(19) Europäisches Patentamt
European Patent Office
Office européen des brevets

(11) EP 4 152 913 A1

(12) EUROPEAN PATENT APPLICATION

(43) Date of publication:
**22.03.2023 Bulletin 2023/12**

(21) Application number: **22195349.0**

(22) Date of filing: **13.09.2022**

(51) International Patent Classification (IPC):
***H10K 101/00*** *(2023.01)* ***H10K 50/13*** *(2023.01)*

(52) Cooperative Patent Classification (CPC):
**H10K 85/346; H10K 50/121; H10K 50/13; H10K 50/19;** H10K 59/38

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.09.2021 KR 20210124268**

(71) Applicant: **Samsung Electronics Co., Ltd.**
**Gyeonggi-do, 16677 (KR)**

(72) Inventors:
- **LEE, Sunghun**
  **16678 Suwon-si (KR)**
- **KWAK, Seungyeon**
  **16678 Suwon-si (KR)**
- **SIM, Myungsun**
  **16678 Suwon-si (KR)**

(74) Representative: **Elkington and Fife LLP**
**Prospect House**
**8 Pembroke Road**
**Sevenoaks, Kent TN13 1XR (GB)**

# (54) LIGHT-EMITTING DEVICE AND ELECTRONIC APPARATUS INCLUDING THE SAME

(57) A light-emitting device includes: an OLED substrate including a structure wherein at least one blue emission unit and at least one green emission unit are stacked in the structure, and wherein the OLED substrate emits blue light and green light; and a color control unit located in a path of light emitted from the OLED substrate, wherein at least one green emission unit includes a first compound and a second compound, the first compound emits first light having a first spectrum, and λP(1) is a first emission peak wavelength, the second compound emits second light having a second spectrum, and λP(2) is a second emission peak wavelength, an absolute value of the difference between λP(1) and λP(2) is from 0 nanometer to about 30 nanometer, and λP(1) and λP(2) are each independently from about 500 nanometer to about 570 nanometer.

FIG. 31

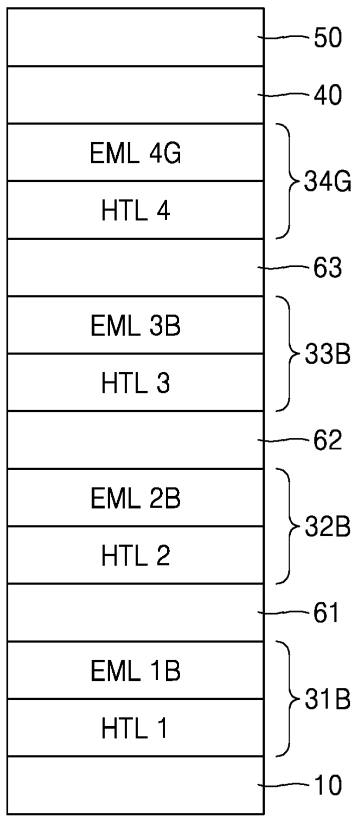


EP 4 152 913 A1

## Description

FIELD OF THE INVENTION

The present disclosure relates to light-emitting devices and electronic apparatuses including the same.

BACKGROUND OF THE INVENTION

From among light-emitting devices, organic light-emitting devices (OLEDs) are self-emission devices, which have improved characteristics in terms of viewing angles, response time, luminance, driving voltage, and response speed, and produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

Meanwhile, a light-emitting device including a plurality of color conversion elements (for example, quantum dot color conversion elements) uses a blue-organic light-emitting device substrate or a white-organic light-emitting device substrate as a light source.

SUMMARY OF THE INVENTION

Provided are light-emitting devices having high luminescence efficiency and long lifespans, and electronic apparatuses including the same.

Additional aspects will be set forth in part in the description, which follows and, in part, will be apparent from the description, or may be learned by practice of the presented embodiments of the disclosure.

According to an aspect, a light-emitting device includes:

an organic light-emitting device (OLED) substrate including a structure in which at least one blue emission unit and at least one green emission unit are stacked, wherein the OLED substrate emits blue light and green light; and
a color control unit located in the path of light emitted from the OLED substrate, wherein the color control unit controls a color of the light emitted from the OLED substrate, wherein
the at least one green emission unit includes a first compound and a second compound,
the first compound and the second compound may be different from each other,
the first compound emits first light having a first spectrum, and λP(1) is a first emission peak wavelength (nm) of the first spectrum, as evaluated from a first photoluminescence spectrum measured from a first film including the first compound,
the second compound may emit second light having a second spectrum, and AP(2) is a second emission peak wavelength (nm) of the second spectrum, as evaluated from a second photoluminescence spectrum measured from a second film including the second compound,
an absolute value of the difference between λP(1) and AP(2) is from about 0 nanometer (nm) to about 30 nm, and λP(1) and AP(2) are each independently from about 500 nm to about 570 nm.

Both the first compound and the second compound may emit a green light.

According to another aspect, a light-emitting device includes:

an organic light-emitting device (OLED) substrate including a structure in which at least one blue emission unit and at least one green emission unit are stacked, wherein the OLED substrate emits blue light and green light; and
a color control unit located in the path of light emitted from the OLED substrate, wherein the color control unit controls a color of the light emitted from the OLED substrate,
wherein the at least one green emission unit includes a first compound and a second compound,
the first compound and the second compound may be different from each other,
the first compound and the second compound may emit a green light,
an absolute value of the difference between AP(1) and AP(2) is from about 0 nanometer (nm) to about 30 nm, and AP(1) and λP(2) are each independently from about 500 nm to about 570 nm.

According to another aspect, provided is an organic light-emitting device (OLED) substrate including a structure in which at least one blue emission unit and at least one green emission unit are stacked, wherein the OLED substrate emits blue light and green light,

wherein the at least one green emission unit includes a first compound and a second compound,
the first compound and the second compound may be different from each other,
the first compound emits first light having a first spectrum, and λP(1) is a first emission peak wavelength (nm) of the first spectrum, as evaluated from a first photoluminescence spectrum measured from a first film including the first compound,
the second compound may emit second light having a second spectrum, and λP(2) is a second emission peak wavelength (nm) of the second spectrum, as evaluated from a second photoluminescence spectrum measured from a second film including the second compound,
an absolute value of the difference between λP(1) and AP(2) is from about 0 nanometer (nm) to about 30 nm, and AP(1) and λP(2) are each independently from about 500 nm to about 570 nm.

Both the first compound and the second compound may emit a green light.
According to another aspect, provided is an organic light-emitting device (OLED) substrate including a structure in which at least one blue emission unit and at least one green emission unit are stacked, wherein the OLED substrate emits blue light and green light,

wherein the at least one green emission unit includes a first compound and a second compound,
the first compound and the second compound may be different from each other,
the first compound and the second compound may emit a green light,
an absolute value of the difference between λP(1) and λP(2) is from about 0 nanometer (nm) to about 30 nm, and λP(1) and AP(2) are each independently from about 500 nm to about 570 nm.

According to another aspect, an electronic apparatus includes the light-emitting device.

BRIEF DESCRIPTION OF THE DRAWINGS

The above and other aspects, features, and advantages of one or more exemplary embodiments of the disclosure will be more apparent from the following detailed description taken in conjunction with the accompanying drawings, in which:

FIG. 1 is a cross-sectional view illustrating a light-emitting device according to one or more embodiments;
FIGS. 2 to 29 are cross-sectional views illustrating an organic light-emitting device (OLED) substrate applicable to a light-emitting device according to one or more embodiments;
FIG. 30 is a cross-sectional view illustrating an OLED substrate applicable to a light-emitting device according to one or more embodiments;
FIG. 31 is a cross-sectional view illustrating an OLED substrate applicable to a light-emitting device according to one or more embodiments;
FIGS. 32 to 39 are cross-sectional views illustrating a light-emitting device according to one or more embodiments;
FIG. 40 is a graph of photoluminescence quantum yield (PLQY, %) versus wavelength (nanometer, nm) of a green-quantum dot (QD) (i.e., green light emitting quantum dot)--containing color conversion element and a red-QD(i.e., red light emitting quantum dot)--containing color conversion element which are applicable to a light-emitting device according to one or more embodiments;
FIG. 41 is a graph of transmittance (%) versus wavelength (nm) of a green-QD-containing color conversion element and a red-QD-containing color conversion element which are applicable to a light-emitting device according to one or more embodiments;
FIG. 42 is a graph of transmittance (%) versus wavelength (nm) of an absorption-type color filter applicable to a light-emitting device according to one or more embodiments;
FIG. 43 is a graph of spectral radiance (Watts per square meter per Steradian per nanometer, $W/m^2 \cdot sr \cdot nm$) versus wavelength (nm) when a light scattering agent is applied to blue light and when no light scattering agent is applied according to one or more embodiments;
FIG. 44 is a graph of intensity (arbitrary units, a.u.) versus wavelength (nm) of the PL spectrum of OLED 2; and
FIG. 45 is a graph of intensity (arbitrary units, a.u.) versus wavelength (nm) of the PL spectrum of Light Emitting Device 1.

DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a light-emitting device according to embodiments will be described in further detail with reference to the accompanying drawings. The width and thickness of the layers or regions shown in the accompanying drawings may be exaggerated for clarity of the specification and convenience of description. The same reference numerals denote the same elements throughout the detailed description.

Description of FIG. 1

FIG. 1 is a cross-sectional view illustrating a light-emitting device according to one or more embodiments.

The light-emitting device of FIG. 1 may include an organic light-emitting device (OLED) substrate 1 and a color control unit 2 located in a path of light emitted from the OLED substrate 1 to control the color of light generated from the OLED substrate 1. The OLED substrate 1 may act as a light source.

The number of emission units included in the OLED substrate 1 may be two or more, or for example, 2 to 20, or 2 to 10. In one or more embodiments, the number of emission units included in the OLED substrate 1 may be 2, 3, 4, or 5.

The OLED substrate 1 includes a structure in which at least one blue emission unit and at least one green emission unit are stacked, for example sequentially stacked. In one or more embodiments, in the OLED substrate 1, the

at least one blue emission unit and the at least one green emission unit may be connected in series to each other to form a tandem structure. Accordingly, the OLED substrate 1 may have a tandem structure.

Each of the blue emission units may emit a blue light having an emission peak wavelength of about 440 nanometers (nm) to about 500 nm, or about 450 nm to about 480 nm.

Each of the green emission units may emit a green light having an emission peak wavelength of about 500 nm to about 570 nm, or about 510 nm to about 550 nm.

The number of the blue emission units included in the OLED substrate 1 may be the same as or greater than the number of the green emission units. In one or more embodiments, the ratio of the number of the blue emission units to the number of the green emission units may be 1:1 to 10:1, or 1:1 to 5:1.

In one or more embodiments, the number of the blue emission units may be 1, 2, 3, 4, or 5, and the number of the green emission units may be 1, 2, 3, or 4.

In one or more embodiments, the number of the blue emission units may be 1, 2, or 3, and the number of the green emission units may be 1 or 2.

In one or more embodiments, the number of the blue emission units may be 2 or 3, and the number of the green emission units may be 1 or 2. In one or more embodiments, the number of the blue emission units may 3, and the number of the green emission units may be 1.

The stacking order of the at least one blue emission unit and the at least one green emission unit may be variously modified. In one or more embodiments, the at least one blue emission unit and the at least one green emission unit may be alternately stacked. In one or more embodiments, the at least one green emission unit (for example, all green emission units) may be located closer to the color control unit 2 than the at least one blue emission unit (for example, all blue emission units).

From the OLED substrate 1, mixed light including blue light and green light is emitted.

The at least one green emission units of the OLED substrate 1 includes a first compound and a second compound, for example, the first compound and the second compound may be mixed. The first compound and the second compound are different from each other.

In one or more embodiments, the at least one green emission units of the OLED substrate 1 may include a layer including a mixture of the first compound and the second compound.

The layer including the mixture of the first compound and the second compound may be formed by i) a co-deposition process or ii) a soluble process including providing a first solution and a heat treatment. During the co-deposition process, a deposition target material may include a first compound and a second compound, and the first solution may include the first compound and the second compound. Therefore, the "layer including the mixture of the first compound and the second compound" is clearly distinguished from, for example, a double-layer structure in which a layer containing the first compound and a layer containing the second compound are stacked.

The color control unit 2 may include a quantum dot, an inorganic phosphor, an organic fluorescent material, an organic phosphorescent material, or a combination thereof. In one or more embodiments, the color control unit 2 may include a plurality of quantum dots.

The color control unit 2 may include a first color control element for green conversion and a second color control element for red conversion. The first color control element and the second color control element may be patterned for corresponding pixels capable of emitting a different color of light.

The color control unit 2 may include a first color control element for green conversion, a second color control element for red conversion, and a third color control element for blue conversion. The first color control element, the second color control element, and the third color control element may be patterned for corresponding pixels capable of emitting a different color of light.

In one or more embodiments, each of the first color control element and the second color control element may be a color conversion element.

In one or more embodiments, each of the first color control element and the second color control element may be a quantum dot-containing color conversion element.

In one or more embodiments, the third color control element may be a color conversion element or a color filter.

In one or more embodiments, the third color control element may be a quantum dot-containing color conversion element or an absorption type color filter.

In one or more embodiments, the color control unit 2 may include a first color control element including a first quantum dot for green conversion, a second color control element including a second quantum dot for red conversion, and a third color control element for blue conversion.

In one or more embodiments, the color control unit 2 may further include a first color filter located on the first color control element, and a second color filter located on the second color control element.

The light-emitting device may further include a thin-film transistor (TFT) array substrate including a plurality of TFTs (not shown). The plurality of TFTs of the TFT array substrate may be a device for driving pixel (subpixel) regions of the OLED substrate 1. When the light-emitting device is a top-emission type light-emitting device, the TFT array

substrate may be located under or below the OLED substrate 1. When the light-emitting device is a bottom-emission type light-emitting device, the TFT array substrate may be located between the OLED substrate 1 and the color control unit 2.

Located between the OLED substrate 1 and the color control unit 2 may be an optical film (for example, a selective reflection film, a capping layer, or the like) that may control the optical characteristics of the light-emitting device in various ways; an encapsulating member to prevent oxygen and/or moisture from external air from reaching the OLED substrate 1; or the like.

In one or more embodiments, a selective reflection film may be additionally located between the OLED substrate 1 and the color control unit 2.

The selective reflection film may be configured to transmit blue light and green light and to reflect red light. The selective reflection film may act to transmit a wavelength band of about 440 nm to about 550 nm and reflect a wavelength band of about 610 nm to about 760 nm. Accordingly, the mixed light including blue light and green light emitted from the OLED substrate 1 may be irradiated to the color control unit 2 through the selective reflection film. In one or more embodiments, red light emitted downward from the second color control element 70b, which will be described later, may be reflected by the selective reflection film and emitted upward. Accordingly, the optical efficiency may be improved by the selective reflection film. When necessary, the selective reflection film may be optionally formed only under the second color control element 70b, which will be described later.

For example, the selective reflection film may be formed in a distributed Bragg reflector (DBR) structure. A DBR structure that passes or reflects only the desired wavelength band may be created by repeatedly stacking two material layers (dielectrics) having different refractive indices and adjusting the thickness and the number of layers to be stacked of the material layers. The DBR structure may be applied to the selective reflection film. For example, a first dielectric layer and a second dielectric layer may be repeatedly stacked, and the reflectance or transmittance of the desired wavelength band may be increased by adjusting the material, the thickness, and the number of layers to be stacked of the material layers. In one or more embodiments, the selective reflection film may have a dichroic mirror structure.

The light-emitting device may not emit white light.

Description of first compound and second compound

The first compound emits first light having a first spectrum and AP(1) is a first emission peak wavelength (nm) of the first spectrum, and the second compound emits second light having a second spectrum and λP(2) is a second emission peak wavelength (nm) in the second spectrum. The absolute value of the difference between the λP(1) and λP(2) is from 0 nm to about 30 nm, 0 nm to about 25 nm, 0 nm to about 20 nm, 0 nm to about 15 nm, or 0 nm to about 10 nm, and λP(1) and λP(2) are each independently about 500 nm to about 570 nm, or about 500 nm to about 550 nm. In one or more embodiments, each of λP(1) and AP(2) may independently be about 500 nm to about 540 nm, or about 510 nm to about 540 nm.

λP(1) and AP(2) are evaluated from the photoluminescence (PL) spectra measured with respect to the first film and the second film, respectively, and are emission peak wavelengths in the corresponding photoluminescence spectra, respectively. In other words, λP(1) is evaluated from a first photoluminescence spectrum measured from a first film comprising the first compound and is an emission peak wavelengths in the first photoluminescence spectrum, and λP(2) is evaluated from a second photoluminescence spectrum measured from a second film comprising the second compound and is an emission peak wavelengths in the second photoluminescence spectrum.

The term "first film" as used herein refers to a film including the first compound, and the term "second film" as used herein refers to a film including the second compound. The first film and the second film may be manufactured using various methods, for example, a vacuum deposition method, and a coating and heating method. The first film and the second film may further include a compound, for example, a host described herein, other than the first compound and the second compound.

In one or more embodiments, the first compound and the second compound may each be an emitter.

In one or more embodiments, both the first compound and the second compound may emit a green light.

In one or more embodiments, the first compound and the second compound may each be an emitter, and AP(1) and λP(2) may each independently be about 510 nm to about 540 nm.

In one or more embodiments, the first compound may be a sensitizer, and the second compound may be an emitter.

In one or more embodiments, the first compound may be a sensitizer, the second compound may be an emitter, λP(1) may be about 500 nm to about 520 nm, and AP(2) may be about 510 nm to about 540 nm.

In one or more embodiments, the first compound and the second compound may each be a phosphorescent compound.

The phosphorescent compound may be an organometallic compound containing a transition metal (for example,

iridium, platinum, osmium, or the like), and may be electrically neutral.

In one or more embodiments, the phosphorescent compound may be a platinum-containing organometallic compound or an iridium-containing organometallic compound. In one or more embodiments, the platinum-containing organometallic compound may be a platinum-containing organometallic compound including platinum and a tetradentate ligand bonded to the platinum. In one or more embodiments, the tetradentate ligand includes a carbon atom and an oxygen atom (or, a sulfur atom) of the tetradentate ligand, and the platinum-containing organometallic compound may include a chemical bond between the carbon atom of the tetradentate ligand and the platinum, and a chemical bond between the oxygen atom (or, the sulfur atom) and the platinum.

In one or more embodiments, the first compound may be a phosphorescent compound, and the second compound may be a fluorescent compound.

In one or more embodiments, the first compound and the second compound may each independently be a fluorescent compound.

The fluorescent compound may be a thermally-activated delayed fluorescence (TADF) compound, or a prompt fluorescent compound.

In one or more embodiments, each of the first compound and the second compound may independently be a fluorescent compound, wherein the first compound may be a thermally-activated delayed fluorescence compound, and the second compound may be a prompt fluorescent compound.

The first compound and the second compound may satisfy Condition 1 or Condition 2:

Condition 1

The first compound is a platinum-containing organometallic compound including platinum and a tetradentate ligand bonded to the platinum, and
the second compound is an iridium-containing organometallic compound.

Condition 2

Each of the first compound and the second compound is independently an iridium-containing organometallic compound.

In one or more embodiments, the first compound and the second compound may satisfy Condition 1,

$\mu$(Pt) may be about 0.5 debye to about 5.0 debye,
$\mu$(Pt) may be less than $\mu$(Ir),
$\mu$(Pt) may be an electric dipole moment of the first compound,
$\mu$(Ir) may be an electric dipole moment of the second compound, and
each of $\mu$(Pt) and $\mu$(Ir) may be calculated based on density functional (DFT) theory. Any various programs may be used for the quantum mechanical calculation based on the DFT, and for example, a Gaussian 16 program may be used.

In the case of a mixture of the first compound and the second compound that satisfy Condition 1, aggregation among molecules of the first compound in the mixture, aggregation among molecules of the second compound in the mixture, and/or aggregation among molecules of the first compound and molecules of the second compound in the mixture, may be substantially minimized. Accordingly, without any consideration about intermolecular aggregation, the amounts (for example, weight) of the first compound and the second compound in the mixture may be relatively increased. Accordingly, a layer including the mixture and a light-emitting device including the mixture may have excellent luminescence efficiency and lifespan characteristics. In addition, when an emission unit of a light-emitting device contains a mixture of the first compound and the second compound which satisfy Condition 1, the hole flux in the emission unit is increased due to the mixture, so that an exciton recombination zone in the emission unit may be spaced apart from each of the interface between an emission layer and a hole transport region and the interface between an emission layer and an electron transport region, resulting in improved lifespan characteristics of the light-emitting device.

The platinum-containing organometallic compound includes one platinum atom and may contain no metal(s) other than platinum.

The platinum-containing organometallic compound may contain no ligands other than the tetradentate ligand bound to the platinum.

The tetradentate ligand bound to platinum in the platinum-containing organometallic compounds may have excellent electrical characteristics and structural rigidity. In addition, the platinum-containing organometallic compound having the tetradentate ligand bound to platinum has a planar structure and may have a relatively small dipole moment. Thus, the layer including the platinum-containing organometallic compound or the light-emitting device including the

platinum-containing organometallic compound have excellent luminescence efficiency and a long lifespan.

The iridium-containing organometallic compound contains one iridium atom and may contain no metal(s) other than iridium.

In this specification, the terms "electric dipole moment of the first compound" and "electric dipole moment of the second compound" as used herein may refer to "total permanent dipole moment in the molecule of the first compound" and "total permanent dipole moment in the molecule of the second compound", respectively.

In one or more embodiments, μ(Pt) may be from about 0.5 debye to about 5.0 debye.

In one or more embodiments, μ(Pt) may be from about 0.5 debye to about 3.0 debye, about 1.0 debye to about 3.0 debye, about 1.5 debye to about 3.0 debye, about 1.7 debye to about 3.0 debye, or about 1.7 debye to about 2.7 debye.

In one or more embodiments, μ(Pt) may be from about 2.0 debye to about 5.0 debye, about 3.0 debye to about 5.0 debye, or about 4.0 debye to about 5.0 debye.

In one or more embodiments, μ(Ir) may be from about 4.0 debye to about 9.0 debye, about 4.5 debye to about 7.5 debye, or about 5.0 debye to about 7.0 debye.

In one or more embodiments, μ(Ir) - μ(Pt) may be from about 0.3 debye to about 4.0 debye.

In one or more embodiments, μ(Ir) - μ(Pt) may be from about 2.0 debye to about 4.0 debye or about 2.0 debye to about 3.0 debye.

In one or more embodiments, μ(Ir) - μ(Pt) may be from about 0.3 debye to about 1.0 debye.

In one or more embodiments, in Condition 1,

AP(Pt) may be equal to λP(Ir),
AP(Pt) may be less than λP(Ir),
AP(Pt) may be greater than λP(Ir),
AP(Pt) and AP(Ir) may each be about 510 nm to about 570 nm,
AP(Pt) and λP(Ir) may each be about 510 nm to about 540 nm,
AP(Pt) may be about 510 nm to about 530 nm, and λP(Ir) may be about 520 nm to about 540 nm,
AP(Pt) and λP(Ir) may each be about 540 nm to about 570 nm, or
AP(Pt) may be about 540 nm to about 560 nm, and AP(Ir) may be about 550 nm to about 570 nm,
wherein AP(Pt) is the first emission peak wavelength AP(1) of the first compound, as evaluated from the first photoluminescence spectrum measured from the first film comprising the first compound, and
λP(Ir) is the second emission peak wavelength λP(2) of the second compound, as evaluated from the second photoluminescence spectrum measured from the second film comprising the second compound.

In one or more embodiments, the light emitting device may satisfy Condition 2, and at least one of Equation 1 to Equation 4. Accordingly, a light-emitting device including the first compound and the second compound satisfies Condition 2 may have better luminescence efficiency and long lifespan:

Equation 1

$$\lambda P(Ir1) > \lambda P(Ir2)$$

Equation 2

$$PLQY(Ir1) > PLYQ(Ir2)$$

Equation 3

$$k_r(Ir1) > k_r(Ir2)$$

Equation 4

$$HOR(Ir1) > HOR(Ir2)$$

wherein, in Equation 1,
λ P(Ir1) is the first emission peak wavelength λP(1) of the first compound, as evaluated from the first photoluminescence

spectrum measured from the first film comprising the first compound, and λP(Ir2) is the second emission peak wavelength λP(2) of the second compound, as evaluated from the second photoluminescence spectrum measured from the second film comprising the second compound,.

In relation to Equation 2, PLQY(Ir1) is the first photoluminescence (PL) quantum yield of the first compound, as evaluated from the first PL spectrum measured from the first film comprising the first compound, and PLQY(Ir2) is the second PL quantum yield of the second compound, as evaluated from the second PL spectrum measured from the second film comprising the second compound.

In relation to Equation 3, kr(Ir1) is a first radiative decay rate of the first compound, as evaluated from the first PL spectrum and first time-resolved PL spectra measured from the first film comprising the first compound, and kr(Ir2) is a second radiative decay rate of the second compound, as evaluated from the second PL spectrum and second time-resolved PL spectra measured from the second film comprising the second compound.

In relation to Equation 4, HOR(Ir1) is a first horizontal orientation ratio of the first compound, as evaluated from a first emission intensity with respect to a first angle measured from the first film comprising the first compound, and HOR(Ir2) is a second horizontal orientation ratio of the second compound, as evaluated from a second emission intensity with respect to a second angle measured from the second film comprising the second compound.

The first film and the second film are those described in the present specification.

In one or more embodiments, the light-emitting device including the first compound and the second compound that satisfies Condition 2 may satisfy:

Equation 1,
at least one of Equation 2 to Equation 4, or
Equation 1, and at least one of Equation 2 to Equation 4.

In one or more embodiments, the light-emitting device including the first compound and the second compound that satisfy Condition 2 may further satisfy Equation 5:

Equation 5

$$\mathrm{HOMO\ (Ir1)} < \mathrm{HOMO\ (Ir2)}$$

wherein, in Equation 5,

HOMO (Ir1) is a first highest occupied molecular orbital (HOMO) energy level of the first compound, as evaluated from a first atmospheric photoelectron spectrum measured from the first film comprising the first compound, and
HOMO (Ir2) is a second highest occupied molecular orbital (HOMO) energy level of the second compound, as evaluated from a second atmospheric photoelectron spectrum measured from the second film comprising the second compound.

Each of HOMO (Ir1) and HOMO (Ir2) may be a negative value measured using an atmospheric photoelectron spectrometer, for example, AC3 manufactured by RIKEN KEIKI Co., Ltd.

Since the light-emitting device including the first compound and the second compound satisfies Condition 2 and satisfies Equation 5, the second compound in the mixture has a shallower HOMO energy level than the first compound, and a relatively greater amount of holes may be trapped in the second compound. As a result, in the case of the light-emitting device including the mixture, without the phenomenon in which the first compound and the second compound are changed into an anionic state due to electrons injected into the mixture and the increase in the driving voltage, holes and electrons may effectively recombine in the first compound and/or the second compound. Accordingly, the light-emitting device may have excellent luminescence efficiency characteristics and excellent lifespan characteristics.

In one or more embodiments, in the light-emitting device including the first compound and the second compound satisfying Condition 2,

|HOMO (Ir1) - HOMO (Ir2)| may be about 0.03 electron volts (eV) to about 0.30 eV, and
|HOMO (Ir1) - HOMO (Ir2)| may be the absolute value of HOMO (Ir1) - HOMO (Ir2).

In one or more embodiments, the platinum-containing organometallic compound in Condition 1 may include a chemical bond between a carbon atom of the tetradentate ligand and the platinum, and

a chemical bond between an oxygen atom of the tetradentate ligand and the platinum, and each of the iridium-containing organometallic compounds in Condition 1 and Condition 2 contains a first ligand, a second ligand, and a third ligand,

wherein, in each of the iridium-containing organometallic compounds,

the first ligand, the second ligand, and the third ligand are identical to each other,

the first ligand and the second ligand are identical to each other, and the second ligand and the third ligand are different from each other, or

the first ligand, the second ligand, and the third ligand are different from each other, and

wherein the first ligand, the second ligand, and the third ligand may each be:

a bidentate ligand bonded to the iridium of the iridium-containing organometallic compound via two nitrogen atoms;

a bidentate ligand bonded to the iridium of the iridium-containing organometallic compound via a nitrogen atom and a carbon atom; or

a bidentate ligand bonded to the iridium of the iridium-containing organometallic compound via two carbon atoms.

In one or more embodiments, the platinum-containing organometallic compound may be an organometallic compound represented by Formula 1, and the iridium-containing organometallic compound may be an organometallic compound represented by Formula 2:

Formula 1

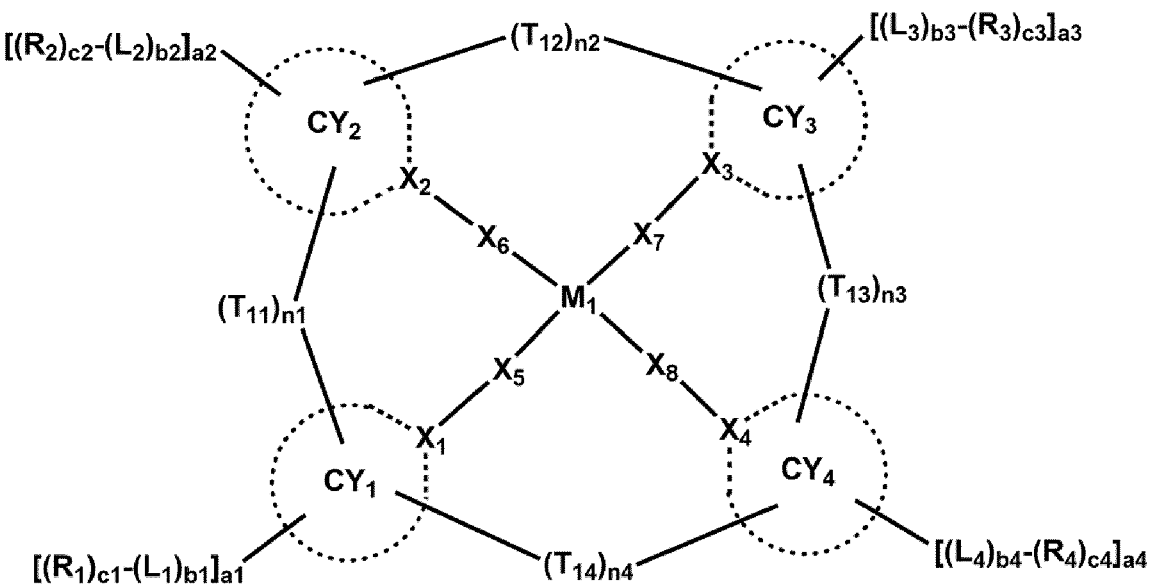

Formula 2 $M_2(L_{11})_{n11}(L_{12})_{n12}(L_{13})_{n13}$

Formula 2-1

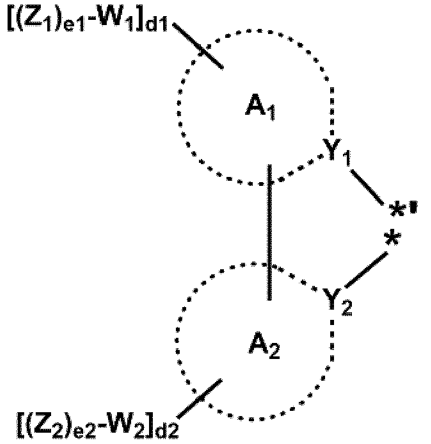

Formula 2-2

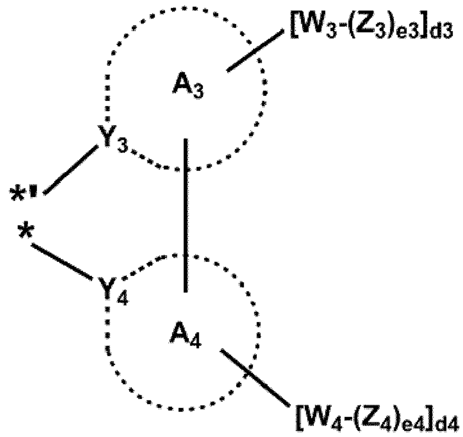

$M_1$ in Formula 1 may be platinum (Pt),
$M_2$ in Formula 2 may be iridium (Ir),
$L_{11}$ in Formula 2 may be a ligand represented by Formula 2-1,
$L_{12}$ in Formula 2 may be a ligand represented by Formula 2-2,
$L_{13}$ in Formula 2 may be a ligand represented by Formula 2-1 or 2-2,
$L_{11}$ and $L_{12}$ in Formula 2 may be different from each other,
n11, n12 and n13 in Formula 2 may each independently be 0, 1, 2, or 3, and the sum of n11, n12, and n13 may be 3,
$X_1$ to $X_4$ and $Y_1$ to $Y_4$ in Formulae 1, 2-1, and 2-2 may each independently be C or N,
$X_5$ to $X_8$ in Formula 1 may each independently be a chemical bond, *-O-*', *-S-*', *-N(R')-*', *-C(R')(R")-*', or *-C(=O)-*', wherein at least one of $X_5$ to $X_8$ may not be a chemical bond,
two of a bond between $X_5$ or $X_1$ and $M_1$, a bond between $X_6$ or $X_2$ and $M_1$, a bond between $X_7$ or $X_3$ and $M_1$, and a bond between $X_8$ or $X_4$ and $M_1$ may each be a coordinate bond, and the other two may each be a covalent bond,
ring $CY_1$ to ring $CY_4$ and ring $A_1$ to ring $A_4$ in Formulae 1, 2-1, and 2-2 may each independently be a $C_5$-$C_{30}$ carbocyclic group or a $C_1$-$C_{30}$ heterocyclic group,
$T_{11}$ to $T_{14}$ in Formula 1 may each independently be a single bond, a double bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_{5a}$)=*', *=C($R_{5a}$)-*', *-C($R_{5a}$)=C($R_{5b}$)-*', *-C(=S)-*', *-C=C-*', a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$,
n1 to n4 in Formula 1 may each independently be 0 or 1, and 3 or more of n1 to n4 may each be 1,
when n1 is 0, $T_{11}$ does not exist, when n2 is 0, $T_{12}$ does not exist, when n3 is 0, $T_{13}$ does not exist, when n4 is 0, $T_{14}$ does not exist,
$L_1$ to $L_4$ and $W_1$ to $W_4$ in Formulae 1, 2-1, and 2-2 may each independently be a single bond, a $C_1$-$C_{20}$ alkylene group that is unsubstituted or substituted with at least one $R_{10a}$, a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$,
b1 to b4 in Formula 1 may each independently be an integer of 1 to 10,
$R_1$ to $R_4$, $R_{5a}$, $R_{5b}$, R', R", and $Z_1$ to $Z_4$ in Formulae 1, 2-1, and 2-2 may each independently be hydrogen, deuterium, -F, -Cl, -Br, -I, -SFs, a hydroxyl group, a cyano group, a nitro group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$),

$-P(=O)(Q_8)(Q_9)$, or $-P(Q_8)(Q_9)$,

c1 to c4, a1 to a4, e1 to e4, and d1 to d4 in Formulae 1, 2-1, and 2-2 may each independently be an integer of 0 to 20, the second compound may not be tris[2-phenylpyridine]iridium,

two or more substituents in at least one of i) two or more of a plurality of $R_1$(s), ii) two or more of a plurality of $R_2$(s), iii) two or more of a plurality of $R_3$(s), iv) two or more of a plurality of $R_4$(s), v) $R_{5a}$ and $R_{5b}$, vi) two or more of a plurality of $Z_1$(s), vii) two or more of a plurality of $Z_2$(s), viii) two or more of a plurality of $Z_3$(s), ix) two or more of a plurality of $Z_4$(s), x) two or more of $R_1$ to $R_4$, $R_{5a}$, and $R_{5b}$, and xi) two or more of $Z_1$ to $Z_4$ may optionally be linked to each other to form a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$,

$R_{10a}$ is understood by referring to the description of $R_1$ provided herein,

* and *' in Formulae 2-1 and 2-2 each indicate a binding site to $M_2$,

* and *' in $X_5$ to $X_8$ and $T_{11}$ to $T_{14}$ each indicate a binding site to an adjacent atom, and

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, - B(Q26)(Q27), $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or a combination thereof,

wherein $Q_1$ to $Q_9$, $Q_{11}$ to $Q_{19}$, $Q_{21}$ to $Q_{29}$, and $Q_{31}$ to $Q_{39}$ may each independently be: hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or

unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

Platinum (Pt) as $M_1$ in Formula 1 may be replaced by palladium (Pd) or gold (Au). That is, the platinum-containing organometallic compound may be replaced with a palladium-containing or a gold-containing organometallic compound.
In Formula 2, n11 to n13 each indicates the number of $L_{11}$(s) to the number of $L_{13}$(s), respectively, and may each independently be 0, 1, 2, or 3, wherein n11 + n12 + n13 may be 3.
In one or more embodiments, in Formula 2, n11 may be 1, 2, or 3, and n12 and n13 may each independently be 0, 1, or 2.
In one or more embodiments, in Formula 2, n12 may be 1, 2, or 3, and n11 and n13 may each independently be 0, 1, or 2.
In one or more embodiments, n11 may be 1, n12 may be 2, and n13 may be 0.
In one or more embodiments, n11 may be 2, n12 may be 1, and n13 may be 0.
In one or more embodiments, n11 may be 3, and n12 and n13 may each be 0.
In one or more embodiments, n12 may be 3, and n11 and n13 may each be 0.
The iridium-containing organometallic compound represented by Formula 2 may be a heteroleptic complex or a homoleptic complex.
In one or more embodiments, the iridium-containing organometallic compound may be a heteroleptic complex.
In Formulae 1, 2-1, and 2-2, $X_1$ to $X_4$ and $Y_1$ to $Y_4$ may each independently be C or N.
In one or more embodiments, at least one of $X_1$ to $X_4$ in Formula 1 may be C.
In one or more embodiments, $X_1$ in Formula 1 may be C.
In one or more embodiments, in Formula 1, i) $X_1$ and $X_3$ may each be C, and $X_2$ and $X_4$ may each be N, or ii) $X_1$ and $X_4$ may each be C, and $X_2$ and $X_3$ may each be N.
In one or more embodiments, in Formulae 2-1 and 2-2, $Y_1$ and $Y_3$ may each be N, and $Y_2$ and $Y_4$ may each be C.
In Formula 1, $X_5$ to Xs may each independently be a chemical bond, *-O-*', *-S-*', *-N(R')-*', *-C(R')(R")-*', or *-C(=O)-*', wherein at least one of $X_5$ to $X_8$ may not be a chemical bond, and * and *' each indicated a bonding site to an adjacent atom. R' and R" may each be the same as described herein.
In one or more embodiments, $X_5$ in Formula 1 may not be a chemical bond.
In one or more embodiments, $X_5$ in Formula 1 may be O or S.
In one or more embodiments, in Formula 1, $X_5$ may be O or S, and $X_6$ to $X_8$ may each be a chemical bond.
In Formula 1, two bonds of a bond between $X_5$ or $X_1$ and $M_1$, a bond between $X_6$ or $X_2$ and $M_1$, a bond between $X_7$ or $X_3$ and $M_1$, and a bond between $X_8$ or $X_4$ and $M_1$ may each be a coordinate bond, and the other two bonds may each be a covalent bond.
In one or more embodiments, a bond between $X_2$ and M in Formula 1 may be a coordinate bond.
In one or more embodiments, in Formula 1, a bond between $X_5$ or $X_1$ and M and a bond between $X_3$ and M may each be a covalent bond, and a bond between $X_2$ and M and a bond between $X_4$ and M may each be a coordinate bond.
In one or more embodiments, the platinum-containing organometallic compound and iridium-containing organometallic compound may each be electrically neutral.
In Formulae 1, 2-1, and 2-2, ring $CY_1$ to ring $CY_4$ and ring $A_1$ to ring $A_4$ may each independently be a $C_5$-$C_{30}$ carbocyclic group or a $C_1$-$C_{30}$ heterocyclic group.
For example, each of ring $CY_1$, ring $CY_3$, and ring $CY_4$ may not be a benzimidazole group.
For example, in Formulae 1, 2-1, and 2-2, ring $CY_1$ to ring $CY_4$ and ring $A_1$ to $A_4$ may each independently be i) a first ring, ii) a second ring, iii) a condensed ring in which two or more first rings are condensed with each other, iv) a condensed ring in which two or more second rings are condensed with each other, or v) a condensed ring in which one or more first rings are condensed with one or more second rings,

wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

In one or more embodiments, in Formulae 1, 2-1, and 2-2, ring $CY_1$ to ring $CY_4$ and ring $A_1$ to ring $A_4$ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthoxazole group, a naphthoisoxazole group, a naphthothiazole group, a naphthoisothiazole group, a naphthoxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenoxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring $CY_1$ and ring $CY_3$ in Formula 1 may each independently be:

a benzene group, a naphthalene group, a phenanthrene group, a dibenzofuran group, a dibenzothiophene group, a dibenzoselenophene group, a carbazole group, a fluorene group, or a dibenzosilole group; or

a benzene group, a naphthalene group, a phenanthrene group, a dibenzofuran group, a dibenzothiophene group,

a dibenzoselenophene group, a carbazole group, a fluorene group, or a dibenzosilole group, each condensed with at least one of a cyclohexane group, a cyclohexene group, a norbornane group, a piperidine group, or a combination thereof.

In one or more embodiments, ring $CY_2$ in Formula 1 may be:

an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with at least one of a cyclohexane group, a cyclohexene group, a norbornane group, a benzene group, a pyridine group, a pyrimidine group, or a combination thereof.

In one or more embodiments, ring $CY_4$ in Formula 1 may be:

a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with at least one of a cyclohexane group, a cyclohexene group, a norbornane group, a benzene group, a pyridine group, a pyrimidine group, or a combination thereof.

In Formulae 2-1 and 2-2, ring $A_1$ and ring $A_3$ may be the same as or different from each other.
In one or more embodiments, a $Y_1$-containing monocyclic group in ring $A_1$, a $Y_2$-containing monocyclic group in ring $A_2$, and $Y_4$-containing monocyclic group in ring $A_4$ may each be a 6-membered ring.
In one or more embodiments, a $Y_3$-containing monocyclic group in ring $A_3$ may be a 6-membered ring.
In one or more embodiments, a $Y_3$-containing monocyclic group in ring $A_3$ may be a 5-membered ring.
In one or more embodiments, a $Y_1$-containing monocyclic group in ring $A_1$ may be a 6-membered ring, and a $Y_3$-containing monocyclic group in ring $A_3$ may be a 5-membered ring.
In one or more embodiments, in Formulae 2-1 and 2-2, ring $A_1$ and ring $A_3$ may each independently be i) one of Group A, ii) a polycyclic group in which two or more of Group A are condensed with each other, or iii) a polycyclic group in which at least one of Group A and at least one of Group B are condensed with each other,

wherein Group A may include a pyridine group, a pyrimidine group, a pyridazine group, a pyrazine group, or a triazine group, and
Group B may include a cyclohexane group, a cyclohexene group, a norbornane group, a benzene group, a furan group, a thiophene group, a selenophene group, a pyrrole group, a cyclopentadiene group, or silole group.

In one or more embodiments, in Formula 2-2, ring $A_3$ may be i) one of Group C, ii) a polycyclic group in which two or more of Group C are condensed with each other, or iii) a polycyclic group in which at least one of Group C and at least one of Group D are condensed with each other,

wherein Group C may include a pyrrole group, a pyrazole group, an imidazole group, a triazole group, an oxazole group, an isoxazole group, a thiazole group, or an isothiazole group, and
Group D may include a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring $A_1$ in Formula 2-1 may be:

a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring $A_3$ in Formula 2-2 may be:

a pyridine group, a pyrimidine group, a pyridazine group, or a pyrazine group;

a pyridine group, a pyrimidine group, a pyridazine group, or a pyrazine group, each condensed with at least one of a cyclohexane group, a norbornane group, a benzene group, or a combination thereof; or

an imidazole group, a benzimidazole group, a naphthoimidazole group, a phenanthrenoimidazole group, a pyridoimidazole group, an oxazole group, a benzoxazole group, a naphthooxazole group, a phenanthrenoxazole group, a pyridooxazole group, a thiazole group, a benzothiazole group, a naphthothiazole group, a phenanthrenothiazole group, or a pyridothiazole group.

In one or more embodiments, ring $A_2$ and ring $A_4$ in Formulae 2-1 and 2-2 may be different from each other.

In one or more embodiments, in Formulae 2-1 and 2-2, ring $A_2$ and ring $A_4$ may each independently be i) one of Group E, ii) a polycyclic group in which two or more of Group E are condensed with each other, or iii) a polycyclic group in which at least one of Group E and at least one of Group F are condensed with each other,

wherein Group E may include a benzene group, a pyridine group, a pyrimidine group, a pyridazine group, a pyrazine group, or a triazine group, and

Group F may include a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, in Formula 2-1, ring $A_2$ may be a polycyclic group in which two or more of Group E and at least one of Group F are condensed with each other.

In one or more embodiments, in Formula 2-2, ring $A_4$ may be a polycyclic group in which two or more of Group E and at least one of Group F are condensed with each other.

In one or more embodiments, ring $A_2$ in Formula 2-1 may be:

a benzene group, a naphthalene group, a phenanthrene group, a dibenzofuran group, a dibenzothiophene group, a dibenzoselenophene group, a carbazole group, a fluorene group, or a dibenzosilole group; or

a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

In one or more embodiments, ring $A_4$ in Formula 2-2 may be:

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

In Formula 1, $T_{11}$ to $T_{14}$ may each independently be a single bond, a double bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*' *-S2-*', *-O*', *-C(=O)-*', *-S(=O)-*', *-S(=O)$_2$-*', *-C($R_{5a}$)=*', *=C($R_{5a}$)-*', *- C($R_{5a}$)=C($R_{5b}$)-*', *-C(=S)-*', *-C≡C-*', a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$, wherein * and *' each indicates a binding site to an adjacent atom.

In one or more embodiments, $T_{11}$ and $T_{12}$ in Formula 1 may be a single bond, and $T_{13}$ may be a single bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', or *-O-*', wherein * and *' each indicates a binding site to an adjacent atom.

n1 to n4 in Formula 1 indicate numbers of $T_{11}$ to $T_{14}$, respectively, and may each independently be 0 or 1, wherein three or more of n1 to n4 may each be 1. That is, an organometallic compound represented by Formula 1 may have a tetradentate ligand.

In Formula 1, when n1 is 0, $T_{11}$ does not exist (that is, ring $CY_1$ and ring $CY_2$ are not linked to each other), when n2 is 0, $T_{12}$ does not exist (that is, ring $CY_2$ and ring $CY_3$ are not linked to each other), when n3 is 0, $T_{13}$ does not

exist (that is, ring $CY_3$ and ring $CY_4$ are not linked to each other), and when n4 is 0, $T_{14}$ does not exist (that is, ring $CY_4$ and ring $CY_1$ are not linked to each other).

In one or more embodiments, in Formula 1, n1 to n3 may each be 1, and n4 may be 0.

$L_1$ to $L_4$ and $W_1$ to $W_4$ in Formulae 1, 2-1, and 2-2 may each independently be a single bond, a $C_1$-$C_{20}$ alkylene group that is unsubstituted or substituted with at least one $R_{10a}$, a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$

In one or more embodiments, in Formulae 1, 2-1, and 2-2, $L_1$ to $L_4$ and $W_1$ to $W_4$ may each independently be:

a single bond; or
a $C_1$-$C_{20}$ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one $R_{10a}$.

In one or more embodiments, $L_1$ to $L_4$ and $W_1$ to $W_4$ in Formulae 1, 2-1, and 2-2 may each independently be:

a single bond; or
a $C_1$-$C_{20}$ alkylene group, a benzene group, a naphthalene group, a pyridine group, a fluorene group, a carbazole group, a dibenzofuran group, or a dibenzothiophene group, each unsubstituted or substituted with at least one $R_{10a}$.

In one or more embodiments, in Formulae 1, 2-1, and 2-2, $L_1$ to $L_4$ and $W_1$ to $W_4$ may each independently be:

a single bond; or
a $C_1$-$C_{20}$ alkylene group, a benzene group, a naphthalene group, a dibenzofuran group, or a dibenzothiophene group, each unsubstituted or substituted with at least one of deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

b1 to b4 in Formula 1 indicate the number of $L_1$(s) to the number of $L_4$(s), respectively, and may each independently be an integer from 1 to 10. When b1 is 2 or more, two or more of $L_1$(s) may be identical to or different from each other, when b2 is 2 or more, two or more of $L_2$(s) may be identical to or different from each other, when b3 is 2 or more, two or more of $L_3$(s) may be identical to or different from each other, and when b4 is 2 or more, two or more of $L_4$(s) may be identical to or different from each other. For example, b1 to b4 may each independently be 1, 2, or 3.

$R_1$ to $R_4$, $R_{5a}$, $R_{5b}$, R', R", and $Z_1$ to $Z_4$ in Formulae 1, 2-1, and 2-2 may each independently be hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a

substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$). $Q_1$ to $Q_9$ may each be as described herein.

In one or more embodiments, $R_1$ to $R_4$, $R_{5a}$, $R_{5b}$, R, R", and $Z_1$ to $Z_4$ in Formulae 1, 2-1, and 2-2 may each independently be:

hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_1$-$C_{20}$ alkoxy group, or a $C_1$-$C_{20}$ alkylthio group;

a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with at least one of deuterium, -F, -Cl, - Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl

group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$,
wherein $Q_1$ to $Q_9$ may each independently be:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$,$-CHFCF_2H$, $-CHFCFH_2$, $-CHFCF_3$, $-CF_2CF_3$, $-CF_2CF_2H$, or $-CF_2CFH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, $C_1$-$C_{10}$ alkyl group, a phenyl group, or a combination thereof.

In one or more embodiments, in Formulae 1, 2-1, and 2-2, $R_1$ to $R_4$, $R_{5a}$, $R_{5b}$, R, R", and $Z_1$ to $Z_4$ may each independently be:

hydrogen, deuterium, -F, or a cyano group;
a $C_1$-$C_{20}$ alkyl group unsubstituted or substituted with at least one of deuterium, -F, a cyano group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof;
a $C_3$-$C_{10}$ cycloalkyl group, a $C_1$-$C_{10}$ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a $C_1$-$C_{20}$ alkyl group, a deuterated $C_1$-$C_{20}$ alkyl group, fluorinated $C_1$-$C_{20}$ alkyl group, a $C_1$-$C_{20}$ alkoxy group, a deuterated $C_1$-$C_{20}$ alkoxy group, a fluorinated $C_1$-$C_{20}$ alkoxy group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof; or
-Si(Q3)(Q4)(Q5) or $-Ge(Q_3)(Q_4)(Q_5)$.

In one or more embodiments, in Formula 2-1, each of e1 and d1 may not be 0, and at least one of a plurality of $Z_1$(s) may be a deuterated $C_1$-$C_{20}$ alkyl group, - $Si(Q_3)(Q_4)(Q_5)$, or $-Ge(Q_3)(Q_4)(Q_5)$. $Q_3$ to $Q_5$ are as described in the present specification.

For example, $Q_3$ to $Q_5$ may each independently be:

a $C_1$-$C_{60}$ alkyl group unsubstituted or substituted with at least one of deuterium, a $C_1$-$C_{60}$ alkyl group, a $C_6$-$C_{60}$ aryl group, or a combination thereof; or
a $C_6$-$C_{60}$ aryl group unsubstituted or substituted with at least one of deuterium, a $C_1$-$C_{60}$ alkyl group, a $C_6$-$C_{60}$ aryl group, or a combination thereof.

In one or more embodiments, $Q_3$ to $Q_5$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$,

$-CHDCD_3$, $-CD_2CD_3$, $-CD_2CD_2H$, or$-CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

In one or more embodiments, $Q_3$ to $Q_5$ may be identical to each other.
In one or more embodiments, two or more of $Q_3$ to $Q_5$ may be different from each other.
In one or more embodiments, the iridium-containing organometallic compound may satisfy at least one of Condition 10-1 to Condition 10-8:

Condition 10-1

Each of e1 and d1 in Formula 2-1 is not 0, and at least one $Z_1$ includes deuterium.

Condition 10-2

Each of e2 and d2 in Formula 2-1 is not 0, and at least one $Z_2$ includes deuterium.

Condition 10-3

Each of e3 and d3 in Formula 2-2 is not 0, and at least one $Z_3$ includes deuterium.

Condition 10-4

Each of e4 and d4 in Formula 2-2 is not 0, and at least one $Z_4$ includes deuterium.

Condition 10-5

Each of e1 and d1 in Formula 2-1 is not 0, and at least one $Z_1$ includes a fluoro group.

Condition 10-6

Each of e2 and d2 in Formula 2-1 is not 0, and at least one $Z_2$ includes a fluoro group.

Condition 10-7

Each of e3 and d3 in Formula 2-2 is not 0, and at least one $Z_3$ includes a fluoro group.

Condition 10-8

Each of e4 and d4 in Formula 2-2 is not 0, and at least one $Z_4$ includes a fluoro group.
In one or more embodiments, in Formulae 1, 2-1, and 2-2, $R_1$ to $R_4$, $R_{5a}$, $R_{5b}$, R, R'', and $Z_1$ to $Z_4$ may each independently be hydrogen, deuterium, -F, $-CH_3$, $-CD_3$, $-CD_2H$, $-CDH_2$, $-CF_3$, $-CF_2H$, $-CFH_2$, a $C_2$-$C_{10}$ alkenyl group, a $C_1$-$C_{10}$ alkoxy group, a $C_1$-$C_{10}$ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, $-Si(Q_3)(Q_4)(Q_5)$, or $-Ge(Q_3)(Q_4)(Q_5)$ ($Q_3$ to $Q_5$ may each be as described herein):

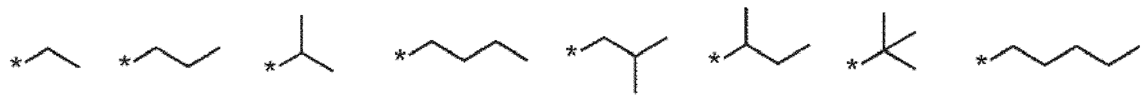

9-1 9-2 9-3 9-4 9-5 9-6 9-7 9-8

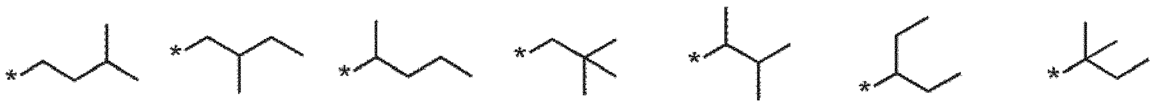

9-9 9-10 9-11 9-12 9-13 9-14 9-15

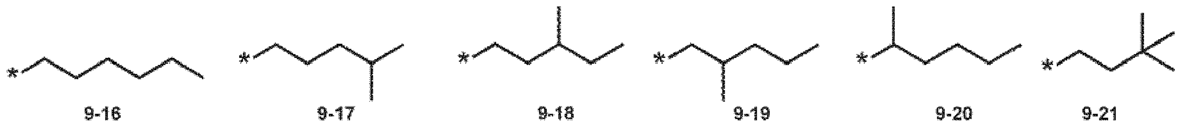

9-16 9-17 9-18 9-19 9-20 9-21

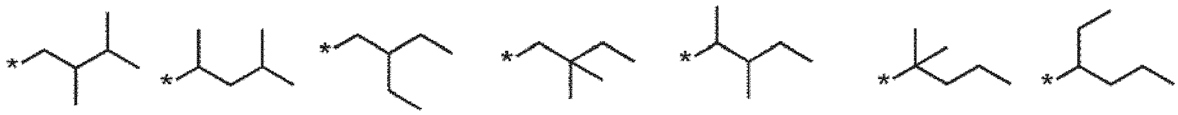

9-22 9-23 9-24 9-25 9-26 9-27 9-28

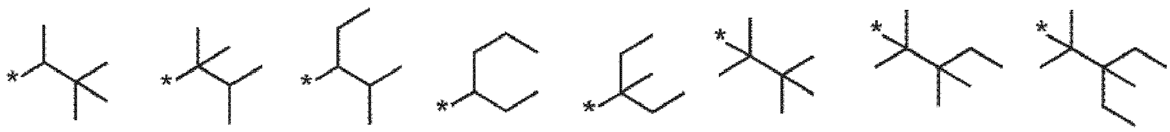

9-29 9-30 9-31 9-32 9-33 9-34 9-35 9-36

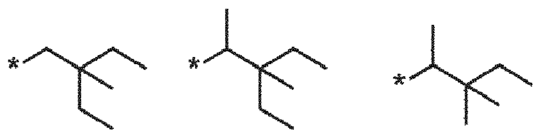

9-37 9-38 9-39

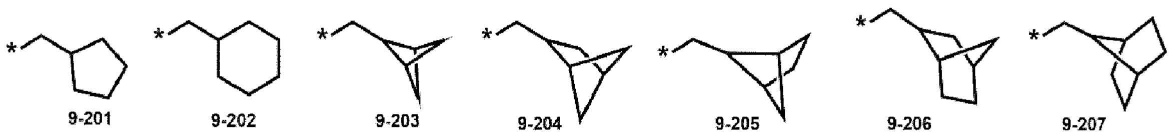

9-201 9-202 9-203 9-204 9-205 9-206 9-207

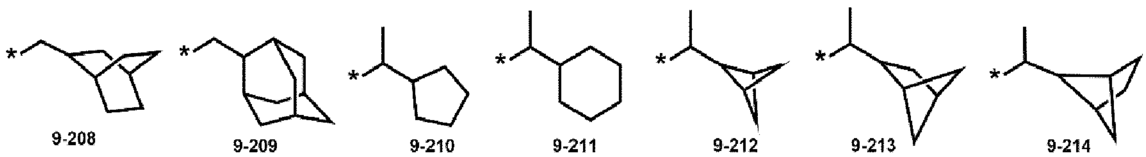

9-208 9-209 9-210 9-211 9-212 9-213 9-214

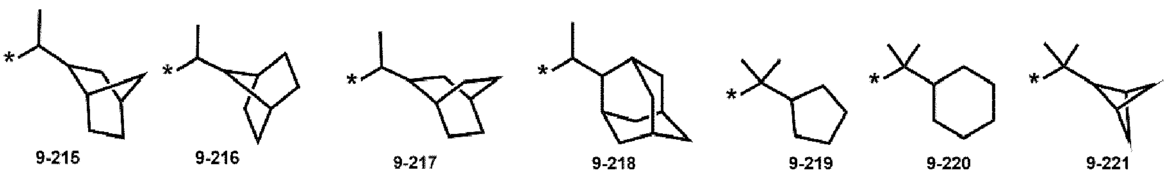

9-215 9-216 9-217 9-218 9-219 9-220 9-221

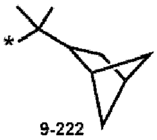
9-222
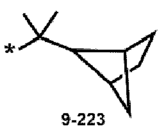
9-223
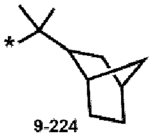
9-224
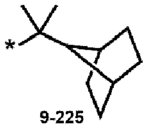
9-225
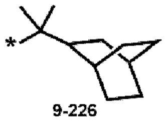
9-226
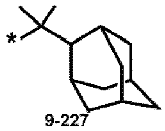
9-227

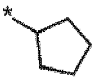
10-1
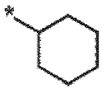
10-2
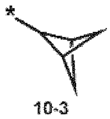
10-3
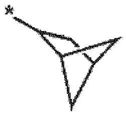
10-4
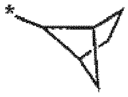
10-5
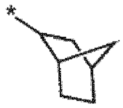
10-6
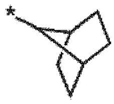
10-7
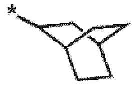
10-8

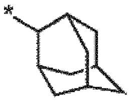
10-9
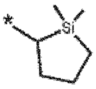
10-10
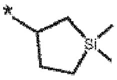
10-11
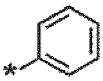
10-12
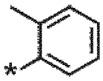
10-13
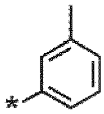
10-14
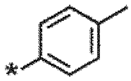
10-15
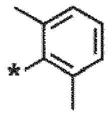
10-16

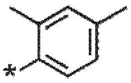
10-17
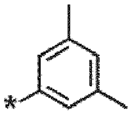
10-18
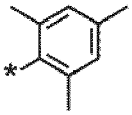
10-19
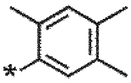
10-20
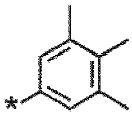
10-21
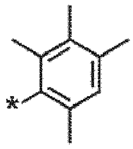
10-22
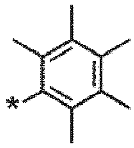
10-23

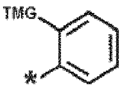
10-24
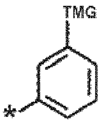
10-25
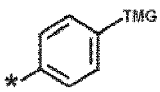
10-26
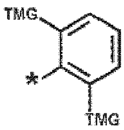
10-27
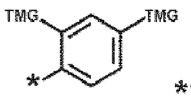
10-28
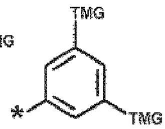
10-29
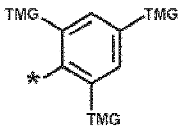
10-30

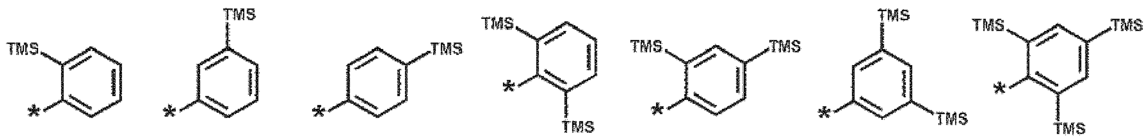
10-31 10-32 10-33 10-34 10-35 10-36 10-37

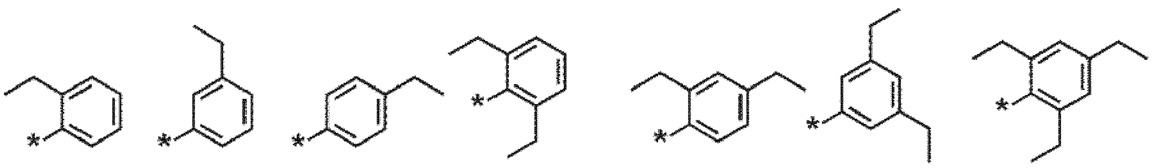
10-38 10-39 10-40 10-41 10-42 10-43 10-44

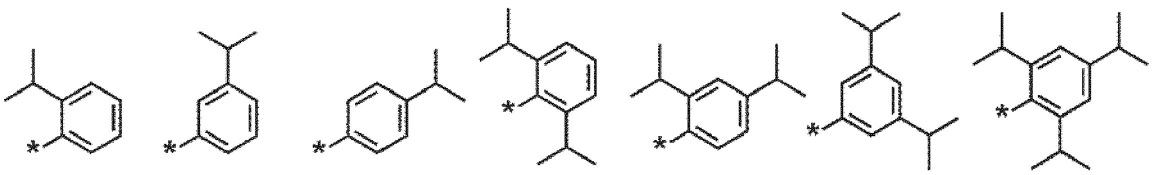
10-45 10-46 10-47 10-48 10-49 10-50 10-51

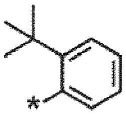
10-52

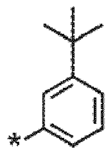
10-53

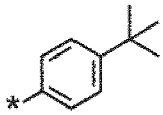
10-54

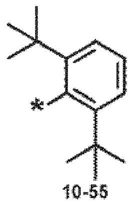
10-55

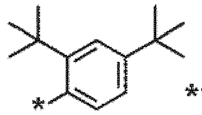
10-56

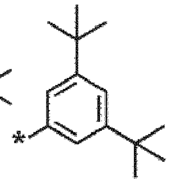
10-57

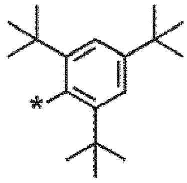
10-58

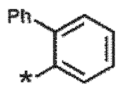
10-59

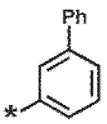
10-60

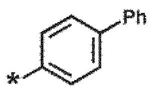
10-61

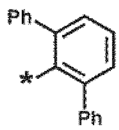
10-62

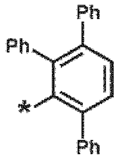
10-63

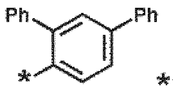
10-64

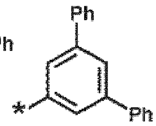
10-65

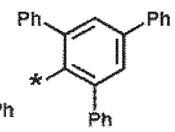
10-66

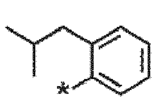
10-67

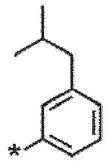
10-68

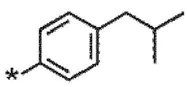
10-69

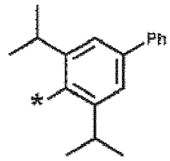
10-70

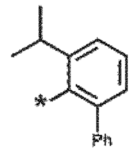
10-71

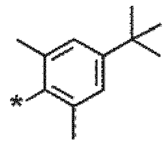
10-72

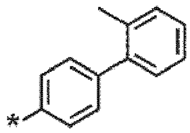
10-73

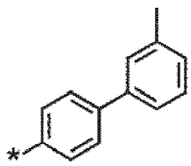
10-74

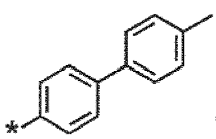
10-75

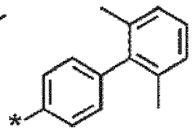
10-76

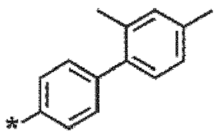
10-77

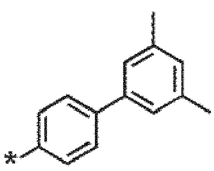
10-78

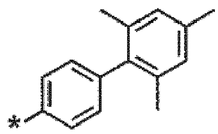
10-79

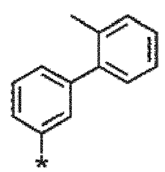
10-80

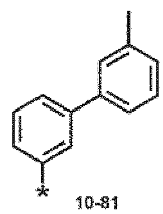
10-81

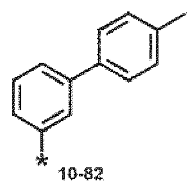
10-82

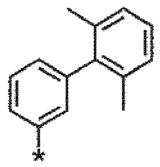
10-83

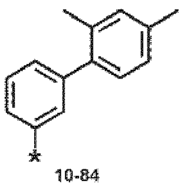
10-84

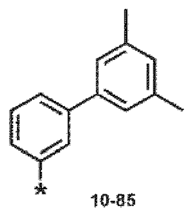
10-85

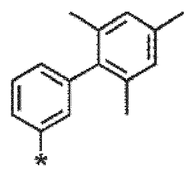
10-86

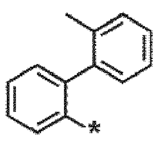
10-87

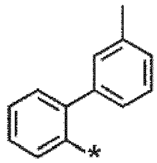
10-88

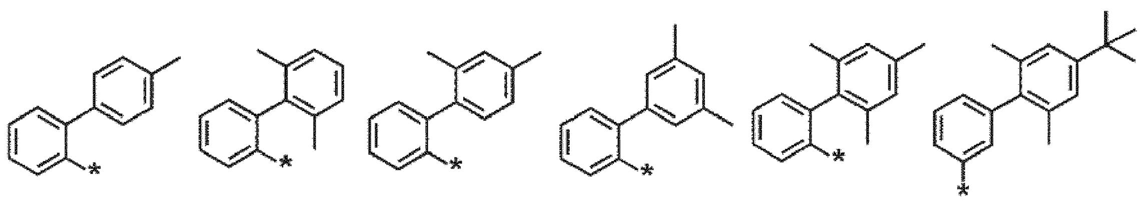
10-89 10-90 10-91 10-92 10-93 10-94

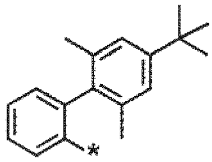
10-95

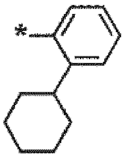
10-96

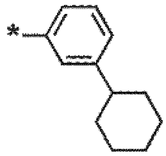
10-97

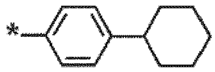
10-98

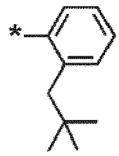
10-99

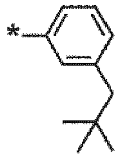
10-100

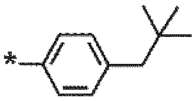
10-101

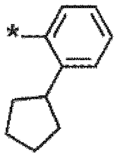
10-102

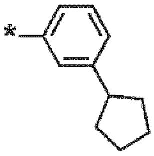
10-103

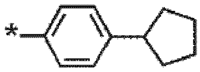
10-104

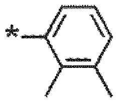
10-105

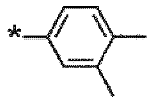
10-106

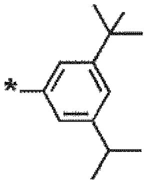
10-107

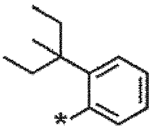
10-108

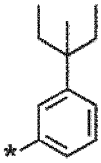
10-109

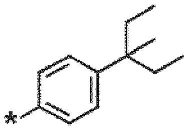
10-110

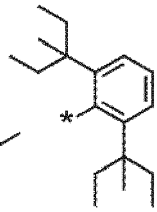
10-111

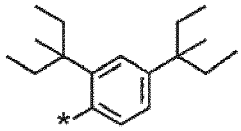
10-112

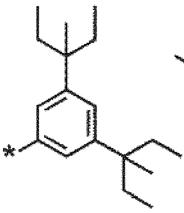
10-113

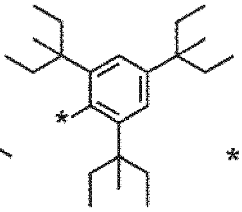
10-114

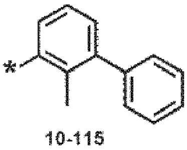
10-115

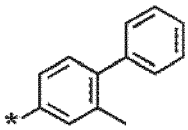
10-116

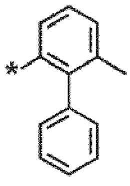
10-117

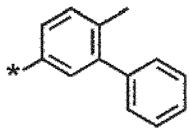
10-118

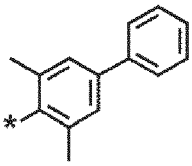
10-119

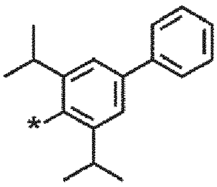
10-120

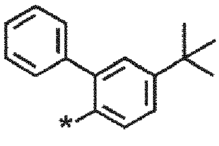
10-121

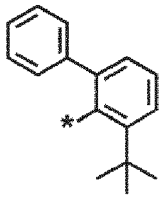
10-122

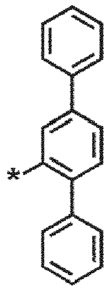
10-123

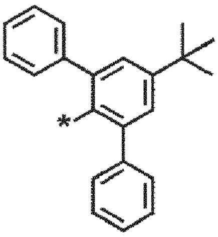
10-124

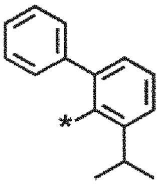
10-125

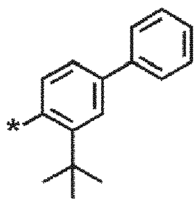
10-126

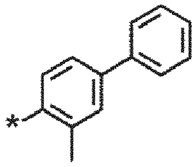
10-127

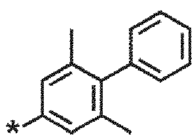
10-128

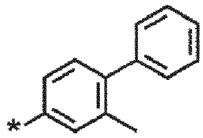

10-129

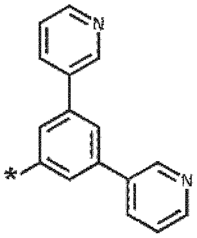

10-201

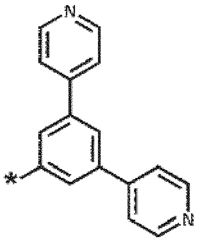

10-202

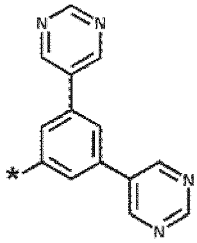

10-203

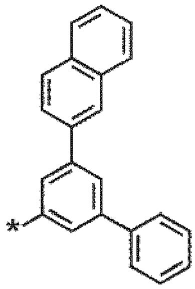

10-204

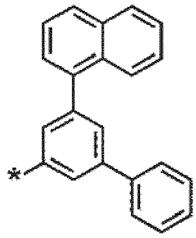

10-205

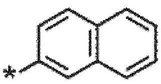

10-206

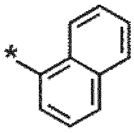

10-207

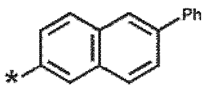

10-208

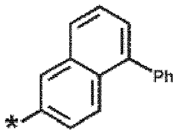

10-209

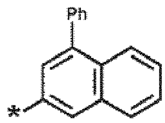

10-210

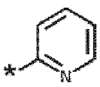

10-211

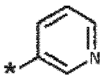

10-212

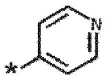

10-213

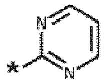

10-214

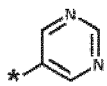

10-215

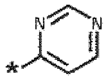

10-216

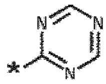

10-217

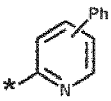

10-218

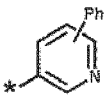

10-219

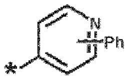

10-220

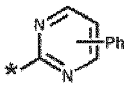

10-221

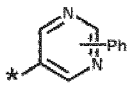

10-222

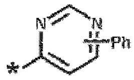

10-223

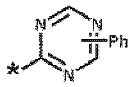

10-224

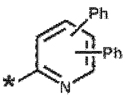

10-225

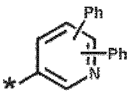

10-226

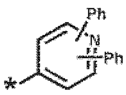

10-227

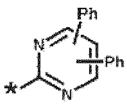

10-228

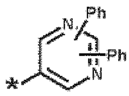

10-229

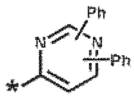

10-230

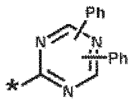

10-231

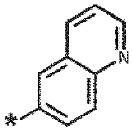

10-232

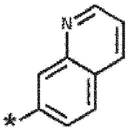

10-233

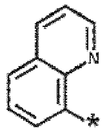

10-234

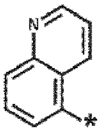

10-235

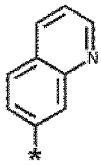

10-236

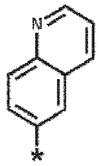

10-237

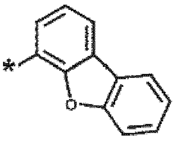
10-238

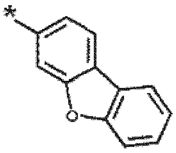
10-239

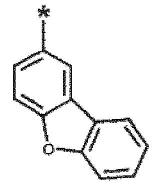
10-240

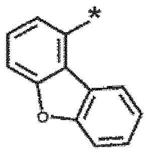
10-241

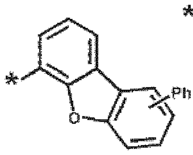
10-242

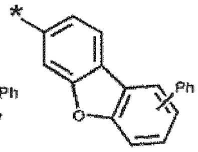
10-243

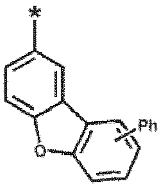
10-244

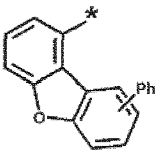
10-245

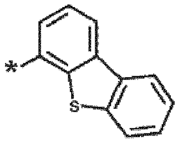
10-246

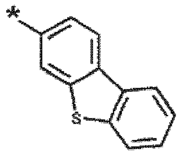
10-247

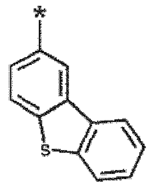
10-248

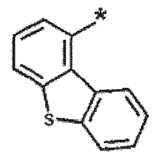
10-249

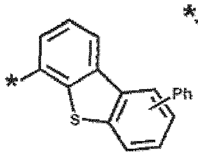
10-250

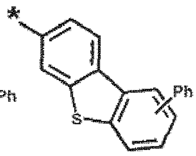
10-251

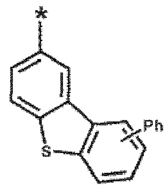
10-252

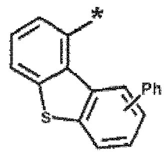
10-253

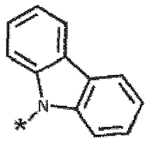
10-254

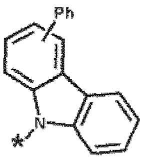
10-255

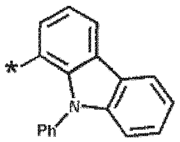
10-256

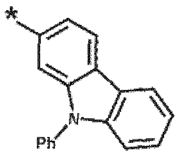
10-257

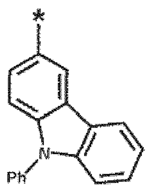
10-258

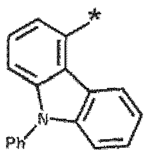
10-259

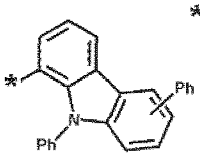
10-260

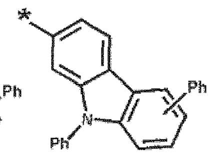
10-261

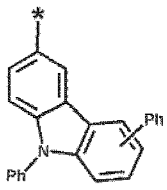
10-262

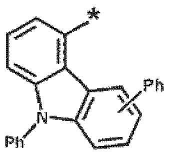
10-263

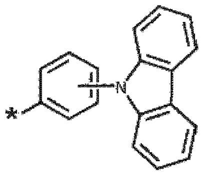
10-264

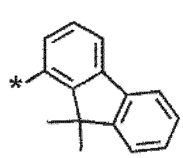
10-265

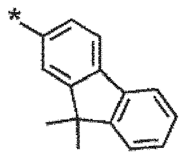
10-266

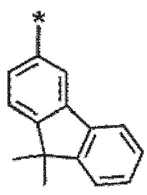
10-267

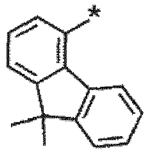
10-268

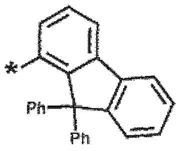
10-269

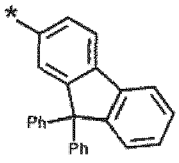
10-270

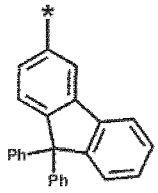
10-271

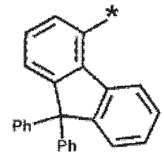
10-272

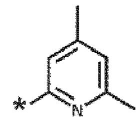
10-273
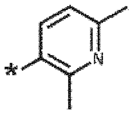
10-274
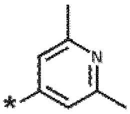
10-275
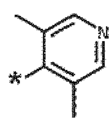
10-276
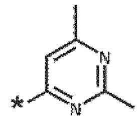
10-277
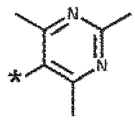
10-278
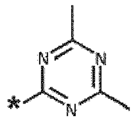
10-279

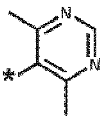
10-280
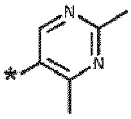
10-281
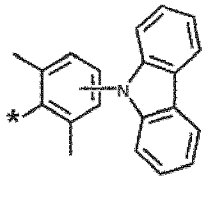
10-282
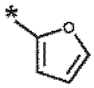
10-283
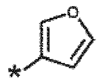
10-284
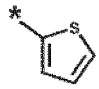
10-285
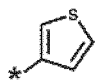
10-286

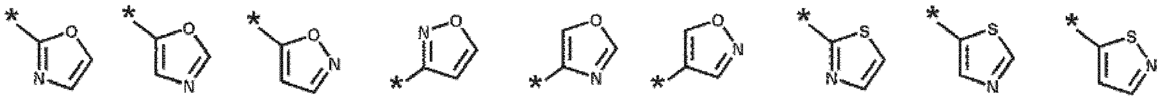
10-287 10-288 10-289 10-290 10-291 10-292 10-293 10-294 10-295

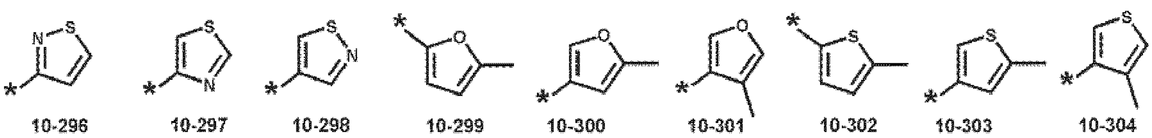
10-296 10-297 10-298 10-299 10-300 10-301 10-302 10-303 10-304

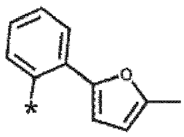
10-305
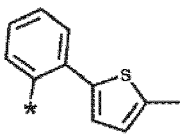
10-306
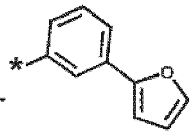
10-307
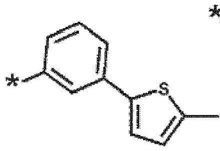
10-308
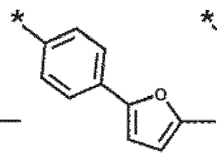
10-309
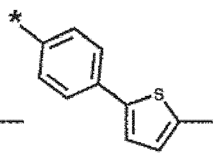
10-310

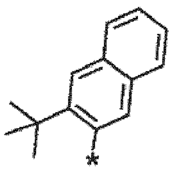
10-311
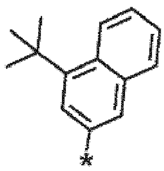
10-312
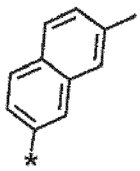
10-313
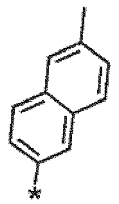
10-314
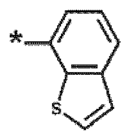
10-315
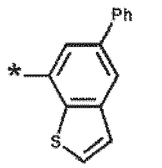
10-316
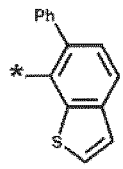
10-317

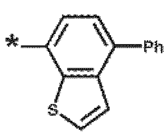
10-318
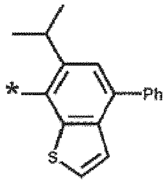
10-319
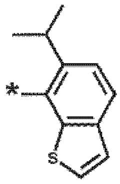
10-320
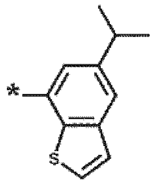
10-321
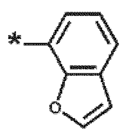
10-322
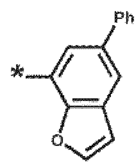
10-323
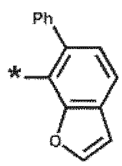
10-324

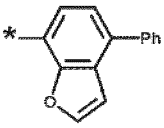 10-325
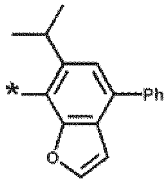 10-326
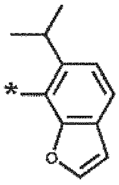 10-327
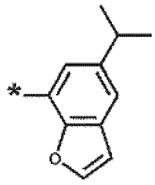 10-328
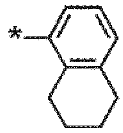 10-329
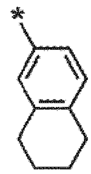 10-330
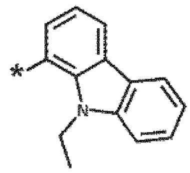 10-331

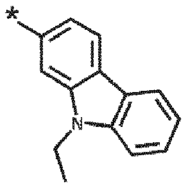 10-332
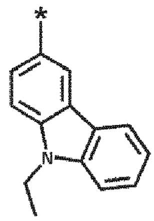 10-333
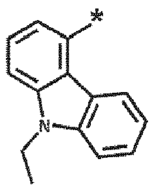 10-334
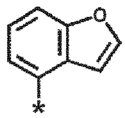 10-335
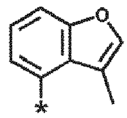 10-336
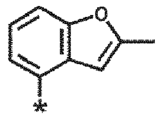 10-337

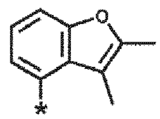 10-338
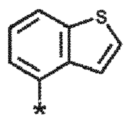 10-339
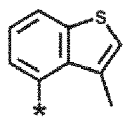 10-340
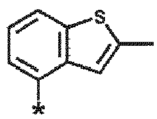 10-341
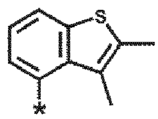 10-342
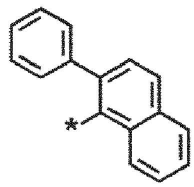 10-343

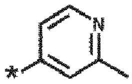 10-344
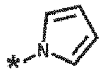 10-345
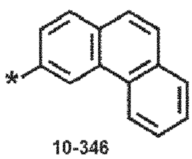 10-346
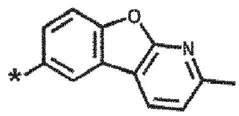 10-347
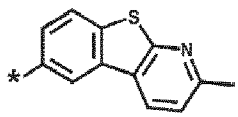 10-348

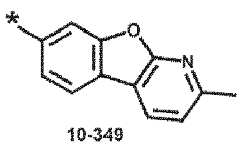 10-349
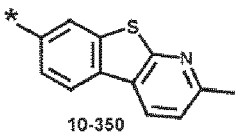 10-350

In Formulae 9-1 to 9-39, 9-201 to 9-237, 10-1 to 10-129, and 10-201 to 10-350, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 and 9-601 to 9-636:

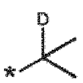 9-501
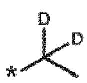 9-502
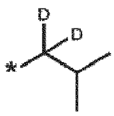 9-503
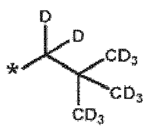 9-504
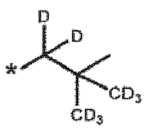 9-505
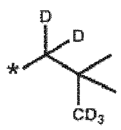 9-506
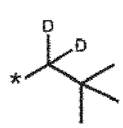 9-507

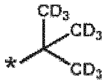 9-508
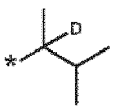 9-509
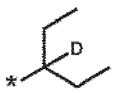 9-510
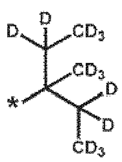 9-511
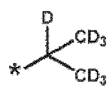 9-512
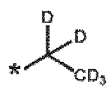 9-513
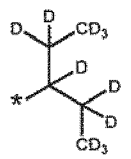 9-514

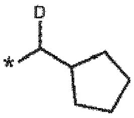
9-601
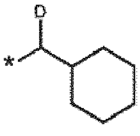
9-602
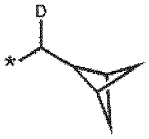
9-603
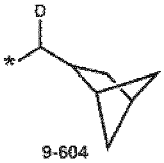
9-604
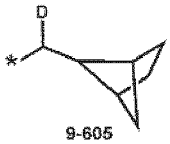
9-605
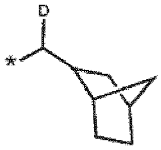
9-606
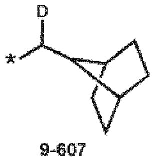
9-607

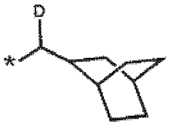
9-608
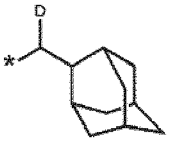
9-609
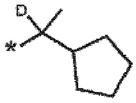
9-610
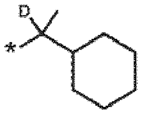
9-611
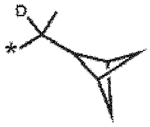
9-612
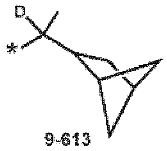
9-613

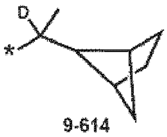
9-614
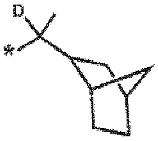
9-615
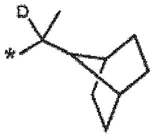
9-616
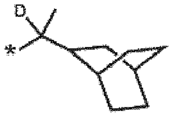
9-617
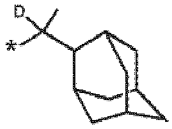
9-618
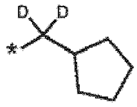
9-619

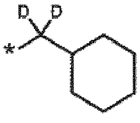
9-620
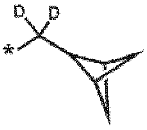
9-621
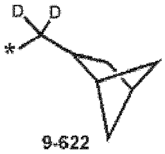
9-622
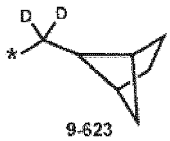
9-623
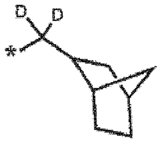
9-624
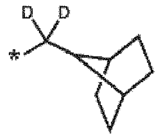
9-625

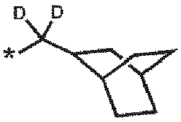
9-626
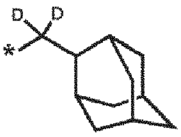
9-627
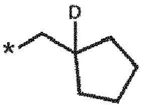
9-628
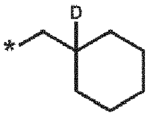
9-629
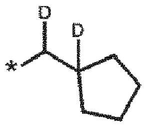
9-630
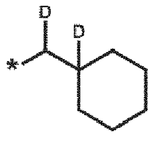
9-631

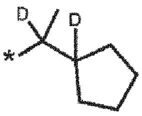
9-632
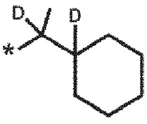
9-633
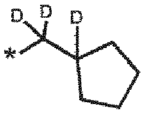
9-634
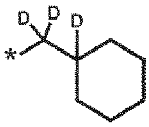
9-635
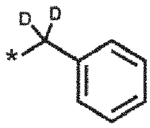
9-636

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

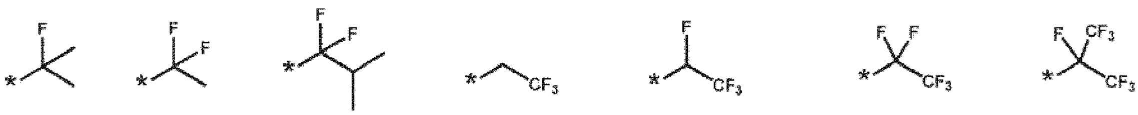
9-701 9-702 9-703 9-704 9-705 9-706 9-707

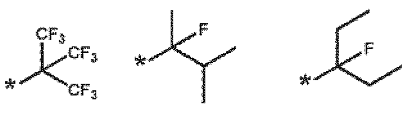
9-708 9-709 9-710

The "group in which at least one hydrogen in Formulae 10-1 to 10-129 is substituted with deuterium" and "the group in which at least one hydrogen in Formulae 10-201 to 10-350 is substituted with deuterium" may be, for example, a group represented by one of Formulae 10-501 to 10-553:

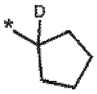
10-501

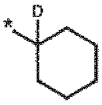
10-502

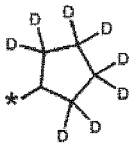
10-503

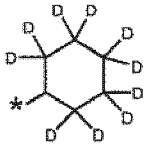
10-504

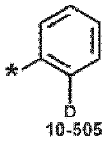
10-505

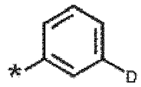
10-506

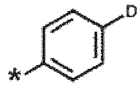
10-507

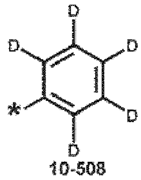
10-508

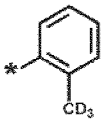
10-509

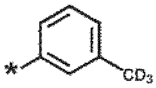
10-510

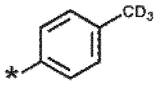
10-511

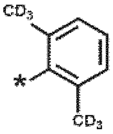
10-512

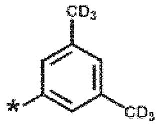
10-513

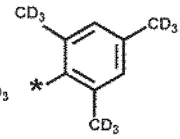
10-514

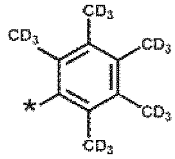
10-515

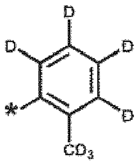
10-516

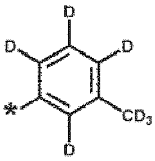
10-517

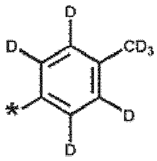
10-518

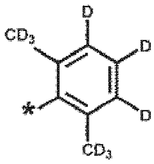
10-519

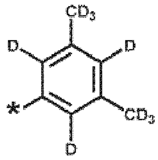
10-520

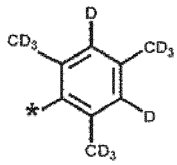
10-521

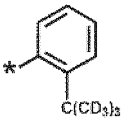
10-522

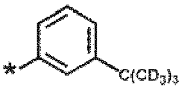
10-523

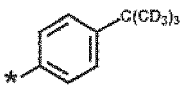
10-524

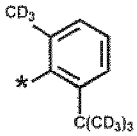
10-525

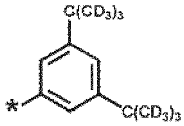
10-526

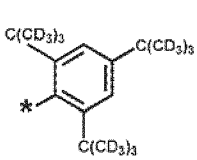
10-527

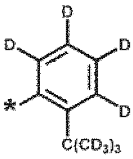
10-528

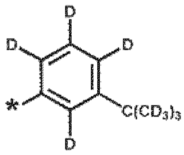
10-529

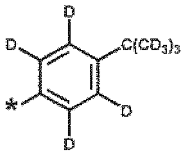
10-530

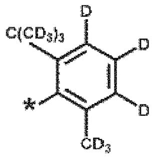
10-531

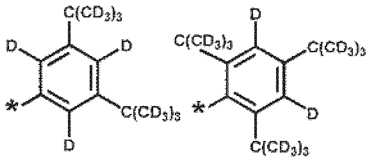
10-532

10-533

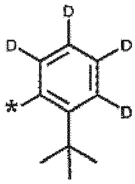
10-534

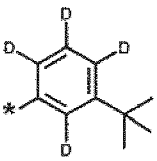
10-535

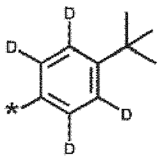
10-536

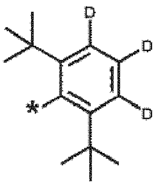
10-537

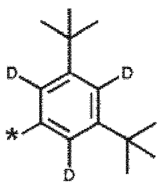
10-538

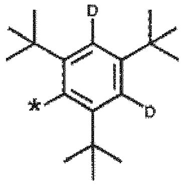
10-540

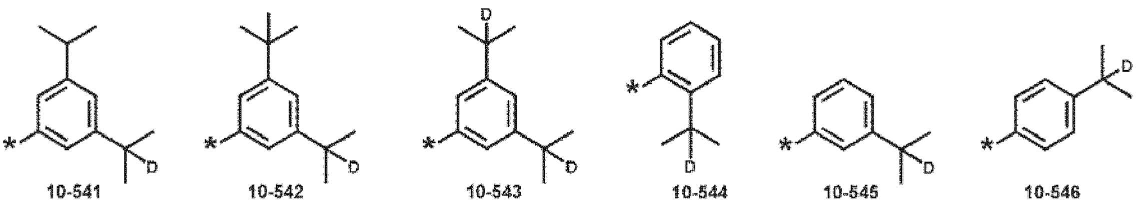
10-541

10-542

10-543

10-544

10-545

10-546

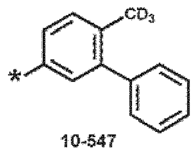
10-547

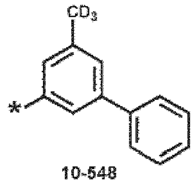
10-548

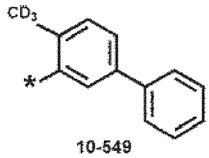
10-549

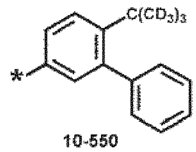
10-550

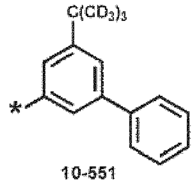
10-551

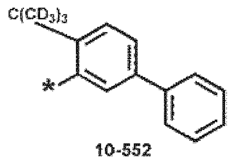
10-552

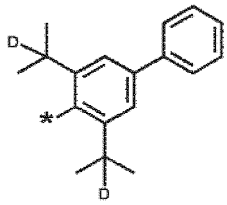
10-553

The "group in which at least one hydrogen in Formulae 10-1 to 10-129 is substituted with -F" and "the group in which at least one hydrogen in Formulae 10-201 to 10-350 is substituted with -F" may be, for example, a group represented by one of Formulae 10-601 to 10-617:

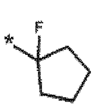
10-601

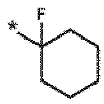
10-602

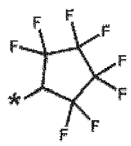
10-603

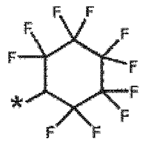
10-604

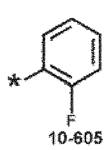
10-605

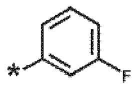
10-606

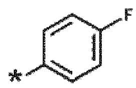
10-607

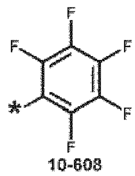
10-608

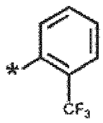
10-609

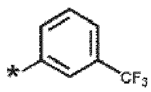
10-610

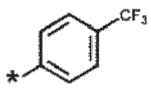
10-611

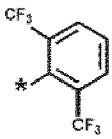
10-612

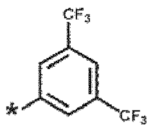
10-613

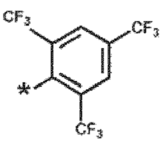
10-614

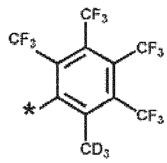
10-615

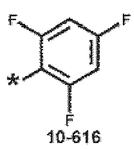
10-616

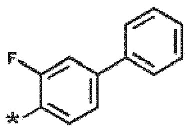
10-617

In Formulae 1, 2-1, and 2-2, c1 to c4 indicate the number of $R_1$(s) to the number of $R_4$(s), respectively; a1 to a4 indicate the number of groups represented by $*\text{-}[(L_1)_{b1}\text{-}(R_1)_{c1}]$, the number of groups represented by $*\text{-}[(L_2)_{b2}\text{-}(R_2)_{c2}]$, the number of groups represented by $*\text{-}[(L_3)_{b3}\text{-}(R_3)_{c3}]$, and the number of groups represented by $*\text{-}[(L_4)_{b4}\text{-}(R_4)_{c4}]$, respectively; e1 to e4 indicate the number of $Z_1$(s) to the number of $Z_4$(s), respectively; and d1 to d4 indicate the number of a group(s) represented by $*\text{-}[W_1\text{-}(Z_1)_{e1}]$, the number of groups represented by $*\text{-}[W_2\text{-}(Z_2)_{e2}]$, the number of groups represented by $*\text{-}[W_3\text{-}(Z_3)_{e3}]$, and the number of groups represented by $*\text{-}[W_4\text{-}(Z_4)_{e4}]$, respectively, and c1 to c4, a1 to a4, e1 to e4, and d1 to d4 may each independently be an integer from 0 to 20. When c1 is 2 or more, two or more $R_1$(s) may be identical to or different from each other, when c2 is 2 or more, two or more $R_2$(s) may be identical to or different from each other, when c3 is 2 or more, two or more $R_3$(s) may be identical to or different from each other, when c4 is 2 or more, two or more $R_4$(s) may be identical to or different from each other, when a1 is 2 or more, two or more groups represented by $*\text{-}[(L_1)_{b1}\text{-}(R_1)_{c1}]$ may be identical to or different from each other, when a2 is 2 or more, two or more groups represented by $*\text{-}[(L_2)_{b2}\text{-}(R_2)_{c2}]$ may be identical to or different from each other, when a3 is 2 or more, two or more groups represented by $*\text{-}[(L_3)_{b3}\text{-}(R_3)_{c3}]$ may be identical to or different from each other, when a4 is 2 or more, two or more groups represented by $*\text{-}[(L_4)_{b4}\text{-}(R_1)_{c4}]$ may be identical to or different from each other, when e1 is 2 or more, two or more $Z_1$(s) may be identical to or different from each other, when e2 is 2 or more, two or more $Z_2$(s) may be identical to or different from each other, when e3 is 2 or more, two or more $Z_3$(s) may be identical to or different from each other, when e4 is 2 or more, two or more $Z_4$(s) may be identical to or different from each other, when d1 is 2 or

more, two or more groups represented by *-[$W_1$-$(Z_1)_{e1}$] may be identical to or different from each other, when d2 is 2 or more, two or more groups represented by*-[$W_2$-$(Z_2)_{e2}$] may be identical to or different from each other, when d3 is 2 or more, two or more groups represented by *-[$W_3$-$(Z_3)_{e3}$] may be identical to or different from each other, and when d4 is 2 or more, two or more groups represented by *-[$W_4$-$(Z_4)_{e1}$] may be identical to or different from each other. For example, in Formulae 1, 2-1, and 2-2, c1 to c4, a1 to a4, e1 to e4, and d1 to d4 may each independently be 0, 1, 2, or 3.

In one or more embodiments, in Formula 2-1, a case where $Y_1$ is N, ring $A_1$ is a pyridine group, $Y_2$ is C, ring $A_2$ is a benzene group, and each of d1 and d2 is 0 may be excluded.

In Formulae 1, 2-1, and 2-2, two or more substituents in at least one of i) two or more of a plurality of $R_1$(s), ii) two or more of a plurality of $R_2$(s), iii) two or more of a plurality of $R_3$(s), iv) two or more of a plurality of $R_4$(s), v) $R_{5a}$ and $R_{5b}$, vi) two or more of a plurality of $Z_1$(s), vii) two or more of a plurality of $Z_2$(s), viii) two or more of a plurality of $Z_3$(s), ix) two or more of a plurality of $Z_4$(s), x) two or more of $R_1$ to $R_4$, $R_{5a}$, and $R_{5b}$, and xi) two or more of $Z_1$ to $Z_4$ may optionally be linked to each other to form a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$.

$R_{10a}$ may be as described in connection with $R_1$.

The symbols * and *' as used herein each indicate a binding site to a neighboring atom, unless otherwise stated.

In one or more embodiments, in Formula 1, n1 may not be 0, n4 may be 0, and a group represented by

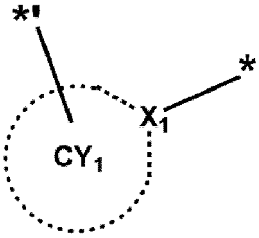

may be a group represented by one of Formulae $CY_1(1)$ to $CY_1(23)$:

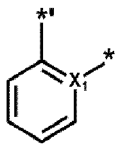
CY1(1)

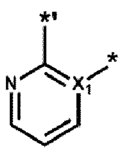
CY1(2)

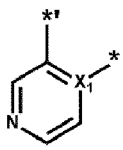
CY1(3)

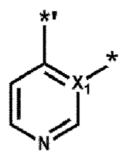
CY1(4)

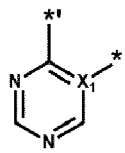
CY1(5)

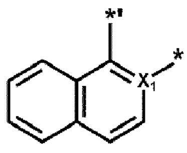
CY1(6)

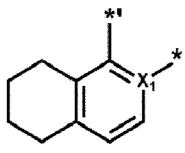
CY1(7)

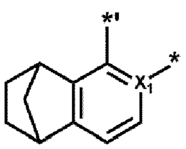
CY1(8)

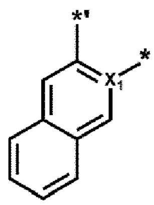
CY1(9)

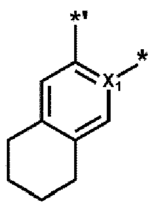
CY1(10)

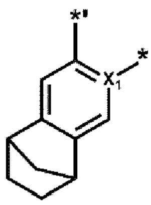
CY1(11)

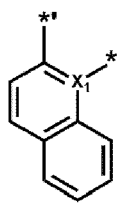
CY1(12)

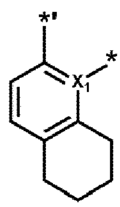
CY1(13)

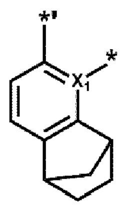
CY1(14)

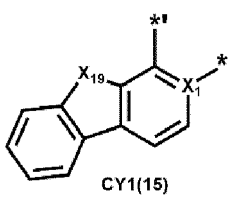
CY1(15)

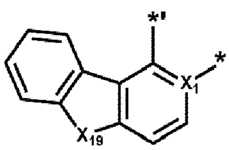
CY1(16)

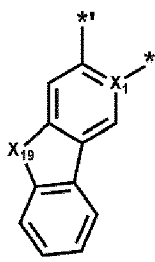
CY1(17)

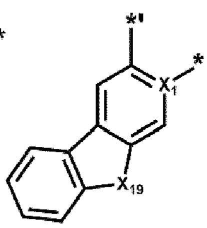
CY1(18)

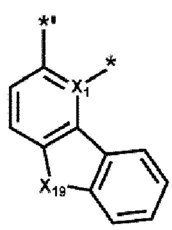
CY1(19)

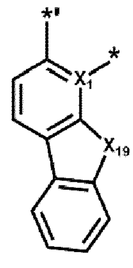
CY1(20)

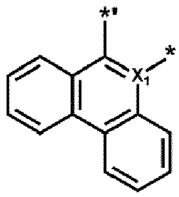
CY1(21)

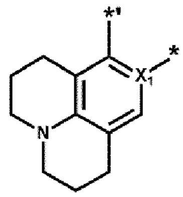
CY1(22)

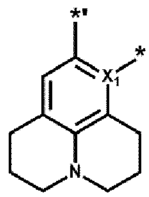
CY1(23)

wherein, in Formulae CY1(1) to CY1(23),

$X_1$ is as described above,
$X_{19}$ may be *-O-*', *-S-*', *-Se-*', *-N($R_{19a}$)-*', *-C($R_{19a}$)($R_{19b}$)-*', or *-Si($R_{19a}$)($R_{19b}$)-*',
$R_{19a}$ and $R_{19b}$ may each be as described in connection with $R_1$,
* indicates a binding site to $X_5$ in Formula 1, and
*' indicates a binding site to $T_{11}$ in Formula 1.

In one or more embodiments, in Formula 1, n1 may be 1, n4 may be 0, and a group represented by

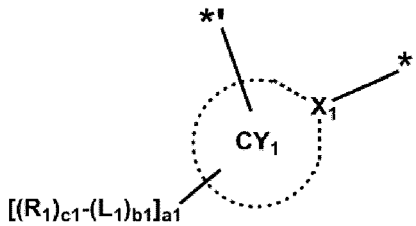

may be a group represented by one of Formulae CY1-1 to CY1-18:

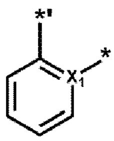
CY1-1

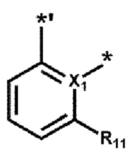
CY1-2

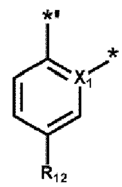
CY1-3

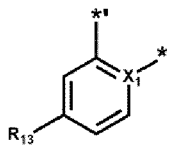
CY1-4

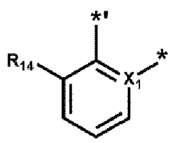
CY1-5

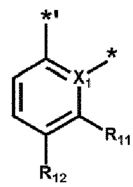
CY1-6

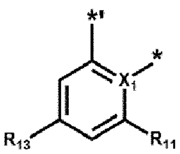
CY1-7

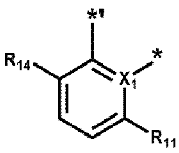
CY1-8

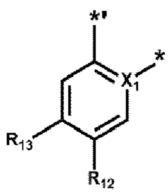
CY1-9

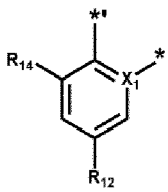
CY1-10

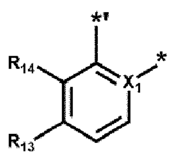
CY1-11

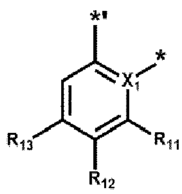
CY1-12

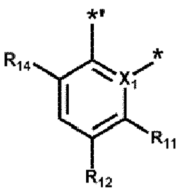
CY1-13

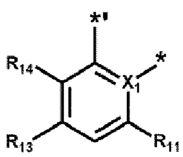
CY1-14

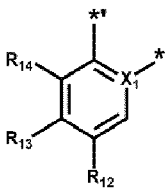
CY1-15

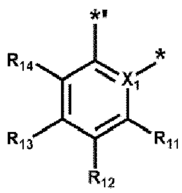
CY1-16

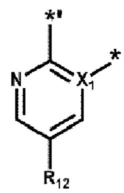
CY1-17

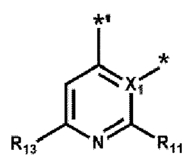
CY1-18

wherein, in Formulae CY1-1 to CY1-18,

$X_1$ is as described above,
$R_{11}$ to $R_{14}$ may each be the same as described in connection with $R_1$, and each of $R_{11}$ to $R_{14}$ may not be hydrogen,

* indicates a binding site to $X_5$ in Formula 1, and
*' indicates a binding site to $T_{11}$ in Formula 1.

In one or more embodiments, in Formula 1, n1 and n2 may each be 1, and ring $CY_2$ may be a group represented by Formula CY2A or CY2B:

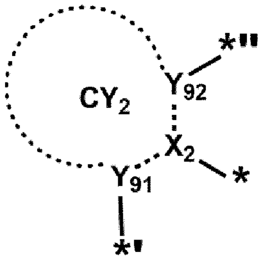

CY2A

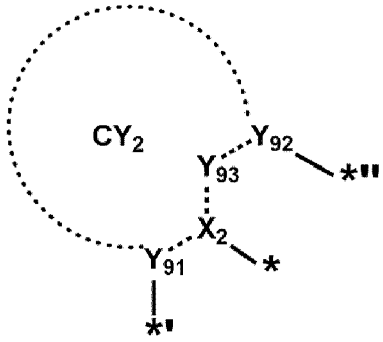

CY2B

wherein, in Formulae CY2A and CY2B,

$X_2$ and $CY_2$ may each be as described herein,
$Y_{91}$ to $Y_{93}$ may each independently be *-O-*', *-S-*', *-N-*', *-C-*', or *-Si-*',
in Formula CY2A, a bond between $X_2$ and $Y_{91}$, a bond between $X_2$ and Y92, a bond between $X_2$ and $Y_{93}$, and a bond between $Y_{22}$ and $Y_{93}$ may each be a chemical bond,
*' indicates a binding site to $T_{11}$ in Formula 1,
* indicates a binding site to $M_1$ in Formula 1, and
*" indicates a binding site to $T_{12}$ in Formula 1.

In one or more embodiments, in Formula 1, each of n1 and n2 may not be 0, and a group represented by

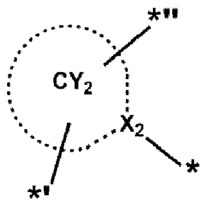

may be a group represented by one of Formulae CY2(1) to CY2(21):

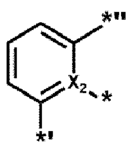

CY2(1)

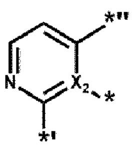

CY2(2)

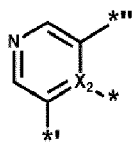

CY2(3)

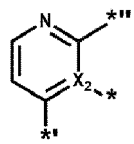

CY2(4)

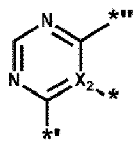

CY2(5)

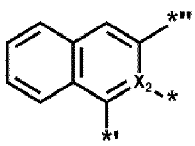

CY2(6)

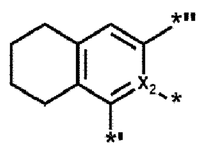

CY2(7)

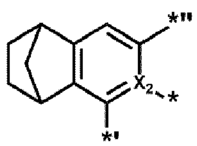

CY2(8)

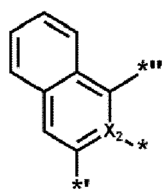

CY2(9)

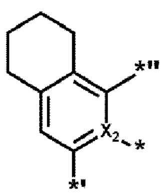

CY2(10)

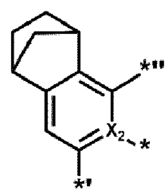

CY2(11)

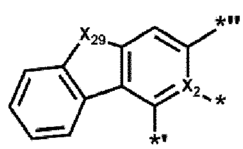

CY2(12)

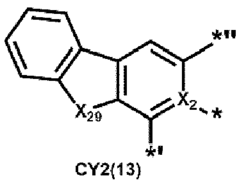
CY2(13)
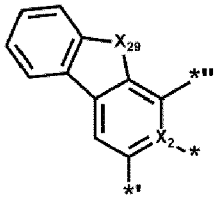
CY2(14)
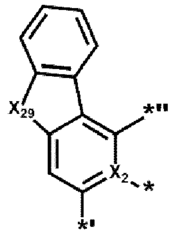
CY2(15)
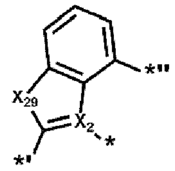
CY2(16)
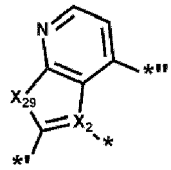
CY2(17)

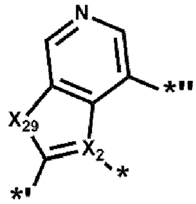
CY2(18)
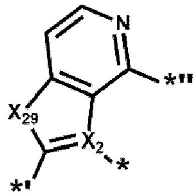
CY2(19)
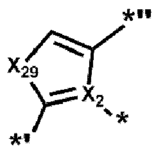
CY2(20)
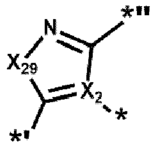
CY2(21)

wherein, in Formulae CY2(1) to CY2(21),

$X_2$ is as described in the present specification,
X29 may be O, S, N-[(L2)b2-(R2)c2], C(R29a)(R29b), or Si(R29a)(R29b),
$L_2$, b2, $R_2$, and c2 may each be the same as described herein,
$R_{29a}$ and $R_{29b}$ may each be the same as described in connection with $R_2$,
*' indicates a binding site to $T_{11}$ in Formula 1,
* indicates a binding site to $M_1$ in Formula 1,
*" indicates a binding site to $T_{12}$ in Formula 1.

In one or more embodiments, in Formula 1, each of n1 and n2 may be 1, and a group represented by

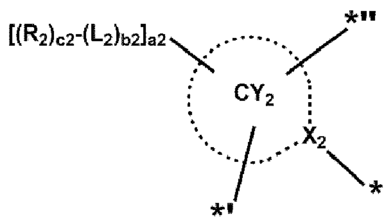

may be a group represented by one of Formulae CY2-1 to CY2-16:

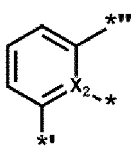
CY2-1
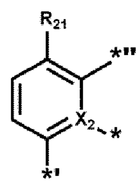
CY2-2
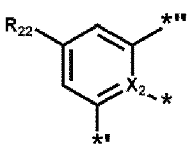
CY2-3
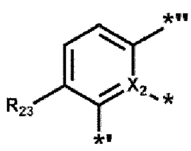
CY2-4
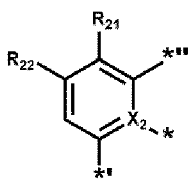
CY2-5
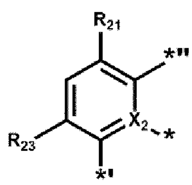
CY2-6

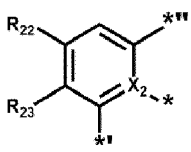
CY2-7

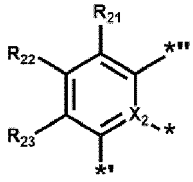
CY2-8

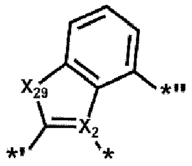
CY2-9

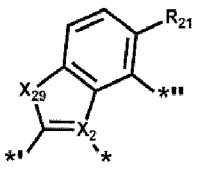
CY2-10

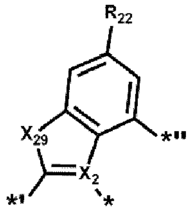
CY2-11

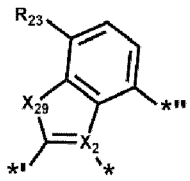
CY2-12

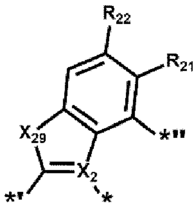
CY2-13

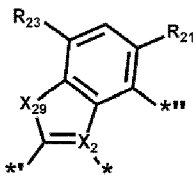
CY2-14

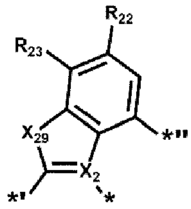
CY2-15

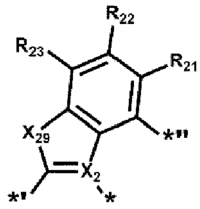
CY2-16

wherein, in Formulae CY2-1 to CY2-16,

$X_2$ is the same as described in the present specification,
X29 may be O, S, N-[(L2)b2-(R2)c2], C(R29a)(R29b), or Si(R29a)(R29b),
$L_2$, b2, $R_2$, and c2 may each be the same as described herein,
$R_{21}$ to $R_{23}$, $R_{29a}$, and $R_{29b}$ may each be the same as described in connection with $R_2$, wherein each of $R_{21}$ to $R_{23}$ may not be hydrogen,
*' indicates a binding site to $T_{11}$ in Formula 1,
* indicates a binding site to $M_1$ in Formula 1,
*" indicates a binding site to $T_{12}$ in Formula 1.

In one or more embodiments, in Formula 1,

each of n1 and n2 may be 1,
a group represented by

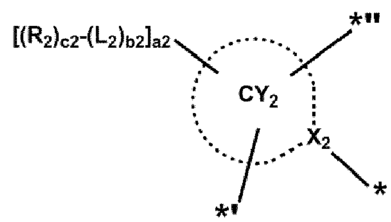

may be represented by one of Formulae CY2-9 to CY2-16,
$X_{29}$ in Formulae CY2-9 to CY2-16 may be N-$[(L_2)_{b2}$-$(R_2)_{c2}]$,
$L_2$ may be a benzene group unsubstituted or substituted with at least one $R_{10a}$,
b2 may be 1 or 2,
c2 may be 2, and

a) one of two $R_2$(s) may be a phenyl group unsubstituted or substituted with at least one of deuterium, a $C_1$-$C_{20}$ alkyl group, a phenyl group, a deuterated phenyl group, a ($C_1$-$C_{20}$ alkyl)phenyl group, or a combination thereof, and b) the other $R_2$ may be a $C_4$-$C_{20}$ alkyl group or a deuterated $C_1$-$C_{20}$ alkyl group, each unsubstituted or substituted with at least one $C_3$-$C_{10}$ cycloalkyl group.

In one or more embodiments, in Formula 1, each of n2 and n3 may not be 0, and a group represented by

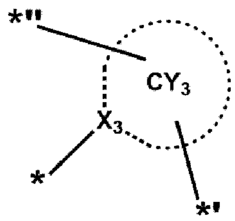

may be a group represented by one of Formulae CY3(1) to CY3(15):

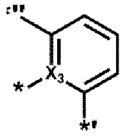
CY3(1)
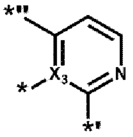
CY3(2)
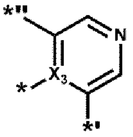
CY3(3)
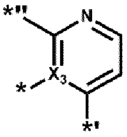
CY3(4)
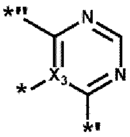
CY3(5)
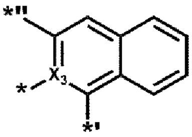
CY3(6)
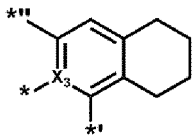
CY3(7)

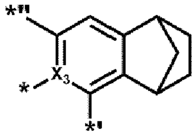
CY3(8)
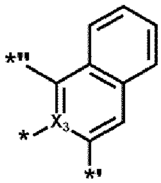
CY3(9)
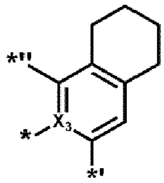
CY3(10)
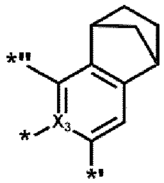
CY3(11)
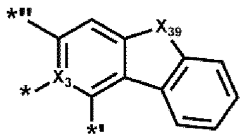
CY3(12)

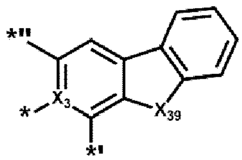
CY3(13)
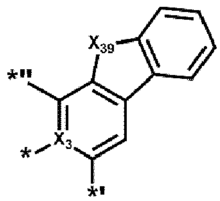
CY3(14)
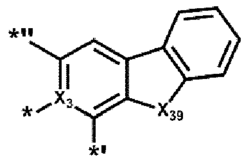
CY3(15)

wherein, in Formulae CY3(1) to CY3(15),

$X_3$ is the same as described in the present specification,
X39 may be O, S, N(Z39a), C(R39a)(R39b), or Si(R39a)(R39b),
$R_{39a}$ and $R_{39b}$ may each be the same as described in connection with $R_3$,
*" indicates a binding site to $T_{12}$ in Formula 1,
* indicates a binding site to $M_1$ in Formula 1,
* indicates a binding site to $T_{13}$ in Formula 1.

In one or more embodiments, in Formula 1, each of n2 and n3 may be 1, and a group represented by

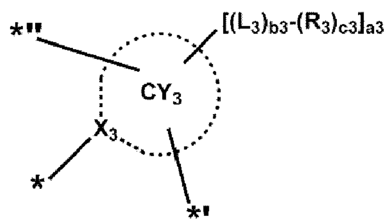

may be a group represented by one of Formulae CY3-1 to CY3-13:

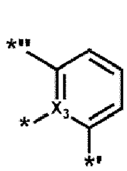
CY3-1
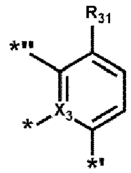
CY3-2
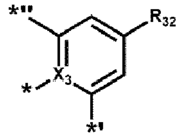
CY3-3
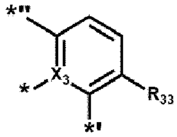
CY3-4
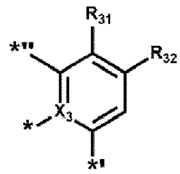
CY3-5
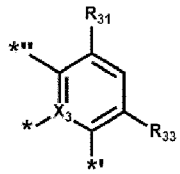
CY3-6

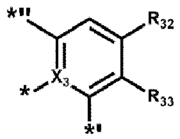
CY3-7
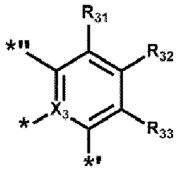
CY3-8
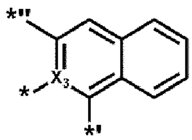
CY3-8
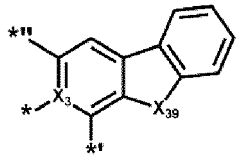
CY3-9
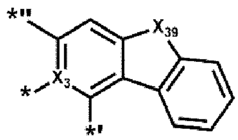
CY3-10

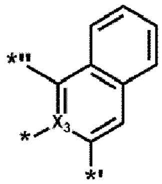
CY3-11
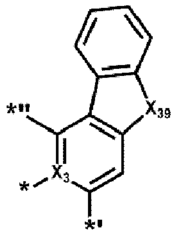
CY3-12
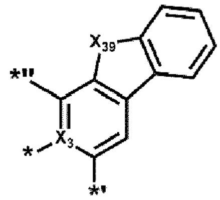
CY3-13

wherein, in Formulae CY3-1 to CY3-31,

$X_3$ is the same as described in the present specification,
X39 may be O, S, N-[(L3)b3-(R3)c3], $C(R_{39a})(R_{39b})$, or $Si(R_{39a})(R_{39b})$,
$L_3$, b3, $R_3$, and c3 may each be the same as described herein,
$R_{31}$ to $R_{33}$, $R_{39a}$, and $R_{39b}$ may each be the same as described in connection with $R_3$, wherein each of $R_{31}$ to $R_{33}$ may not be hydrogen,
*" indicates a binding site to $T_{12}$ in Formula 1,
* indicates a binding site to $M_1$ in Formula 1,
*' indicates a binding site to $T_{13}$ in Formula 1.

In one or more embodiments, in Formula 1, n3 may not be 0, n4 may be 0, and a group represented by

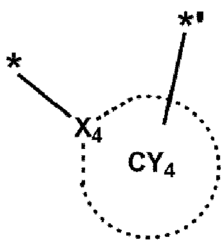

may be a group represented by one of Formulae CY4(1) to CY4(20):

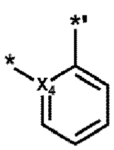
CY4(1)
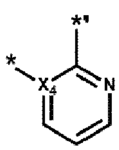
CY4(2)
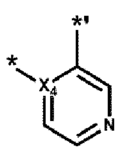
CY4(3)
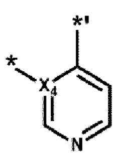
CY4(4)
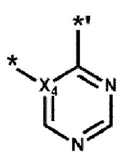
CY4(5)
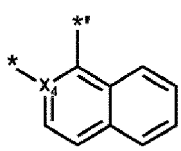
CY4(6)
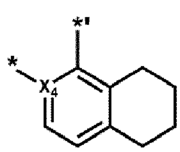
CY4(7)

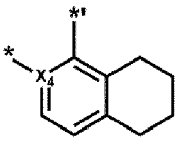
CY4(8)
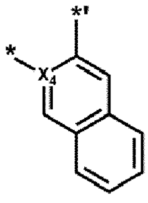
CY4(9)
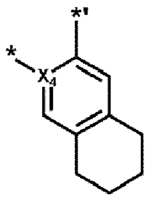
CY4(10)
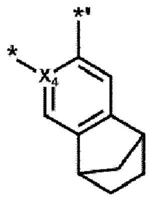
CY4(11)
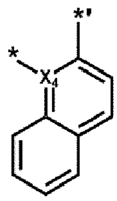
CY4(12)
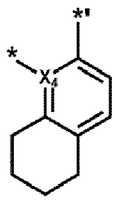
CY4(13)
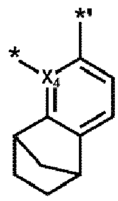
CY4(14)

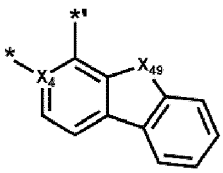
CY4(15)
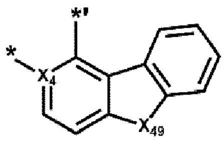
CY4(16)
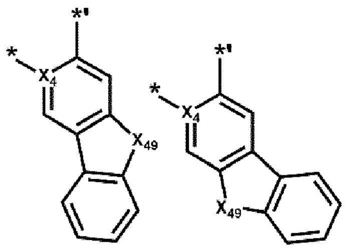
CY4(17) CY4(18)
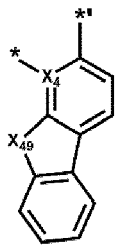
CY4(19)
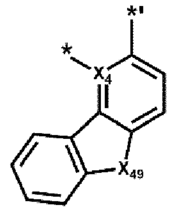
CY4(20)

wherein, in Formulae CY4(1) to CY4(20),

$X_4$ is the same as described in the present specification,
$X_{49}$ may be O, S, N(R49a), C(R49a)(R49b), or Si(R49a)(R49b),
$R_{49a}$ and $R_{49b}$ may each be the same as described in connection with $R_4$,
*' indicates a binding site to $T_{13}$ in Formula 1, and
* indicates a binding site to $M_1$ in Formula 1.

In one or more embodiments, in Formula 1, n3 may be 1, n4 may be 0, and a group represented by

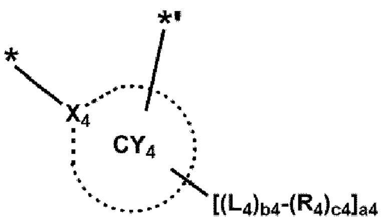

may be a group represented by one of Formulae CY4-1 to CY4-16:

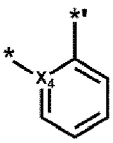
CY4-1
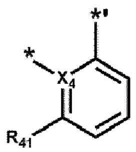
CY4-2
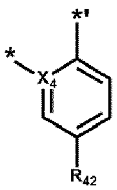
CY4-3
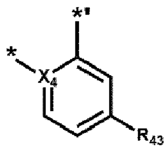
CY4-4
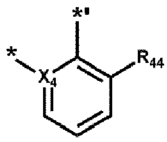
CY4-5
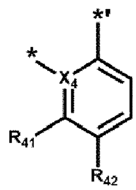
CY4-6

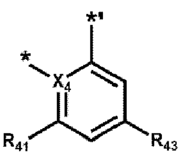
CY4-7
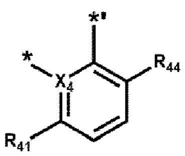
CY4-8
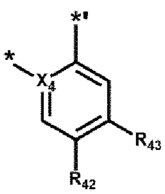
CY4-9
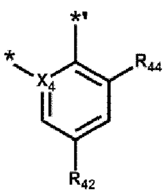
CY4-10
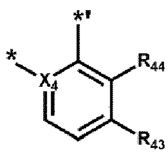
CY4-11
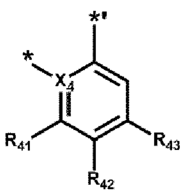
CY4-12

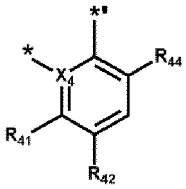

CY4-13

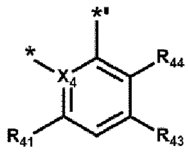

CY4-14

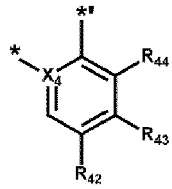

CY4-15

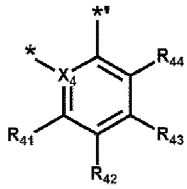

CY4-16

wherein, in Formulae CY4-1 to CY4-16,

$X_4$ is the same as described in the present specification,
$R_{41}$ to $R_{44}$ may each be the same as described in connection with $R_4$, and each of $R_{41}$ to $R_{44}$ may not be hydrogen,
*' indicates a binding site to $T_{13}$ in Formula 1, and
* indicates a binding site to $M_1$ in Formula 1.

In one or more embodiments, the platinum-containing organometallic compound may be a compound represented by one of Formulae 1-1 to 1-3:

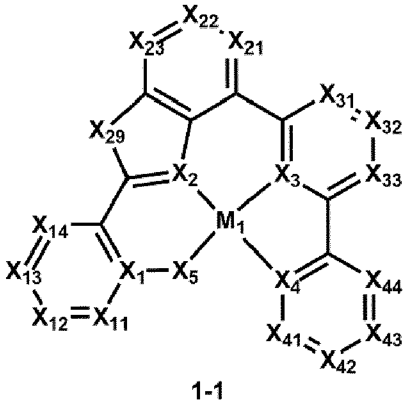

1-1

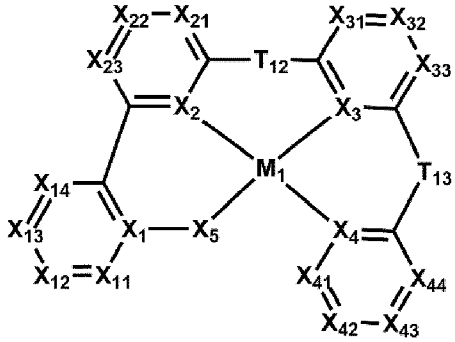

1-2

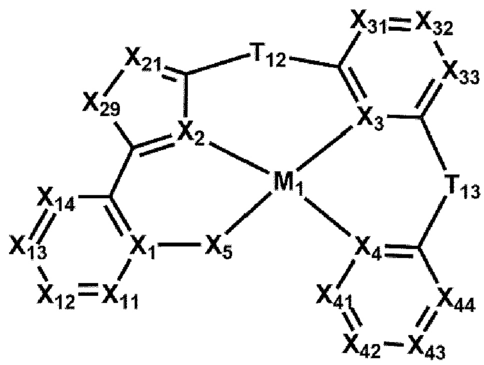

1-3

wherein, in Formulae 1-1 to 1-3,

$M_1$, $X_1$ to Xs, $T_{12}$, and $T_{13}$ may each be the same as described herein,
$X_{11}$ may be N or $C(R_{11})$, $X_{12}$ may be N or $C(R_{12})$, $X_{13}$ may be N or $C(R_{13})$, and $X_{14}$ may be N or $C(R_{14})$,
$R_{11}$ to $R_{14}$ may each be the same as described in connection with $R_1$,
two or more of $R_{11}$ to $R_{14}$ may optionally be linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$X_{21}$ may be N or $C(R_{21})$, $X_{22}$ may be N or $C(R_{22})$, and $X_{23}$ may be N or $C(R_{23})$,
X29 may be O, S, N-$[(L_2)_{b2}$-$(R_2)_{c2}]$, $C(R_{29a})(R_{29b})$, or $Si(R_{29a})(R_{29b})$,
$L_2$, b2, $R_2$, and c2 may each be the same as described herein,
$R_{21}$ to $R_{23}$, $R_{29a}$, and $R_{29b}$ may each be the same as described in connection with $R_2$,
two or more of $R_{21}$ to $R_{23}$ may optionally be linked to each other to form a $C_5$-$C_{30}$ carbocyclic group unsubstituted

or substituted with at least one $R_{10a}$, or a $C_1$-$C_{30}$ heterocyclic group unsubstituted or substituted with at least one $R_{10a}$,
$X_{31}$ may be N or C($R_{31}$), $X_{32}$ may be N or C($R_{32}$), and $X_{33}$ may be N or C(R33),
$R_{31}$ to $R_{33}$ may each be the same as described in connection with $R_3$,
two or more of $R_{31}$ to $R_{33}$ may optionally be linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$X_{41}$ may be N or C($R_{41}$), $X_{42}$ may be N or C($R_{42}$), $X_{43}$ may be N or C($R_{43}$), and $X_{44}$ may be N or C($R_{44}$),
$R_{41}$ to $R_{44}$ may each be the same as described in connection with $R_4$, and
two or more of $R_{41}$ to $R_{44}$ may optionally be linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

In one or more embodiments,

$Y_1$ in Formula 2-1 may be N, and
a group represented by

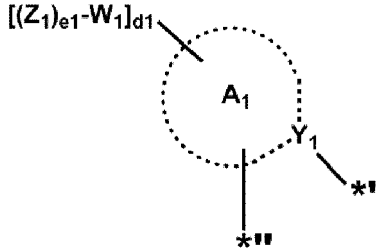

in Formula 2-1 may be a group represented by one of Formulae A1-1 to A1-3:

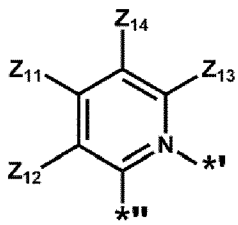
A1-1

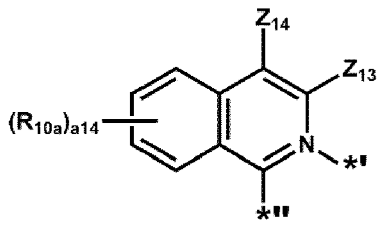
A1-2

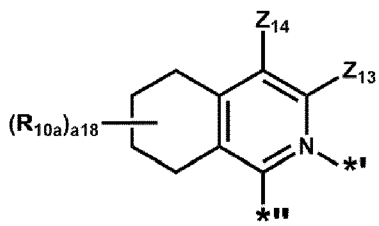
A1-3

wherein, in Formulae A1-1 to A1-3,
$Z_{11}$ to $Z_{14}$ may each be the same as described in connection with $Z_1$,
$R_{10a}$ may be understood by referring to the description of $R_{10a}$ provided herein, and
a14 may be an integer from 0 to 4,
a18 may be an integer from 0 to 8,
*' indicates a binding site to $M_2$ in Formula 2, and
*" indicates a binding site to ring $A_2$.

For example, in Formulae A1-1 to A1-3, $Z_{14}$ may be a deuterated $C_1$-$C_{20}$ alkyl group, -Si($Q_3$)($Q_4$)($Q_5$), or -Ge($Q_3$)($Q_4$)($Q_5$).
In one or more embodiments,

$Y_3$ in Formula 2-2 may be N, and
a group represented by

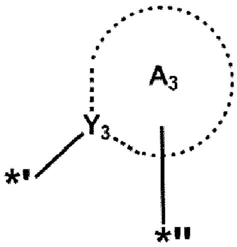

in Formula 2-2 may be a group represented by one of Formulae NR1 to NR48:

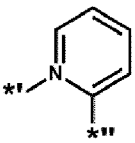
NR1

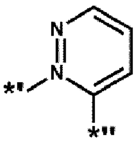
NR2

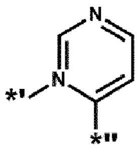
NR3

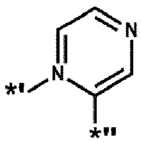
NR4

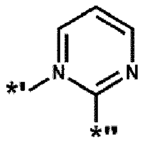
NR5

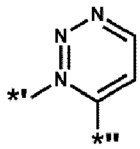
NR6

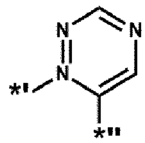
NR7

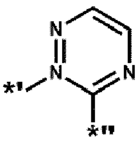
NR8

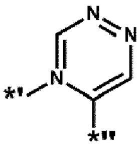
NR9

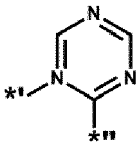
RN10

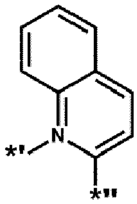
NR11

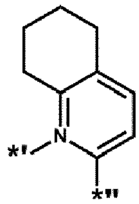
NR12

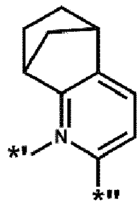
NR13

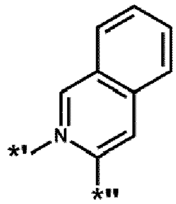
NR14

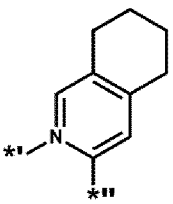
NR15

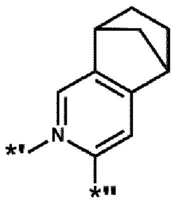
NR16

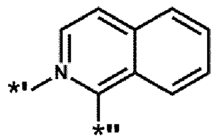
NR17

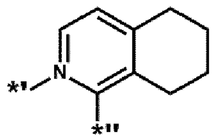
NR18

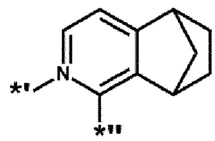
NR19

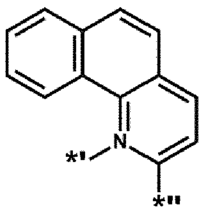
NR20

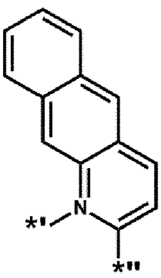
NR21

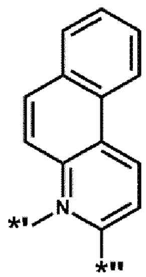
NR22

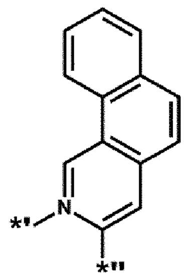
NR23

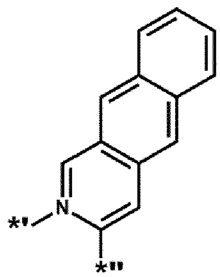
NR24

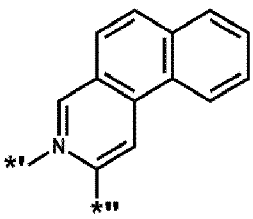
NR25

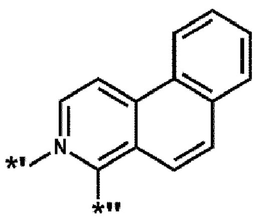
NR26

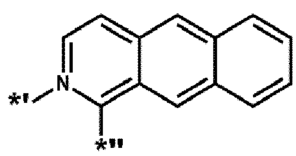
NR27

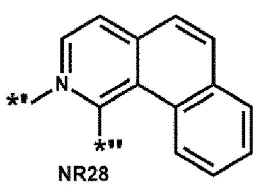
NR28

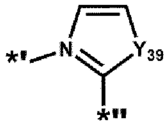
NR29

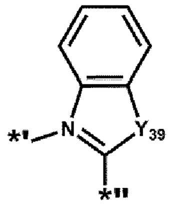
NR30

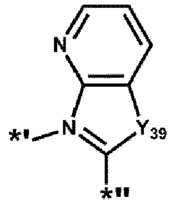
NR31

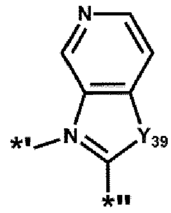
NR32

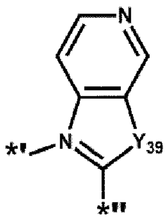
NR33

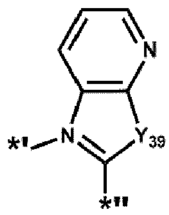
NR34

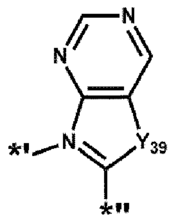
NR35

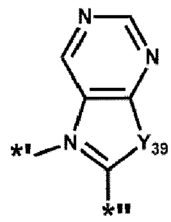
NR36

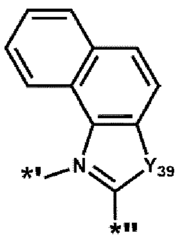
NR37

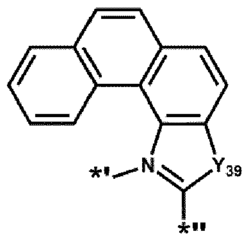
NR38

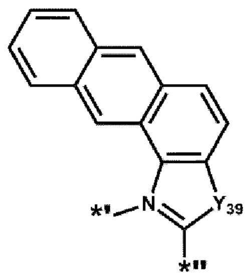
NR39

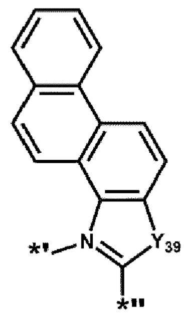
NR40

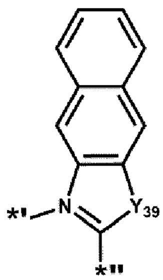
NR41

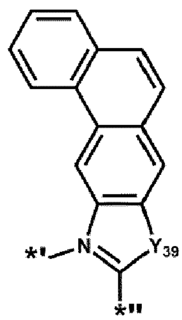
NR42

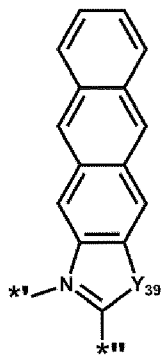
NR43

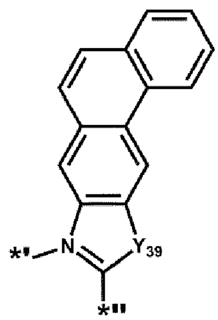
NR44

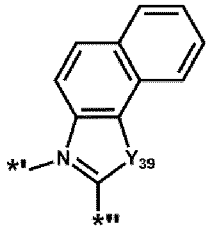

NR45

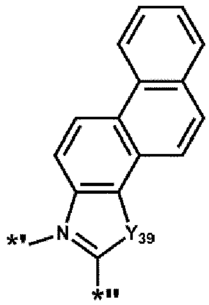

NR46

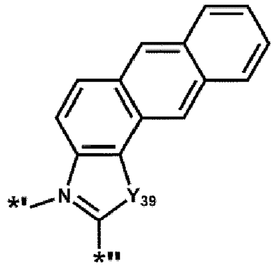

NR47

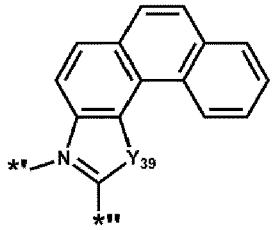

NR48

wherein, in Formulae NR1 to NR48,
$Y_{39}$ may be O, S, Se, N-[$W_3$-$(Z_3)_{e3}$], C($Z_{39a}$)($Z_{39b}$), or Si($Z_{39a}$)($Z_{39b}$),
$W_3$, $Z_3$, and e3 may each be the same as described herein, and $Z_{39a}$ and $Z_{39b}$ may each be the same as described in connection with $Z_3$,
*' indicates a binding site to $M_2$ in Formula 2, and
*" indicates a binding site to ring $A_4$.

In one or more embodiments,

in Formulae 2-1 and 2-2, each of $Y_2$ and $Y_4$ may be C, and
a group represented by

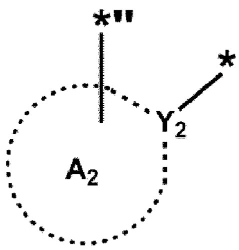

in Formula 2-1 and
a group represented by

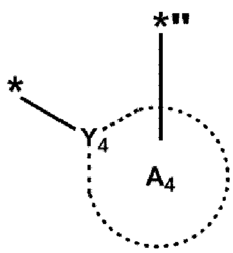

in Formula 2-2
may each independently be a group represented by one of Formulae CR1 to CR29:

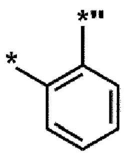

CR1

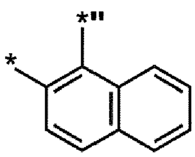

CR2

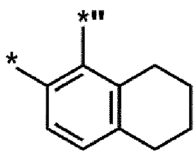

CR3

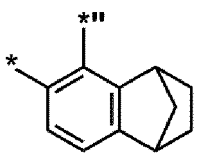

CR4

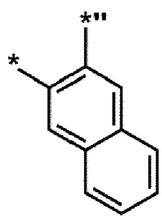

CR5

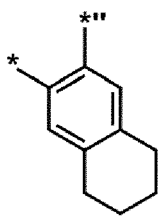

CR6

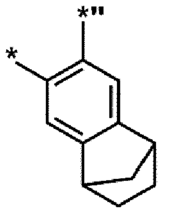
CR7
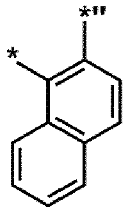
CR8
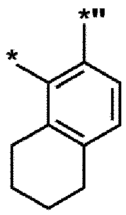
CR9
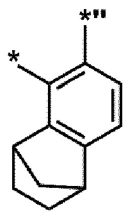
CR10
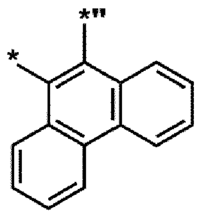
CR11
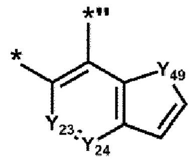
CR12

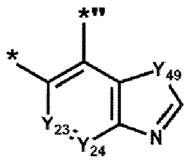
CR13
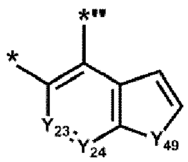
CR14
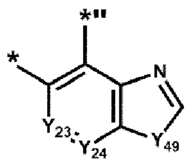
CR15
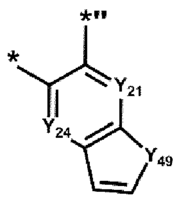
CR16
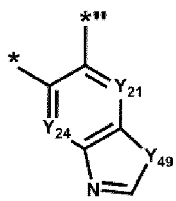
CR17
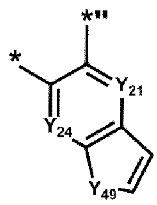
CR18

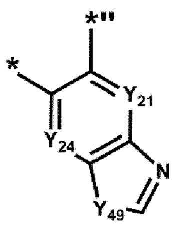
CR19
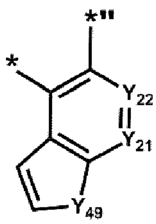
CR20
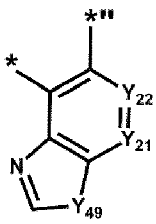
CR21
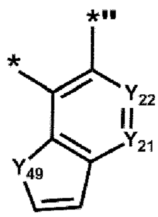
CR22
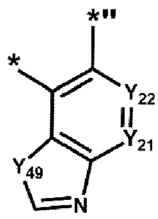
CR23

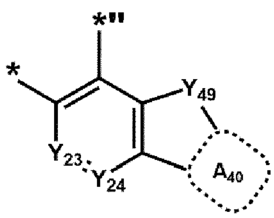
CR24
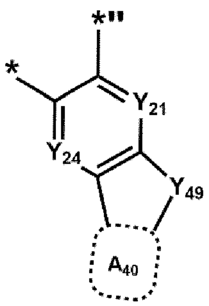
CR25
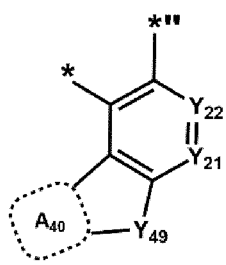
CR26

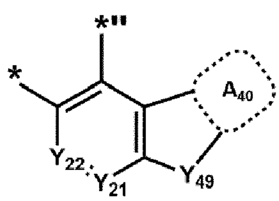
CR27
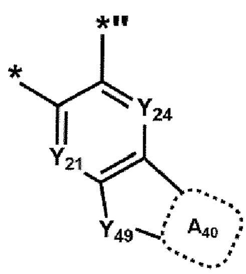
CR28
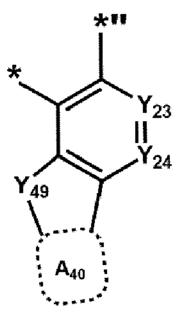
CR29

wherein, in Formulae CR1 to CR29,
Y49 may be O, S, Se, N-[$W_2$-$(Z_2)_{e2}$], N-[$W_4$-$(Z_4)_{e4}$], C(Z29a)(Z29b), C(Z49a)(Z49b), Si(Z29a)(Z29b), or Si(Z49a)(Z49b),

$W_2$, $W_4$, $Z_2$, $Z_4$, e2, and e4 may each be the same as described herein, Z29a and Z29b may each be the same as described in connection with $Z_2$, and Z49a and $Z_{49b}$ may each be the same as described in connection with $Z_4$, $Y_{21}$ to $Y_{24}$ may each independently be N or C,

ring $A_{40}$ may be a $C_5$-$C_{30}$ carbocyclic group or a $C_1$-$C_{30}$ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),

* indicates a binding site to $M_2$ in Formula 2, and

*" indicates a binding site to ring $A_1$ in Formula 2-1 or ring $A_3$ in Formula 2-2.

In one or more embodiments,

a group represented by

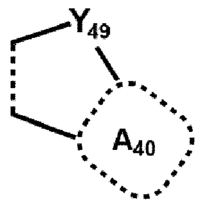

in Formulae CR24 to CR29 may be a group represented by one of Formulae CR(1) to CR(13):

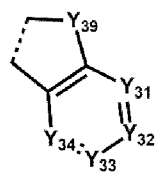

CR(1)

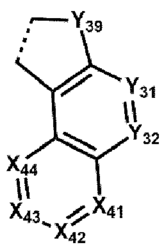

CY(2)

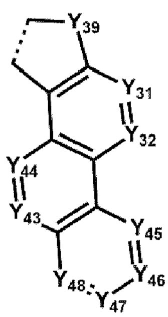

CR(3)

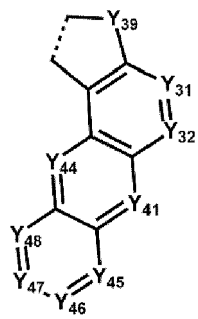

CR(4)

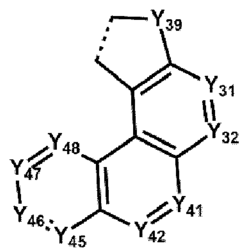

CR(5)

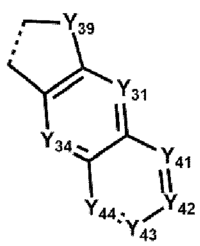

CR(6)

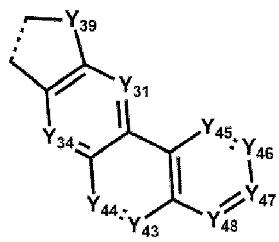

CR(7)

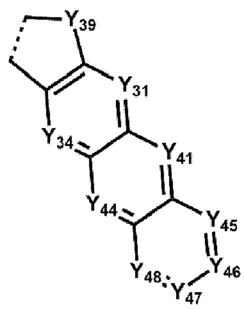

CR(8)

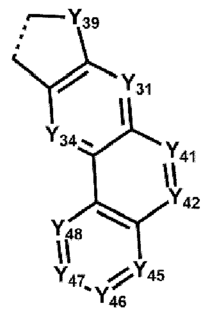

CR(9)

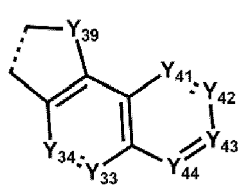
CR(10)

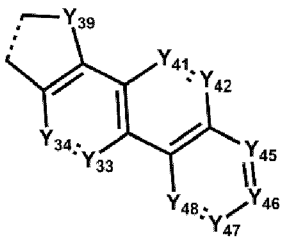
CR(11)

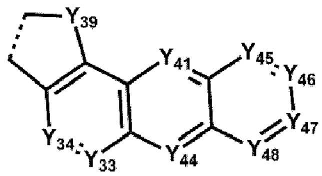
CR(12)

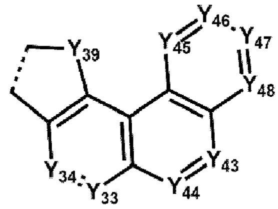
CR(13)

wherein, in Formulae CR(1) to CR(13),
$Y_{39}$ may be the same as described herein in connection with $Y_{49}$, and
$Y_{31}$ to $Y_{34}$ and $Y_{41}$ to $Y_{48}$ may each independently be C or N.

In one or more embodiments, the platinum-containing organometallic compound may include at least one deuterium.

In one or more embodiments, the iridium-containing organometallic compound may include at least one deuterium.

For example, the platinum-containing organometallic compound may be a compound of Group 1-1 to Group 1-4:

Group 1-1

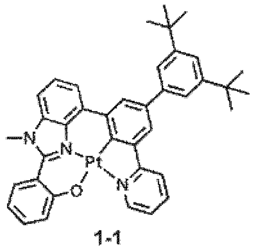
1-1

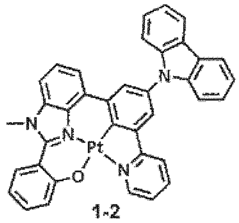
1-2

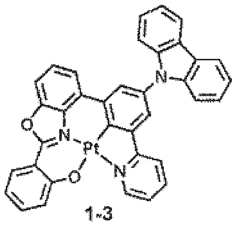
1-3

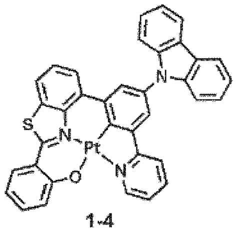
1-4

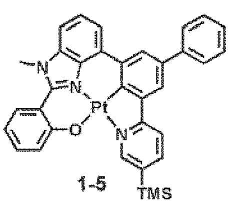
1-5

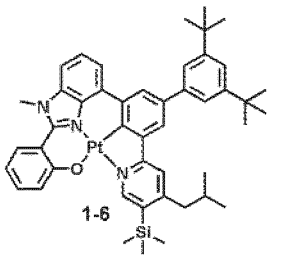
1-6

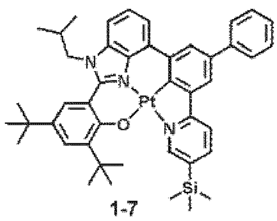
1-7

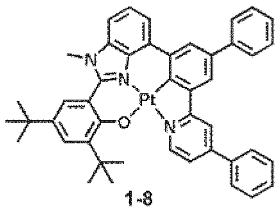
1-8

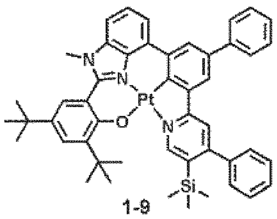
1-9

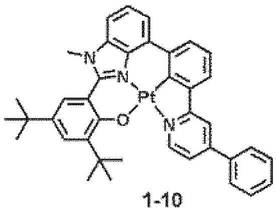
1-10

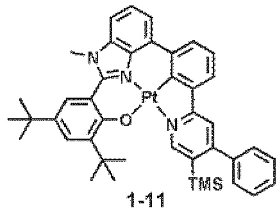
1-11

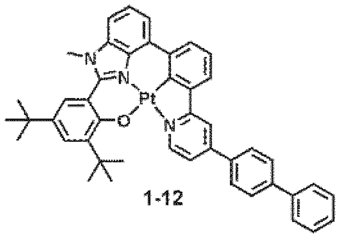
1-12

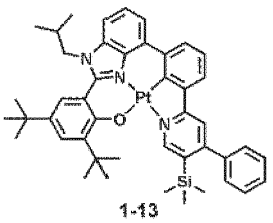
1-13

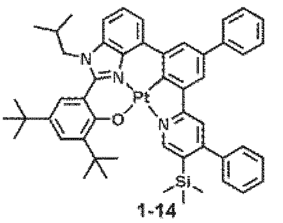
1-14

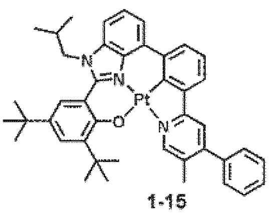
1-15

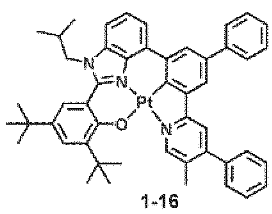
1-16

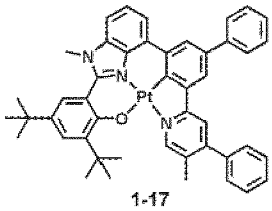
1-17

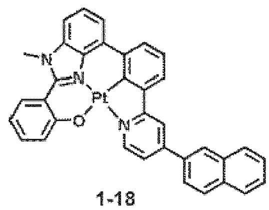
1-18

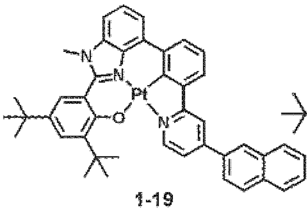
1-19

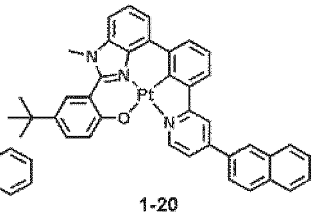
1-20

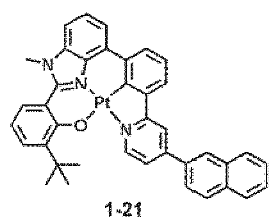
1-21

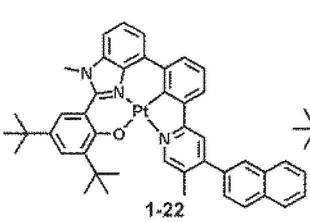
1-22

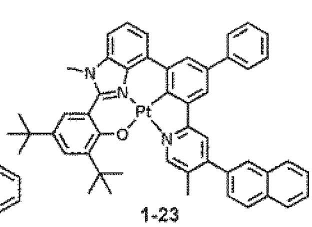
1-23

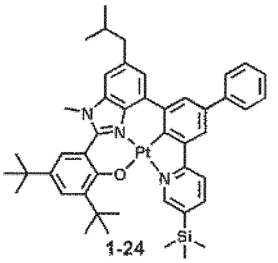
1-24

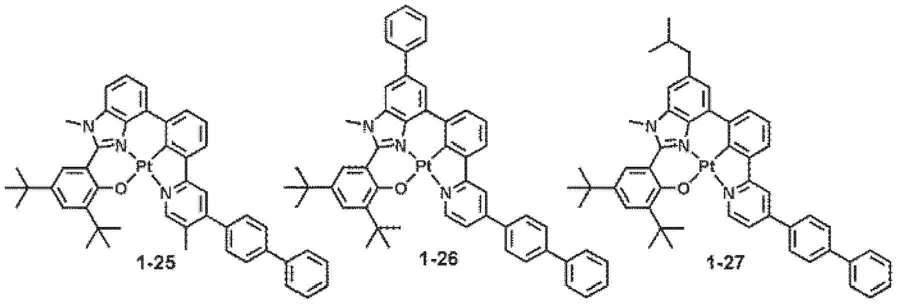

1-25 1-26 1-27

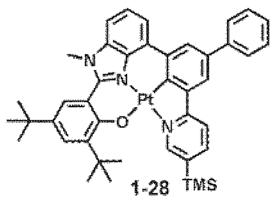

1-28

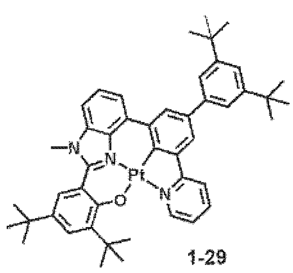

1-29

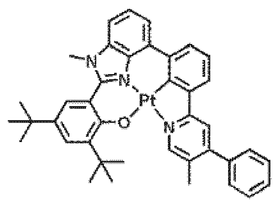

1-30

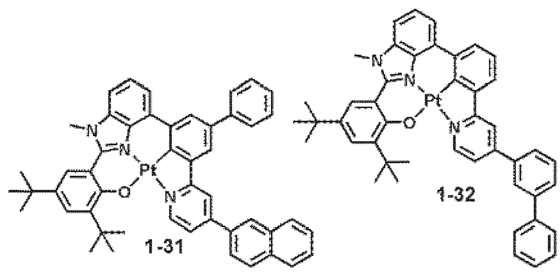

1-31 1-32

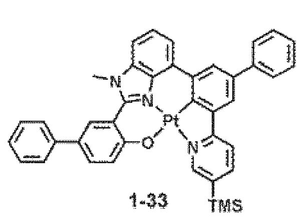

1-33

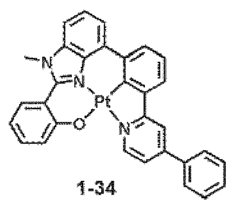

1-34

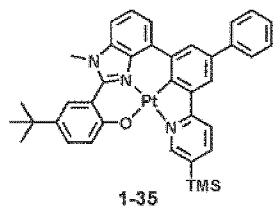

1-35

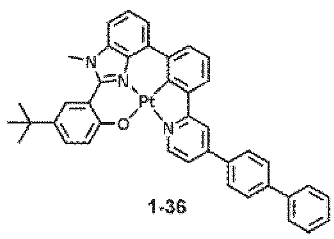

1-36

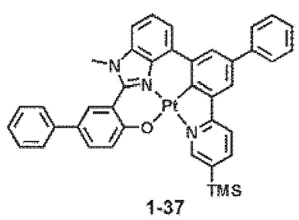

1-37

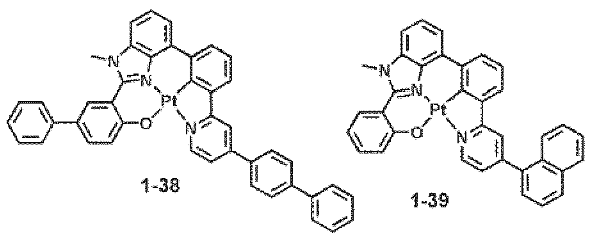

1-38 1-39

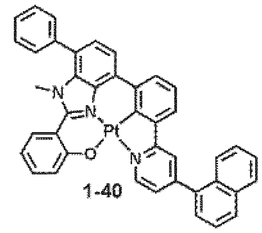

1-40

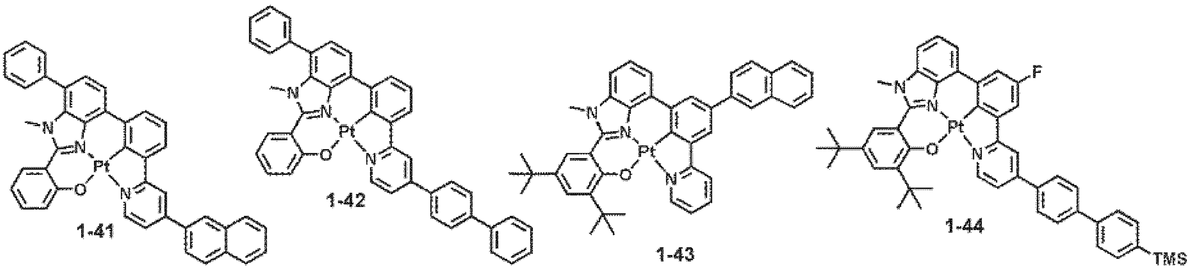

1-41 1-42 1-43 1-44

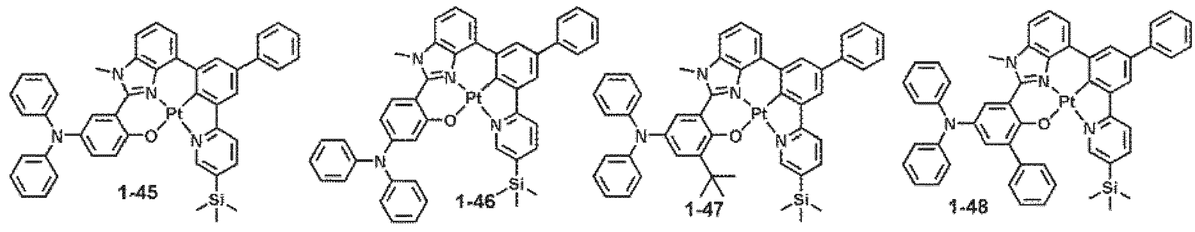

1-45 1-46 1-47 1-48

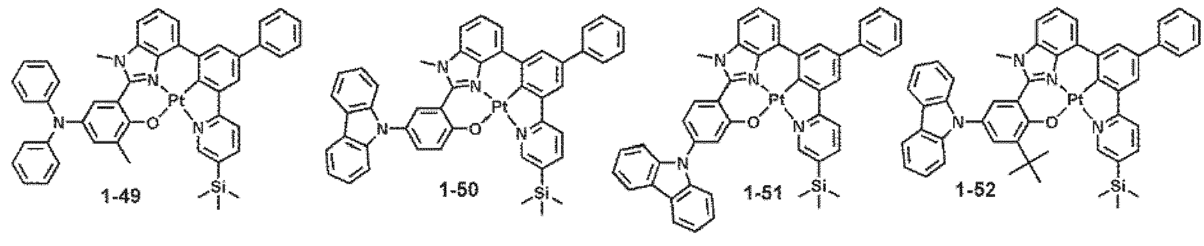

1-49 1-50 1-51 1-52

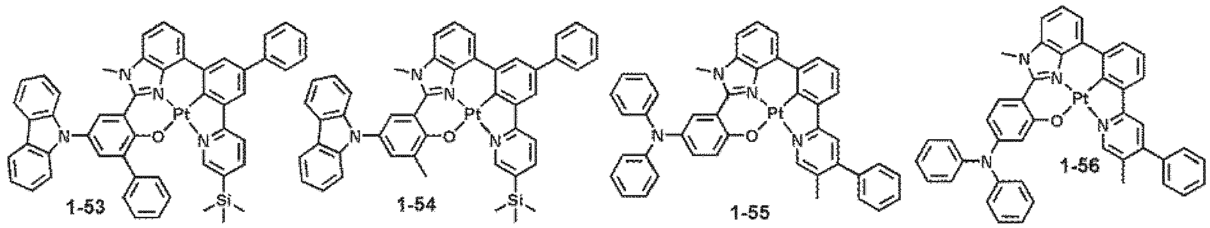

1-53 1-54 1-55 1-56

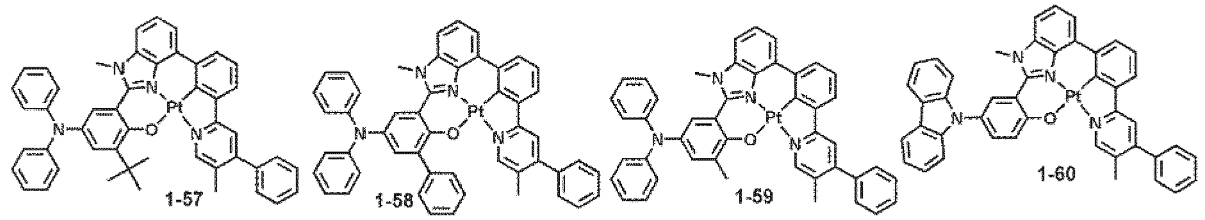

1-57 1-58 1-59 1-60

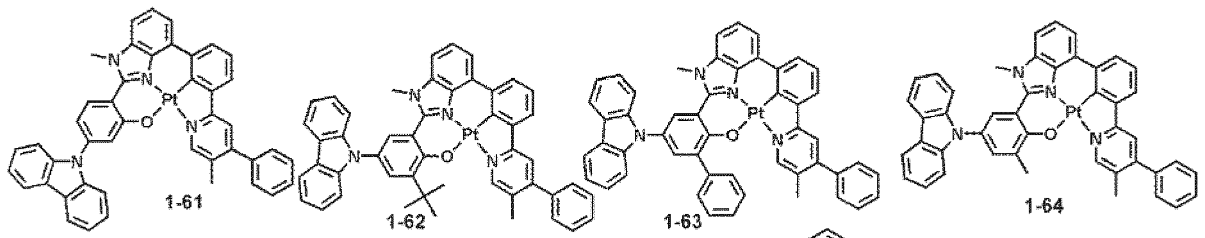

1-61 1-62 1-63 1-64

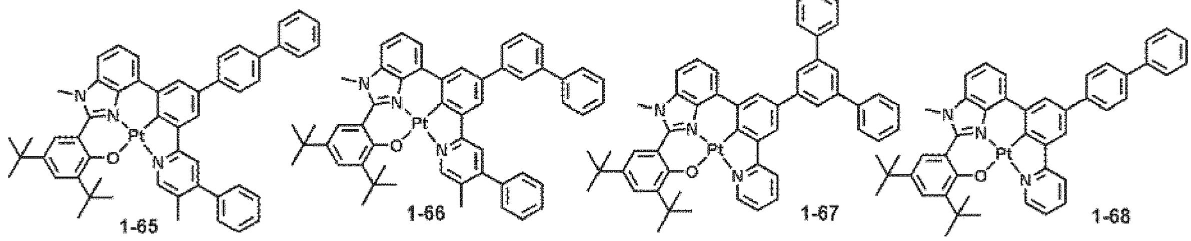

1-65 1-66 1-67 1-68

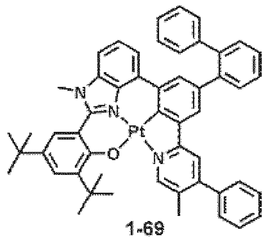

1-69

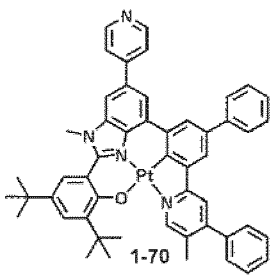

1-70

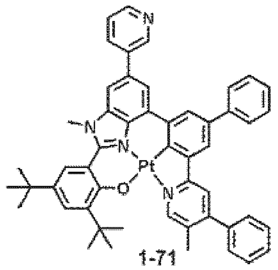

1-71

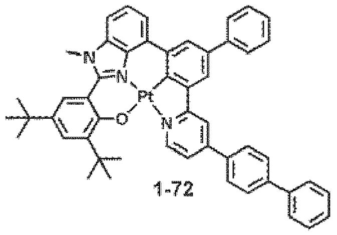

1-72

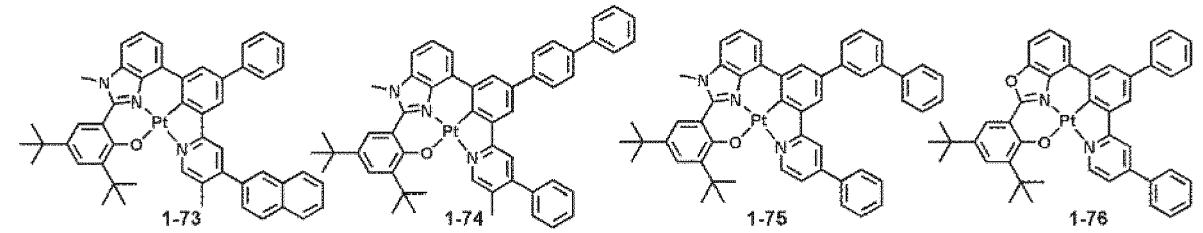

1-73

1-74

1-75

1-76

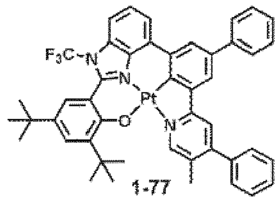

1-77

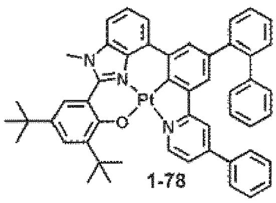

1-78

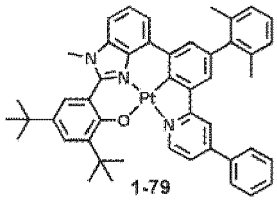

1-79

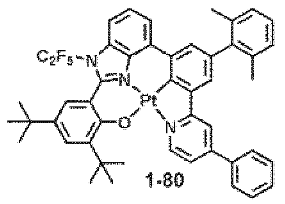

1-80

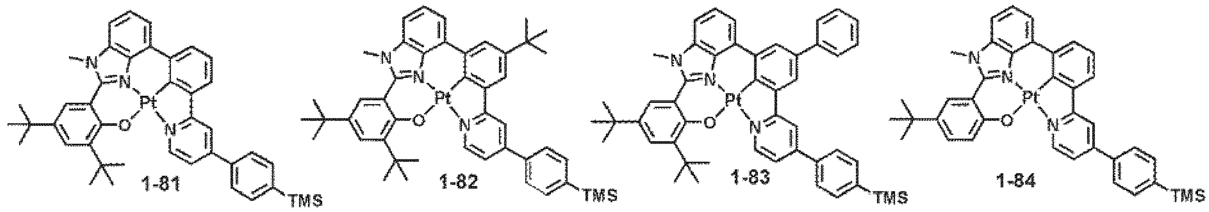

1-81

1-82

1-83

1-84

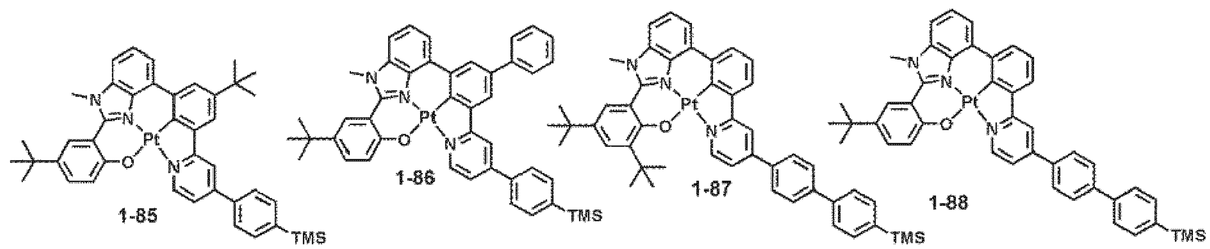

1-85

1-86

1-87

1-88

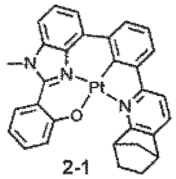
2-1

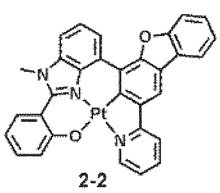
2-2

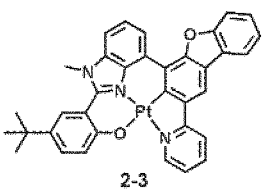
2-3

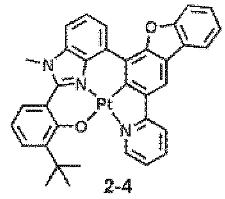
2-4

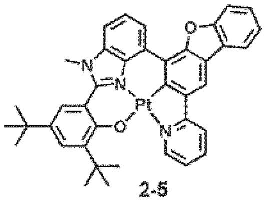
2-5

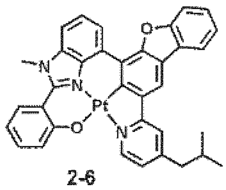
2-6

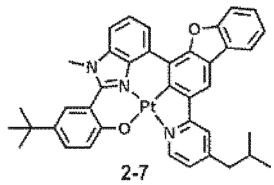
2-7

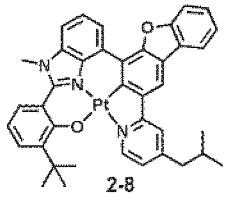
2-8

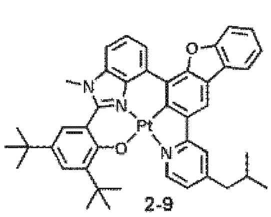
2-9

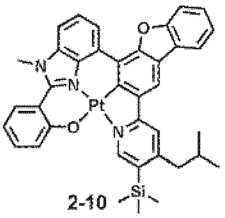
2-10

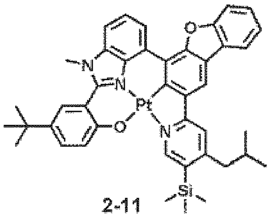
2-11

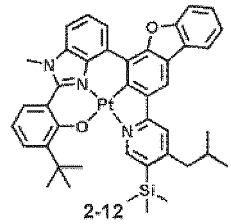
2-12

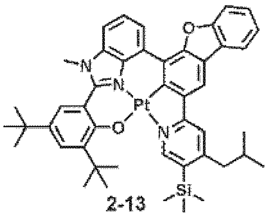
2-13

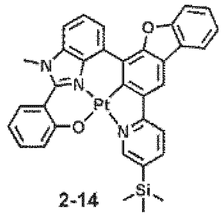
2-14

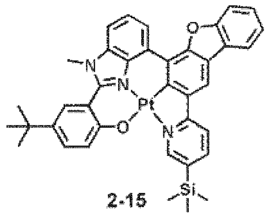
2-15

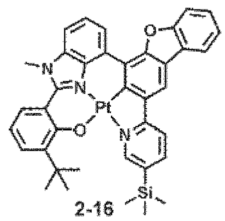
2-16

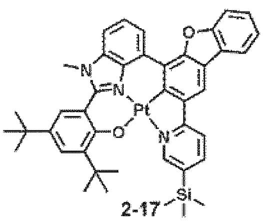
2-17

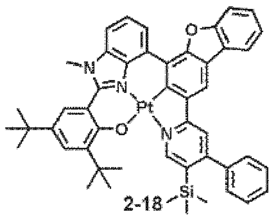
2-18

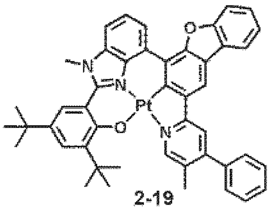
2-19

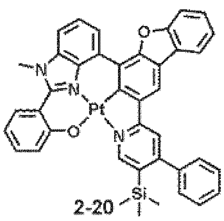
2-20

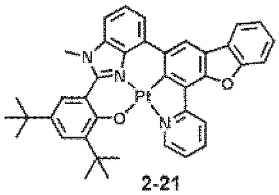
2-21

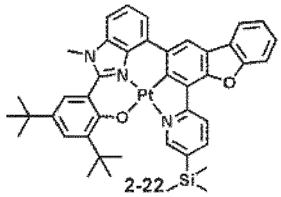
2-22

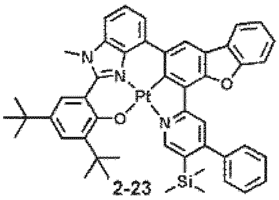
2-23

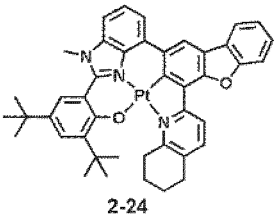
2-24

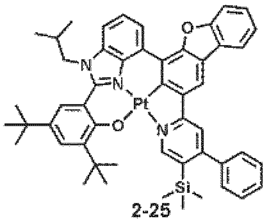
2-25

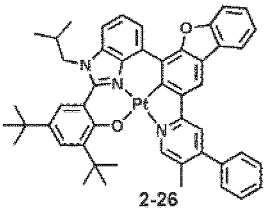
2-26

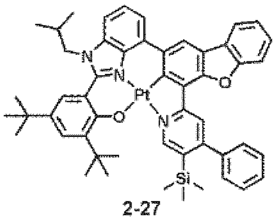
2-27

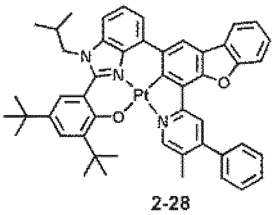
2-28

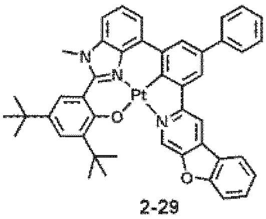
2-29

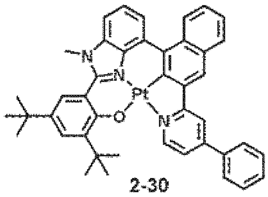
2-30

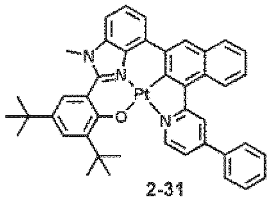
2-31

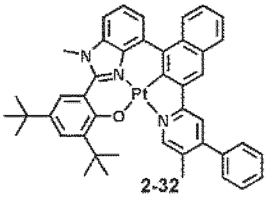
2-32

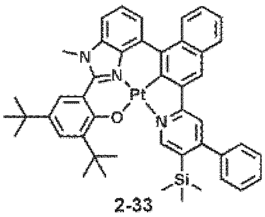
2-33

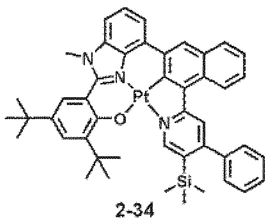
2-34

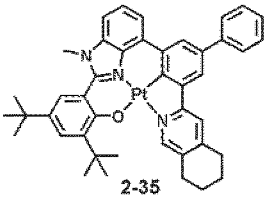
2-35

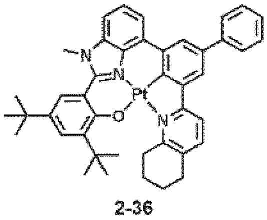
2-36

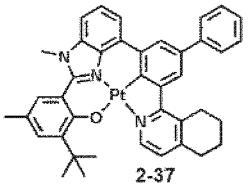
2-37

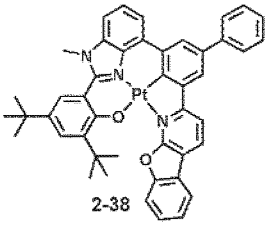
2-38

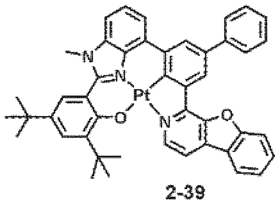
2-39

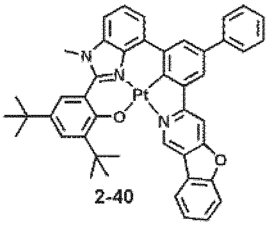
2-40

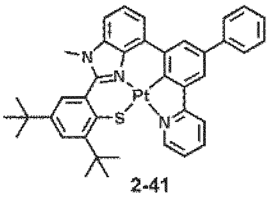
2-41

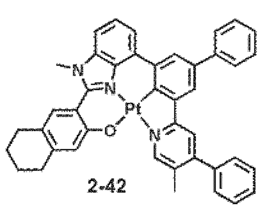
2-42

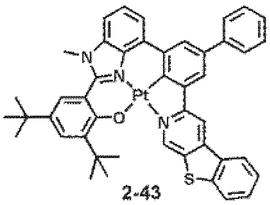
2-43

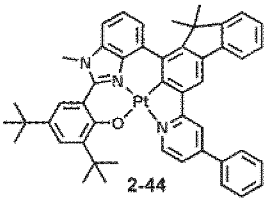
2-44

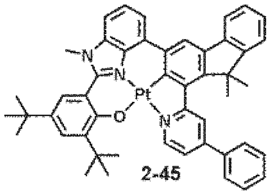
2-45

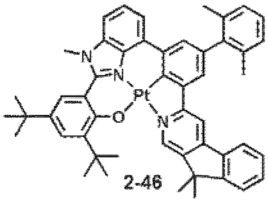
2-46

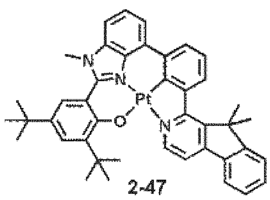
2-47

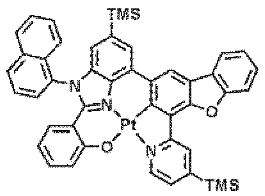
3-1

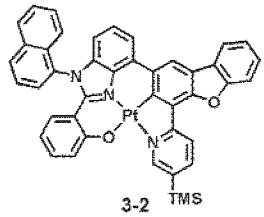
3-2

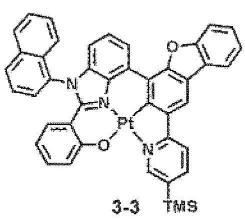
3-3

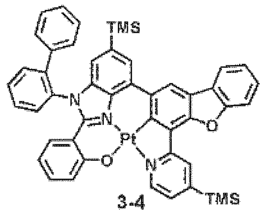
3-4

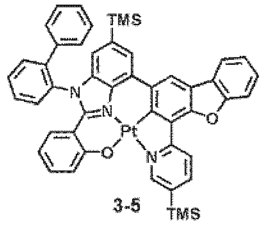
3-5

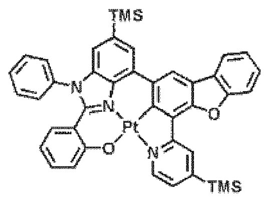
3-6

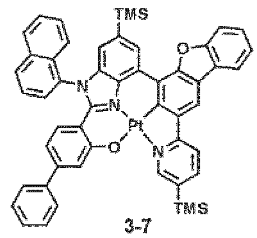
3-7

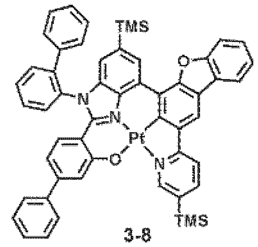
3-8

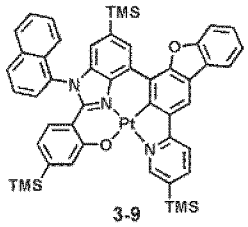
3-9

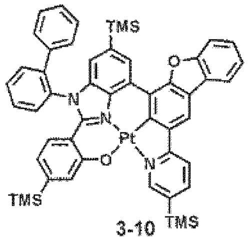
3-10

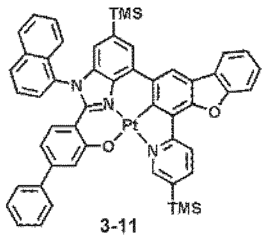
3-11

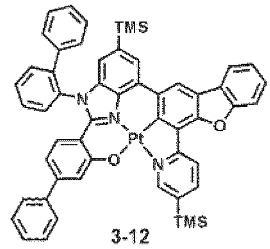
3-12

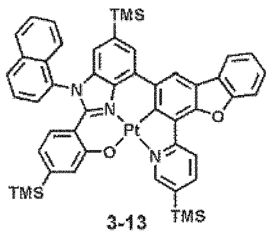
3-13

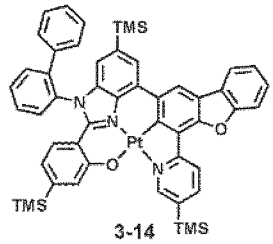
3-14

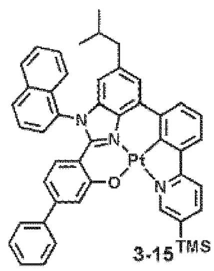
3-15

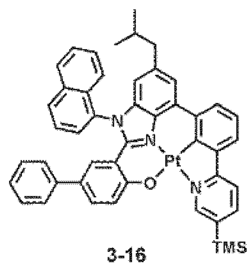
3-16

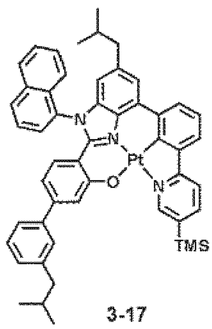
3-17

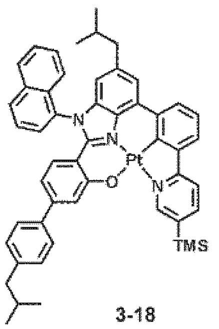
3-18

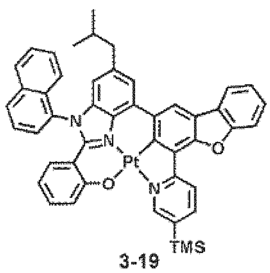
3-19

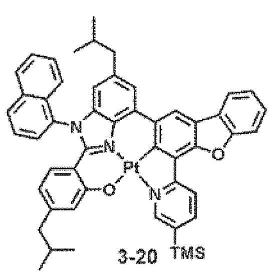
3-20

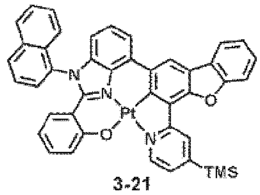
3-21

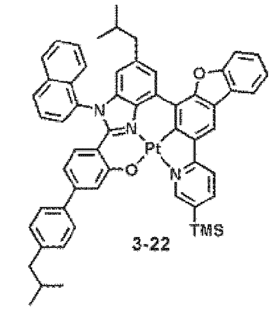
3-22

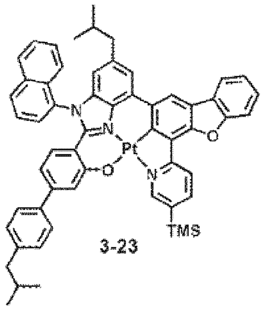
3-23

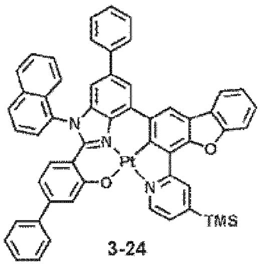
3-24

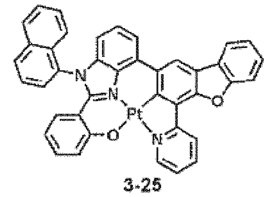
3-25

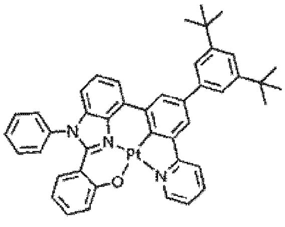
3-26

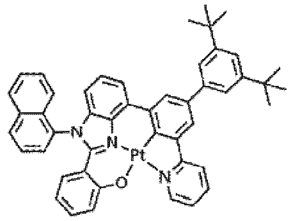
3-27

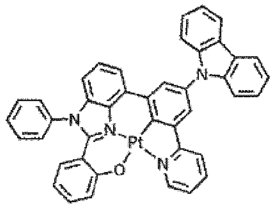
3-28

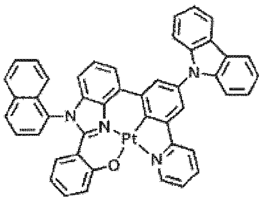
3-29

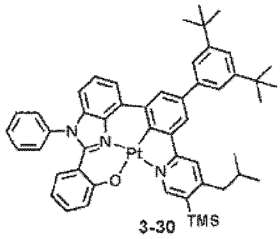
3-30

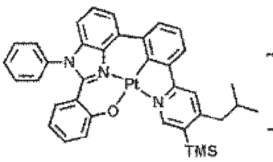
3-31

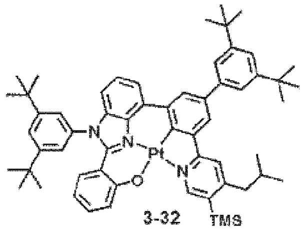
3-32

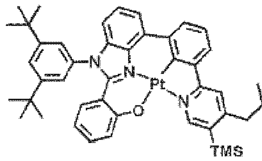
3-33

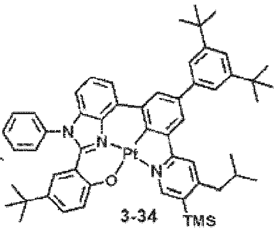
3-34

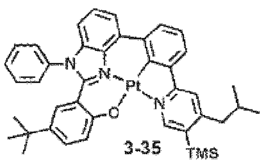
3-35

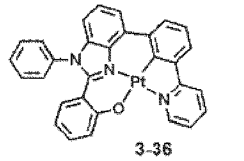
3-36

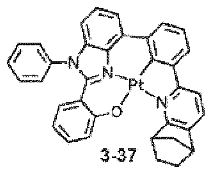
3-37

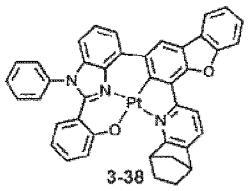
3-38

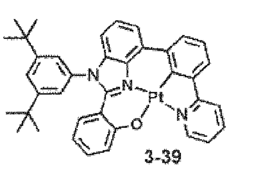
3-39

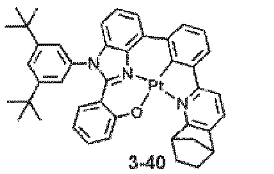
3-40

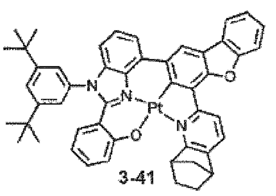
3-41

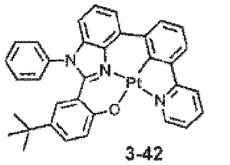
3-42

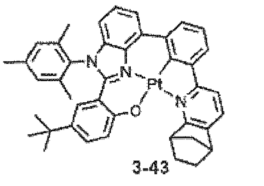
3-43

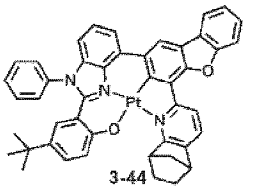
3-44

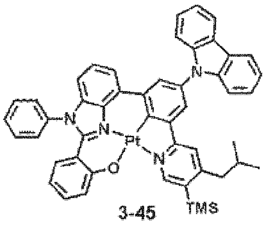
3-45

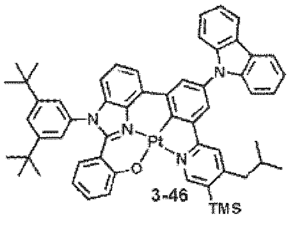
3-46

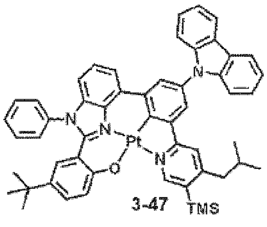
3-47

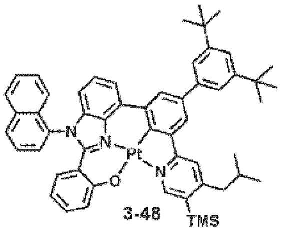
3-48

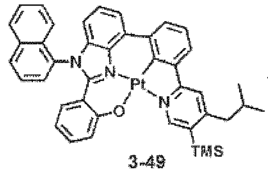
3-49

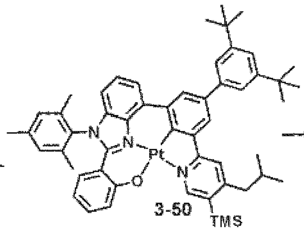
3-50

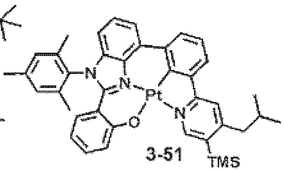
3-51

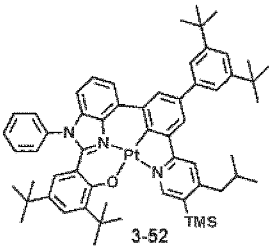
3-52

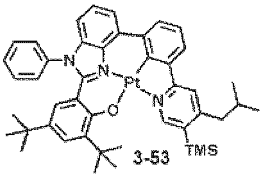
3-53

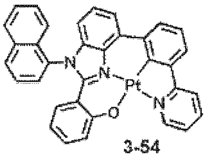
3-54

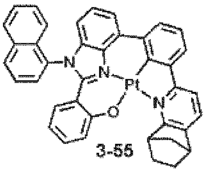
3-55

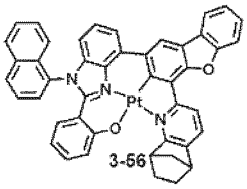
3-56

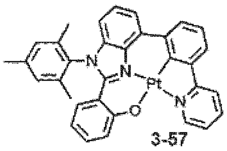
3-57

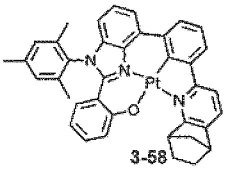
3-58

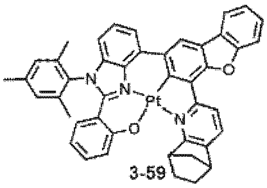
3-59

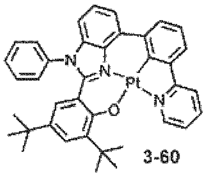
3-60

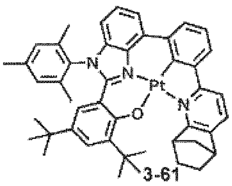
3-61

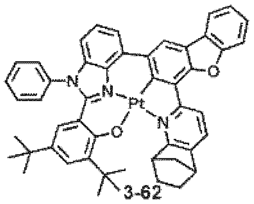
3-62

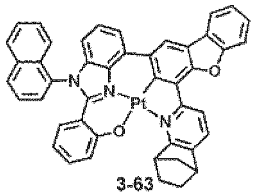
3-63

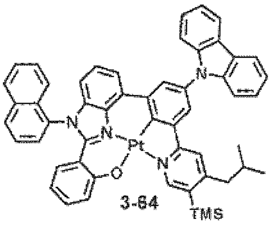
3-64

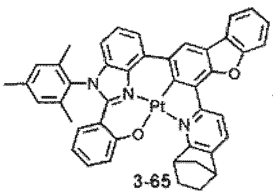
3-65

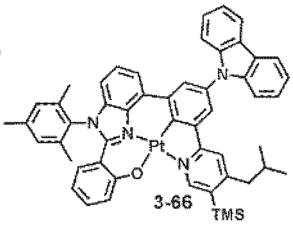
3-66

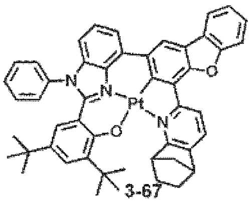
3-67

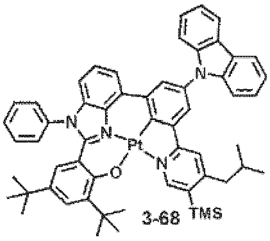
3-68

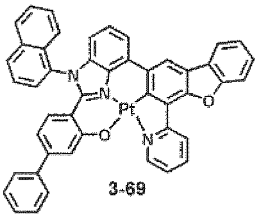
3-69

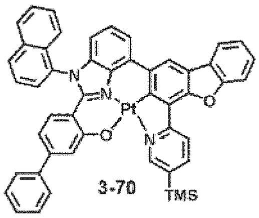
3-70

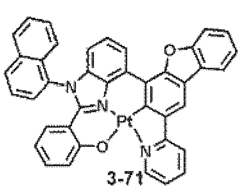
3-71

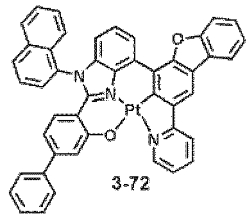
3-72

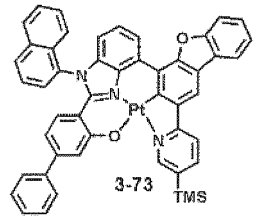
3-73

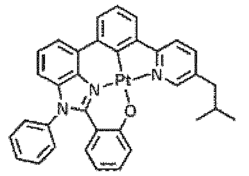
3-74

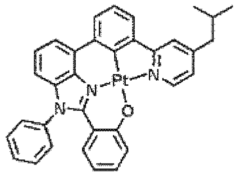
3-75

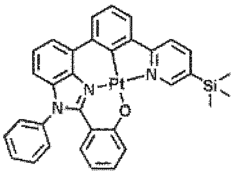
3-76

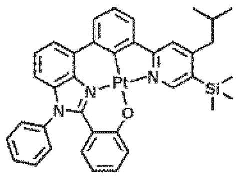
3-77

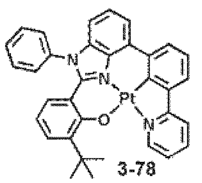
3-78

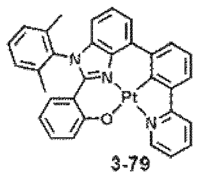
3-79

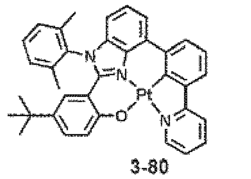
3-80

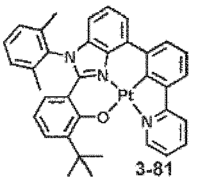
3-81

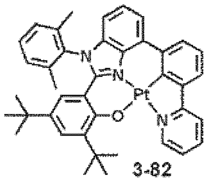
3-82

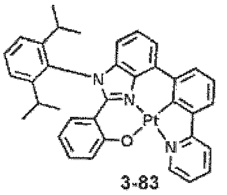
3-83

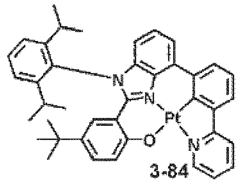
3-84

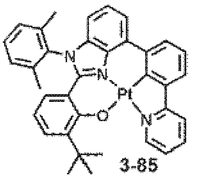
3-85

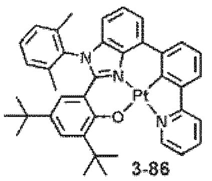
3-86

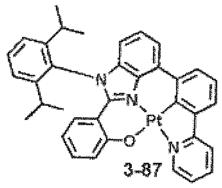
3-87

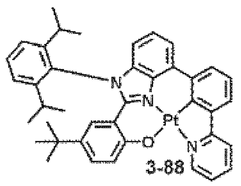
3-88

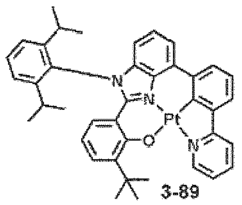
3-89

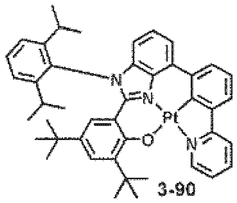
3-90

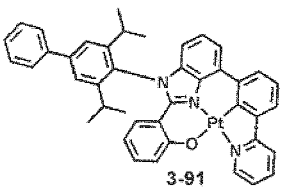
3-91

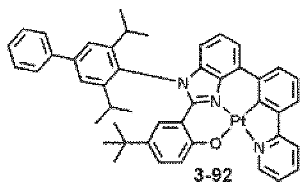
3-92

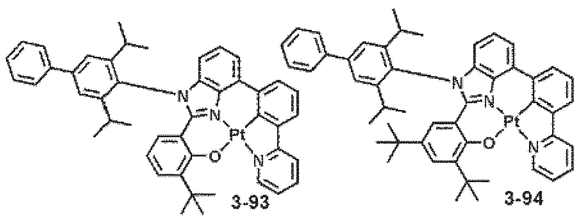
3-93

3-94

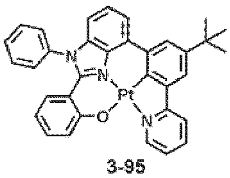
3-95

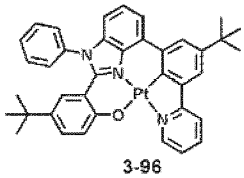
3-96

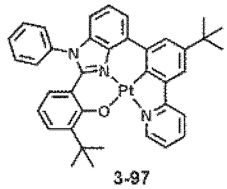
3-97

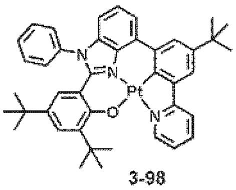
3-98

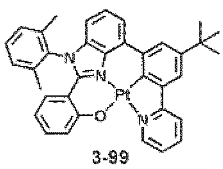
3-99

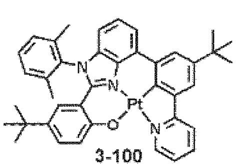
3-100

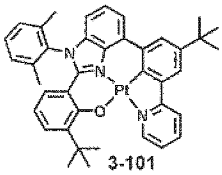
3-101

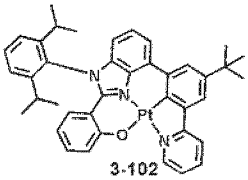
3-102

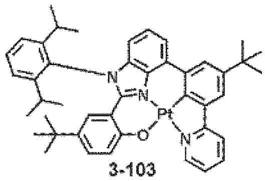
3-103

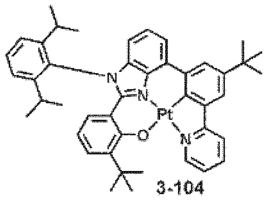
3-104

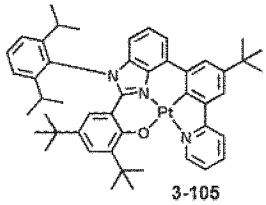
3-105

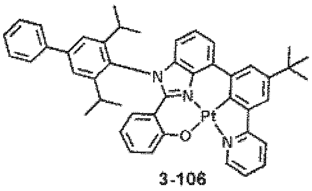
3-106

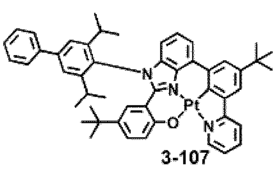
3-107

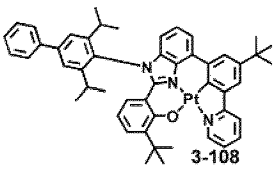
3-108

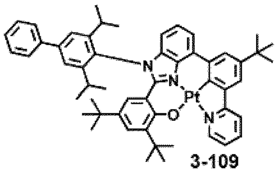
3-109

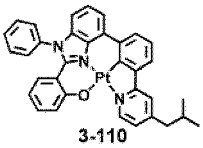
3-110

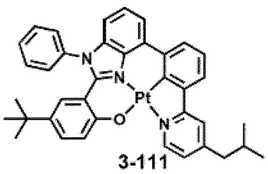
3-111

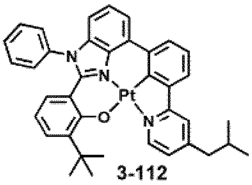
3-112

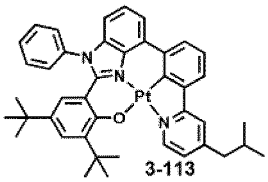
3-113

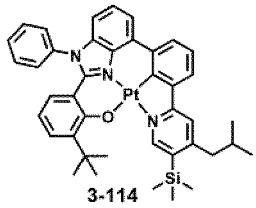
3-114

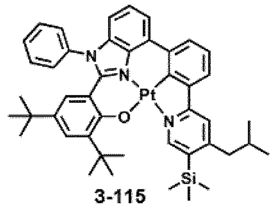
3-115

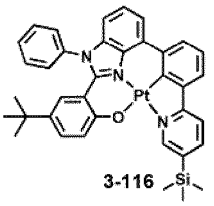
3-116

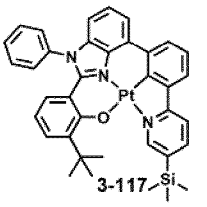
3-117

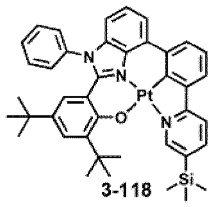
3-118

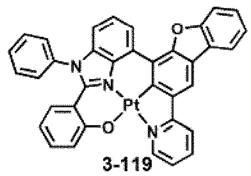
3-119

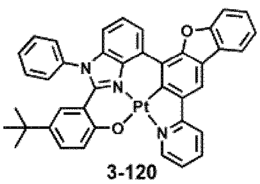
3-120

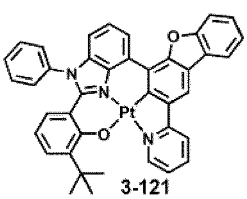
3-121

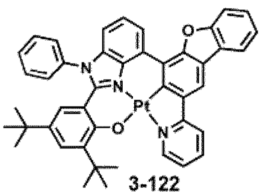
3-122

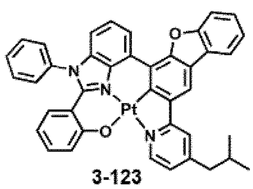
3-123

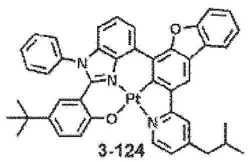
3-124
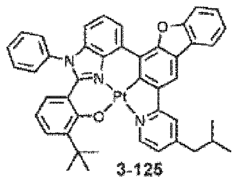
3-125
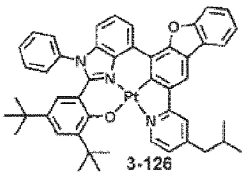
3-126
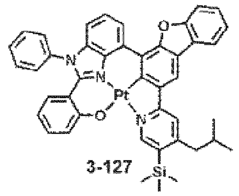
3-127

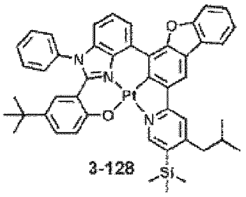
3-128
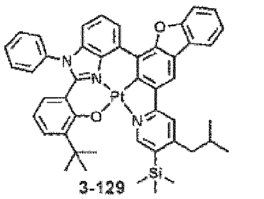
3-129
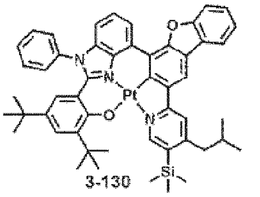
3-130
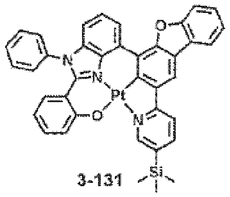
3-131

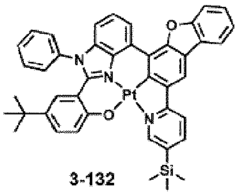
3-132
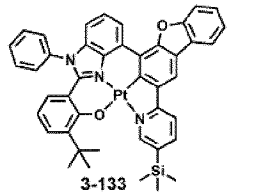
3-133
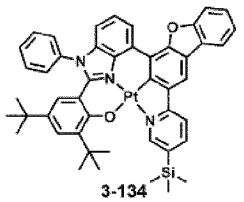
3-134
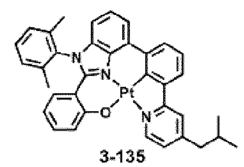
3-135

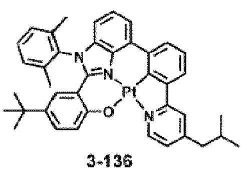
3-136
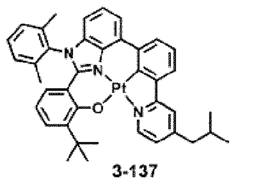
3-137
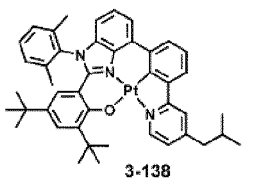
3-138
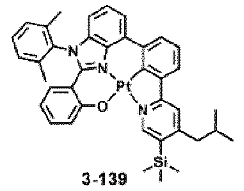
3-139

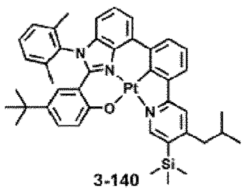
3-140
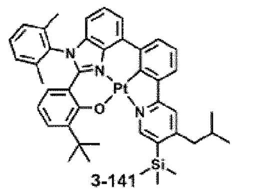
3-141
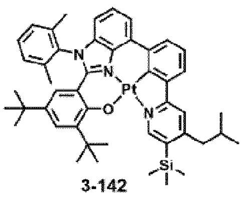
3-142
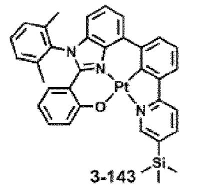
3-143

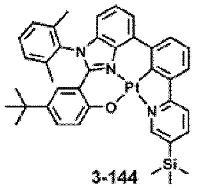
3-144
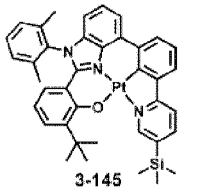
3-145
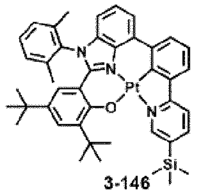
3-146
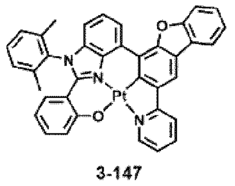
3-147

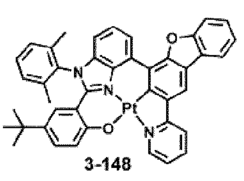
3-148
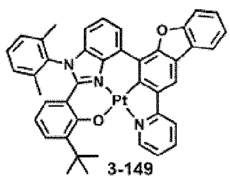
3-149
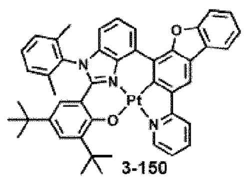
3-150
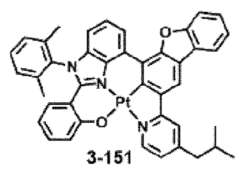
3-151

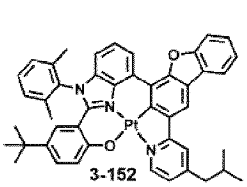
3-152
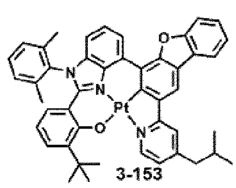
3-153
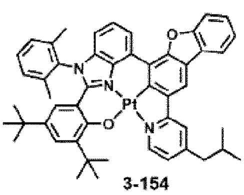
3-154
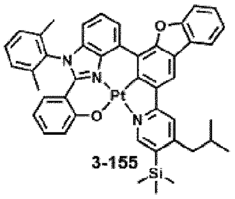
3-155

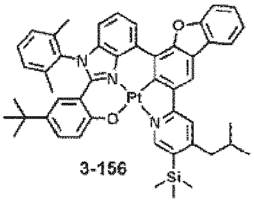
3-156
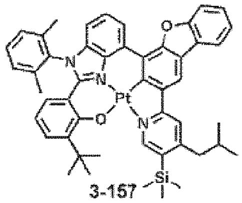
3-157
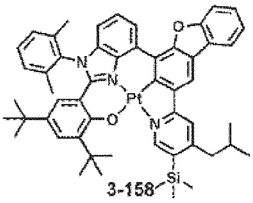
3-158
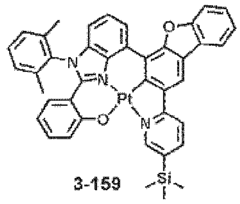
3-159
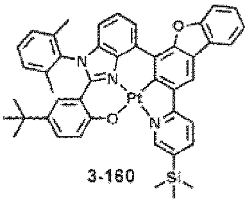
3-160
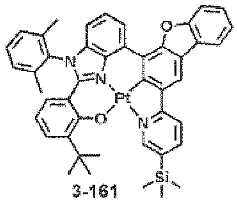
3-161
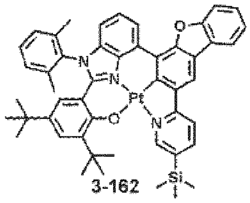
3-162
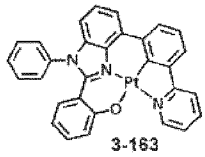
3-163
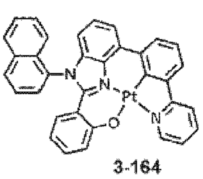
3-164
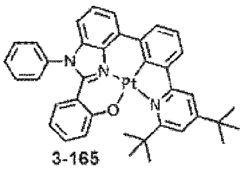
3-165
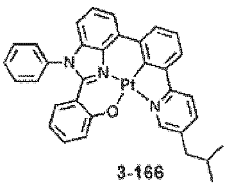
3-166
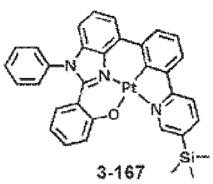
3-167
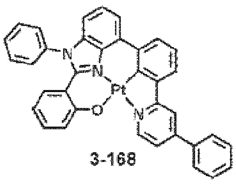
3-168
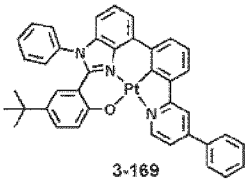
3-169
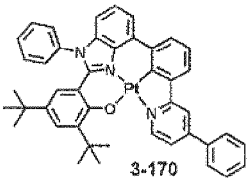
3-170
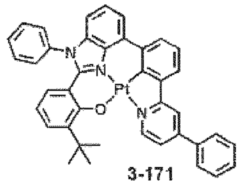
3-171
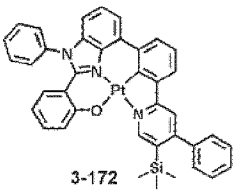
3-172
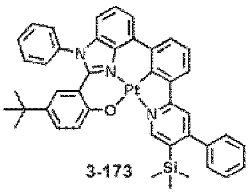
3-173
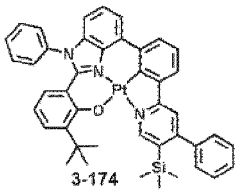
3-174
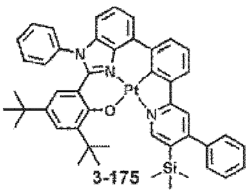
3-175
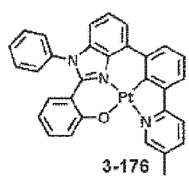
3-176
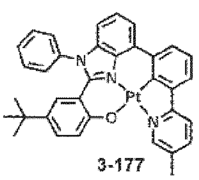
3-177
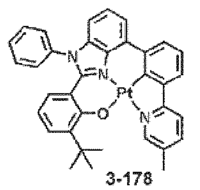
3-178
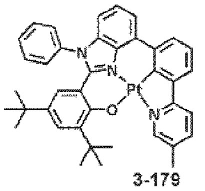
3-179
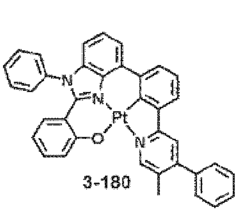
3-180
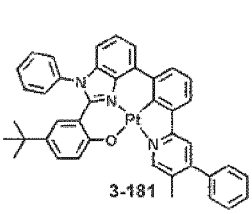
3-181
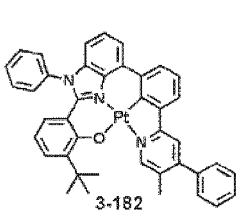
3-182
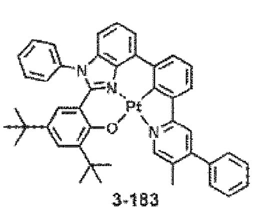
3-183
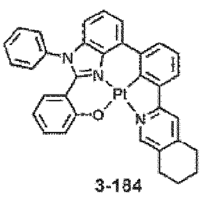
3-184
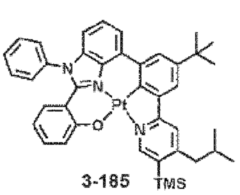
3-185
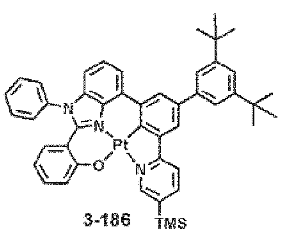
3-186
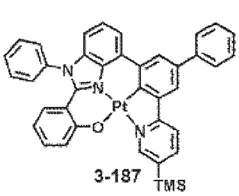
3-187

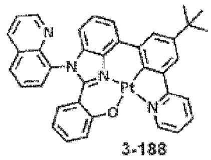
3-188

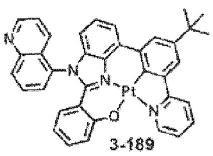
3-189

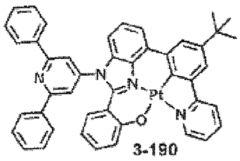
3-190

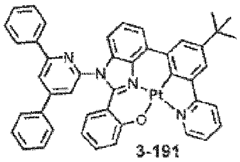
3-191

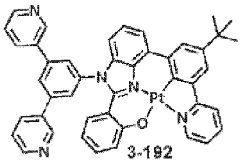
3-192

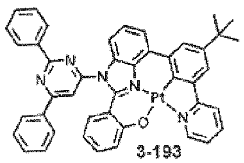
3-193

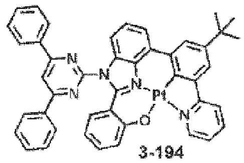
3-194

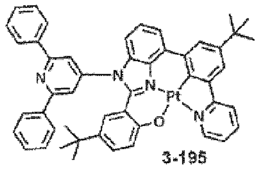
3-195

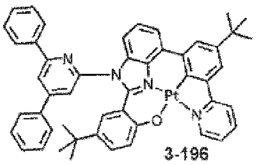
3-196

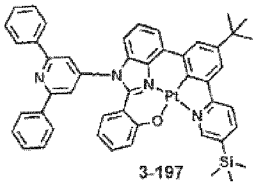
3-197

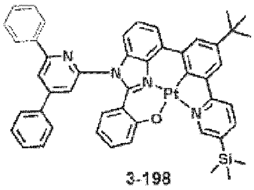
3-198

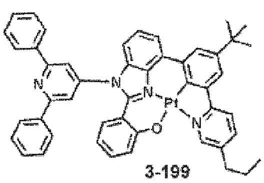
3-199

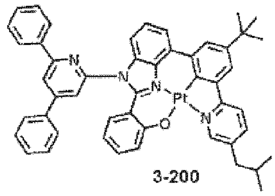
3-200

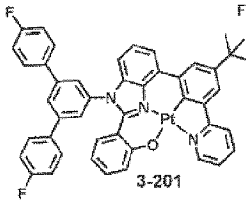
3-201

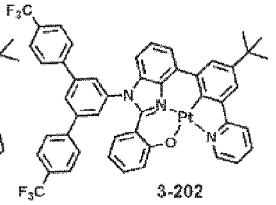
3-202

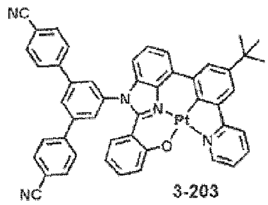
3-203

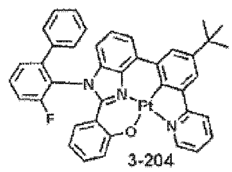
3-204

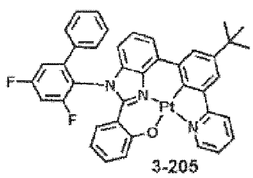
3-205

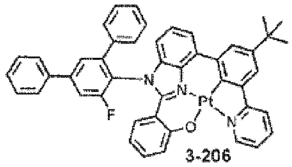
3-206

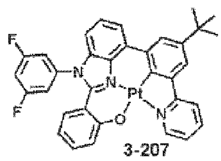
3-207

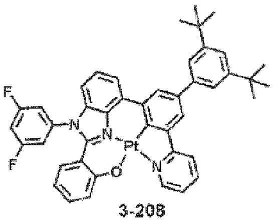
3-208

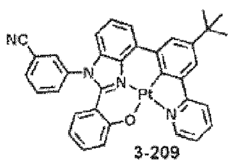
3-209

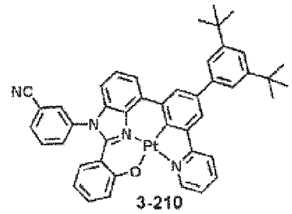
3-210

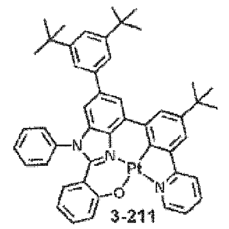
3-211

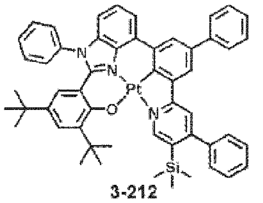
3-212

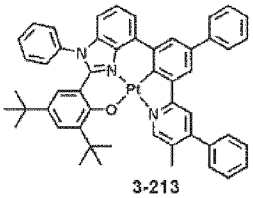
3-213

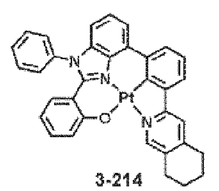
3-214

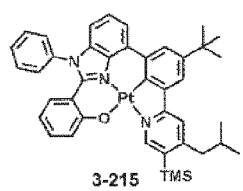
3-215

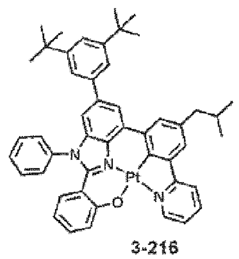
3-216

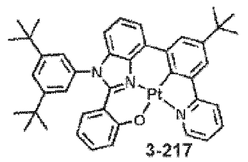
3-217

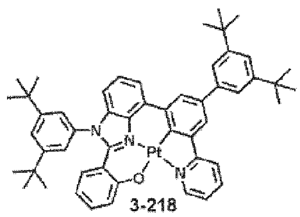
3-218

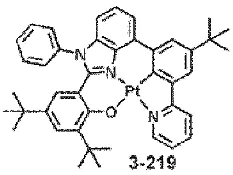
3-219

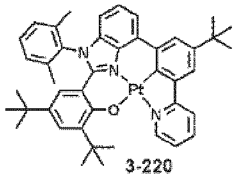
3-220

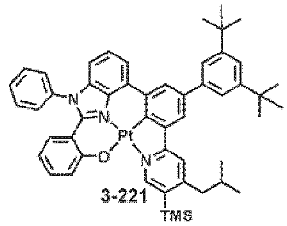
3-221

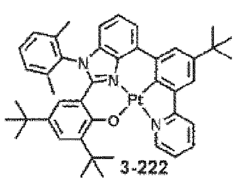
3-222

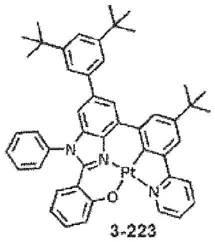
3-223

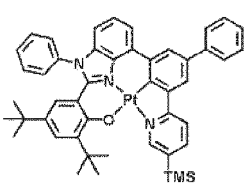
3-224

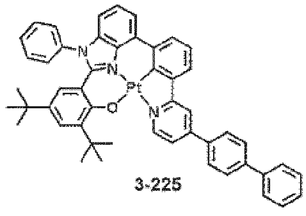
3-225

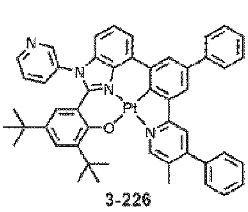
3-226

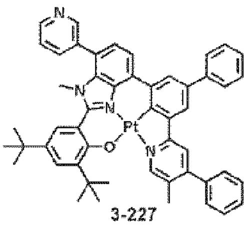
3-227

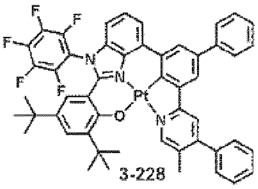
3-228

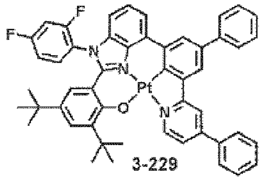
3-229

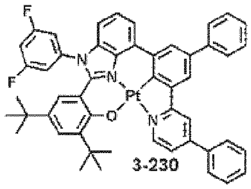
3-230

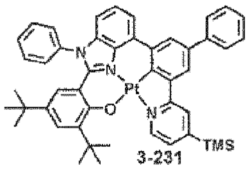
3-231

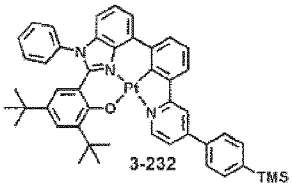
3-232

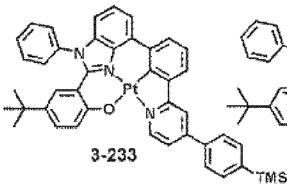
3-233

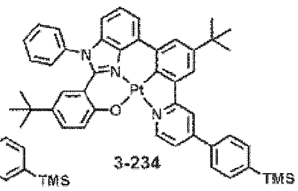
3-234

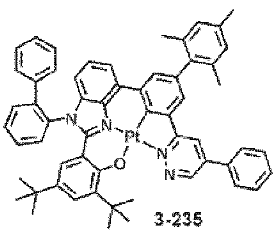
3-235

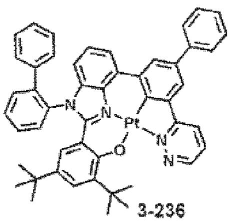
3-236

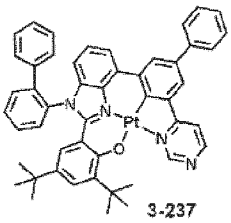
3-237

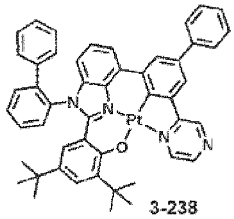
3-238

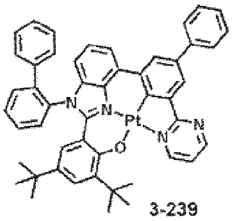
3-239

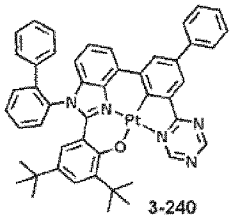
3-240

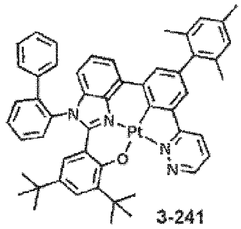
3-241

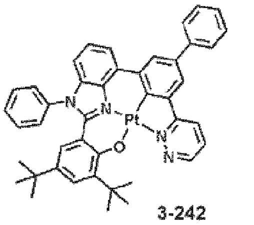
3-242

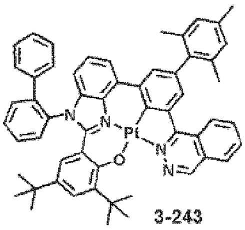
3-243

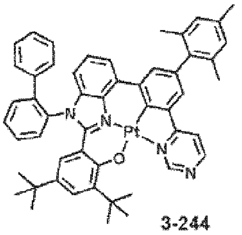
3-244

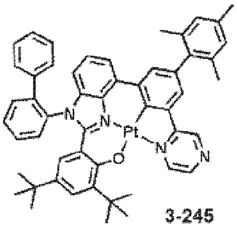
3-245

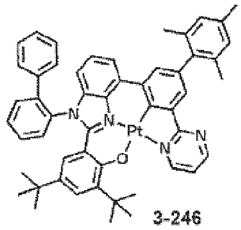
3-246

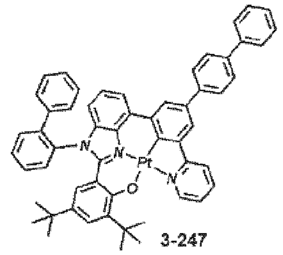
3-247
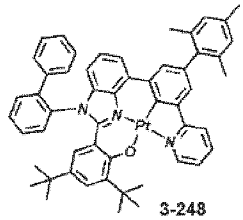
3-248
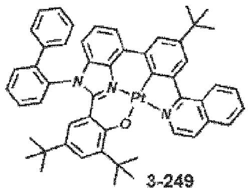
3-249
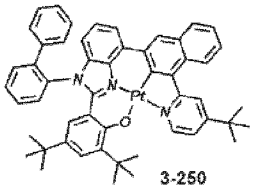
3-250
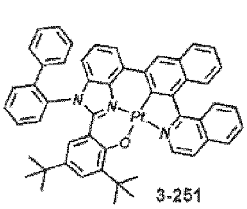
3-251
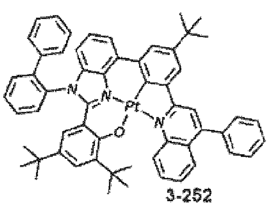
3-252
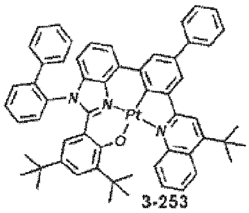
3-253
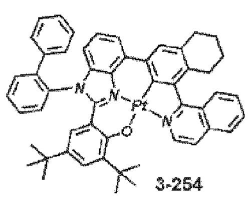
3-254
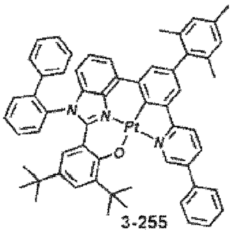
3-255
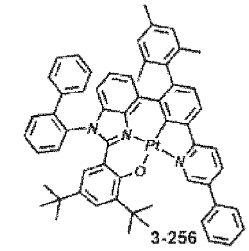
3-256
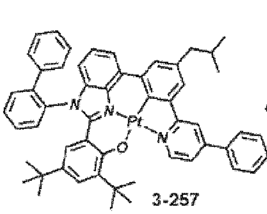
3-257
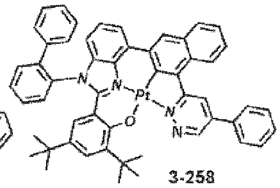
3-258
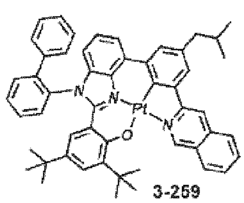
3-259
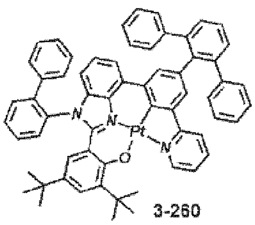
3-260
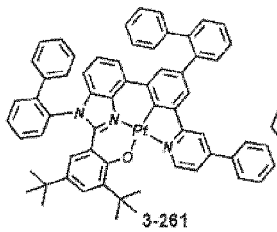
3-261
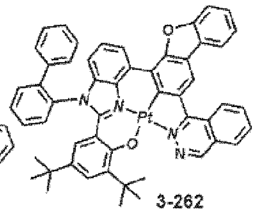
3-262
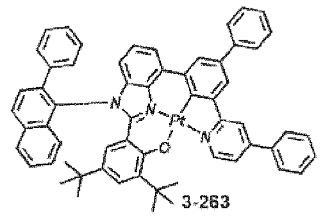
3-263
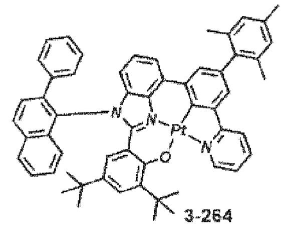
3-264
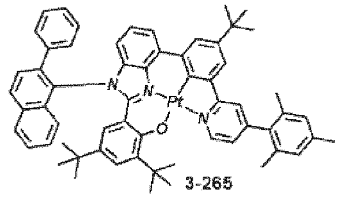
3-265
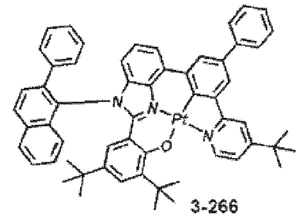
3-266
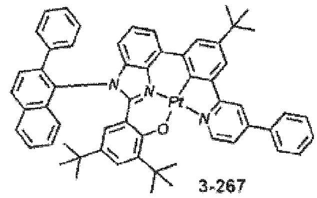
3-267
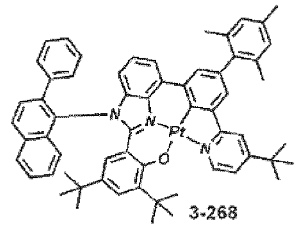
3-268
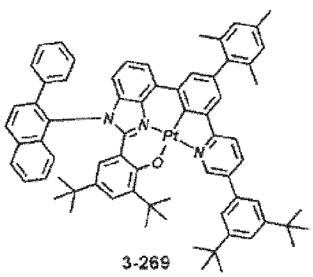
3-269
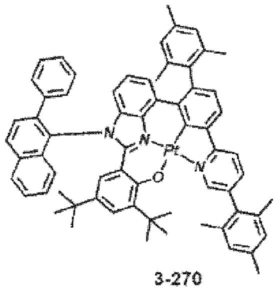
3-270
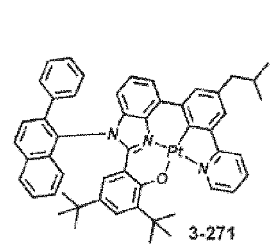
3-271

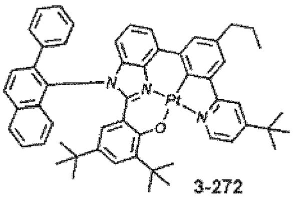
3-272

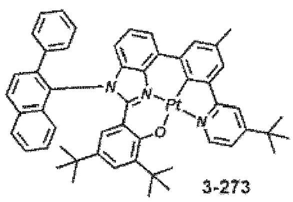
3-273

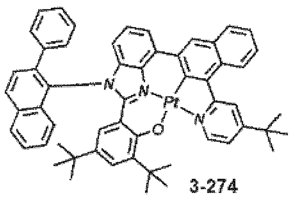
3-274

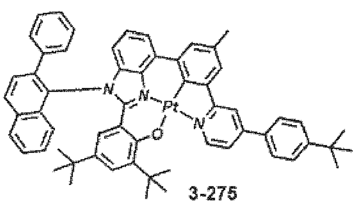
3-275

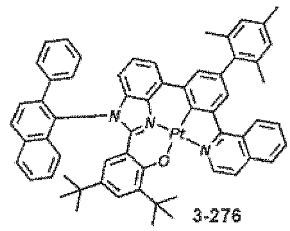
3-276

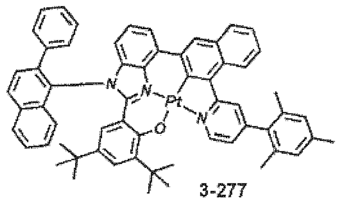
3-277

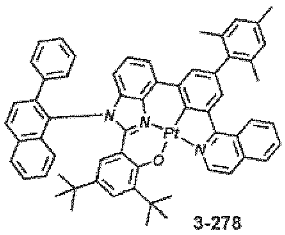
3-278

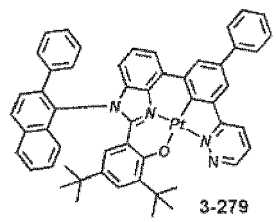
3-279

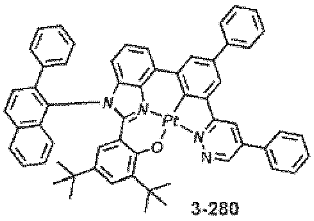
3-280

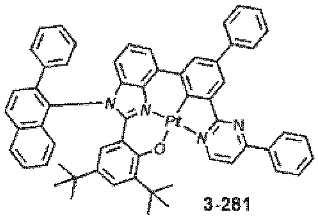
3-281

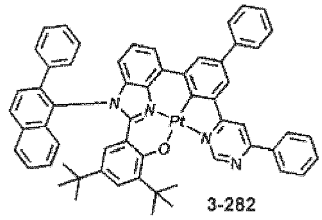
3-282

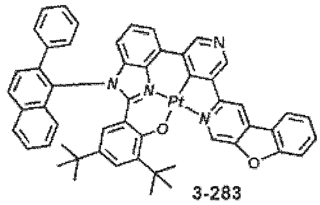
3-283

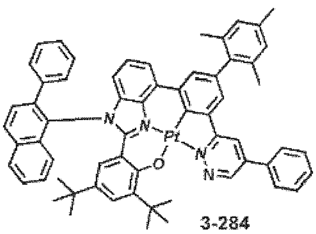
3-284

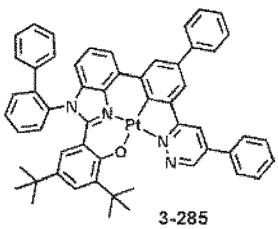
3-285

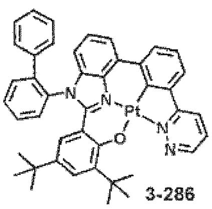
3-286

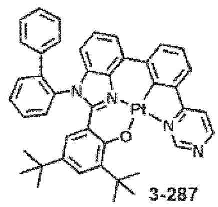
3-287

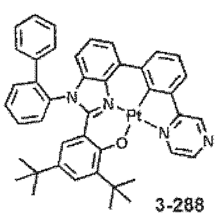
3-288

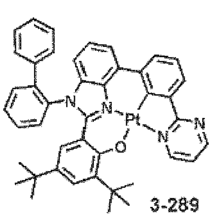
3-289

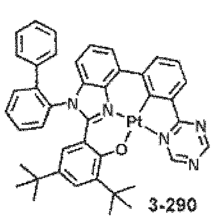
3-290

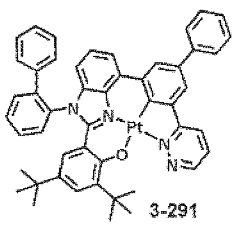
3-291

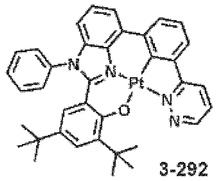
3-292

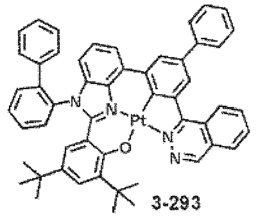
3-293

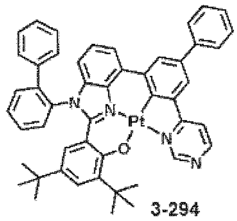
3-294

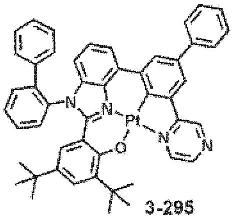
3-295

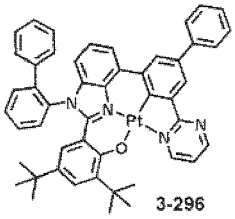
3-296

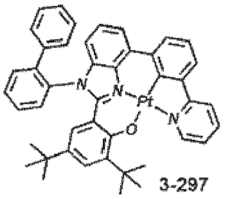
3-297

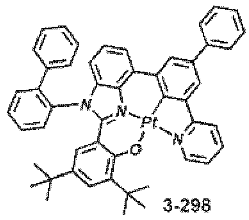
3-298

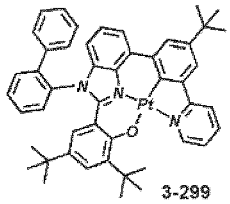
3-299

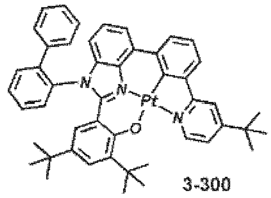
3-300

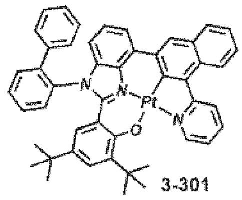
3-301

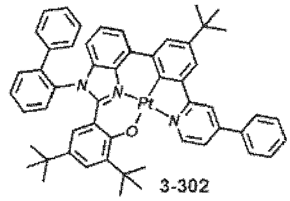
3-302

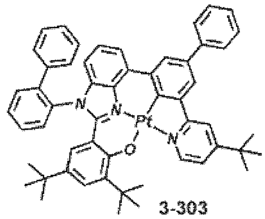
3-303

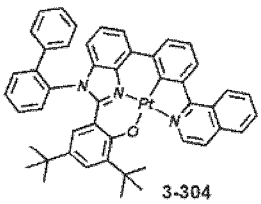
3-304

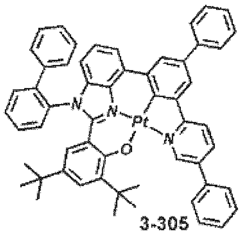
3-305

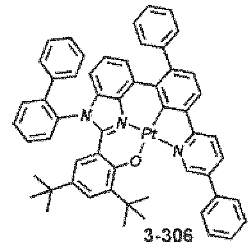
3-306

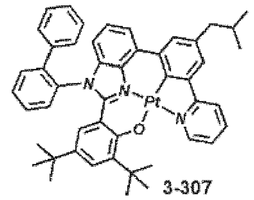
3-307

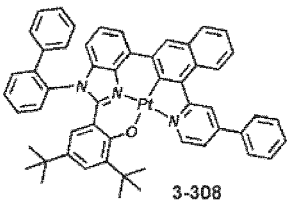
3-308

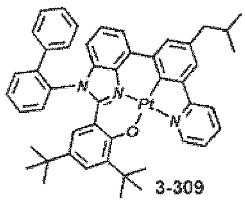
3-309

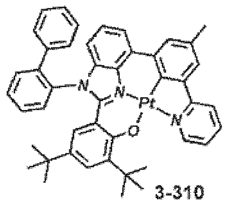
3-310

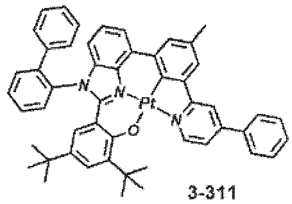
3-311

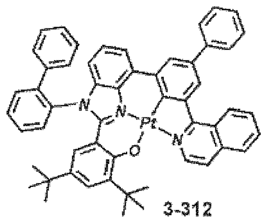
3-312

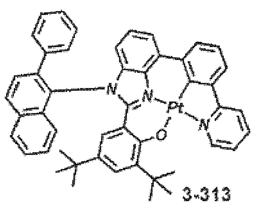
3-313

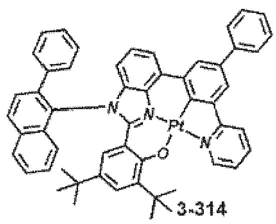
3-314

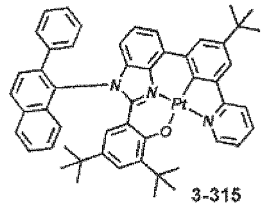
3-315

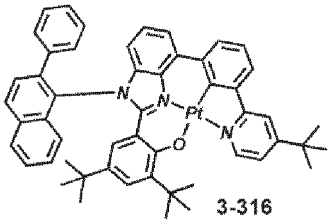
3-316

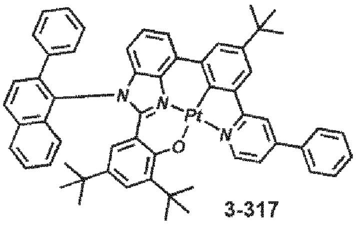
3-317

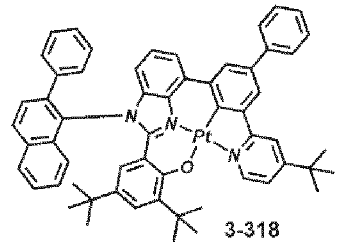
3-318

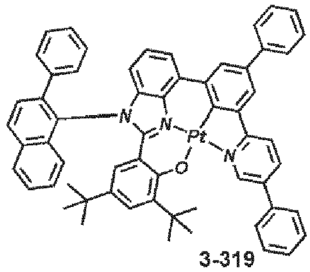
3-319

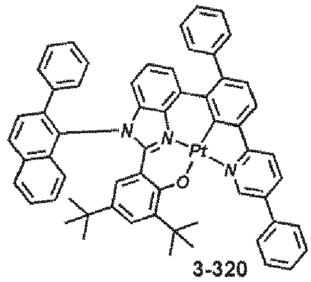
3-320

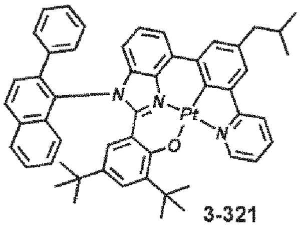
3-321

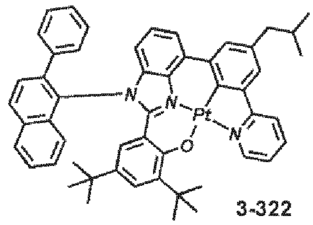
3-322

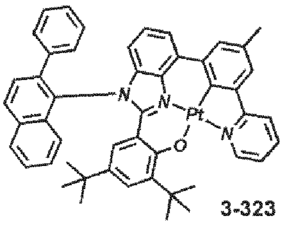
3-323

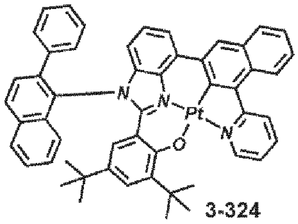
3-324

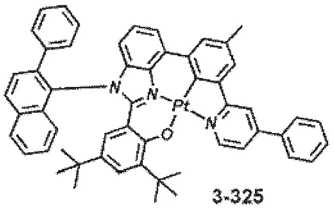
3-325

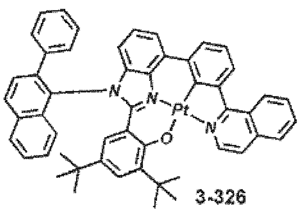
3-326

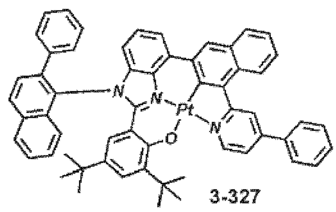
3-327

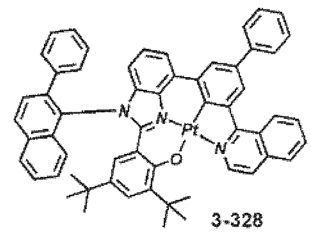
3-328

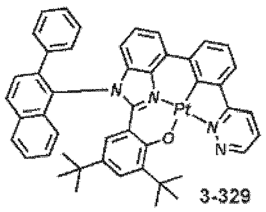
3-329

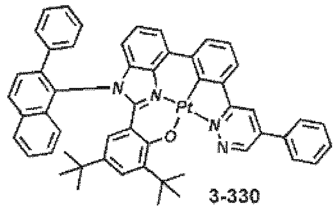
3-330

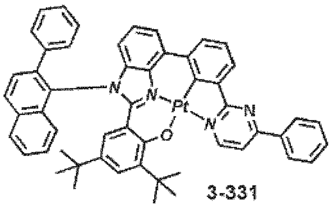
3-331

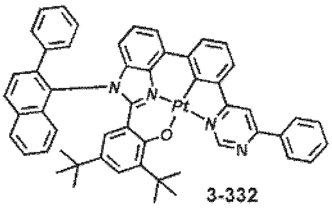
3-332

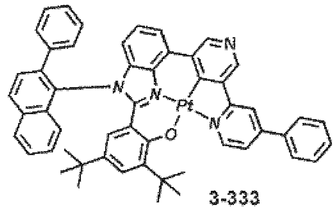
3-333

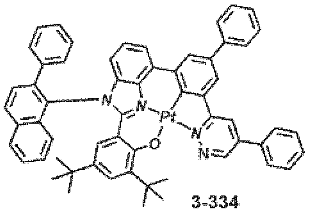
3-334

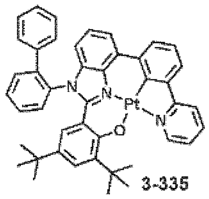
3-335

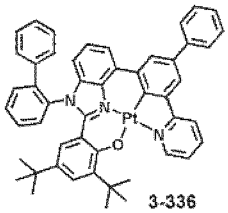
3-336

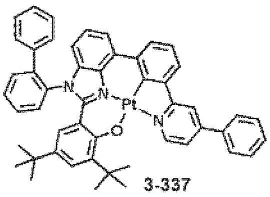
3-337

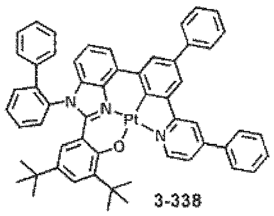
3-338

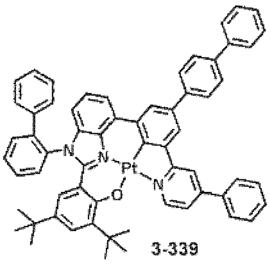
3-339

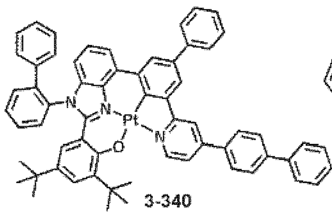
3-340

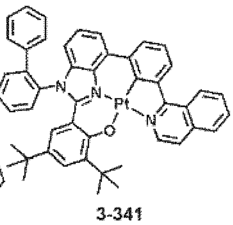
3-341

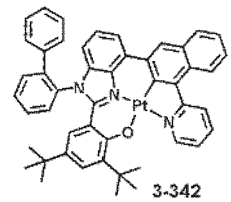
3-342

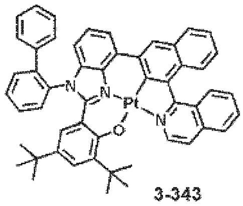
3-343

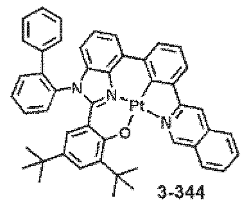
3-344

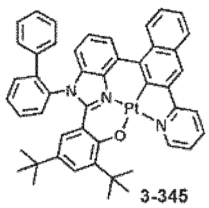
3-345

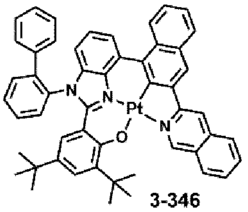
3-346

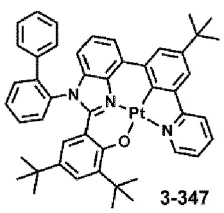
3-347

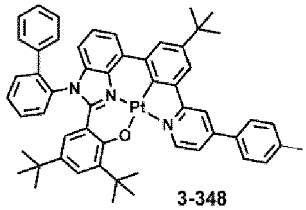
3-348

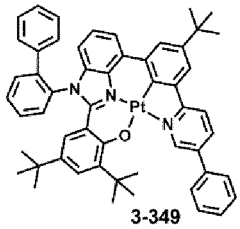
3-349

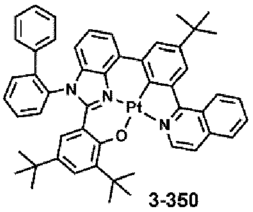
3-350

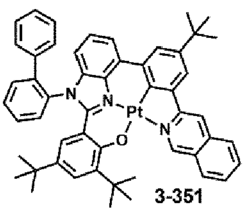
3-351

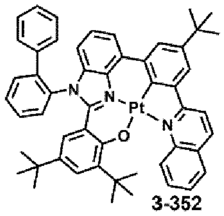
3-352

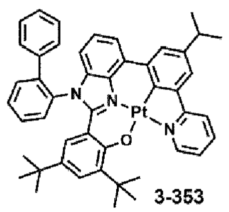
3-353

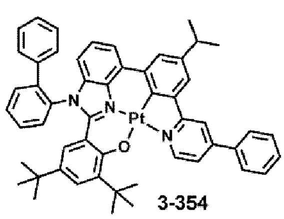
3-354

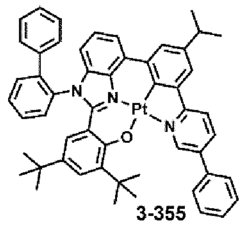
3-355

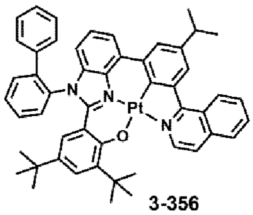
3-356

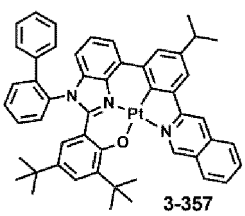
3-357

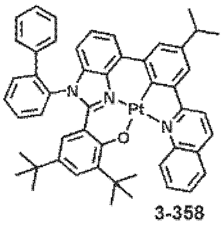
3-358

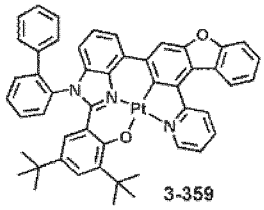
3-359

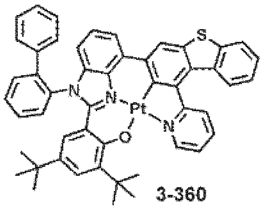
3-360

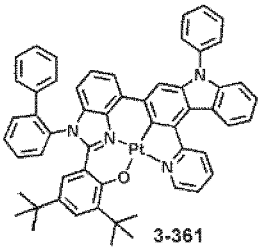
3-361

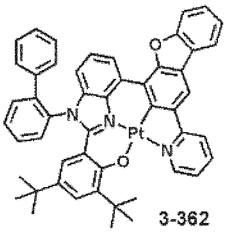
3-362

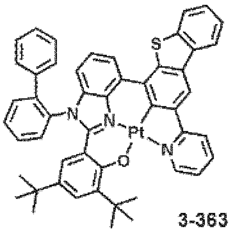
3-363

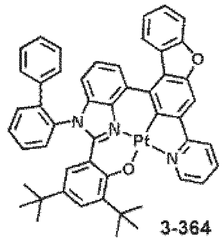
3-364

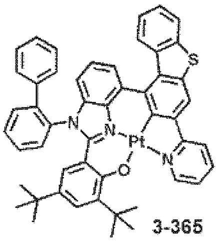
3-365

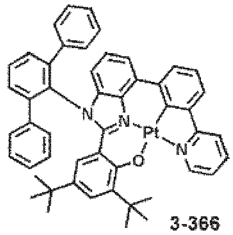
3-366

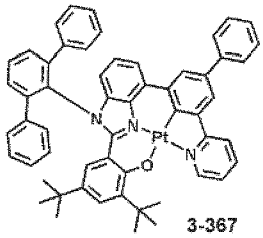
3-367

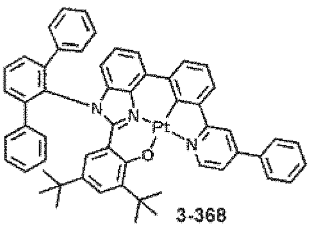
3-368

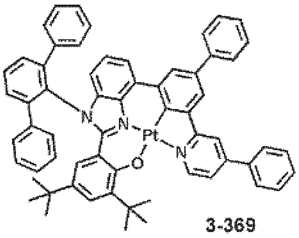
3-369

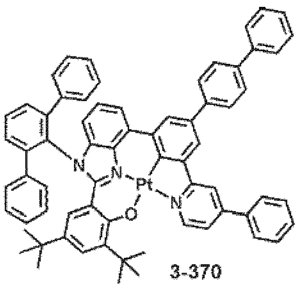
3-370

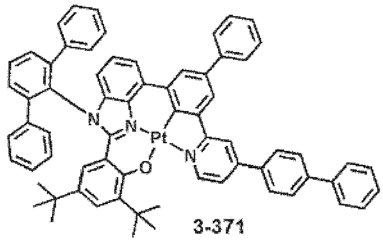
3-371

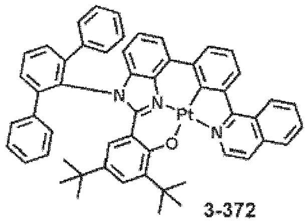
3-372

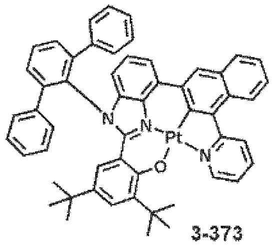
3-373

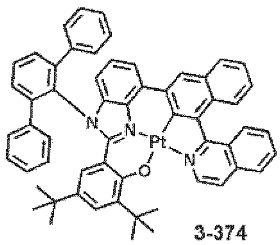
3-374

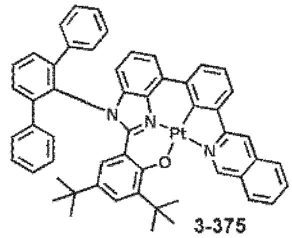
3-375

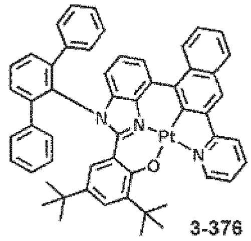
3-376

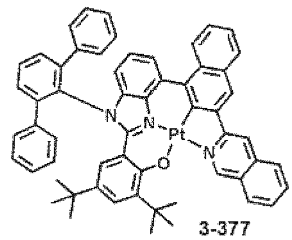
3-377

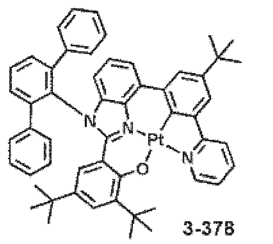
3-378

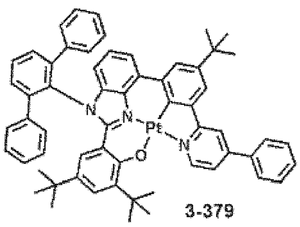
3-379

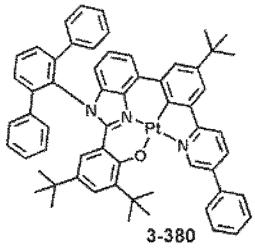
3-380

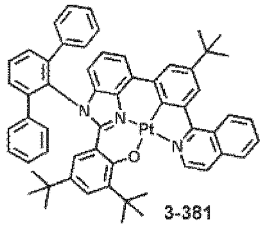
3-381

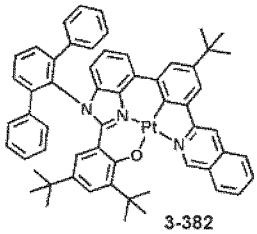
3-382

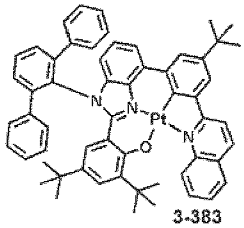
3-383

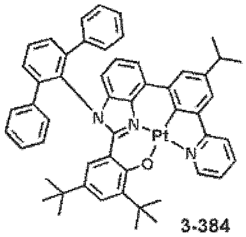
3-384

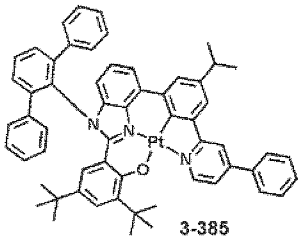
3-385

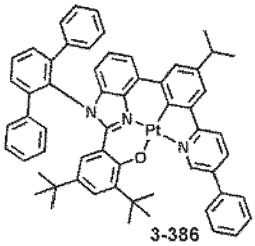
3-386

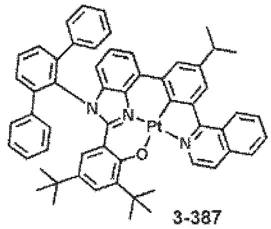
3-387

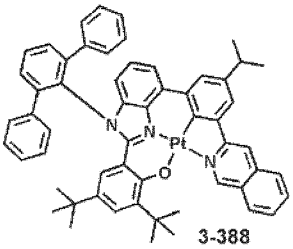
3-388

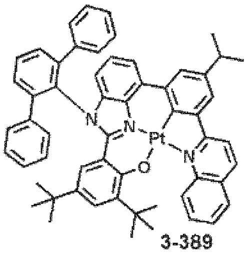
3-389

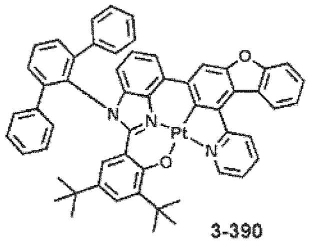
3-390

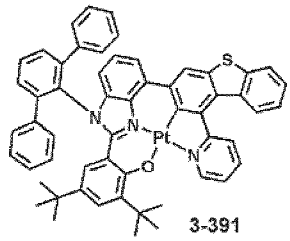
3-391

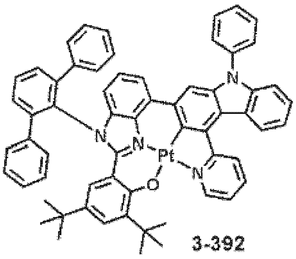
3-392

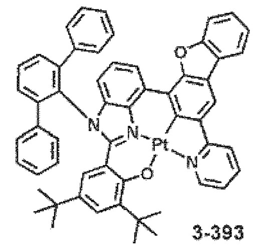
3-393

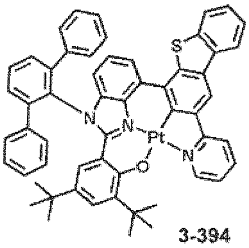
3-394

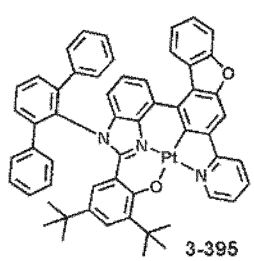
3-395

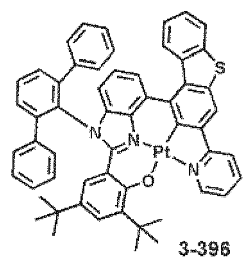
3-396

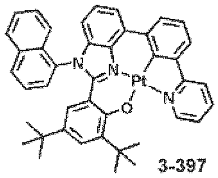
3-397

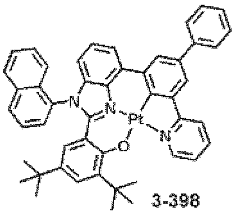
3-398

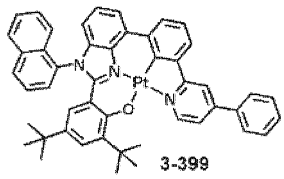
3-399

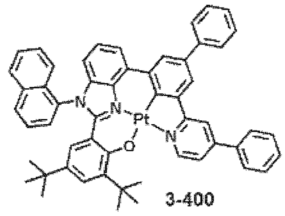
3-400

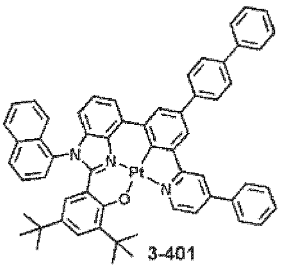
3-401

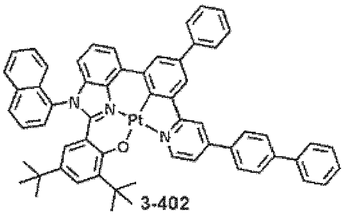
3-402

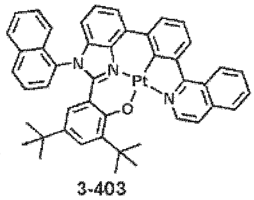
3-403

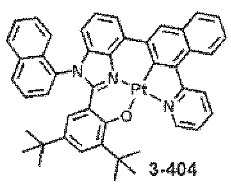
3-404

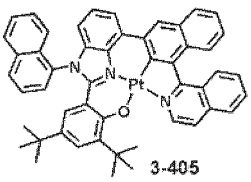
3-405

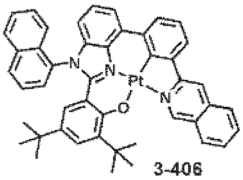
3-406

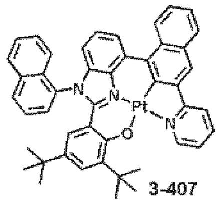
3-407

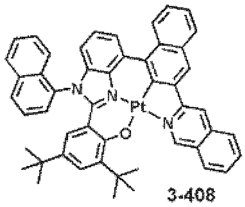
3-408

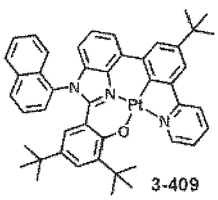
3-409

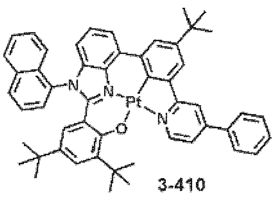
3-410

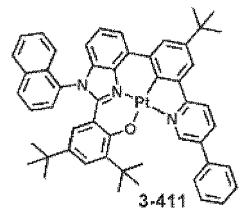
3-411

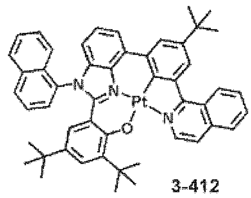
3-412

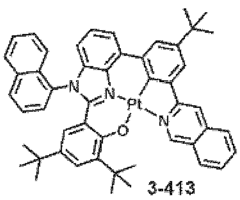
3-413

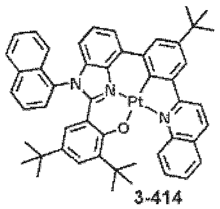
3-414

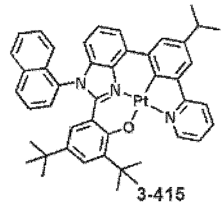
3-415

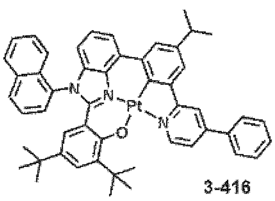
3-416

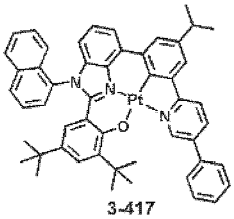
3-417

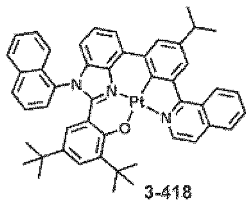
3-418

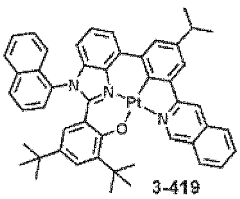
3-419

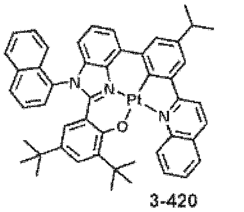
3-420

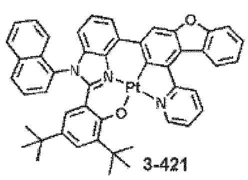
3-421

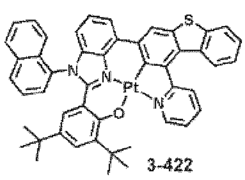
3-422

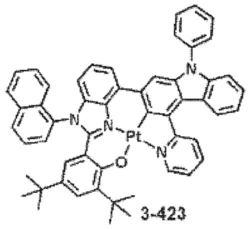
3-423

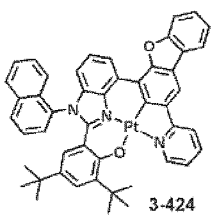
3-424

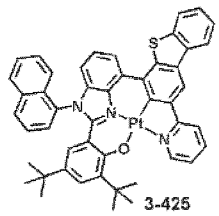
3-425

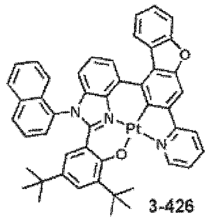
3-426

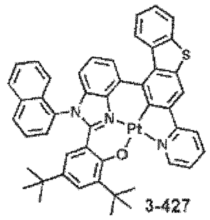
3-427

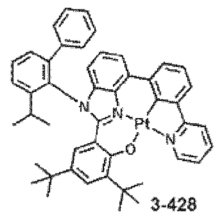
3-428

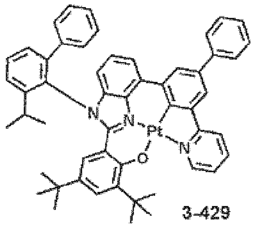
3-429

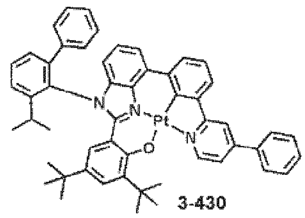
3-430

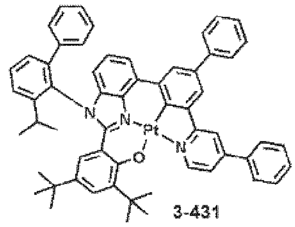
3-431

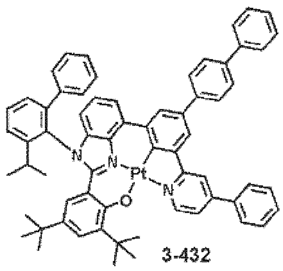
3-432

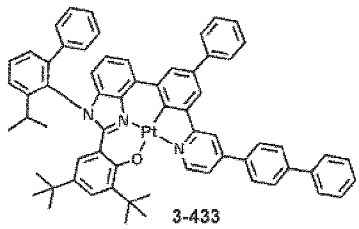
3-433

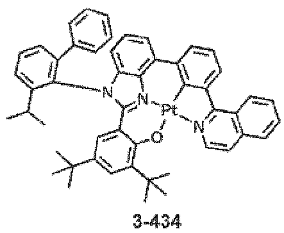
3-434

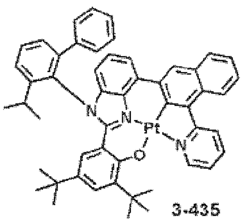
3-435

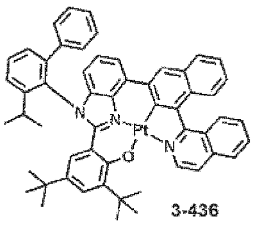
3-436

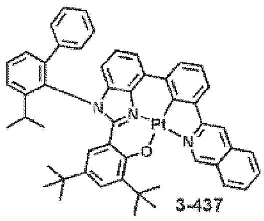
3-437

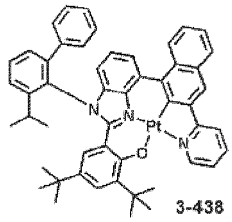
3-438

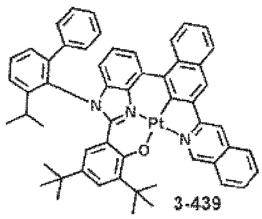
3-439

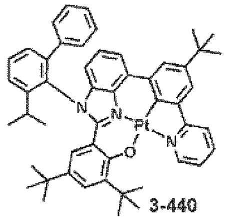
3-440

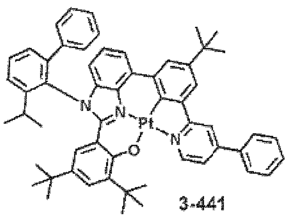
3-441

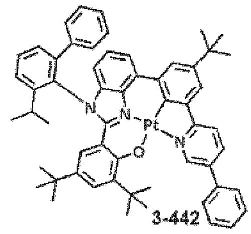
3-442

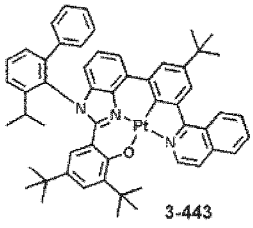
3-443

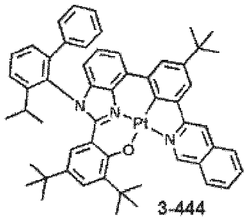
3-444

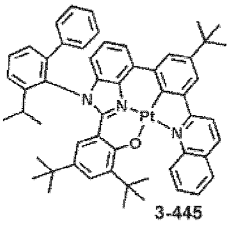
3-445

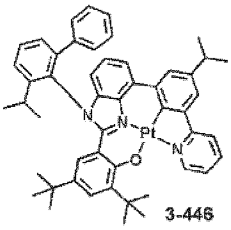
3-446

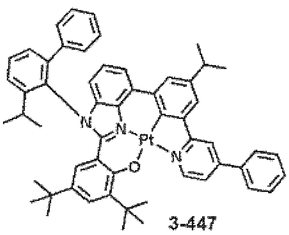
3-447

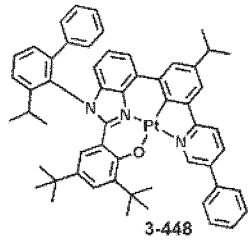
3-448

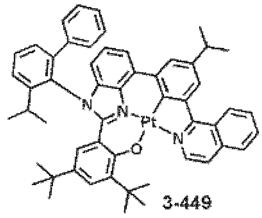
3-449

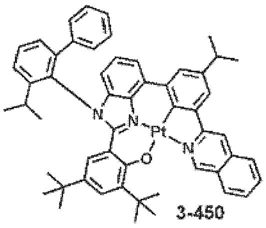
3-450

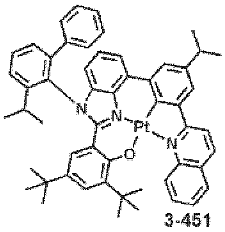
3-451

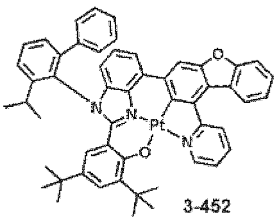
3-452

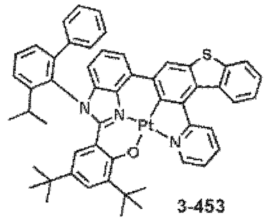
3-453

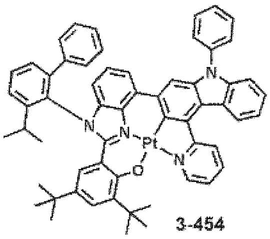
3-454

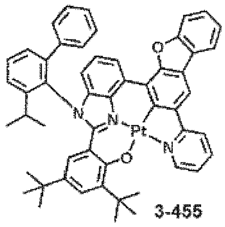
3-455

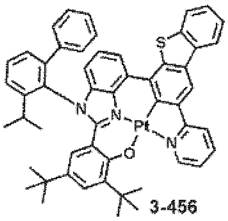
3-456

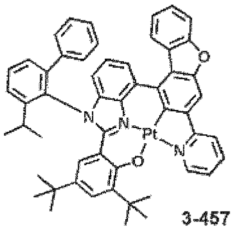
3-457

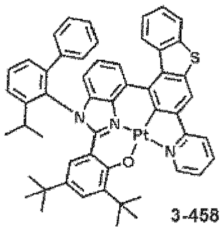
3-458

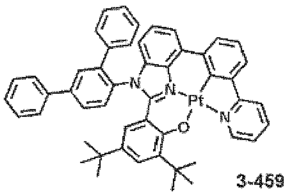
3-459

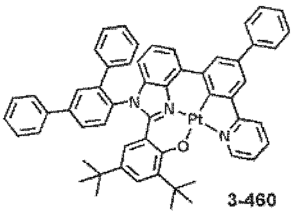
3-460

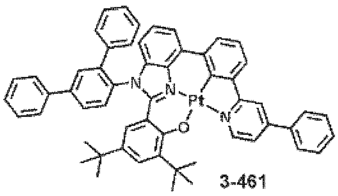
3-461

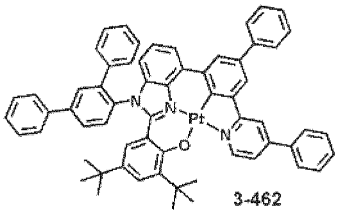
3-462

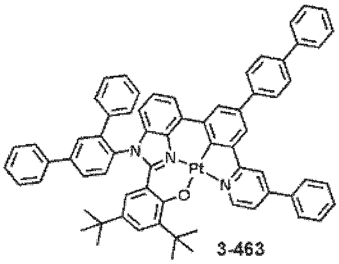
3-463

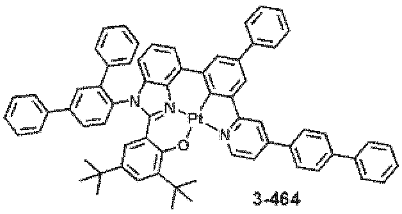
3-464

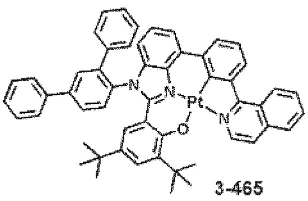
3-465

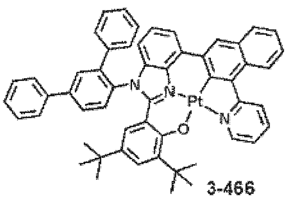
3-466

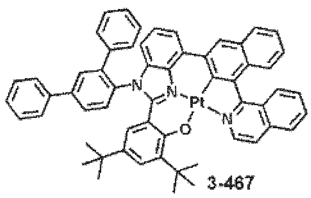
3-467

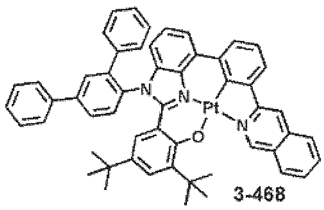
3-468

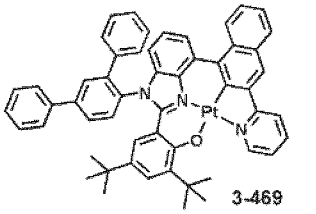
3-469

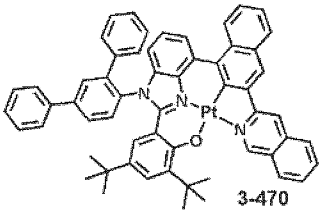
3-470

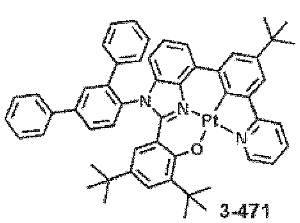
3-471

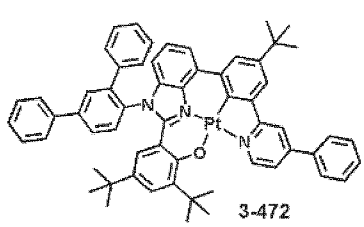
3-472

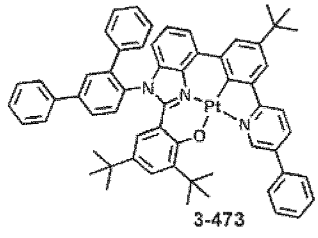
3-473

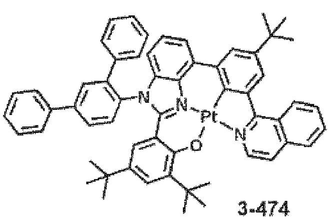
3-474

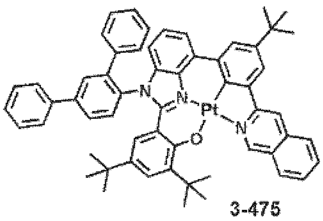
3-475

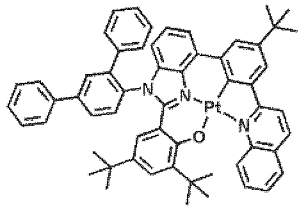
3-476

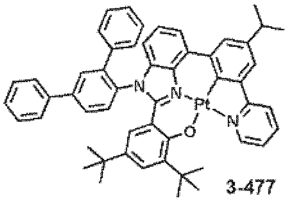
3-477

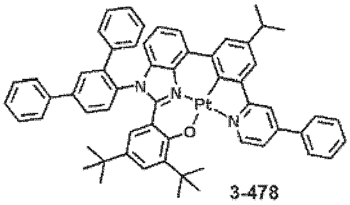
3-478

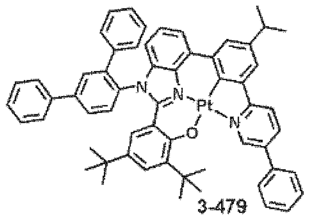
3-479

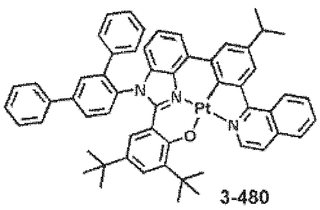
3-480

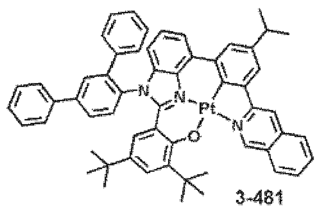
3-481

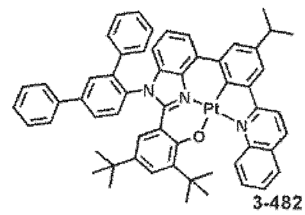
3-482

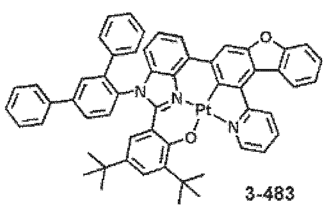
3-483

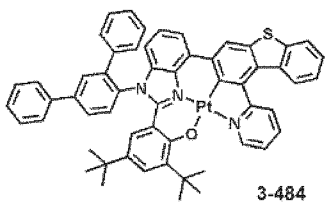
3-484

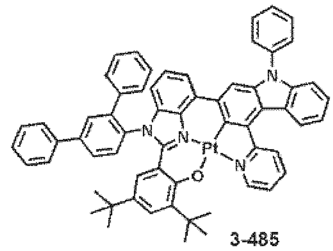
3-485

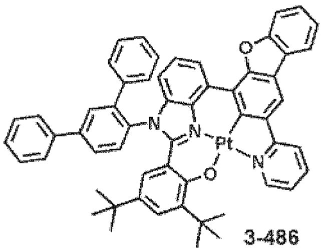
3-486

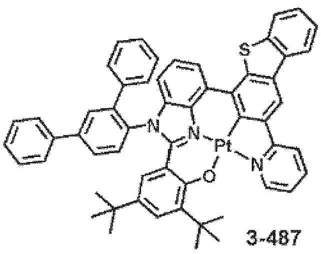
3-487

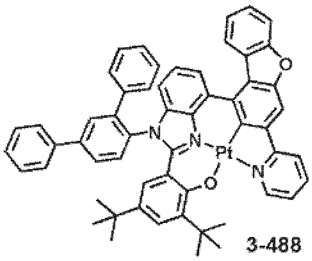
3-488

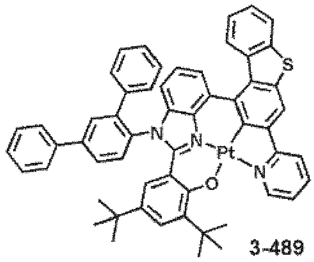
3-489

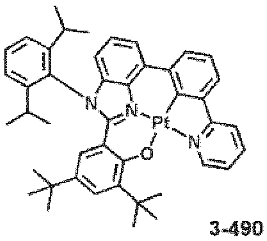
3-490

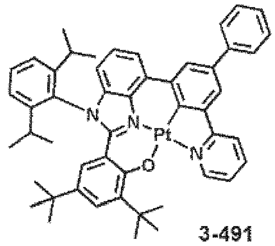
3-491

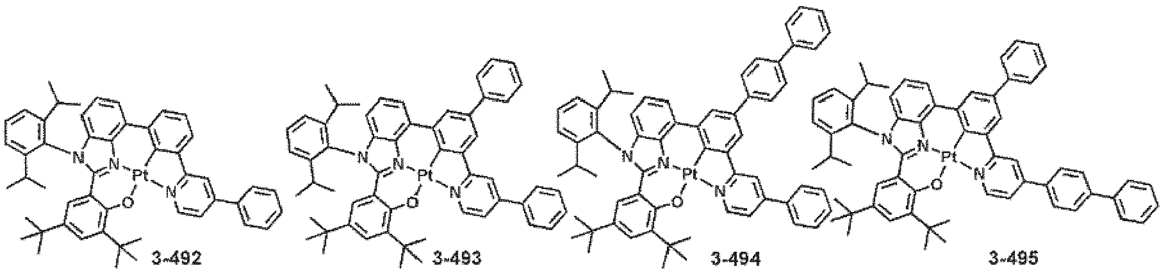
3-492 3-493 3-494 3-495

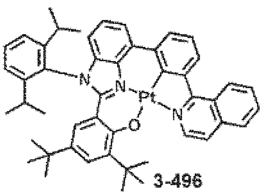
3-496

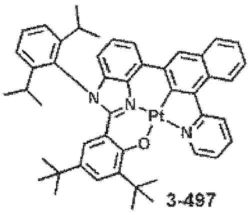
3-497

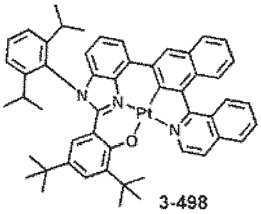
3-498

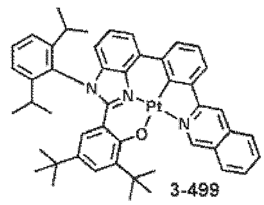
3-499

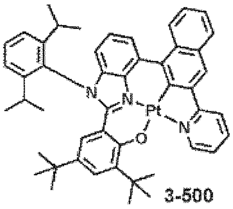
3-500

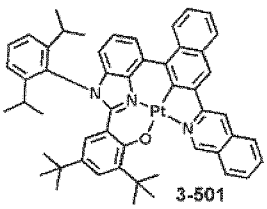
3-501

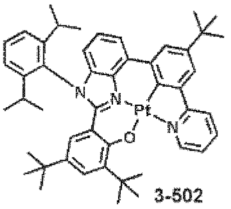
3-502

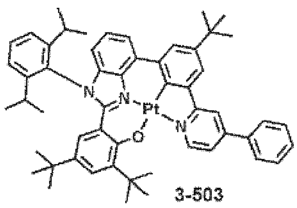
3-503

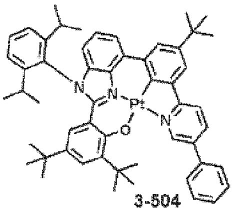
3-504

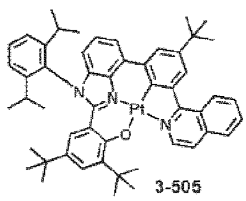
3-505

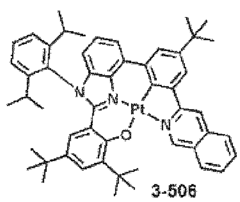
3-506

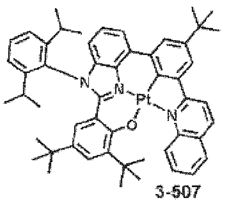
3-507

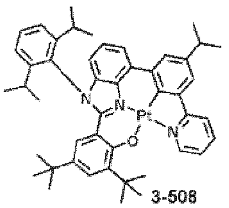
3-508

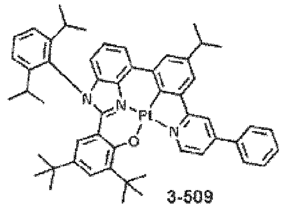
3-509

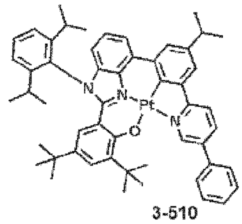
3-510

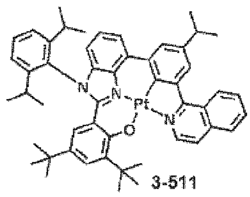
3-511

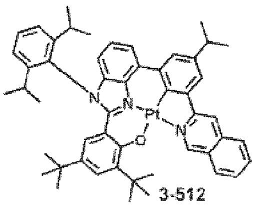
3-512

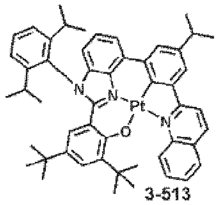
3-513

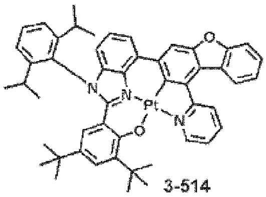
3-514

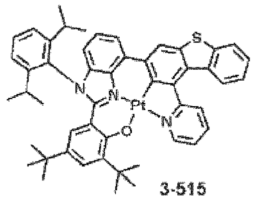
3-515

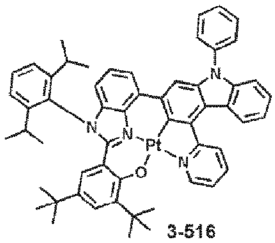
3-516

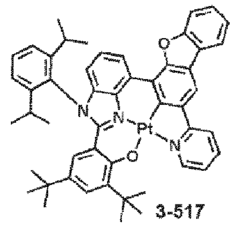
3-517

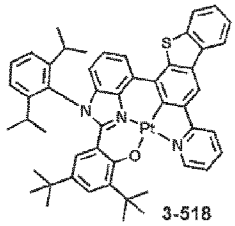
3-518

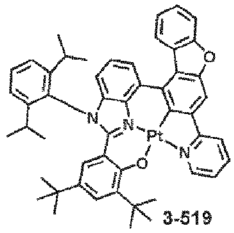
3-519

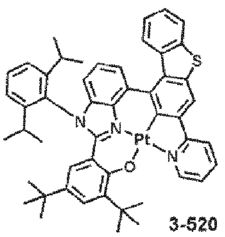
3-520

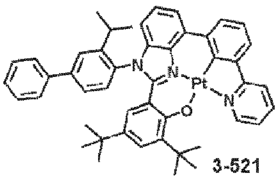
3-521

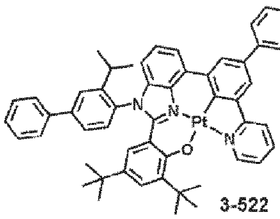
3-522

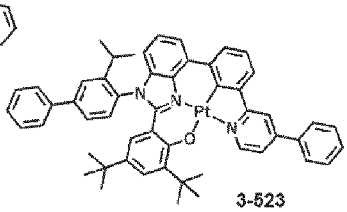
3-523

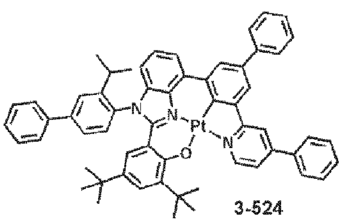
3-524

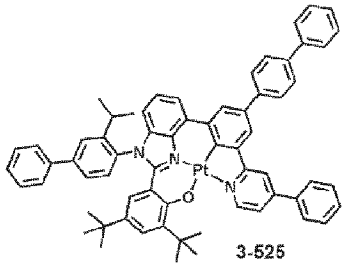
3-525

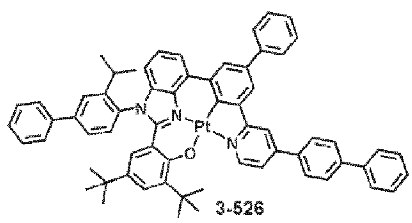
3-526

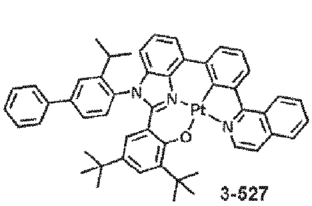
3-527

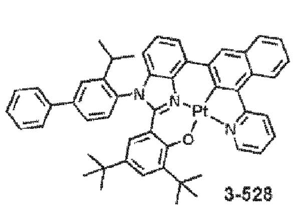
3-528

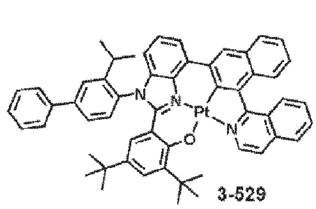
3-529

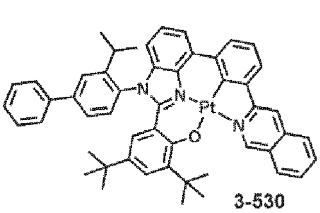
3-530

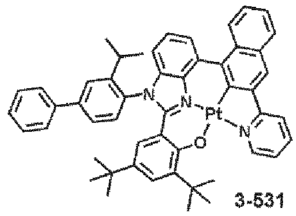
3-531

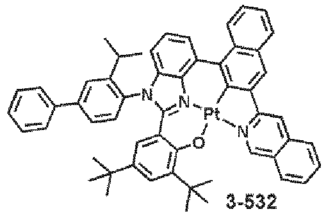
3-532

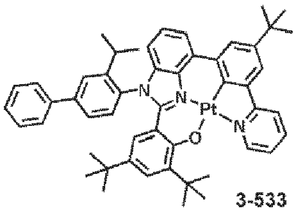
3-533

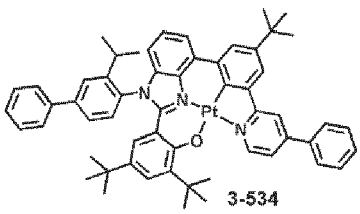
3-534

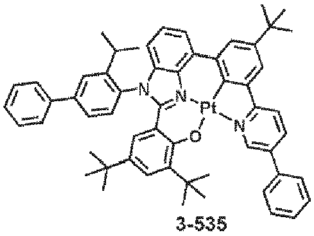
3-535

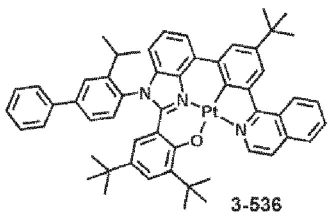
3-536

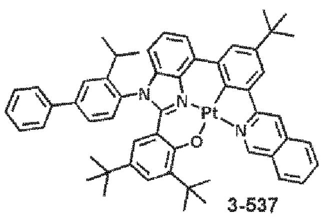
3-537

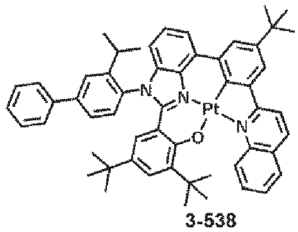
3-538

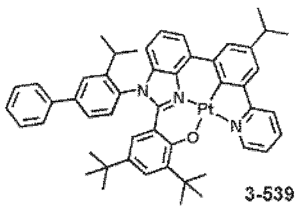
3-539

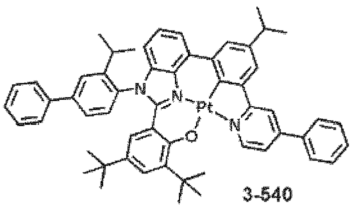
3-540

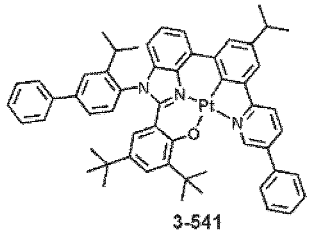
3-541

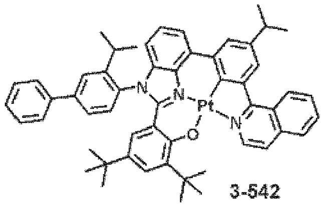
3-542

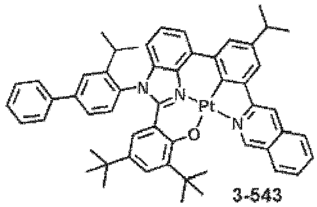
3-543

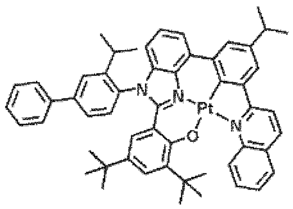
3-544

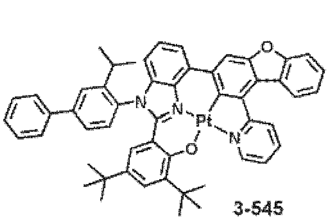
3-545

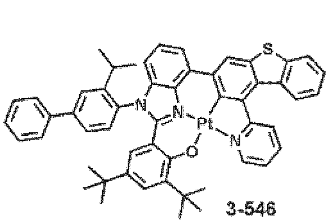
3-546

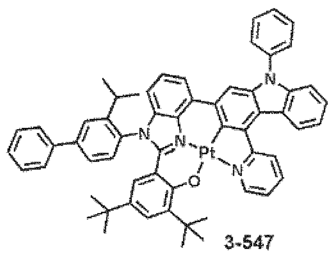
3-547

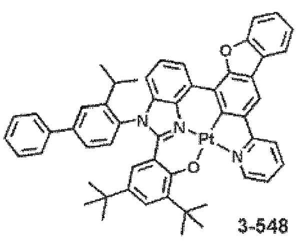
3-548

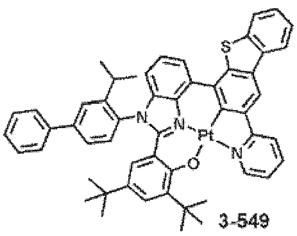
3-549

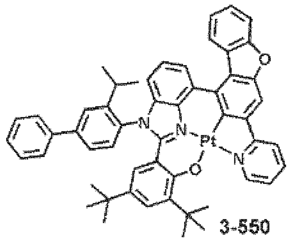
3-550

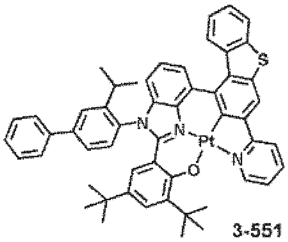
3-551

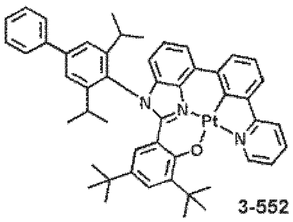
3-552

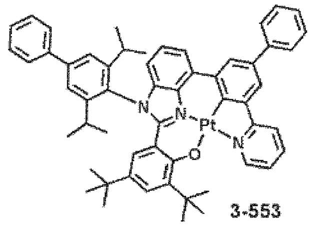
3-553

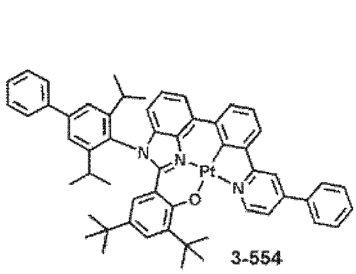
3-554

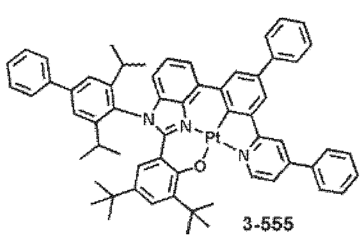
3-555

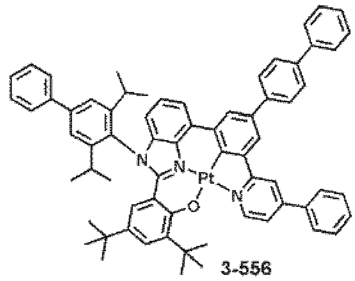
3-556

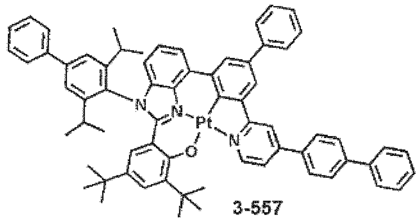
3-557

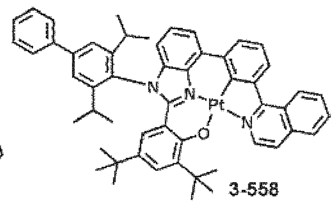
3-558

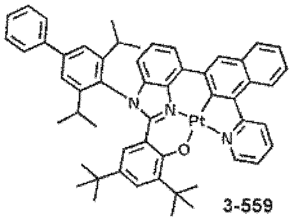
3-559

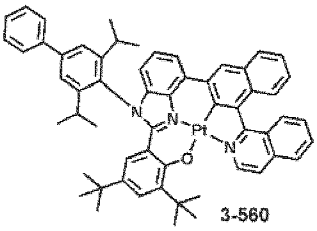
3-560

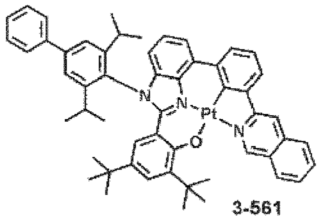
3-561

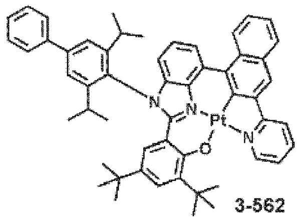
3-562

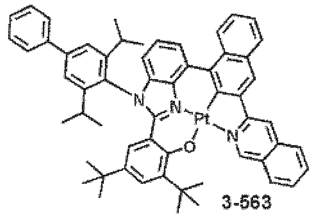
3-563

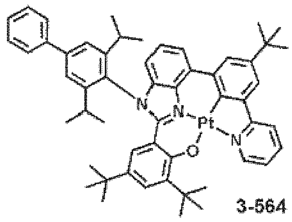
3-564

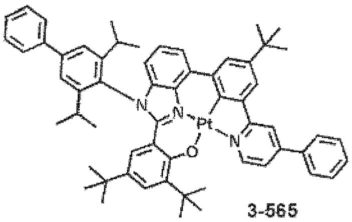
3-565

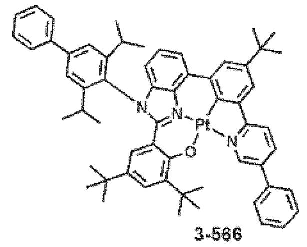
3-566

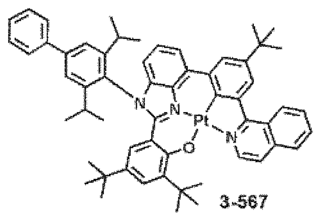
3-567

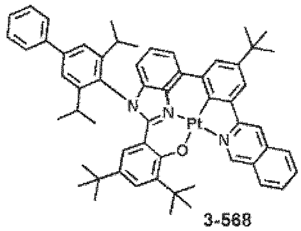
3-568

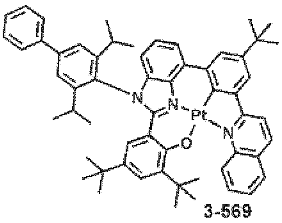
3-569

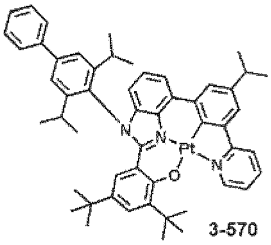
3-570

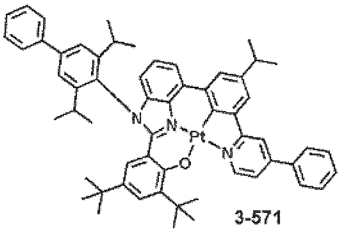
3-571

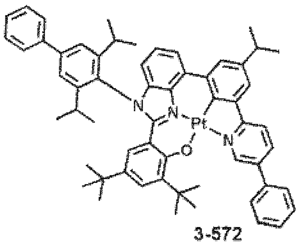
3-572

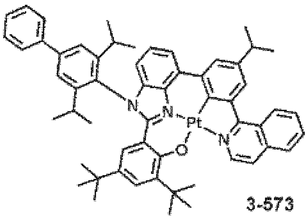
3-573

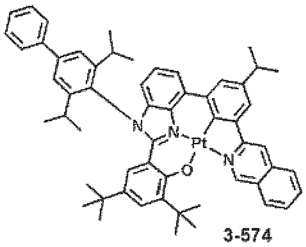
3-574

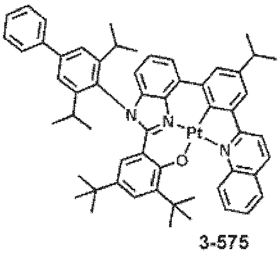
3-575

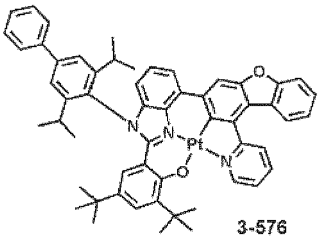
3-576

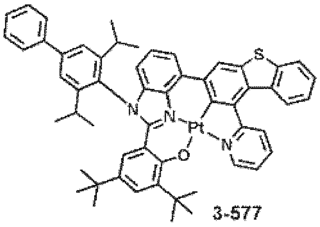
3-577

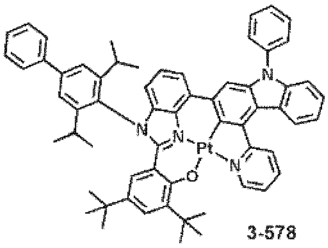
3-578

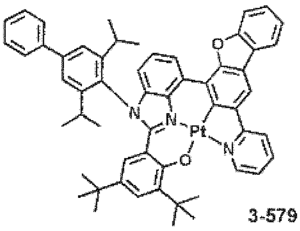
3-579

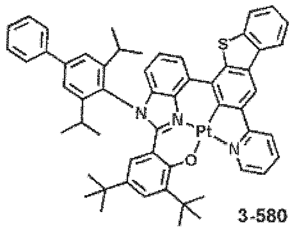
3-580

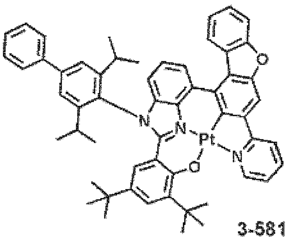
3-581

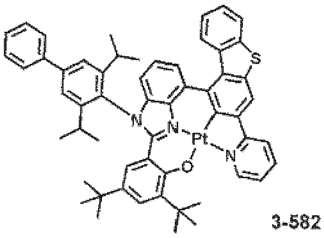
3-582

Group 1-2

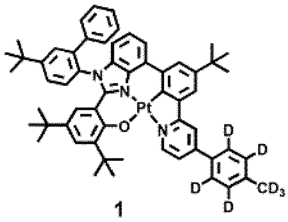
1

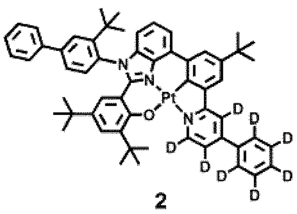
2

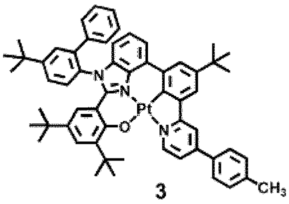
3

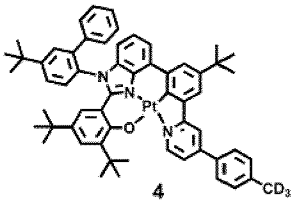
4

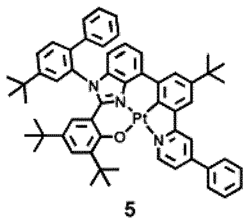
5

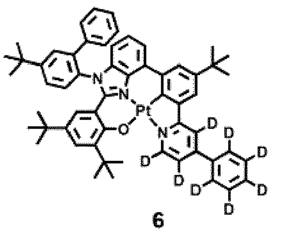
6

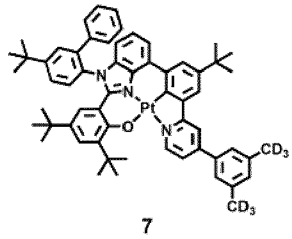
7

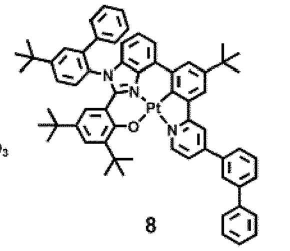
8

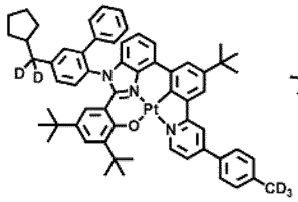
9

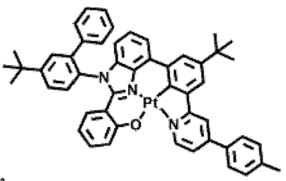
10

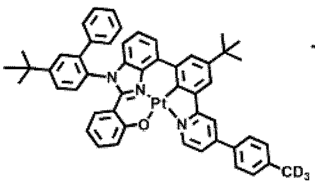
11

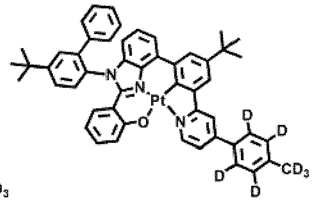
12

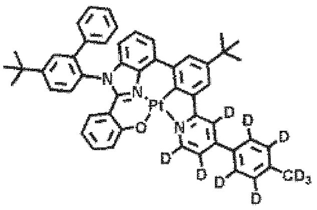
13

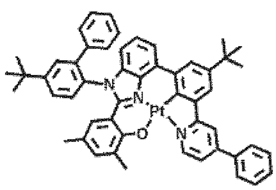
14

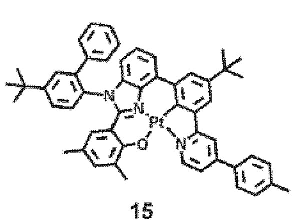
15

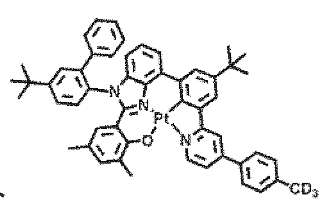
16

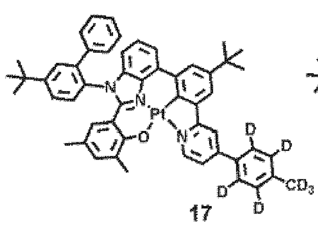
17

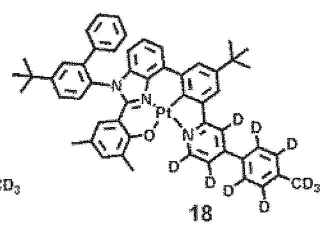
18

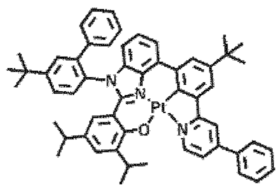
19

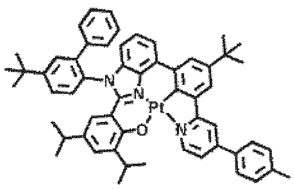
20

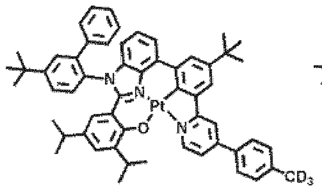
21

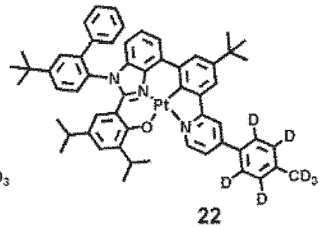
22

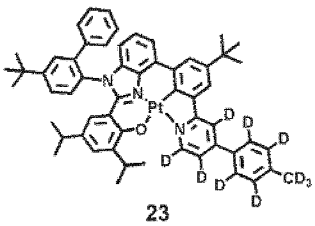
23

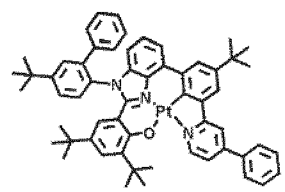
24

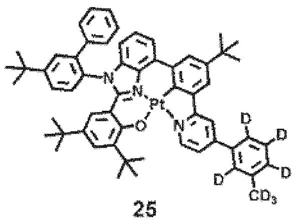
25

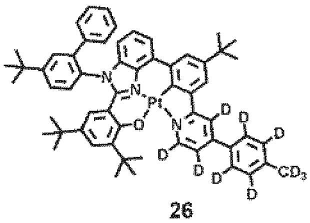
26

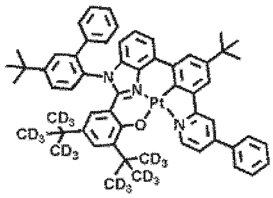
27

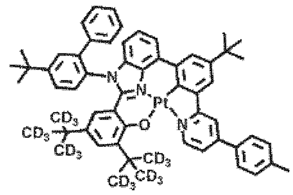
28

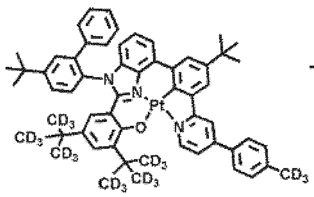
29

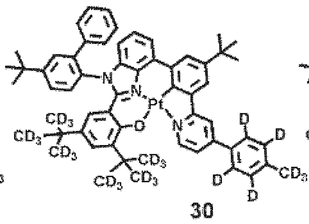
30

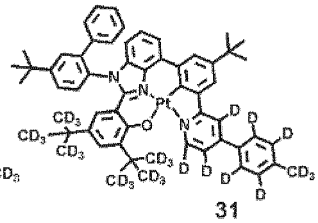
31

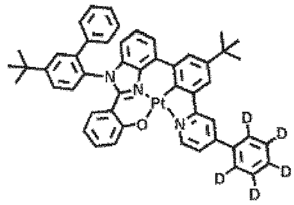
32

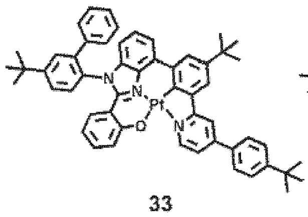
33

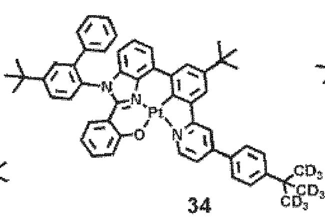
34

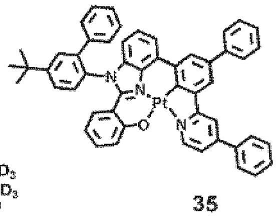
35

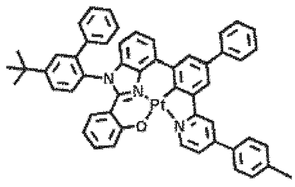
36

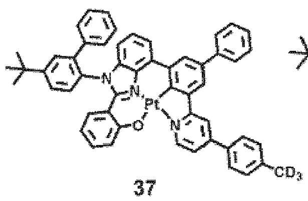
37

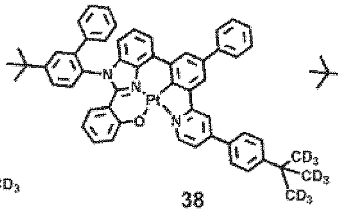
38

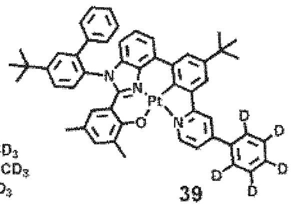
39

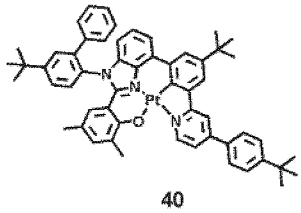
40

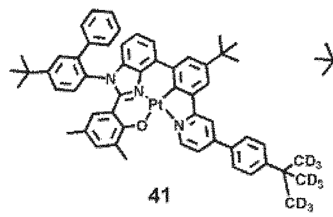
41

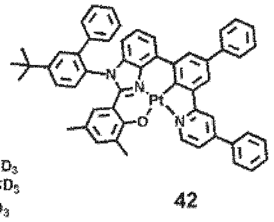
42

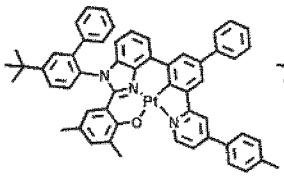
43

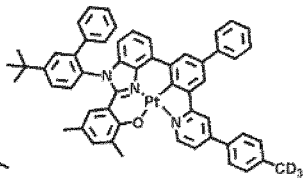
44

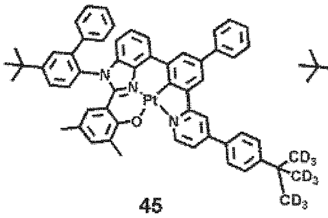
45

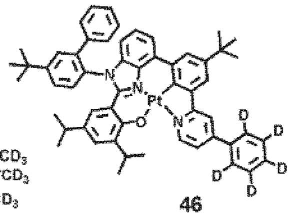
46

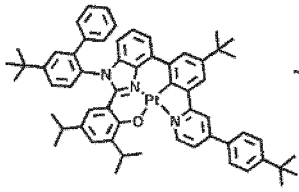
47

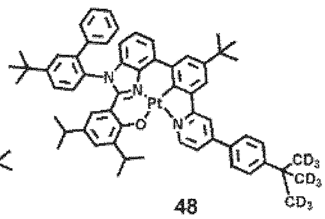
48

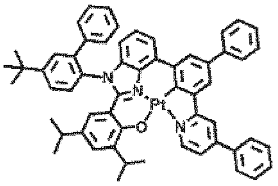
49

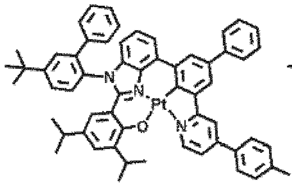
50

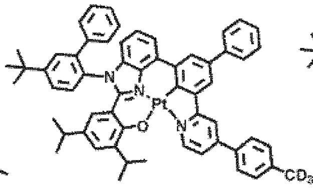
51

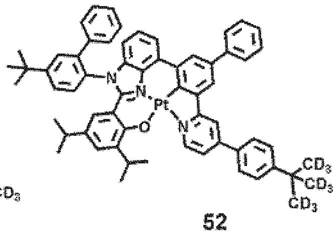
52

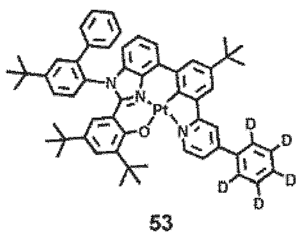
53

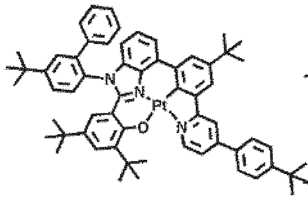
54

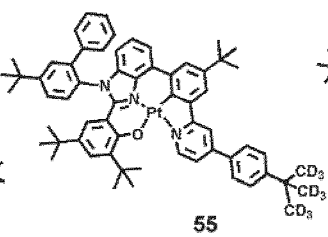
55

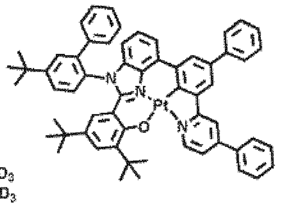
56

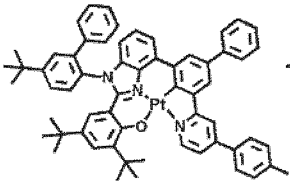
57

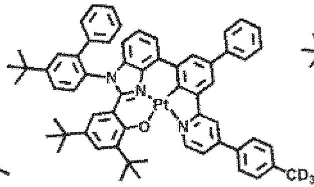
58

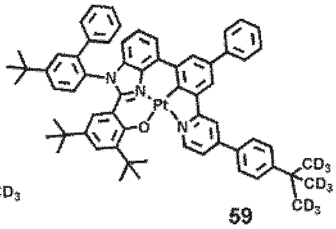
59

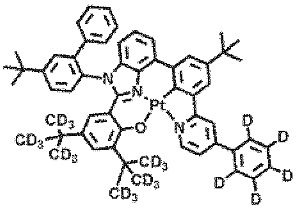
60

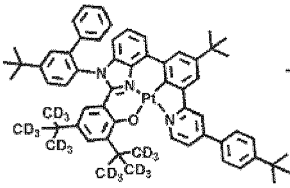
61

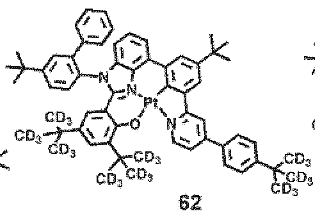
62

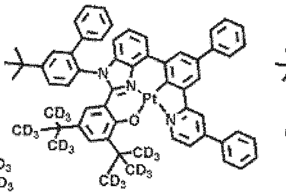
63

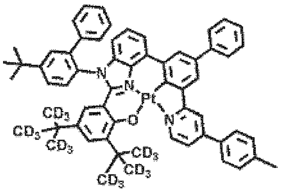
64

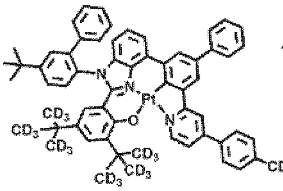
65

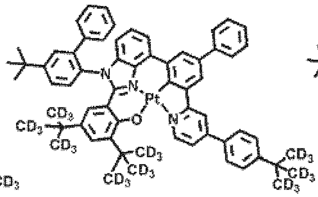
66

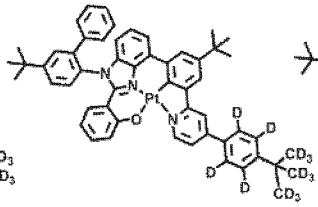
67

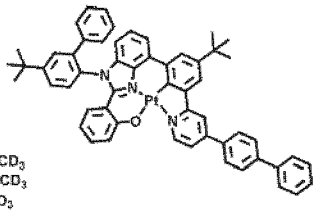
68

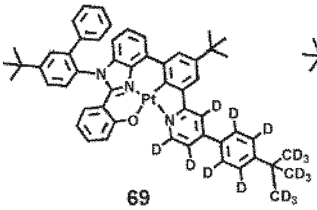
69

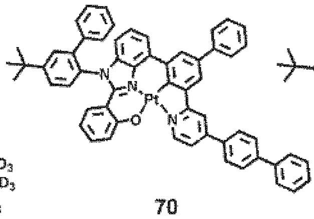
70

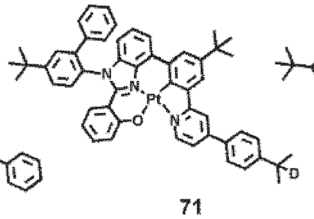
71

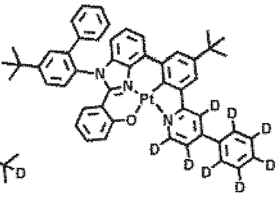
72

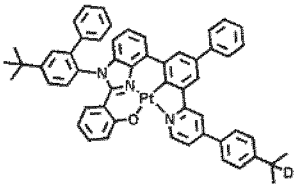
73
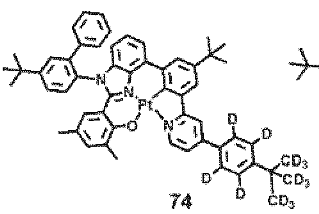
74
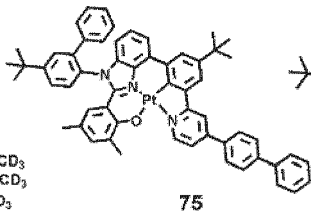
75
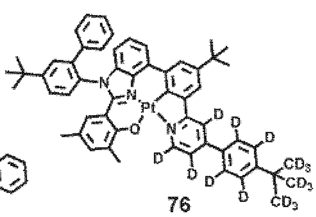
76

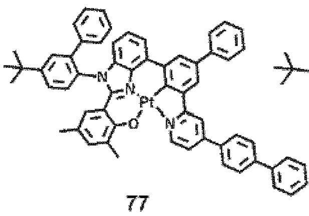
77
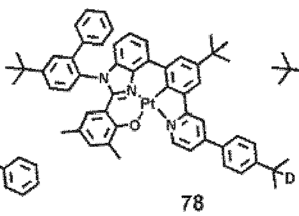
78
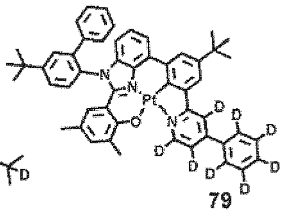
79
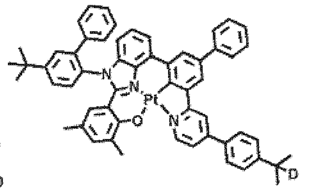
80

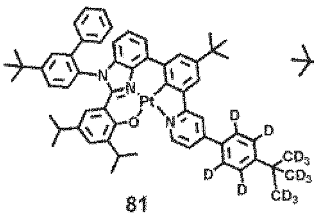
81
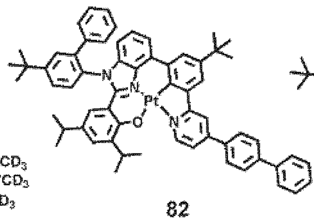
82
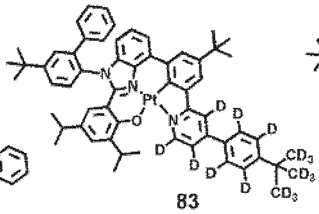
83
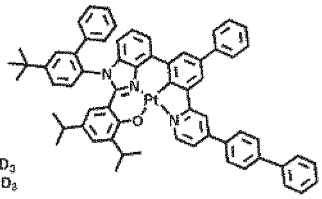
84

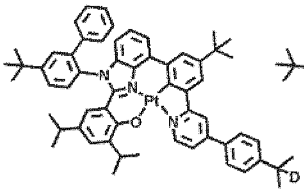
85
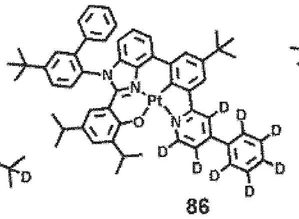
86
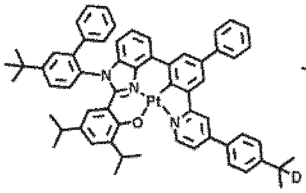
87
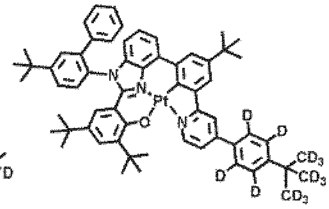
88

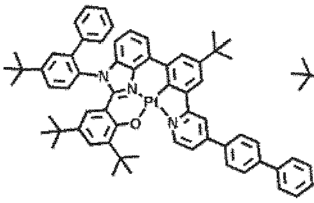
89
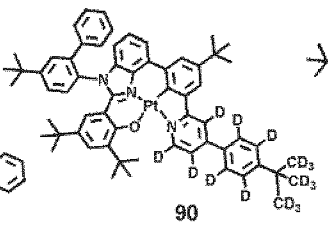
90
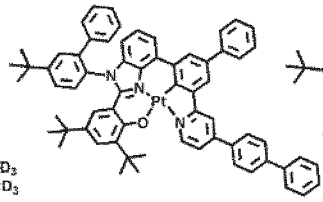
91
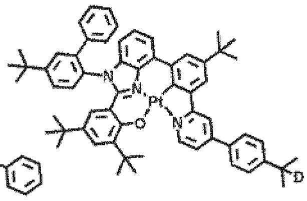
92

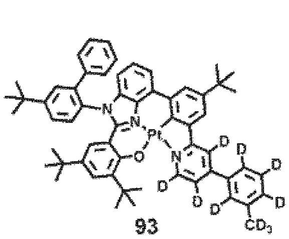
93
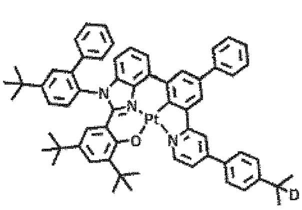
94
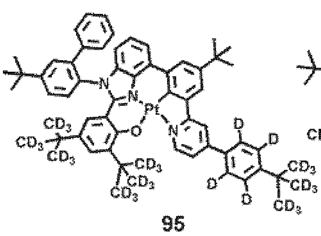
95
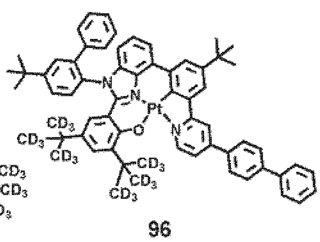
96

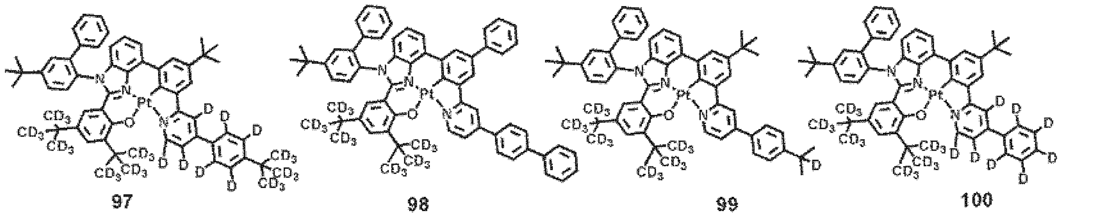

97 98 99 100

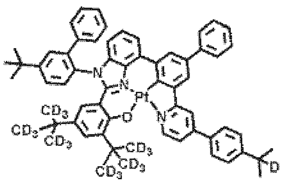

101

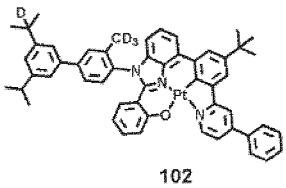

102

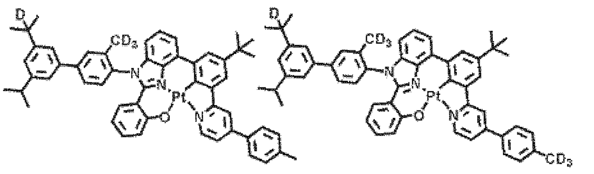

103 104

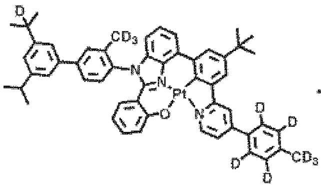

105

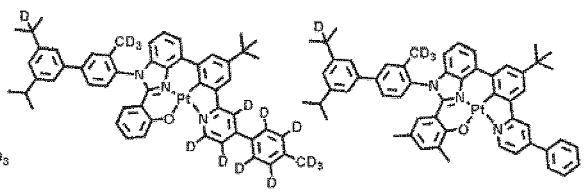

106 107

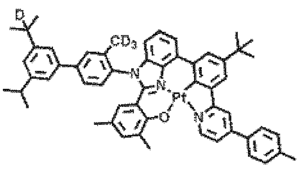

108

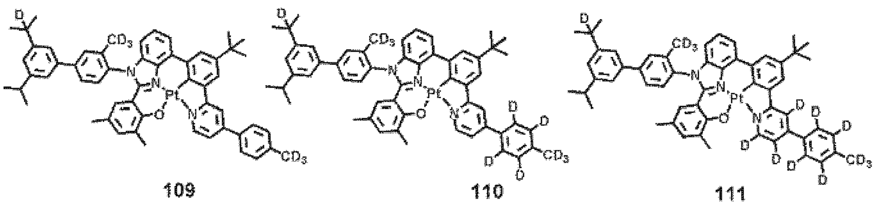

109 110 111

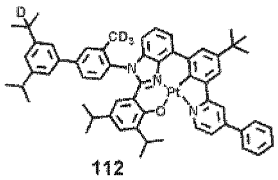

112

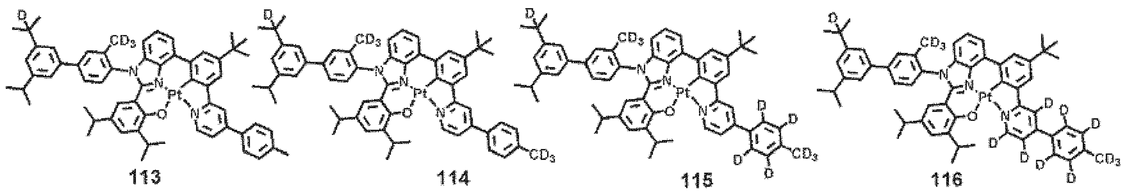

113 114 115 116

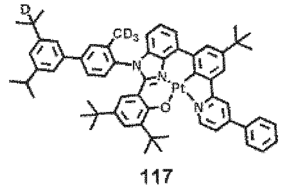

117

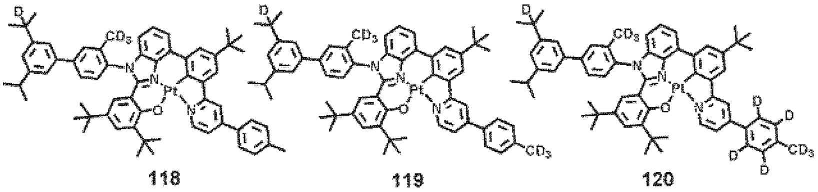

118 119 120

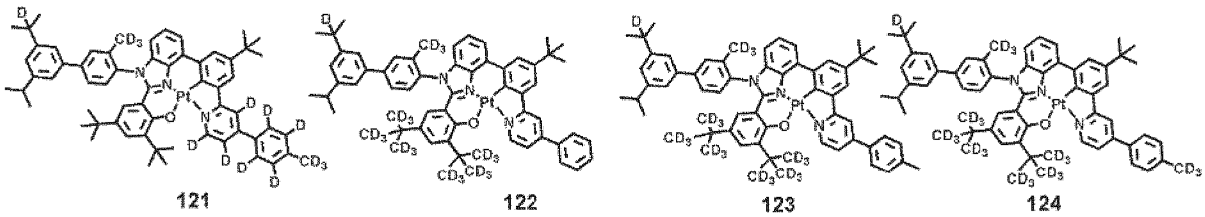

121 122 123 124

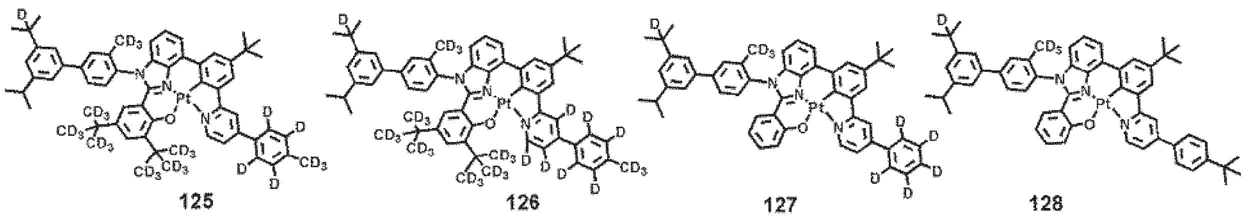

125 126 127 128

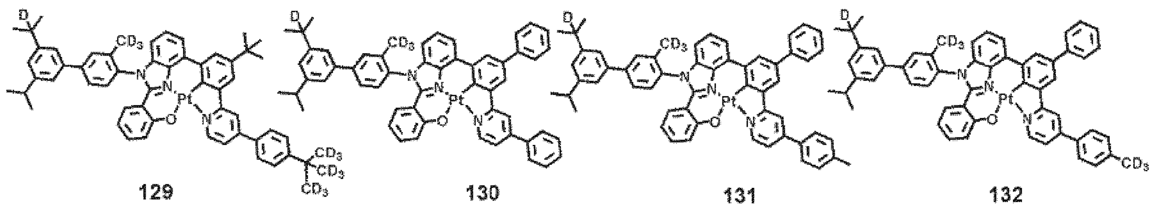

129 130 131 132

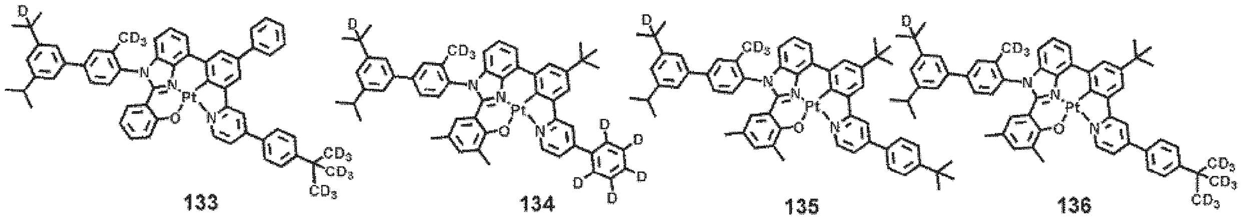

133 134 135 136

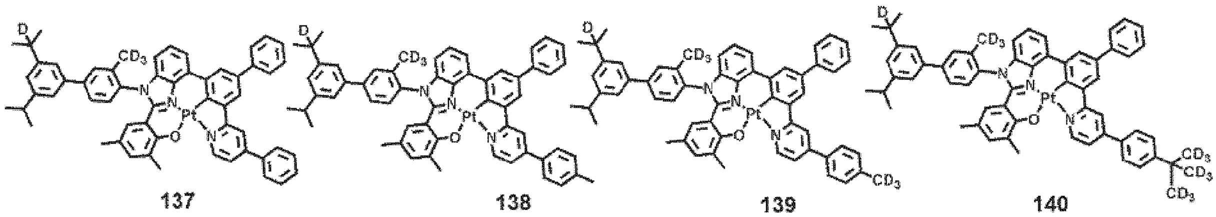

137 138 139 140

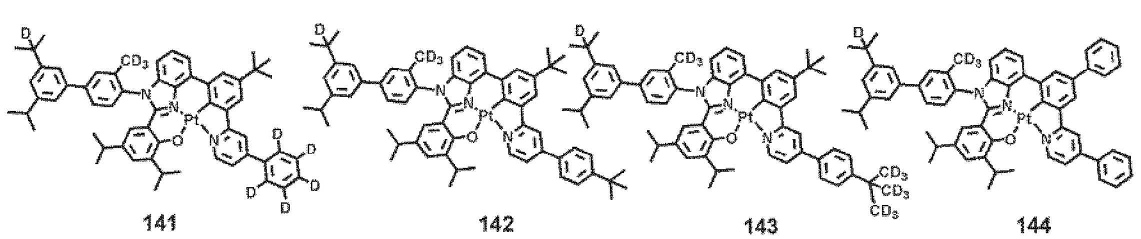

141 142 143 144

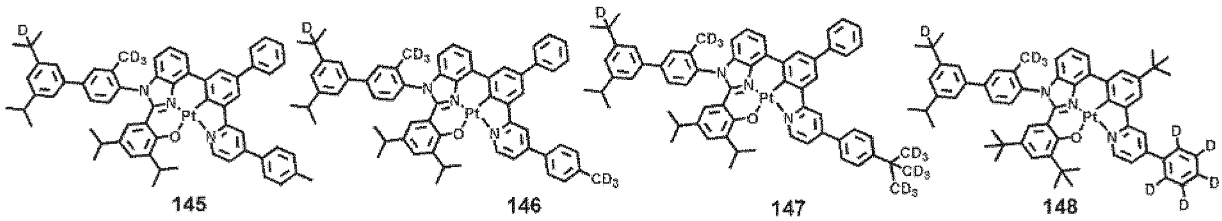

145 146 147 148

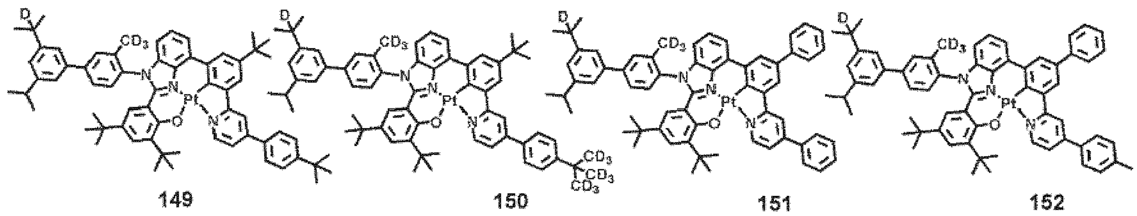

149 150 151 152

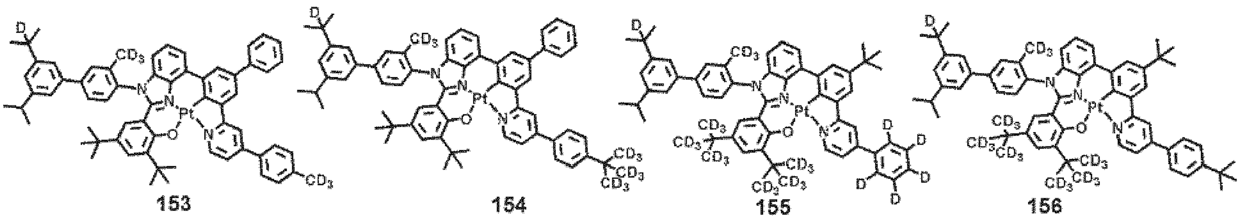

153 154 155 156

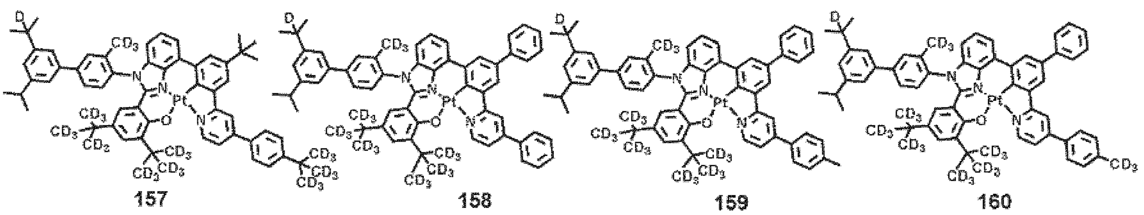

157 158 159 160

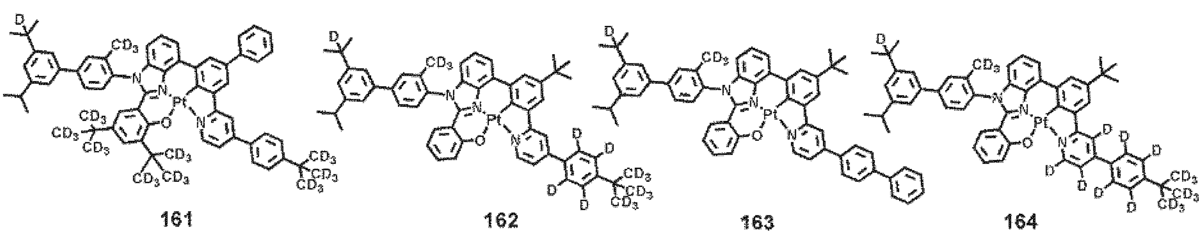

161 162 163 164

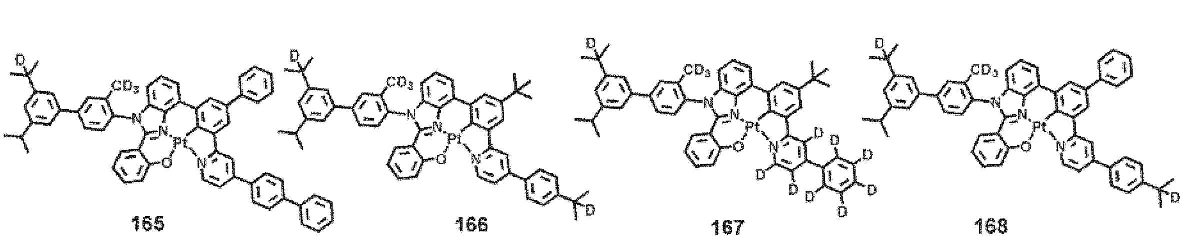

165 166 167 168

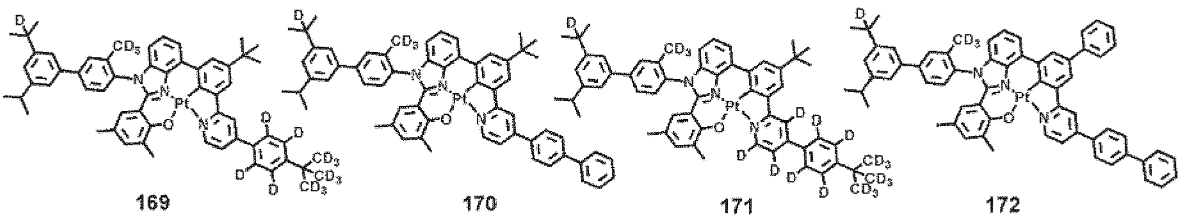

169 170 171 172

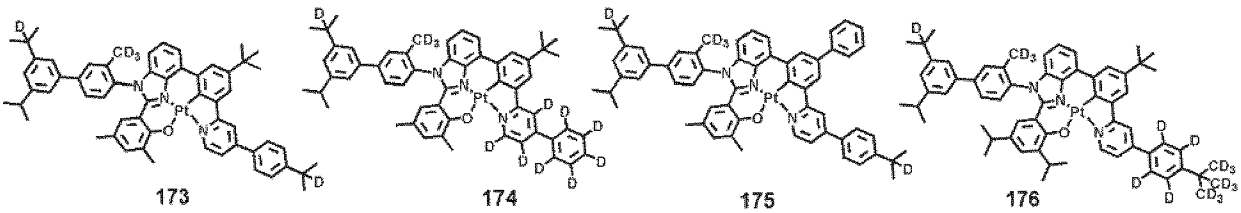

173 174 175 176

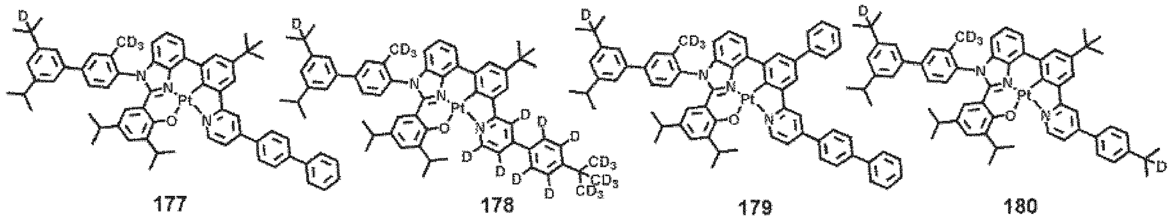

177 178 179 180

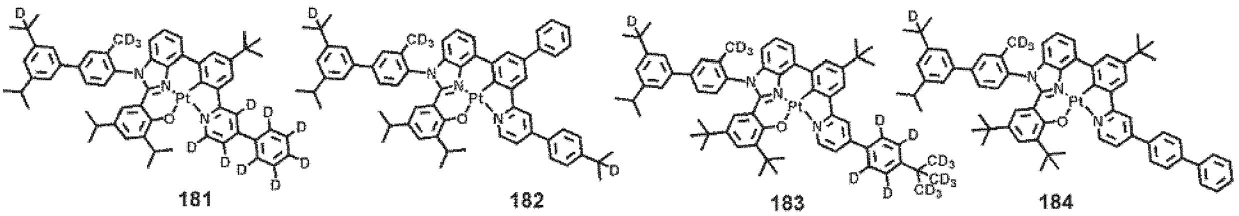

181 182 183 184

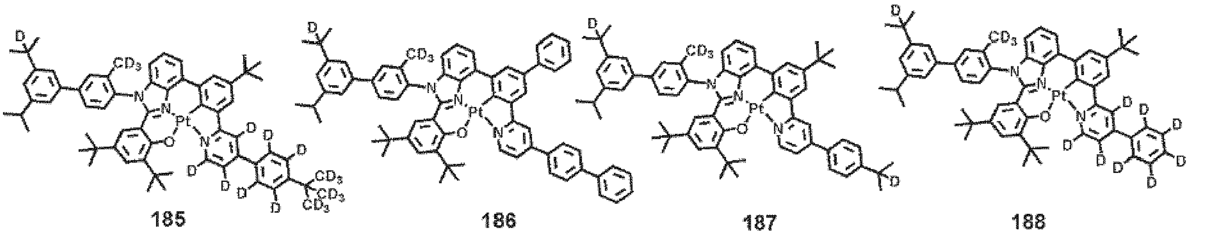

185 186 187 188

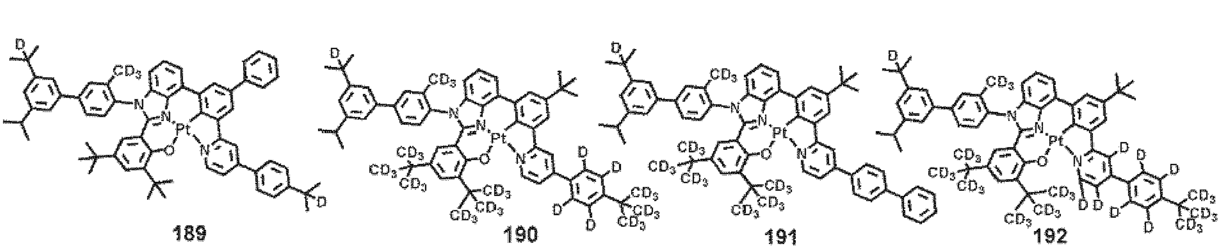

189 190 191 192

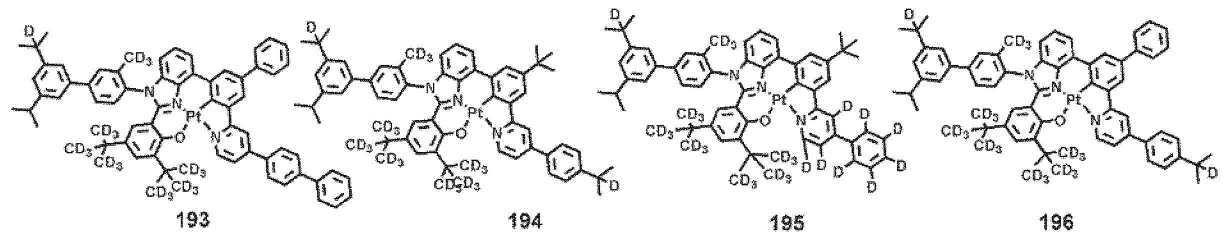

193 194 195 196

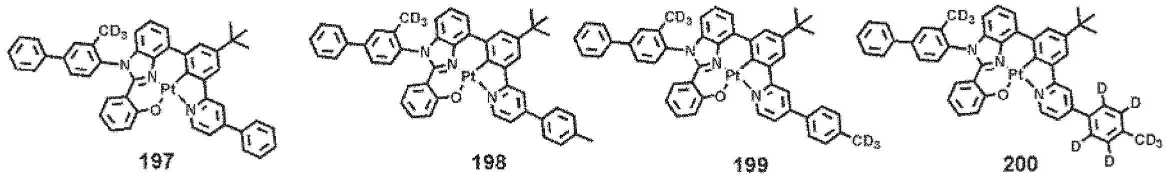

197 198 199 200

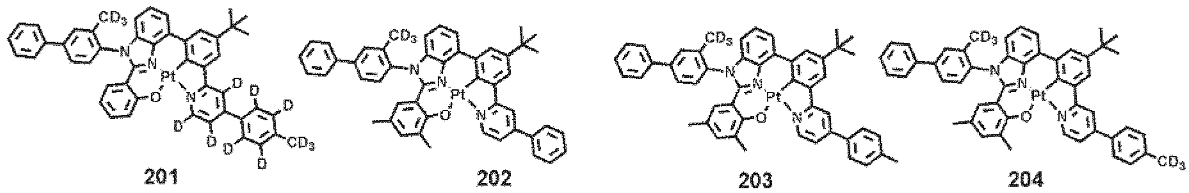

201 202 203 204

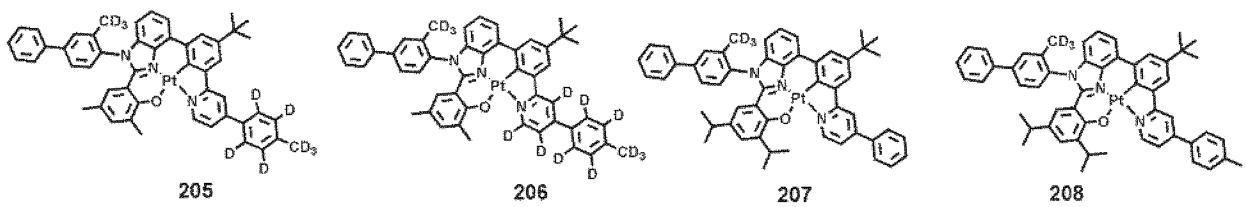

205 206 207 208

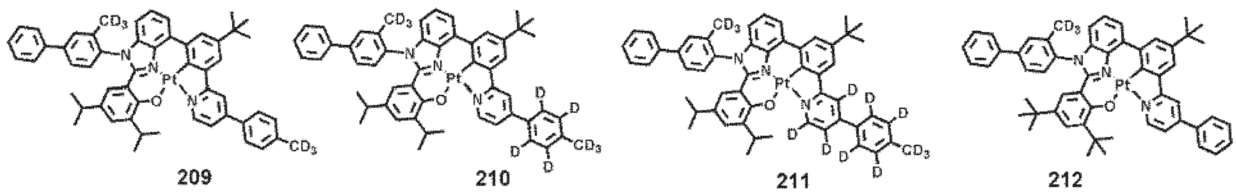

209 210 211 212

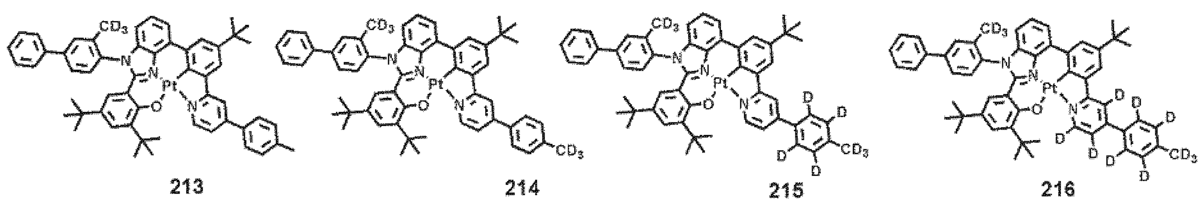

213 214 215 216

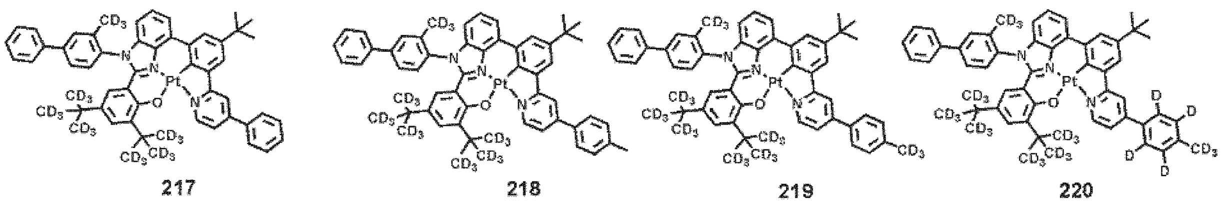

217 218 219 220

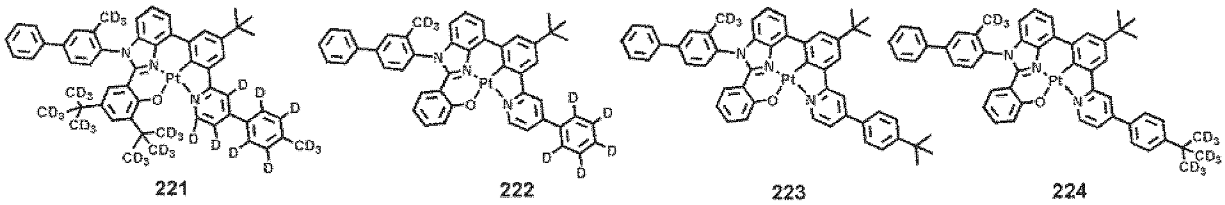

221 222 223 224

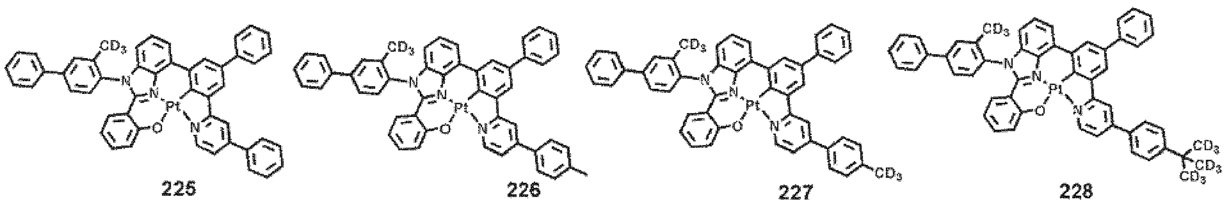

225 226 227 228

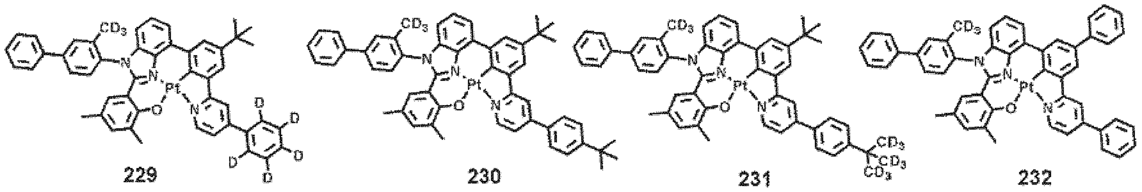

229 230 231 232

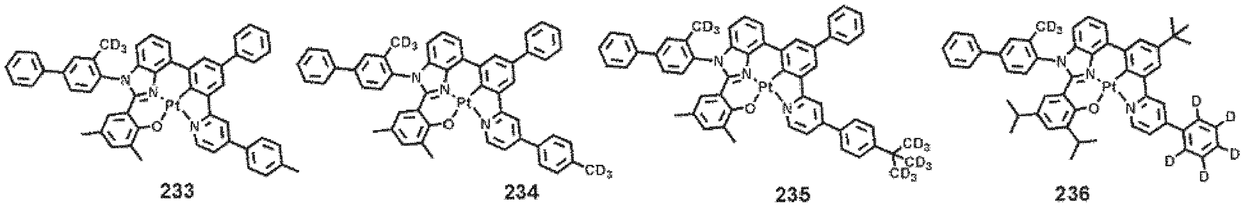

233 234 235 236

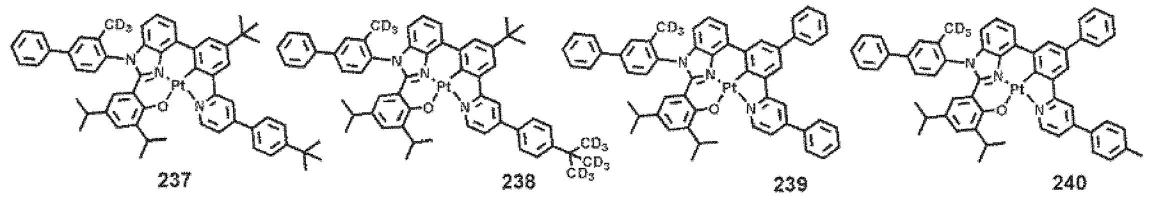

237 238 239 240

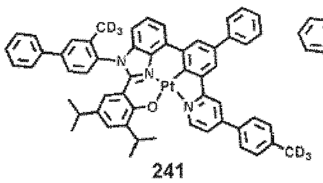
241

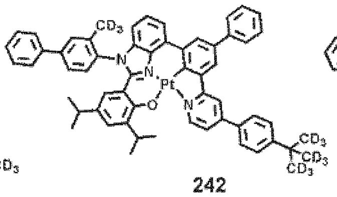
242

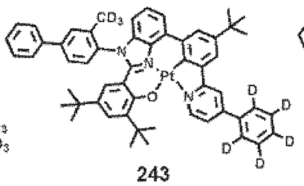
243

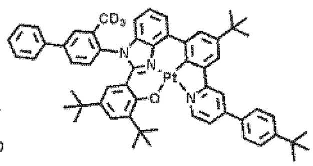
244

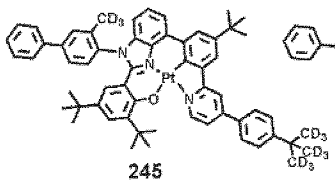
245

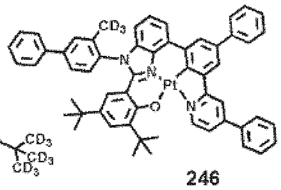
246

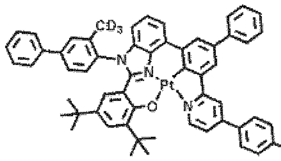
247

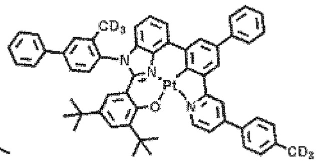
248

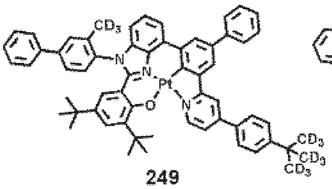
249

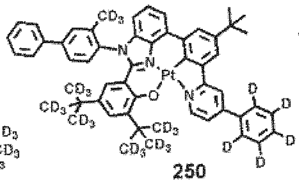
250

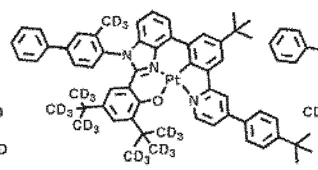
251

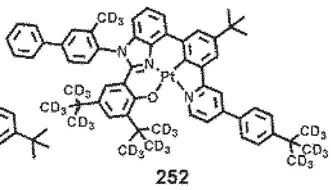
252

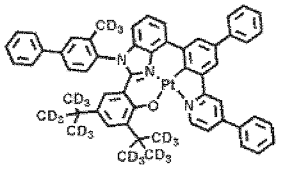
253

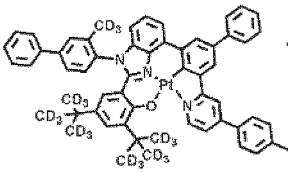
254

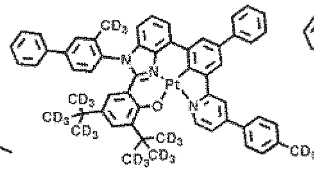
255

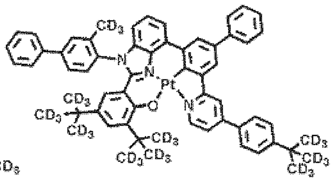
256

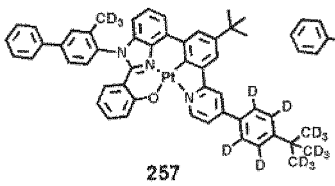
257

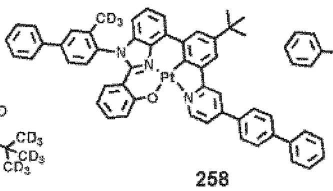
258

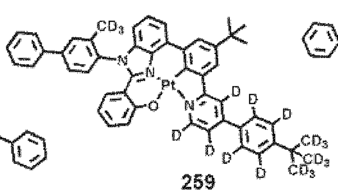
259

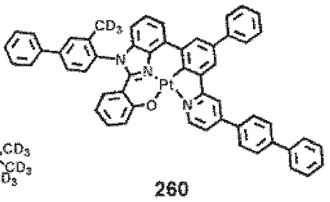
260

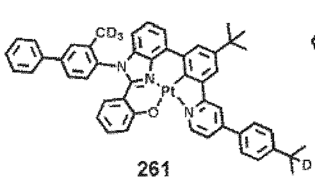
261

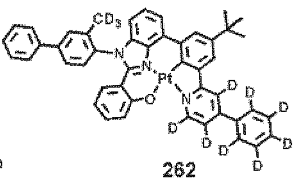
262

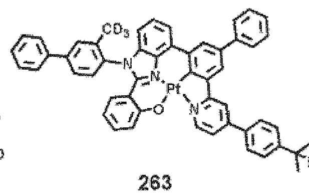
263

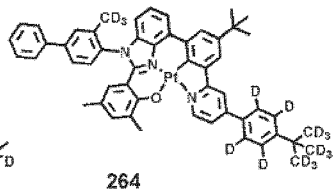
264

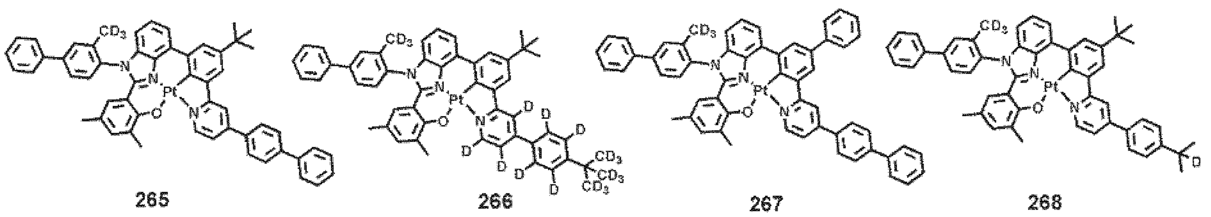

265 266 267 268

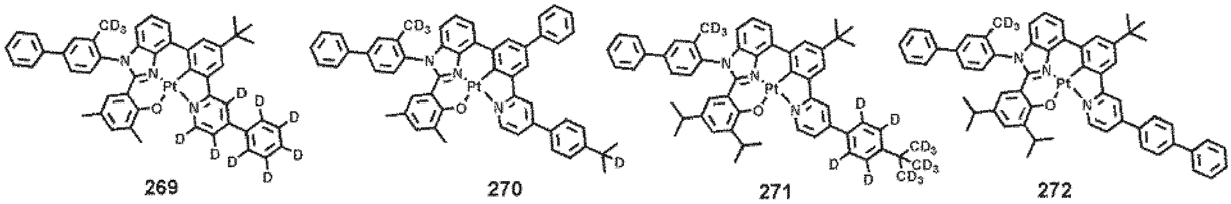

269 270 271 272

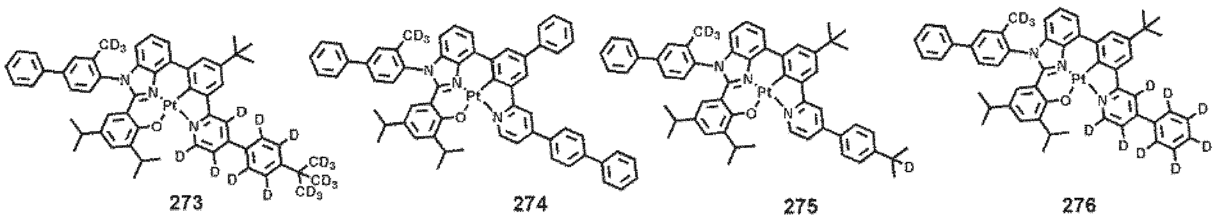

273 274 275 276

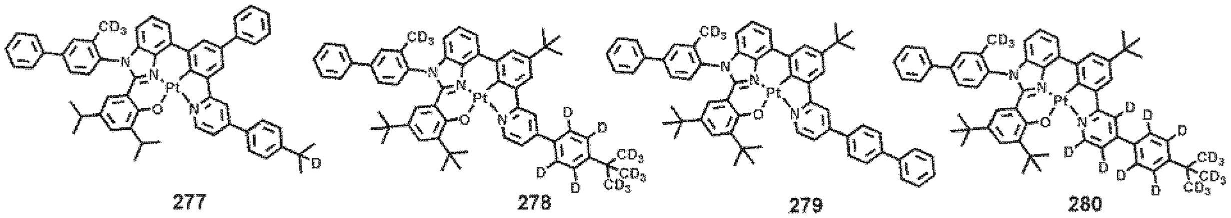

277 278 279 280

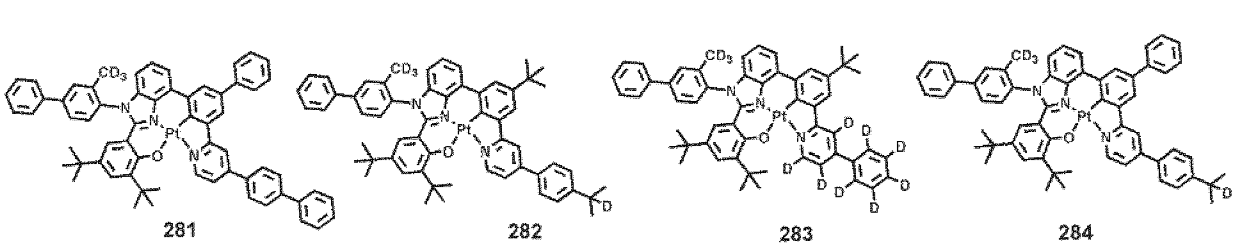

281 282 283 284

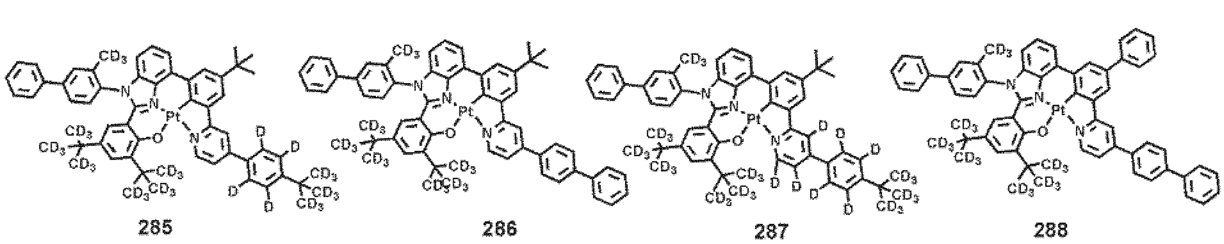

285 286 287 288

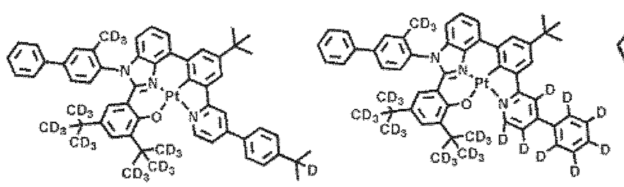

289 290

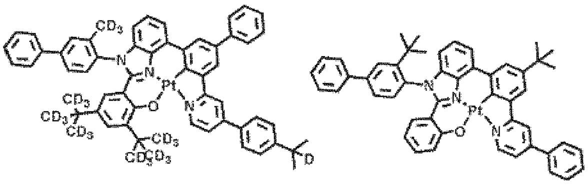

291 292

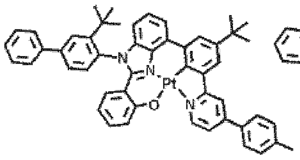

293

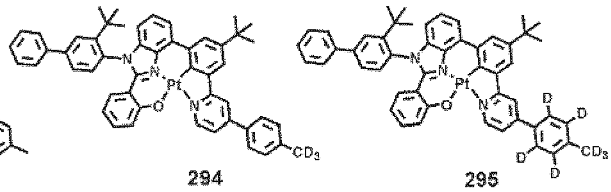

294 295

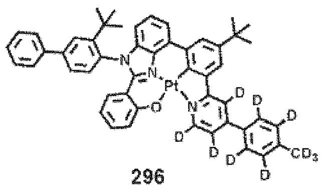

296

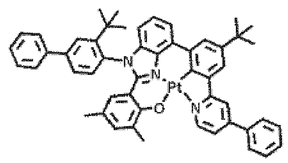

297

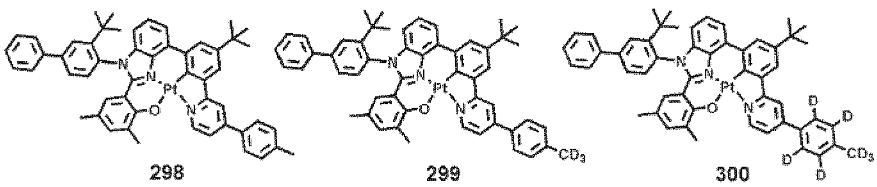

298 299 300

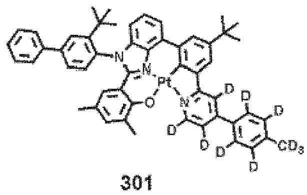

301

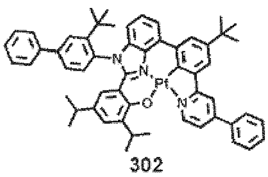

302

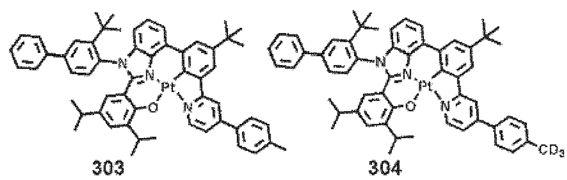

303 304

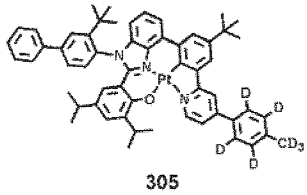

305

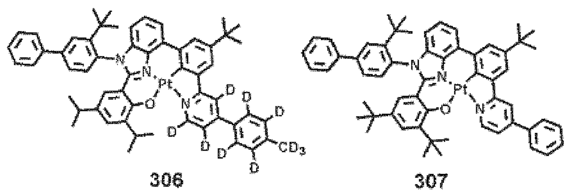

306 307

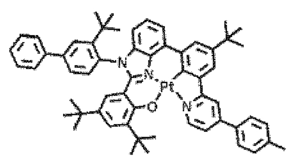

308

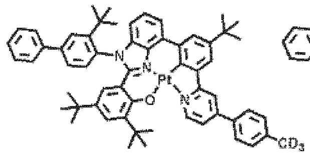

309

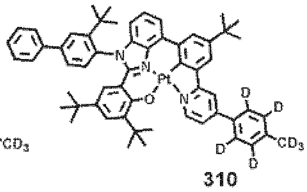

310

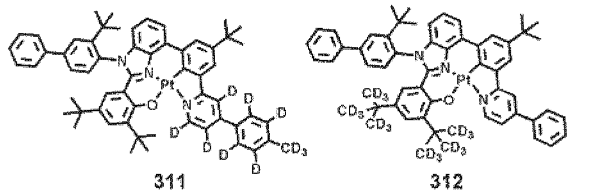

311 312

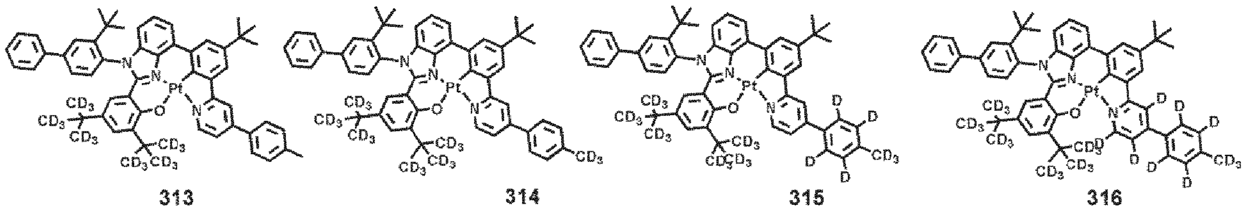

313 314 315 316

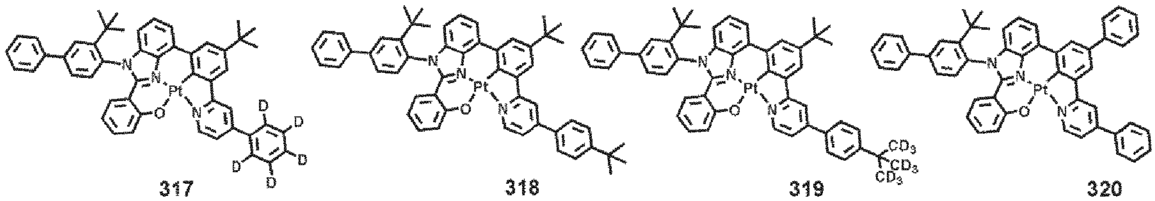

317 318 319 320

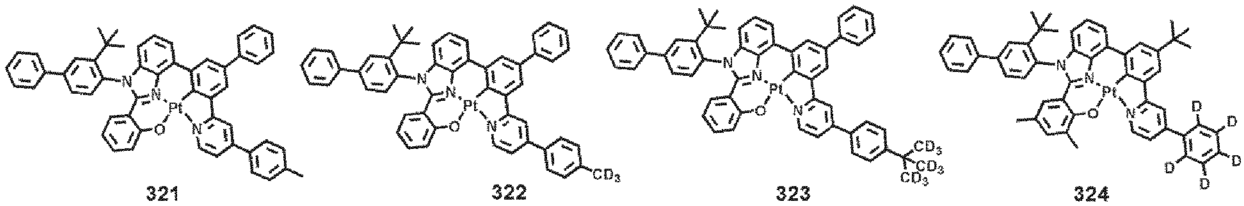

321 322 323 324

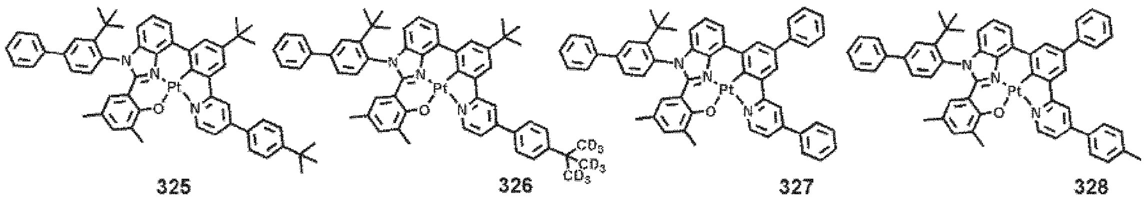

325 326 327 328

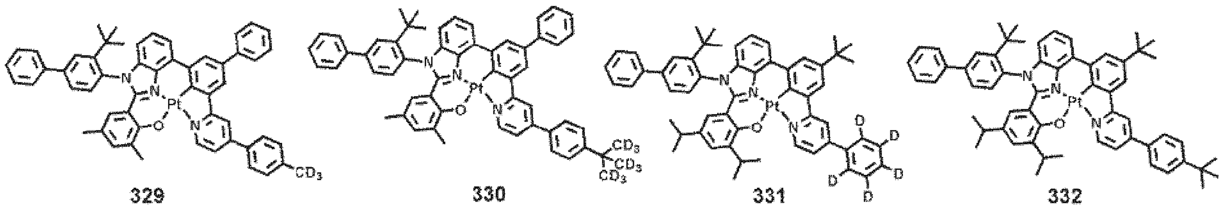

329 330 331 332

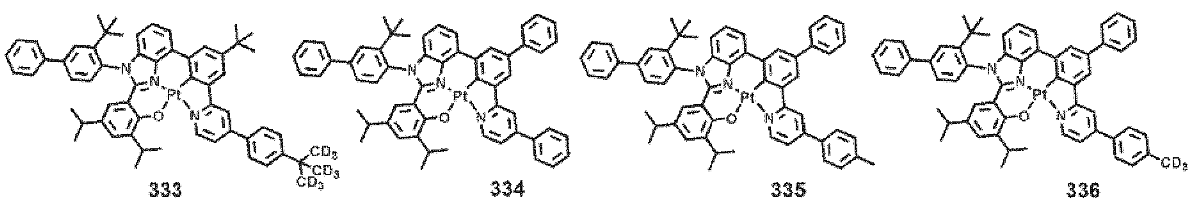

333 334 335 336

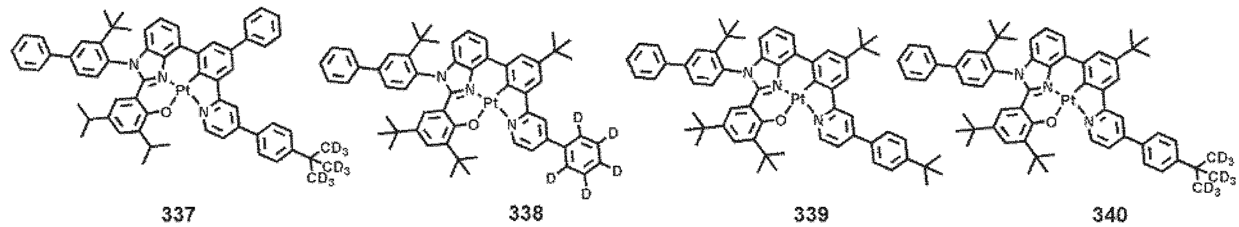

337 338 339 340

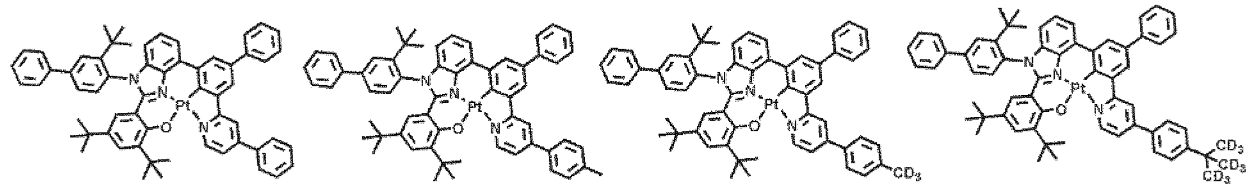

341 342 343 344

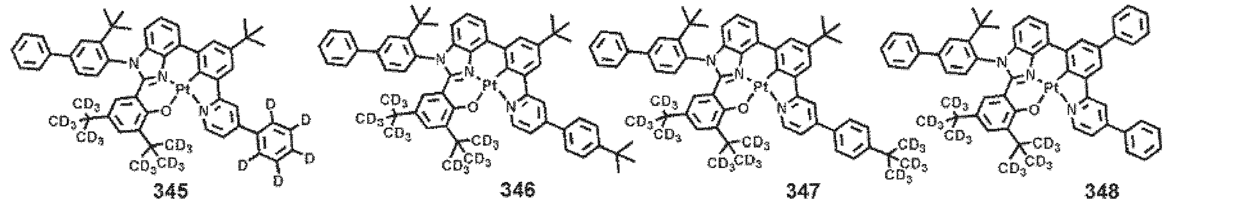

345 346 347 348

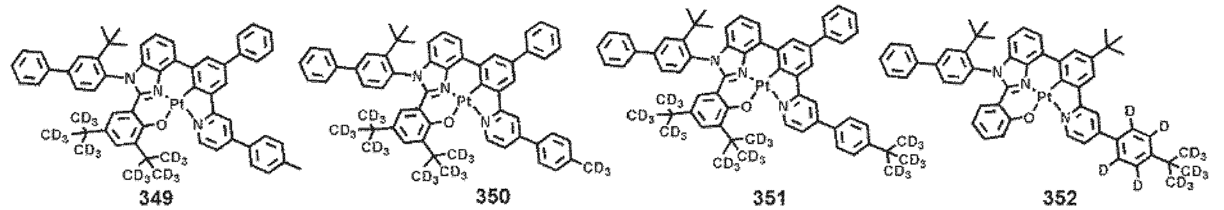

349 350 351 352

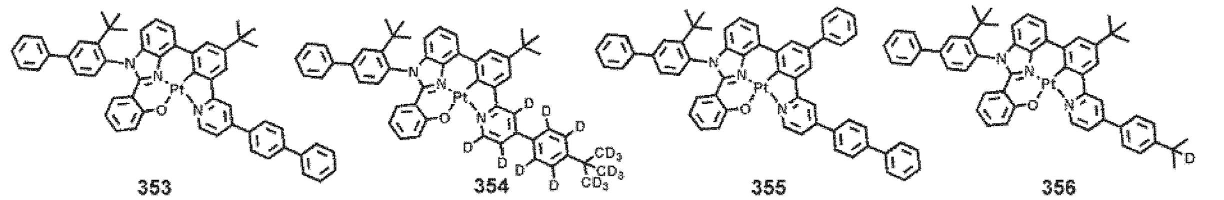

353 354 355 356

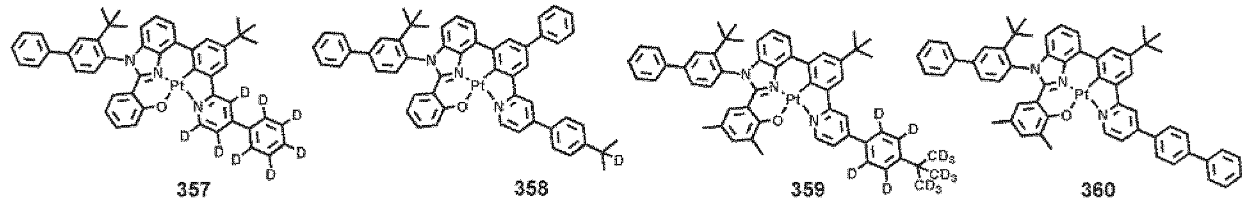

357 358 359 360

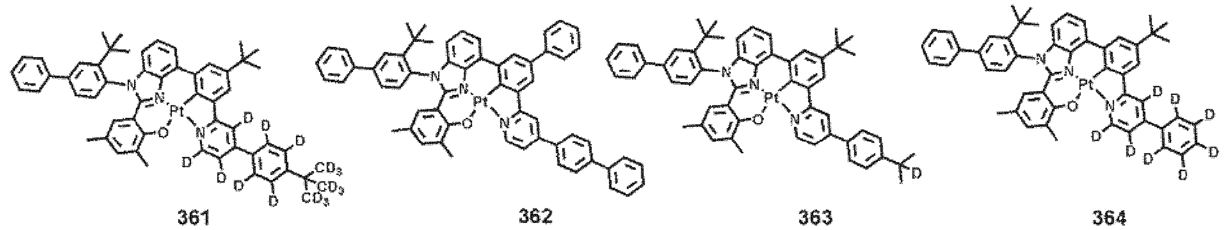

361 362 363 364

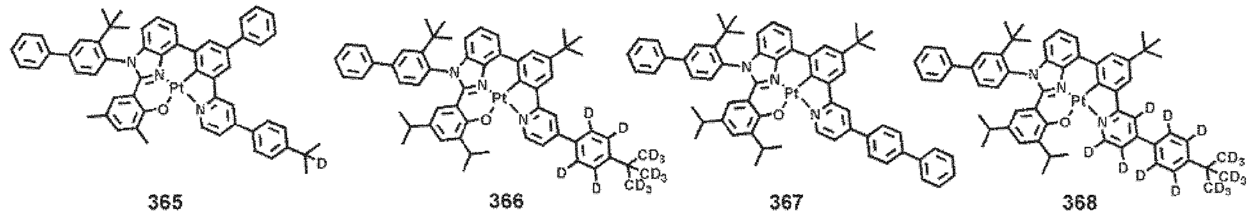

365 366 367 368

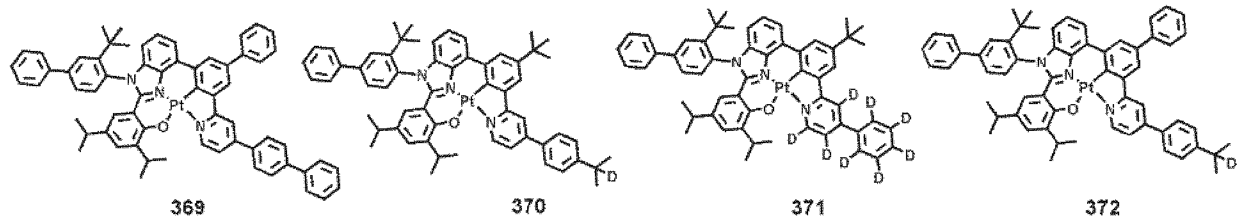

369 370 371 372

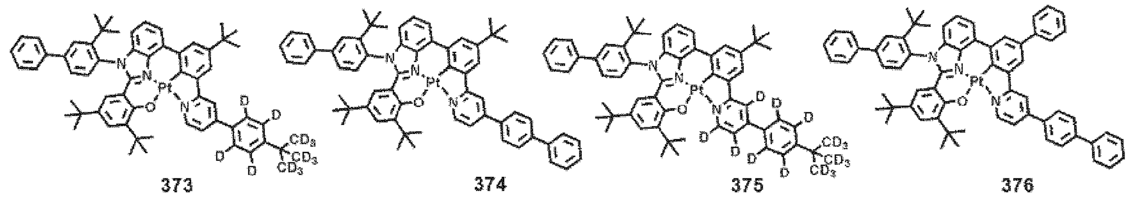

373 374 375 376

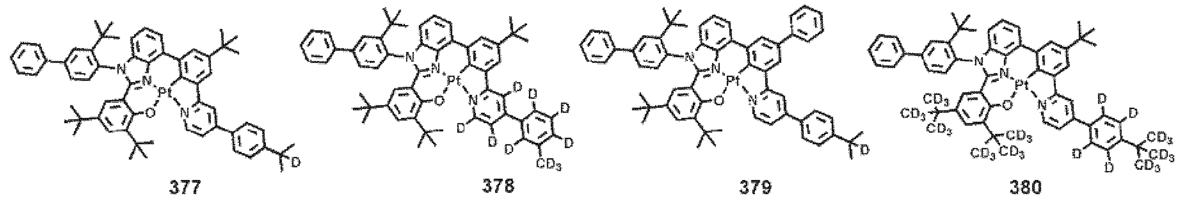

377 378 379 380

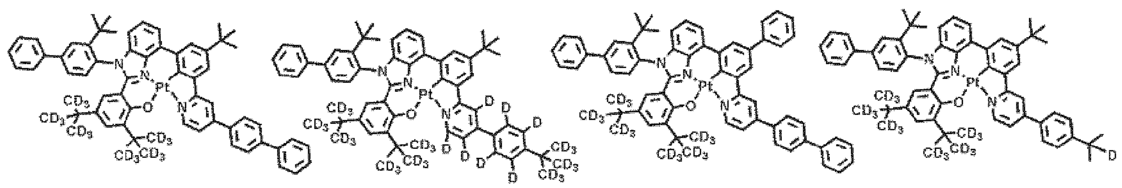

381 382 383 384

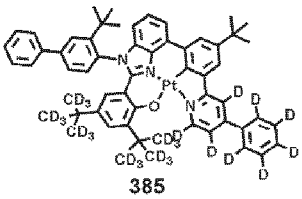
385

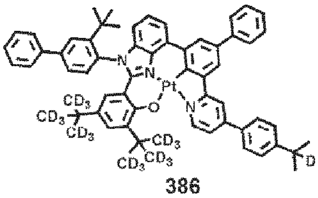
386

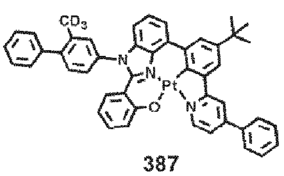
387

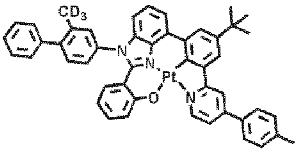
388

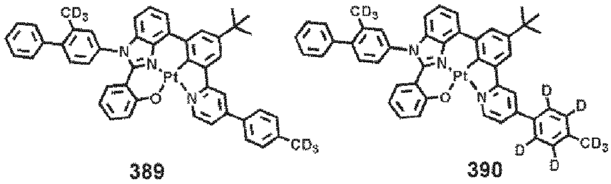
389

390

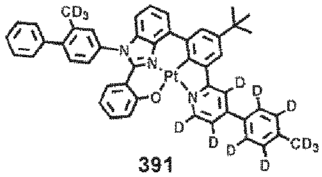
391

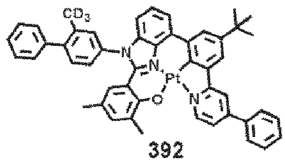
392

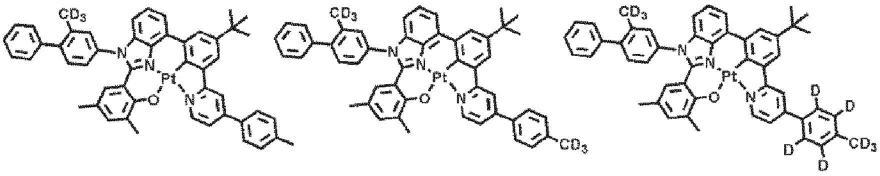
393

394

395

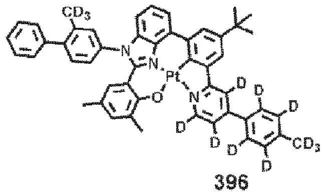
396

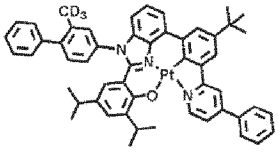
397

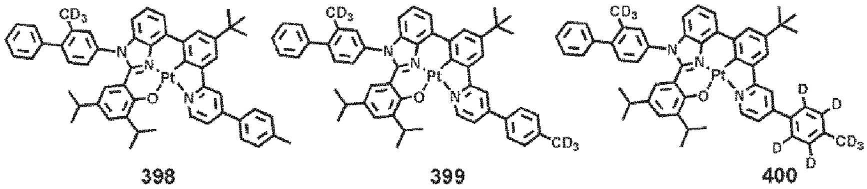
398

399

400

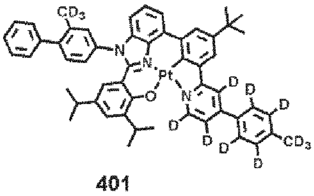
401

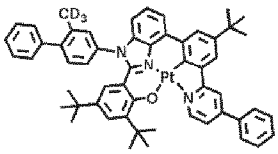
402

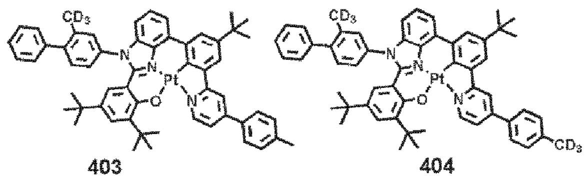
403

404

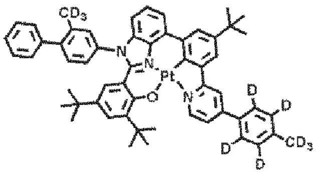
405

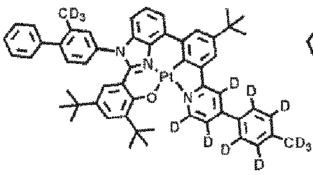
406

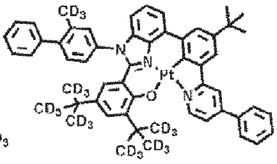
407

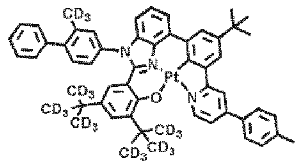
408

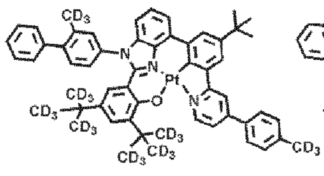

409

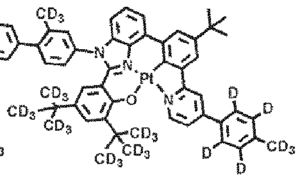

410

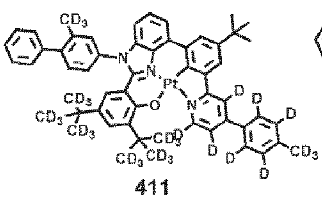

411

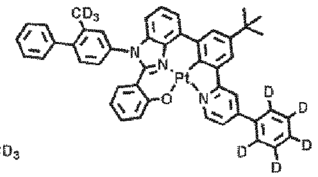

412

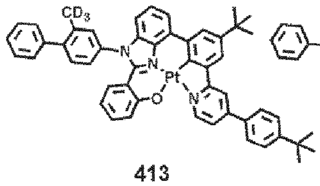

413

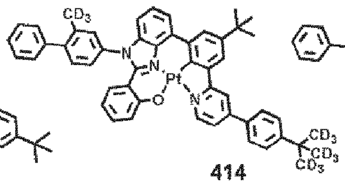

414

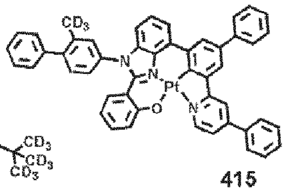

415

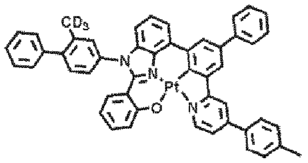

416

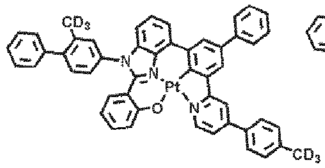

417

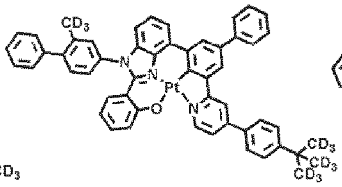

418

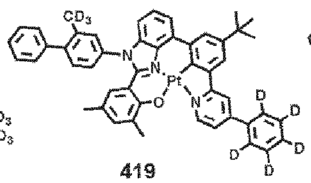

419

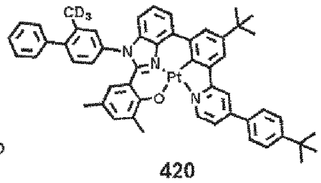

420

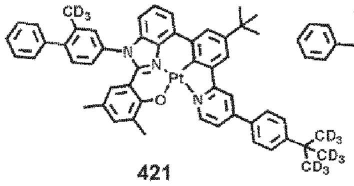

421

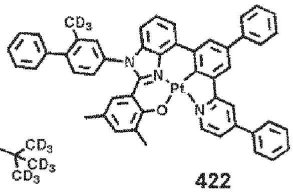

422

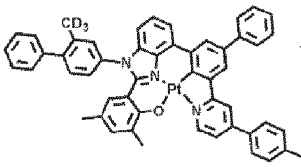

423

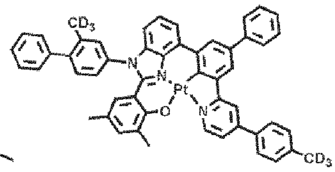

424

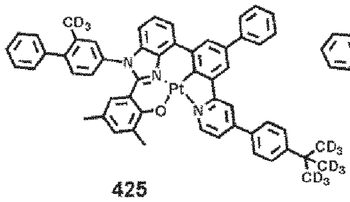

425

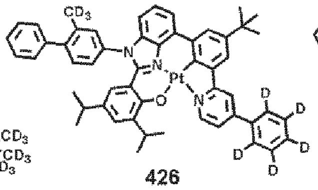

426

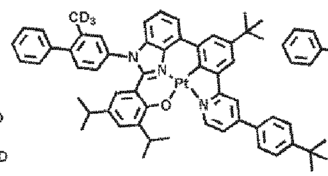

427

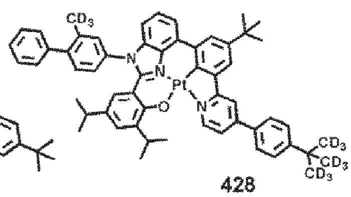

428

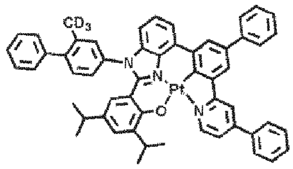

429

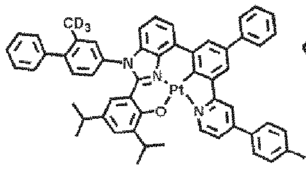

430

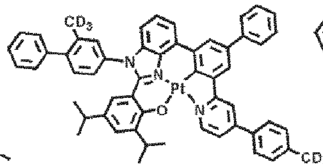

431

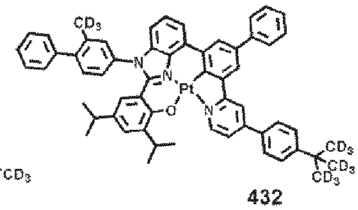

432

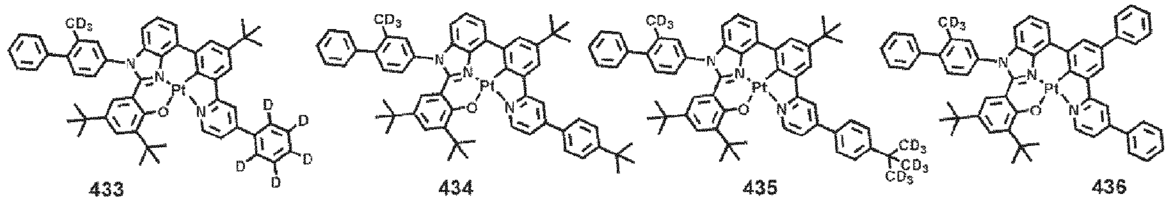

433 434 435 436

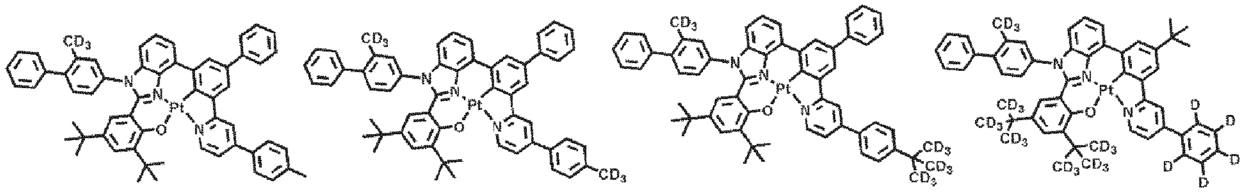

437 438 439 440

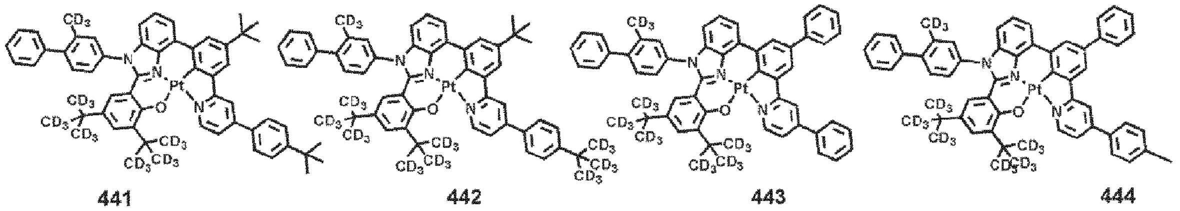

441 442 443 444

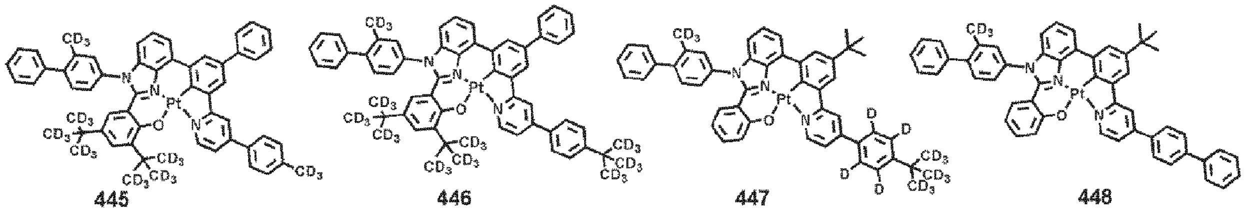

445 446 447 448

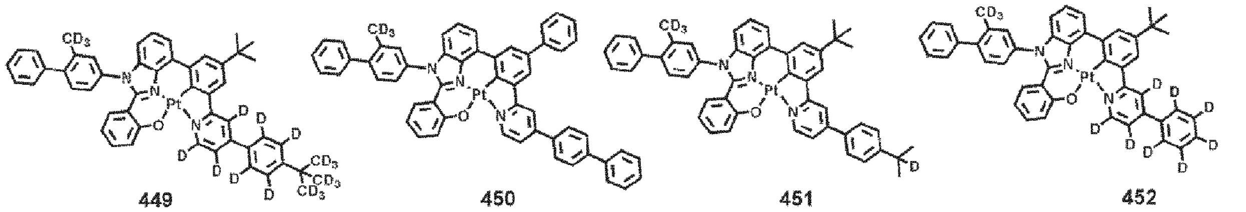

449 450 451 452

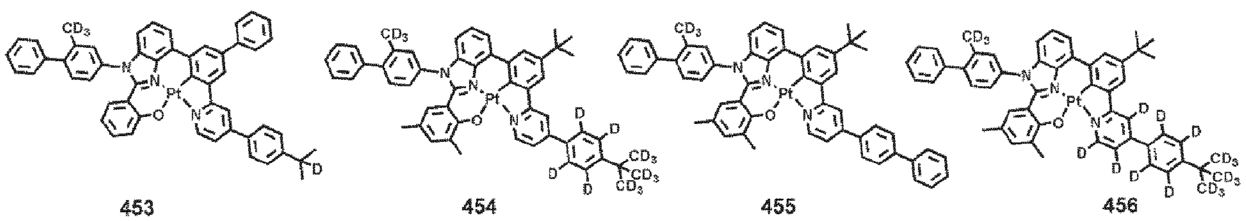

453 454 455 456

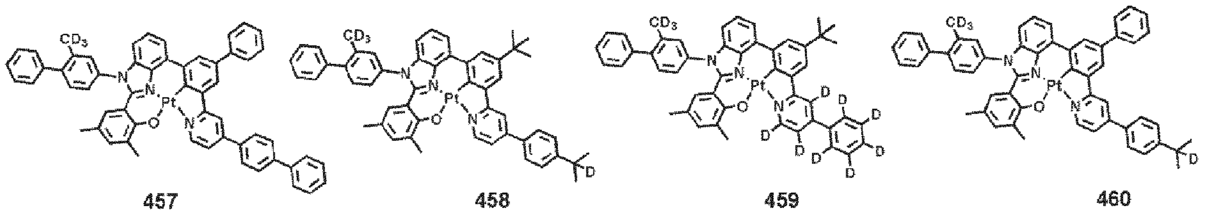

457 458 459 460

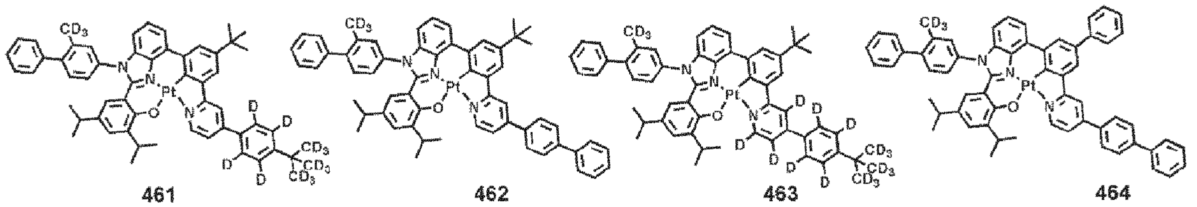

461 462 463 464

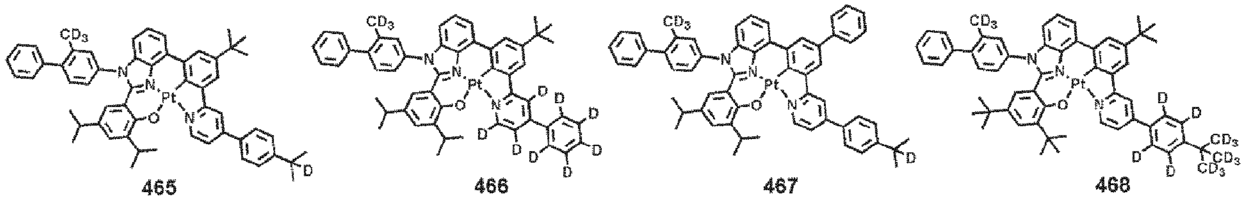

465 466 467 468

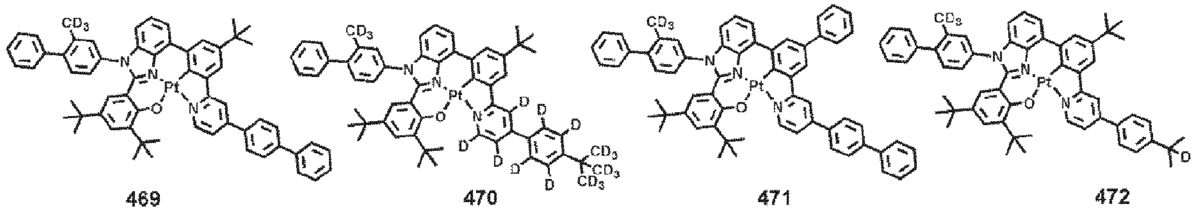

469 470 471 472

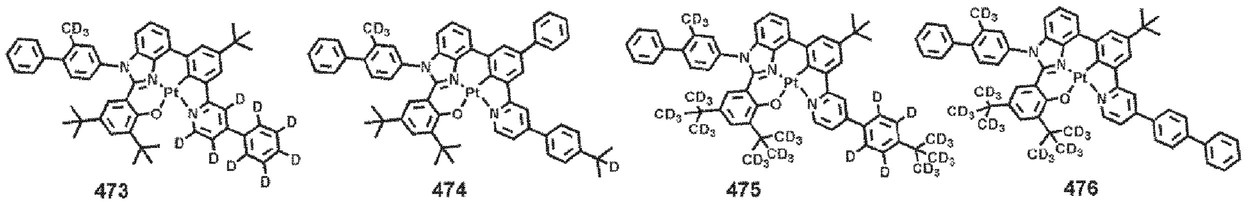

473 474 475 476

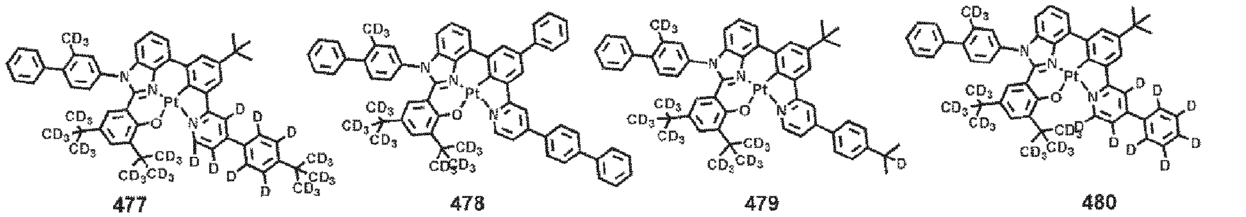

477 478 479 480

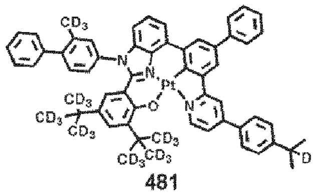
481

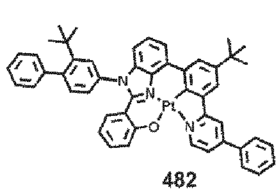
482

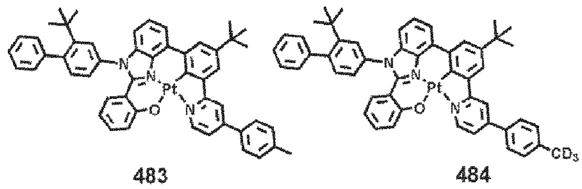
483 484

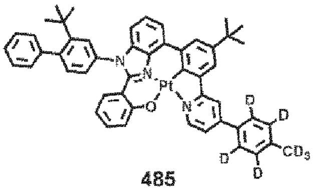
485

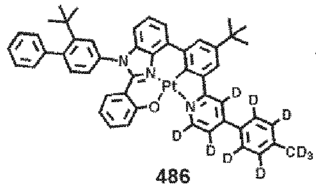
486

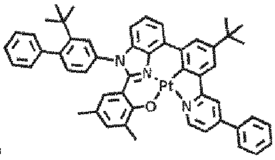
487

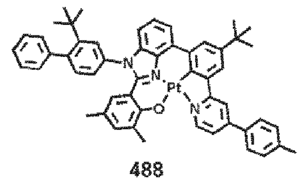
488

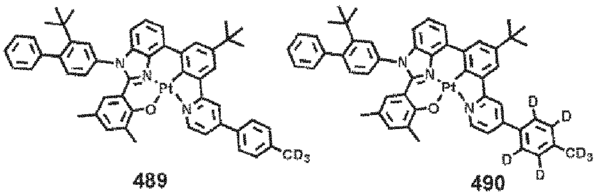
489 490

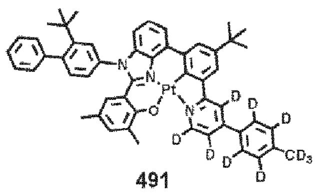
491

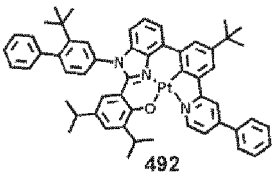
492

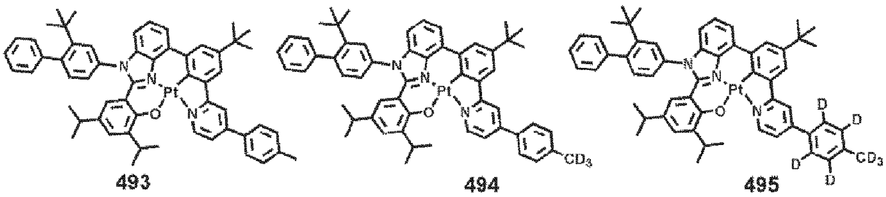
493 494 495

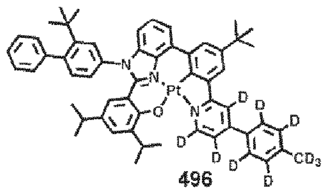
496

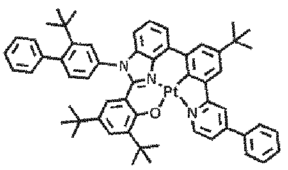
497

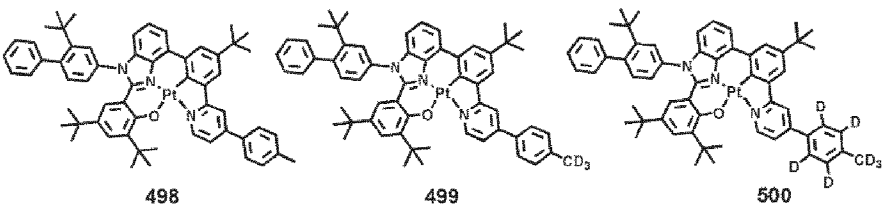
498 499 500

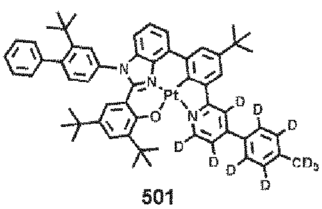
501

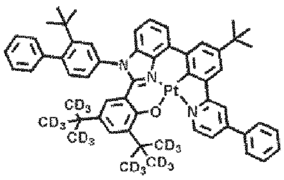
502

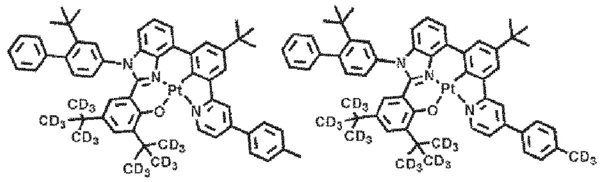
503 504

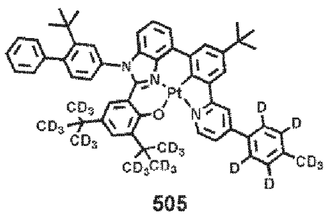
505

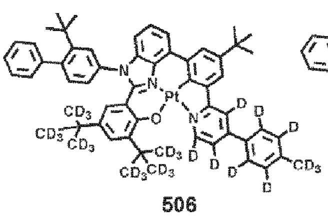
506

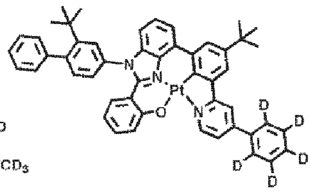
507

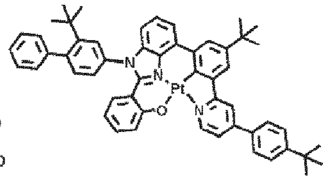
508

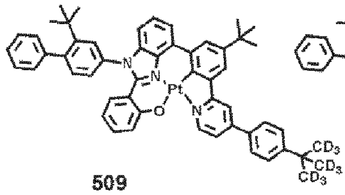
509

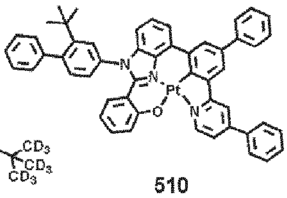
510

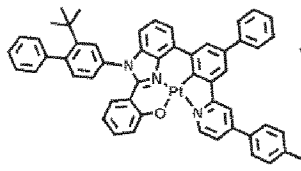
511

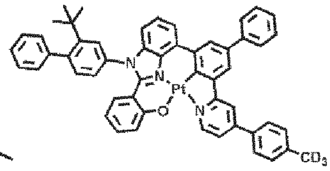
512

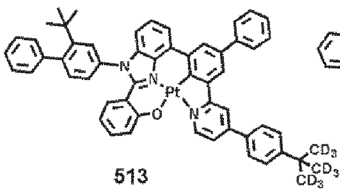
513

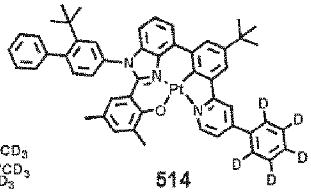
514

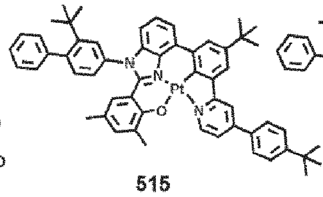
515

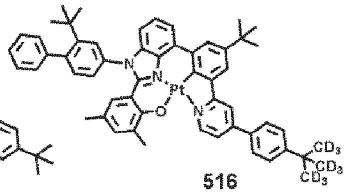
516

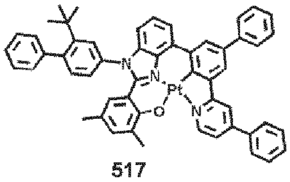
517

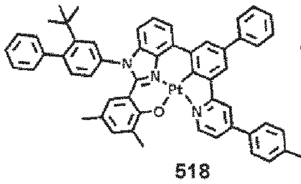
518

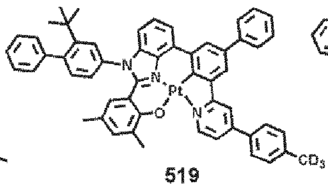
519

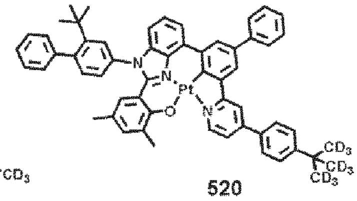
520

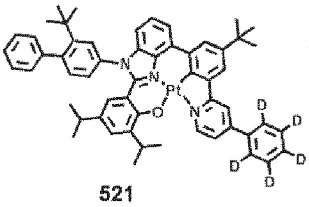
521

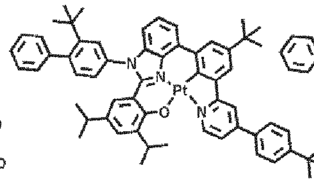
522

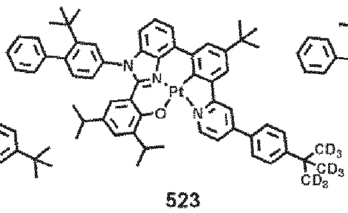
523

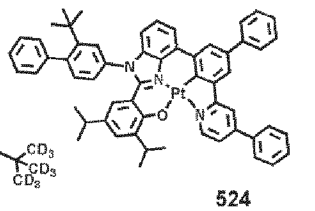
524

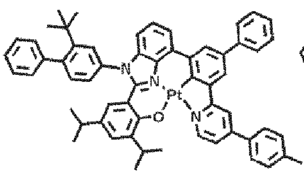
525

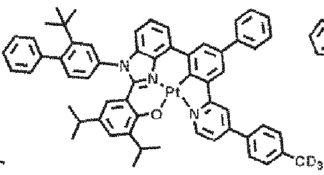
526

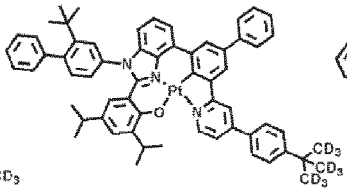
527

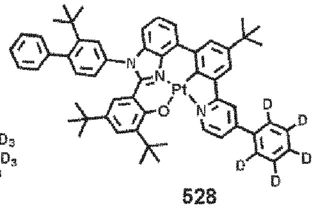
528

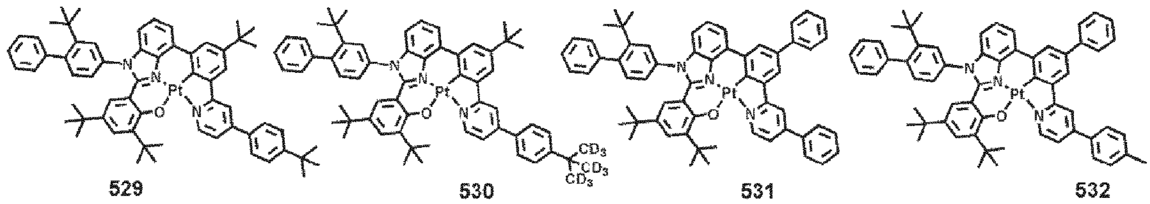

529 530 531 532

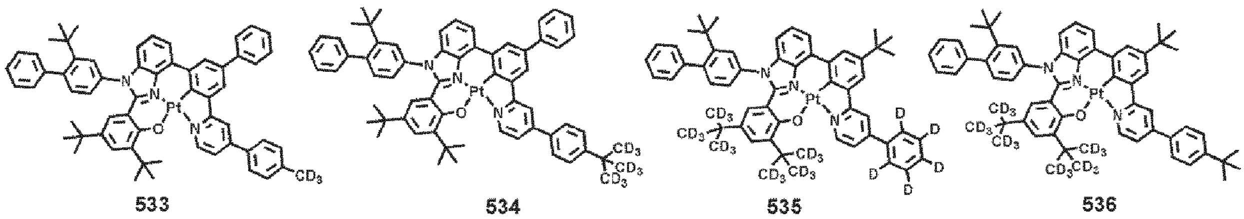

533 534 535 536

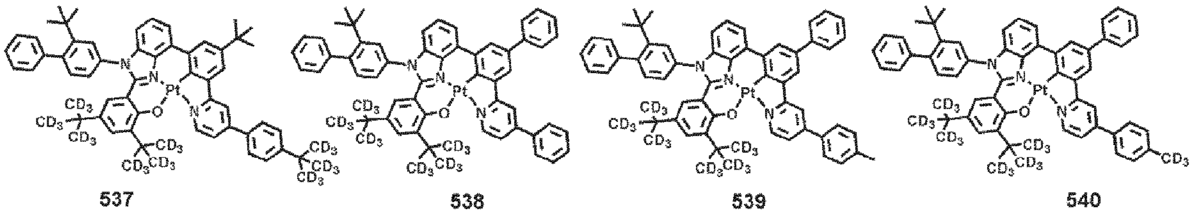

537 538 539 540

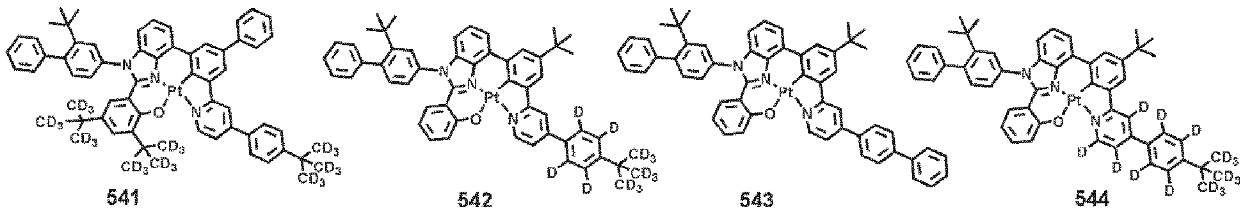

541 542 543 544

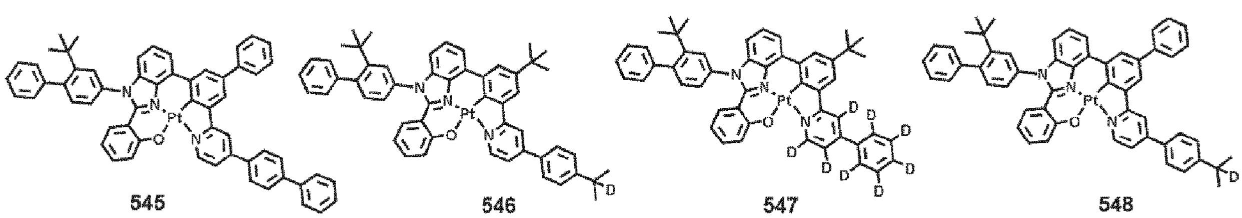

545 546 547 548

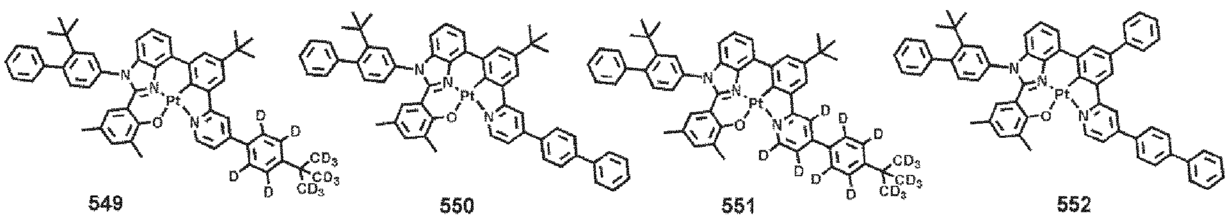

549 550 551 552

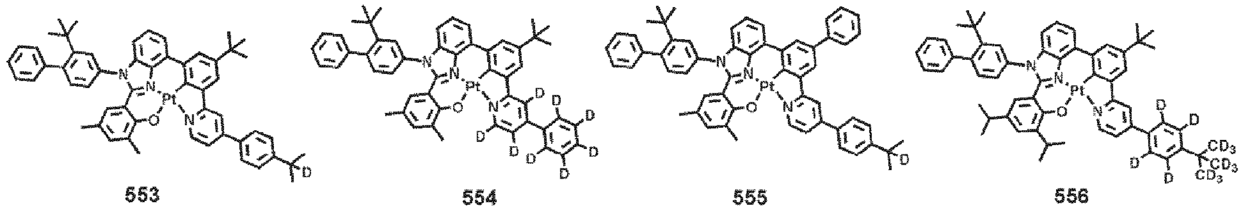

553 554 555 556

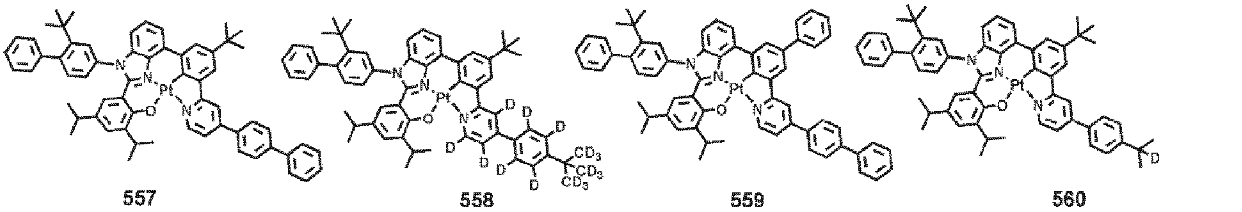

557 558 559 560

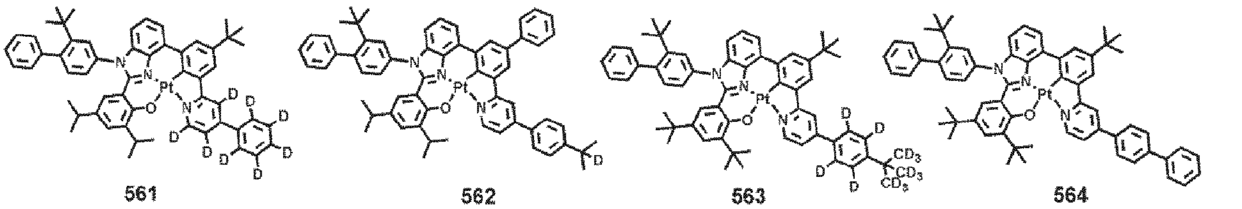

561 562 563 564

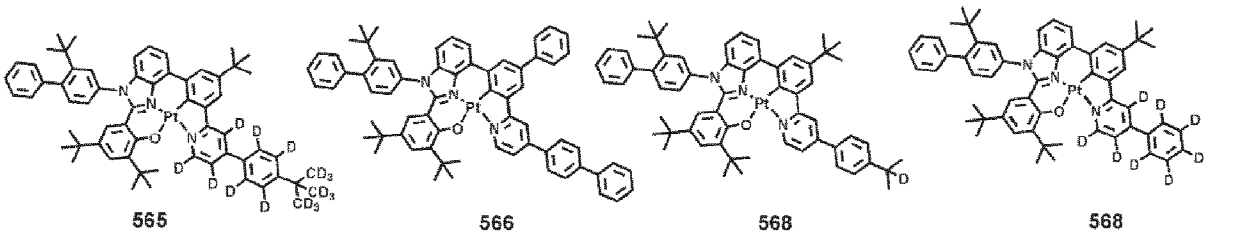

565 566 568 568

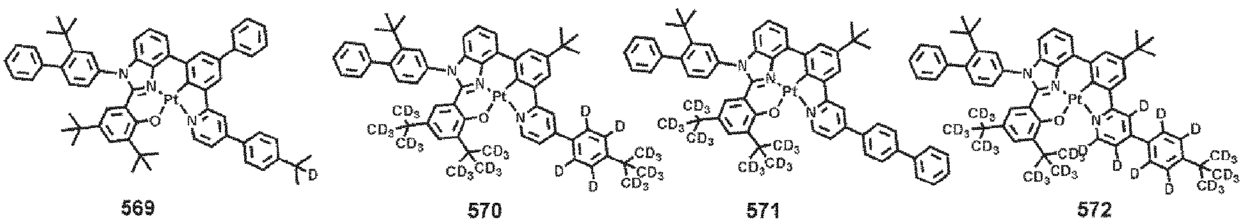

569 570 571 572

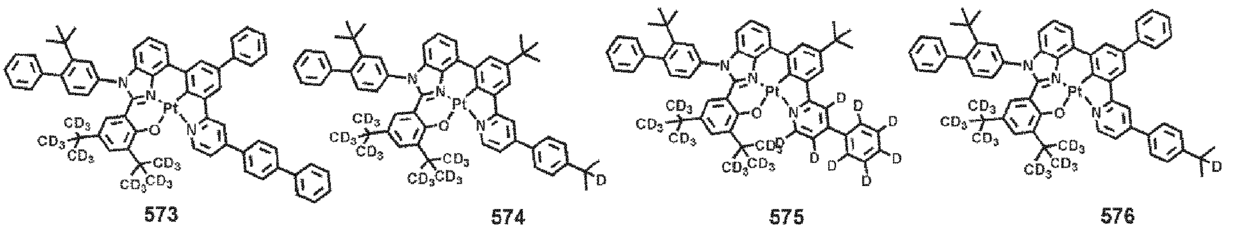

573 574 575 576

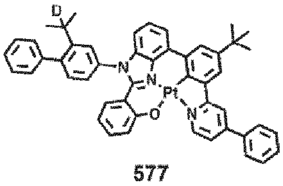
577
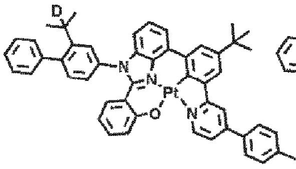
578
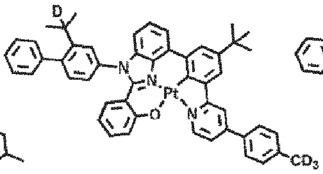
579
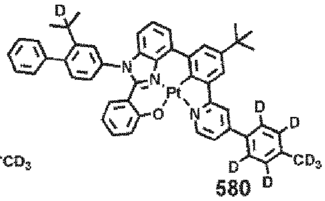
580

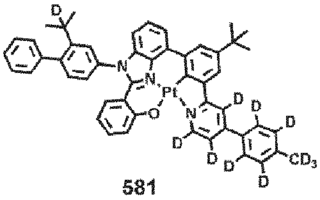
581
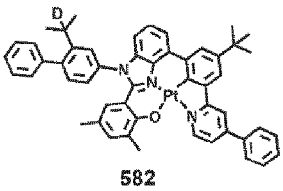
582
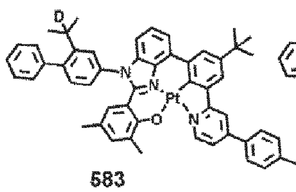
583
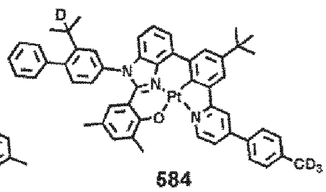
584

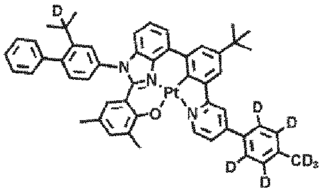
585
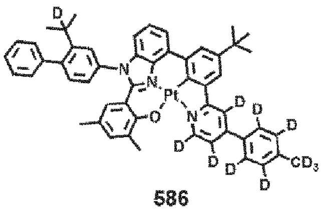
586
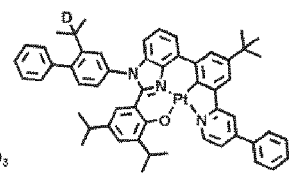
587
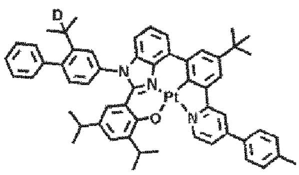
588

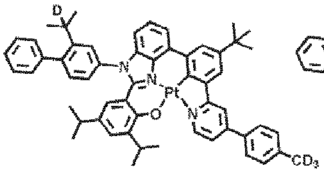
589
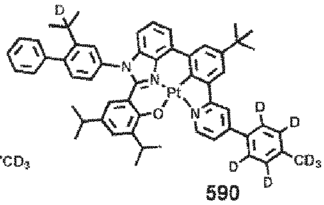
590
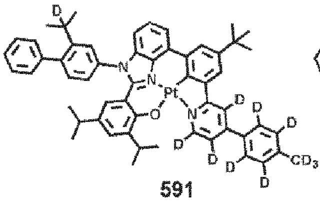
591
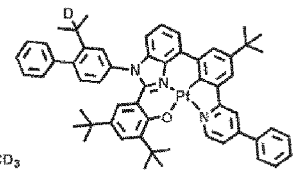
592

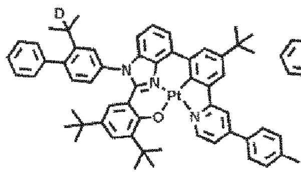
593
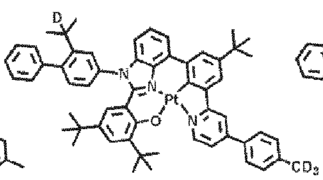
594
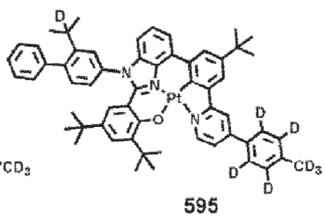
595
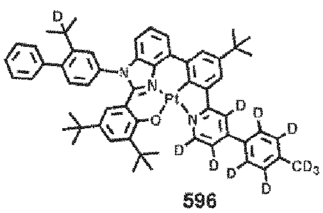
596

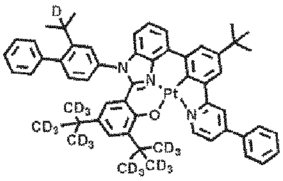
597
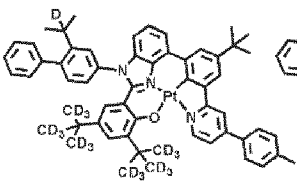
598
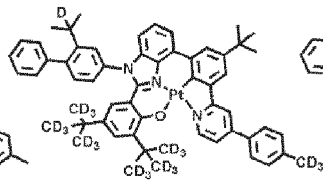
599
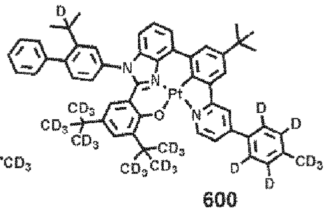
600

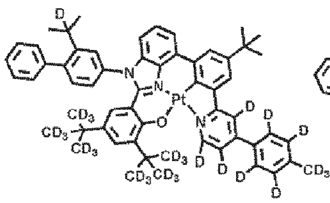
601

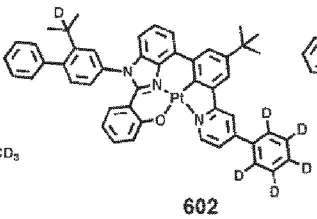
602

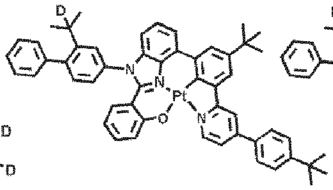
603

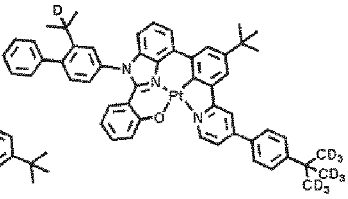
604

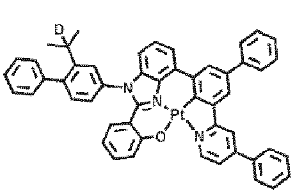
605

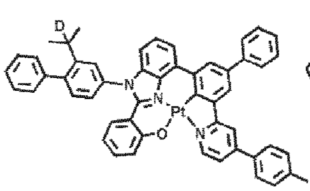
606

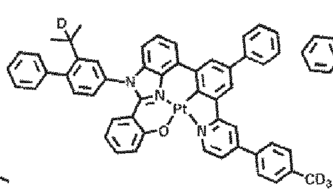
607

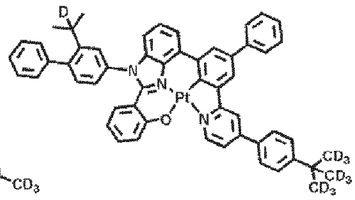
608

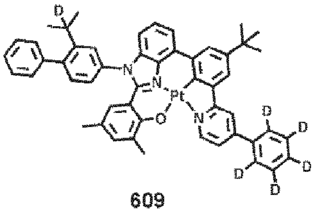
609

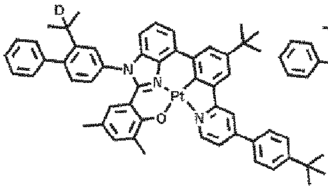
610

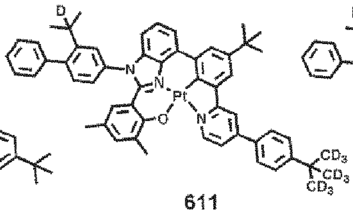
611

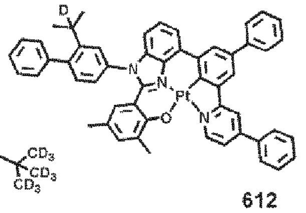
612

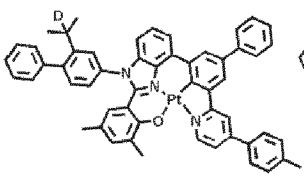
613

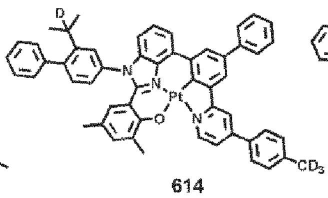
614

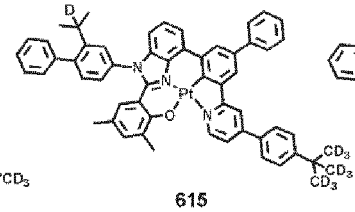
615

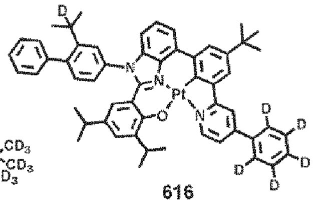
616

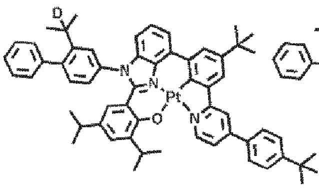
617

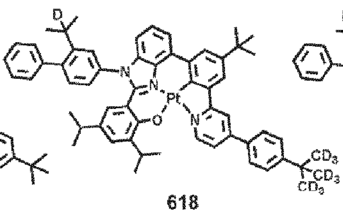
618

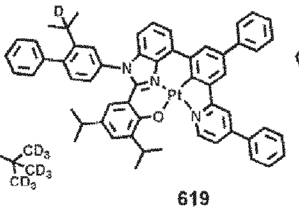
619

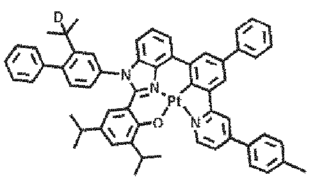
620

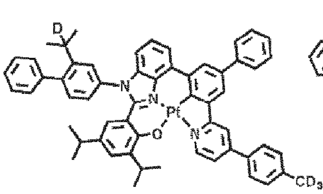
621

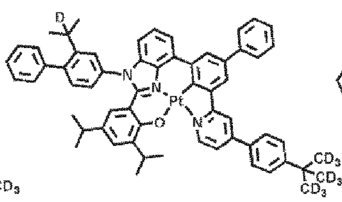
622

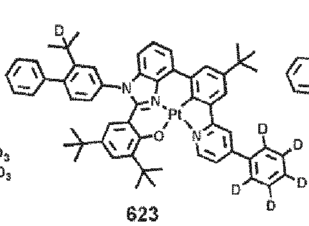
623

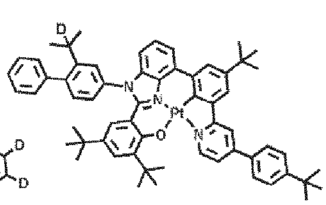
624

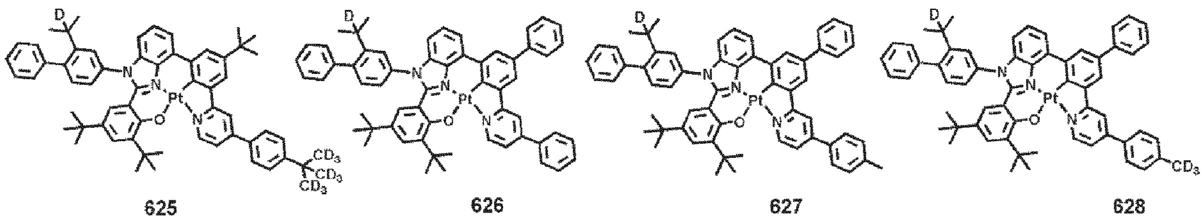

625 626 627 628

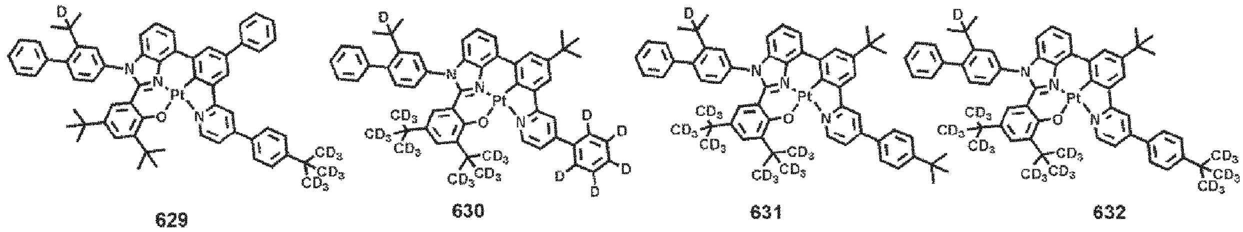

629 630 631 632

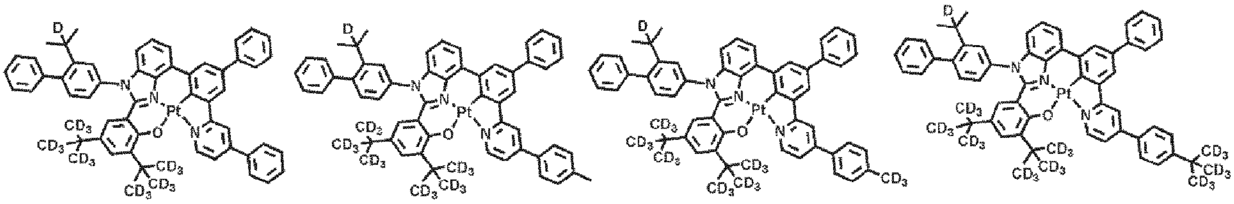

633 634 635 636

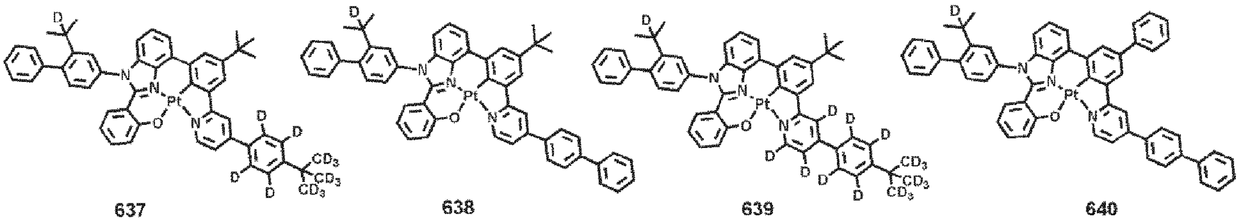

637 638 639 640

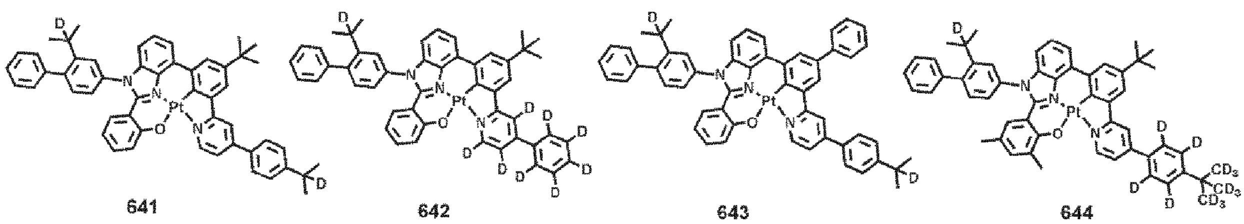

641 642 643 644

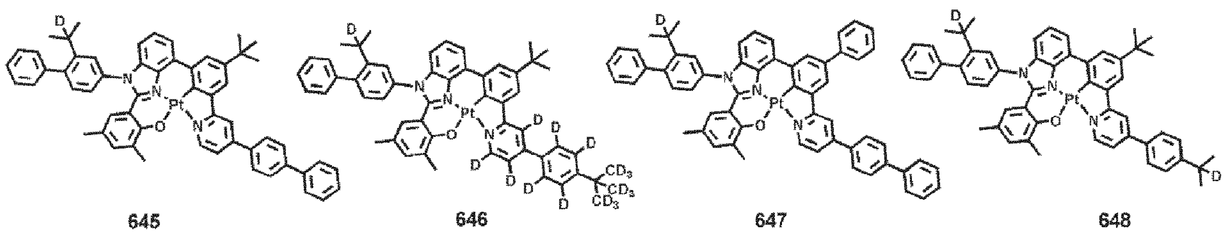

645 646 647 648

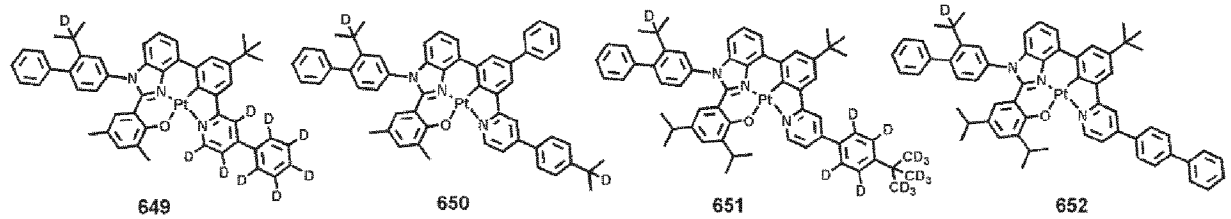

649 650 651 652

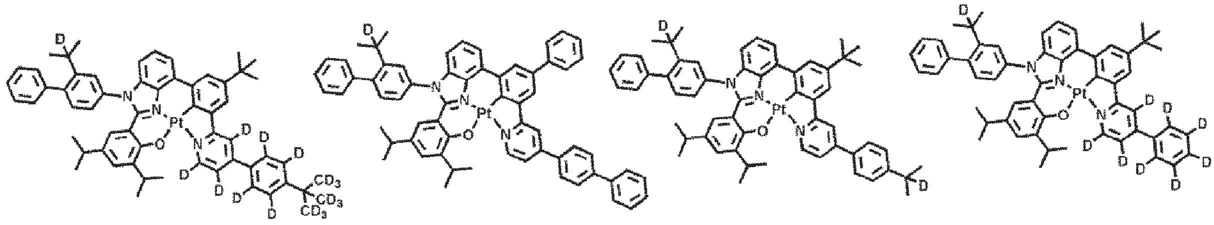

653 654 655 656

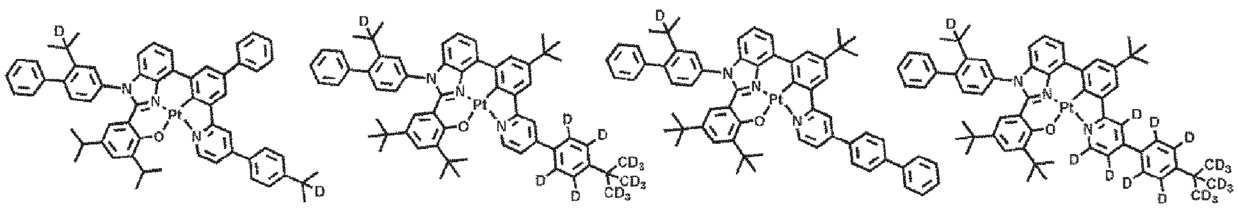

657 658 659 660

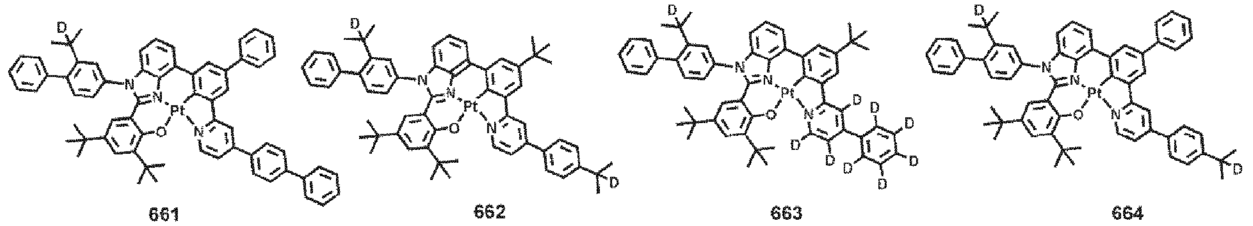

661 662 663 664

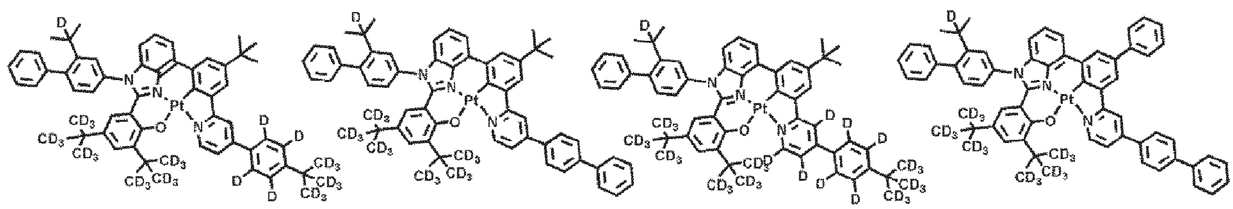

665 666 667 668

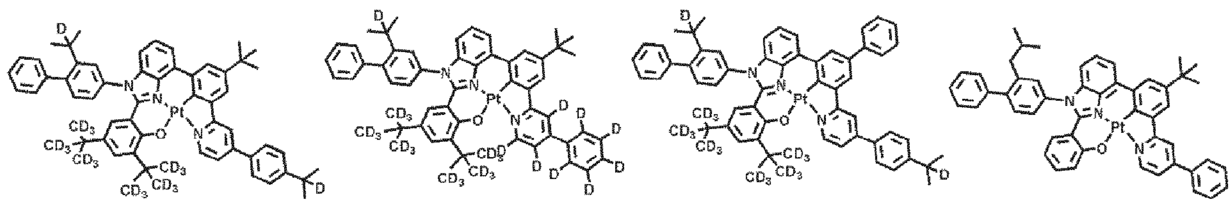

669 670 671 672

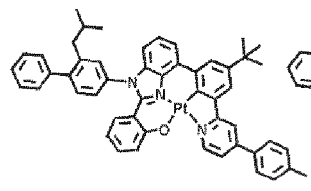
673
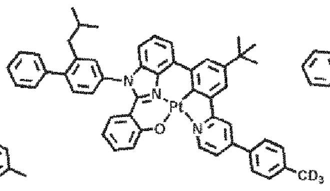
674
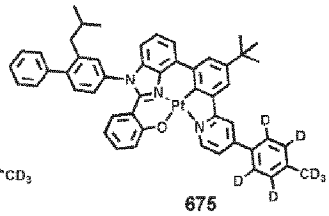
675
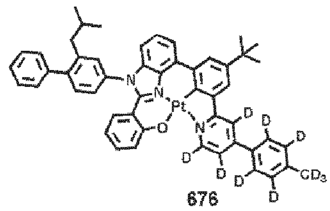
676

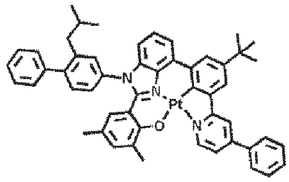
677
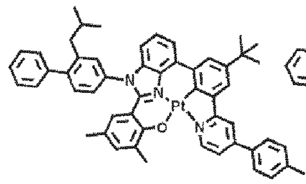
678
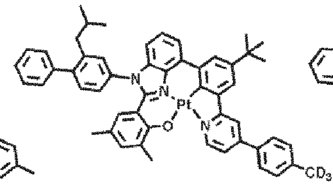
679
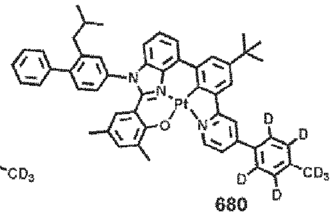
680

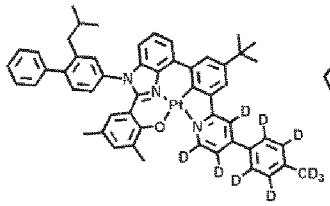
681
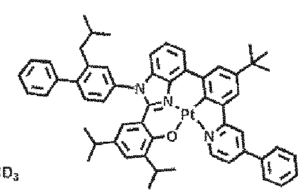
682
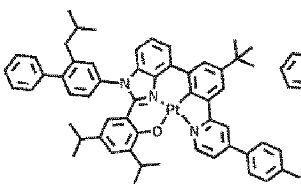
683
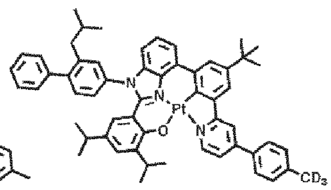
684

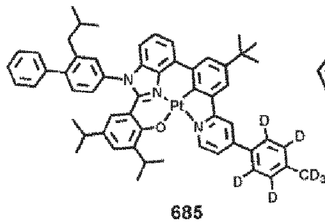
685
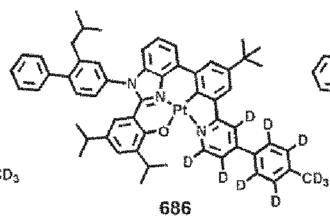
686
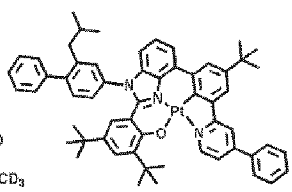
687
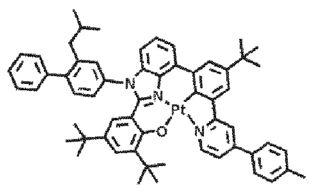
688

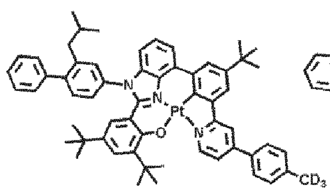
689
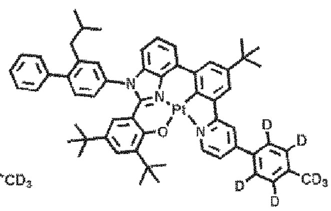
690
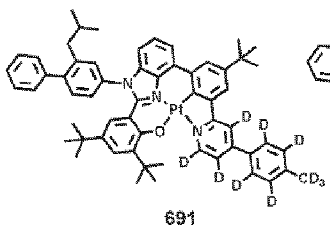
691
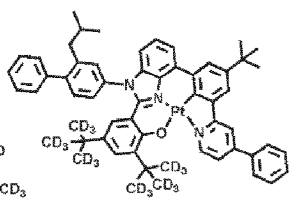
692

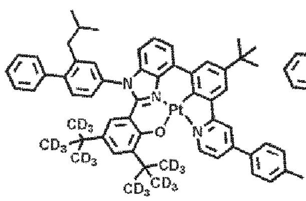
693
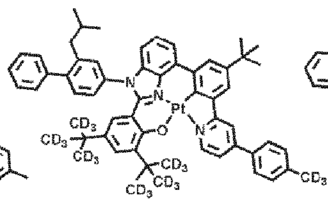
694
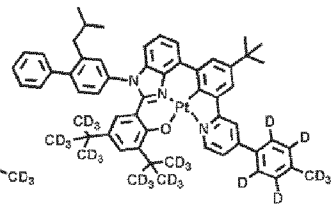
695
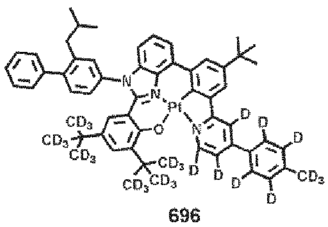
696

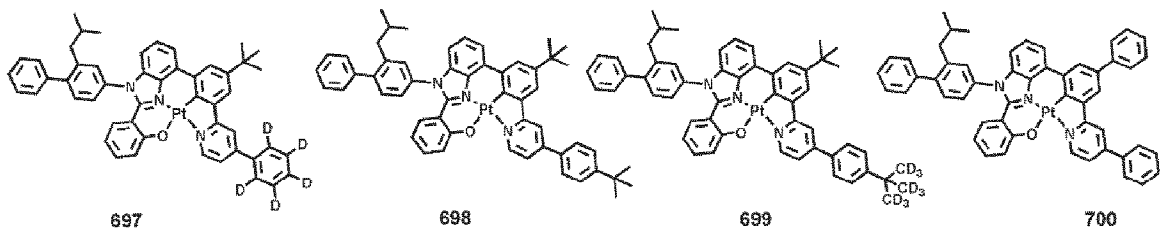

697 698 699 700

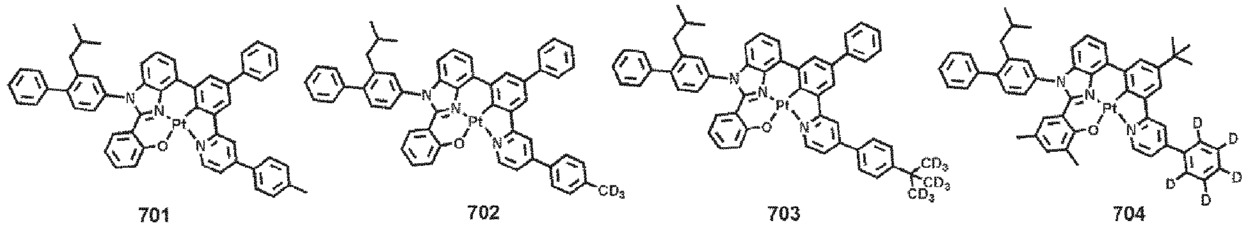

701 702 703 704

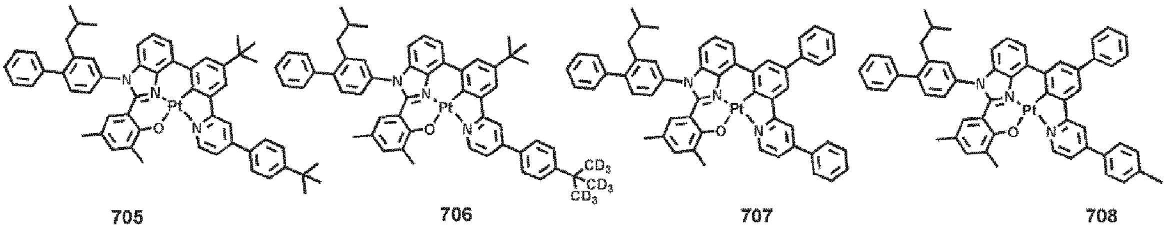

705 706 707 708

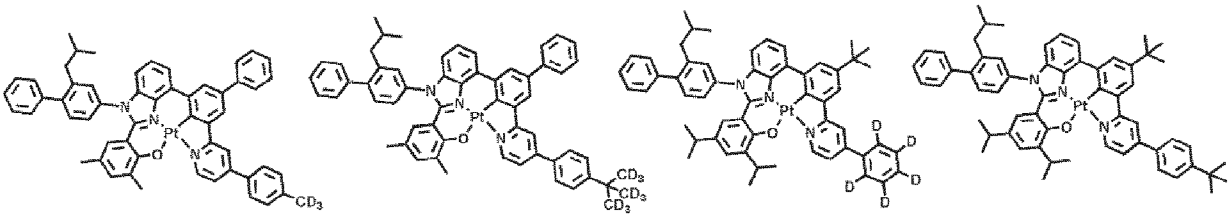

709 710 711 712

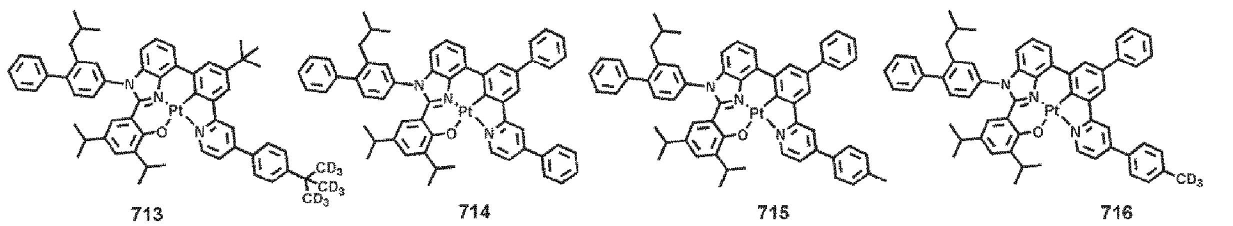

713 714 715 716

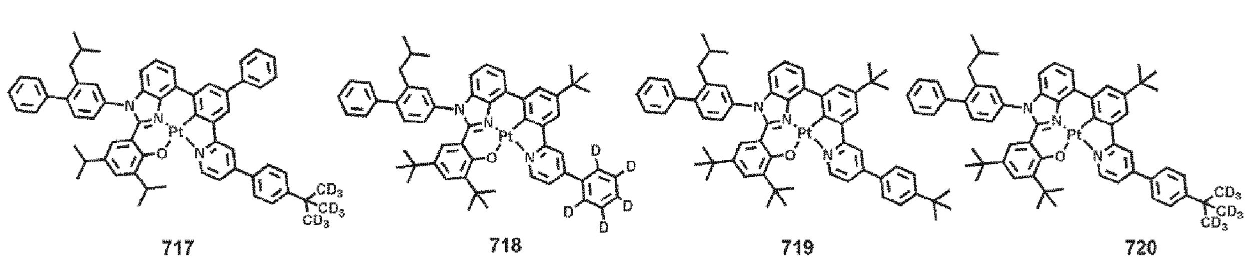

717 718 719 720

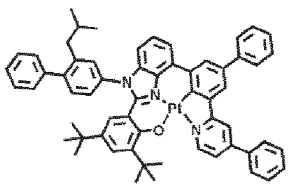
721

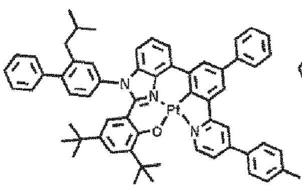
722

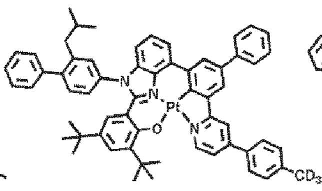
723

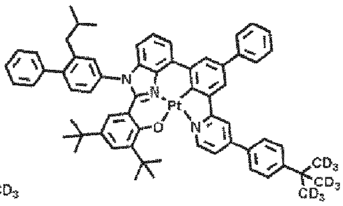
724

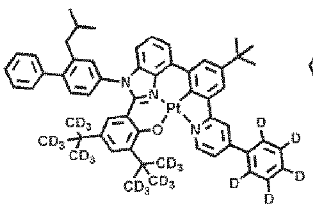
725

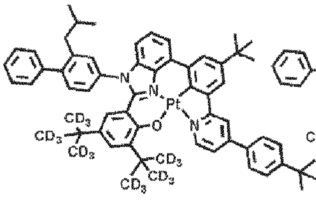
726

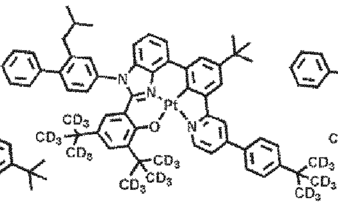
727

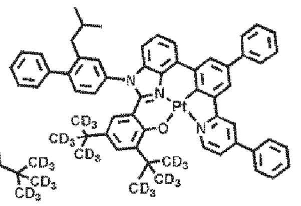
728

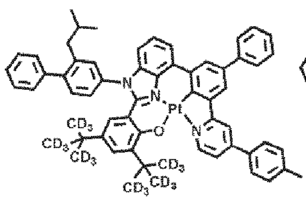
729

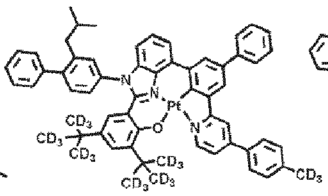
730

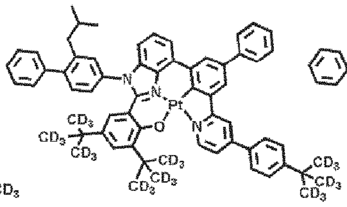
731

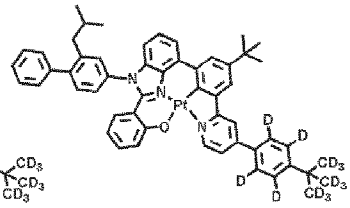
732

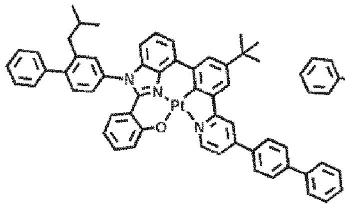
733

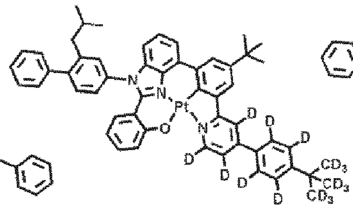
734

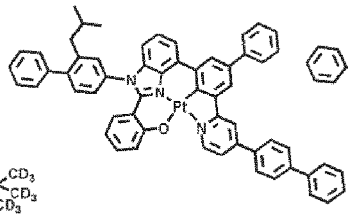
735

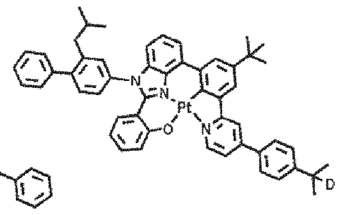
736

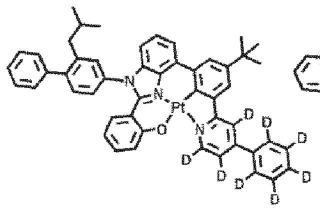
737

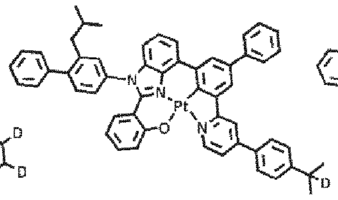
738

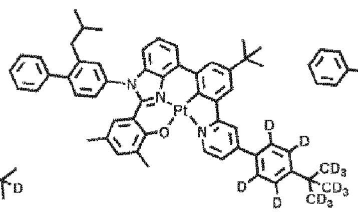
738

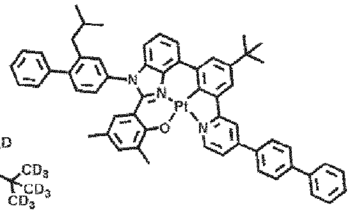
740

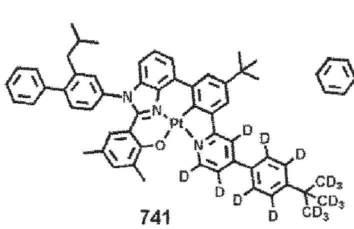
741

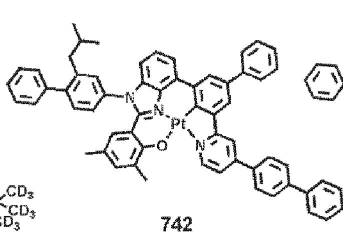
742

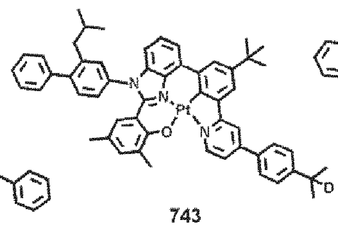
743

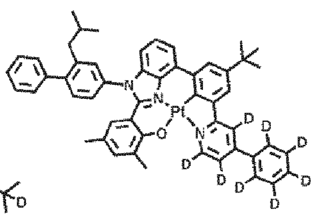
744

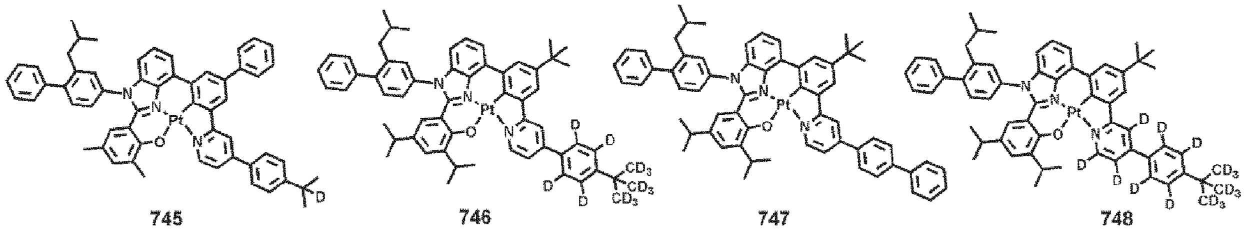

745 746 747 748

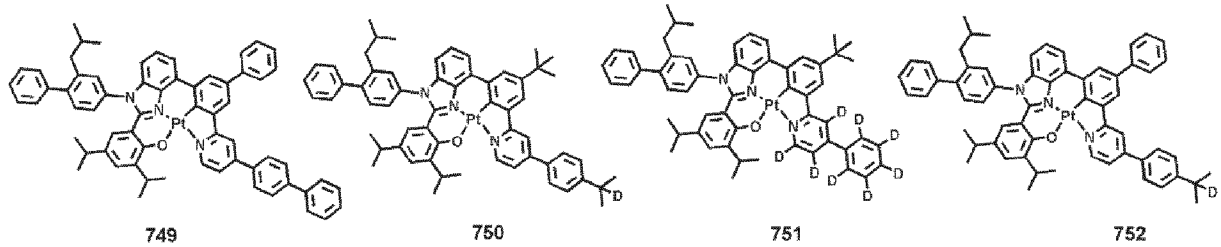

749 750 751 752

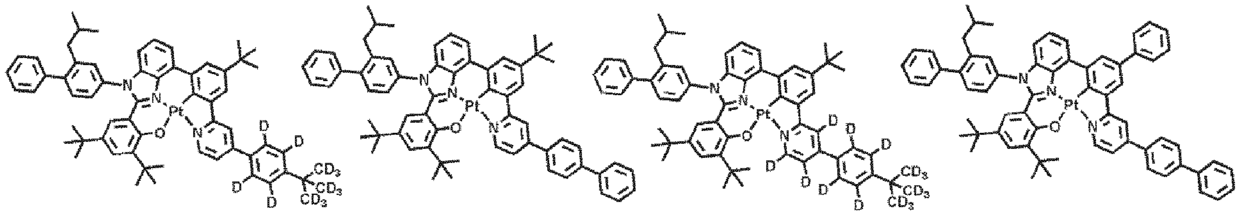

753 754 755 756

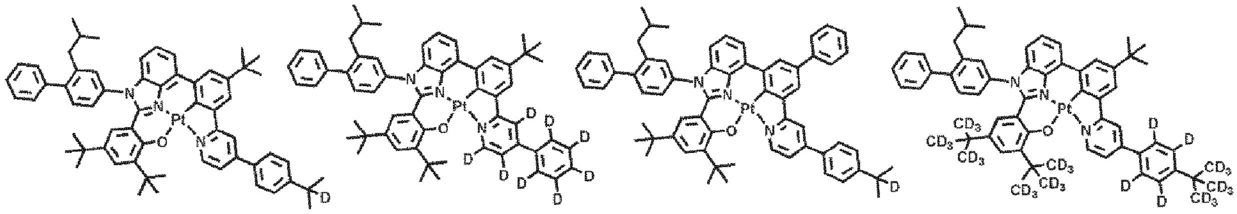

757 758 759 760

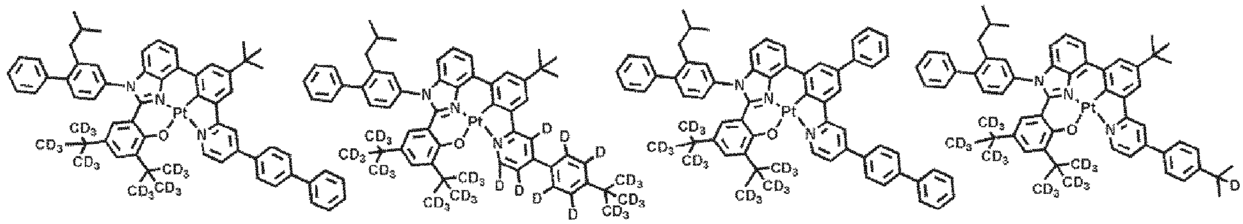

761 762 763 764

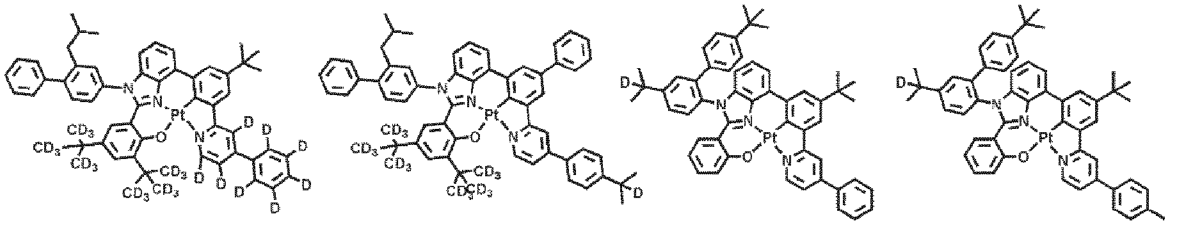

765 766 767 768

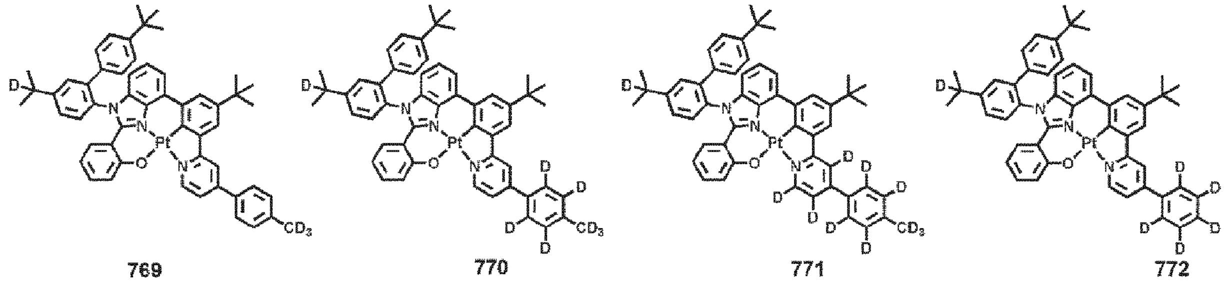

769 770 771 772

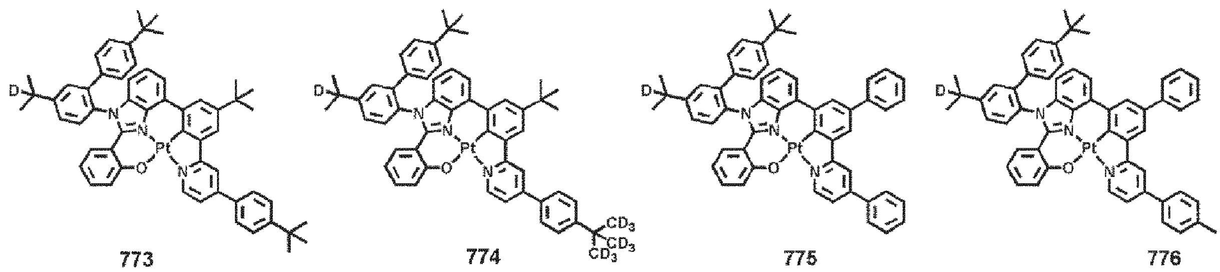

773 774 775 776

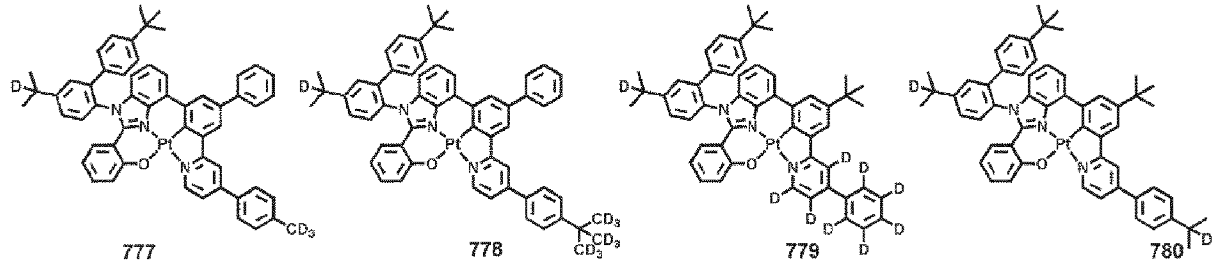

777 778 779 780

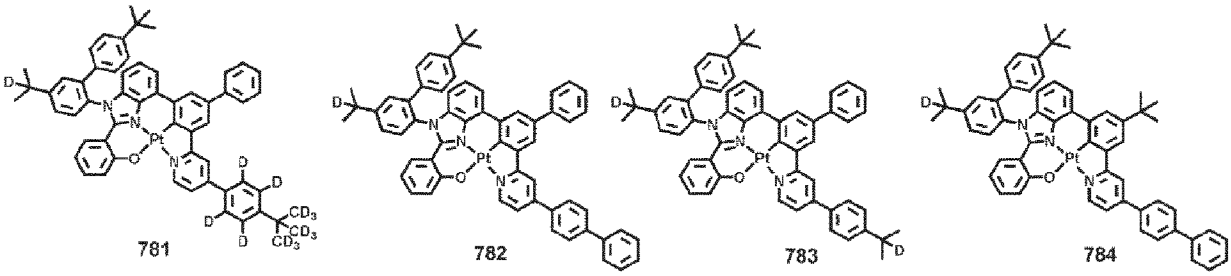

781 782 783 784

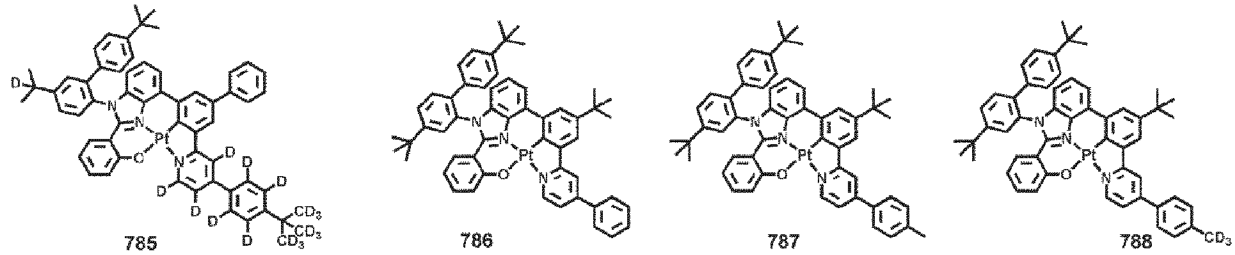

785 786 787 788

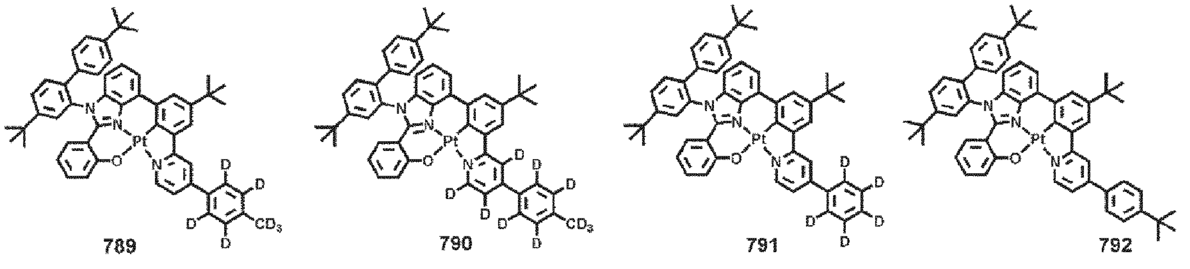

789 790 791 792

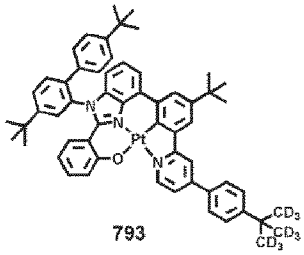
793

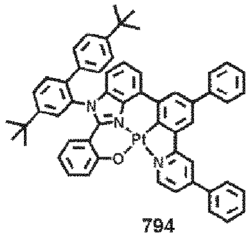
794

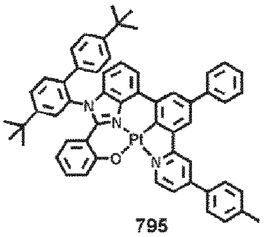
795

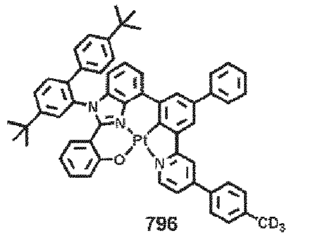
796

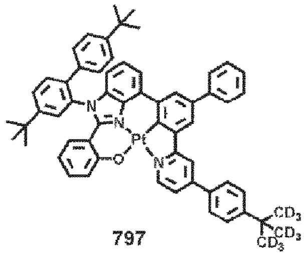
797

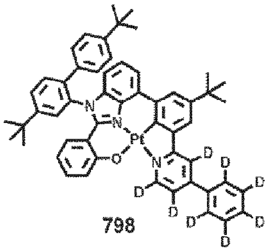
798

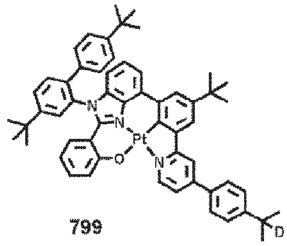
799

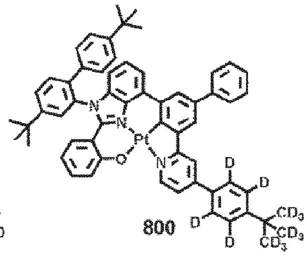
800

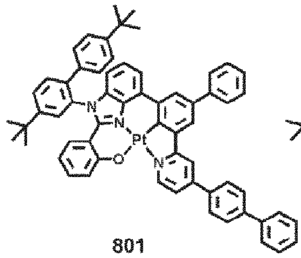
801

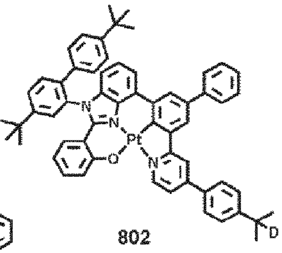
802

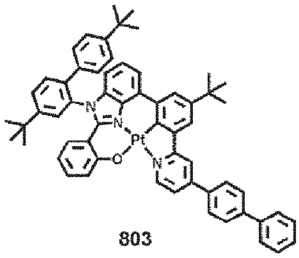
803

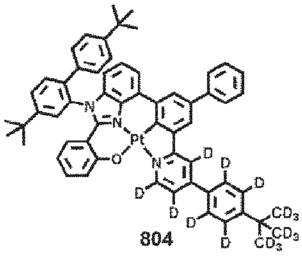
804

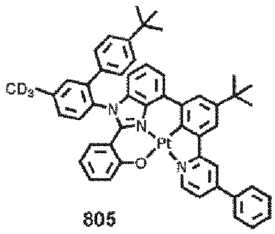
805

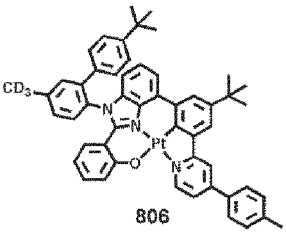
806

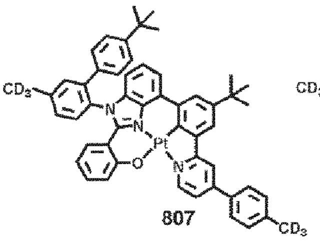
807

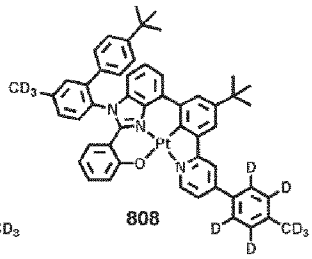
808

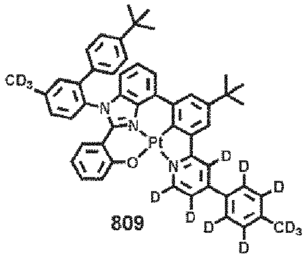
809

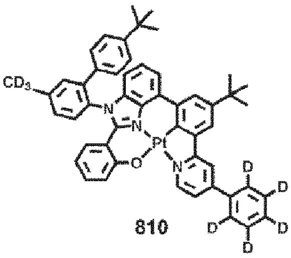
810

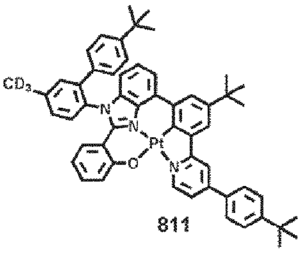
811

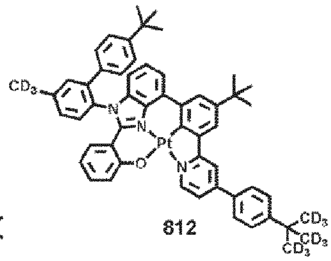
812

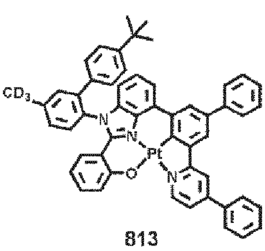
813

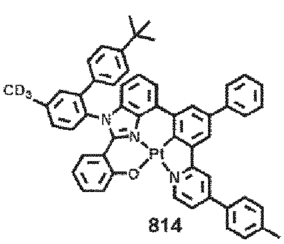
814

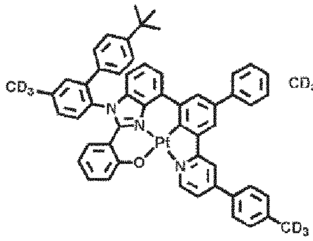
815

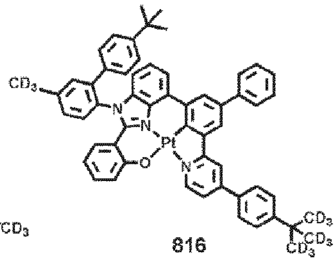
816

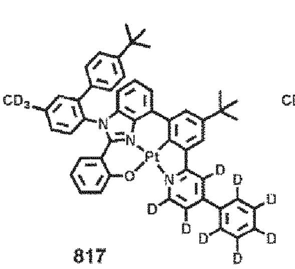

817

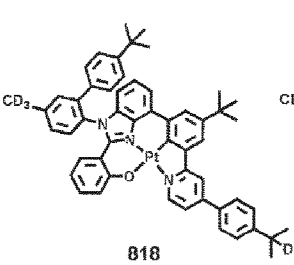

818

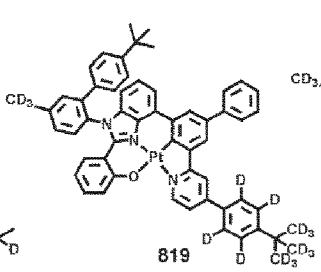

819

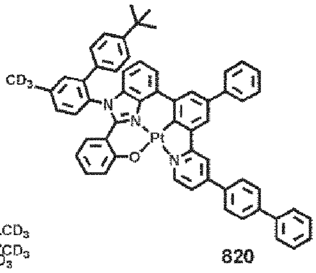

820

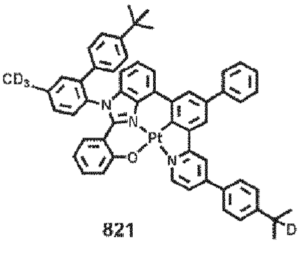

821

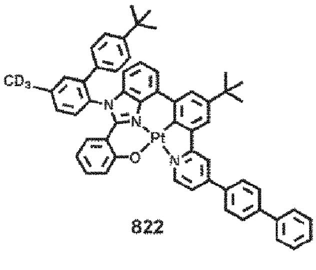

822

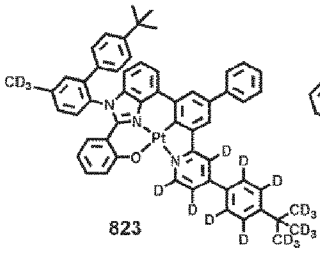

823

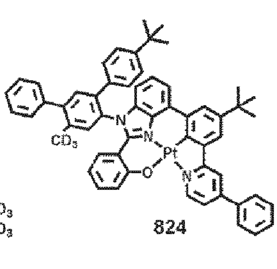

824

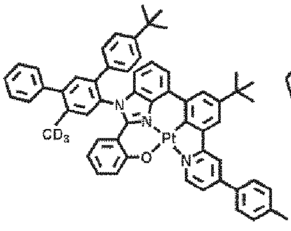

825

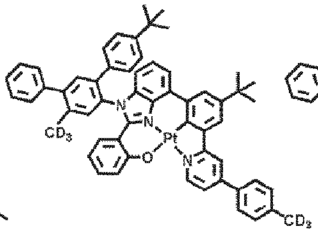

826

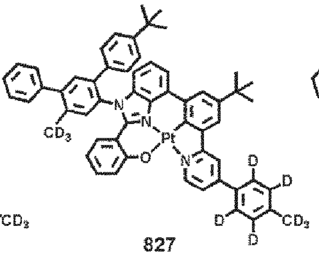

827

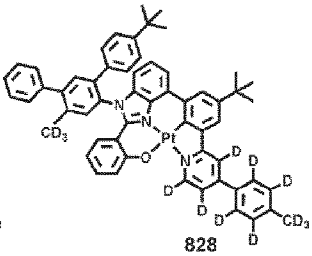

828

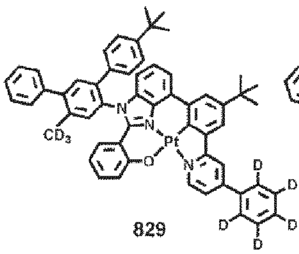

829

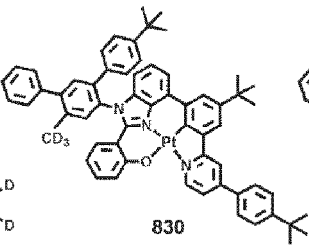

830

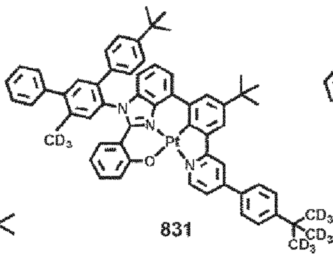

831

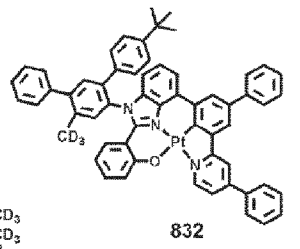

832

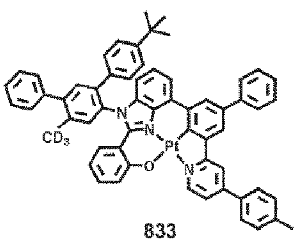

833

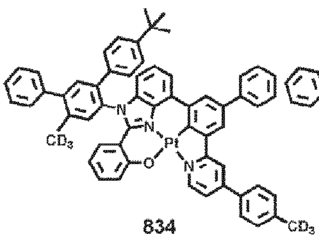

834

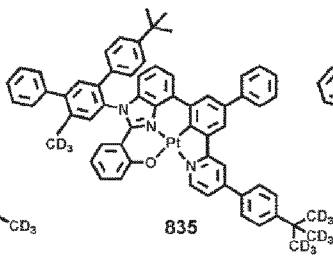

835

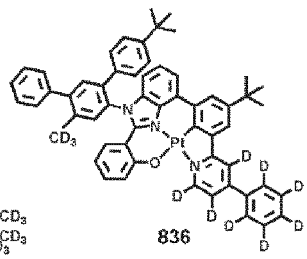

836

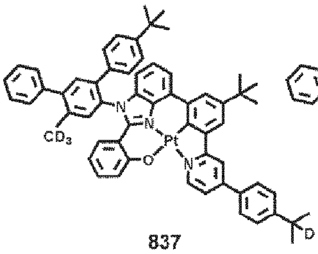

837

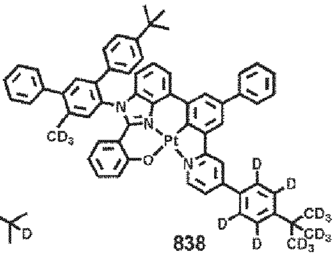

838

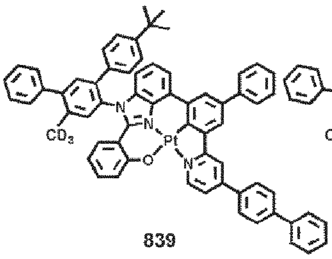

839

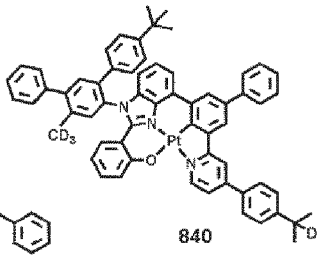

840

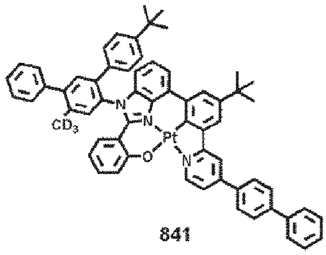
841

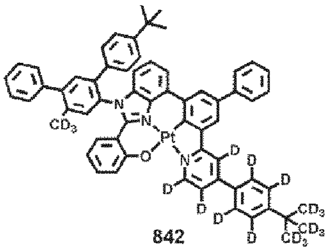
842

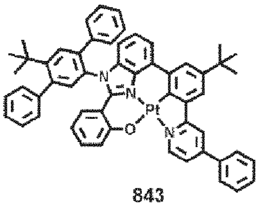
843

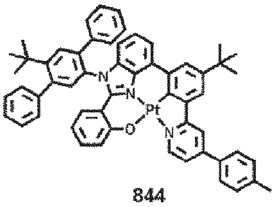
844

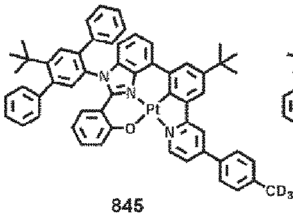
845

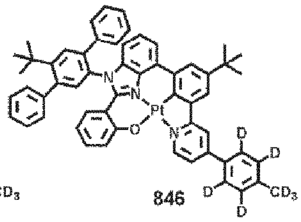
846

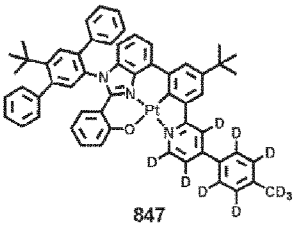
847

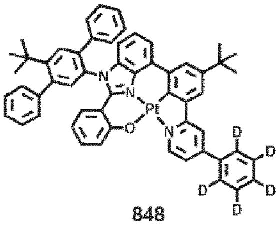
848

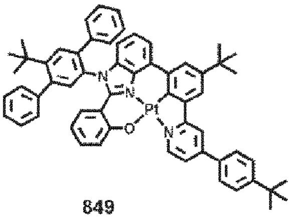
849

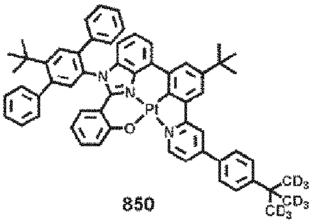
850

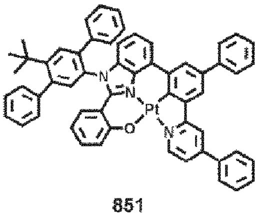
851

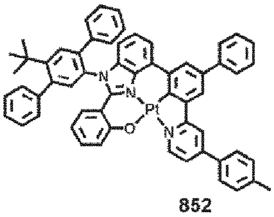
852

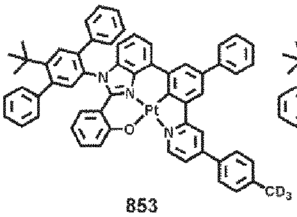
853

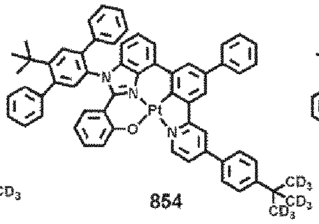
854

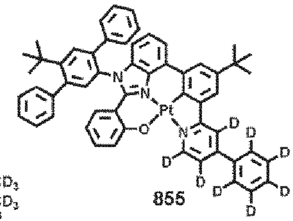
855

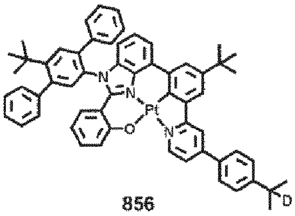
856

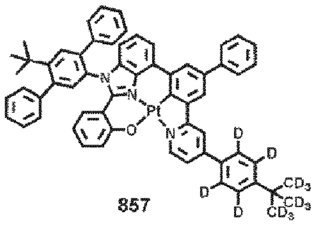
857

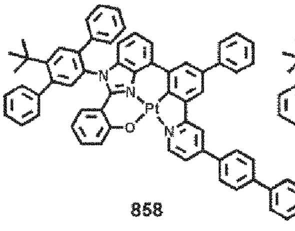
858

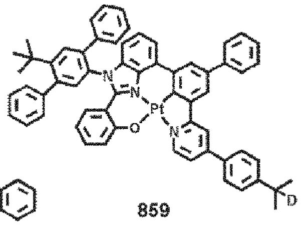
859

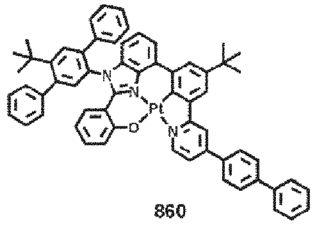
860

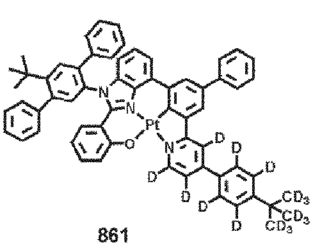
861

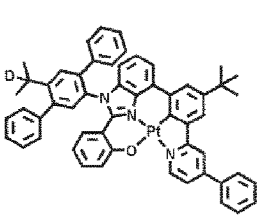
862

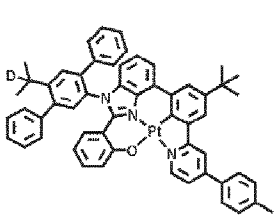
863

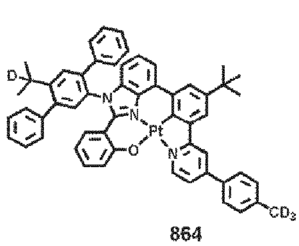
864

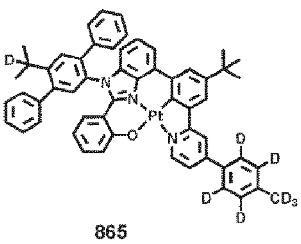
865
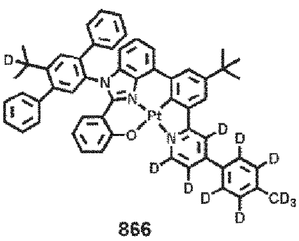
866
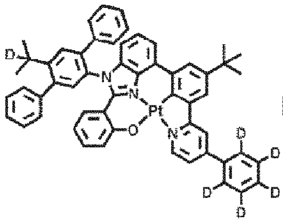
867
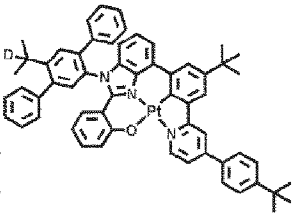
868

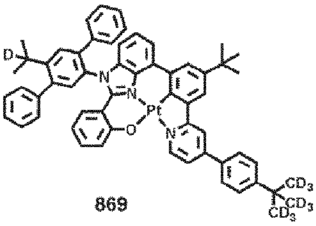
869
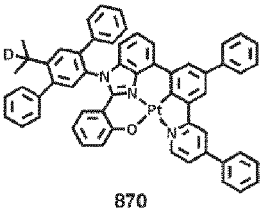
870
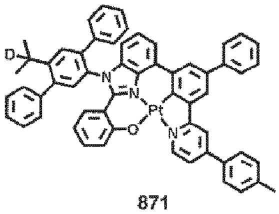
871
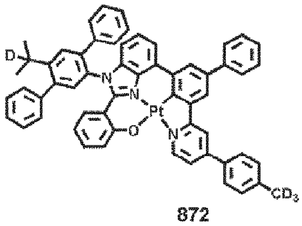
872

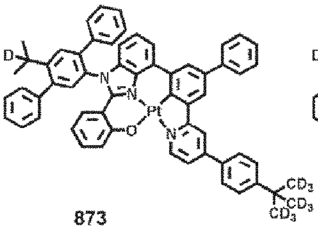
873
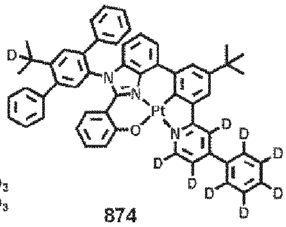
874
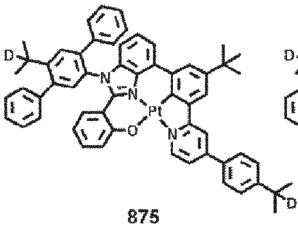
875
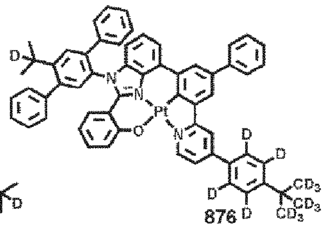
876

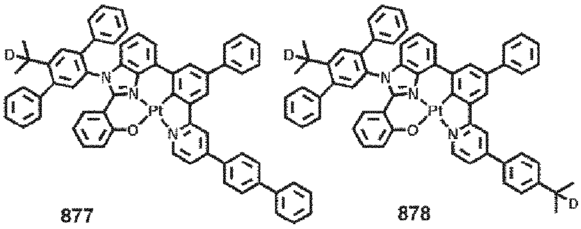
877
878
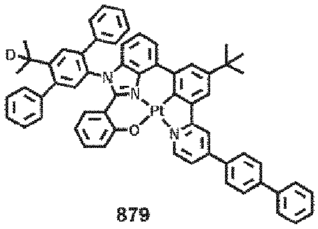
879
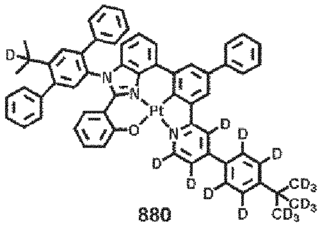
880

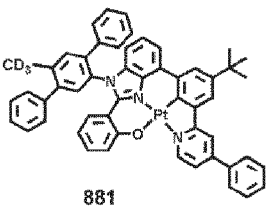
881
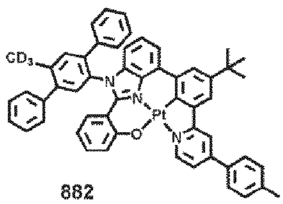
882
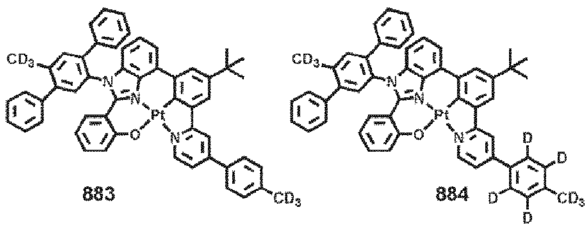
883
884

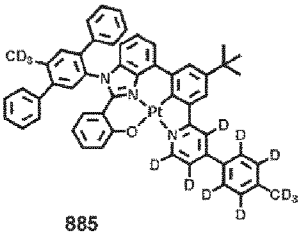
885
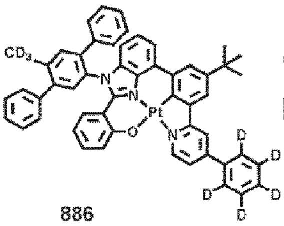
886
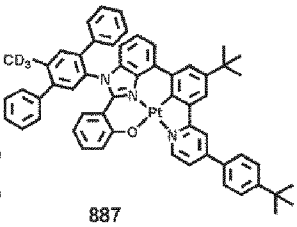
887
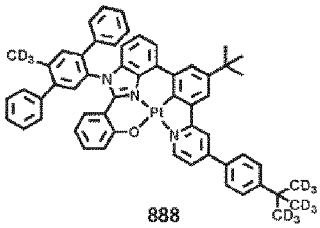
888

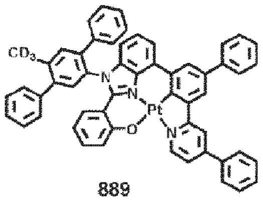

889

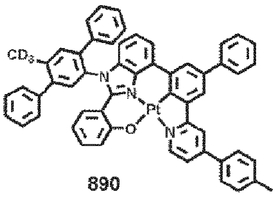

890

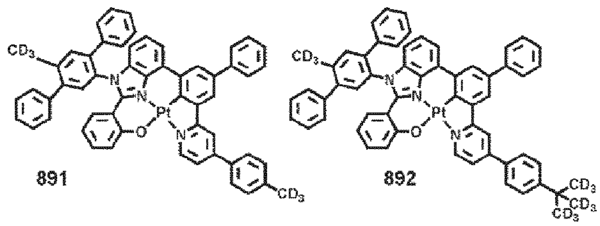

891

892

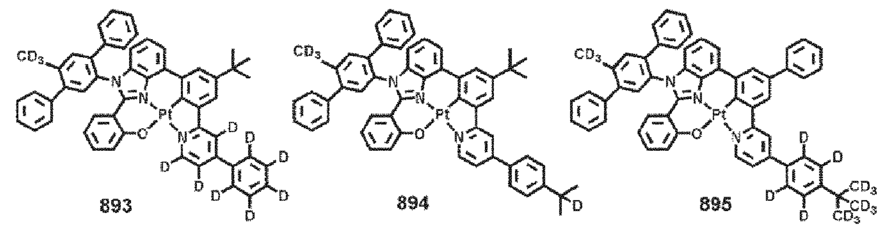

893

894

895

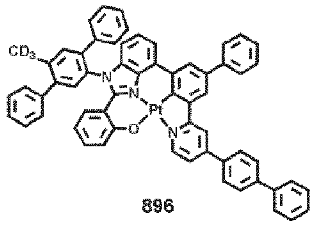

896

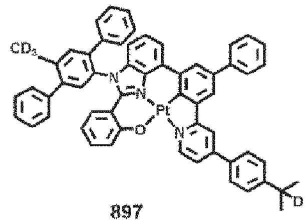

897

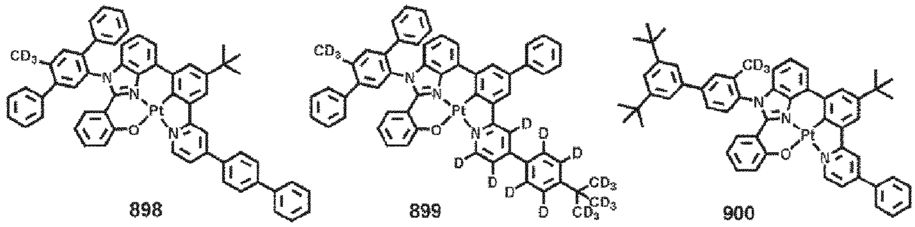

898

899

900

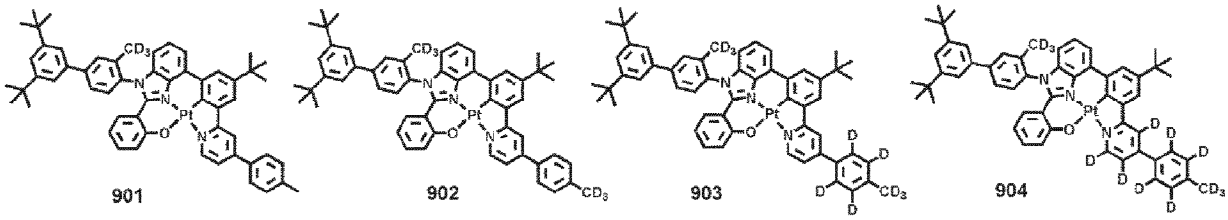

901

902

903

904

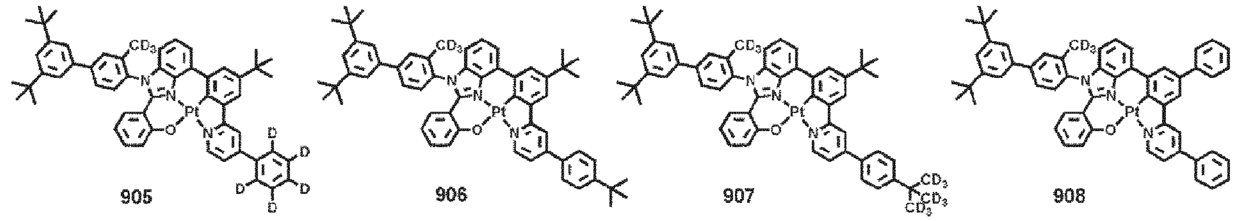

905

906

907

908

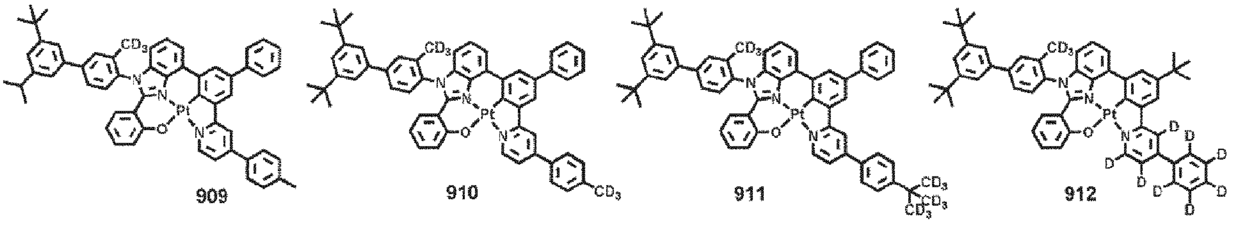

909

910

911

912

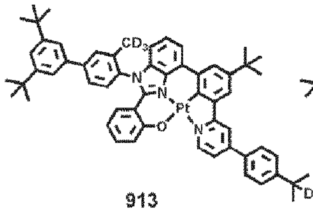
913

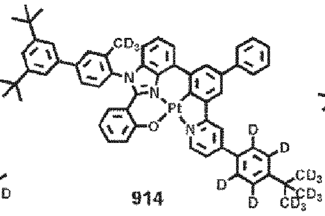
914

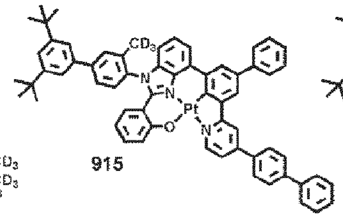
915

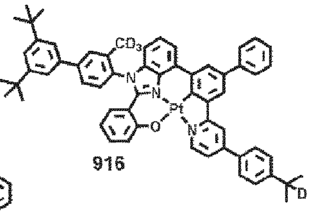
916

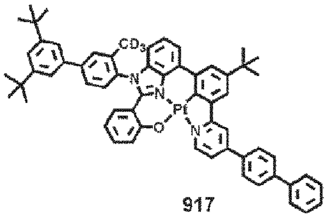
917

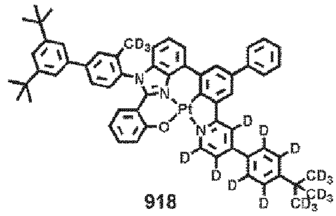
918

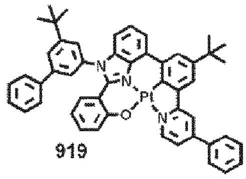
919

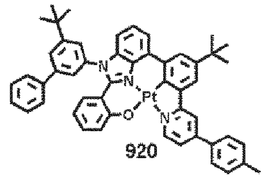
920

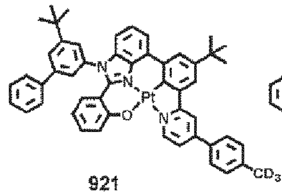
921

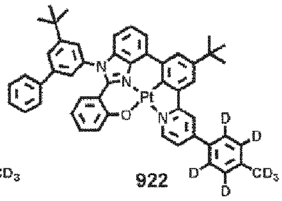
922

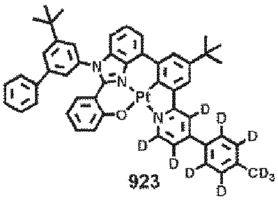
923

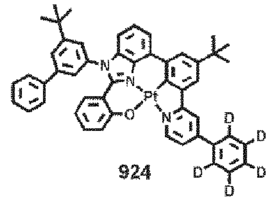
924

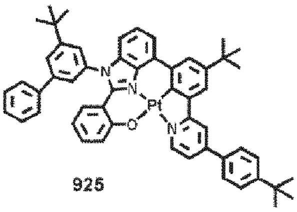
925

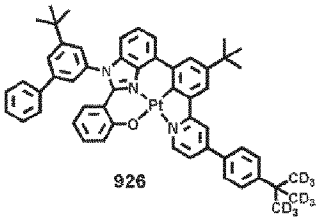
926

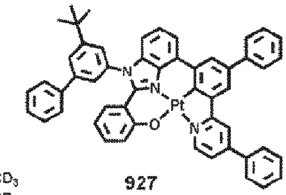
927

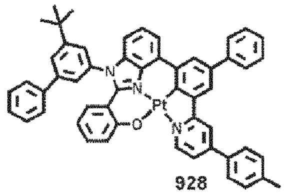
928

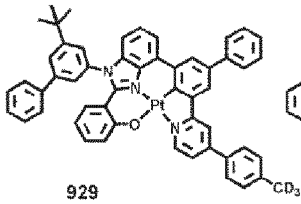
929

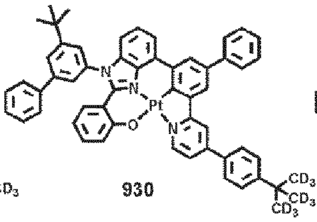
930

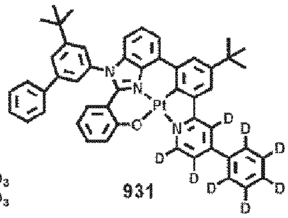
931

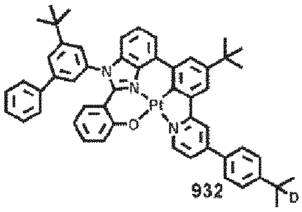
932

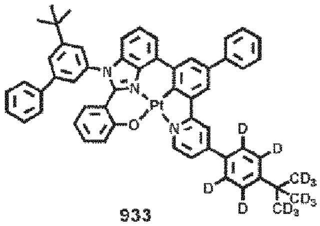
933

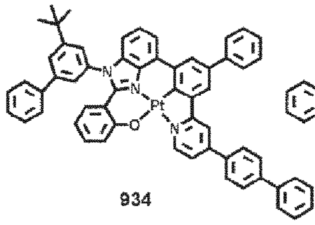
934

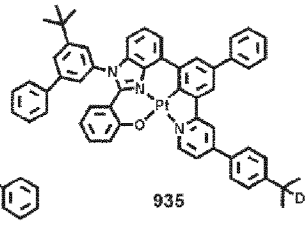
935

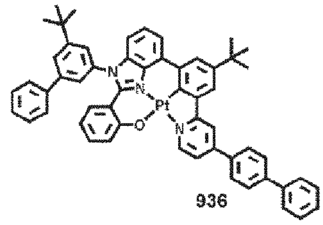
936

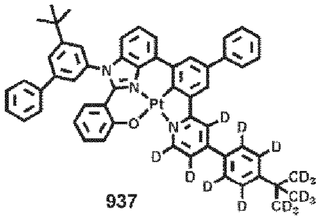
937

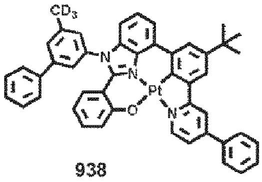
938

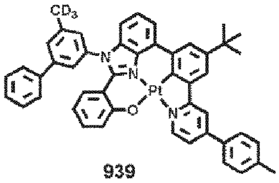
939

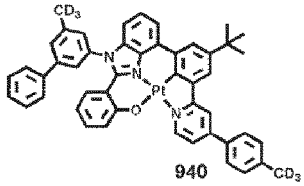
940

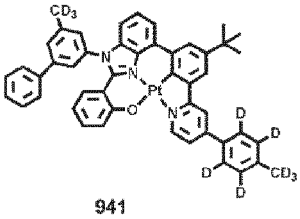
941

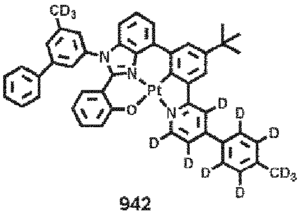
942

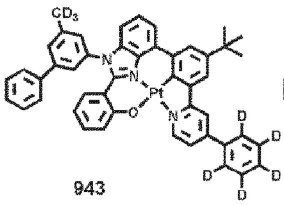
943

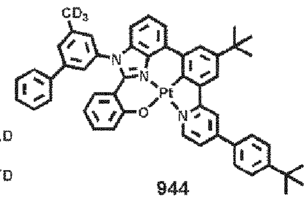
944

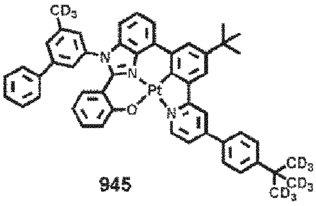
945

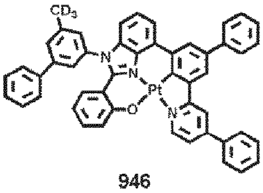
946

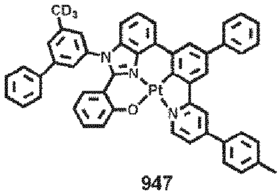
947

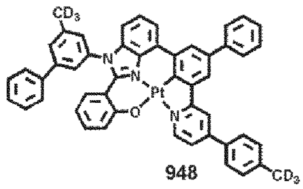
948

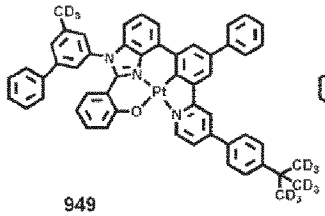
949

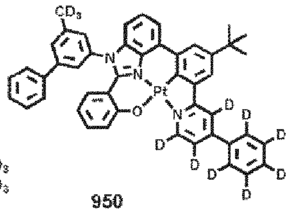
950

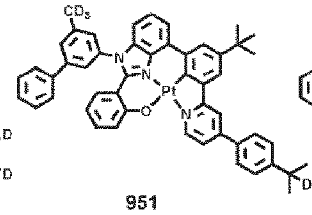
951

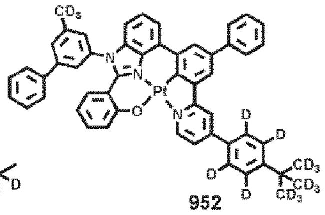
952

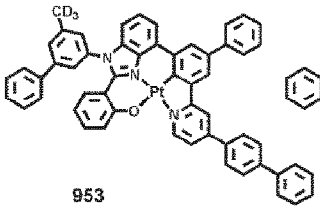
953

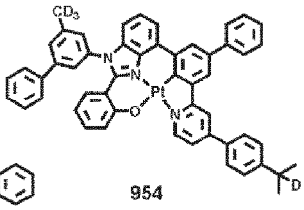
954

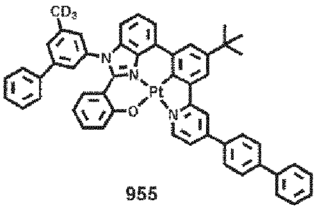
955

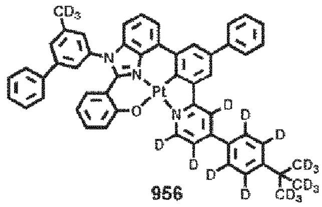
956

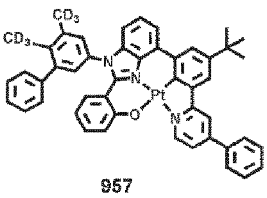
957

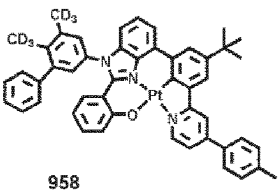
958

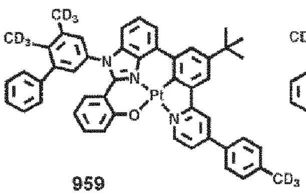
959

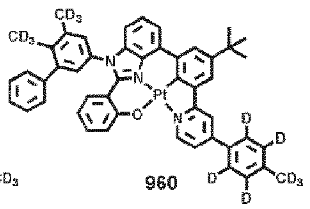
960

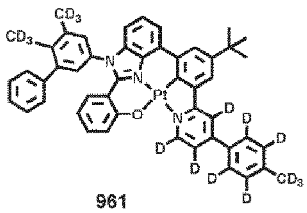
961

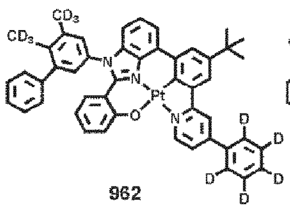
962

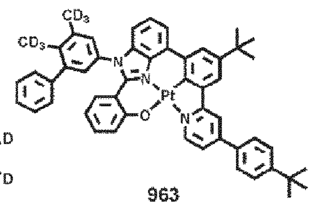
963

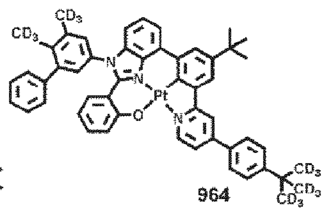
964

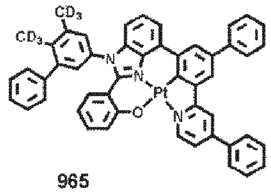
965

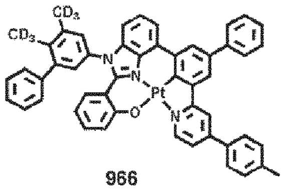
966

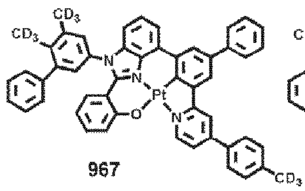
967

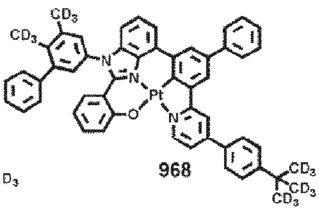
968

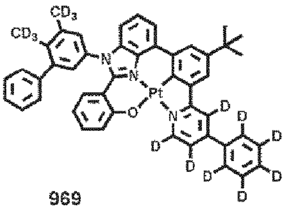
969

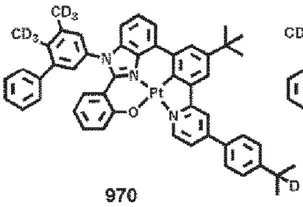
970

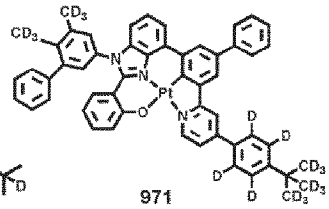
971

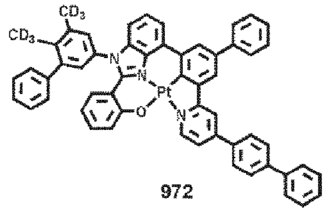
972

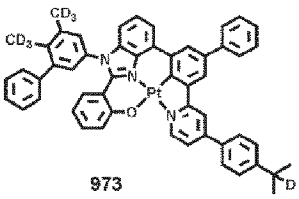
973

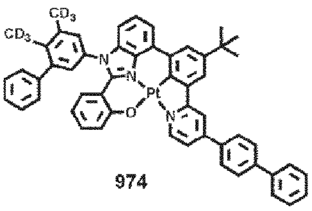
974

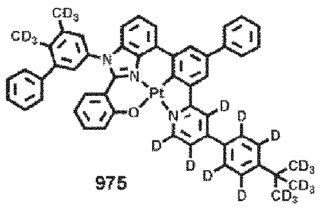
975

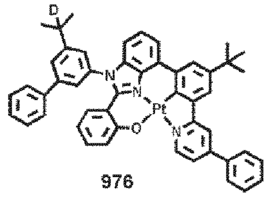
976

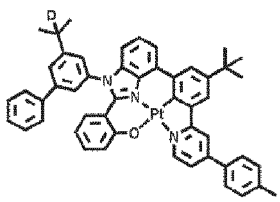
977

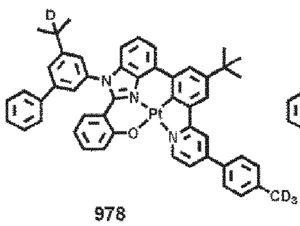
978

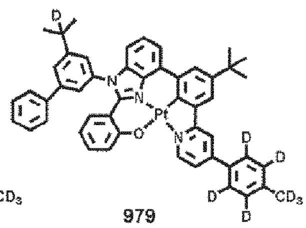
979

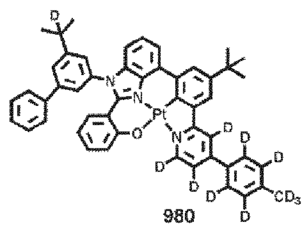
980

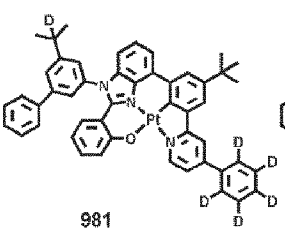
981

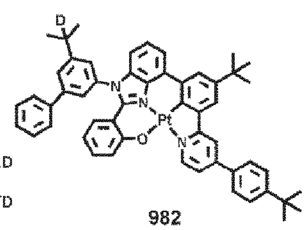
982

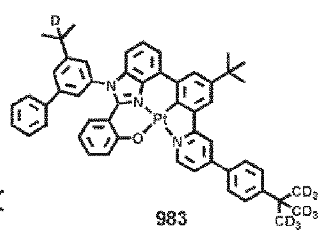
983

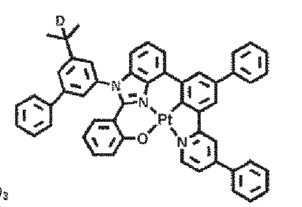
984

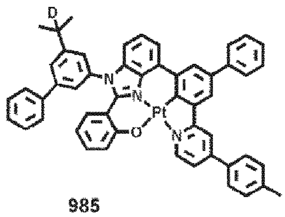
985
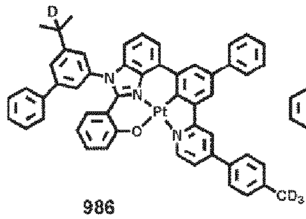
986
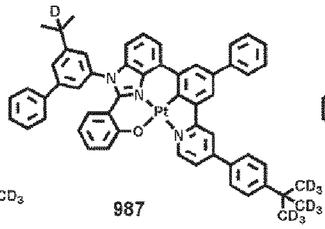
987
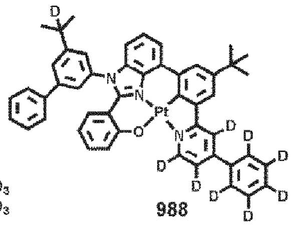
988

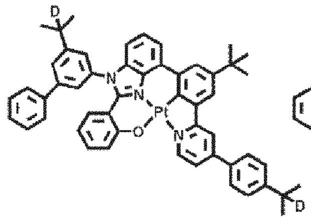
989
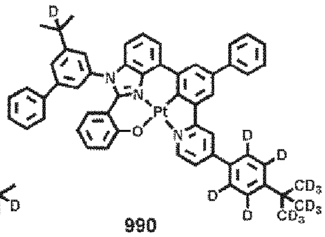
990
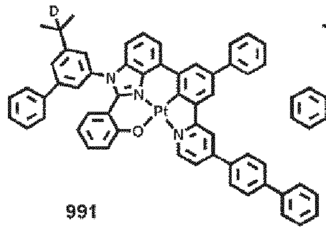
991
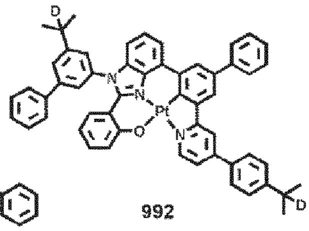
992

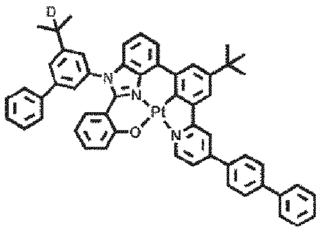
993
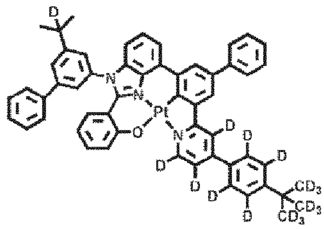
994
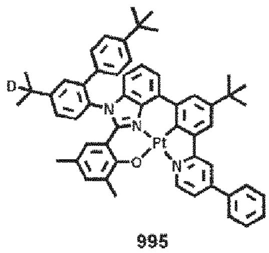
995
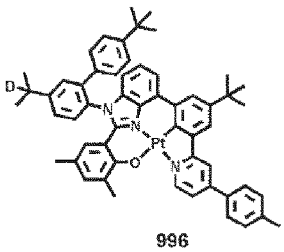
996

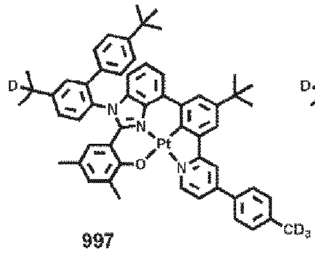
997
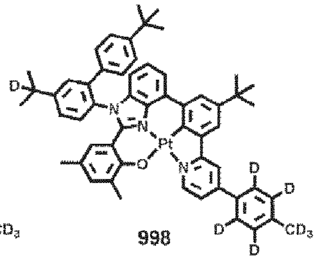
998
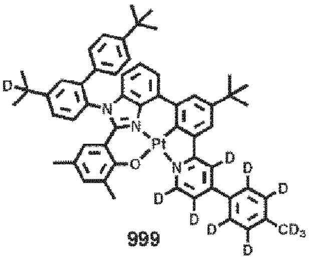
999
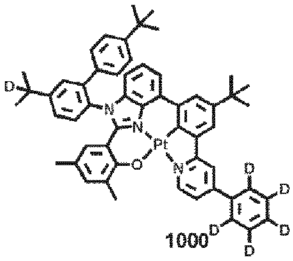
1000

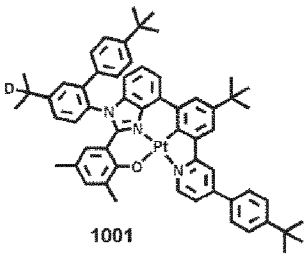
1001
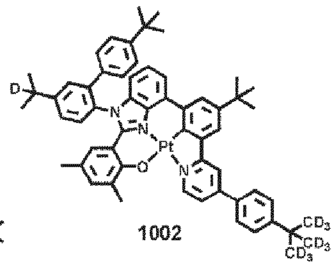
1002
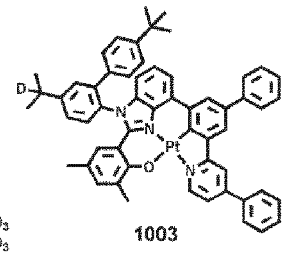
1003
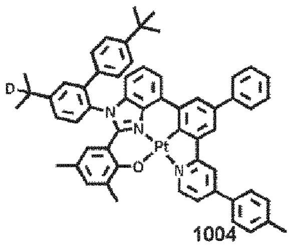
1004

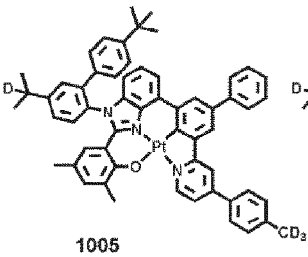
1005
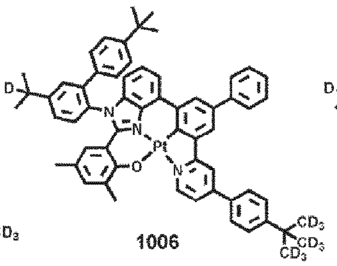
1006
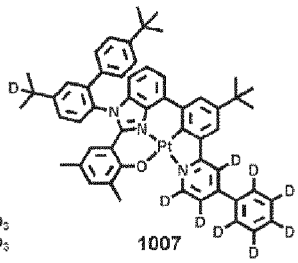
1007
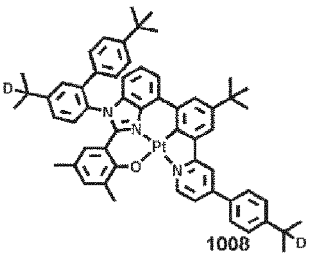
1008

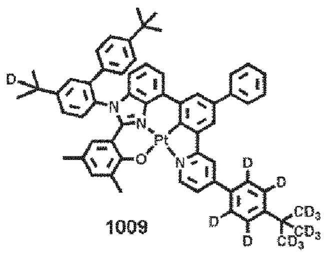

1009

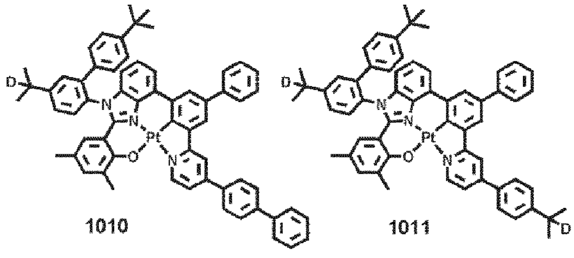

1010

1011

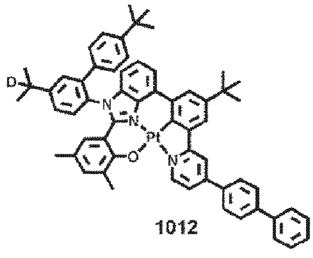

1012

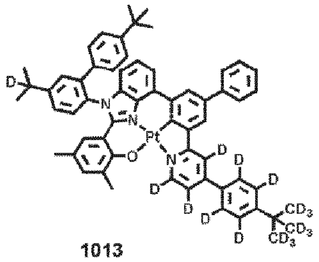

1013

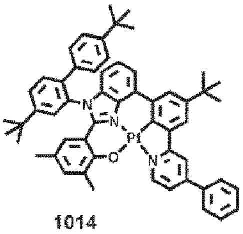

1014

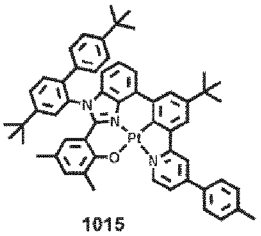

1015

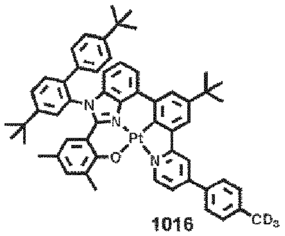

1016

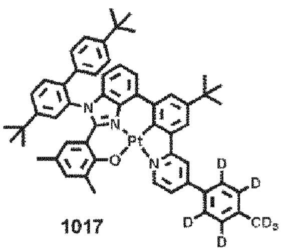

1017

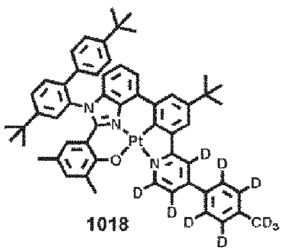

1018

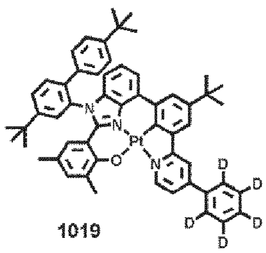

1019

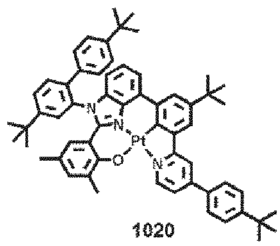

1020

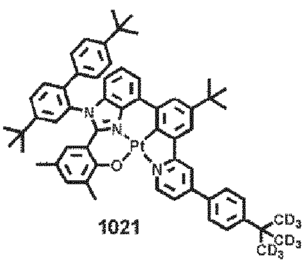

1021

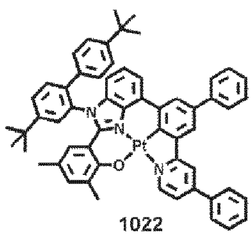

1022

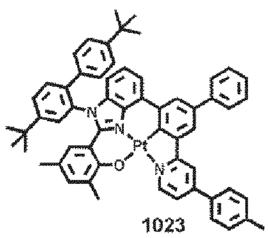

1023

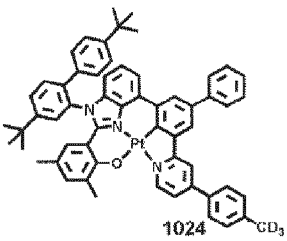

1024

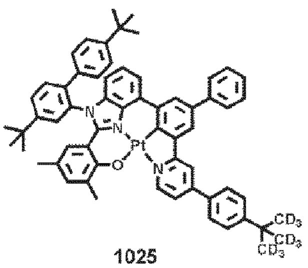

1025

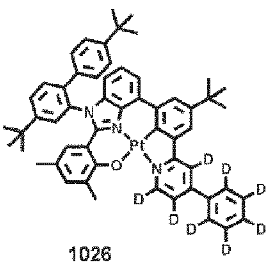

1026

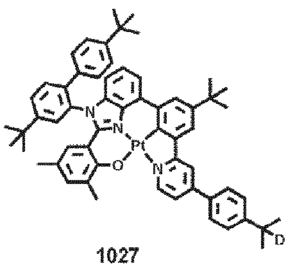

1027

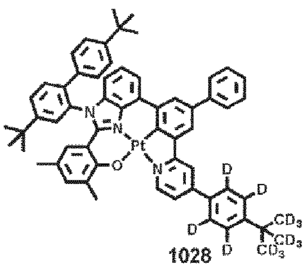

1028

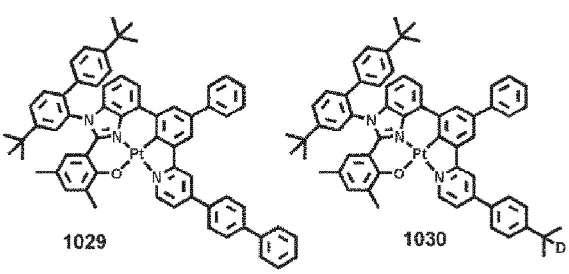

1029

1030

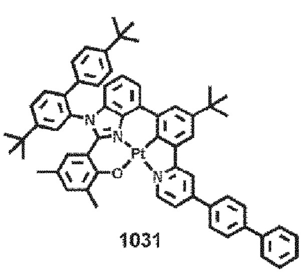

1031

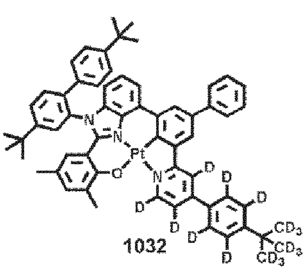

1032

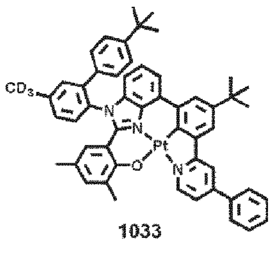
1033

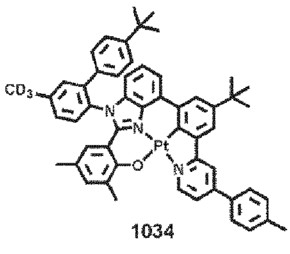
1034

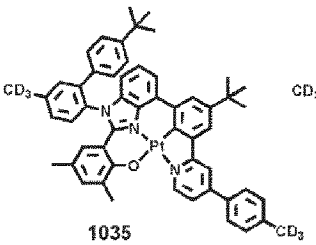
1035

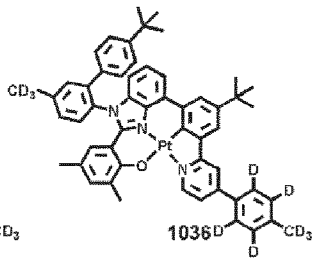
1036

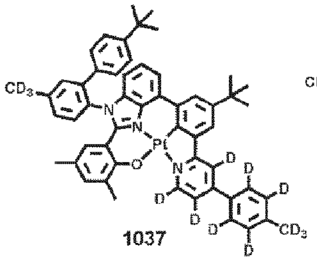
1037

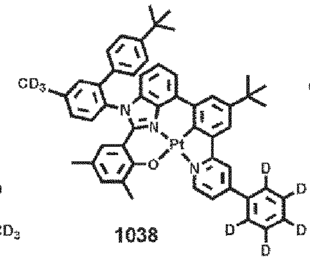
1038

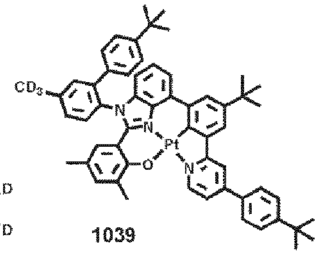
1039

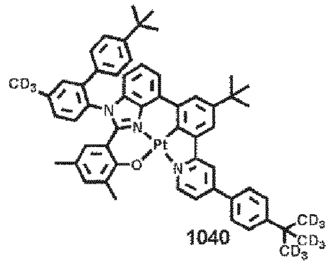
1040

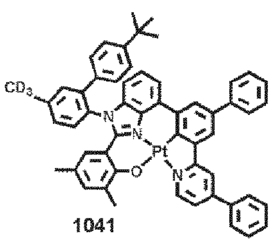
1041

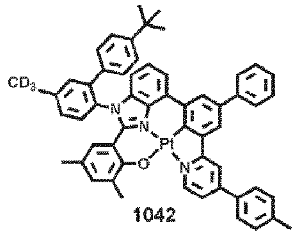
1042

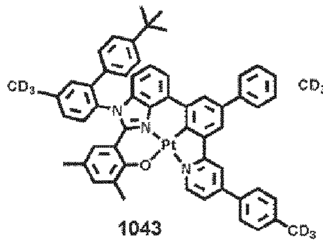
1043

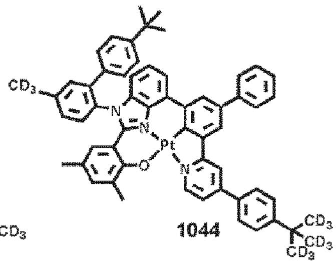
1044

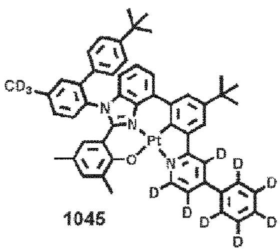
1045

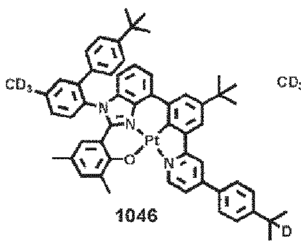
1046

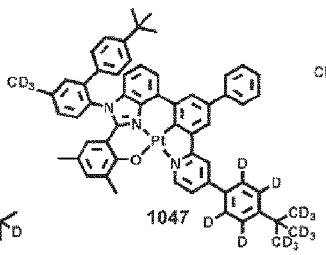
1047

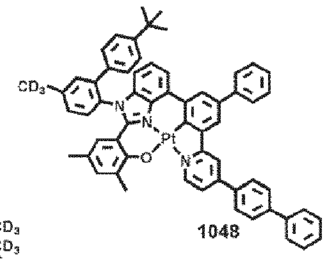
1048

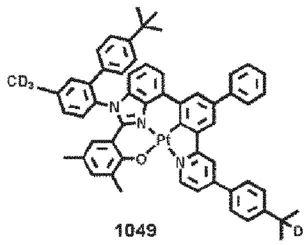
1049

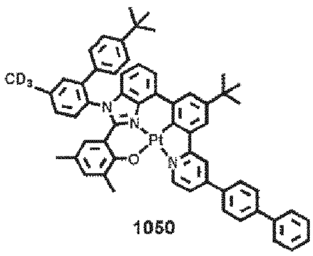
1050

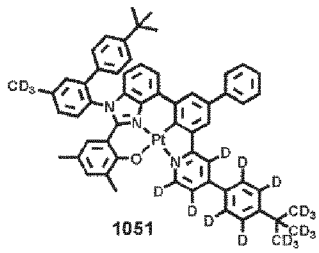
1051

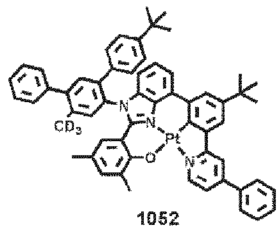
1052

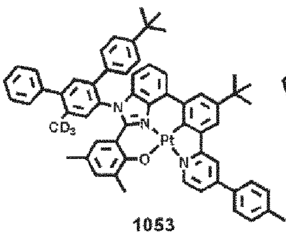
1053

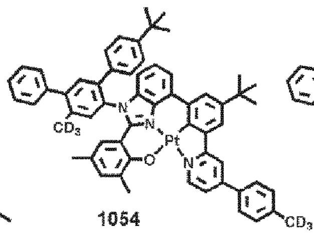
1054

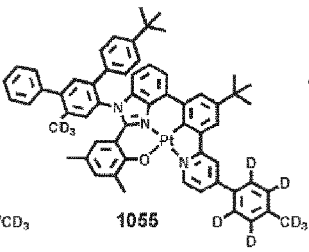
1055

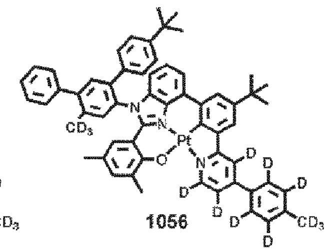
1056

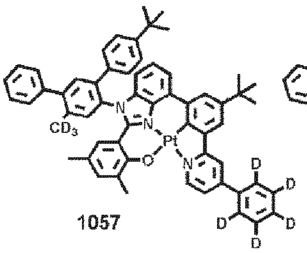
1057

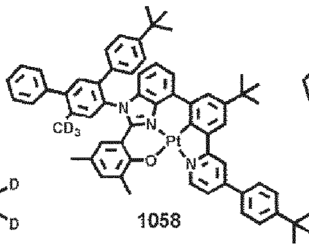
1058

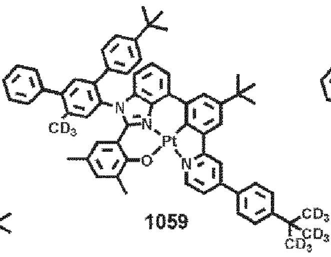
1059

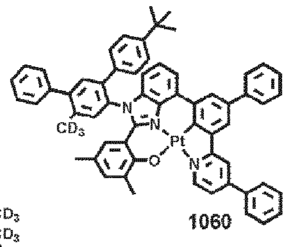
1060

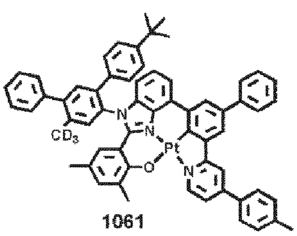
1061

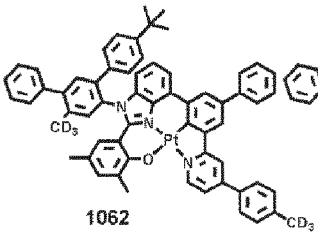
1062

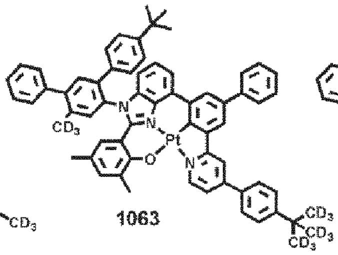
1063

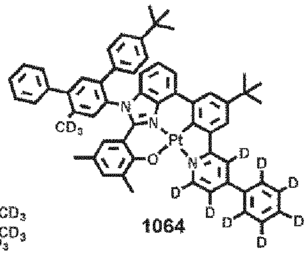
1064

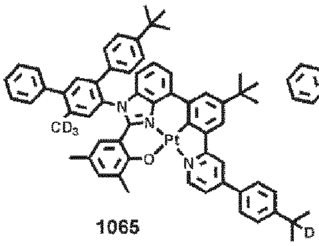
1065

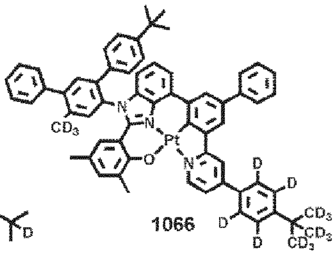
1066

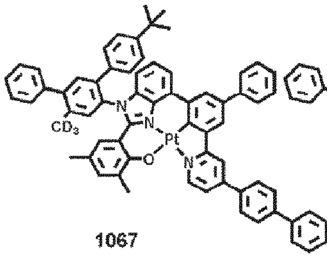
1067

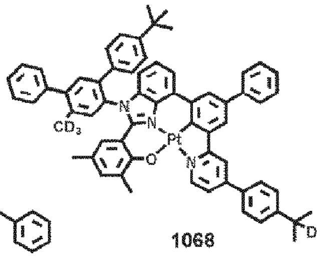
1068

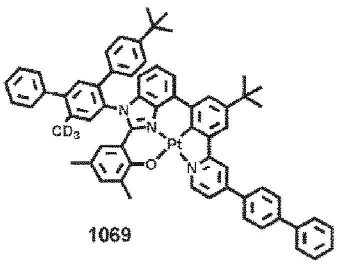
1069

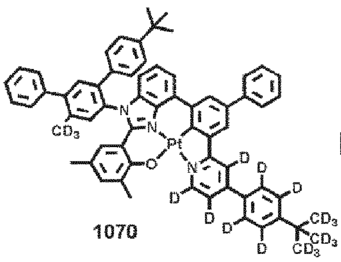
1070

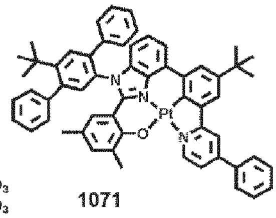
1071

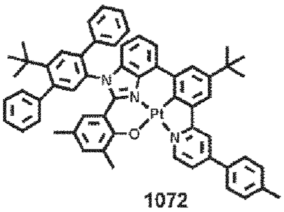
1072

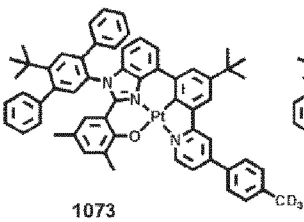
1073

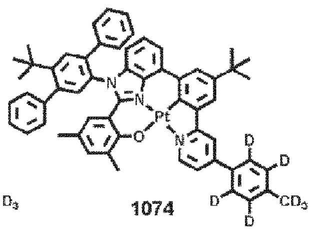
1074

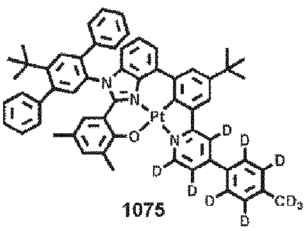
1075

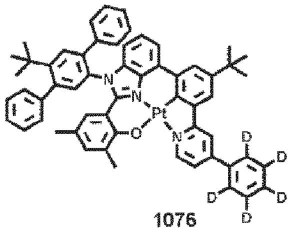
1076

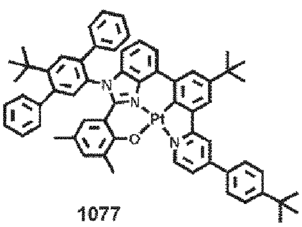
1077

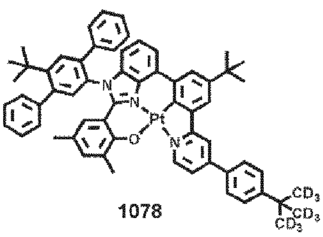
1078

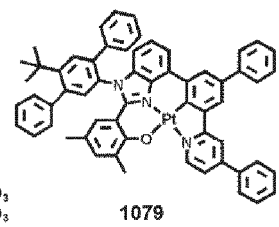
1079

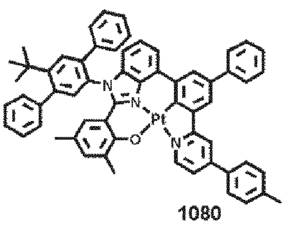
1080

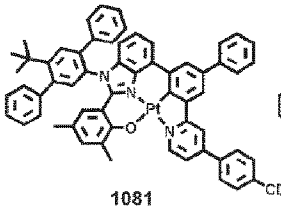
1081

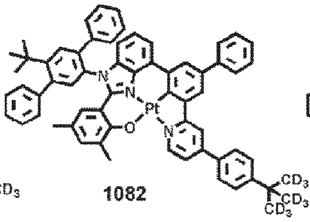
1082

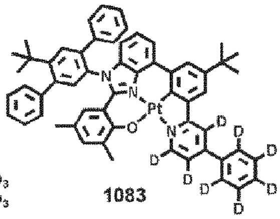
1083

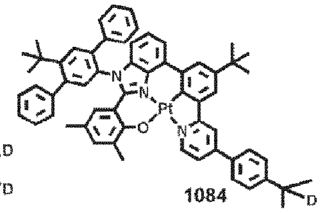
1084

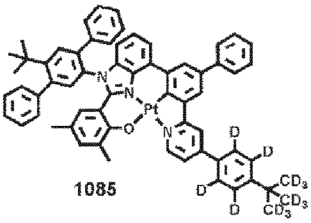
1085

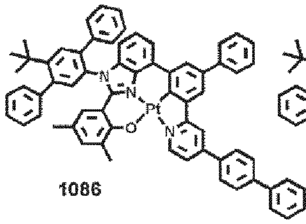
1086

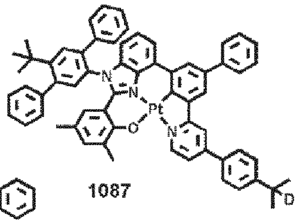
1087

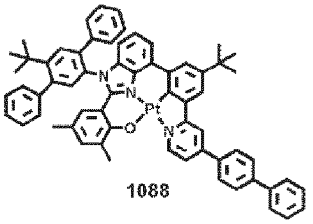
1088

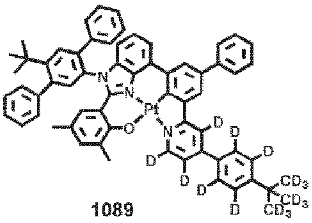
1089

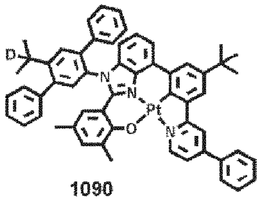
1090

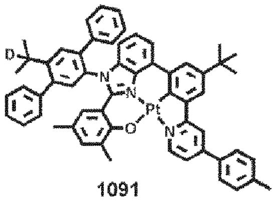
1091

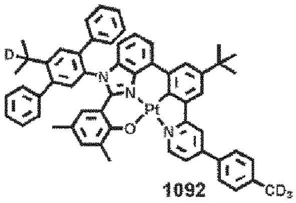
1092

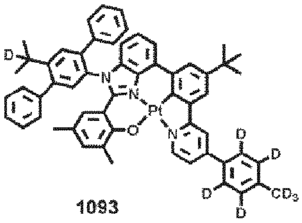
1093

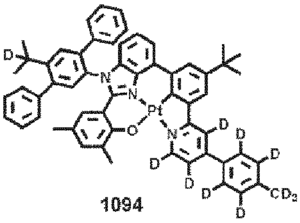
1094

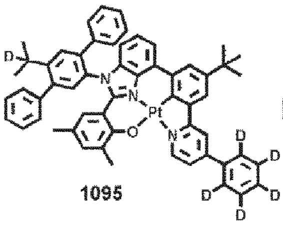
1095

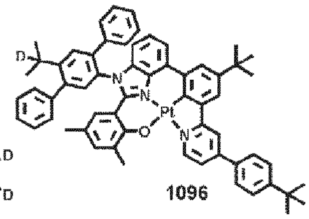
1096

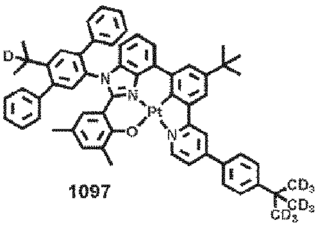
1097

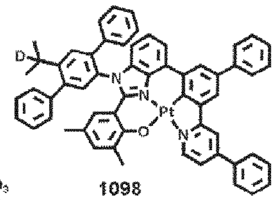
1098

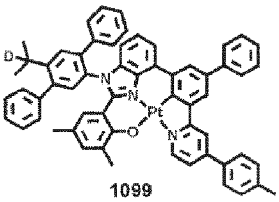
1099

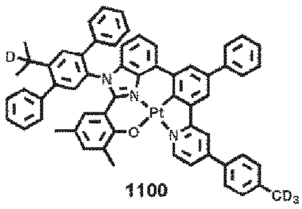
1100

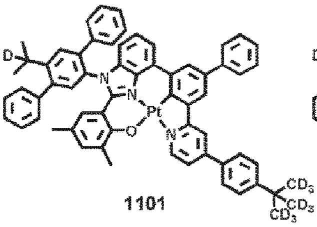
1101

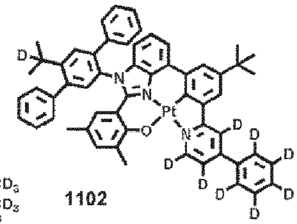
1102

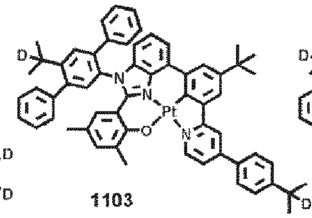
1103

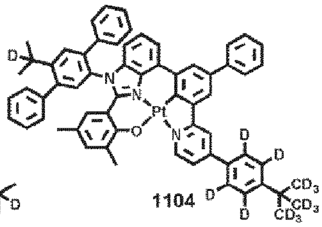
1104

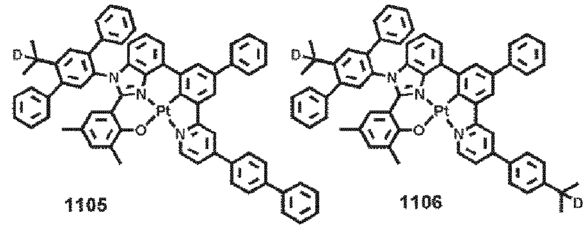

1105

1106

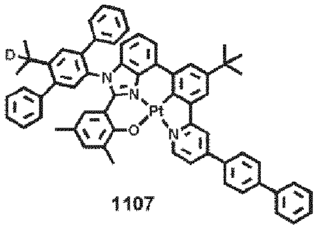

1107

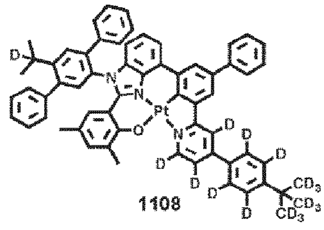

1108

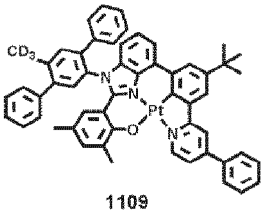

1109

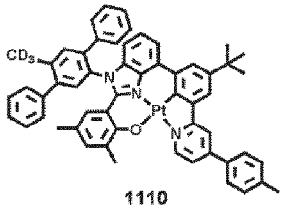

1110

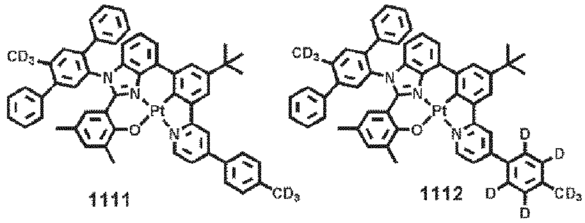

1111

1112

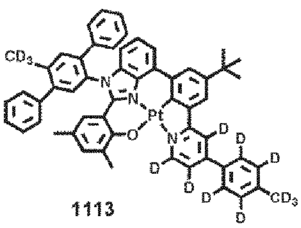

1113

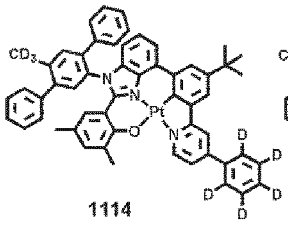

1114

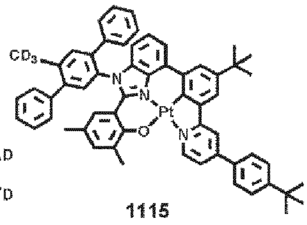

1115

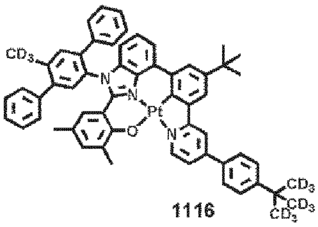

1116

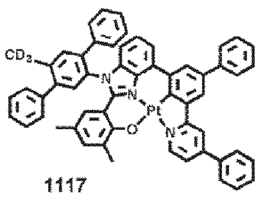

1117

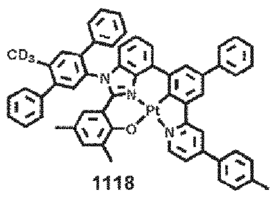

1118

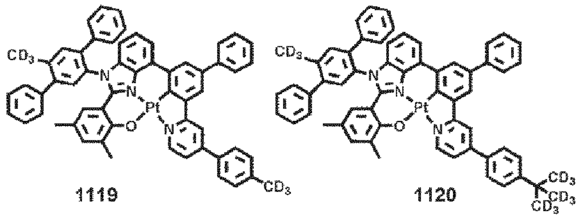

1119

1120

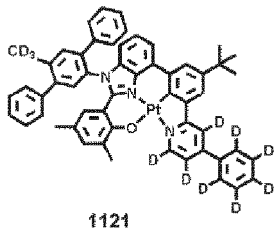

1121

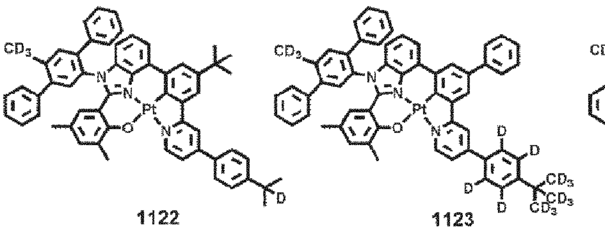

1122

1123

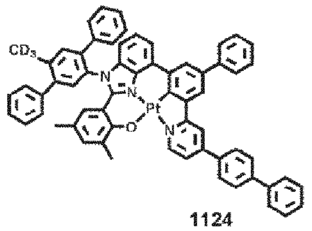

1124

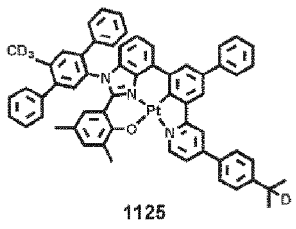

1125

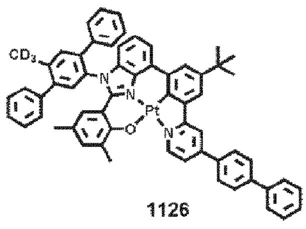

1126

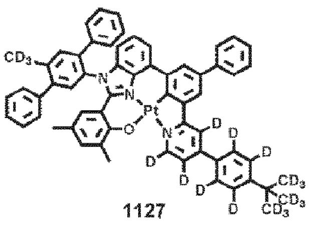

1127

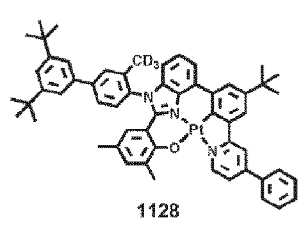

1128

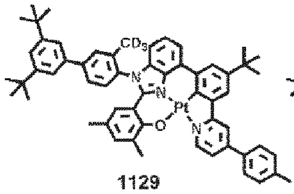
1129

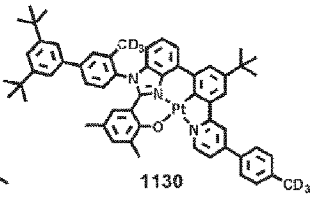
1130

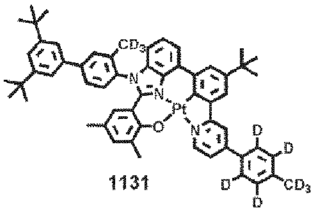
1131

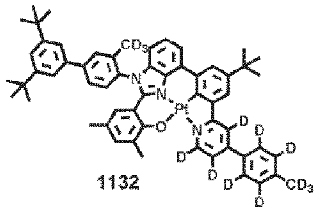
1132

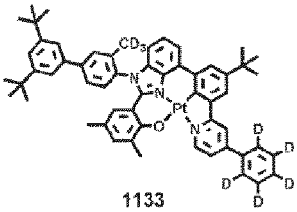
1133

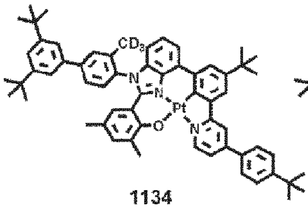
1134

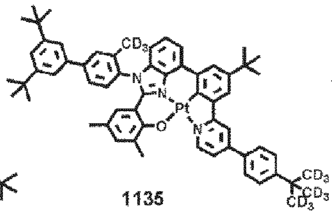
1135

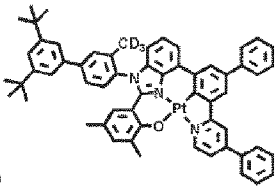
1136

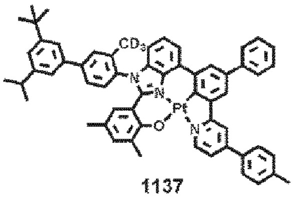
1137

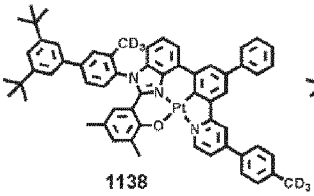
1138

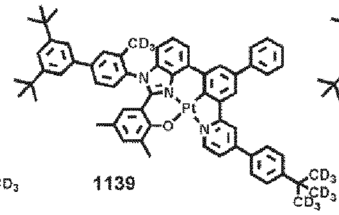
1139

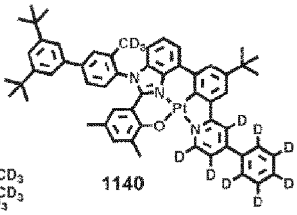
1140

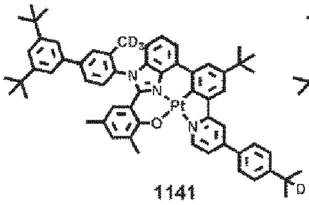
1141

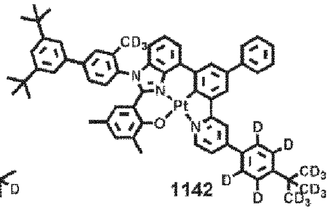
1142

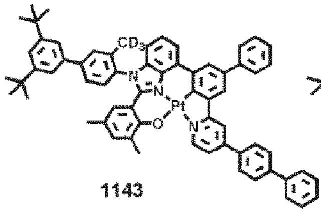
1143

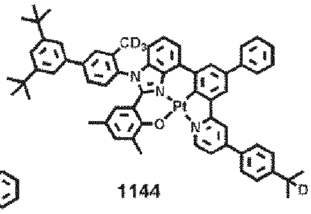
1144

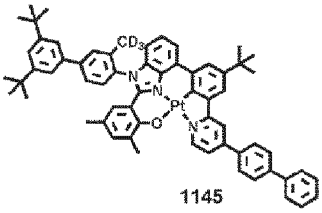
1145

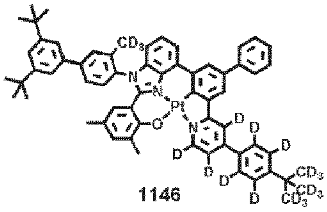
1146

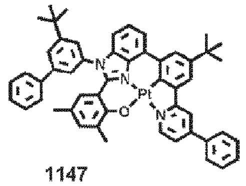
1147

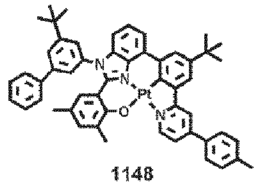
1148

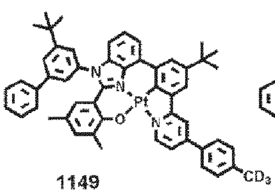
1149

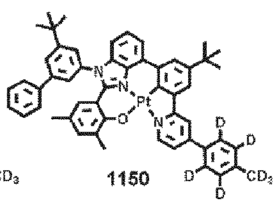
1150

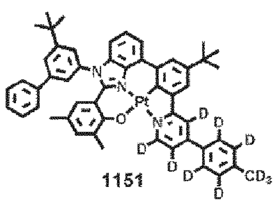
1151

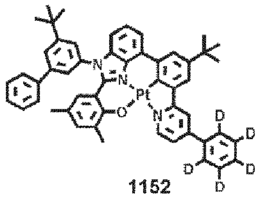
1152

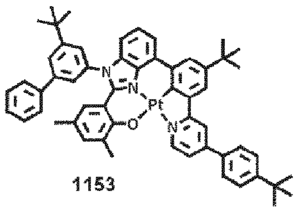
1153

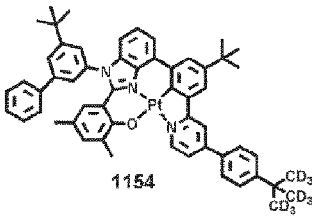
1154

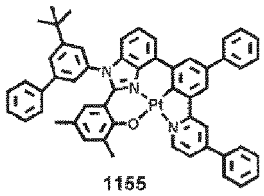
1155

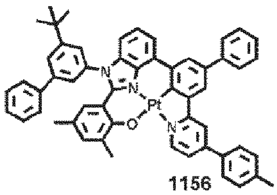
1156

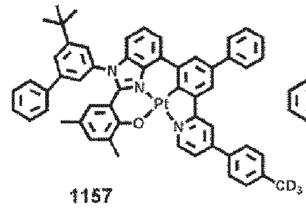
1157

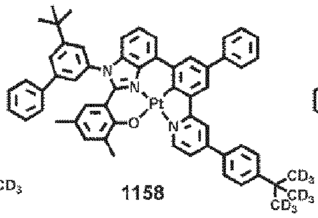
1158

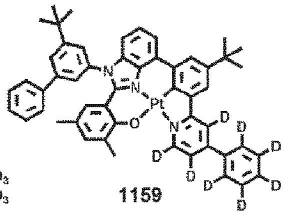
1159

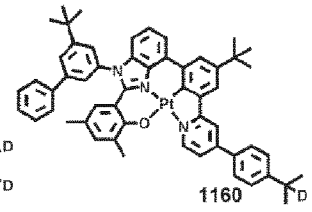
1160

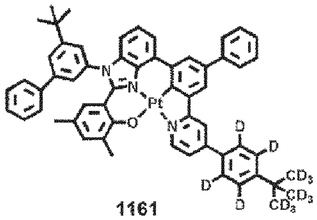
1161

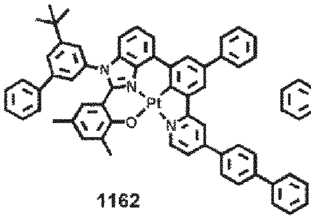
1162

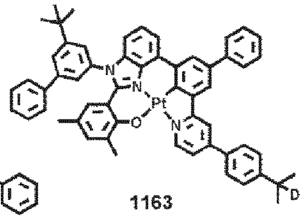
1163

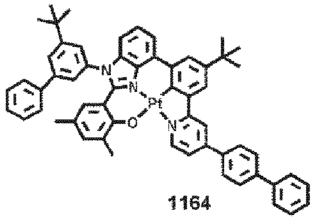
1164

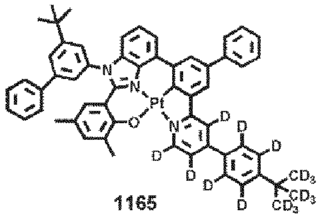
1165

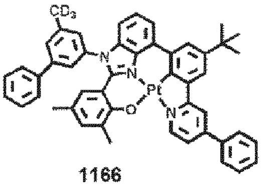
1166

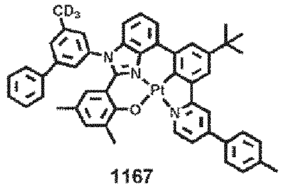
1167

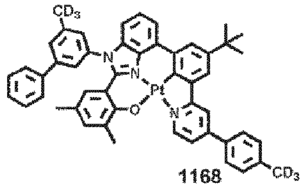
1168

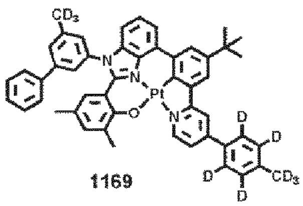
1169

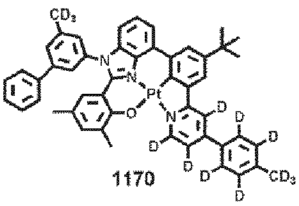
1170

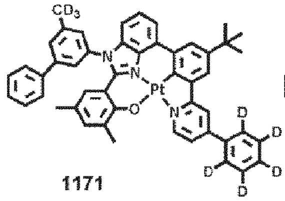
1171

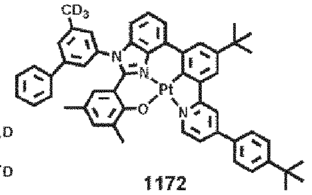
1172

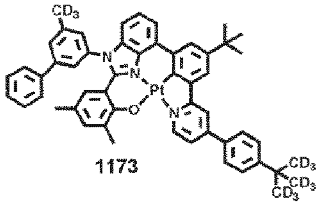
1173

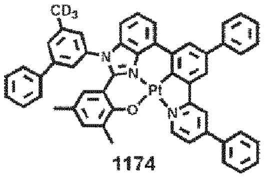
1174

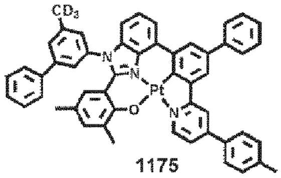
1175

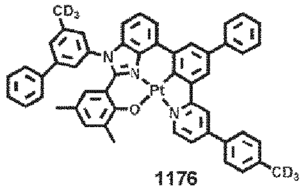
1176

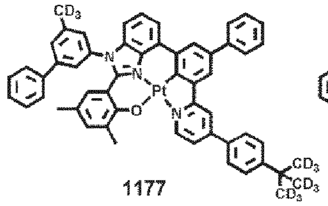
1177

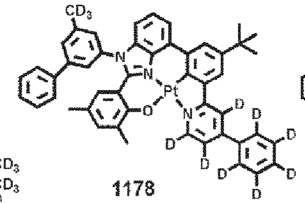
1178

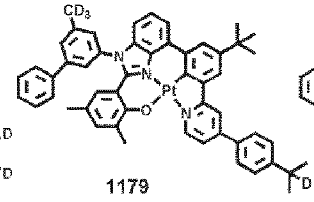
1179

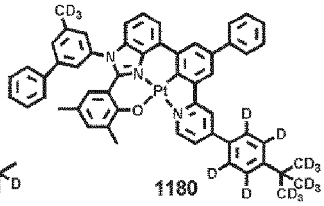
1180

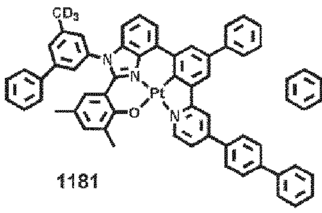
1181

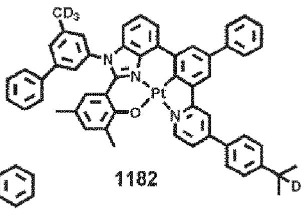
1182

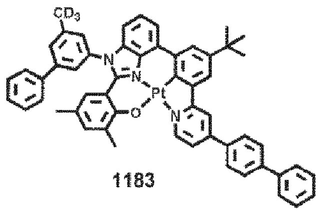
1183

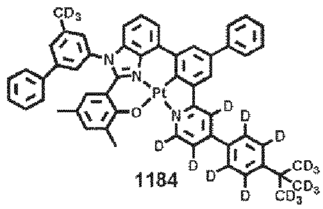
1184

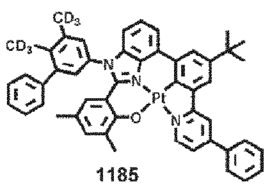
1185

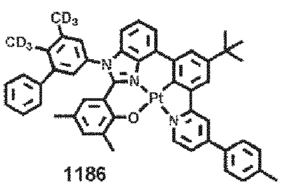
1186

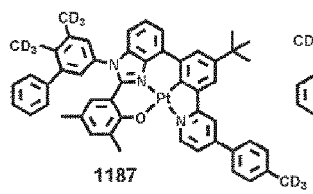
1187

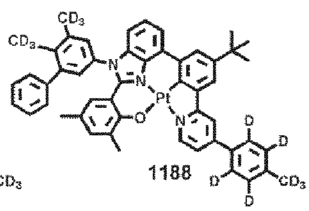
1188

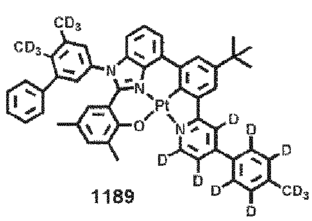
1189

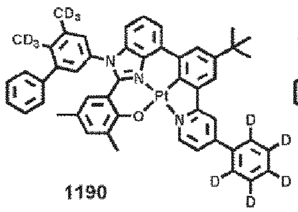
1190

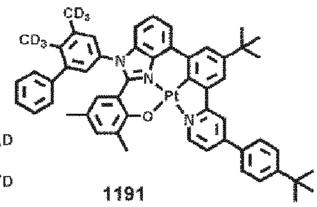
1191

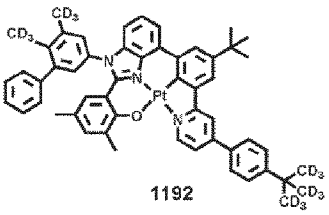
1192

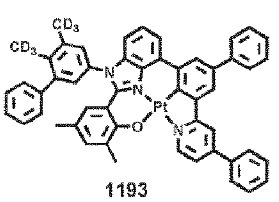
1193

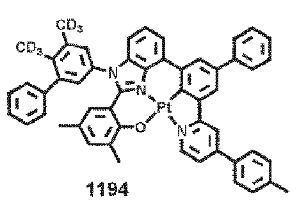
1194

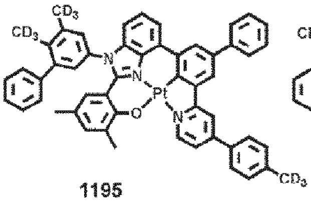
1195

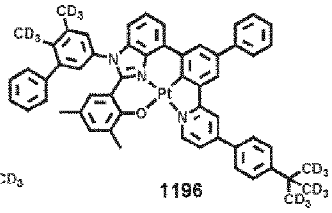
1196

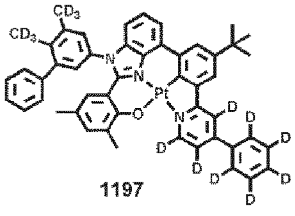
1197

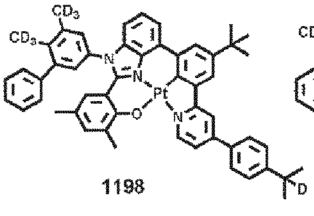
1198

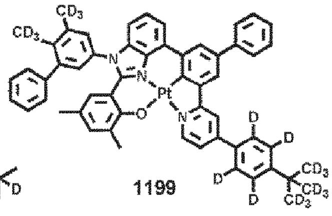
1199

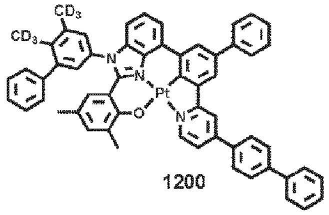
1200

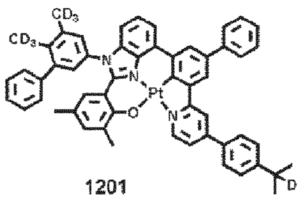
1201

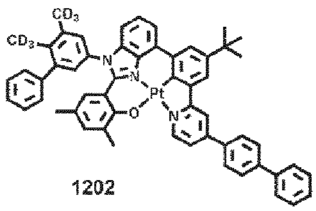
1202

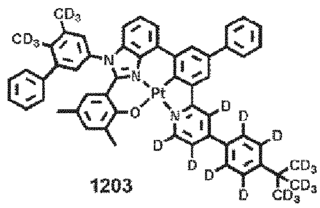
1203

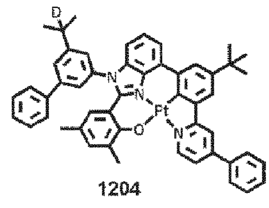
1204

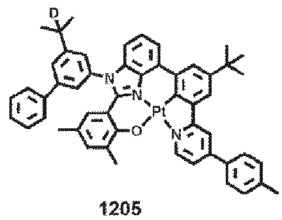
1205

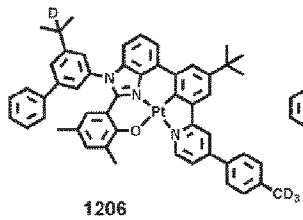
1206

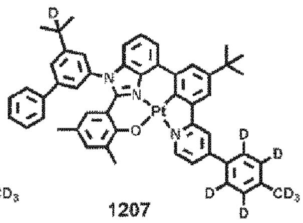
1207

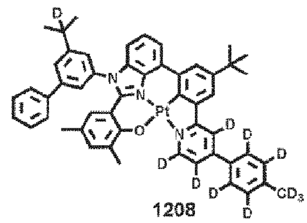
1208

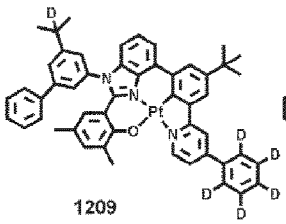
1209

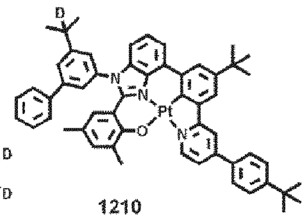
1210

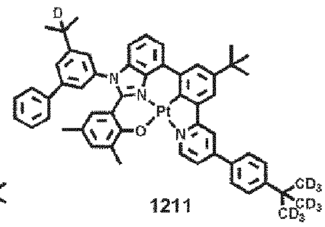
1211

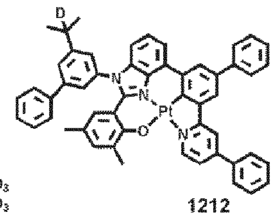
1212

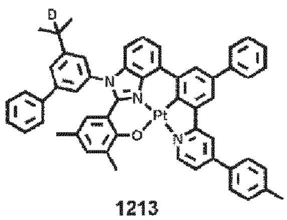
1213

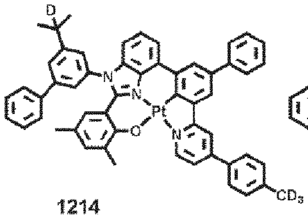
1214

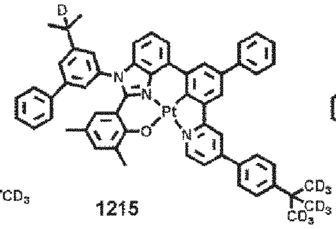
1215

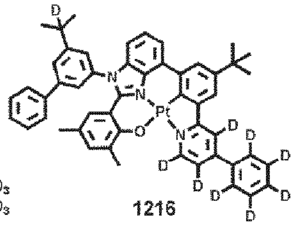
1216

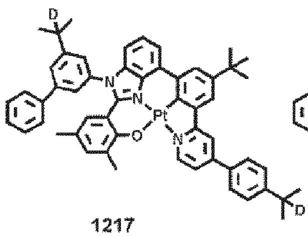
1217

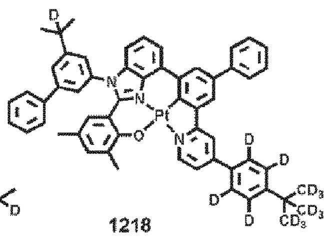
1218

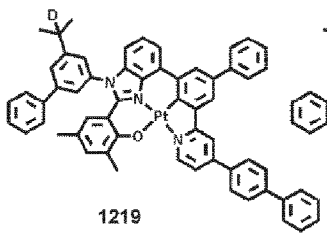
1219

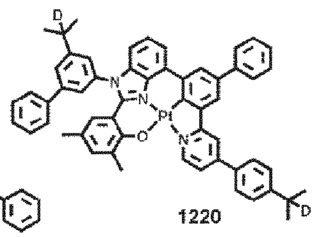
1220

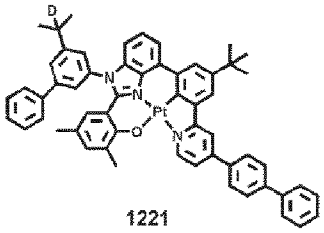
1221

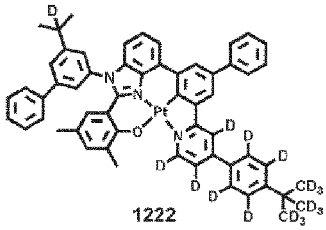
1222

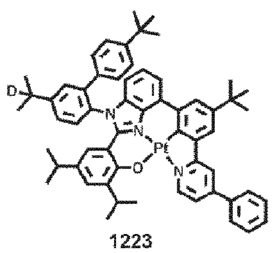
1223

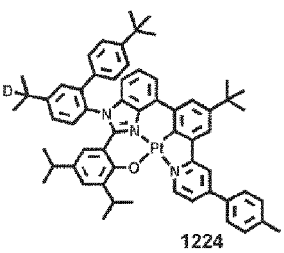
1224

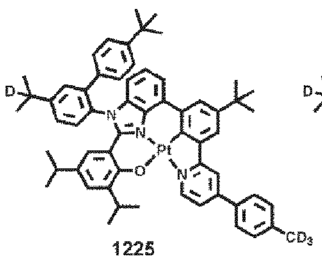

1225

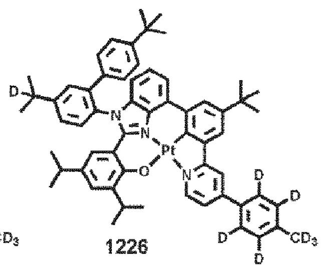

1226

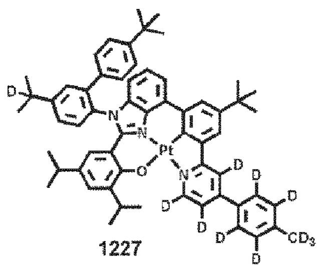

1227

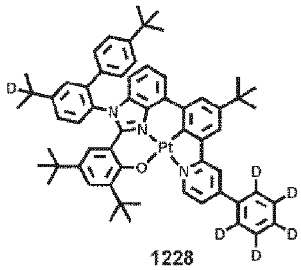

1228

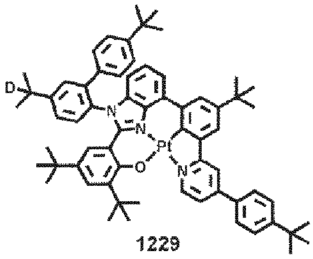

1229

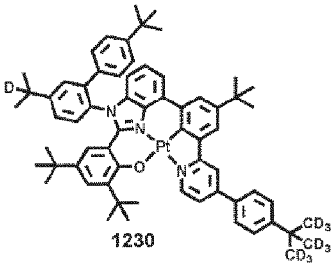

1230

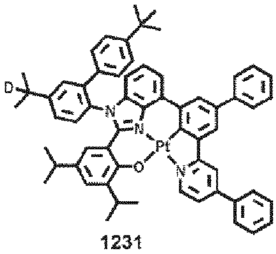

1231

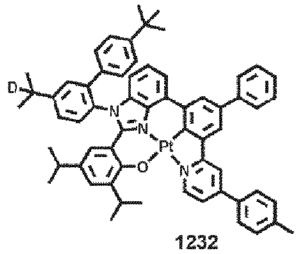

1232

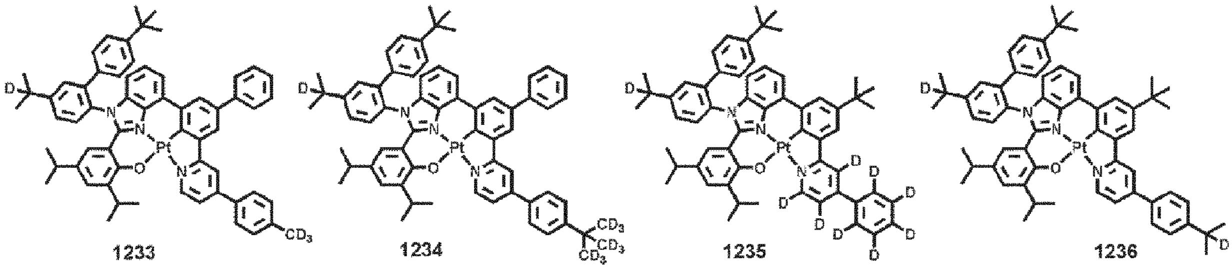

1233 1234 1235 1236

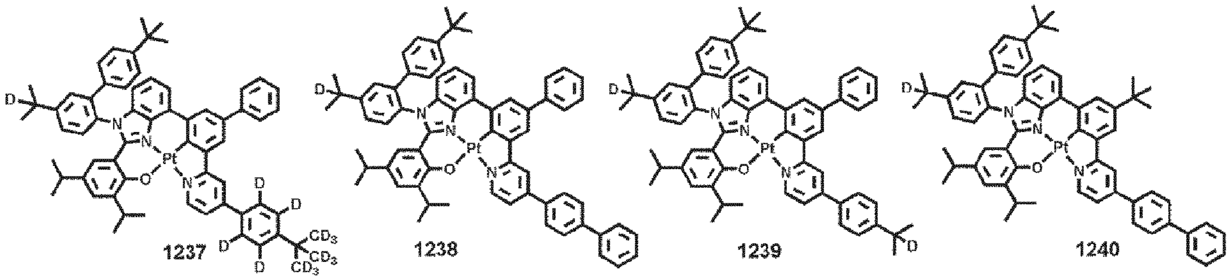

1237 1238 1239 1240

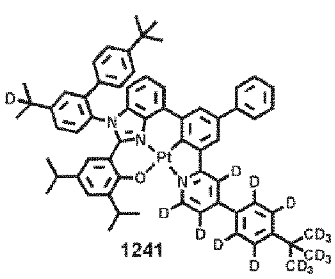

1241

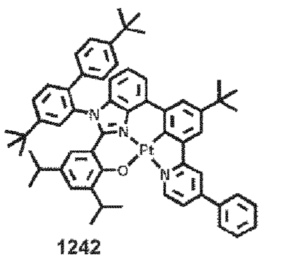

1242

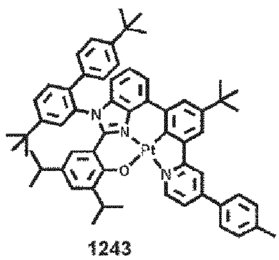

1243

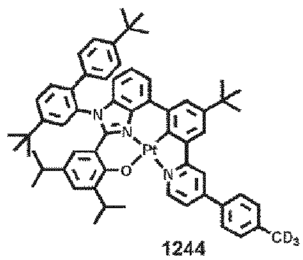

1244

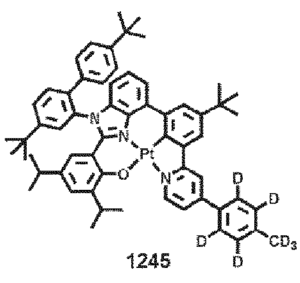

1245

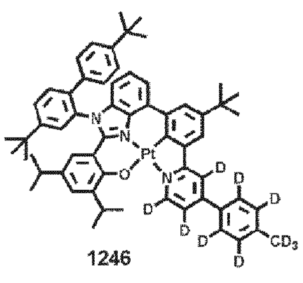

1246

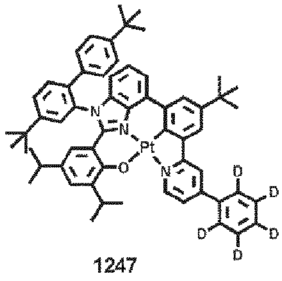

1247

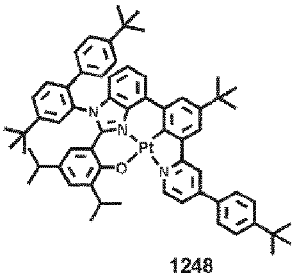

1248

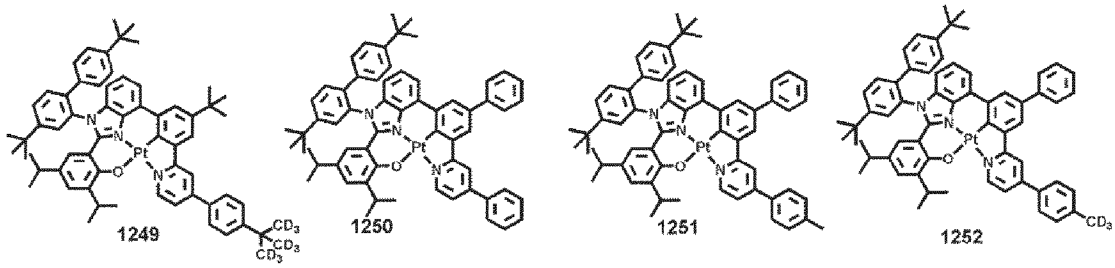

1249 1250 1251 1252

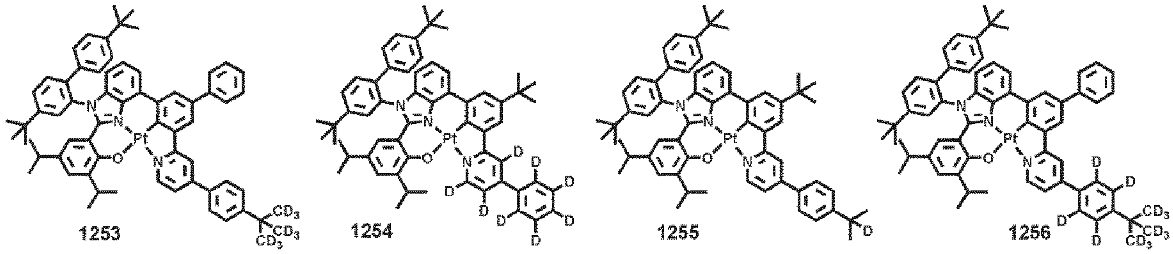

1253 1254 1255 1256

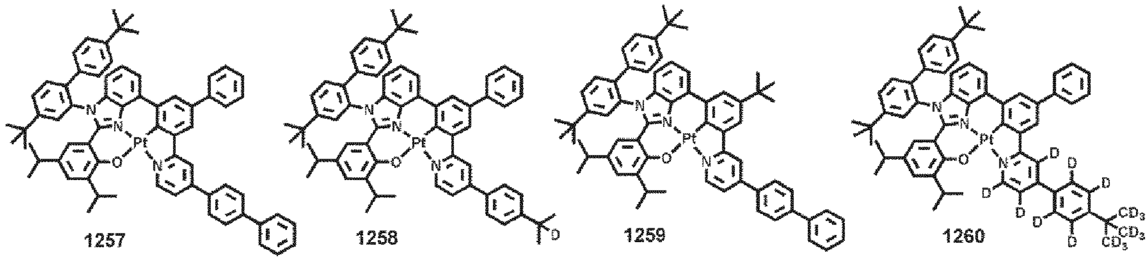

1257 1258 1259 1260

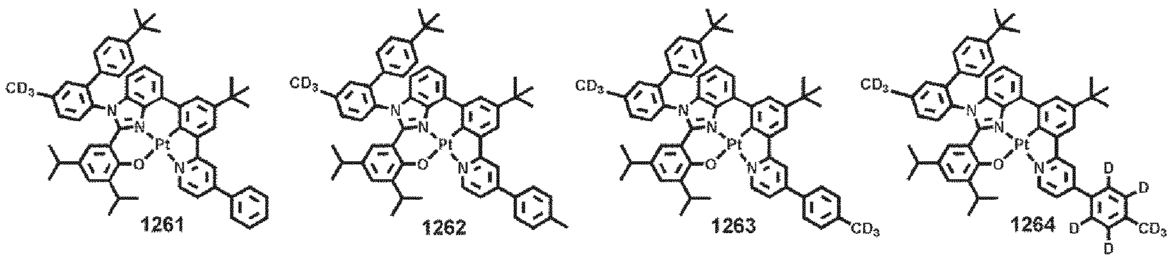

1261 1262 1263 1264

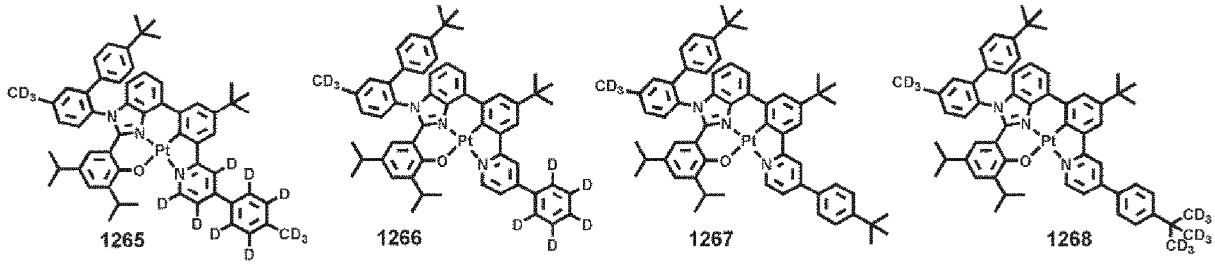

1265 1266 1267 1268

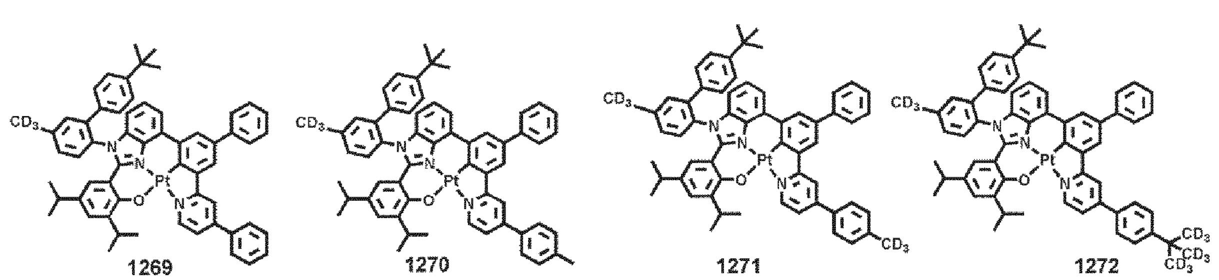

1269 1270 1271 1272

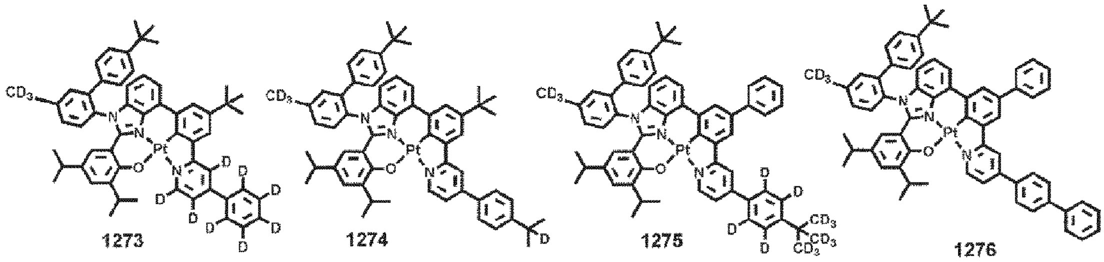

1273 1274 1275 1276

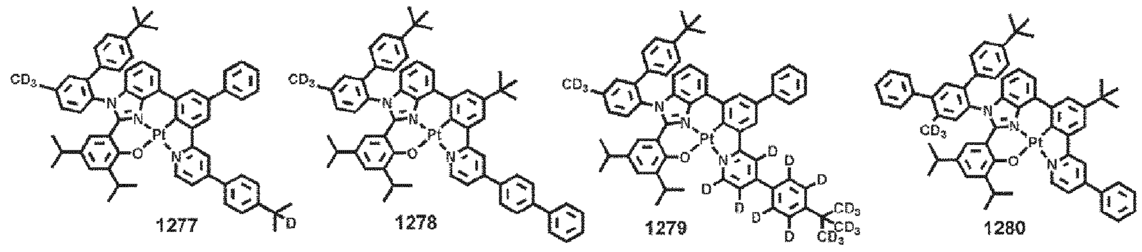

1277 1278 1279 1280

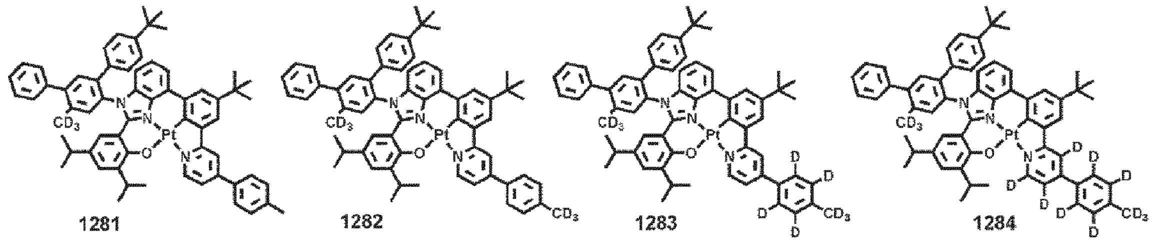

1281 1282 1283 1284

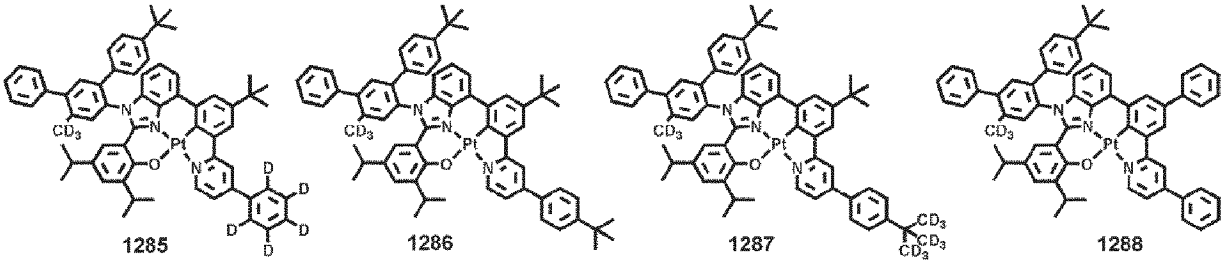

1285 1286 1287 1288

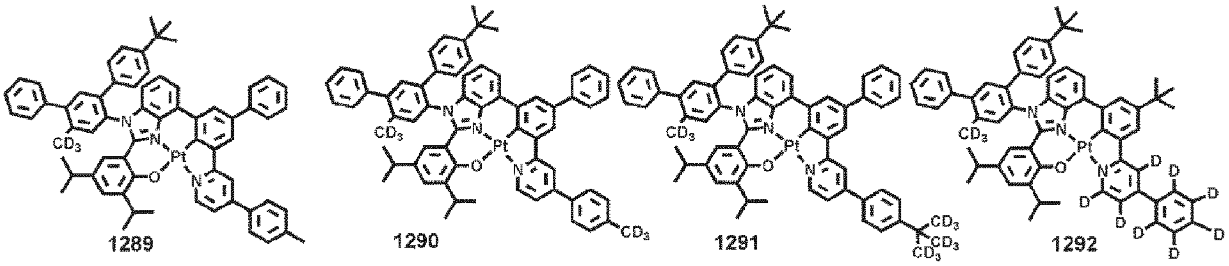

1289 1290 1291 1292

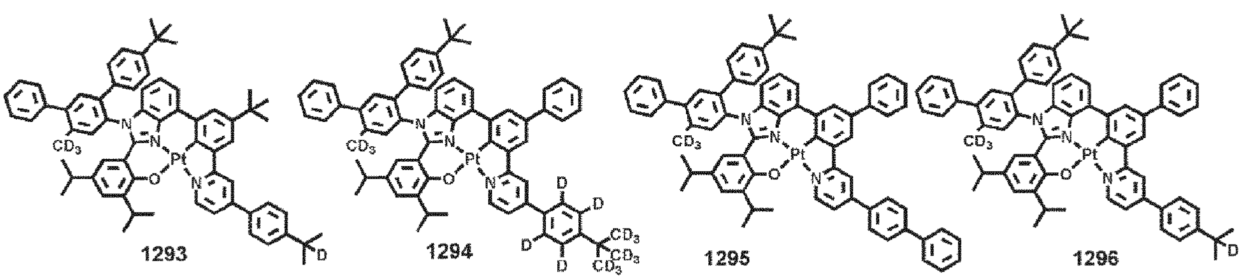

1293 1294 1295 1296

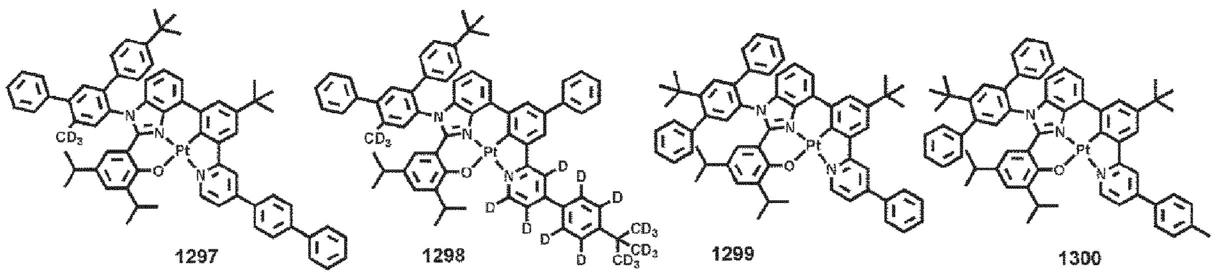

1297 1298 1299 1300

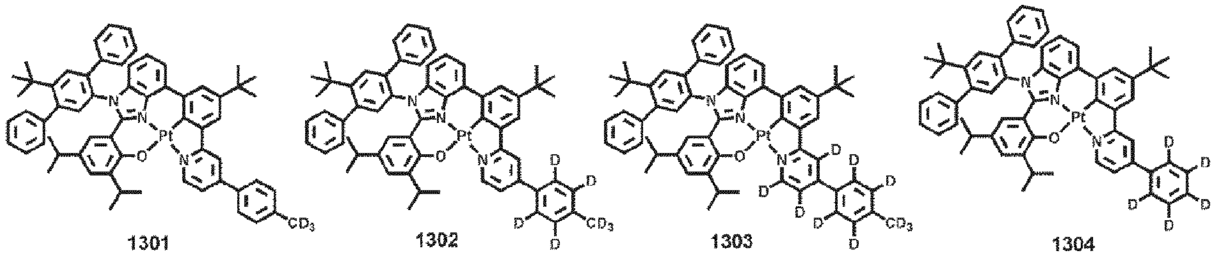

1301 1302 1303 1304

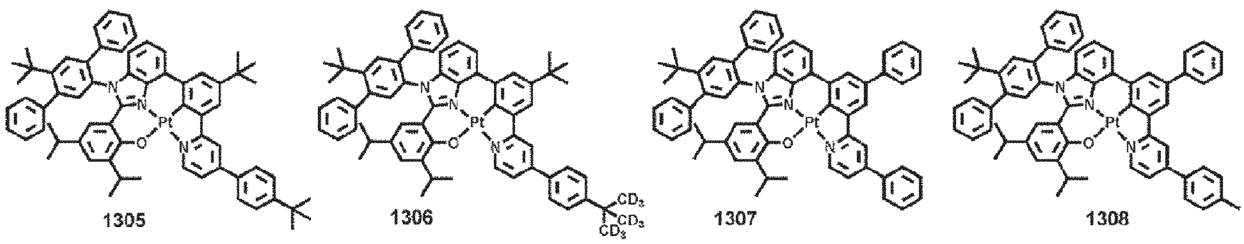

1305 1306 1307 1308

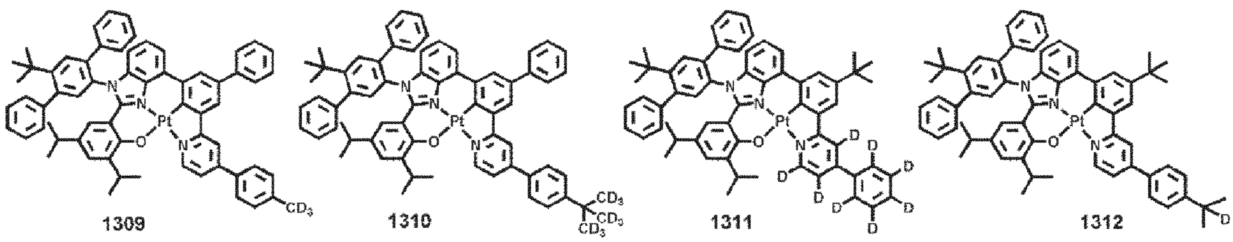

1309 1310 1311 1312

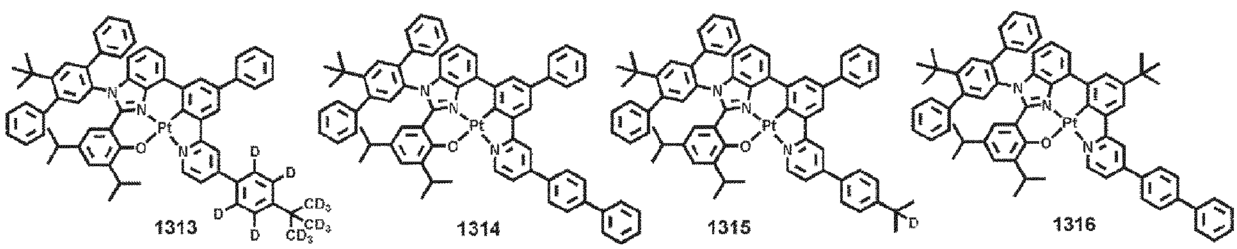

1313 1314 1315 1316

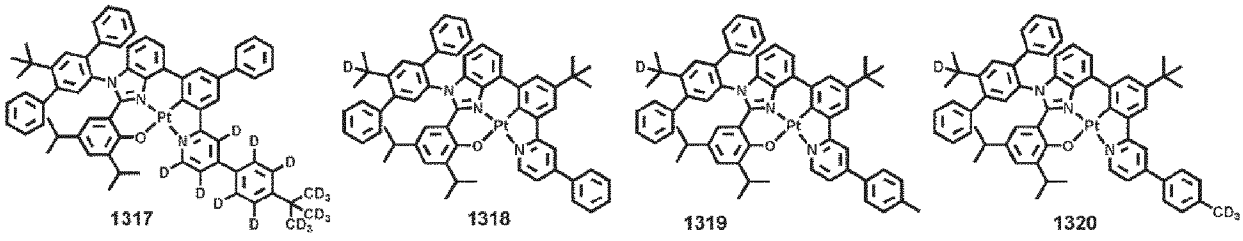

1317 1318 1319 1320

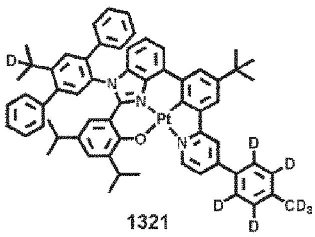
1321

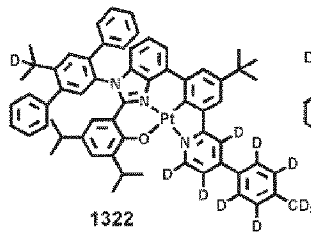
1322

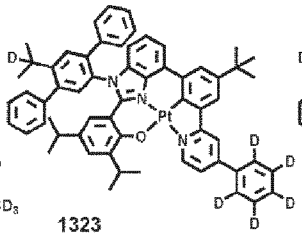
1323

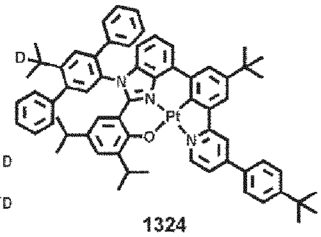
1324

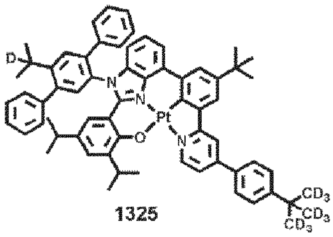
1325

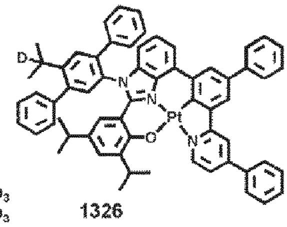
1326

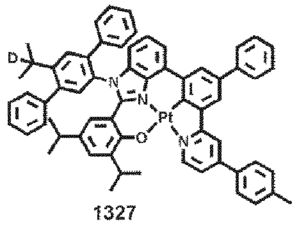
1327

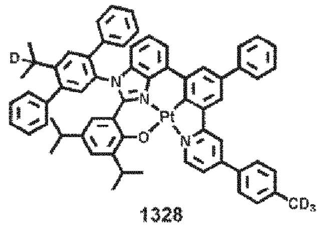
1328

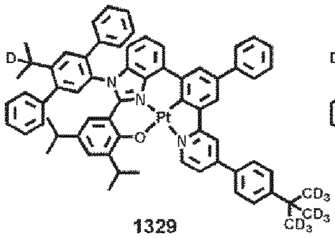
1329

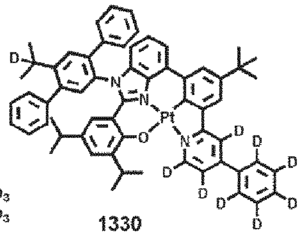
1330

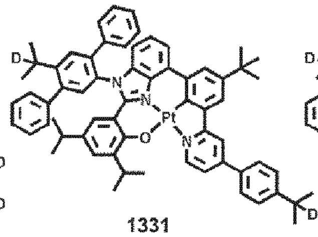
1331

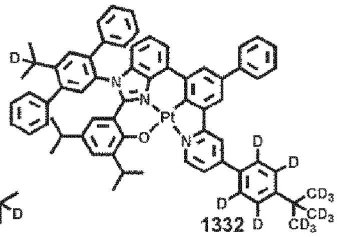
1332

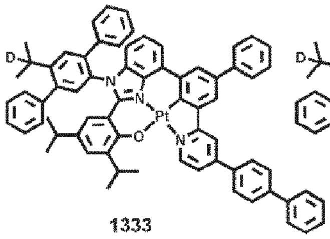
1333

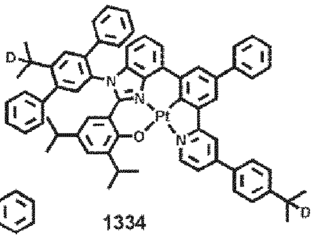
1334

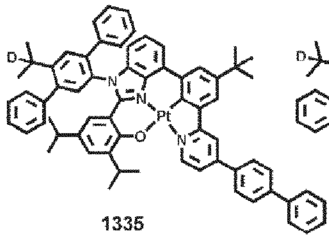
1335

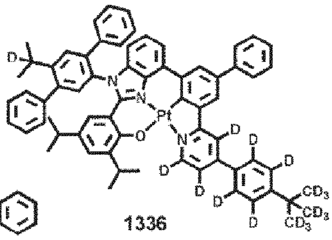
1336

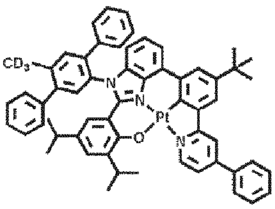
1337

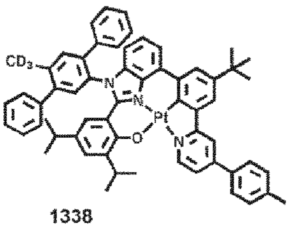
1338

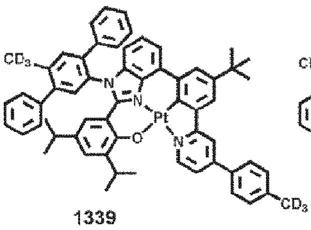
1339

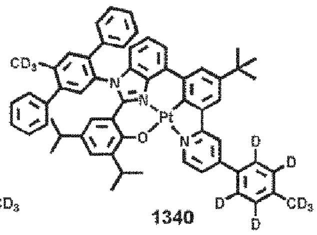
1340

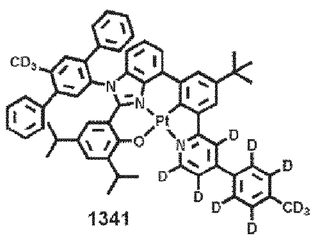
1341

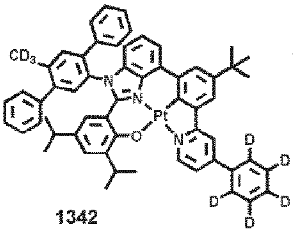
1342

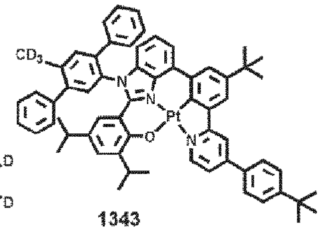
1343

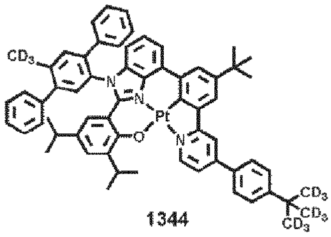
1344

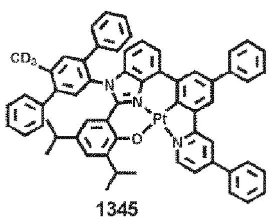
1345
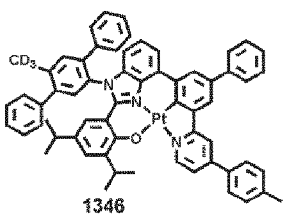
1346
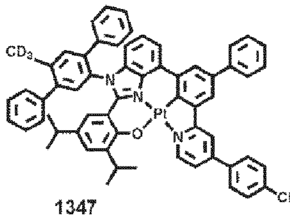
1347
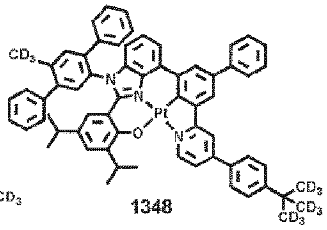
1348
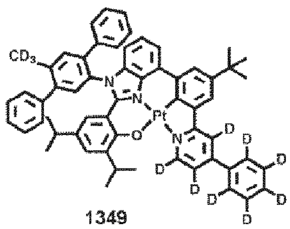
1349
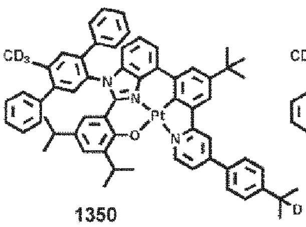
1350
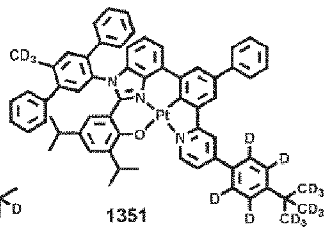
1351
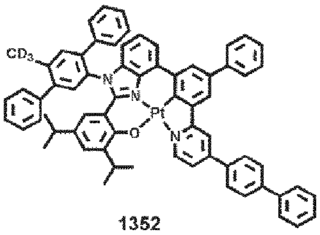
1352
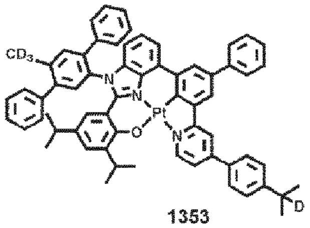
1353
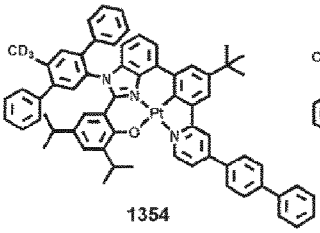
1354
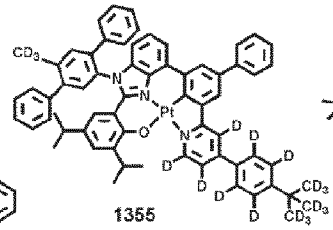
1355
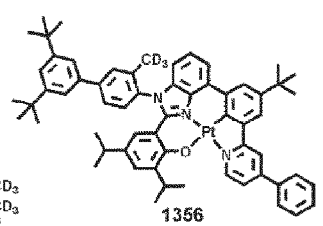
1356
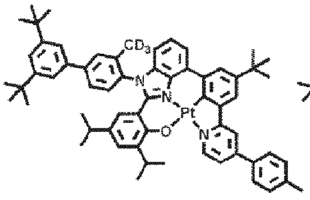
1357
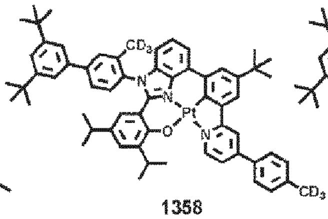
1358
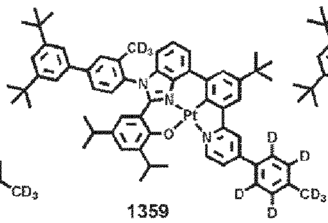
1359
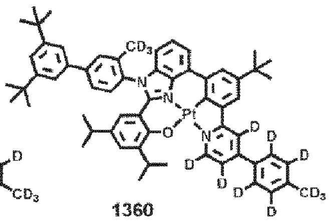
1360
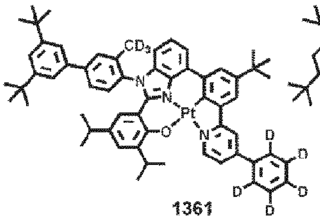
1361
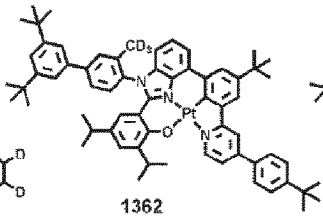
1362
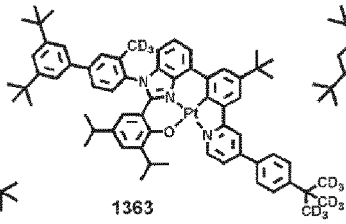
1363
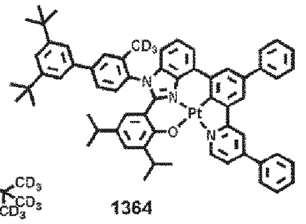
1364
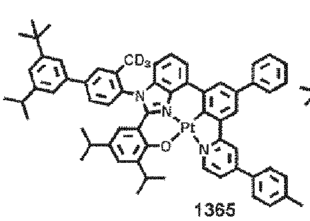
1365
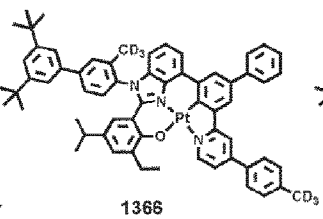
1366
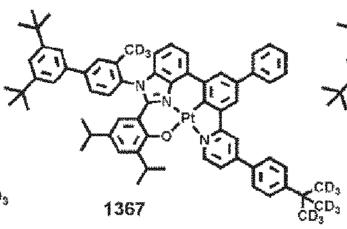
1367
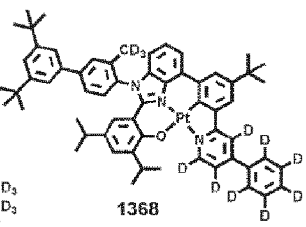
1368

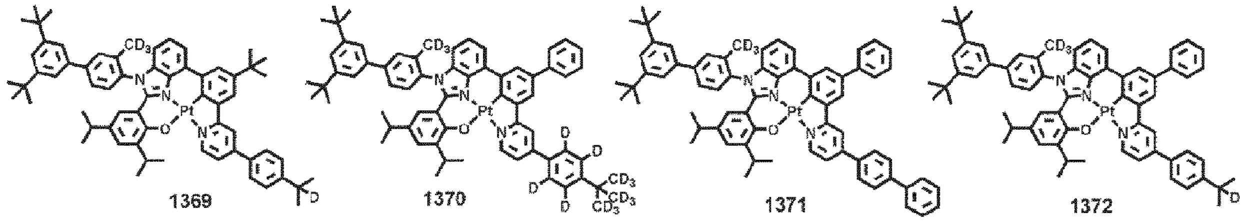

1369 1370 1371 1372

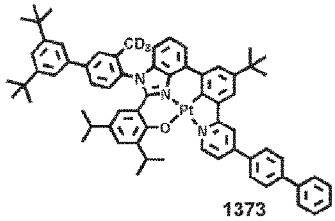

1373

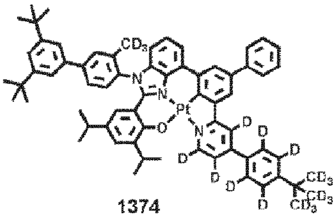

1374

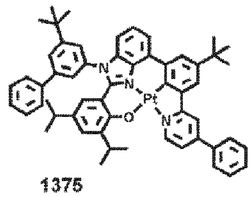

1375

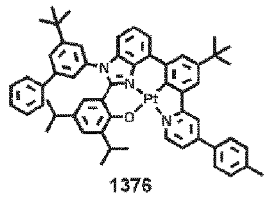

1376

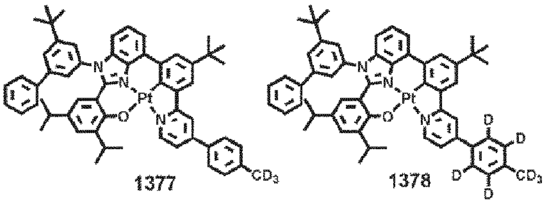

1377 1378

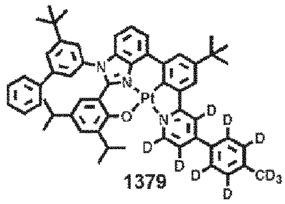

1379

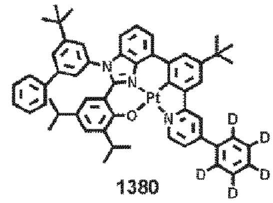

1380

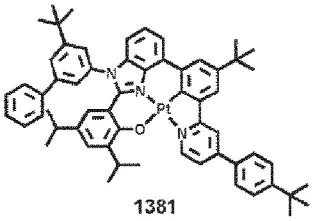

1381

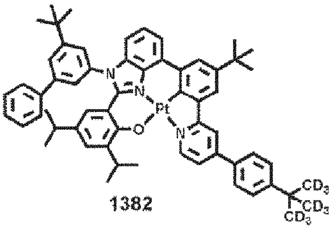

1382

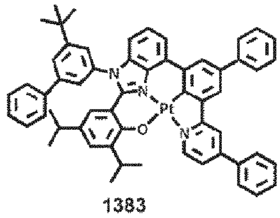

1383

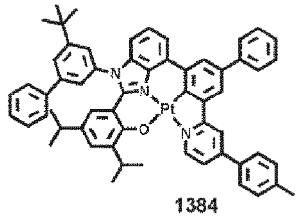

1384

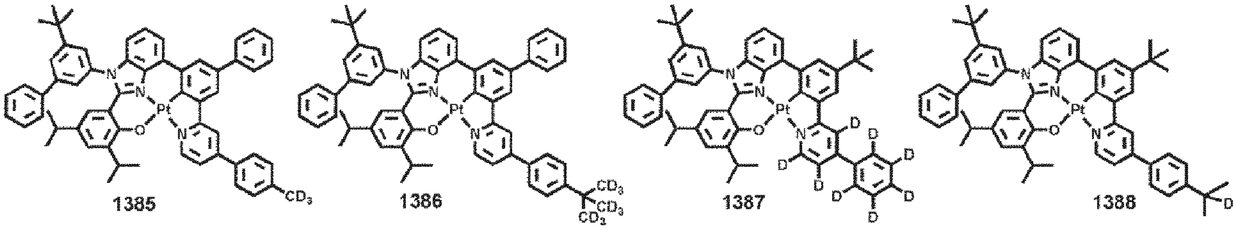

1385 1386 1387 1388

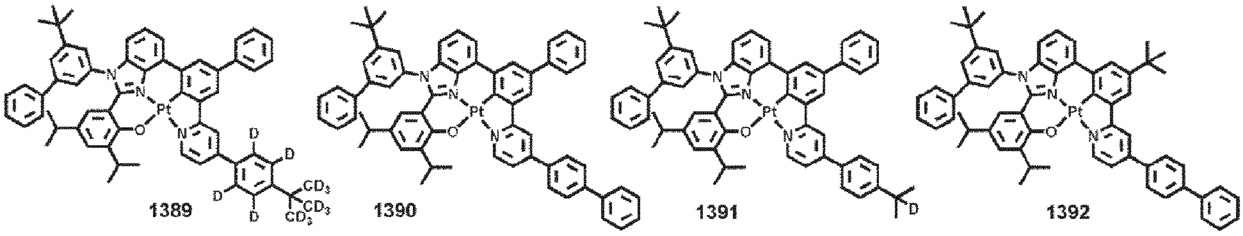

1389 1390 1391 1392

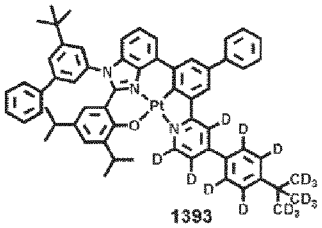
1393

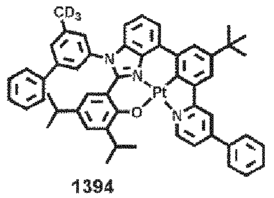
1394

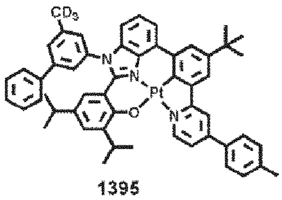
1395

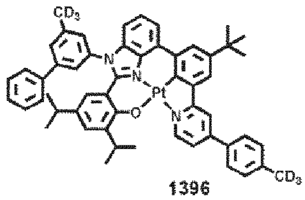
1396

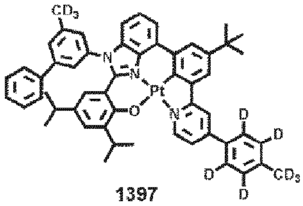
1397

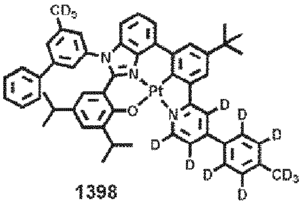
1398

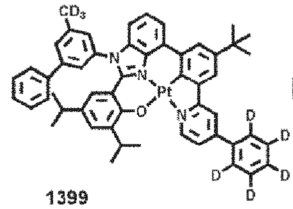
1399

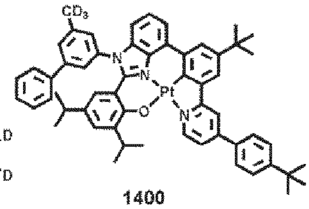
1400

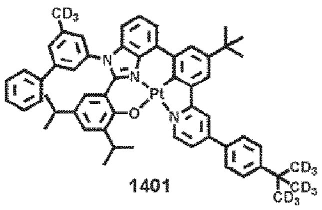
1401

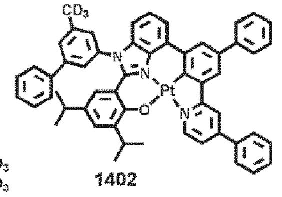
1402

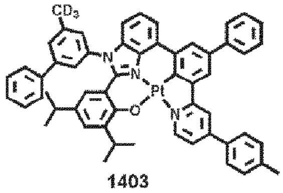
1403

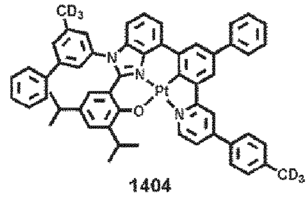
1404

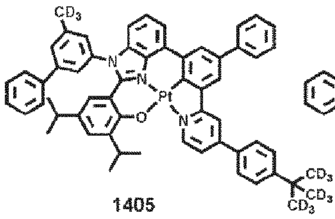
1405

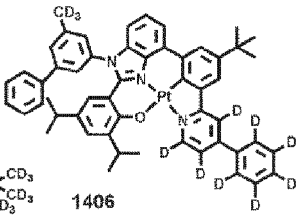
1406

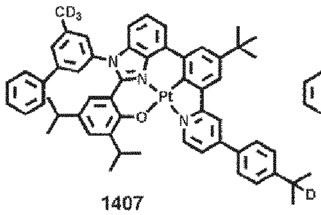
1407

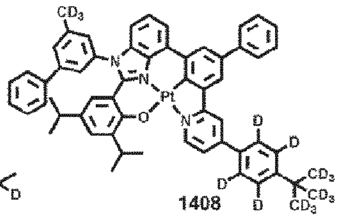
1408

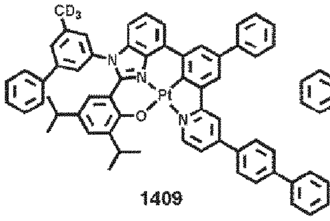
1409

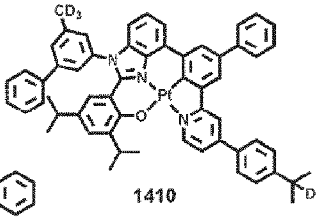
1410

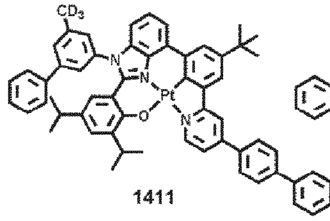
1411

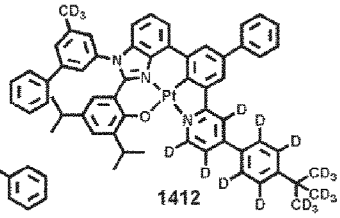
1412

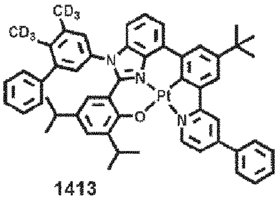
1413

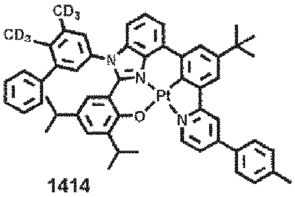
1414

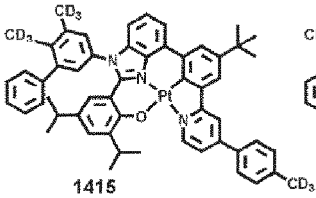
1415

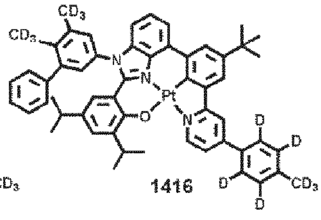
1416

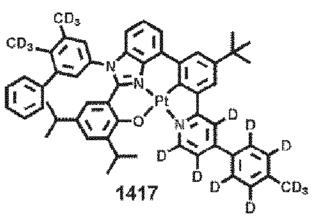
1417

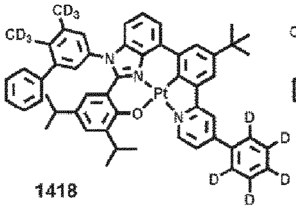
1418

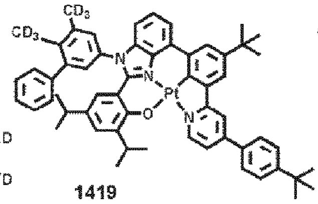
1419

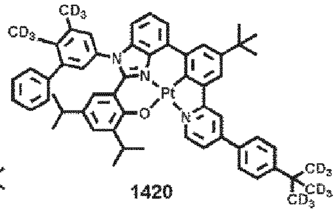
1420

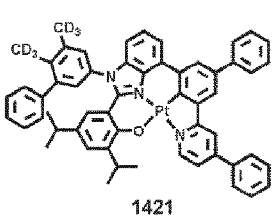
1421

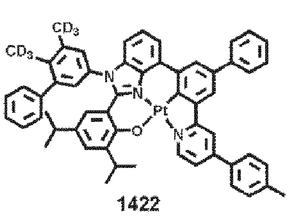
1422

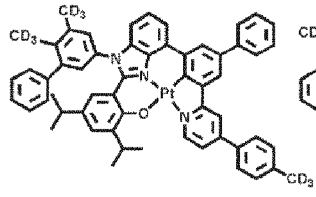
1423

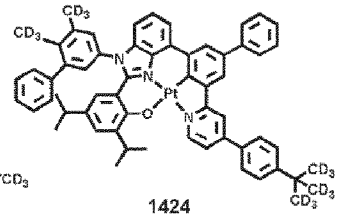
1424

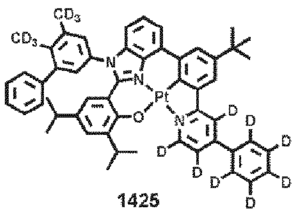
1425

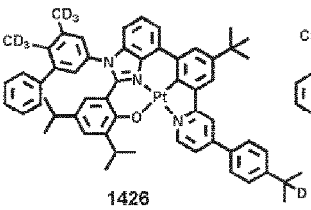
1426

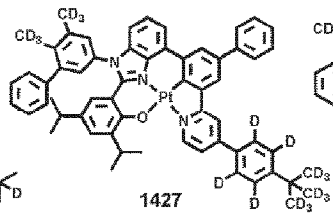
1427

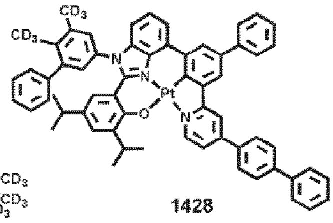
1428

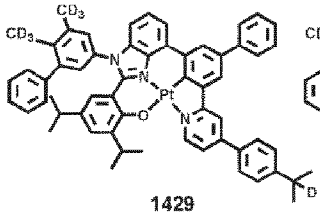
1429

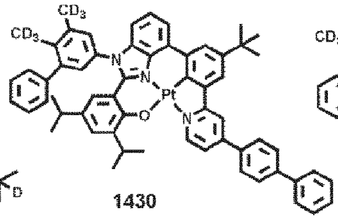
1430

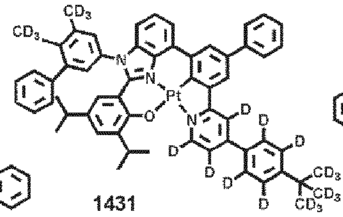
1431

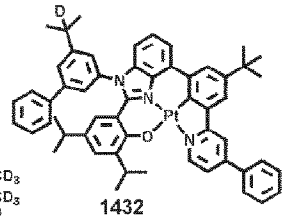
1432

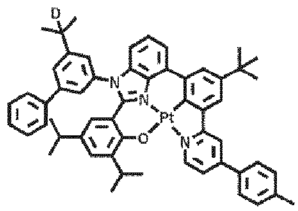
1433

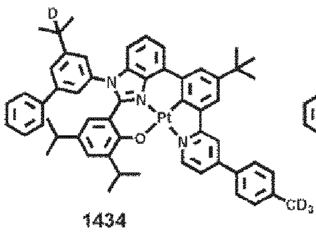
1434

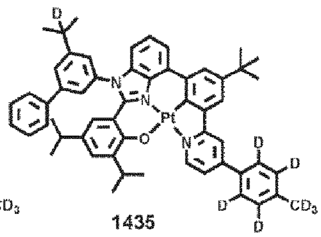
1435

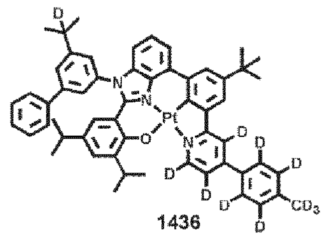
1436

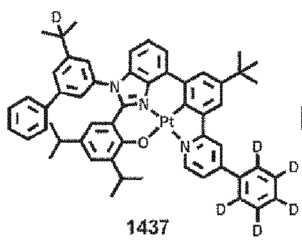
1437

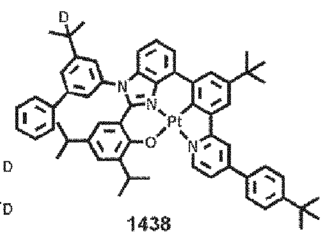
1438

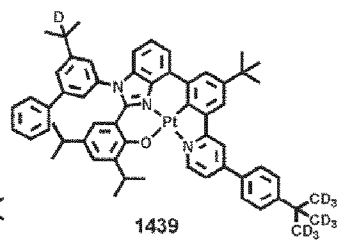
1439

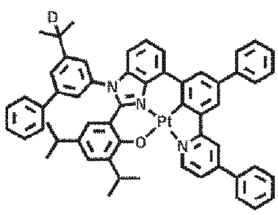
1440

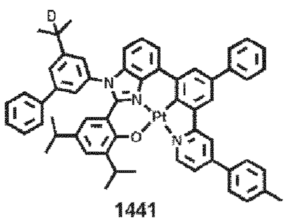
1441

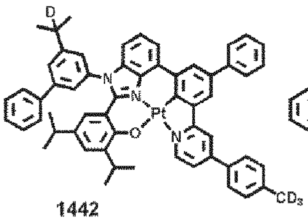
1442

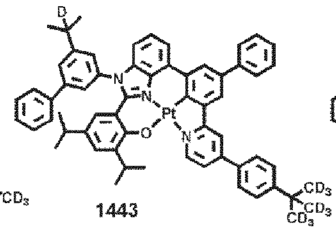
1443

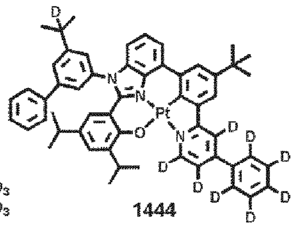
1444

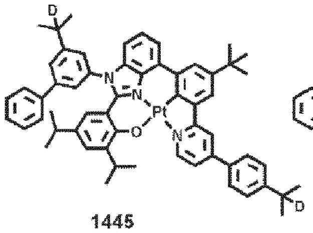
1445

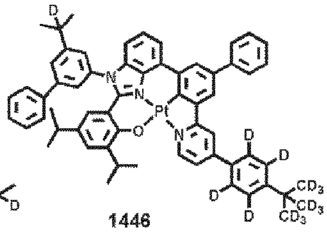
1446

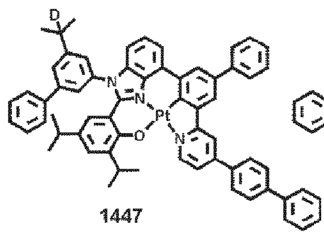
1447

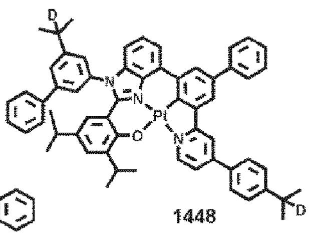
1448

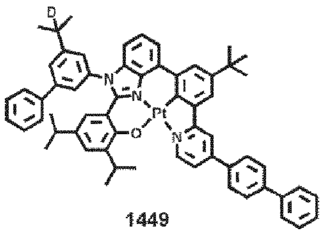
1449

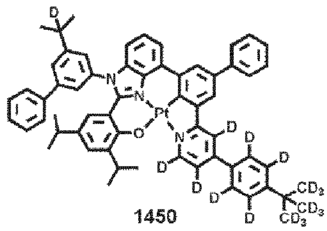
1450

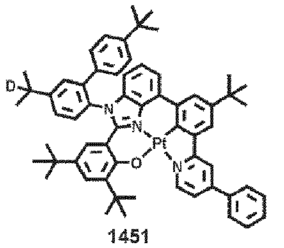
1451

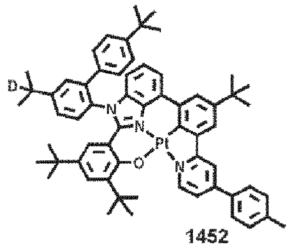
1452

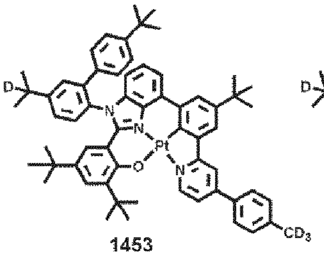
1453

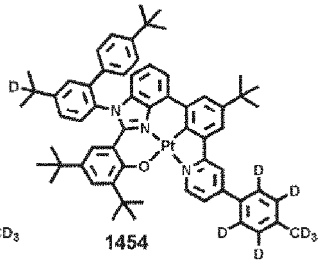
1454

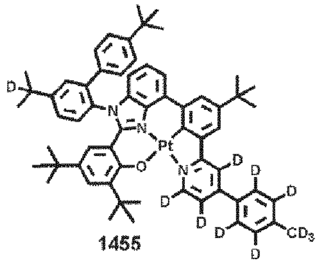
1455

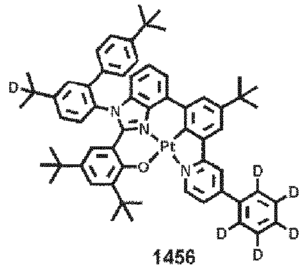
1456

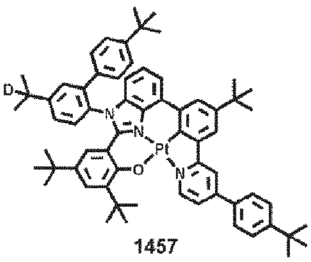
1457

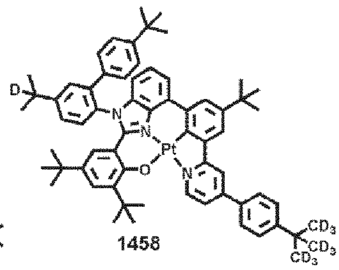
1458

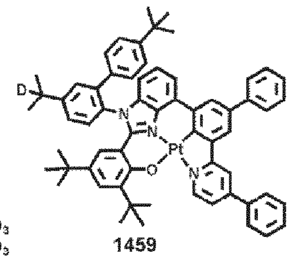
1459

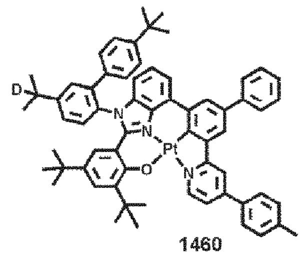
1460

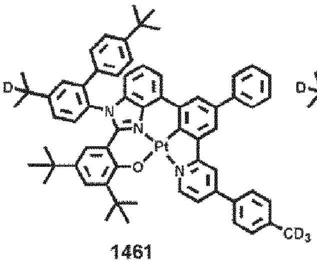
1461

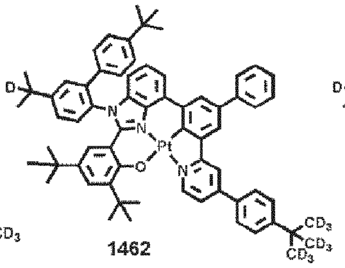
1462

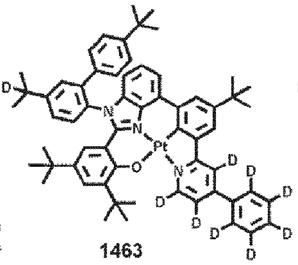
1463

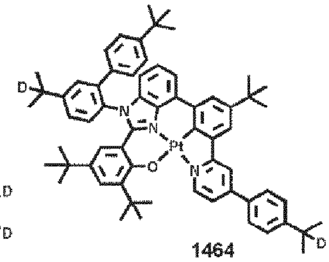
1464

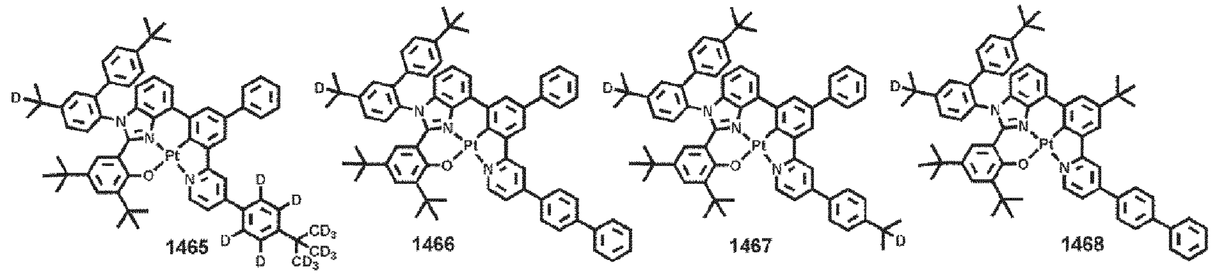

1465 1466 1467 1468

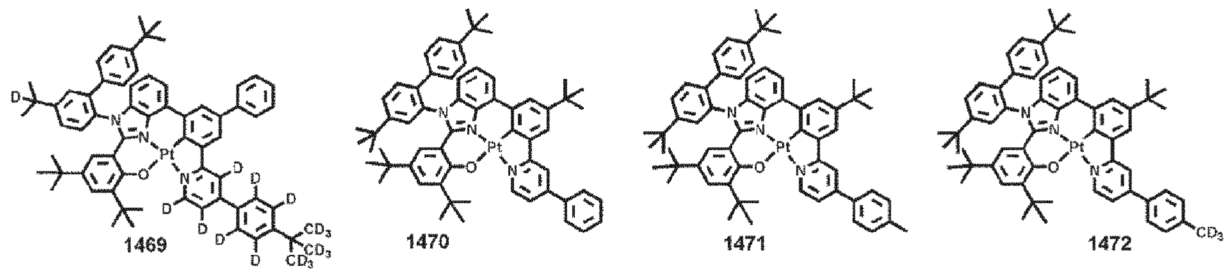

1469 1470 1471 1472

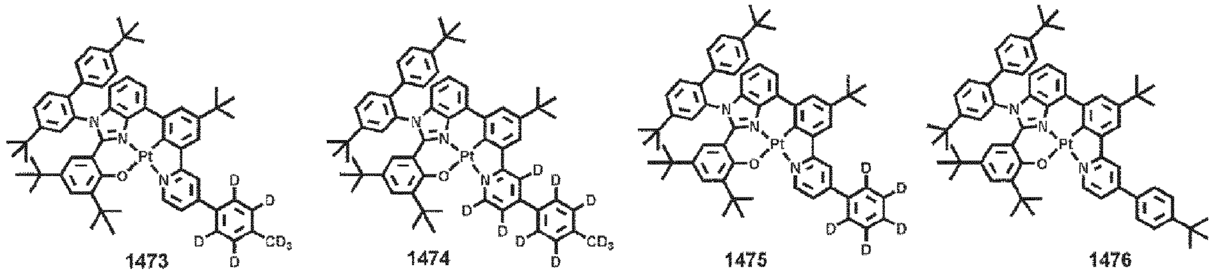

1473 1474 1475 1476

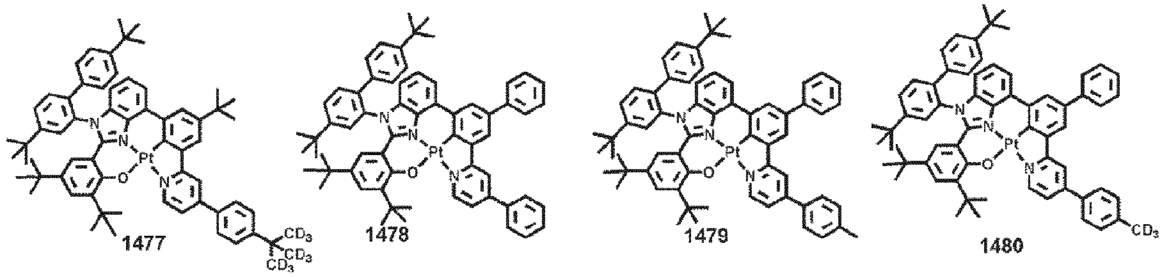

1477 1478 1479 1480

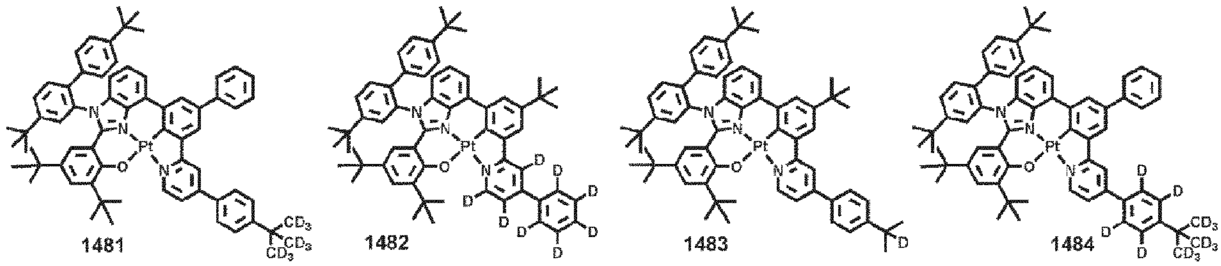

1481 1482 1483 1484

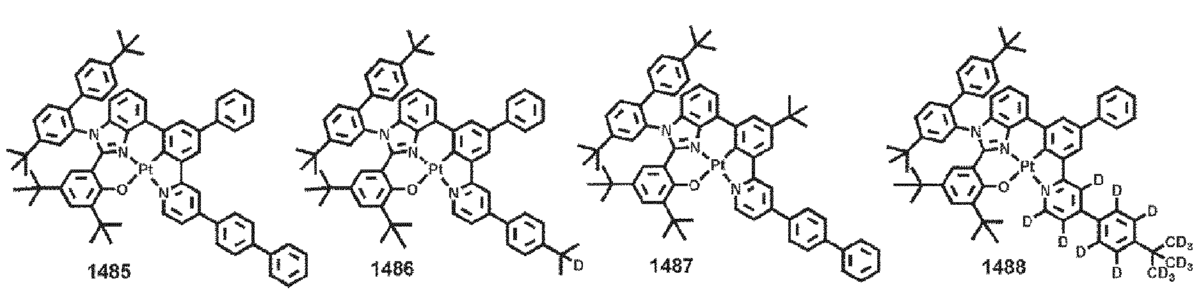

1485 1486 1487 1488

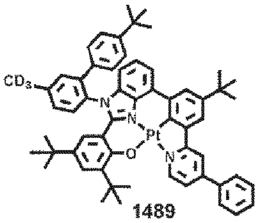
1489

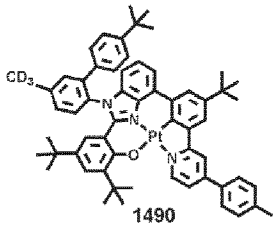
1490

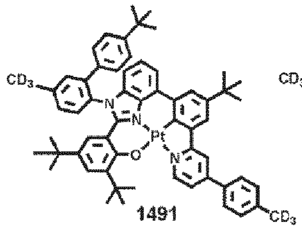
1491

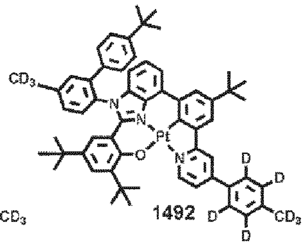
1492

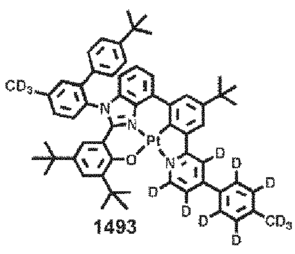
1493

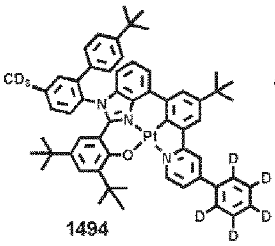
1494

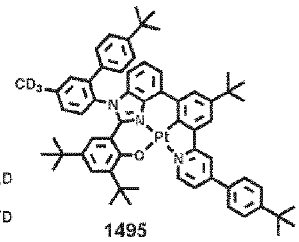
1495

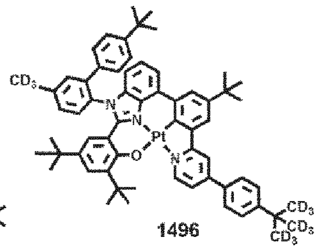
1496

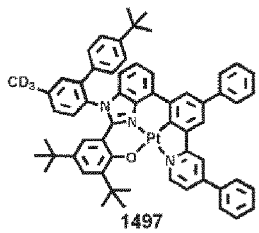
1497

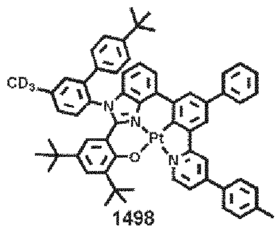
1498

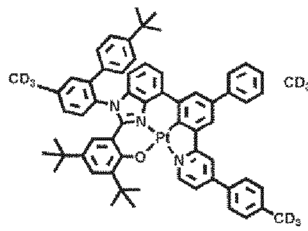
1499

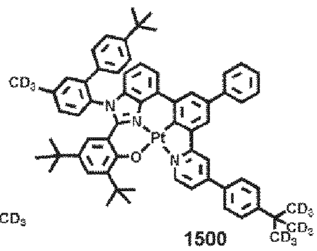
1500

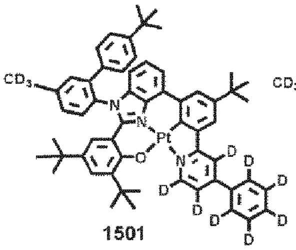
1501

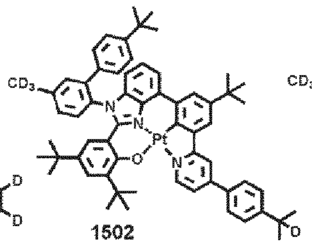
1502

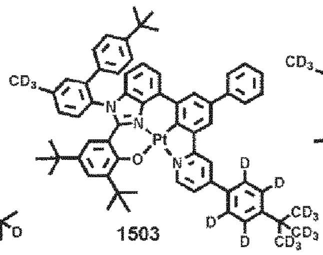
1503

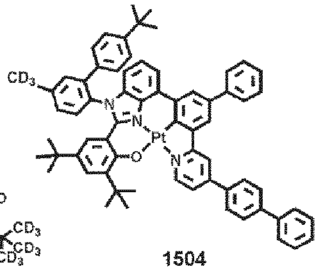
1504

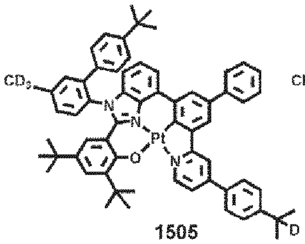
1505

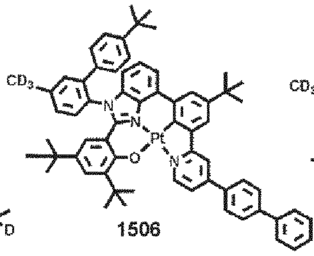
1506

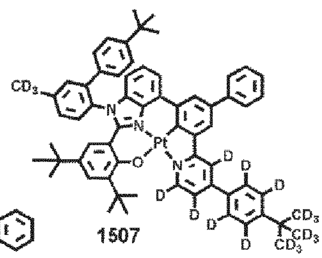
1507

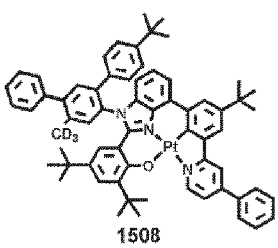
1508

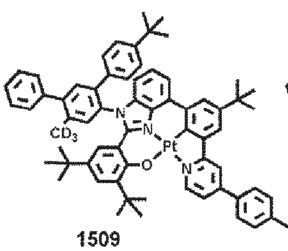
1509

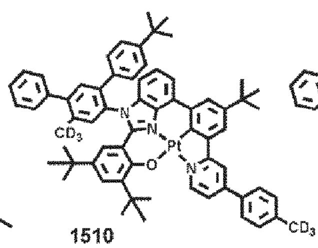
1510

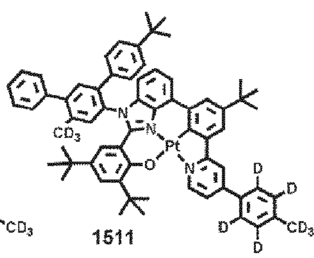
1511

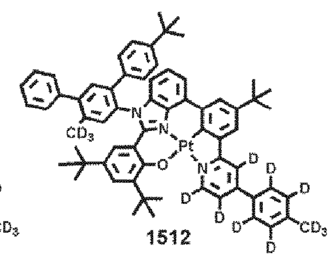
1512

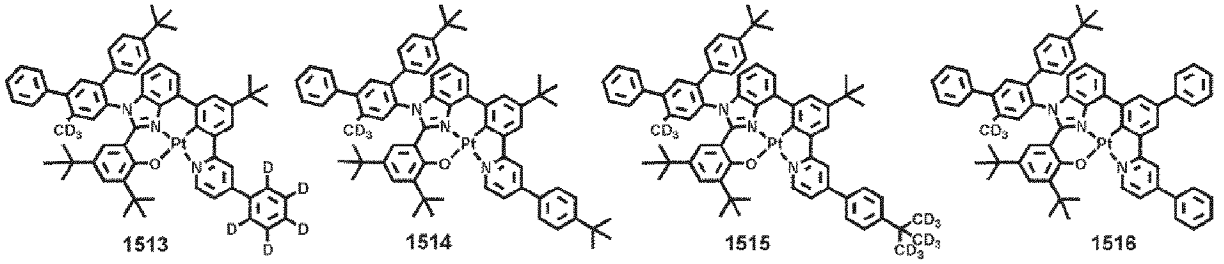

1513 1514 1515 1516

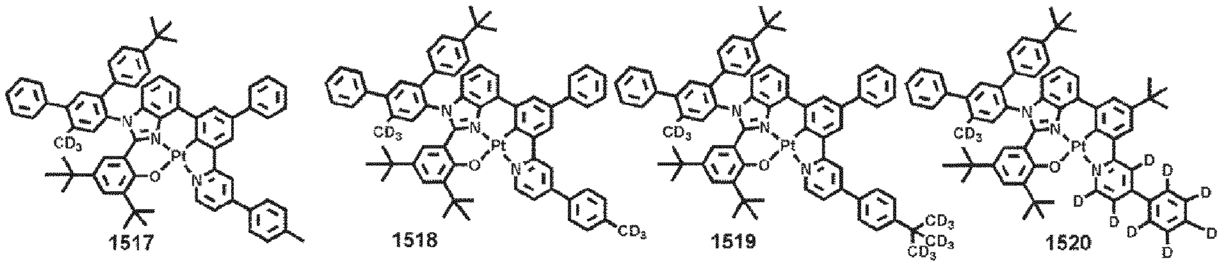

1517 1518 1519 1520

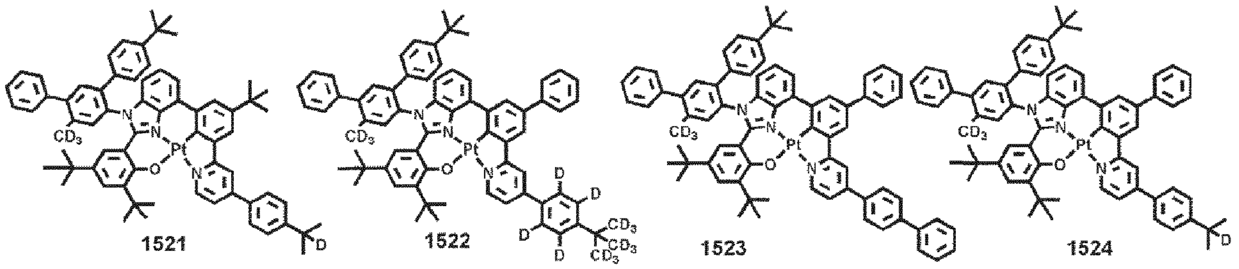

1521 1522 1523 1524

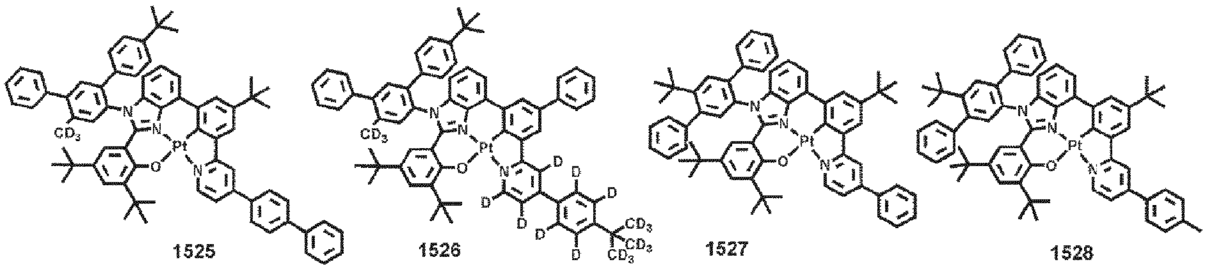

1525 1526 1527 1528

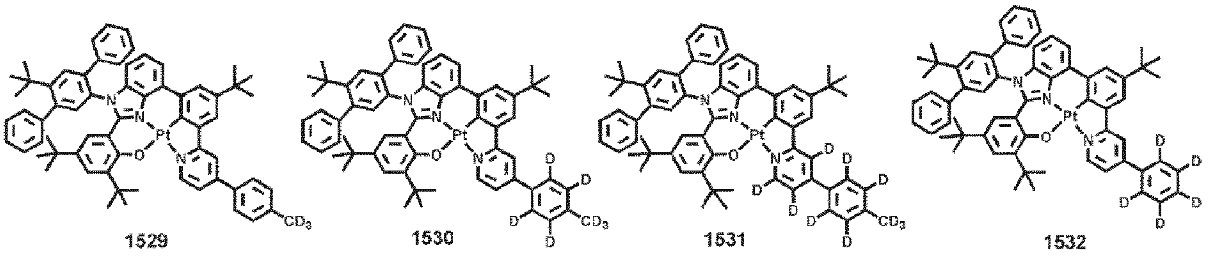

1529 1530 1531 1532

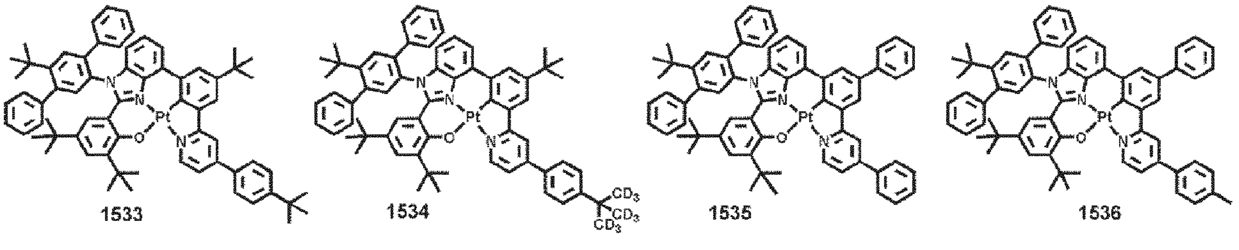

1533 1534 1535 1536

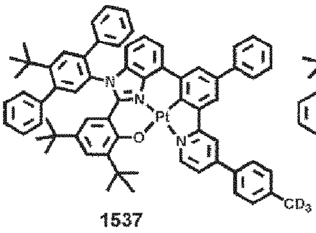 1537 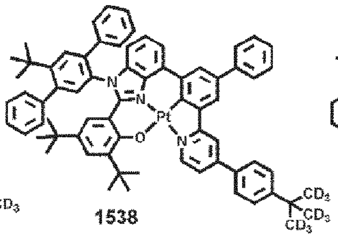 1538 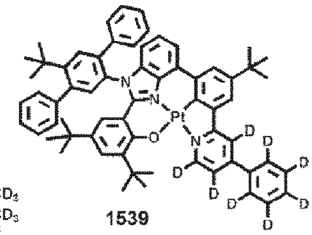 1539 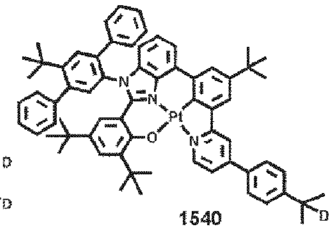 1540

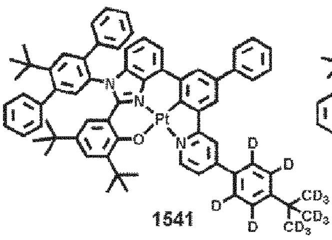 1541 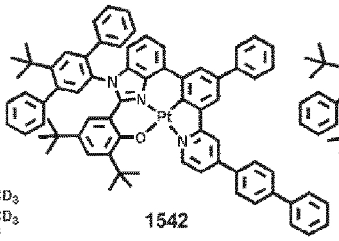 1542 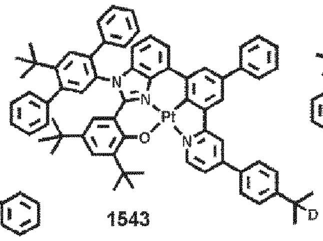 1543 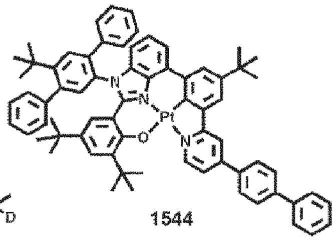 1544

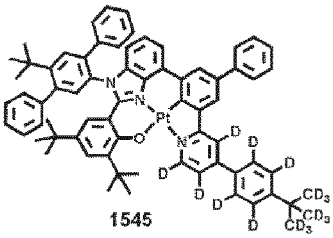 1545 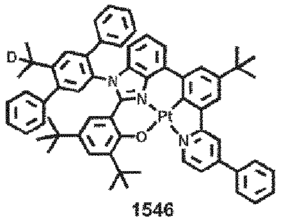 1546 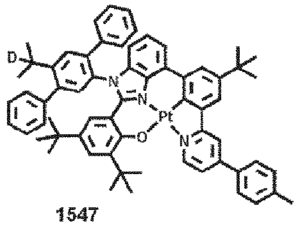 1547 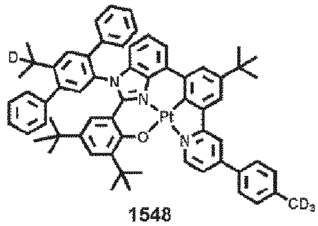 1548

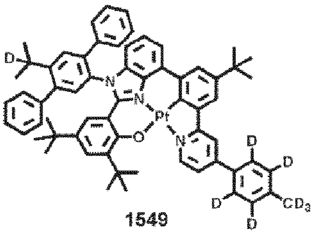 1549 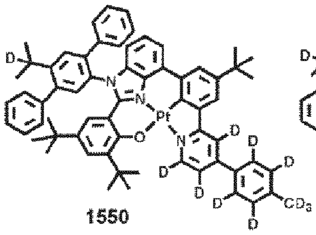 1550 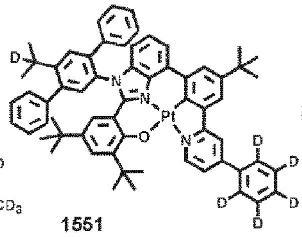 1551 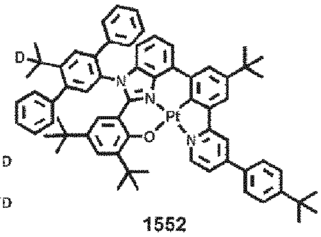 1552

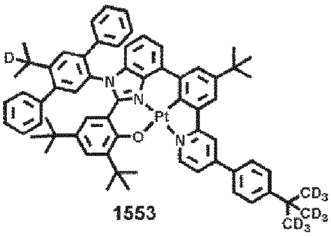 1553 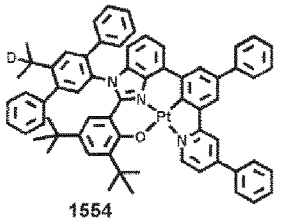 1554 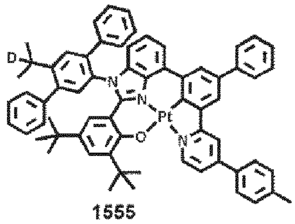 1555 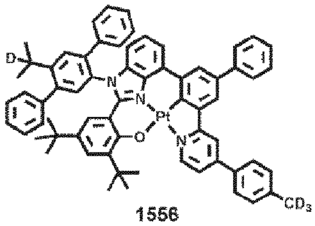 1556

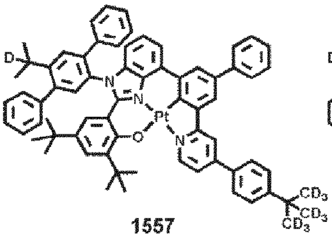 1557 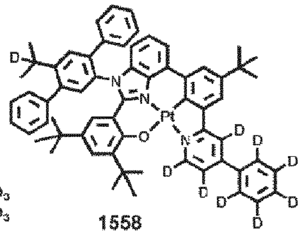 1558 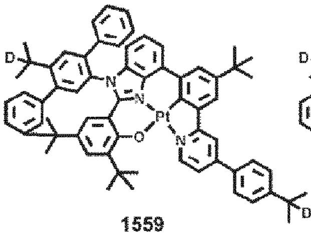 1559 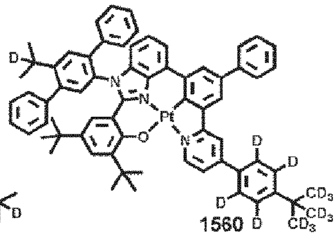 1560

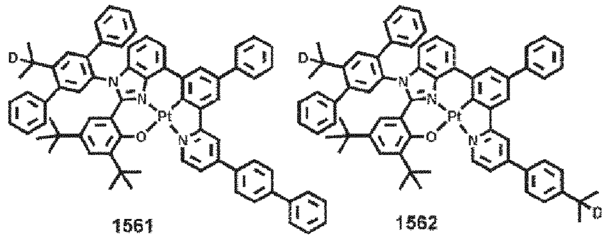

1561 1562

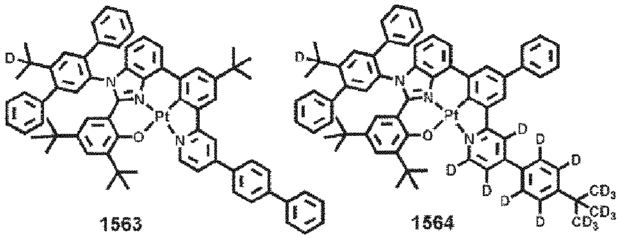

1563 1564

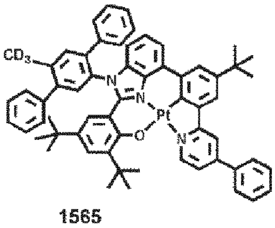

1565

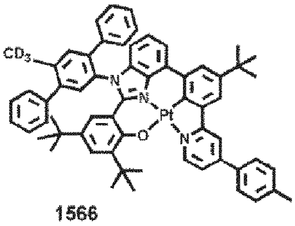

1566

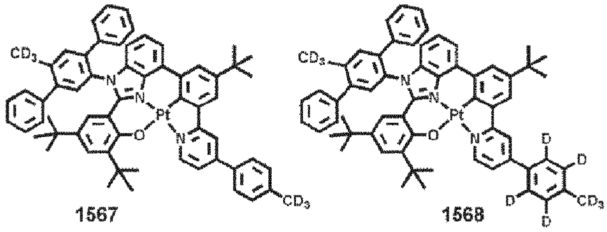

1567 1568

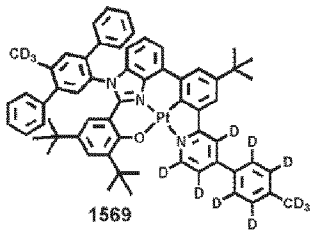

1569

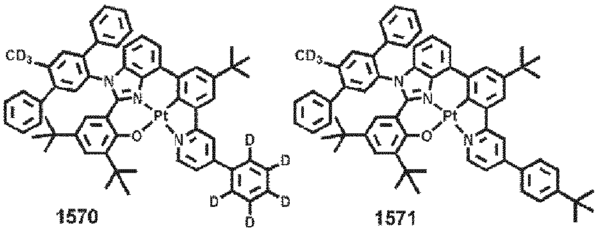

1570 1571

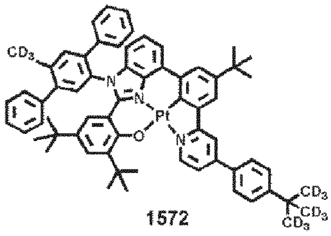

1572

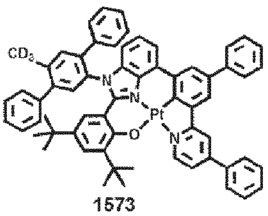

1573

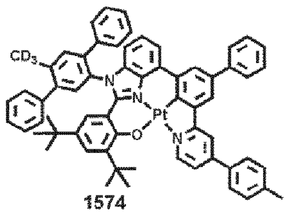

1574

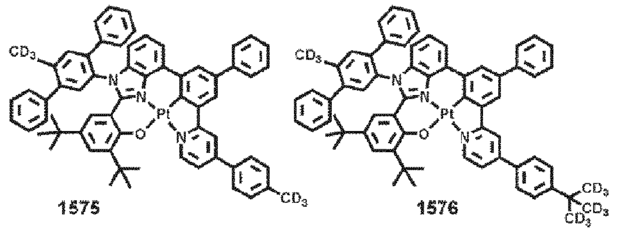

1575 1576

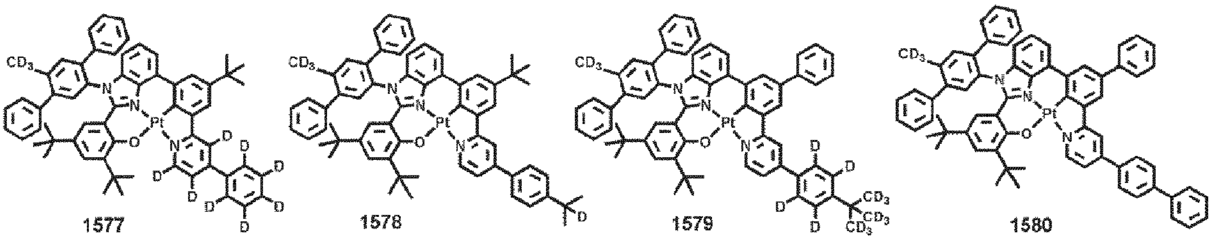

1577 1578 1579 1580

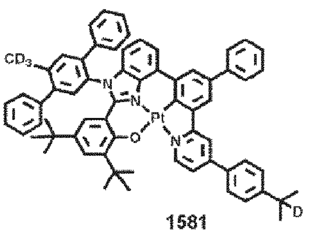

1581

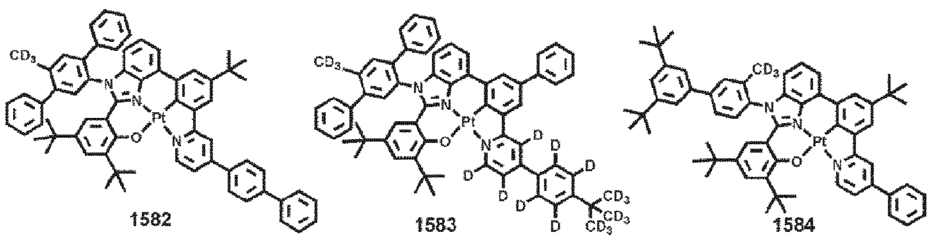

1582 1583 1584

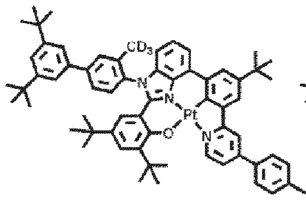
1585

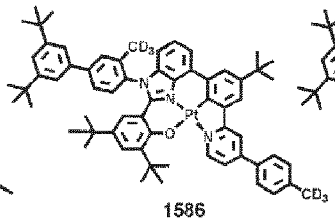
1586

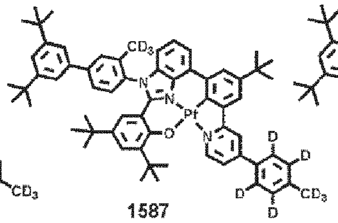
1587

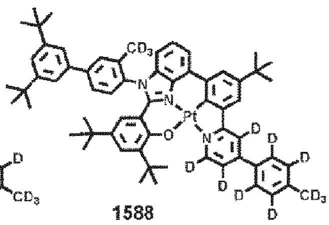
1588

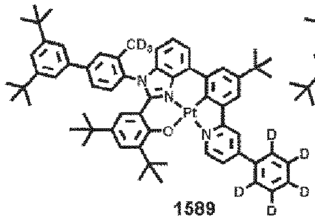
1589

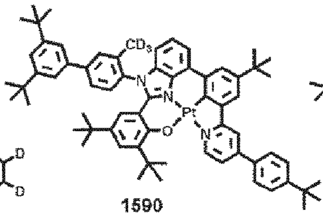
1590

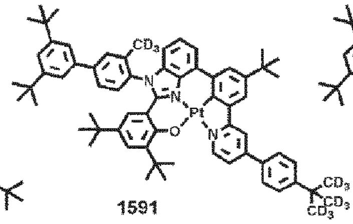
1591

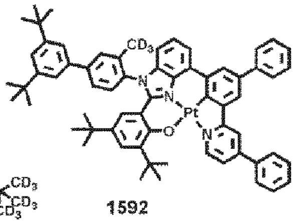
1592

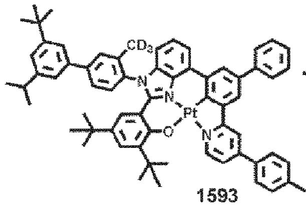
1593

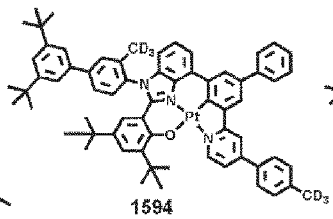
1594

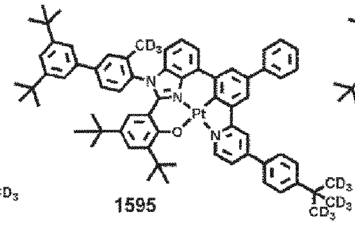
1595

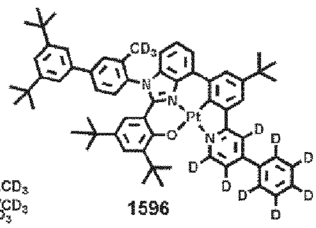
1596

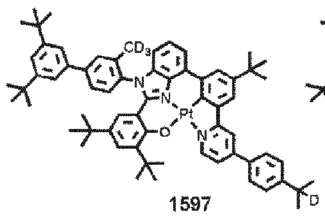
1597

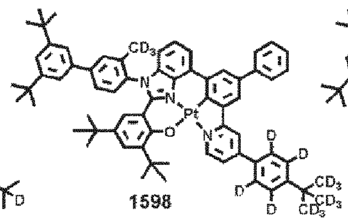
1598

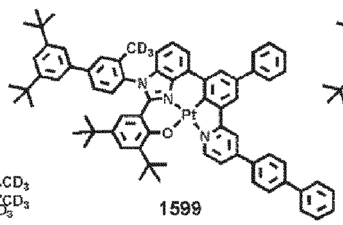
1599

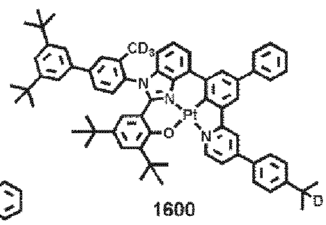
1600

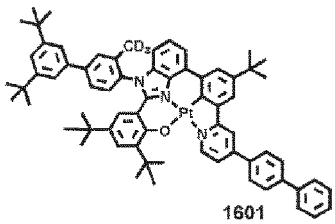
1601

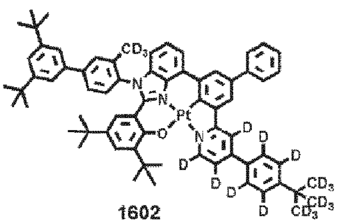
1602

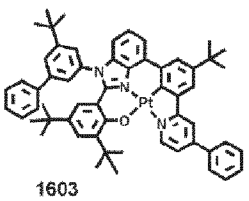
1603

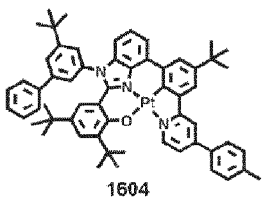
1604

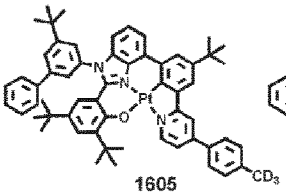
1605

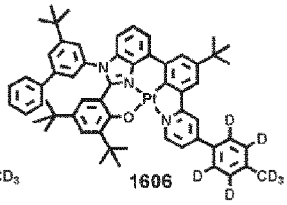
1606

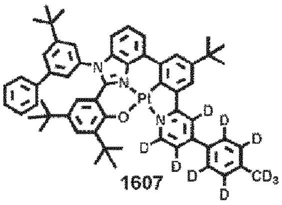
1607

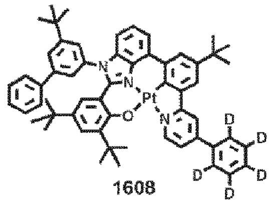
1608

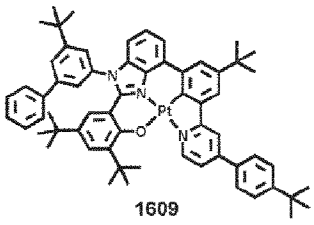
1609

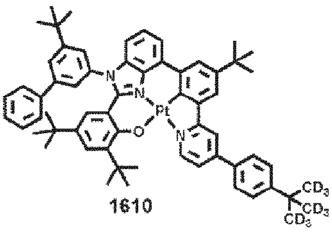
1610

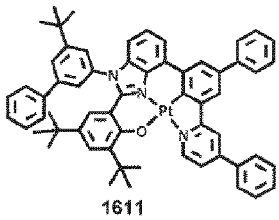
1611

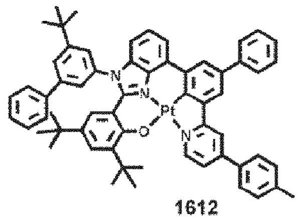
1612

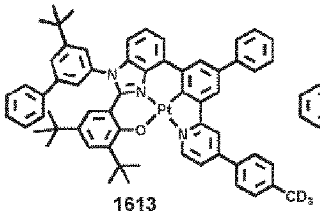
1613

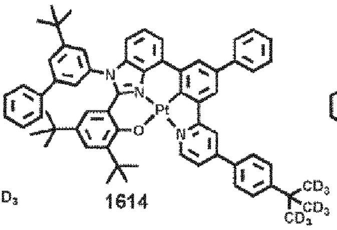
1614

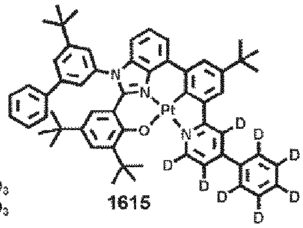
1615

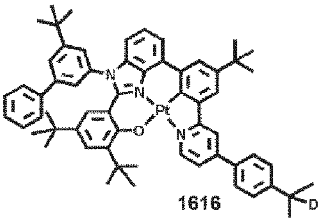
1616

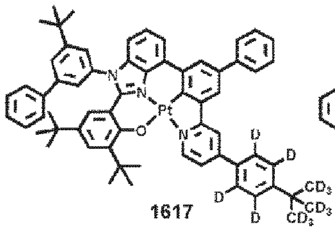
1617

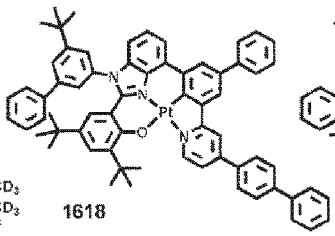
1618

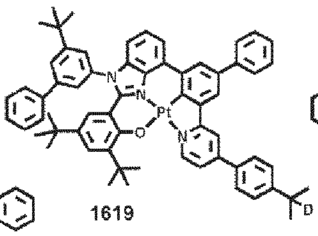
1619

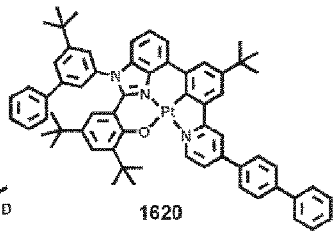
1620

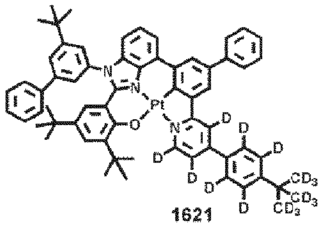
1621

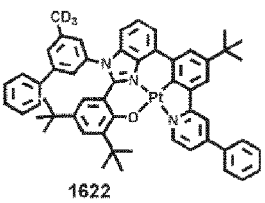
1622

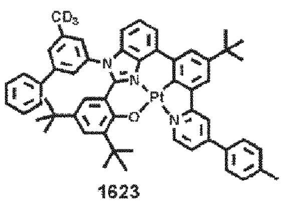
1623

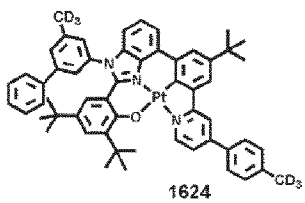
1624

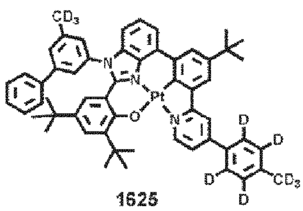
1625

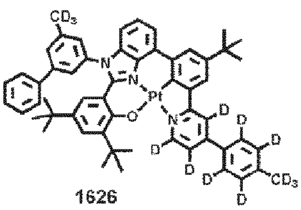
1626

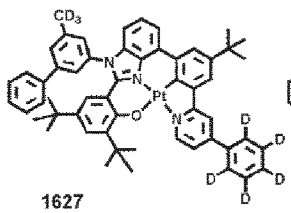
1627

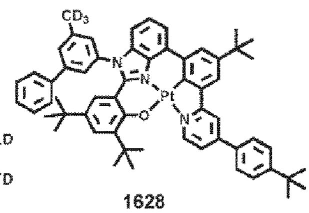
1628

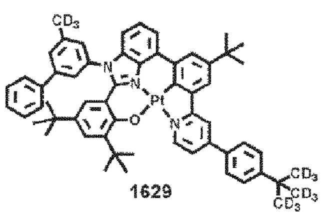
1629

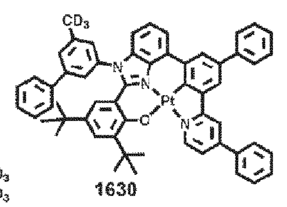
1630

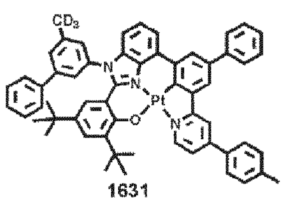
1631

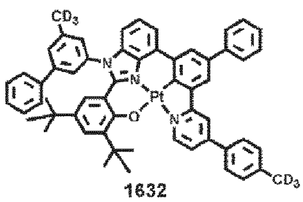
1632

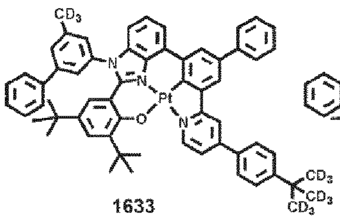
1633
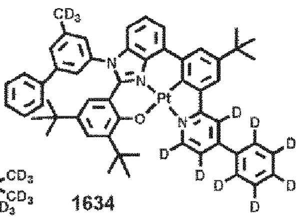
1634
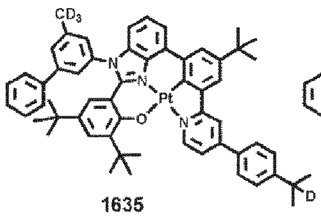
1635
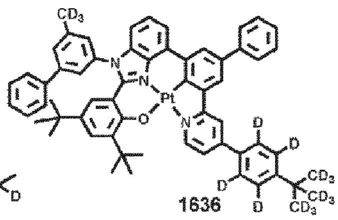
1636

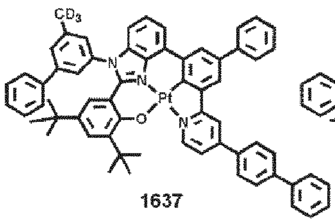
1637
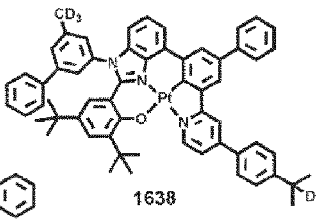
1638
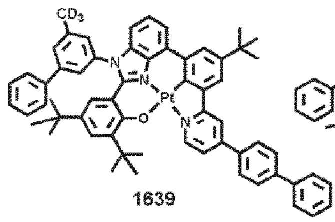
1639
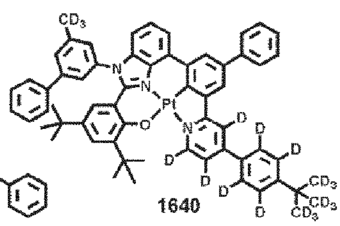
1640

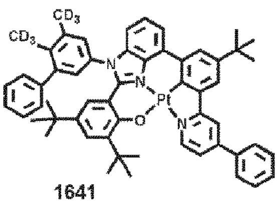
1641
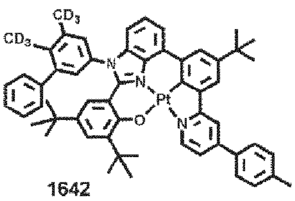
1642
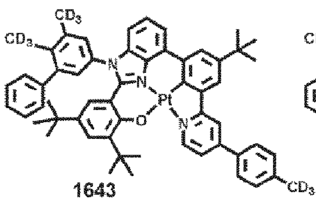
1643
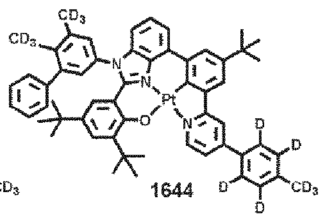
1644

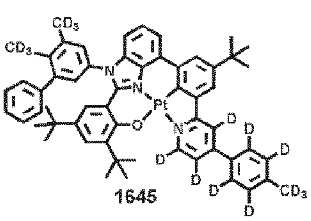
1645
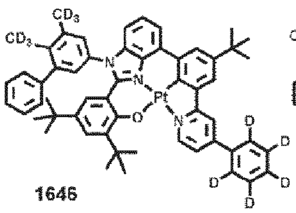
1646
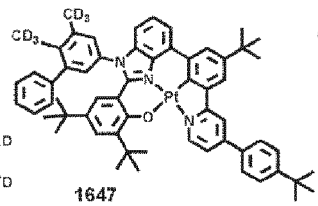
1647
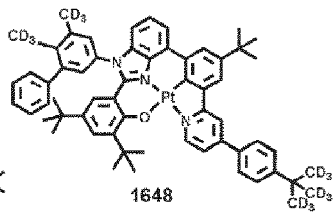
1648

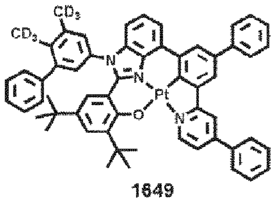
1649
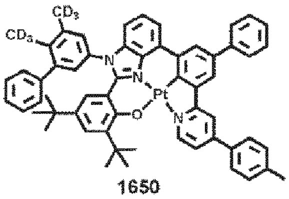
1650
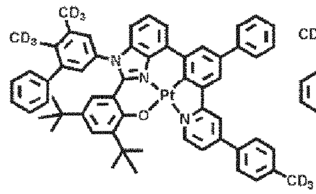
1651
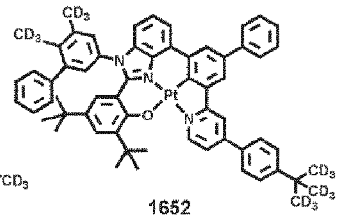
1652

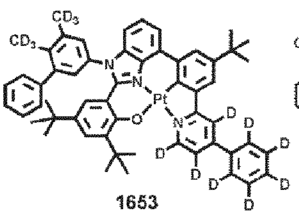
1653
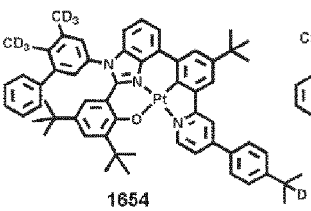
1654
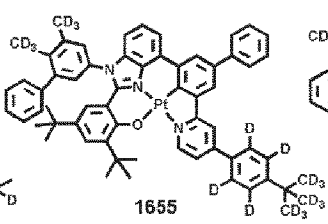
1655
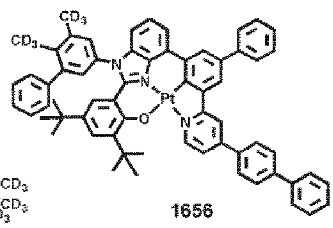
1656

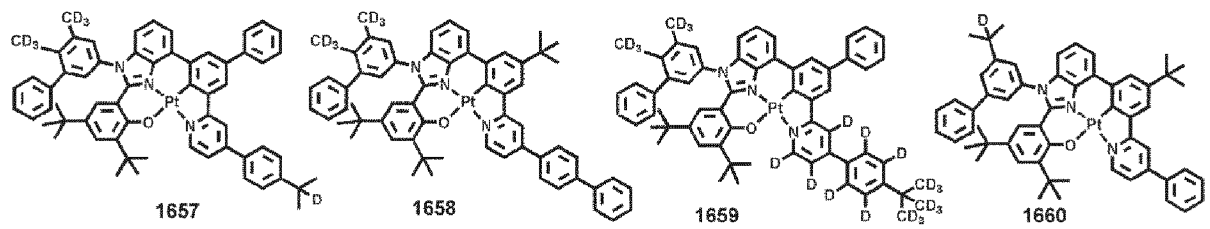

1657 1658 1659 1660

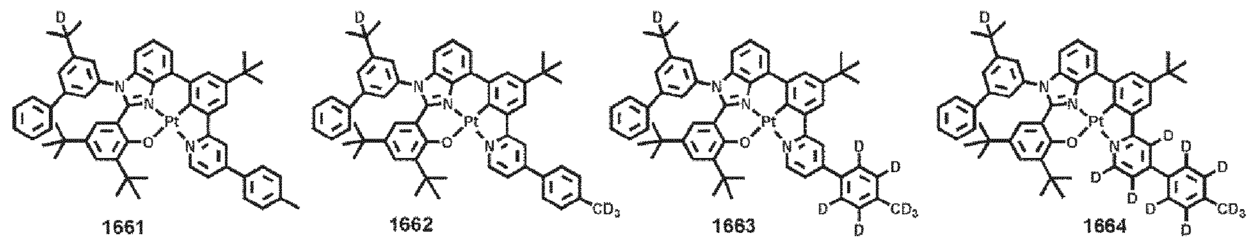

1661 1662 1663 1664

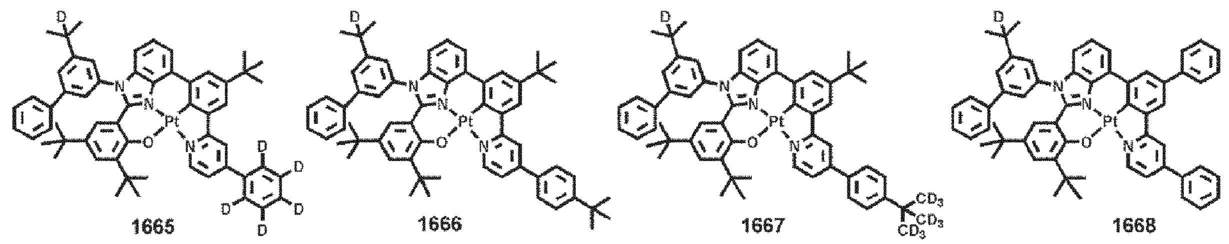

1665 1666 1667 1668

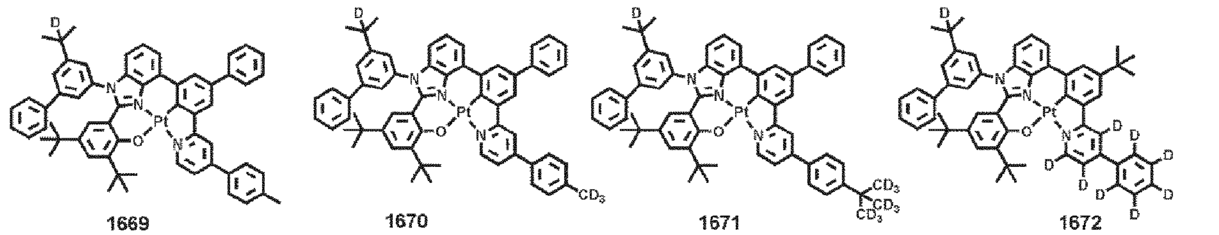

1669 1670 1671 1672

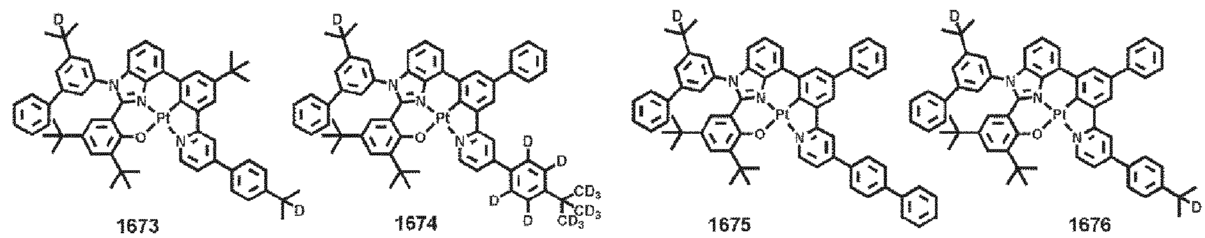

1673 1674 1675 1676

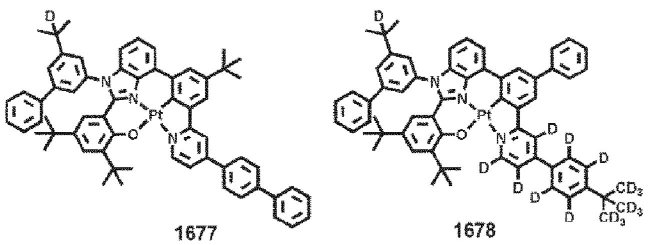

1677 1678

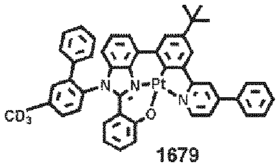
1679

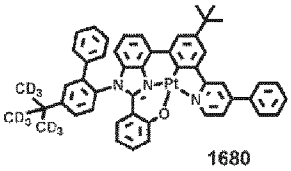
1680

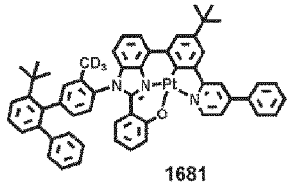
1681

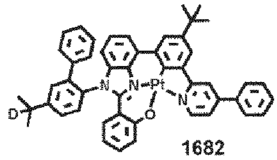
1682

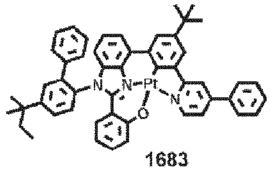
1683

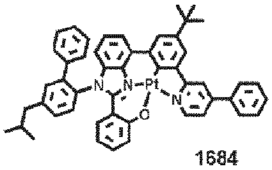
1684

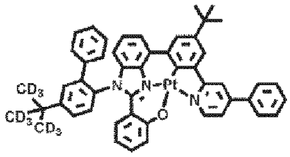
1685

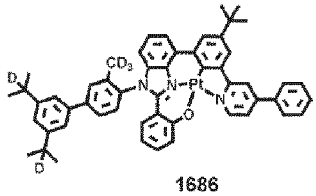
1686

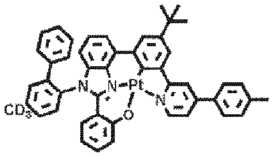
1687

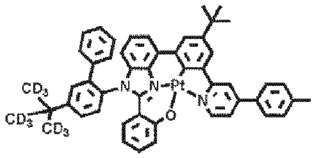
1688

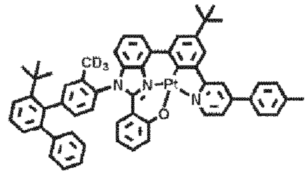
1689

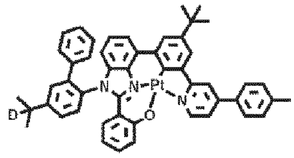
1690

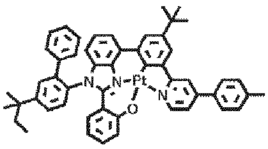
1691

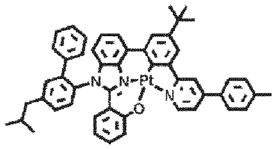
1692

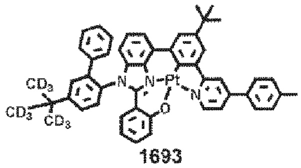
1693

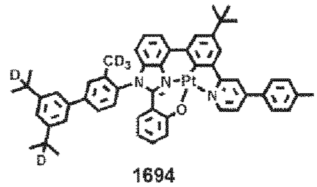
1694

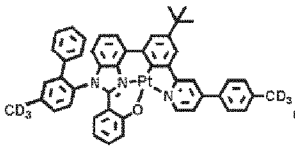
1695

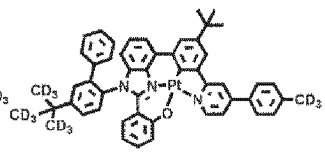
1696

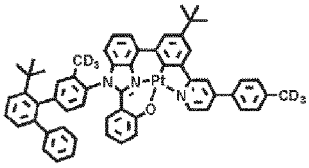
1697

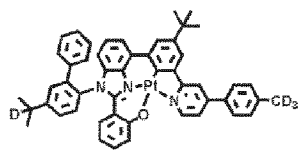
1698

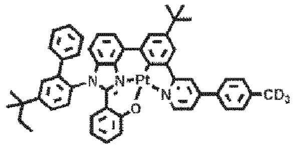
1699

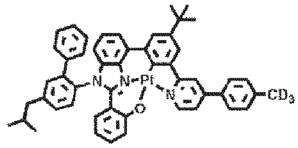
1700

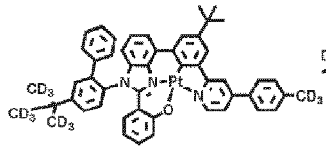
1701

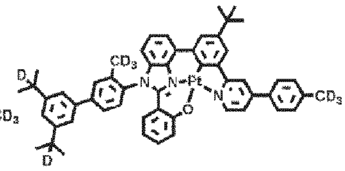
1702

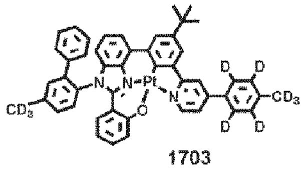
1703

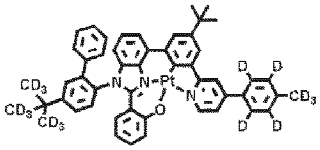
1704

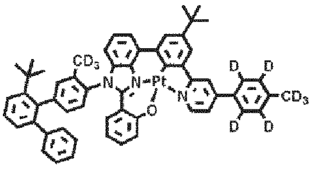
1705

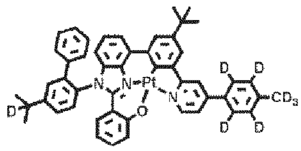
1706

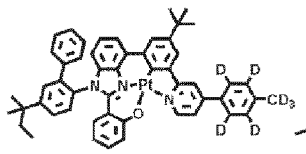
1707

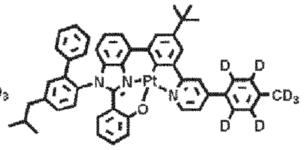
1708

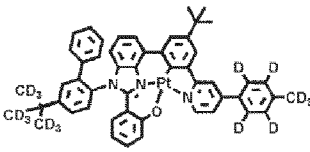
1709

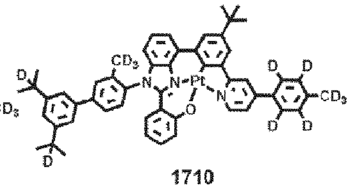
1710

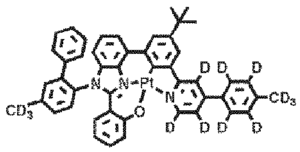
1711

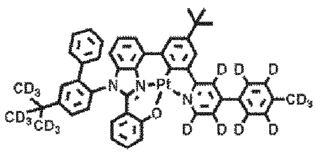
1712

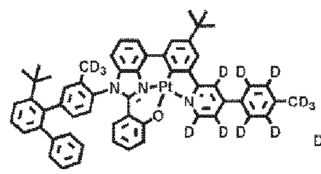
1713

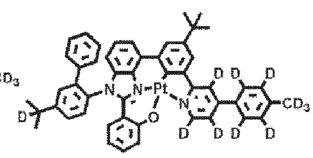
1714

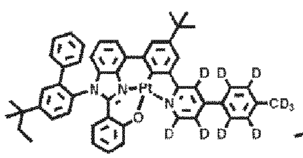
1715

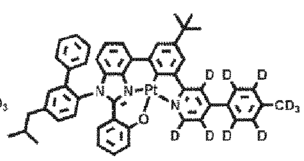
1716

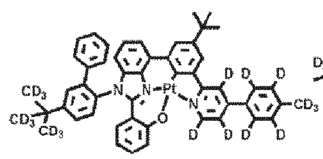
1717

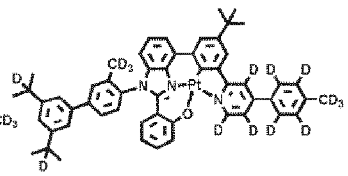
1718

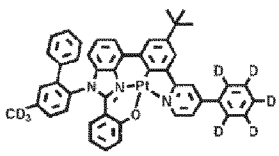
1719

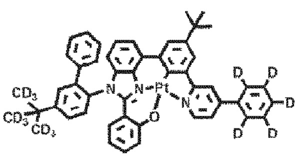
1720

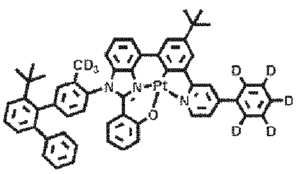
1721

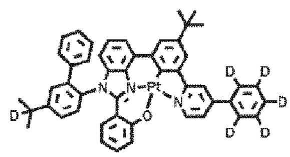
1722

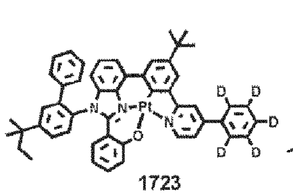
1723

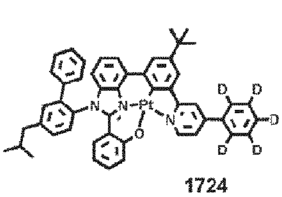
1724

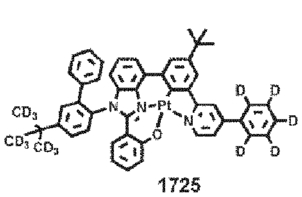
1725

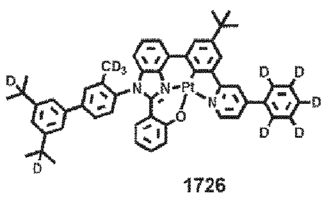
1726

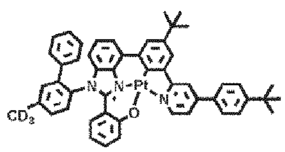
1727

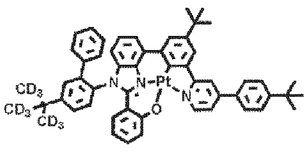
1728

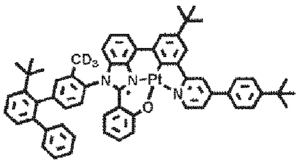
1729

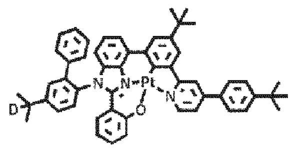
1730

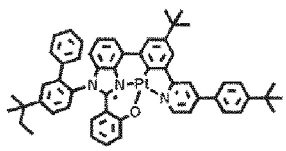
1731

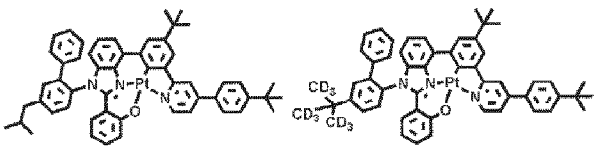
1732

1733

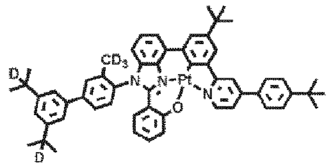
1734

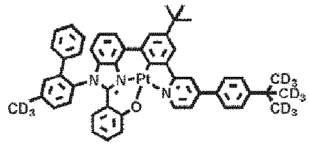
1735

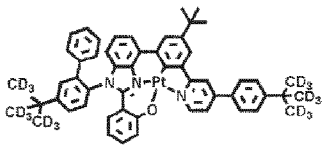
1736

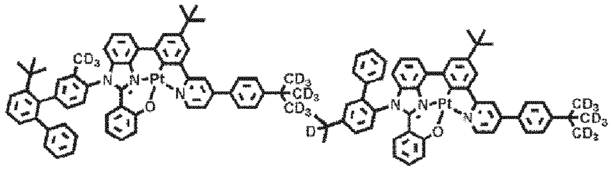
1737

1738

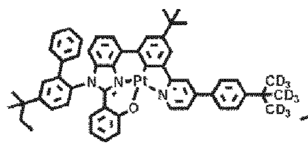
1739

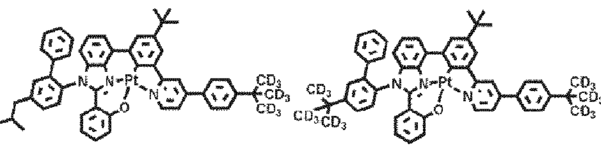
1740

1741

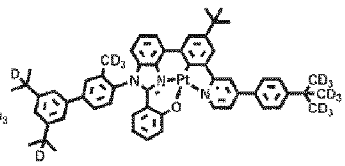
1742

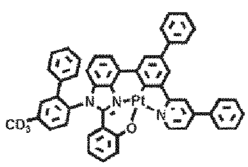
1743

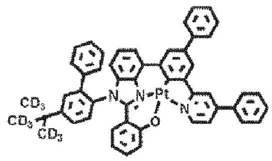
1744

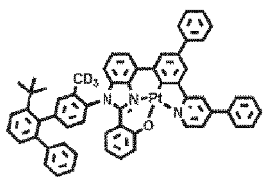
1745

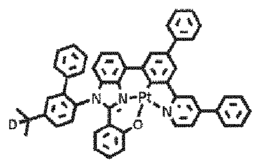
1746

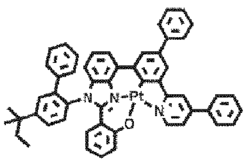
1747

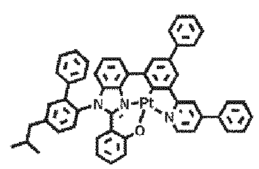
1748

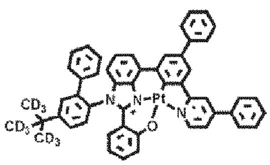
1749

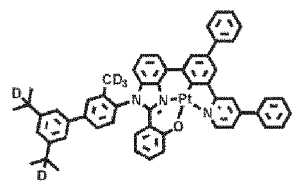
1750

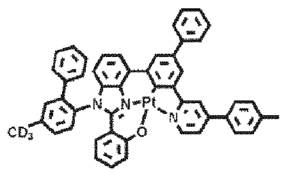
1751

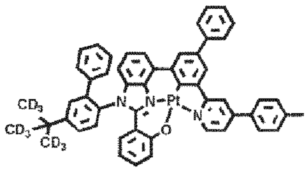
1752

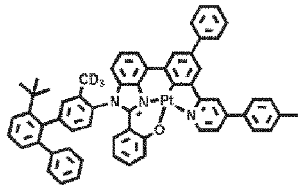
1753

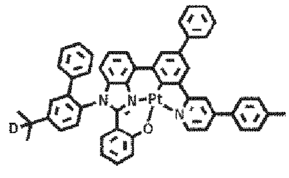
1754

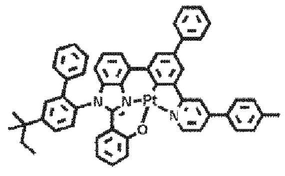
1755

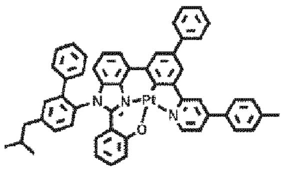
1756

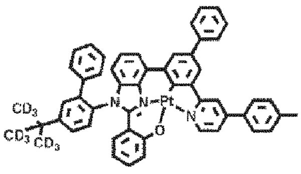
1757

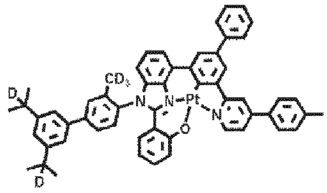
1758

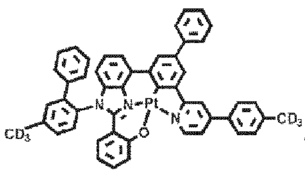
1759

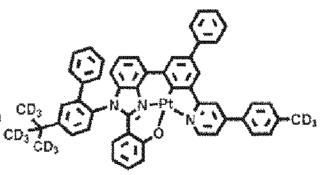
1760

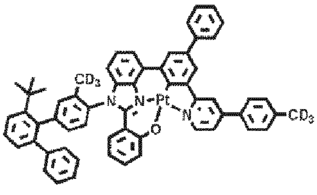
1761

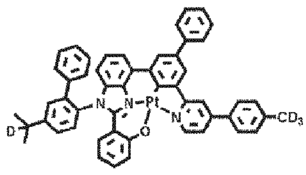
1762

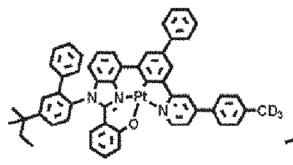
1763

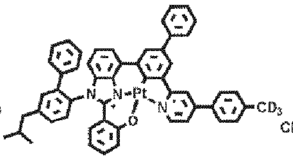
1764

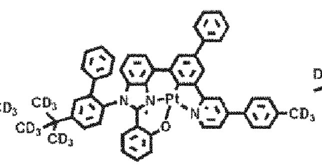
1765

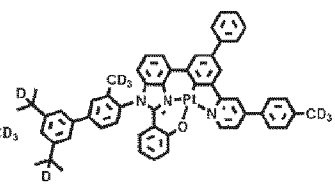
1766

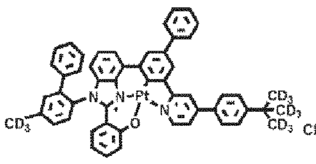
1767

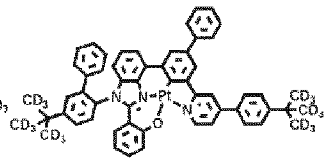
1768

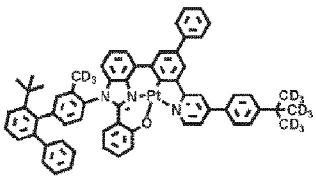
1769

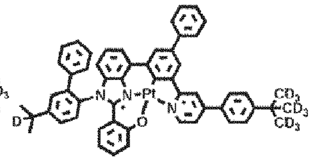
1770

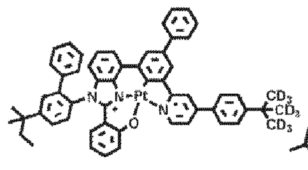
1771

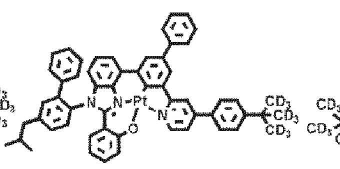
1772

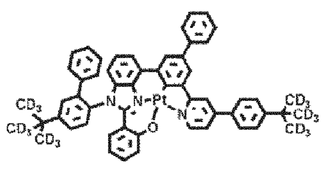
1773

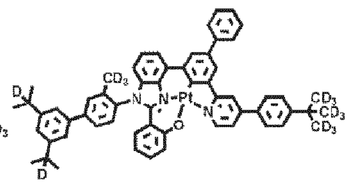
1774

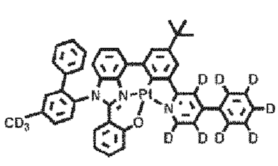
1775

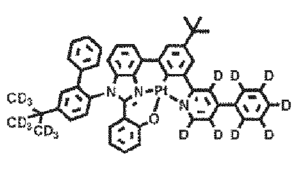
1776

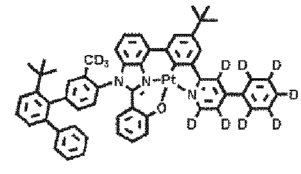
1777

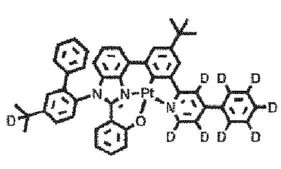
1778

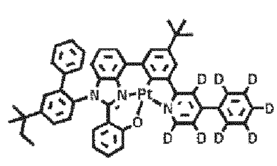
1779

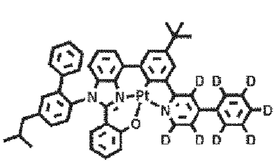
1780

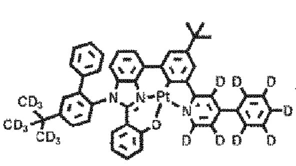
1781

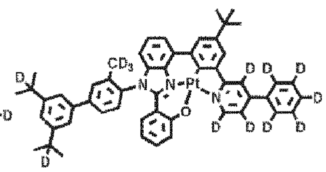
1782

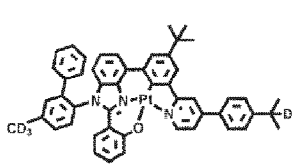
1783

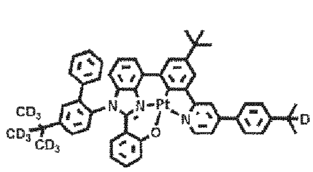
1784

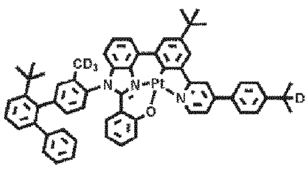
1785

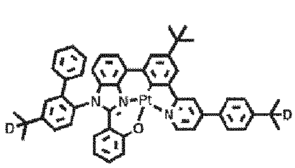
1786

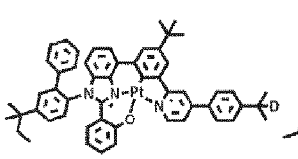
1787

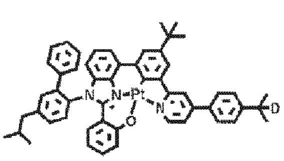
1788

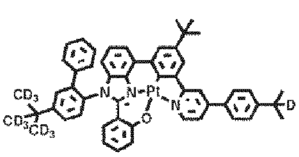
1789

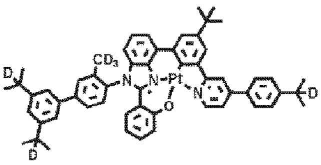
1790

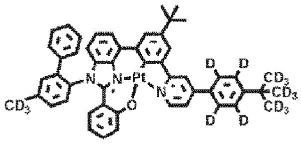
1791

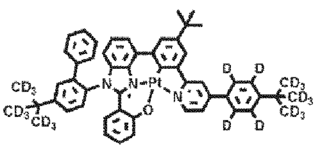
1792

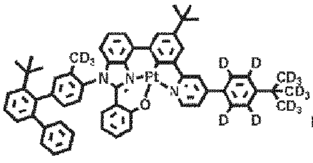
1793

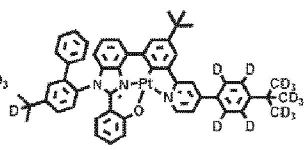
1794

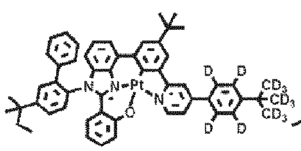
1795

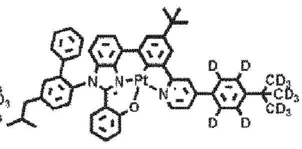
1796

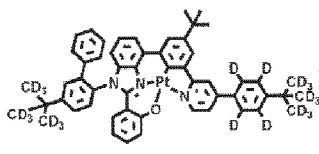
1797

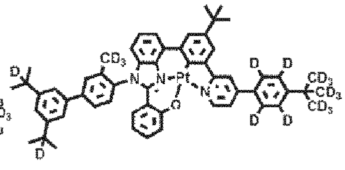
1798

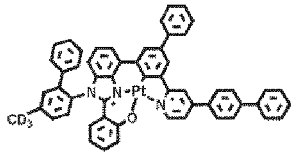
1799

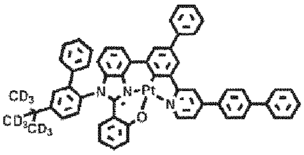
1800

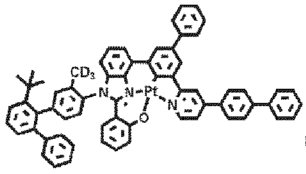
1801

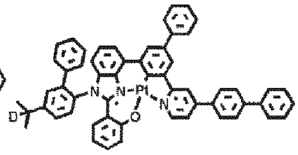
1802

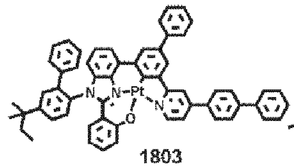
1803

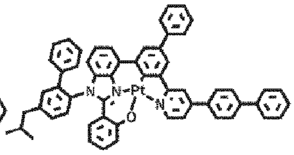
1804

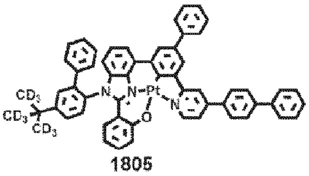
1805

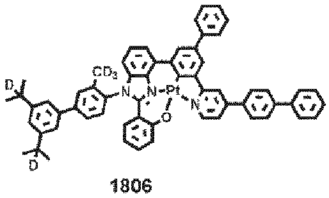
1806

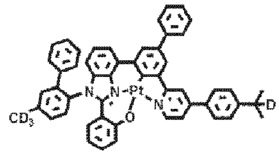
1807

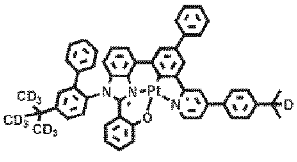
1808

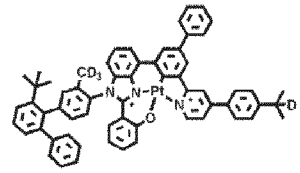
1809

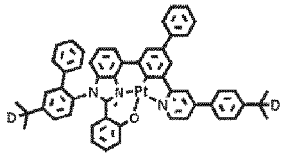
1810

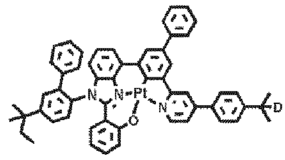
1811

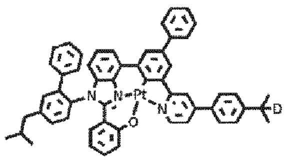
1812

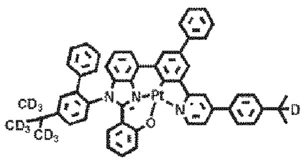
1813

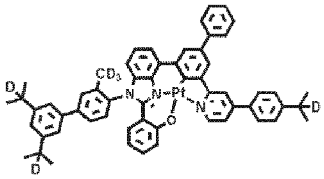
1814

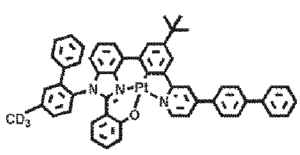
1815

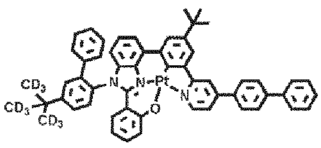
1816

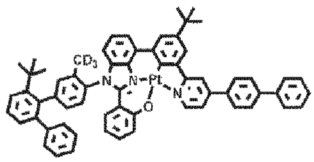
1817

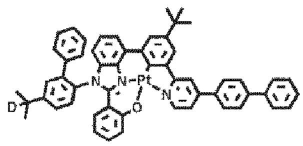
1818

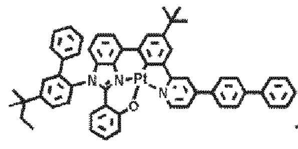
1819

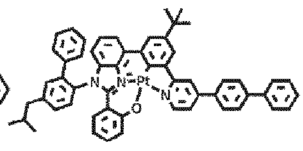
1820

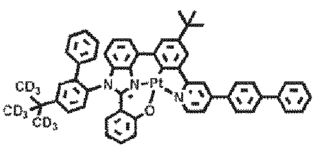
1821

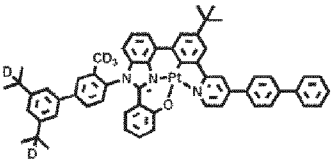
1822

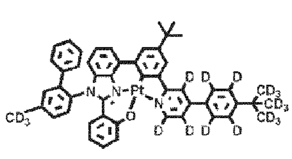
1823
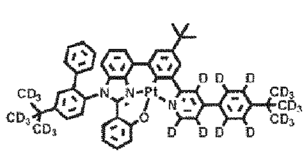
1824
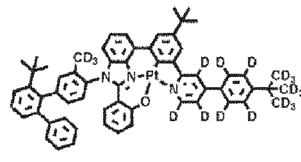
1825
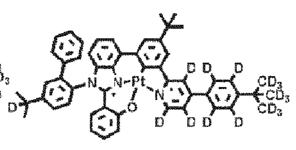
1826

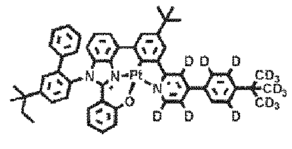
1827
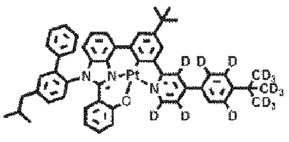
1828
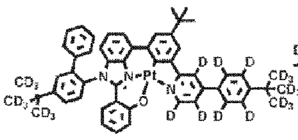
1829
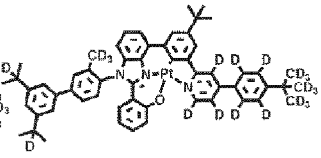
1830

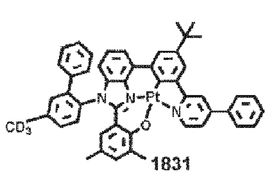
1831
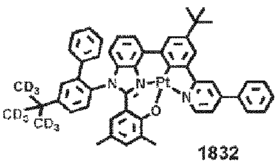
1832
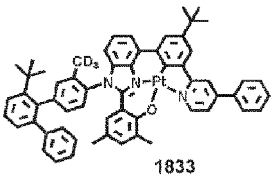
1833
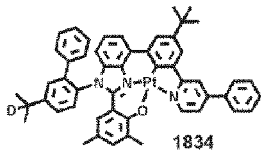
1834

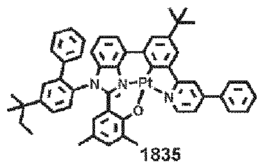
1835
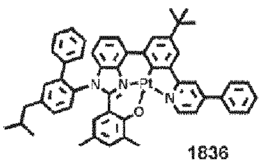
1836
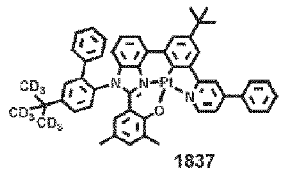
1837
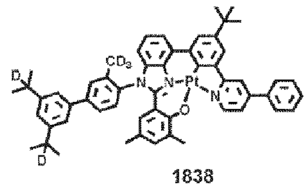
1838

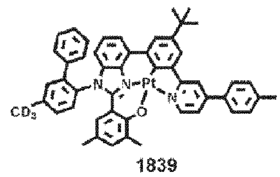
1839
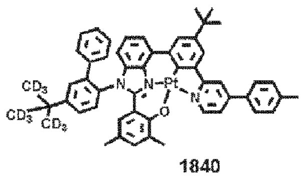
1840
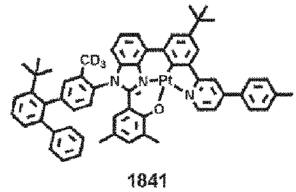
1841
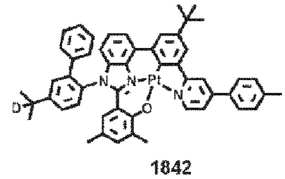
1842

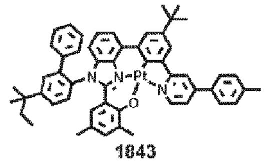
1843
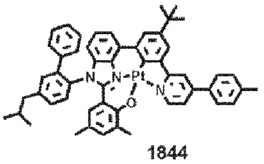
1844
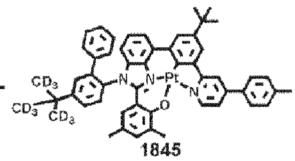
1845
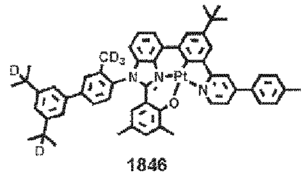
1846

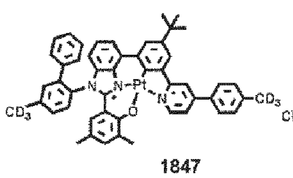
1847
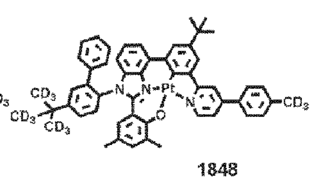
1848
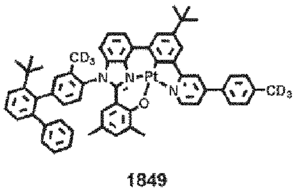
1849
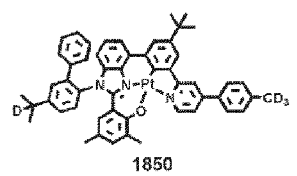
1850

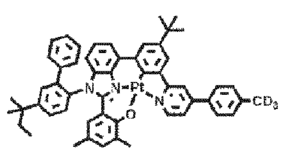
1851
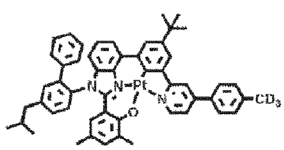
1852
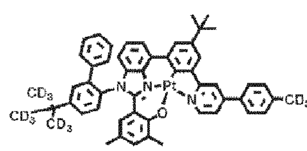
1853
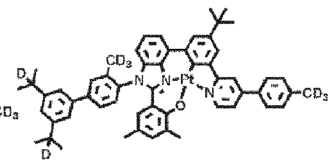
1854

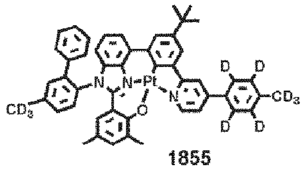 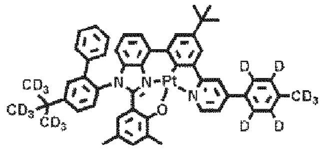 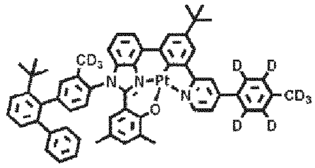 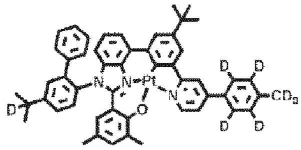

1855 1856 1857 1858

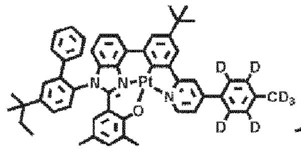 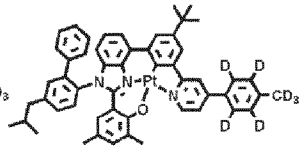 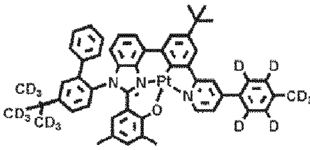 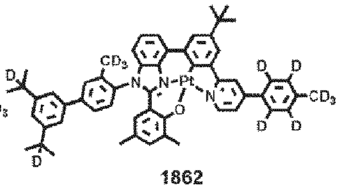

1859 1860 1861 1862

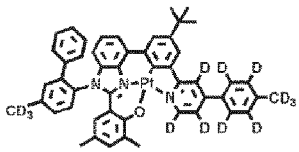 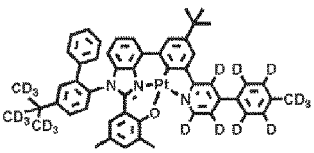 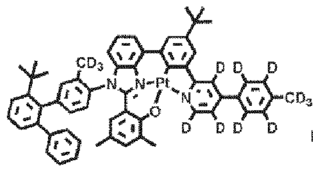 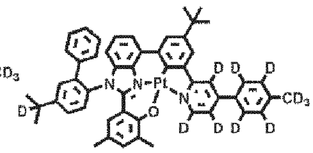

1863 1864 1865 1866

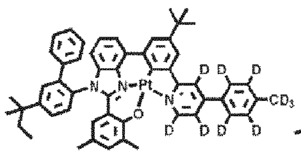 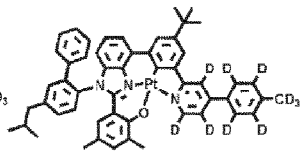 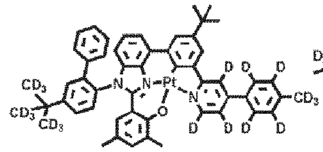 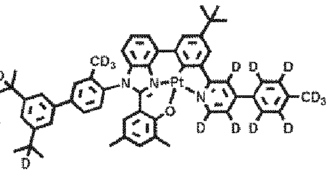

1867 1868 1869 1870

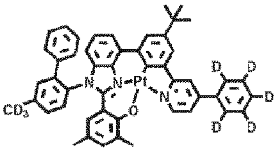 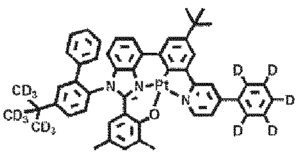 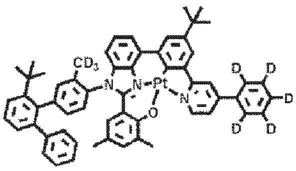 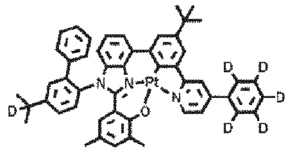

1871 1872 1873 1874

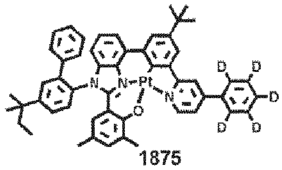 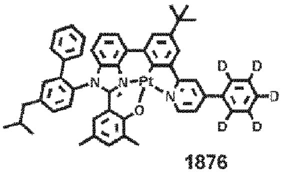 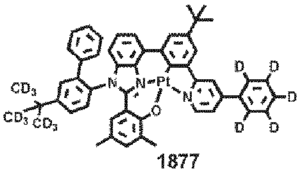 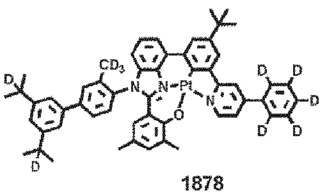

1875 1876 1877 1878

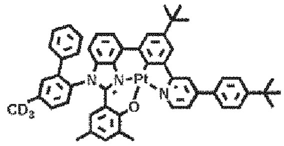

1879

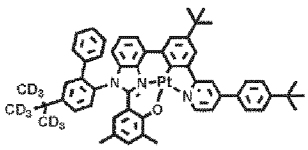

1880

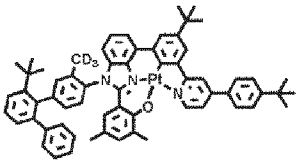

1881

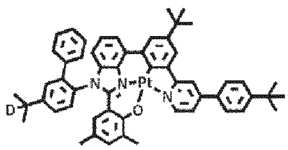

1882

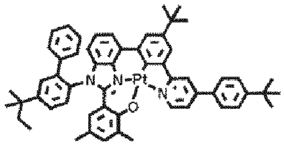

1883

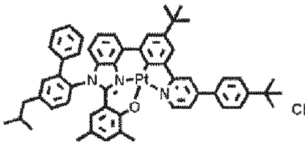

1884

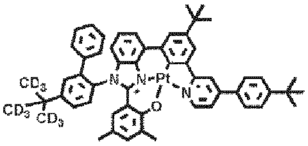

1885

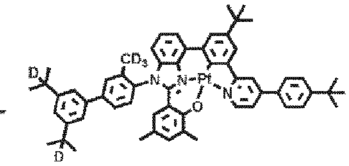

1886

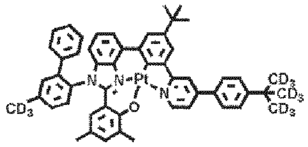

1887

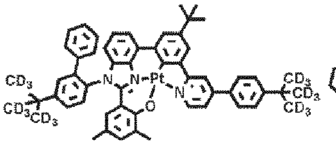

1888

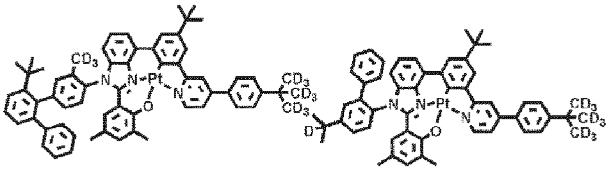

1889

1890

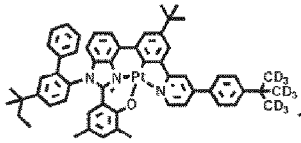

1891

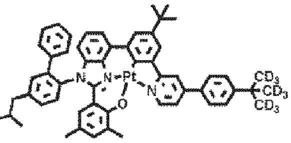

1892

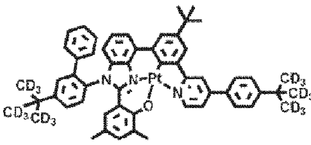

1893

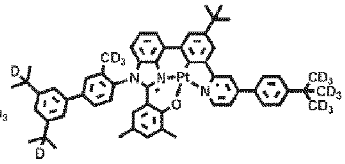

1894

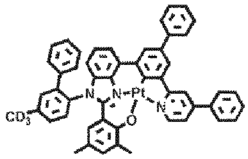

1895

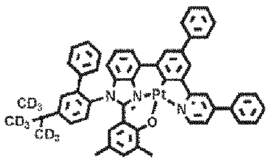

1896

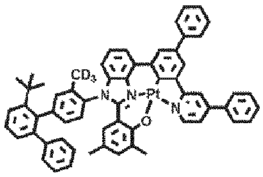

1897

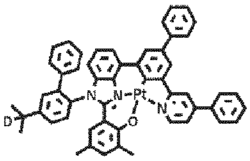

1898

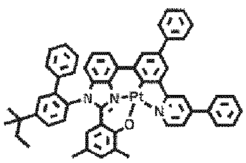

1899

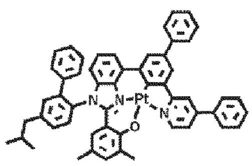

1900

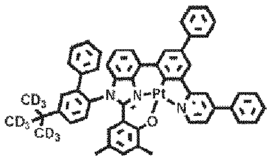

1901

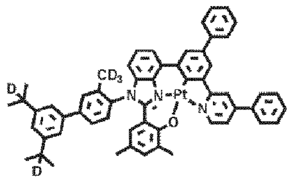

1902

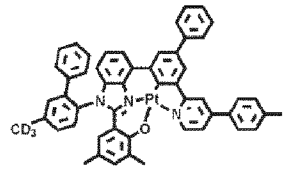
1903

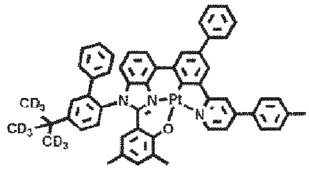
1904

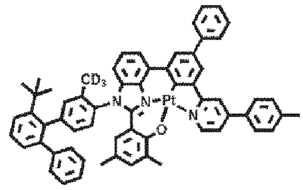
1905

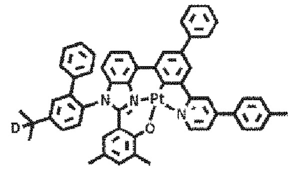
1906

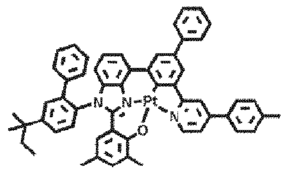
1907

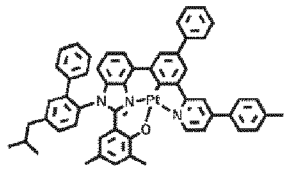
1908

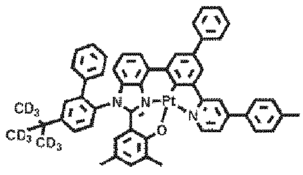
1909

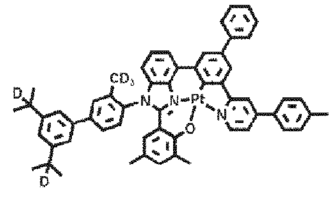
1910

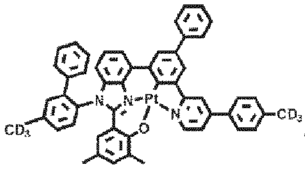
1911

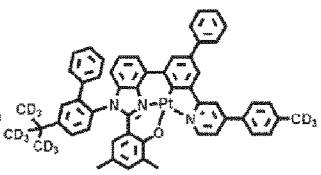
1912

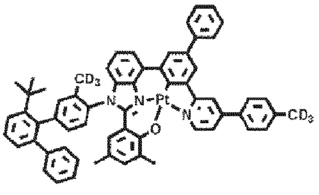
1913

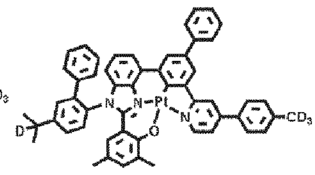
1914

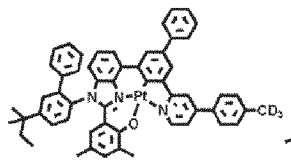
1915

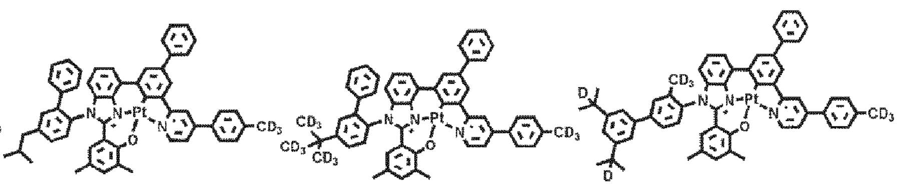
1916

1917

1918

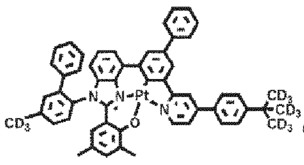
1919

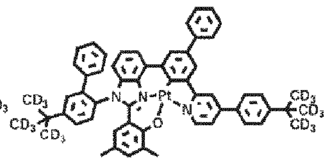
1920

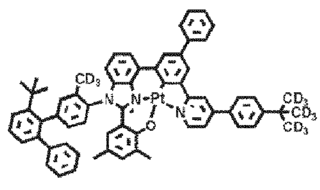
1921

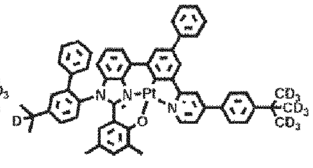
1922

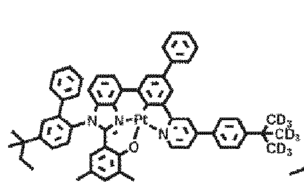
1923

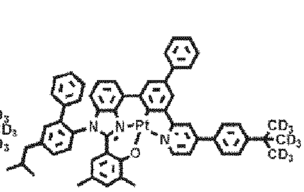
1924

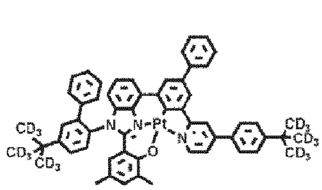
1925

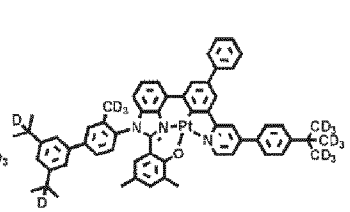
1926

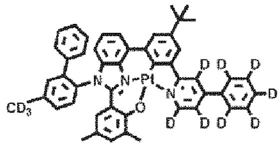
1927

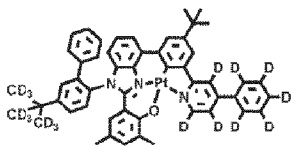
1928

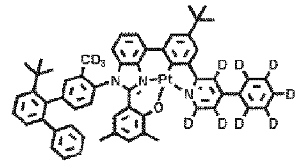
1929

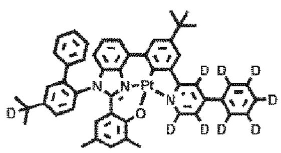
1930

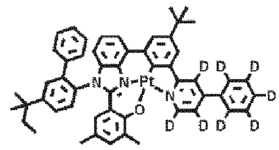
1931

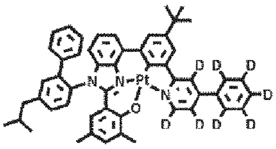
1932

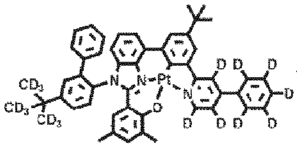
1933

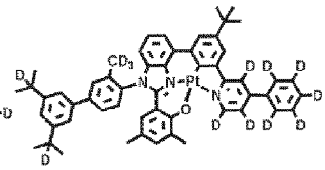
1934

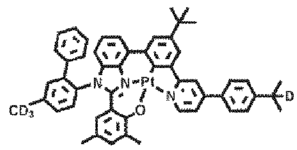
1935

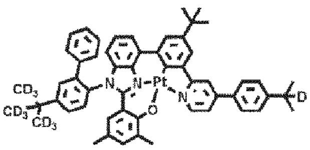
1936

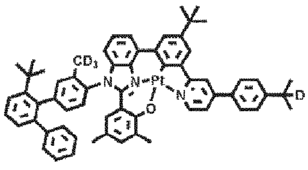
1937

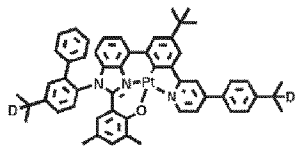
1938

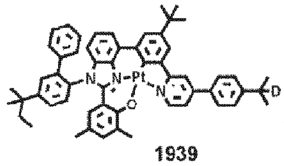
1939

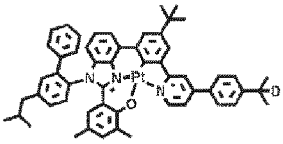
1940

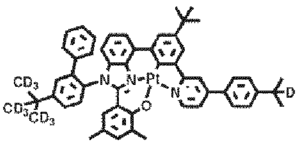
1941

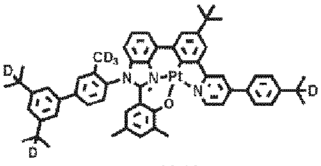
1942

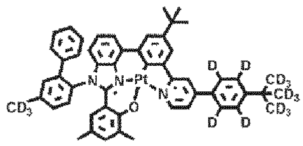
1943

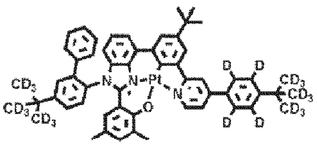
1944

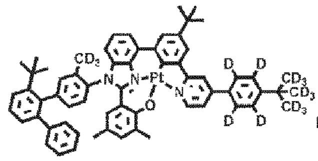
1945

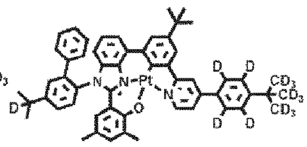
1946

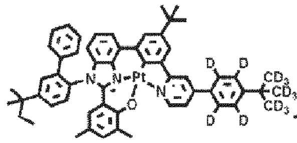
1947

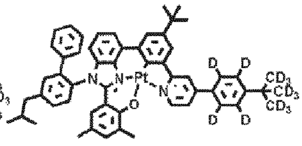
1948

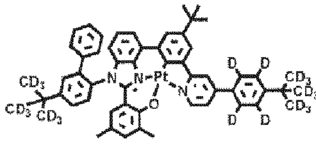
1949

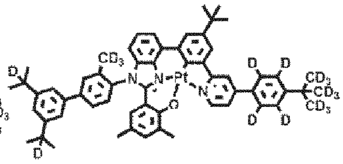
1950

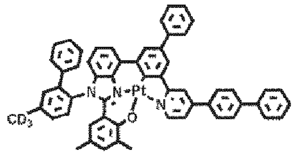

1951

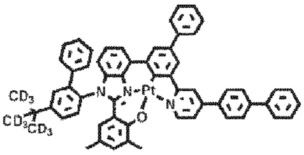

1952

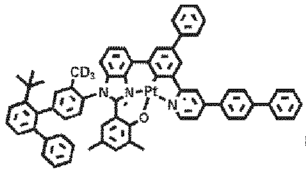

1953

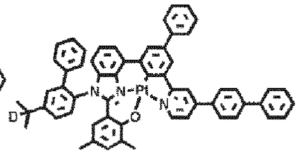

1954

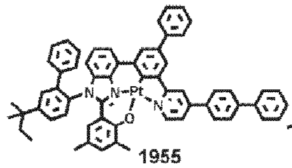

1955

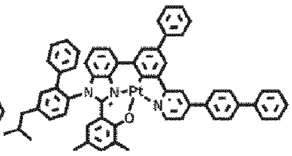

1956

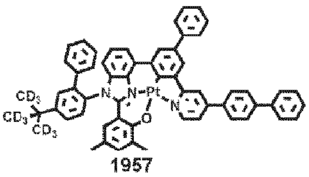

1957

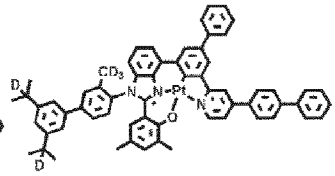

1958

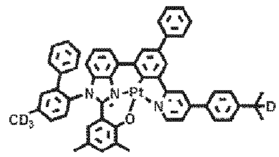

1959

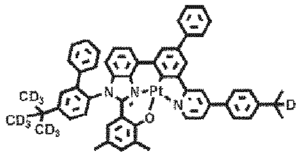

1960

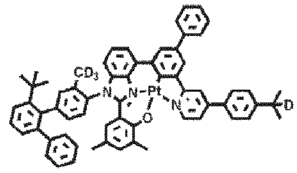

1961

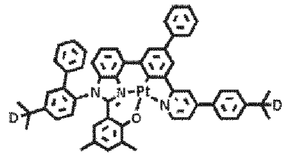

1962

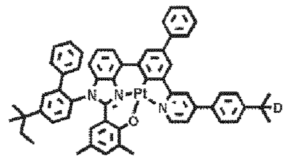

1963

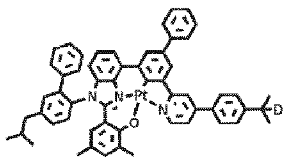

1964

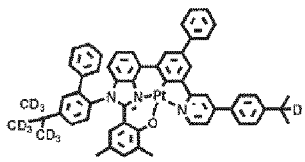

1965

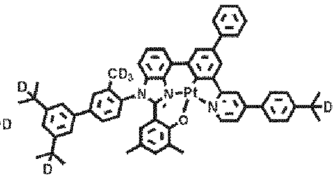

1966

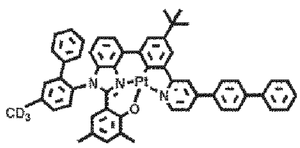

1967

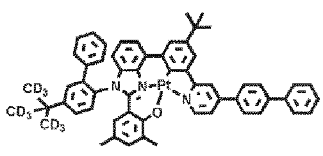

1968

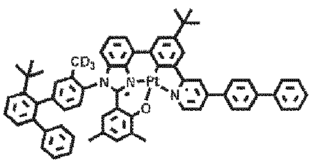

1969

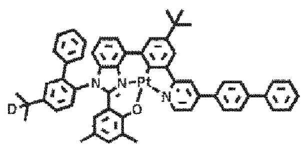

1970

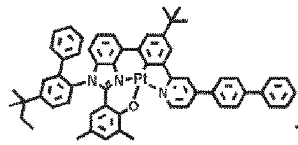

1971

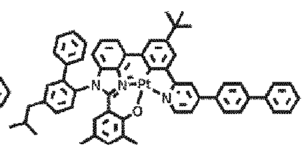

1972

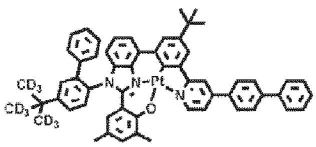

1973

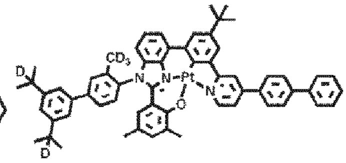

1974

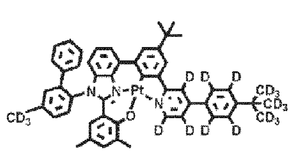
1975
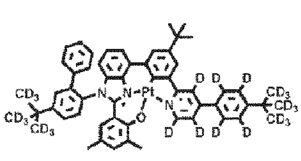
1976
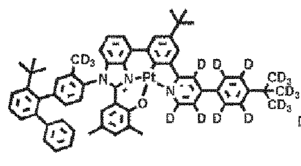
1977
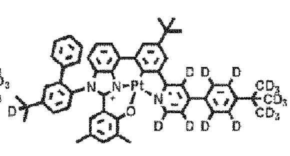
1978
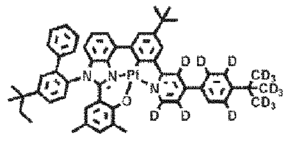
1979
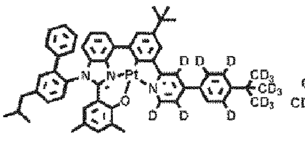
1980
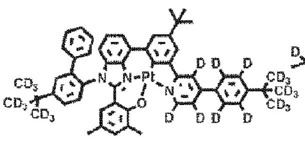
1981
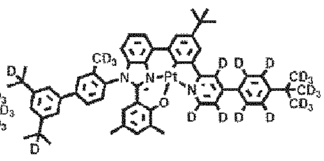
1982
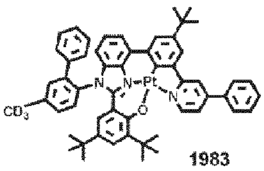
1983
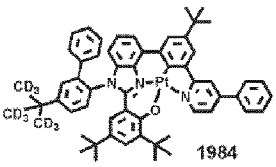
1984
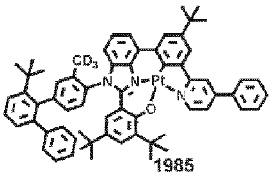
1985
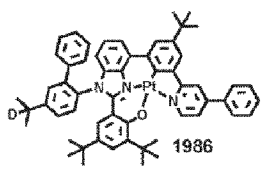
1986
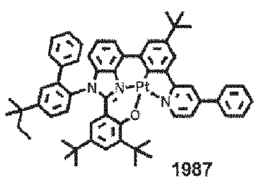
1987
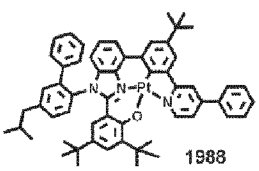
1988
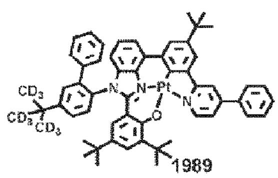
1989
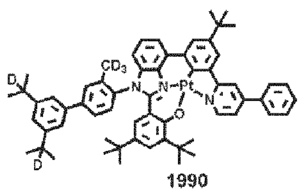
1990
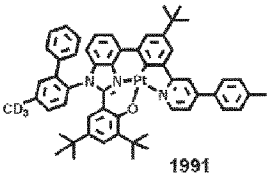
1991
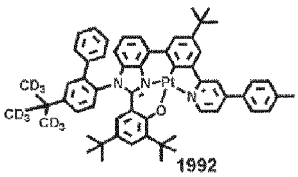
1992
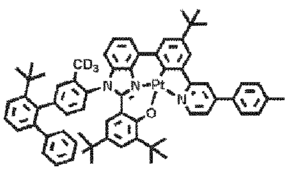
1993
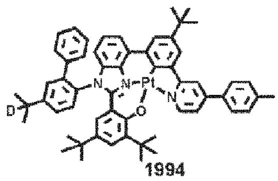
1994
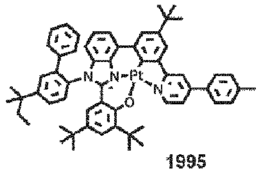
1995
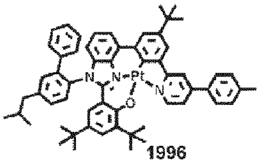
1996
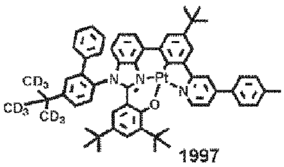
1997
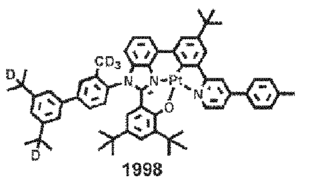
1998
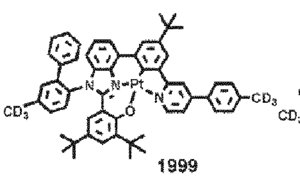
1999
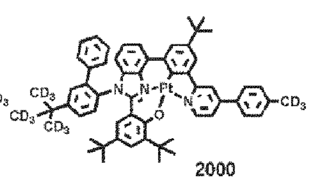
2000
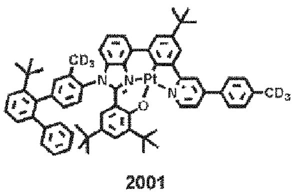
2001
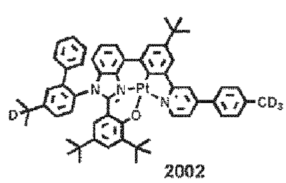
2002
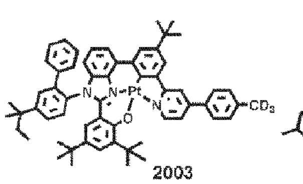
2003
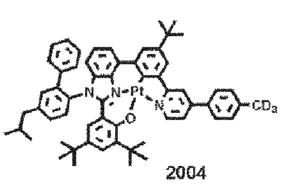
2004
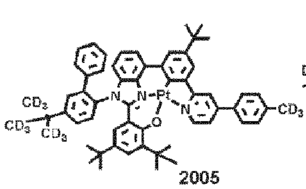
2005
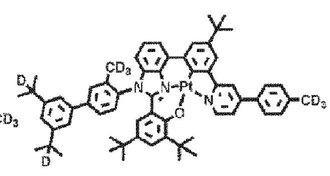
2006

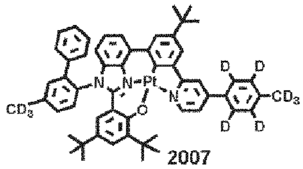
2007
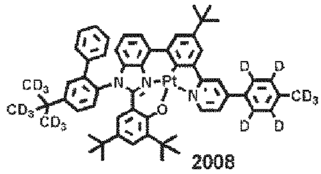
2008
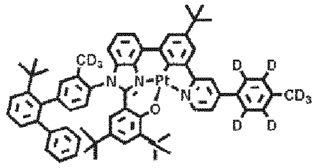
2009
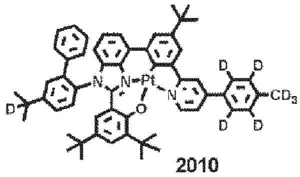
2010

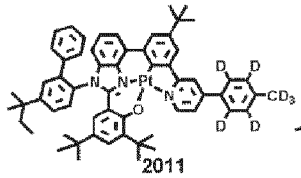
2011
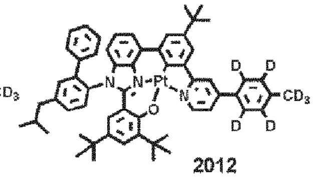
2012
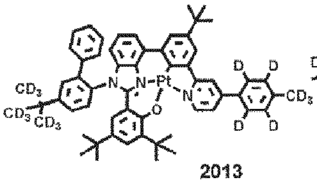
2013
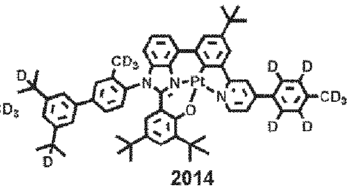
2014

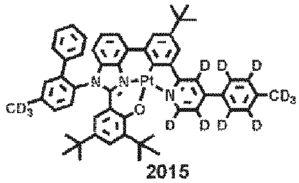
2015
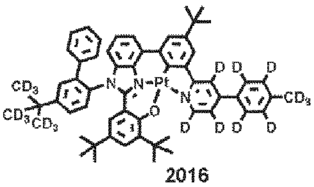
2016
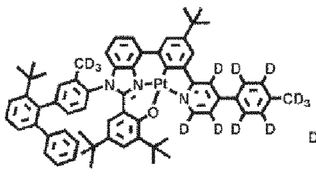
2017
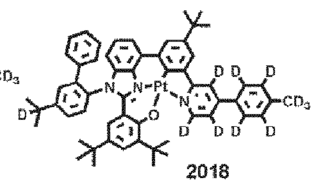
2018

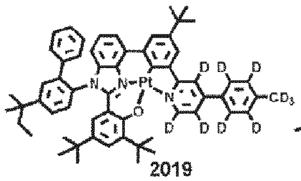
2019
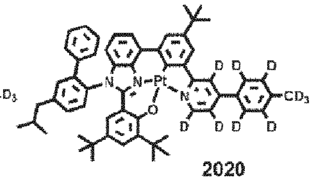
2020
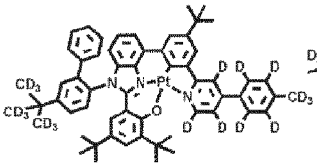
2021
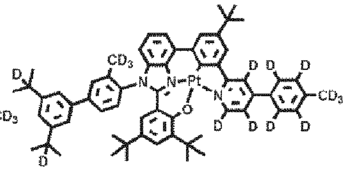
2022

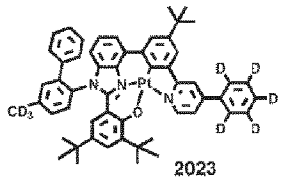
2023
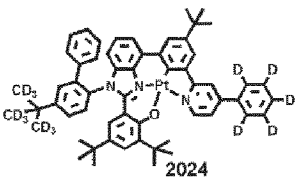
2024
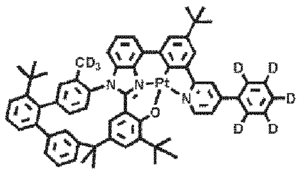
2025
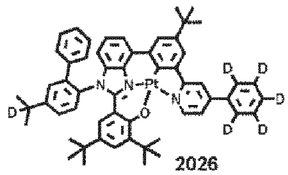
2026

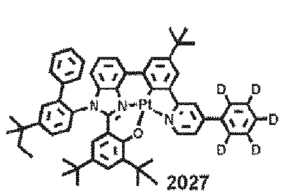
2027
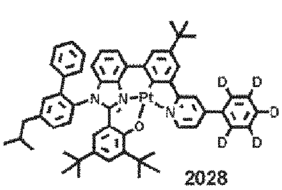
2028
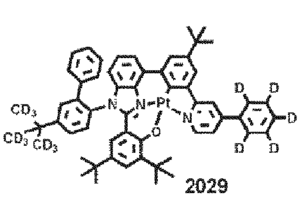
2029
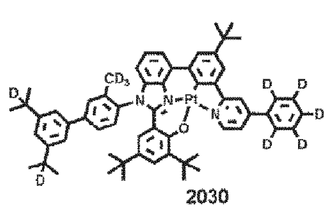
2030

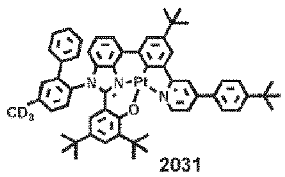
2031

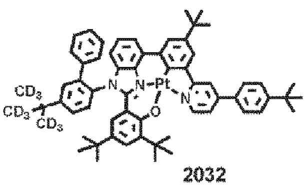
2032

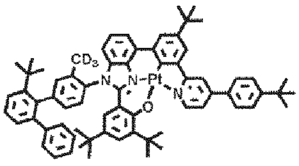
2033

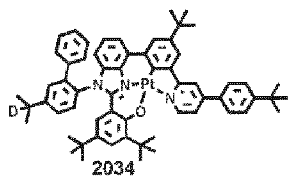
2034

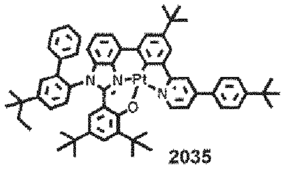
2035

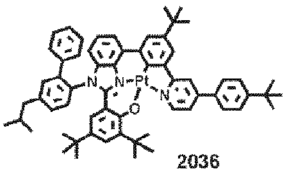
2036

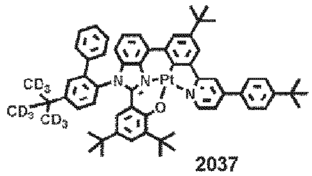
2037

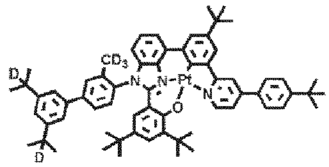
2038

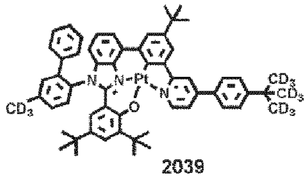
2039

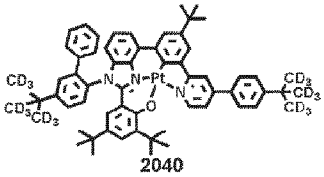
2040

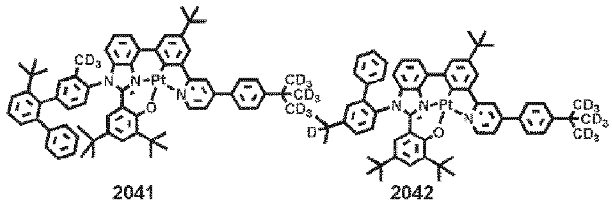
2041

2042

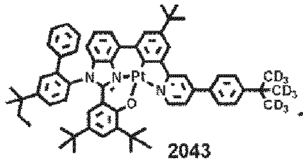
2043

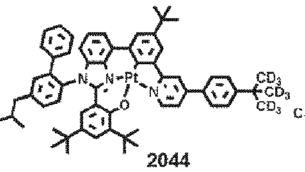
2044

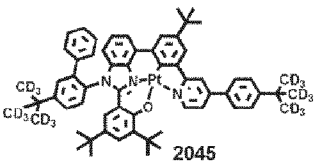
2045

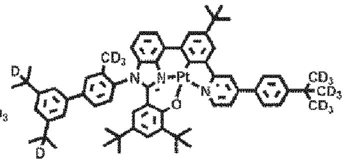
2046

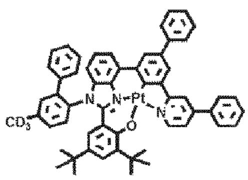
2047

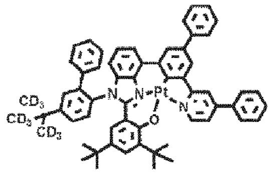
2048

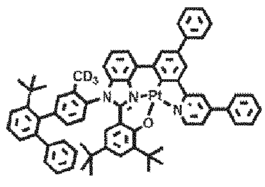
2049

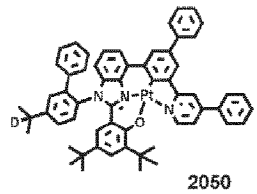
2050

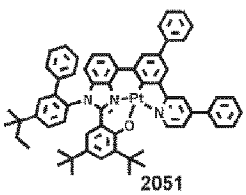
2051

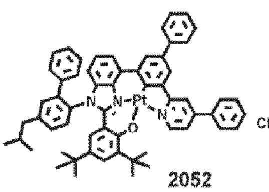
2052

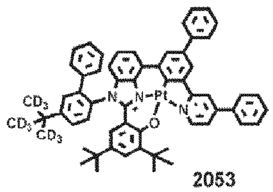
2053

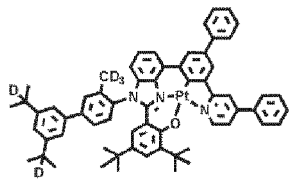
2054

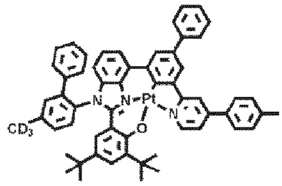
2055

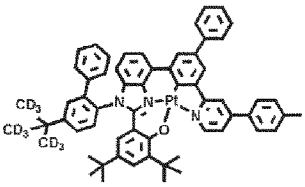
2056

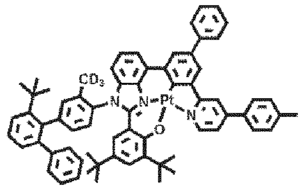
2057

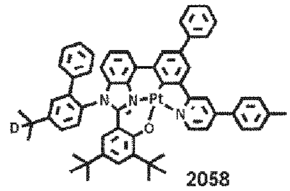
2058

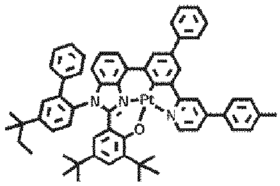
2059

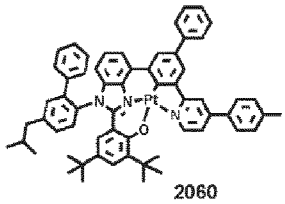
2060

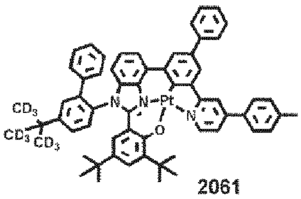
2061

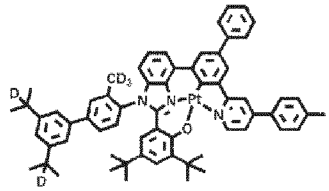
2062

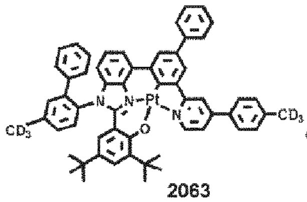
2063

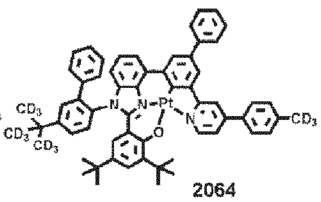
2064

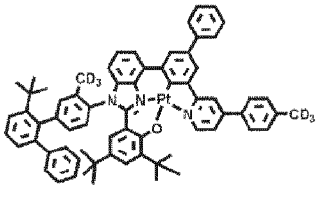
2065

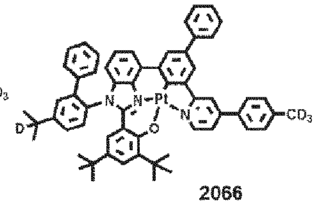
2066

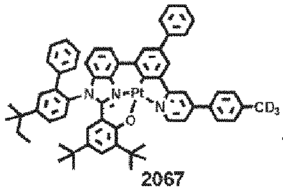
2067

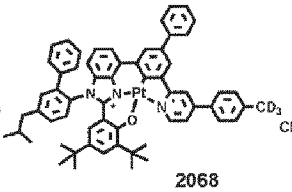
2068

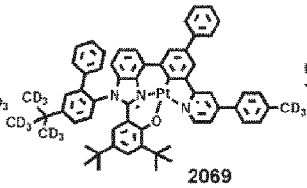
2069

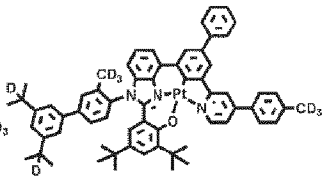
2070

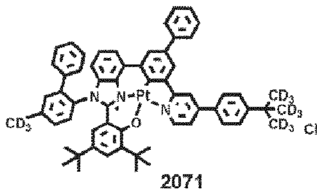
2071

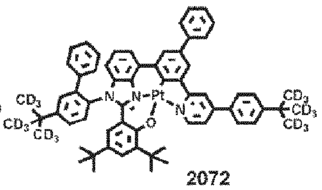
2072

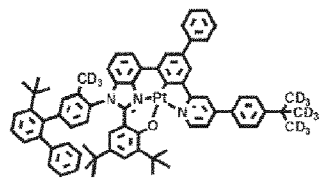
2073

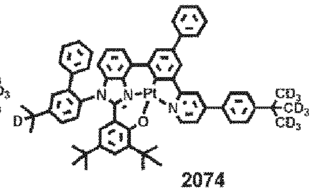
2074

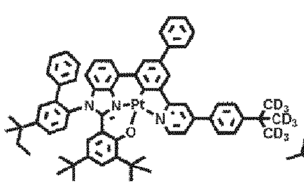
2075

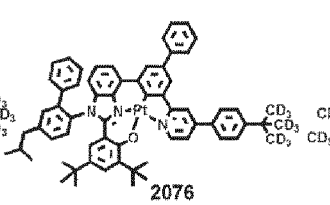
2076

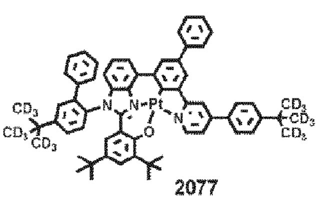
2077

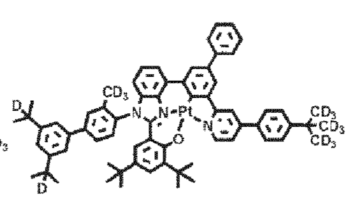
2078

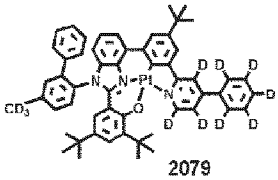
2079

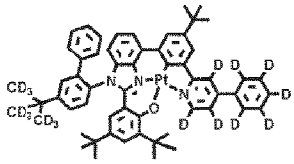
2080

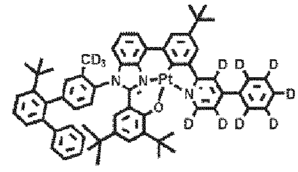
2081

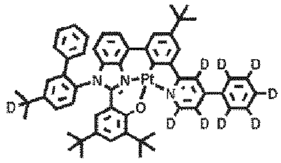
2082

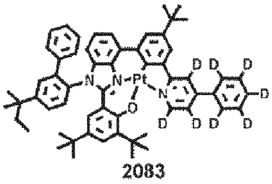
2083

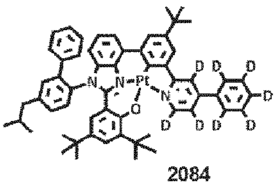
2084

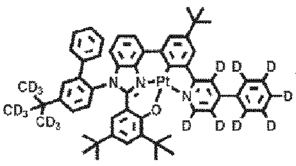
2085

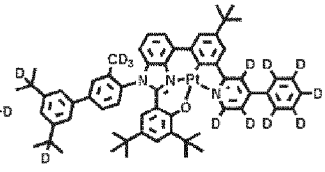
2086

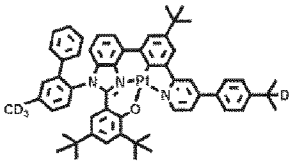
2087

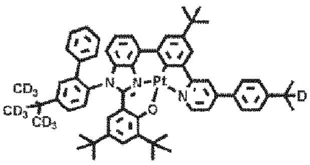
2088

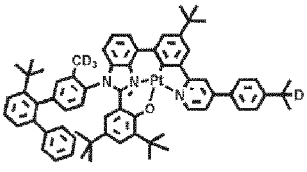
2089

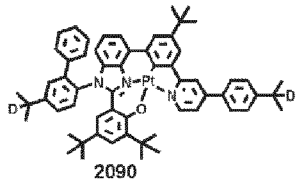
2090

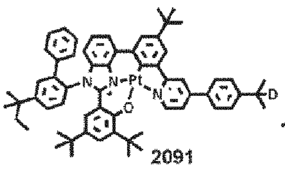
2091

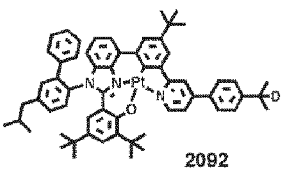
2092

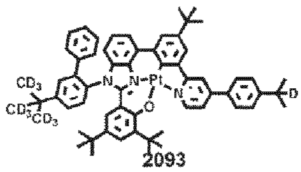
2093

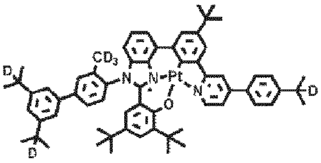
2094

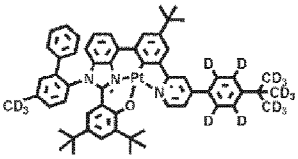
2095

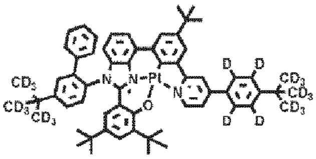
2096

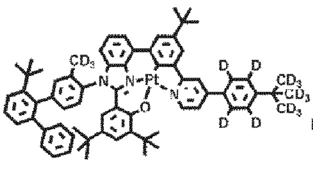
2097

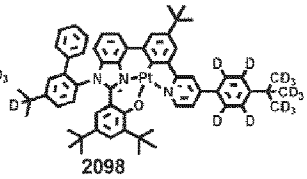
2098

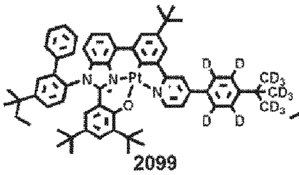
2099

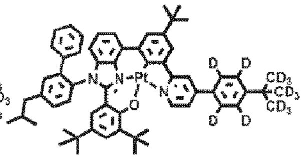
2100

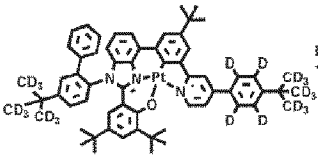
2101

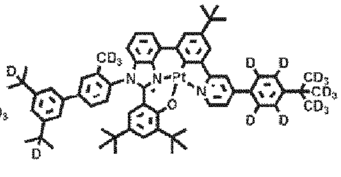
2102

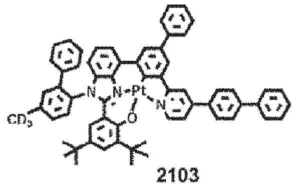
2103
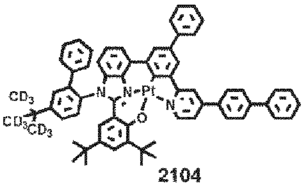
2104
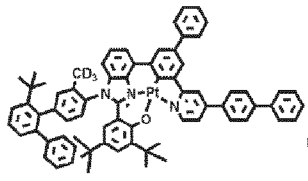
2105
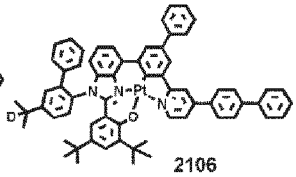
2106

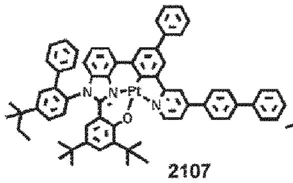
2107
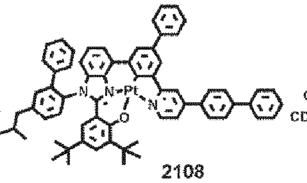
2108
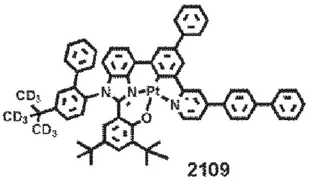
2109
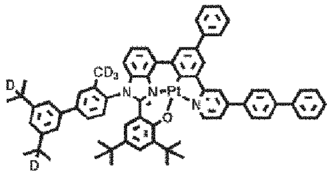
2110

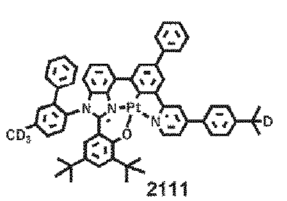
2111
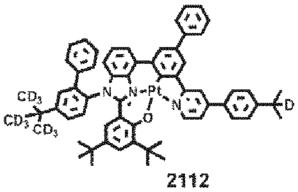
2112
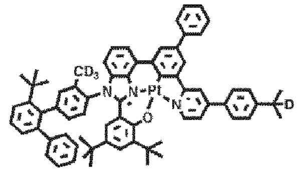
2113
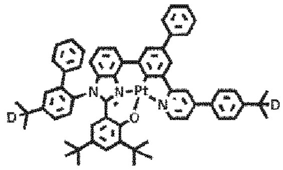
2114

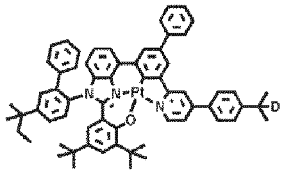
2115
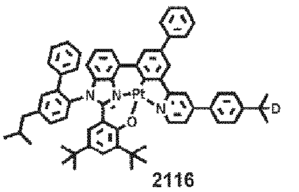
2116
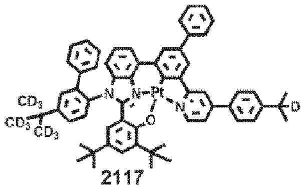
2117
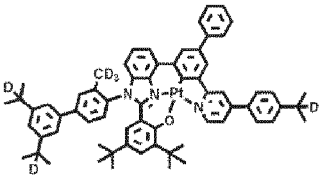
2118

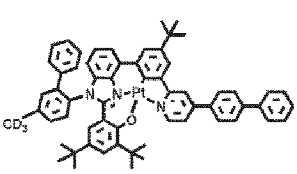
2119
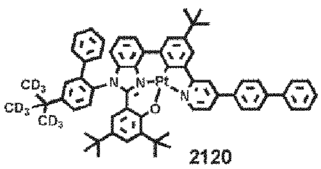
2120
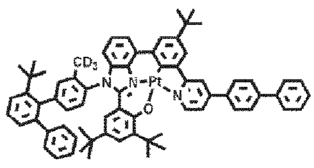
2121
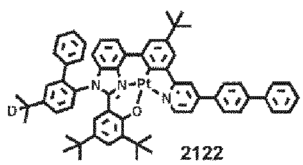
2122

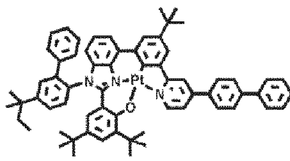
2123
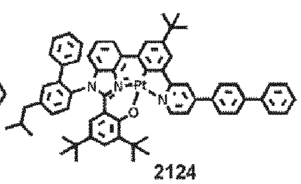
2124
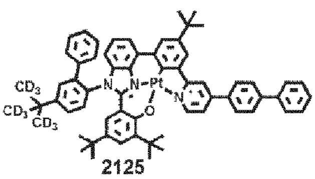
2125
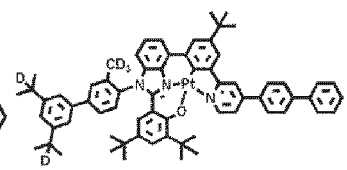
2126

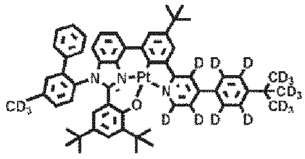
2127

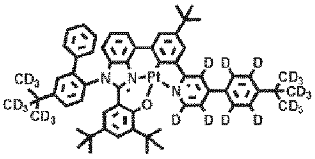
2128

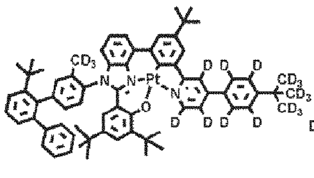
2129

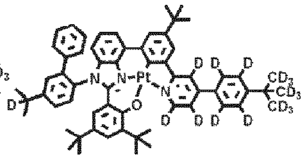
2130

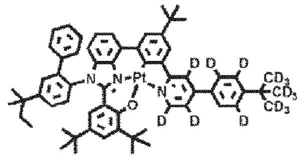
2131

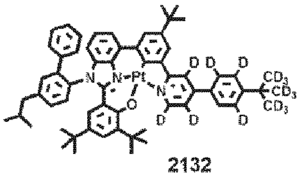
2132

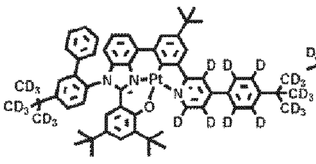
2133

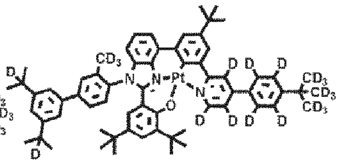
2134

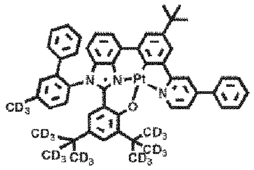
2135

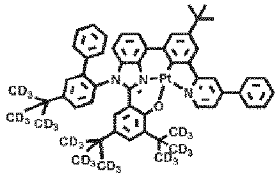
2136

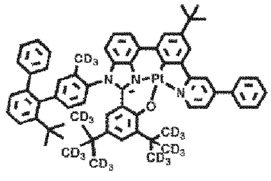
2137

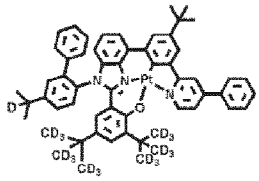
2138

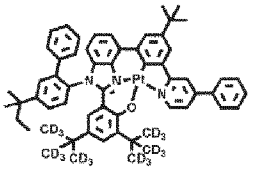
2139

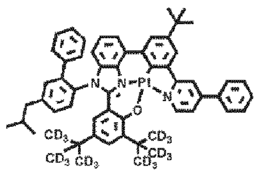
2140

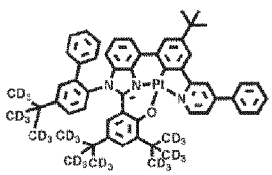
2141

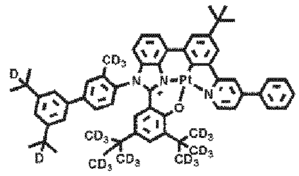
2142

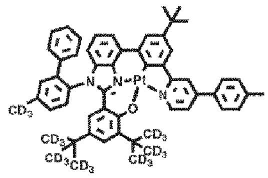
2143

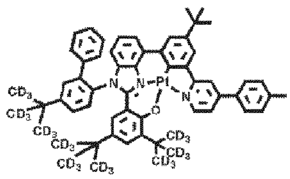
2144

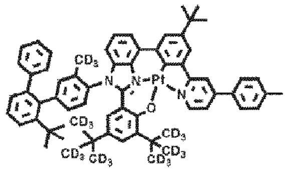
2145

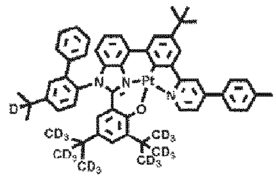
2146

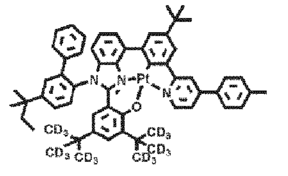

2147

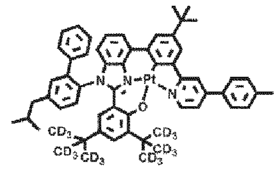

2148

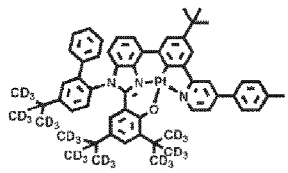

2149

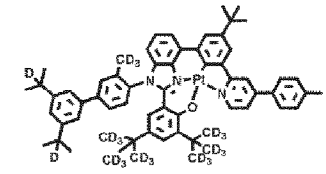

2150

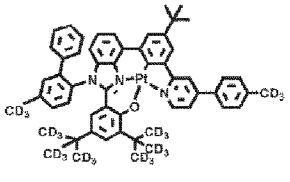

2151

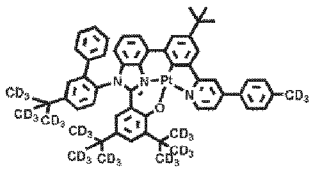

2152

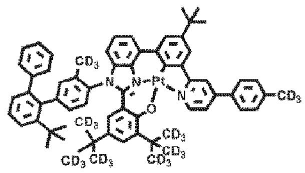

2153

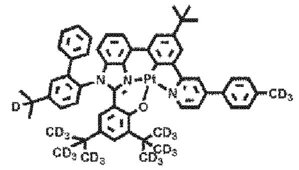

2154

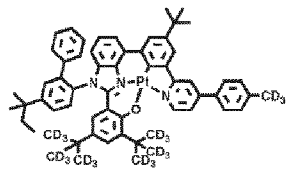

2155

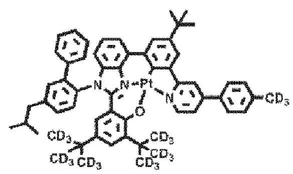

2156

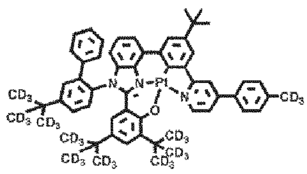

2157

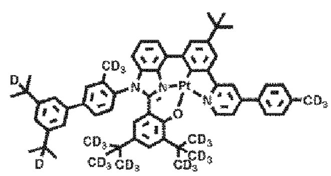

2158

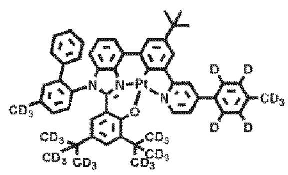

2159

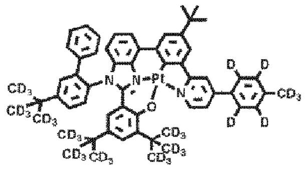

2160

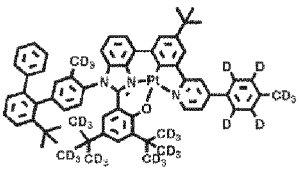

2161

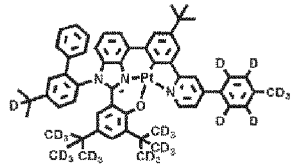

2162

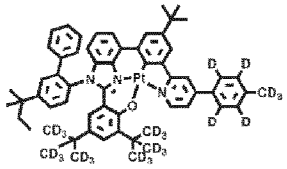

2163

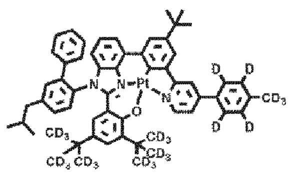

2164

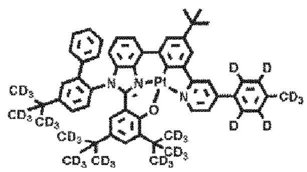

2165

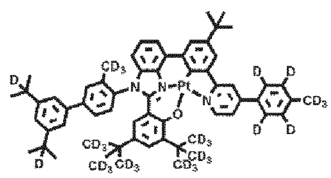

2166

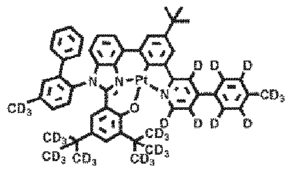

2167

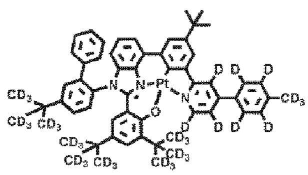

2168

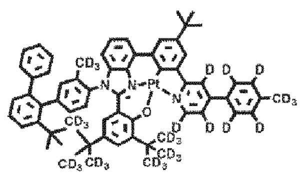

2169

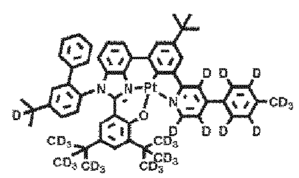

2170

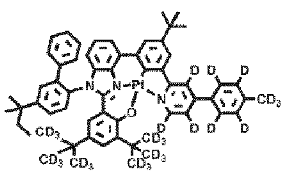

**2171**

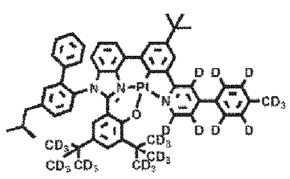

**2172**

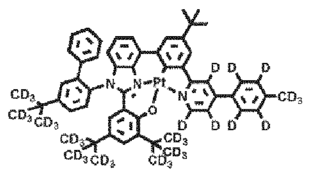

**2173**

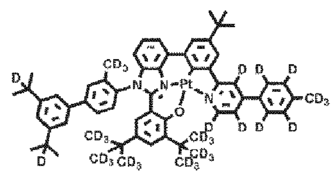

**2174**

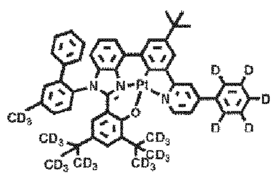

**2175**

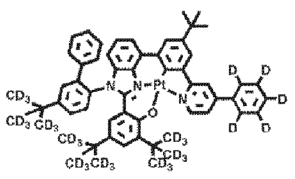

**2176**

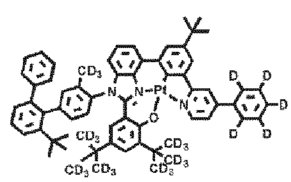

**2177**

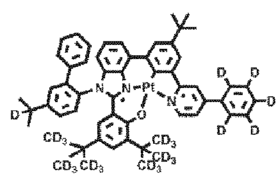

**2178**

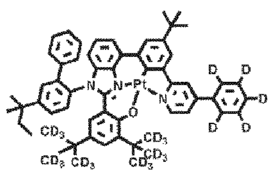

**2179**

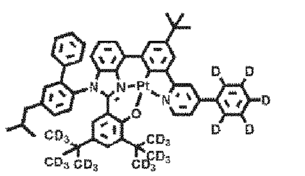

**2180**

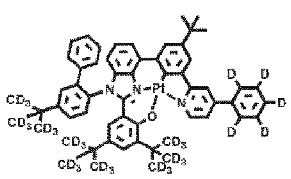

**2181**

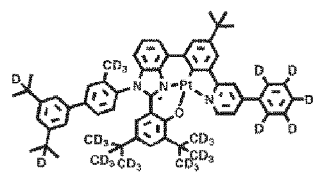

**2182**

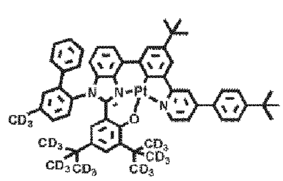

**2183**

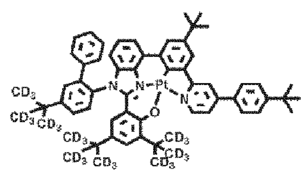

**2184**

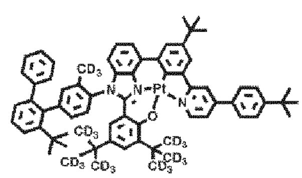

**2185**

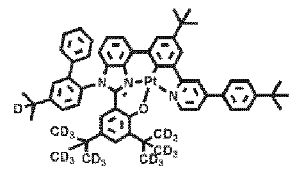

**2186**

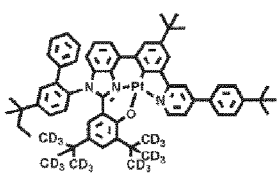

**2187**

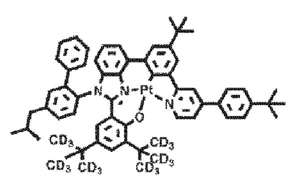

**2188**

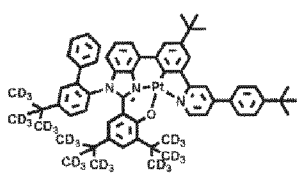

**2189**

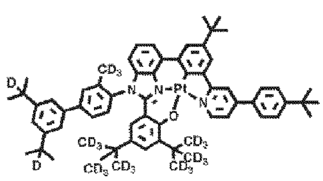

**2190**

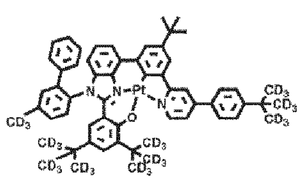

**2191**

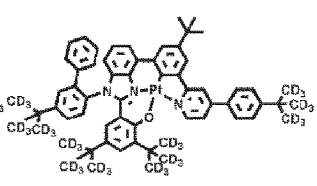

**2192**

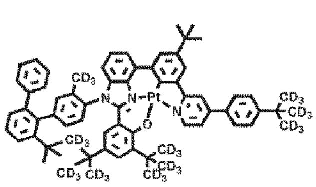

**2193**

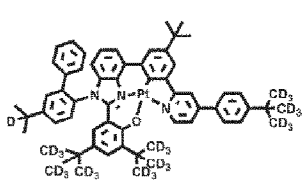

**2194**

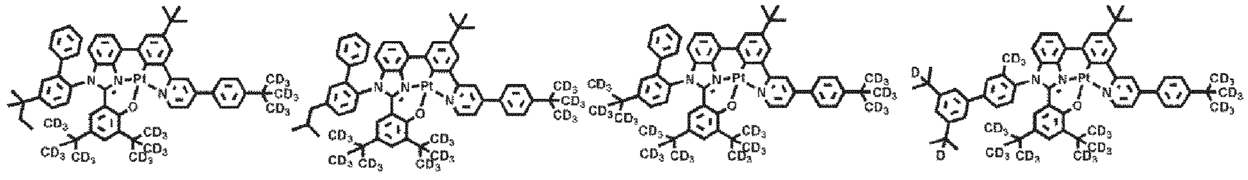

2195 2196 2197 2198

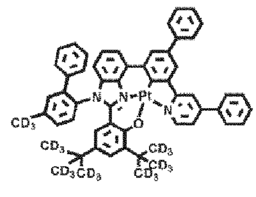

2199

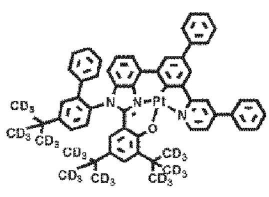

2200

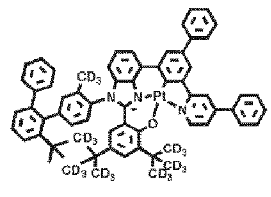

2201

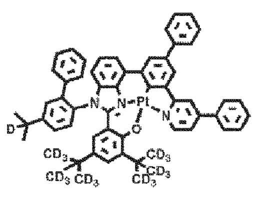

2202

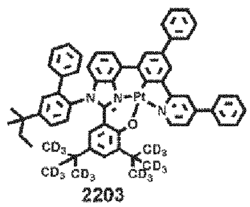

2203

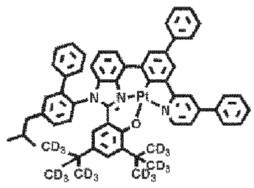

2204

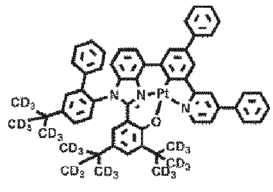

2205

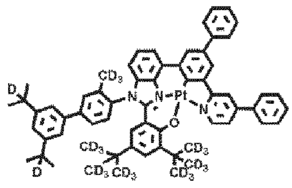

2206

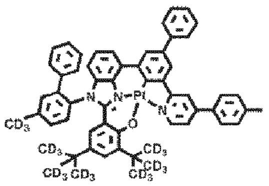

2207

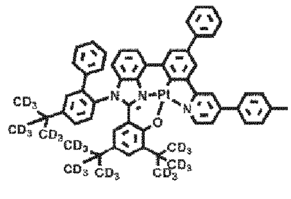

2208

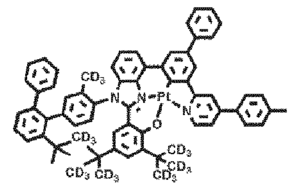

2209

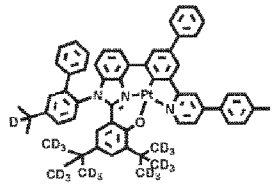

2210

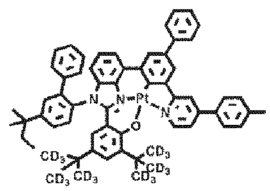

2211

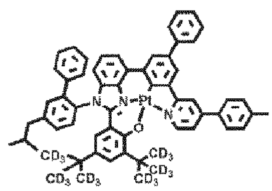

2212

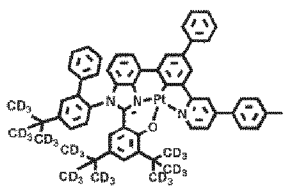

2213

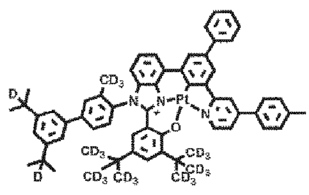

2214

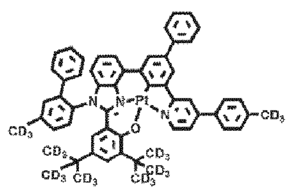

2215

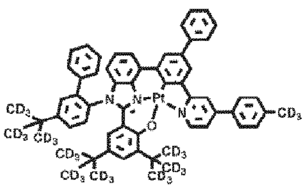

2216

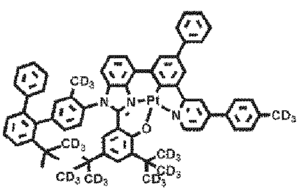

2217

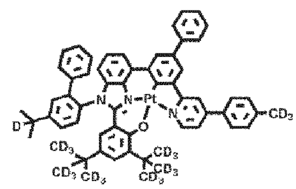

2218

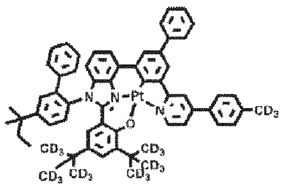
2219

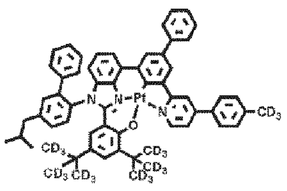
2220

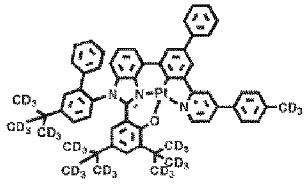
2221

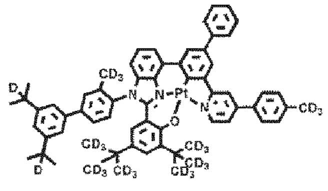
2222

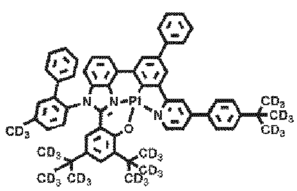
2223

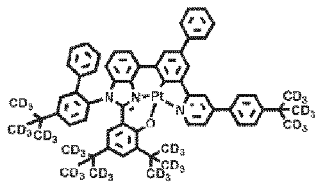
2224

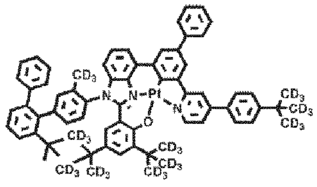
2225

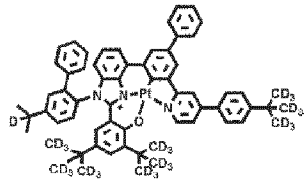
2226

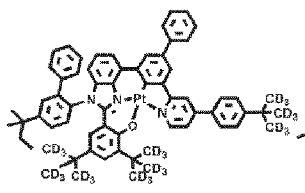
2227

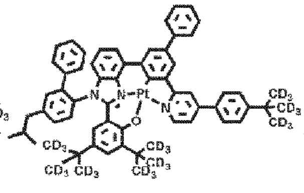
2228

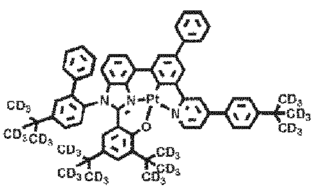
2229

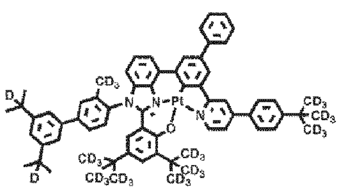
2230

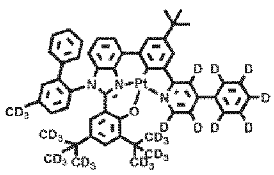
2231

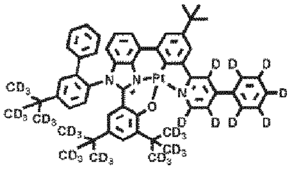
2232

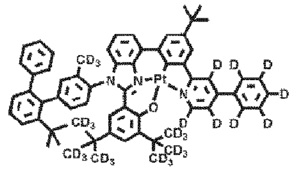
2233

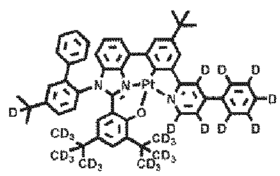
2234

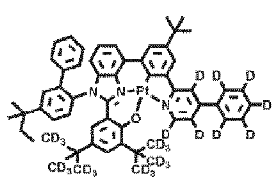
2235

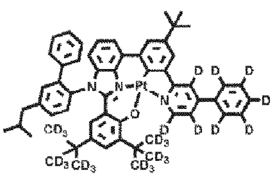
2236

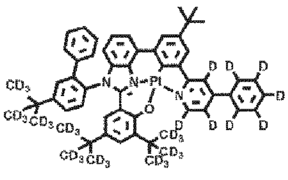
2237

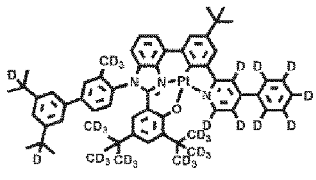
2238

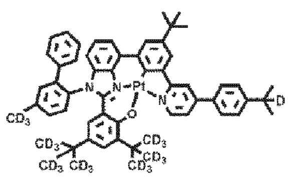
2239

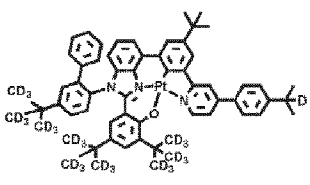
2240

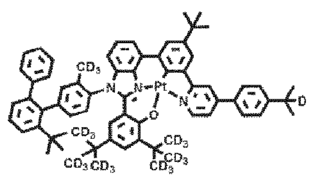
2241

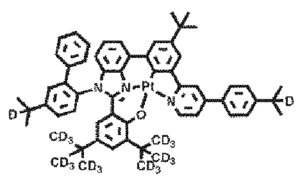
2242

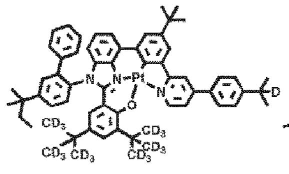
2243
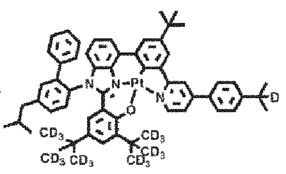
2244
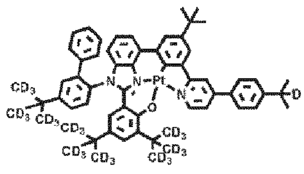
2245
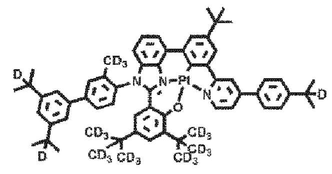
2246

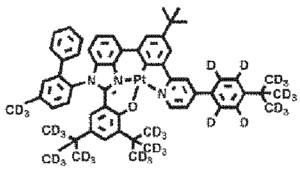
2247
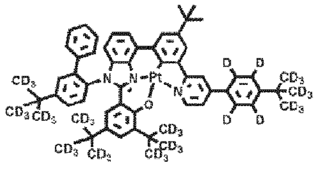
2248
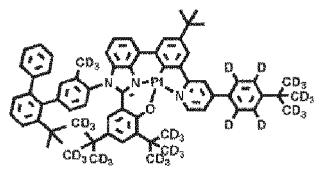
2249
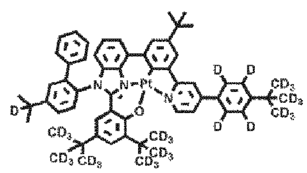
2250

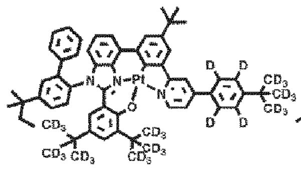
2251
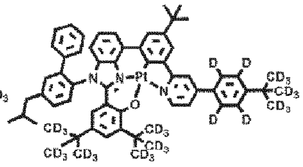
2252
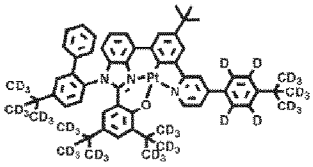
2253
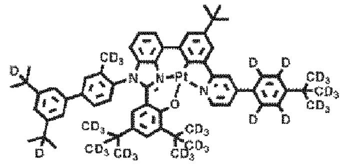
2254

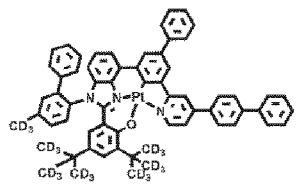
2255
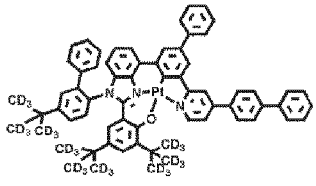
2256
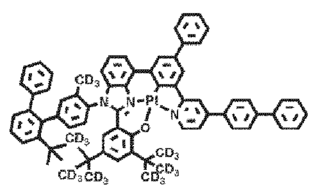
2257
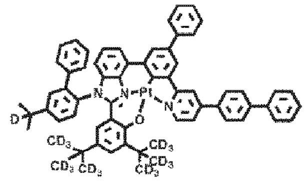
2258

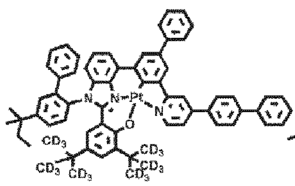
2259
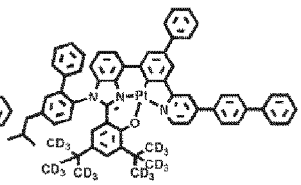
2260
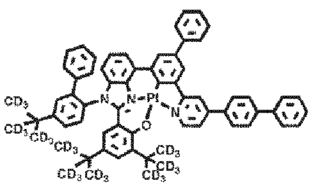
2261
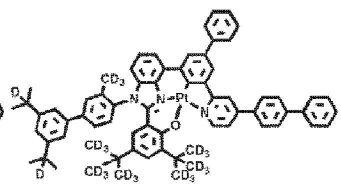
2262

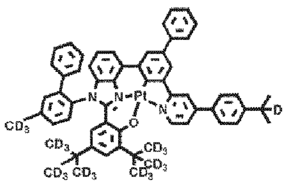
2263
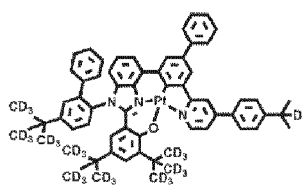
2264
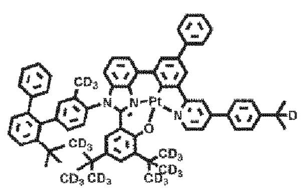
2265
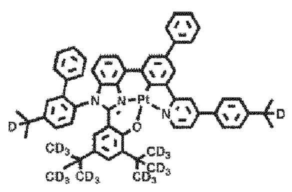
2266

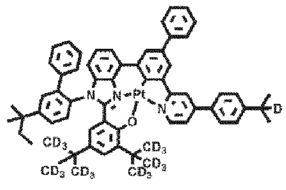
2267

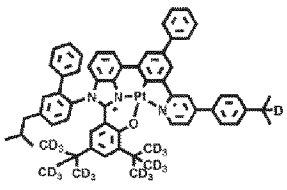
2268

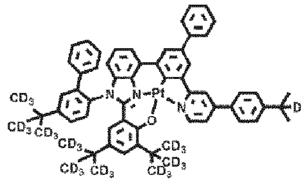
2269

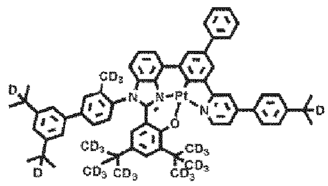
2270

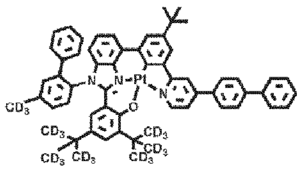
2271

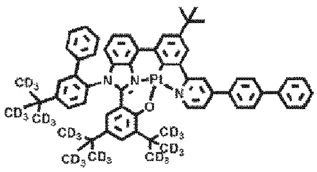
2272

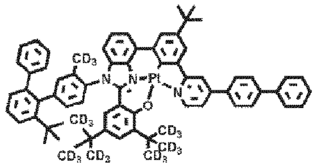
2273

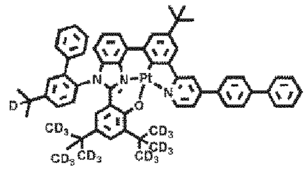
2274

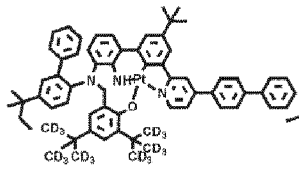
2275

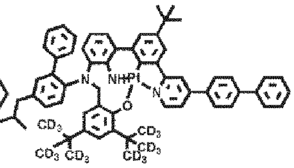
2276

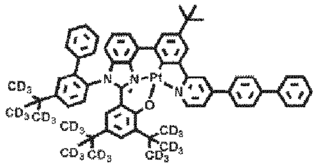
2277

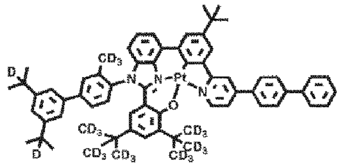
2278

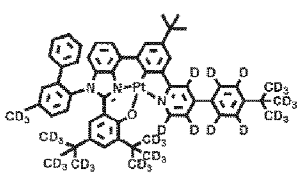
2279

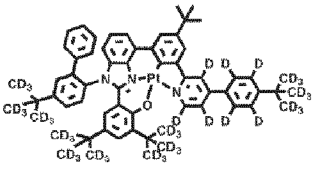
2280

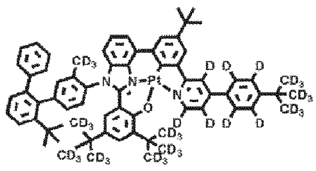
2281

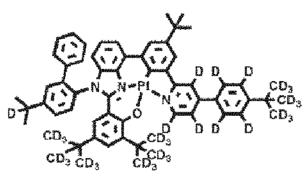
2282

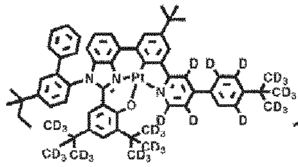
2283

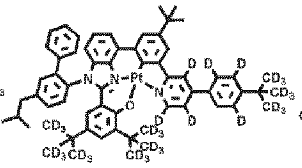
2284

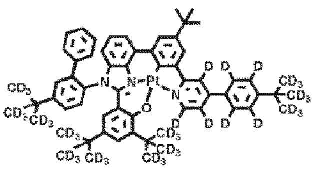
2285

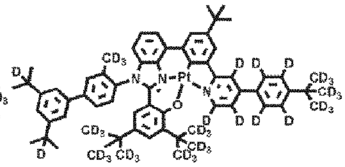
2286

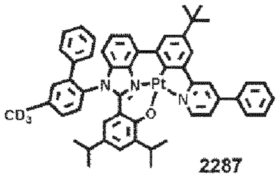
2287
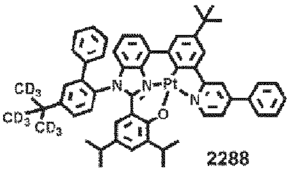
2288
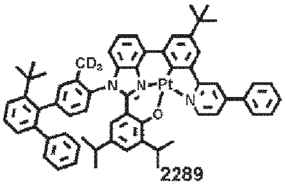
2289
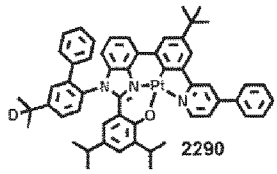
2290

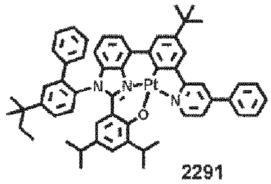
2291
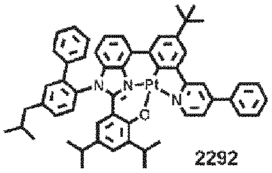
2292
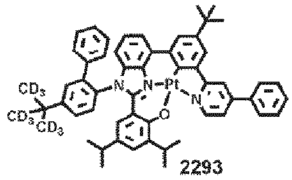
2293
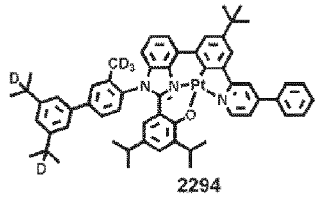
2294

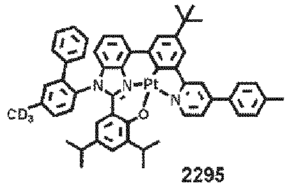
2295
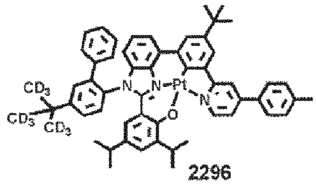
2296
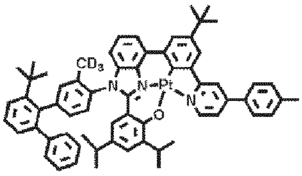
2297
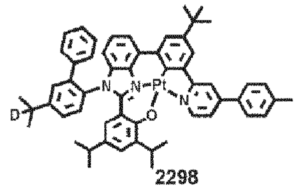
2298

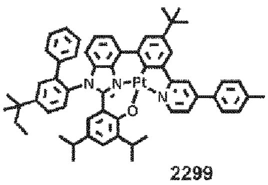
2299
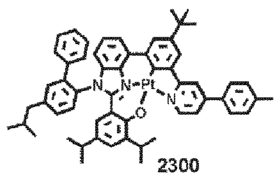
2300
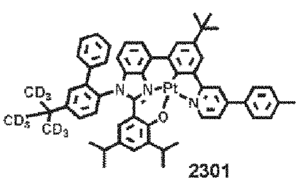
2301
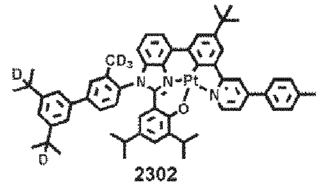
2302

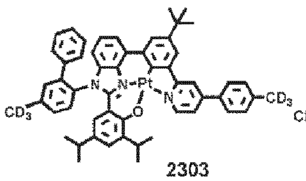
2303
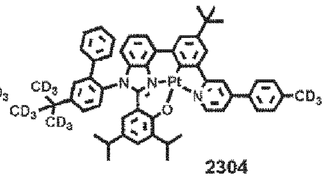
2304
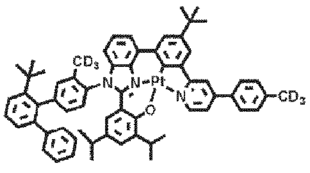
2305
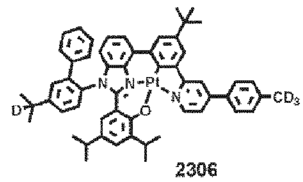
2306

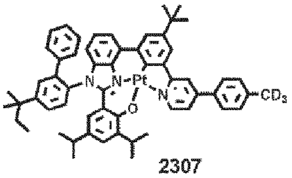
2307
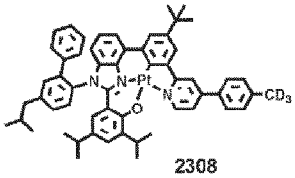
2308
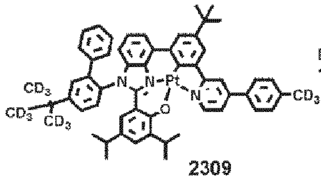
2309
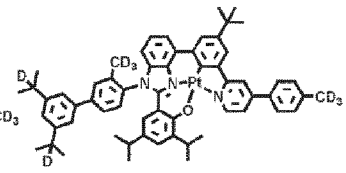
2310

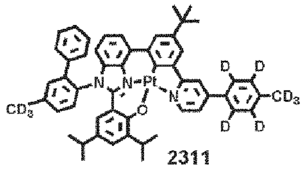
2311

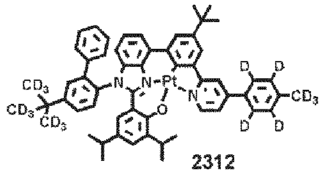
2312

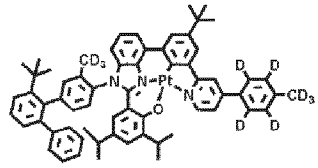
2313

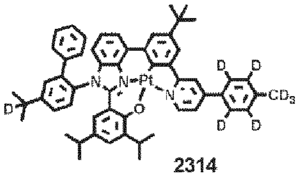
2314

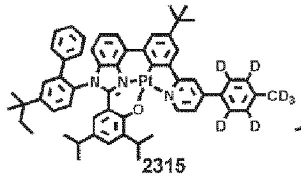
2315

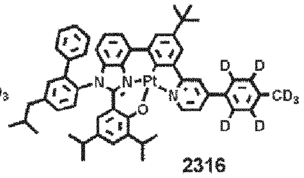
2316

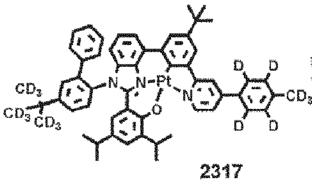
2317

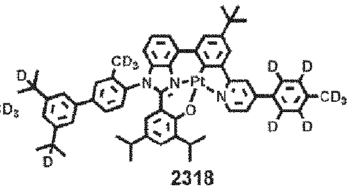
2318

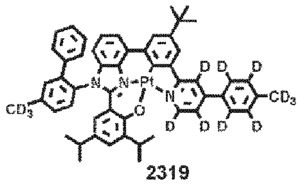
2319

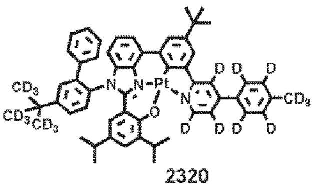
2320

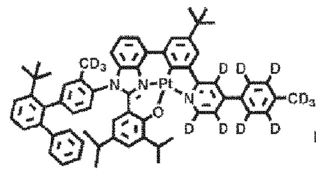
2321

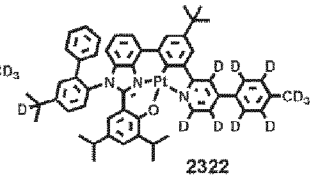
2322

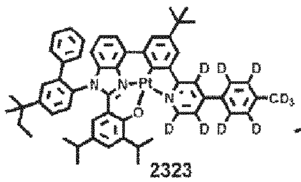
2323

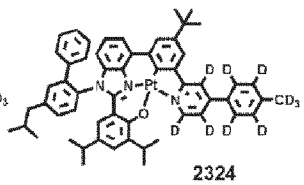
2324

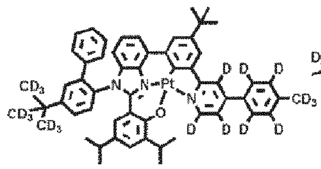
2325

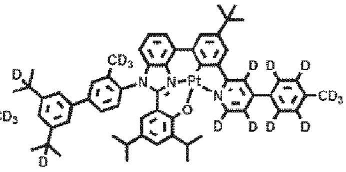
2326

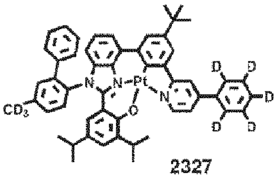
2327

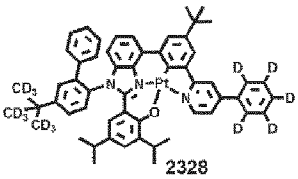
2328

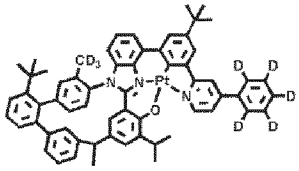
2329

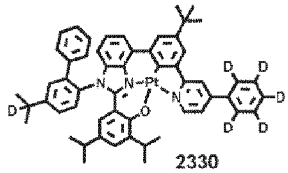
2330

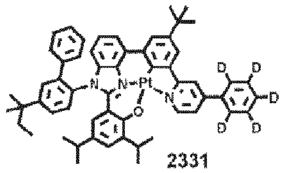
2331

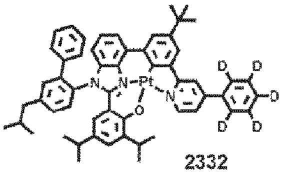
2332

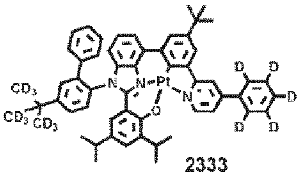
2333

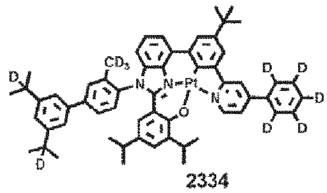
2334

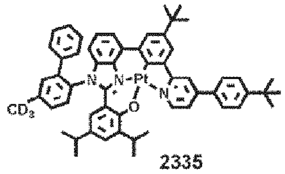
2335

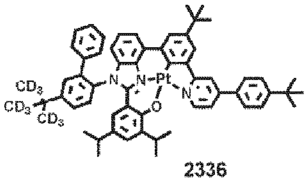
2336

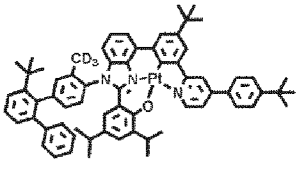
2337

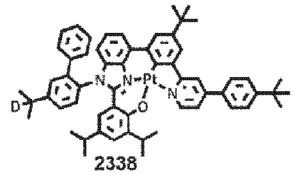
2338

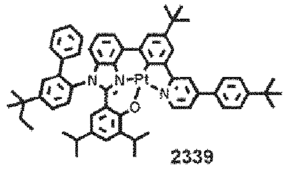
2339

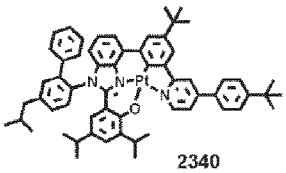
2340

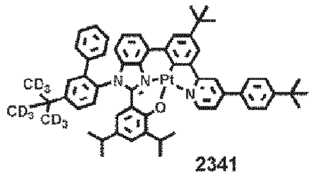
2341

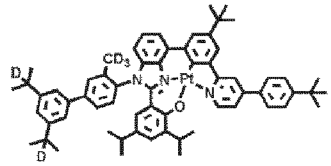
2342

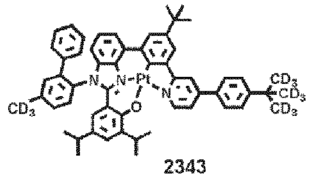
2343

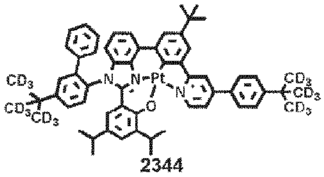
2344

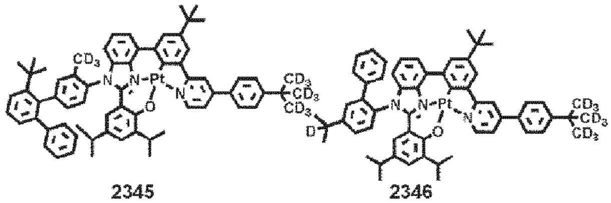
2345

2346

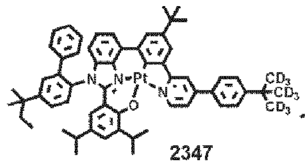
2347

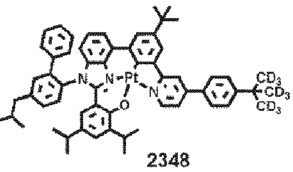
2348

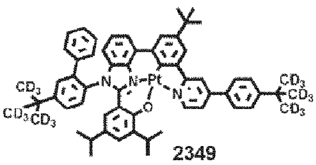
2349

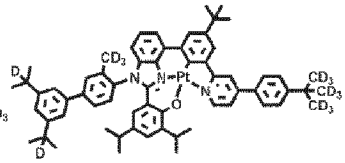
2350

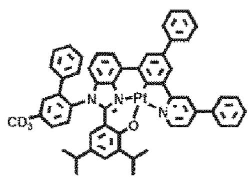
2351

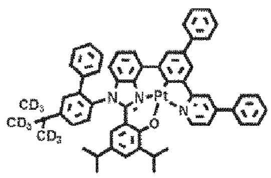
2352

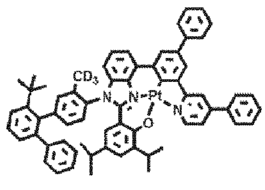
2353

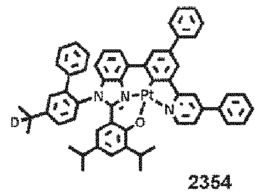
2354

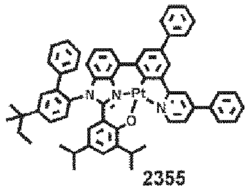
2355

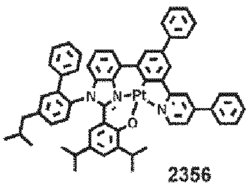
2356

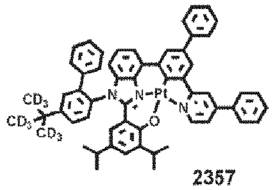
2357

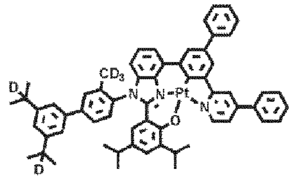
2358

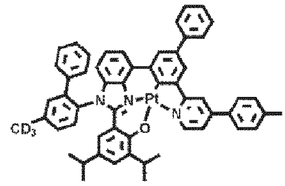
2359

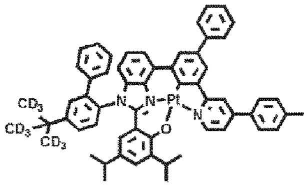
2360

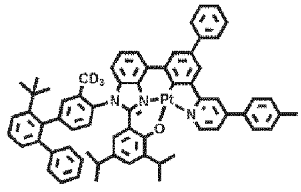
2361

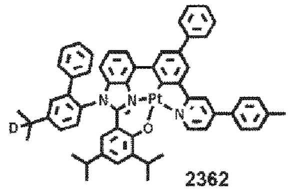
2362

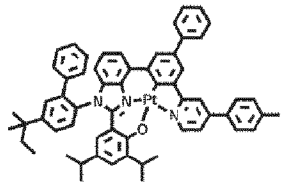
2363

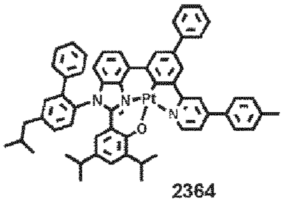
2364

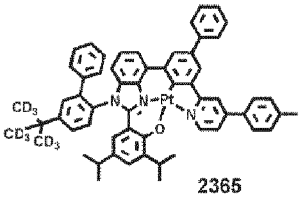
2365

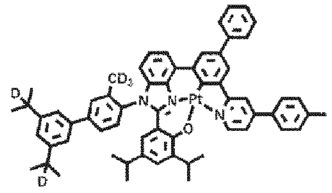
2366

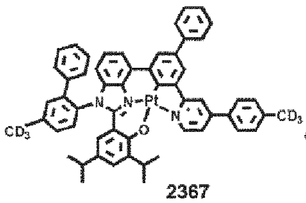
2367

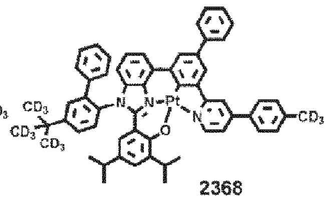
2368

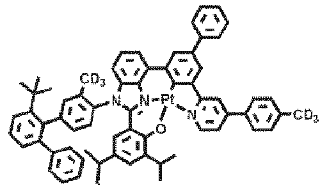
2369

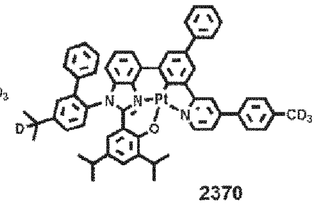
2370

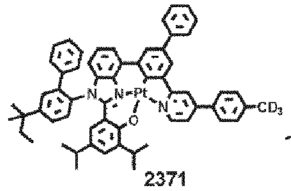
2371

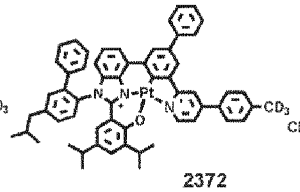
2372

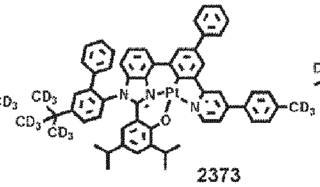
2373

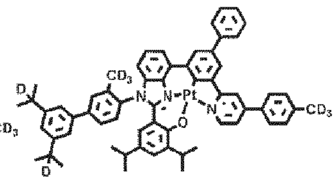
2374

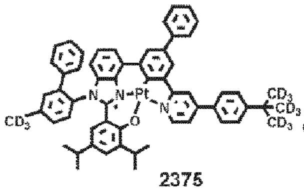
2375

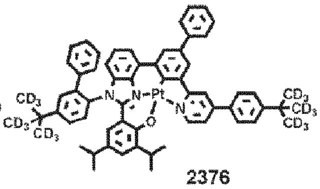
2376

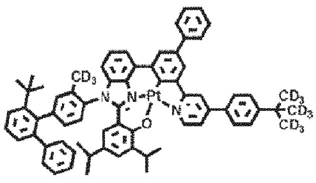
2377

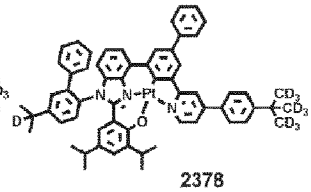
2378

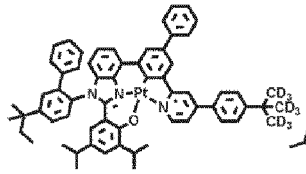
2379

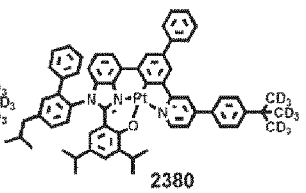
2380

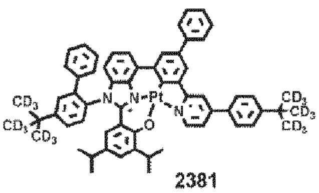
2381

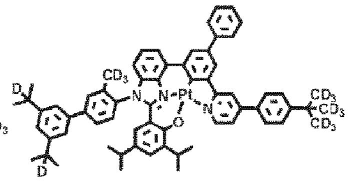
2382

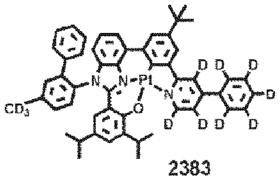
2383

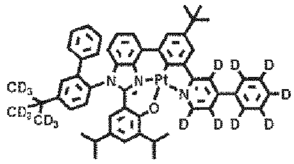
2384

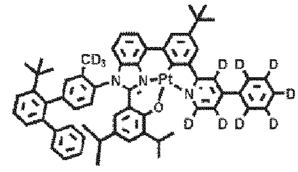
2385

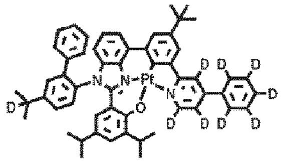
2386

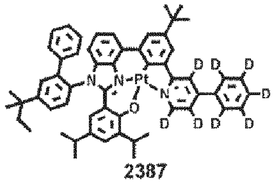
2387

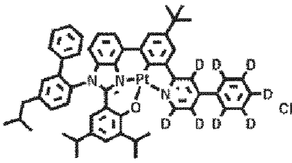
2388

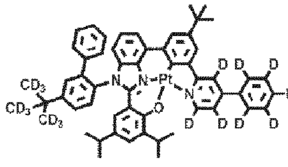
2389

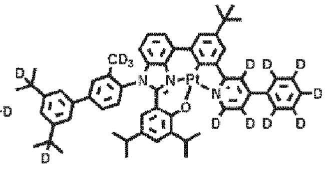
2390

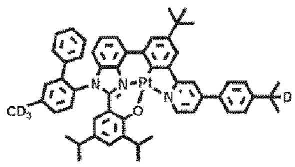
2391

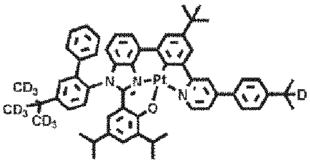
2392

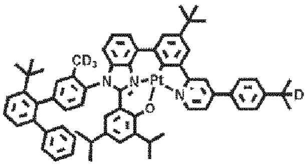
2393

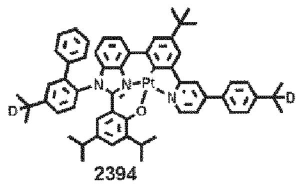
2394

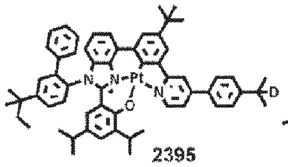
2395

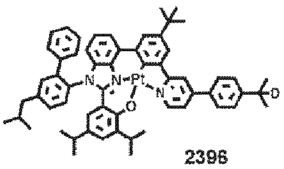
2396

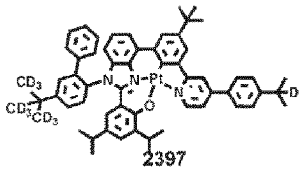
2397

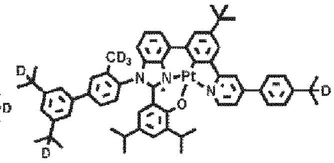
2398

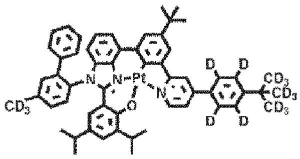
2399

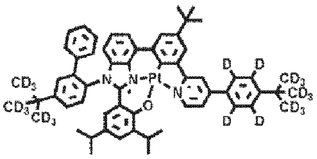
2400

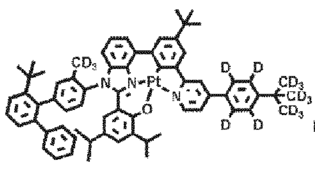
2401

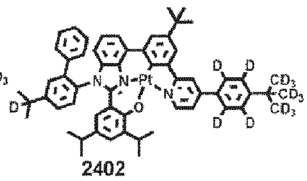
2402

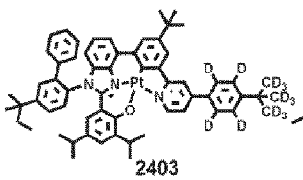
2403

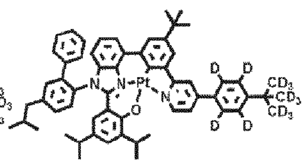
2404

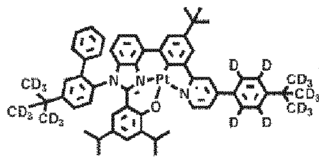
2405

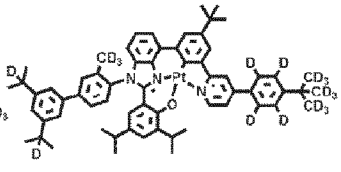
2406

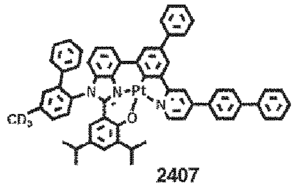

2407

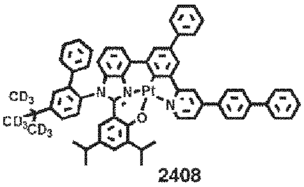

2408

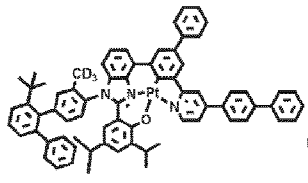

2409

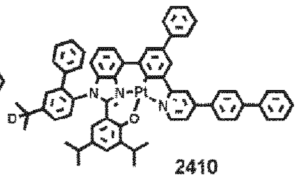

2410

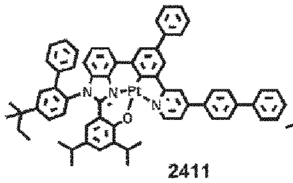

2411

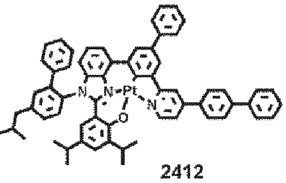

2412

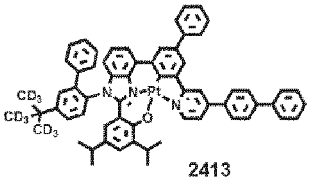

2413

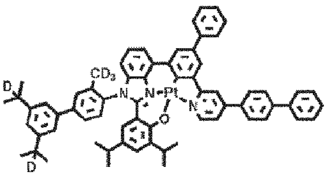

2414

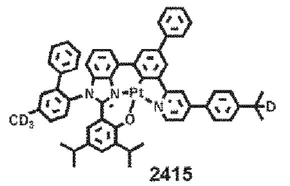

2415

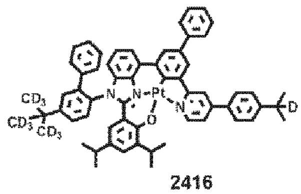

2416

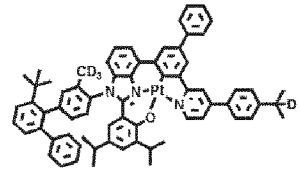

2417

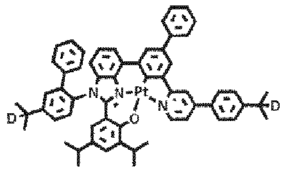

2418

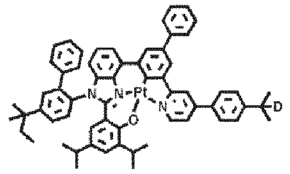

2419

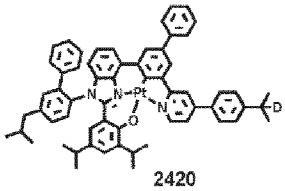

2420

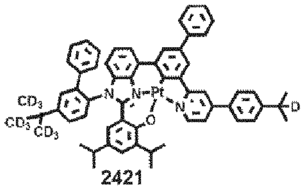

2421

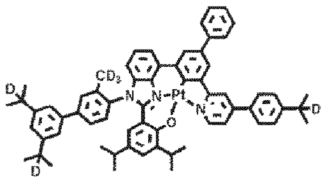

2422

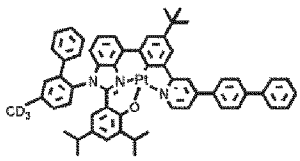

2423

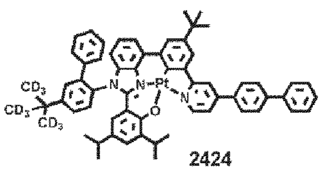

2424

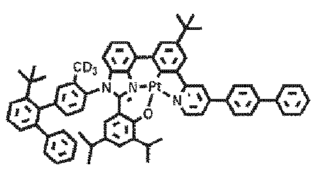

2425

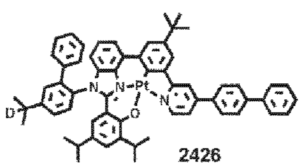

2426

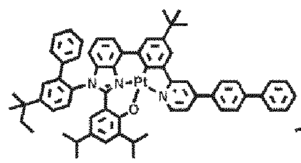

2427

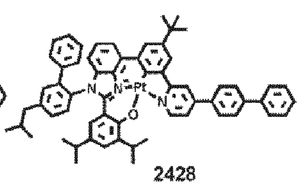

2428

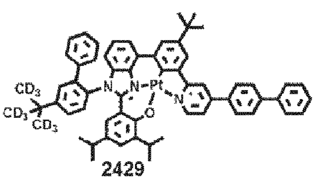

2429

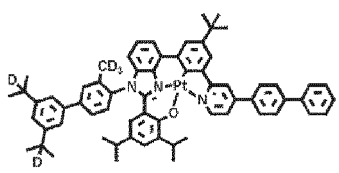

2430

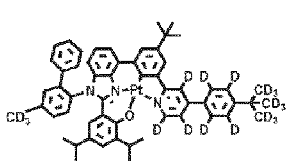
2431
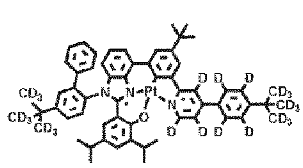
2432
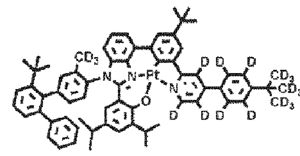
2433
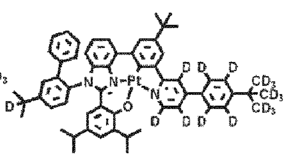
2434
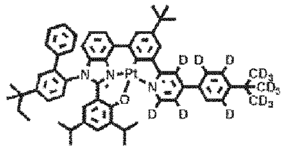
2435
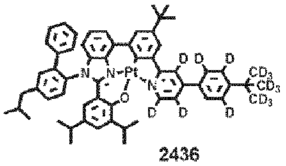
2436
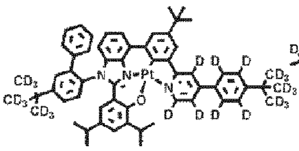
2437
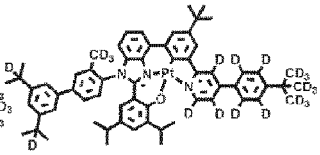
2438
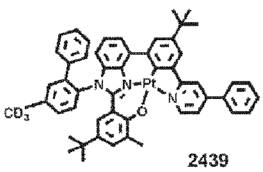
2439
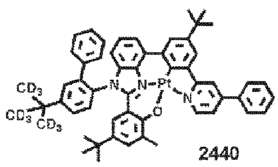
2440
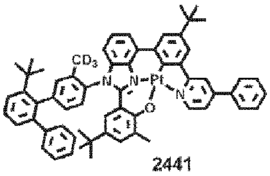
2441
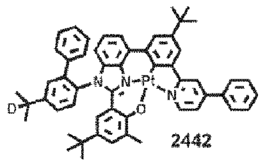
2442
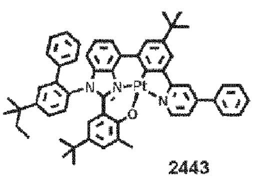
2443
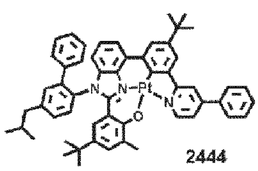
2444
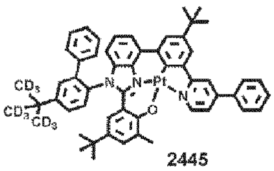
2445
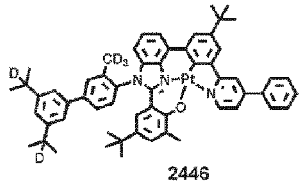
2446
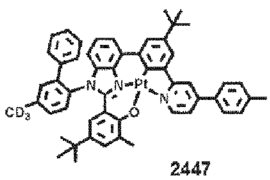
2447
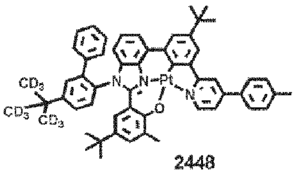
2448
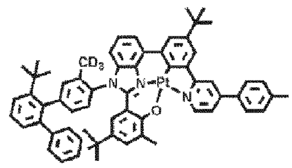
2449
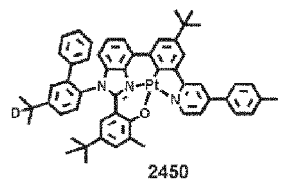
2450
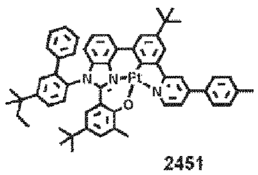
2451
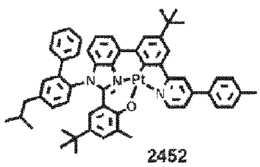
2452
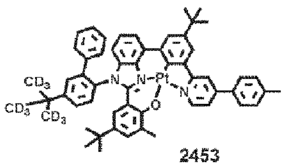
2453
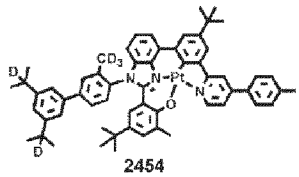
2454
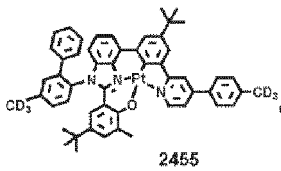
2455
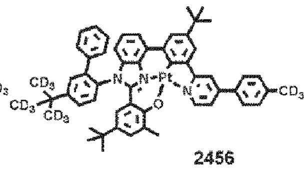
2456
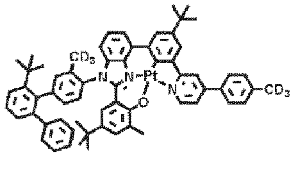
2457
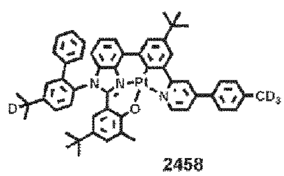
2458
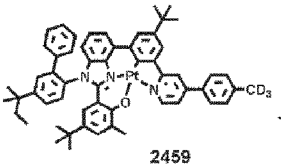
2459
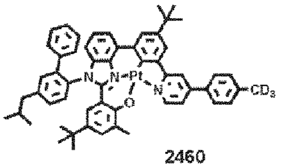
2460
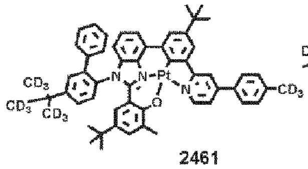
2461
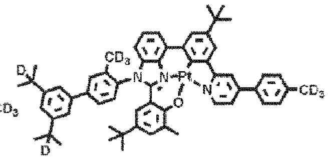
2462

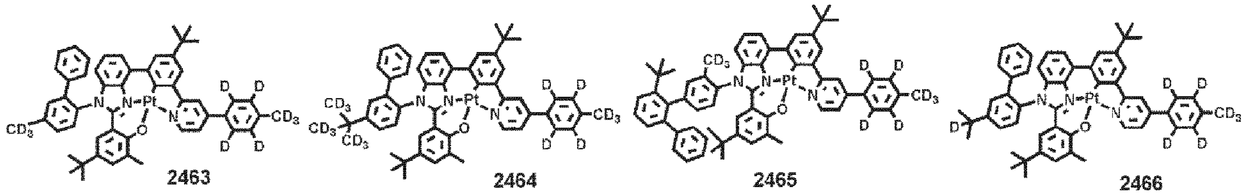

2463 2464 2465 2466

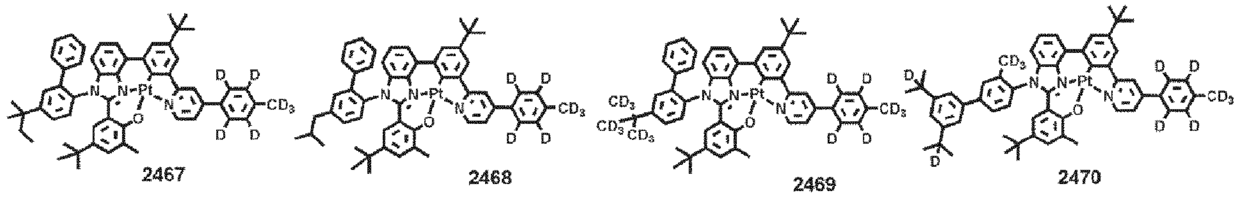

2467 2468 2469 2470

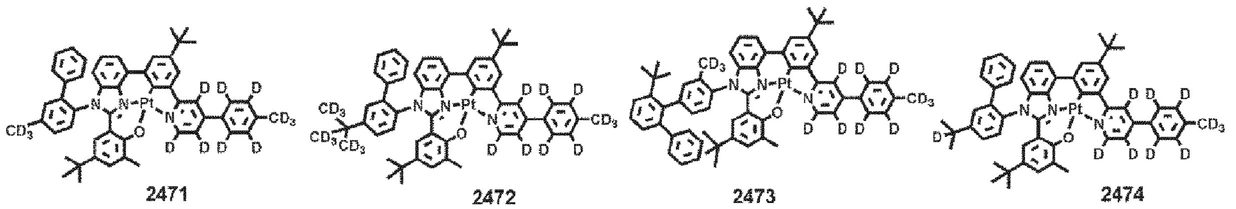

2471 2472 2473 2474

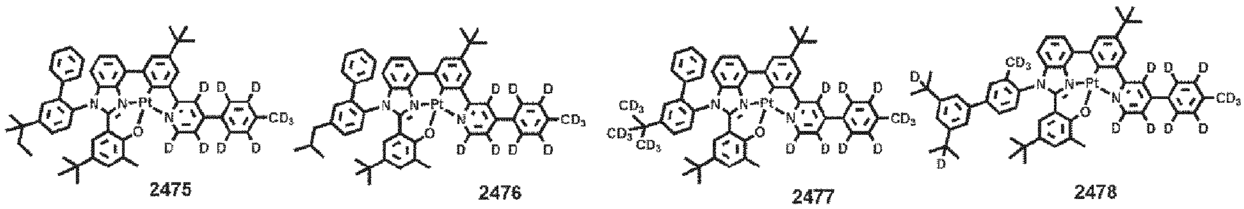

2475 2476 2477 2478

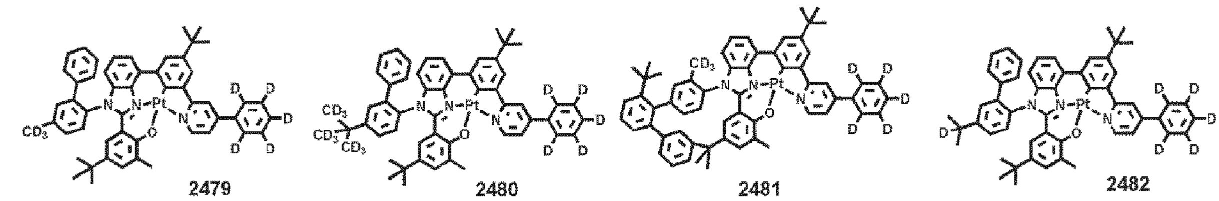

2479 2480 2481 2482

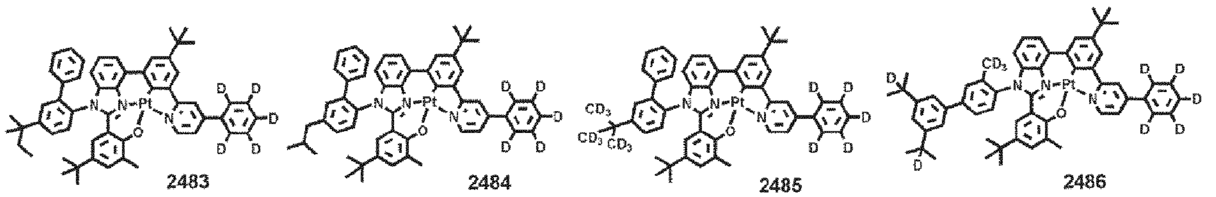

2483 2484 2485 2486

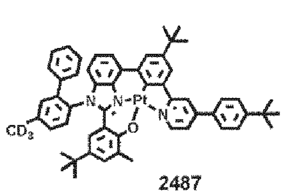
2487

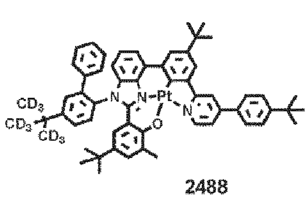
2488

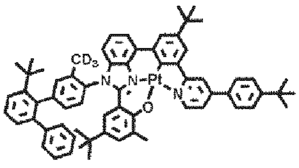
2489

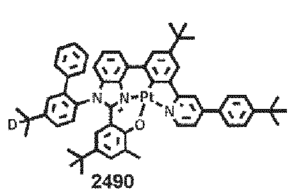
2490

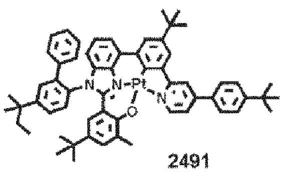
2491

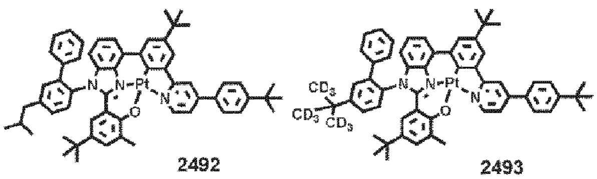
2492

2493

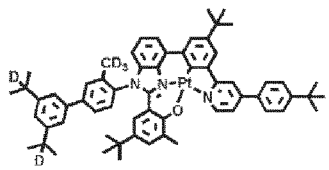
2494

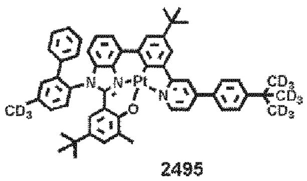
2495

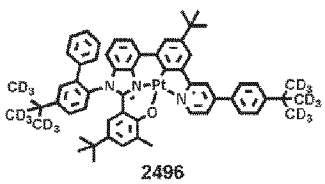
2496

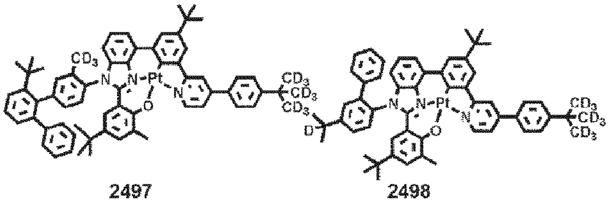
2497

2498

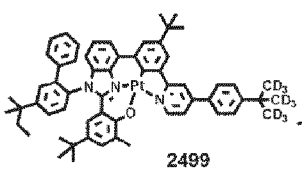
2499

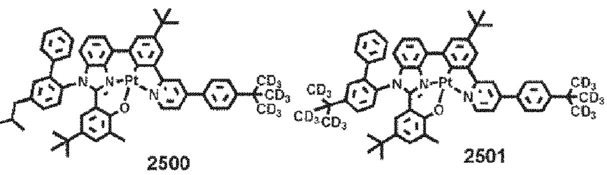
2500

2501

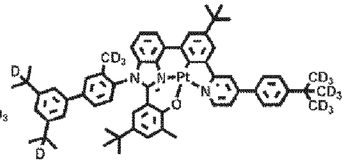
2502

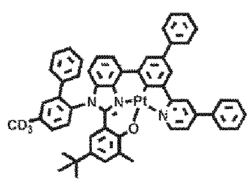
2503

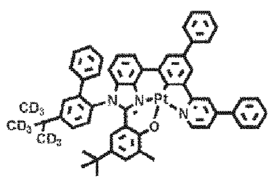
2504

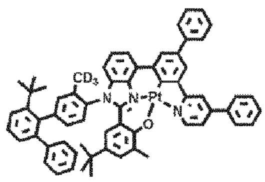
2505

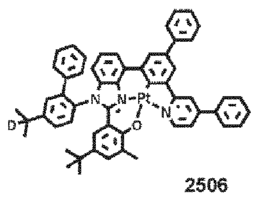
2506

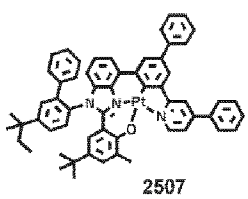
2507

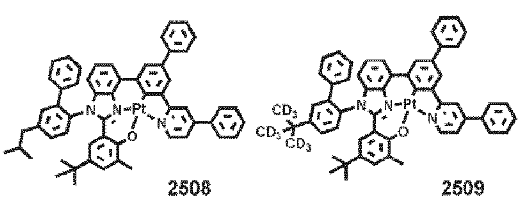
2508

2509

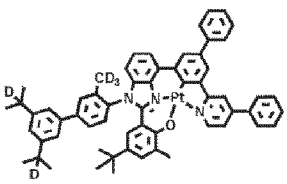
2510

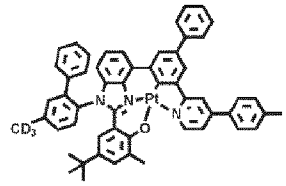
2511

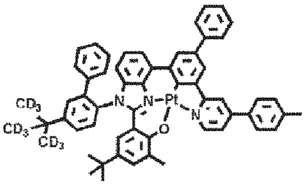
2512

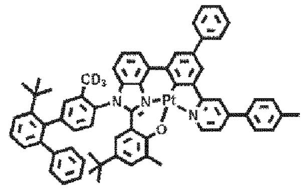
2513

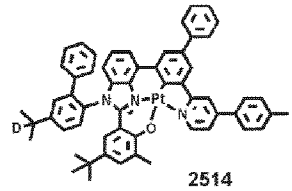
2514

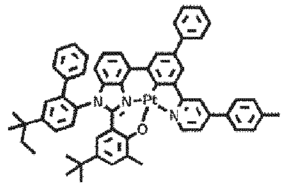
2515

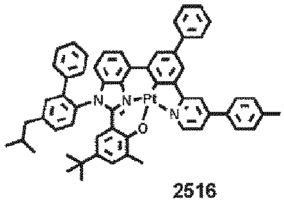
2516

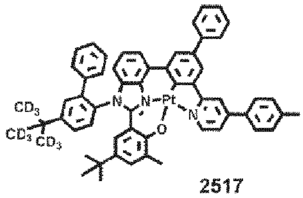
2517

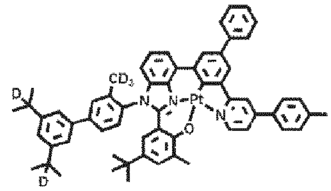
2518

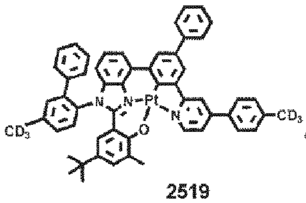
2519

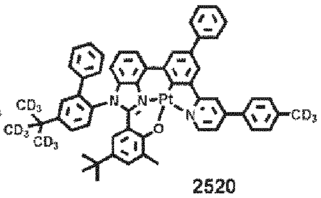
2520

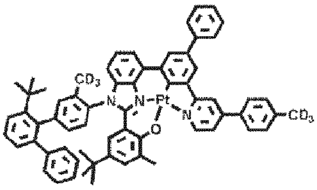
2521

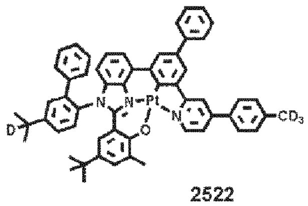
2522

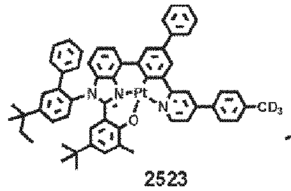
2523

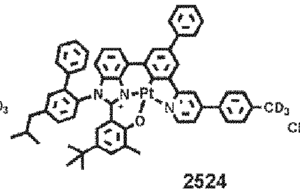
2524

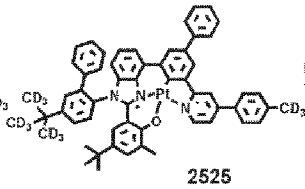
2525

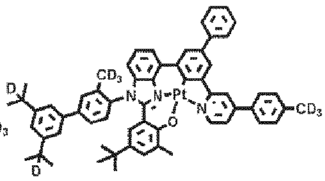
2526

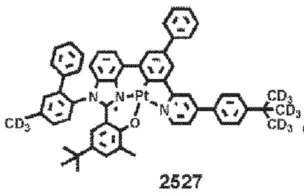
2527

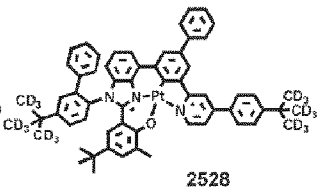
2528

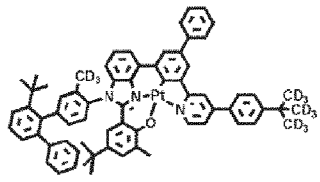
2529

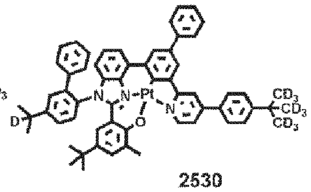
2530

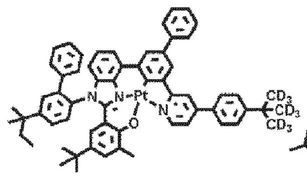
2531

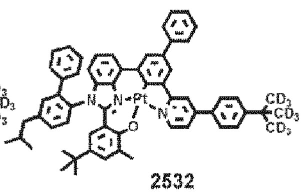
2532

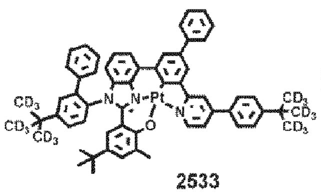
2533

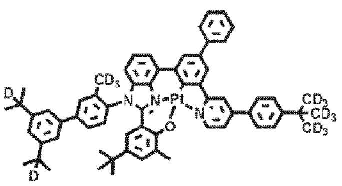
2534

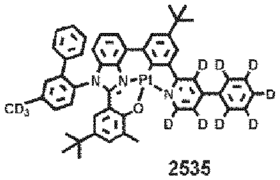
2535

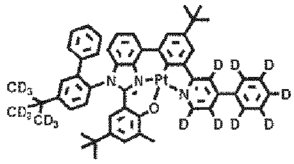
2536

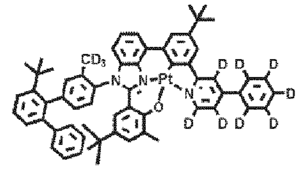
2537

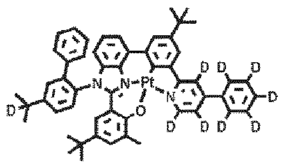
2538

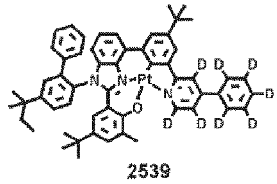
2539

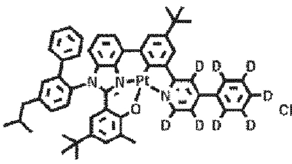
2540

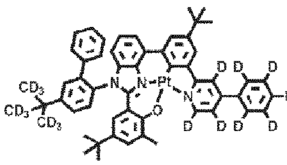
2541

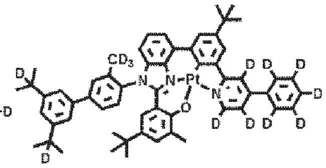
2542

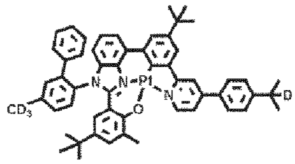
2543

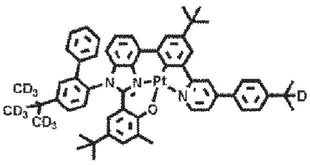
2544

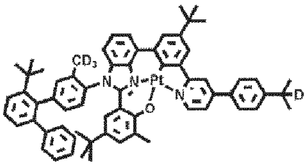
2545

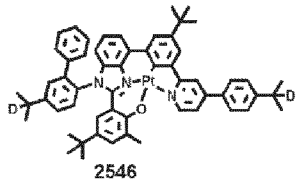
2546

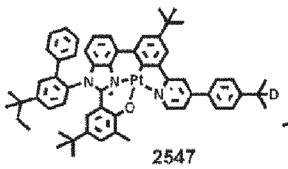
2547

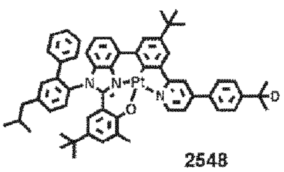
2548

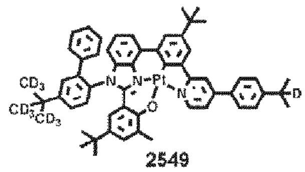
2549

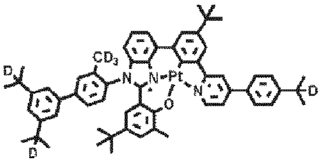
2550

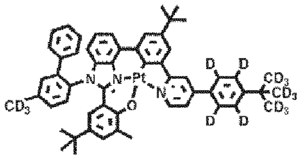
2551

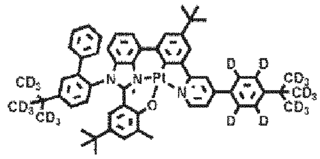
2552

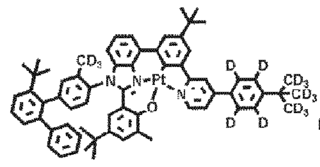
2553

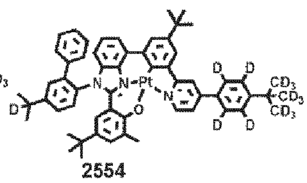
2554

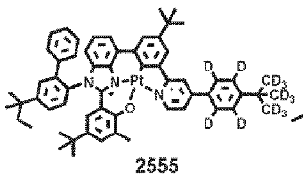
2555

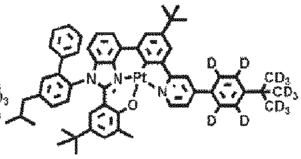
2556

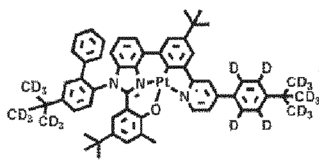
2557

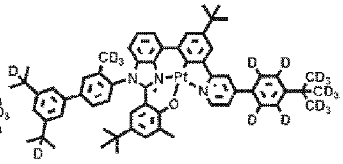
2558

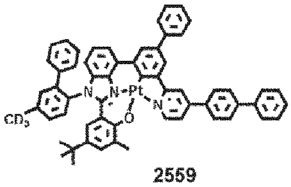
2559

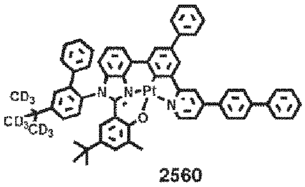
2560

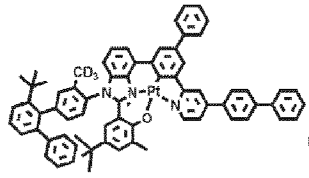
2561

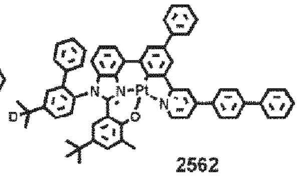
2562

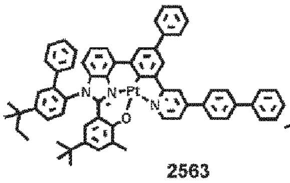
2563

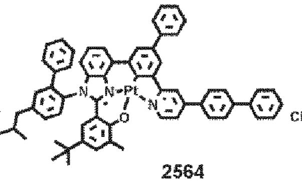
2564

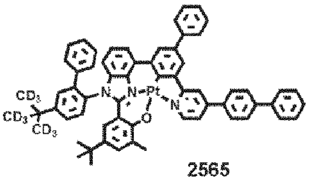
2565

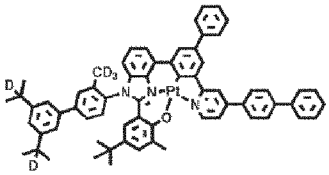
2566

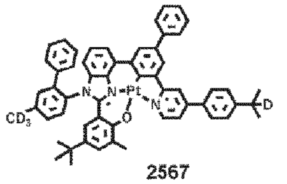
2567

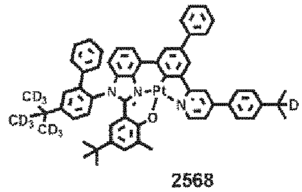
2568

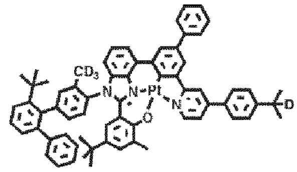
2569

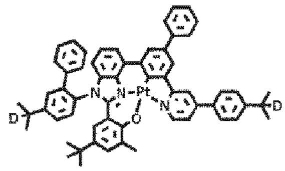
2570

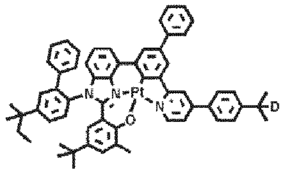
2571

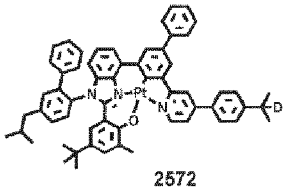
2572

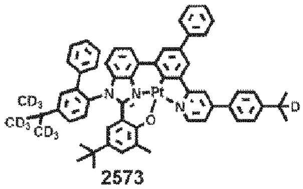
2573

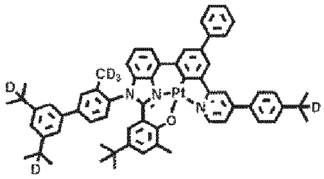
2574

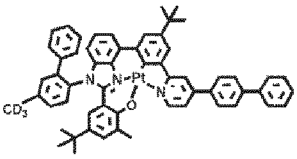
2575

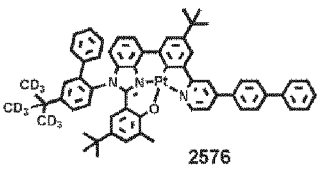
2576

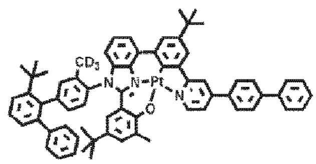
2577

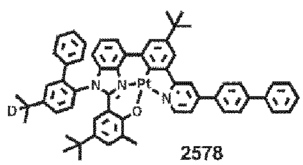
2578

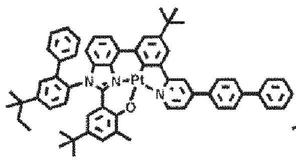
2579

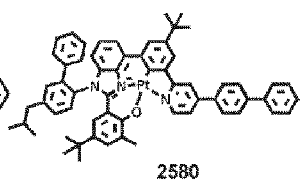
2580

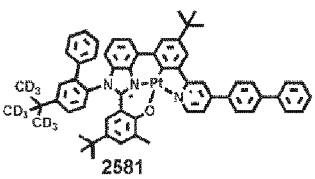
2581

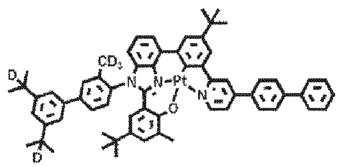
2582

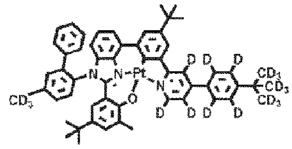
2583

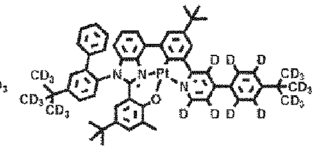
2584

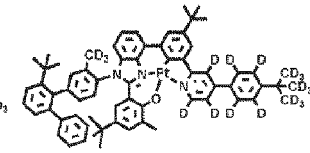
2585

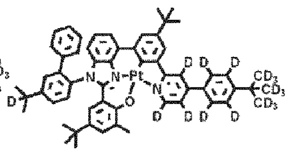
2586

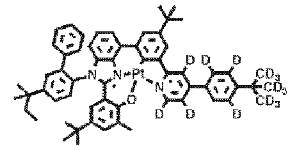
2587

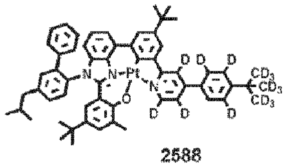
2588

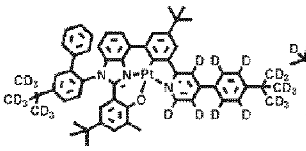
2589

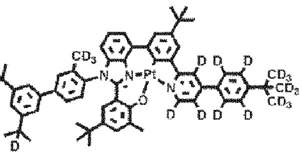
2590

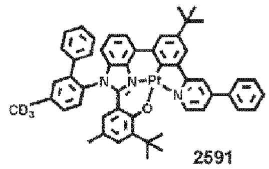
2591

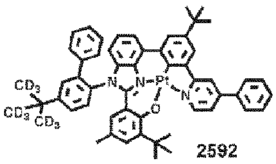
2592

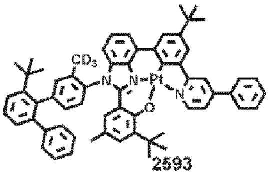
2593

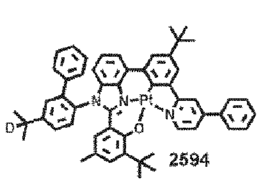
2594

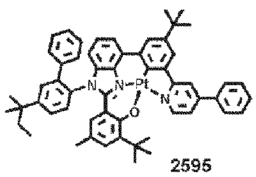
2595

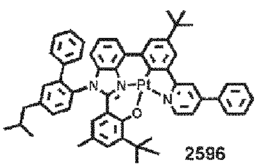
2596

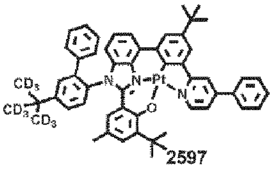
2597

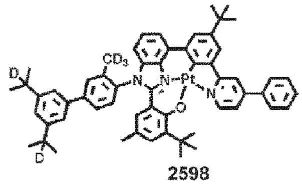
2598

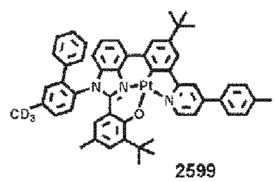
2599

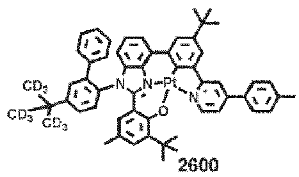
2600

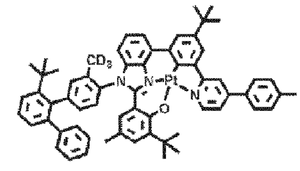
2601

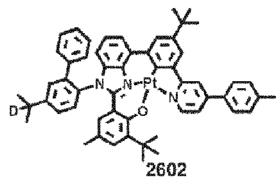
2602

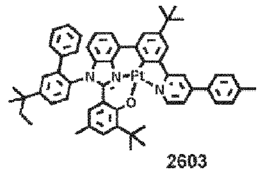
2603

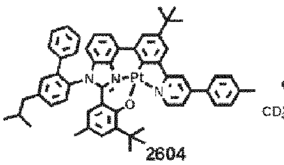
2604

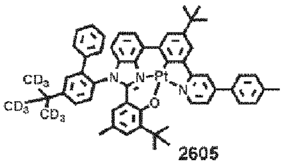
2605

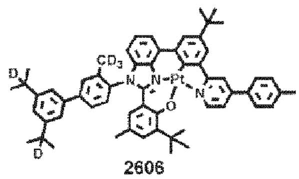
2606

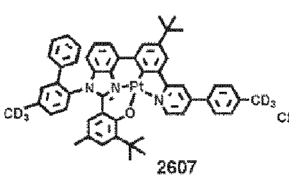
2607

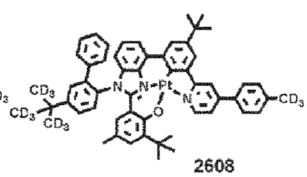
2608

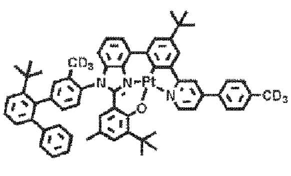
2609

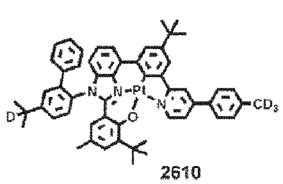
2610

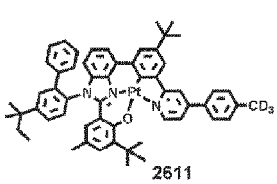
2611

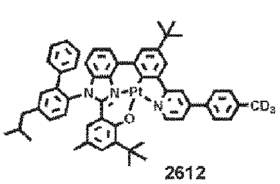
2612

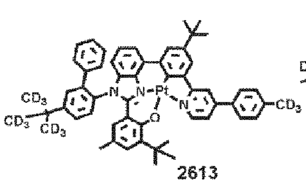
2613

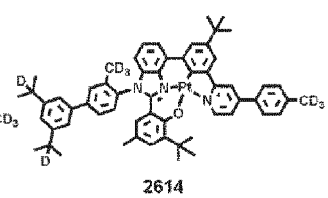
2614

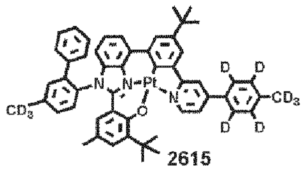
2615

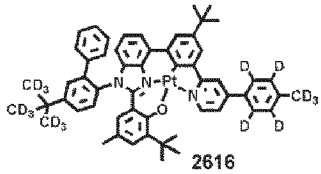
2616

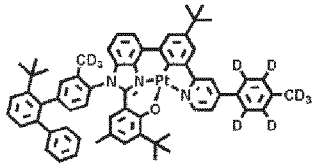
2617

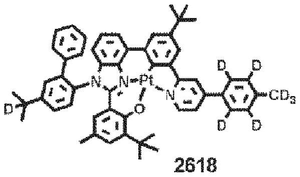
2618

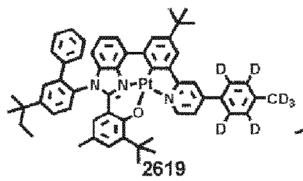
2619

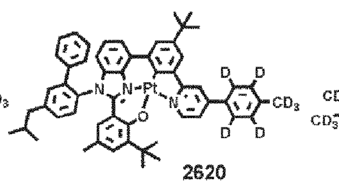
2620

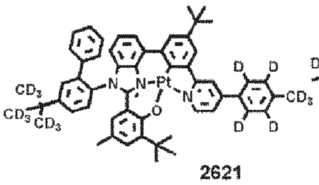
2621

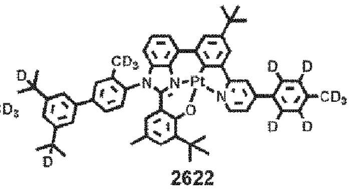
2622

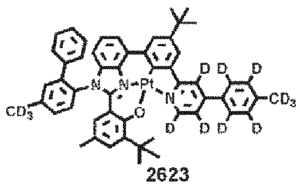
2623

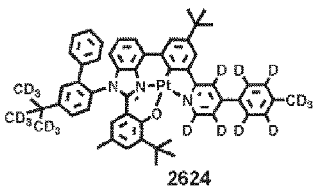
2624

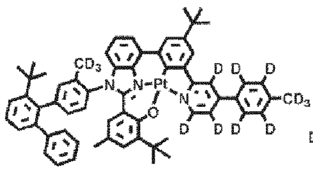
2625

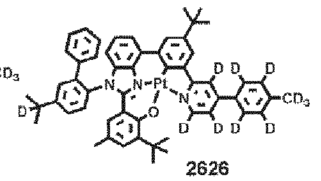
2626

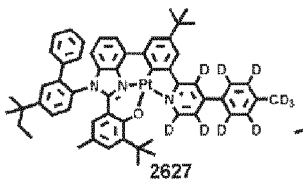
2627

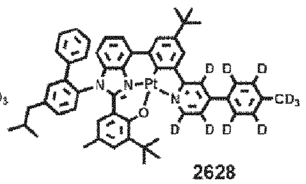
2628

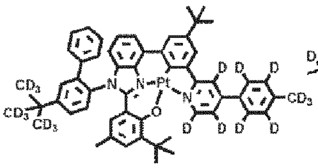
2629

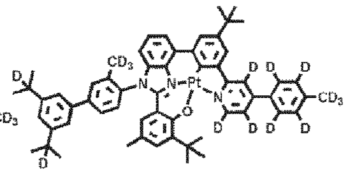
2630

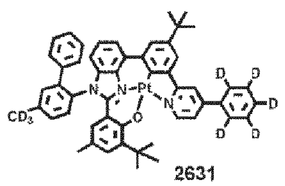
2631

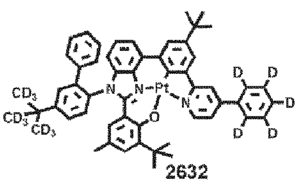
2632

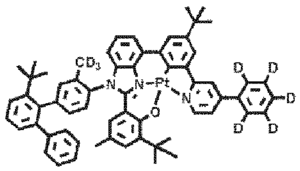
2633

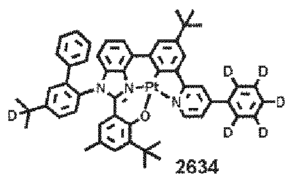
2634

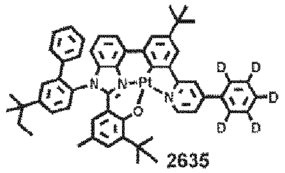
2635

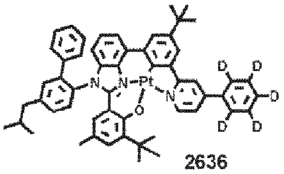
2636

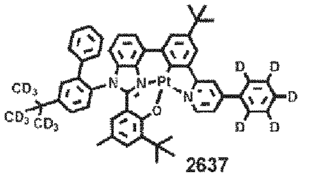
2637

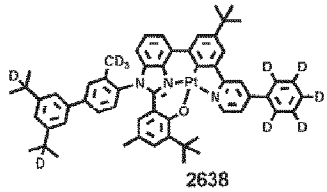
2638

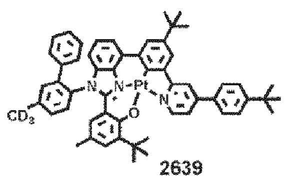
2639
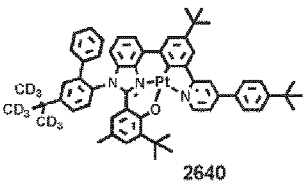
2640
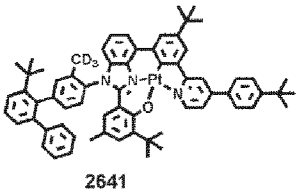
2641
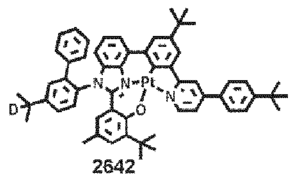
2642

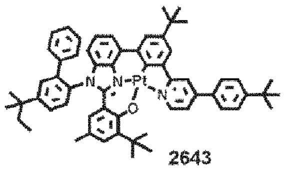
2643
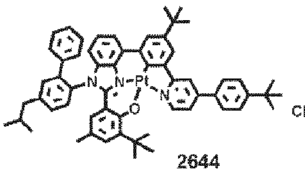
2644
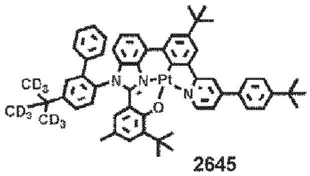
2645
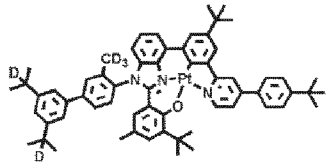
2646

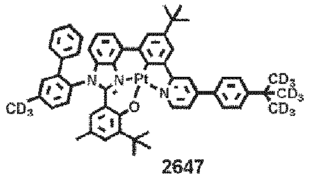
2647
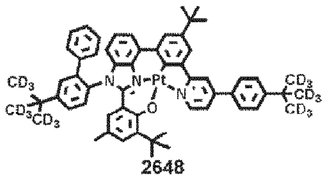
2648
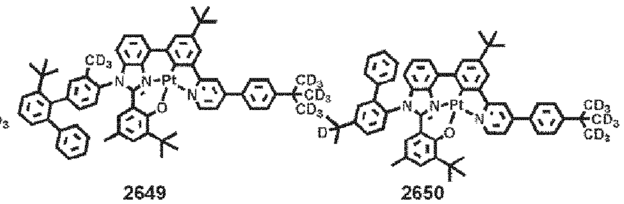
2649
2650

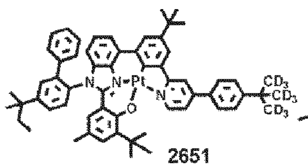
2651
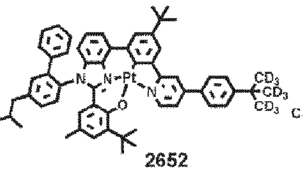
2652
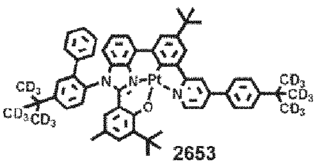
2653
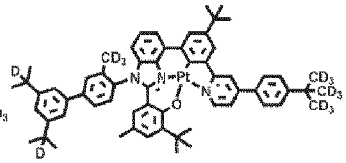
2654

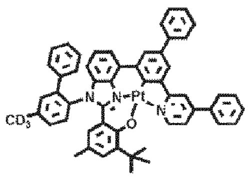
2655
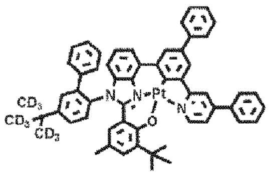
2656
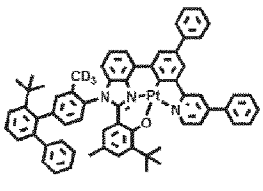
2657
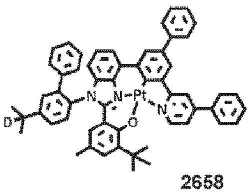
2658

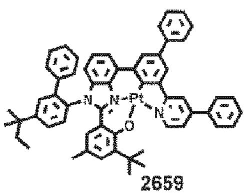
2659
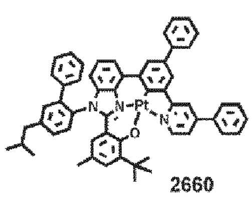
2660
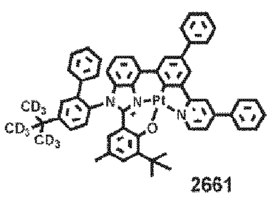
2661
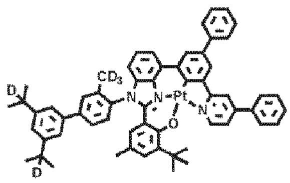
2662

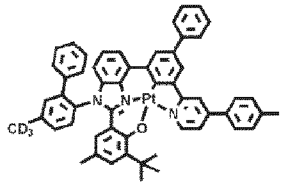
2663
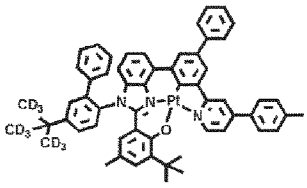
2664
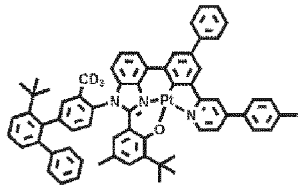
2665
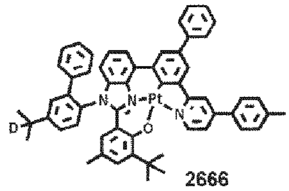
2666

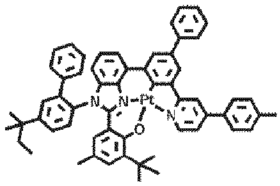
2667
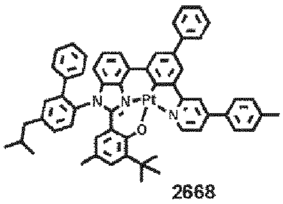
2668
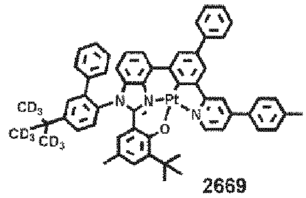
2669
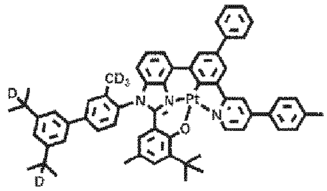
2670

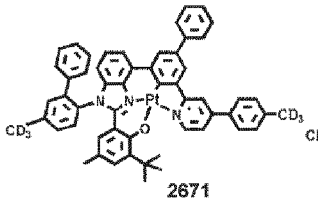
2671
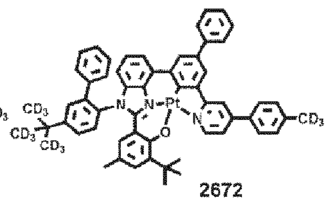
2672
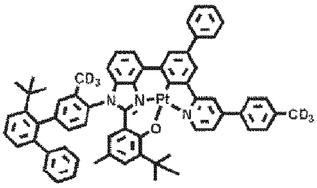
2673
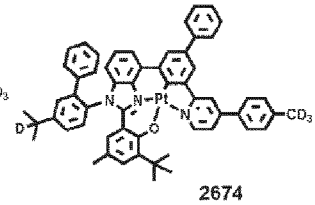
2674

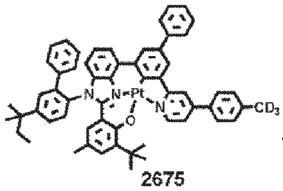
2675
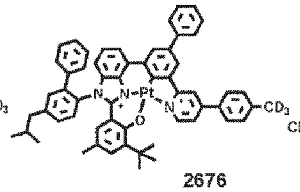
2676
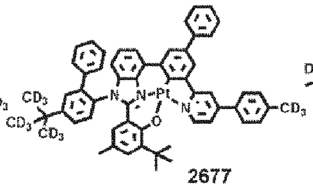
2677
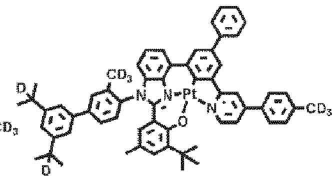
2678

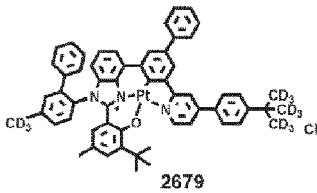
2679
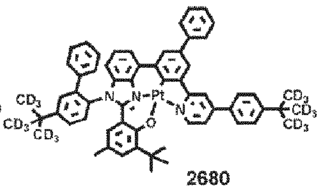
2680
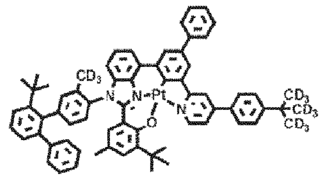
2681
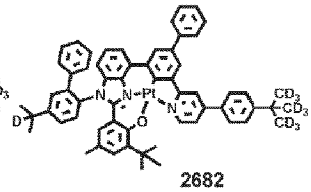
2682

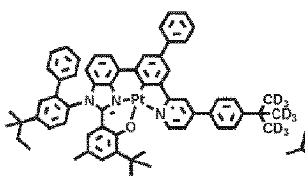
2683
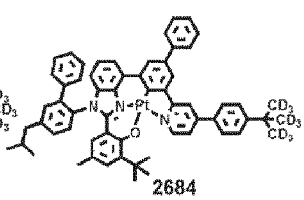
2684
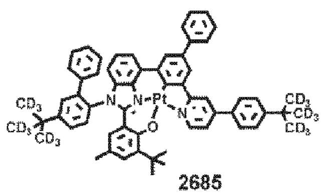
2685
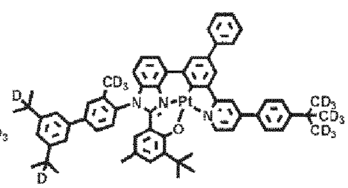
2686

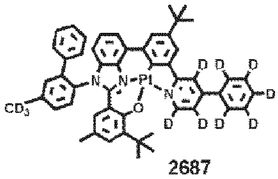
2687

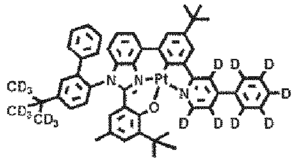
2688

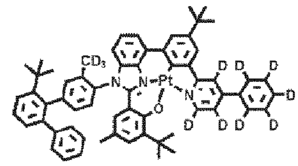
2689

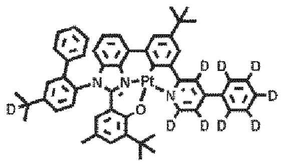
2690

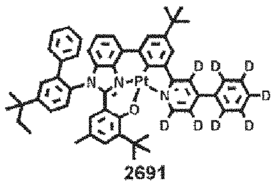
2691

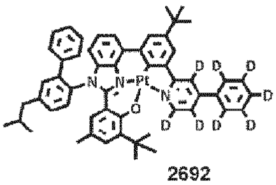
2692

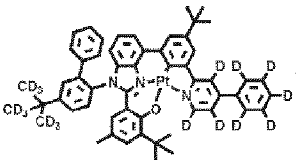
2693

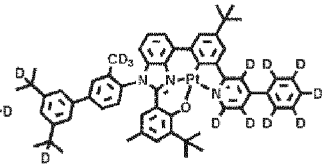
2694

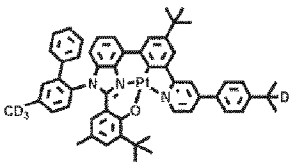
2695

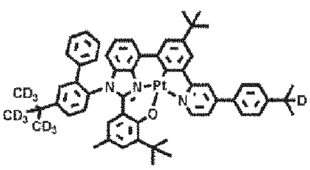
2696

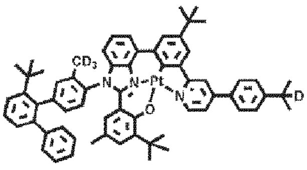
2697

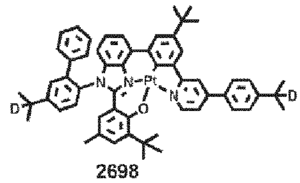
2698

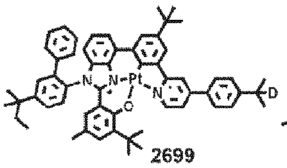
2699

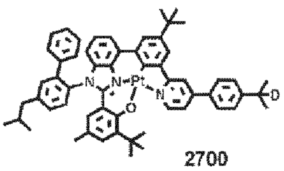
2700

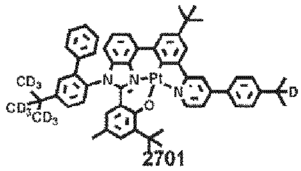
2701

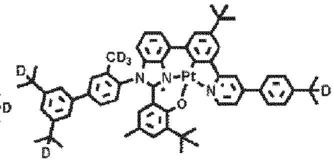
2702

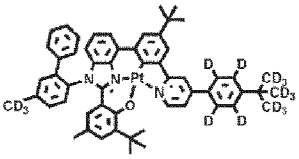
2703

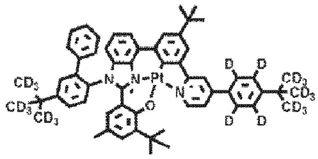
2704

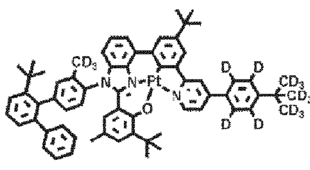
2705

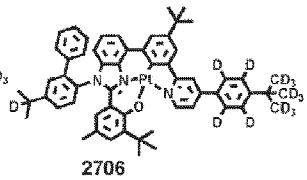
2706

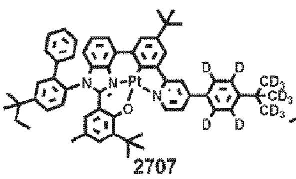
2707

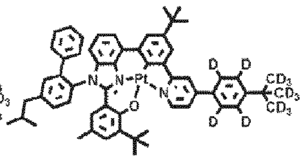
2708

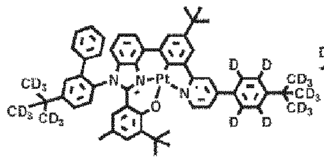
2709

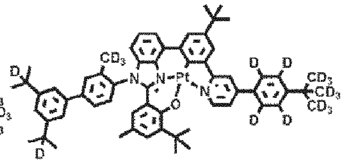
2710

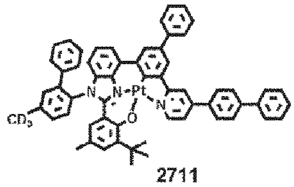
2711
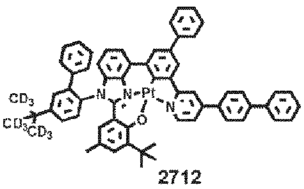
2712
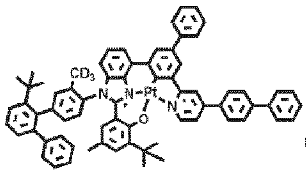
2713
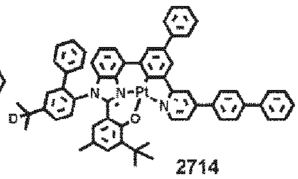
2714

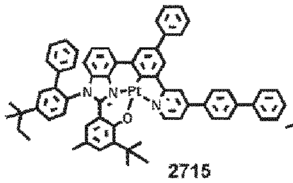
2715
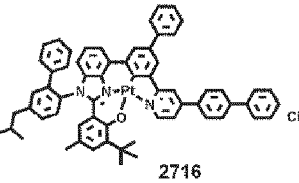
2716
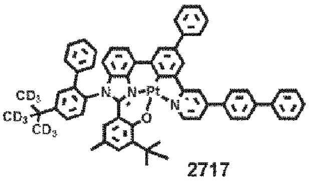
2717
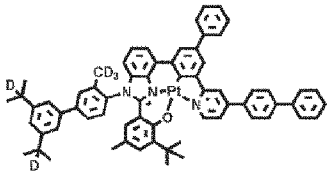
2718

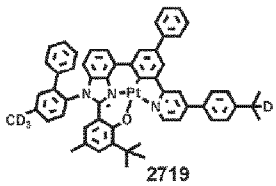
2719
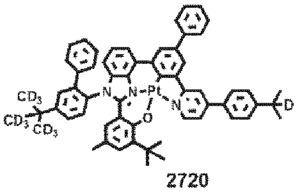
2720
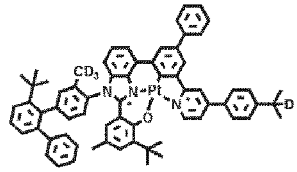
2721
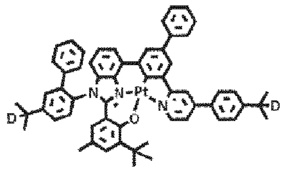
2722

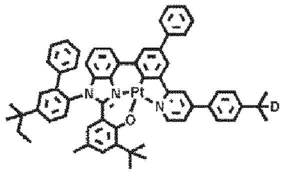
2723
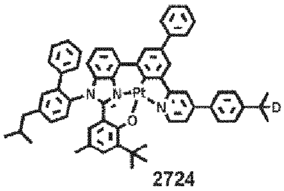
2724
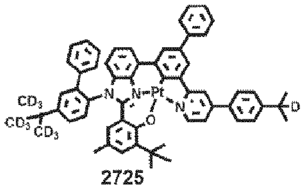
2725
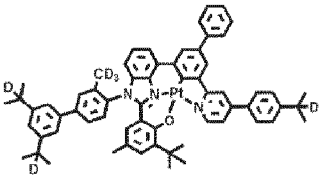
2726

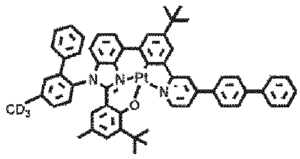
2727
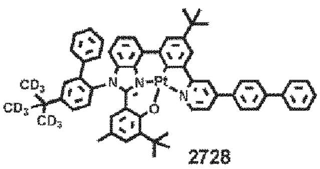
2728
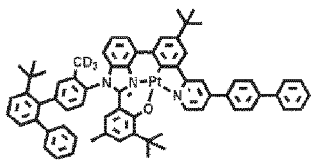
2729
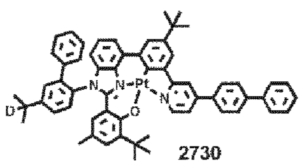
2730

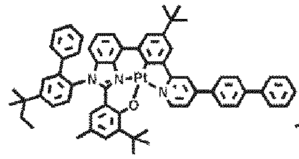
2731
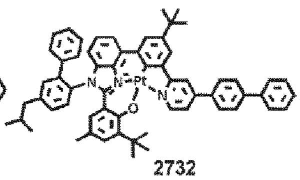
2732
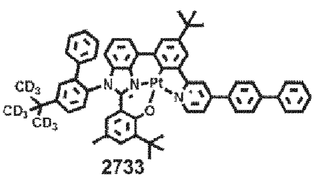
2733
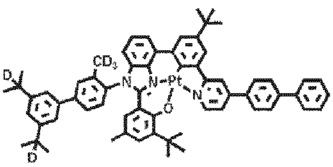
2734

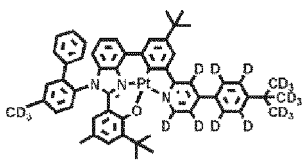
2735

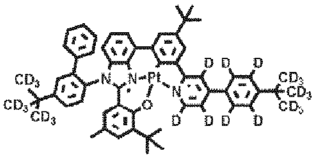
2736

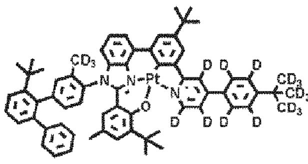
2737

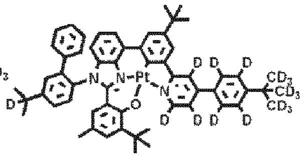
2738

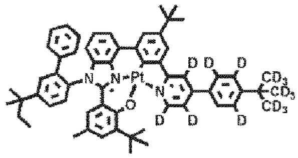
2739

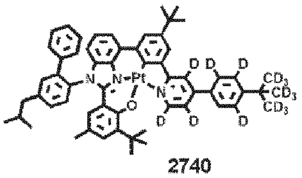
2740

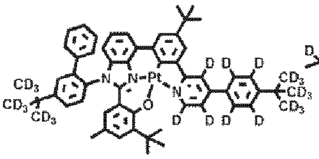
2741

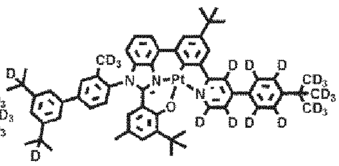
2742

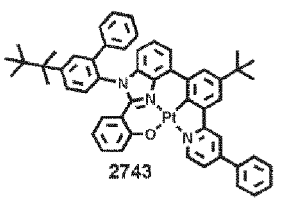
2743

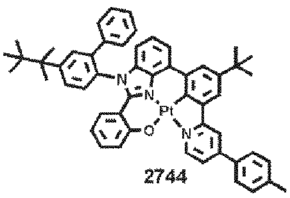
2744

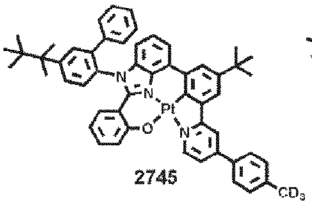
2745

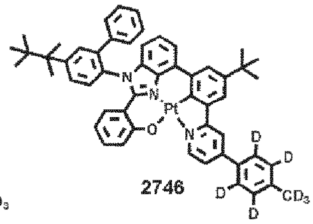
2746

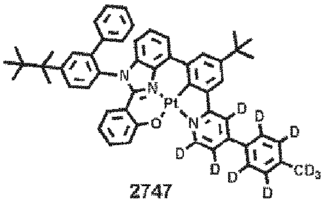
2747

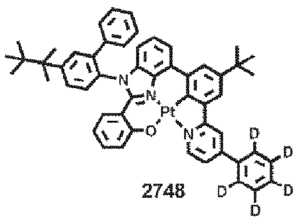
2748

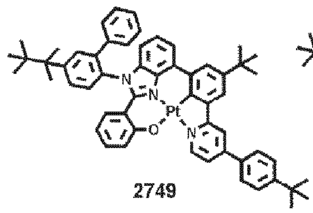
2749

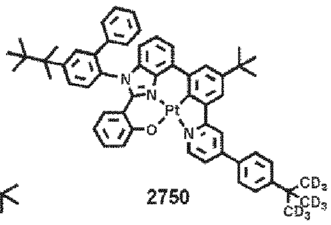
2750

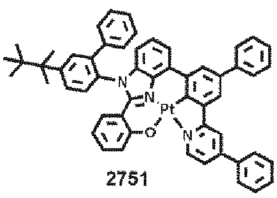
2751

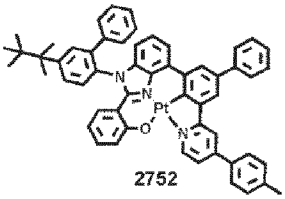
2752

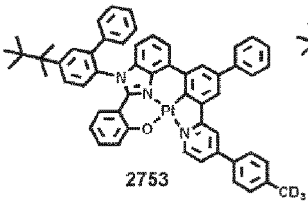
2753

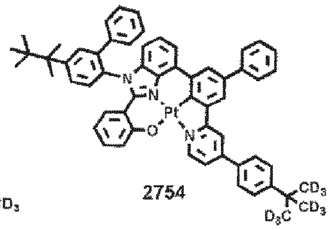
2754

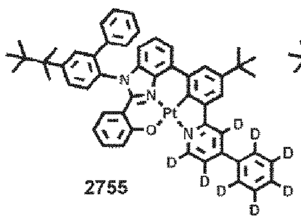
2755

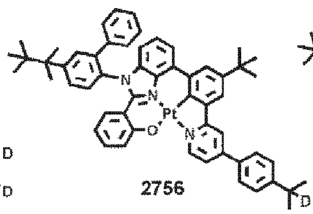
2756

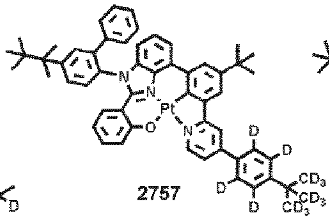
2757

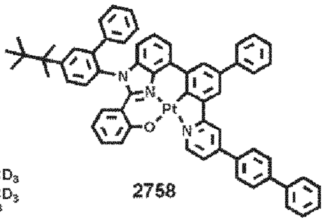
2758

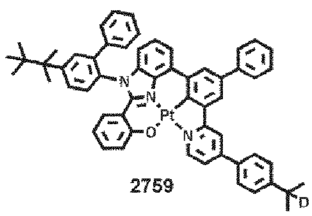
2759

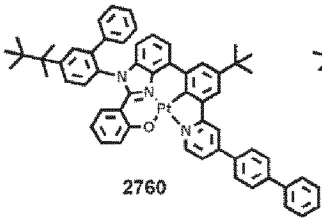
2760

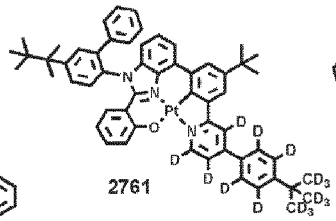
2761

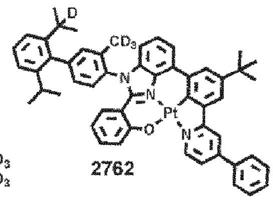
2762

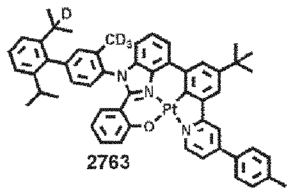
2763

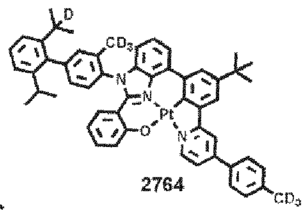
2764

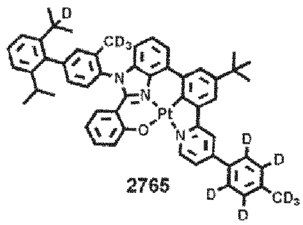
2765

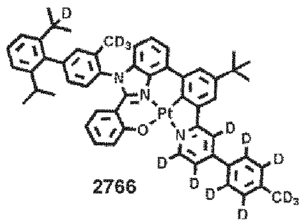
2766

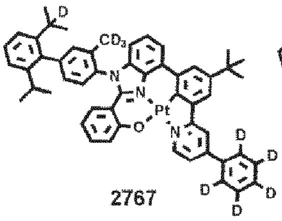
2767

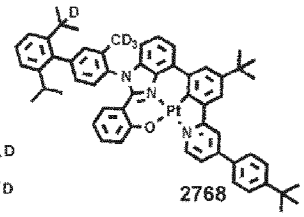
2768

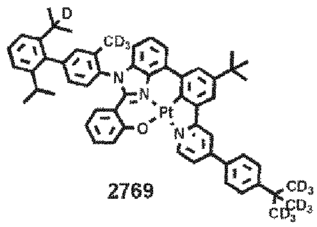
2769

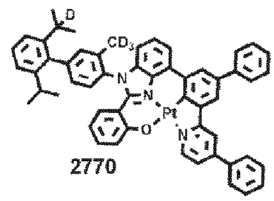
2770

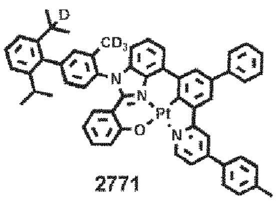
2771

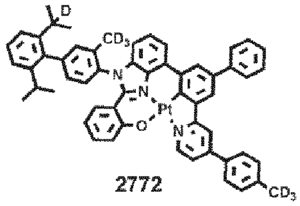
2772

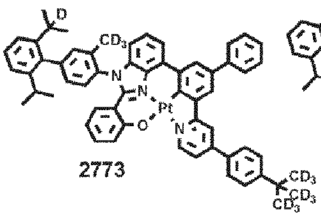
2773

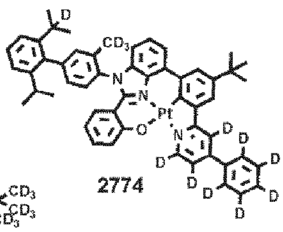
2774

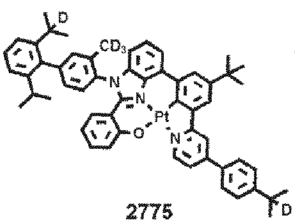
2775

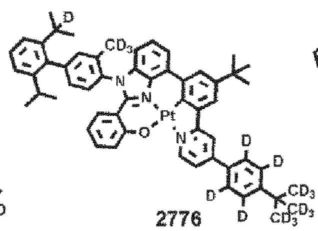
2776

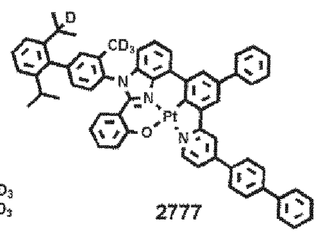
2777

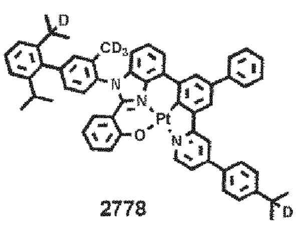
2778

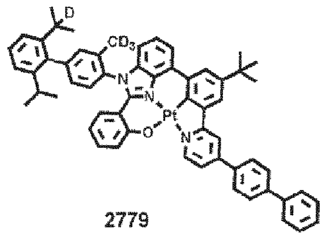
2779

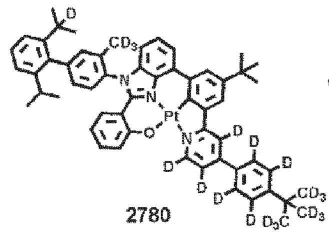
2780

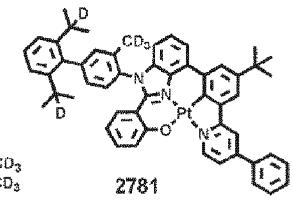
2781

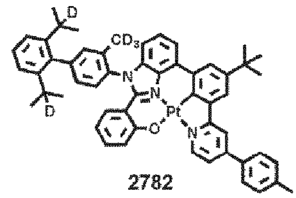
2782

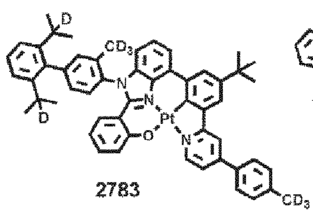
2783

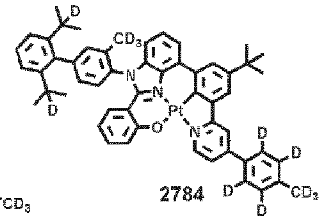
2784

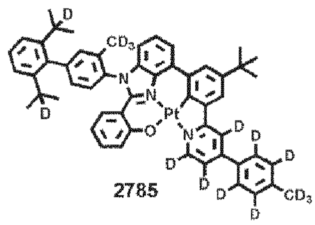
2785

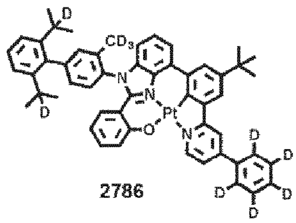
2786

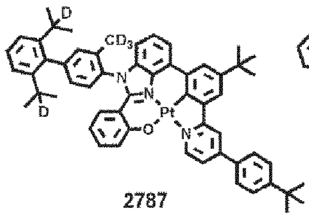
2787

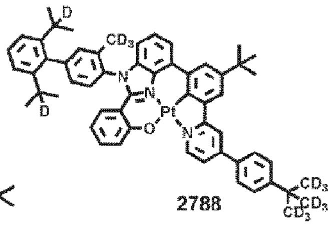
2788

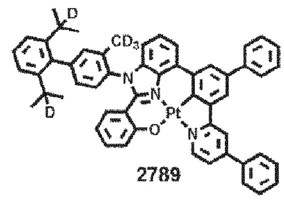
2789

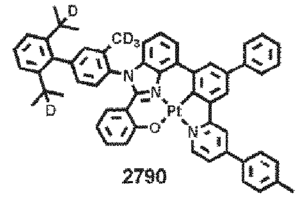
2790

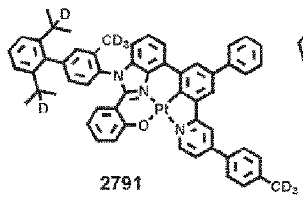
2791

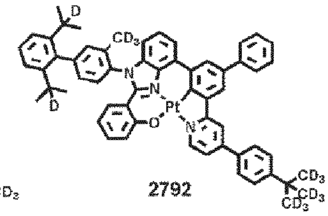
2792

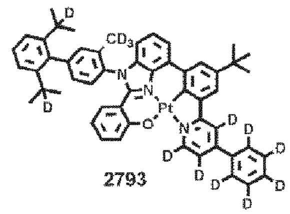
2793

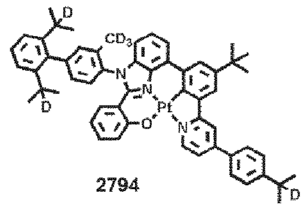
2794

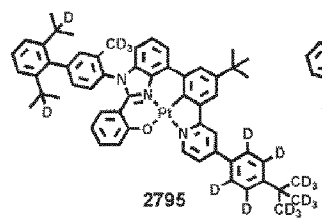
2795

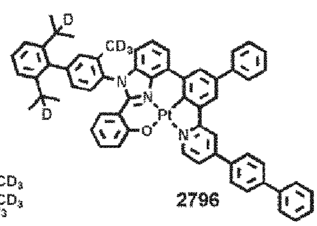
2796

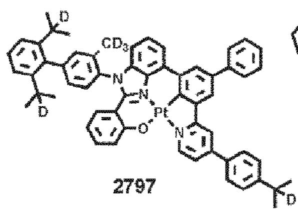
2797

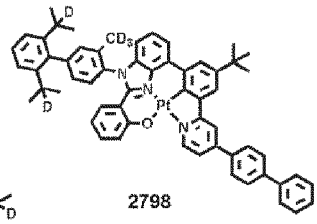
2798

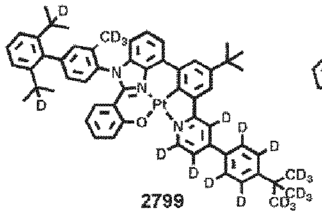
2799

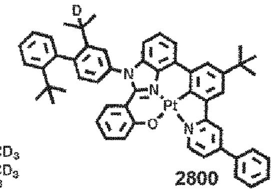
2800

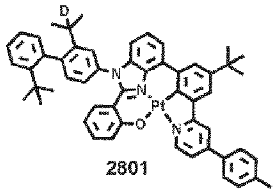
2801

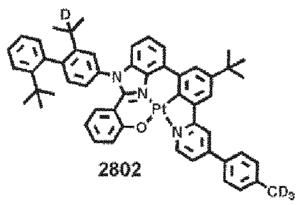
2802

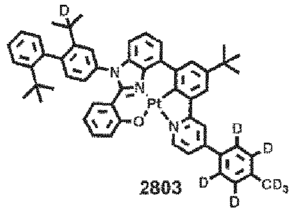
2803

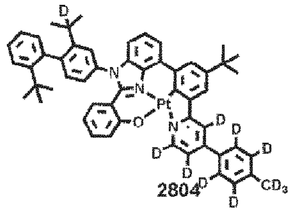
2804

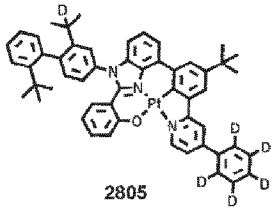
2805

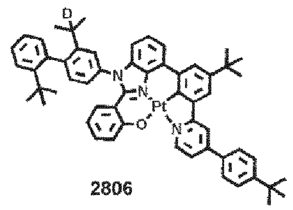
2806

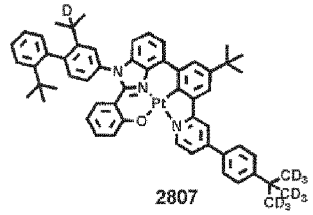
2807

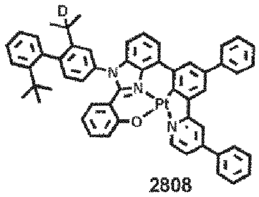
2808

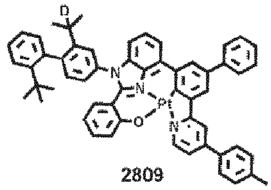
2809

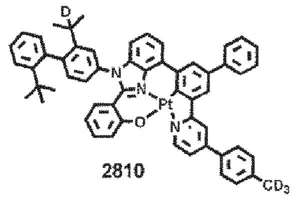
2810

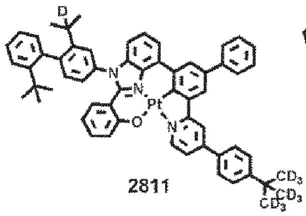
2811

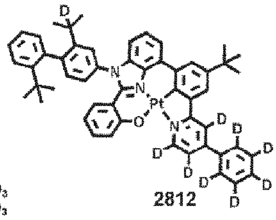
2812

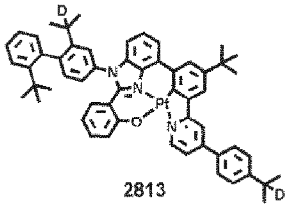
2813

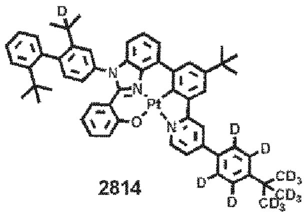
2814

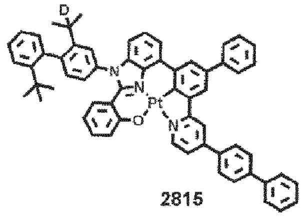
2815

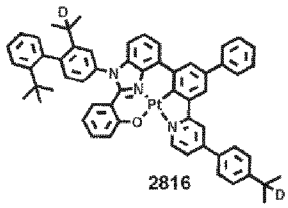
2816

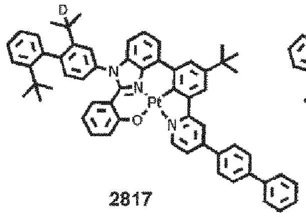
2817

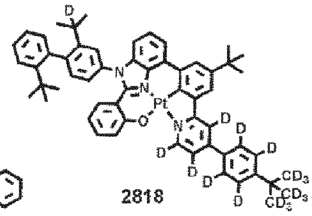
2818

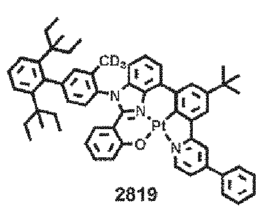
2819

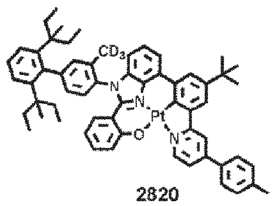
2820

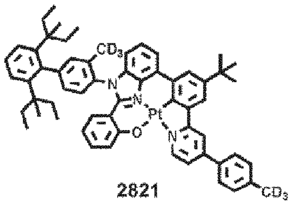
2821

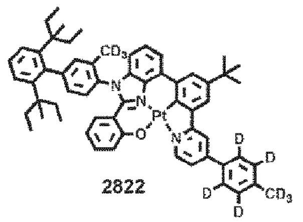
2822

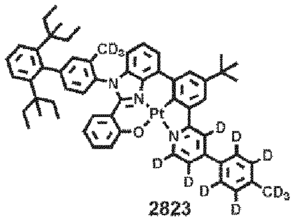
2823

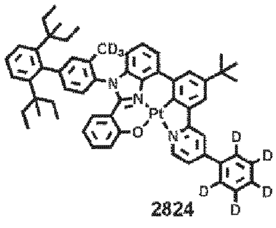
2824

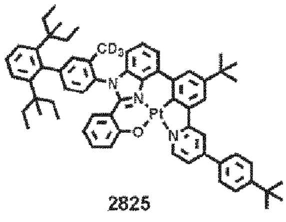
2825

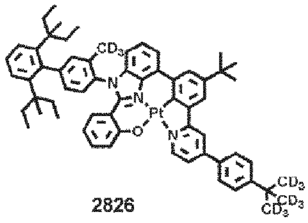
2826

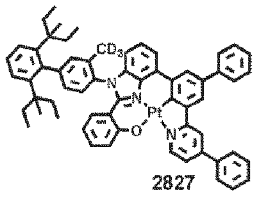
2827

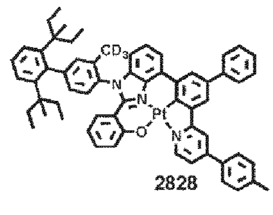
2828

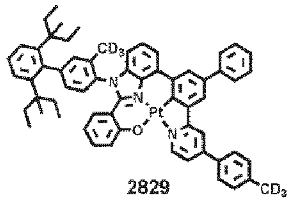
2829

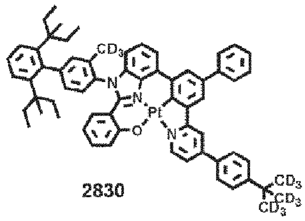
2830

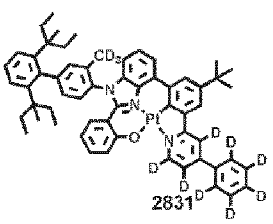
2831

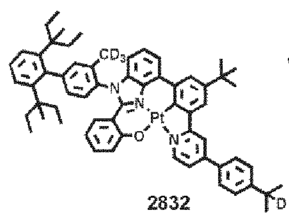
2832

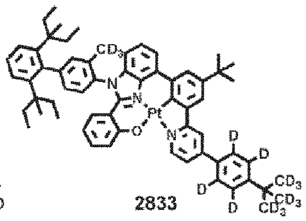
2833

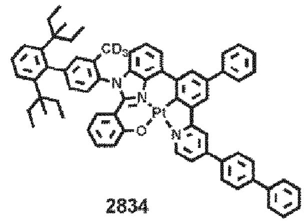
2834

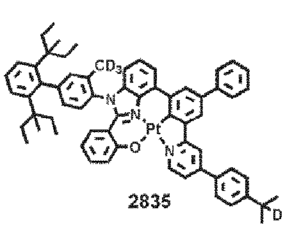
2835

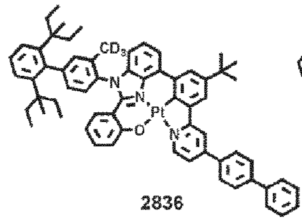
2836

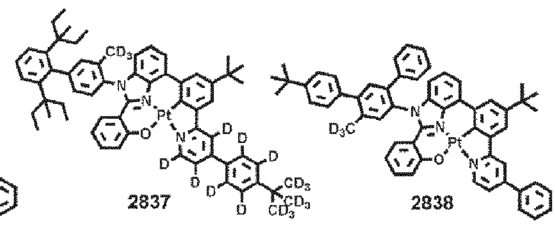
2837

2838

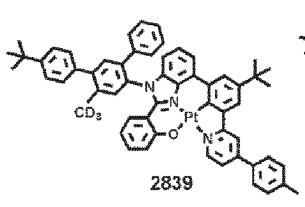
2839

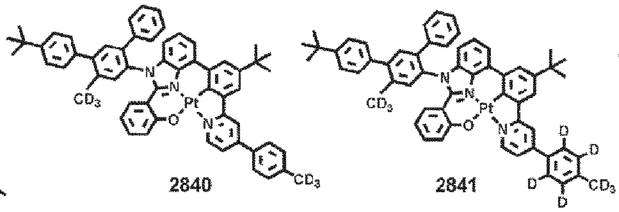
2840

2841

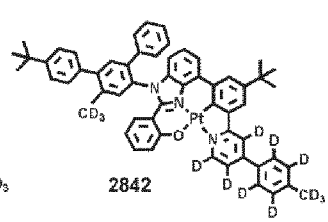
2842

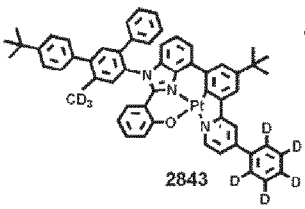
2843

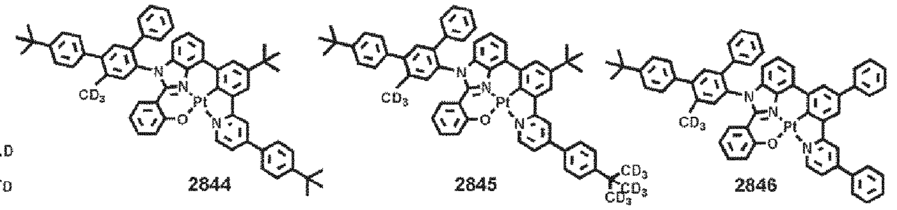
2844

2845

2846

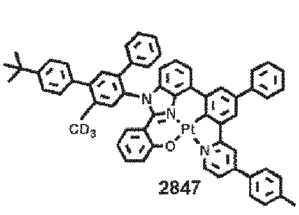
2847

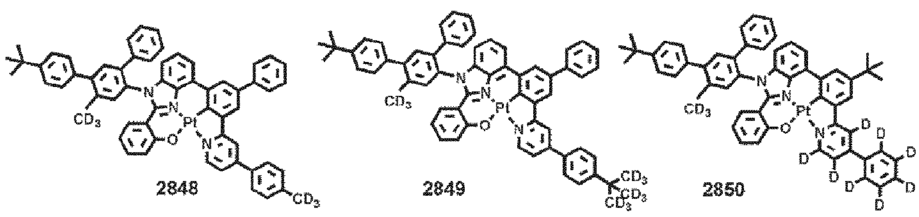
2848

2849

2850

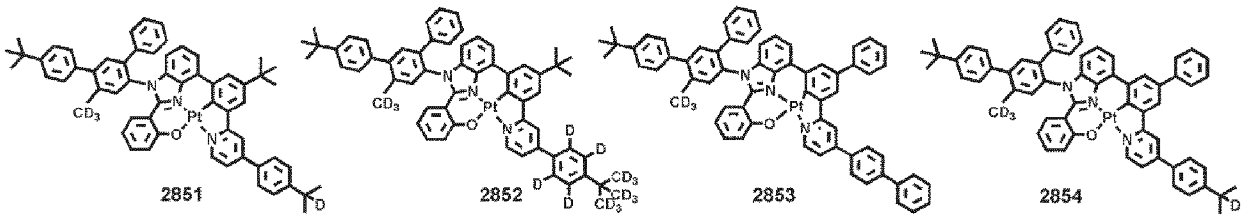

2851 2852 2853 2854

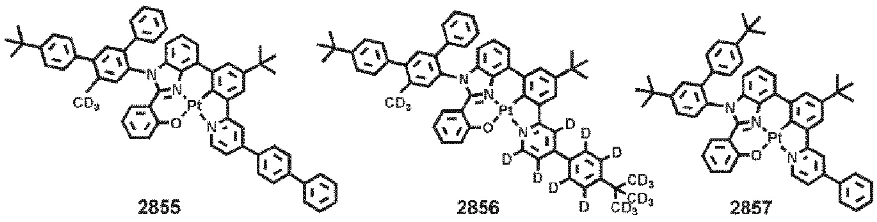

2855 2856 2857

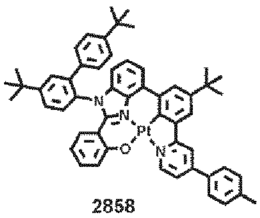

2858

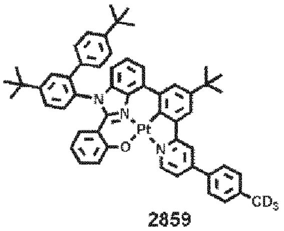

2859

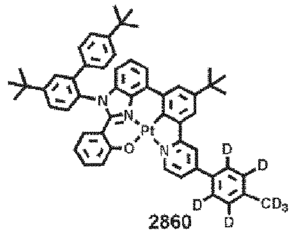

2860

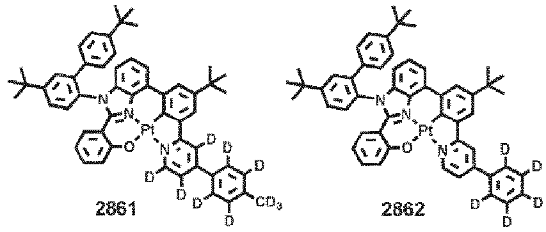

2861 2862

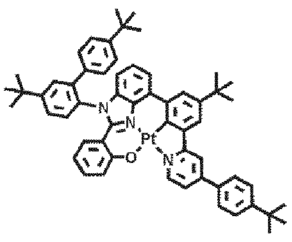

2863

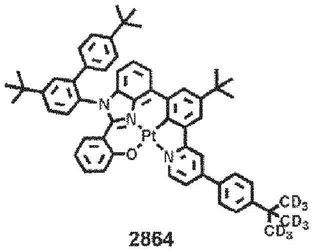

2864

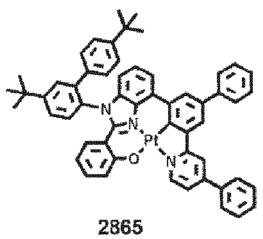

2865

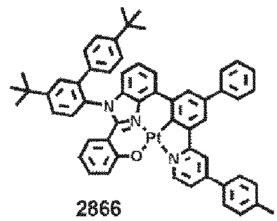

2866

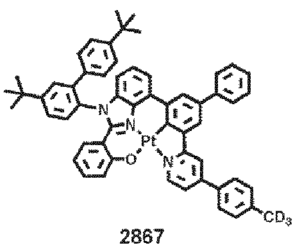

2867

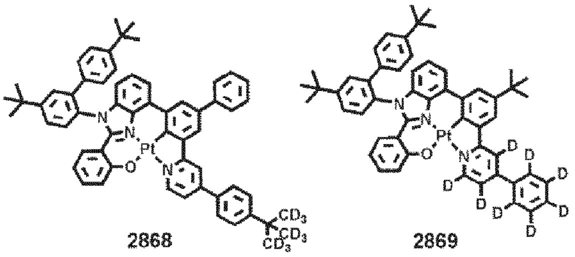

2868 2869

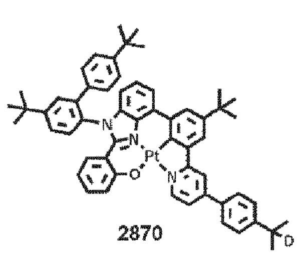

2870

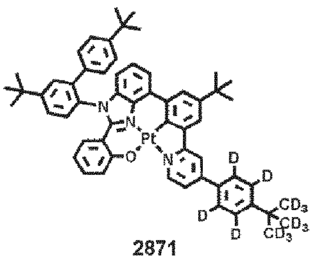

2871

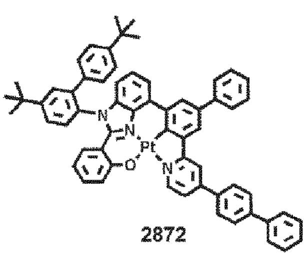

2872

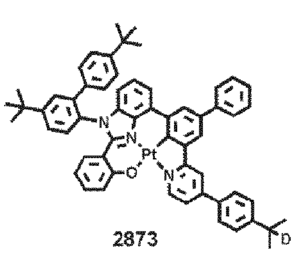

2873

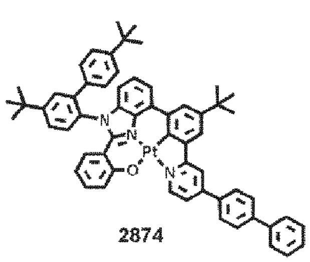

2874

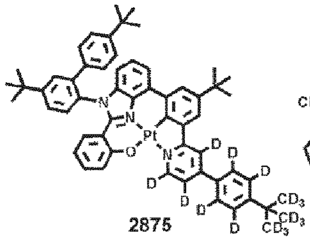
2875

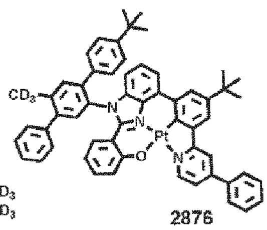
2876

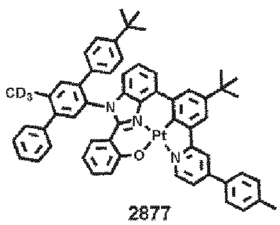
2877

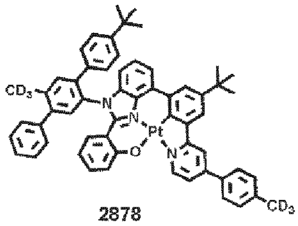
2878

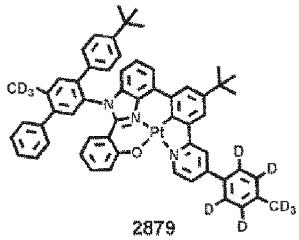
2879

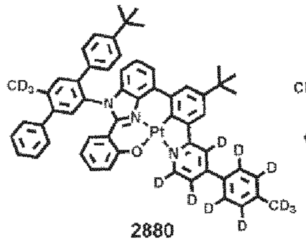
2880

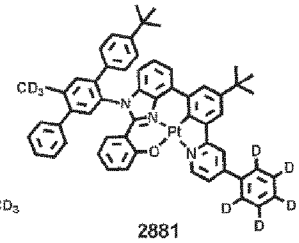
2881

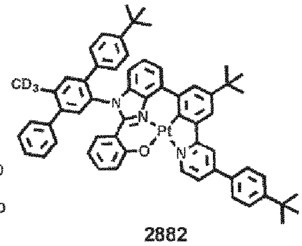
2882

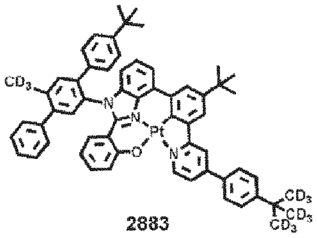
2883

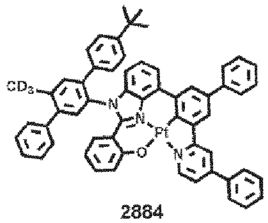
2884

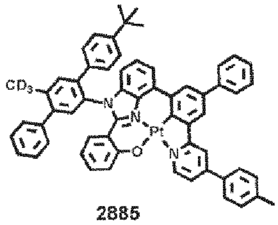
2885

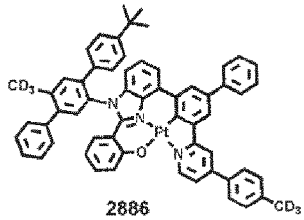
2886

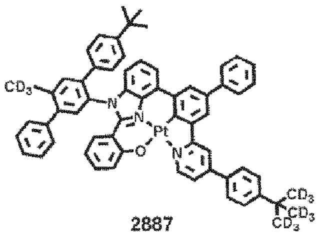
2887

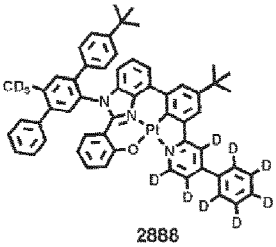
2888

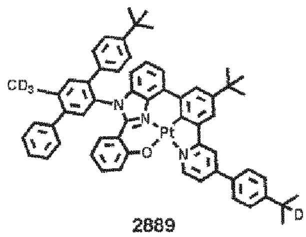
2889

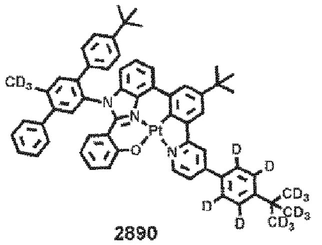
2890

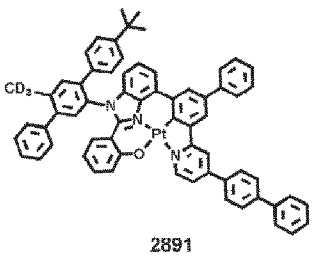
2891

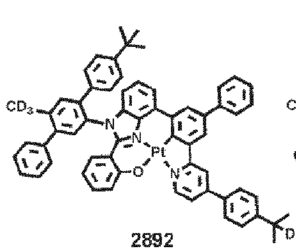
2892

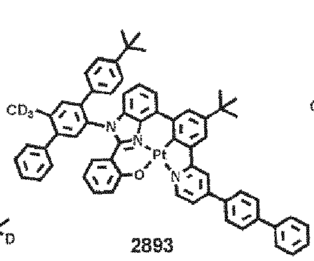
2893

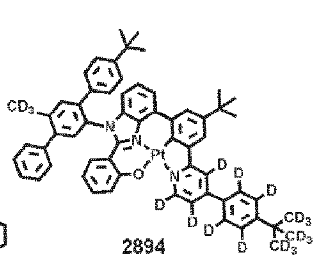
2894

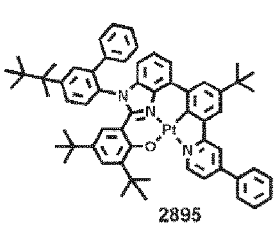
2895

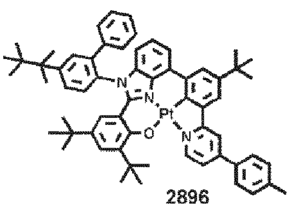
2896

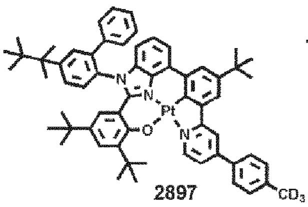
2897

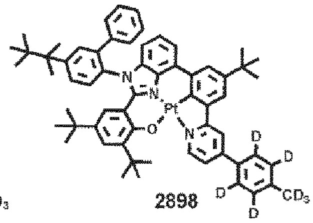
2898

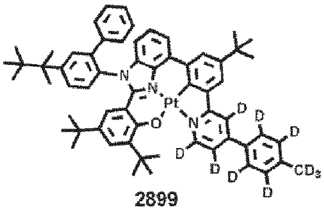
2899

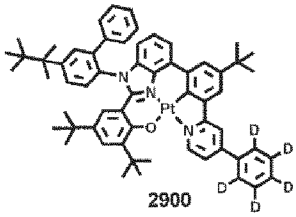
2900

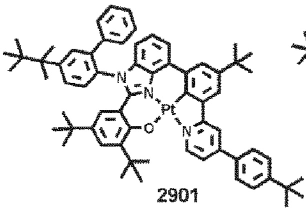
2901

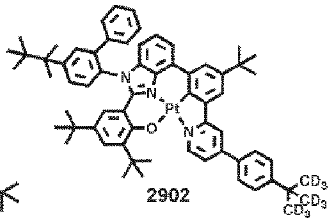
2902

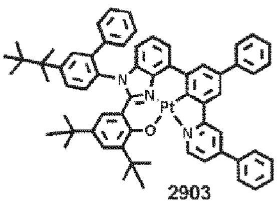
2903

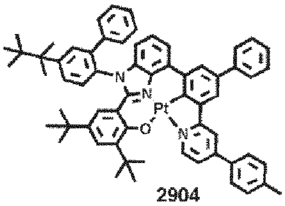
2904

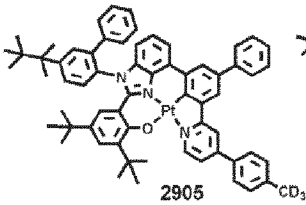
2905

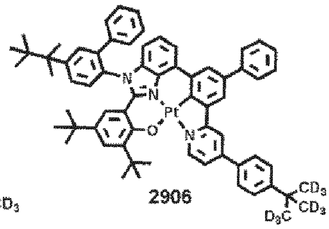
2906

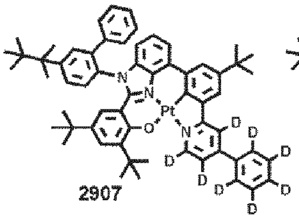
2907

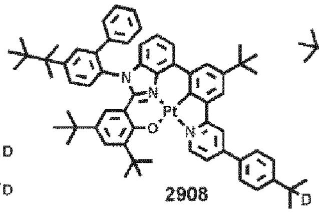
2908

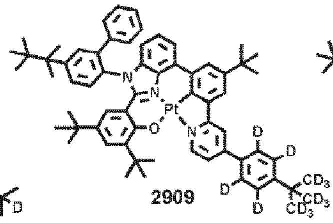
2909

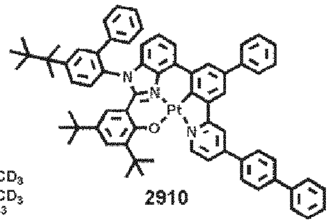
2910

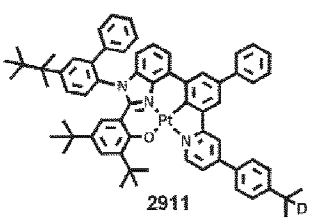
2911

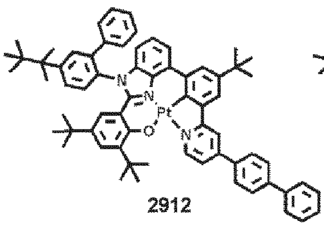
2912

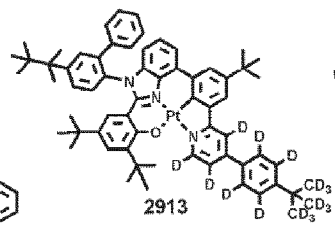
2913

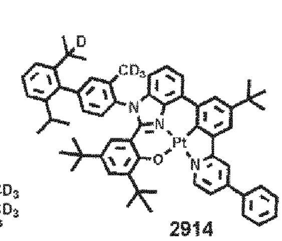
2914

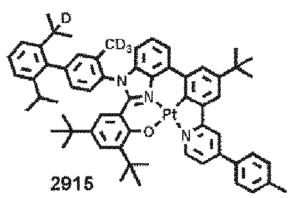
2915

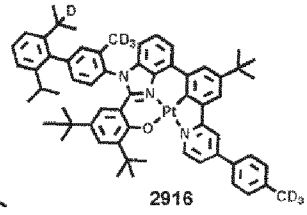
2916

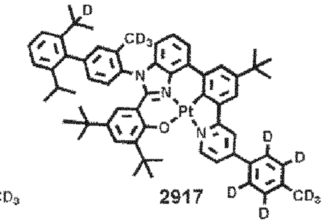
2917

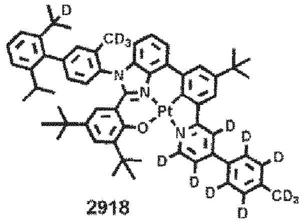
2918

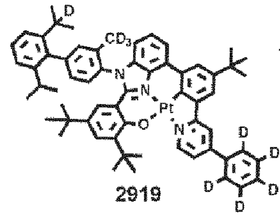
2919

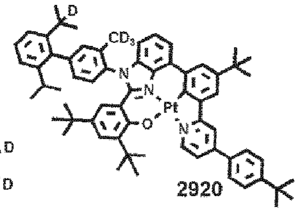
2920

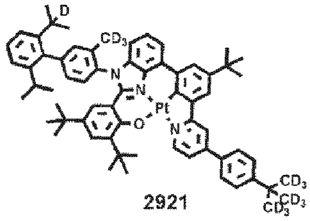
2921

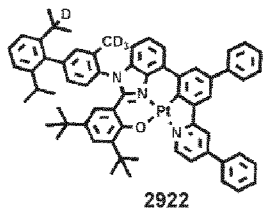
2922

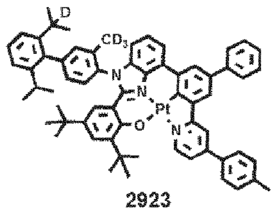
2923

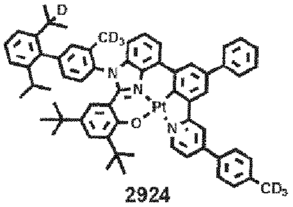
2924

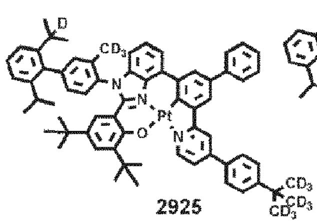
2925

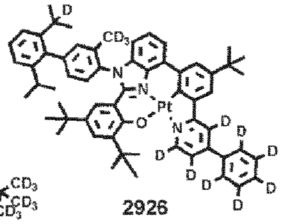
2926

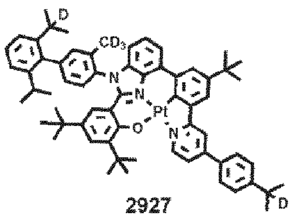
2927

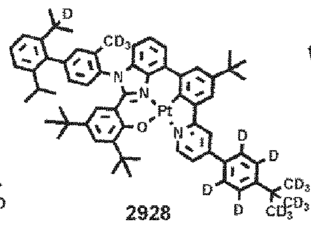
2928

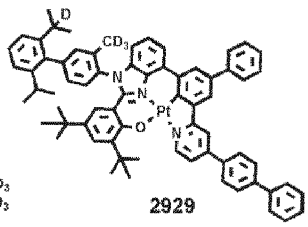
2929

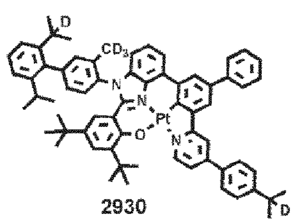
2930

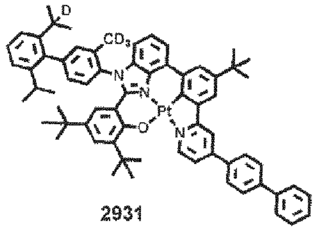
2931

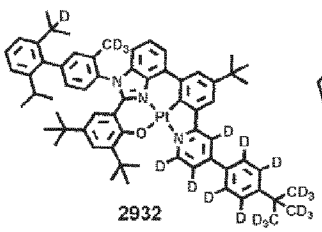
2932

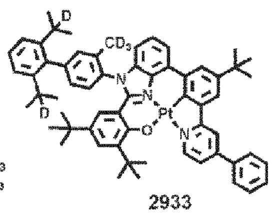
2933

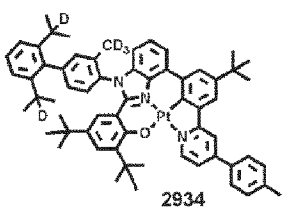
2934

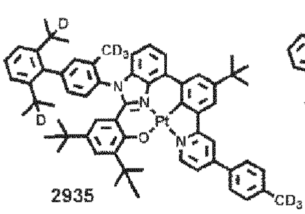
2935

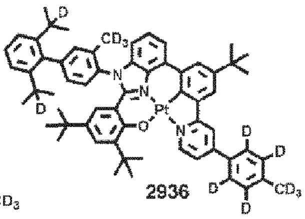
2936

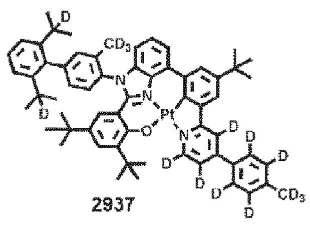
2937

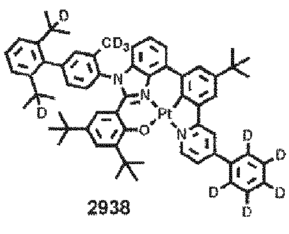
2938

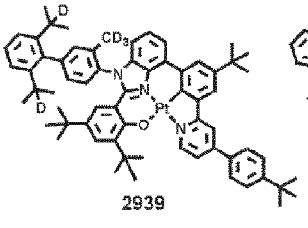
2939

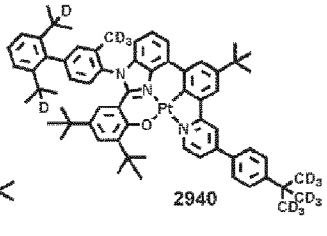
2940

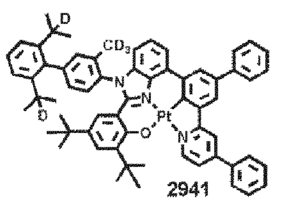
2941

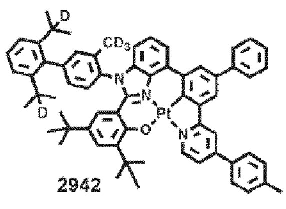
2942

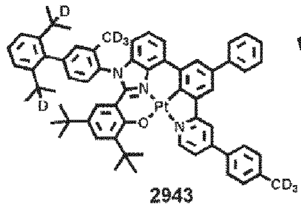
2943

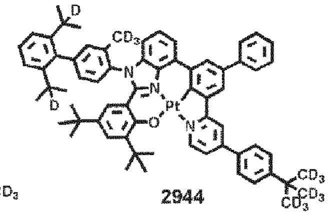
2944

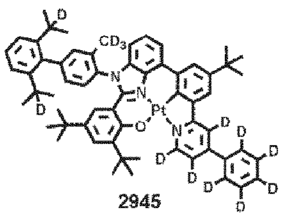
2945

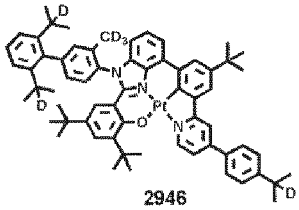
2946

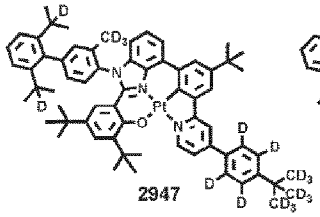
2947

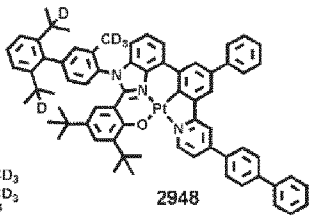
2948

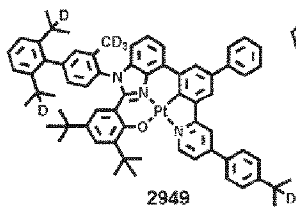
2949

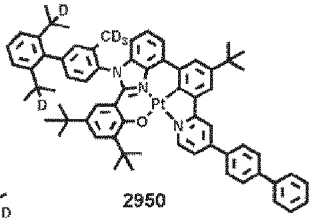
2950

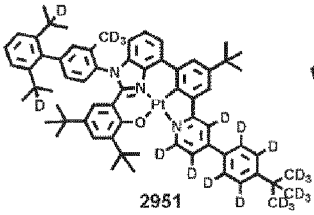
2951

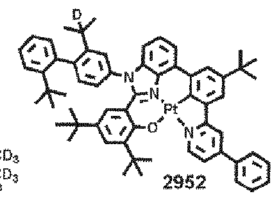
2952

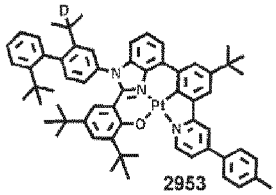
2953

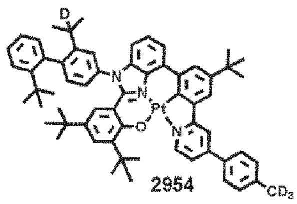
2954

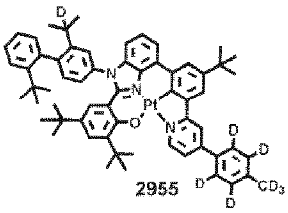
2955

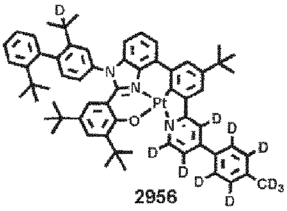
2956

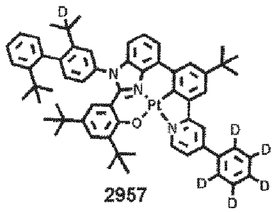
2957

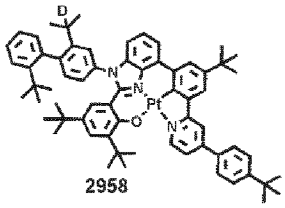
2958

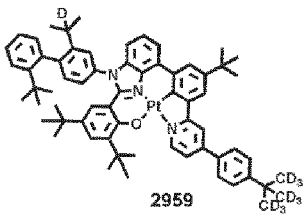
2959

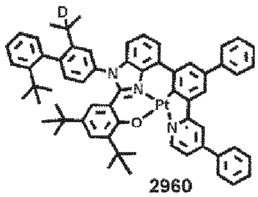
2960

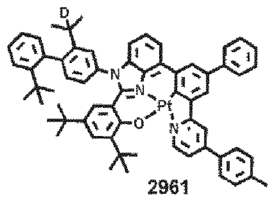
2961

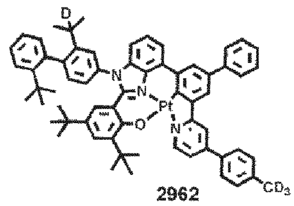
2962

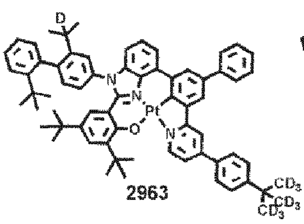
2963

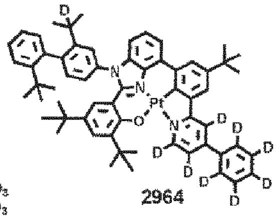
2964

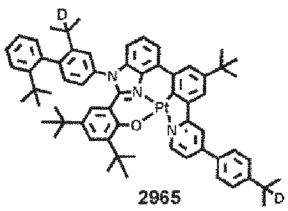
2965

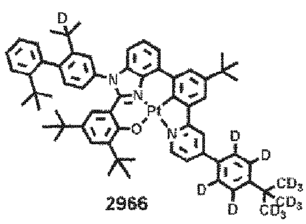
2966

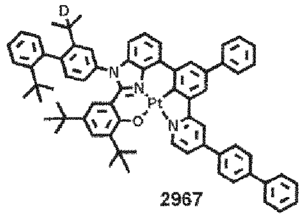
2967

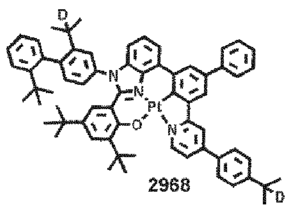
2968

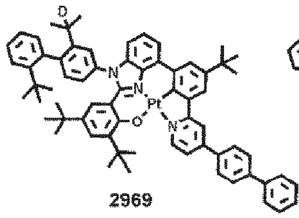
2969

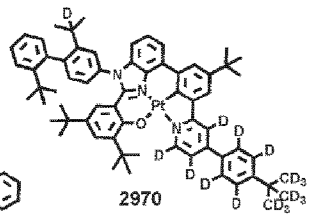
2970

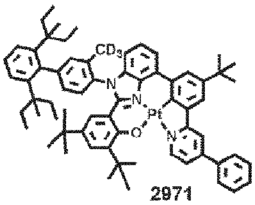
2971

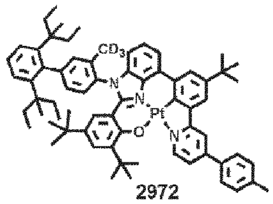
2972

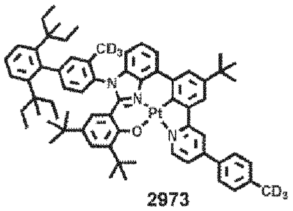
2973

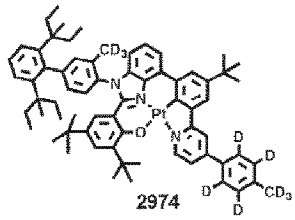
2974

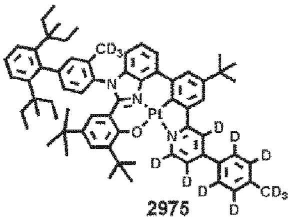
2975

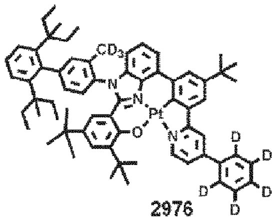
2976

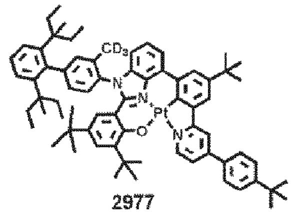
2977

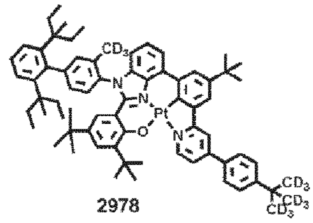
2978

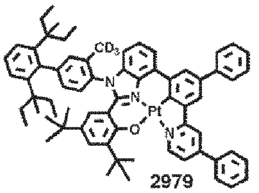
2979

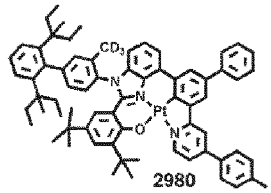
2980

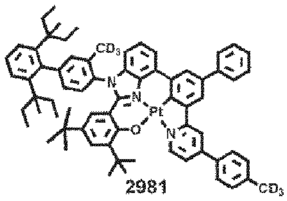
2981

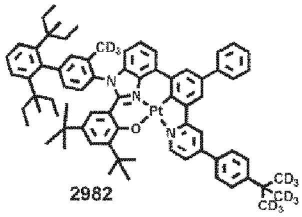
2982

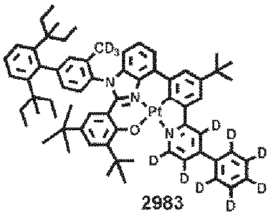
2983

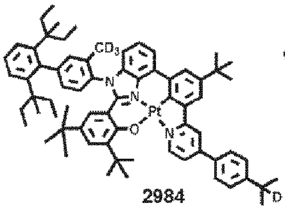
2984

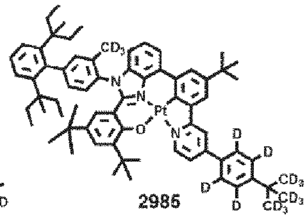
2985

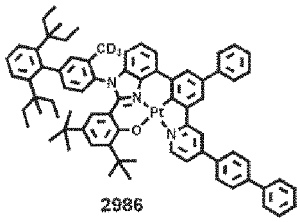
2986

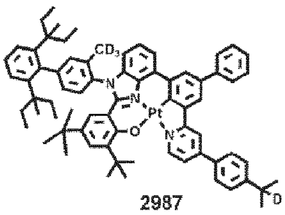
2987

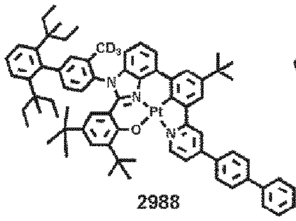
2988

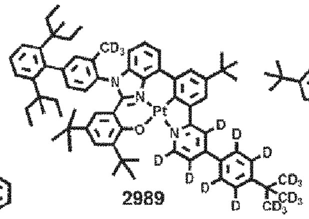
2989

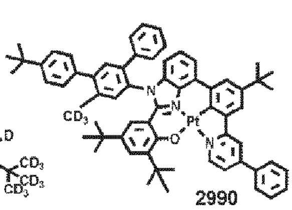
2990

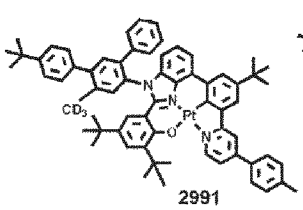
2991

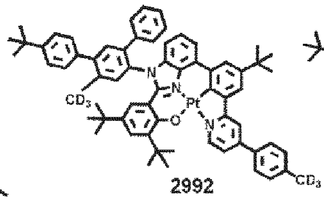
2992

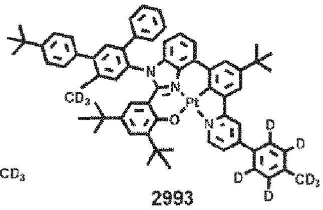
2993

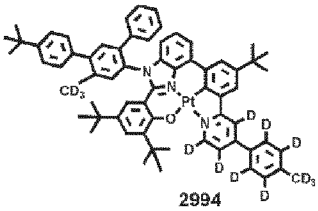
2994

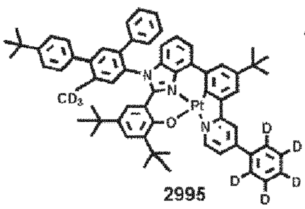
2995

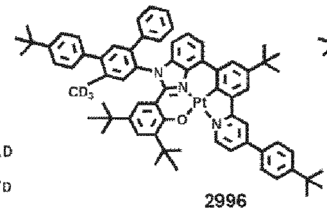
2996

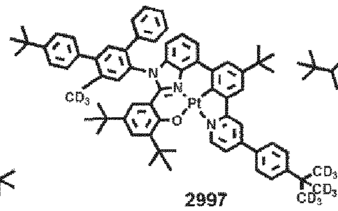
2997

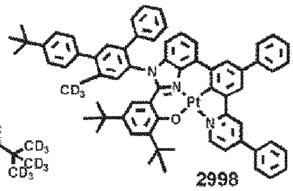
2998

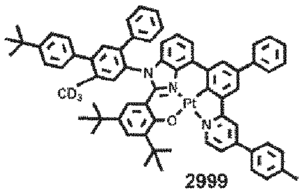
2999

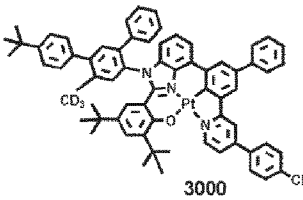
3000

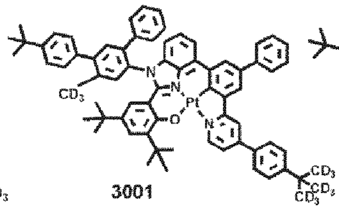
3001

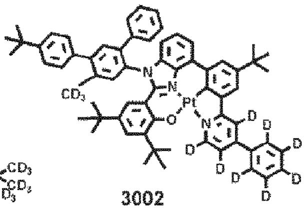
3002

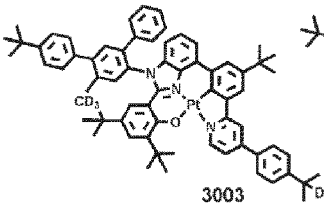
3003

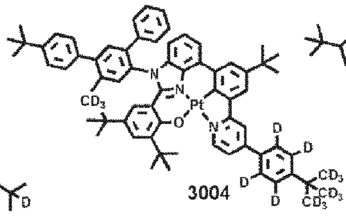
3004

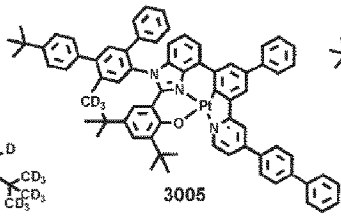
3005

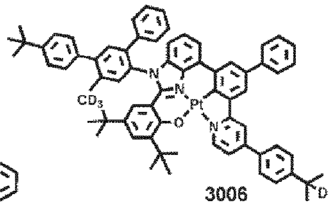
3006

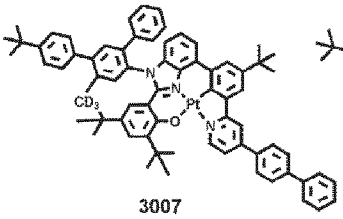
3007

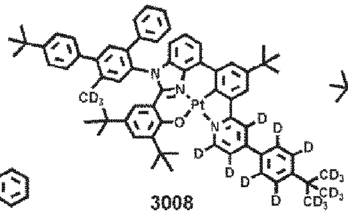
3008

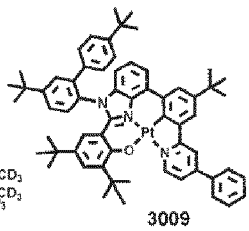
3009

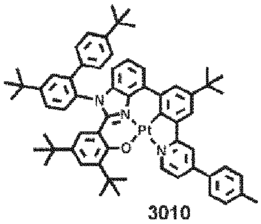
3010

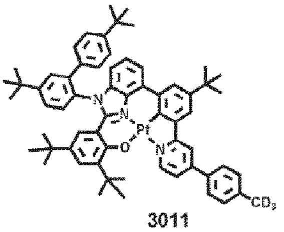
3011

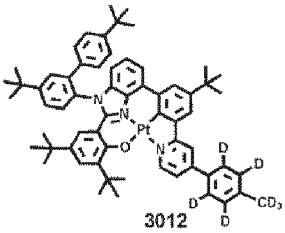
3012

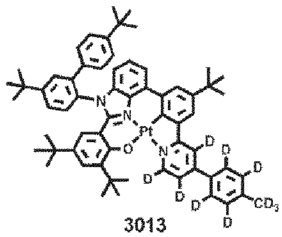
3013

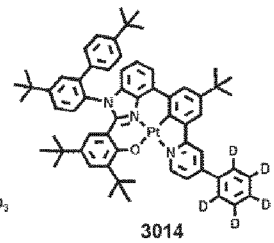
3014

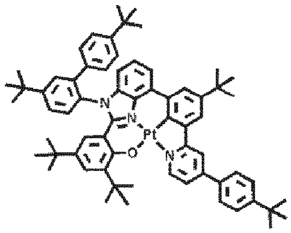

3015

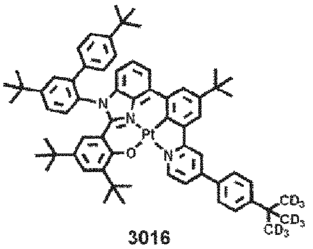

3016

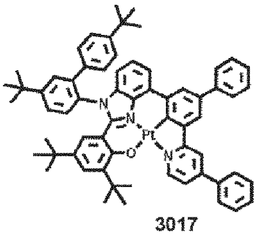

3017

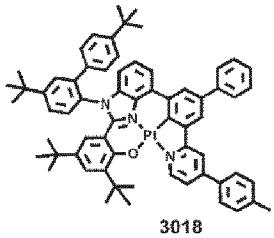

3018

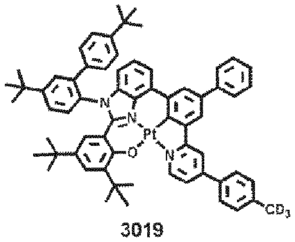

3019

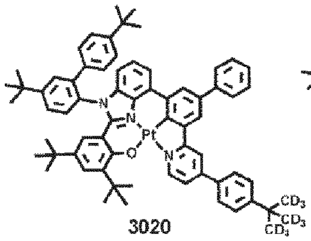

3020

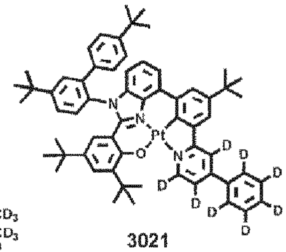

3021

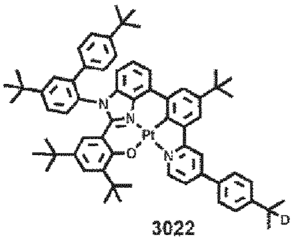

3022

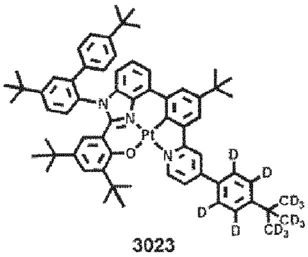

3023

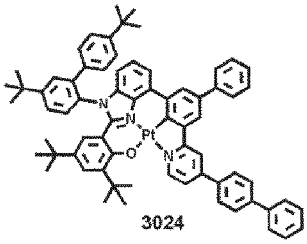

3024

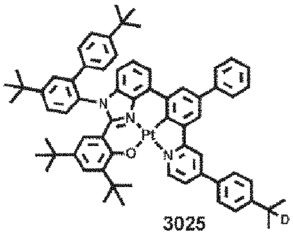

3025

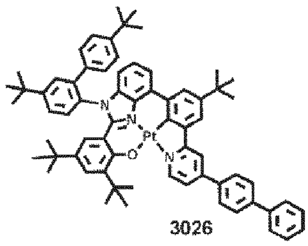

3026

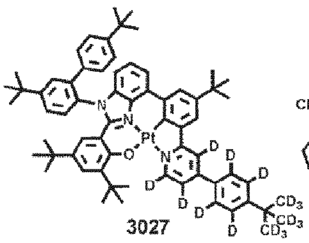

3027

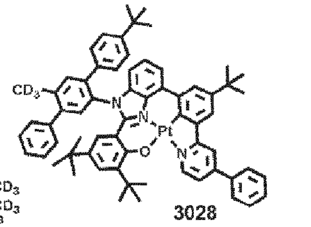

3028

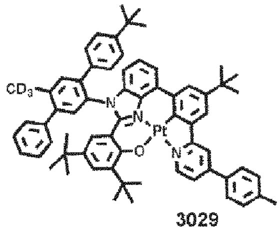

3029

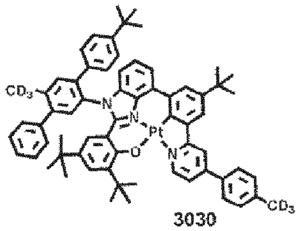

3030

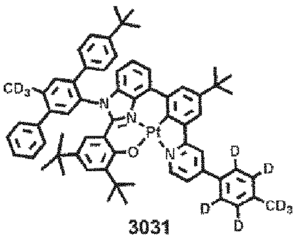

3031

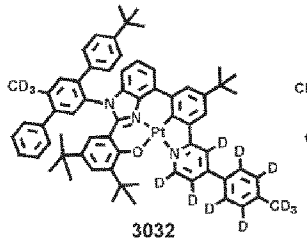

3032

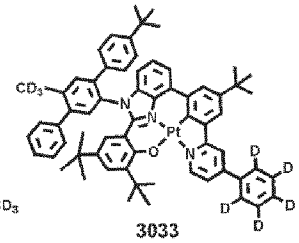

3033

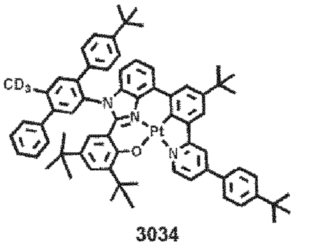

3034

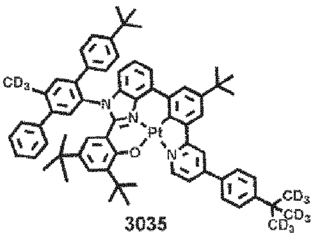

3035

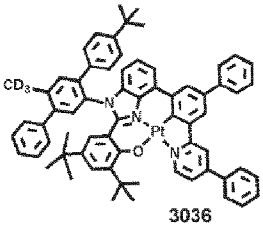

3036

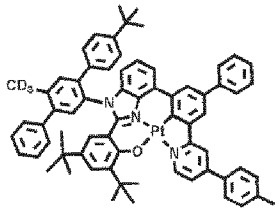

3037

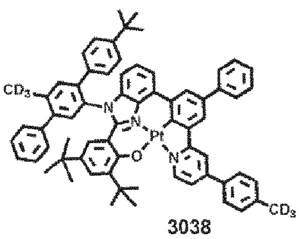

3038

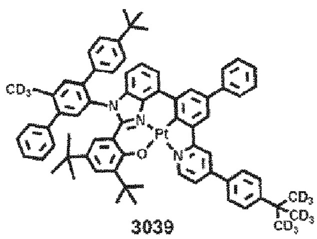
3039

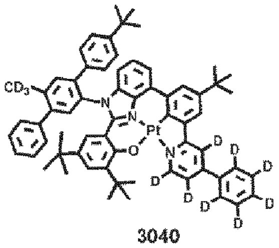
3040

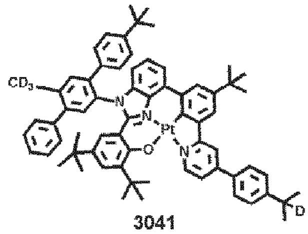
3041

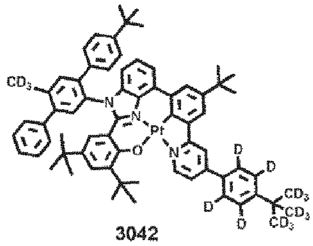
3042

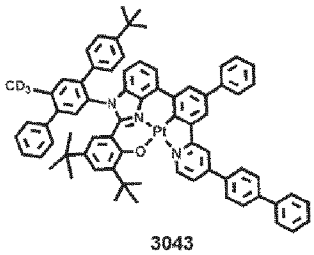
3043

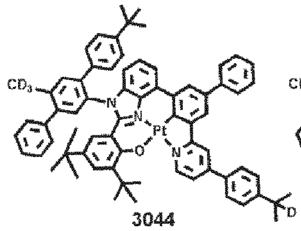
3044

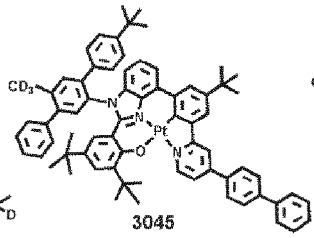
3045

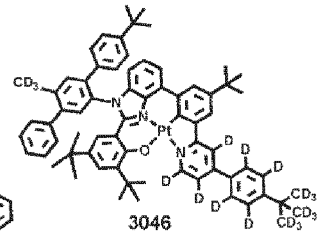
3046

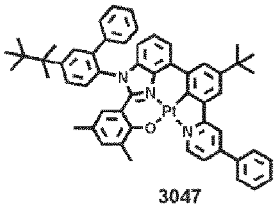
3047

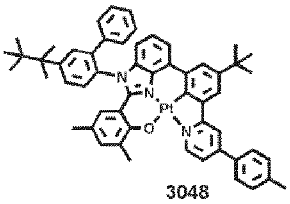
3048

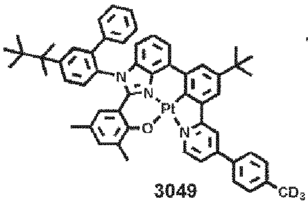
3049

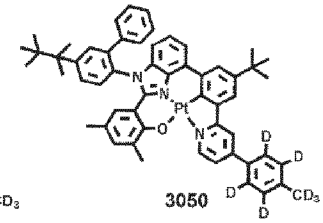
3050

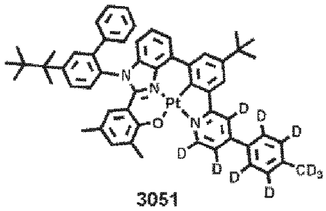
3051

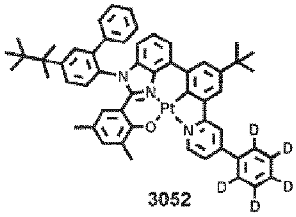
3052

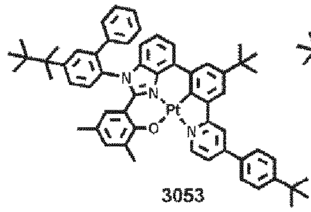
3053

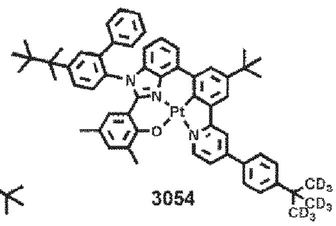
3054

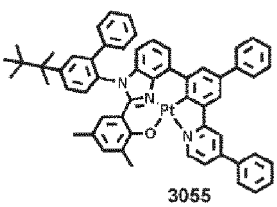
3055

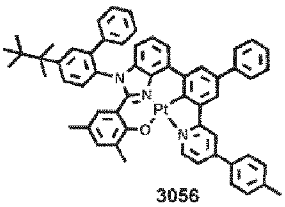
3056

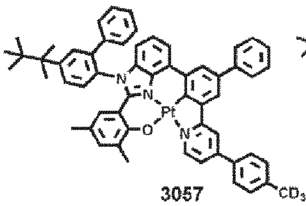
3057

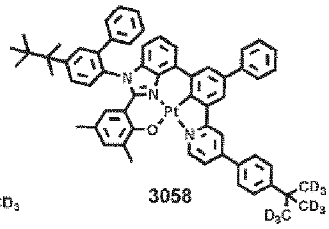
3058

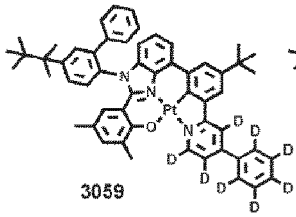

3059

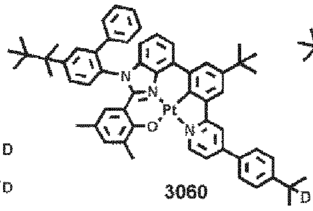

3060

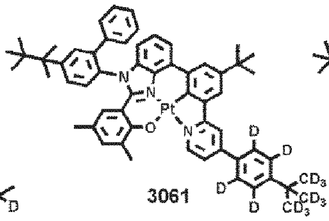

3061

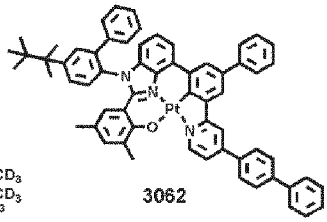

3062

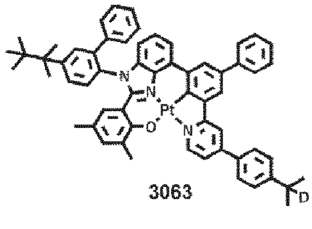

3063

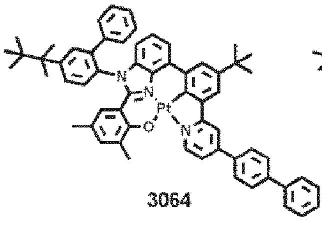

3064

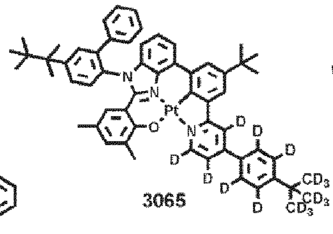

3065

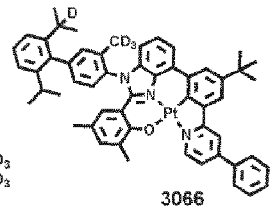

3066

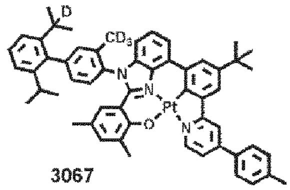

3067

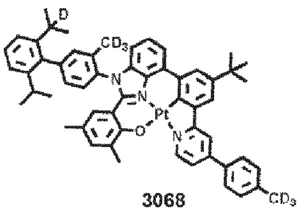

3068

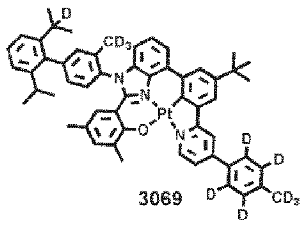

3069

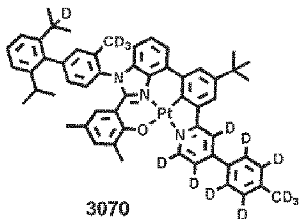

3070

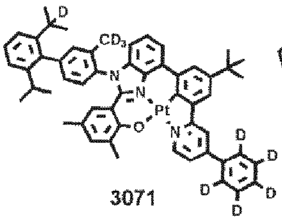

3071

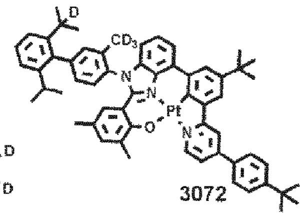

3072

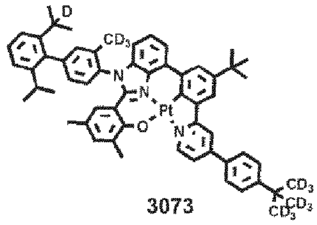

3073

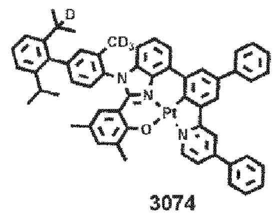

3074

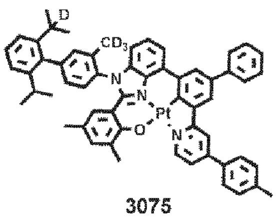

3075

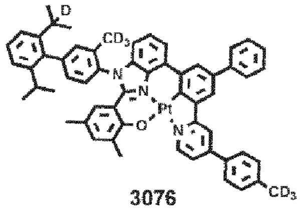

3076

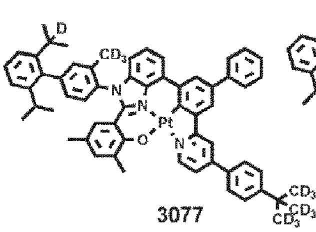

3077

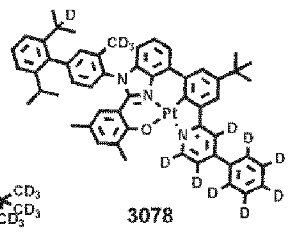

3078

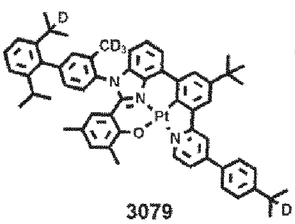

3079

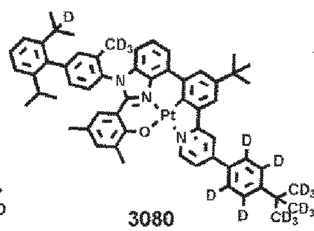

3080

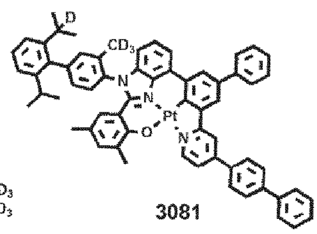

3081

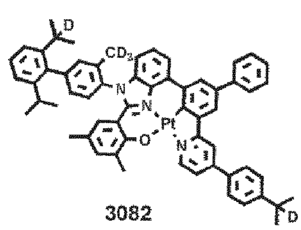

3082

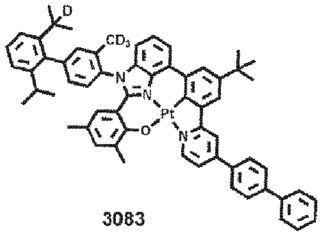
3083

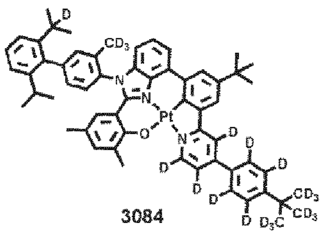
3084

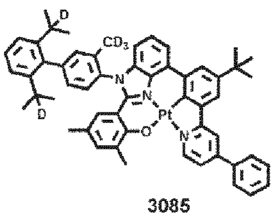
3085

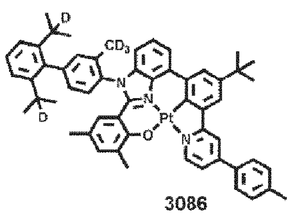
3086

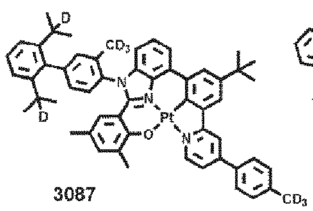
3087

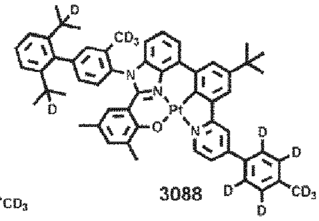
3088

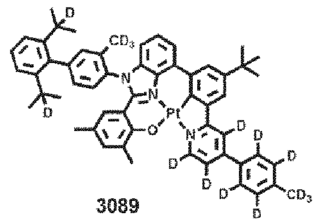
3089

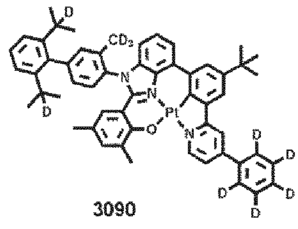
3090

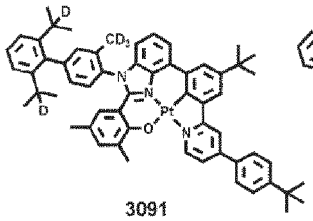
3091

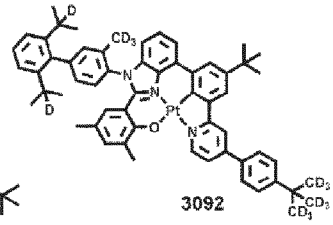
3092

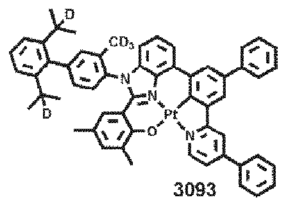
3093

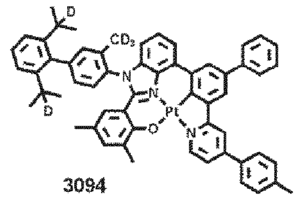
3094

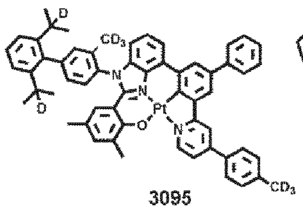
3095

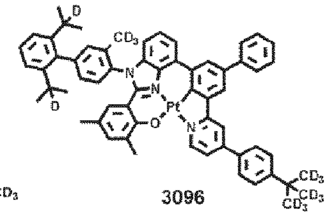
3096

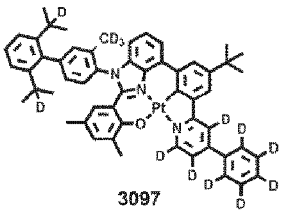
3097

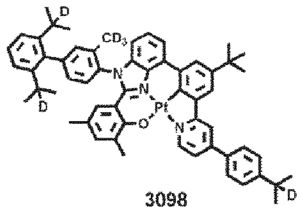
3098

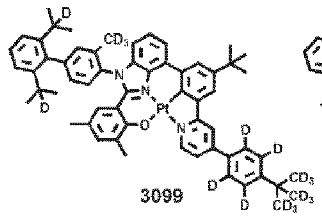
3099

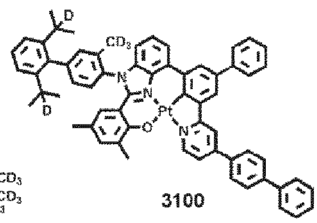
3100

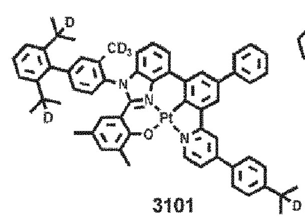
3101

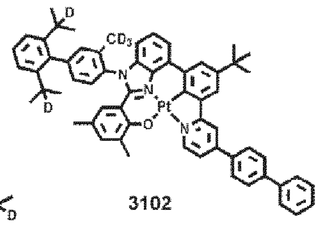
3102

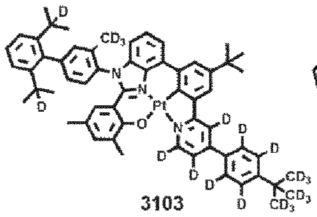
3103

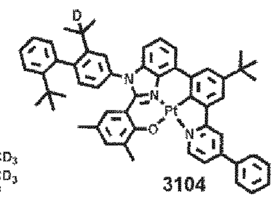
3104

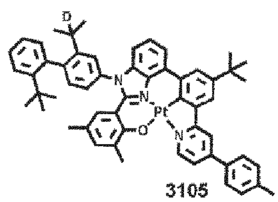
3105

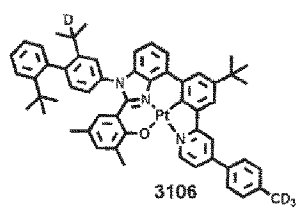
3106

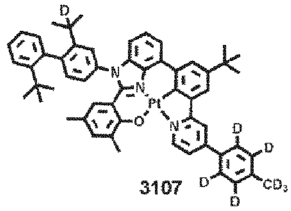
3107

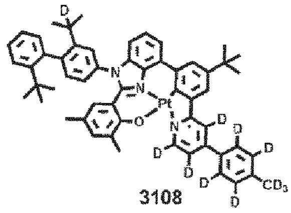
3108

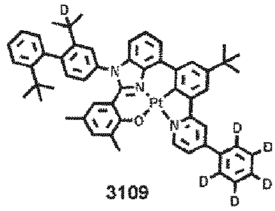
3109

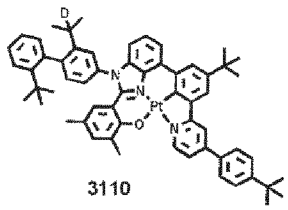
3110

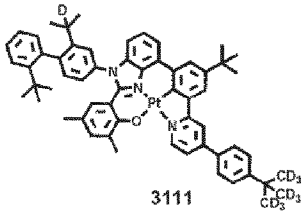
3111

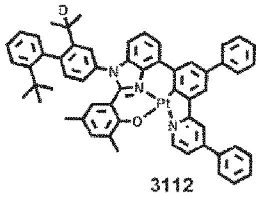
3112

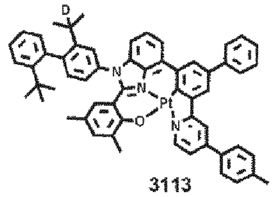
3113

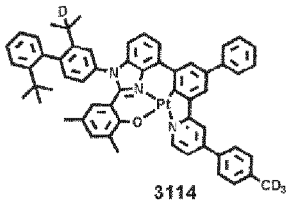
3114

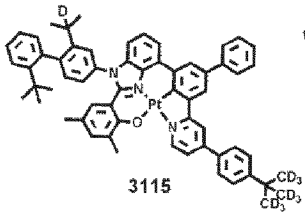
3115

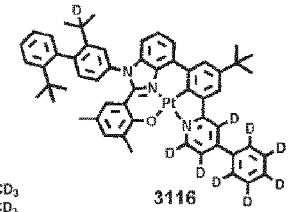
3116

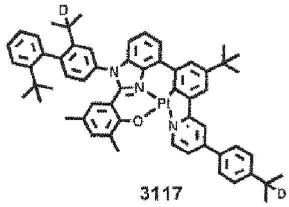
3117

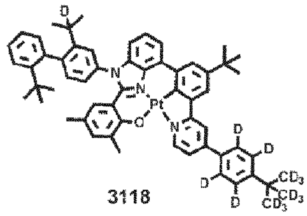
3118

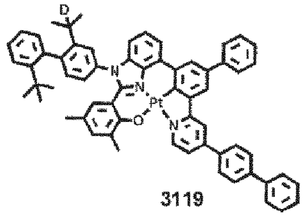
3119

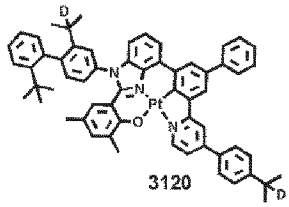
3120

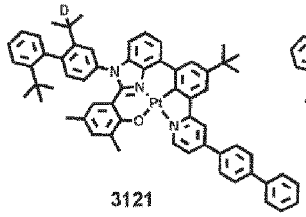
3121

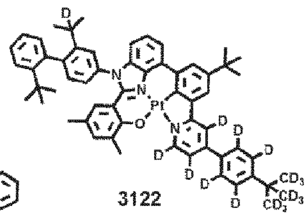
3122

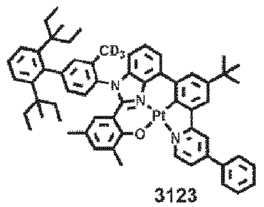
3123

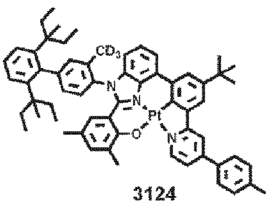
3124

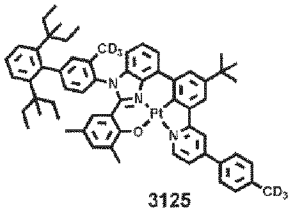
3125

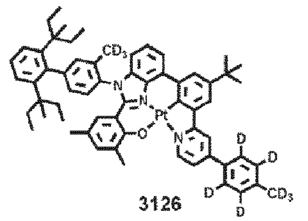
3126

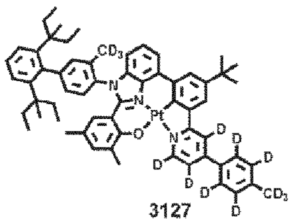
3127

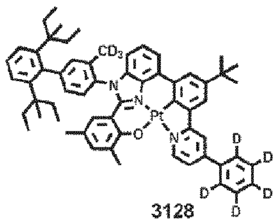
3128

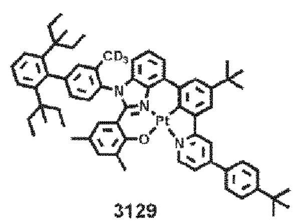
3129

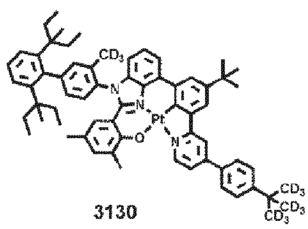
3130

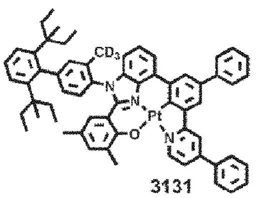
3131
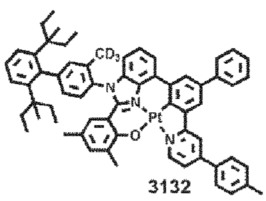
3132
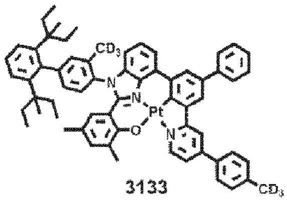
3133
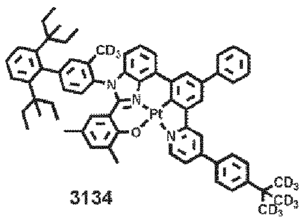
3134

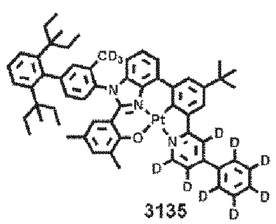
3135
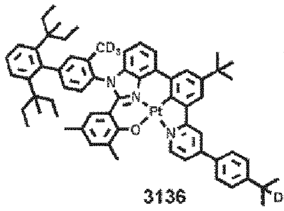
3136
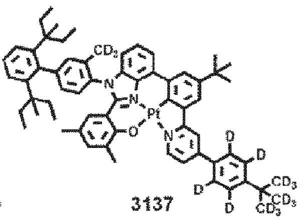
3137
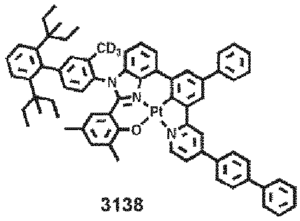
3138

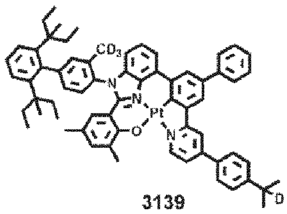
3139
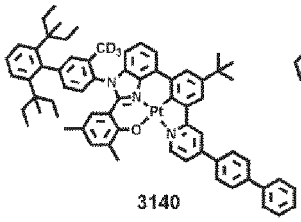
3140
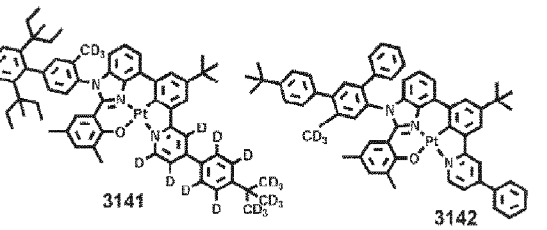
3141

3142

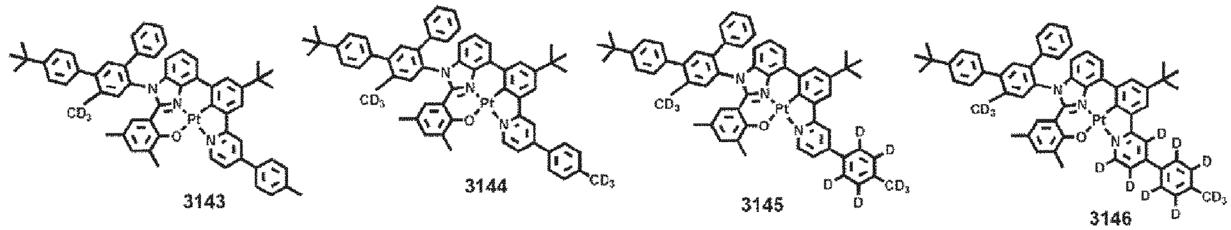
3143

3144

3145

3146

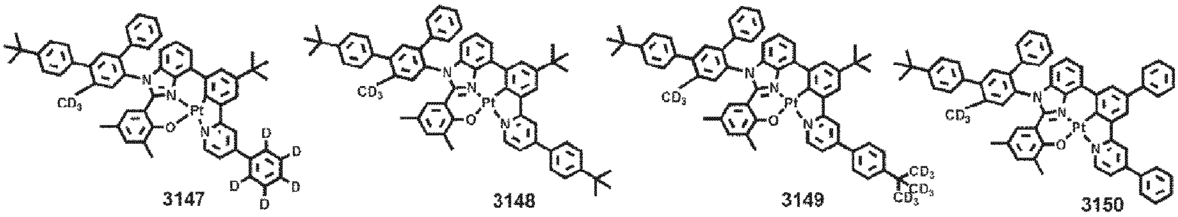
3147

3148

3149

3150

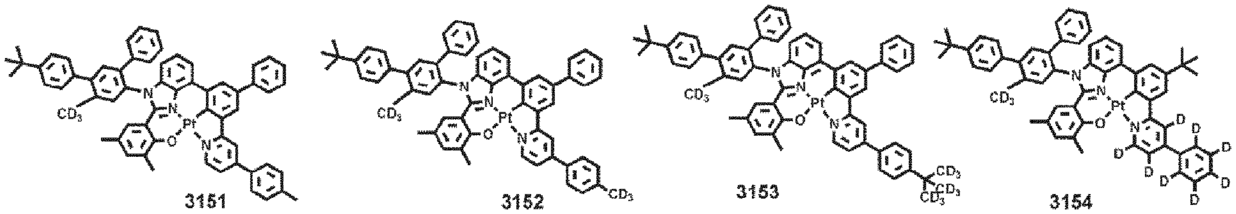
3151

3152

3153

3154

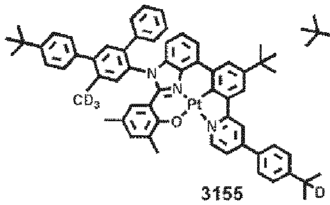
3155

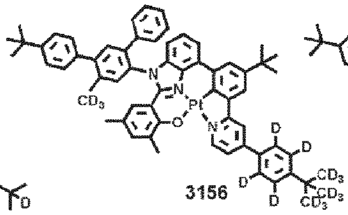
3156

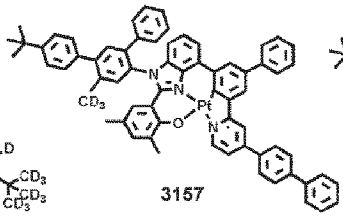
3157

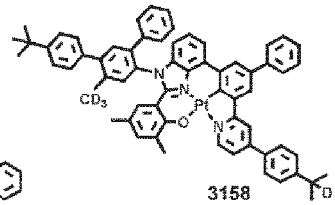
3158

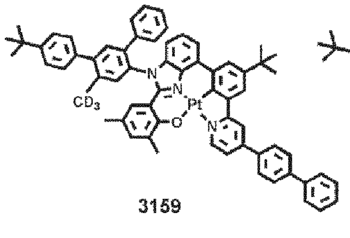
3159

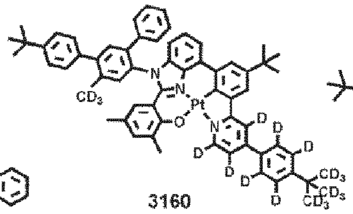
3160

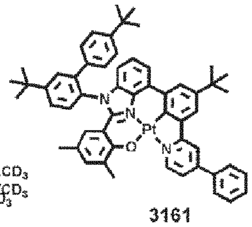
3161

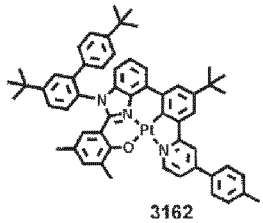
3162

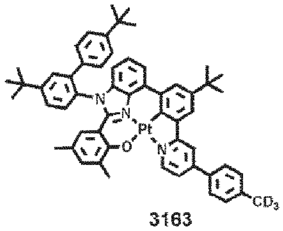
3163

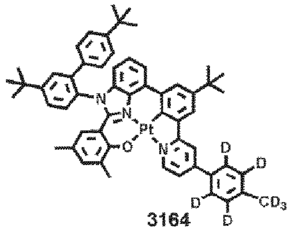
3164

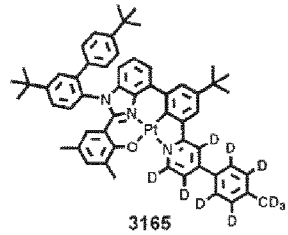
3165

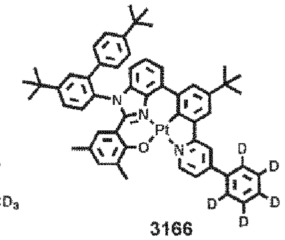
3166

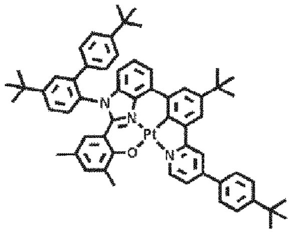
3167

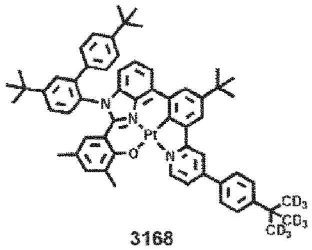
3168

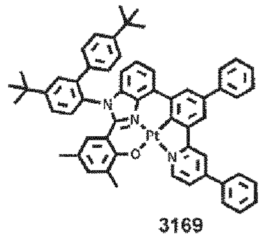
3169

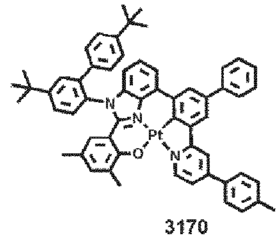
3170

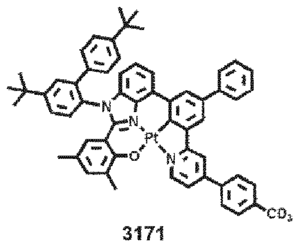
3171

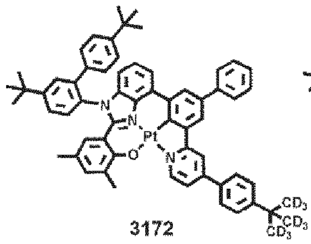
3172

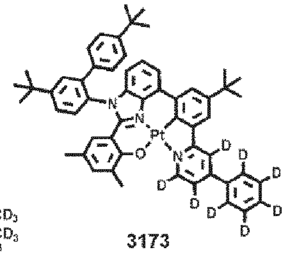
3173

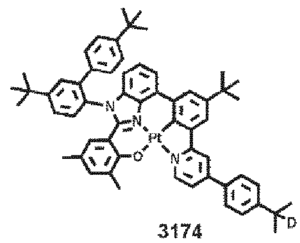
3174

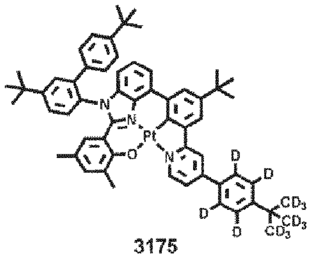
3175

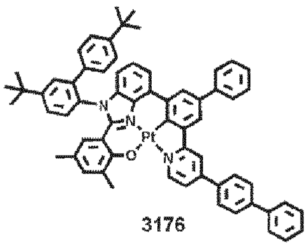
3176

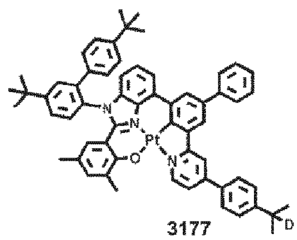
3177

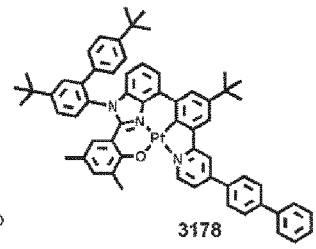
3178

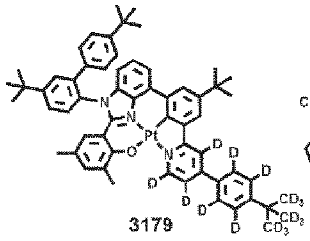
3179

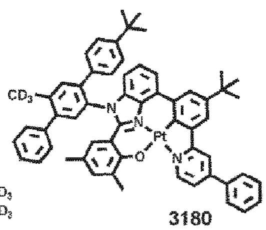
3180

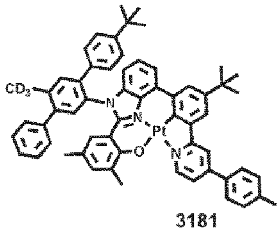
3181

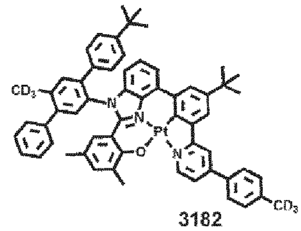
3182

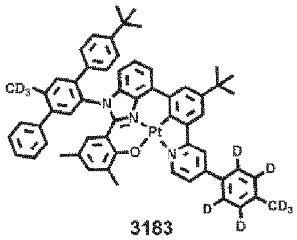
3183

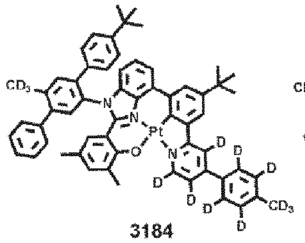
3184

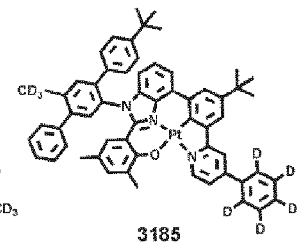
3185

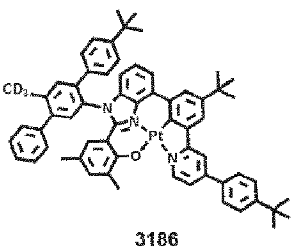
3186

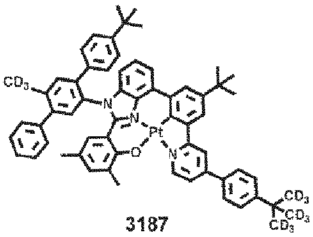
3187

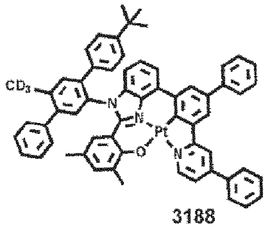
3188

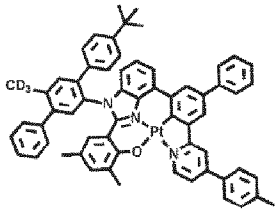
3189

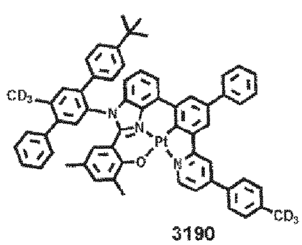
3190

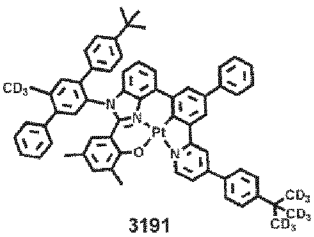
3191

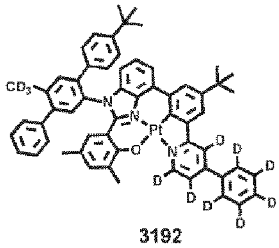
3192

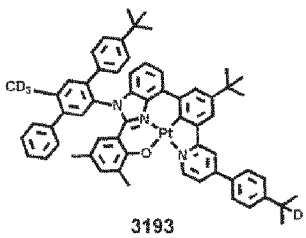
3193

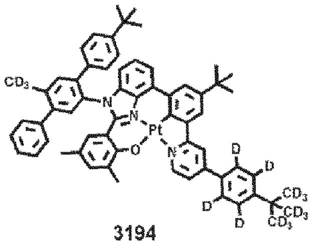
3194

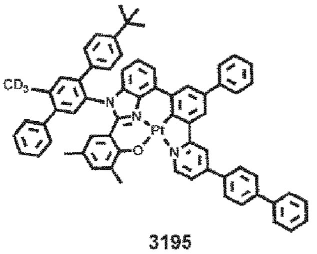
3195

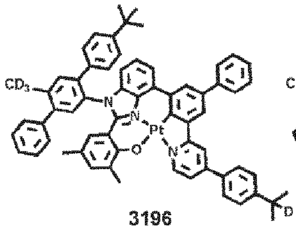
3196

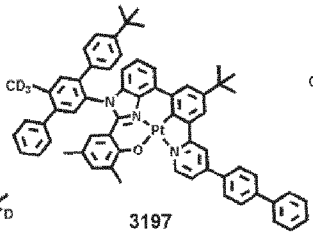
3197

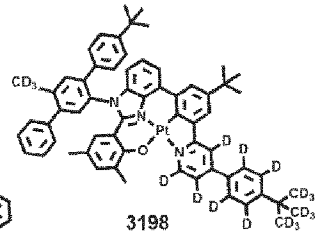
3198

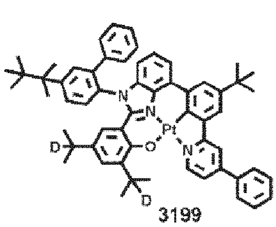
3199

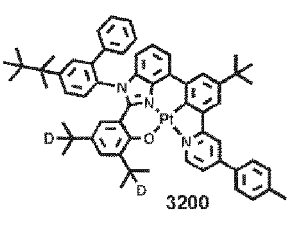
3200

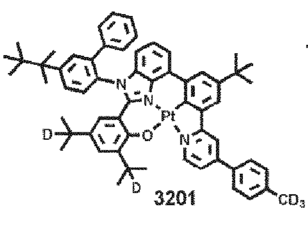
3201

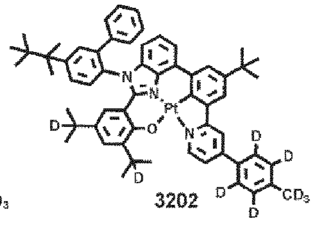
3202

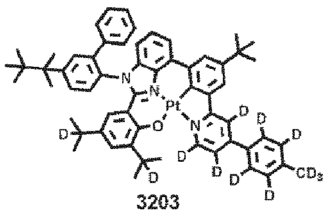
3203

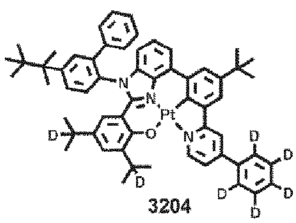
3204

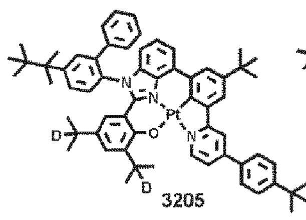
3205

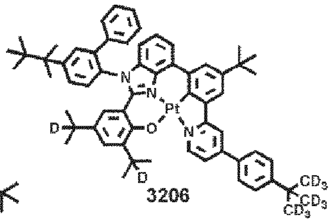
3206

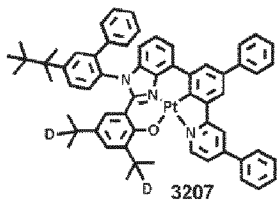
3207

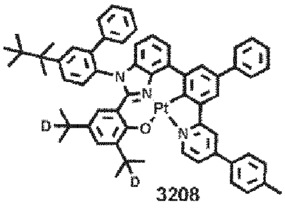
3208

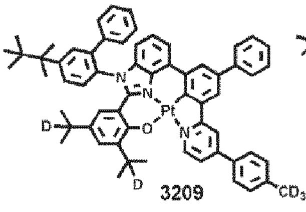
3209

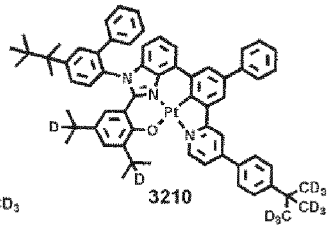
3210

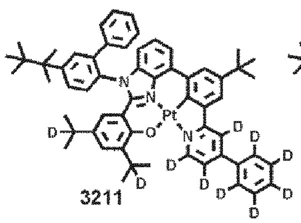
3211

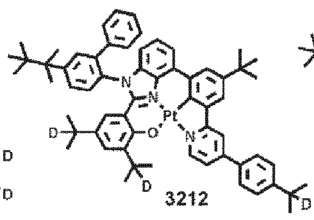
3212

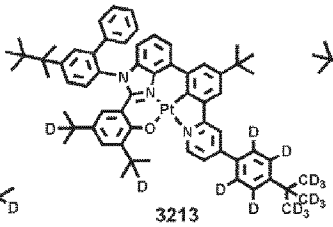
3213

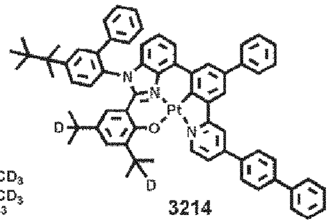
3214

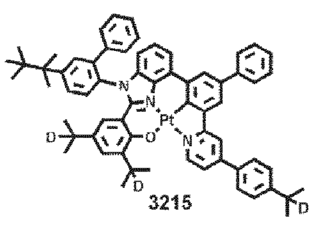
3215

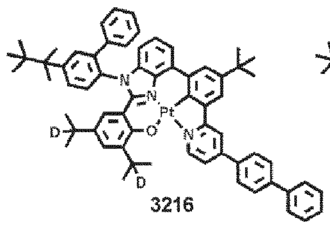
3216

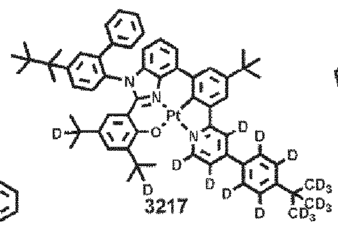
3217

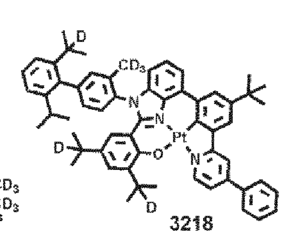
3218

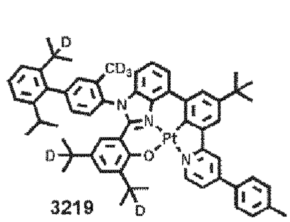
3219

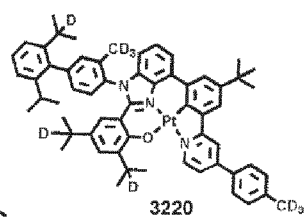
3220

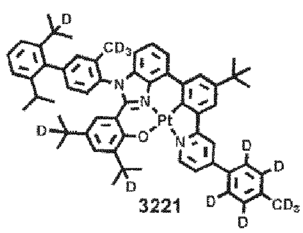
3221

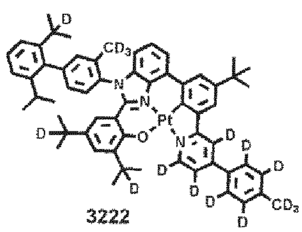
3222

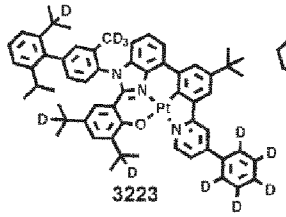
3223

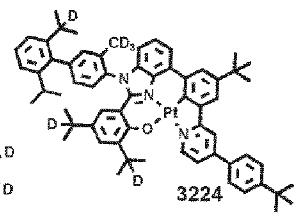
3224

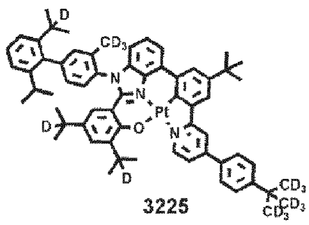
3225

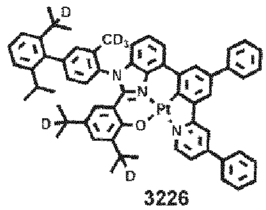
3226

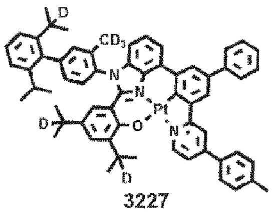
3227

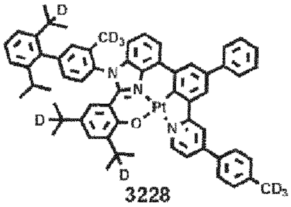
3228

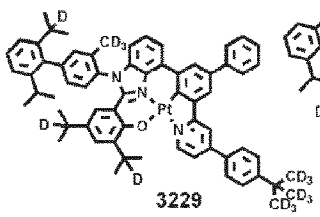
3229

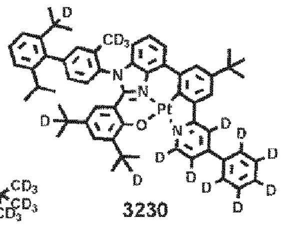
3230

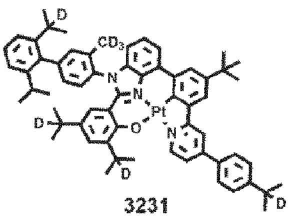
3231

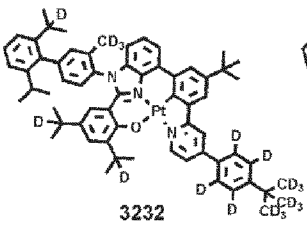
3232

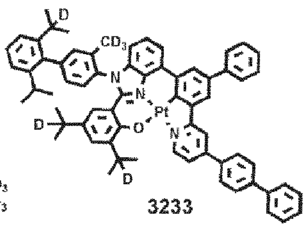
3233

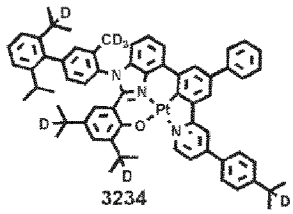
3234

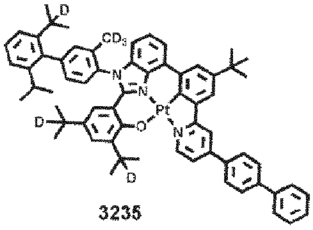
3235

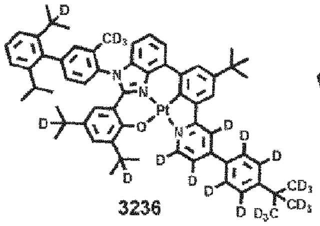
3236

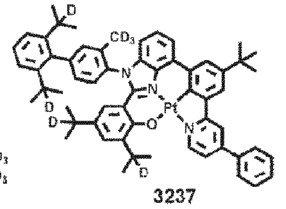
3237

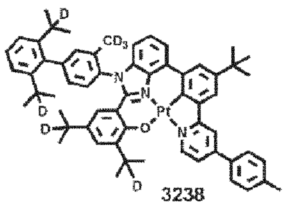
3238

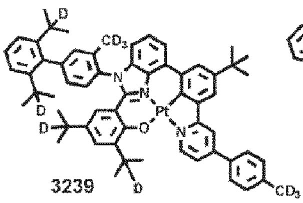
3239

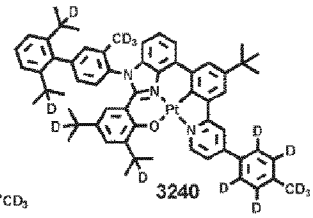
3240

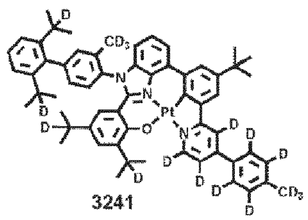
3241

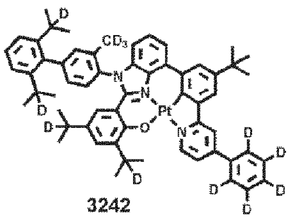
3242

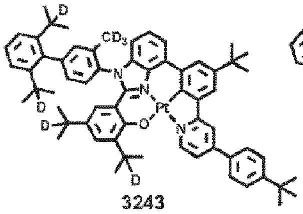
3243

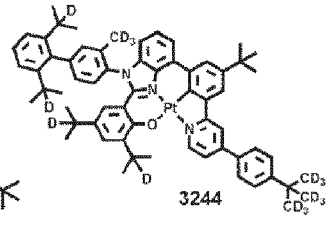
3244

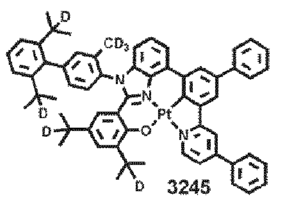
3245

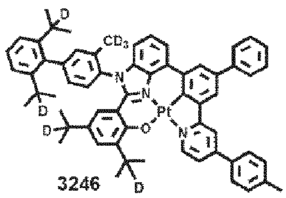
3246

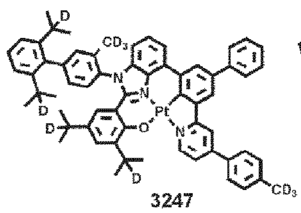
3247

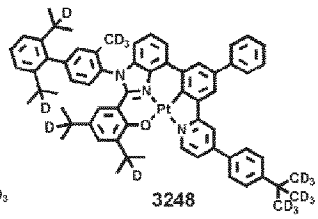
3248

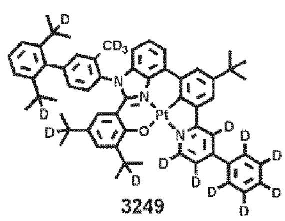
3249

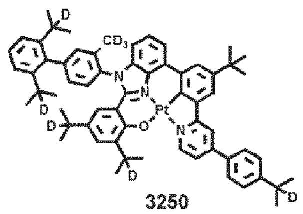
3250

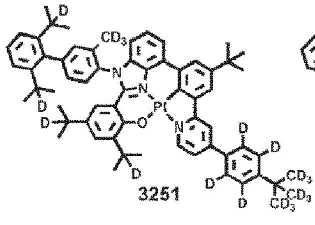
3251

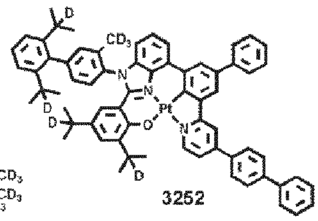
3252

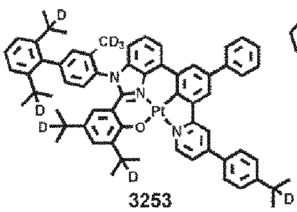
3253

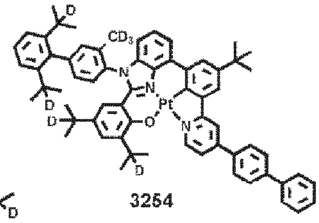
3254

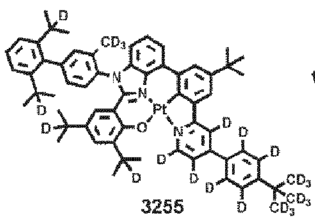
3255

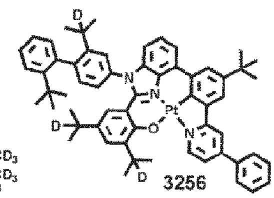
3256

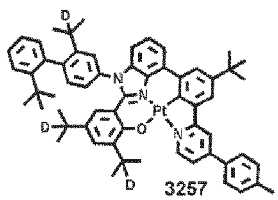
3257

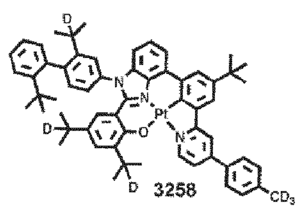
3258

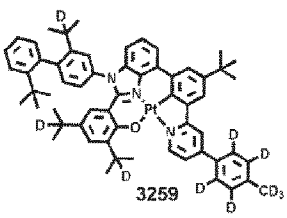
3259

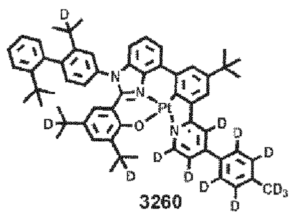
3260

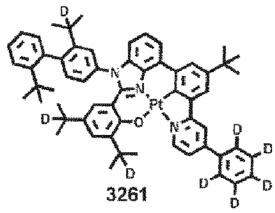
3261

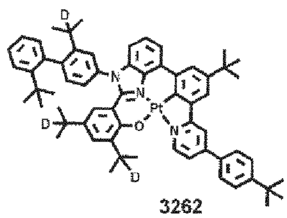
3262

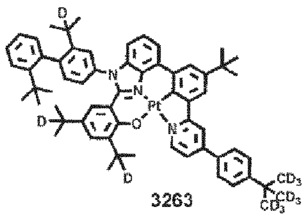
3263

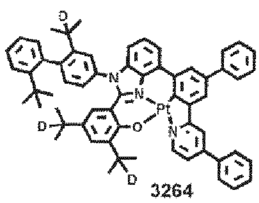
3264

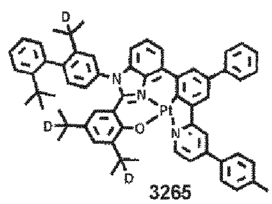
3265

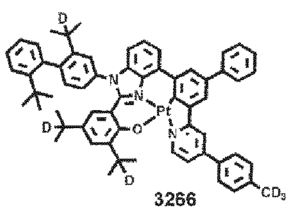
3266

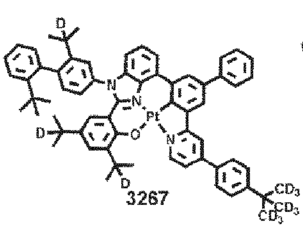
3267

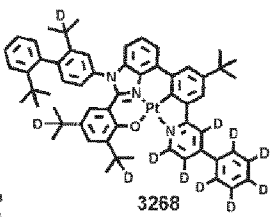
3268

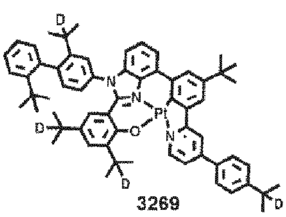
3269

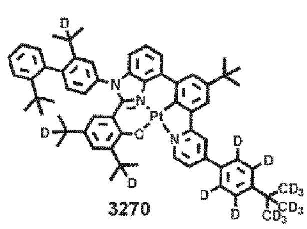
3270

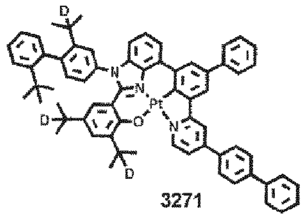
3271

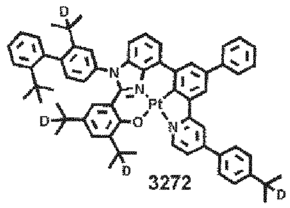
3272

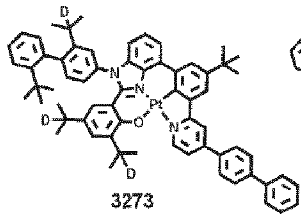
3273

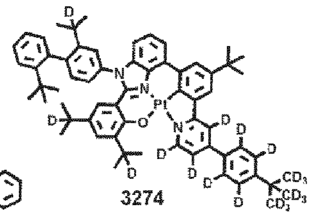
3274

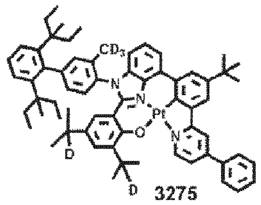
3275

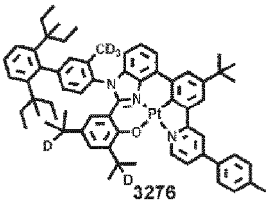
3276

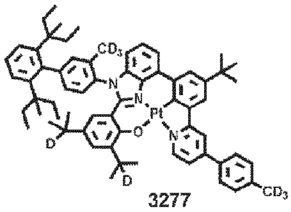
3277

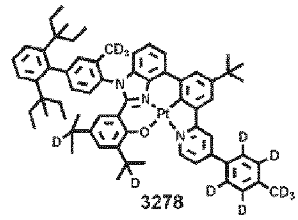
3278

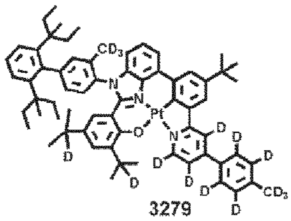
3279

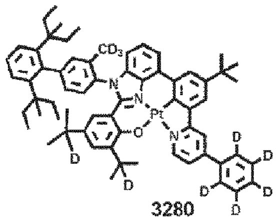
3280

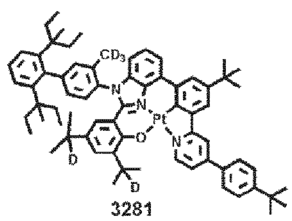
3281

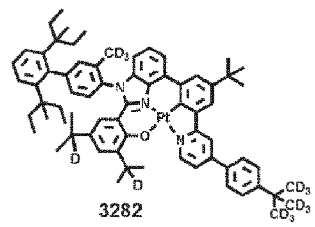
3282

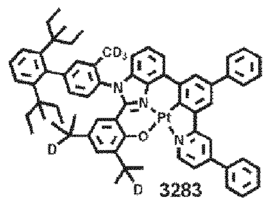
3283

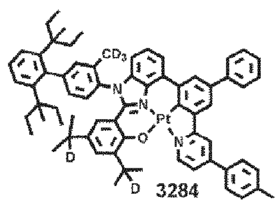
3284

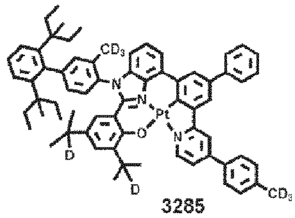
3285

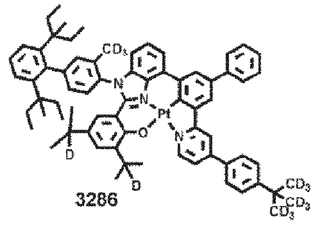
3286

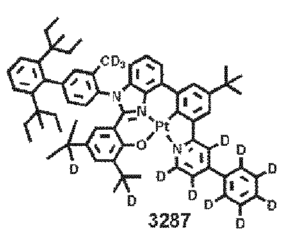
3287

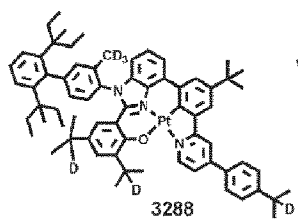
3288

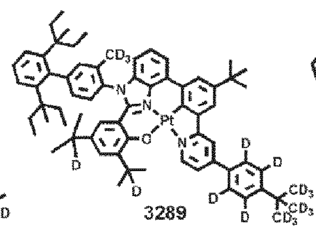
3289

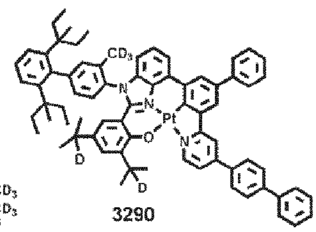
3290

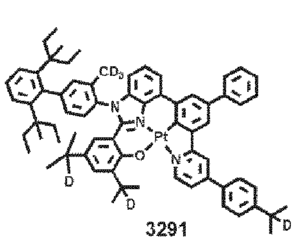
3291

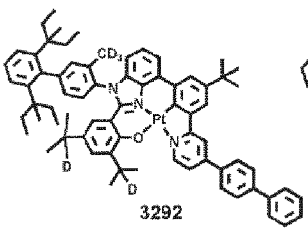
3292

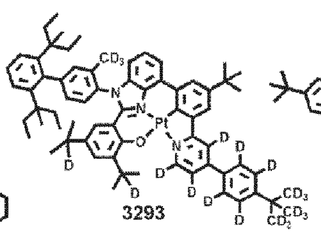
3293

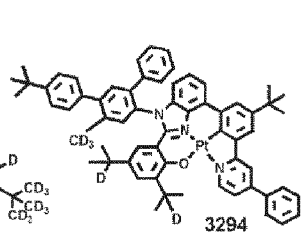
3294

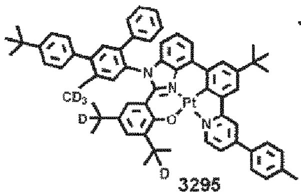
3295

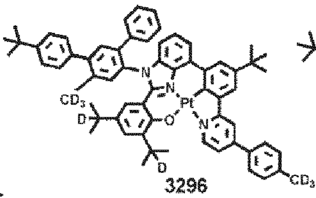
3296

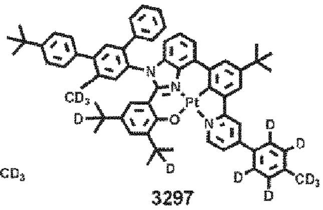
3297

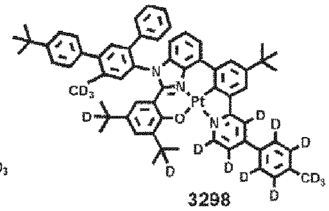
3298

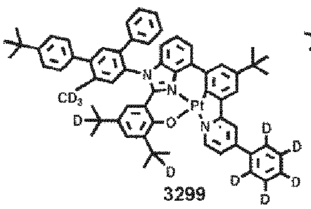
3299

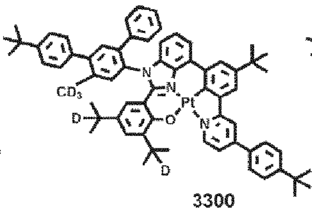
3300

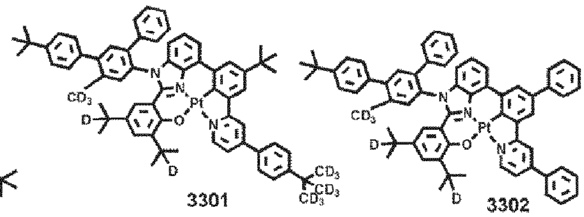
3301

3302

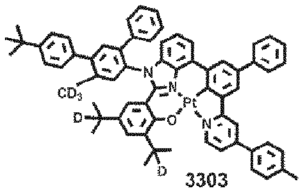
3303

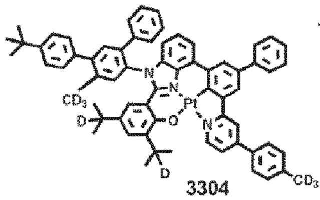
3304

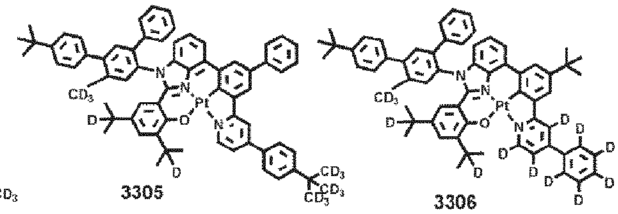
3305

3306

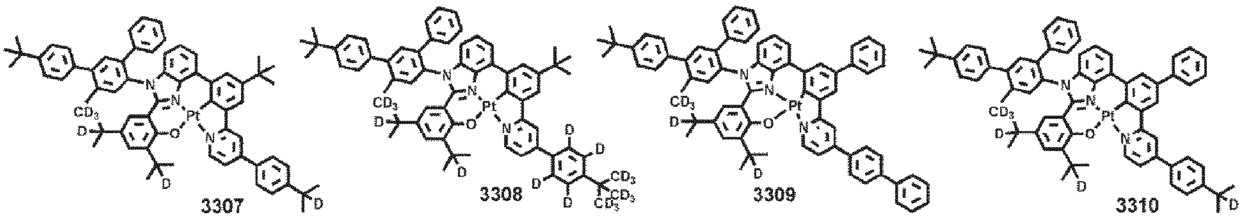
3307

3308

3309

3310

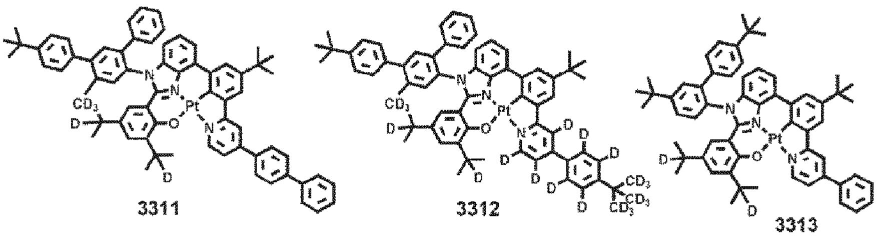
3311

3312

3313

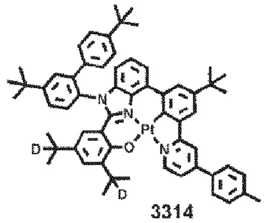
3314

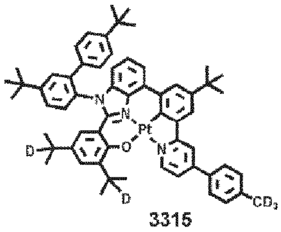
3315

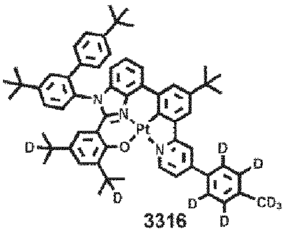
3316

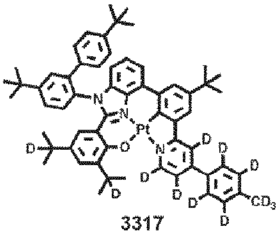
3317

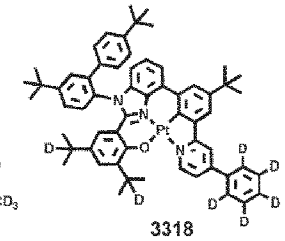
3318

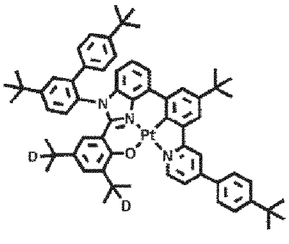

3319

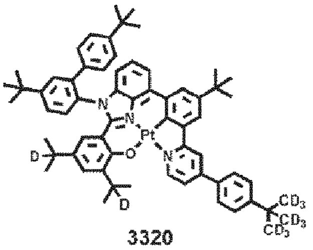

3320

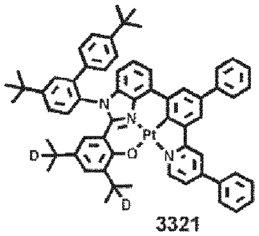

3321

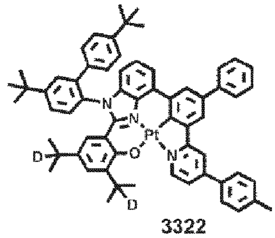

3322

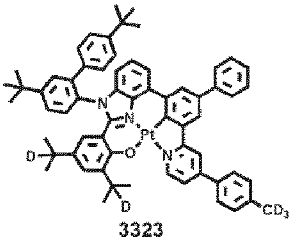

3323

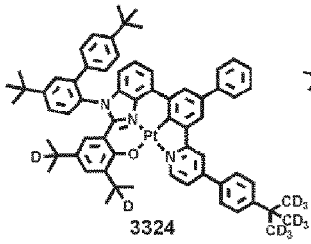

3324

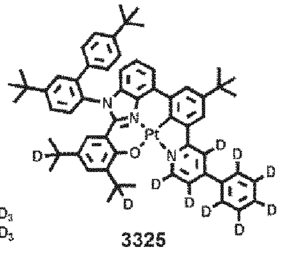

3325

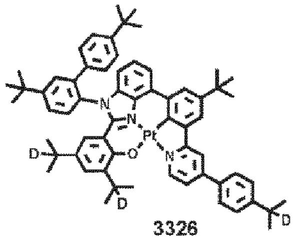

3326

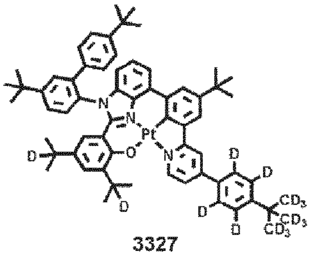

3327

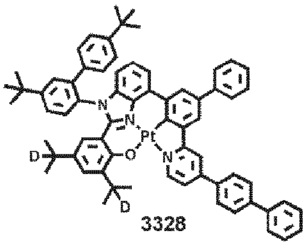

3328

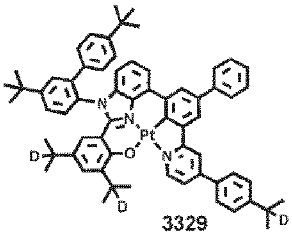

3329

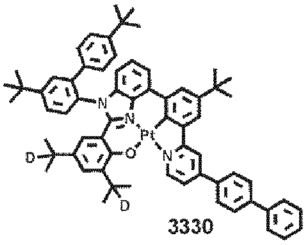

3330

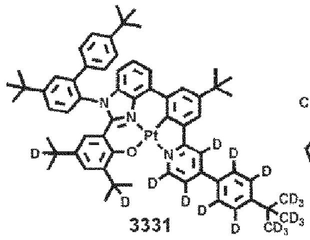

3331

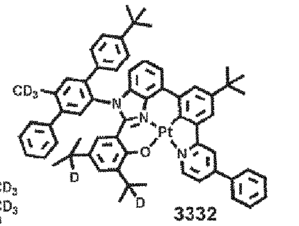

3332

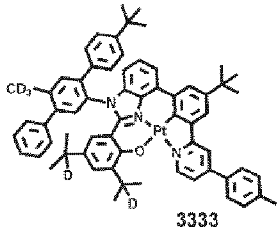

3333

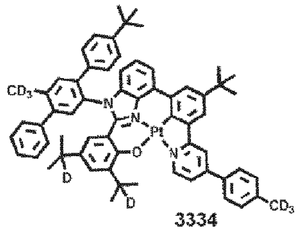

3334

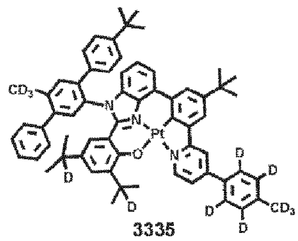

3335

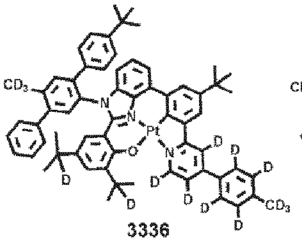

3336

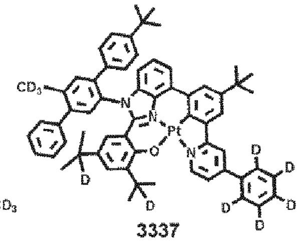

3337

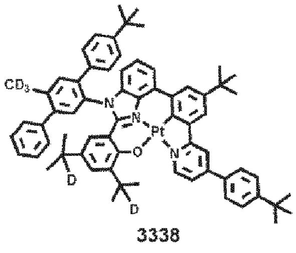

3338

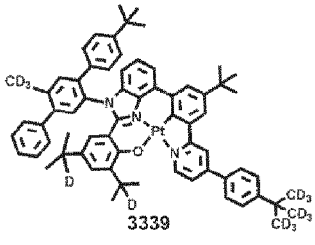

3339

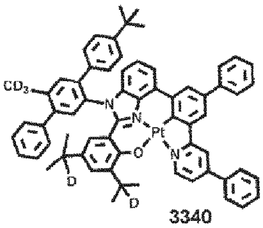

3340

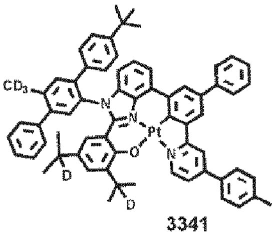

3341

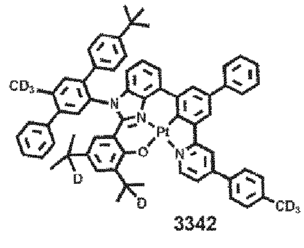

3342

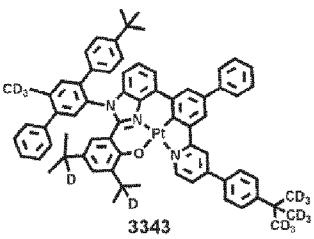
3343

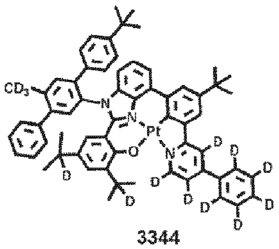
3344

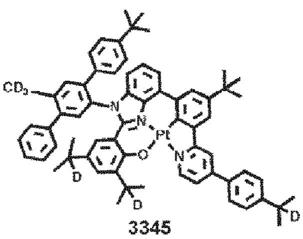
3345

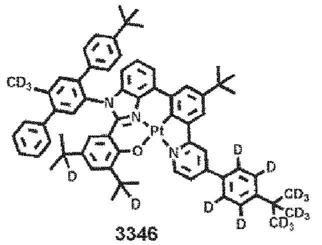
3346

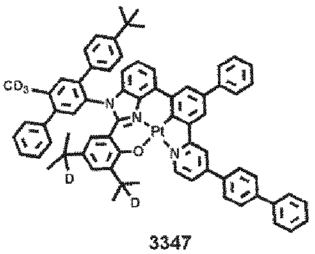
3347

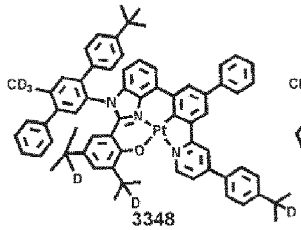
3348

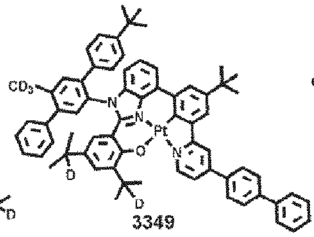
3349

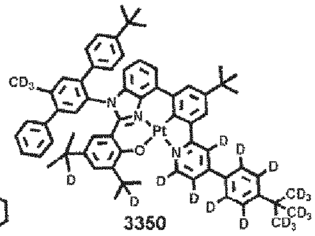
3350

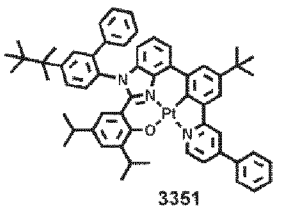
3351

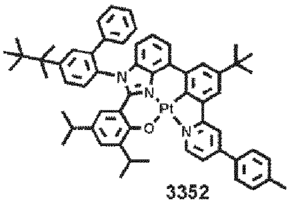
3352

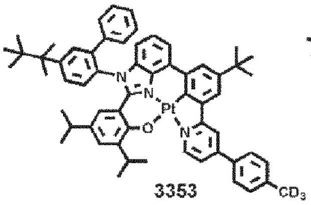
3353

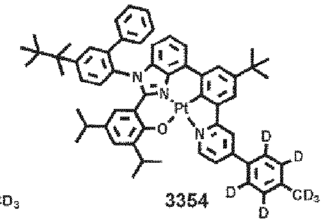
3354

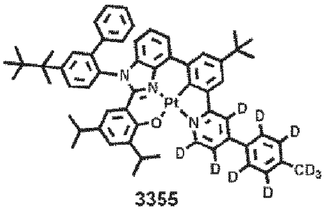
3355

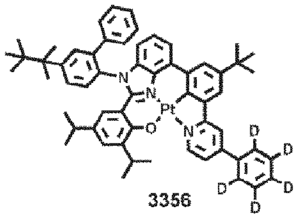
3356

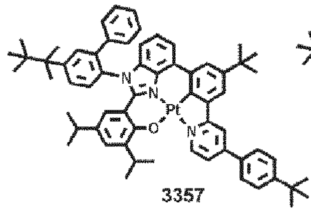
3357

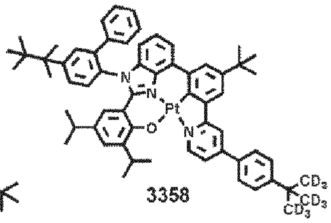
3358

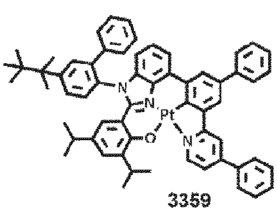
3359

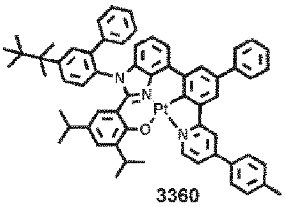
3360

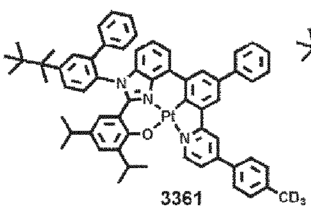
3361

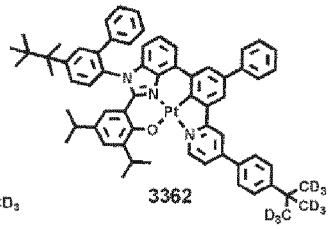
3362

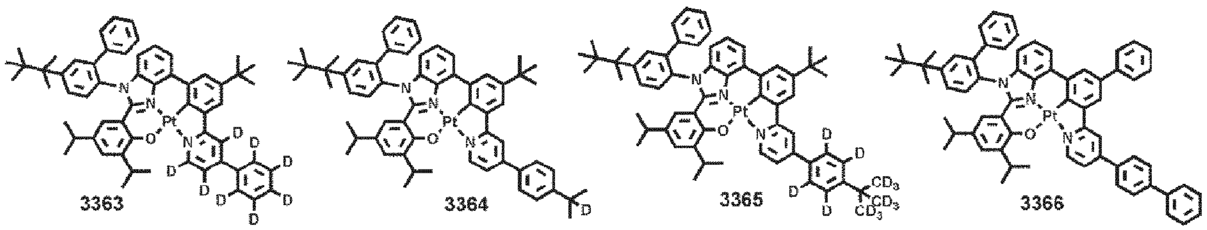

3363 3364 3365 3366

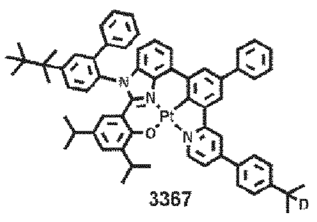

3367

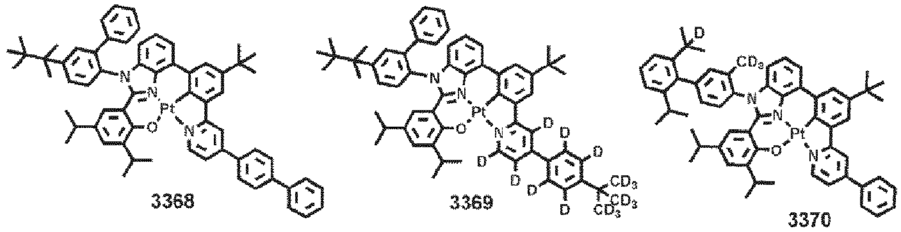

3368 3369 3370

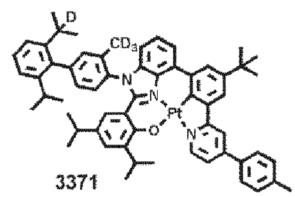

3371

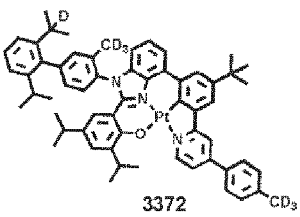

3372

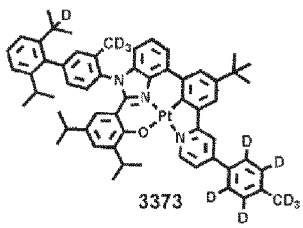

3373

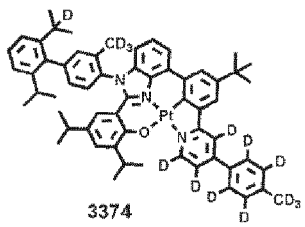

3374

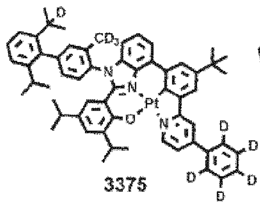

3375

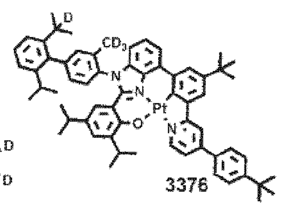

3376

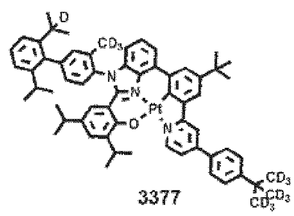

3377

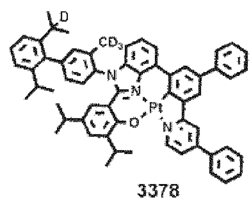

3378

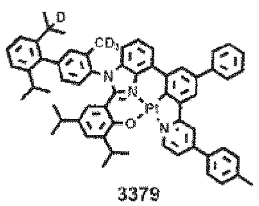

3379

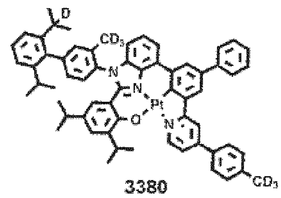

3380

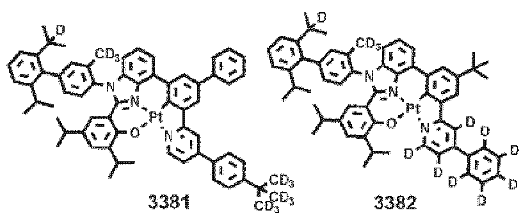

3381 3382

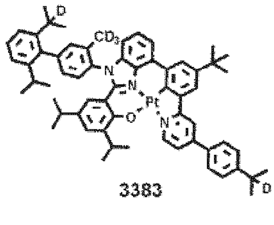

3383

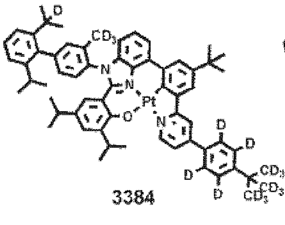

3384

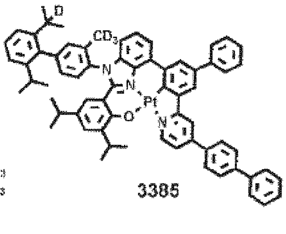

3385

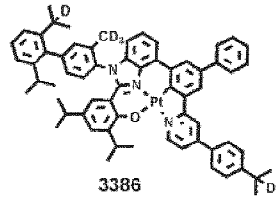

3386

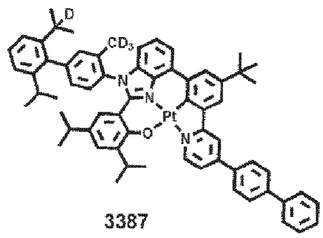
3387

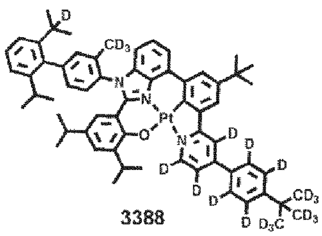
3388

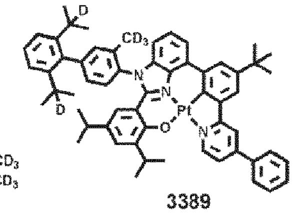
3389

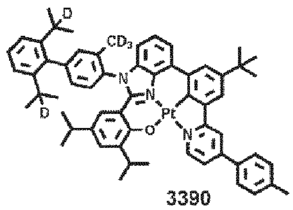
3390

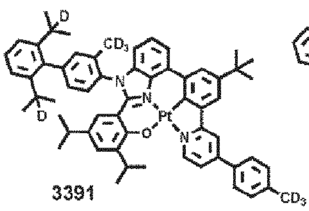
3391

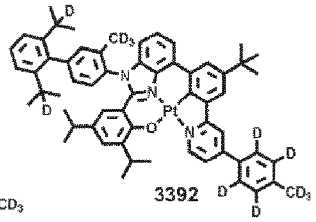
3392

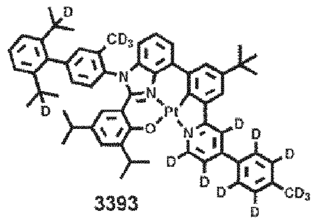
3393

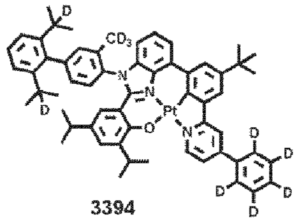
3394

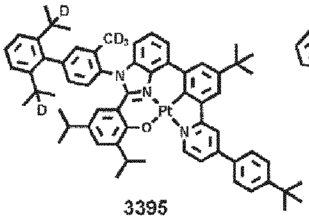
3395

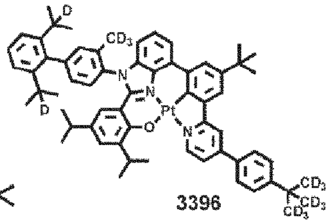
3396

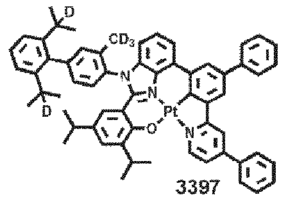
3397

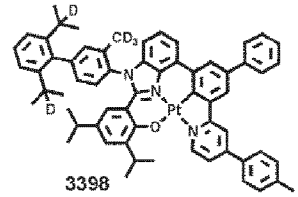
3398

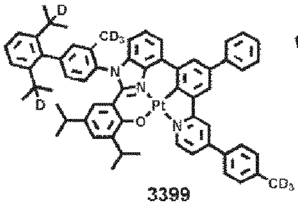
3399

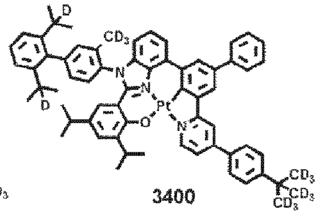
3400

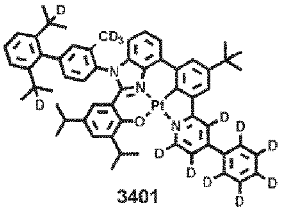
3401

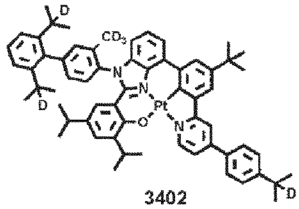
3402

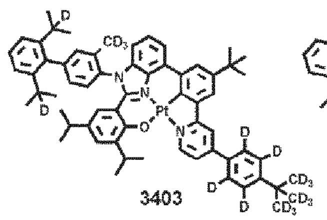
3403

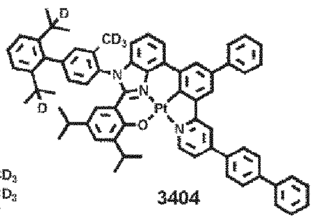
3404

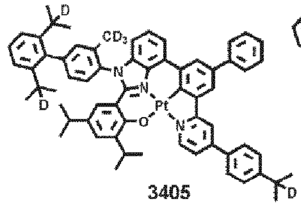
3405

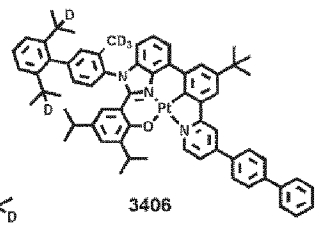
3406

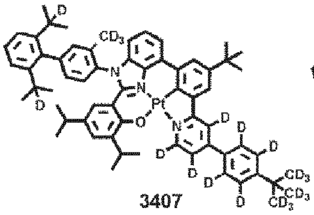
3407

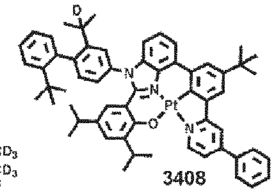
3408

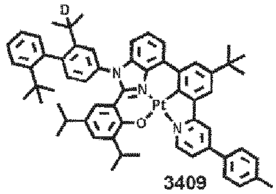
3409

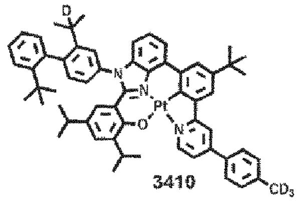
3410

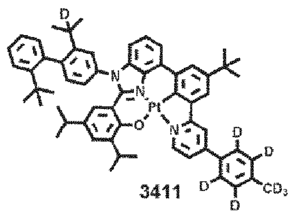
3411

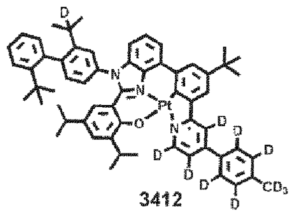
3412

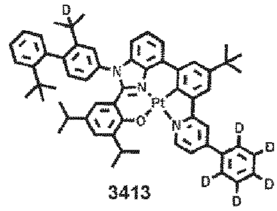
3413

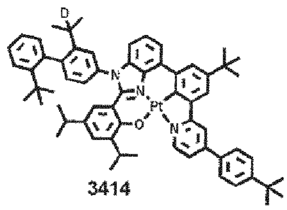
3414

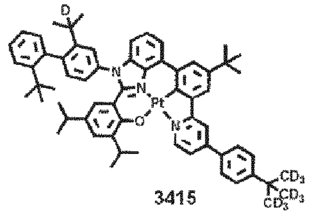
3415

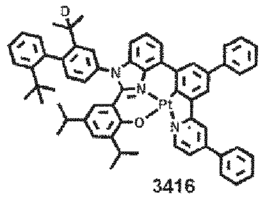
3416

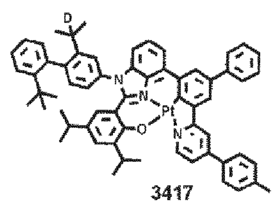
3417

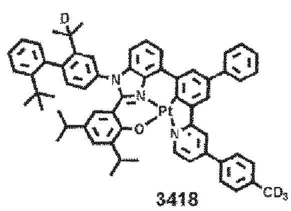
3418

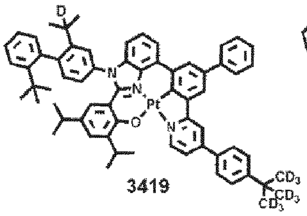
3419

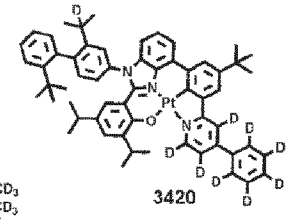
3420

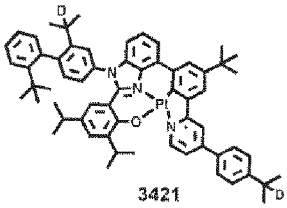
3421

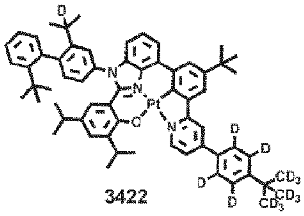
3422

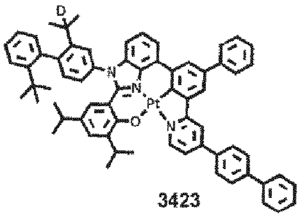
3423

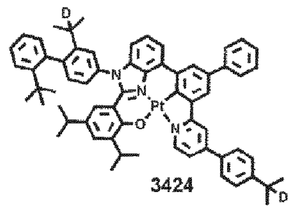
3424

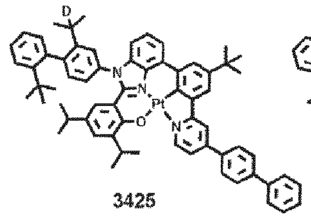
3425

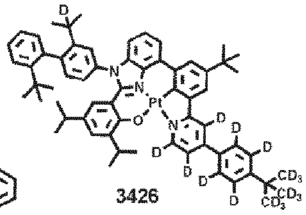
3426

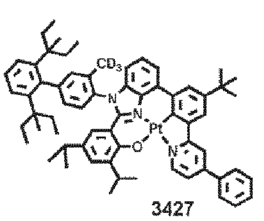
3427

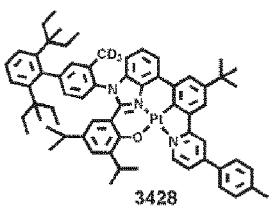
3428

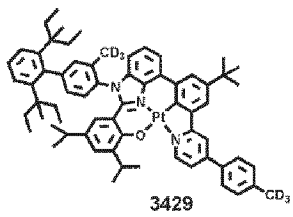
3429

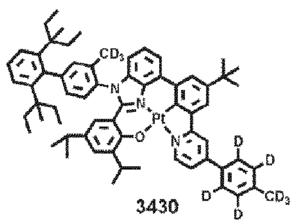
3430

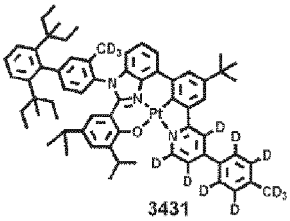
3431

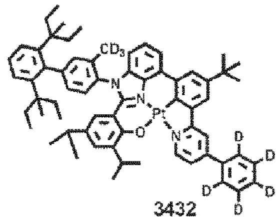
3432

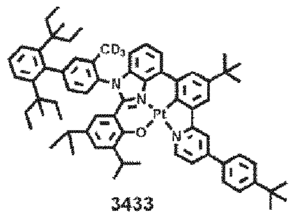
3433

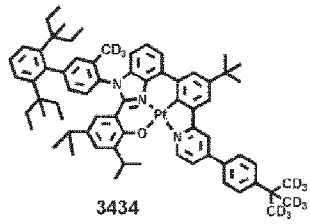
3434

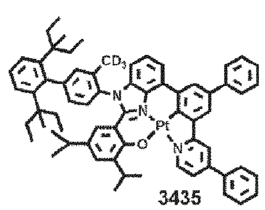
3435

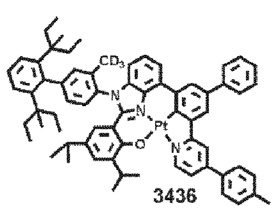
3436

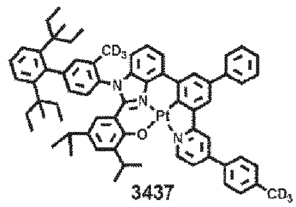
3437

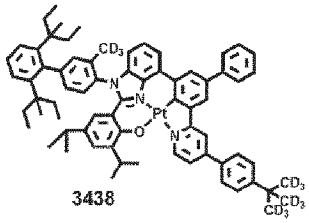
3438

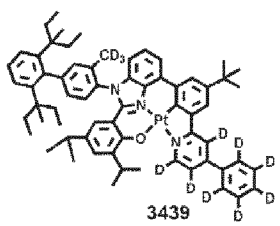
3439

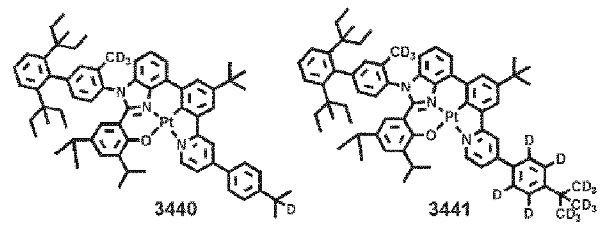
3440

3441

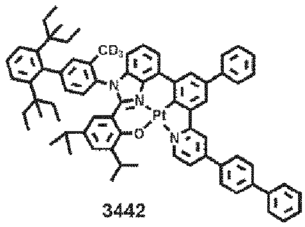
3442

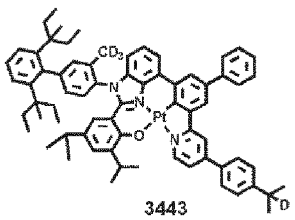
3443

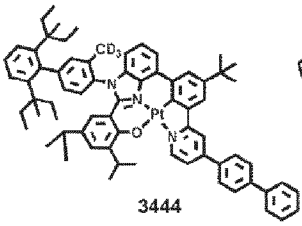
3444

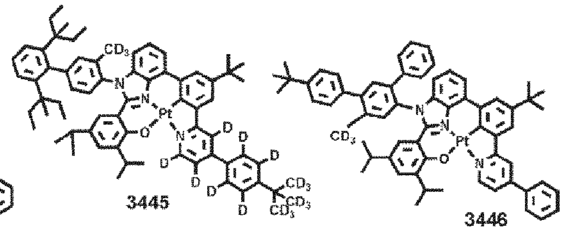
3445

3446

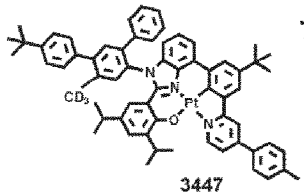
3447

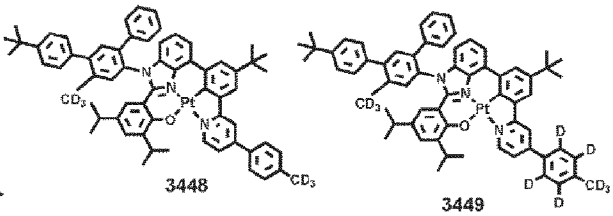
3448

3449

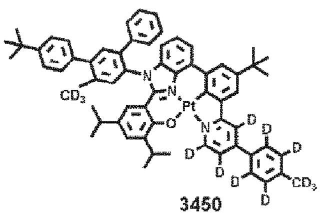
3450

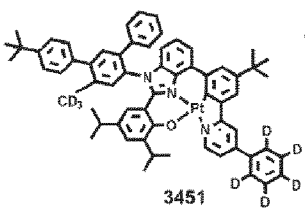
3451

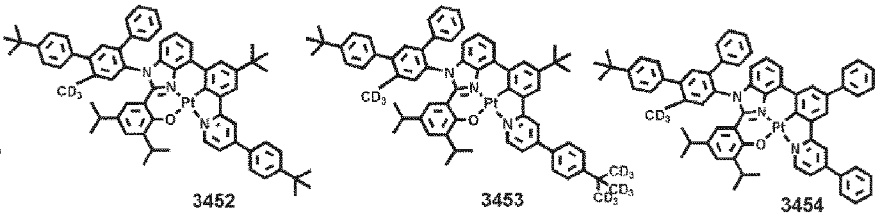
3452

3453

3454

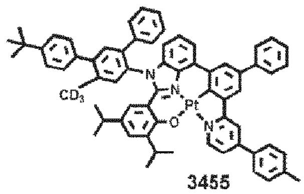
3455

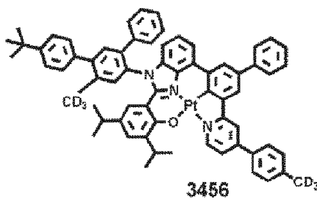
3456

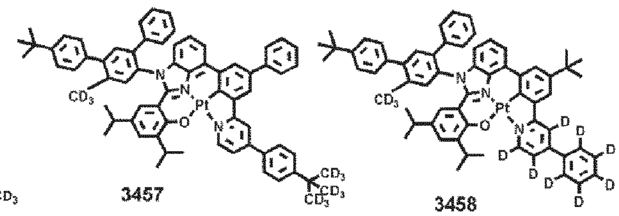
3457

3458

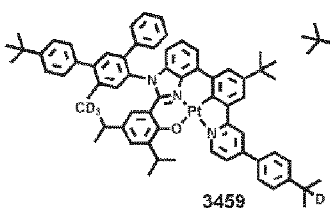
3459
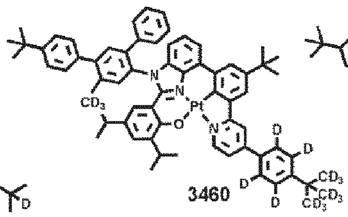
3460
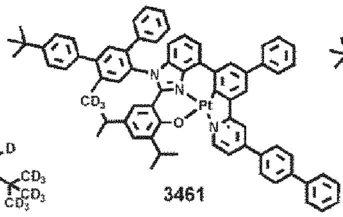
3461
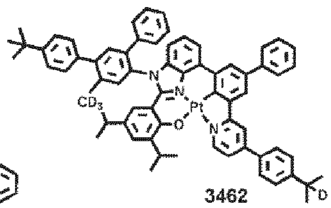
3462

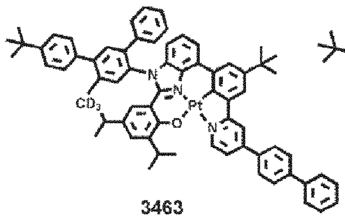
3463
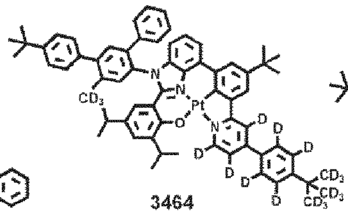
3464
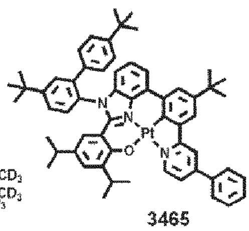
3465
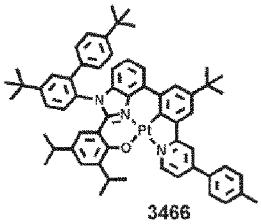
3466

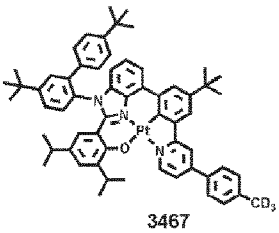
3467
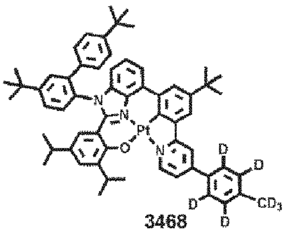
3468
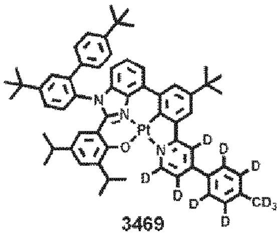
3469
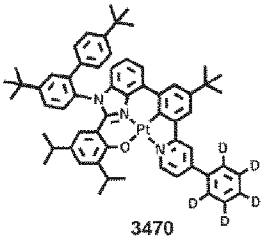
3470

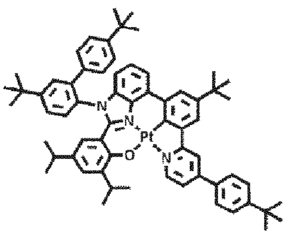
3471
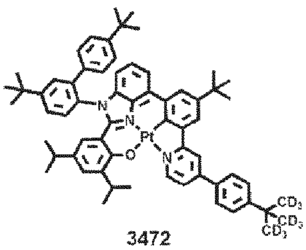
3472
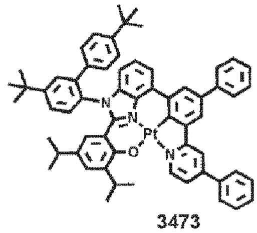
3473
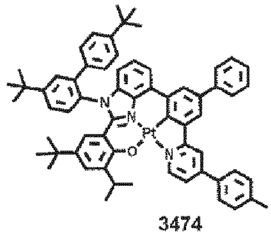
3474

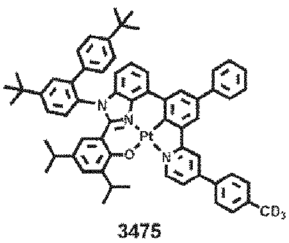
3475
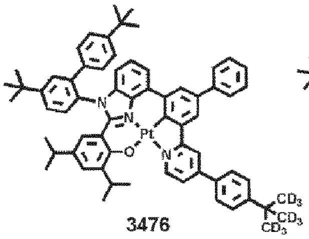
3476
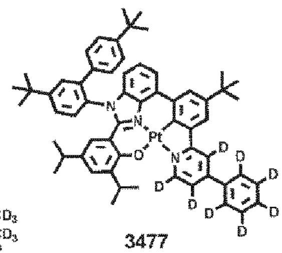
3477
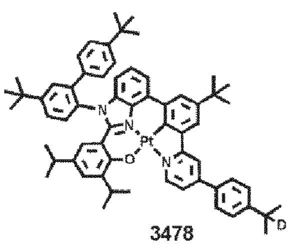
3478

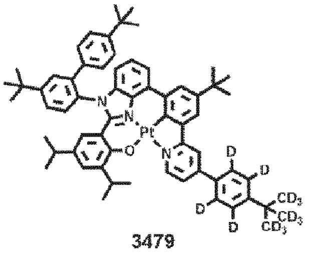
3479
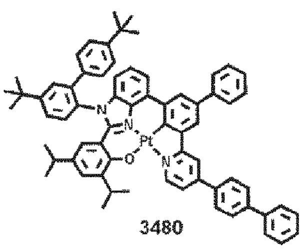
3480
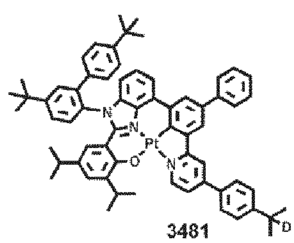
3481
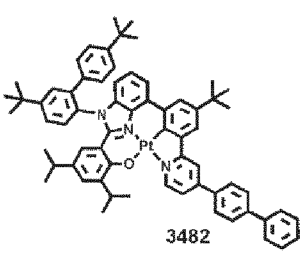
3482

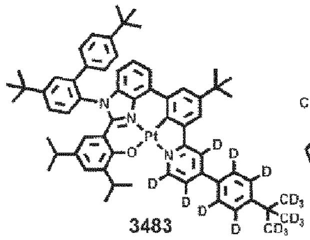
3483

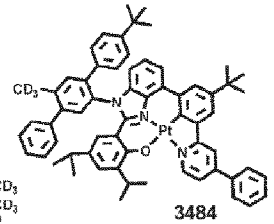
3484

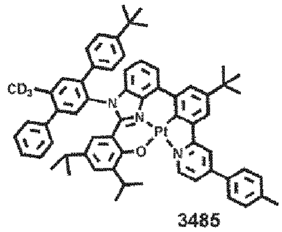
3485

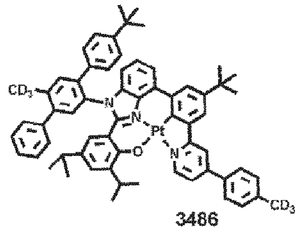
3486

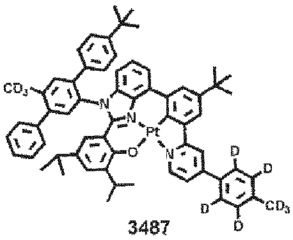
3487

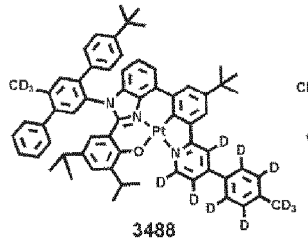
3488

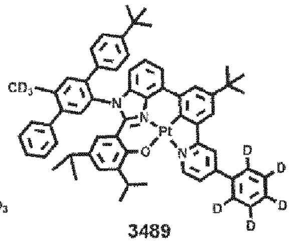
3489

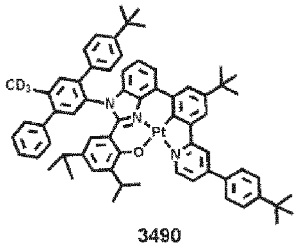
3490

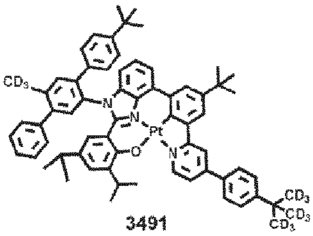
3491

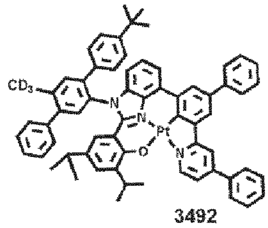
3492

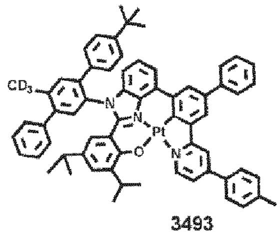
3493

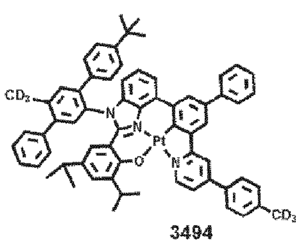
3494

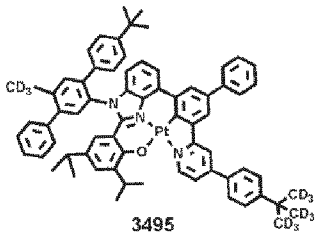
3495

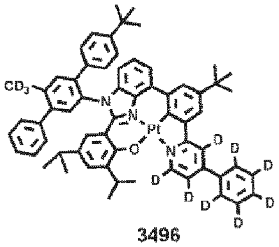
3496

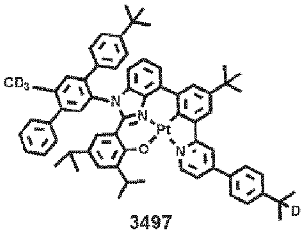
3497

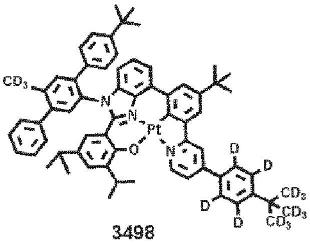
3498

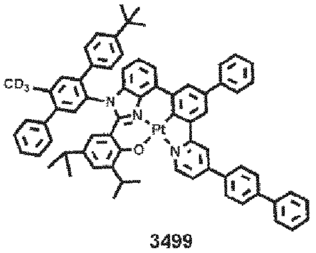
3499

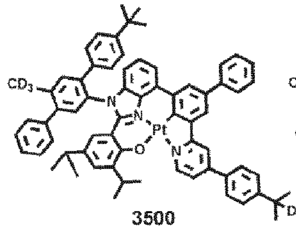
3500

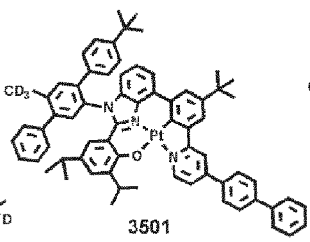
3501

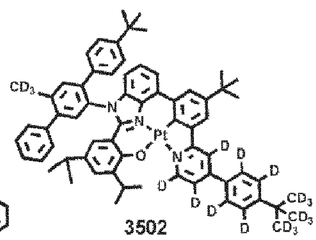
3502

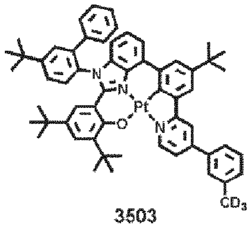
3503

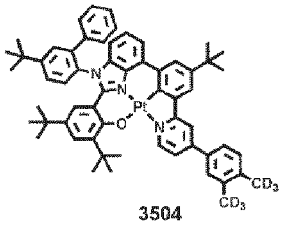
3504

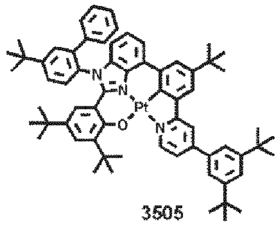
3505

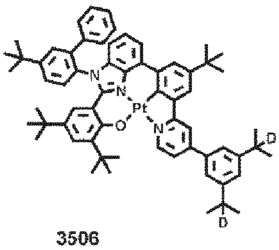
3506

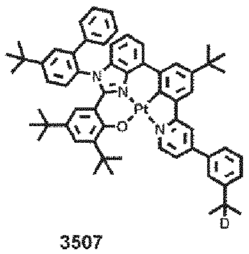
3507

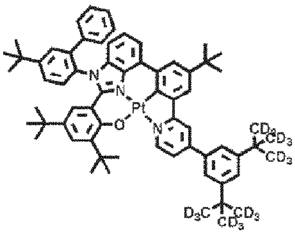
3508

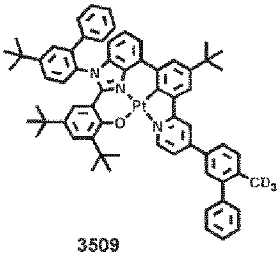
3509

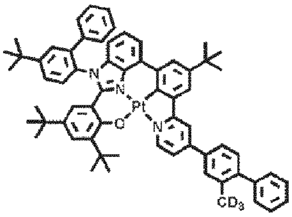
3510

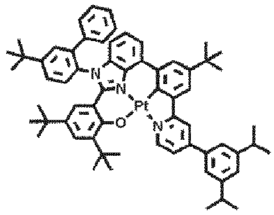
3511

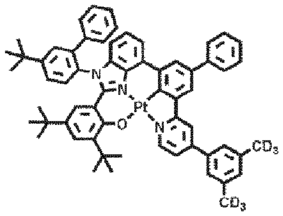
3512

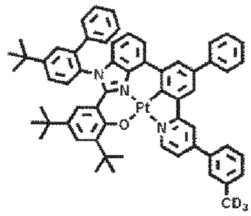
3513

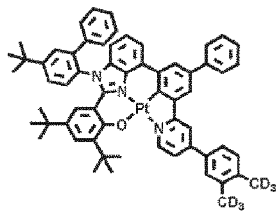
3514

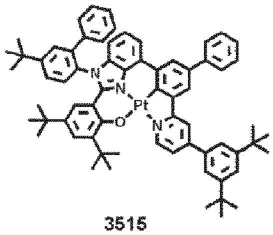
3515

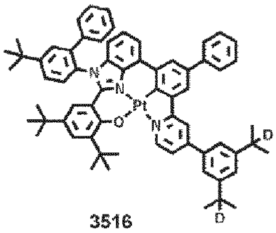
3516

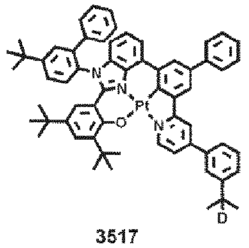
3517

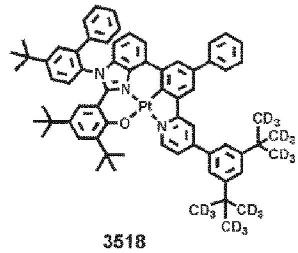
3518

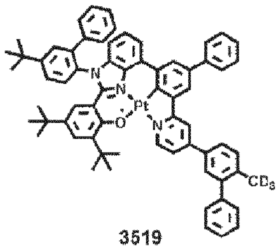
3519

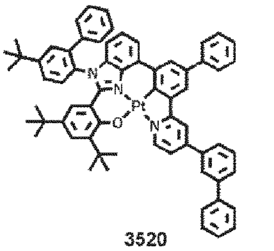
3520

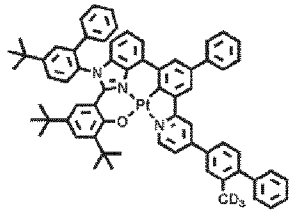
3521

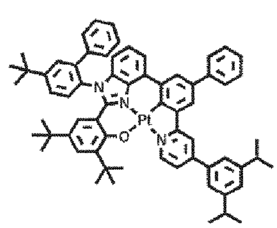
3522

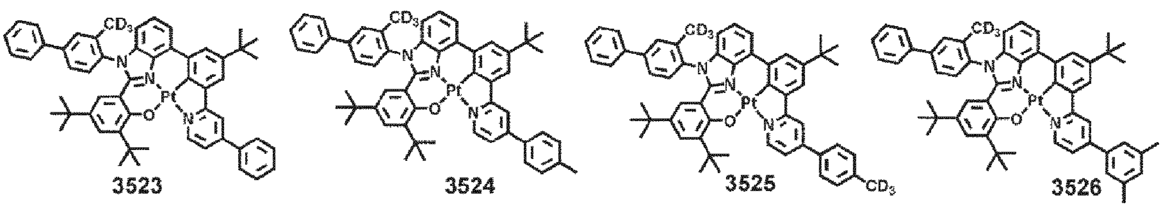

3523 3524 3525 3526

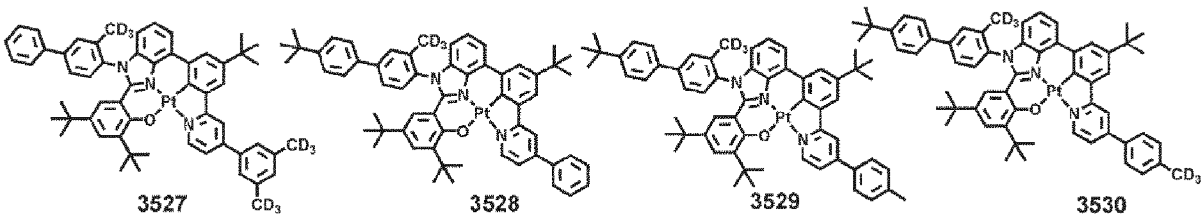

3527 3528 3529 3530

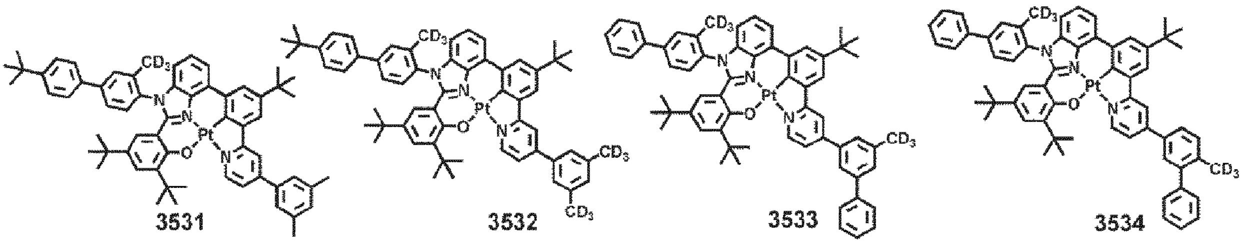

3531 3532 3533 3534

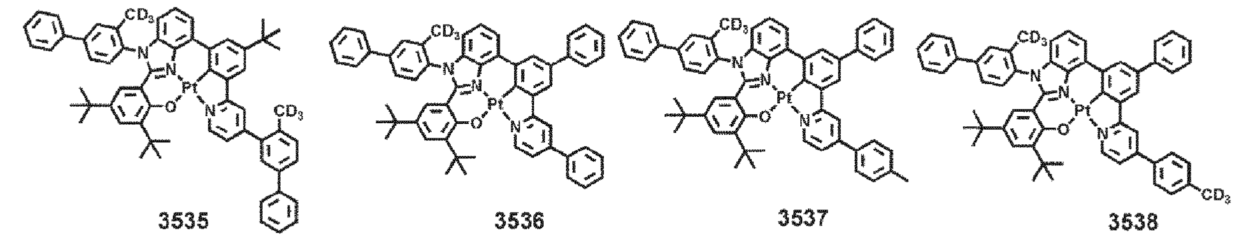

3535 3536 3537 3538

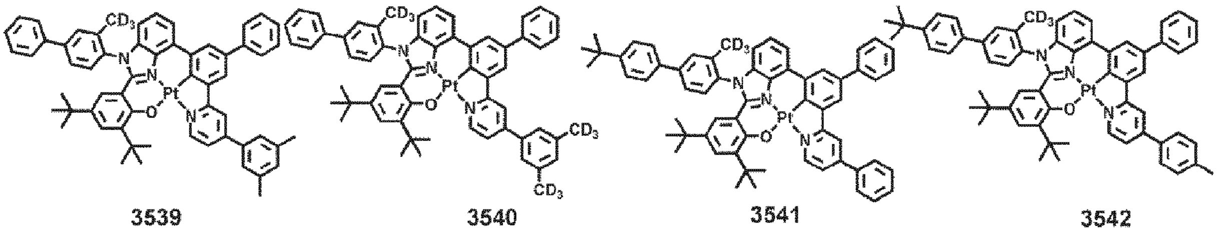

3539 3540 3541 3542

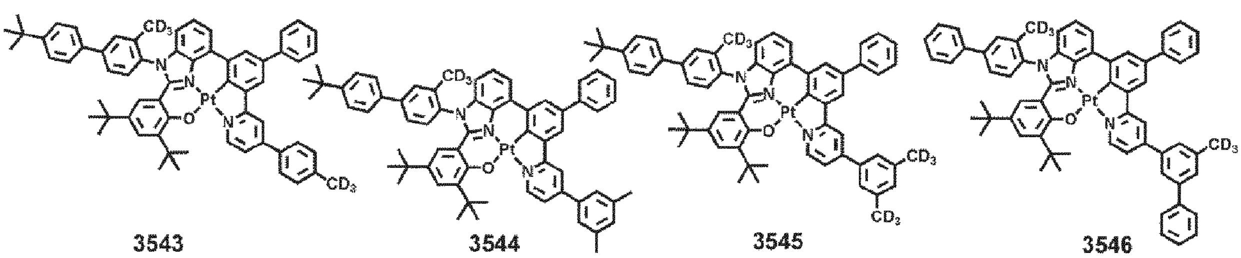

3543 3544 3545 3546

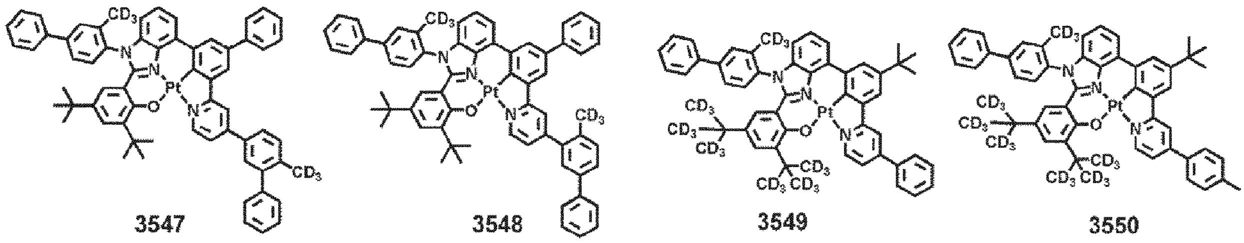

3547 3548 3549 3550

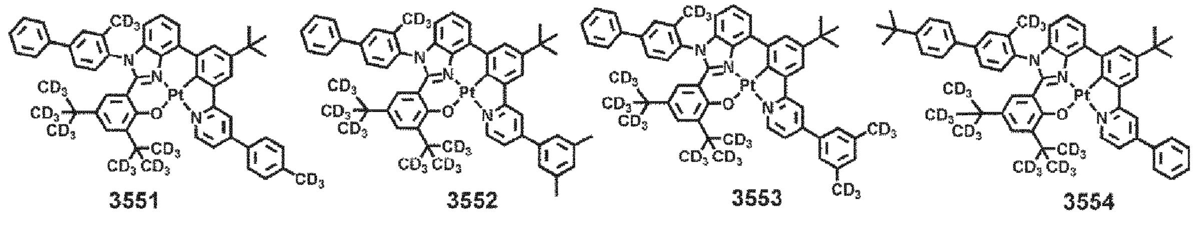

3551 3552 3553 3554

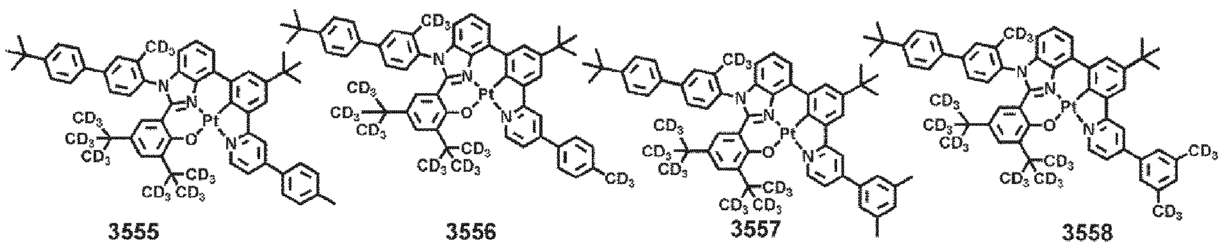

3555 3556 3557 3558

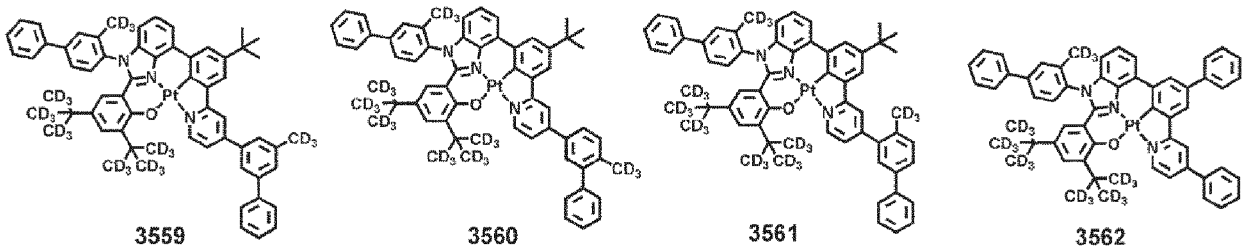

3559 3560 3561 3562

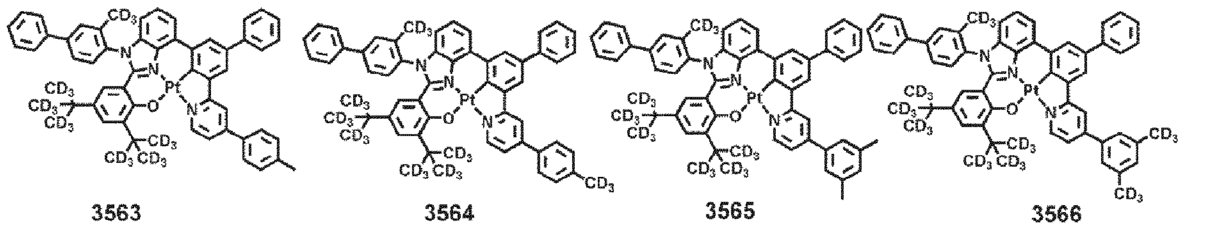

3563 3564 3565 3566

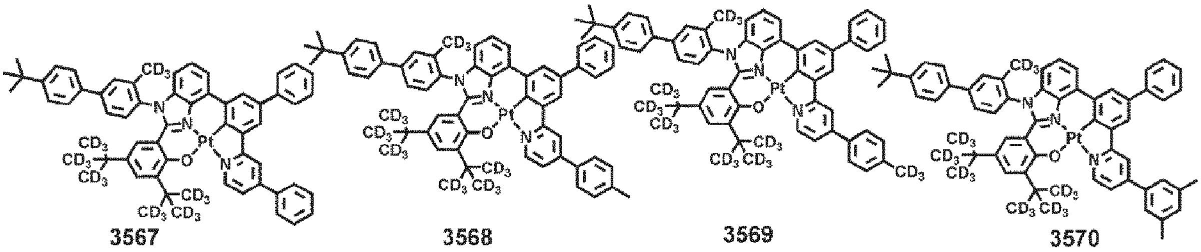

3567 3568 3569 3570

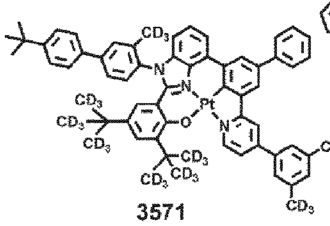
3571

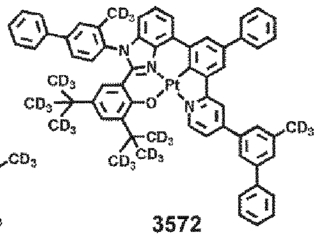
3572

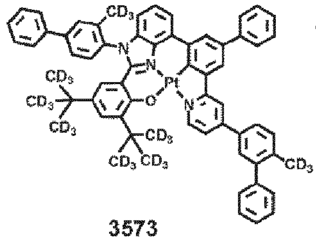
3573

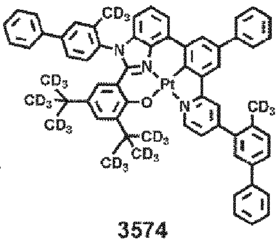
3574

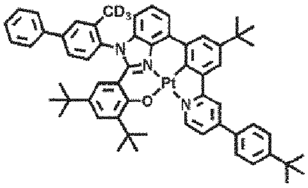
3575

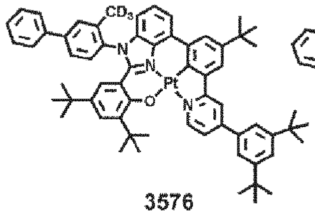
3576

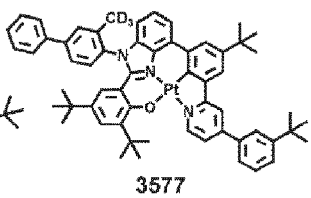
3577

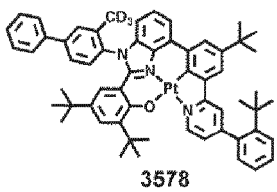
3578

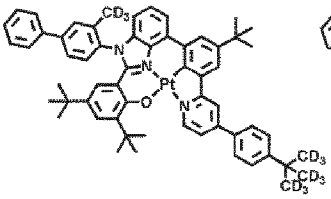
3579

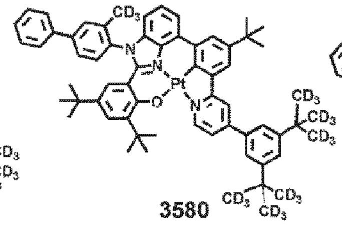
3580

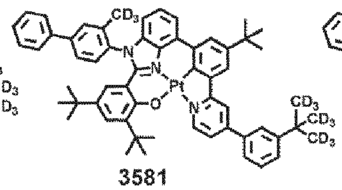
3581

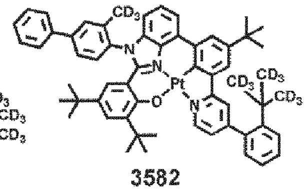
3582

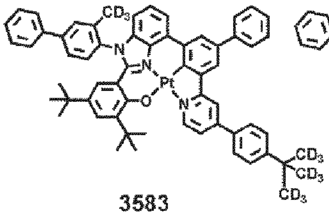
3583

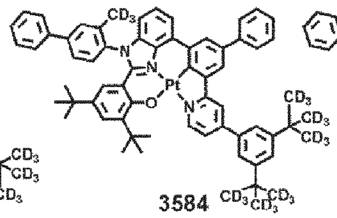
3584

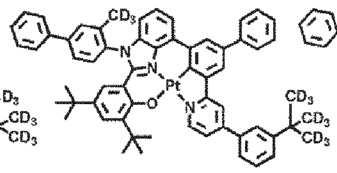
3585

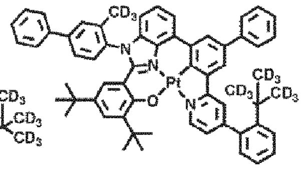
3586

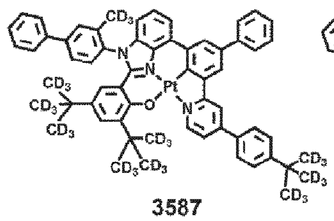
3587

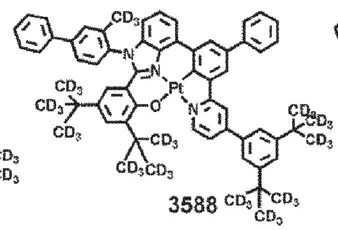
3588

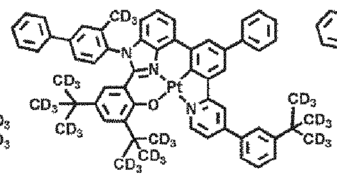
3589

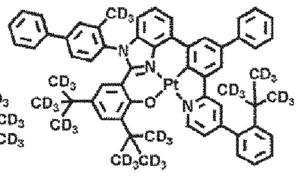
3590

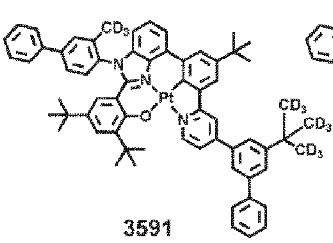
3591

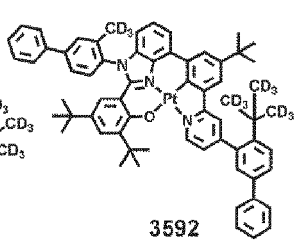
3592

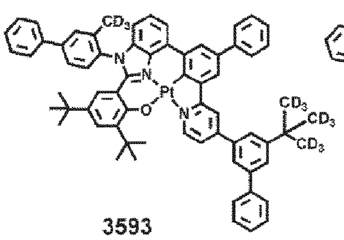
3593

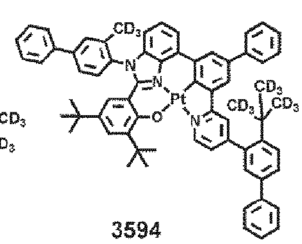
3594

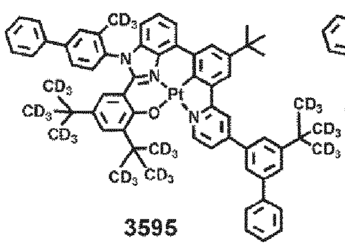

3595

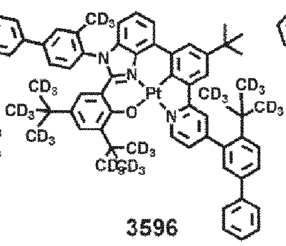

3596

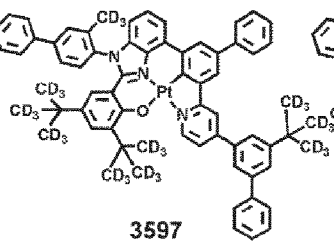

3597

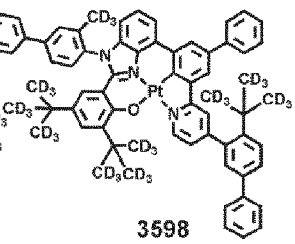

3598

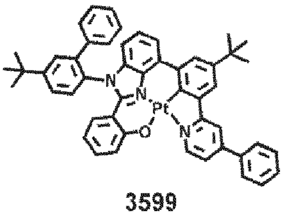

3599

Group 1-3

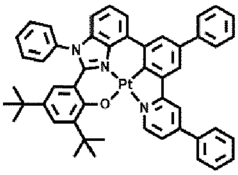

1

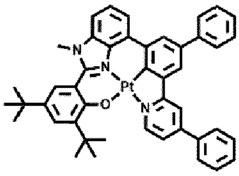

2

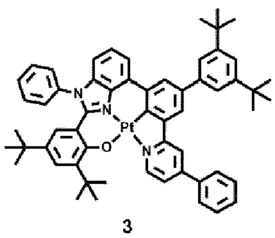

3

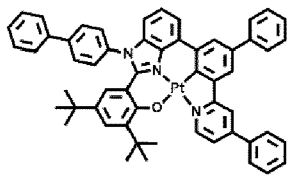

4

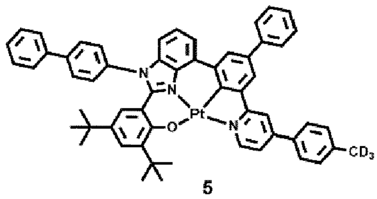

5

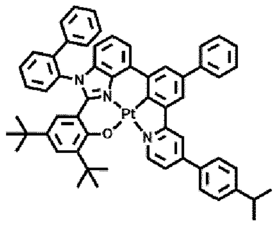

6

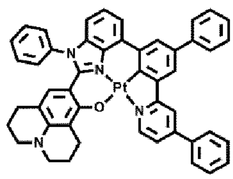

7

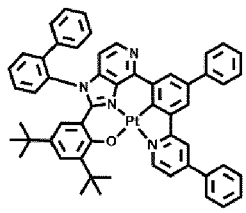

8

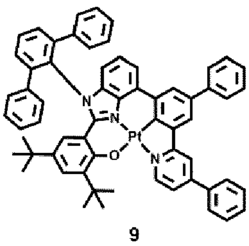

9

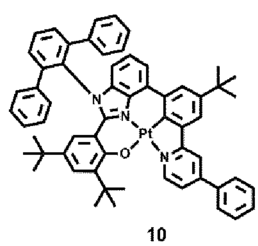

10

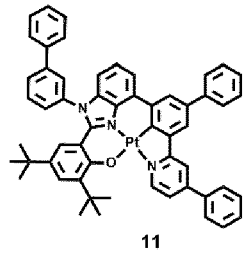

11

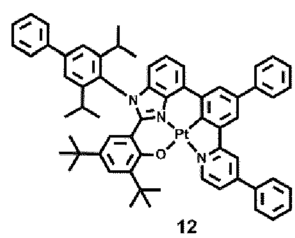

12

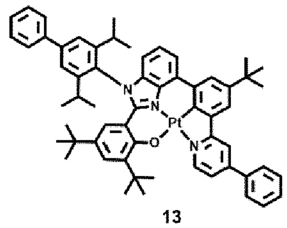
13

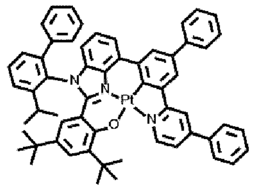
14

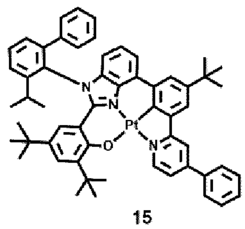
15

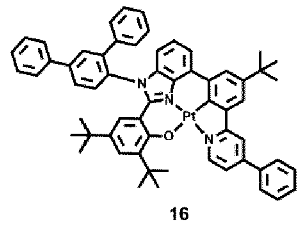
16

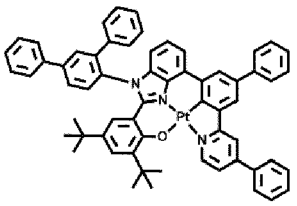
17

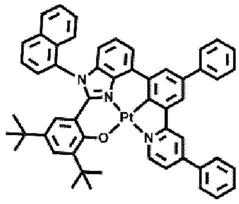
18

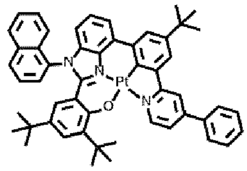
19

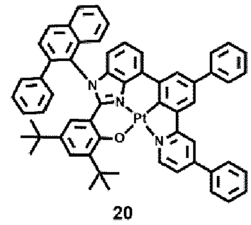
20

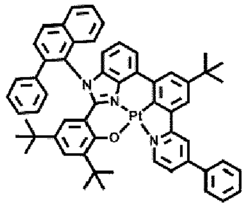
21

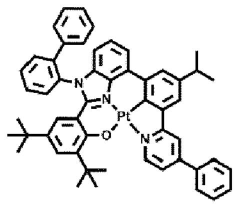
22

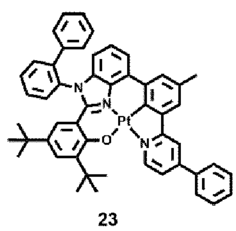
23

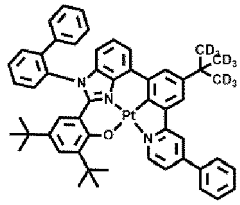
24

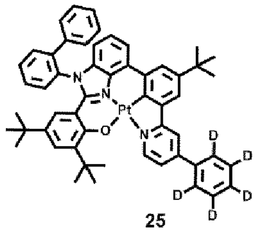
25

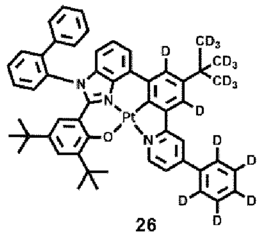
26

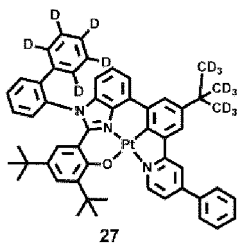
27

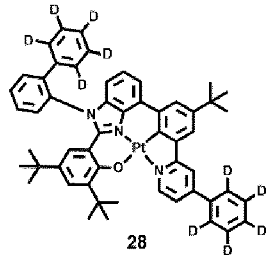
28

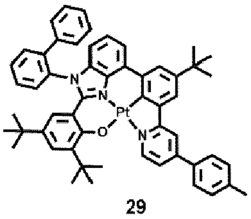
29

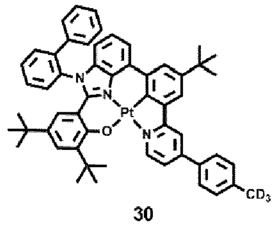
30

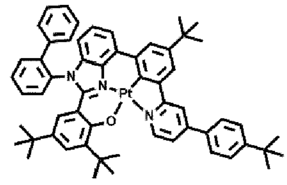
31

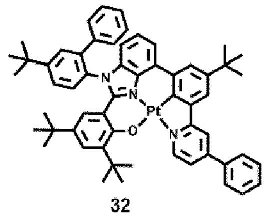
32

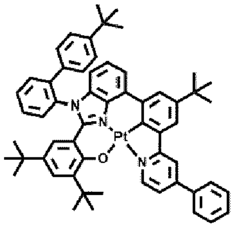
33

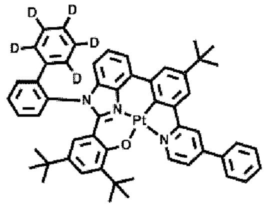
34

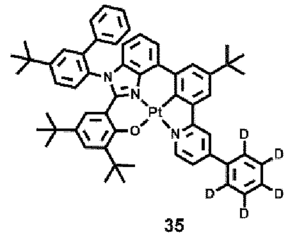
35

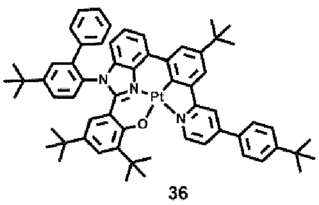
36

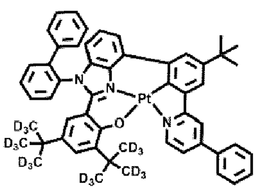
37
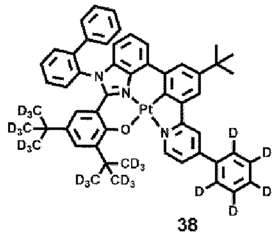
38
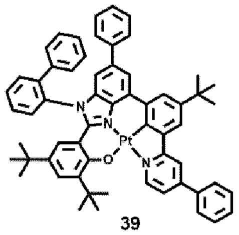
39
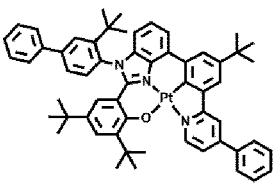
40

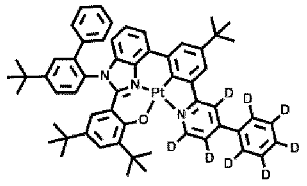
41
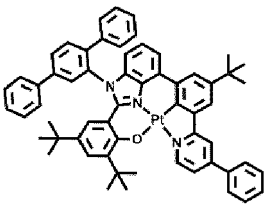
42
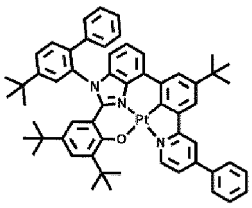
43
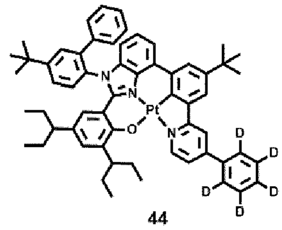
44

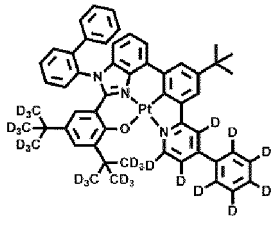
45
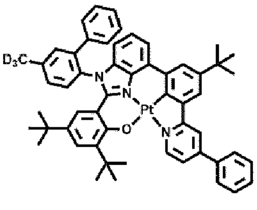
46
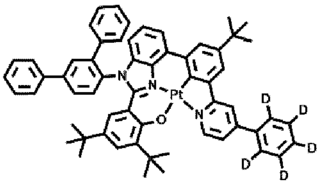
47
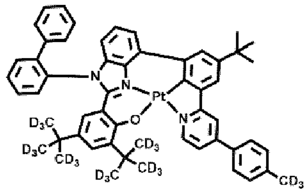
48

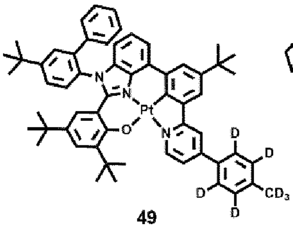
49
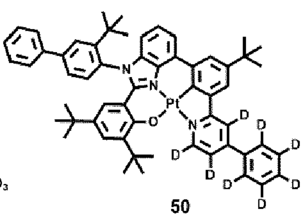
50
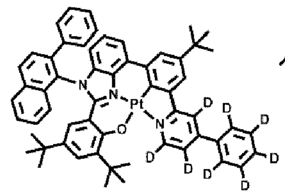
51
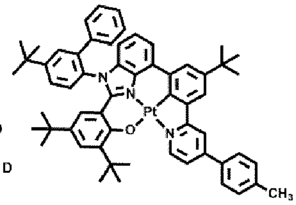
52

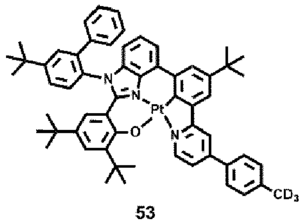
53
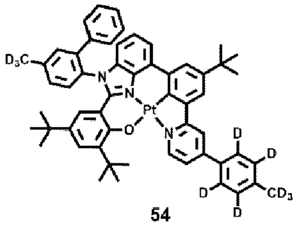
54
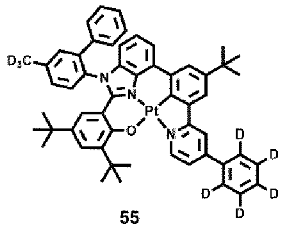
55
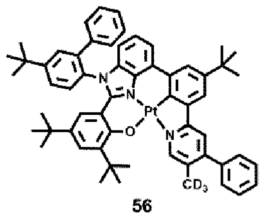
56

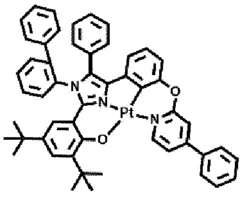
57
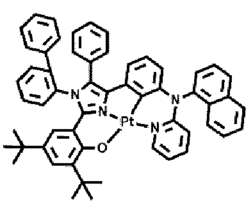
58
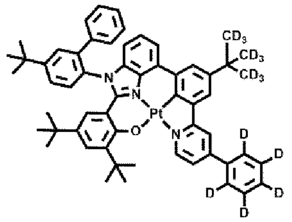
59
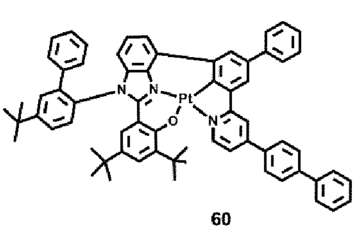
60

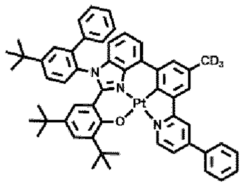
61

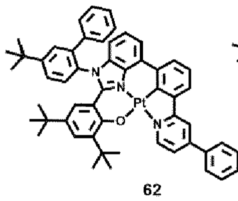
62

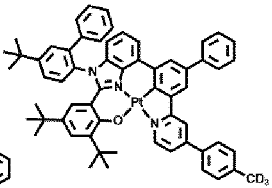
63

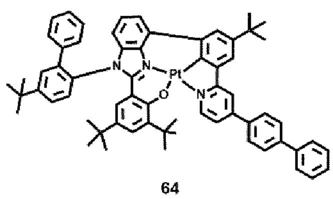
64

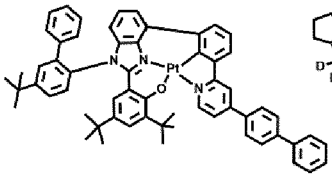
65

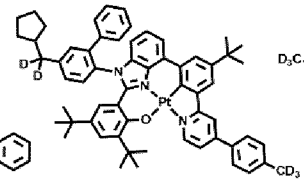
66

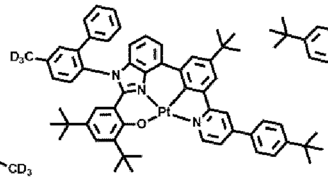
67

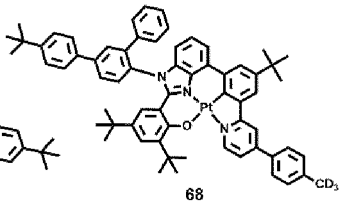
68

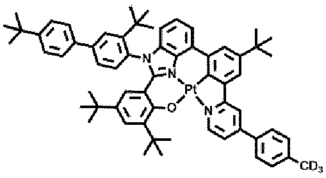
69

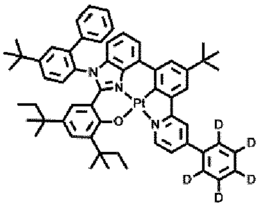
70

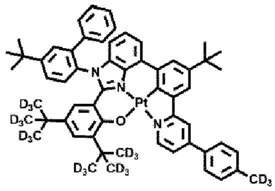
71

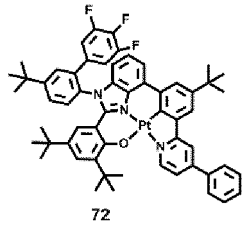
72

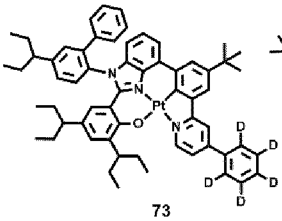
73

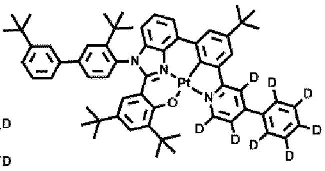
74

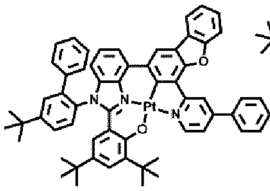
75

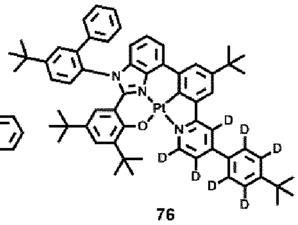
76

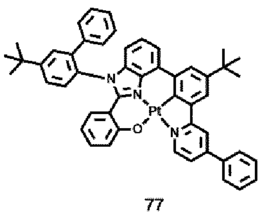
77

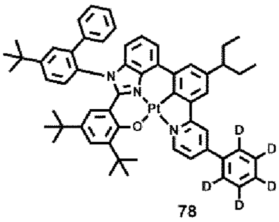
78

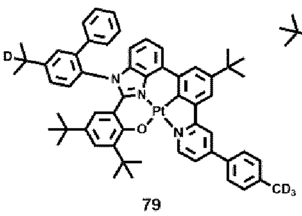
79

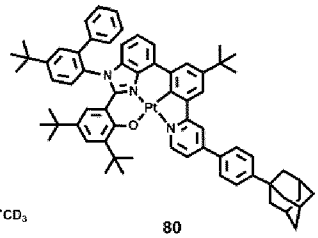
80

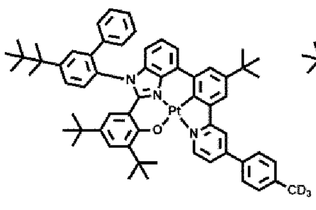
81

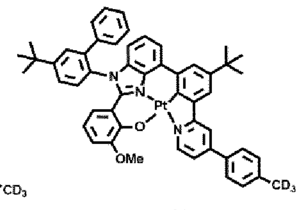
82

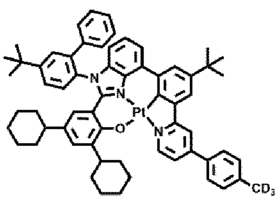
83

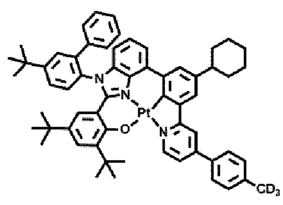
84

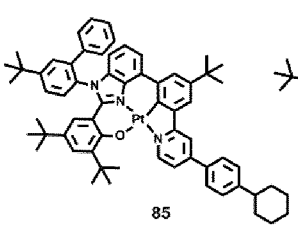

85

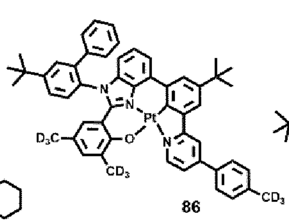

86

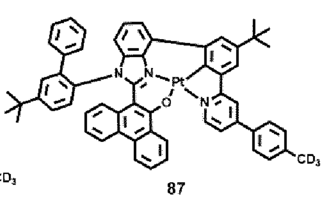

87

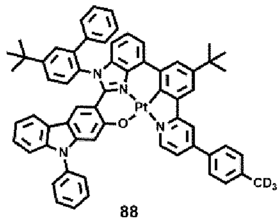

88

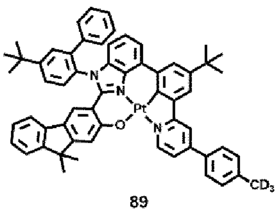

89

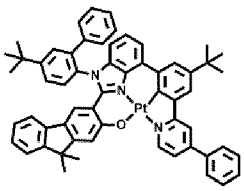

90

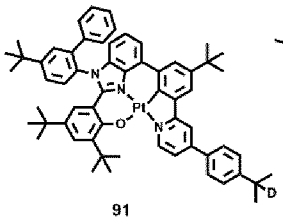

91

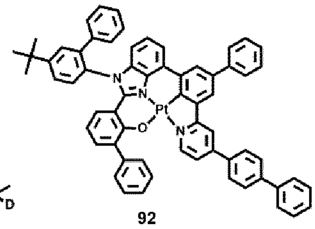

92

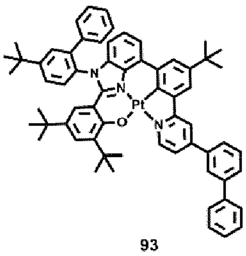

93

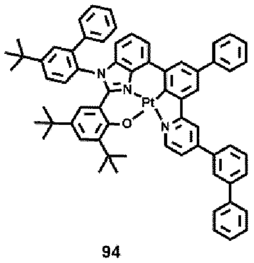

94

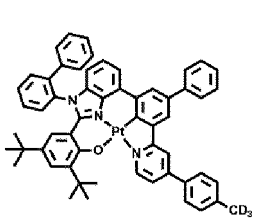

95

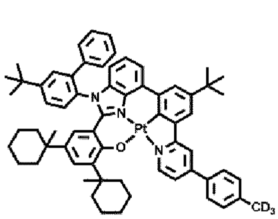

96

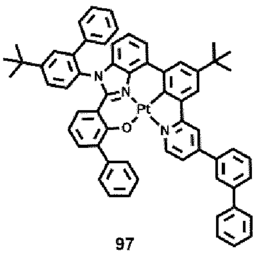

97

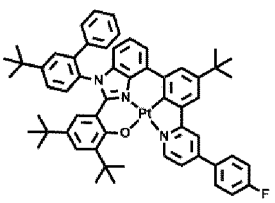

98

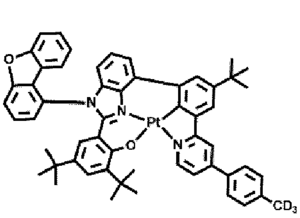

99

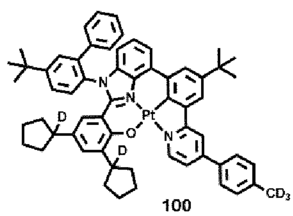

100

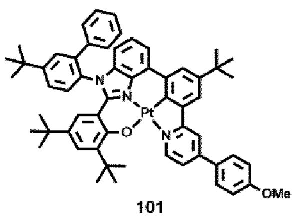

101

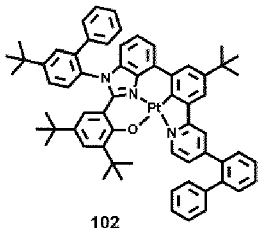

102

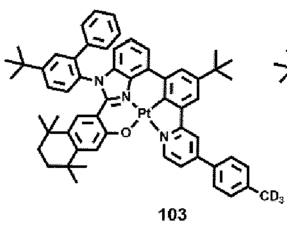

103

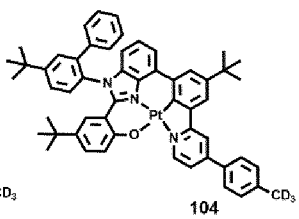

104

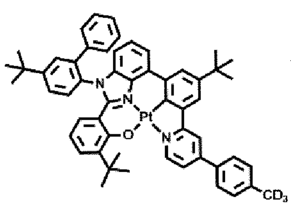

105

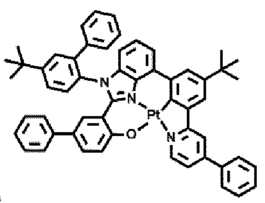

106

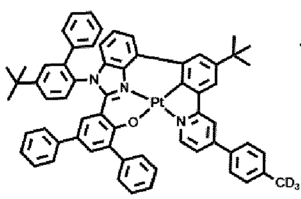

107

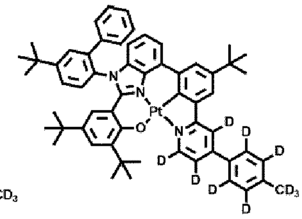

108

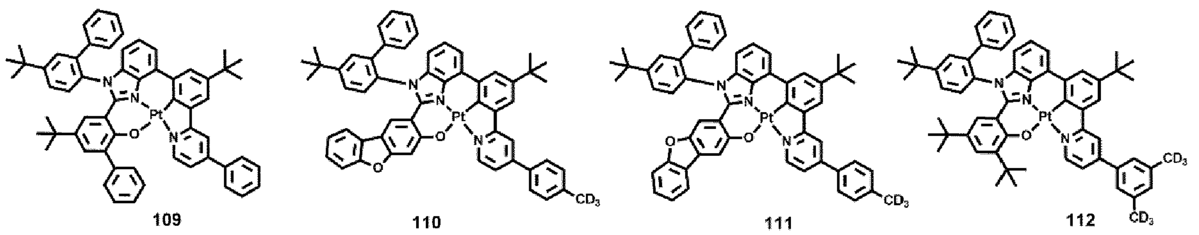

109 110 111 112

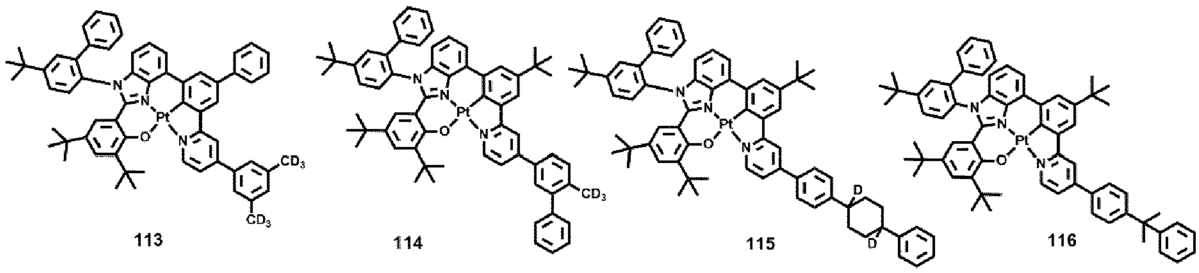

113 114 115 116

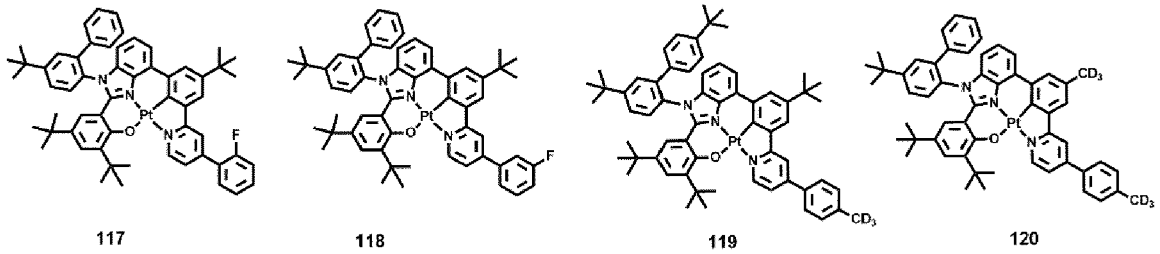

117 118 119 120

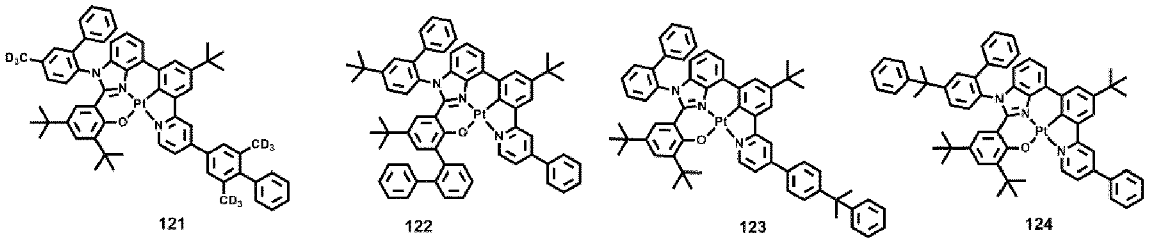

121 122 123 124

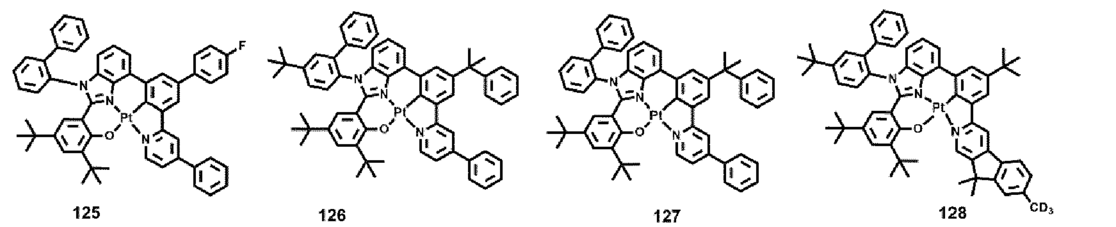

125 126 127 128

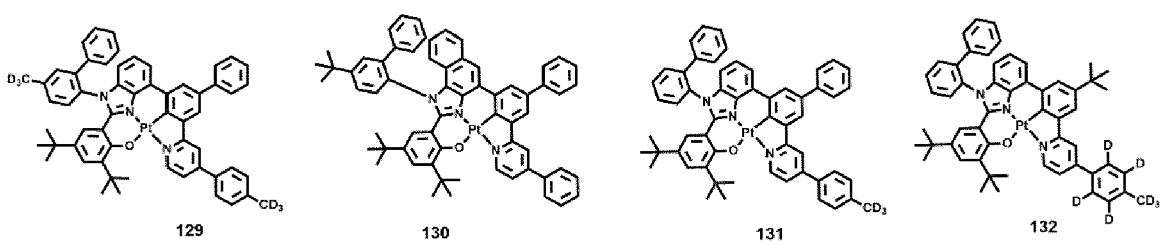

129 130 131 132

Group 1-4

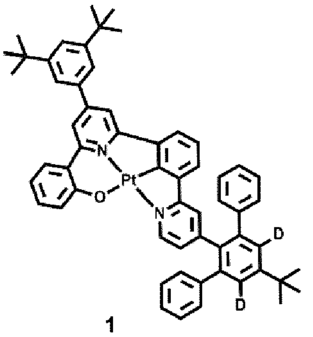
1

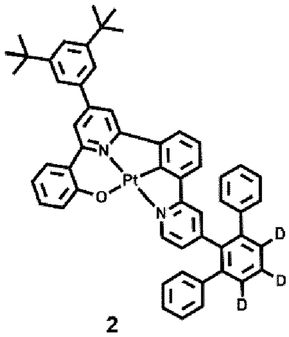
2

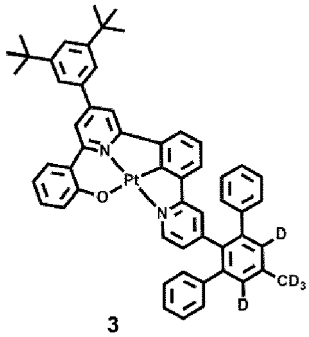
3

In one or more embodiments, the iridium-containing organometallic compound may be a compound of Group 2-1 to Group 2-6:

Group 2-1

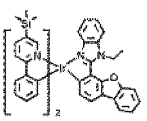
1

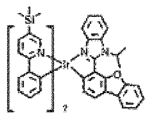
2

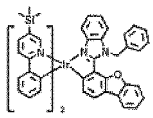
3

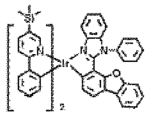
4

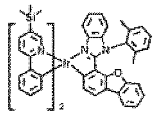
5

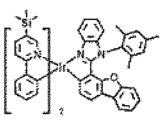
6

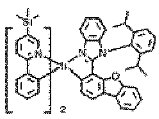
7

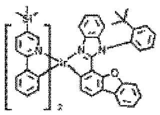
8

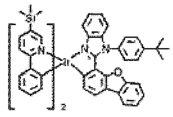
9

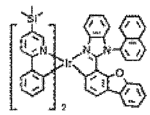
10

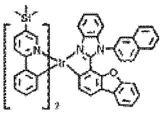
11

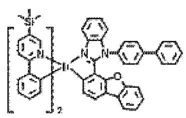
12

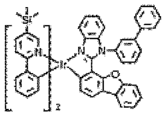
13

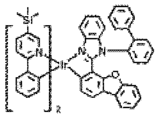
14

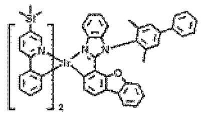
15

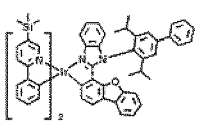
16

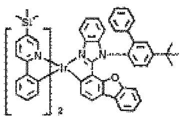
17

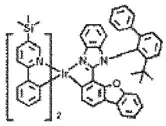
18

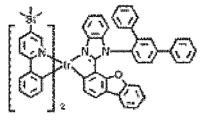
19

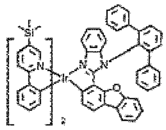
20

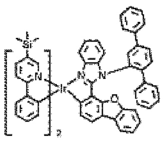
21

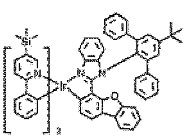
22

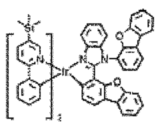
23

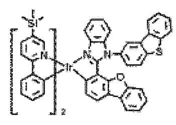
24

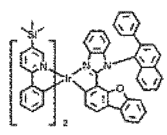
25

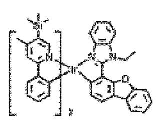
26

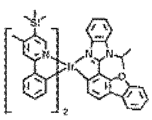
27

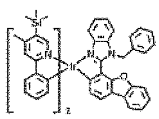
28

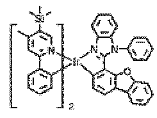
29

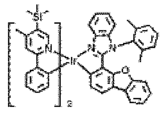
30

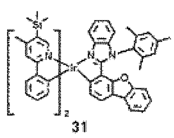
31

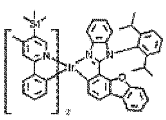
32

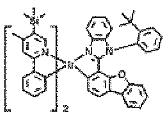
33

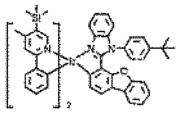
34

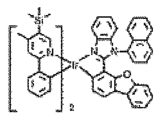
35

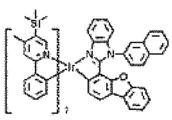
36

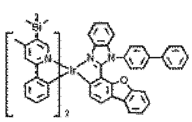
37

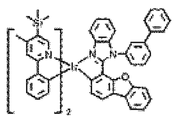
38

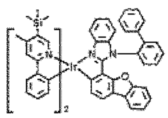
39

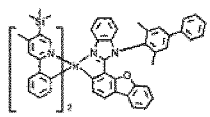
40

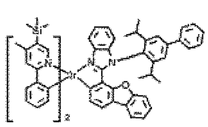
41

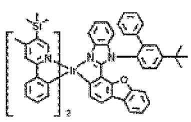
42

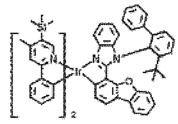
43

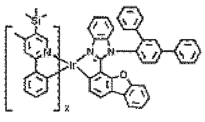
44

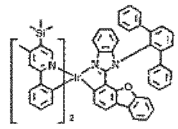
45

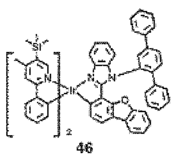
46

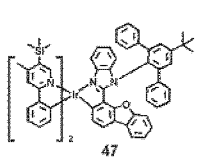
47

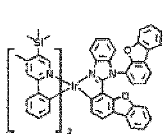
48

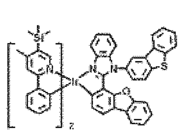
49

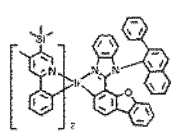
50

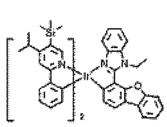
51

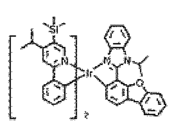
52

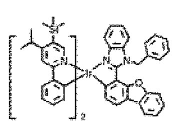
53

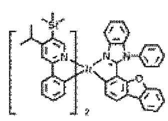
54

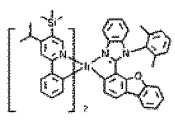
55

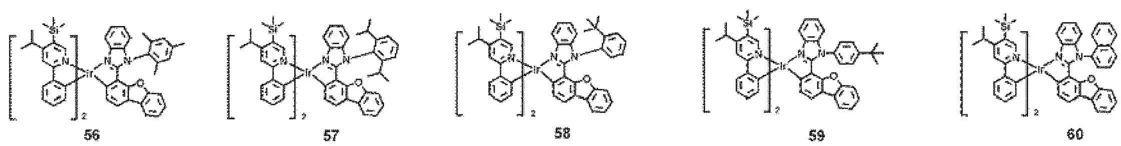
56 57 58 59 60

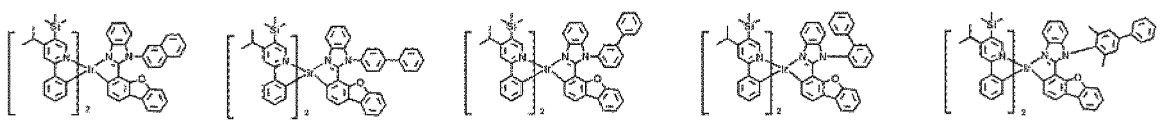
61 62 63 64 65

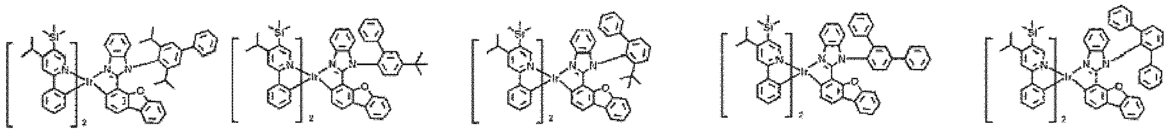
66 67 68 69 70

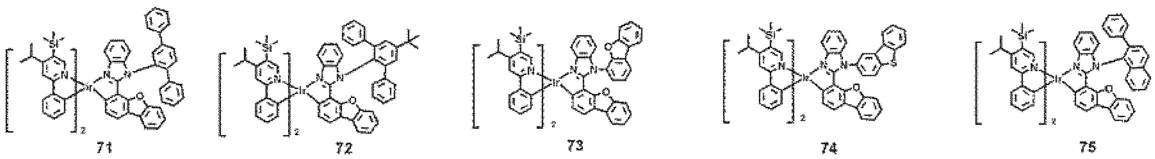
71 72 73 74 75

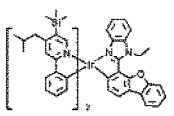
76

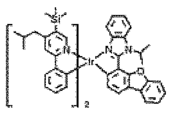
77

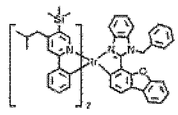
78

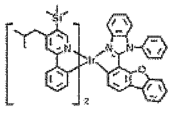
79

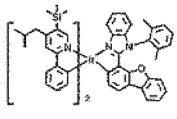
80

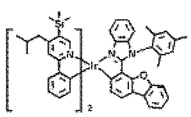
81

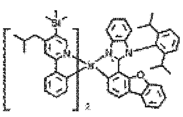
82

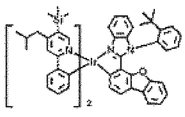
83

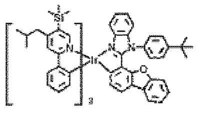
84

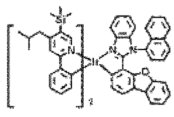
85

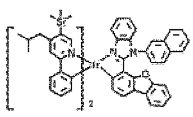
86

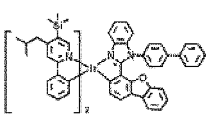
87

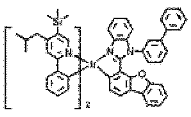
88

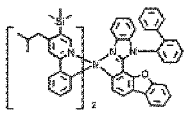
89

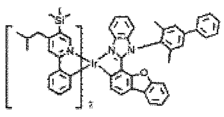
90

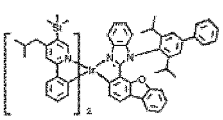
91

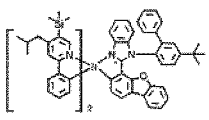
92

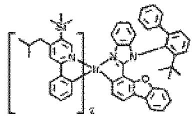
93

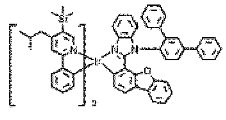
94

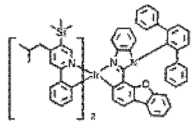
95

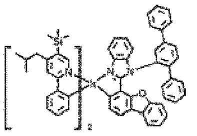
96

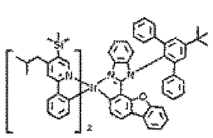
97

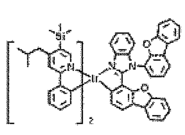
98

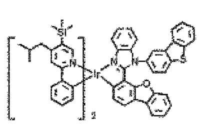
99

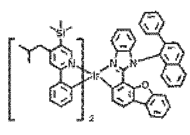
100

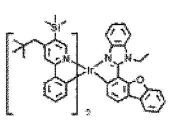
101

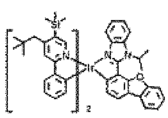
102

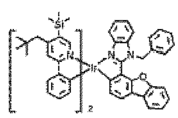
103

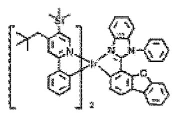
104

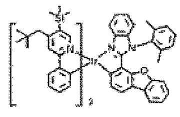
105

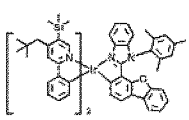
106

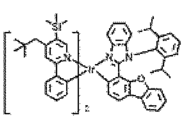
107

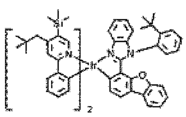
108

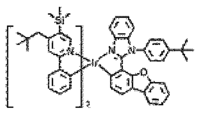
109

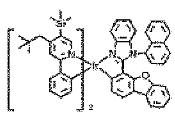
110

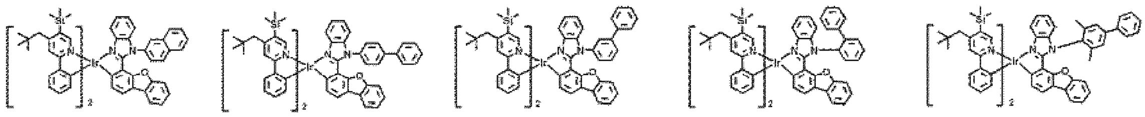
111 112 113 114 115

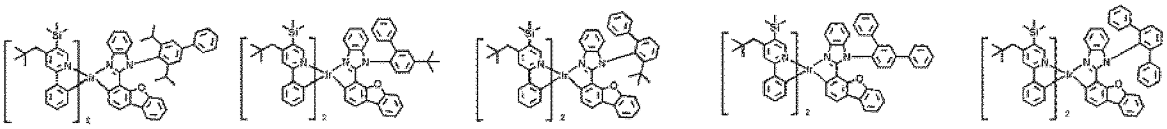
116 117 118 119 120

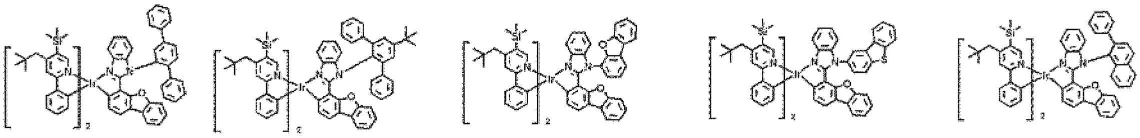
121 122 123 124 125

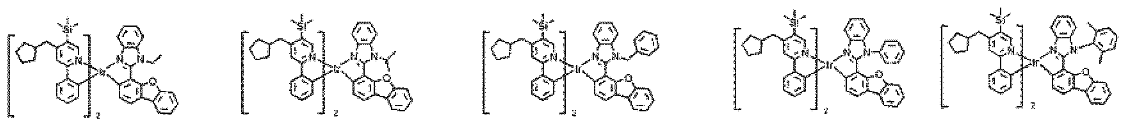
126 127 128 129 130

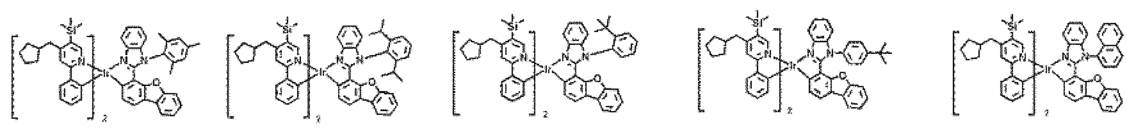
131 132 133 134 135

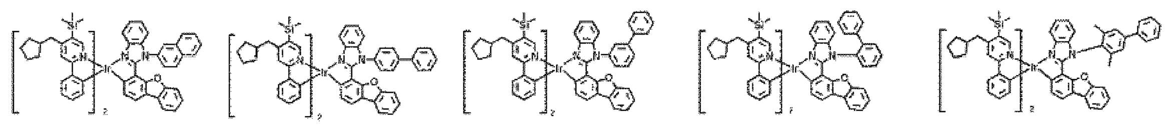
136 137 138 139 140

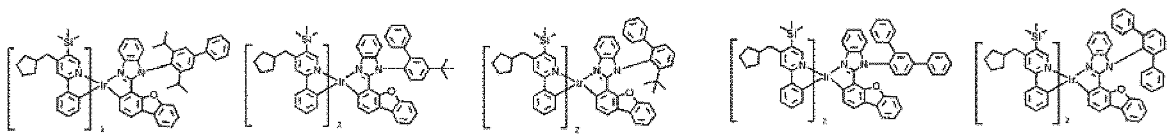
141 142 143 144 145

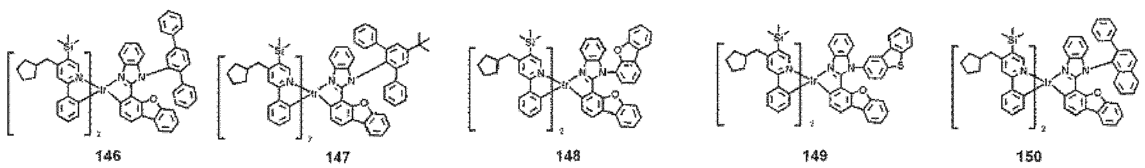
146 147 148 149 150

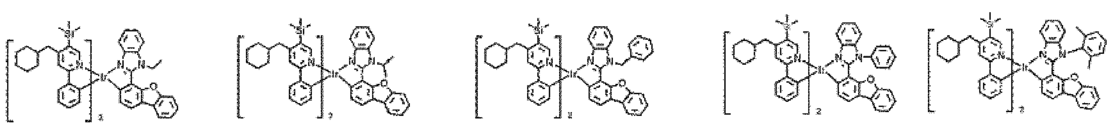
151 152 153 154 155

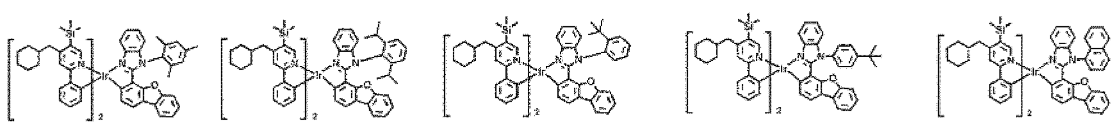
156 157 158 159 160

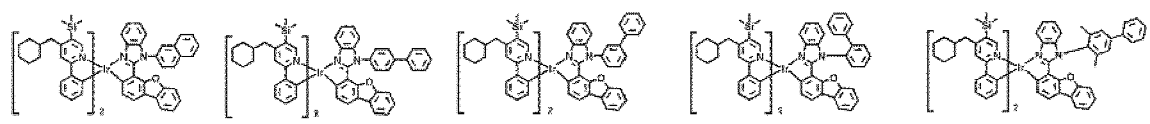
161 162 163 164 165

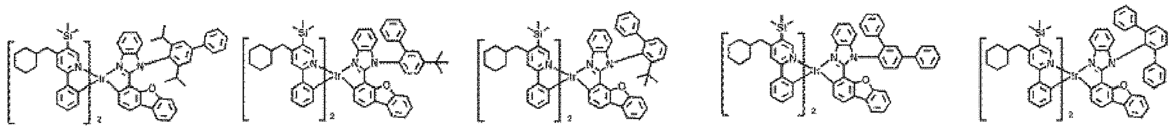
166 167 168 169 170

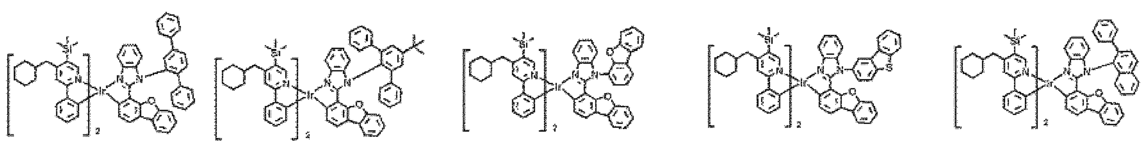
171 172 173 174 175

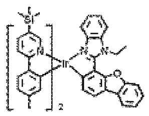
176
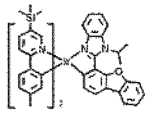
177
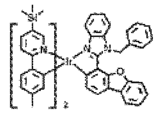
178
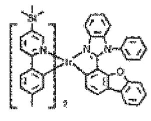
179
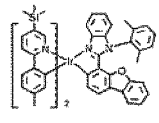
180
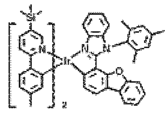
181
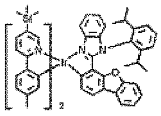
182
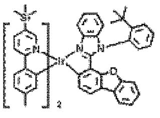
183
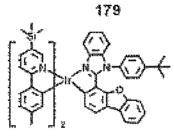
184
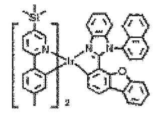
185
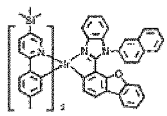
186
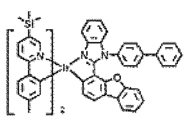
187
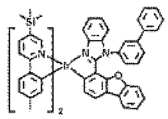
188
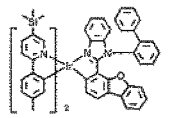
189
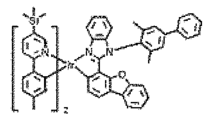
190
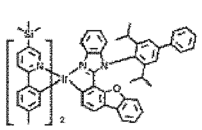
191
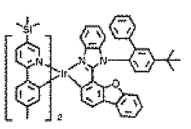
192
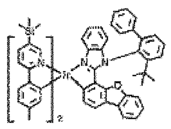
193
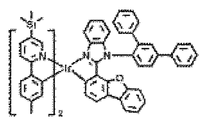
194
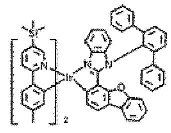
195
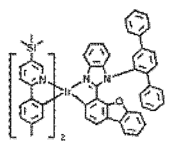
196
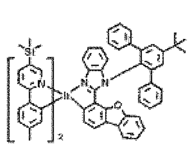
197
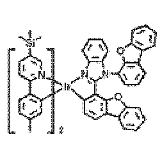
198
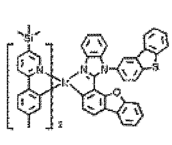
199
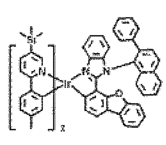
200
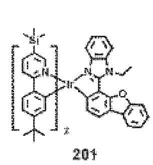
201
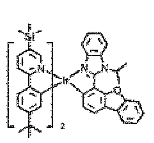
202
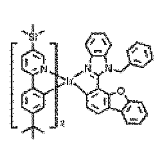
203
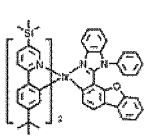
204
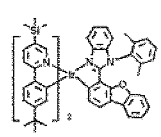
205
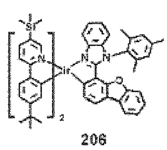
206
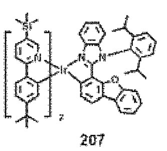
207
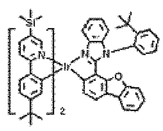
208
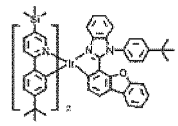
209
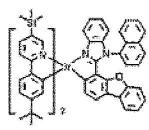
210
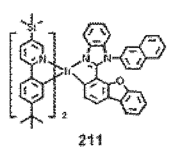
211
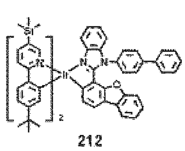
212
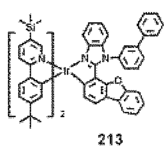
213
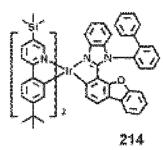
214
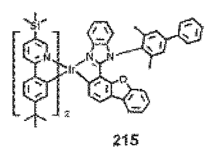
215
216
217
218
219
220
221
222
223
224
225

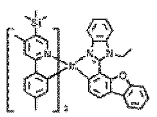
226
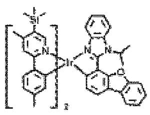
227
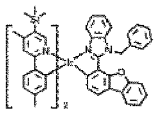
228
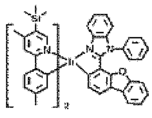
229
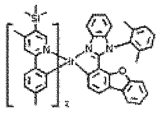
230

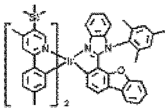
231
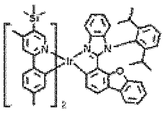
232
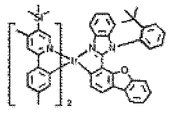
233
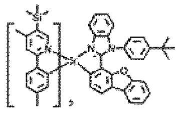
234
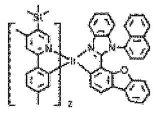
235

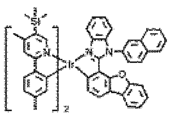
236
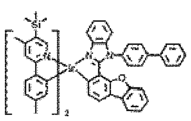
237
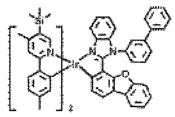
238
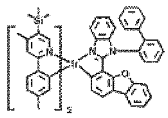
239
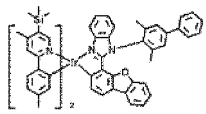
240

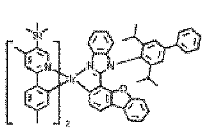
241
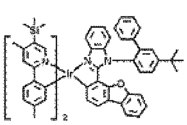
242
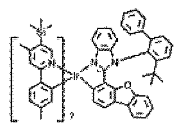
243
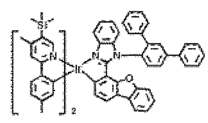
244
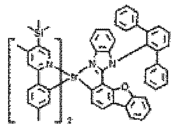
245

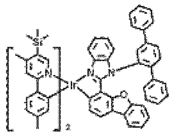
246
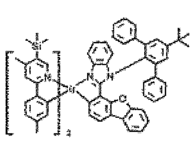
247
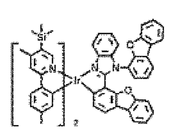
248
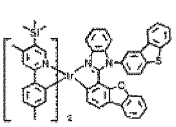
249
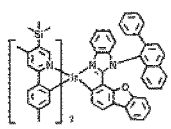
250

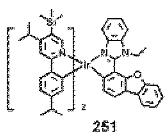
251
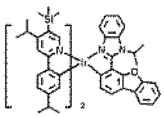
252
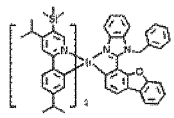
253
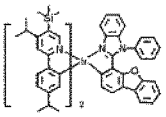
254
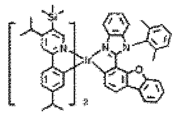
255

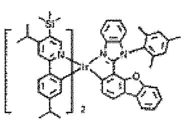
256
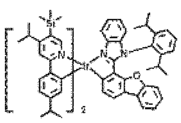
257
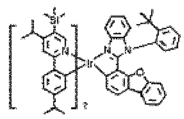
258
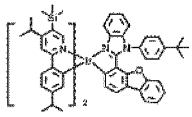
259
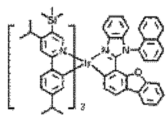
260

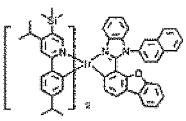
261
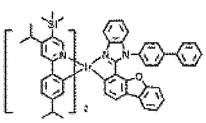
262
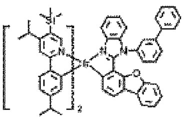
263
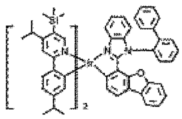
264
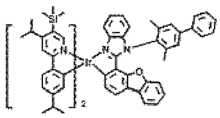
265

266
267
268
269
270

271
272
273
274
275

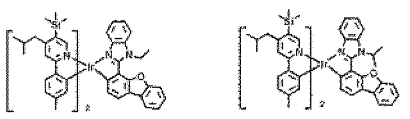
276
277
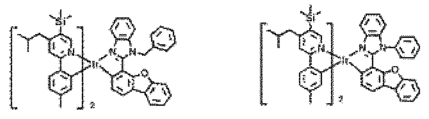
278
279
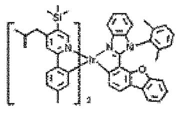
280

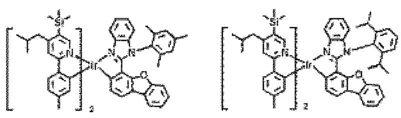
281
282
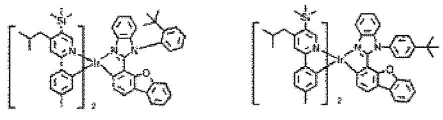
283
284
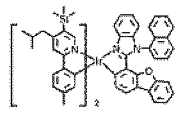
285

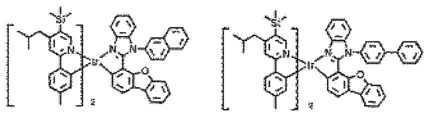
286
287
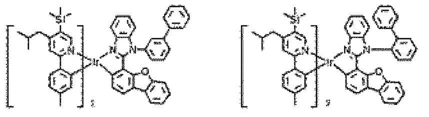
288
289
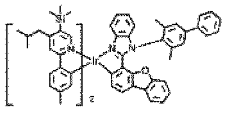
290

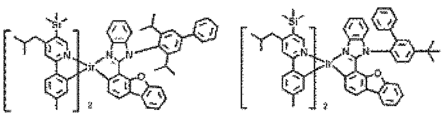
291
292
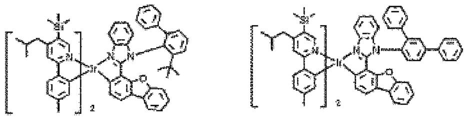
293
294
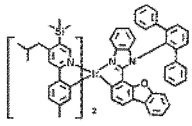
295

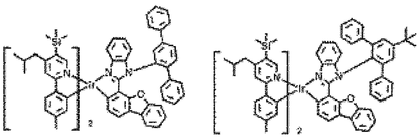
296
297
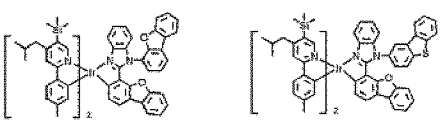
298
299
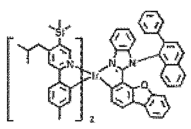
300

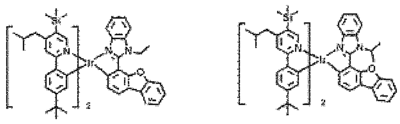
301
302
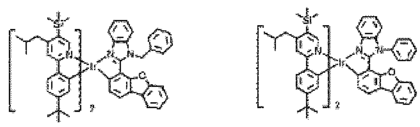
303
304
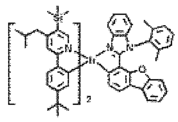
305

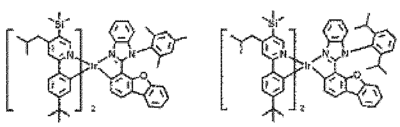
306
307
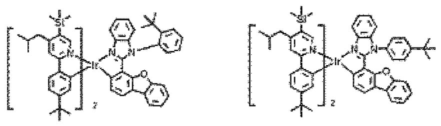
308
309
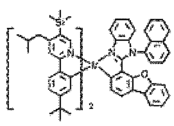
310

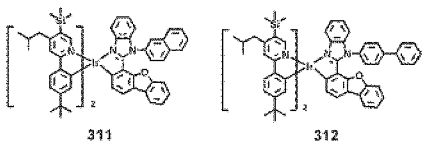
311
312
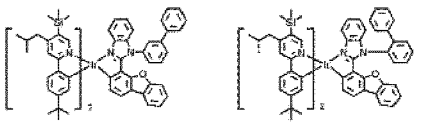
313
314
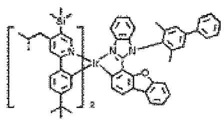
315

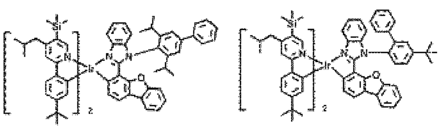
316
317
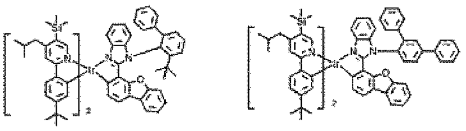
318
319
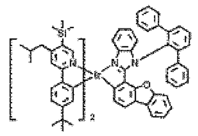
320

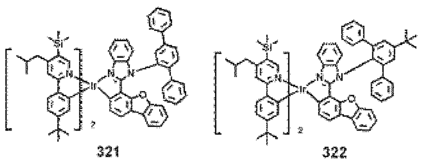
321
322
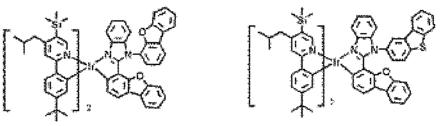
323
324
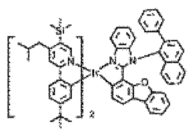
325

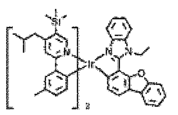
326
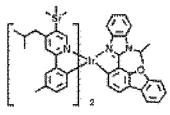
327
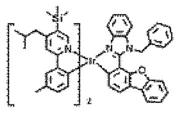
328
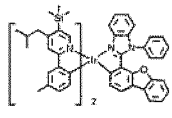
329
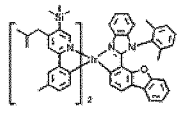
330

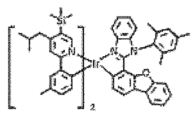
331
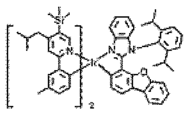
332
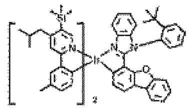
333
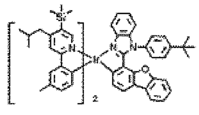
334
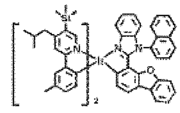
335

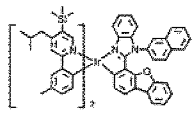
336
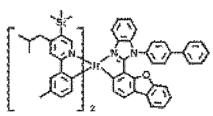
337
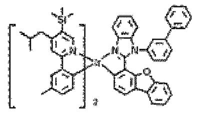
338
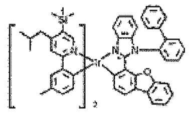
339
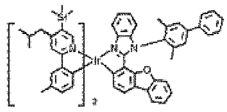
340

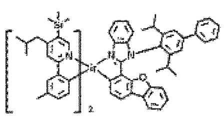
341
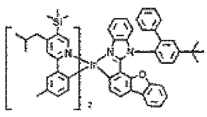
342
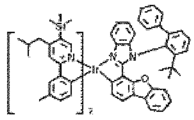
343
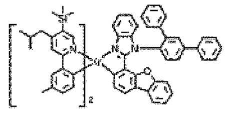
343
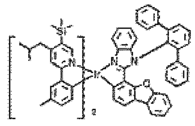
345

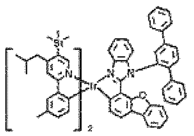
346
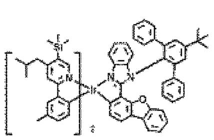
347
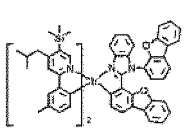
348
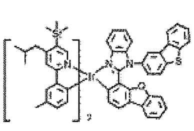
349
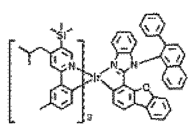
350

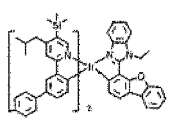
351
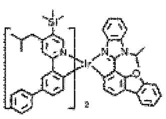
352
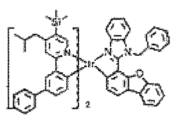
353
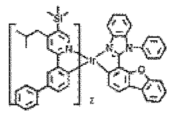
354
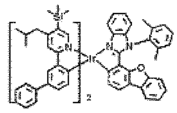
355

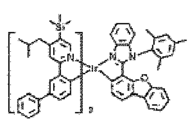
356
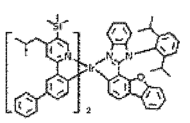
357
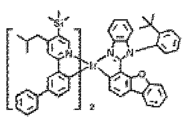
358
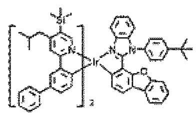
359
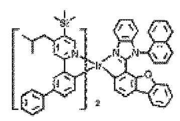
360

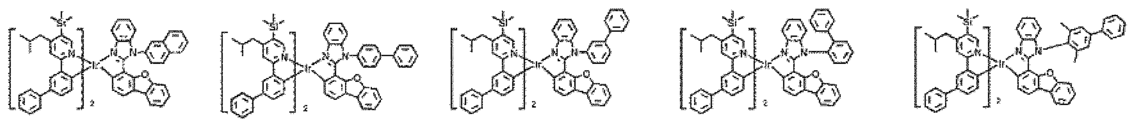
361
362
363
364
365

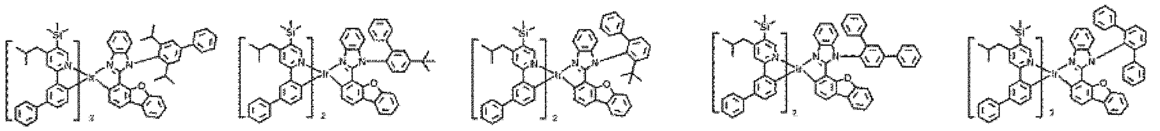
366
367
368
369
370

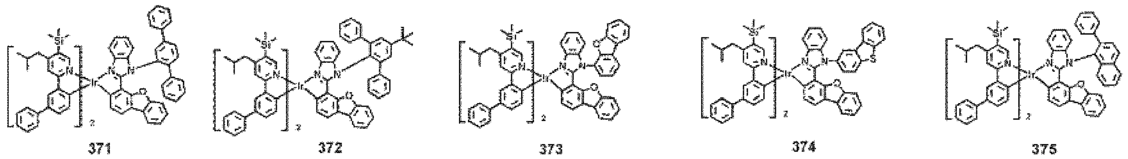
371
372
373
374
375

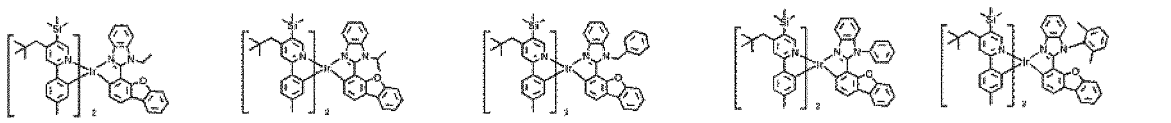
376 377 378 379 380

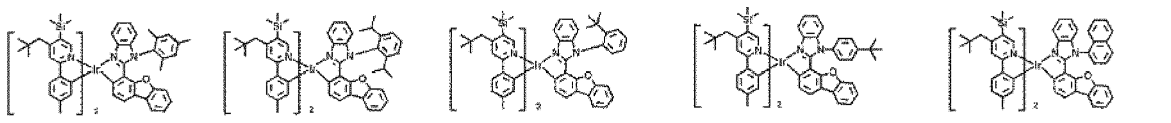
381 382 383 384 385

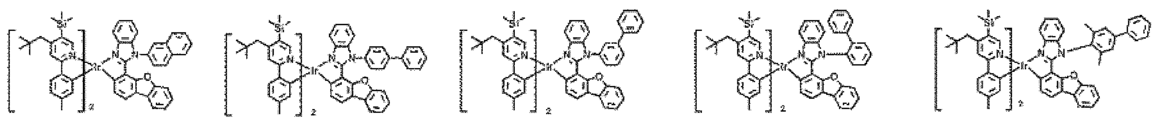
386 387 388 389 390

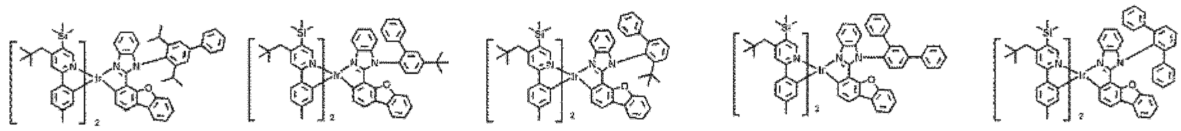
391 392 393 394 395

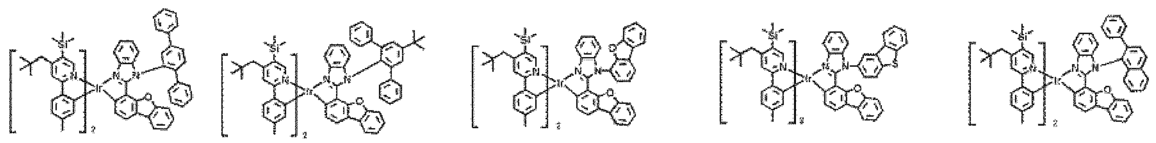
396 397 398 399 400

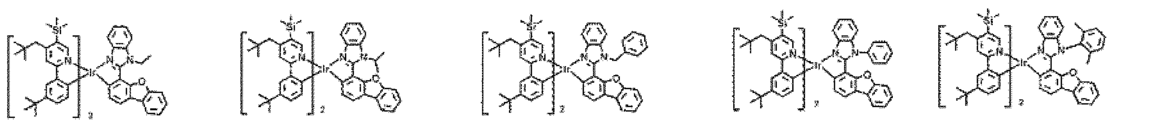
401 402 403 404 405

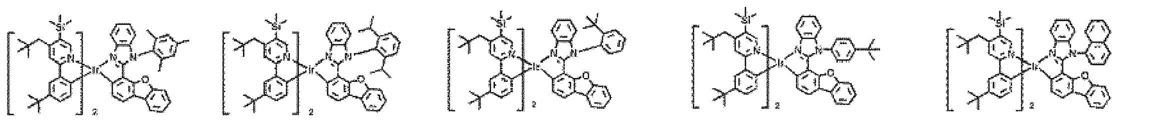
406 407 408 409 410

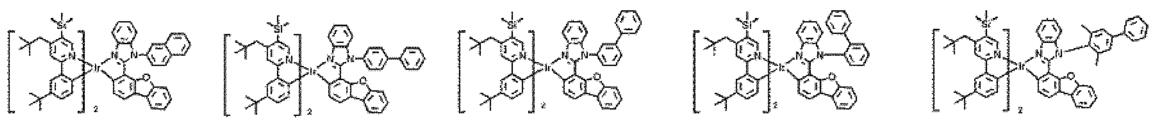
411 412 413 414 415

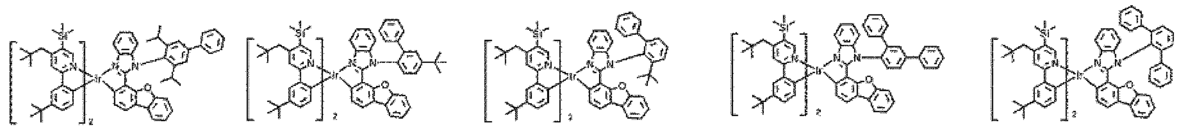
416 417 418 419 420

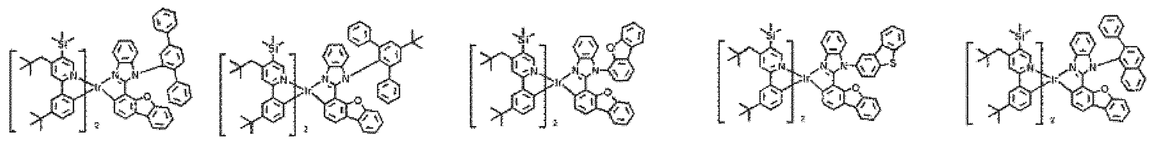
421 422 423 424 425

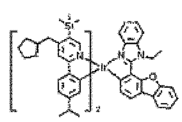
426
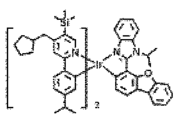
427
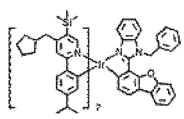
428
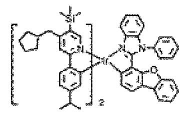
429
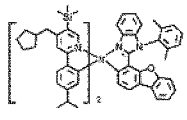
430

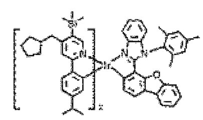
431
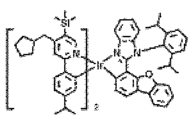
432
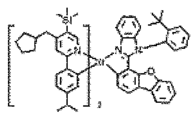
433
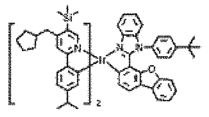
434
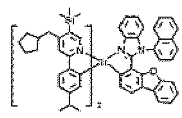
435

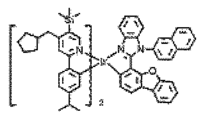
436
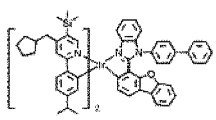
437
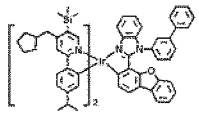
438
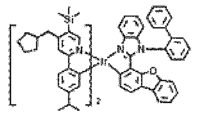
439
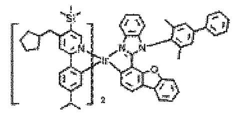
440

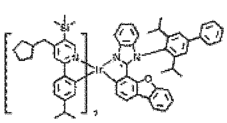
441
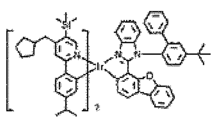
442
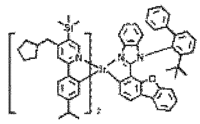
443
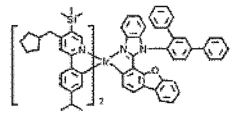
444
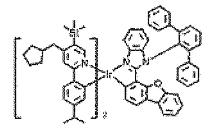
445

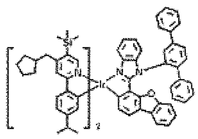
446
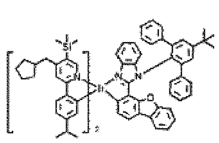
447
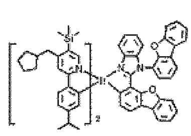
448
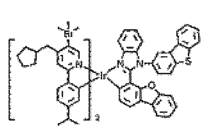
449
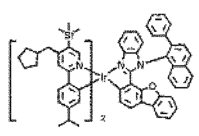
450

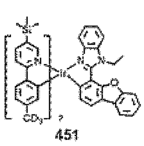
451
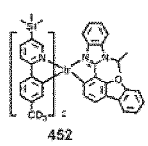
452
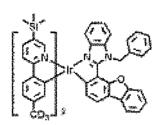
453
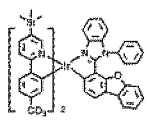
454
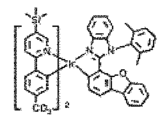
455

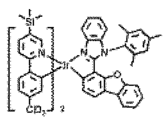
456
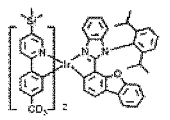
457
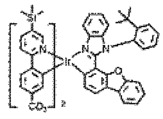
458
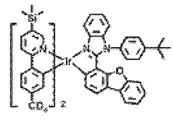
459
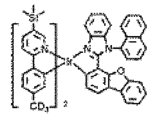
460

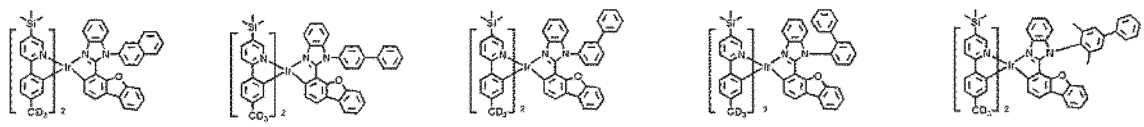
461
462
463
464
465

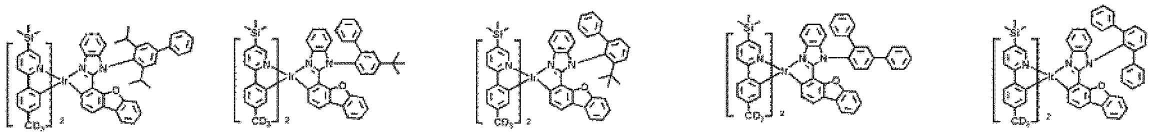
466
467
468
469
470

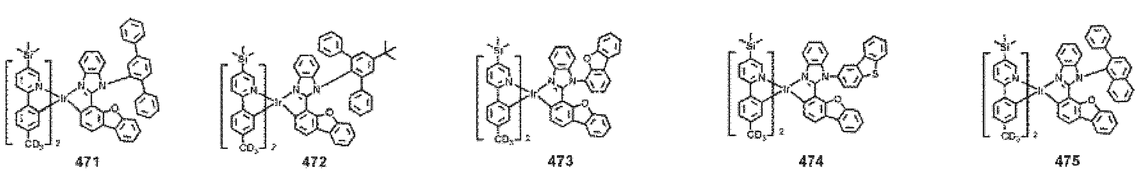
471
472
473
474
475

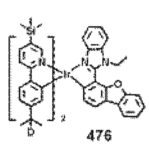
476
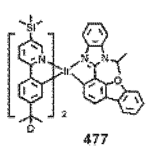
477
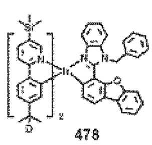
478
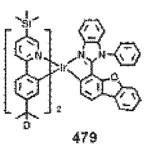
479
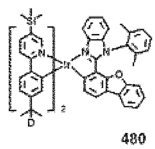
480

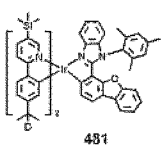
481
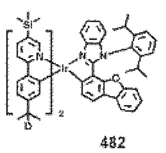
482
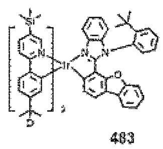
483
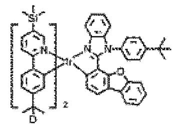
484
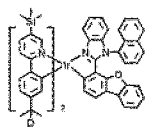
485

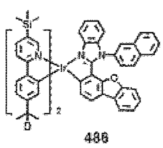
486
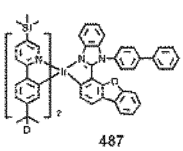
487
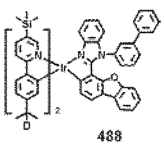
488
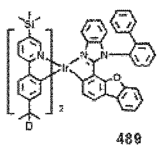
489
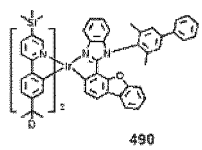
490

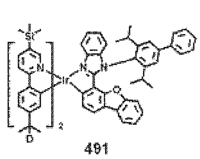
491
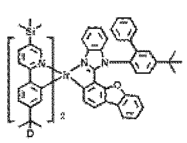
492
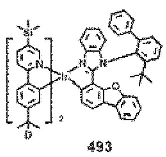
493
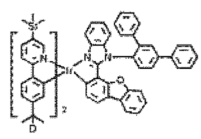
494
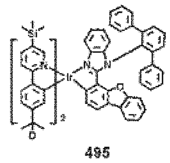
495

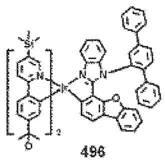
496
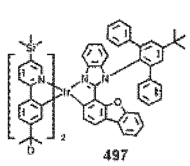
497
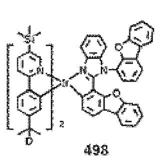
498
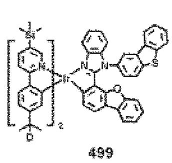
499
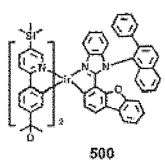
500

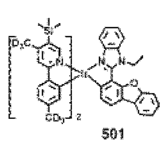
501
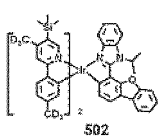
502
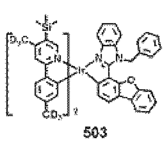
503
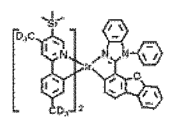
504
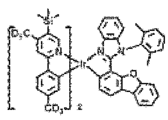
505

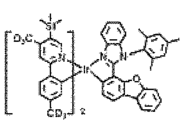
506
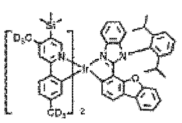
507
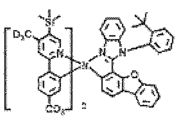
508
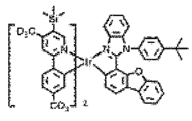
509
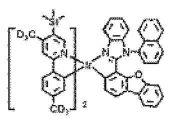
510

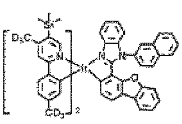
511
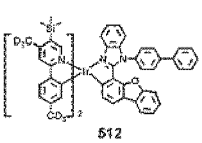
512
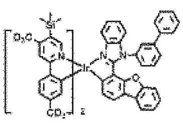
513
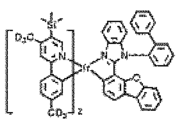
514
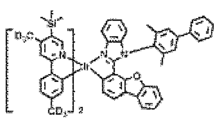
515

516
517
518
519
520

521
522
523
524
525

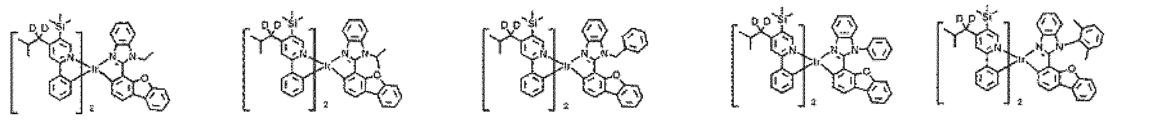
526 527 528 529 530

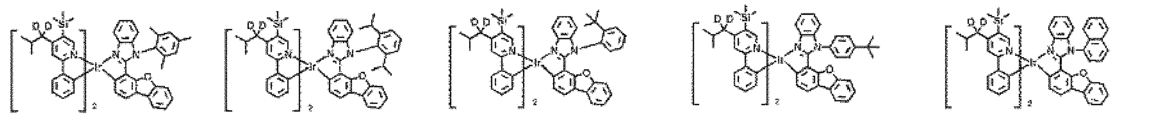
531 532 533 534 535

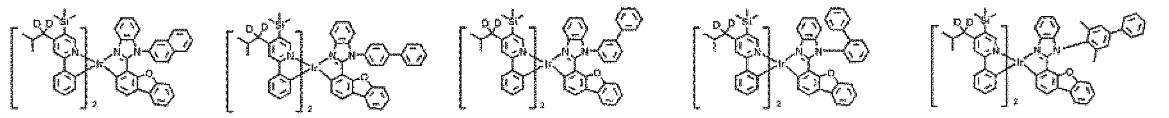
536 537 538 539 540

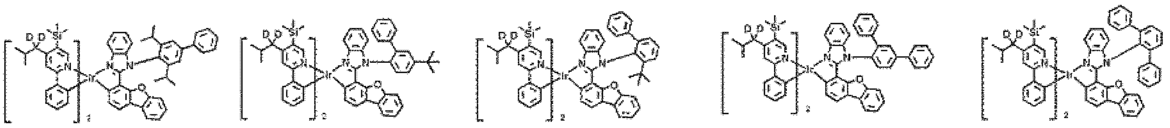
541 542 543 544 545

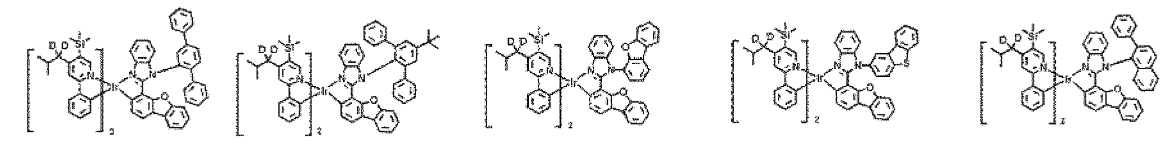
546 547 548 549 550

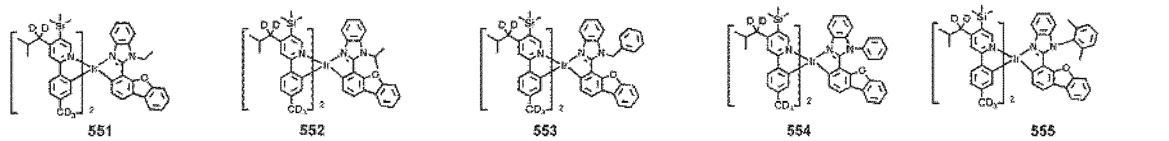
551 552 553 554 555

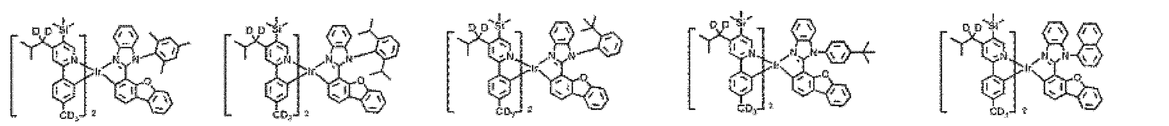
556 557 558 559 560

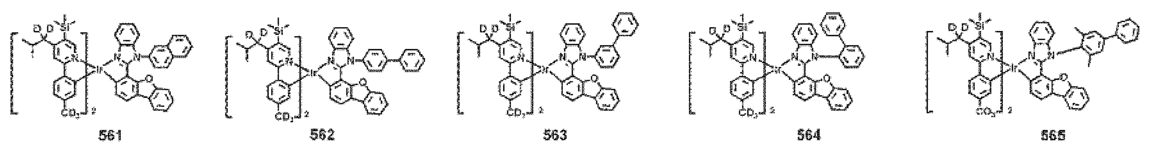
561 562 563 564 565

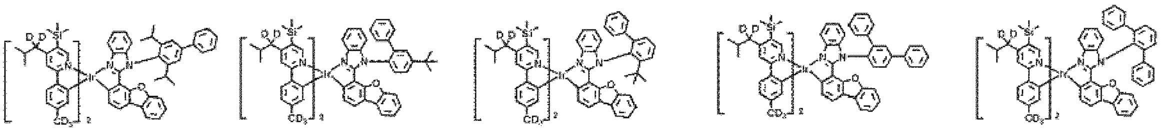
566 567 568 569 570

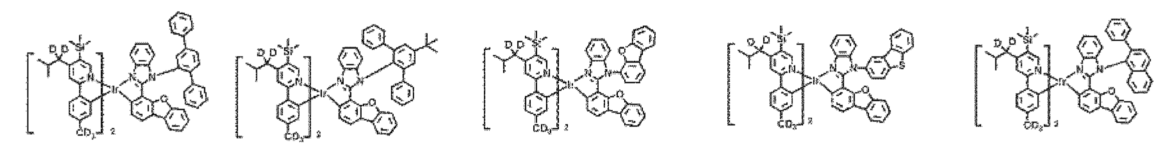
571 572 573 574 575

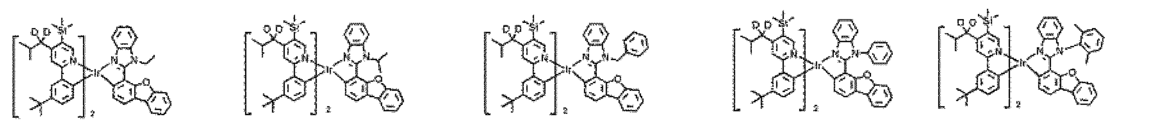
576 577 578 579 580

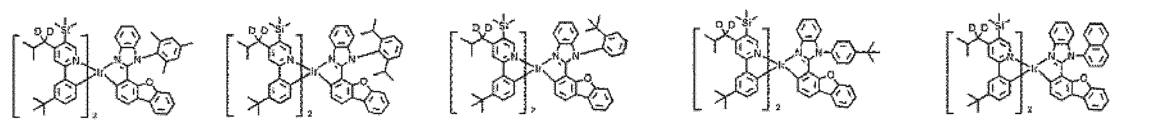
581 582 583 584 585

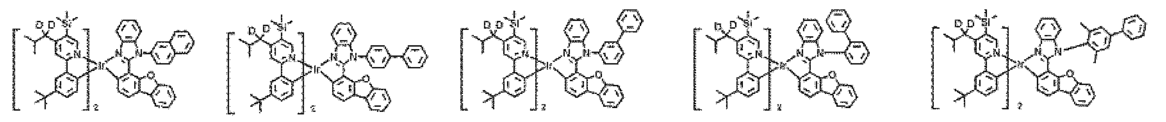
586 587 588 589 590

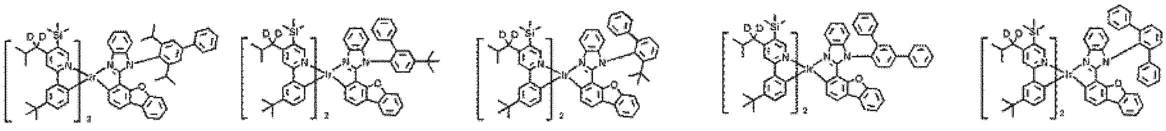
591 592 593 594 595

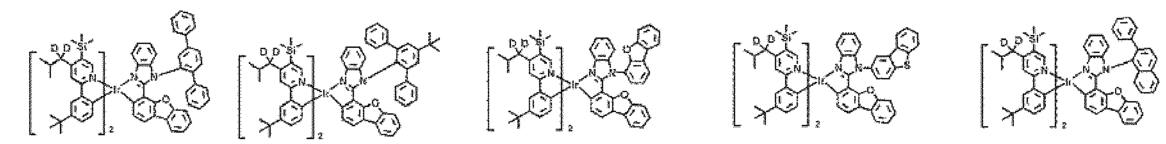
596 597 598 599 600

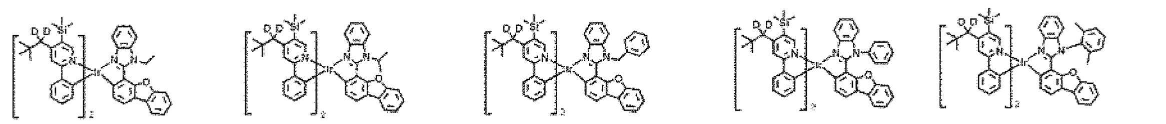
601 602 603 604 605

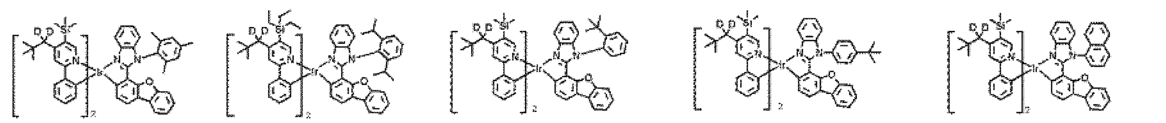
606 607 608 609 610

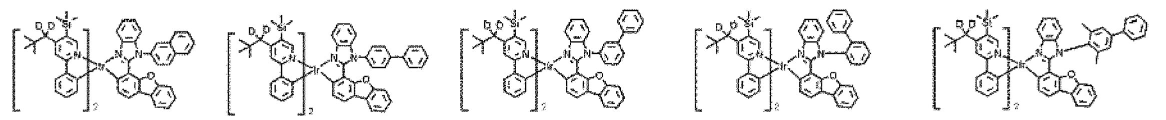
611 612 613 614 615

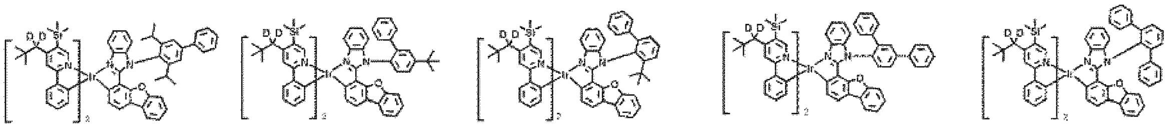
616 617 618 619 620

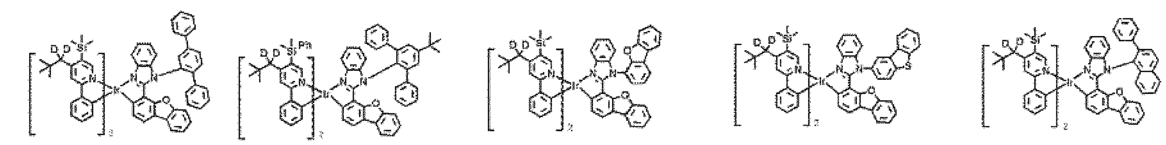
621 622 623 624 625

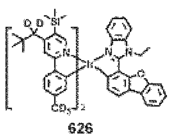
626

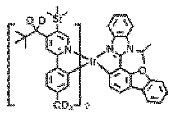
627

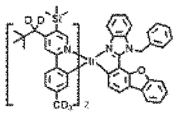
628

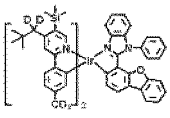
629

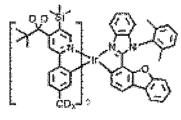
630

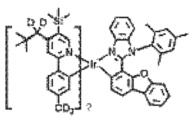
631

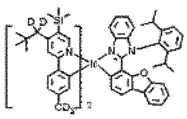
632

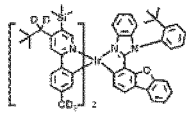
633

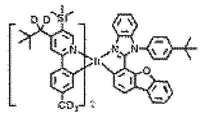
634

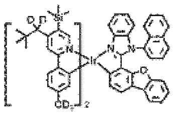
635

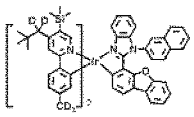
636

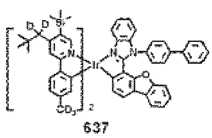
637

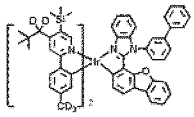
638

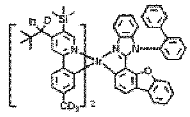
639

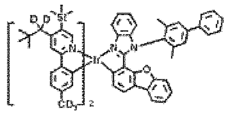
640

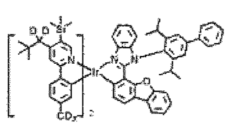
641

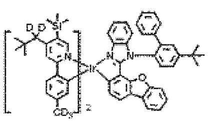
642

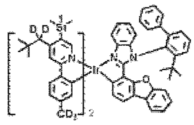
643

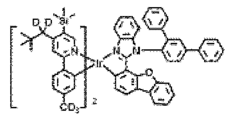
644

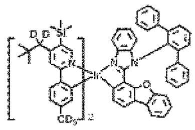
645

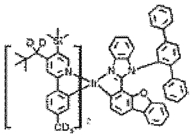
646

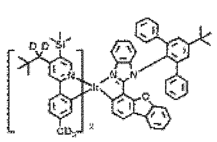
647

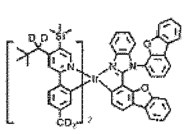
648

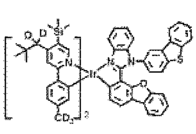
649

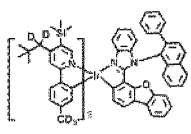
650

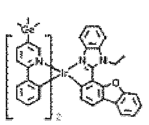
651

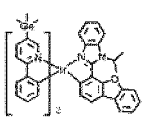
652

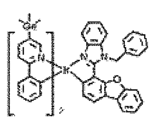
653

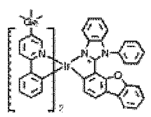
654

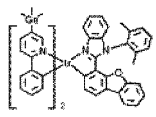
655

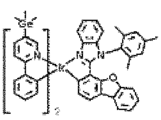
656

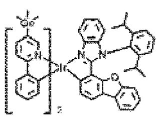
657

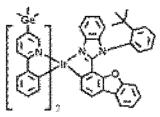
658

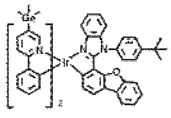
659

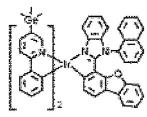
660

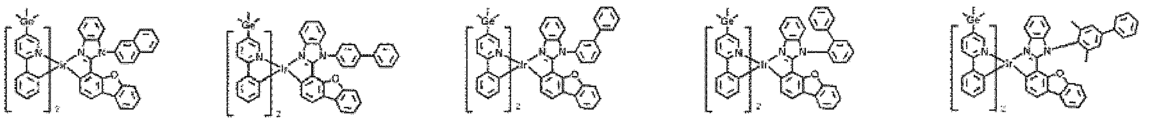
661 662 663 664 665

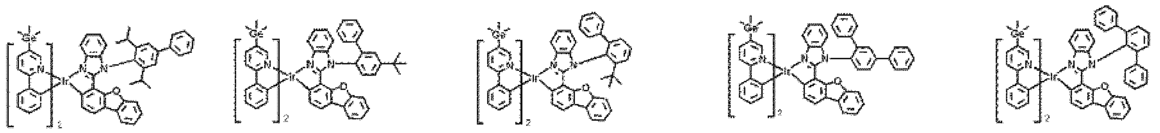
666 667 668 669 670

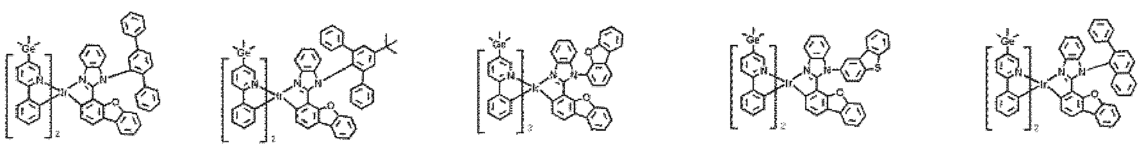
671 672 673 674 675

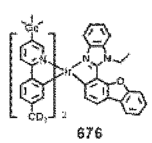
676
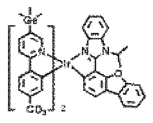
677
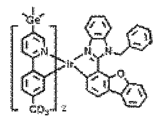
678
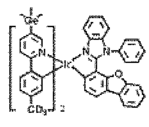
679
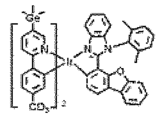
680
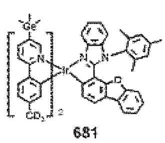
681
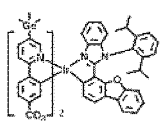
682
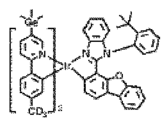
683
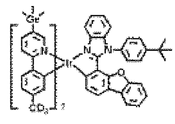
684
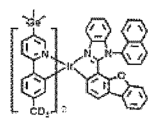
685
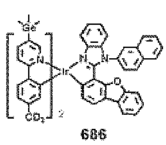
686
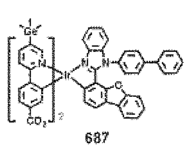
687
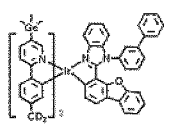
688
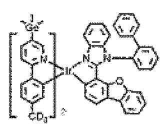
689
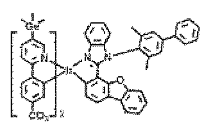
690
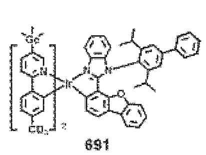
691
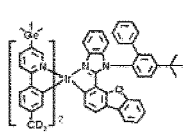
692
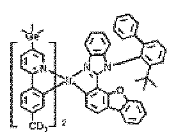
693
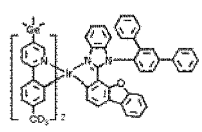
694
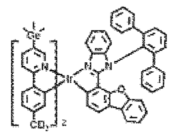
695
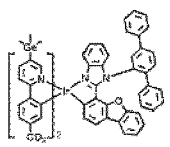
696
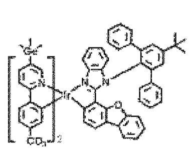
697
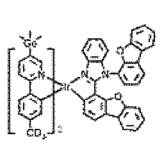
698
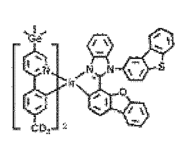
699
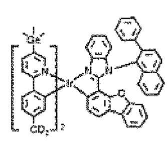
700
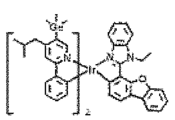
701
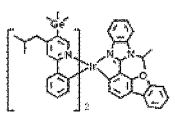
702
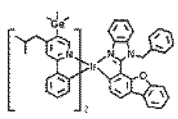
703
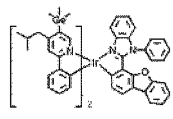
704
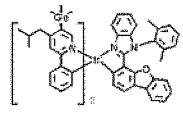
705
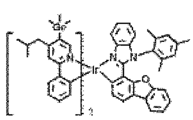
706
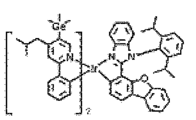
707
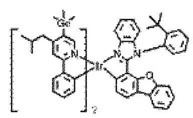
708
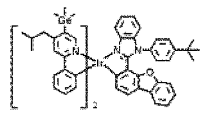
709
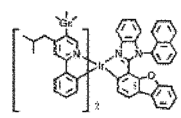
710
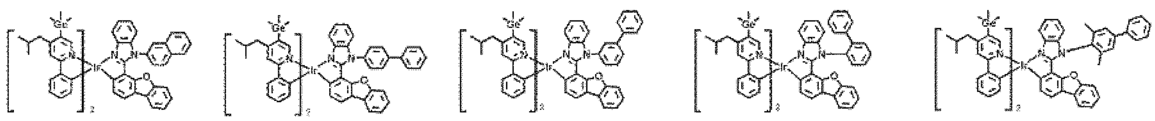
711 712 713 714 715
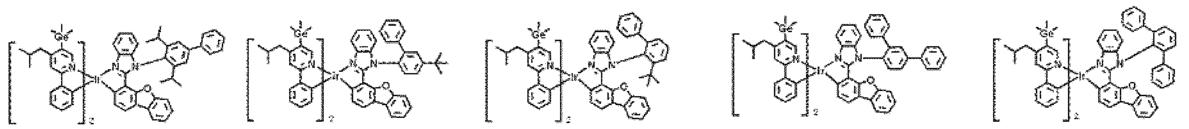
716 717 718 719 720
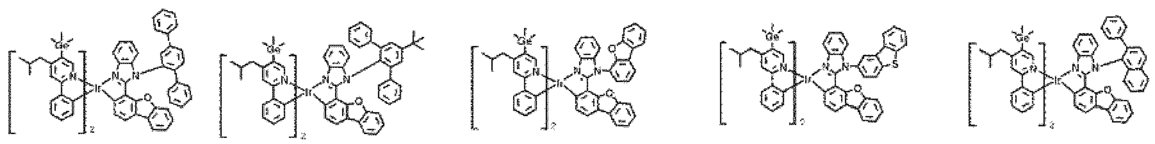
721 722 723 724 725

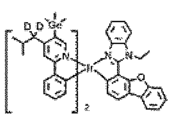
726
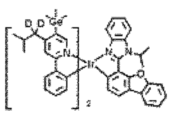
727
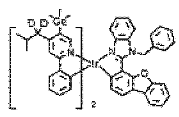
728
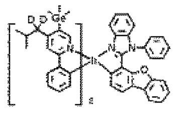
729
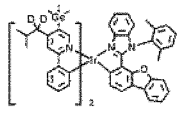
730

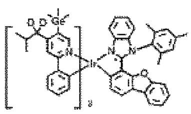
731
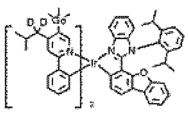
732
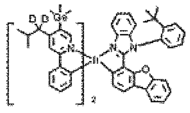
733
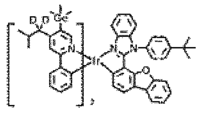
734
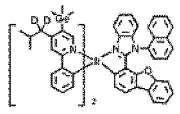
735

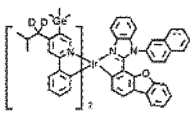
736
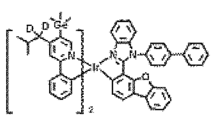
737
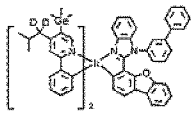
738
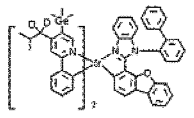
739
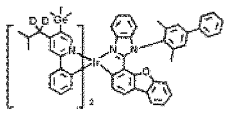
740

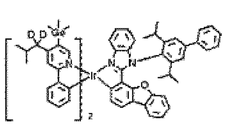
741
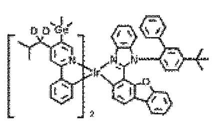
742
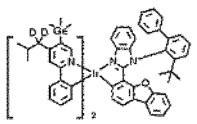
743
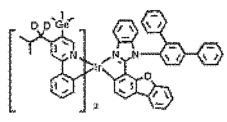
744
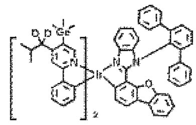
745

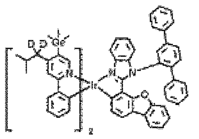
746
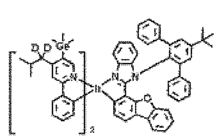
747
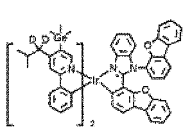
748
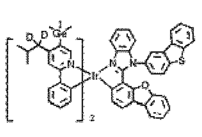
749
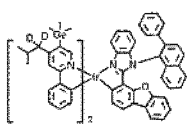
750

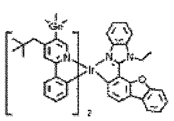
751
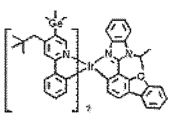
752
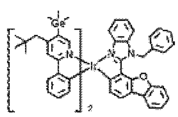
753
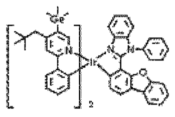
754
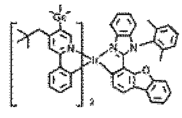
755

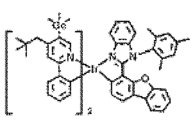
756
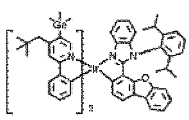
757
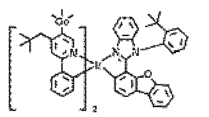
758
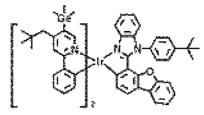
759
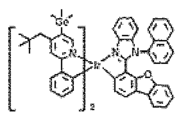
760

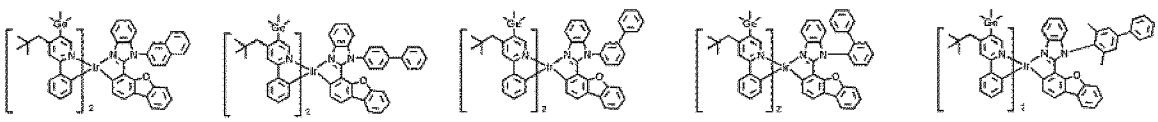
761 762 763 764 765

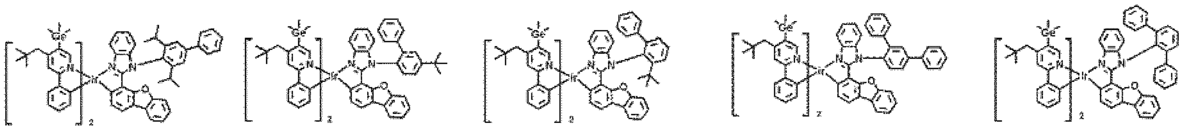
766 767 768 769 770

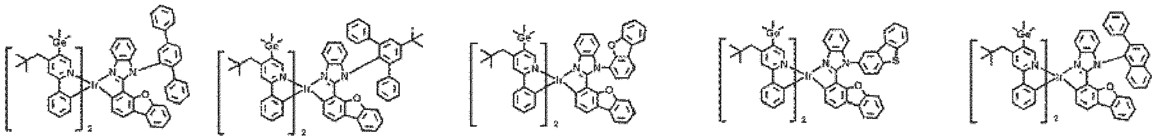
771 772 773 774 775

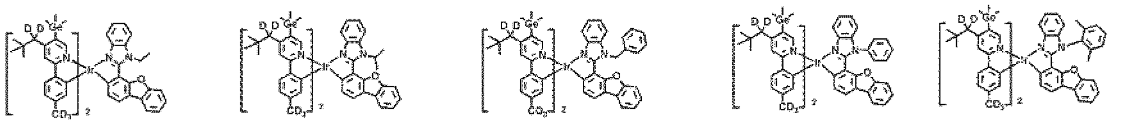
776
777
778
779
780

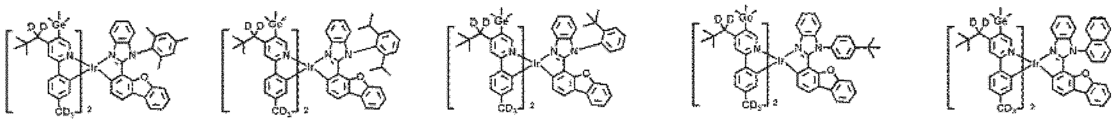
781
782
783
784
785

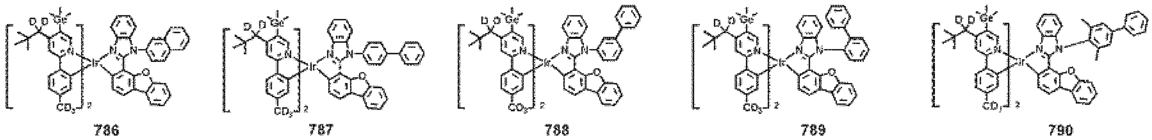
786
787
788
789
790

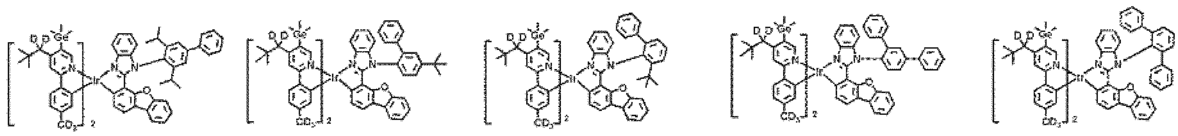
791
792
793
794
795

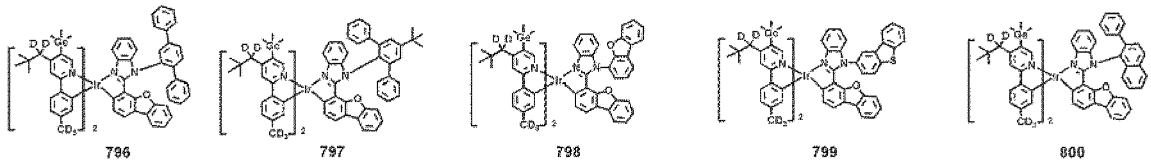
796
797
798
799
800

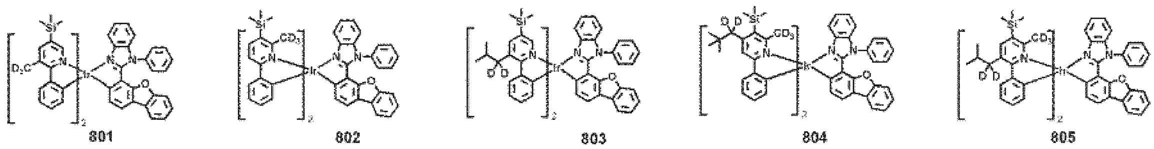
801
802
803
804
805

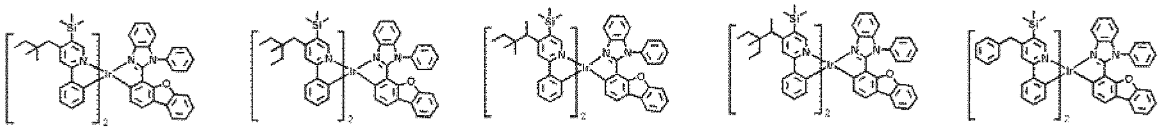
806
807
808
809
810

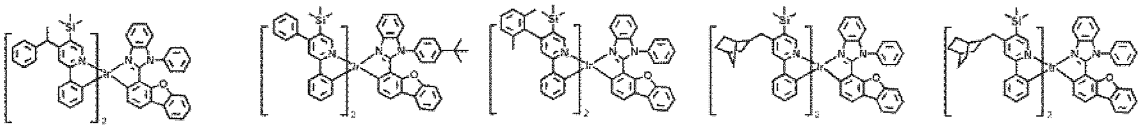
811
812
813
814
815

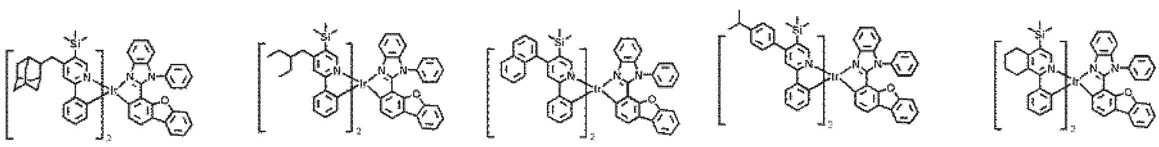
816
817
818
819
820

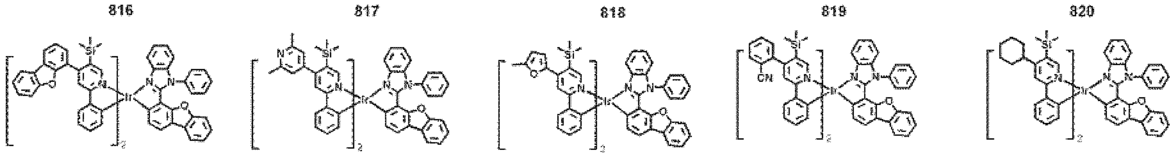
821
822
823
824
825

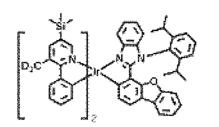 826 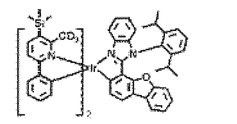 827 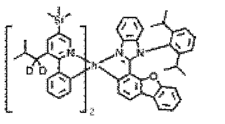 828 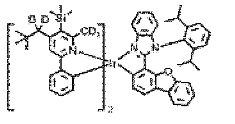 829 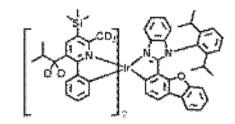 830

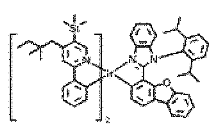 831 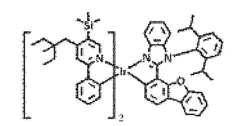 832 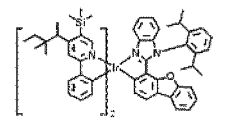 833 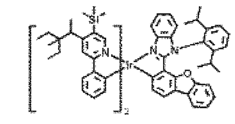 834 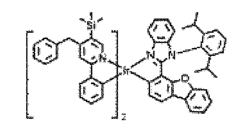 835

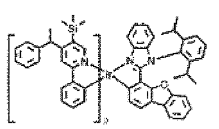 836 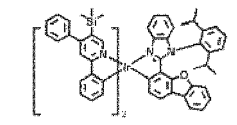 837 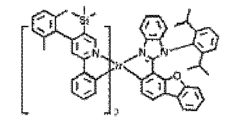 838 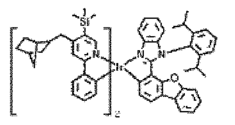 839 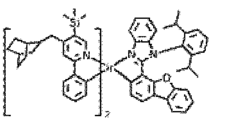 840

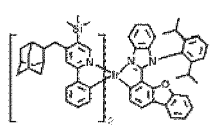 841 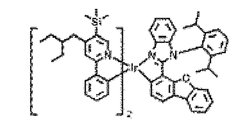 842 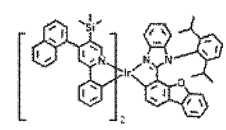 843 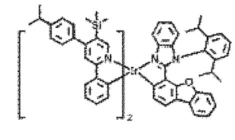 844 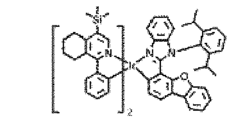 845

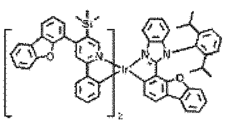 846 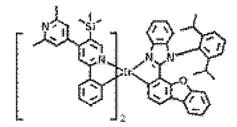 847 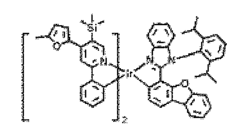 848 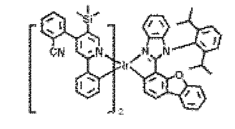 849 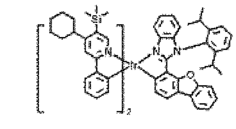 850

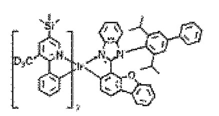 851 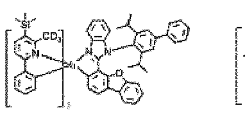 852 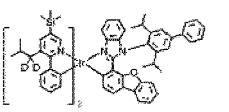 853 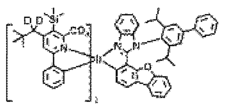 854 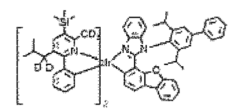 855

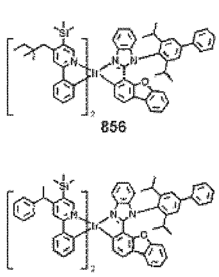 856 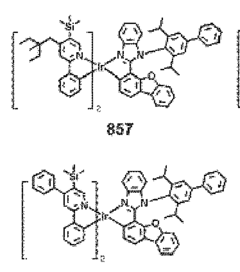 857 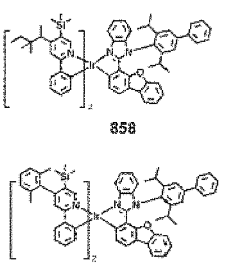 858 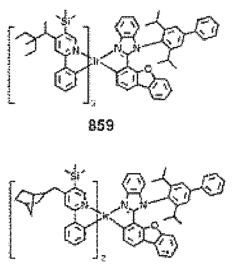 859 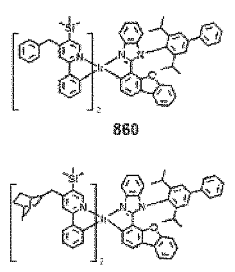 860

861 862 863 864 865

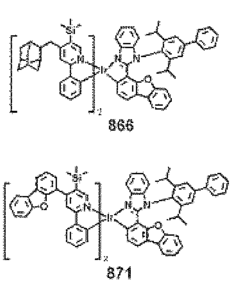 866 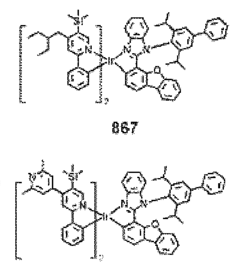 867 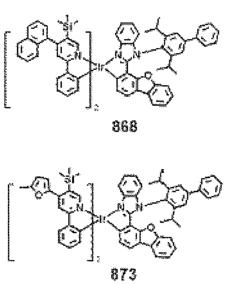 868 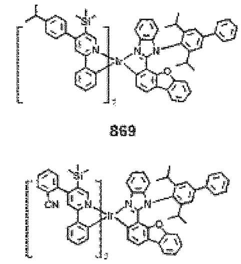 869 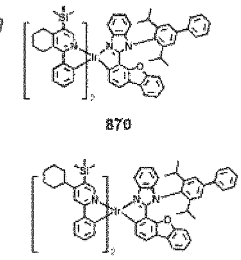 870

871 872 873 874 875

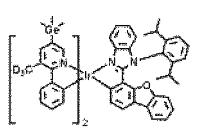
876
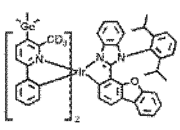
877
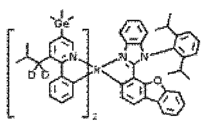
878
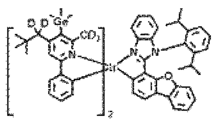
879
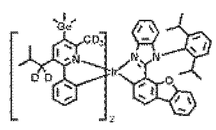
880

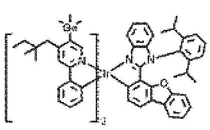
881
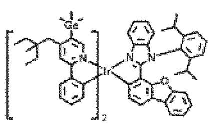
882
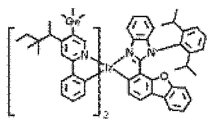
883
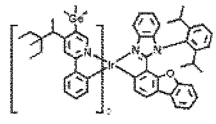
884
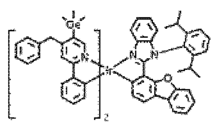
885

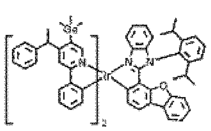
886
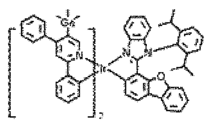
887
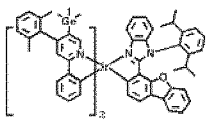
888
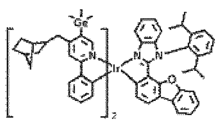
889
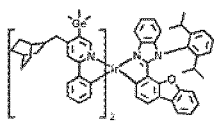
890

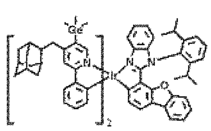
891
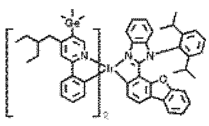
892
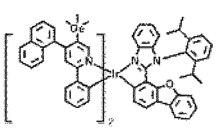
893
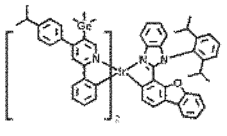
894
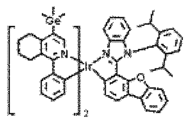
895

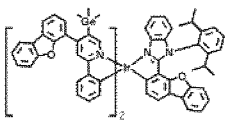
896
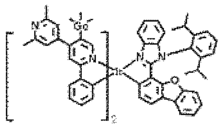
897
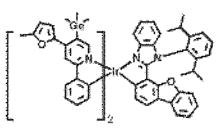
898
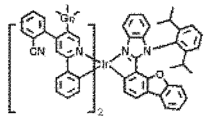
899
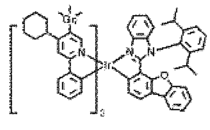
900

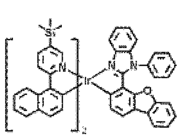
901
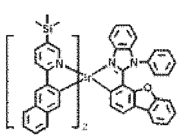
902
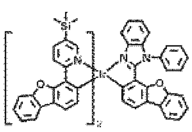
903
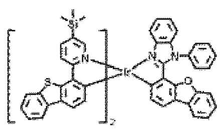
904
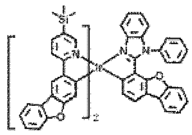
905

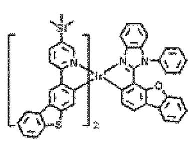
906
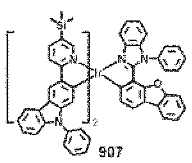
907
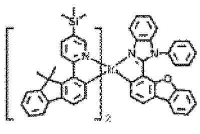
908
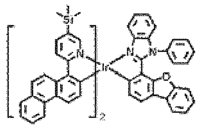
909
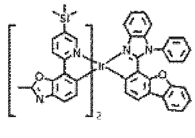
910

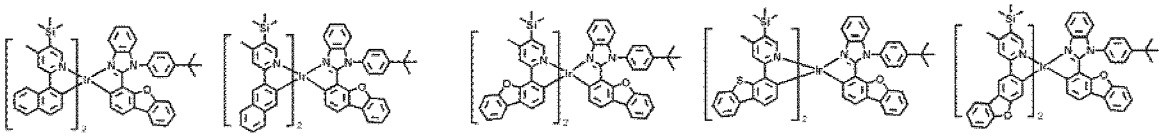
911
912
913
914
915

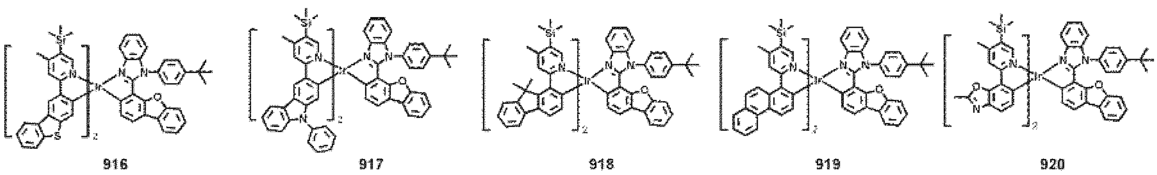
916
917
918
919
920

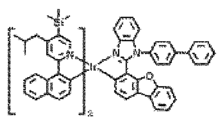
921
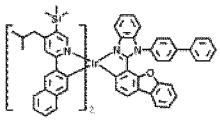
922
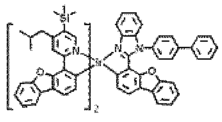
923
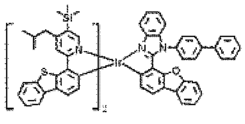
924
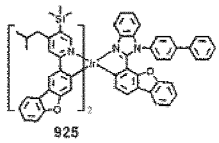
925

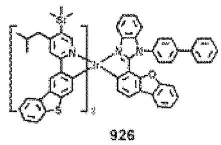
926
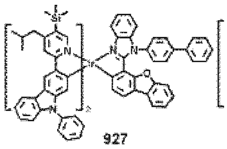
927
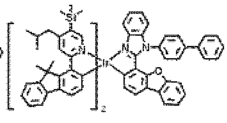
928
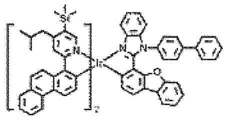
929
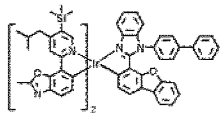
930

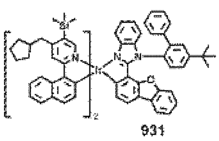
931
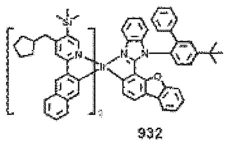
932
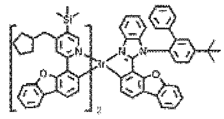
933
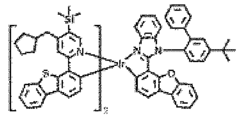
934
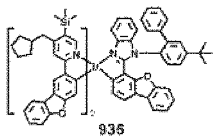
935

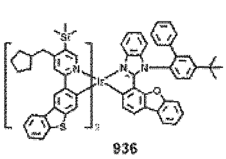
936
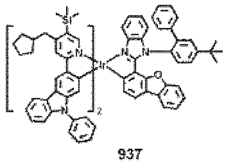
937
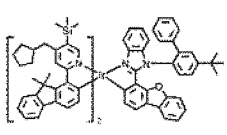
938
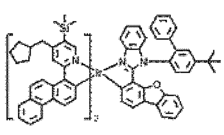
939
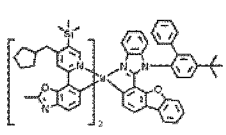
940

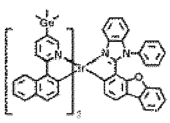
941
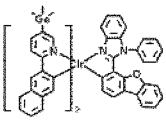
942
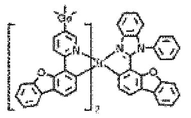
943
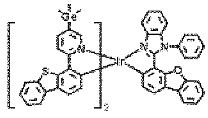
944
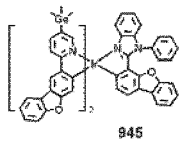
945

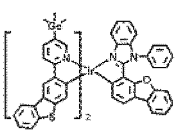
946
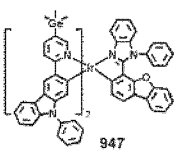
947
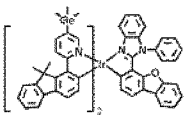
948
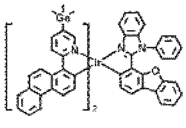
949
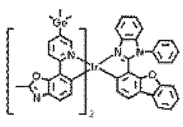
950

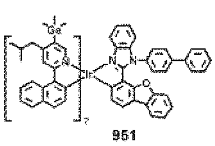
951
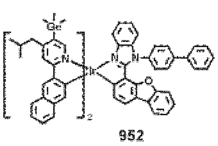
952
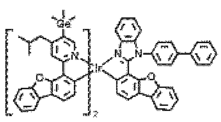
953
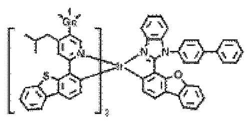
954
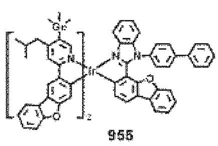
955

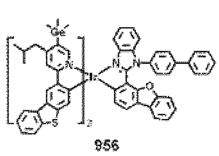
956
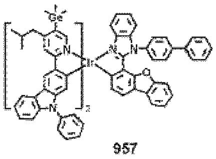
957
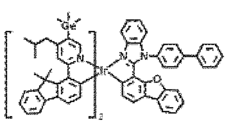
958
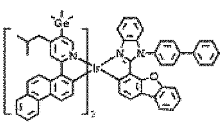
959
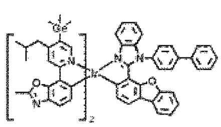
960

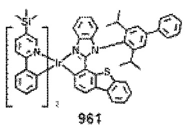
961
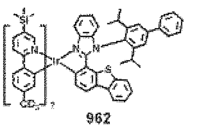
962
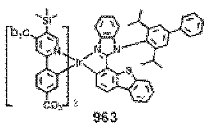
963
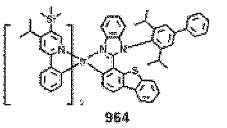
964
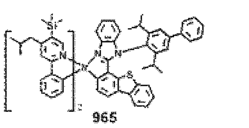
965
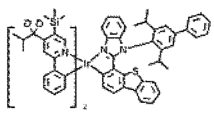
966
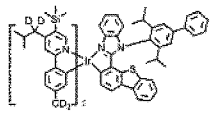
967
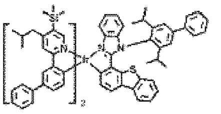
968
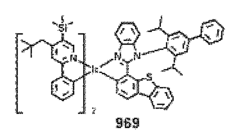
969
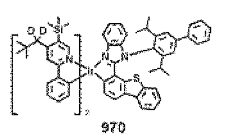
970
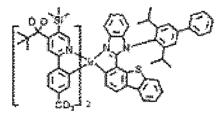
971
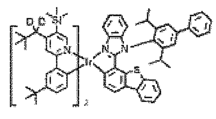
972
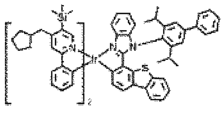
973
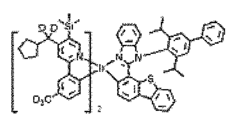
974
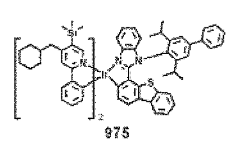
975
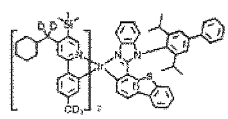
976
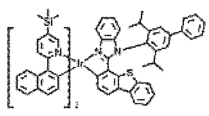
977
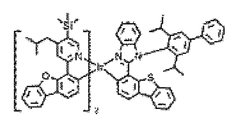
978
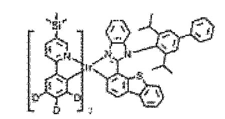
979
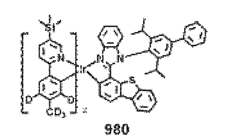
980
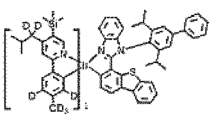
981
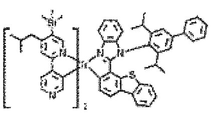
982
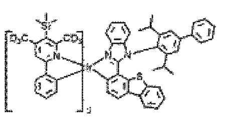
983
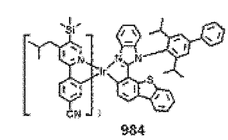
984
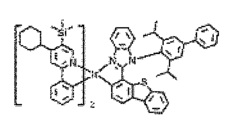
985
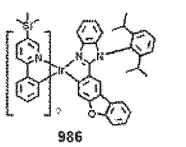
986
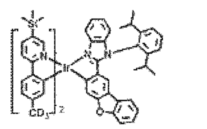
987
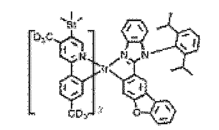
988
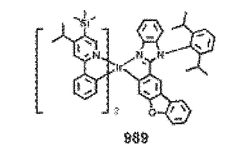
989
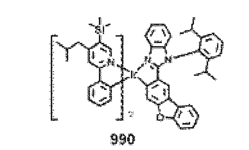
990
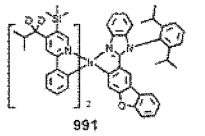
991
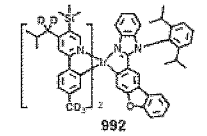
992
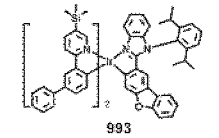
993
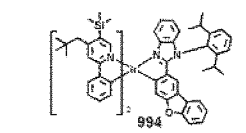
994
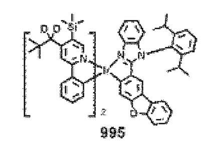
995
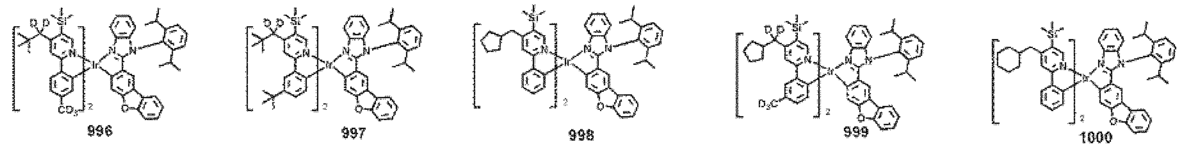
996
997
998
999
1000
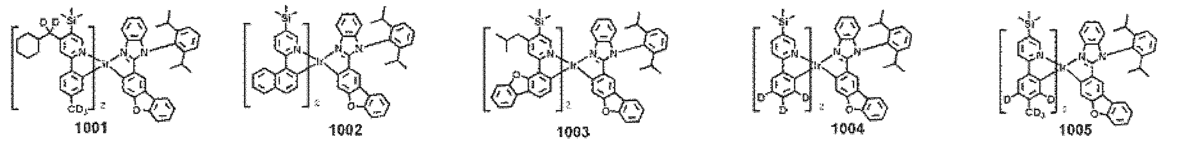
1001
1002
1003
1004
1005
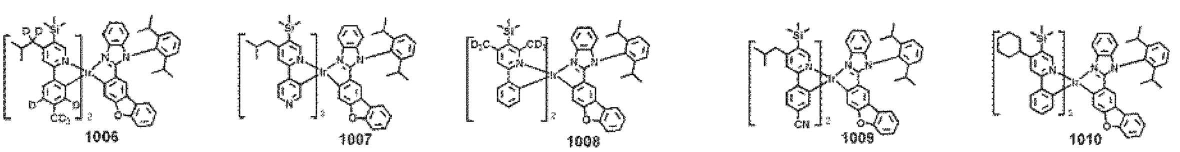
1006
1007
1008
1009
1010

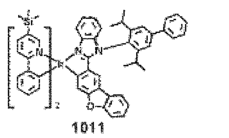
1011
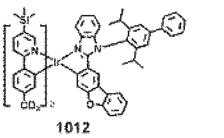
1012
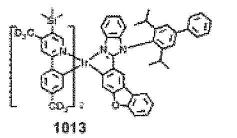
1013
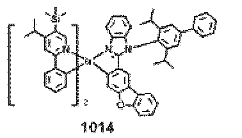
1014
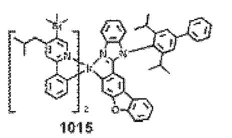
1015

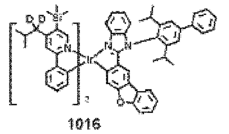
1016
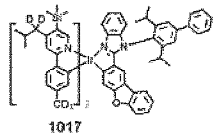
1017
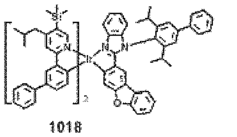
1018
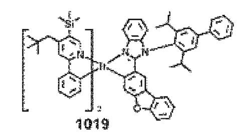
1019
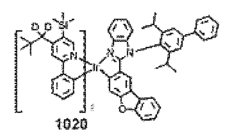
1020

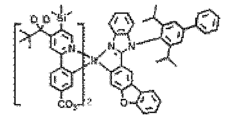
1021
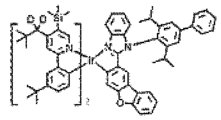
1022
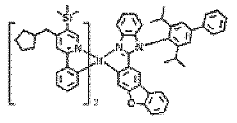
1023
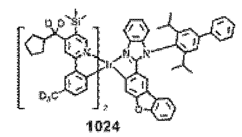
1024
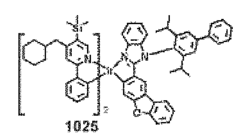
1025

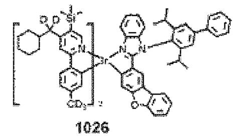
1026
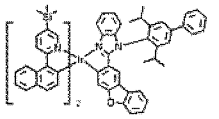
1027
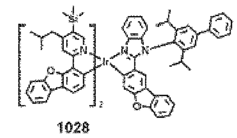
1028
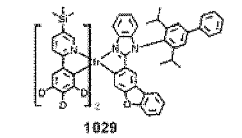
1029
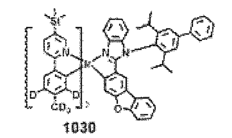
1030

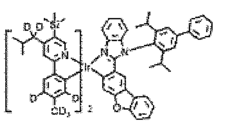
1031
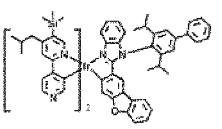
1032
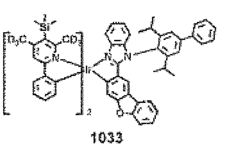
1033
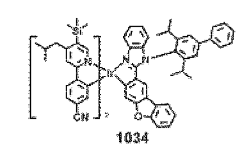
1034
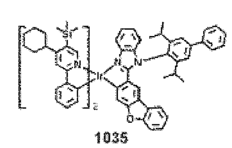
1035

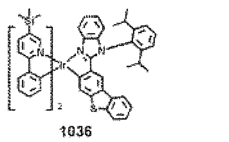
1036
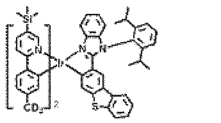
1037
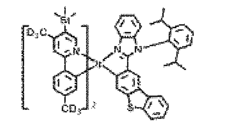
1038
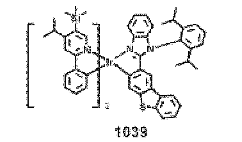
1039
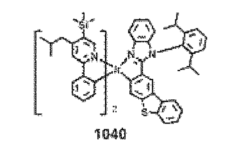
1040

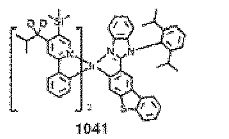
1041
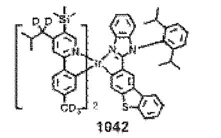
1042
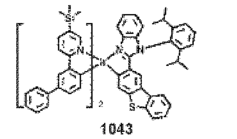
1043
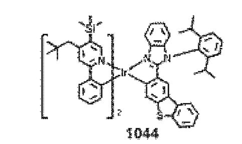
1044
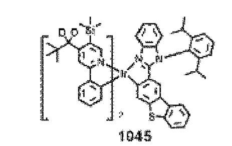
1045

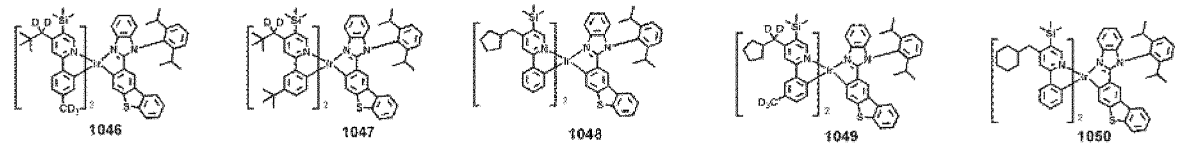
1046 1047 1048 1049 1050

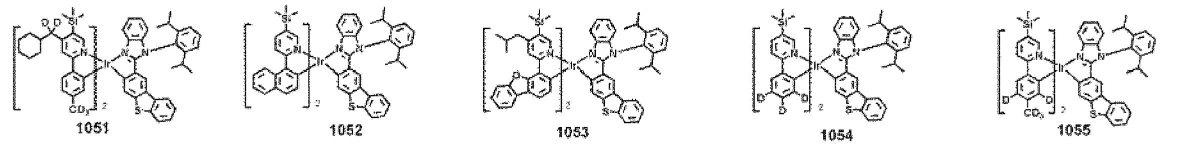
1051 1052 1053 1054 1055

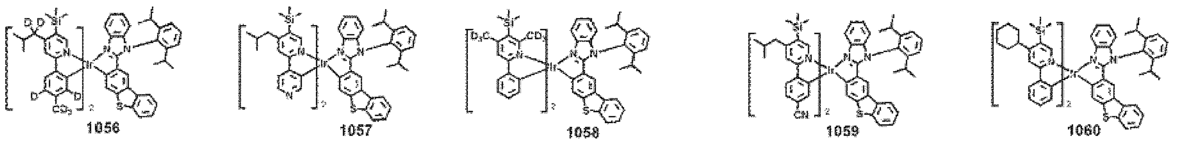
1056 1057 1058 1059 1060

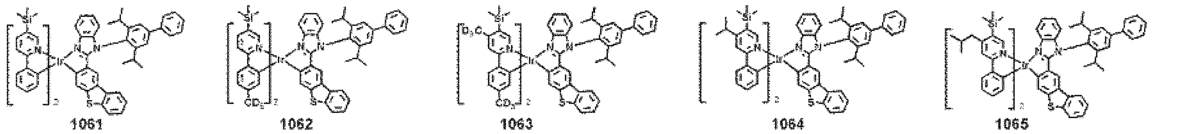
1061 1062 1063 1064 1065
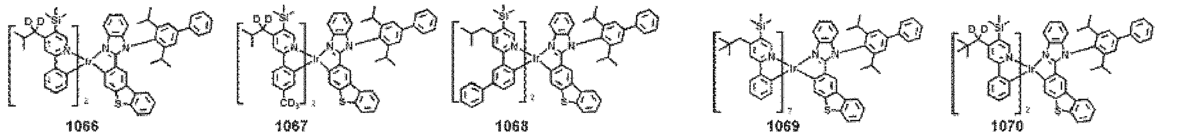
1066 1067 1068 1069 1070
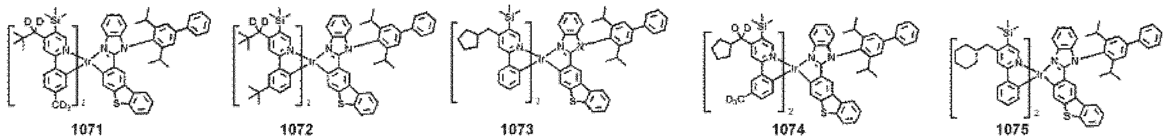
1071 1072 1073 1074 1075
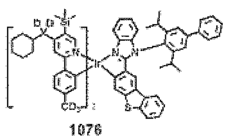
1076
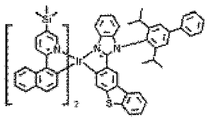
1077
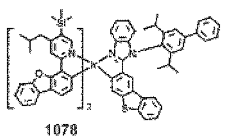
1078
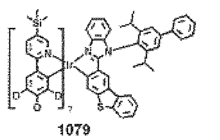
1079
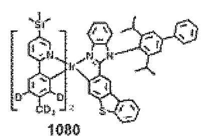
1080
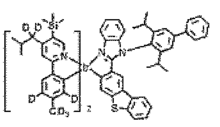
1081
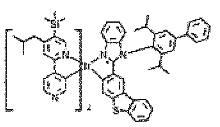
1082
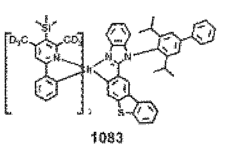
1083
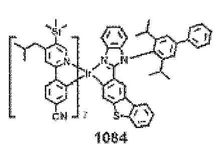
1084
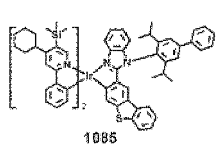
1085
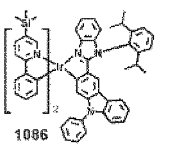
1086
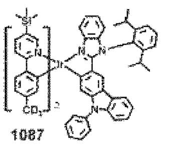
1087
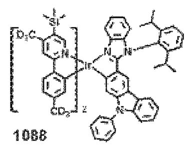
1088
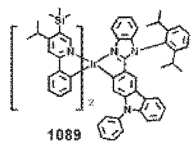
1089
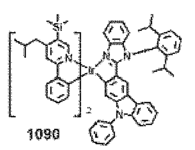
1090
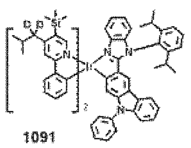
1091
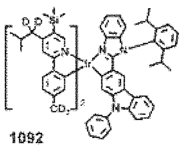
1092
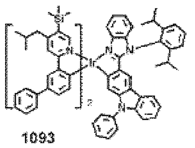
1093
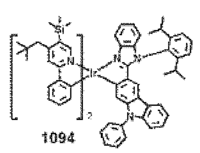
1094
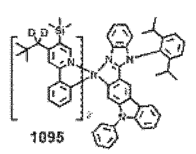
1095
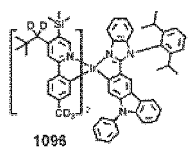
1096
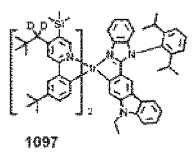
1097
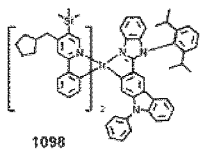
1098
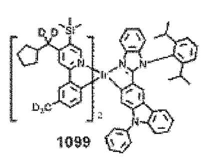
1099
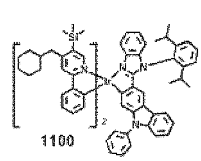
1100
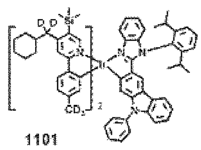
1101
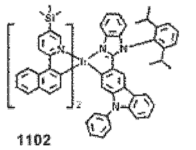
1102
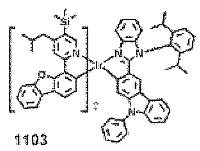
1103
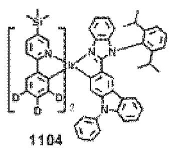
1104
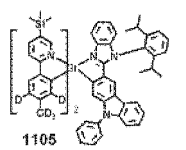
1105
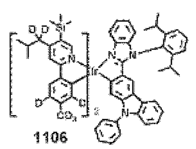
1106
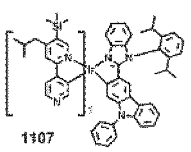
1107
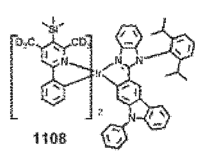
1108
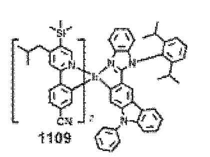
1109
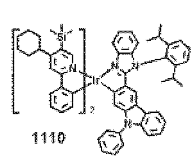
1110

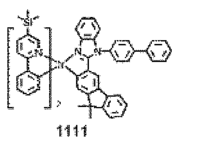
1111
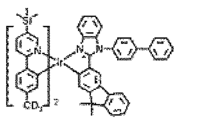
1112
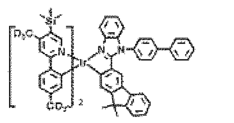
1113
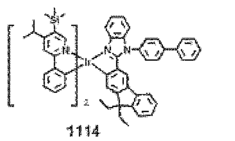
1114
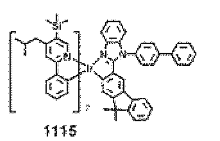
1115

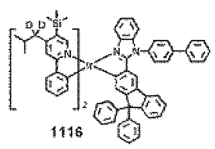
1116
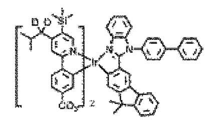
1117
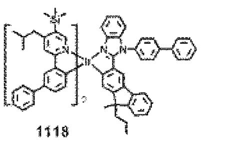
1118
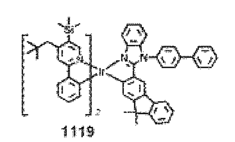
1119
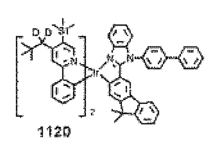
1120

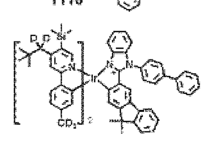
1121
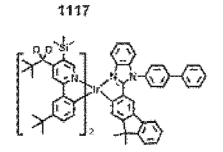
1122
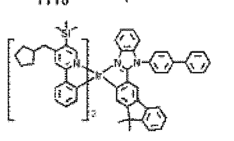
1123
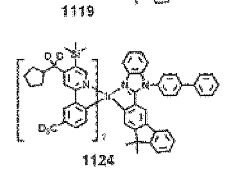
1124
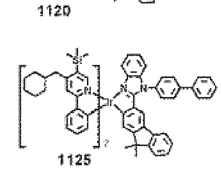
1125

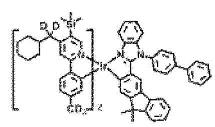
1126
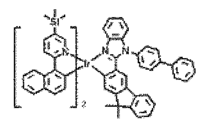
1127
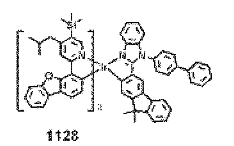
1128
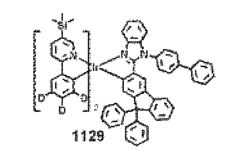
1129
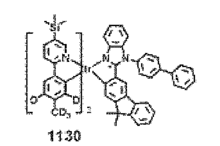
1130

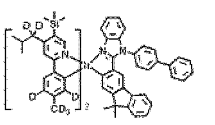
1131
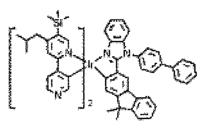
1132
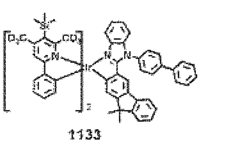
1133
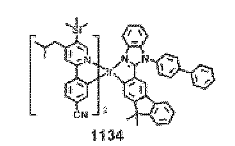
1134
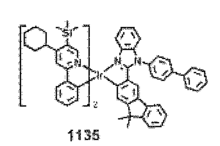
1135

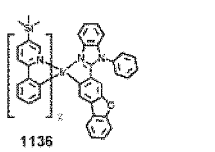
1136
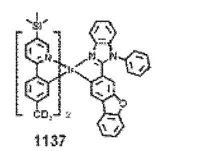
1137
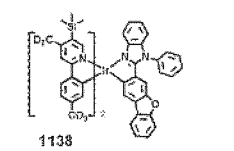
1138
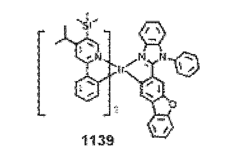
1139
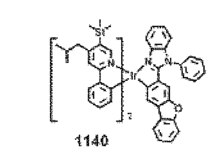
1140

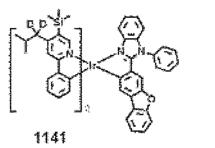
1141
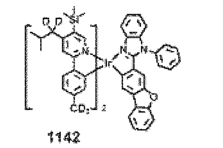
1142
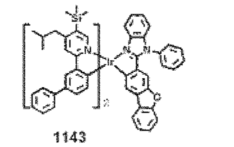
1143
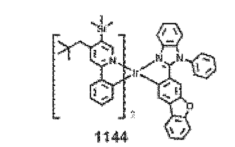
1144
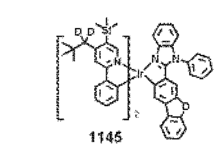
1145

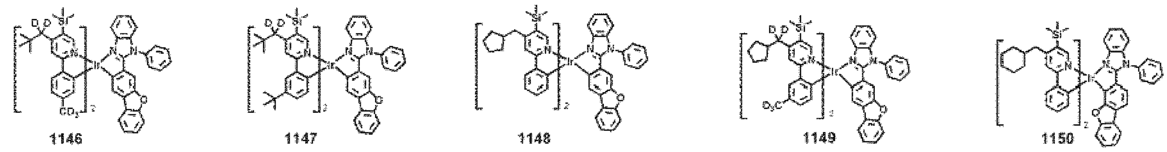
1146
1147
1148
1149
1150

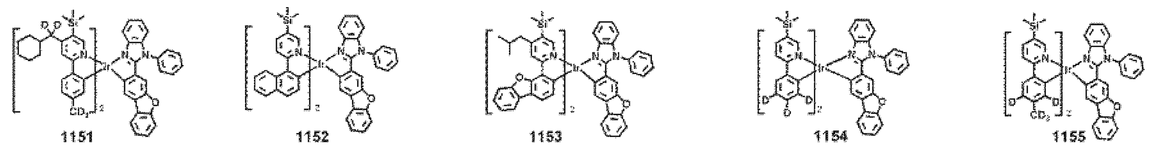
1151
1152
1153
1154
1155

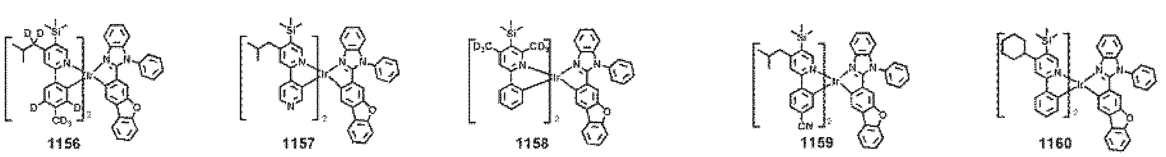
1156
1157
1158
1159
1160

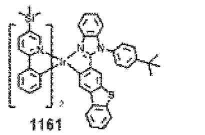
1161
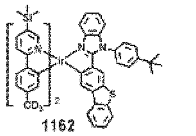
1162
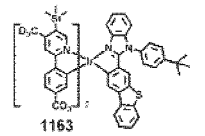
1163
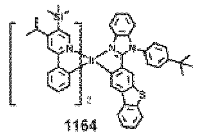
1164
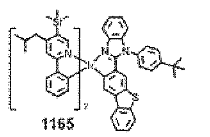
1165

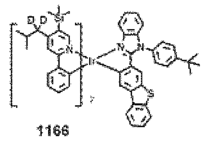
1166
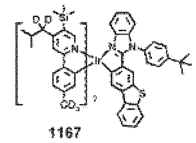
1167
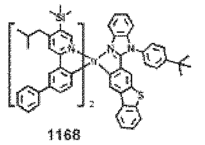
1168
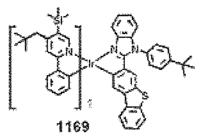
1169
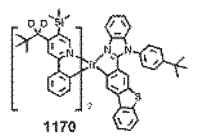
1170

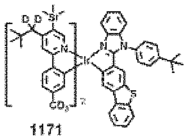
1171
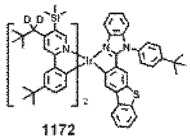
1172
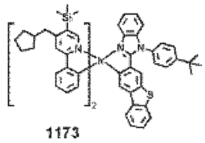
1173
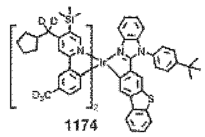
1174
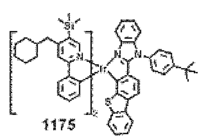
1175

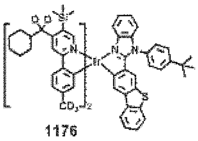
1176
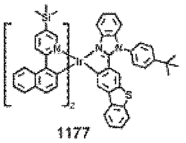
1177
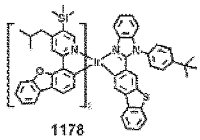
1178
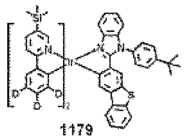
1179
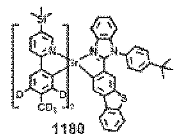
1180

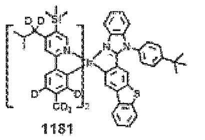
1181
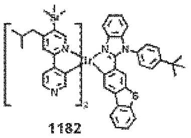
1182
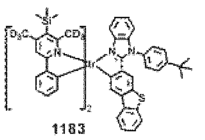
1183
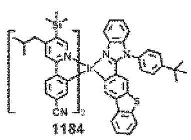
1184
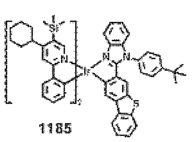
1185

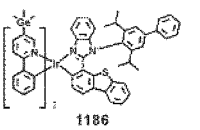
1186
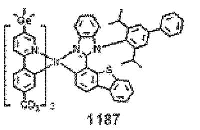
1187
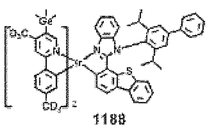
1188
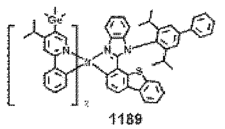
1189
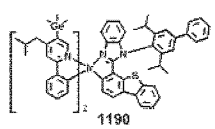
1190

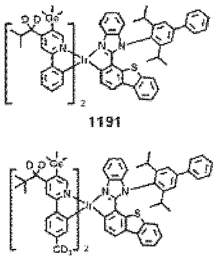
1191
1196
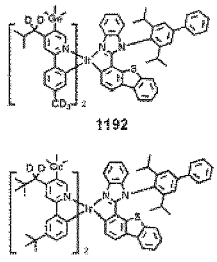
1192
1197
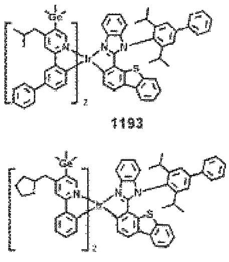
1193
1198
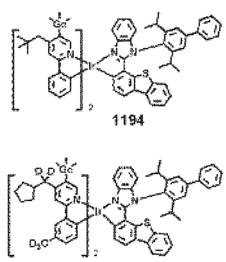
1194
1199
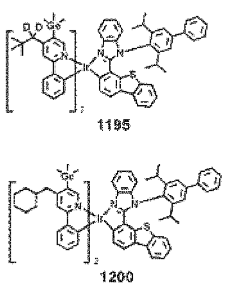
1195
1200

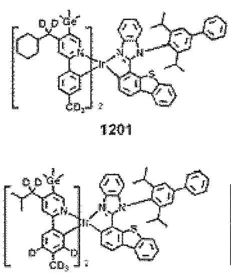
1201
1206
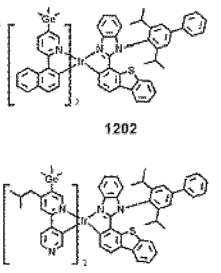
1202
1207
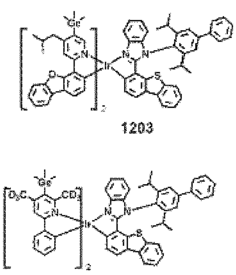
1203
1208
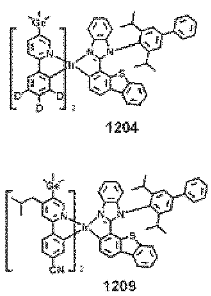
1204
1209
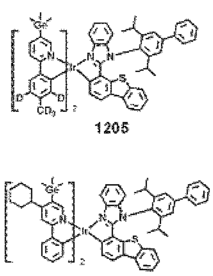
1205
1210

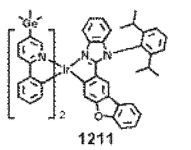
1211
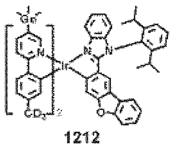
1212
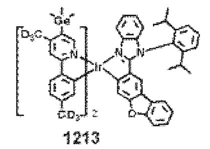
1213
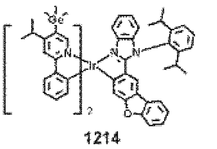
1214
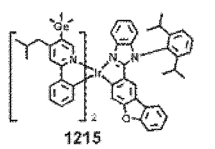
1215
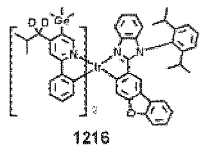
1216
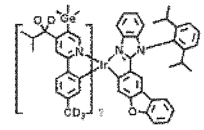
1217
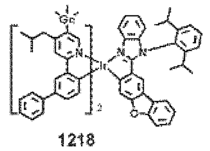
1218
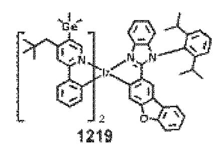
1219
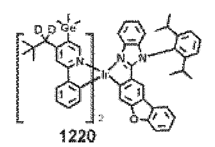
1220
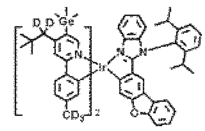
1221
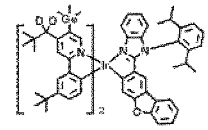
1222
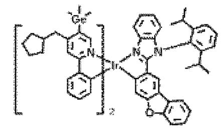
1223
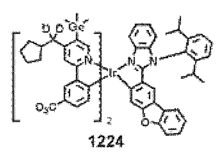
1224
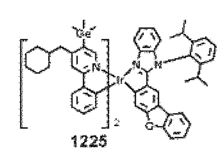
1225
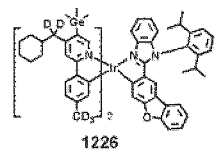
1226
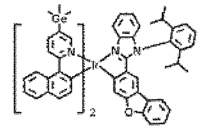
1227
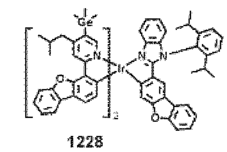
1228
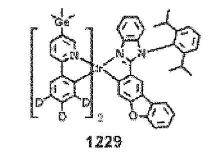
1229
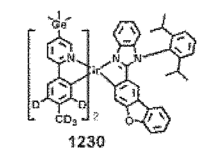
1230
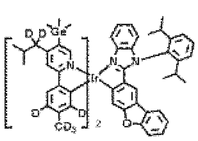
1231
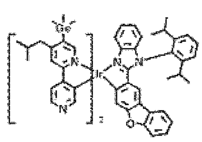
1232
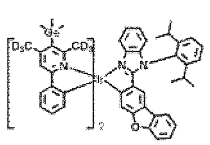
1233
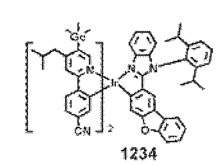
1234
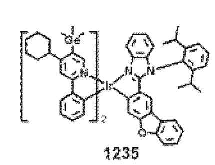
1235
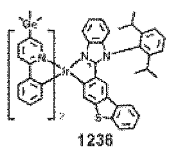
1236
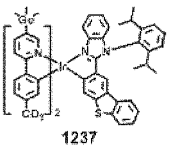
1237
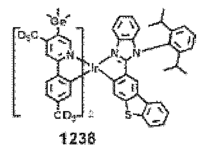
1238
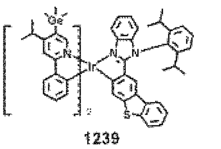
1239
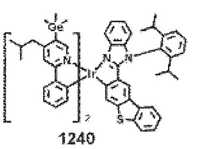
1240
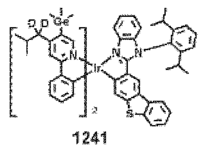
1241
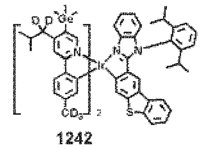
1242
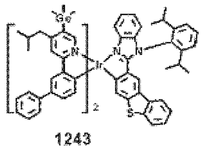
1243
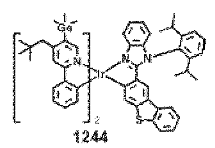
1244
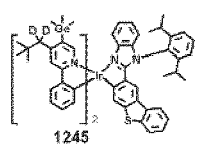
1245
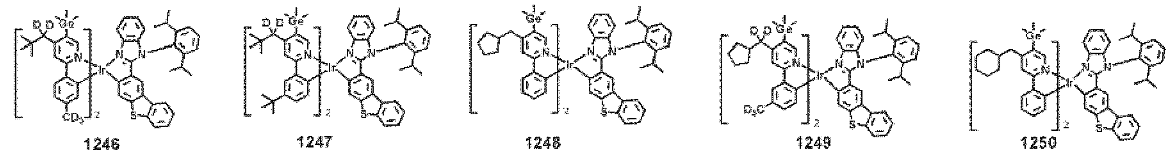
1246 1247 1248 1249 1250
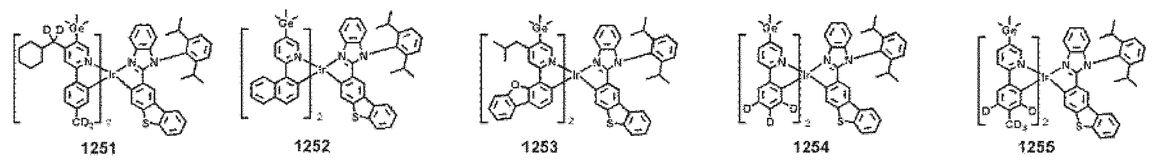
1251 1252 1253 1254 1255
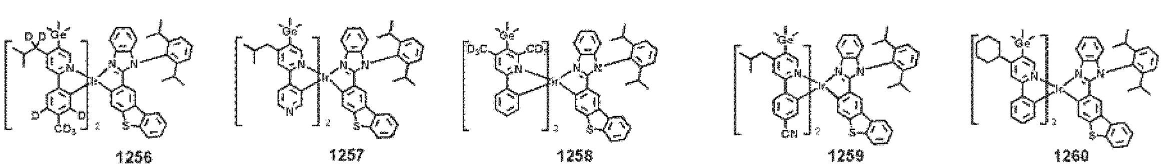
1256 1257 1258 1259 1260

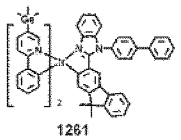
1261

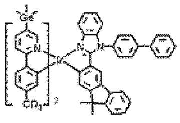
1262

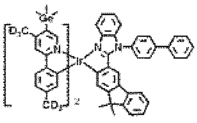
1263

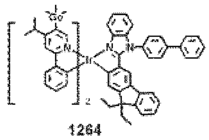
1264

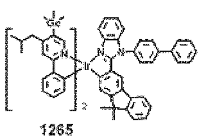
1265

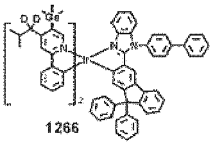
1266

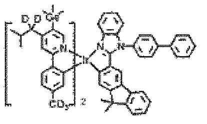
1267

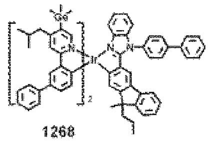
1268

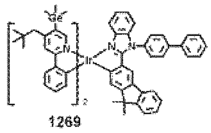
1269

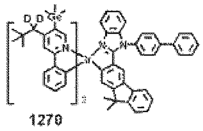
1270

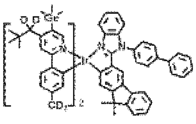
1271

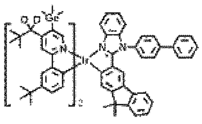
1272

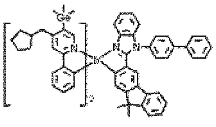
1273

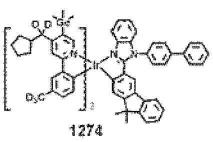
1274

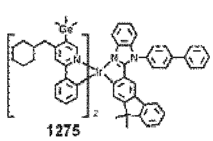
1275

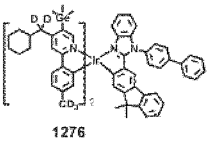
1276

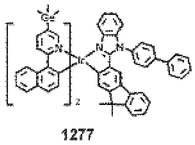
1277

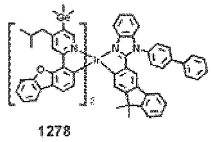
1278

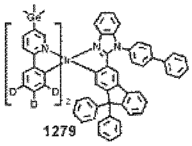
1279

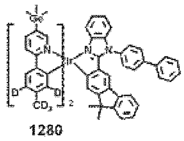
1280

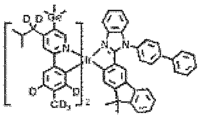
1281

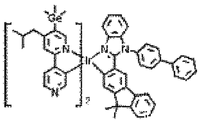
1282

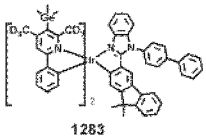
1283

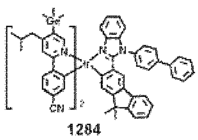
1284

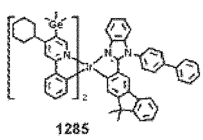
1285

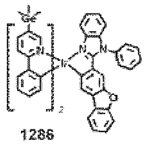
1286

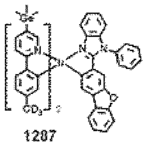
1287

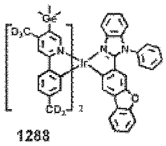
1288

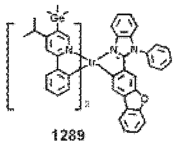
1289

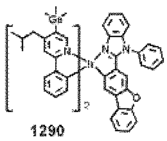
1290

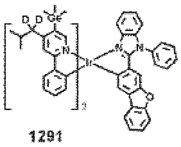
1291

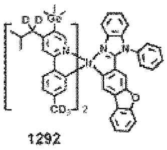
1292

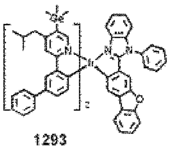
1293

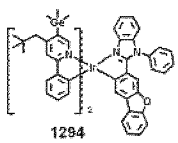
1294

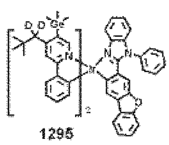
1295

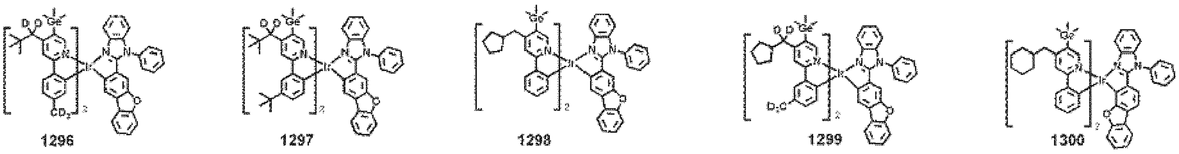
1296 1297 1298 1299 1300

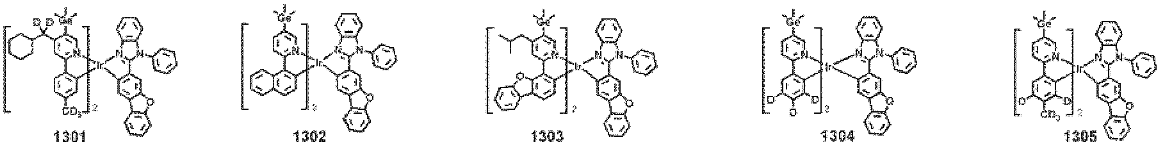
1301 1302 1303 1304 1305

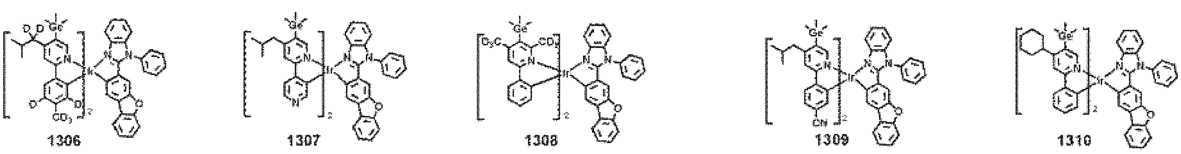
1306 1307 1308 1309 1310

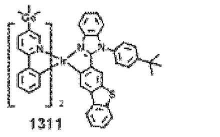
1311

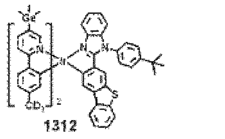
1312

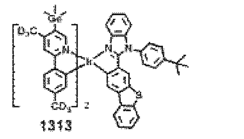
1313

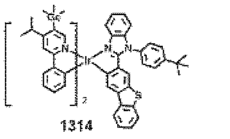
1314

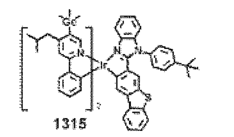
1315

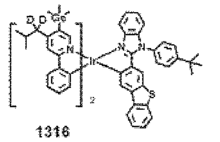
1316

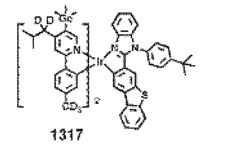
1317

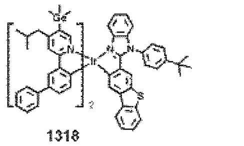
1318

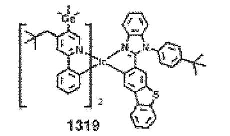
1319

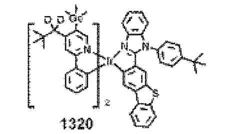
1320

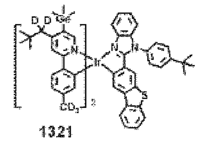
1321

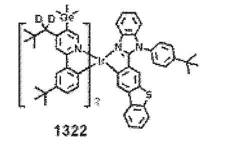
1322

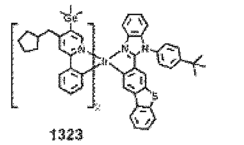
1323

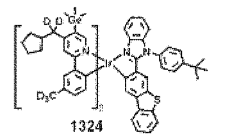
1324

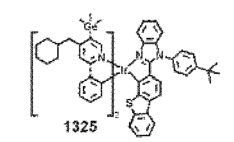
1325

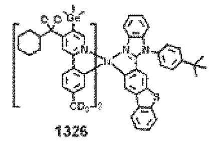
1326

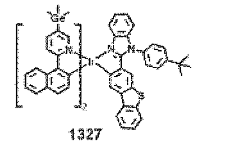
1327

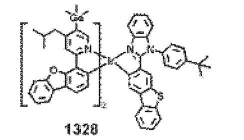
1328

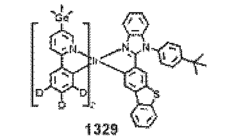
1329

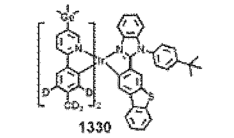
1330

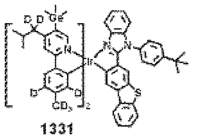
1331

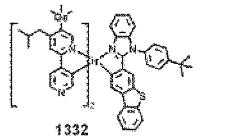
1332

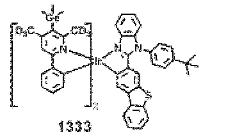
1333

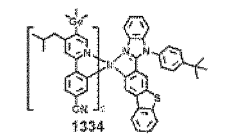
1334

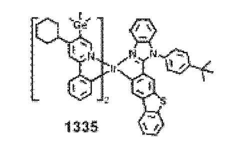
1335

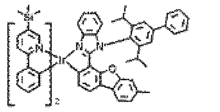
1336

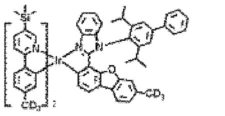
1337

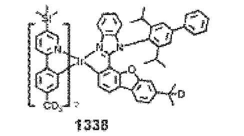
1338

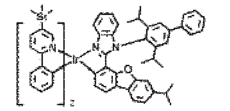
1339

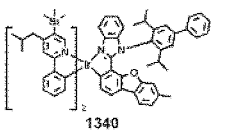
1340

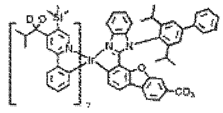
1341

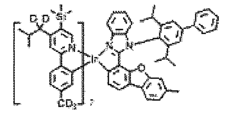
1342

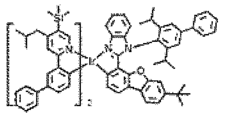
1343

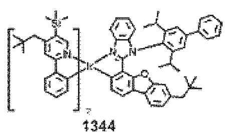
1344

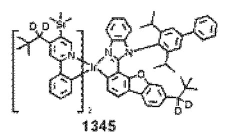
1345

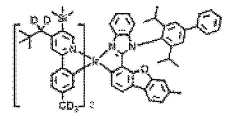
1346

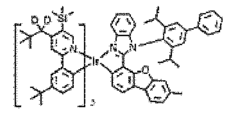
1347

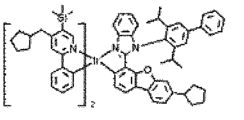
1348

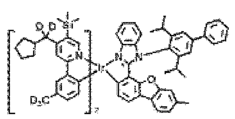
1349

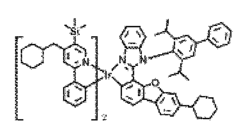
1350

1351

1352

1353

1354

1355

1356

1357

1358

1359

1360

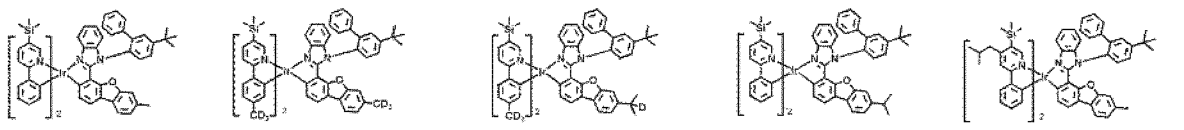
1361 1362 1363 1364 1365

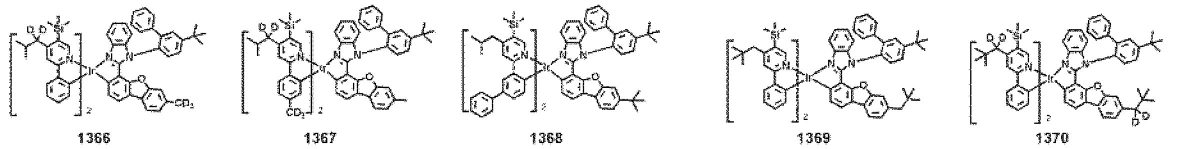
1366 1367 1368 1369 1370

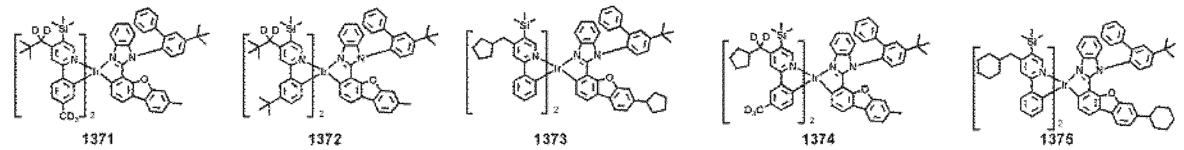
1371 1372 1373 1374 1375

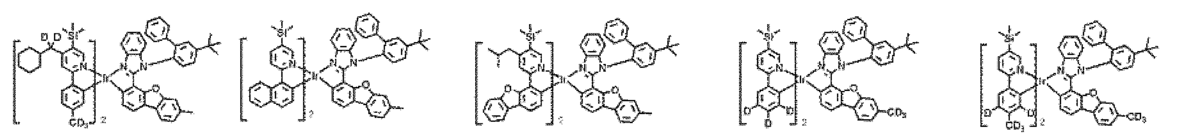
1376 1377 1378 1379 1380

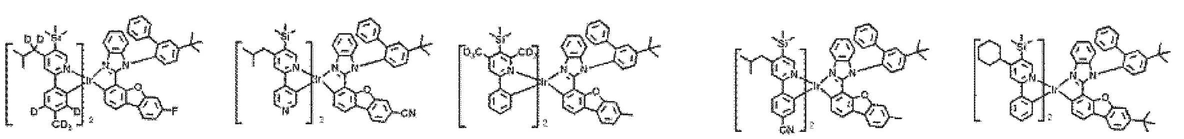
1381 1382 1383 1384 1385

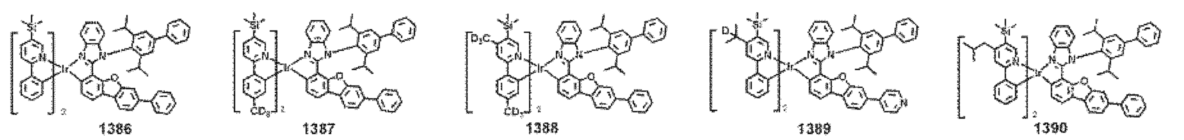
1386 1387 1388 1389 1390

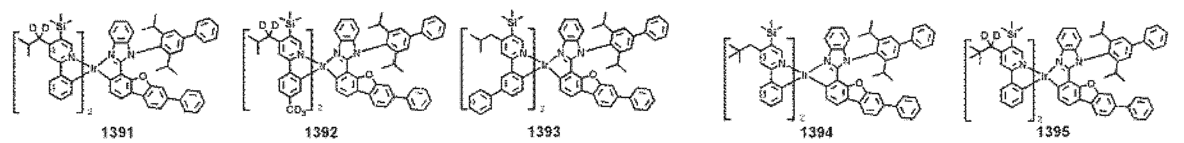
1391 1392 1393 1394 1395

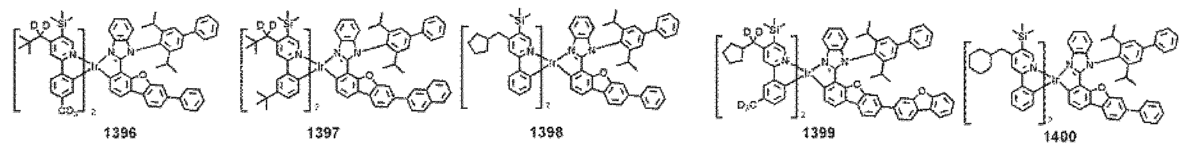
1396 1397 1398 1399 1400

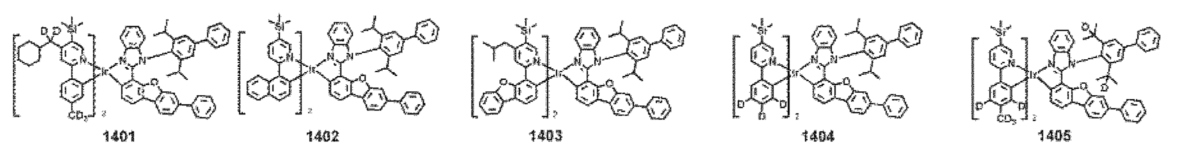
1401 1402 1403 1404 1405

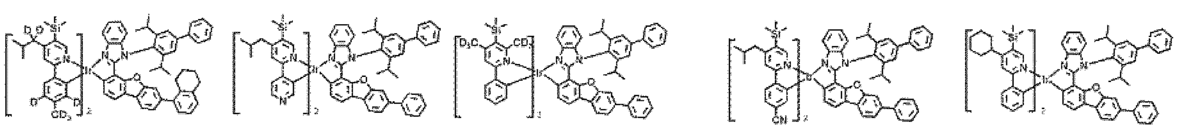
1406 1407 1408 1409 1410

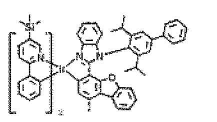
1411
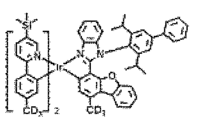
1412
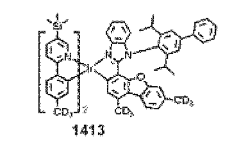
1413
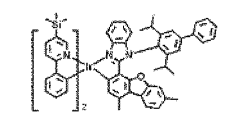
1414
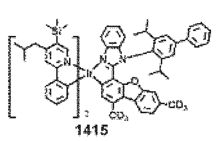
1415

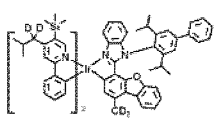
1416
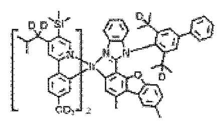
1417
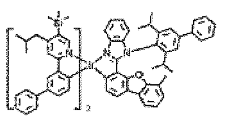
1418
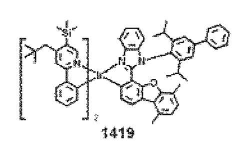
1419
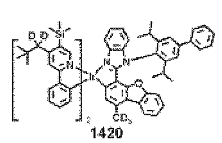
1420

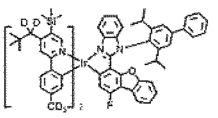
1421
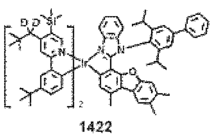
1422
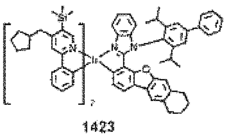
1423
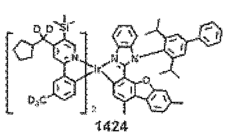
1424
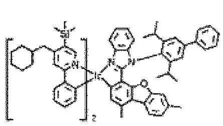
1425

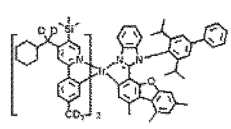
1426
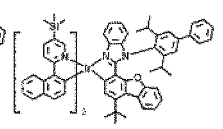
1427
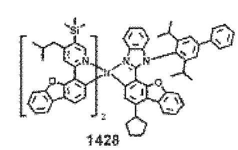
1428
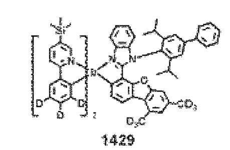
1429
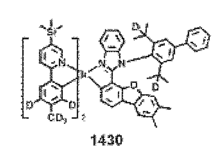
1430

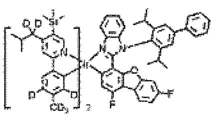
1431
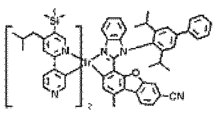
1432
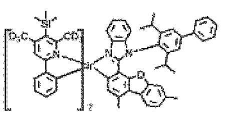
1433
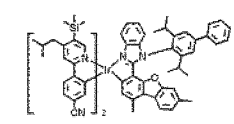
1434
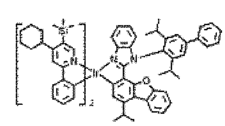
1435

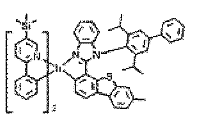
1436
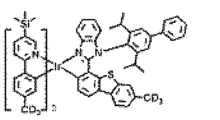
1437
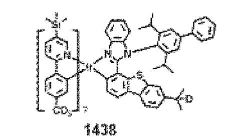
1438
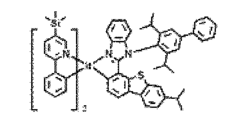
1439
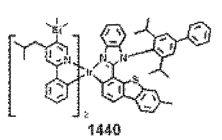
1440

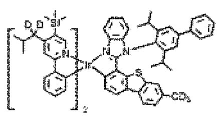
1441
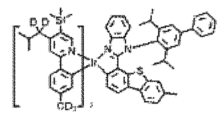
1442
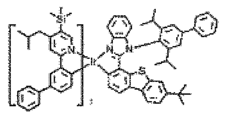
1443
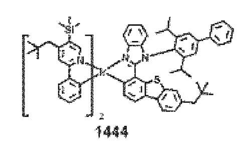
1444
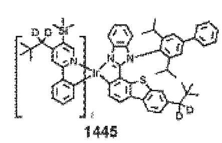
1445

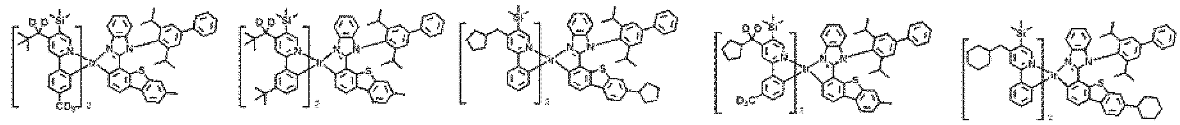
1446
1447
1448
1449
1450

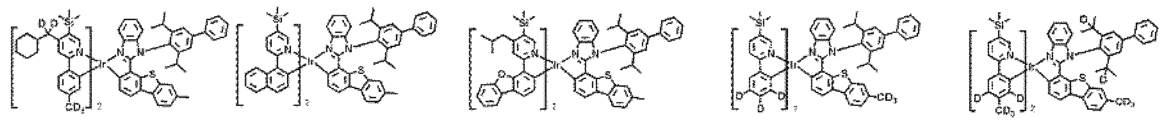
1451
1452
1453
1454
1455

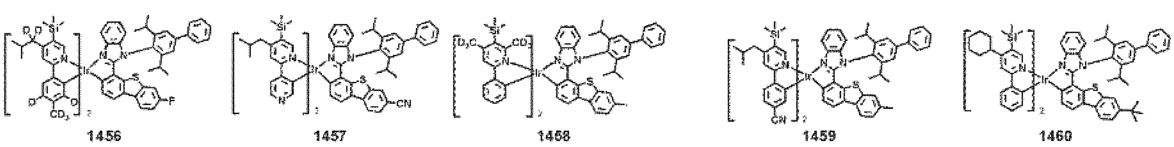
1456
1457
1458
1459
1460

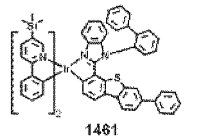
1461

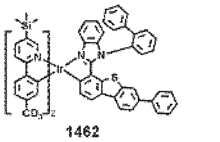
1462

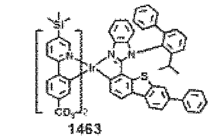
1463

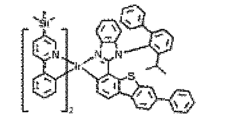
1464

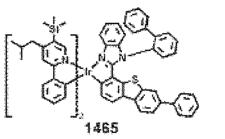
1465

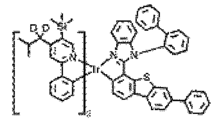
1466

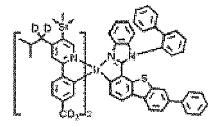
1467

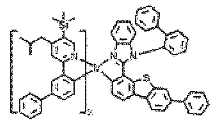
1468

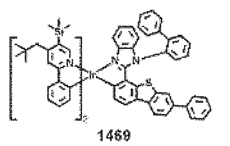
1469

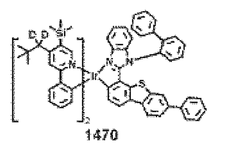
1470

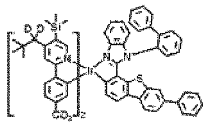
1471

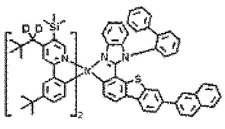
1472

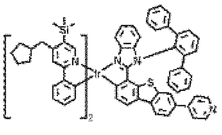
1473

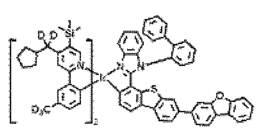
1474

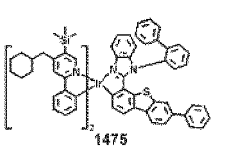
1475

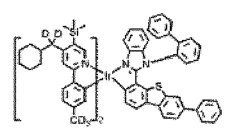
1476

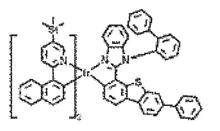
1477

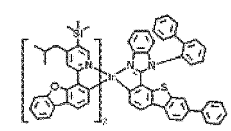
1478

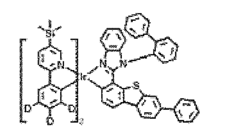
1479

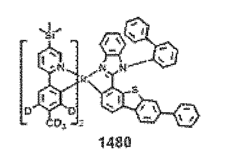
1480

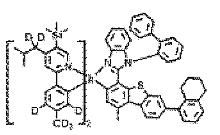
1481

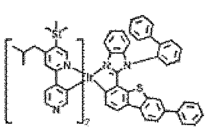
1482

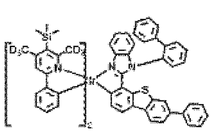
1483

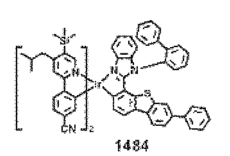
1484

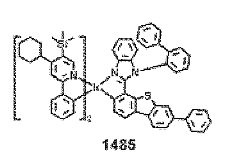
1485

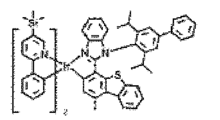
1486

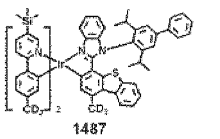
1487

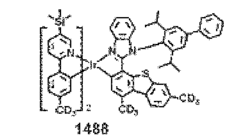
1488

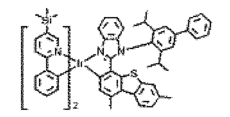
1489

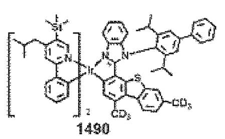
1490

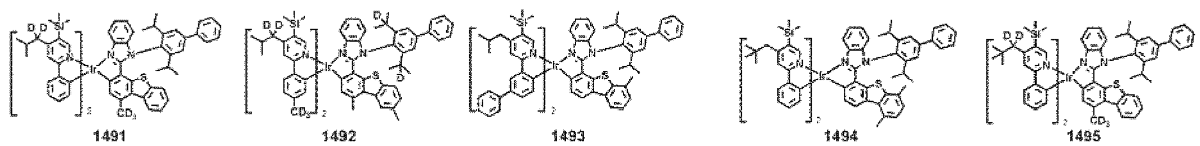
1491 1492 1493 1494 1495

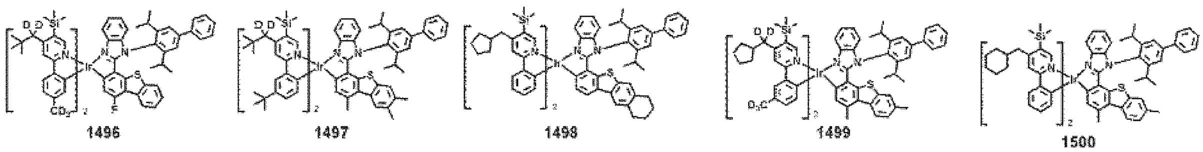
1496 1497 1498 1499 1500

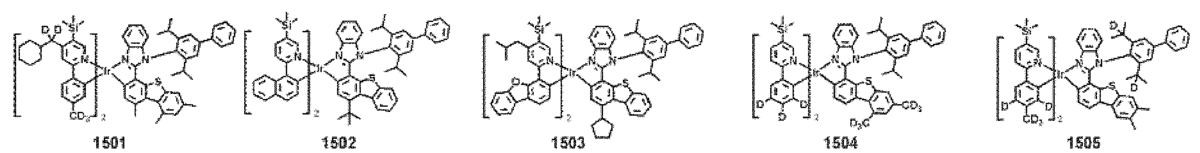
1501 1502 1503 1504 1505

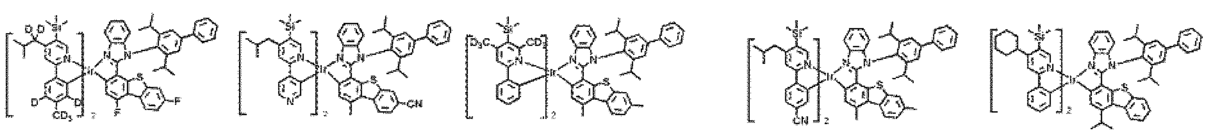
1506 1507 1508 1509 1510

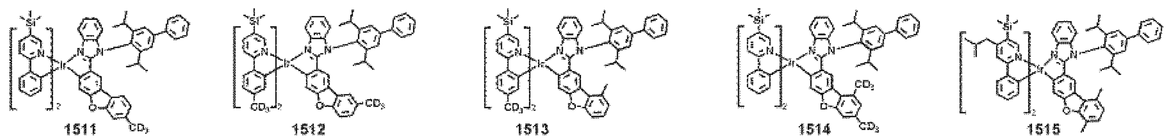
1511 1512 1513 1514 1515

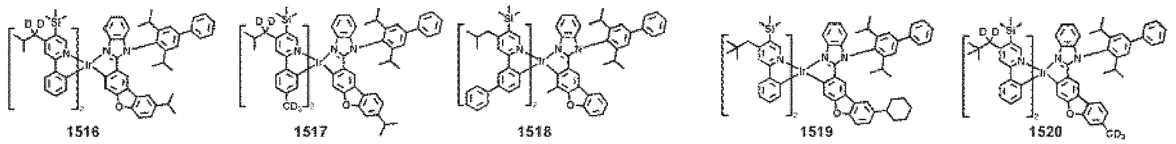
1516 1517 1518 1519 1520

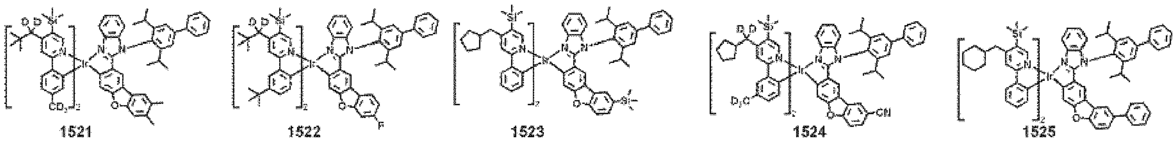
1521 1522 1523 1524 1525

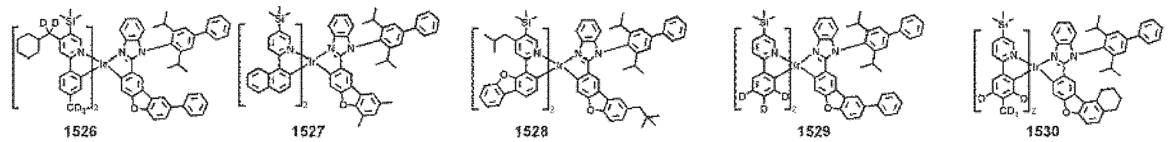
1526 1527 1528 1529 1530

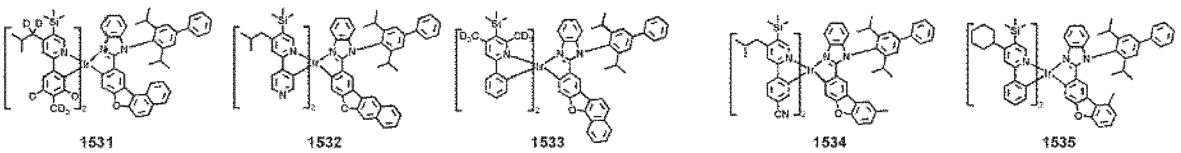
1531 1532 1533 1534 1535

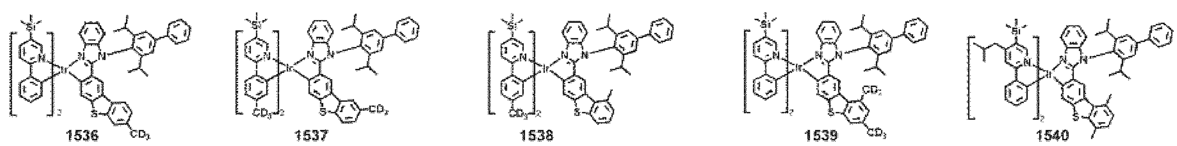
1536 1537 1538 1539 1540

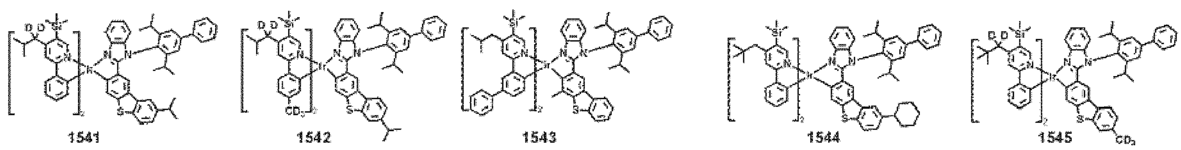
1541 1542 1543 1544 1545

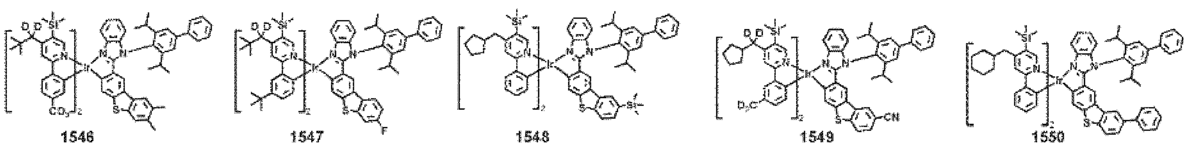
1546 1547 1548 1549 1550

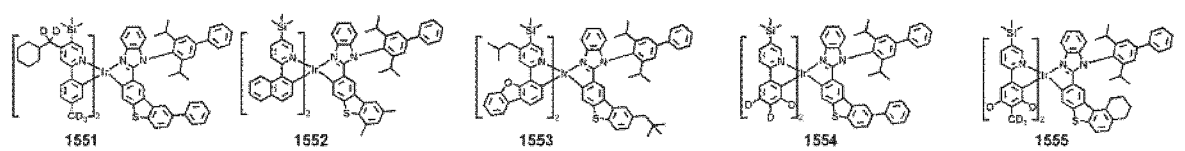
1551 1552 1553 1554 1555

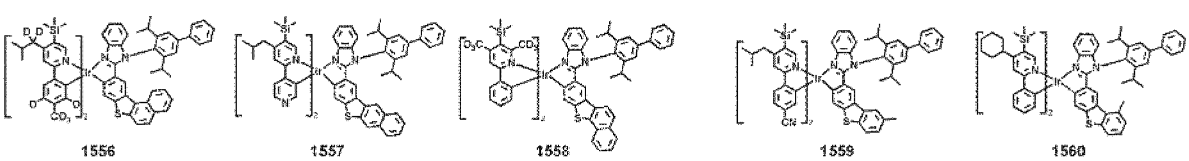
1556 1557 1558 1559 1560

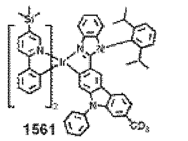
1561
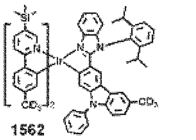
1562
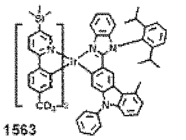
1563
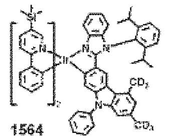
1564
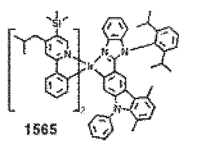
1565
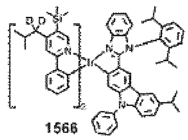
1566
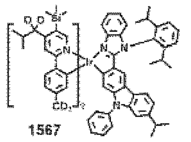
1567
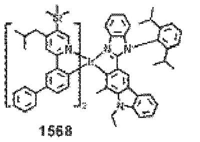
1568
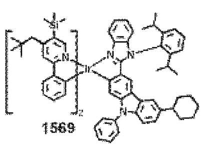
1569
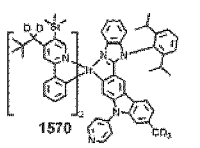
1570
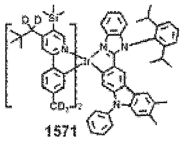
1571
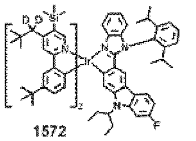
1572
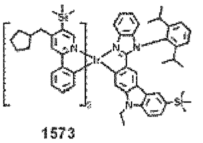
1573
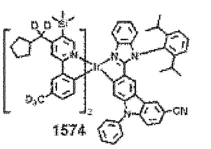
1574
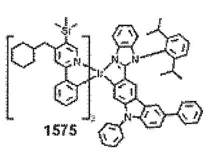
1575
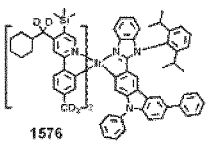
1576
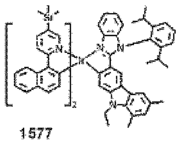
1577
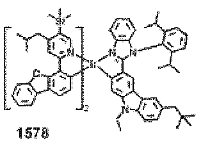
1578
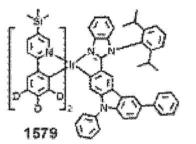
1579
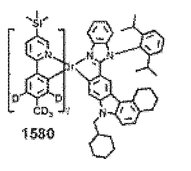
1580
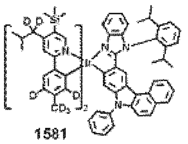
1581
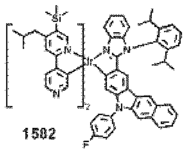
1582
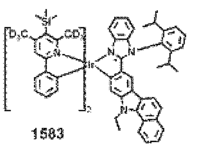
1583
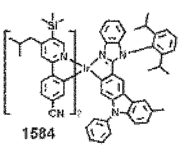
1584
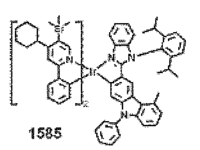
1585
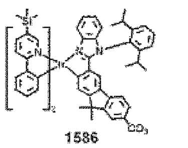
1586
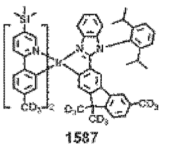
1587
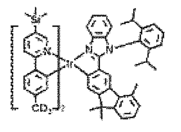
1588
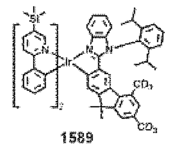
1589
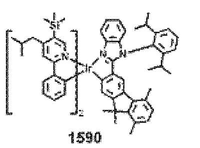
1590
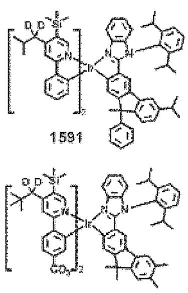
1591
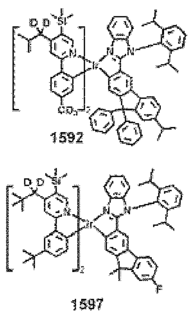
1592
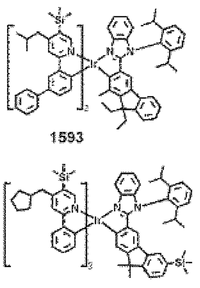
1593
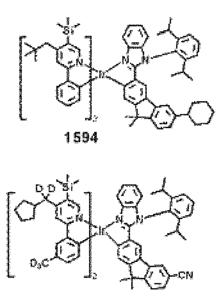
1594
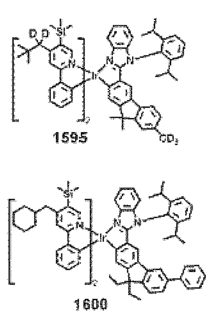
1595
1596
1597
1598
1599
1600
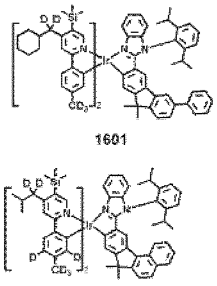
1601
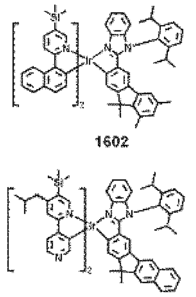
1602
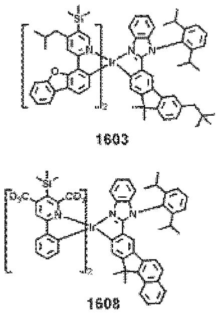
1603
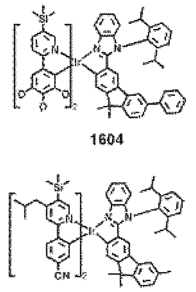
1604
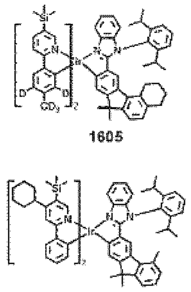
1605
1606
1607
1608
1609
1610

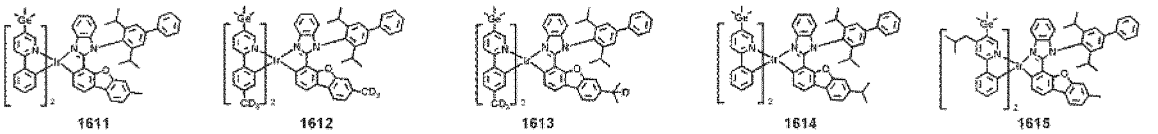
1611 1612 1613 1614 1615
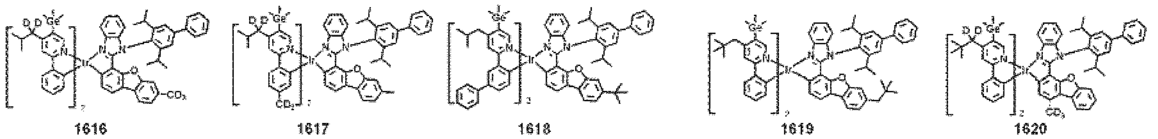
1616 1617 1618 1619 1620
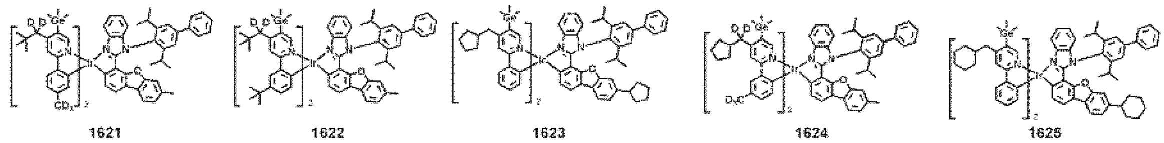
1621 1622 1623 1624 1625
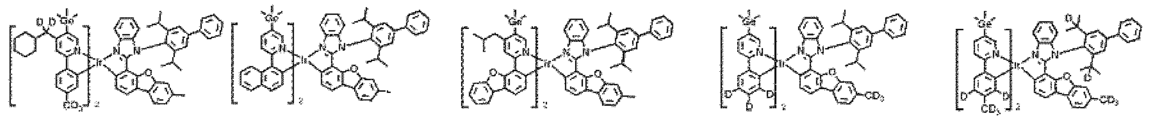
1626 1627 1628 1629 1630
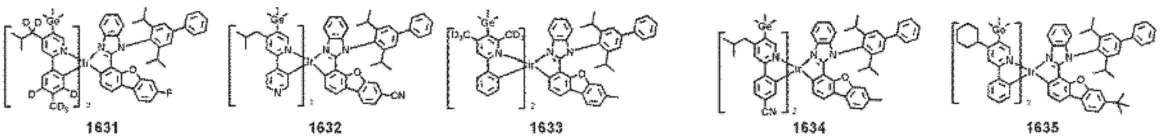
1631 1632 1633 1634 1635
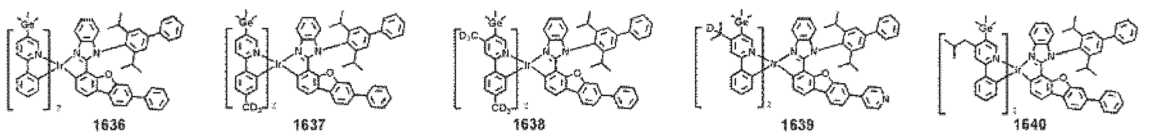
1636 1637 1638 1639 1640
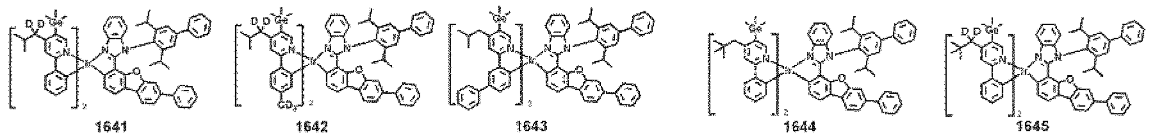
1641 1642 1643 1644 1645
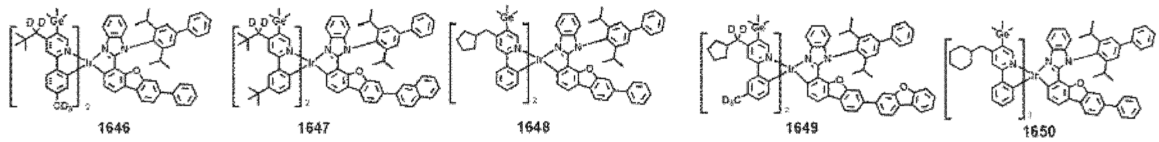
1646 1647 1648 1649 1650
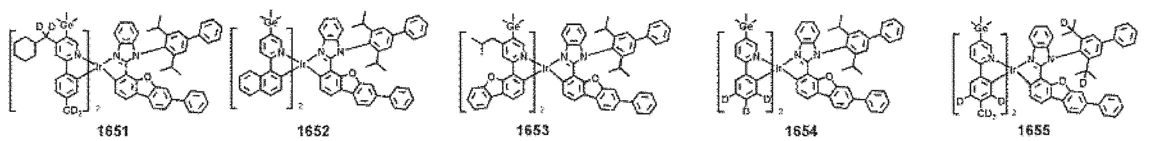
1651 1652 1653 1654 1655
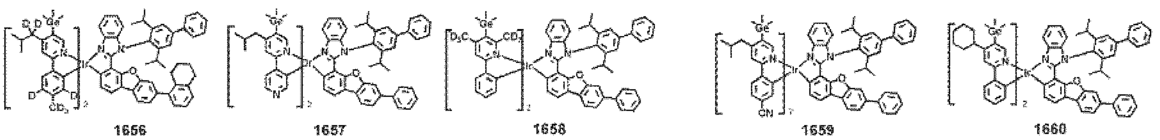
1656 1657 1658 1659 1660

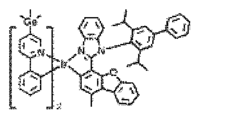
1661
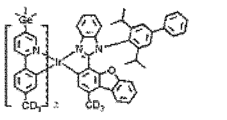
1662
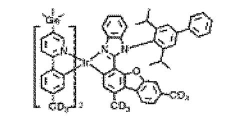
1663
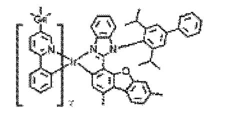
1664
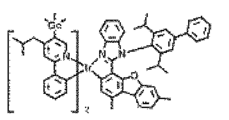
1665

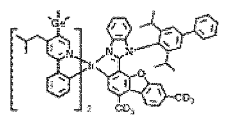
1666
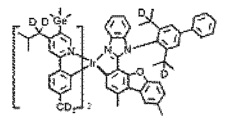
1667
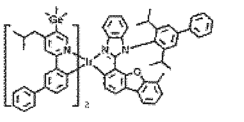
1668
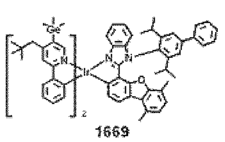
1669
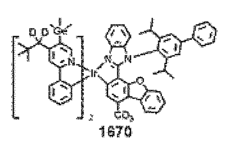
1670

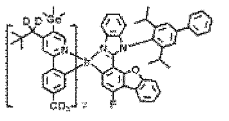
1671
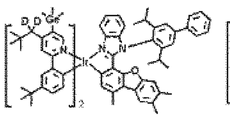
1672
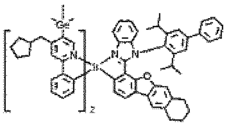
1673
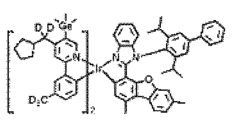
1674
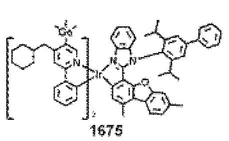
1675

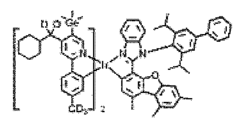
1676
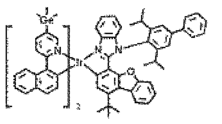
1677
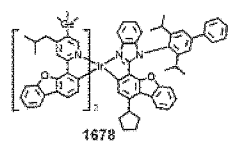
1678
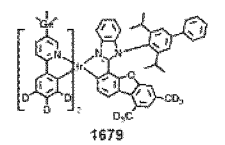
1679
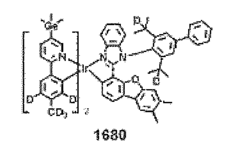
1680

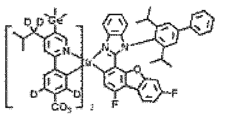
1681
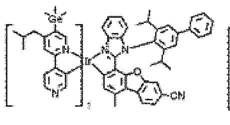
1682
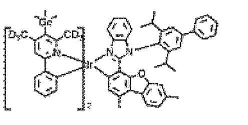
1683
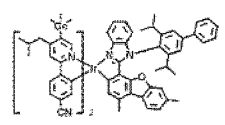
1684
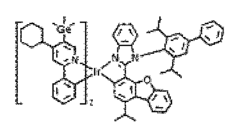
1685

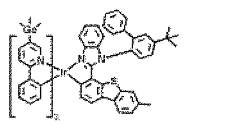
1686
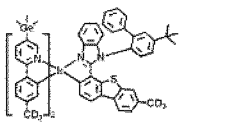
1687
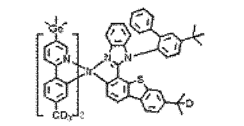
1688
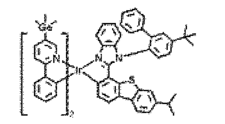
1689
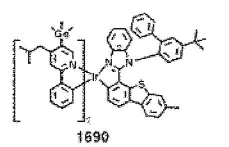
1690

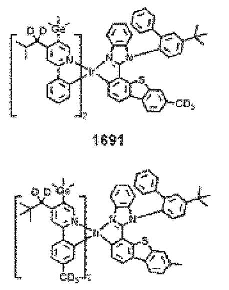
1691
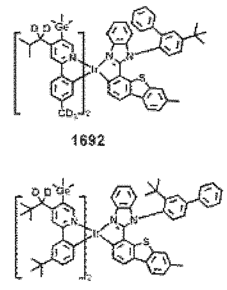
1692
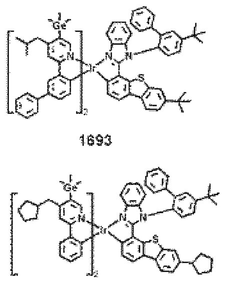
1693
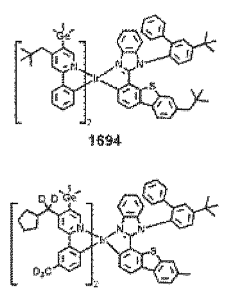
1694
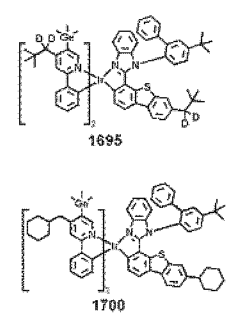
1695

1696
1697
1698
1699
1700

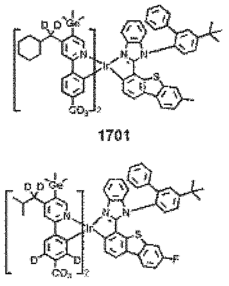
1701
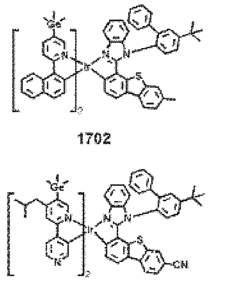
1702
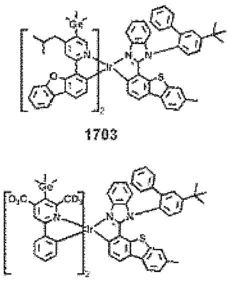
1703
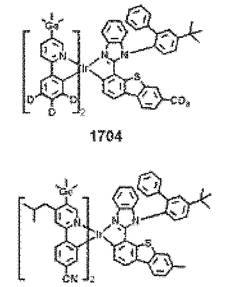
1704
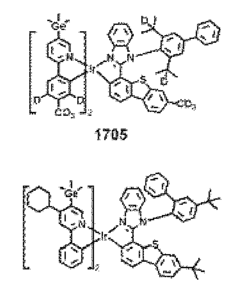
1705

1706
1707
1708
1709
1710

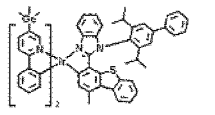
1711
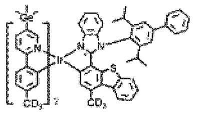
1712
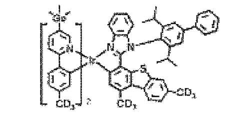
1713
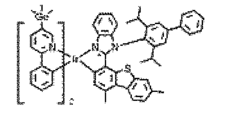
1714
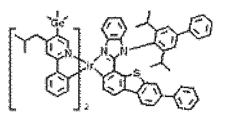
1715
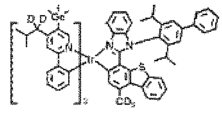
1716
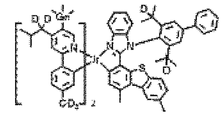
1717
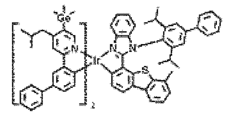
1718
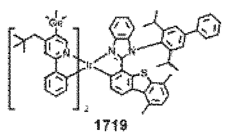
1719
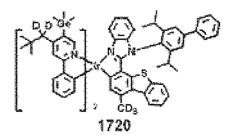
1720
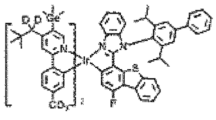
1721
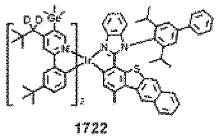
1722
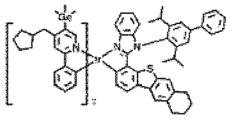
1723
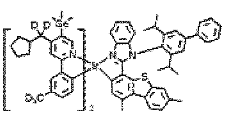
1724
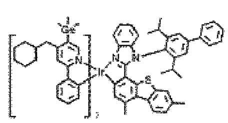
1725
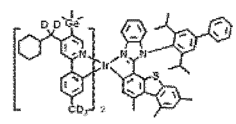
1726
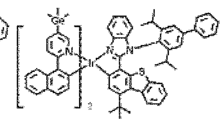
1727
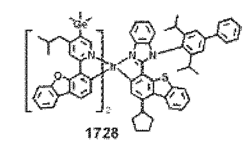
1728
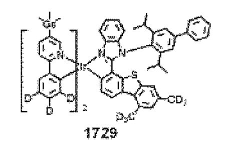
1729
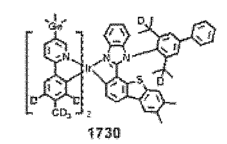
1730
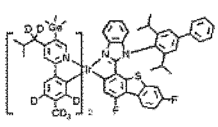
1731
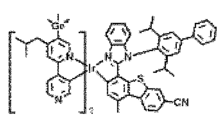
1732
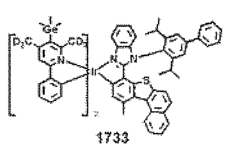
1733
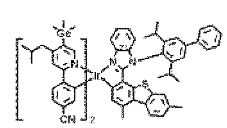
1734
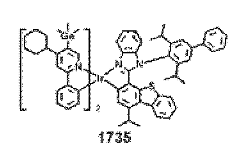
1735
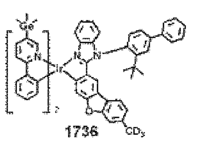
1736
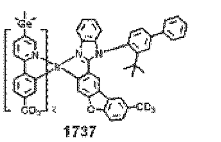
1737
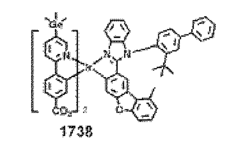
1738
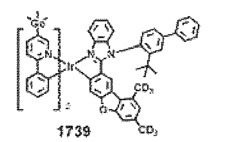
1739
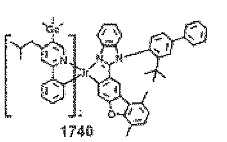
1740
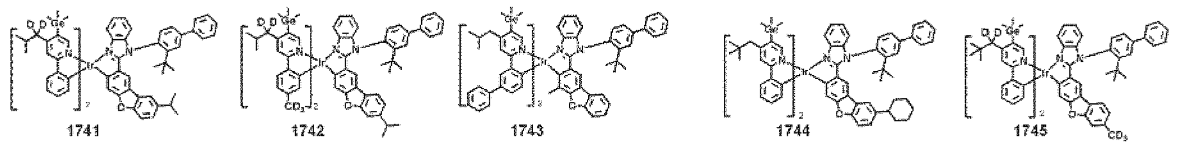
1741 1742 1743 1744 1745
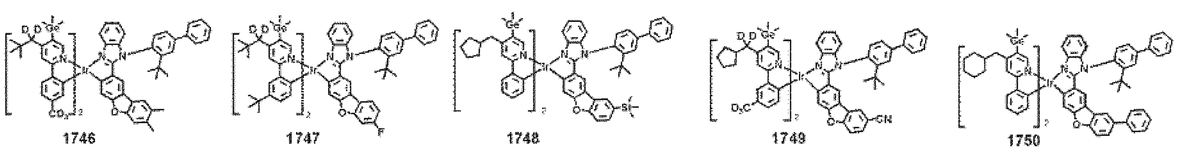
1746 1747 1748 1749 1750
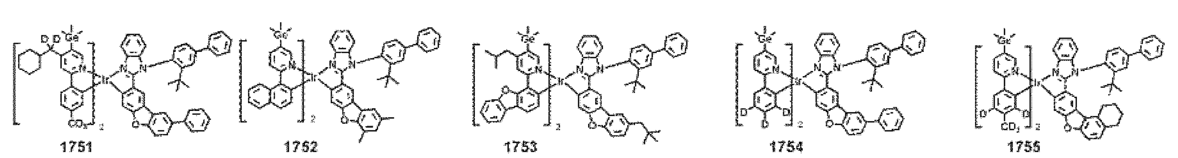
1751 1752 1753 1754 1755
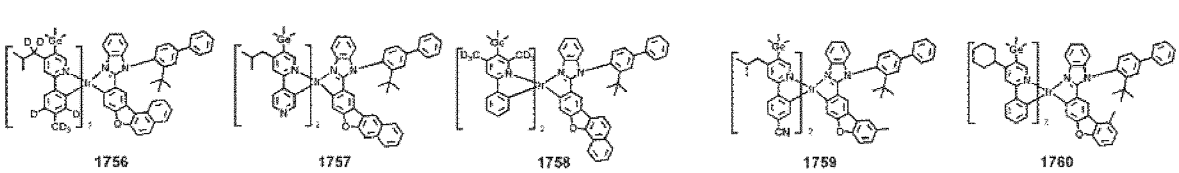
1756 1757 1758 1759 1760

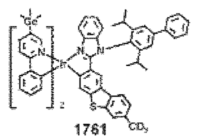
1761
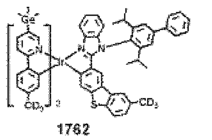
1762
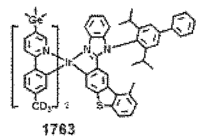
1763
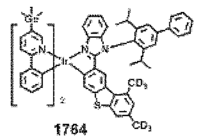
1764
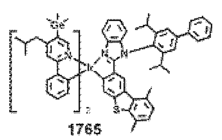
1765
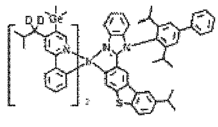
1766
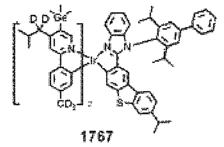
1767
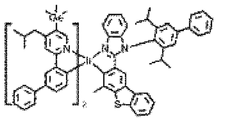
1768
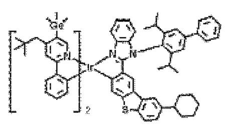
1769
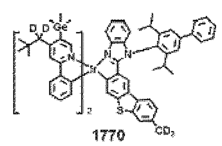
1770
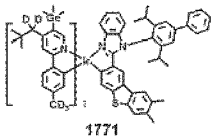
1771
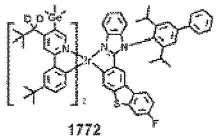
1772
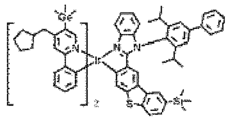
1773
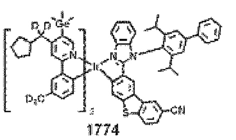
1774
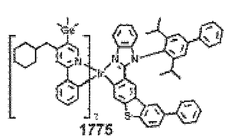
1775
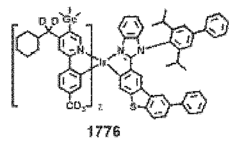
1776
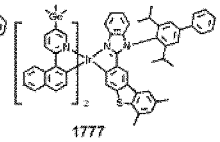
1777
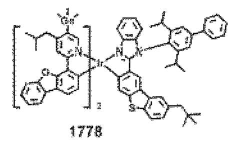
1778
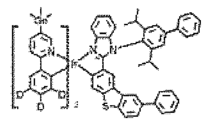
1779
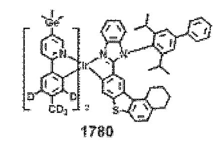
1780
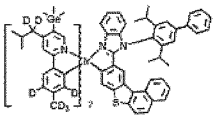
1781
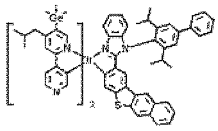
1782
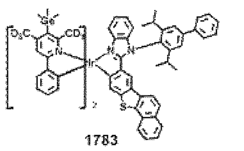
1783
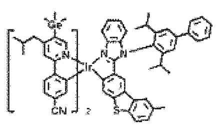
1784
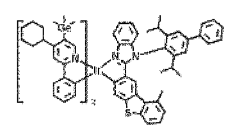
1785
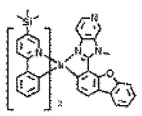
1786
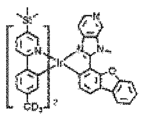
1787
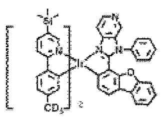
1788
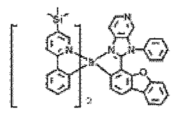
1789
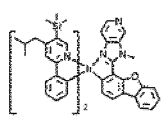
1790
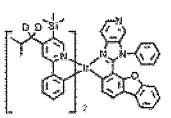
1791
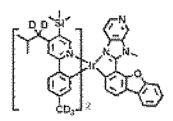
1792
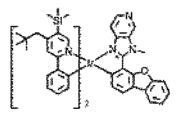
1793
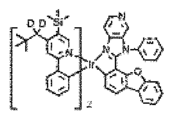
1794
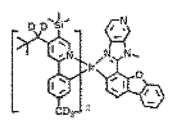
1795
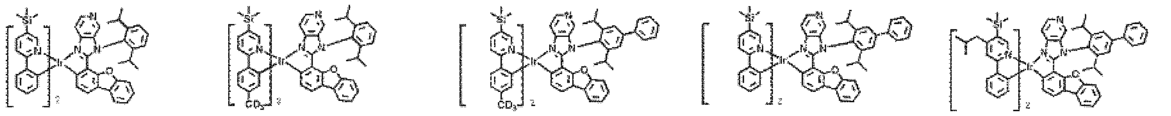
1796
1797
1798
1799
1800
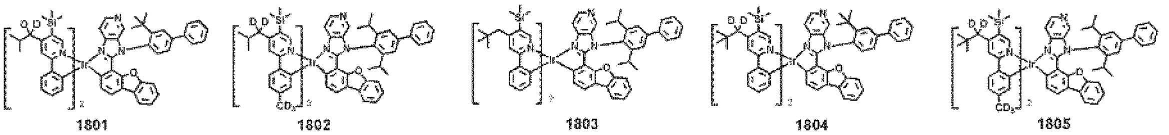
1801
1802
1803
1804
1805

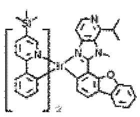
1806
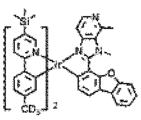
1807
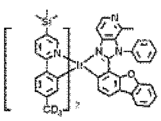
1808
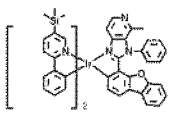
1809
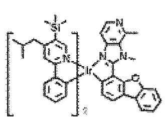
1810
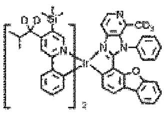
1811
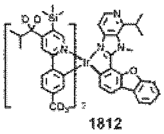
1812
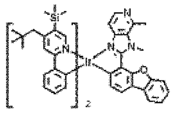
1813
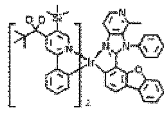
1814
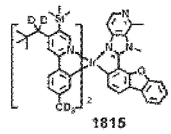
1815
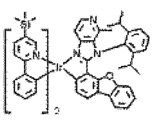
1816
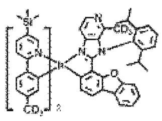
1817
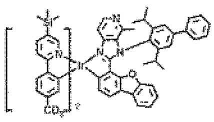
1818
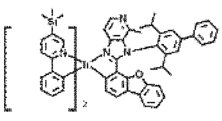
1819
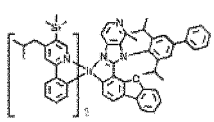
1820
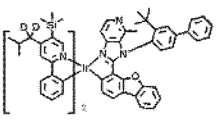
1821
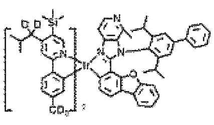
1822
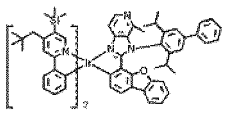
1823
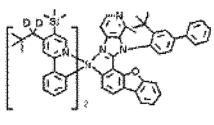
1824
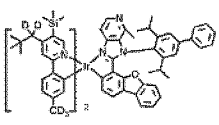
1825
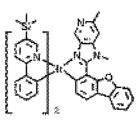
1826
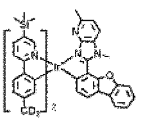
1827
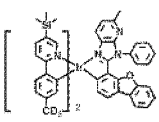
1828
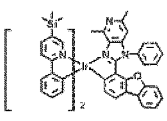
1829
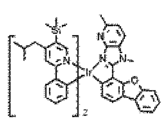
1830
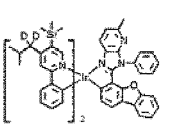
1831
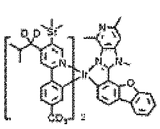
1832
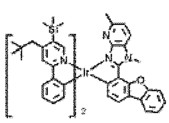
1833
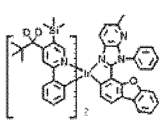
1834
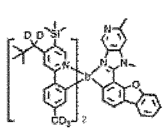
1835
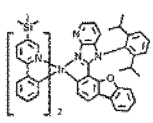
1836
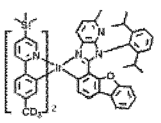
1837
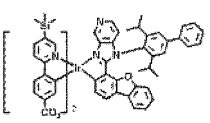
1838
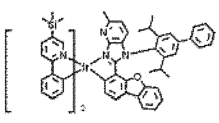
1839
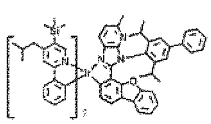
1840
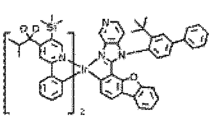
1841
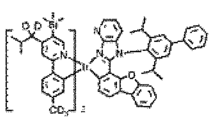
1842
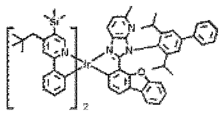
1843
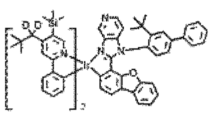
1844
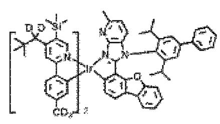
1845

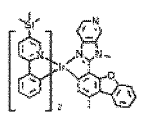
1846
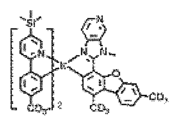
1847
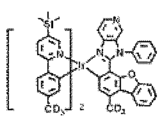
1848
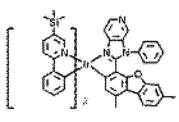
1849
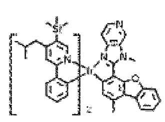
1850

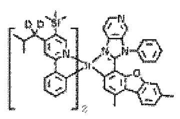
1851
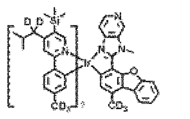
1852
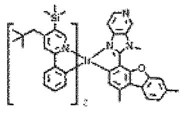
1853
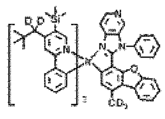
1854
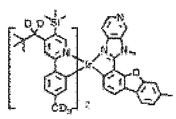
1855

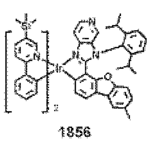
1856
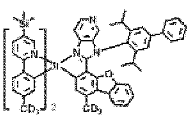
1857
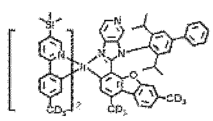
1858
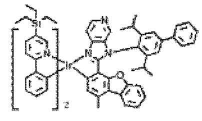
1859
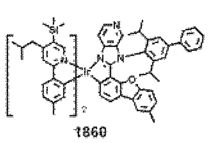
1860

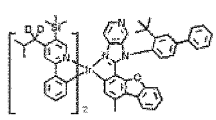
1861
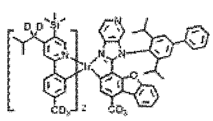
1862
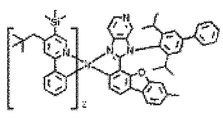
1863
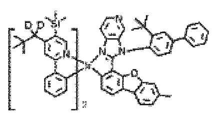
1864
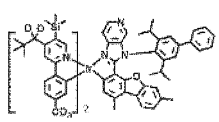
1865

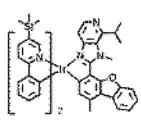
1866
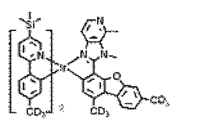
1867
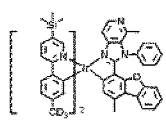
1868
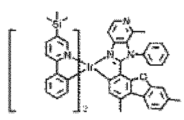
1869
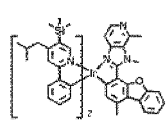
1870

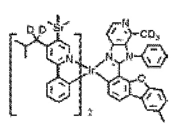
1871
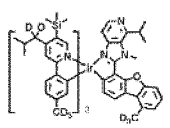
1872
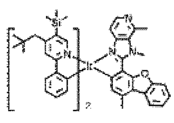
1873
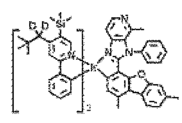
1874
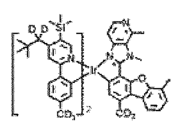
1875

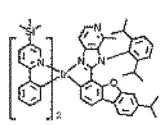
1876
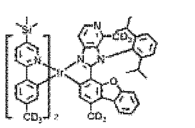
1877
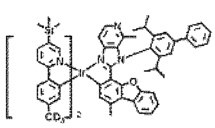
1878
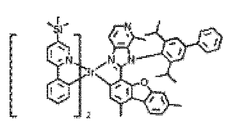
1879
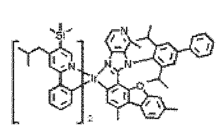
1880

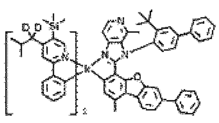
1881
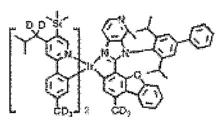
1882
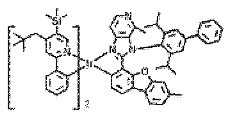
1883
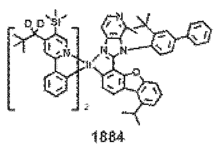
1884
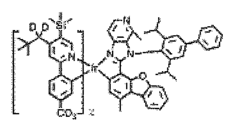
1885

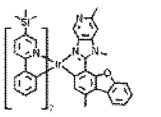
1886
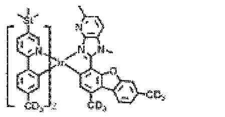
1887
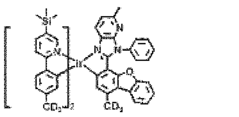
1888
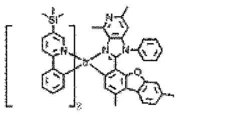
1889
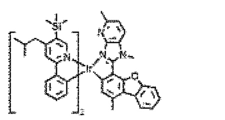
1890

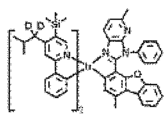
1891
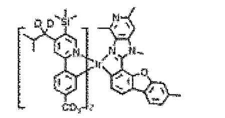
1892
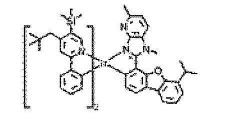
1893
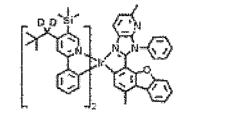
1894
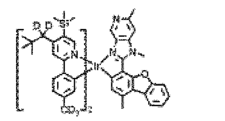
1895

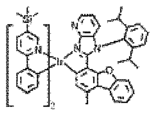
1896
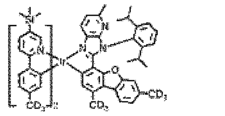
1897
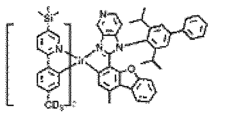
1898
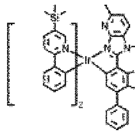
1899
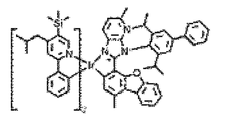
1900

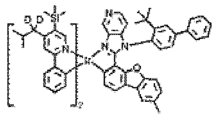
1901
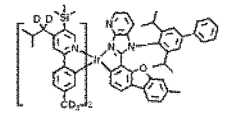
1902
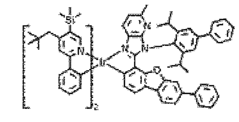
1903
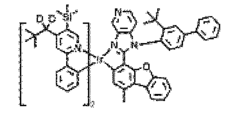
1904
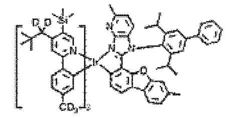
1905

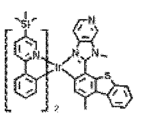
1906
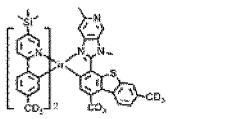
1907
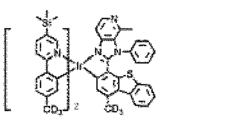
1908
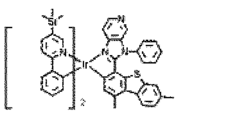
1909
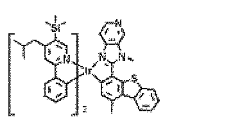
1910

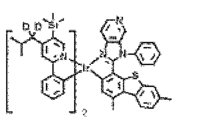
1911
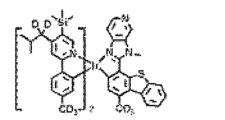
1912
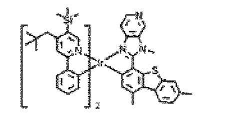
1913
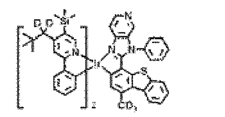
1914
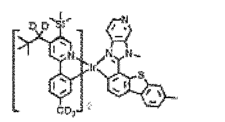
1915

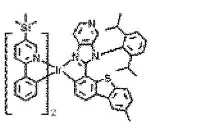
1916
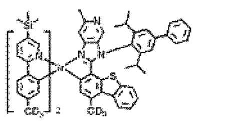
1917
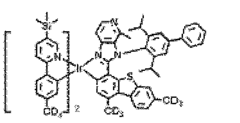
1918
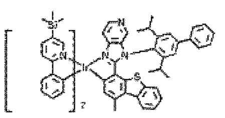
1919
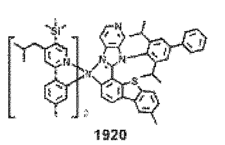
1920

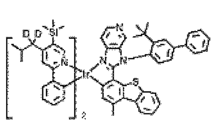
1921
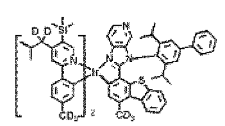
1922
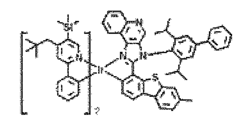
1923
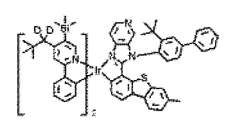
1924
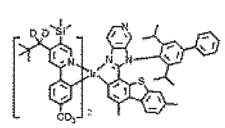
1925

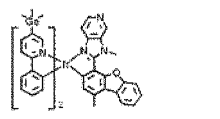
1926

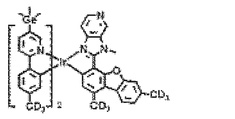
1927

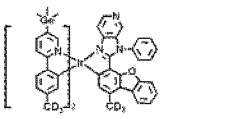
1928

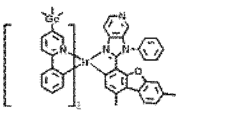
1929

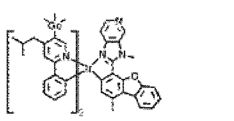
1930

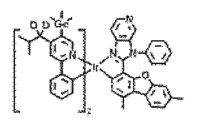
1931

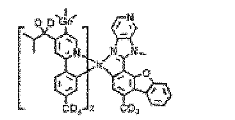
1932

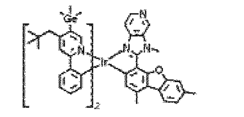
1933

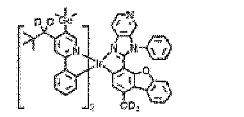
1934

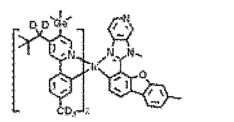
1935

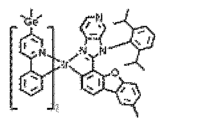
1936

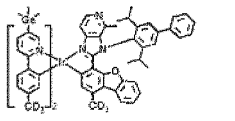
1937

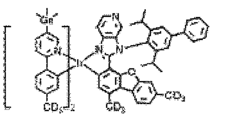
1938

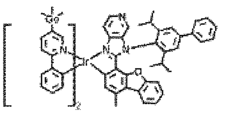
1939

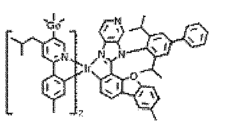
1940

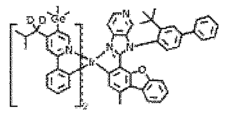
1941

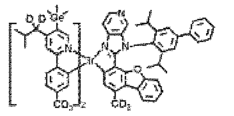
1942

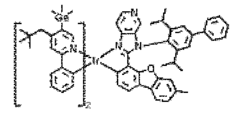
1943

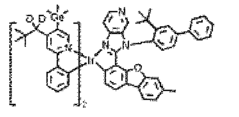
1944

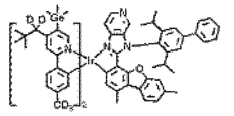
1945

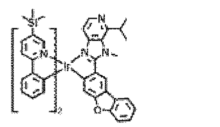
1946

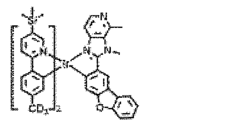
1947

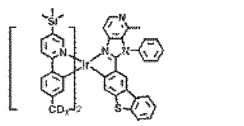
1948

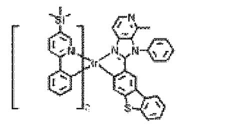
1949

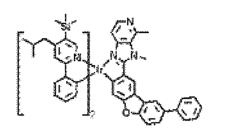
1950

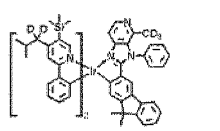
1951

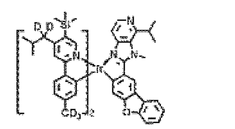
1952

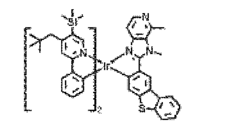
1953

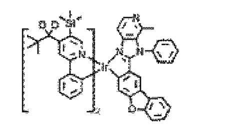
1954

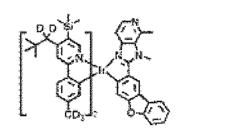
1955

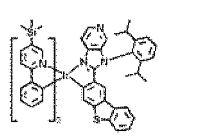
1956

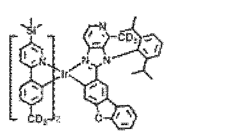
1957

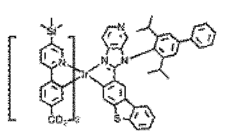
1958

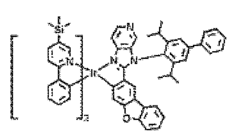
1959

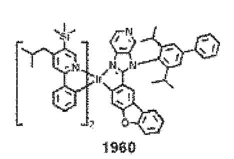
1960

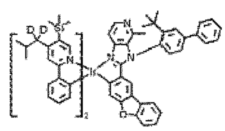
1961

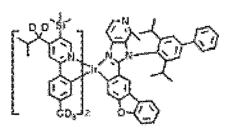
1962

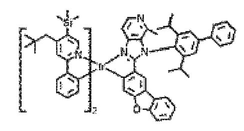
1963

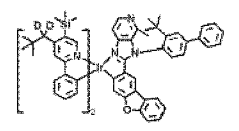
1964

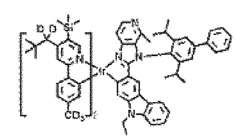
1965

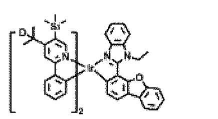
1966
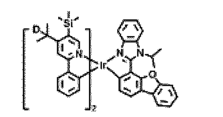
1967
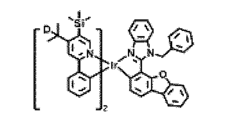
1968
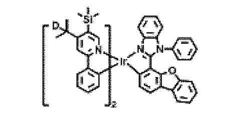
1969
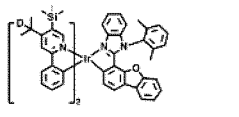
1970

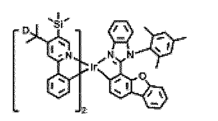
1971
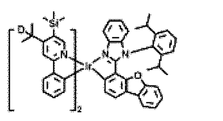
1972
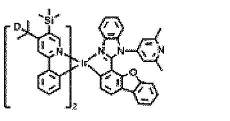
1973
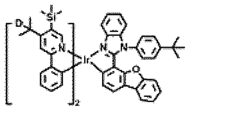
1974
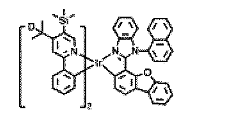
1975

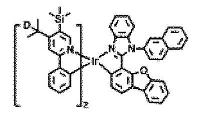
1976
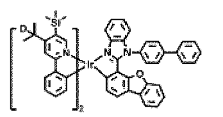
1977
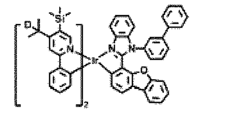
1978
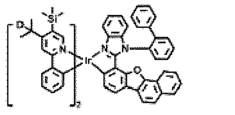
1979
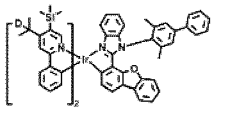
1980

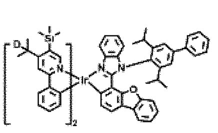
1981
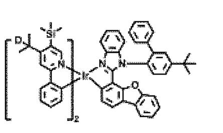
1982
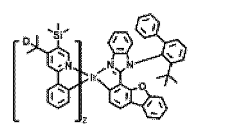
1983
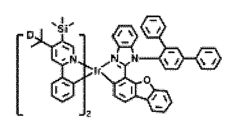
1984
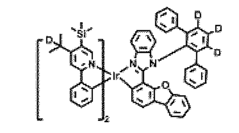
1985

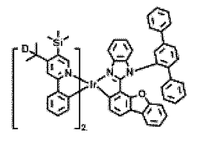
1986
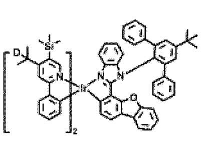
1987
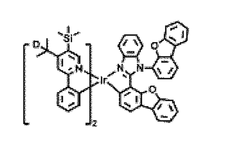
1988
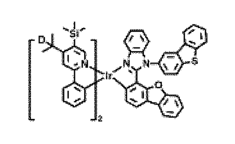
1989
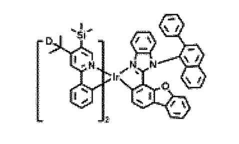
1990

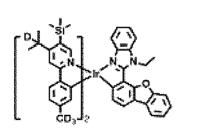
1991
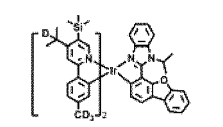
1992
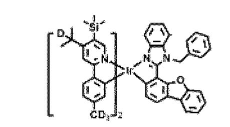
1993
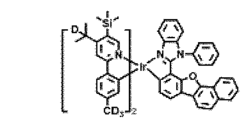
1994
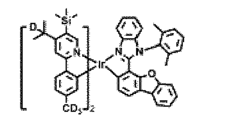
1995

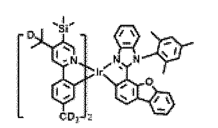
1996
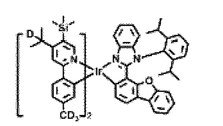
1997
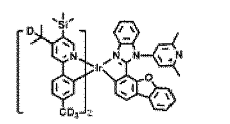
1998
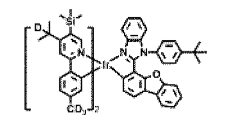
1999
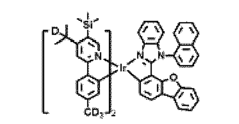
2000

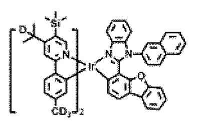
2001
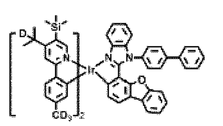
2002
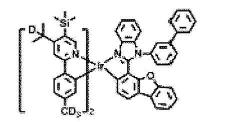
2003
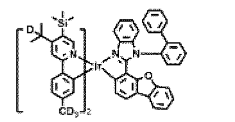
2004
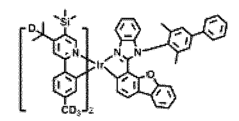
2005

2006
2007
2008
2009
2010

2011
2012
2013
2014
2015

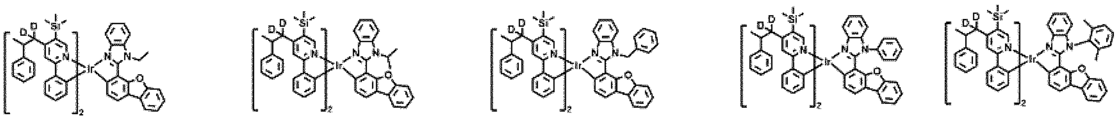
2016 2017 2018 2019 2020

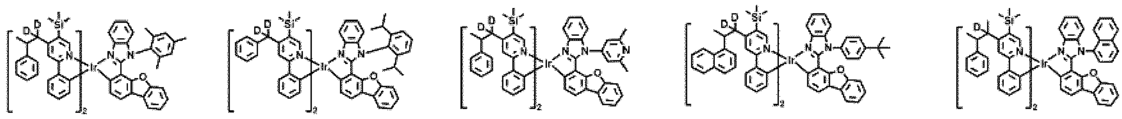
2021 2022 2023 2024 2025

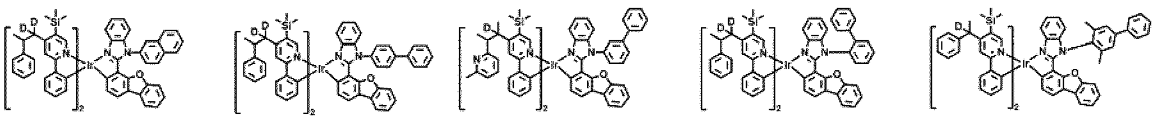
2026 2027 2028 2029 2030

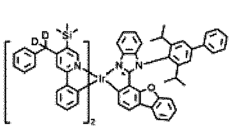
2031

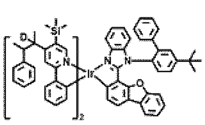
2032

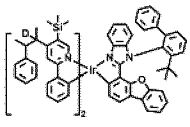
2033

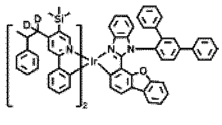
2034

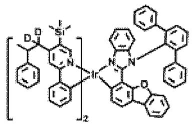
2035

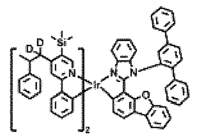
2036

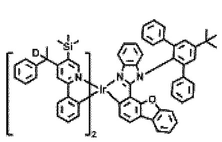
2037

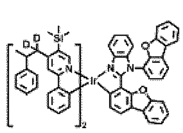
2038

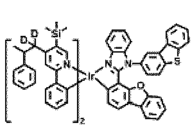
2039

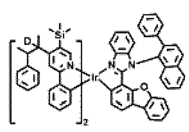
2040

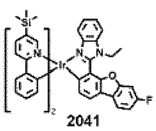
2041

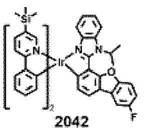
2042

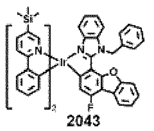
2043

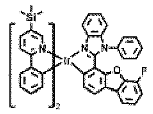
2044

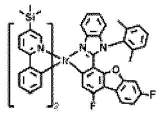
2045

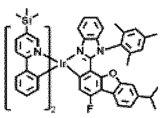
2046

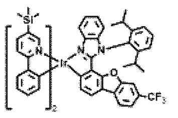
2047

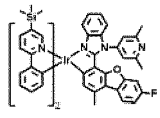
2048

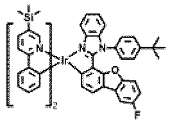
2049

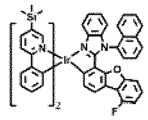
2050

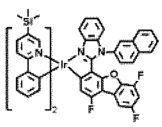
2051

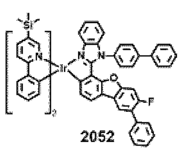
2052

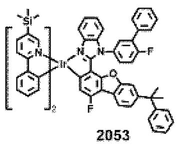
2053

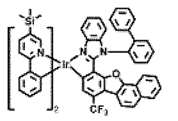
2054

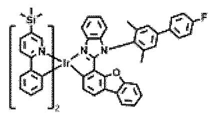
2055

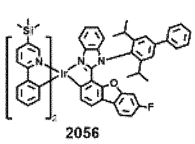
2056

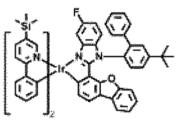
2057

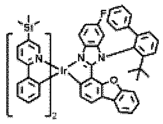
2058

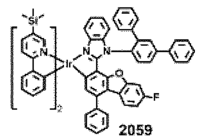
2059

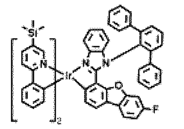
2060

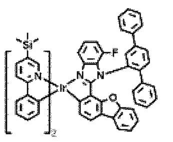
2061

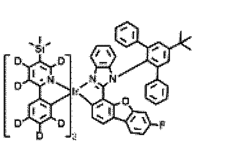
2062

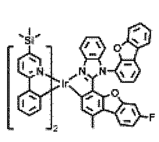
2063

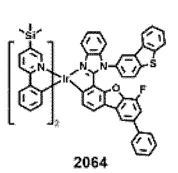
2064

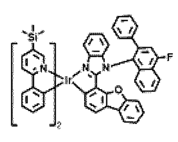
2065

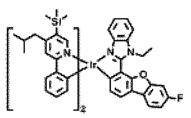
2066
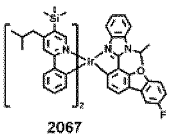
2067
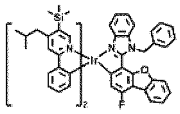
2068
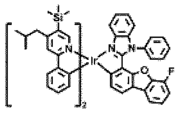
2069
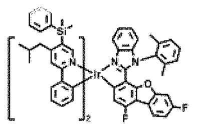
2070
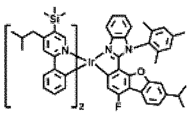
2071
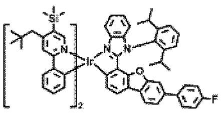
2072
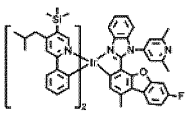
2073
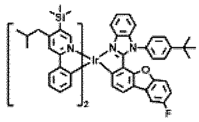
2074
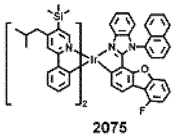
2075
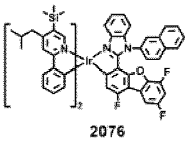
2076
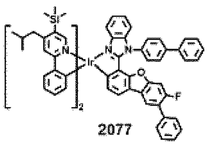
2077
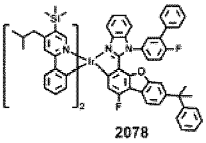
2078
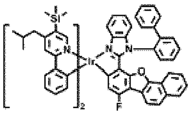
2079
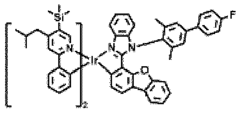
2080
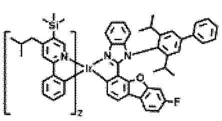
2081
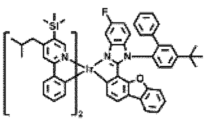
2082
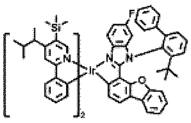
2083
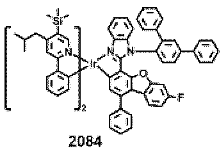
2084
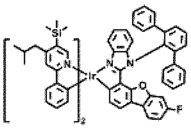
2085
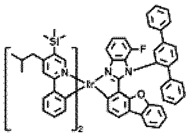
2086
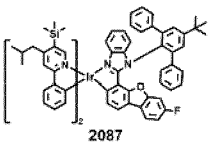
2087
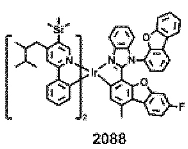
2088
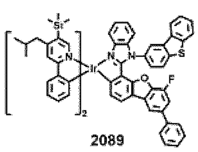
2089
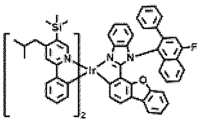
2090
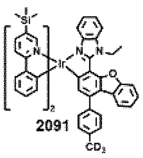
2091
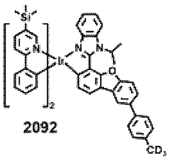
2092
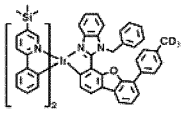
2093
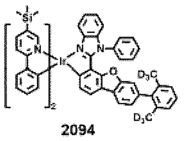
2094
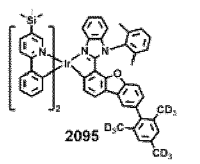
2095
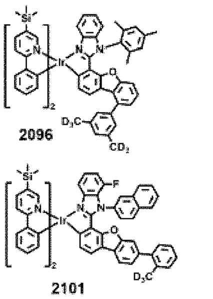
2096
2101
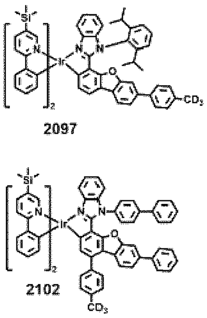
2097
2102
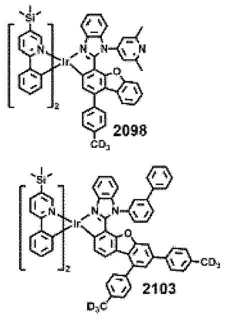
2098
2103
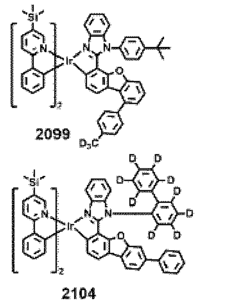
2099
2104
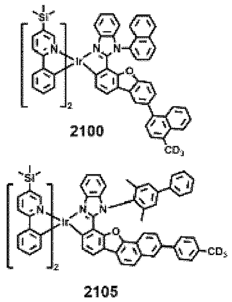
2100
2105
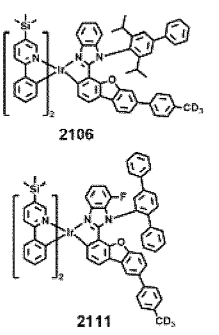
2106
2111
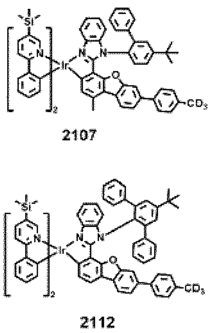
2107
2112
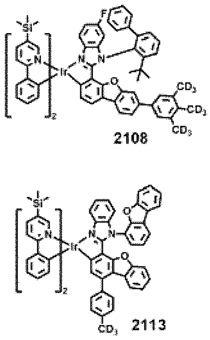
2108
2113
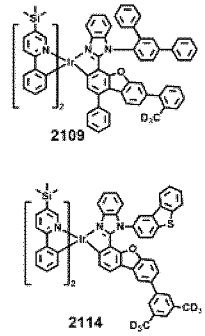
2109
2114
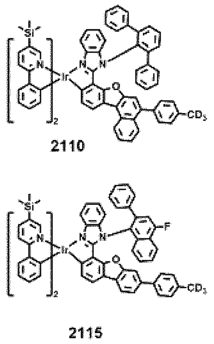
2110
2115

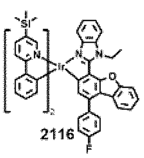
2116
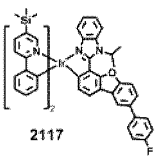
2117
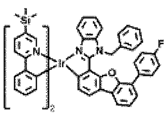
2118
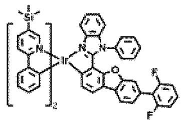
2119
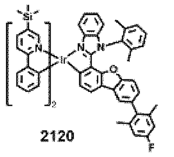
2120
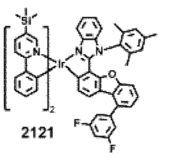
2121
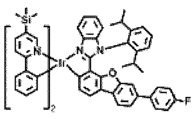
2122
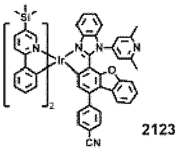
2123
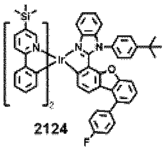
2124
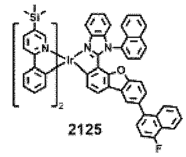
2125
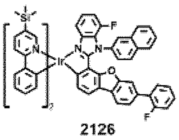
2126
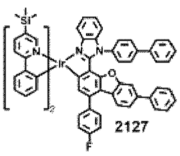
2127
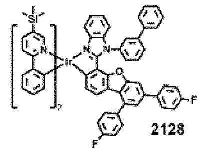
2128
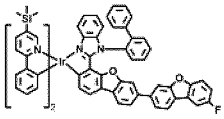
2129
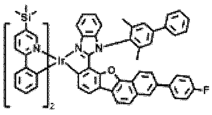
2130
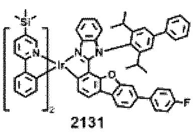
2131
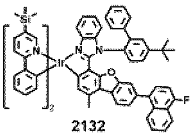
2132
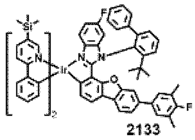
2133
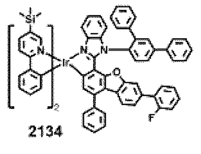
2134
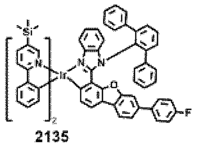
2135
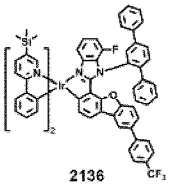
2136
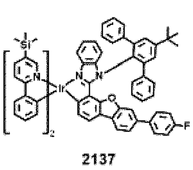
2137
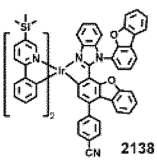
2138
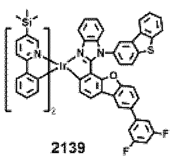
2139
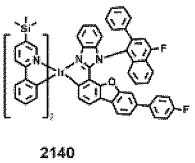
2140
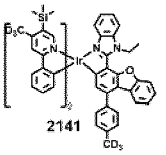
2141
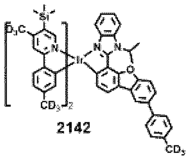
2142
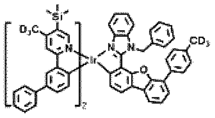
2143
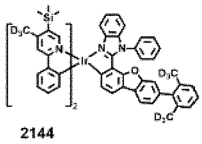
2144
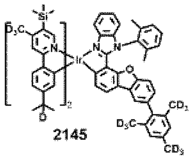
2145
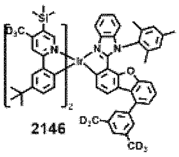
2146
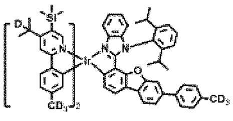
2147
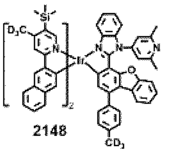
2148
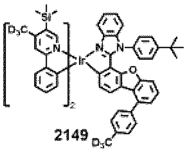
2149
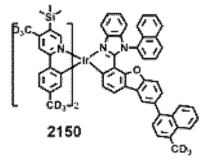
2150
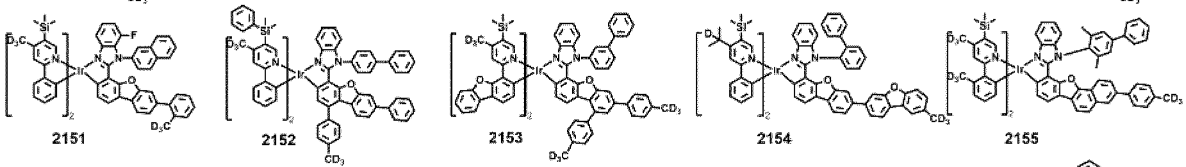
2151 2152 2153 2154 2155
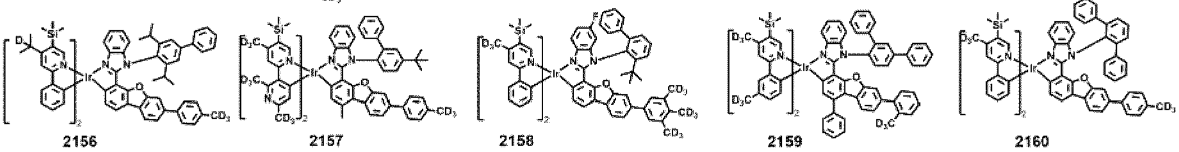
2156 2157 2158 2159 2160
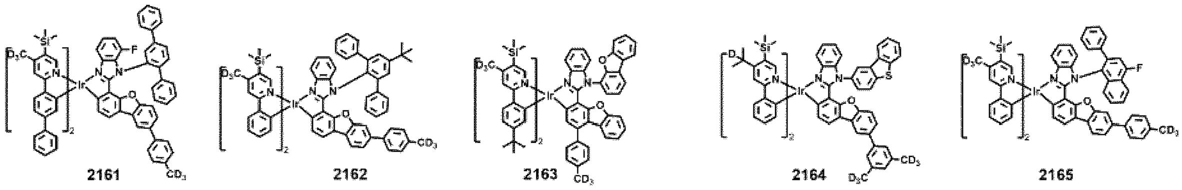
2161 2162 2163 2164 2165

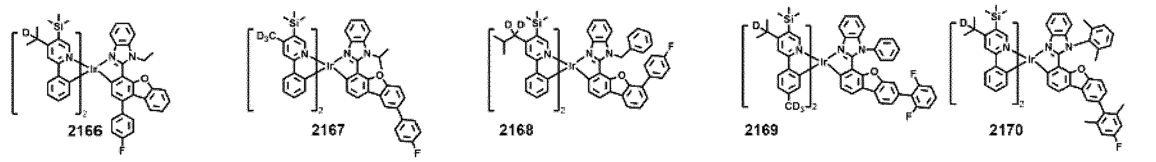

2166 2167 2168 2169 2170

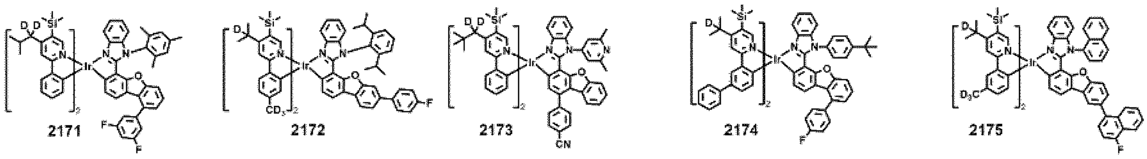

2171 2172 2173 2174 2175

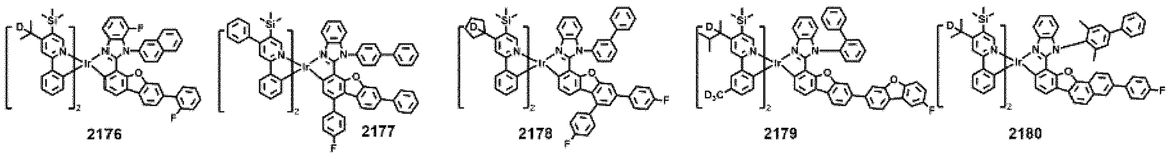

2176 2177 2178 2179 2180

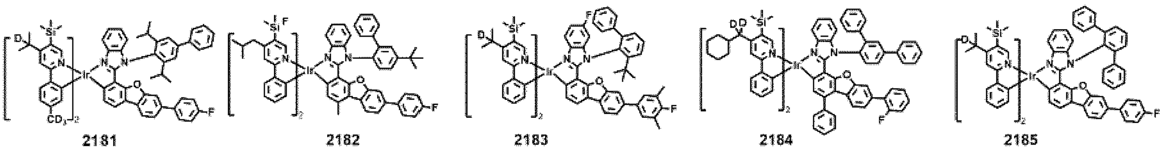

2181 2182 2183 2184 2185

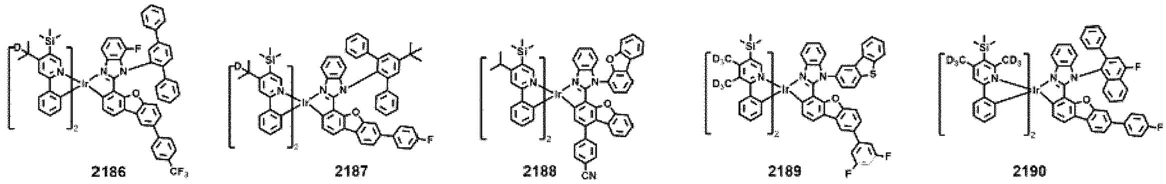

2186 2187 2188 2189 2190

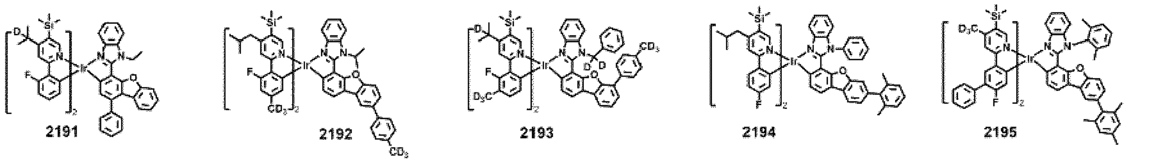

2191 2192 2193 2194 2195

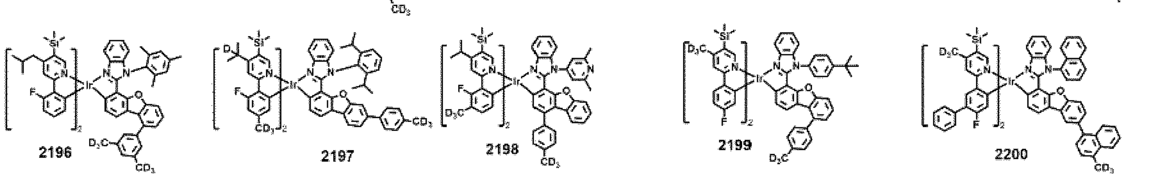

2196 2197 2198 2199 2200

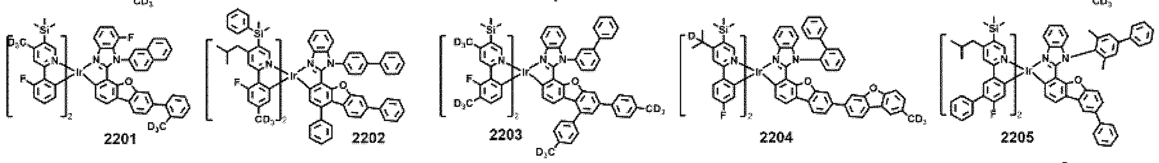

2201 2202 2203 2204 2205

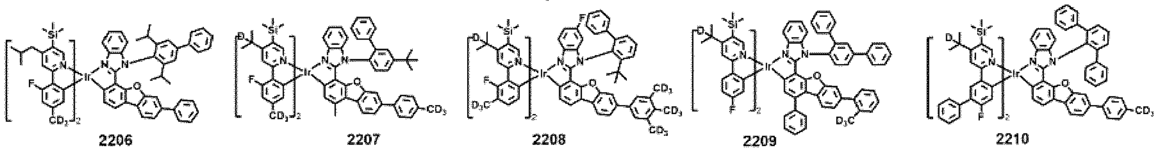

2206 2207 2208 2209 2210

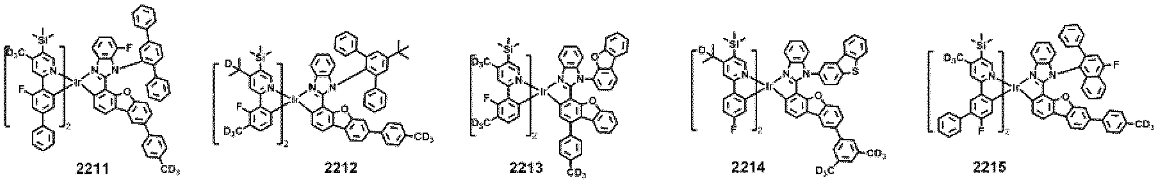

2211 2212 2213 2214 2215

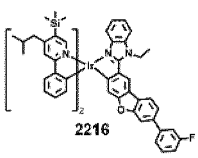
2216
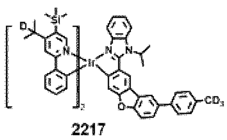
2217
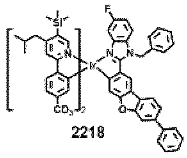
2218
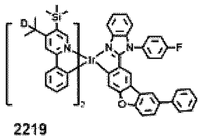
2219
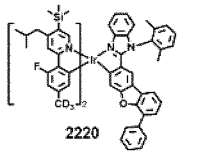
2220

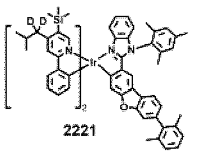
2221
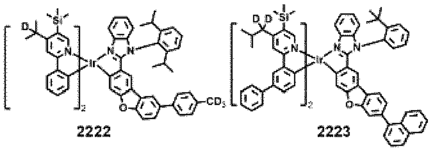
2222
2223
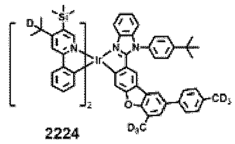
2224
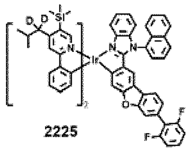
2225

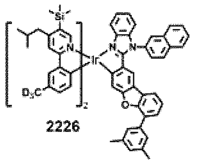
2226
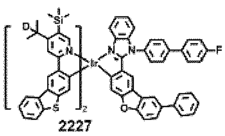
2227
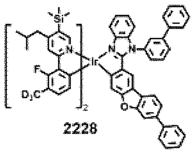
2228
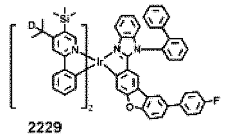
2229
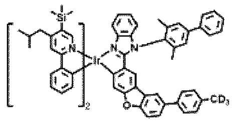
2230

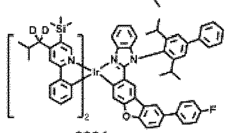
2231
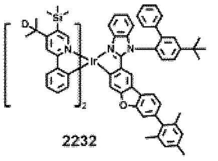
2232
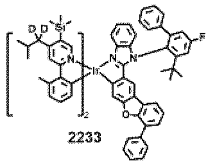
2233
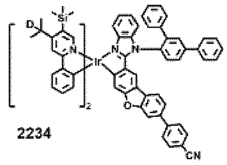
2234
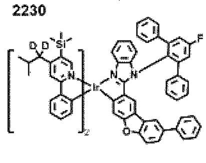
2235

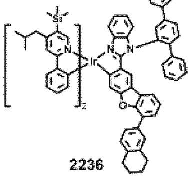
2236
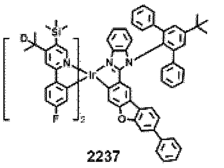
2237
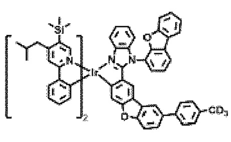
2238
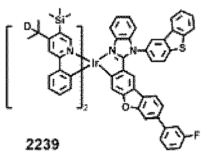
2239
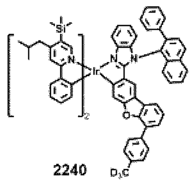
2240

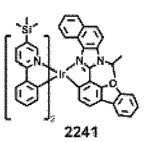
2241
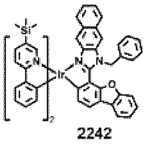
2242
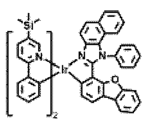
2243
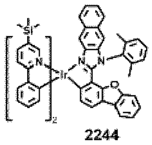
2244
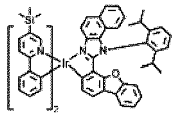
2245

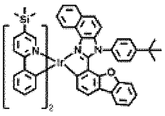
2246
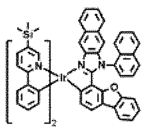
2247
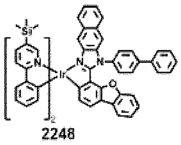
2248
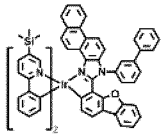
2249
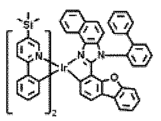
2250

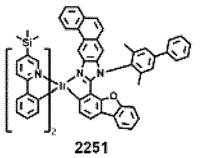
2251
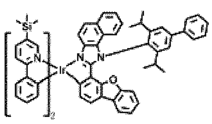
2252
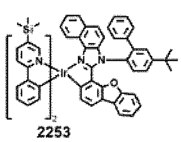
2253
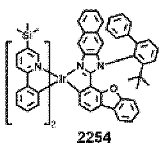
2254
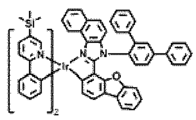
2255

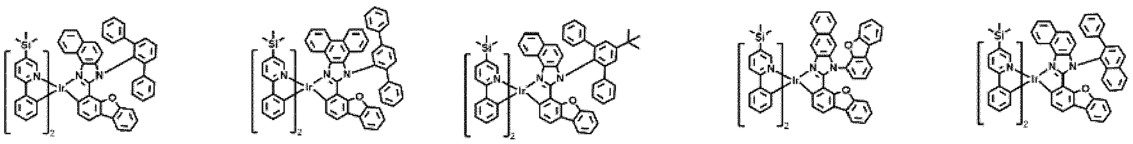
2256
2257
2258
2259
2260

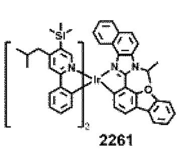
2261

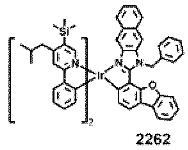
2262

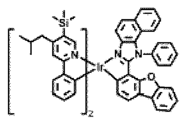
2263

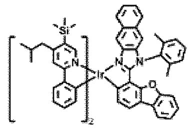
2264

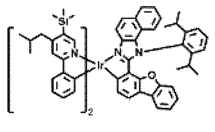
2265

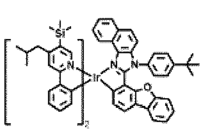
2266

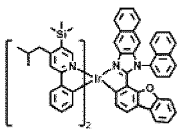
2267

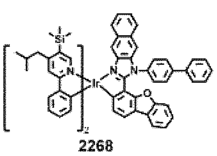
2268

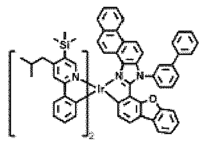
2269

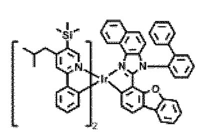
2270

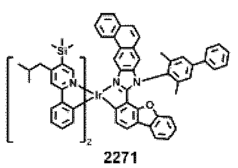
2271

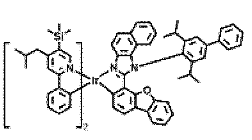
2272

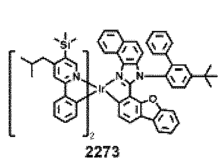
2273

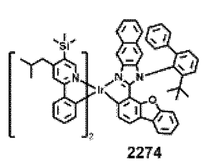
2274

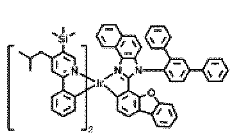
2275

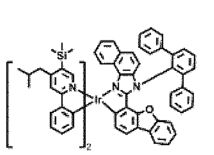
2276

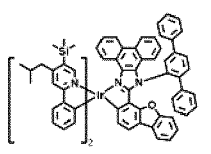
2277

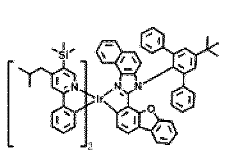
2278

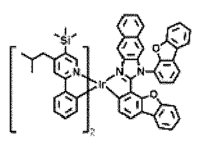
2279

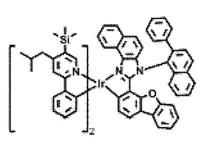
2280

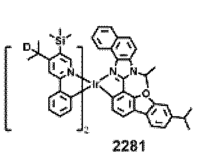
2281

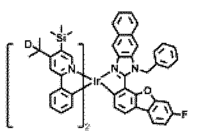
2282

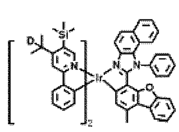
2283

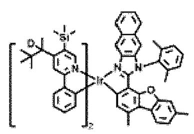
2284

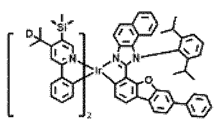
2285

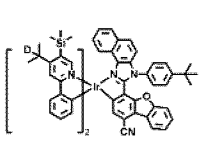
2286

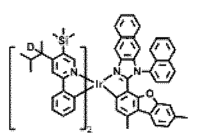
2287

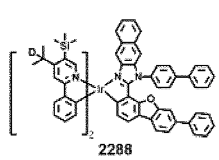
2288

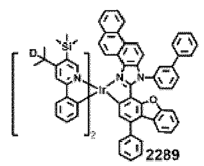
2289

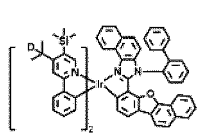
2290

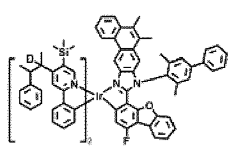
2291

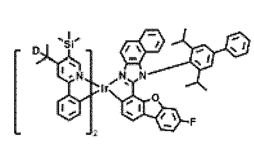
2292

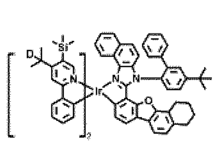
2293

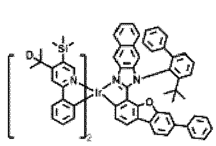
2294

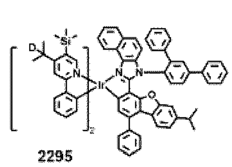
2295

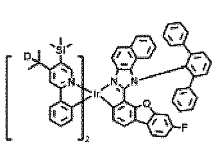
2296

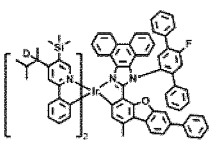
2297

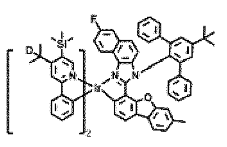
2298

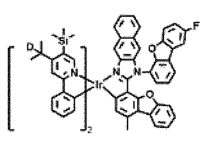
2299

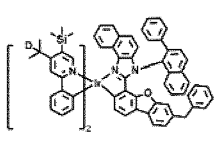
2300

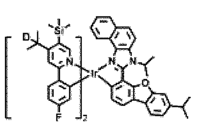
2301

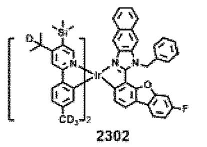
2302

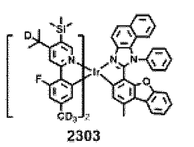
2303

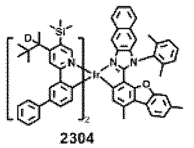
2304

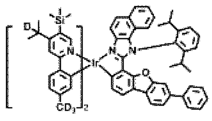
2305

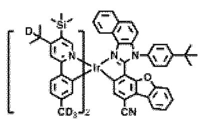
2306

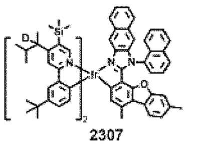
2307

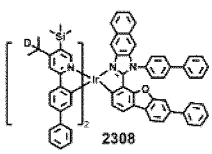
2308

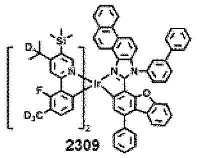
2309

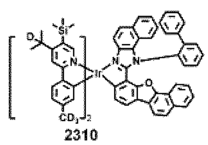
2310

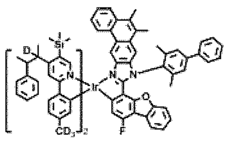
2311

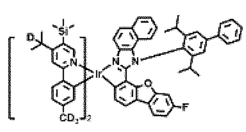
2312

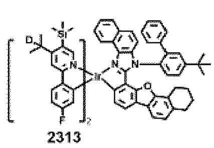
2313

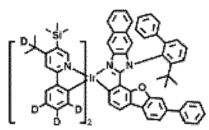
2314

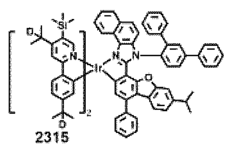
2315

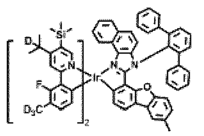
2316

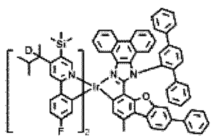
2317

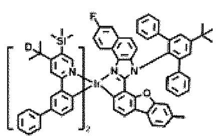
2318

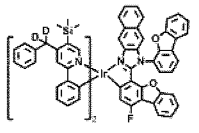
2319

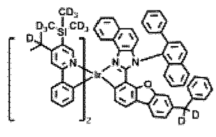
2320

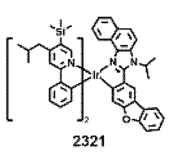
2321

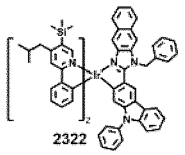
2322

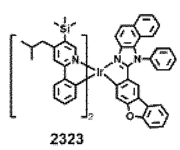
2323

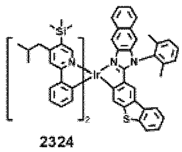
2324

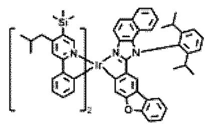
2325

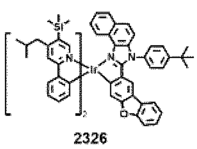
2326

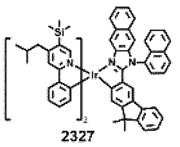
2327

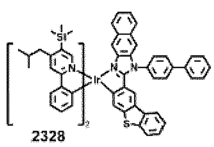
2328

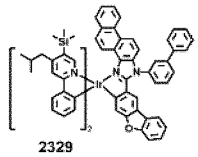
2329

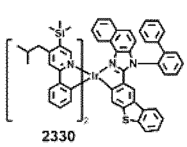
2330

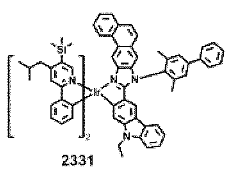
2331

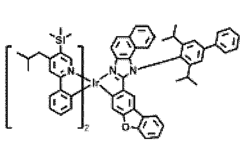
2332

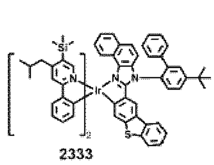
2333

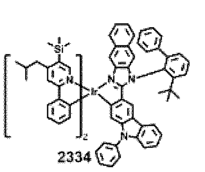
2334

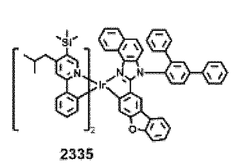
2335

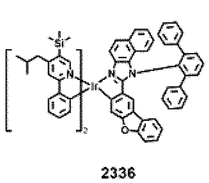
2336

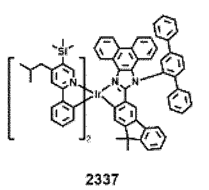
2337

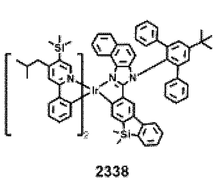
2338

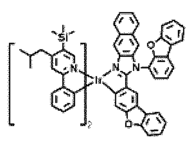
2339

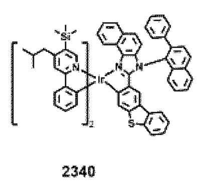
2340

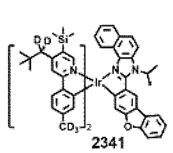
2341
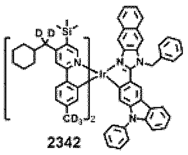
2342
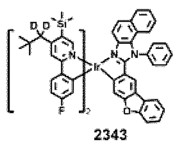
2343
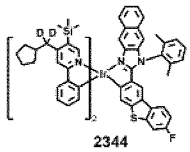
2344
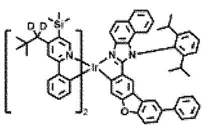
2345

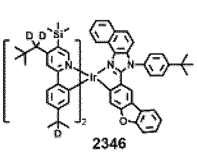
2346
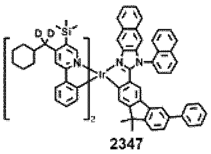
2347
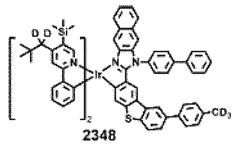
2348
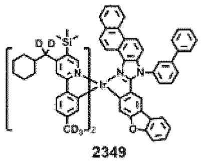
2349
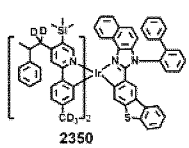
2350

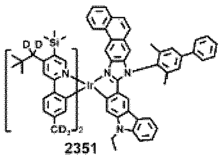
2351
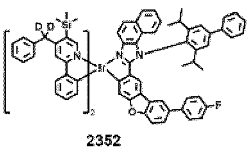
2352
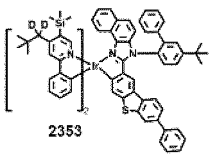
2353
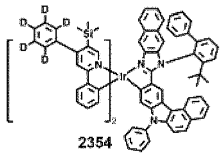
2354
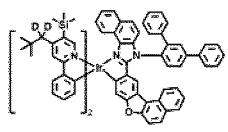
2355

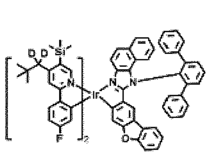
2356
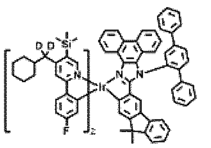
2357
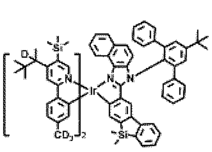
2358
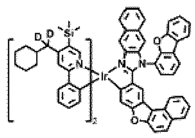
2359
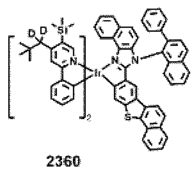
2360

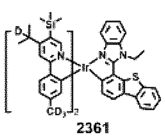
2361
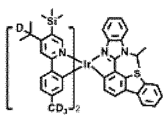
2362
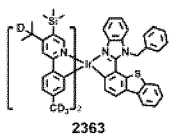
2363
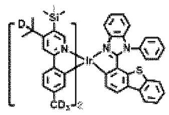
2364
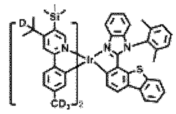
2365

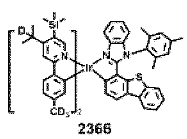
2366
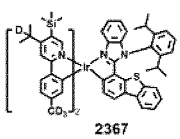
2367
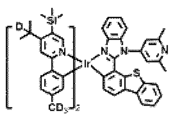
2368
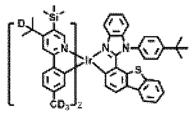
2369
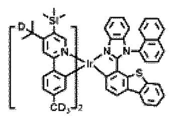
2370

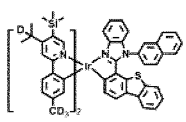
2371
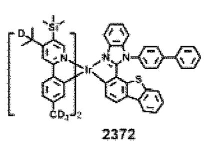
2372
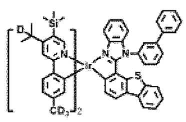
2373
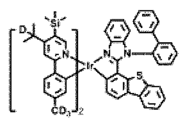
2374
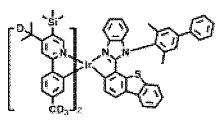
2375

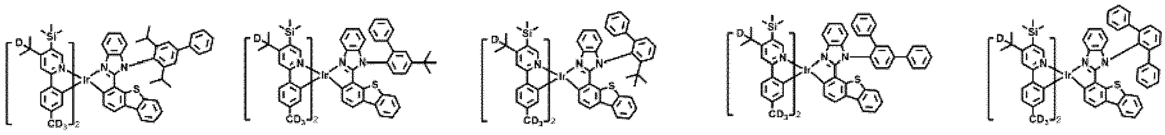
2376
2377
2378
2379
2380

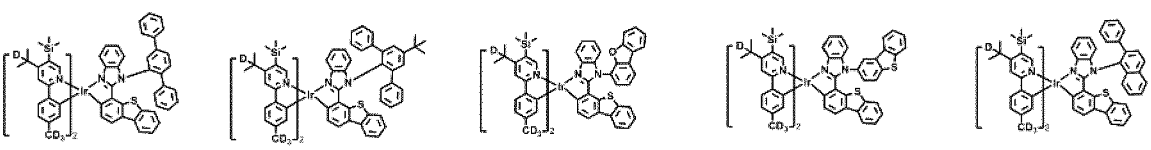
2381
2382
2383
2384
2385

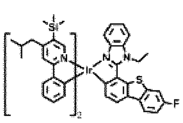
2386
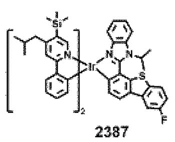
2387
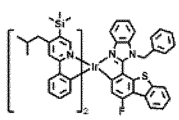
2388
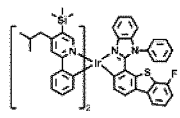
2389
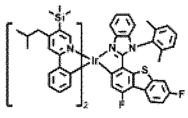
2390

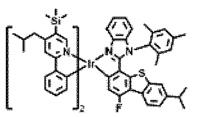
2391
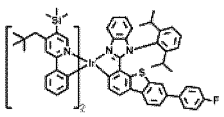
2392
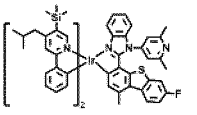
2393
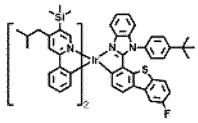
2394
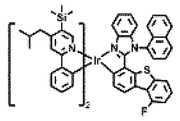
2395

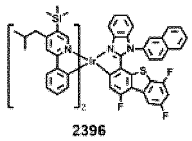
2396
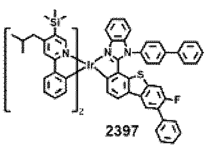
2397
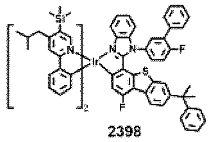
2398
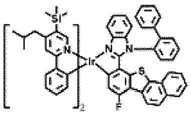
2399
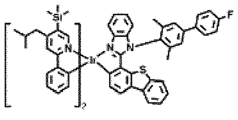
2400

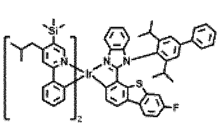
2401
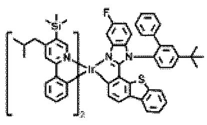
2402
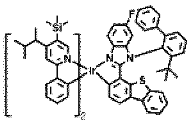
2403
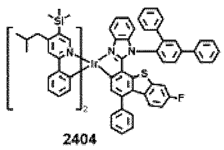
2404
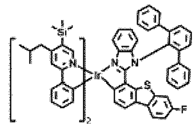
2405

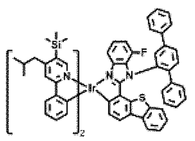
2406
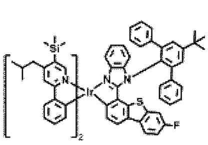
2407
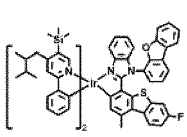
2408
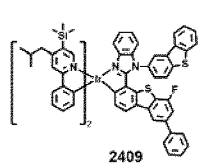
2409
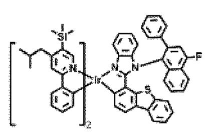
2410

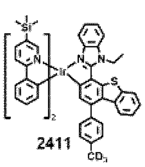
2411
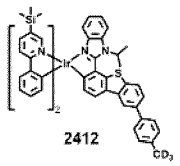
2412
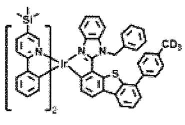
2413
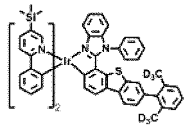
2414
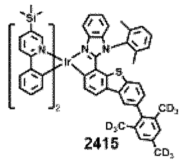
2415

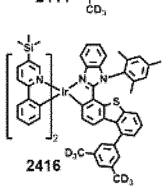
2416
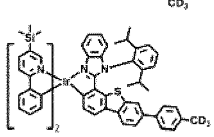
2417
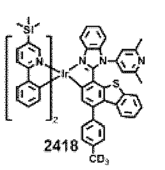
2418
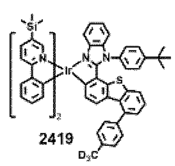
2419
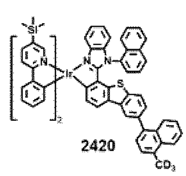
2420

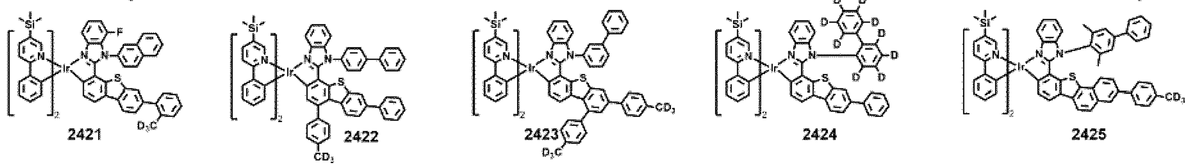
2421
2422
2423
2424
2425

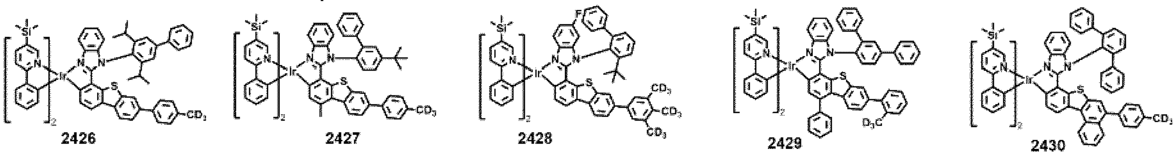
2426
2427
2428
2429
2430

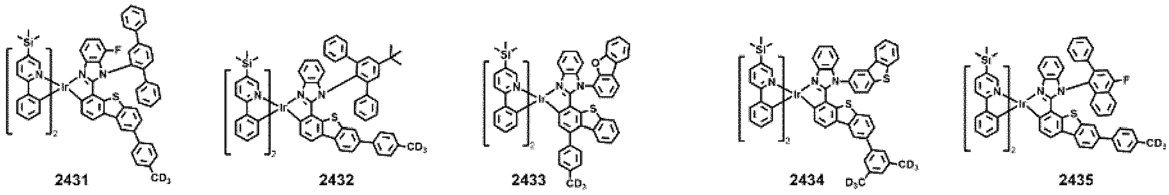
2431
2432
2433
2434
2435

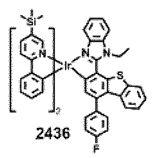
2436

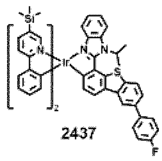
2437

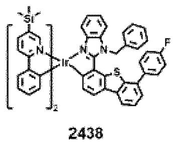
2438

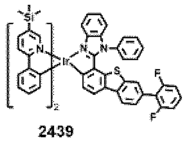
2439

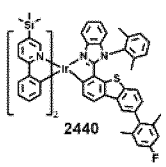
2440

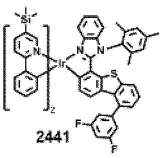
2441

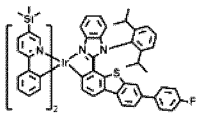
2442

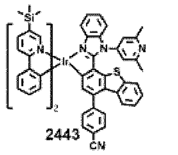
2443

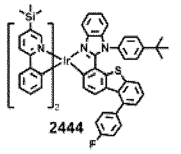
2444

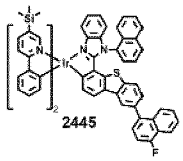
2445

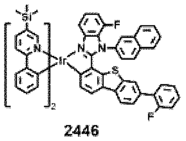
2446

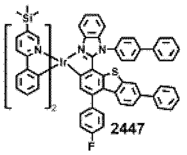
2447

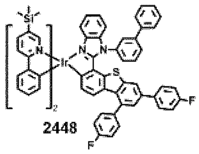
2448

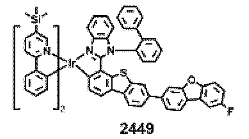
2449

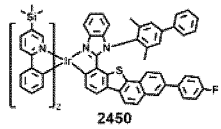
2450

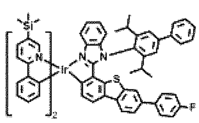
2451

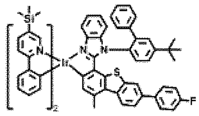
2452

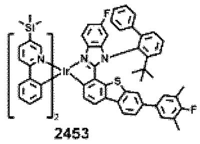
2453

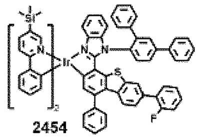
2454

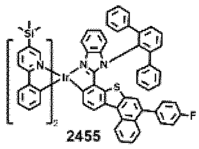
2455

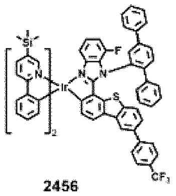
2456

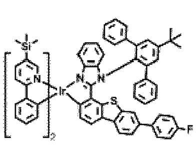
2457

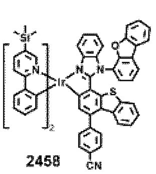
2458

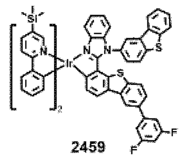
2459

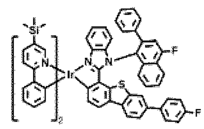
2460

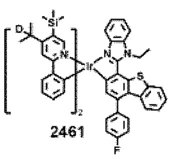
2461

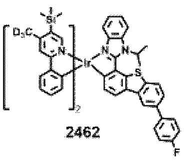
2462

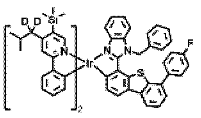
2463

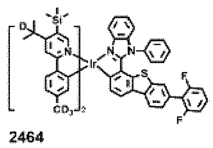
2464

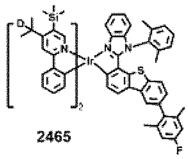
2465

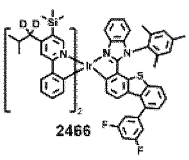
2466

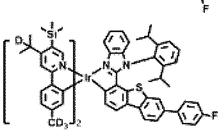
2467

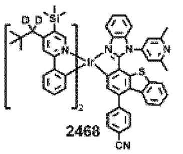
2468

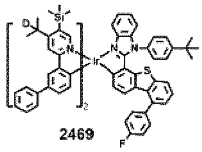
2469

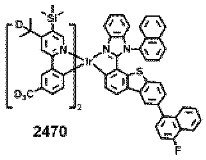
2470

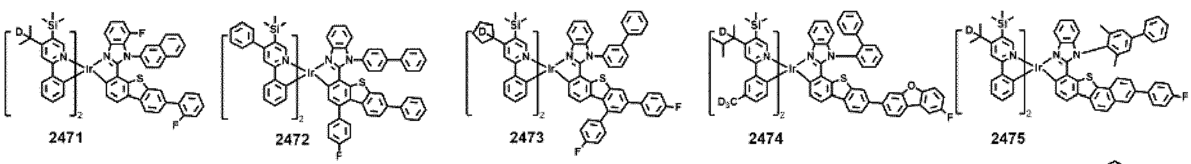
2471

2472

2473

2474

2475

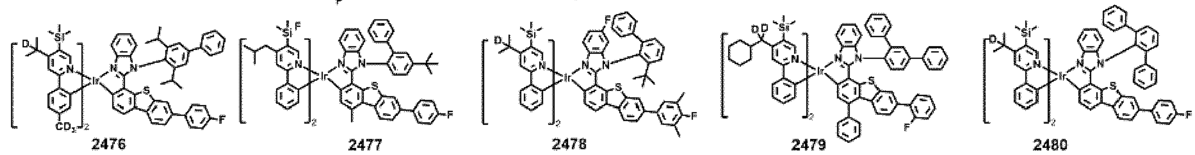
2476

2477

2478

2479

2480

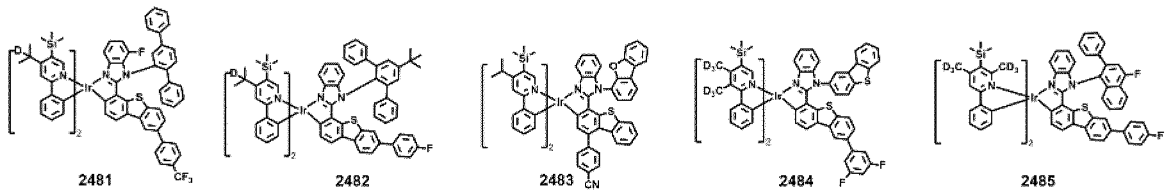
2481

2482

2483

2484

2485

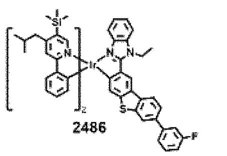
2486
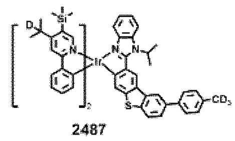
2487
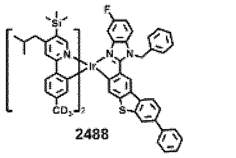
2488
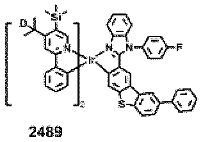
2489
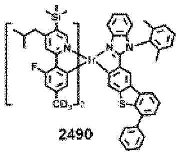
2490
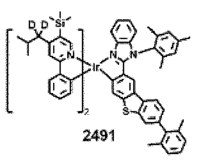
2491
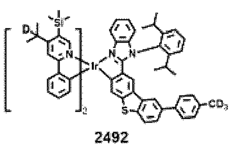
2492
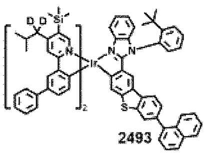
2493
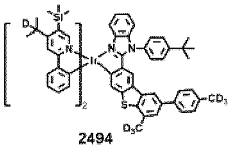
2494
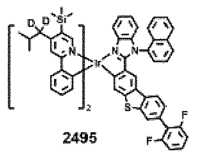
2495
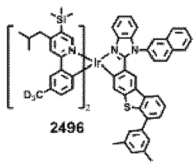
2496
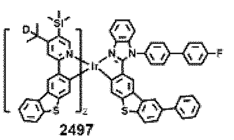
2497
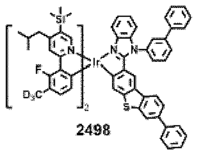
2498
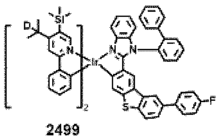
2499
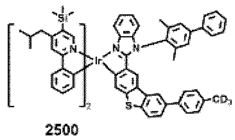
2500
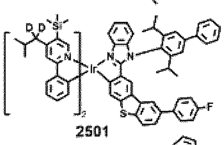
2501
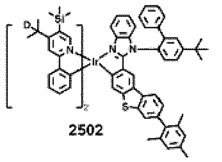
2502
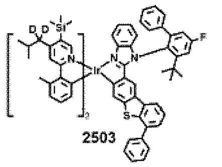
2503
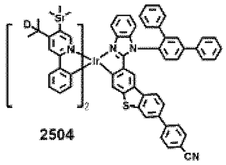
2504
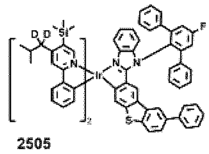
2505
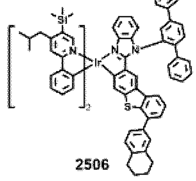
2506
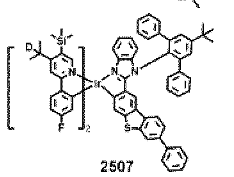
2507
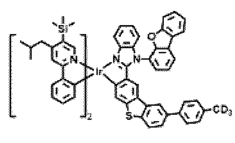
2508
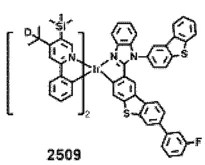
2509
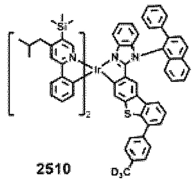
2510
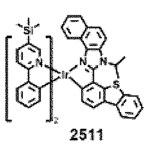
2511
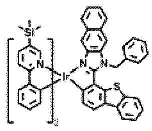
2512
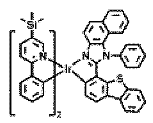
2513
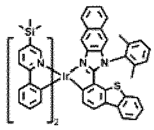
2514
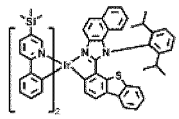
2515
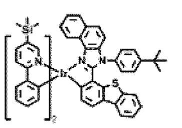
2516
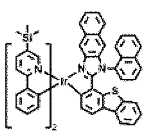
2517
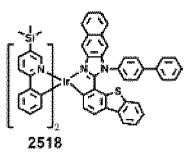
2518
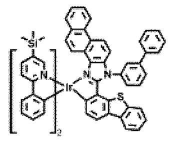
2519
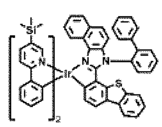
2520
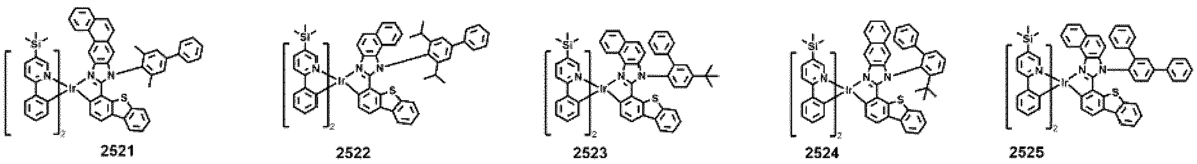
2521 2522 2523 2524 2525
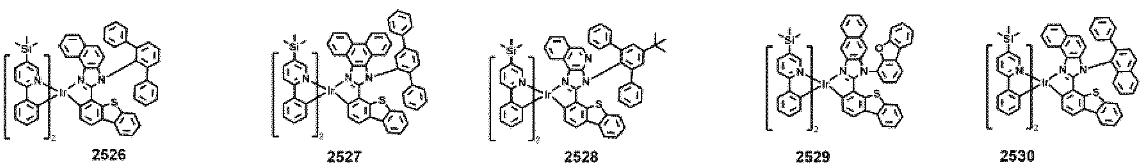
2526 2527 2528 2529 2530

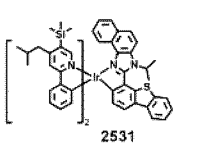
2531
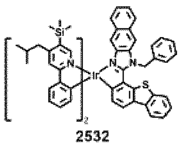
2532
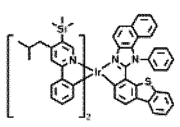
2533
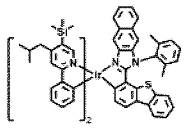
2534
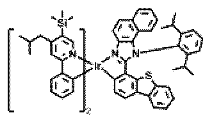
2535

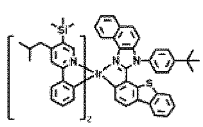
2536
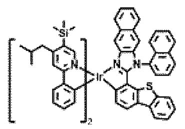
2537
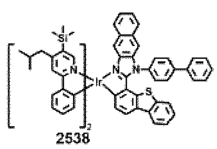
2538
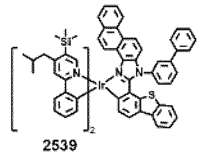
2539
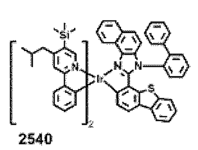
2540

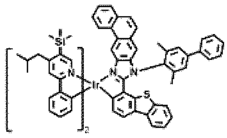
2541
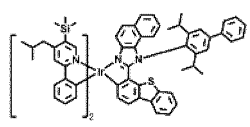
2542
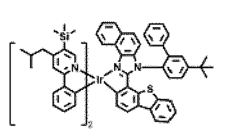
2543
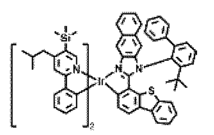
2544
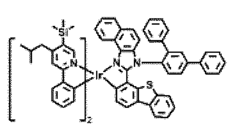
2545

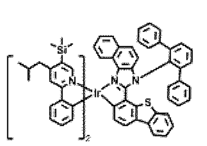
2546
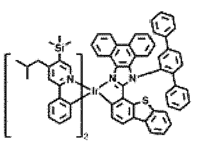
2547
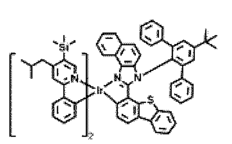
2548
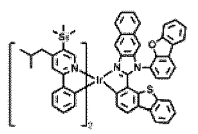
2549
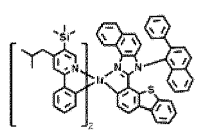
2550

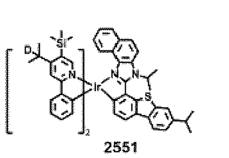
2551
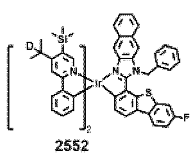
2552
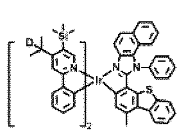
2553
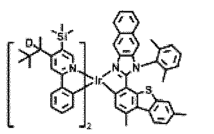
2554
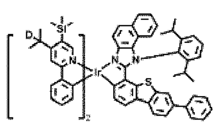
2555

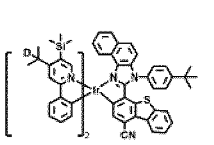
2556
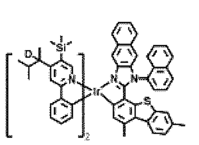
2557
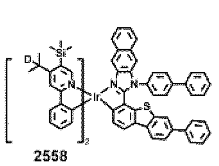
2558
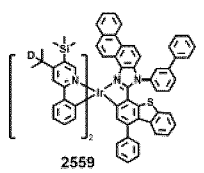
2559
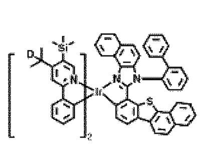
2560

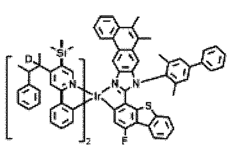
2561
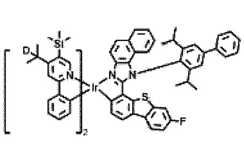
2562
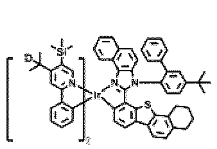
2563
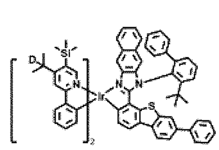
2564
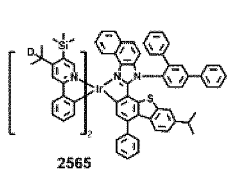
2565

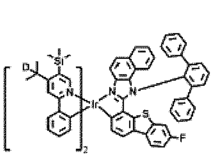
2566
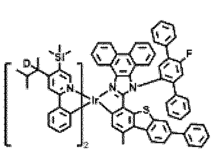
2567
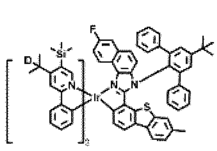
2568
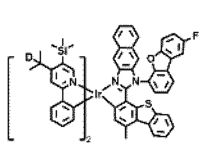
2569
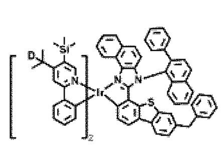
2570

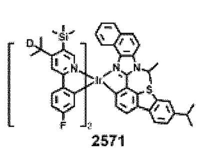
2571
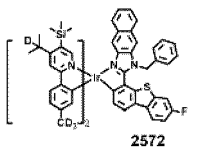
2572
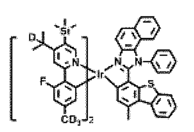
2573
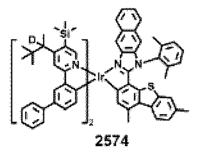
2574
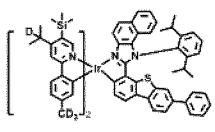
2575

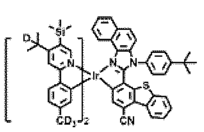
2576
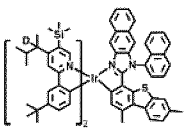
2577
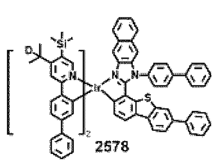
2578
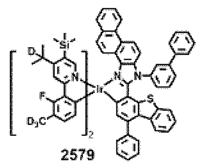
2579
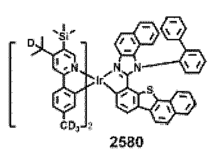
2580

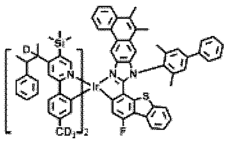
2581
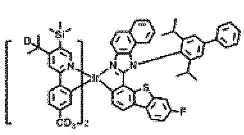
2582
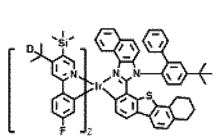
2583
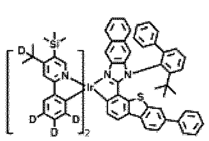
2584
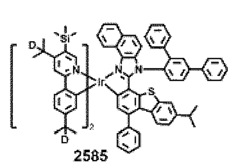
2585

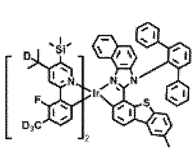
2586
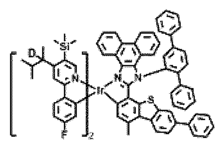
2587
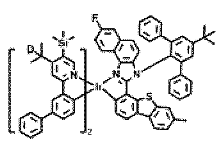
2588
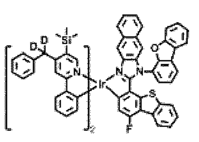
2589
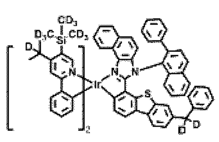
2590

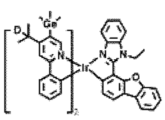
2591
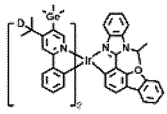
2592
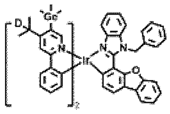
2593
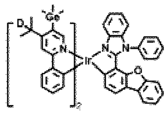
2594
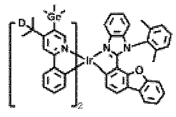
2595

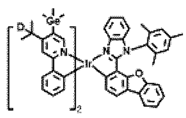
2596
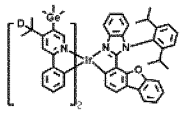
2597
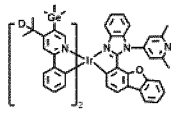
2598
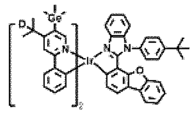
2599
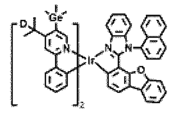
2600

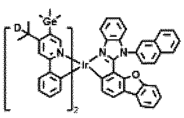
2601
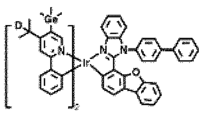
2602
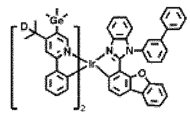
2603
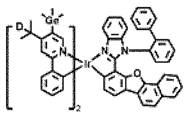
2604
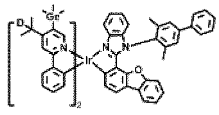
2605

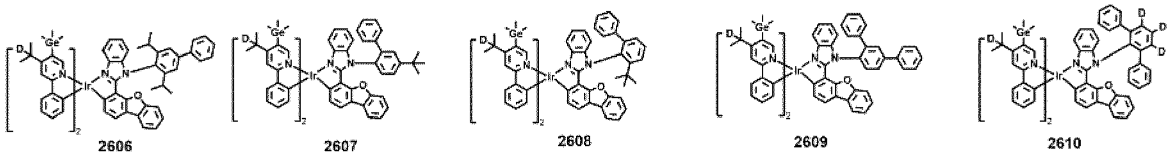
2606
2607
2608
2609
2610

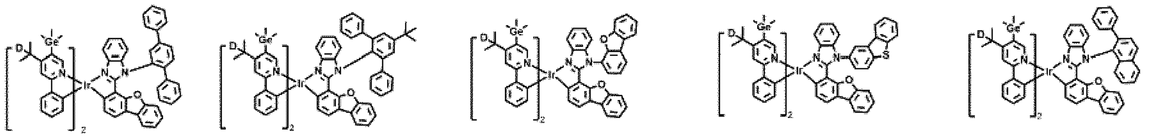
2611
2612
2613
2614
2615

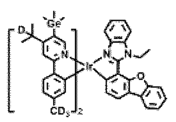
2616
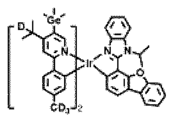
2617
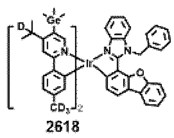
2618
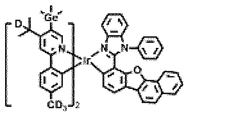
2619
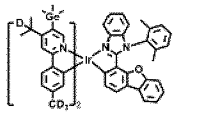
2620
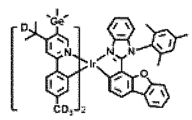
2621
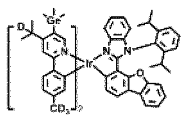
2622
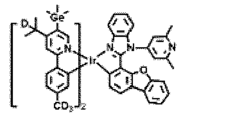
2623
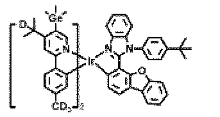
2624
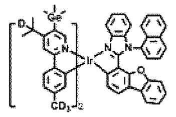
2625
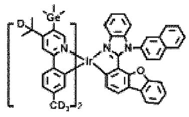
2626
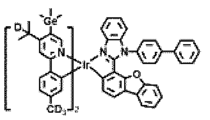
2627
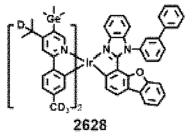
2628
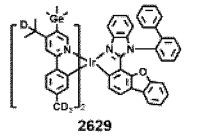
2629
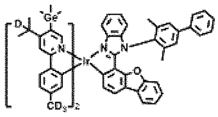
2630
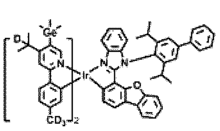
2631
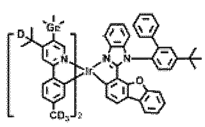
2632
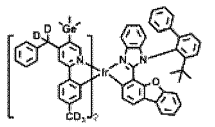
2633
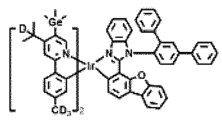
2634
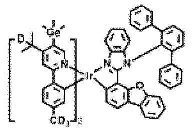
2635
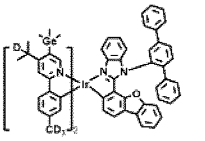
2636
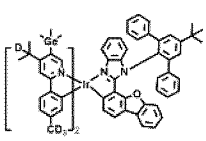
2637
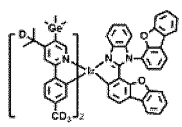
2638
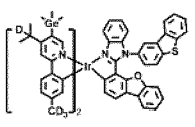
2639
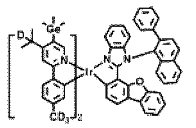
2640
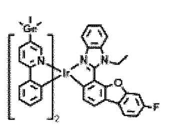
2641
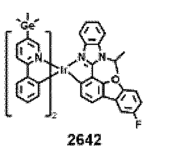
2642
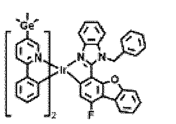
2643
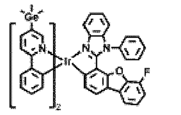
2644
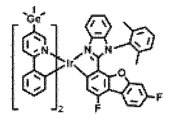
2645
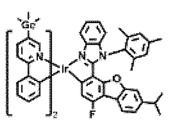
2646
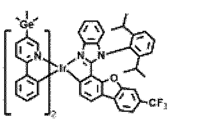
2647
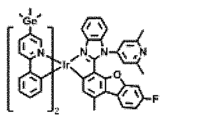
2648
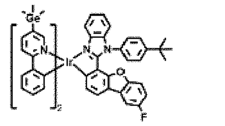
2649
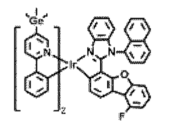
2650
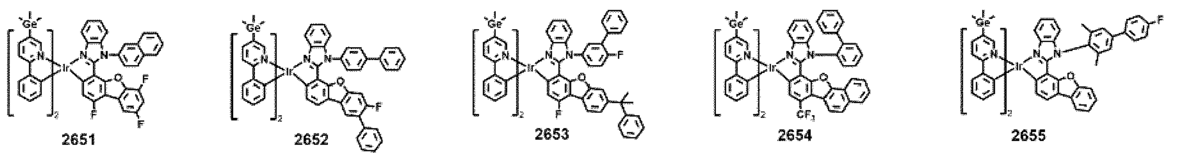
2651 2652 2653 2654 2655
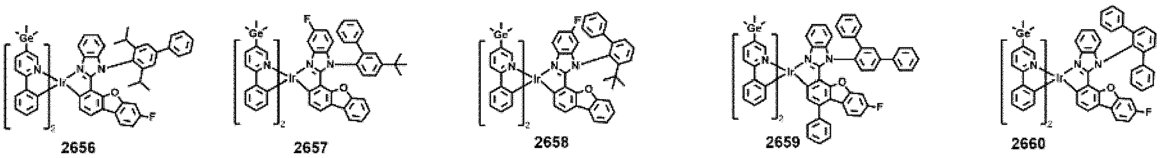
2656 2657 2658 2659 2660
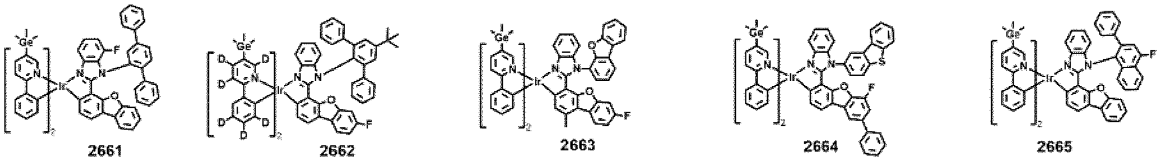
2661 2662 2663 2664 2665

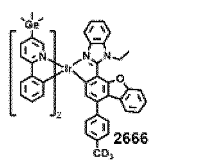
2666

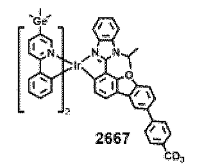
2667

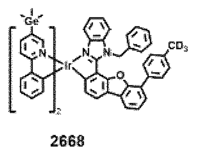
2668

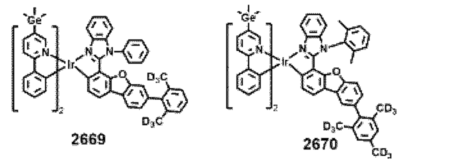
2669

2670

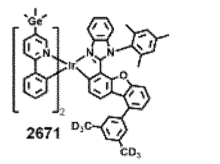
2671

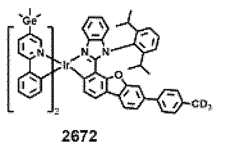
2672

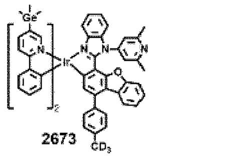
2673

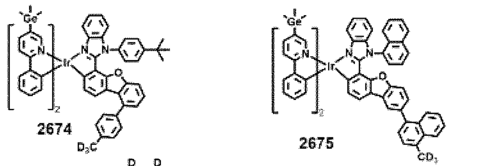
2674

2675

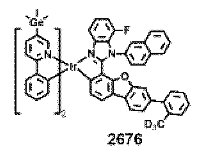
2676

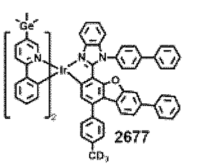
2677

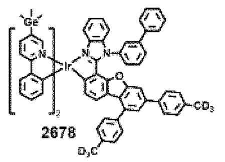
2678

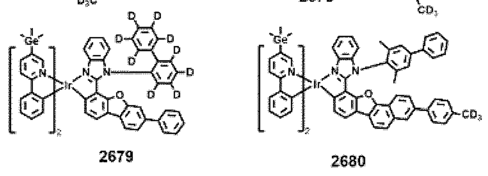
2679

2680

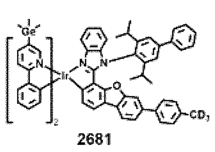
2681

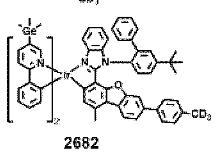
2682

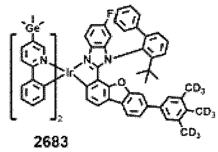
2683

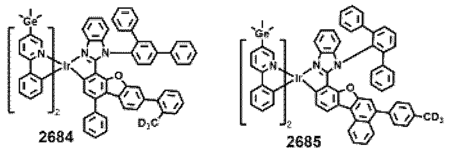
2684

2685

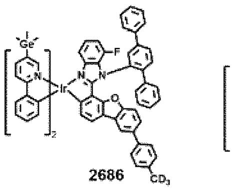
2686

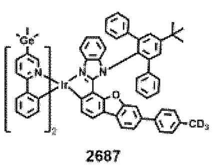
2687

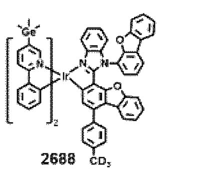
2688

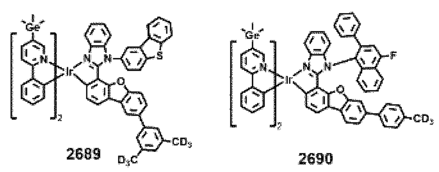
2689

2690

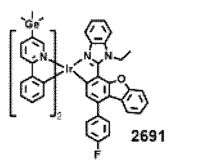
2691

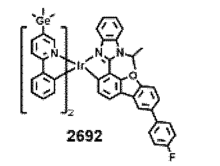
2692

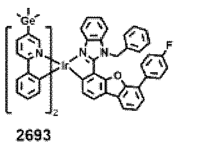
2693

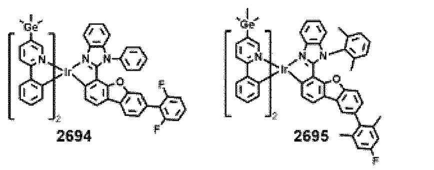
2694

2695

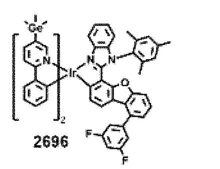
2696

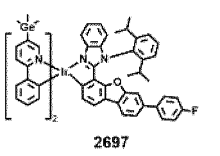
2697

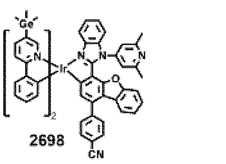
2698

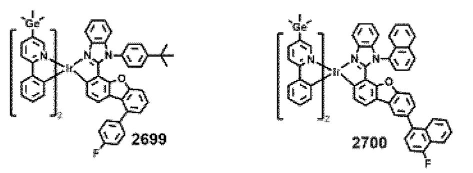
2699

2700

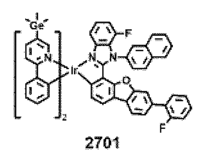
2701

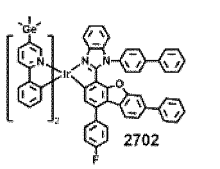
2702

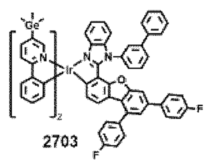
2703

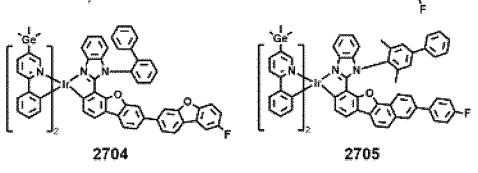
2704

2705

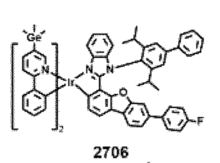
2706

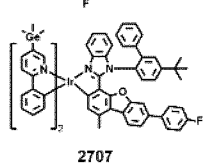
2707

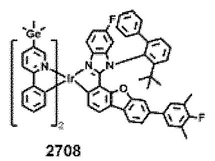
2708

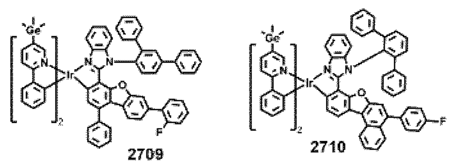
2709

2710

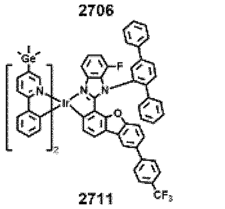
2711

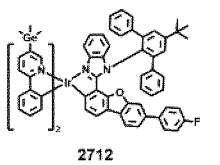
2712

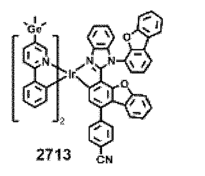
2713

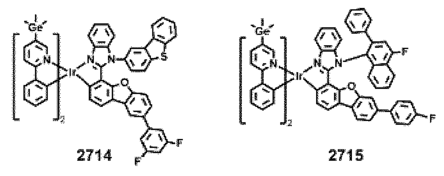
2714

2715

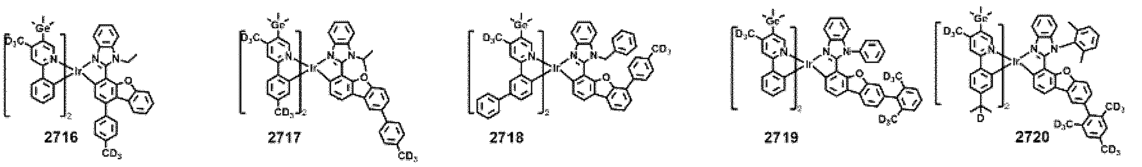
2716 2717 2718 2719 2720

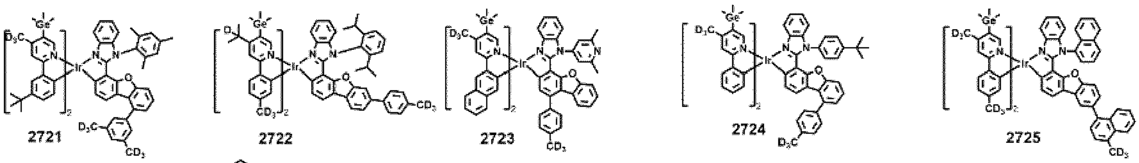
2721 2722 2723 2724 2725

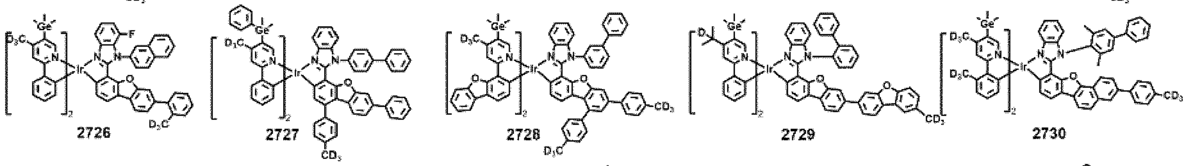
2726 2727 2728 2729 2730

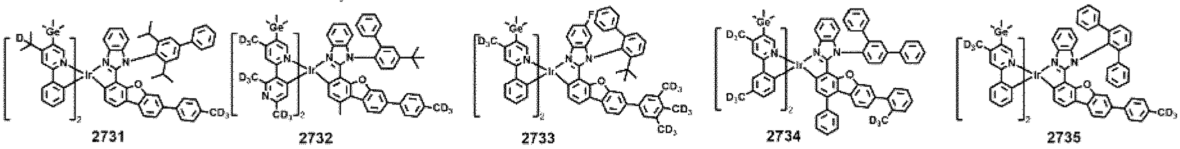
2731 2732 2733 2734 2735

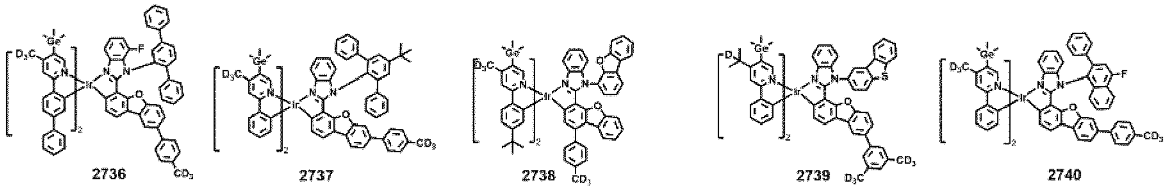
2736 2737 2738 2739 2740

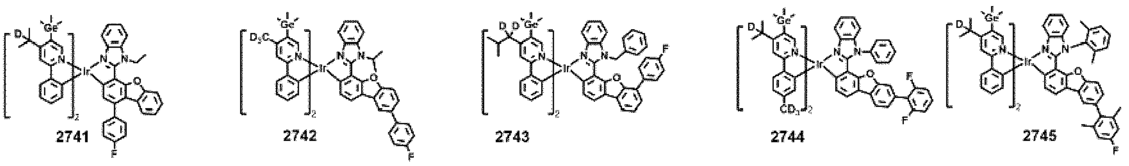
2741 2742 2743 2744 2745

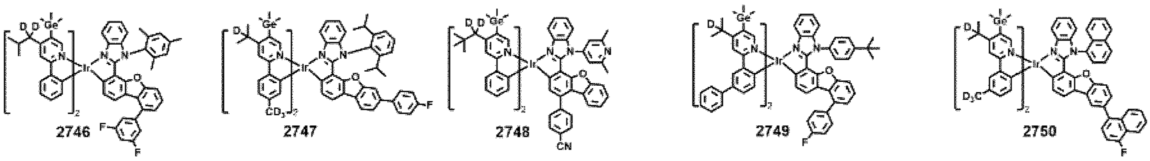
2746 2747 2748 2749 2750

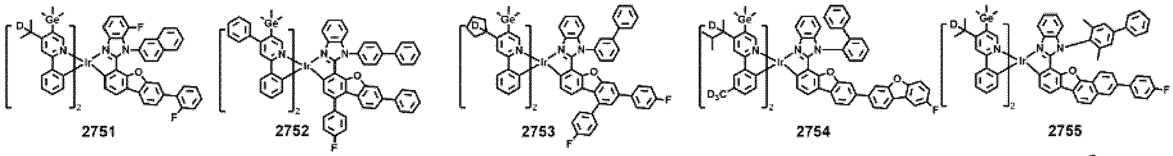
2751 2752 2753 2754 2755

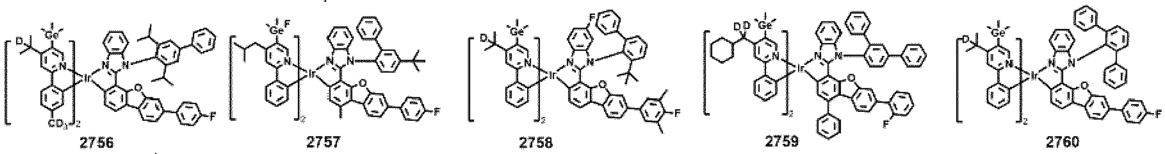
2756 2757 2758 2759 2760

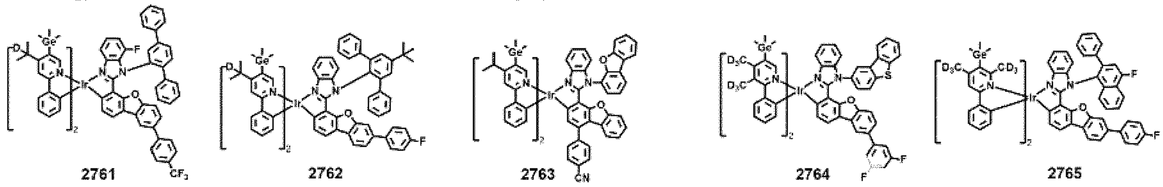
2761 2762 2763 2764 2765

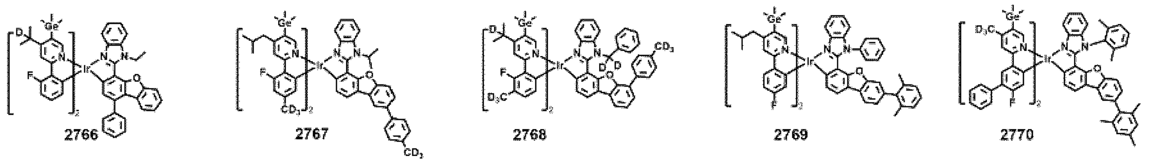

2766 2767 2768 2769 2770

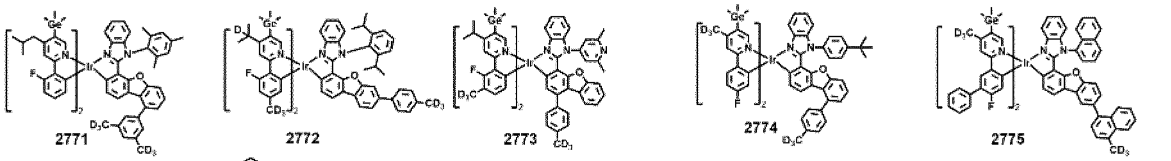

2771 2772 2773 2774 2775

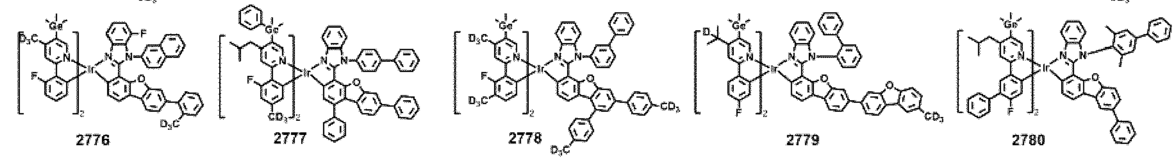

2776 2777 2778 2779 2780

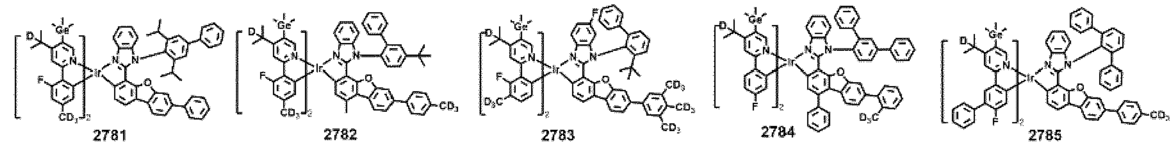

2781 2782 2783 2784 2785

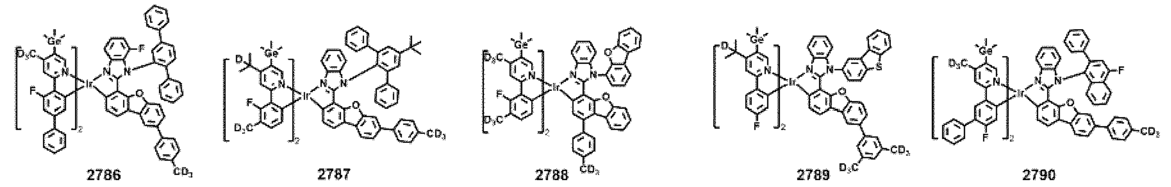

2786 2787 2788 2789 2790

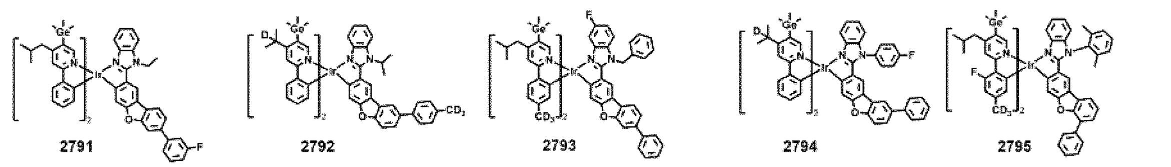

2791 2792 2793 2794 2795

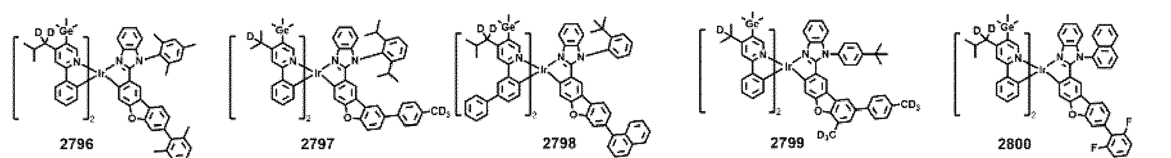

2796 2797 2798 2799 2800

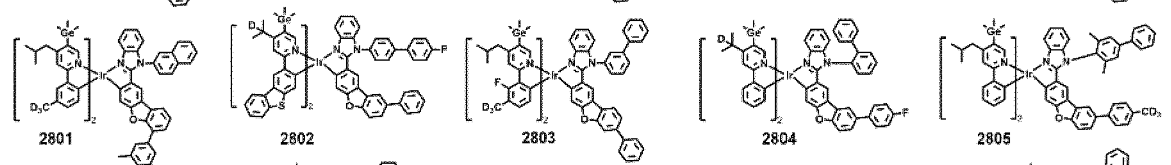

2801 2802 2803 2804 2805

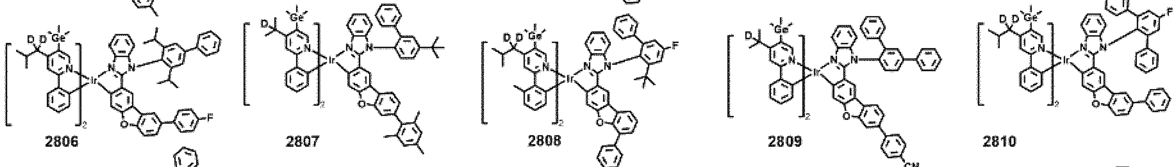

2806 2807 2808 2809 2810

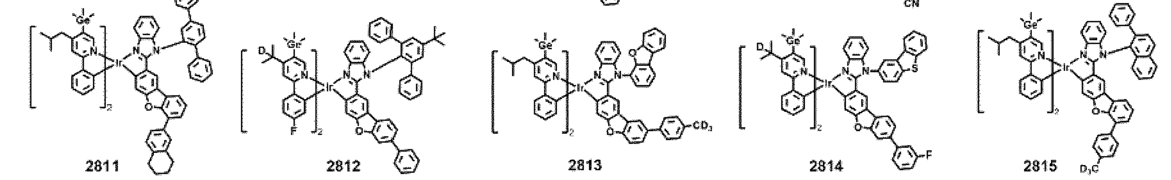

2811 2812 2813 2814 2815

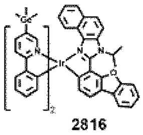
2816

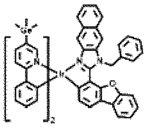
2817

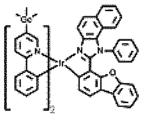
2818

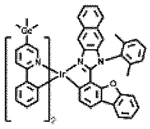
2819

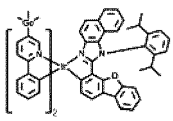
2820

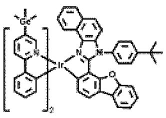
2821

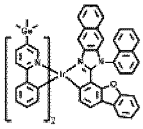
2822

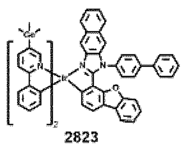
2823

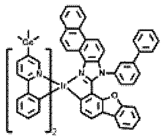
2824

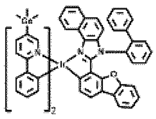
2825

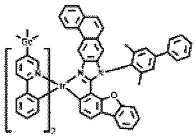
2826

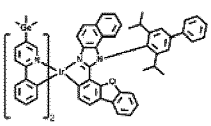
2827

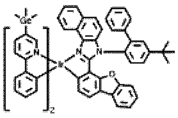
2828

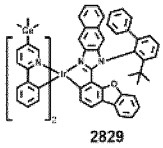
2829

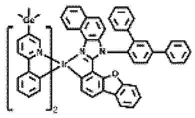
2830

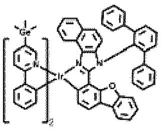
2831

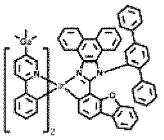
2832

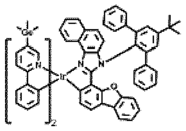
2833

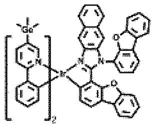
2834

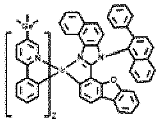
2835

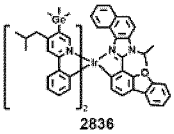
2836

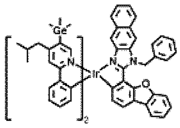
2837

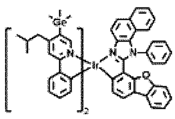
2838

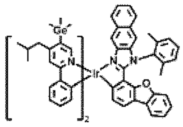
2839

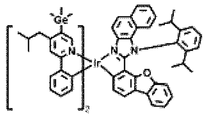
2840

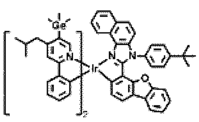
2841

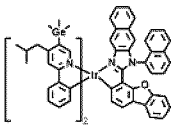
2842

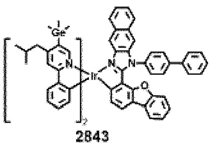
2843

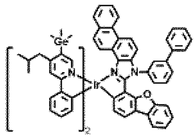
2844

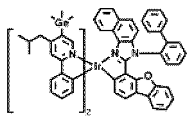
2845

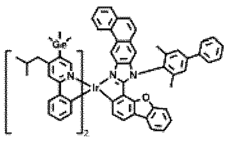
2846

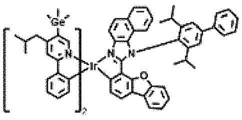
2847

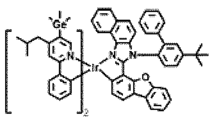
2848

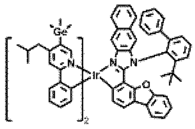
2849

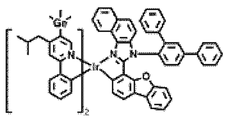
2850

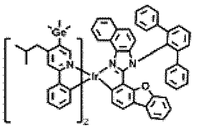
2851

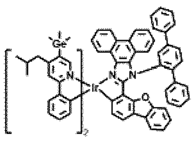
2852

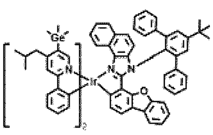
2853

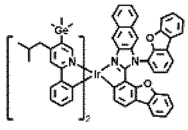
2854

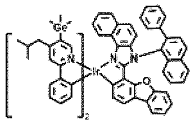
2855

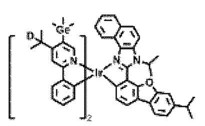
2856

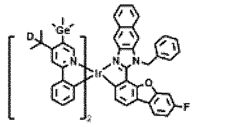
2857

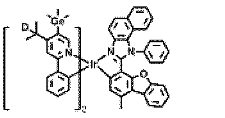
2858

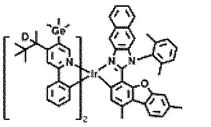
2859

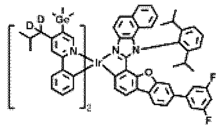
2860

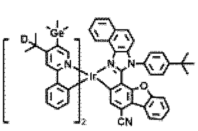
2861

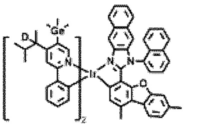
2862

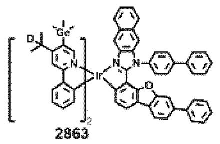
2863

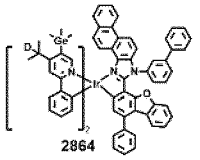
2864

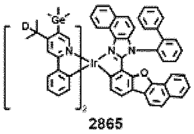
2865

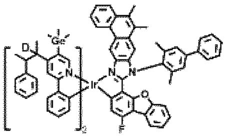
2866

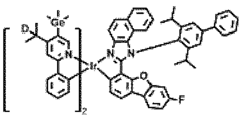
2867

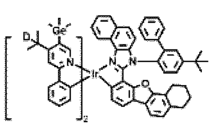
2868

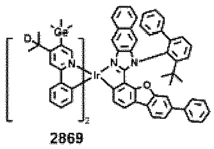
2869

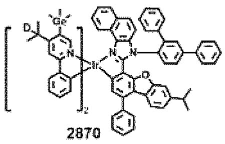
2870

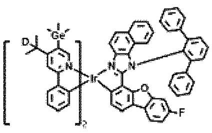
2871

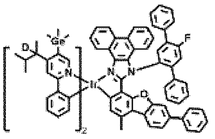
2872

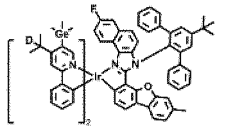
2873

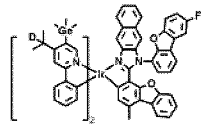
2874

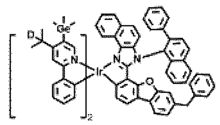
2875

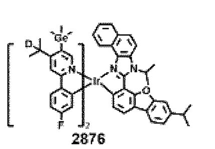
2876

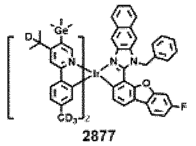
2877

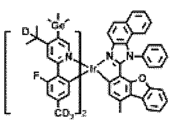
2878

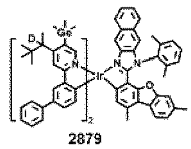
2879

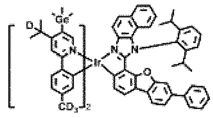
2880

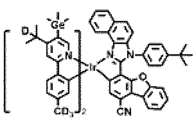
2881

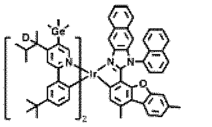
2882

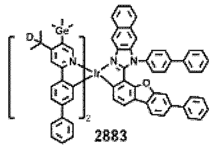
2883

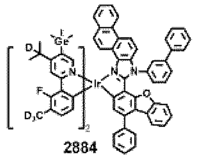
2884

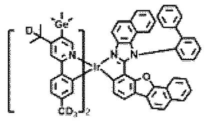
2885

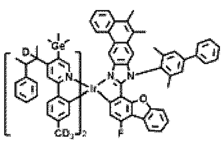
2886

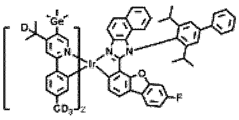
2887

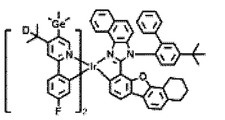
2888

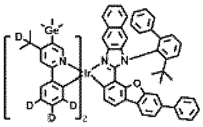
2889

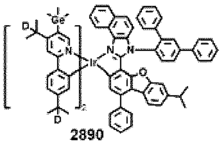
2890

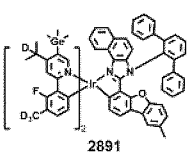
2891

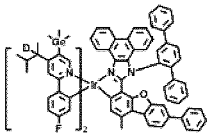
2892

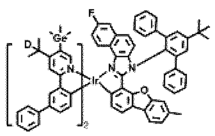
2893

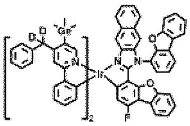
2894

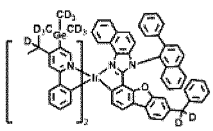
2895

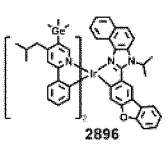
2896

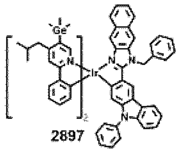
2897

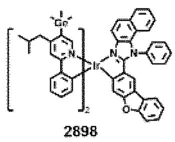
2898

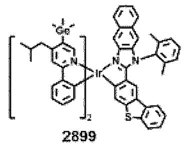
2899

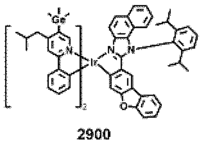
2900

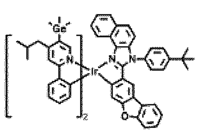
2901

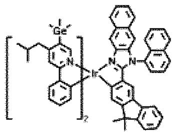
2902

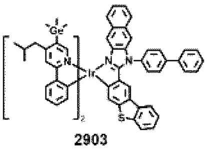
2903

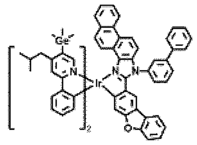
2904

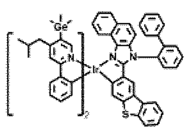
2905

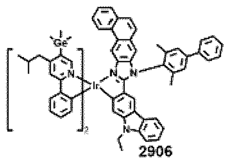
2906

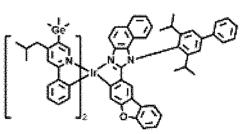
2907

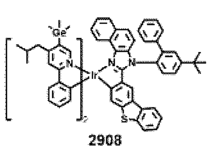
2908

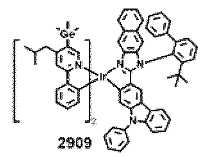
2909

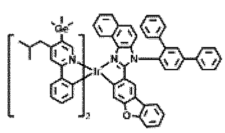
2910

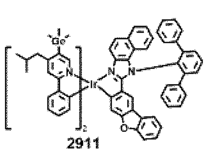
2911

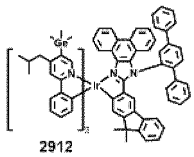
2912

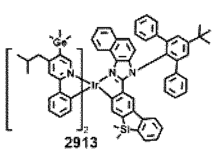
2913

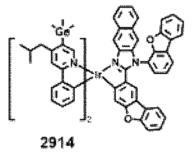
2914

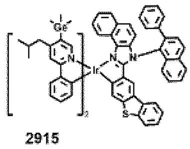
2915

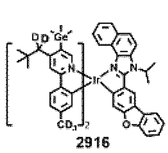
2916

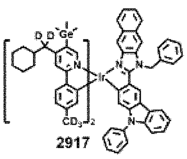
2917

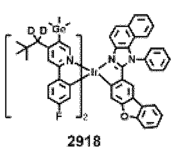
2918

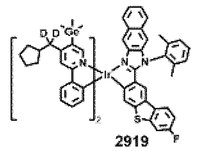
2919

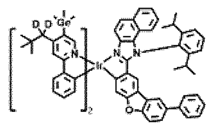
2920

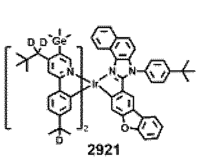
2921

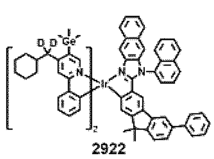
2922

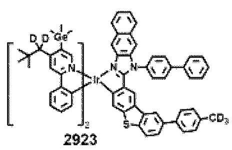
2923

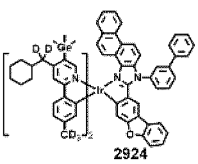
2924

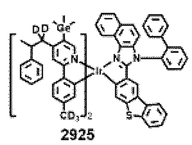
2925

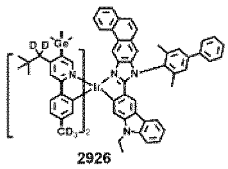
2926

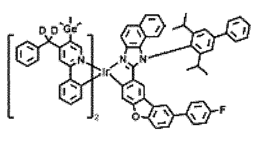
2927

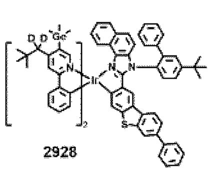
2928

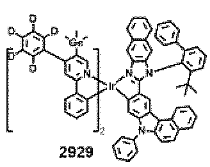
2929

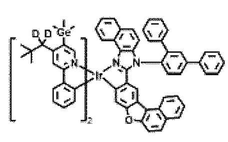
2930

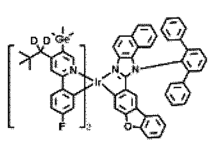
2931

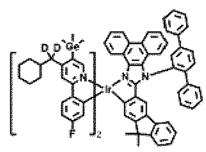
2932

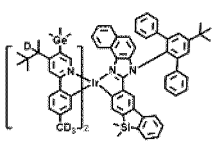
2933

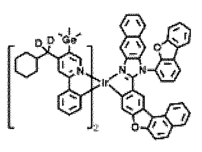
2934

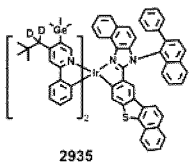
2935

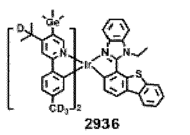
2936
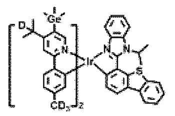
2937
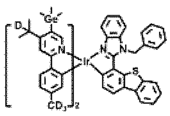
2938
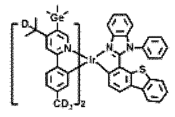
2939
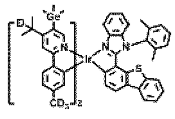
2940

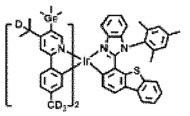
2941
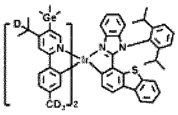
2942
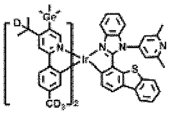
2943
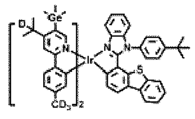
2944
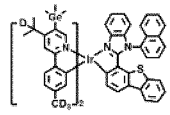
2945

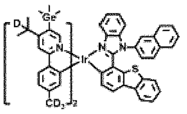
2946
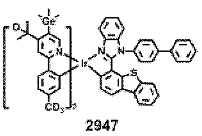
2947
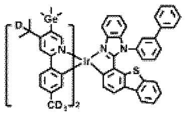
2948
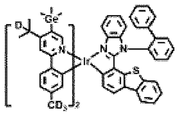
2949
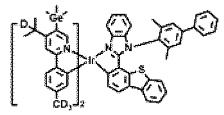
2950

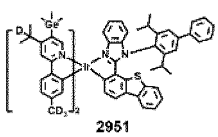
2951
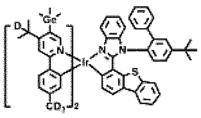
2952
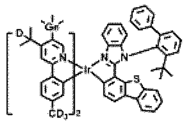
2953
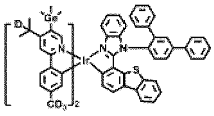
2954
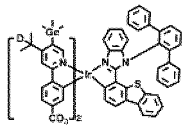
2955

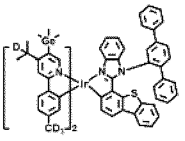
2956
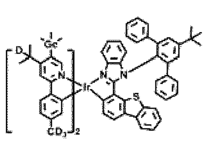
2957
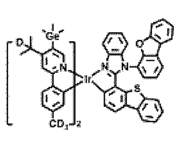
2958
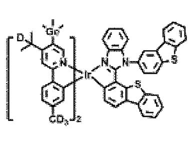
2959
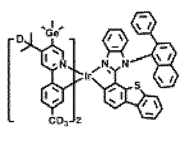
2960

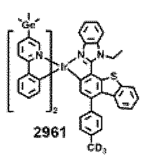
2961
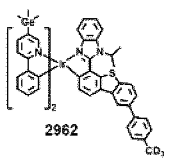
2962
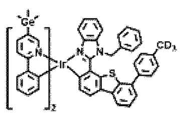
2963
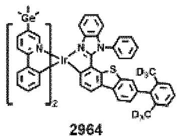
2964
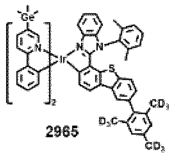
2965

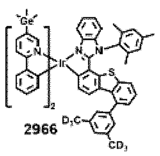
2966
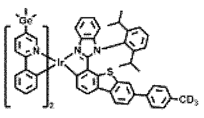
2967
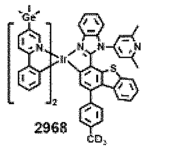
2968
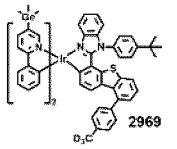
2969
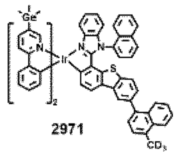
2971

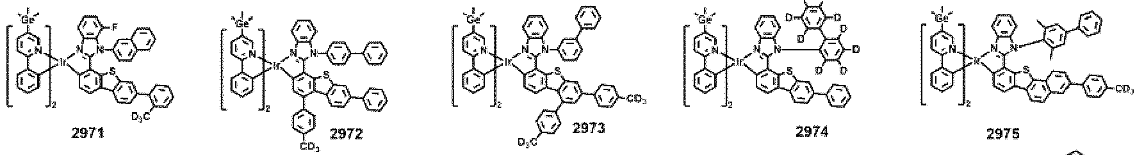
2971
2972
2973
2974
2975

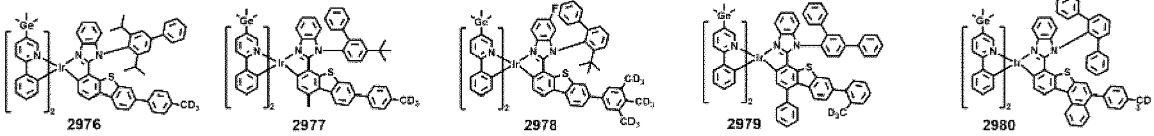
2976
2977
2978
2979
2980

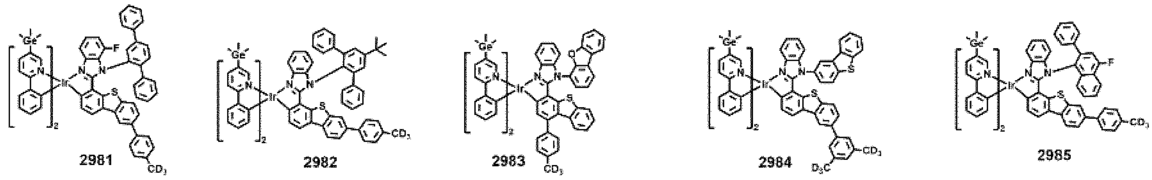
2981
2982
2983
2984
2985

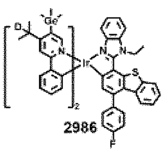
2986
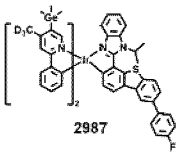
2987
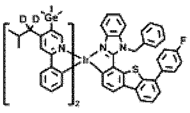
2988
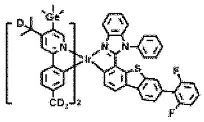
2989
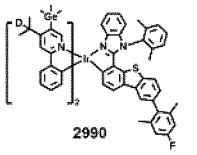
2990

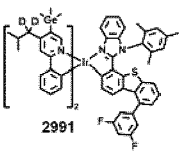
2991
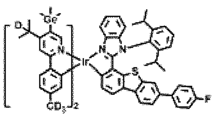
2992
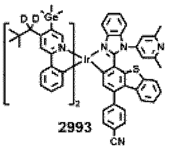
2993
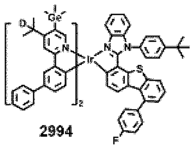
2994
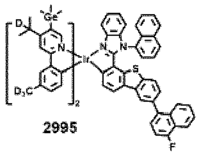
2995

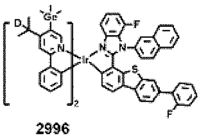
2996
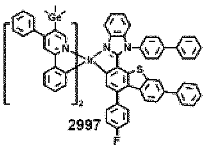
2997
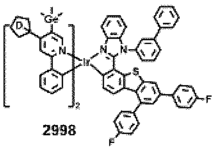
2998
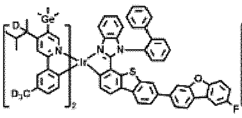
2999
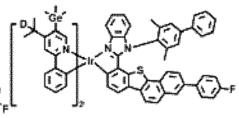
3000

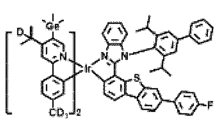
3001
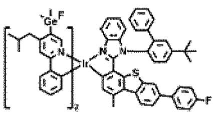
3002
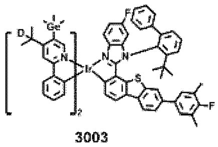
3003
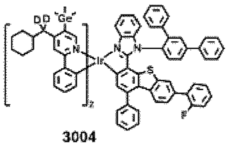
3004
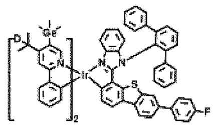
3005

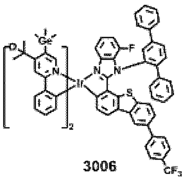
3006
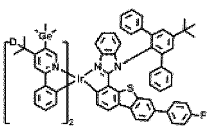
3007
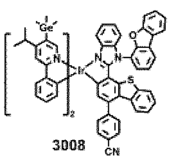
3008
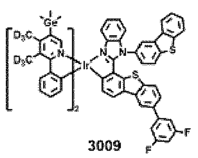
3009
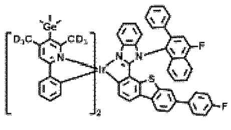
3010

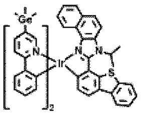
3011
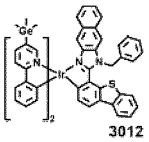
3012
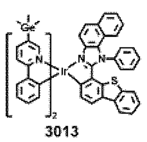
3013
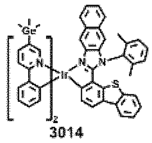
3014
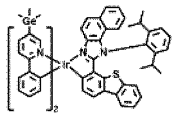
3015

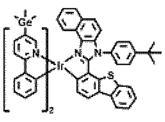
3016
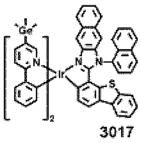
3017
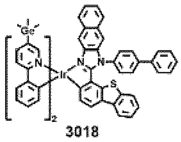
3018
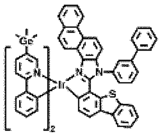
3019
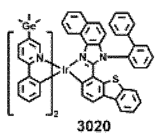
3020

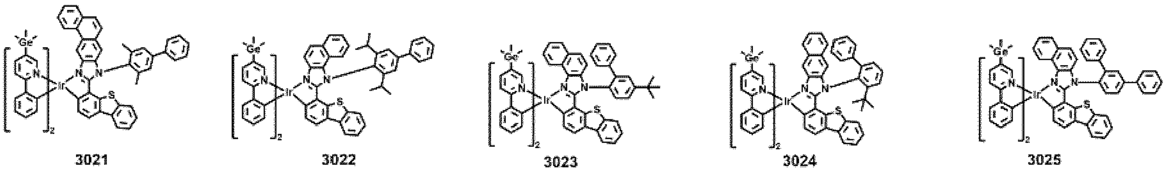
3021
3022
3023
3024
3025

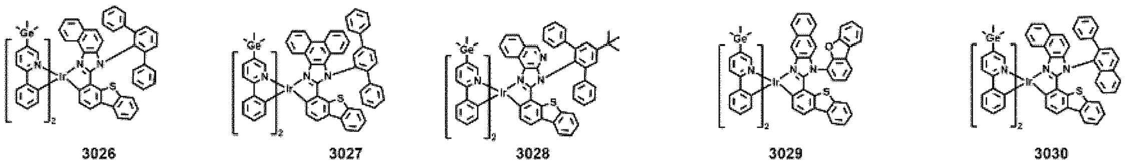
3026
3027
3028
3029
3030

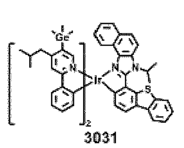
3031
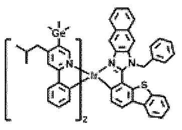
3032
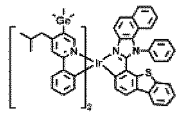
3033
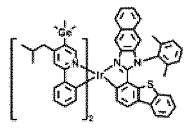
3034
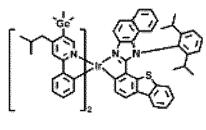
3035
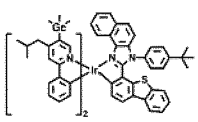
3036
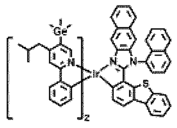
3037
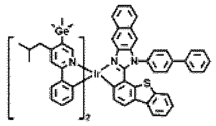
3038
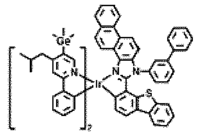
3039
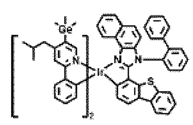
3040
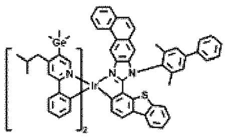
3041
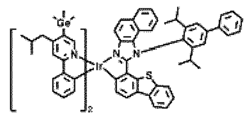
3042
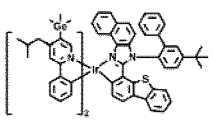
3043
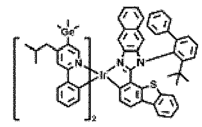
3044
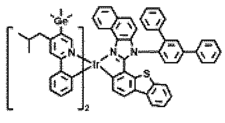
3045
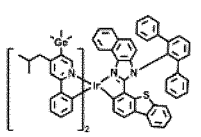
3046
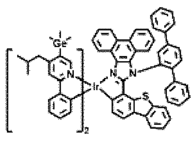
3047
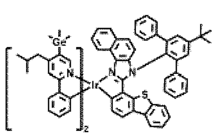
3048
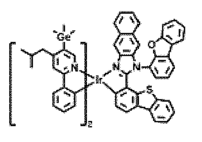
3049
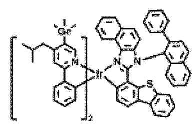
3050
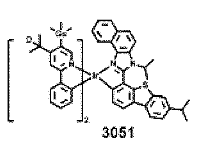
3051
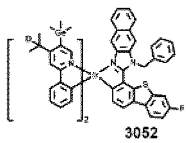
3052
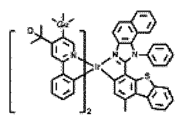
3053
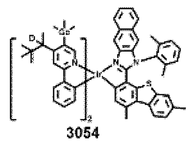
3054
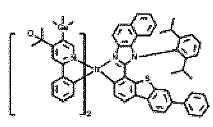
3055
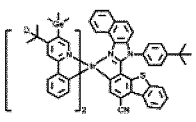
3056
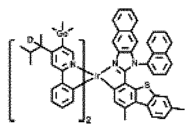
3057
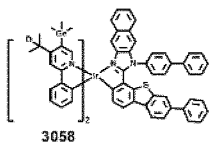
3058
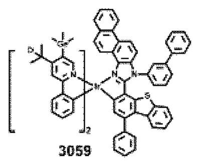
3059
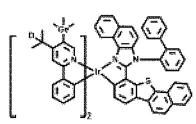
3060
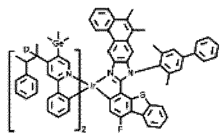
3061
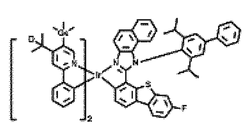
3062
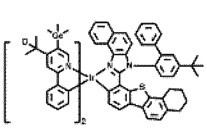
3063
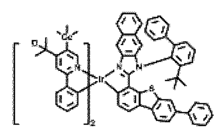
3064
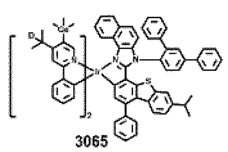
3065
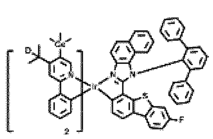
3066
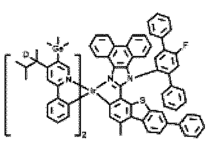
3067
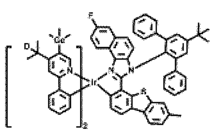
3068
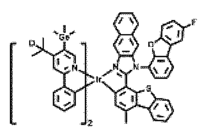
3069
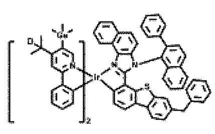
3070

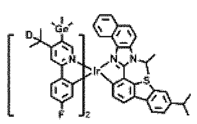
3071
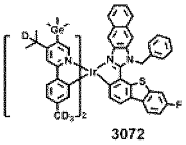
3072
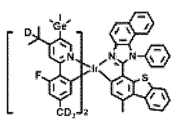
3073
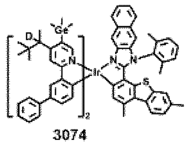
3074
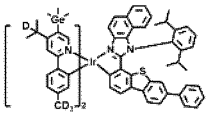
3075

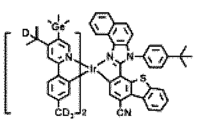
3076
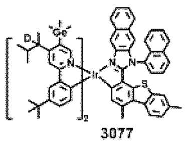
3077
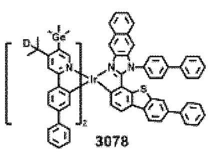
3078
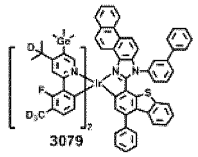
3079
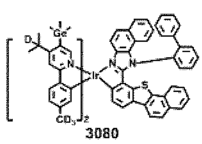
3080

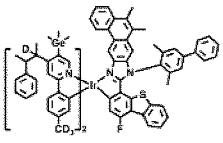
3081
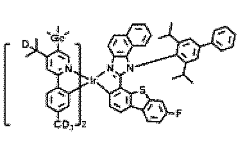
3082
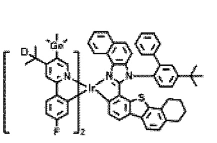
3083
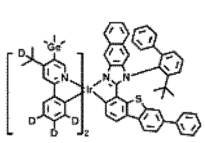
3084
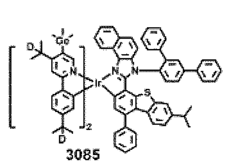
3085

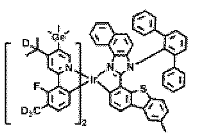
3086
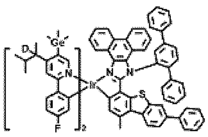
3087
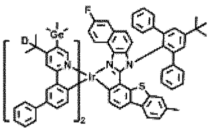
3088
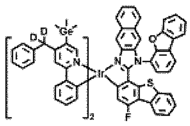
3089
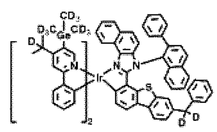
3090

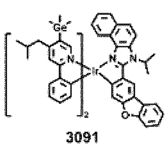
3091
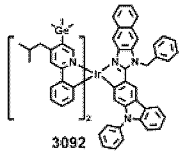
3092
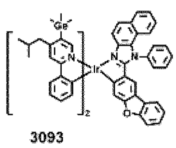
3093
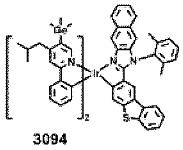
3094
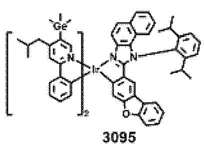
3095

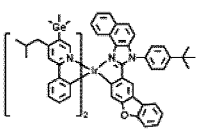
3096
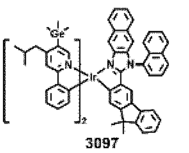
3097
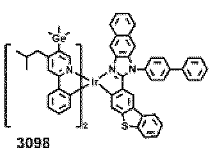
3098
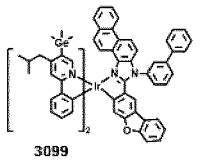
3099
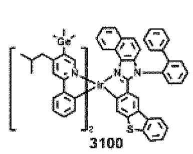
3100

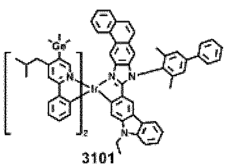
3101
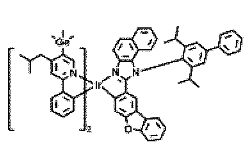
3102
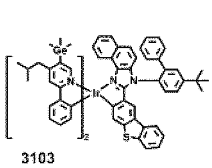
3103
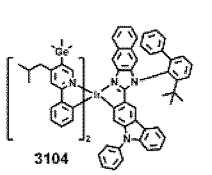
3104
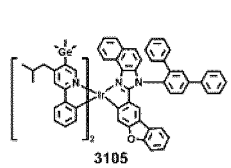
3105

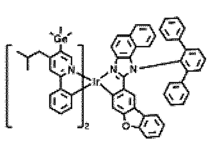
3106
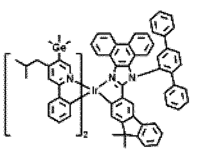
3107
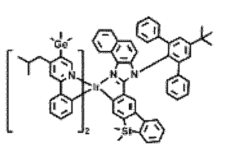
3108
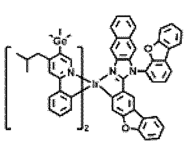
3109
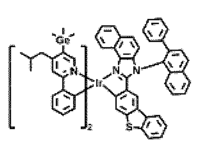
3110

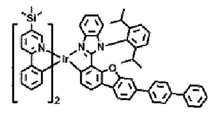
3111

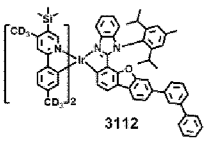
3112

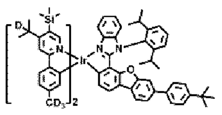
3113

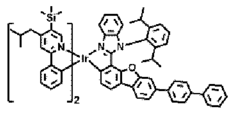
3114

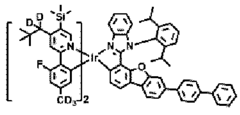
3115

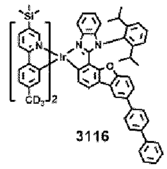
3116

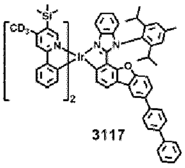
3117

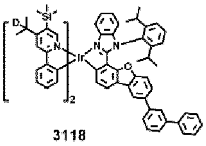
3118

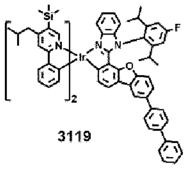
3119

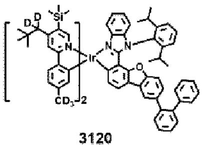
3120

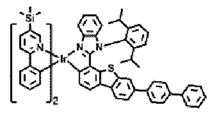
3121

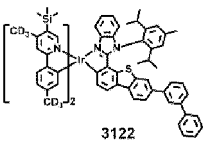
3122

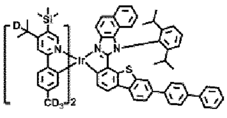
3123

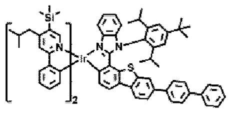
3124

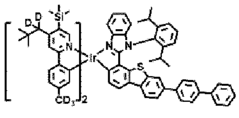
3125

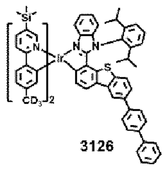
3126

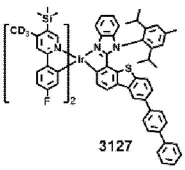
3127

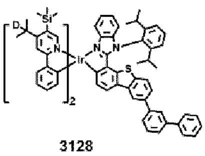
3128

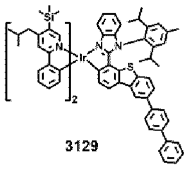
3129

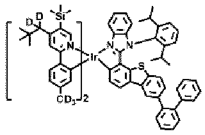
3130

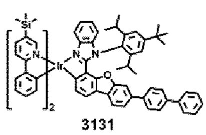
3131

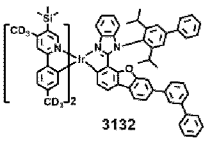
3132

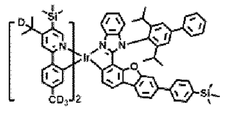
3133

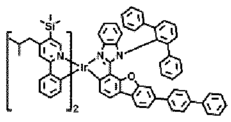
3134

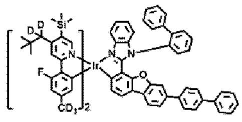
3135

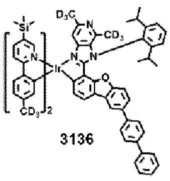
3136

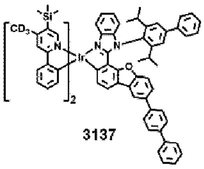
3137

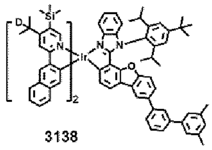
3138

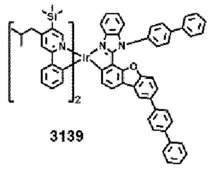
3139

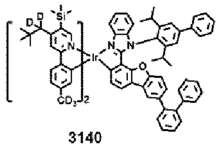
3140

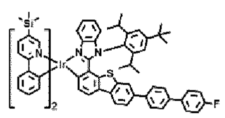
3141

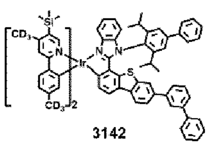
3142

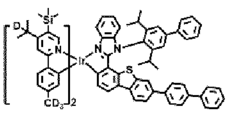
3143

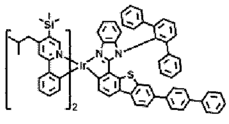
3144

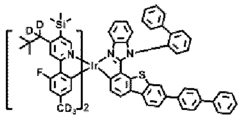
3145

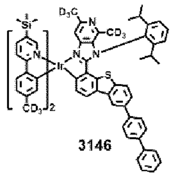
3146

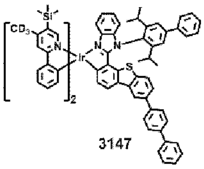
3147

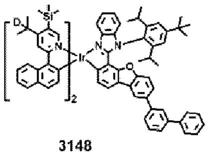
3148

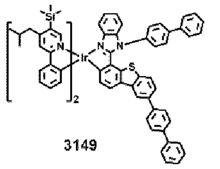
3149

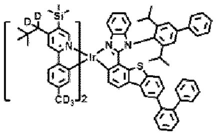
3150

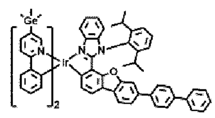
3151
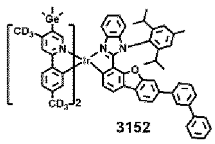
3152
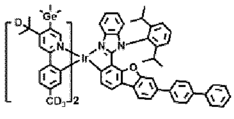
3153
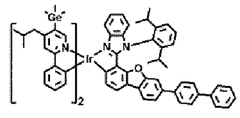
3154
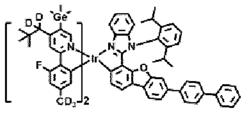
3155

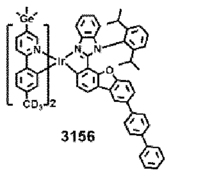
3156
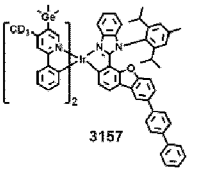
3157
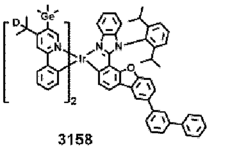
3158
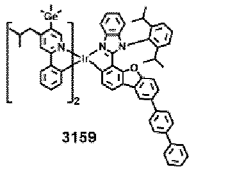
3159
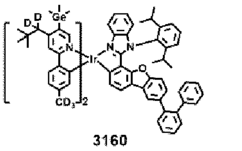
3160

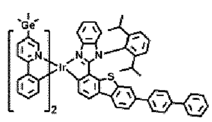
3161
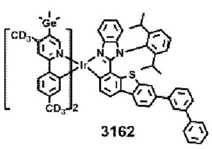
3162
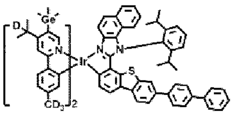
3163
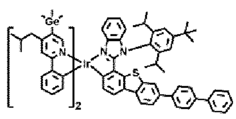
3164
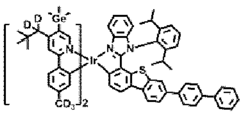
3165

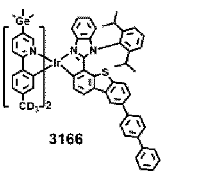
3166
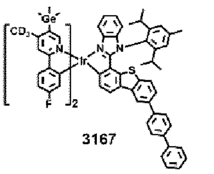
3167
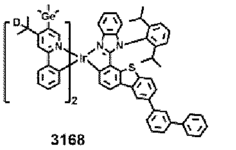
3168
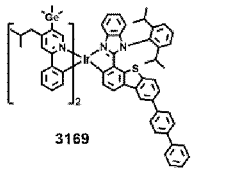
3169
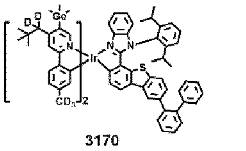
3170

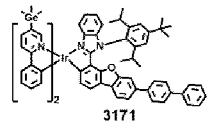
3171
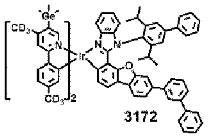
3172
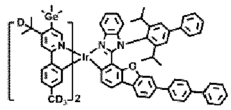
3173
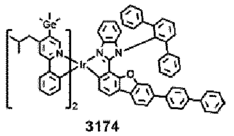
3174
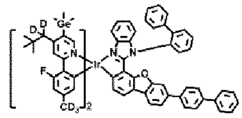
3175

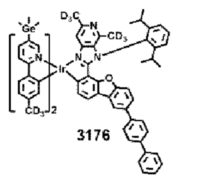
3176
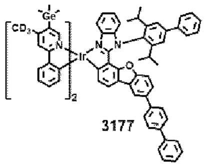
3177
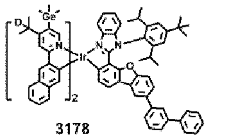
3178
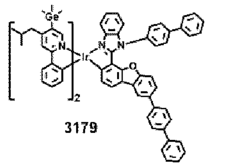
3179
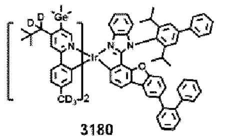
3180

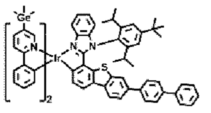
3181
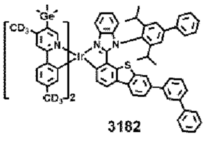
3182
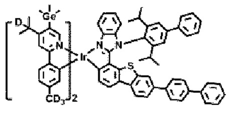
3183
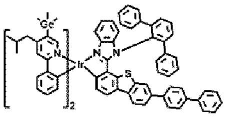
3184
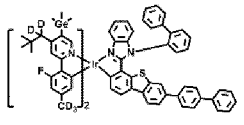
3185

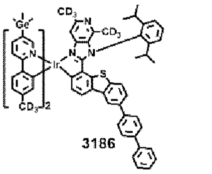
3186
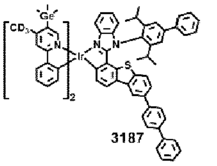
3187
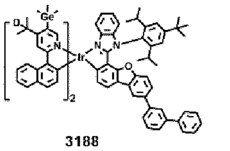
3188
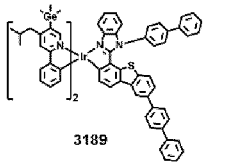
3189
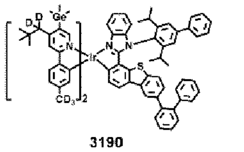
3190

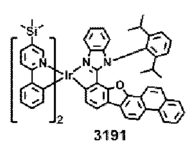 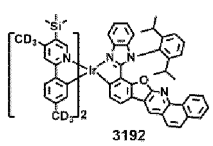 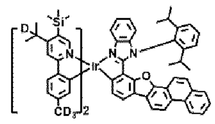 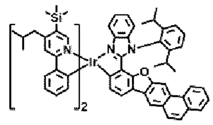 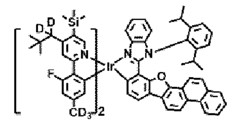

3191 3192 3193 3194 3195

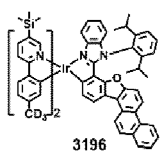 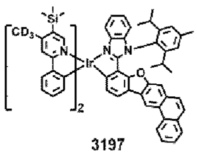 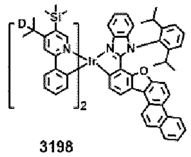 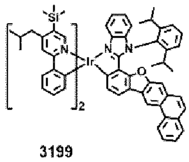 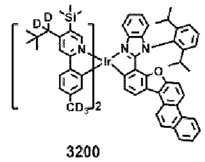

3196 3197 3198 3199 3200

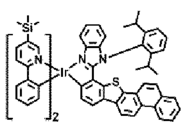 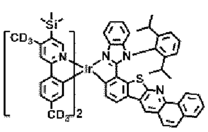 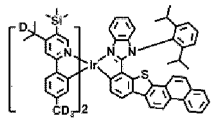 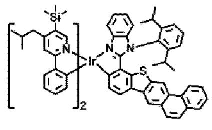 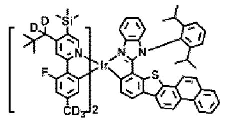

3201 3202 3203 3204 3205

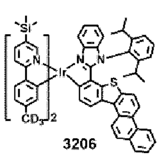 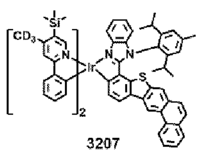 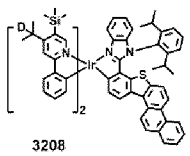 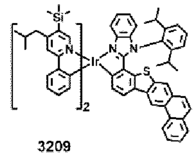 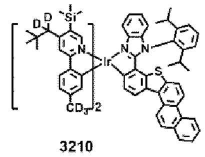

3206 3207 3208 3209 3210

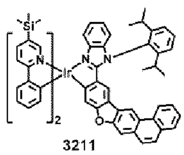 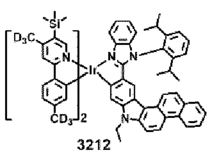 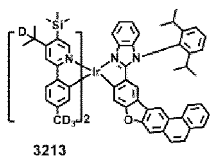 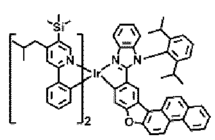 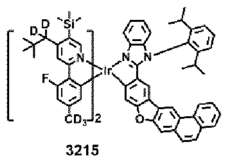

3211 3212 3213 3214 3215

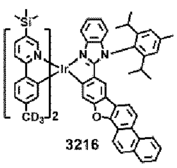 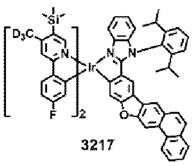 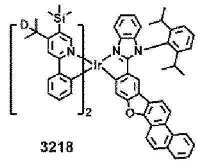 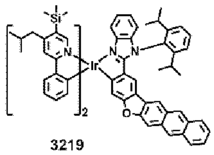 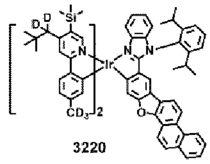

3216 3217 3218 3219 3220

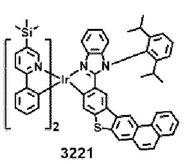 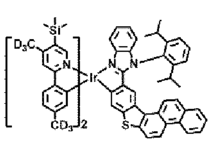 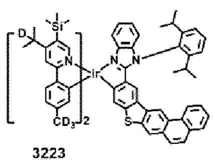 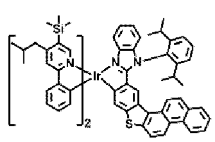 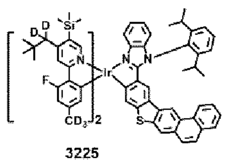

3221 3222 3223 3224 3225

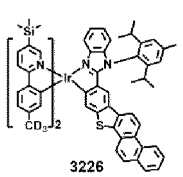 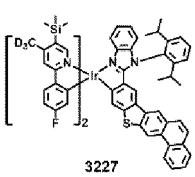 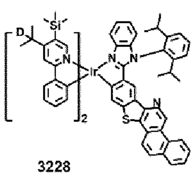 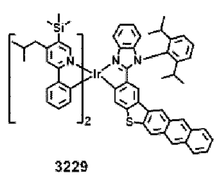 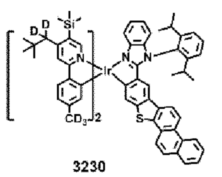

3226 3227 3228 3229 3230

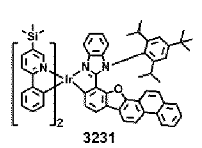
3231
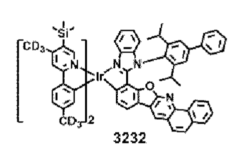
3232
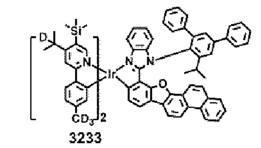
3233
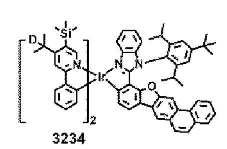
3234
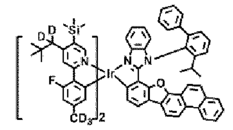
3235

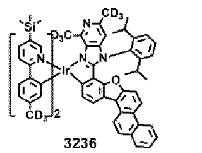
3236
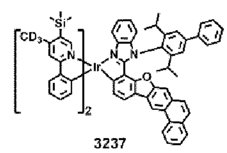
3237
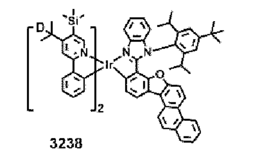
3238
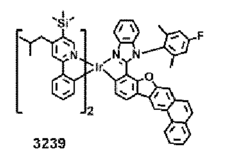
3239
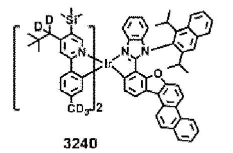
3240

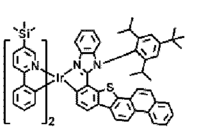
3241
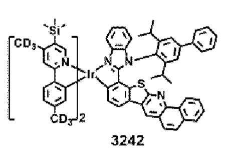
3242
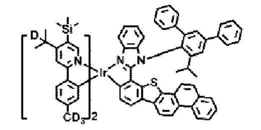
3243
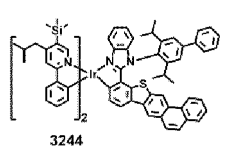
3244
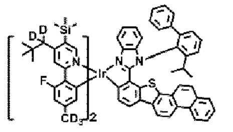
3245

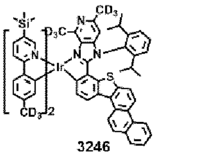
3246
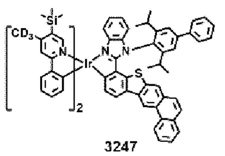
3247
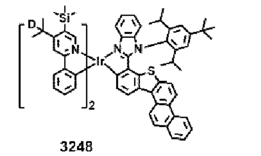
3248
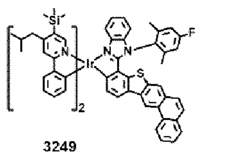
3249
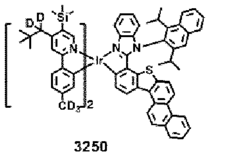
3250

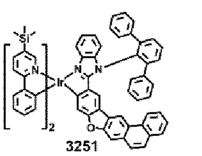
3251
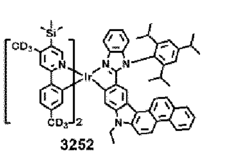
3252
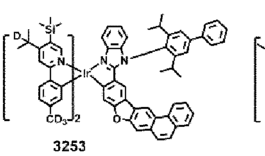
3253
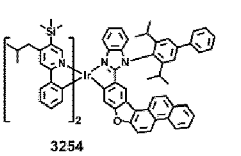
3254
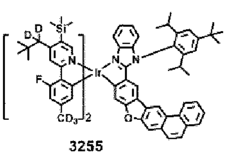
3255

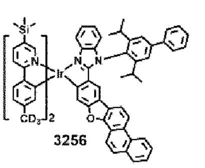
3256
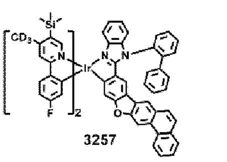
3257
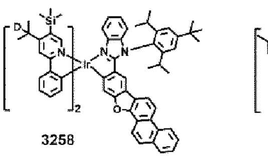
3258
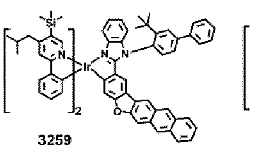
3259
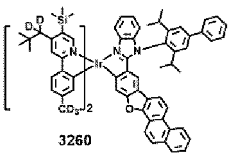
3260

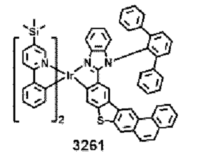
3261
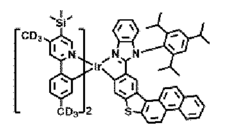
3262
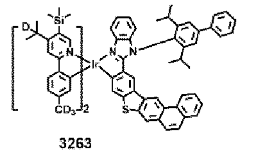
3263
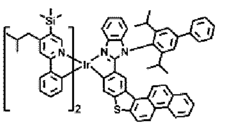
3264
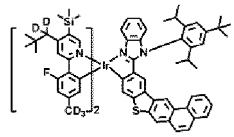
3265

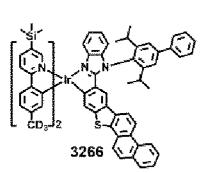
3266
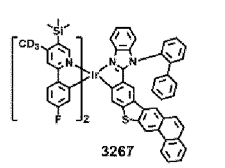
3267
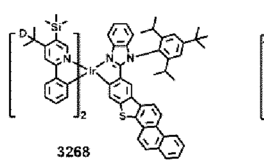
3268
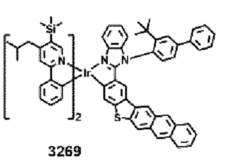
3269
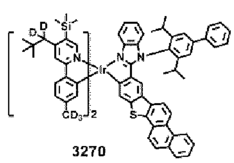
3270

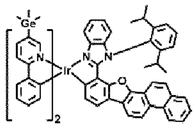 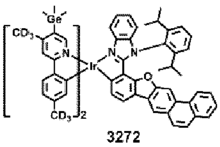 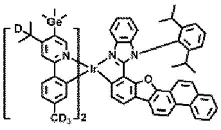 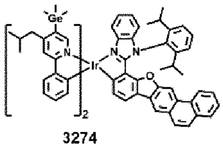 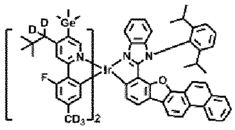

3271 3272 3273 3274 3275

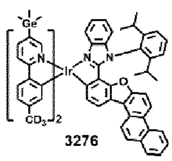 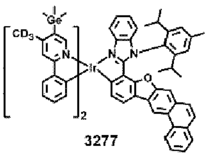 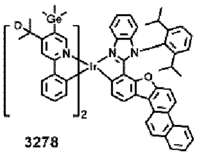 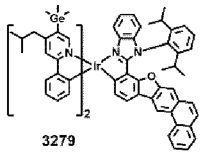 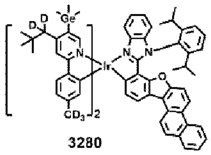

3276 3277 3278 3279 3280

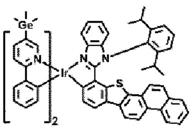 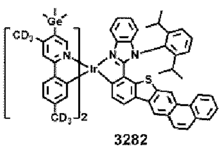 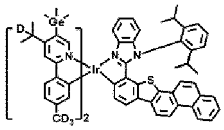 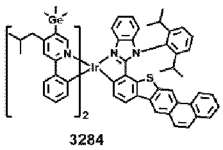 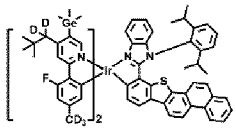

3281 3282 3283 3284 3285

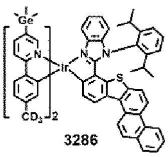 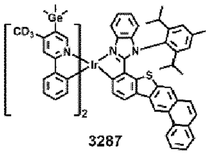 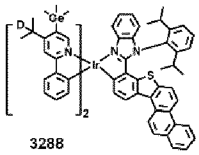 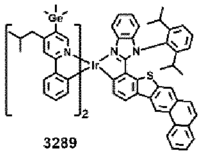 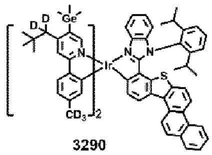

3286 3287 3288 3289 3290

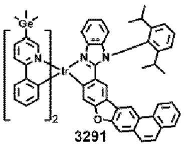 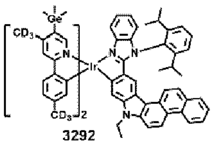 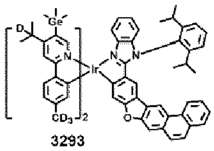 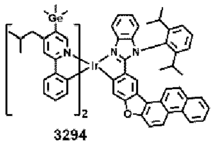 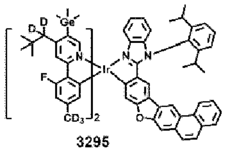

3291 3292 3293 3294 3295

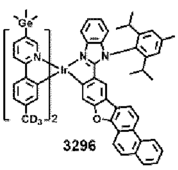 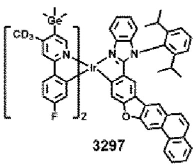 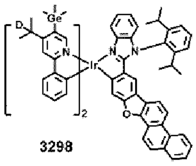 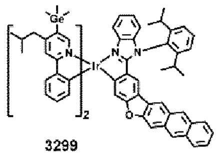 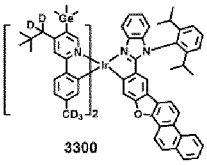

3296 3297 3298 3299 3300

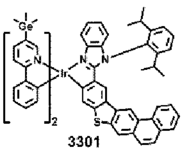 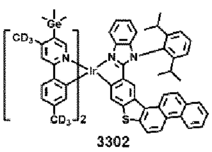 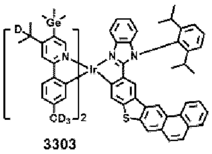 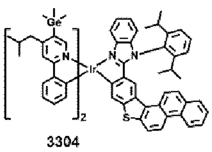 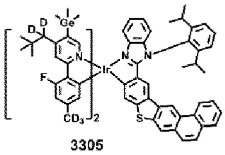

3301 3302 3303 3304 3305

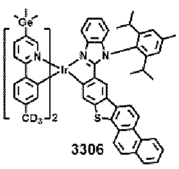 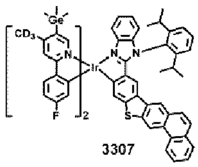 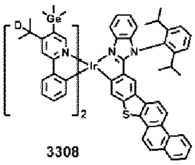 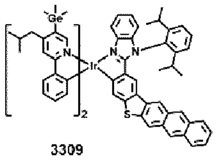 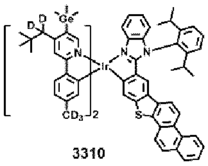

3306 3307 3308 3309 3310

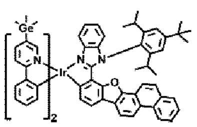
3311
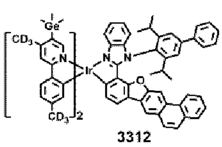
3312
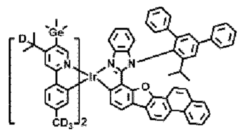
3313
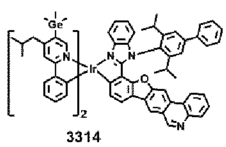
3314
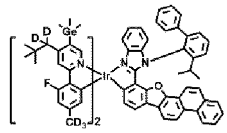
3315

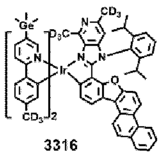
3316
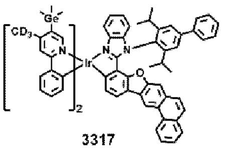
3317
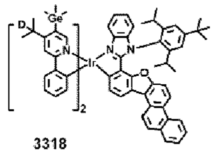
3318
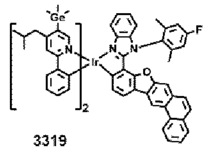
3319
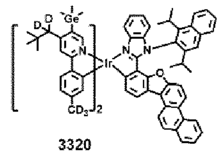
3320

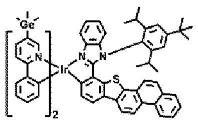
3321
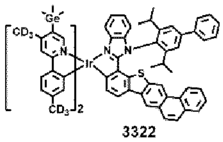
3322
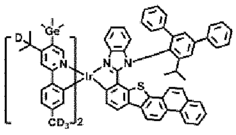
3323
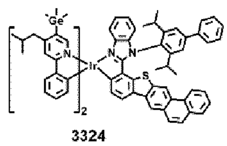
3324
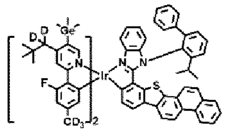
3325

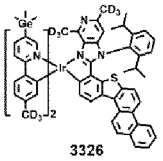
3326
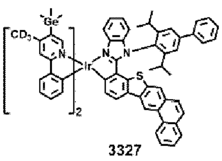
3327
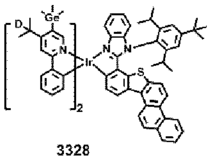
3328
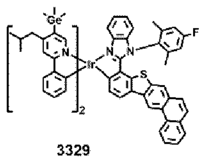
3329
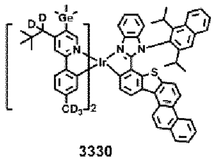
3330

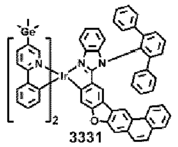
3331
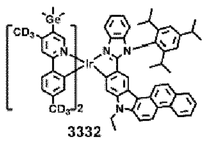
3332
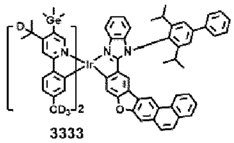
3333
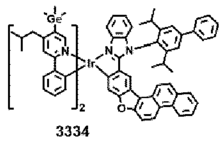
3334
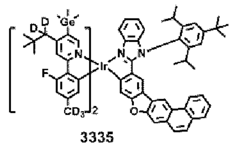
3335

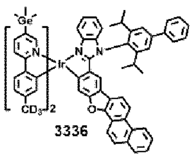
3336
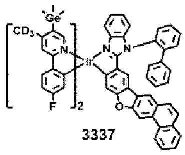
3337
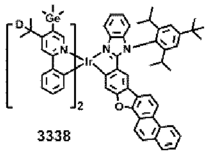
3338
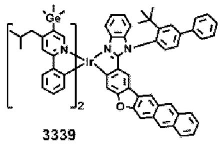
3339
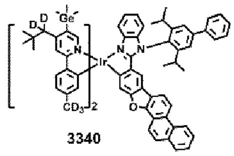
3340

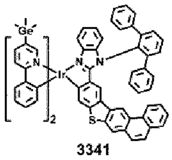
3341
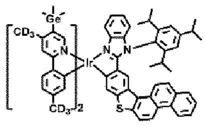
3342
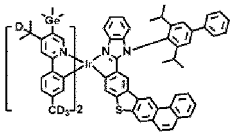
3343
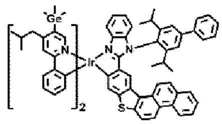
3344
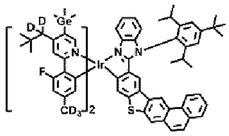
3345

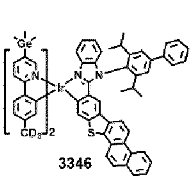
3346
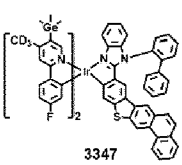
3347
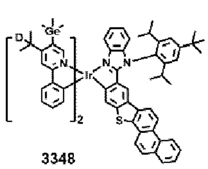
3348
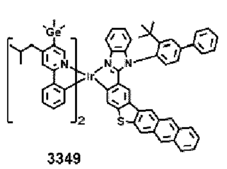
3349
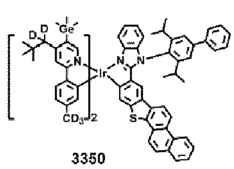
3350

Group 2-2

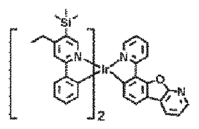
1

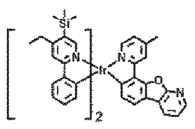
2

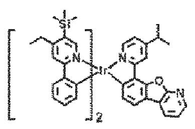
3

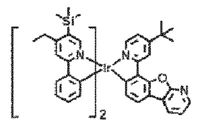
4

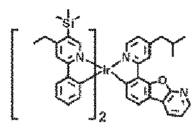
5

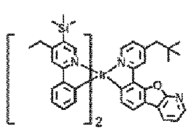
6

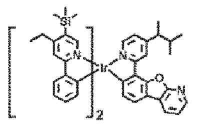
7

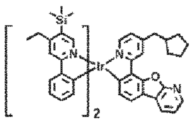
8

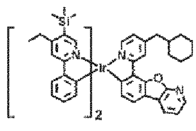
9

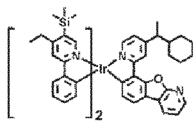
10

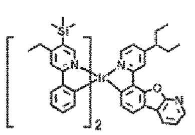
11

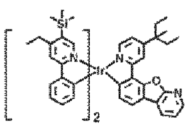
12

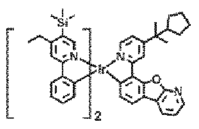
13

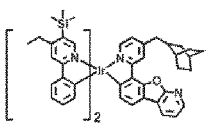
14

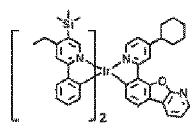
15

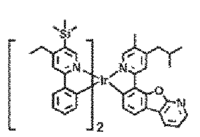
16

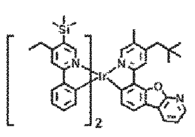
17

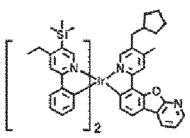
18

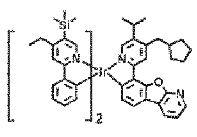
19

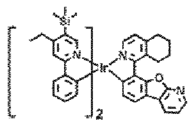
20

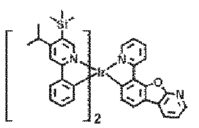
21

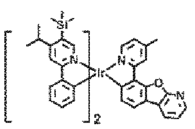
22

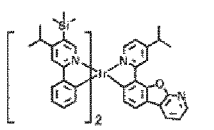
23

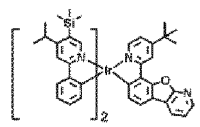
24

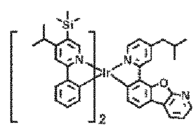
25

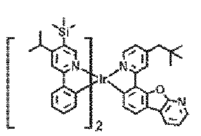
26

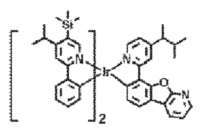
27

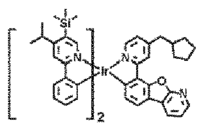
28

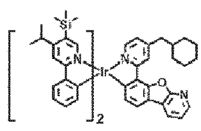
29

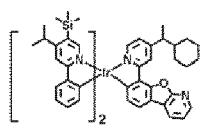
30

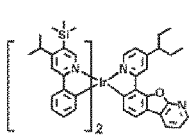
31

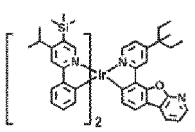
32

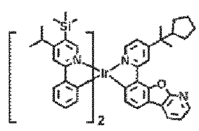
33

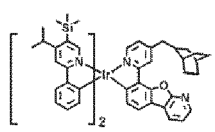
34

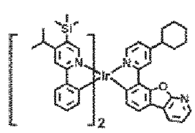
35

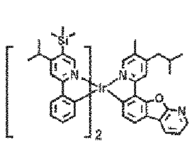
36

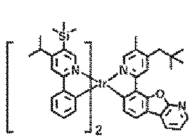
37

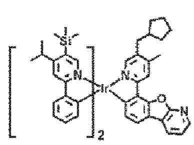
38

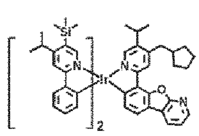
39

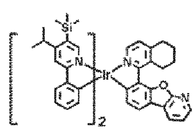
40

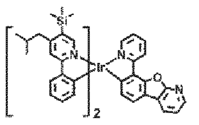
41
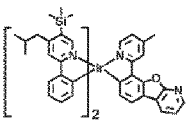
42
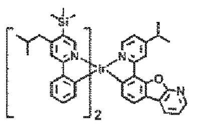
43
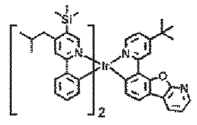
44
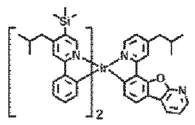
45

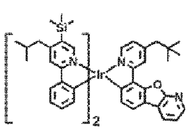
46
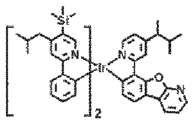
47
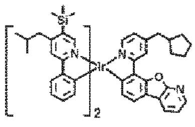
48
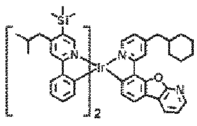
49
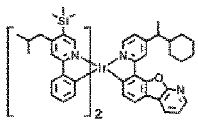
50

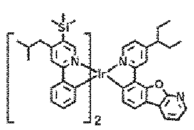
51
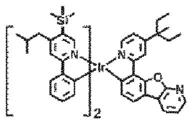
52
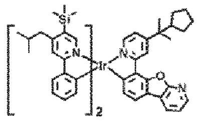
53
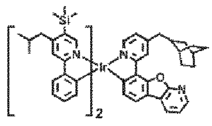
54
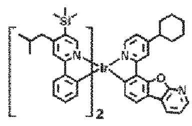
55

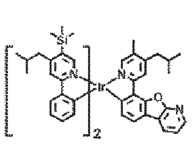
56
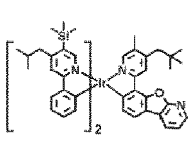
57
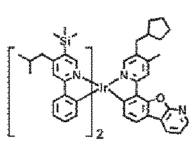
58
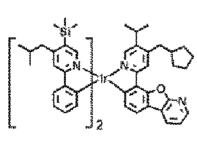
59
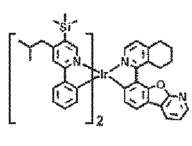
60

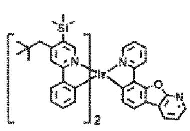
61
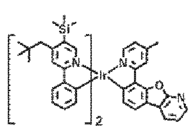
62
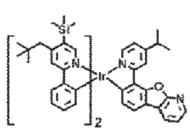
63
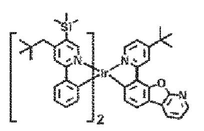
64
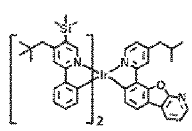
65

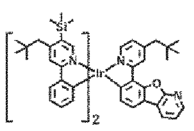
66
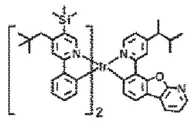
67
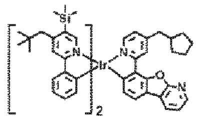
68
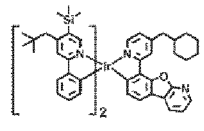
69
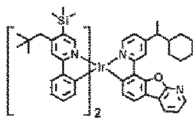
70

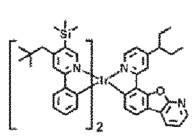
71
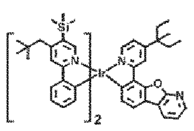
72
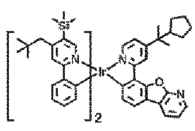
73
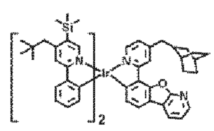
74
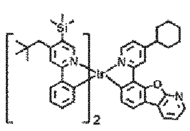
75

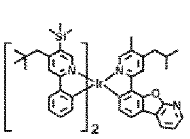
76
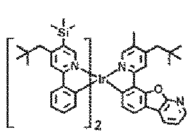
77
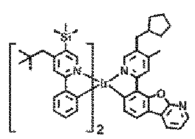
78
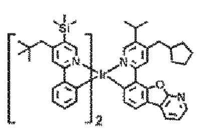
79
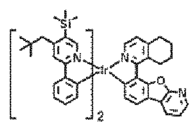
80

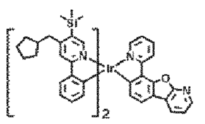 81 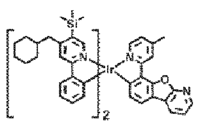 82 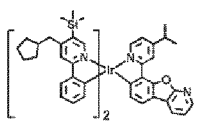 83 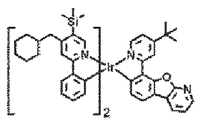 84 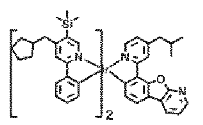 85

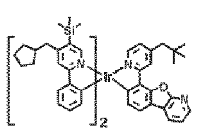 86 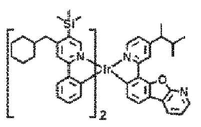 87 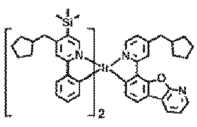 88 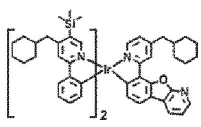 89 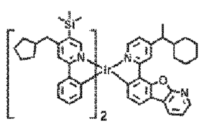 90

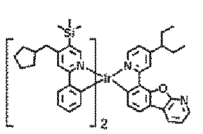 91 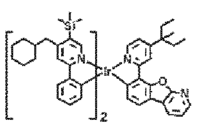 92 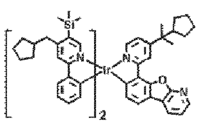 93 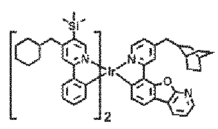 94 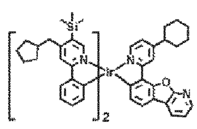 95

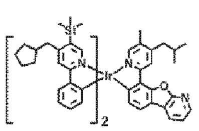 96 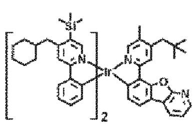 97 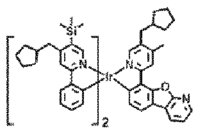 98 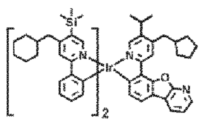 99 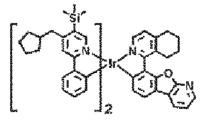 100

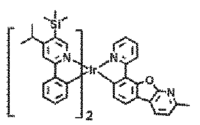 101 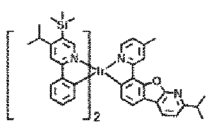 102 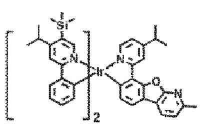 103 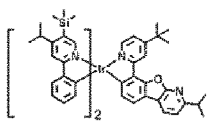 104 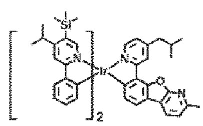 105

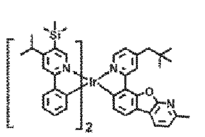 106 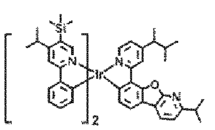 107 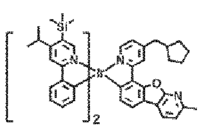 108 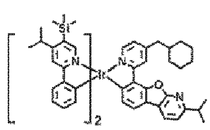 109 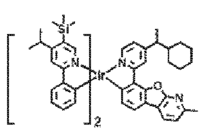 110

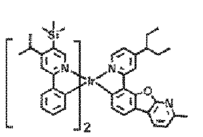 111 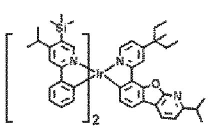 112 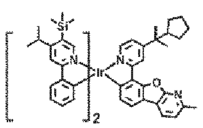 113 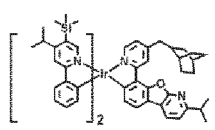 114 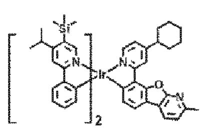 115

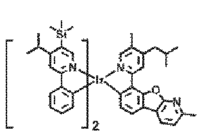 116 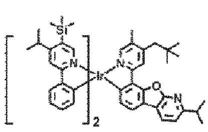 117 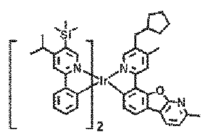 118 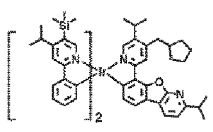 119 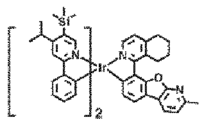 120

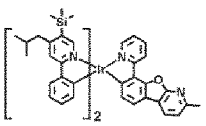
121

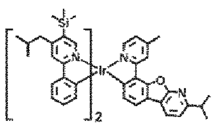
122

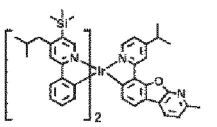
123

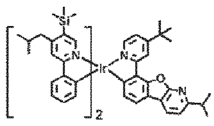
124

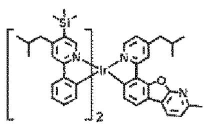
125

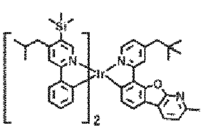
126

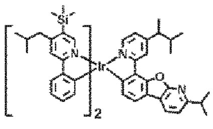
127

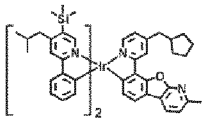
128

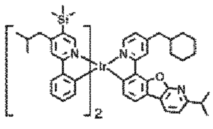
129

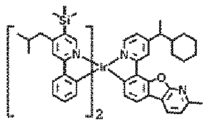
130

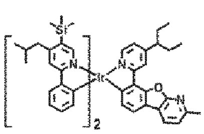
131

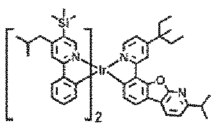
132

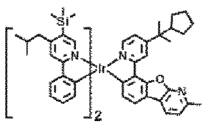
133

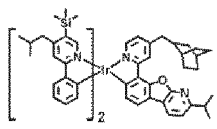
134

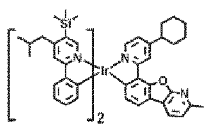
135

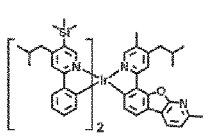
136

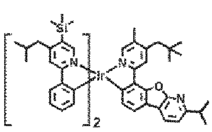
137

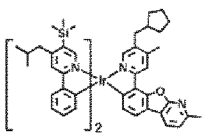
138

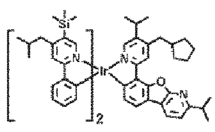
139

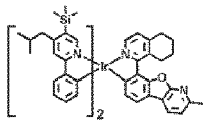
140

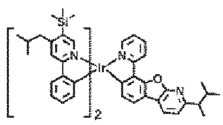
141

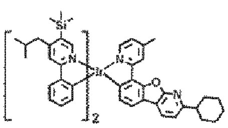
142

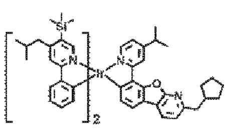
143

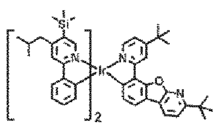
144

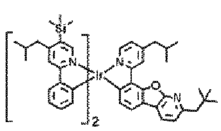
145

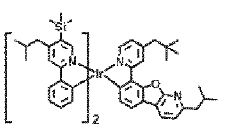
146

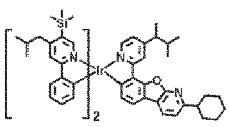
147

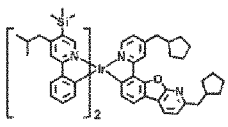
148

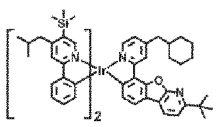
149

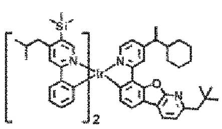
150

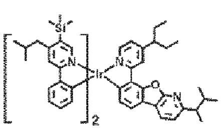
151

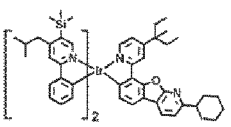
152

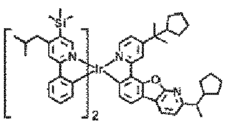
153

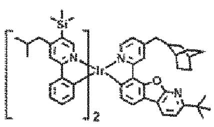
154

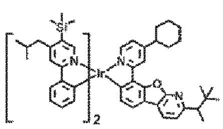
155

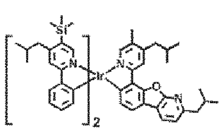
156

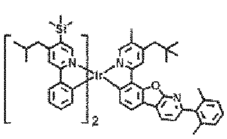
157

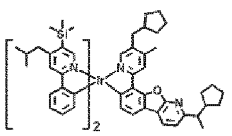
158

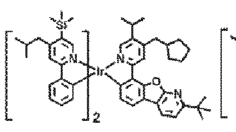
159

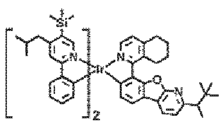
160

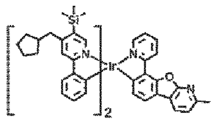
161
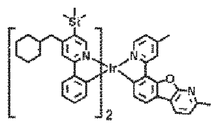
162
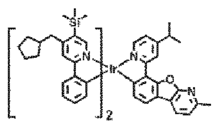
163
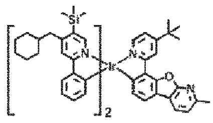
164
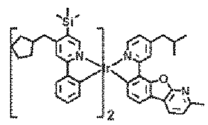
165

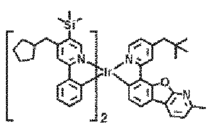
166
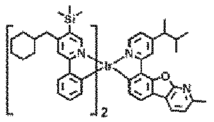
167
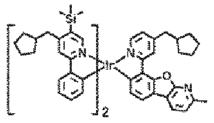
168
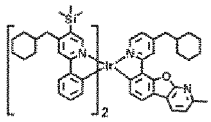
169
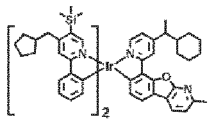
170

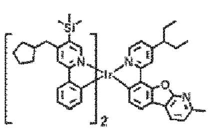
171
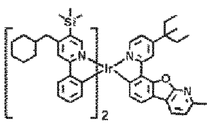
172
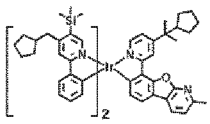
173
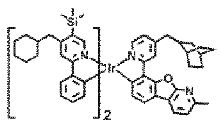
174
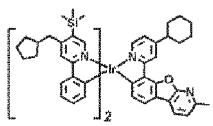
175

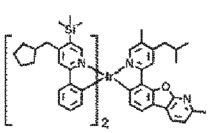
176
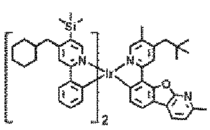
177
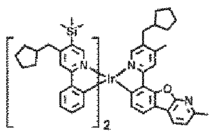
178
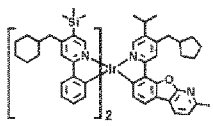
179
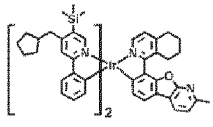
180

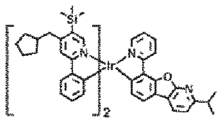
181
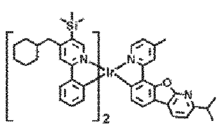
182
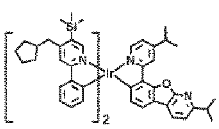
183
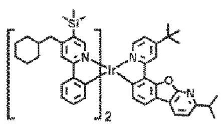
184
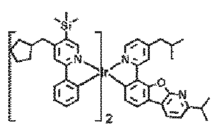
185

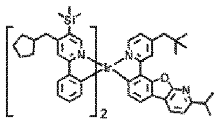
186
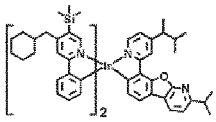
187
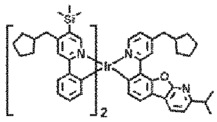
188
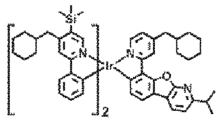
189
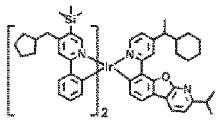
190

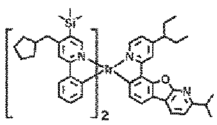
191
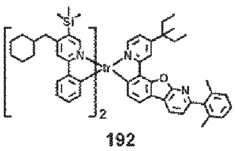
192
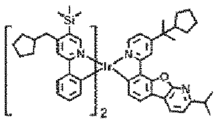
193
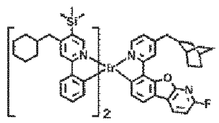
194
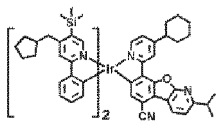
195

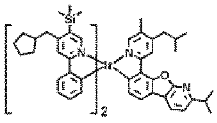
196
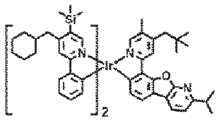
197
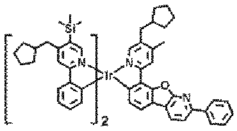
198
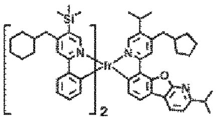
199
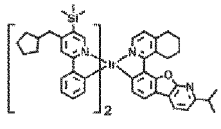
200

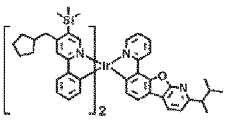
201
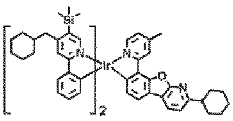
202
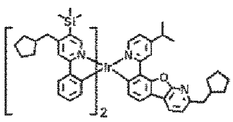
203
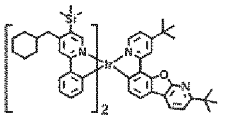
204
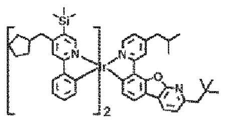
205

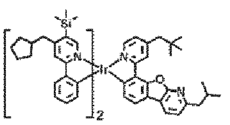
206
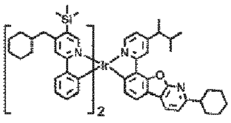
207
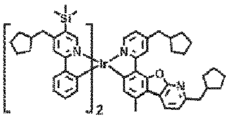
208
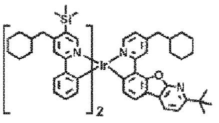
209
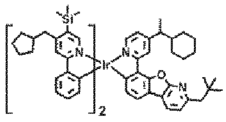
210

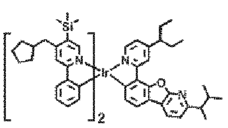
211
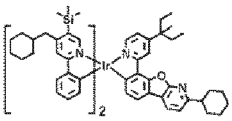
212
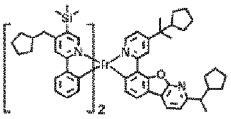
213
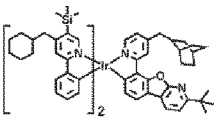
214
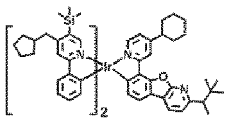
215

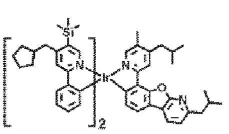
216
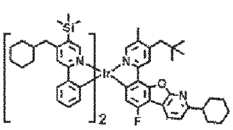
217
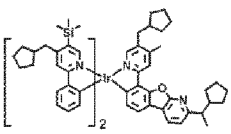
218
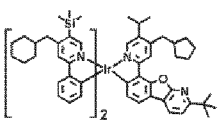
219
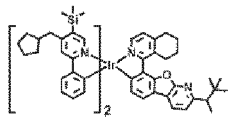
220

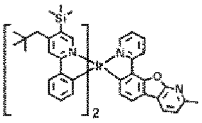
221
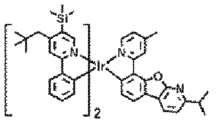
222
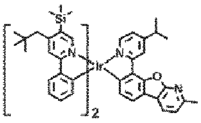
223
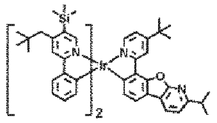
224
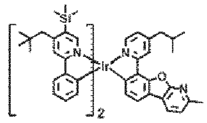
225

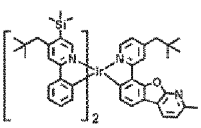
226
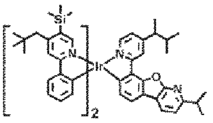
227
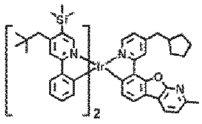
228
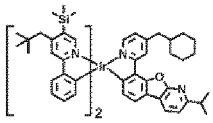
229
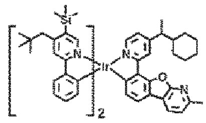
230

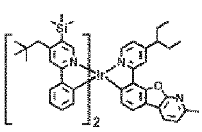
231
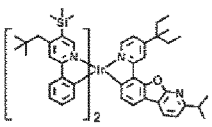
232
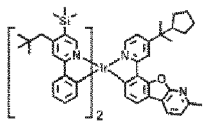
233
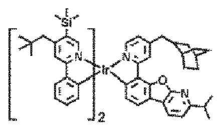
234
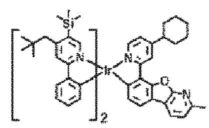
235

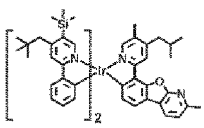
236
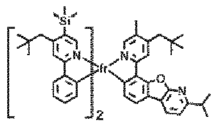
237
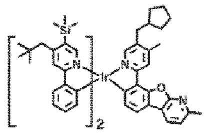
238
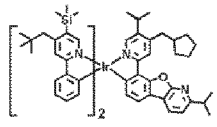
239
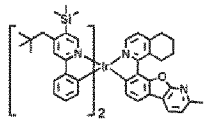
240

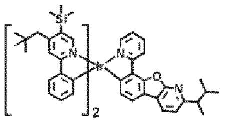
241
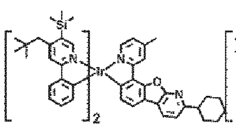
242
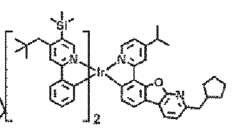
243
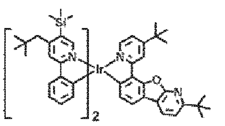
244
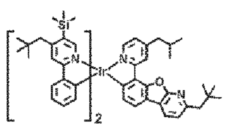
245

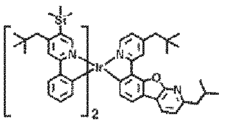
246
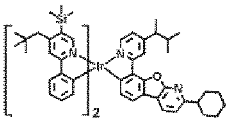
247
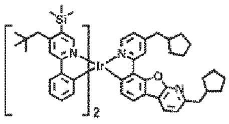
248
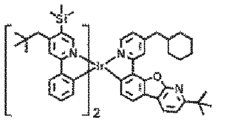
249
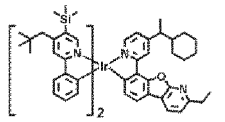
250

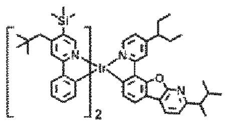
251
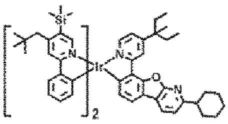
252
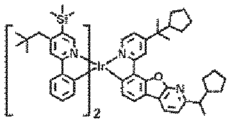
253
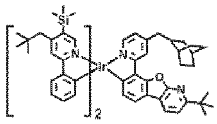
254
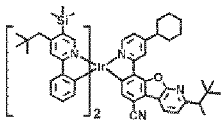
255

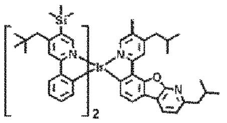
256
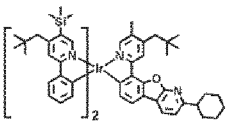
257
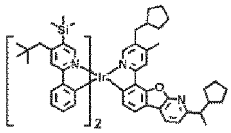
258
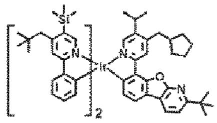
259
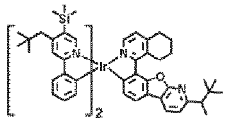
260

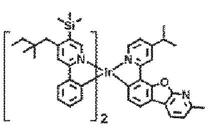
261
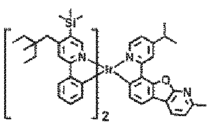
262
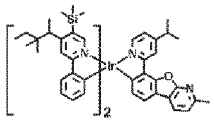
263
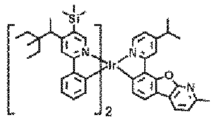
264
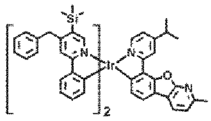
265

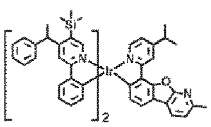
266
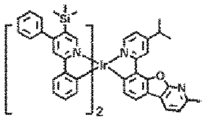
267
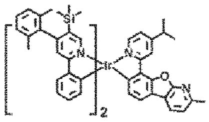
268
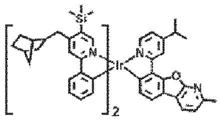
269
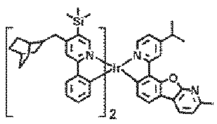
270

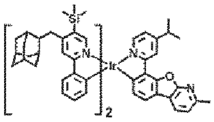
271
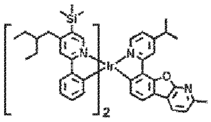
272
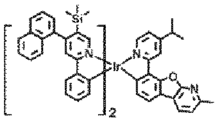
273
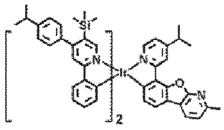
274
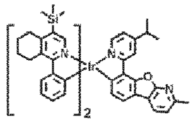
275

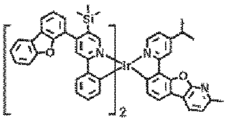
276
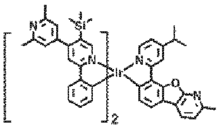
277
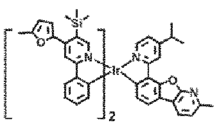
278
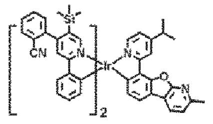
279
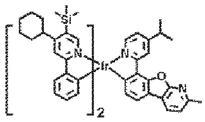
280

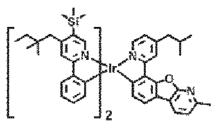
281
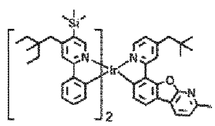
282
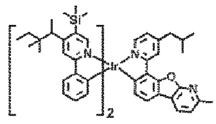
283
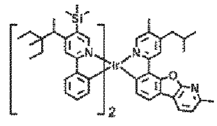
284
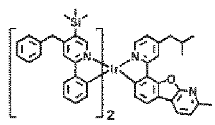
285
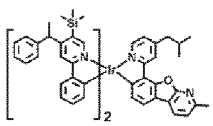
286
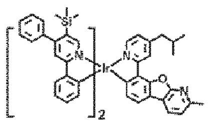
287
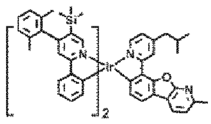
288
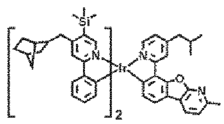
289
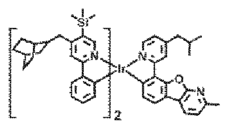
290
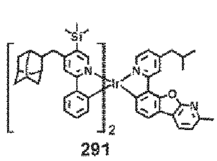
291
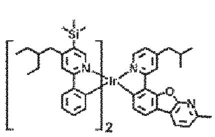
292
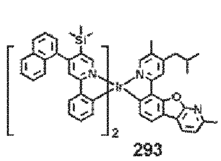
293
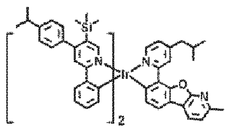
294
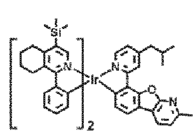
295
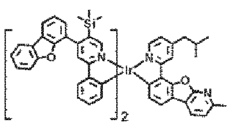
296
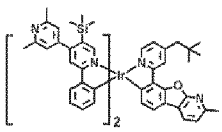
297
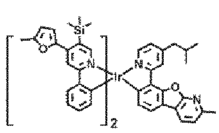
298
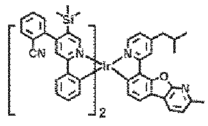
299
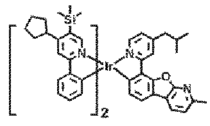
300
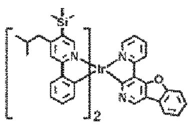
301
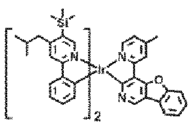
302
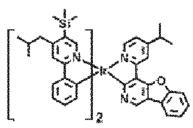
303
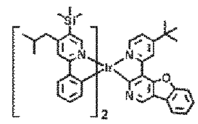
304
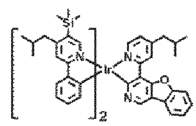
305
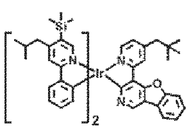
306
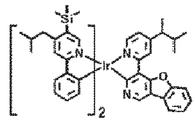
307
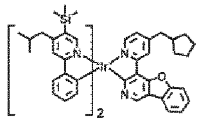
308
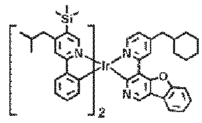
309
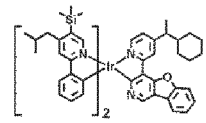
310
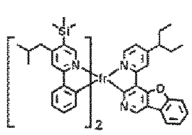
311
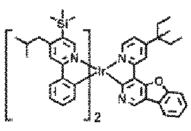
312
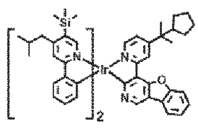
313
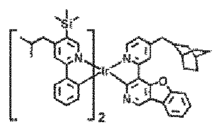
314
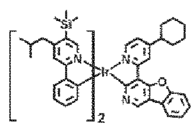
315
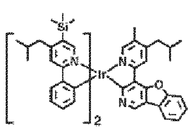
316
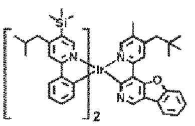
317
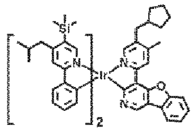
318
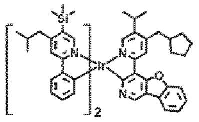
319
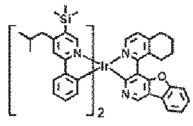
320

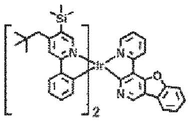
321
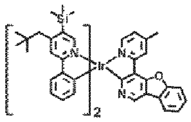
322
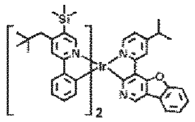
323
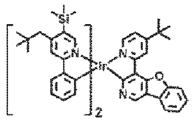
324
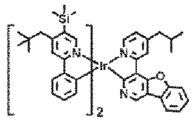
325
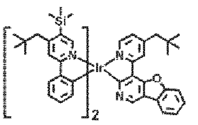
326
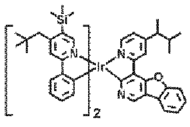
327
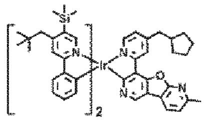
328
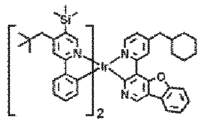
329
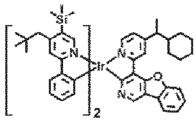
330
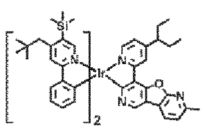
331
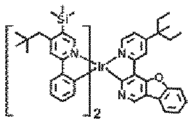
332
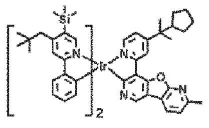
333
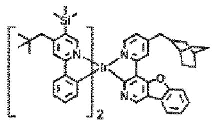
334
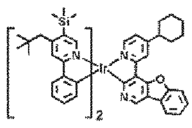
335
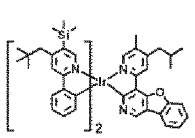
336
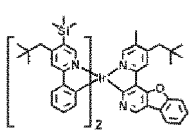
337
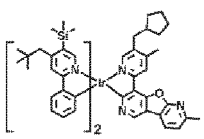
338
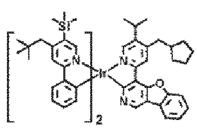
339
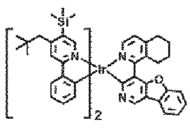
340
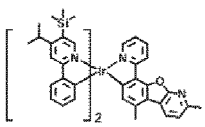
341
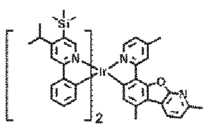
342
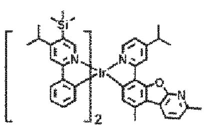
343
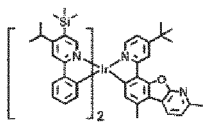
344
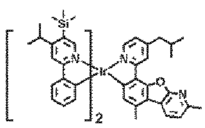
345
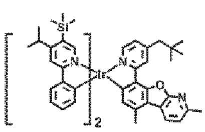
346
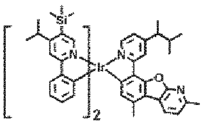
347
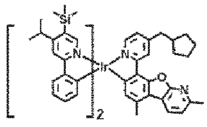
348
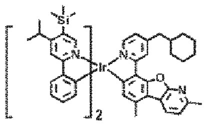
349
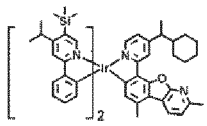
350
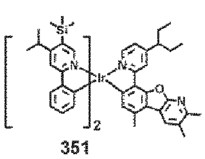
351
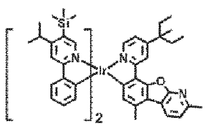
352
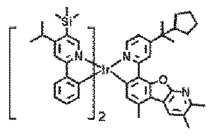
353
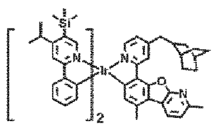
354
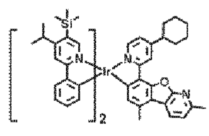
355
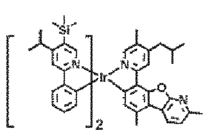
356
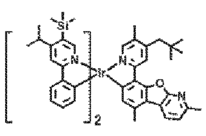
357
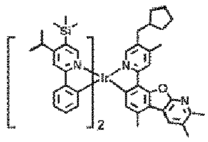
358
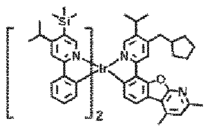
359
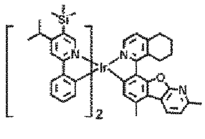
360

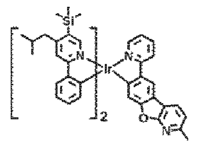
361
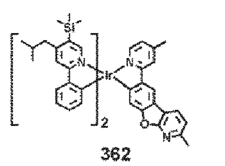
362
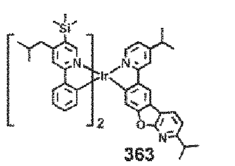
363
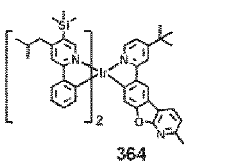
364
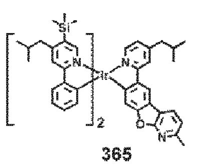
365
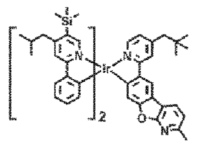
366
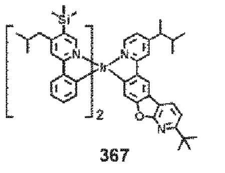
367
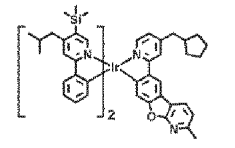
368
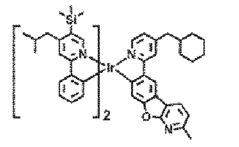
369
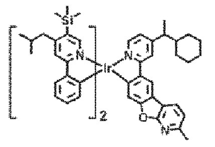
370
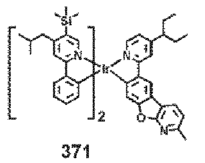
371
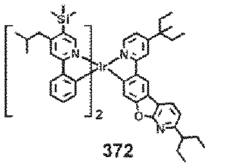
372
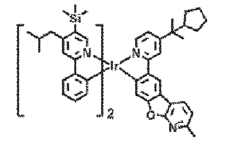
373
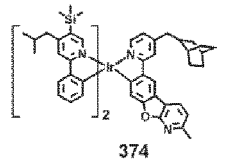
374
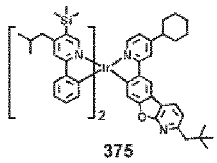
375
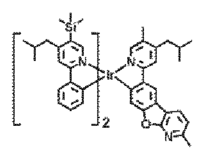
376
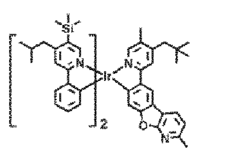
377
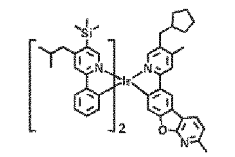
378
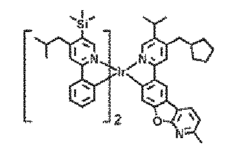
379
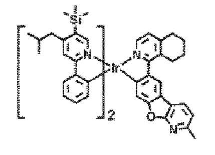
380
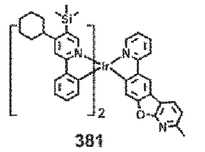
381
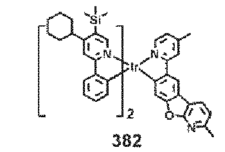
382
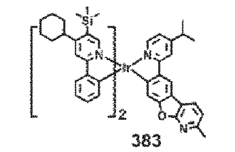
383
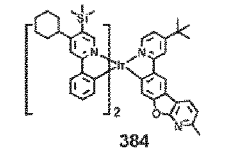
384
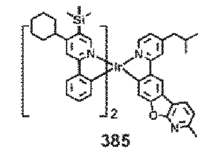
385
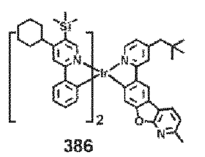
386
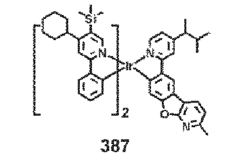
387
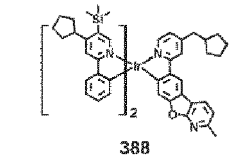
388
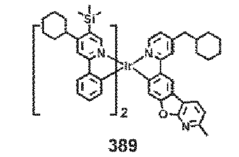
389
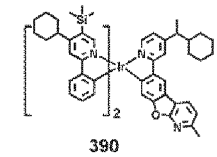
390
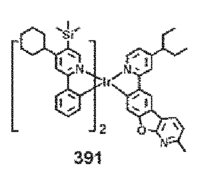
391
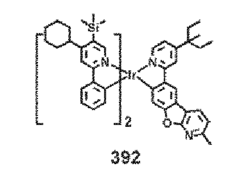
392
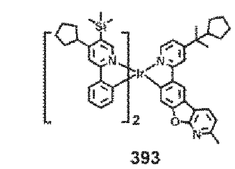
393
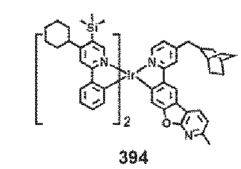
394
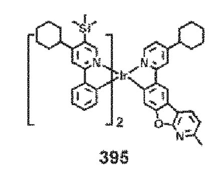
395
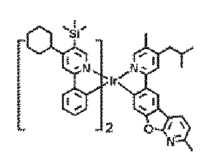
396
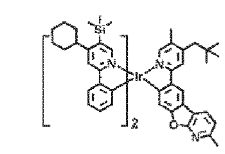
397
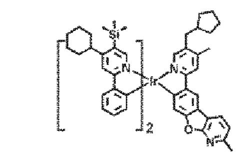
398
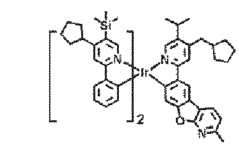
399
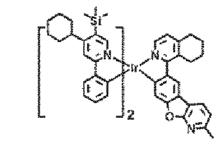
400

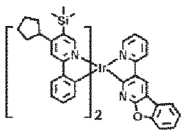
401
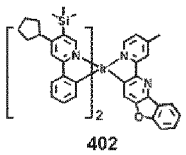
402
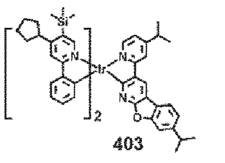
403
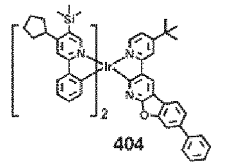
404
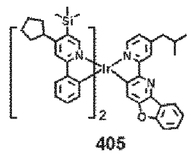
405

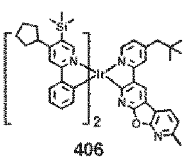
406
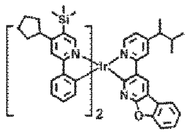
407
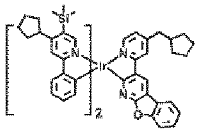
408
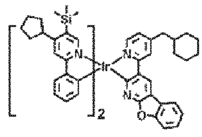
409
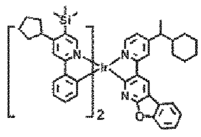
410

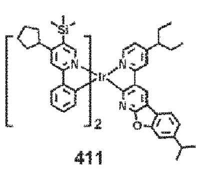
411
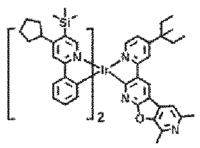
412
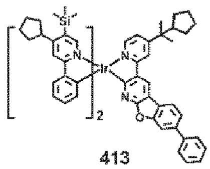
413
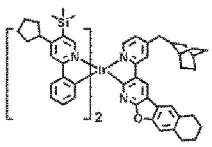
414
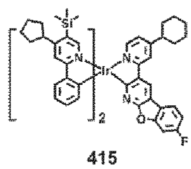
415

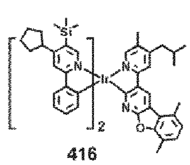
416
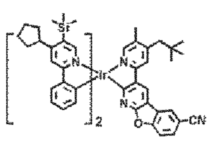
417
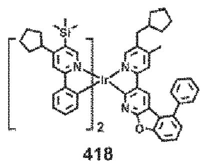
418
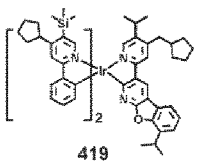
419
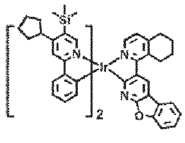
420

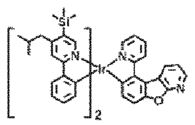
421
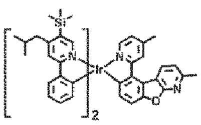
422
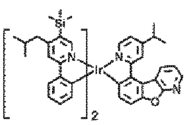
423
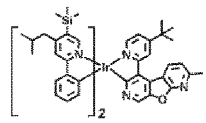
424
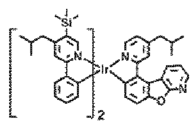
425

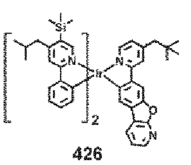
426
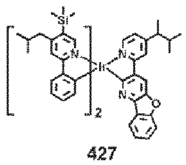
427
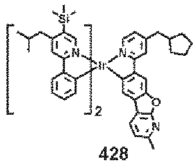
428
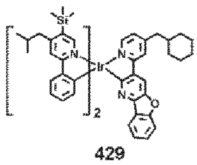
429
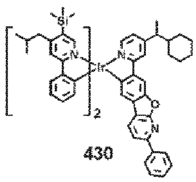
430

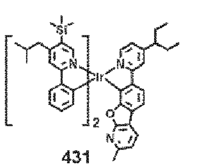
431
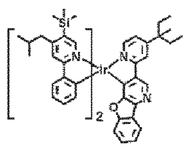
432
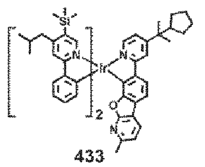
433
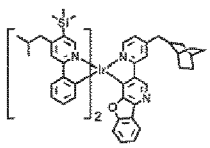
434
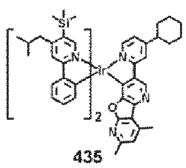
435

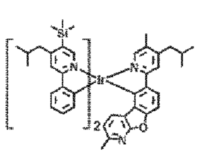
436
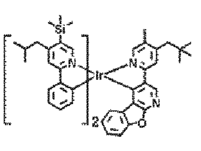
437
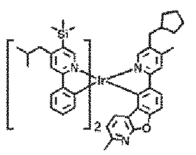
438
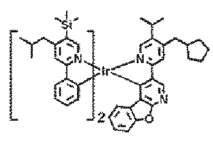
439
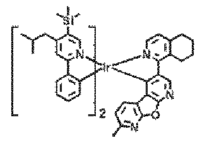
440

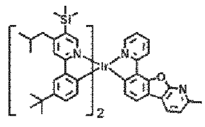
441
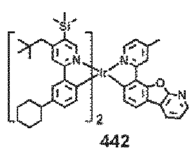
442
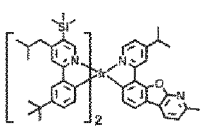
443
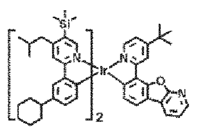
444
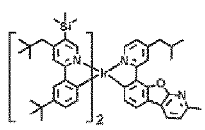
445

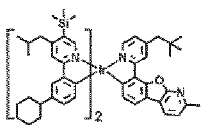
446
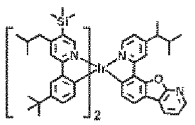
447
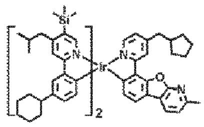
448
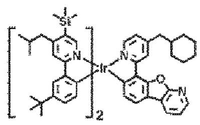
449
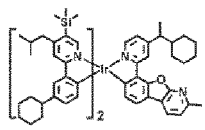
450

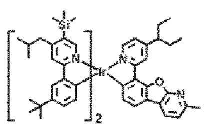
451
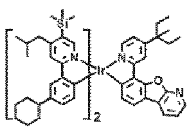
452
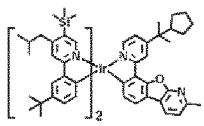
453
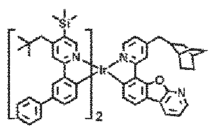
454
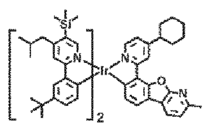
455

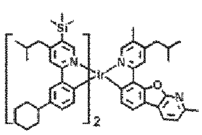
456
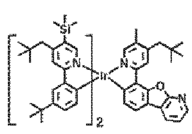
457
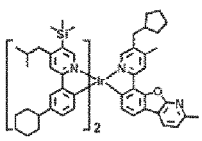
458
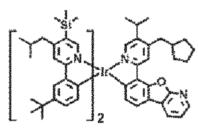
459
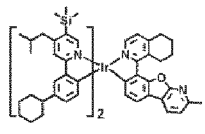
460

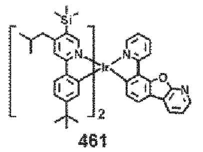
461
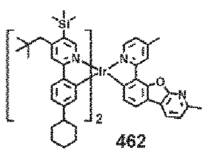
462
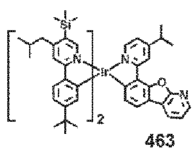
463
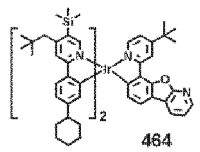
464
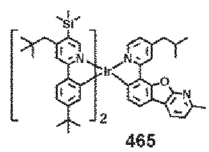
465

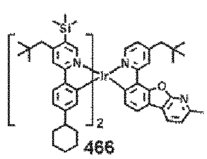
466
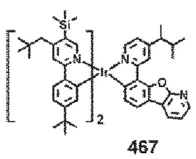
467
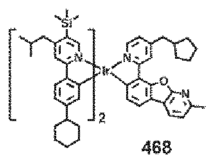
468
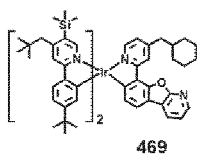
469
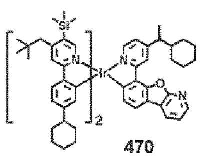
470

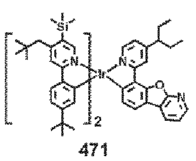
471
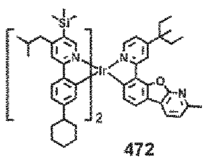
472
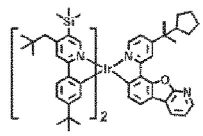
473
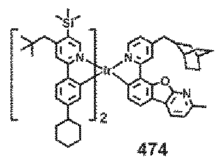
474
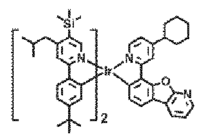
475

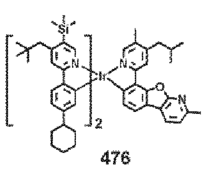
476
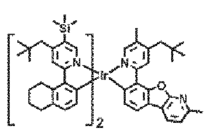
477
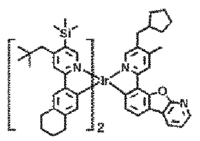
478
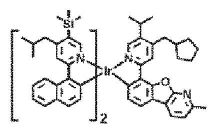
479
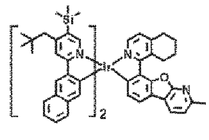
480

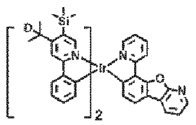
481
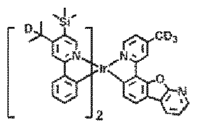
482
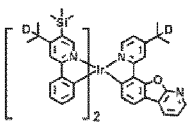
483
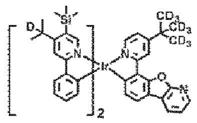
484
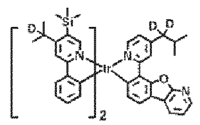
485

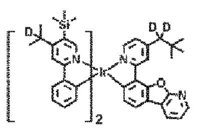
486
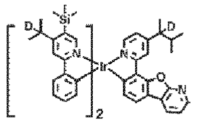
487
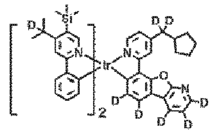
488
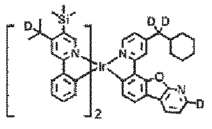
489
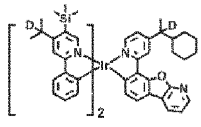
490

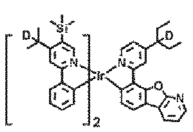
491
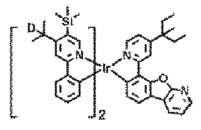
492
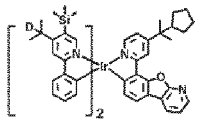
493
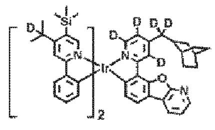
494
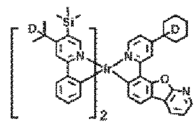
495

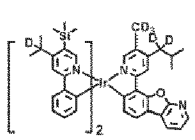
496
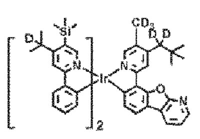
497
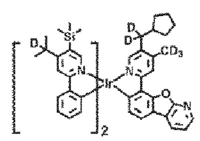
498
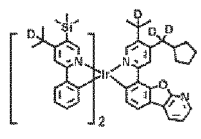
499
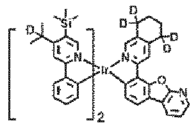
500

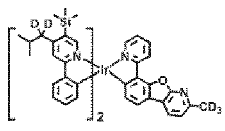
501
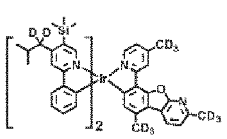
502
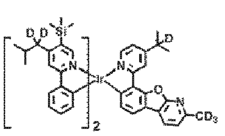
503
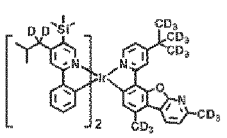
504
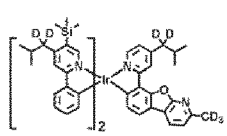
505

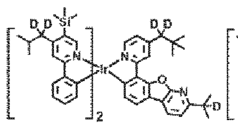
506
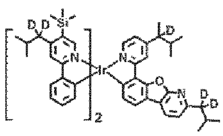
507
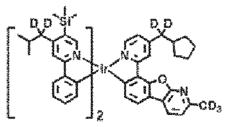
508
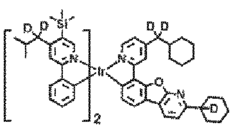
509
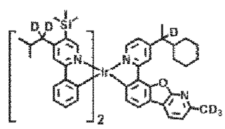
510

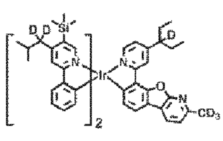
511
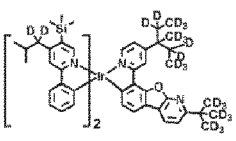
512
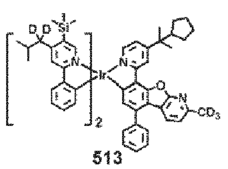
513
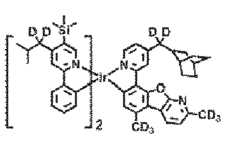
514
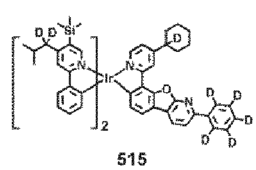
515

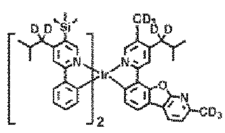
516
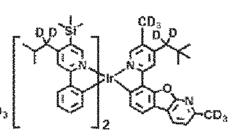
517
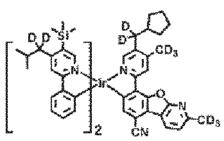
518
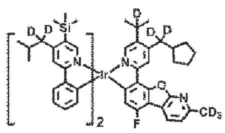
519
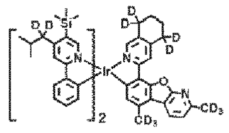
520

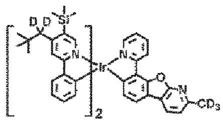
521
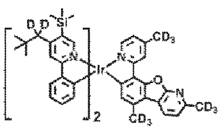
522
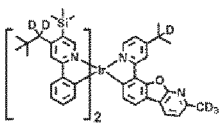
523
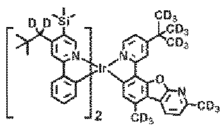
524
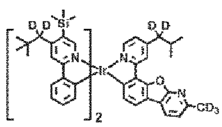
525

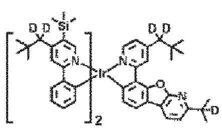
526
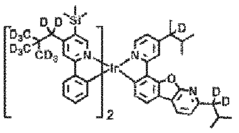
527
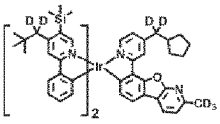
528
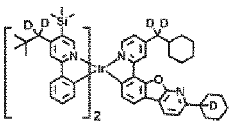
529
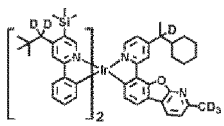
530

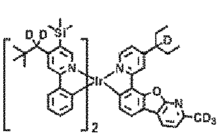
531
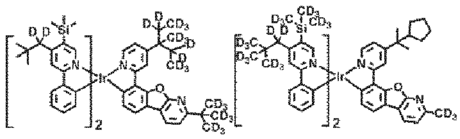
532
533
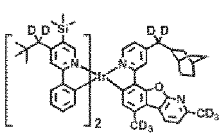
534
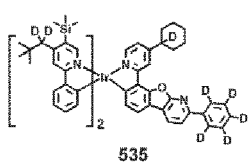
535

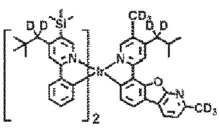
536
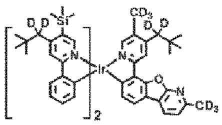
537
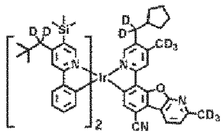
538
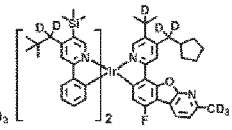
539
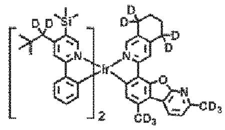
540

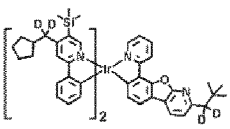
541
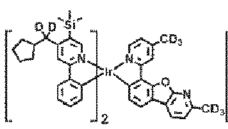
542
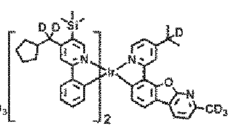
543
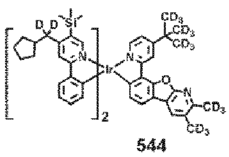
544
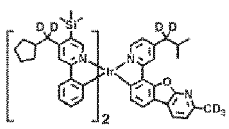
545

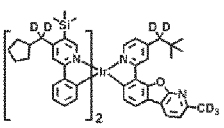
546
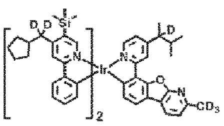
547
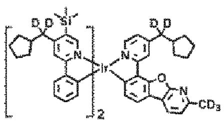
548
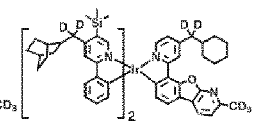
549
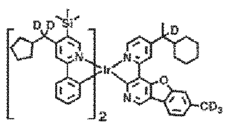
550

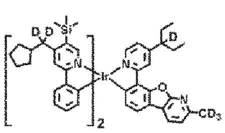
551
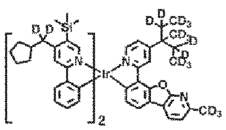
552
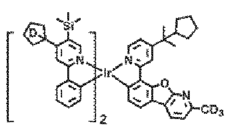
553
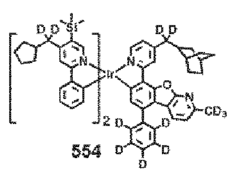
554
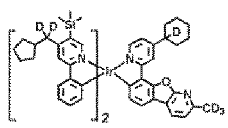
555

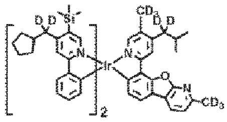
556
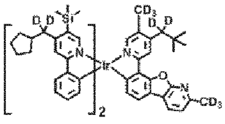
557
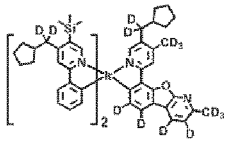
558
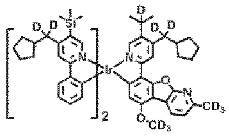
559
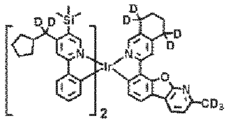
560

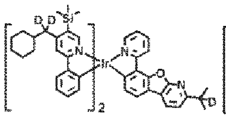
561

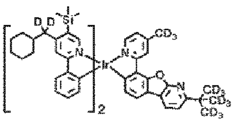
562

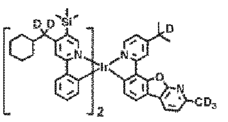
563

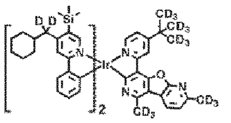
564

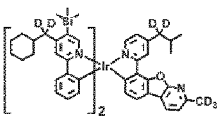
565

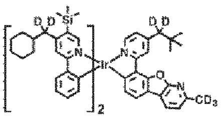
566

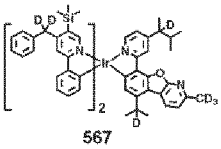
567

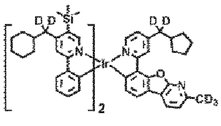
568

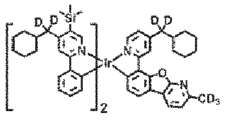
569

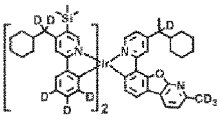
570

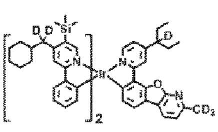
571

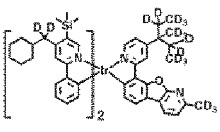
572

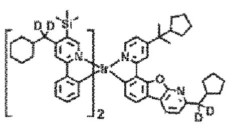
573

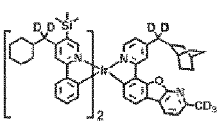
574

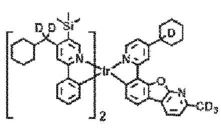
575

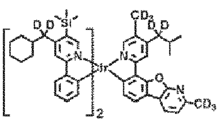
576

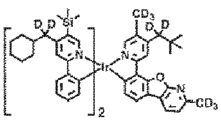
577

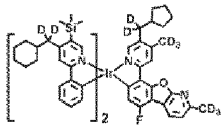
578

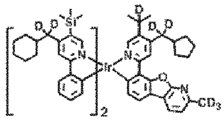
579

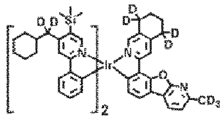
580

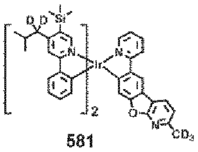
581

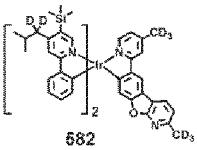
582

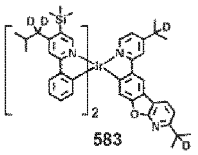
583

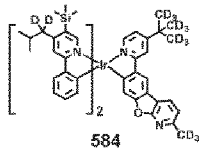
584

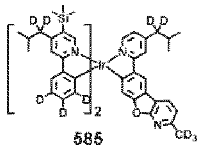
585

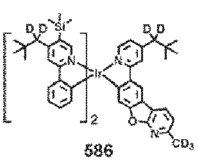
586

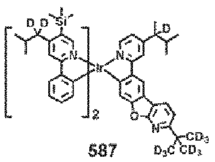
587

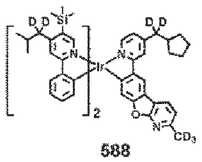
588

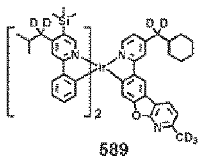
589

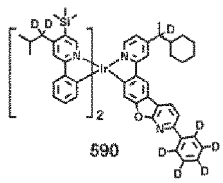
590

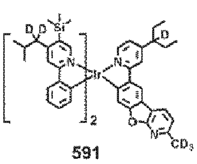
591

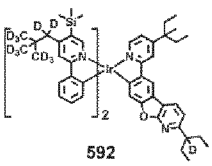
592

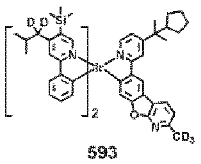
593

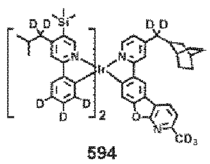
594

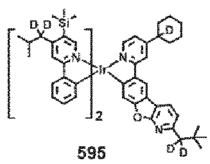
595

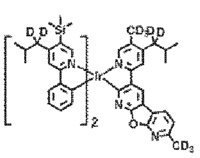
596

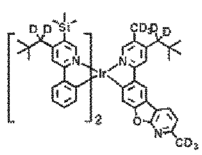
597

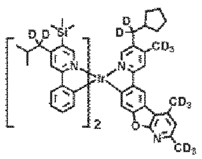
598

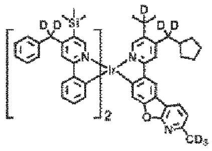
599

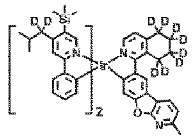
600

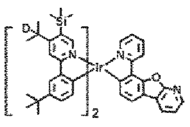
601
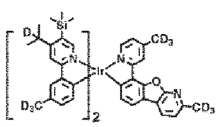
602
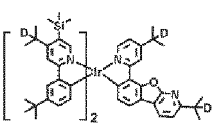
603
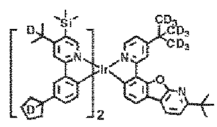
604
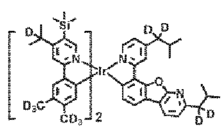
605
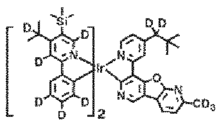
606
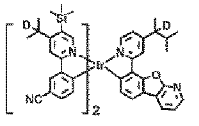
607
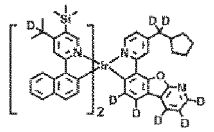
608
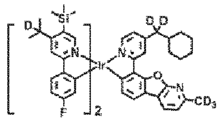
609
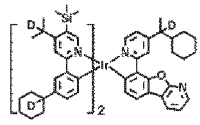
610
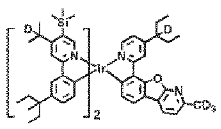
611
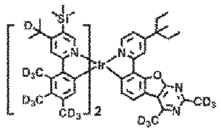
612
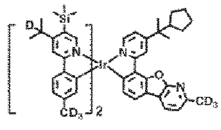
613
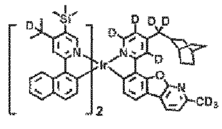
614
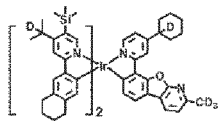
615
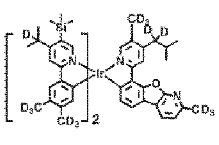
616
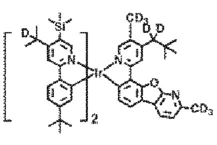
617
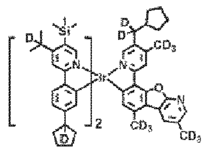
618
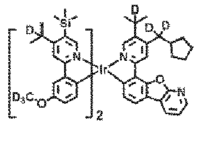
619
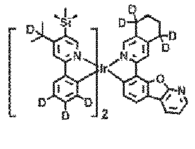
620
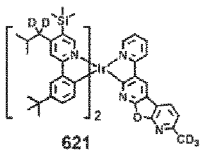
621
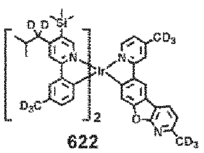
622
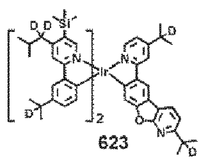
623
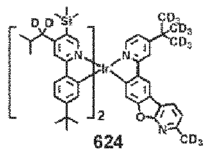
624
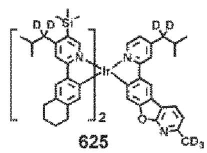
625
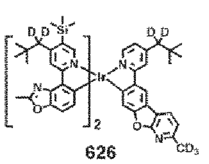
626
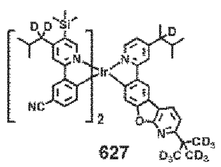
627
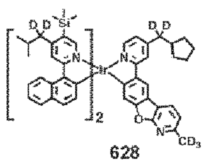
628
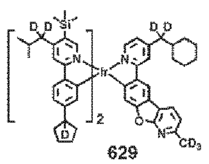
629
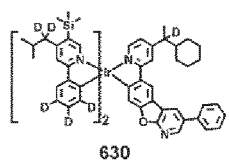
630
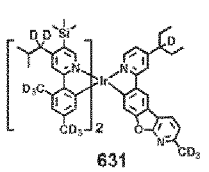
631
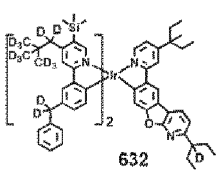
632
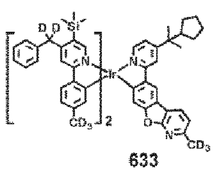
633
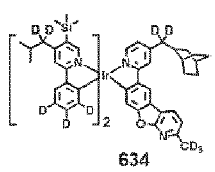
634
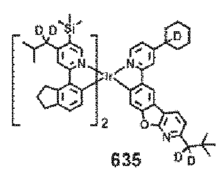
635
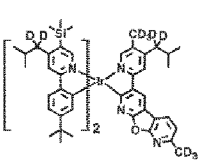
636
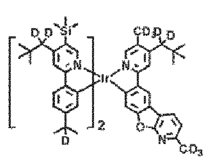
637
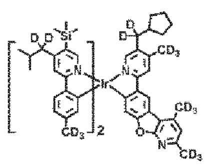
638
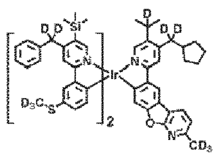
639
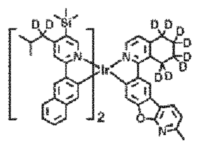
640

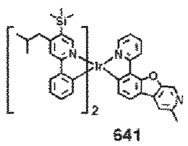
641

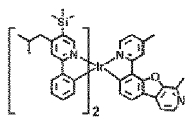
642

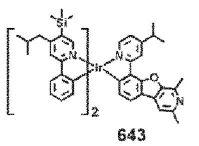
643

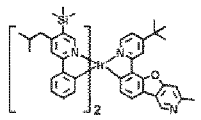
644

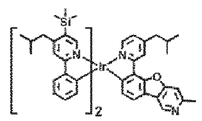
645

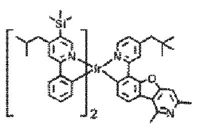
646

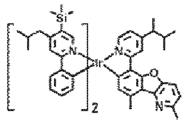
647

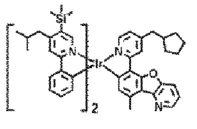
648

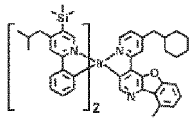
649

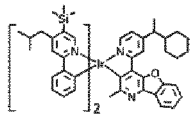
650

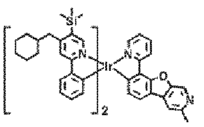
651

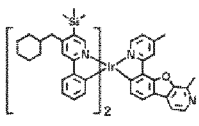
652

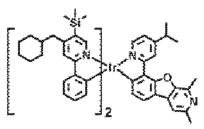
653

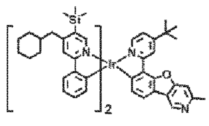
654

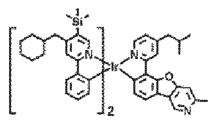
655

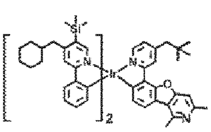
656

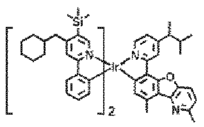
657

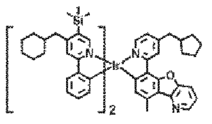
658

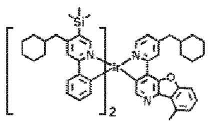
659

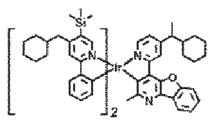
660

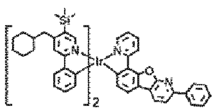
661

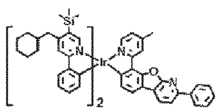
662

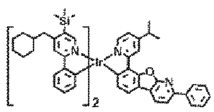
663

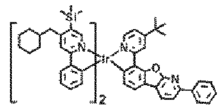
664

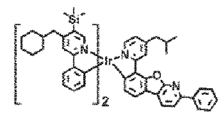
665

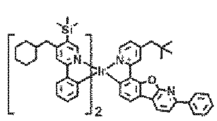
666

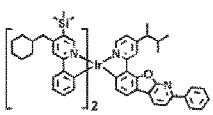
667

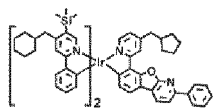
668

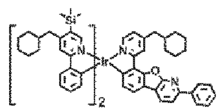
669

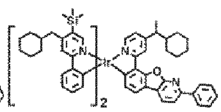
670

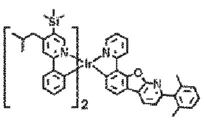
671

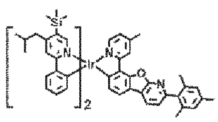
672

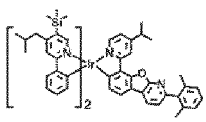
673

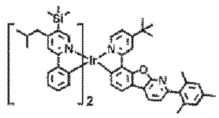
674

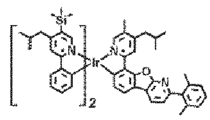
675

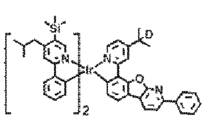
676

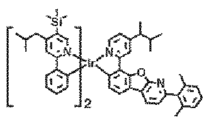
677

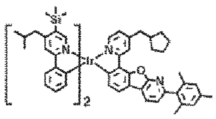
678

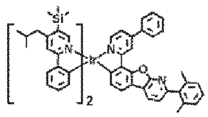
679

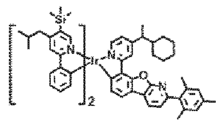
680

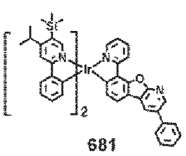
681

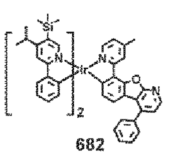
682

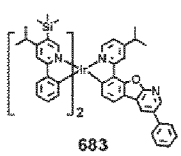
683

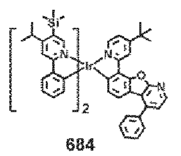
684

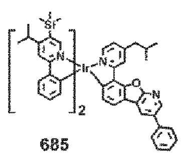
685

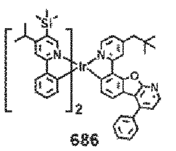
686

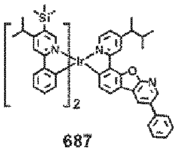
687

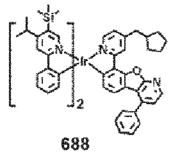
688

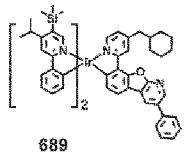
689

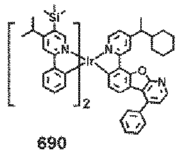
690

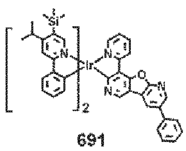
691

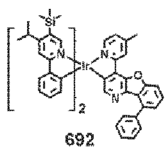
692

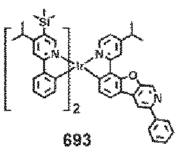
693

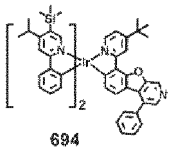
694

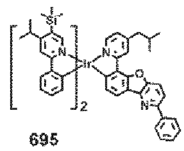
695

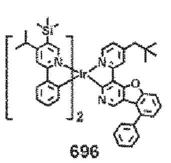
696

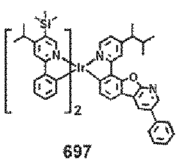
697

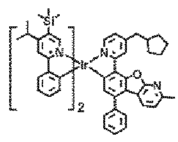
698

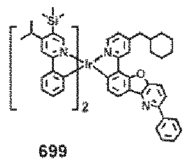
699

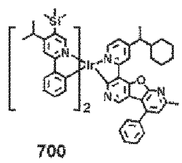
700

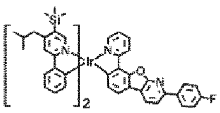
701

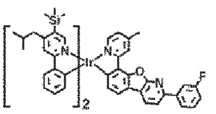
702

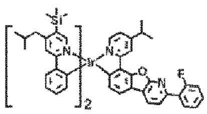
703

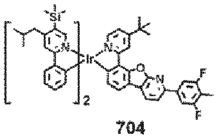
704

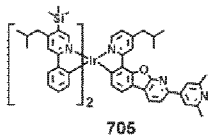
705

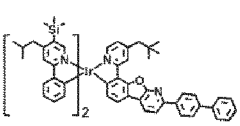
706

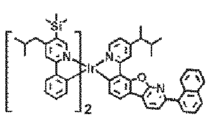
707

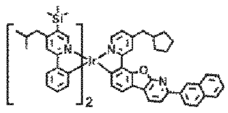
708

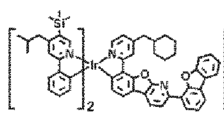
709

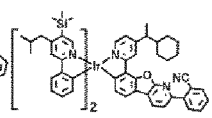
710

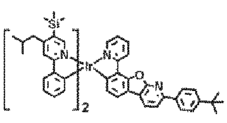
711

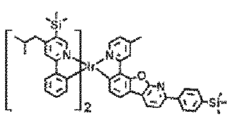
712

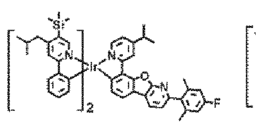
713

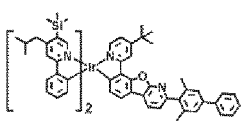
714

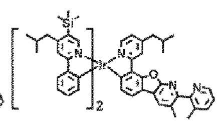
715

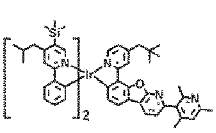
716

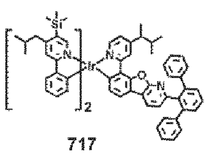
717

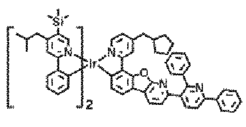
718

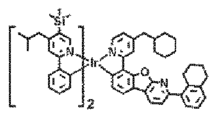
719

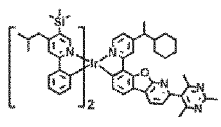
720

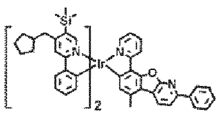
721
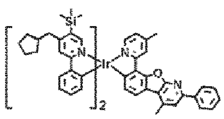
722
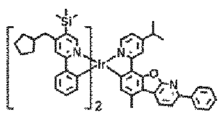
723
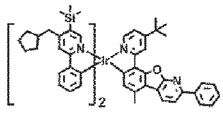
724
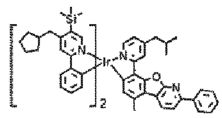
725

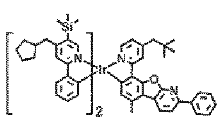
726
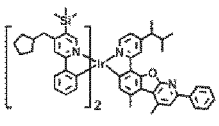
727
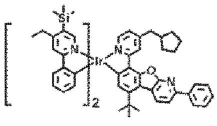
728
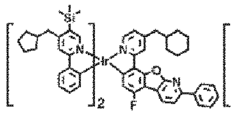
729
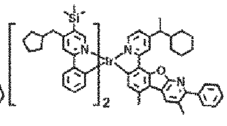
730

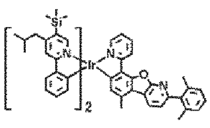
731
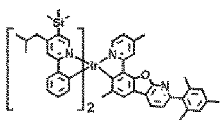
732
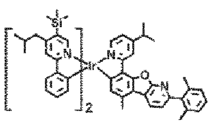
733
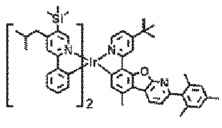
734
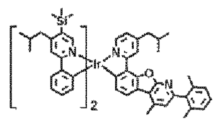
735

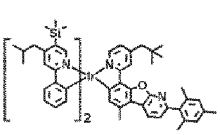
736
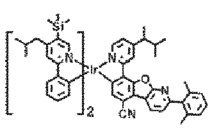
737
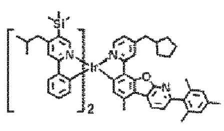
738
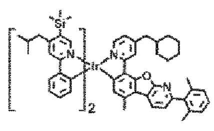
739
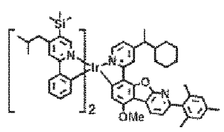
740

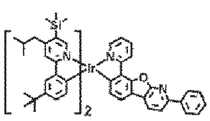
741
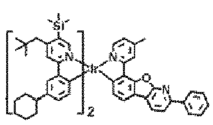
742
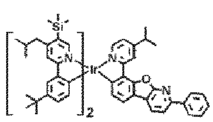
743
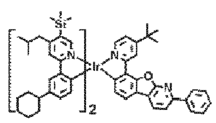
744
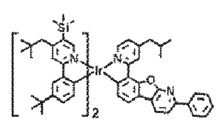
745

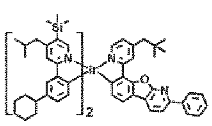
746
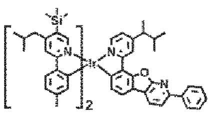
747
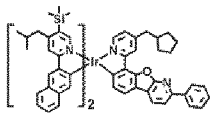
748
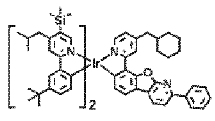
749
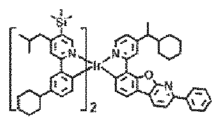
750

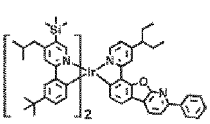
751
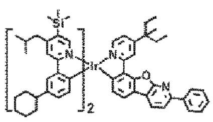
752
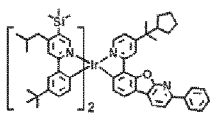
753
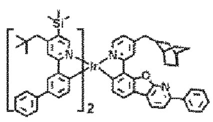
754
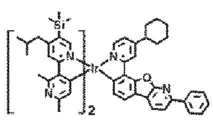
755

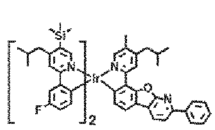
756
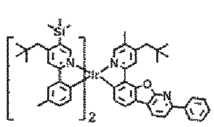
757
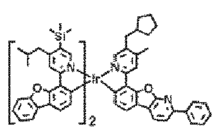
758
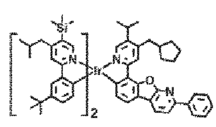
759
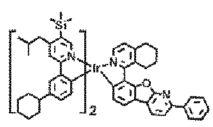
760

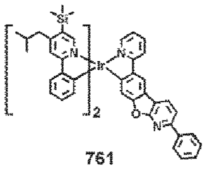
761
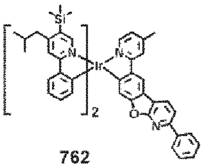
762
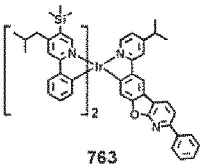
763
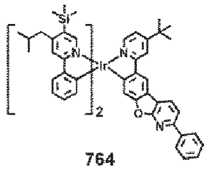
764
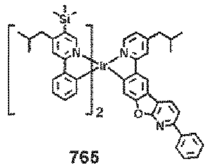
765
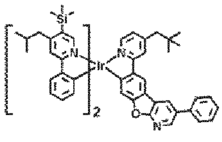
766
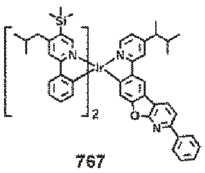
767
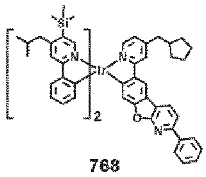
768
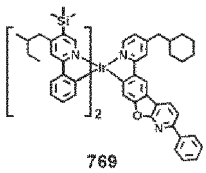
769
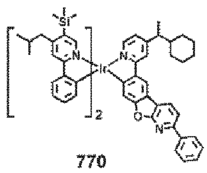
770
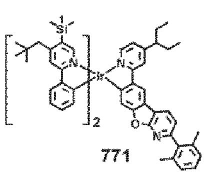
771
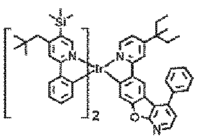
772
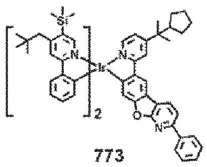
773
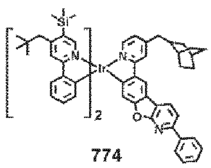
774
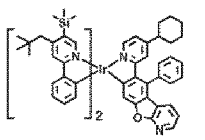
775
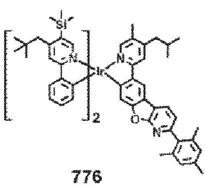
776
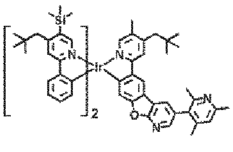
777
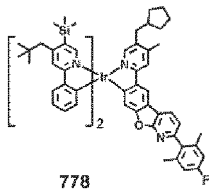
778
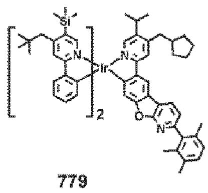
779
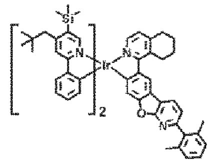
780
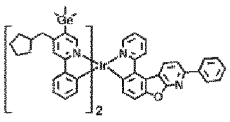
781
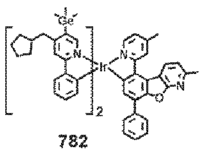
782
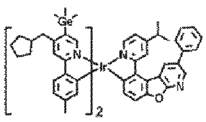
783
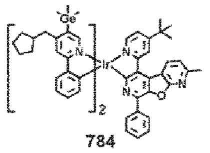
784
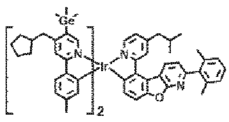
785
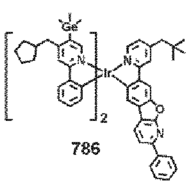
786
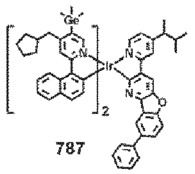
787
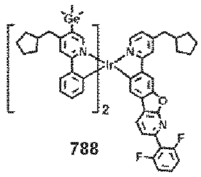
788
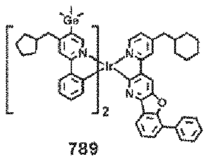
789
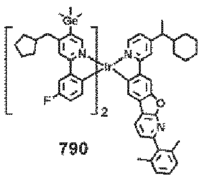
790
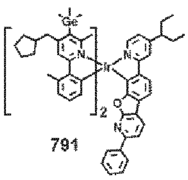
791
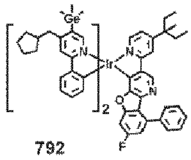
792
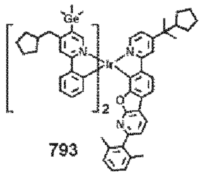
793
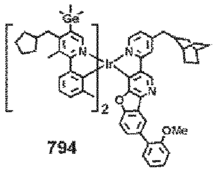
794
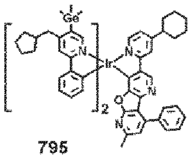
795
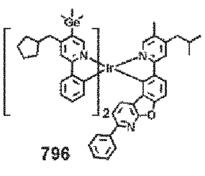
796
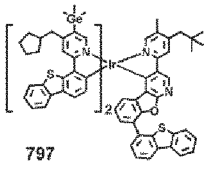
797
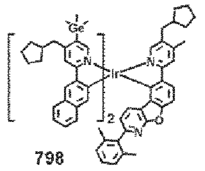
798
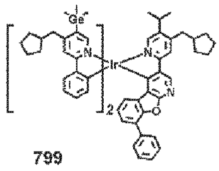
799
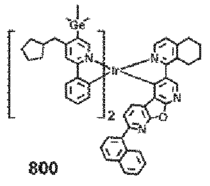
800

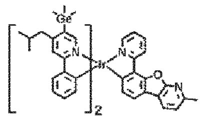
801
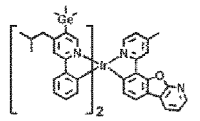
802
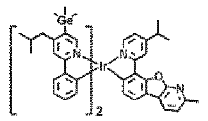
803
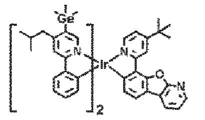
804
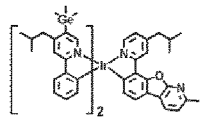
805

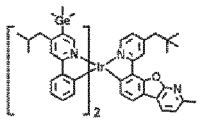
806
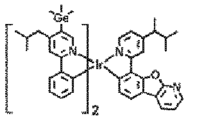
807
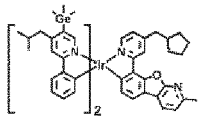
808
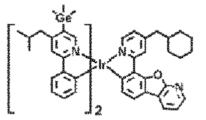
809
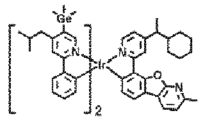
810

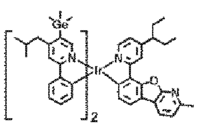
811
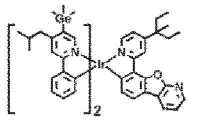
812
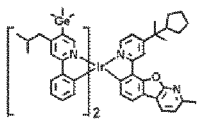
813
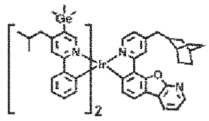
814
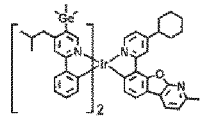
815

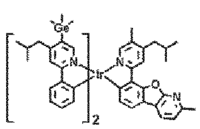
816
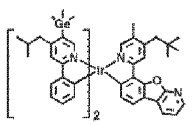
817
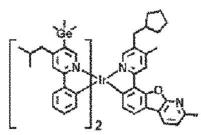
818
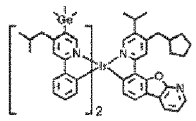
819
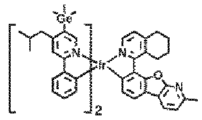
820

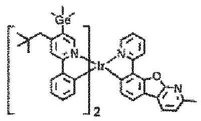
821
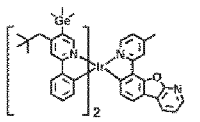
822
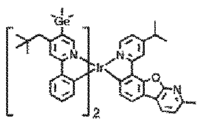
823
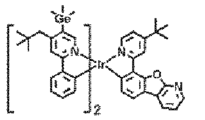
824
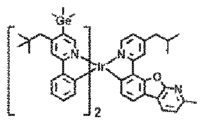
825

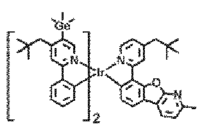
826
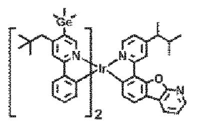
827
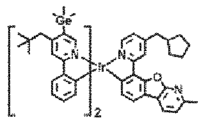
828
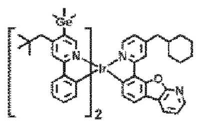
829
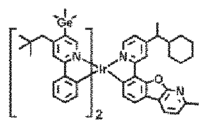
830

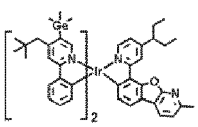
831
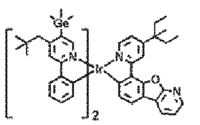
832
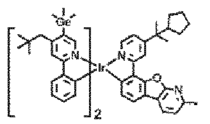
833
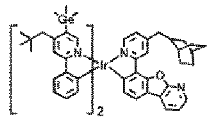
834
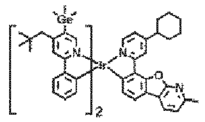
835

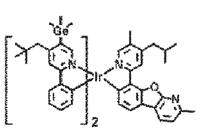
836
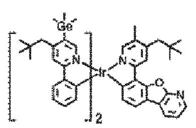
837
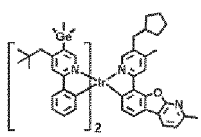
838
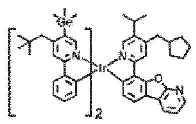
839
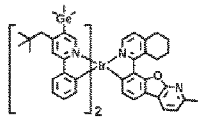
840

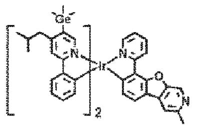
841

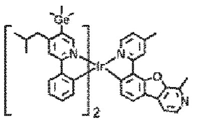
842

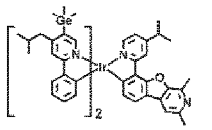
843

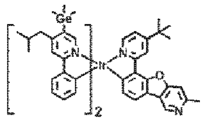
844

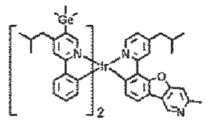
845

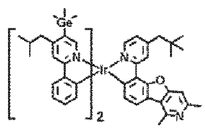
846

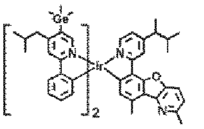
847

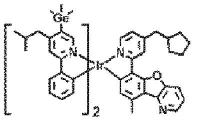
848

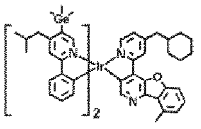
849

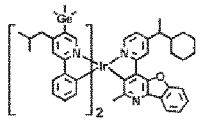
850

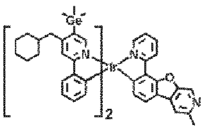
851

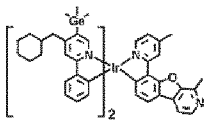
852

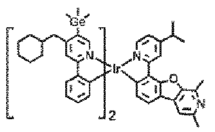
853

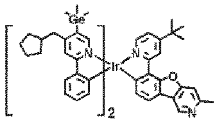
854

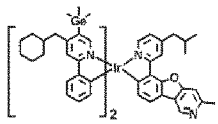
855

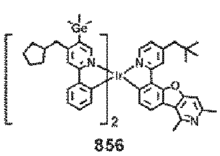
856

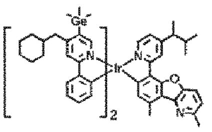
857

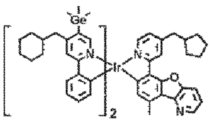
858

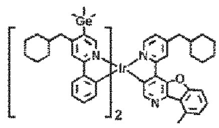
859

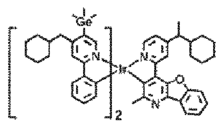
860

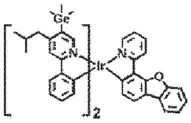
861

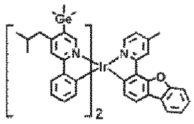
862

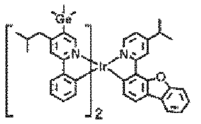
863

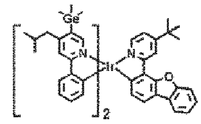
864

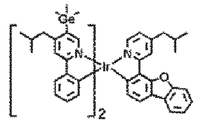
865

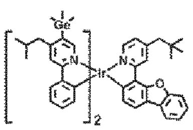
866

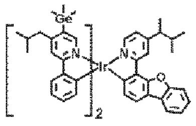
867

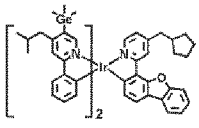
868

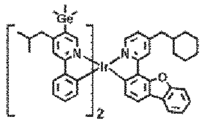
869

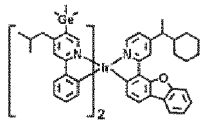
870

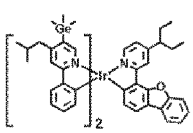
871

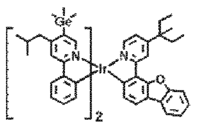
872

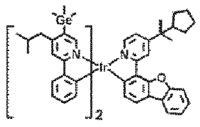
873

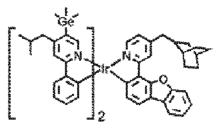
874

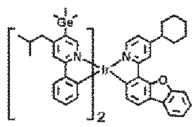
875

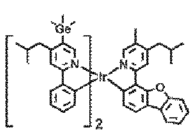
876

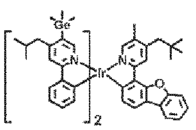
877

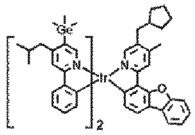
878

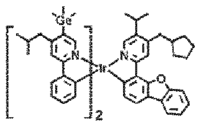
879

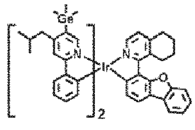
880

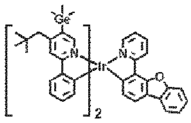
881
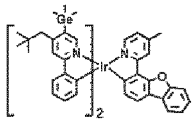
882
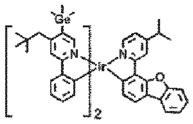
883
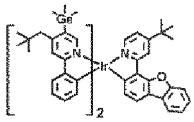
884
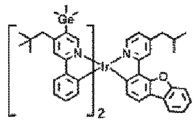
885

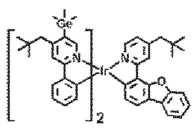
886
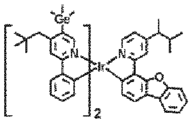
887
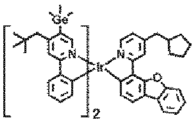
888
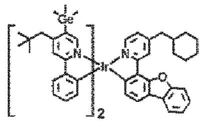
889
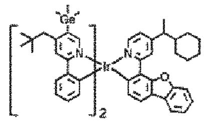
890

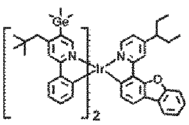
891
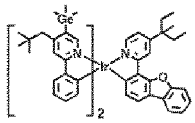
892
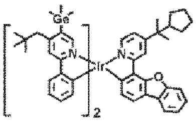
893
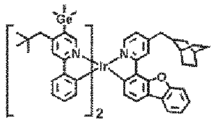
894
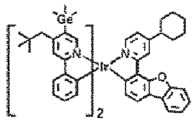
895

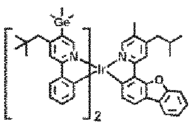
896
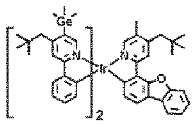
897
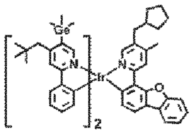
898
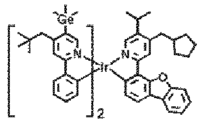
899
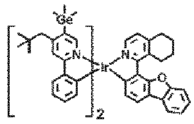
900

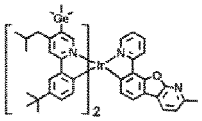
901
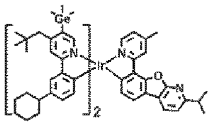
902
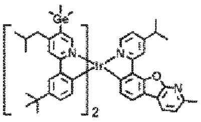
903
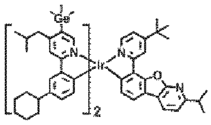
904
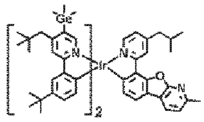
905

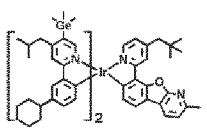
906
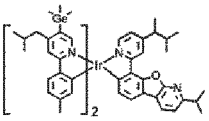
907
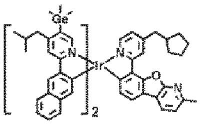
908
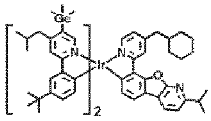
909
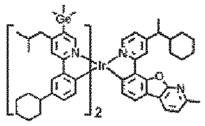
910

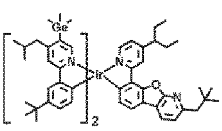
911
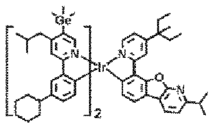
912
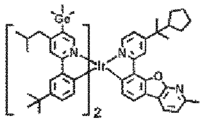
913
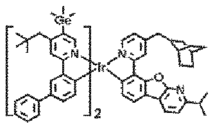
914
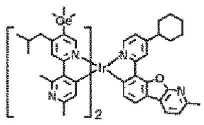
915

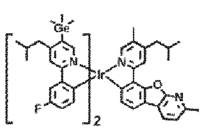
916
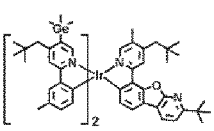
917
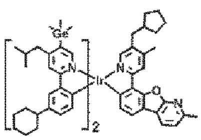
918
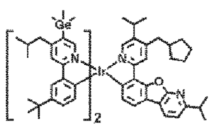
919
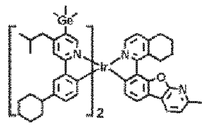
920

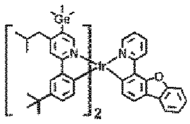
921
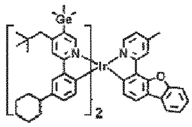
922
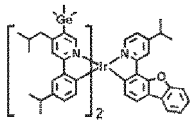
923
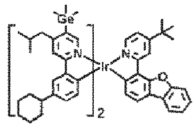
924
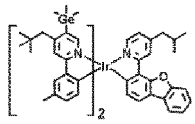
925

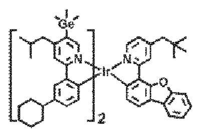
926
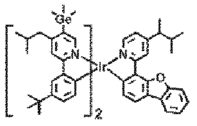
927
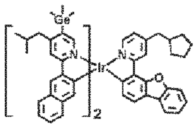
928
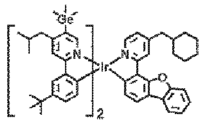
929
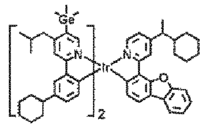
930

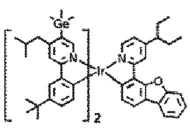
931
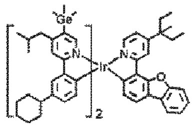
932
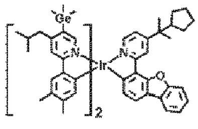
933
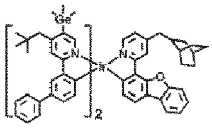
934
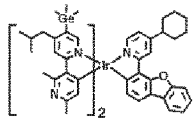
935

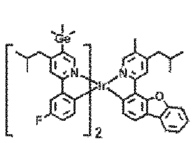
936
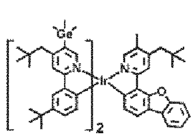
937
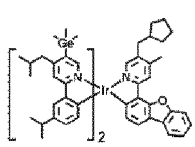
938
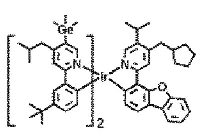
939
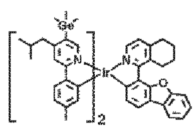
940

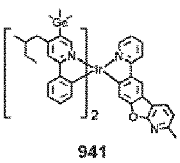
941
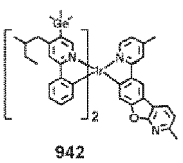
942
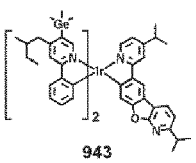
943
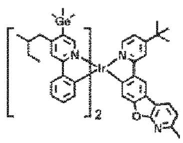
944
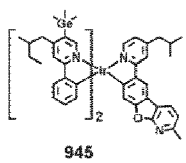
945

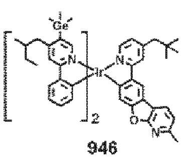
946
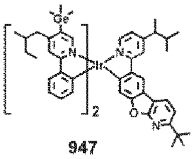
947
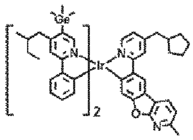
948
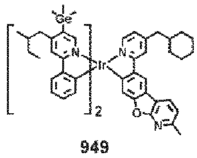
949
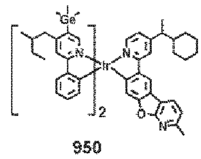
950

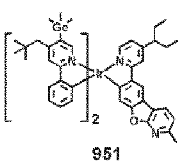
951
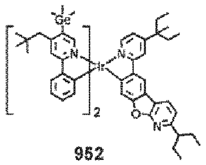
952
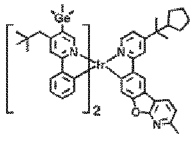
953
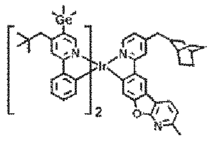
954
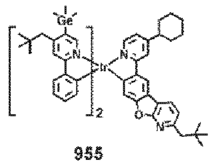
955

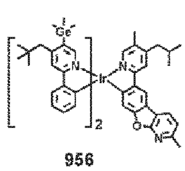
956
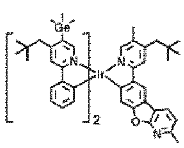
957
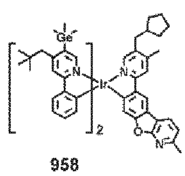
958
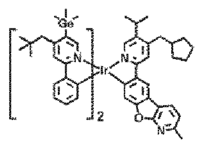
959
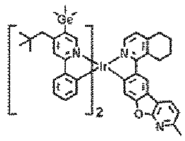
960

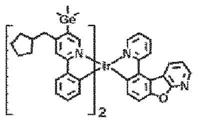
961
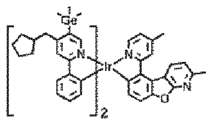
962
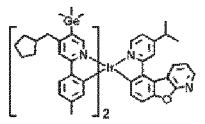
963
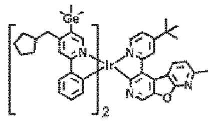
964
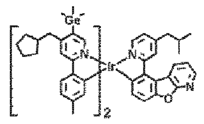
965

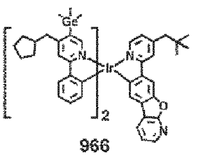
966
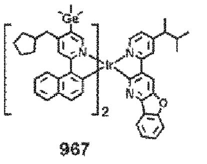
967
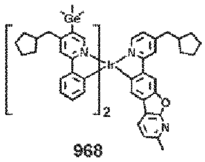
968
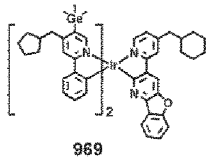
969
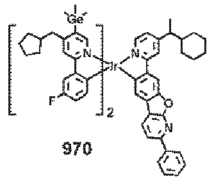
970

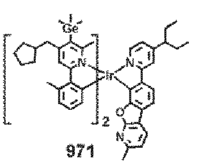
971
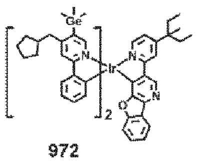
972
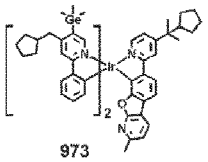
973
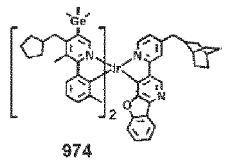
974
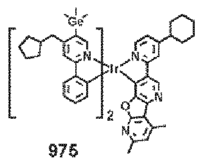
975

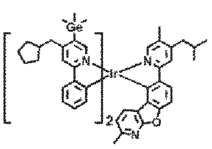
976
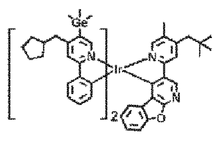
977
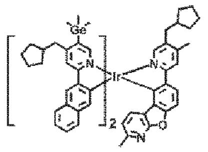
978
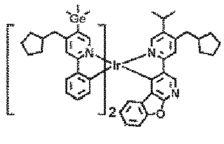
979
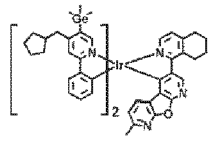
980

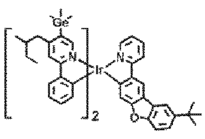
981
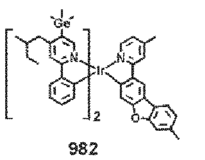
982
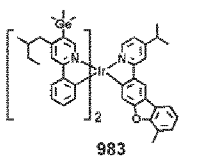
983
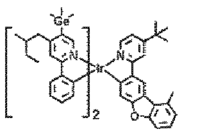
984
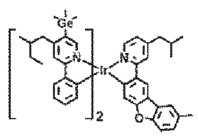
985

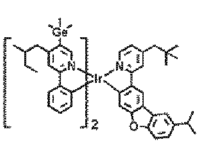
986
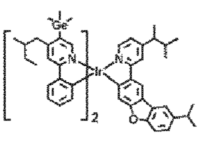
987
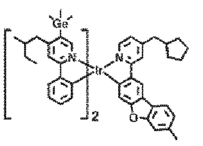
988
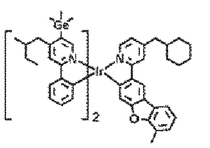
989
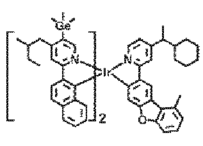
990

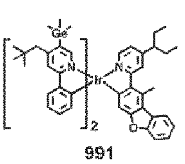
991
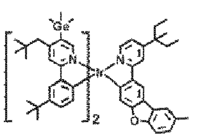
992
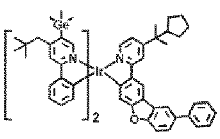
993
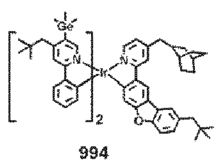
994
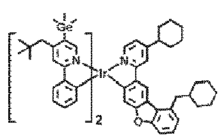
995

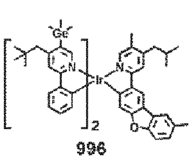
996
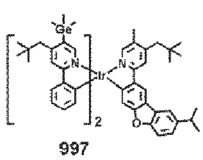
997
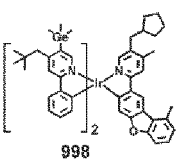
998
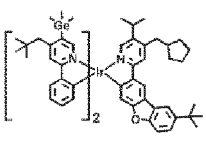
999
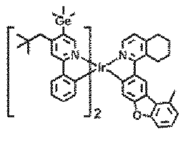
1000

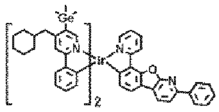
1001

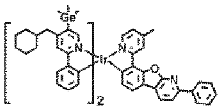
1002

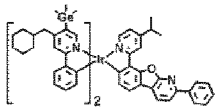
1003

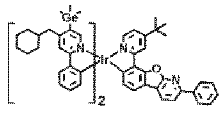
1004

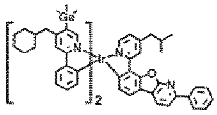
1005

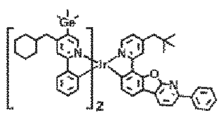
1006

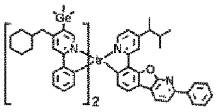
1007

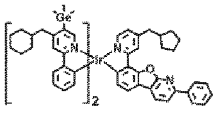
1008

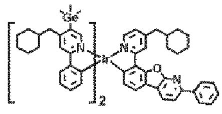
1009

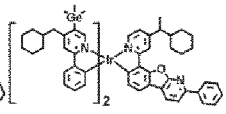
1010

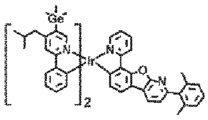
1011

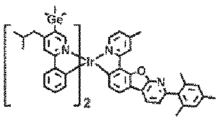
1012

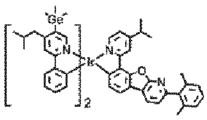
1013

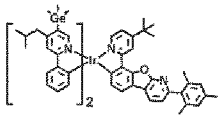
1014

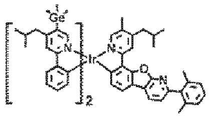
1015

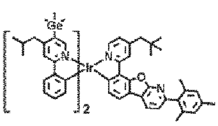
1016

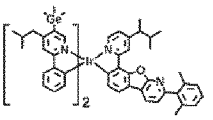
1017

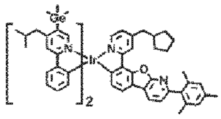
1018

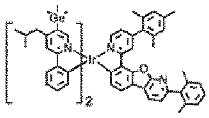
1019

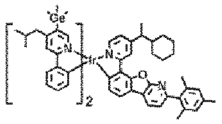
1020

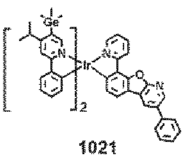
1021

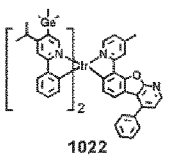
1022

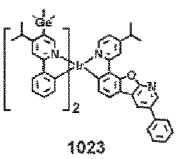
1023

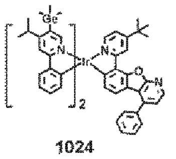
1024

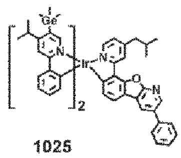
1025

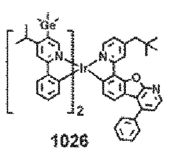
1026

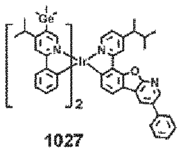
1027

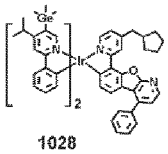
1028

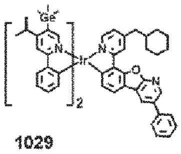
1029

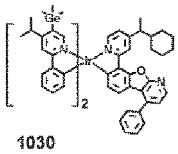
1030

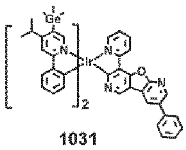
1031

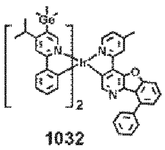
1032

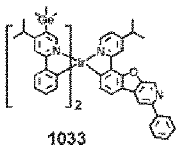
1033

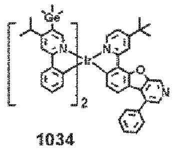
1034

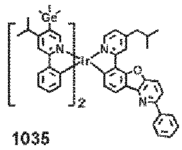
1035

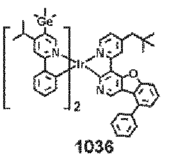
1036

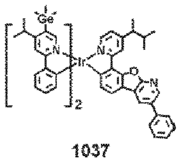
1037

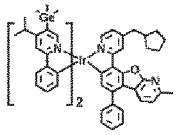
1038

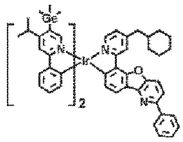
1039

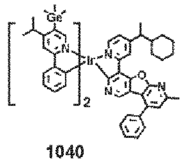
1040

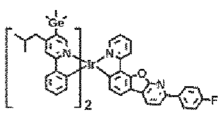
1041
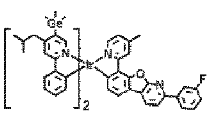
1042
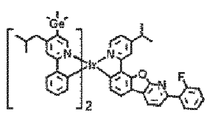
1043
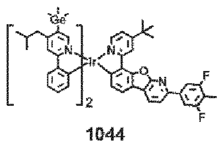
1044
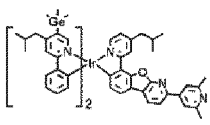
1045

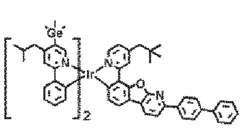
1046
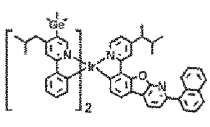
1047
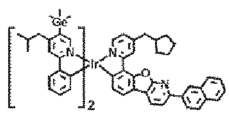
1048
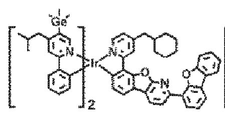
1049
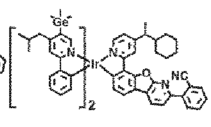
1050

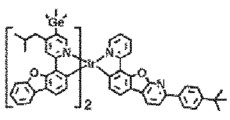
1051
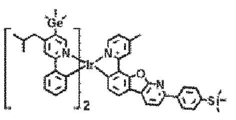
1052
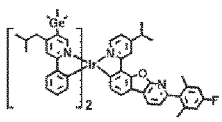
1053
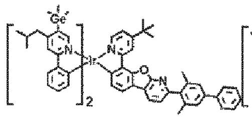
1054
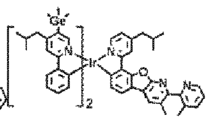
1055

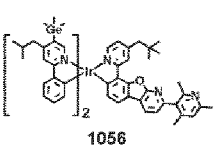
1056
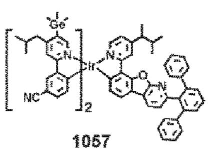
1057
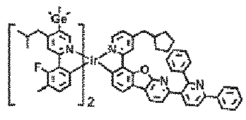
1058
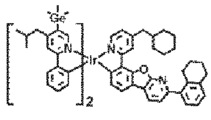
1059
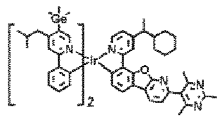
1060

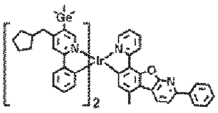
1061
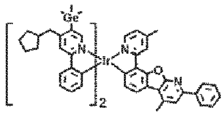
1062
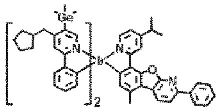
1063
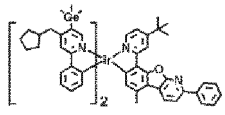
1064
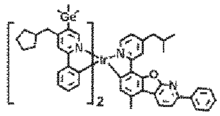
1065

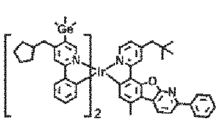
1066
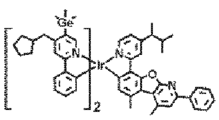
1067
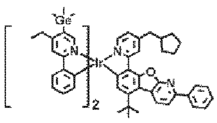
1068
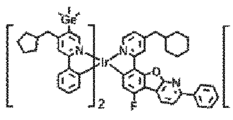
1069
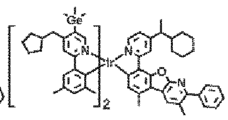
1070

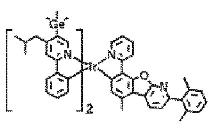
1071
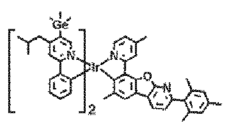
1072
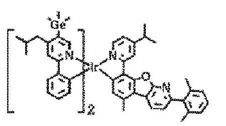
1073
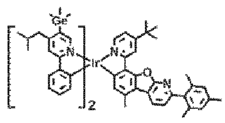
1074
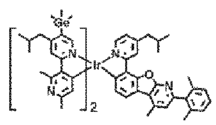
1075

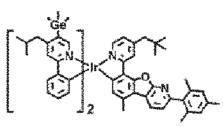
1076
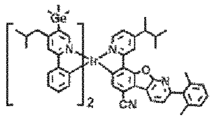
1077
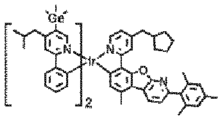
1078
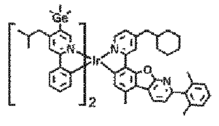
1079
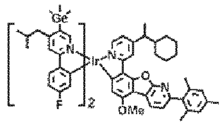
1080

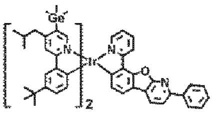 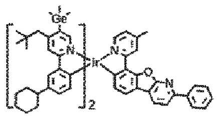 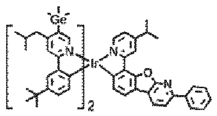 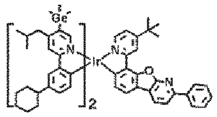 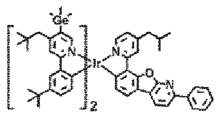

1081 1082 1083 1084 1085

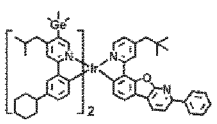 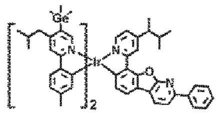 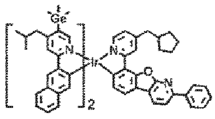 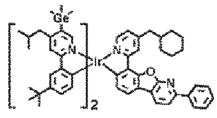 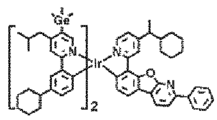

1086 1087 1088 1089 1090

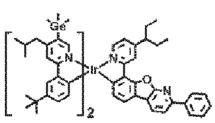 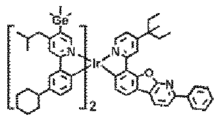 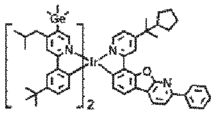 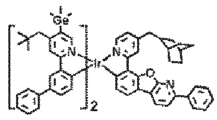 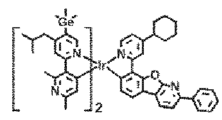

1091 1092 1093 1094 1095

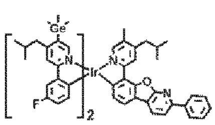 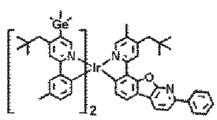 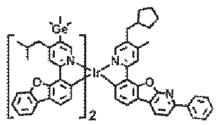 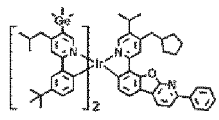 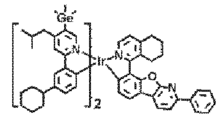

1096 1097 1098 1099 1100

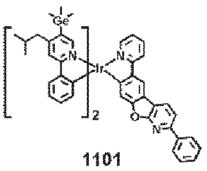 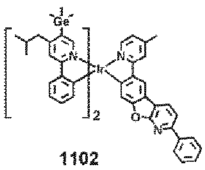 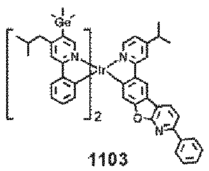 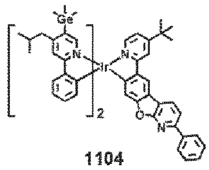 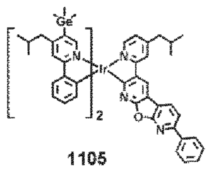

1101 1102 1103 1104 1105

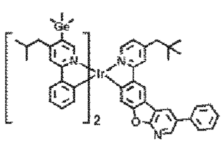 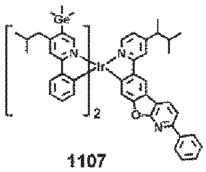 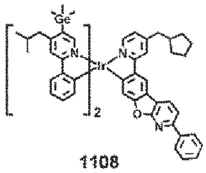 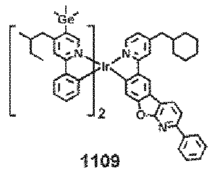 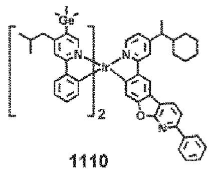

1106 1107 1108 1109 1110

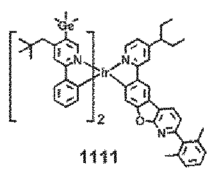 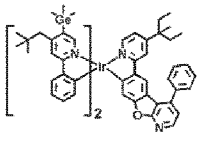 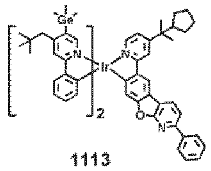 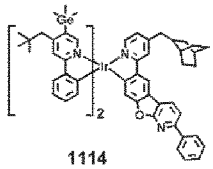 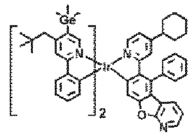

1111 1112 1113 1114 1115

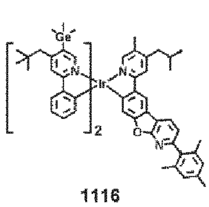 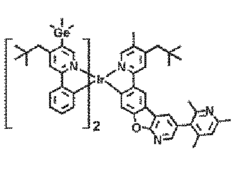 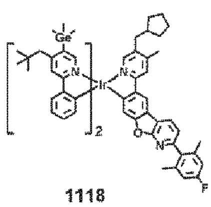 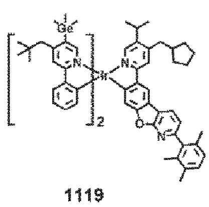 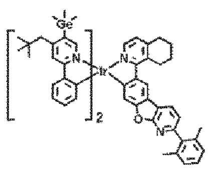

1116 1117 1118 1119 1120

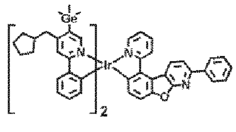

1121

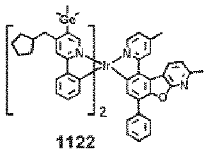

1122

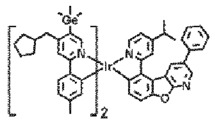

1123

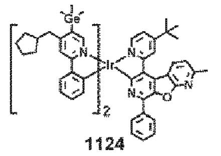

1124

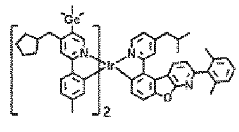

1125

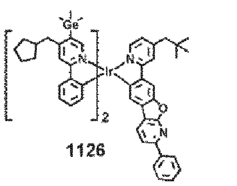

1126

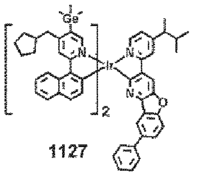

1127

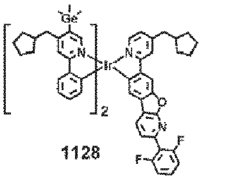

1128

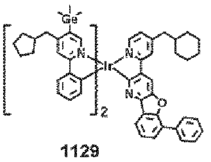

1129

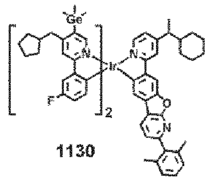

1130

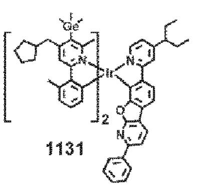

1131

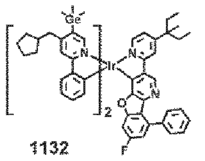

1132

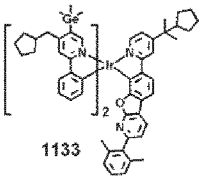

1133

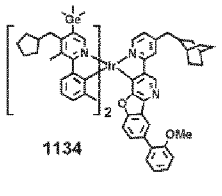

1134

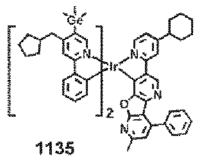

1135

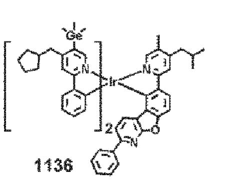

1136

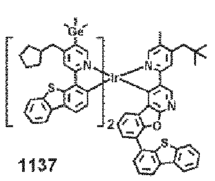

1137

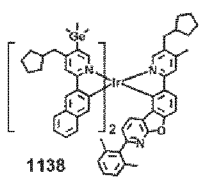

1138

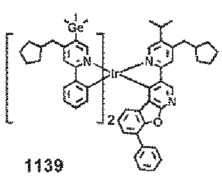

1139

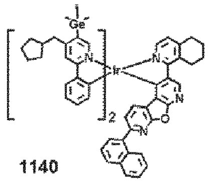

1140

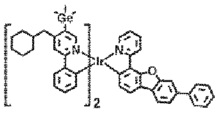

1141

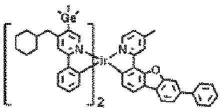

1142

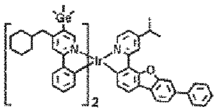

1143

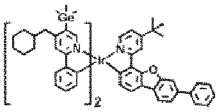

1144

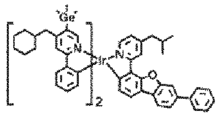

1145

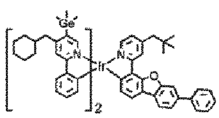

1146

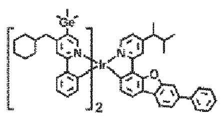

1147

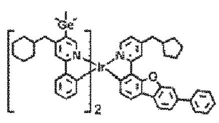

1148

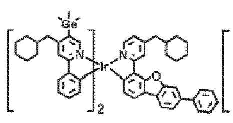

1149

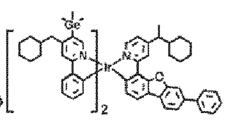

1150

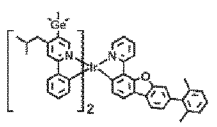

1151

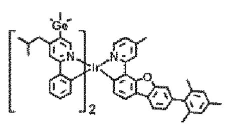

1152

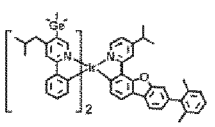

1153

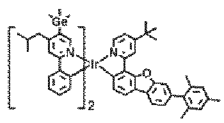

1154

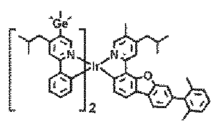

1155

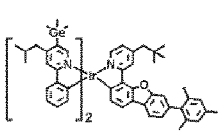

1156

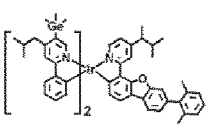

1157

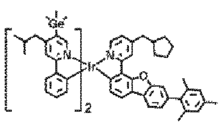

1158

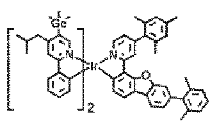

1159

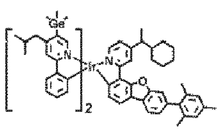

1160

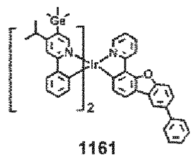
1161

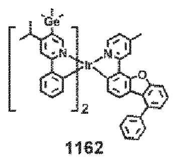
1162

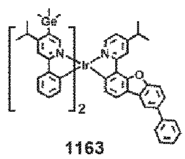
1163

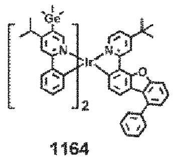
1164

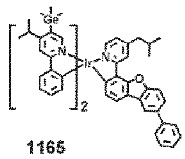
1165

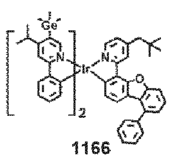
1166

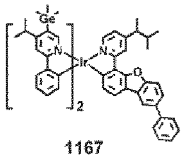
1167

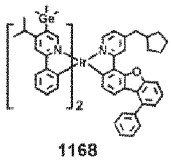
1168

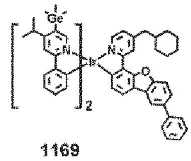
1169

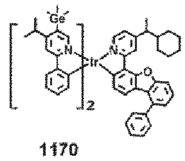
1170

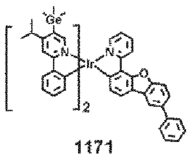
1171

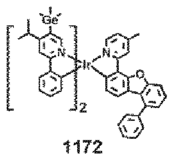
1172

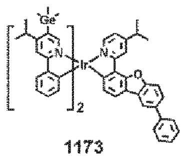
1173

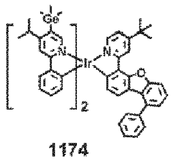
1174

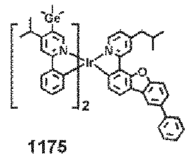
1175

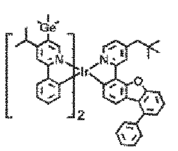
1176

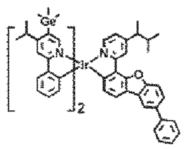
1177

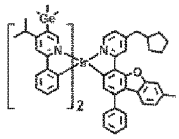
1178

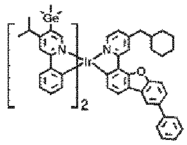
1179

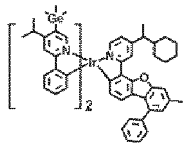
1180

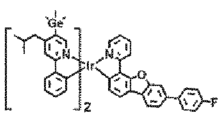
1181

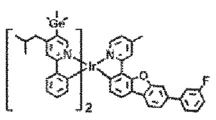
1182

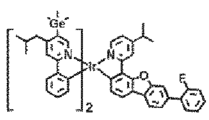
1183

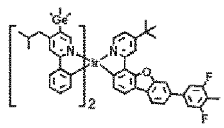
1184

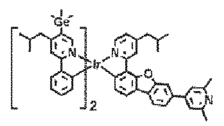
1185

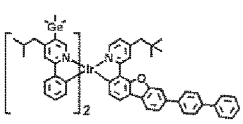
1186

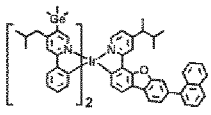
1187

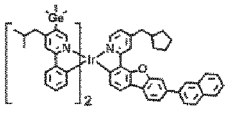
1188

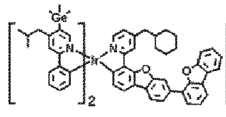
1189

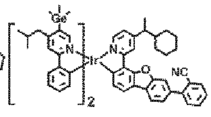
1190

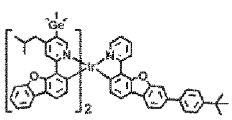
1191

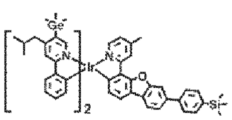
1192

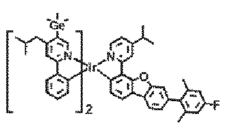
1193

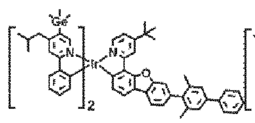
1194

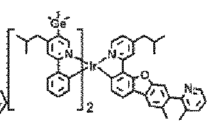
1195

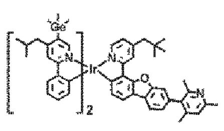
1196

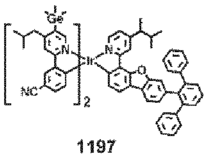
1197

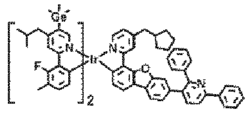
1198

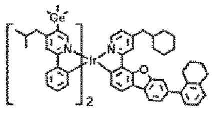
1199

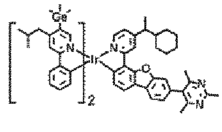
1200

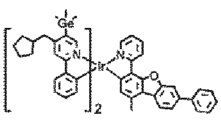
1201

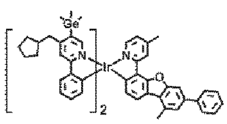
1202

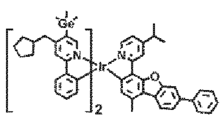
1203

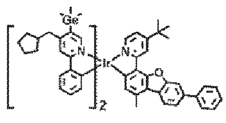
1204

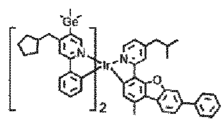
1205

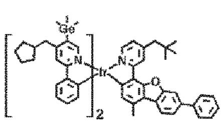
1206

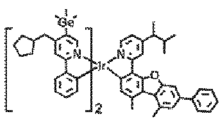
1207

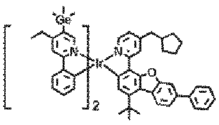
1208

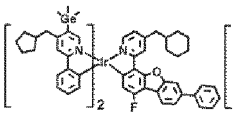
1209

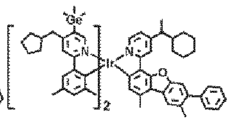
1210

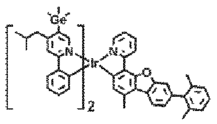
1211

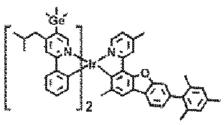
1212

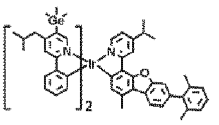
1213

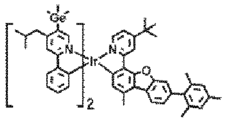
1214

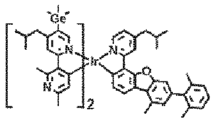
1215

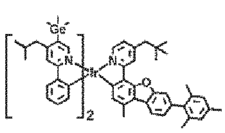
1216

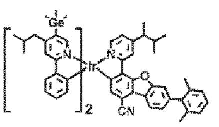
1217

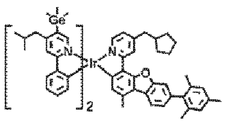
1218

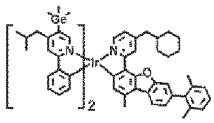
1219

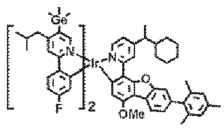
1220

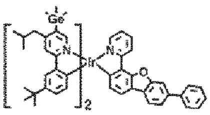
1221

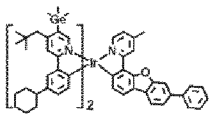
1222

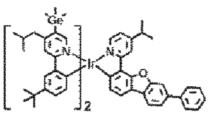
1223

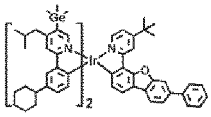
1224

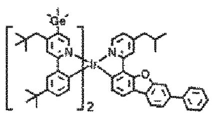
1225

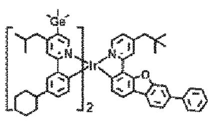
1226

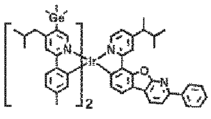
1227

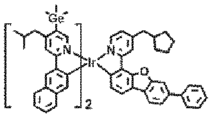
1228

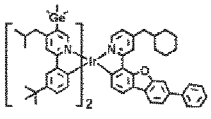
1229

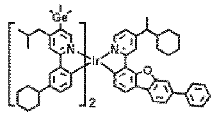
1230

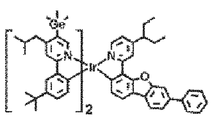
1231

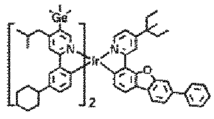
1232

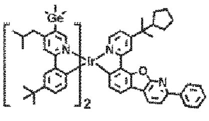
1233

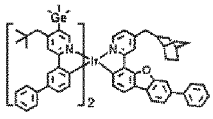
1234

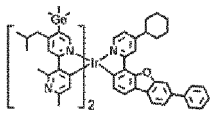
1235

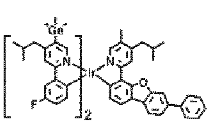
1236

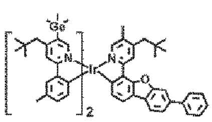
1237

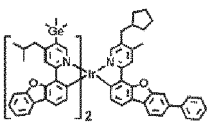
1238

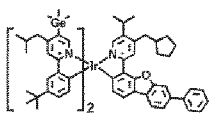
1239

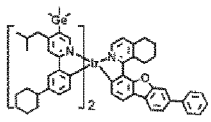
1240

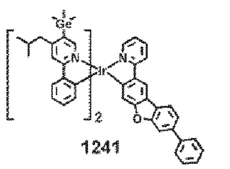
1241
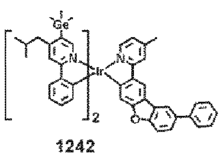
1242
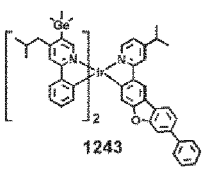
1243
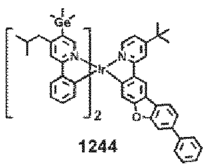
1244
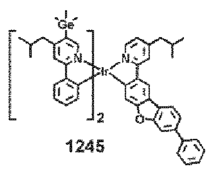
1245

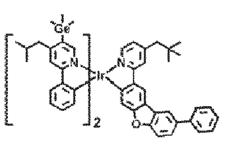
1246
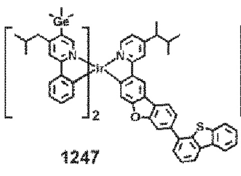
1247
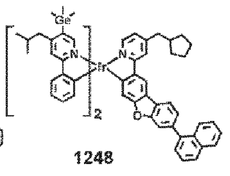
1248
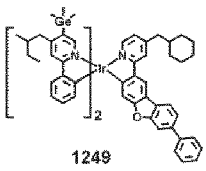
1249
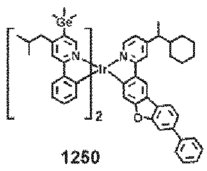
1250

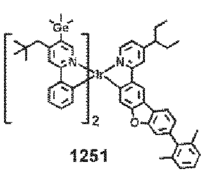
1251
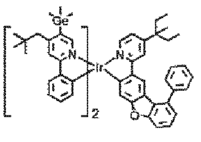
1252
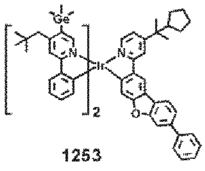
1253
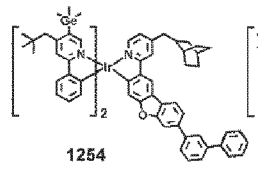
1254
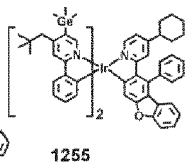
1255

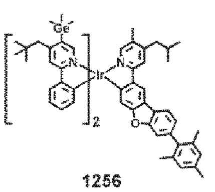
1256
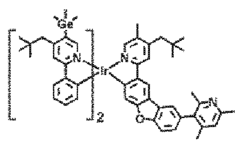
1257
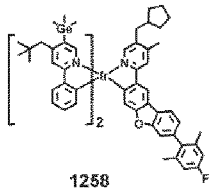
1258
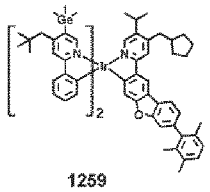
1259
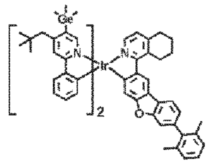
1260

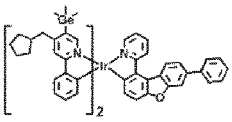
1261
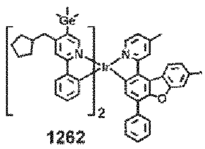
1262
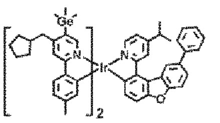
1263
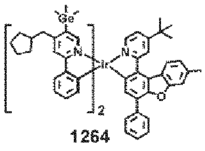
1264
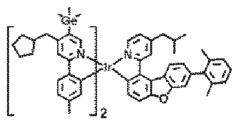
1265

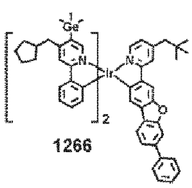
1266
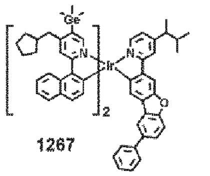
1267
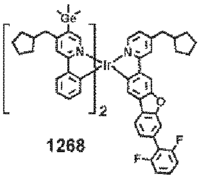
1268
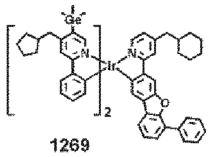
1269
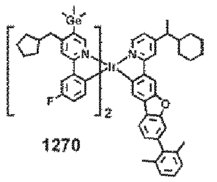
1270

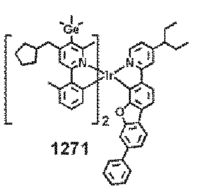
1271
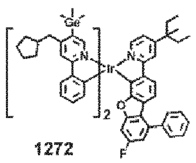
1272
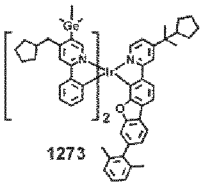
1273
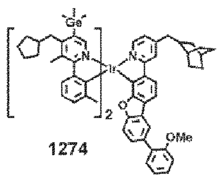
1274
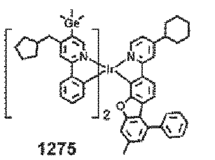
1275

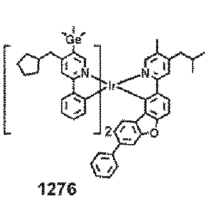
1276
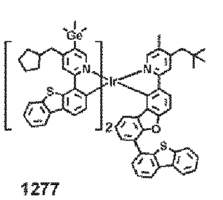
1277
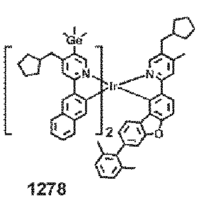
1278
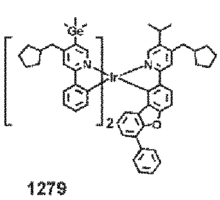
1279
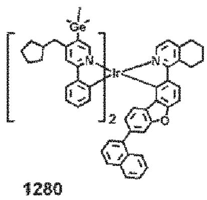
1280

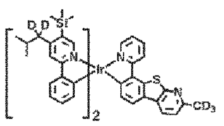
1281

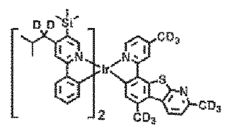
1282

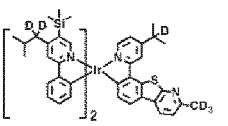
1283

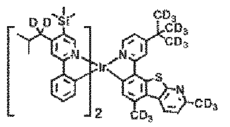
1284

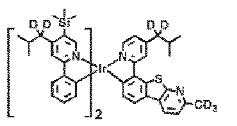
1285

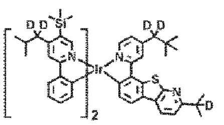
1286

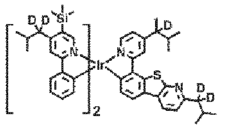
1287

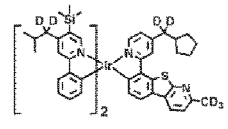
1288

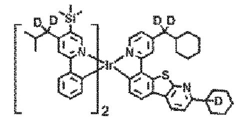
1289

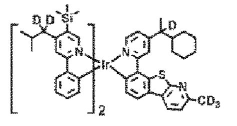
1290

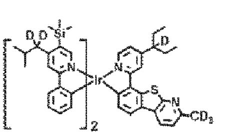
1291

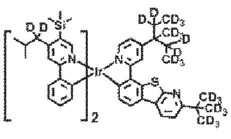
1292

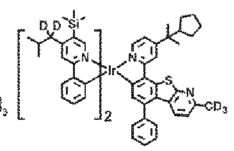
1293

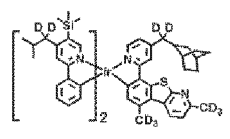
1294

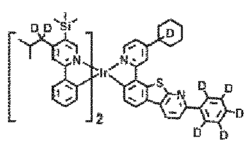
1295

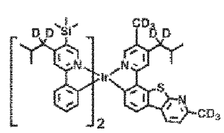
1296

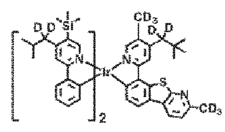
1297

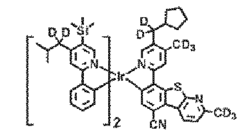
1298

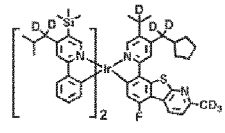
1299

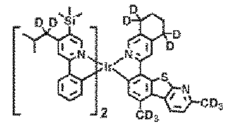
1300

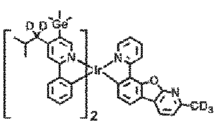
1301

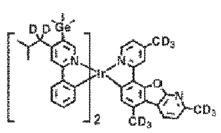
1302

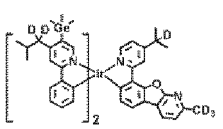
1303

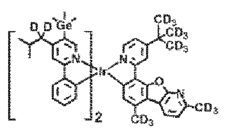
1304

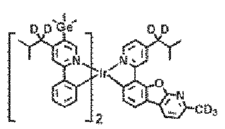
1305

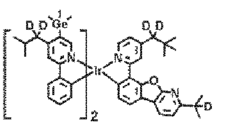
1306

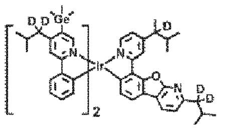
1307

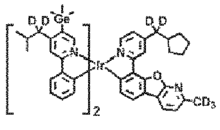
1308

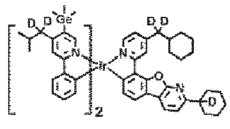
1309

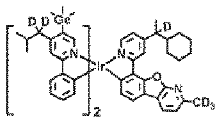
1310

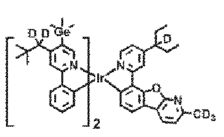
1311

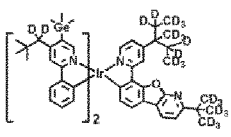
1312

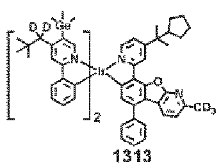
1313

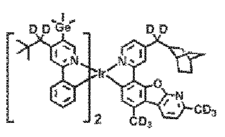
1314

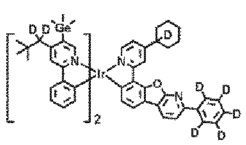
1315

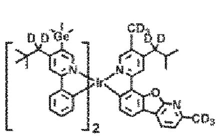
1316

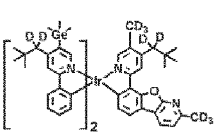
1317

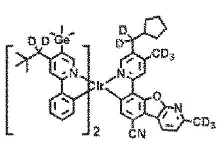
1318

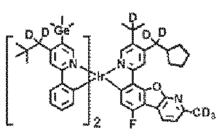
1319

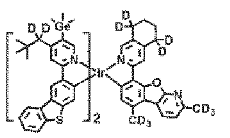
1320

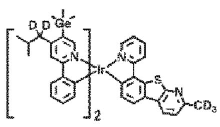
1321

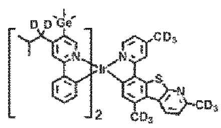
1322

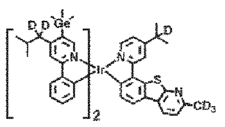
1323

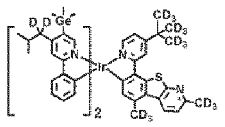
1324

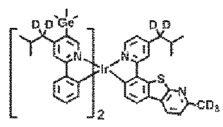
1325

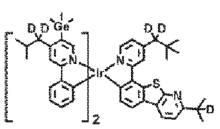
1326

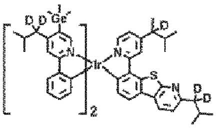
1327

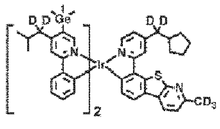
1328

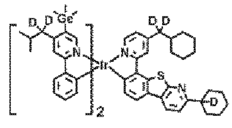
1329

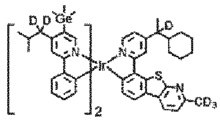
1330

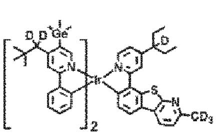
1331

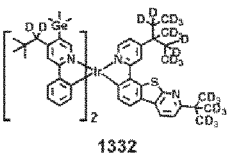
1332

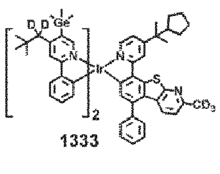
1333

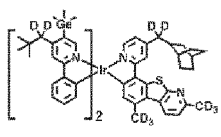
1334

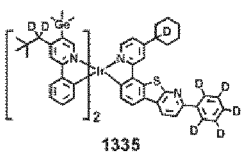
1335

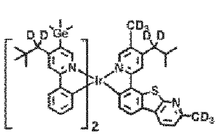
1336

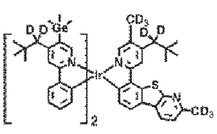
1337

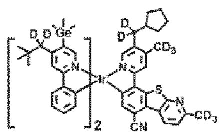
1338

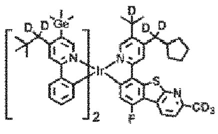
1339

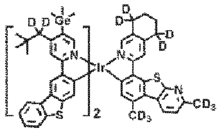
1340

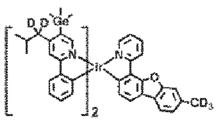
1341

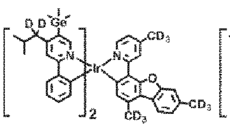
1342

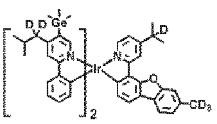
1343

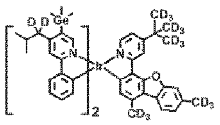
1344

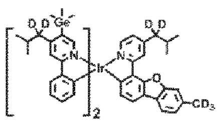
1345

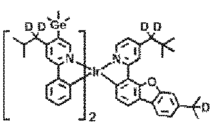
1346

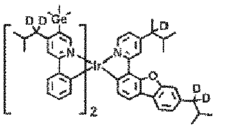
1347

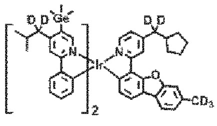
1348

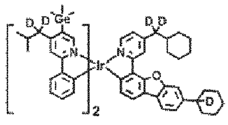
1349

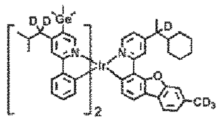
1350

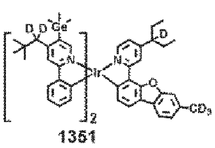
1351

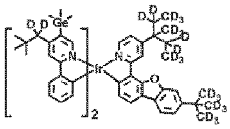
1352

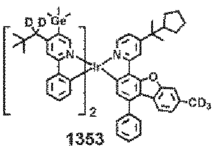
1353

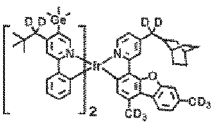
1354

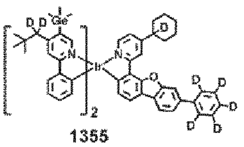
1355

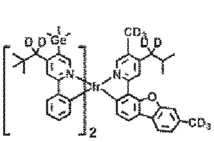
1356

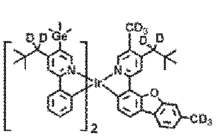
1357

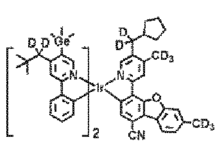
1358

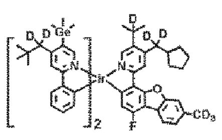
1359

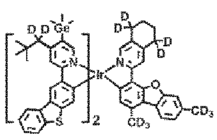
1360

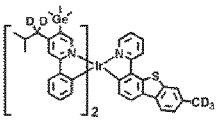
1361

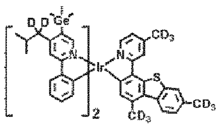
1362

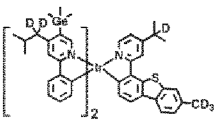
1363

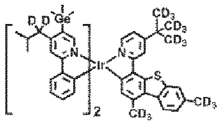
1364

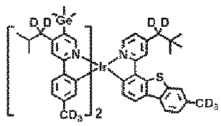
1365

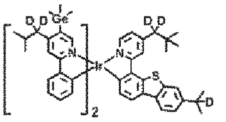
1366

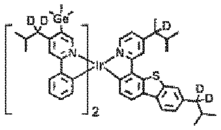
1367

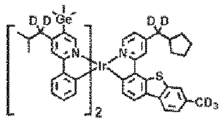
1368

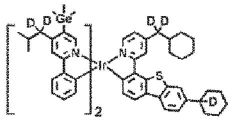
1369

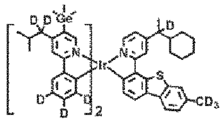
1370

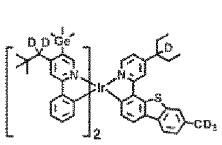
1371

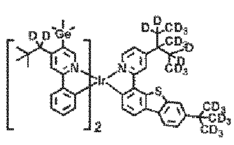
1372

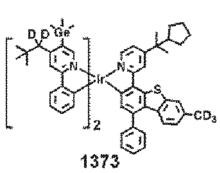
1373

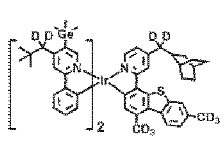
1374

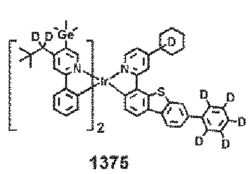
1375

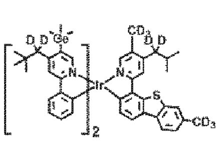
1376

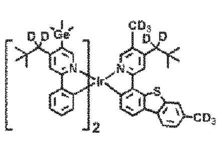
1377

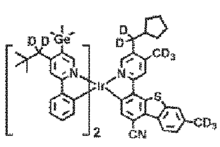
1378

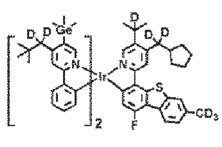
1379

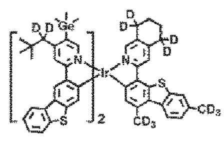
1380

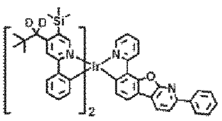
1381

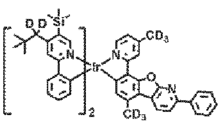
1382

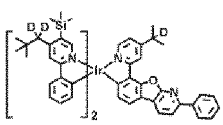
1383

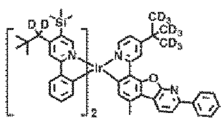
1384

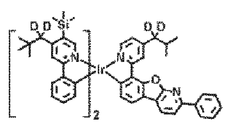
1385

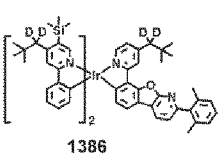
1386

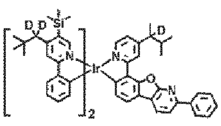
1387

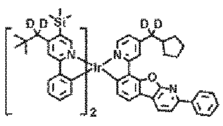
1388

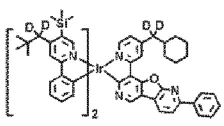
1389

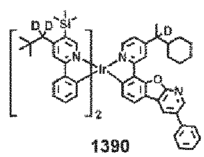
1390

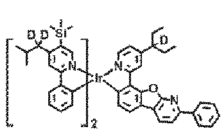
1391

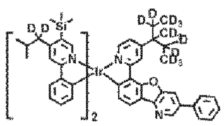
1392

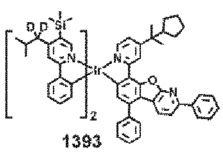
1393

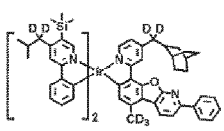
1394

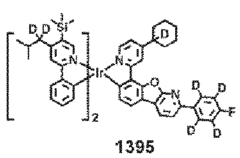
1395

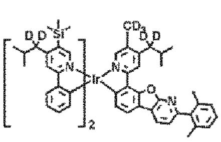
1396

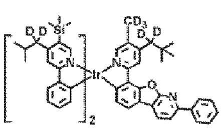
1397

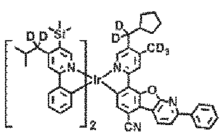
1398

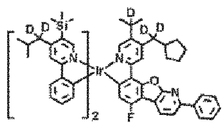
1399

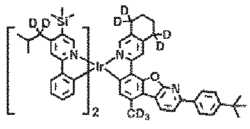
1400

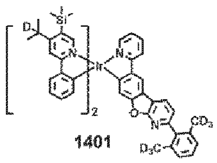
1401

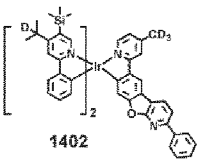
1402

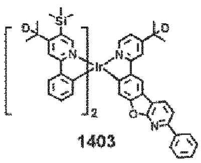
1403

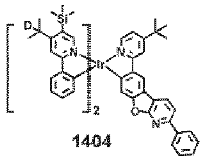
1404

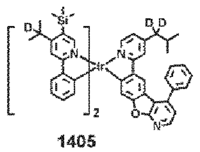
1405

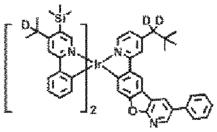
1406

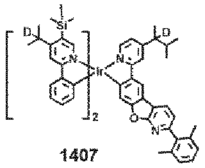
1407

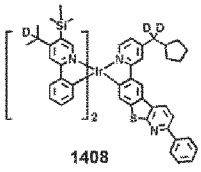
1408

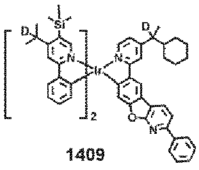
1409

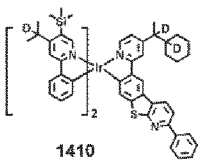
1410

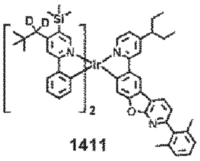
1411

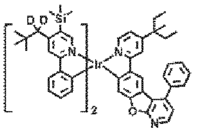
1412

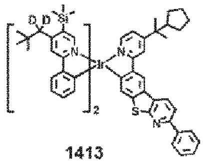
1413

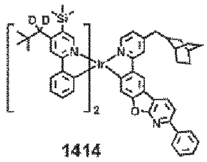
1414

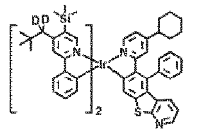
1415

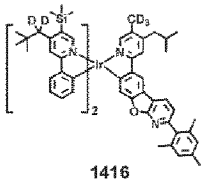
1416

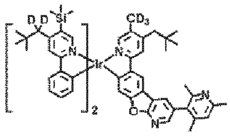
1417

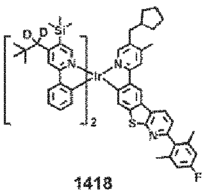
1418

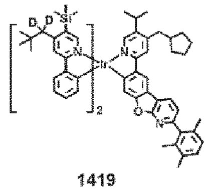
1419

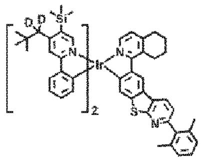
1420

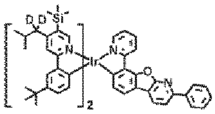
1421

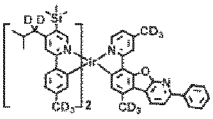
1422

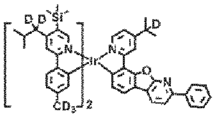
1423

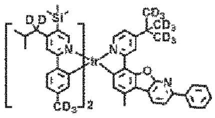
1424

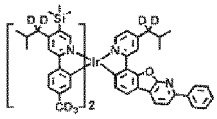
1425

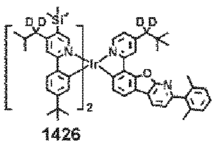
1426

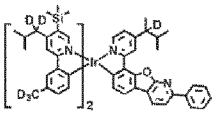
1427

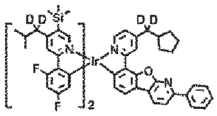
1428

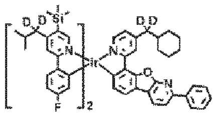
1429

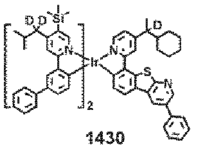
1430

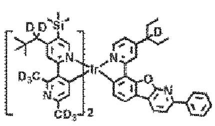
1431

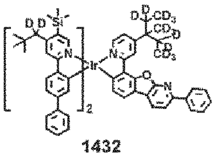
1432

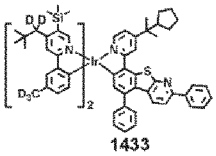
1433

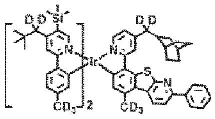
1434

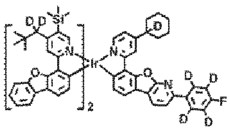
1435

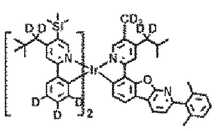
1436

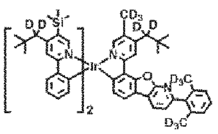
1437

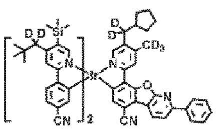
1438

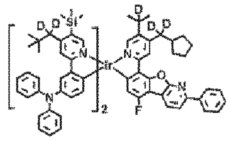
1439

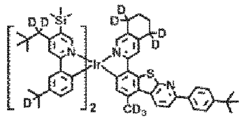
1440

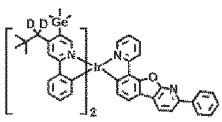
1441
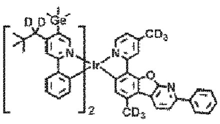
1442
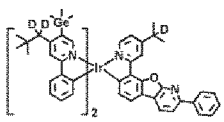
1443
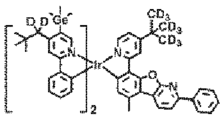
1444
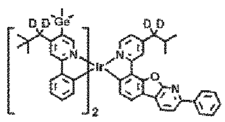
1445

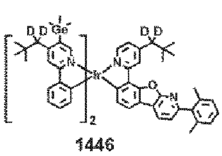
1446
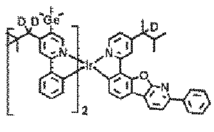
1447
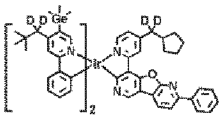
1448
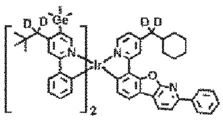
1449
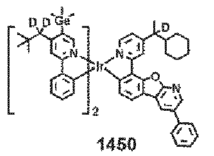
1450

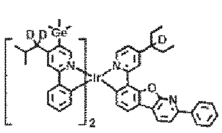
1451
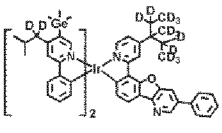
1452
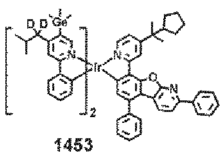
1453
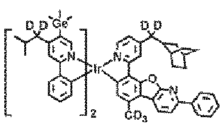
1454
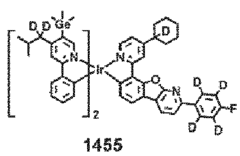
1455

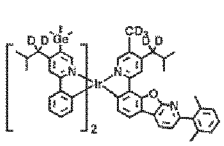
1456
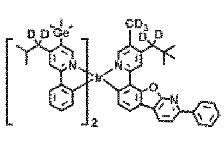
1457
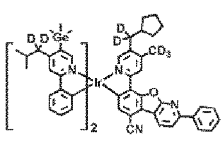
1458
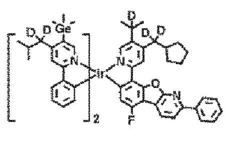
1459
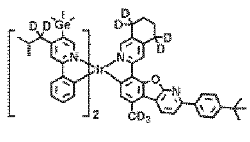
1460

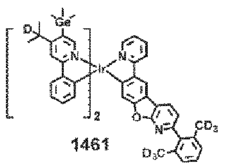
1461
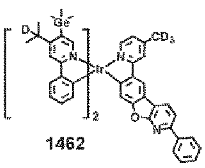
1462
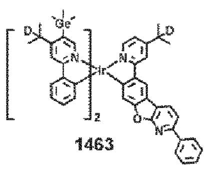
1463
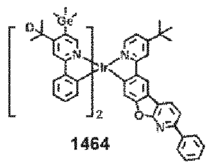
1464
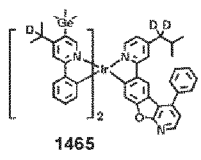
1465

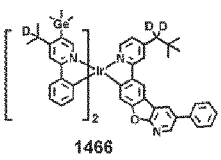
1466
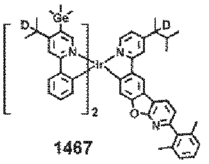
1467
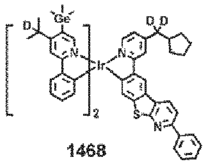
1468
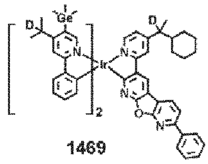
1469
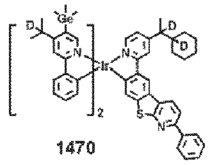
1470

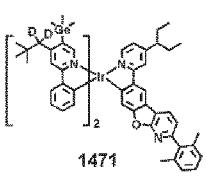
1471
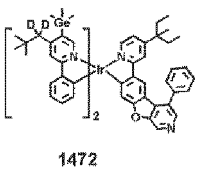
1472
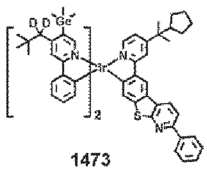
1473
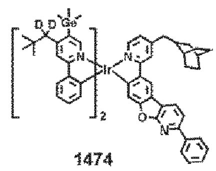
1474
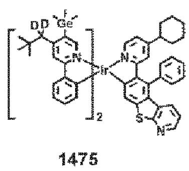
1475

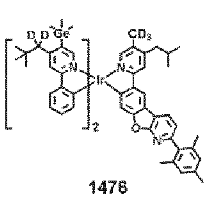
1476
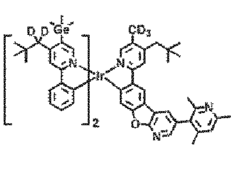
1477
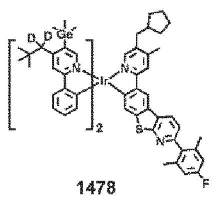
1478
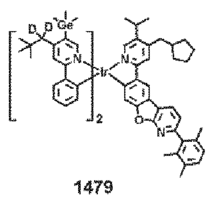
1479
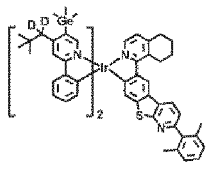
1480

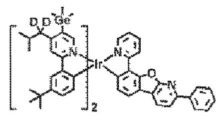
1481

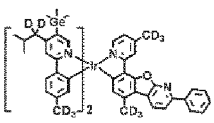
1482

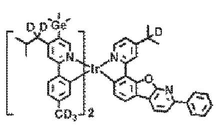
1483

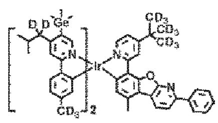
1484

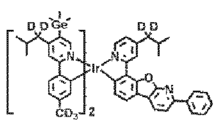
1485

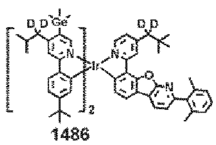
1486

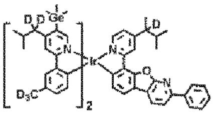
1487

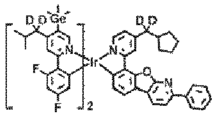
1488

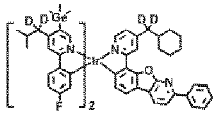
1489

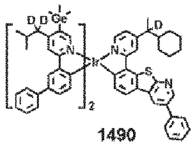
1490

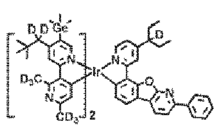
1491

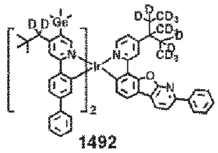
1492

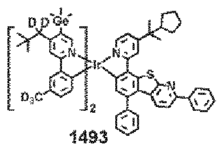
1493

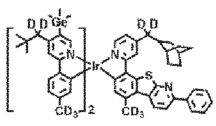
1494

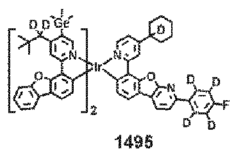
1495

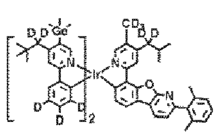
1496

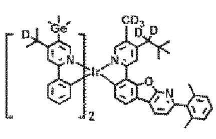
1497

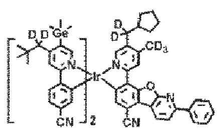
1498

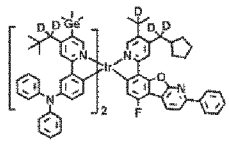
1499

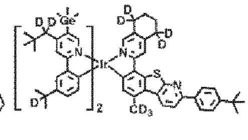
1500

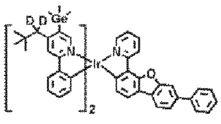
1501

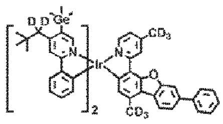
1502

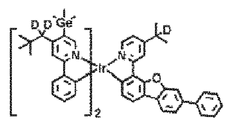
1503

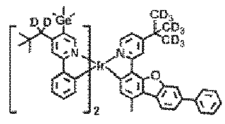
1504

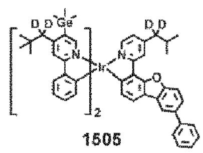
1505

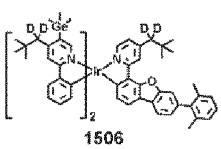
1506

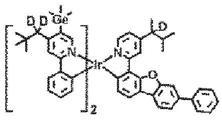
1507

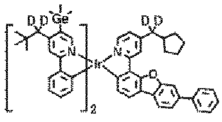
1508

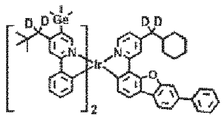
1509

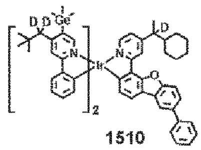
1510

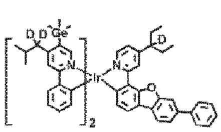
1511

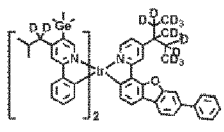
1512

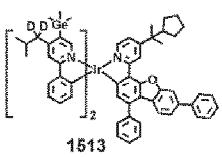
1513

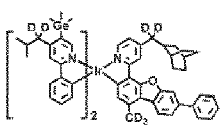
1514

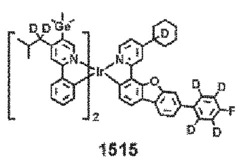
1515

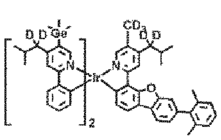
1516

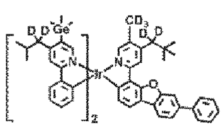
1517

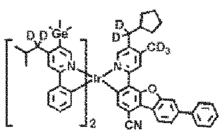
1518

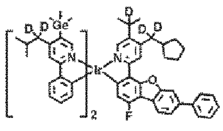
1519

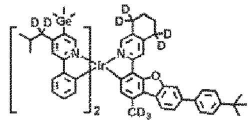
1520

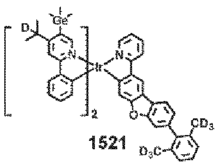
1521
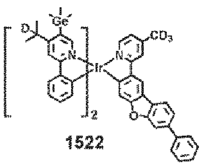
1522
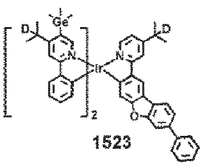
1523
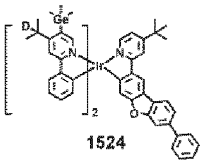
1524
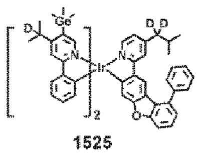
1525

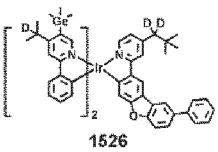
1526
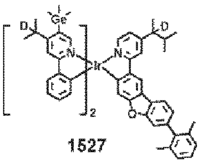
1527
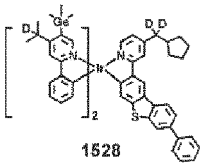
1528
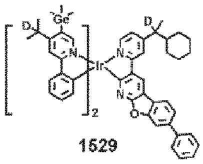
1529
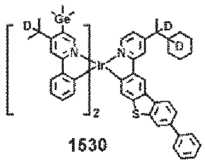
1530

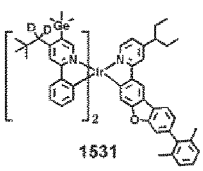
1531
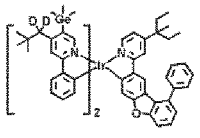
1532
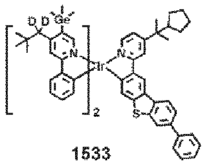
1533
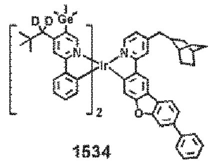
1534
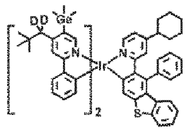
1535

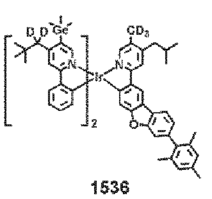
1536
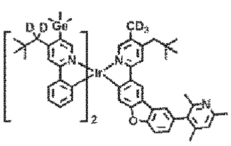
1537
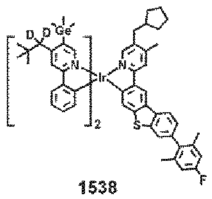
1538
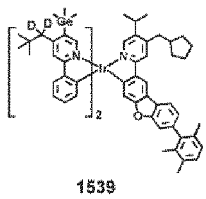
1539
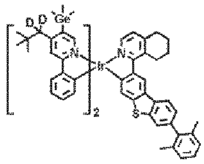
1540

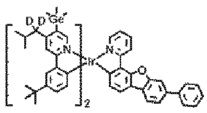
1541
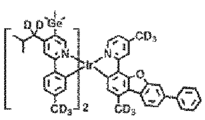
1542
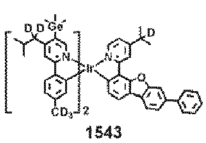
1543
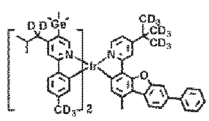
1544
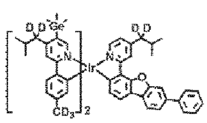
1545

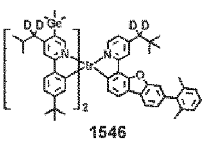
1546
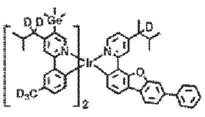
1547
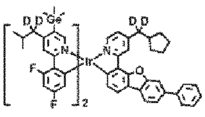
1548
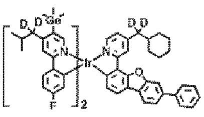
1549
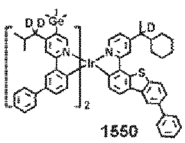
1550

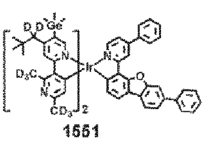
1551
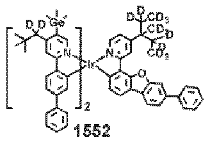
1552
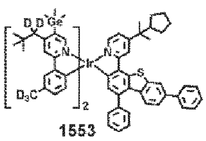
1553
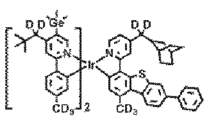
1554
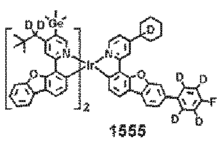
1555

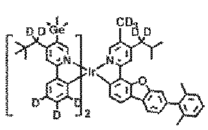
1556
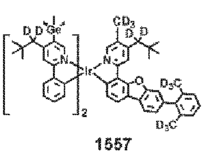
1557
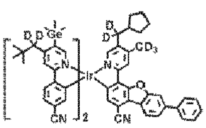
1558
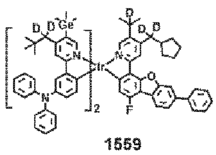
1559
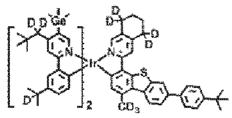
1560

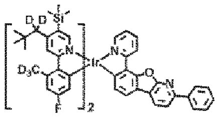
1561
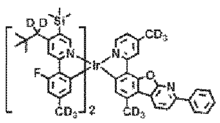
1562
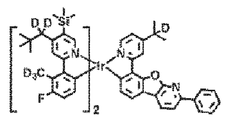
1563
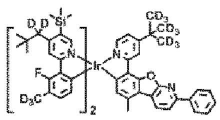
1564
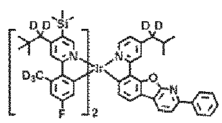
1565

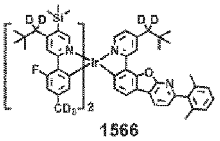
1566
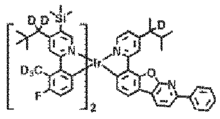
1567
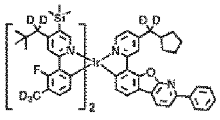
1568
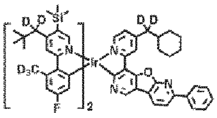
1569
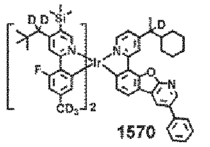
1570

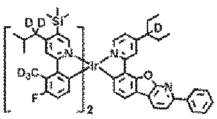
1571
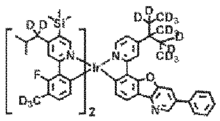
1572
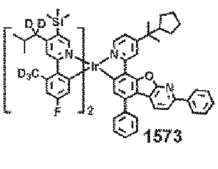
1573
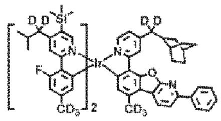
1574
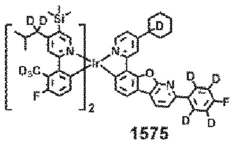
1575

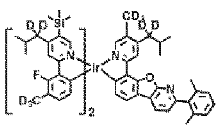
1576
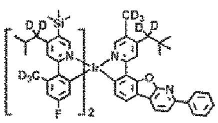
1577
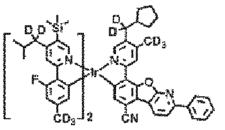
1578
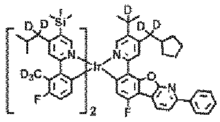
1579
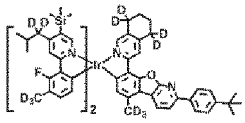
1580

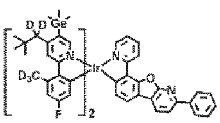
1581
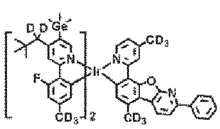
1582
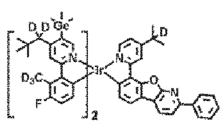
1583
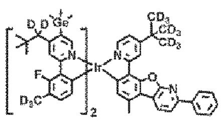
1584
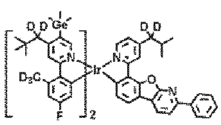
1585

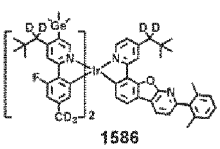
1586
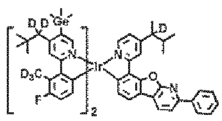
1587
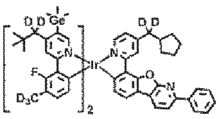
1588
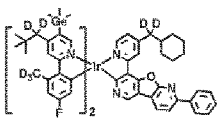
1589
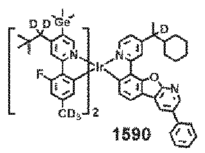
1590

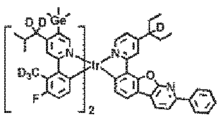
1591
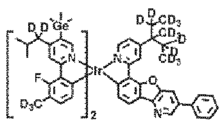
1592
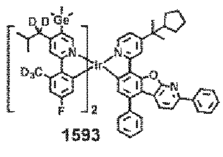
1593
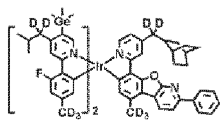
1594
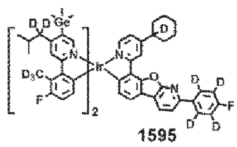
1595

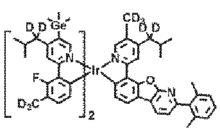
1596
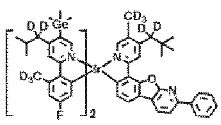
1597
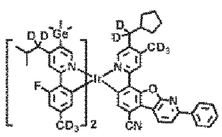
1598
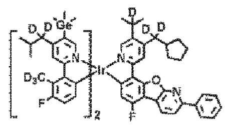
1599
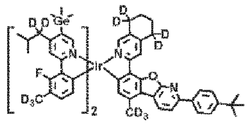
1600

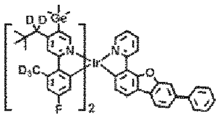 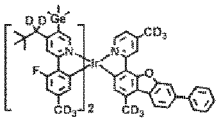 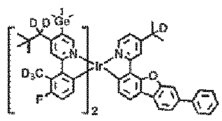 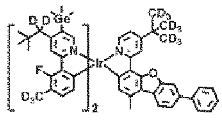 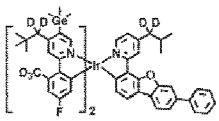

1601 1602 1603 1604 1605

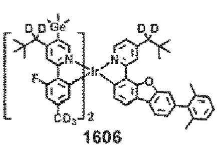 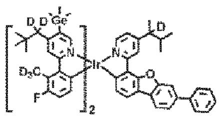 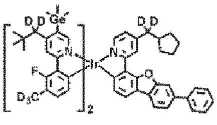 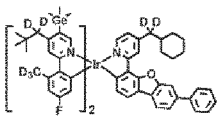 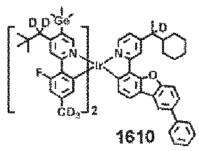

1606 1607 1608 1609 1610

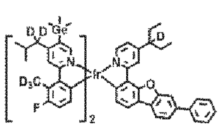 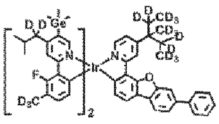 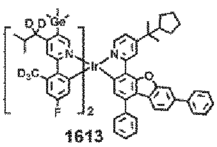 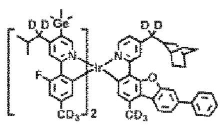 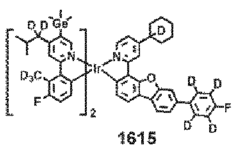

1611 1612 1613 1614 1615

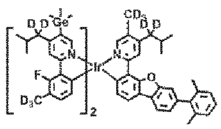 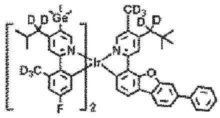 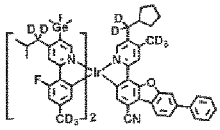 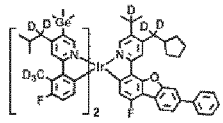 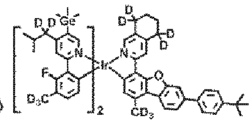

1616 1617 1618 1619 1620

Group 2-3

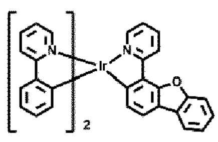 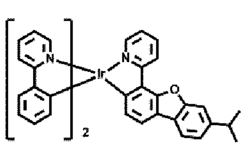 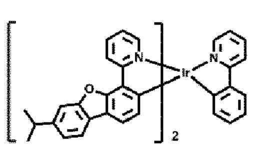 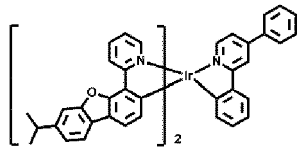

1 2 3 4

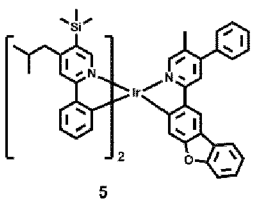 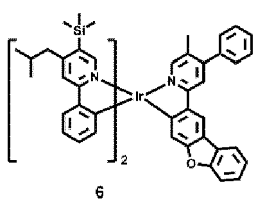 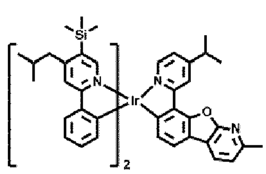 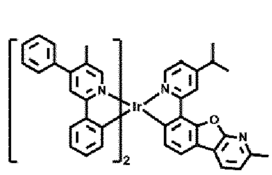

5 6 7 8

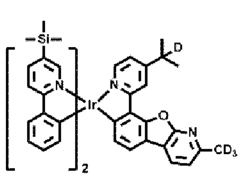 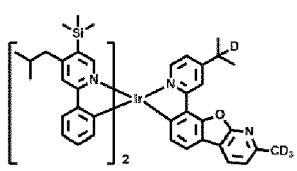 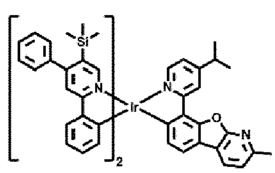 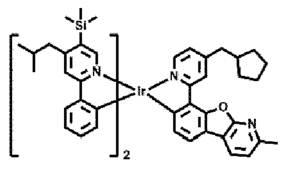

9 10 11 12

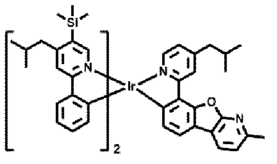
13

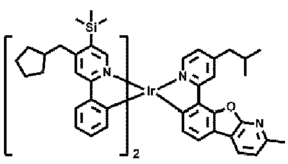
14

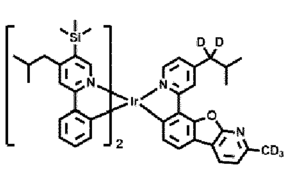
15

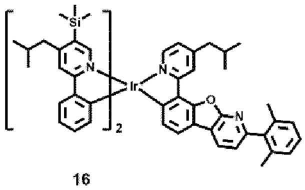
16

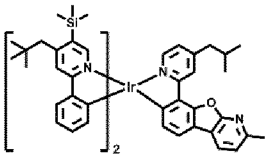
17

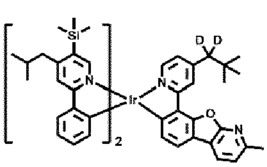
18

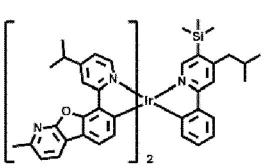
19

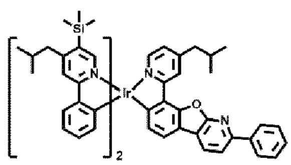
20

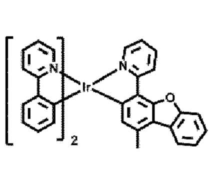
21

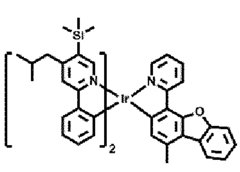
22

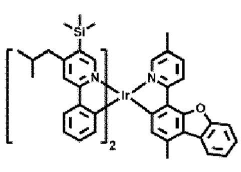
23

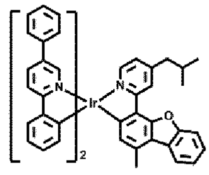
24

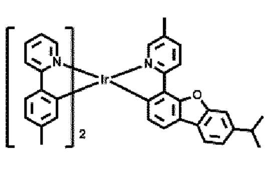
25

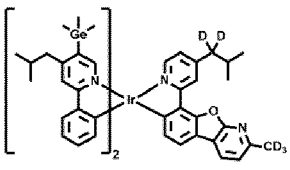
26

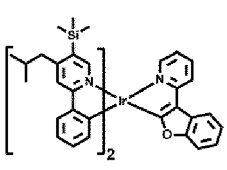
27

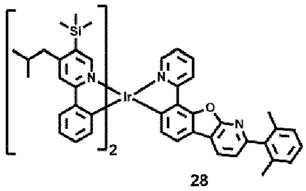
28

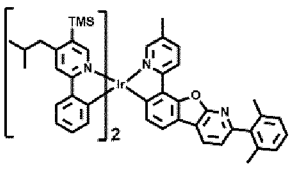
29

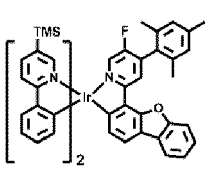
30

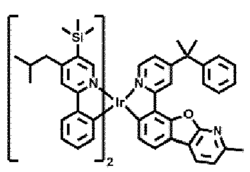
31

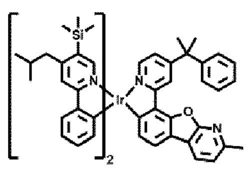
32

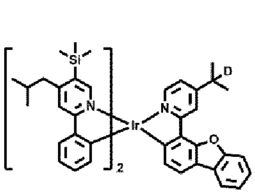
33

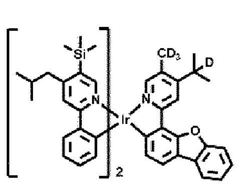
34

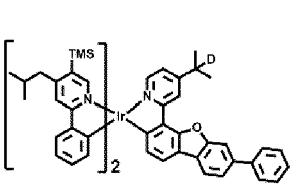
35

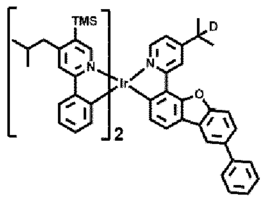
36

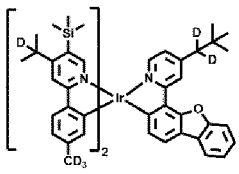
37

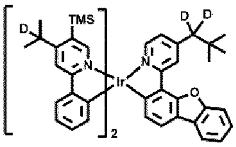
38

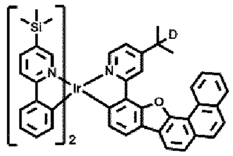
39

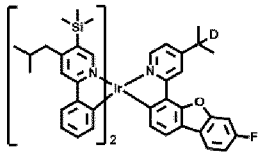
40

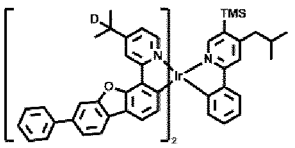
41

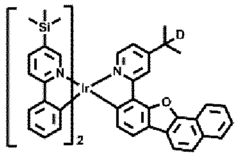
42

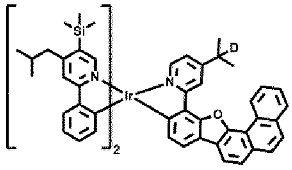
43

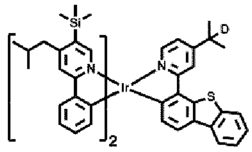
44

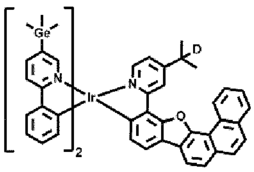
45

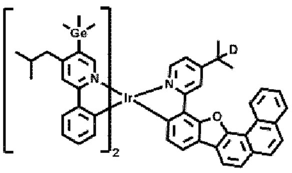
46

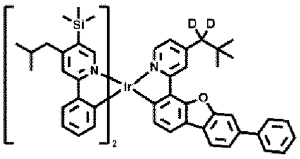
47

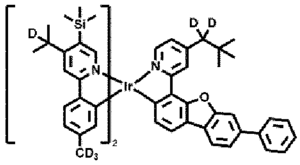
48

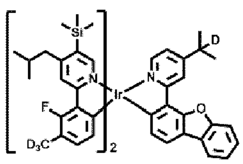
49

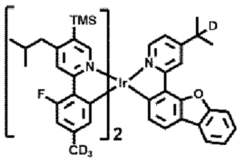
50

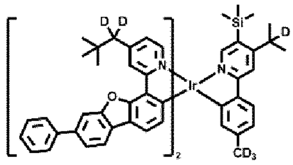
51

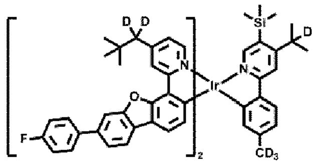
52

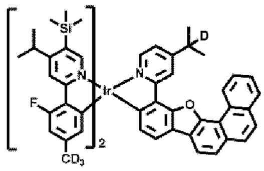
53

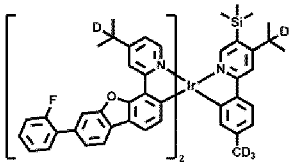
54

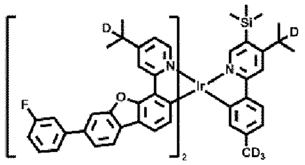
55

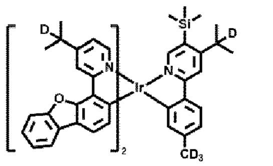
56

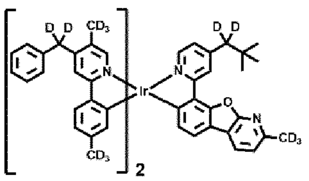
57

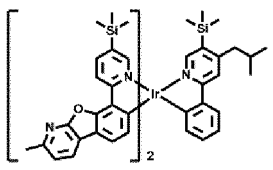
58

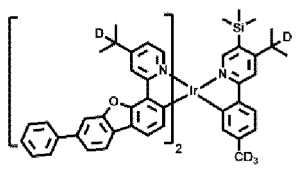
59

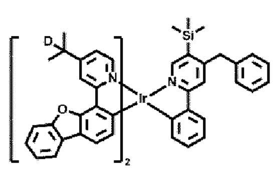
60

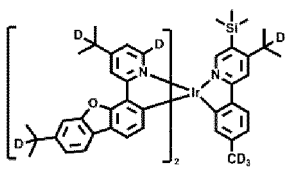
61

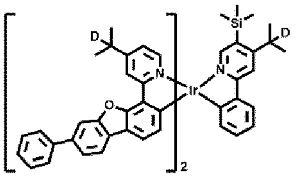
62

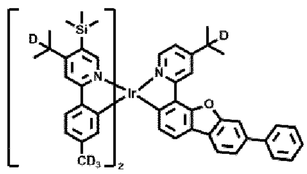
63

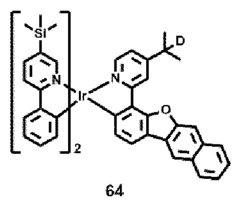
64

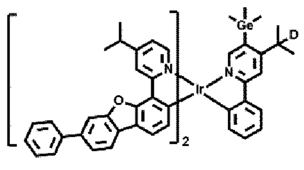
65

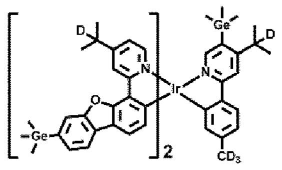
66

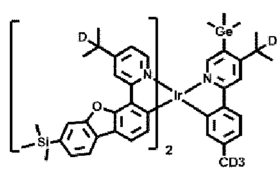
67

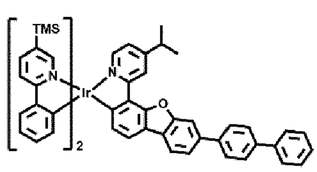
68

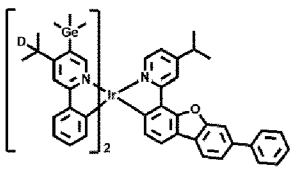
69

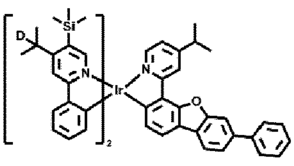
70

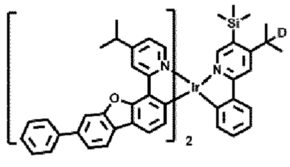
71

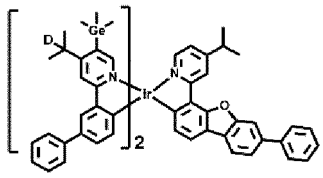
72

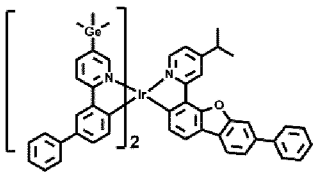
73

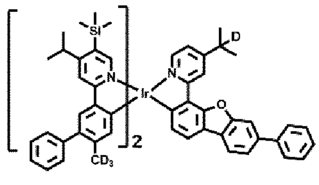
74

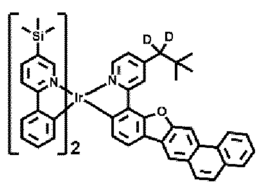
75

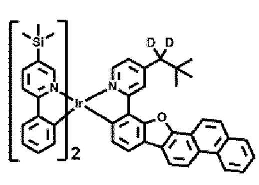
76

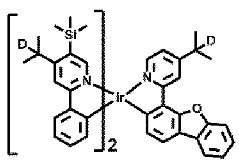
77

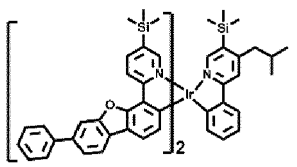
78

Group 2-4

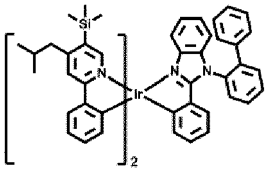

1

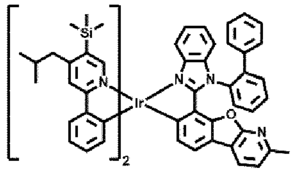

2

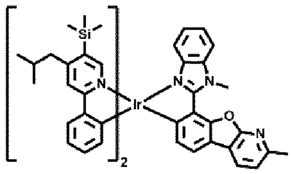

3

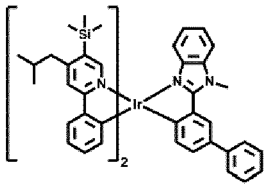

4

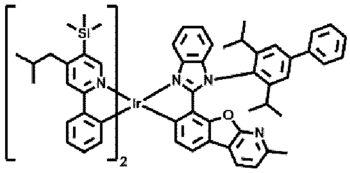

5

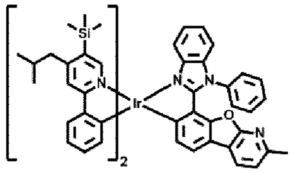

6

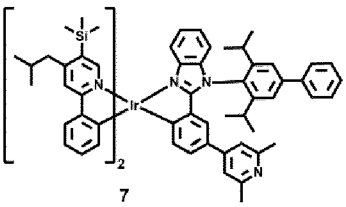

7

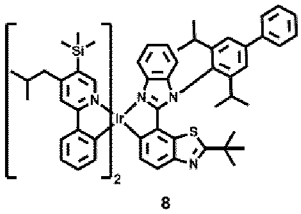

8

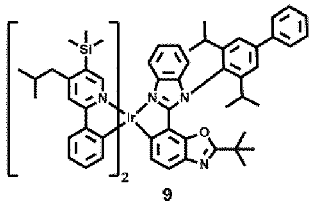

9

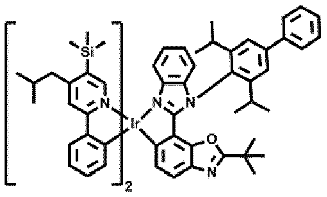

10

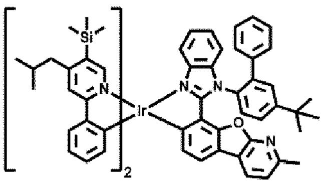

11

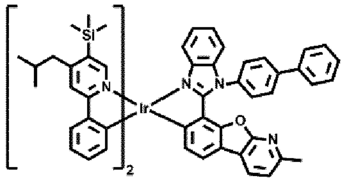

12

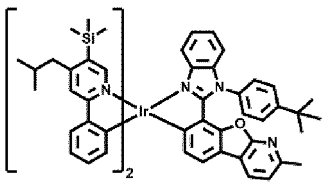

13

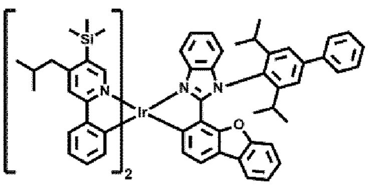

14

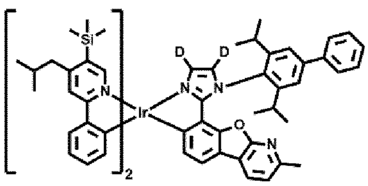

15

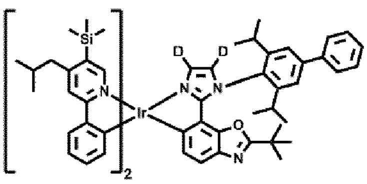

16

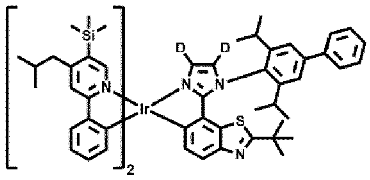

17

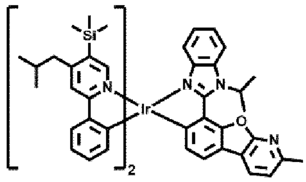

18

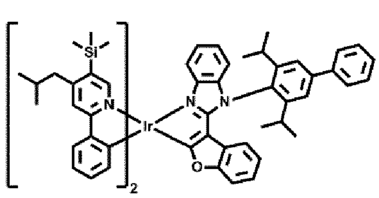
19

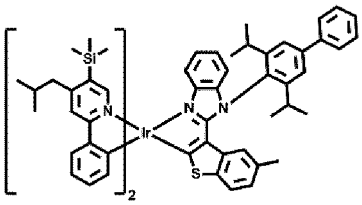
20

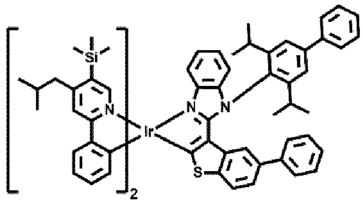
21

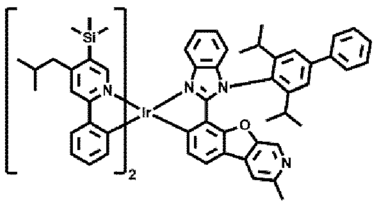
22

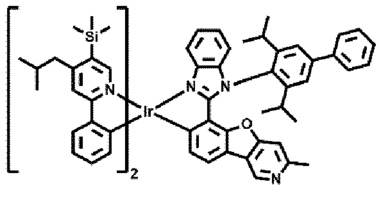
23

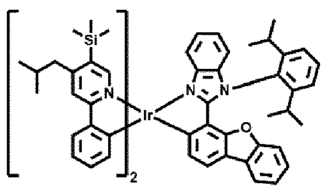
24

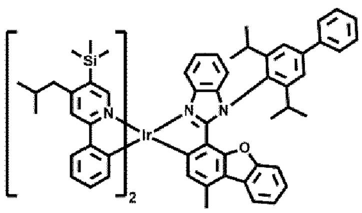
25

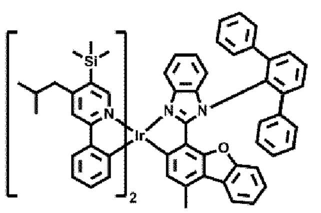
26

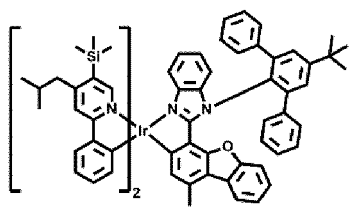
27

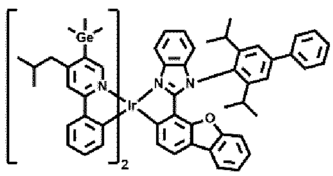
28

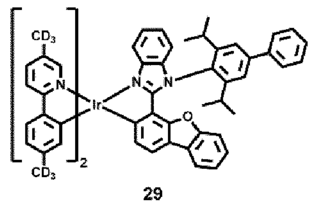
29

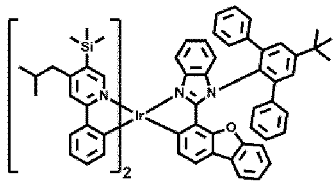
30

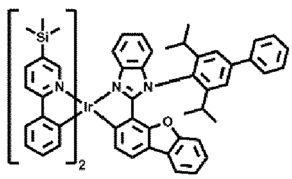
31

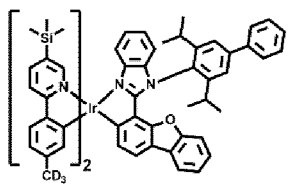
32

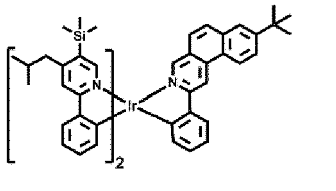
33

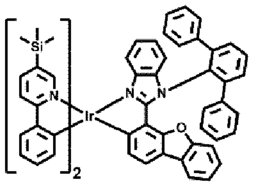
34

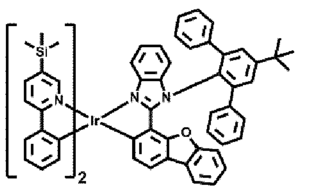
35

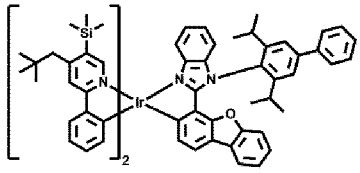
36

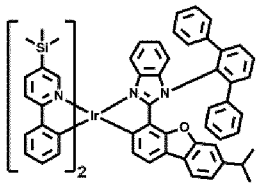
37

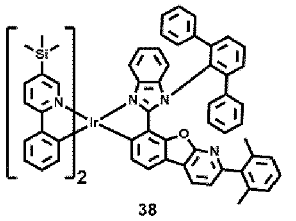
38

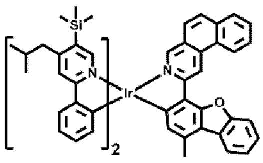
39

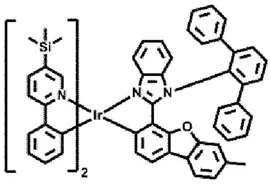
40

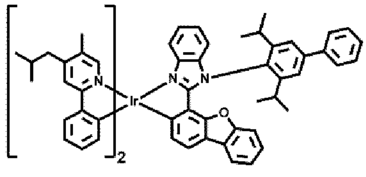
41

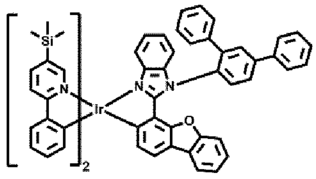
42

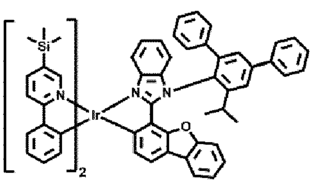
43

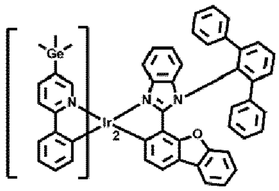
44

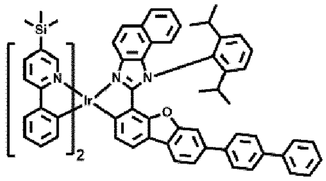
45

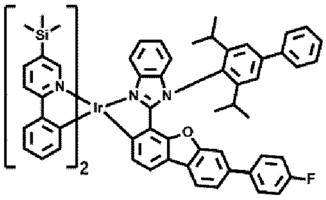
46

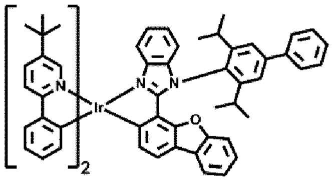
47

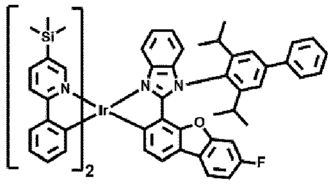
48

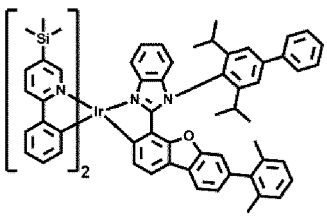
49

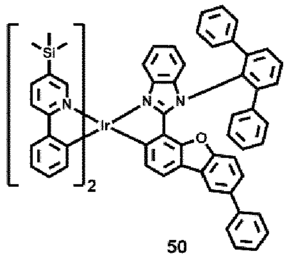
50

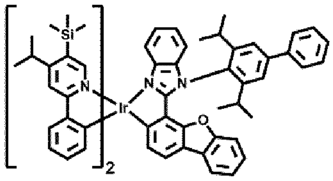
51

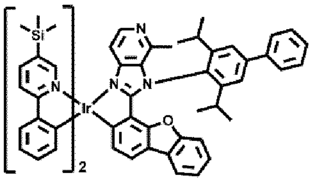
52

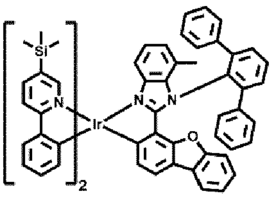
53

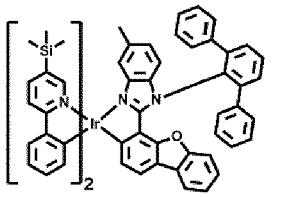
54

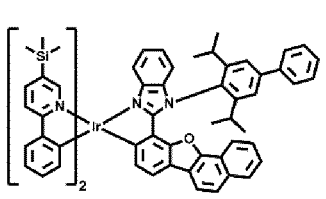
55

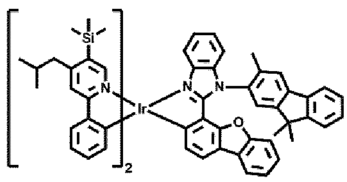
56

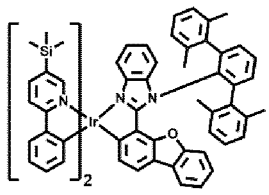
57

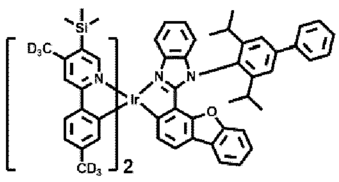
58

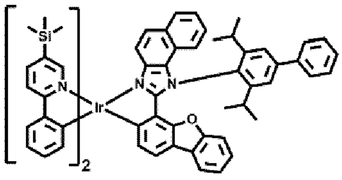
59

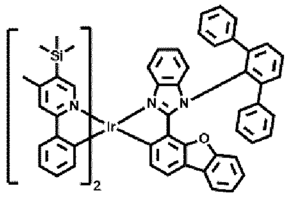
60

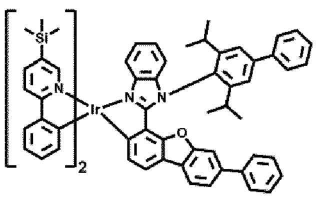
61

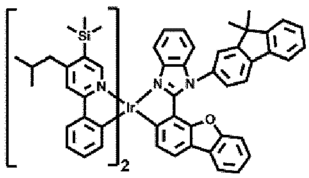
62

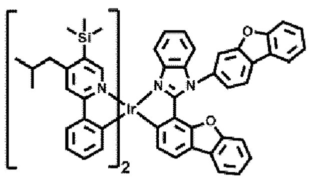
63

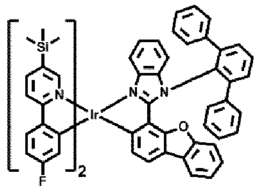
64

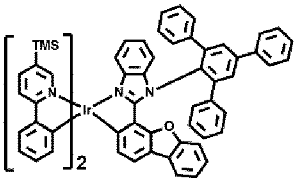
65

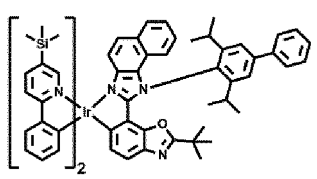
66

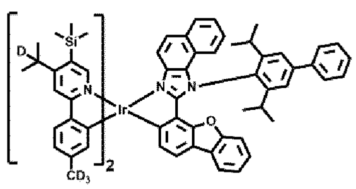
67

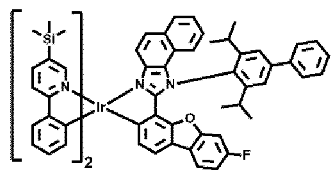
68

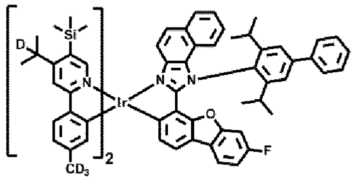
69

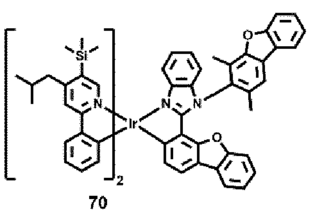
70

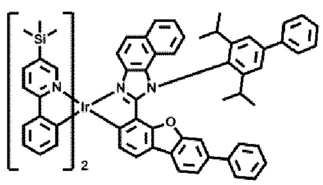
71

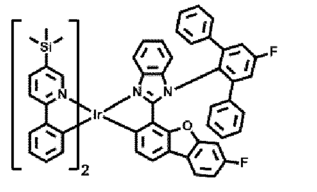
72

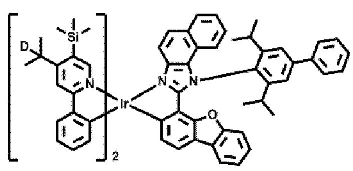
73

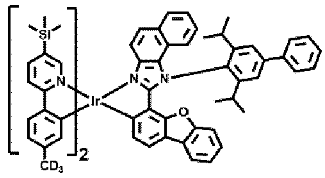
74

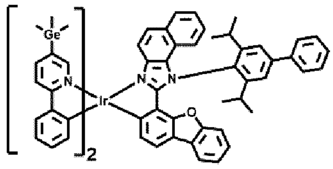
75

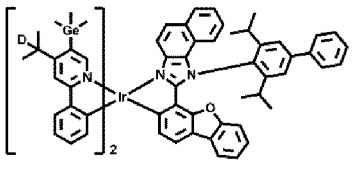
76

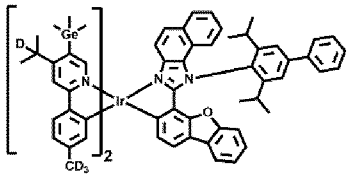
77

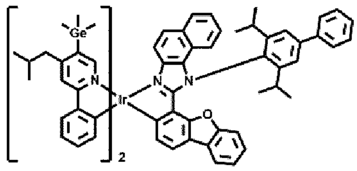
78

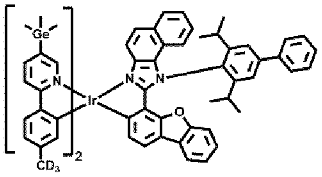
79

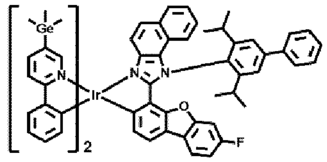
80

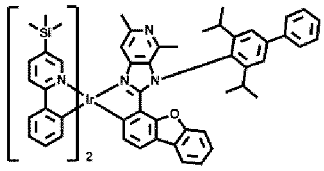
81

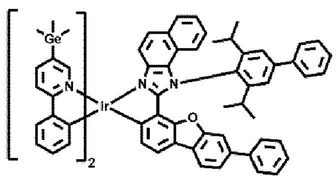
82

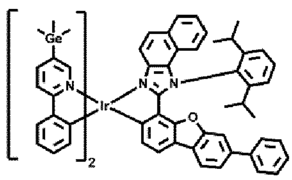
83

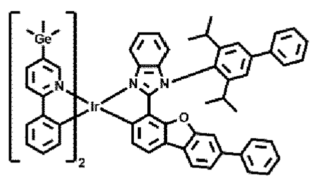
84

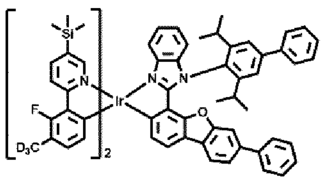
85

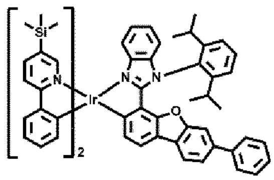
86

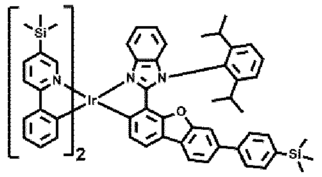
87

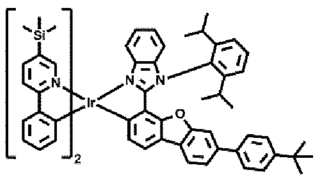
88

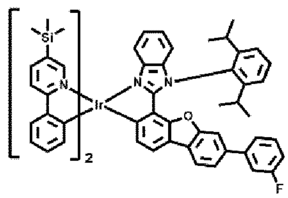
89

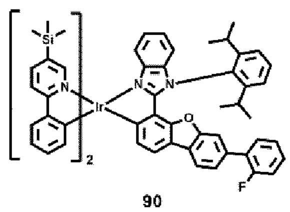
90

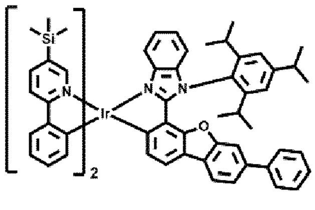

91

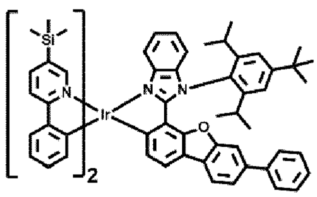

92

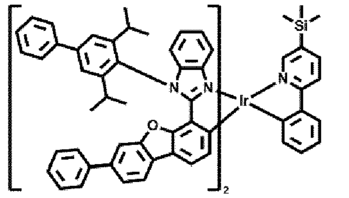

93

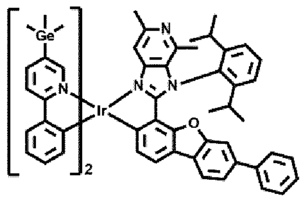

94

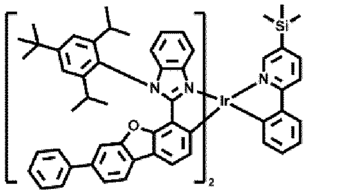

95

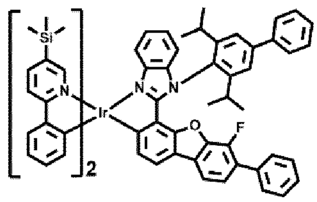

96

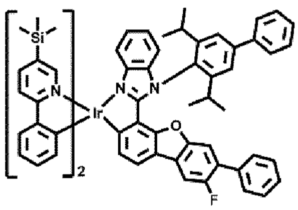

97

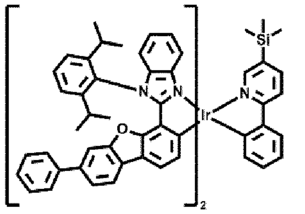

98

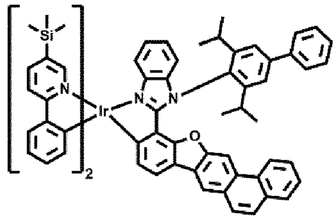

99

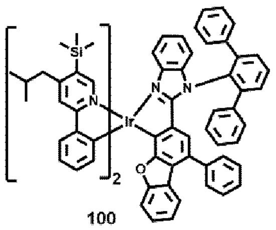

100

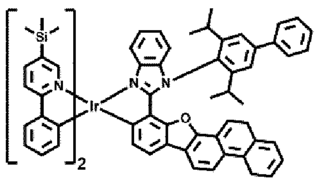

101

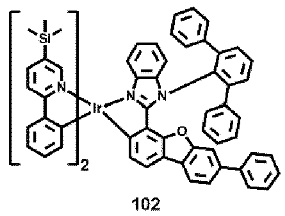

102

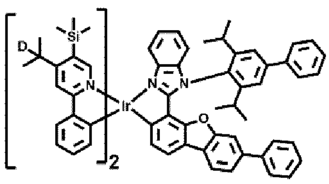

103

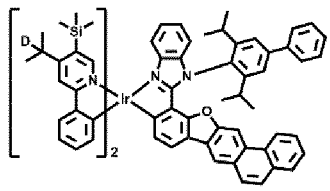

104

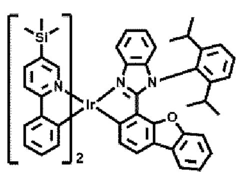

105

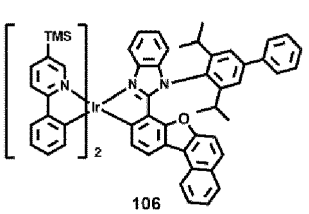

106

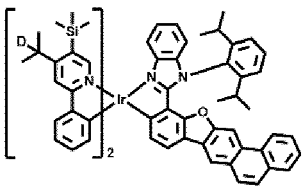

107

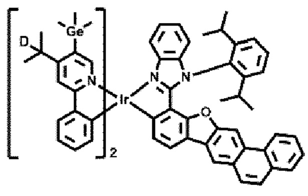

108

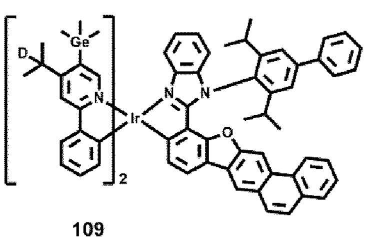

109

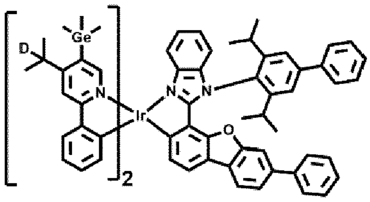

110

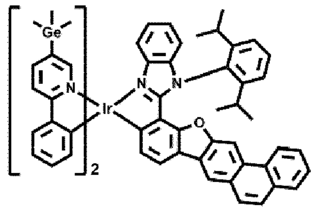

111

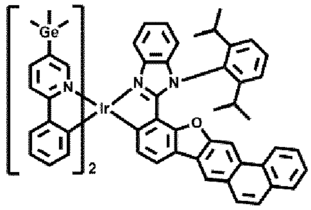

112

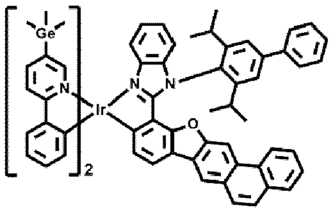

113

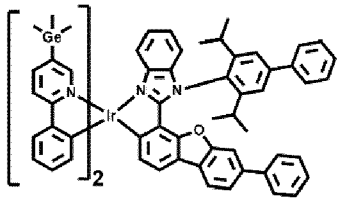

114

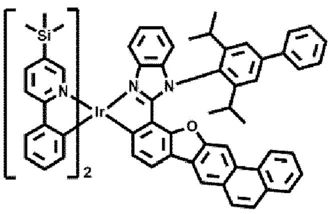

115

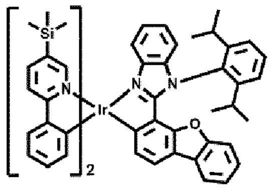

116

## Group 2-5

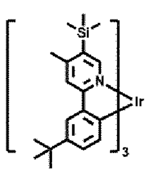

1

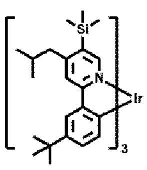

2

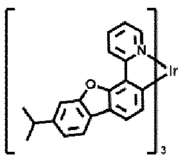

3

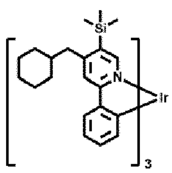

4

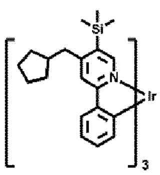

5

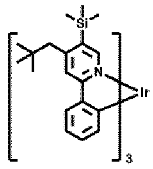

6

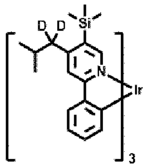

7

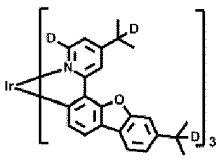

8

Group 2-6

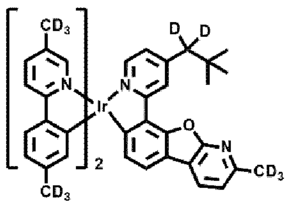
1

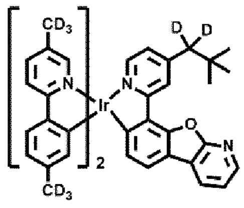
2

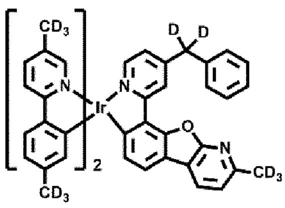
3

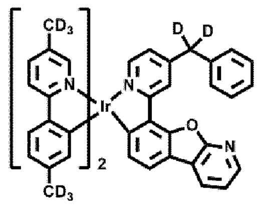
4

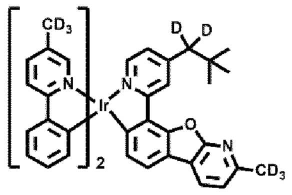
5

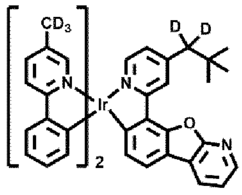
6

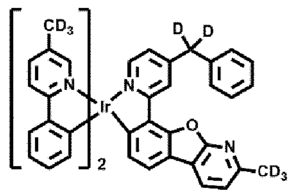
7

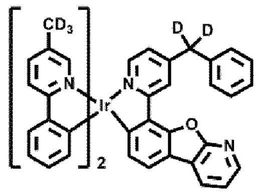
8

In the present specification, "OMe" is a methoxy group, "TMS" is a trimethylsilyl group, and "TMG" is a trimethylgermyl group.

In one or more embodiments, the iridium-containing organometallic compound may not be a compound of Group B:

Group B

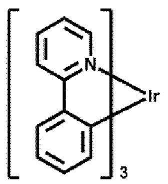
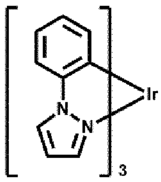
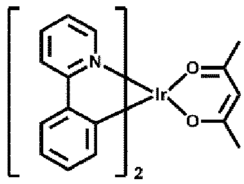
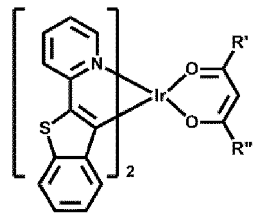
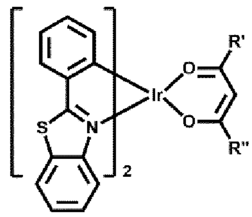
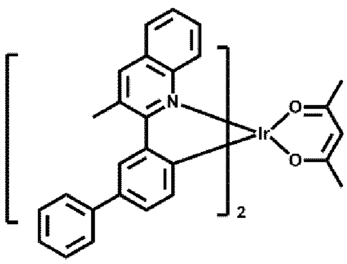
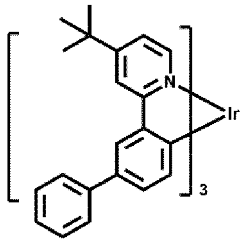
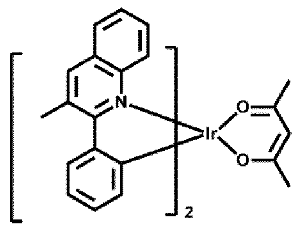
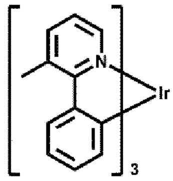
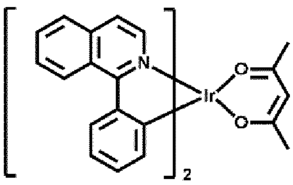
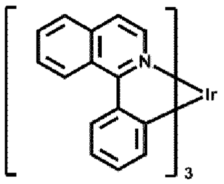
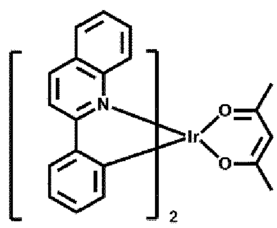
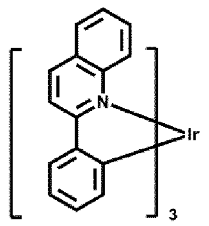

R' and R" of Group B may each be an alkyl group.

The fluorescent compound

a) may not include a transition metal, and

b) may include i) B(boron), and ii) O, S, N, or a combination thereof.

In one or more embodiments, the fluorescent compound may include at least one 6-membered ring containing at least one nitrogen atom and at least one boron atom.

In one or more embodiments, the fluorescent compound may be a compound represented by Formula 3 or a compound represented by Formula 4:

Formula 3

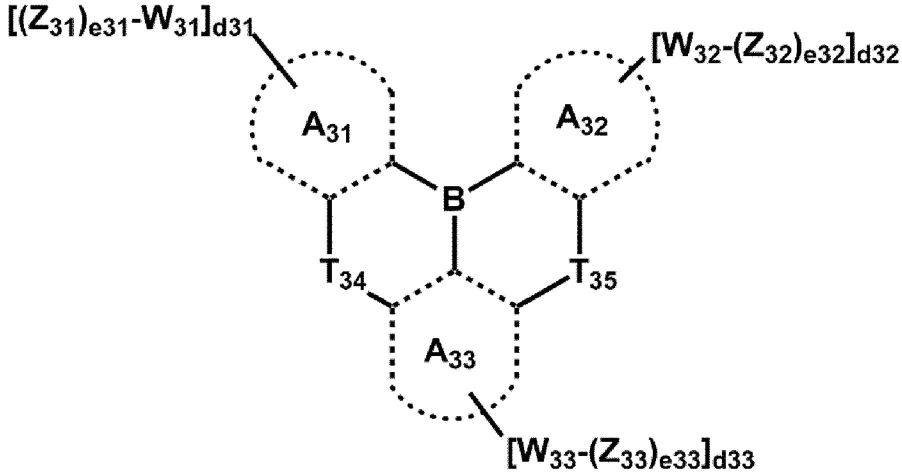

Formula 4

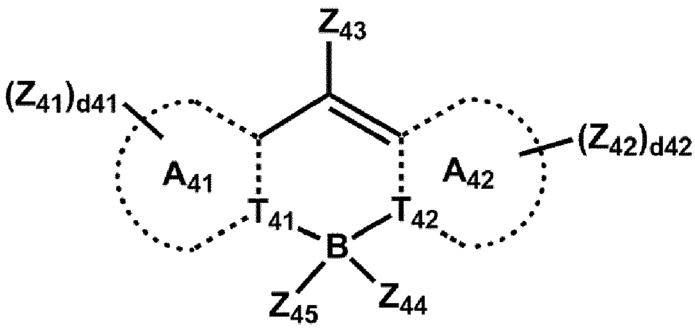

wherein, in Formulae 3 and 4,

ring $A_{31}$ to ring $A_{33}$, ring $A_{41}$, and ring $A_{42}$ may each independently be a $C_5$-$C_{30}$ carbocyclic group or a $C_1$-$C_{30}$ heterocyclic group,

$T_{34}$ may be O, S, or N-[$W_{34}$-$(Z_{34})_{e34}$],
$T_{35}$ may be O, S, or N-[$W_{35}$-$(Z_{35})_{e35}$],
$T_{41}$ and $T_{42}$ may each independently be N or C,
$W_{31}$ to $W_{33}$ are each the same as described in connection with $W_1$ in Formula 2-1,
$Z_{31}$ to $Z_{35}$ and $Z_{41}$ to $Z_{45}$ are each the same as described in connection with $Z_1$ in Formula 2-1,
e31 to e35 are each the same as described in connection with e1 in Formula 2-1, and
d31 to d33 and d41 to d42 are each the same as described in connection with d1 in Formula 2-1.

For example, ring $A_{31}$ to ring $A_{33}$, ring $A_{41}$ and ring $A_{42}$ are each the same as described in connection with ring $A_1$ in Formula 2-1.

In one or more embodiments, in relation to Formula 3, ring $A_{31}$ and $A_{32}$ may each be a benzene group, and ring $A_{33}$ may be a benzene group, a quinoline group, or an isoquinoline group.

In one or more embodiments, $T_{34}$ in Formula 3 may be N-[$W_{34}$-$(Z_{34})_{e34}$].

In one or more embodiments, $T_{34}$ in Formula 3 may be N-[$W_{34}$-$(Z_{34})_{e34}$], and $Z_{34}$ and ring $A_{31}$ and/or $Z_{34}$ and

$Z_{31}$ may be bonded to each other via a single bond, or a linking group including O, S, N, B, C, or a combination thereof.

In one or more embodiments, $T_{35}$ in Formula 3 may be N-[$W_{35}$-$(Z_{35})_{e35}$].

In one or more embodiments, $T_{35}$ in Formula 3 may be N-[$W_{35}$-$(Z_{35})_{e35}$], and $Z_{35}$ and ring $A_{32}$ and/or $Z_{35}$ and $Z_{32}$ may be bonded to each other via a single bond or a linking group including O, S, N, B, C, or a combination thereof.

In one or more embodiments, ring $A_{41}$ and ring $A_{42}$ in Formula 4 may each be pyrrolyl. For example, $T_{41}$ and $T_{42}$ may each be N.

For example, the fluorescent compound may be a compound of Group 3 or Group 4:

Group 3

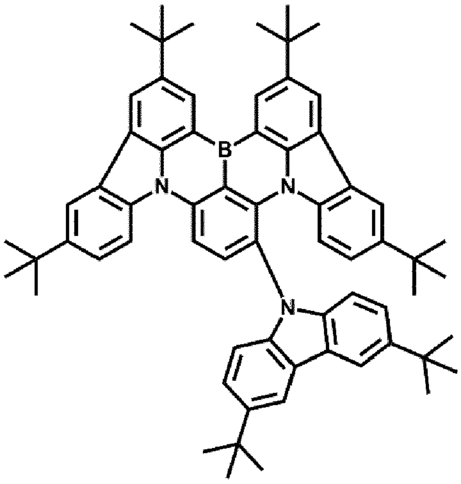

1

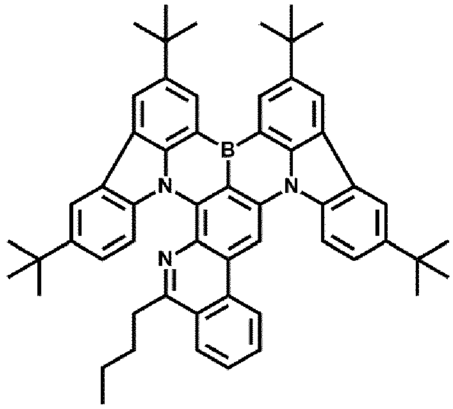

2

Group 4

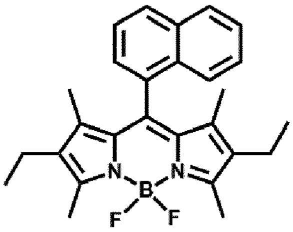

1

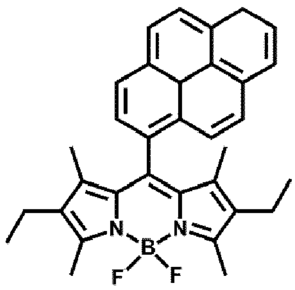

2

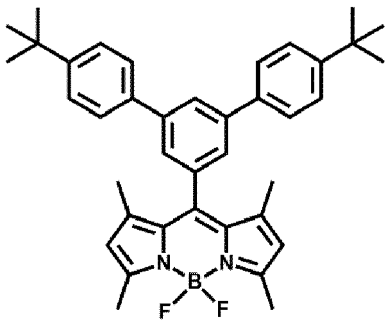

3

A weight ratio of the first compound to the second compound included in the mixture including the first compound and the second compound may be about 90:10 to about 10:90, about 80:20 to about 20:80, about 70:30 to about 30:70, or about 60:40 to about 40:60.

Descriptions of FIGS. 2 to 31

FIGS. 2 to 31 each show a cross-sectional view of an OLED substrate according to one or more embodiments.

The OLED substrate of FIG. 2 has a tandem structure in which a first electrode 10, a blue first emission unit 31B, a green second emission unit 32G, and a second electrode 50 are vertically stacked in sequence. That is, the OLED substrate of FIG. 2 includes one blue emission unit 31B and one green emission unit 32G.

A color control unit 2 may be located above the second electrode 50. That is, the green second emission unit 32G of FIG. 2 may be located closer to the color control unit 2 than the blue first emission unit 31B.

The first electrode 10 may be anode, which is a hole injection electrode, and the second electrode 50 may be a cathode, which is an electron injection electrode. Alternatively, the first electrode 10 may be a cathode, which is an

electron injection electrode, and the second electrode 50 may be an anode, which is a hole injection electrode.

A thin-film transistor (TFT) array substrate including a plurality of TFT (not shown) may be provided under the first electrode 10, and an OLED substrate 1 may be provided on the TFT array substrate.

The first electrode 10 may be formed by, for example, applying a material for forming the first electrode 10 onto the substrate by using a deposition or sputtering method. The first electrode 10 may be an anode. The material for forming the first electrode 10 may include materials with a high work function to facilitate hole injection. The first electrode 10 may be a reflective electrode, a semi-transmissive electrode, or a transmissive electrode. The material for forming the first electrode 10 may be indium tin oxide (ITO), indium zinc oxide (IZO), tin oxide ($SnO_2$), or zinc oxide (ZnO). In one or more embodiments, the material for forming the first electrode 10 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 10 may have a single-layered structure or a multi-layered structure including a plurality of layers. For example, the first electrode 10 may have a three-layered structure of ITO/Ag/ITO.

The first electrode 10 may be a patterned element corresponding to each subpixel area and electrically connected to each TFT element of the TFT array substrate (not shown).

The blue first emission unit 31B may include a blue luminescent compound (i.e., a blue light-emitting compound).

The blue luminescent compound may include a blue phosphorescent compound, and a blue fluorescent compound (thermal activated delayed fluorescence (TADF) compound and/or prompt fluorescent compound).

In one or more embodiments, the blue luminescent compound may be an iridium-containing organometallic compound or a platinum-containing organometallic compound. The iridium-containing organometallic compound may include a ligand having a carbene moiety, and the carbon of the carbene moiety of the ligand and the iridium of the iridium-containing organometallic compound may be connected by a chemical bond.

In one or more embodiments, the blue luminescent compound may be a fluorescent compound including at least one boron (B) atom and at least one nitrogen (N) atom. In one or more embodiments, the blue luminescent compound may include a $C_6$-$C_{60}$ polycyclic group in which a 6-membered ring containing boron atom and a nitrogen atom as ring-forming atoms and a cyclic group are condensed with each other.

The green second emission unit 32G may include a mixture of the first compound and the second compound as described herein.

The second electrode 50 may be the cathode. A material for forming the second electrode 50 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 50.

The second electrode 50 may be an unpatterned common electrode, or may be patterned with a plurality of electrode elements.

A protective layer (not shown) may additionally be located on the second electrode 50. In one or more embodiments, the protective layer may include a transparent insulating material.

Referring to FIG. 1, the blue light emitted from the blue first emission unit 31B and the green light emitted from the green second emission unit 32G pass through the second electrode 50 and the color of each light is adjusted by the color control unit 2 and then the adjusted each light is emitted toward outside the light-emitting device.

The OLED substrate of FIG. 3 has a tandem structure in which the first electrode 10, a green first emission unit 31G, a blue second emission unit 32B, and the second electrode 50 are vertically stacked in this order.

The OLED substrate may include two blue emission units and one green emission unit, as illustrated in FIGS. 4 to 6.

The OLED substrate of FIG. 4 has a tandem structure in which the first electrode 10, the blue first emission unit 31B, the blue second emission unit 32B, a green third emission unit 33G, and the second electrode 50 are vertically stacked in this order.

The OLED substrate of FIG. 5 has a tandem structure in which the first electrode 10, the blue first emission unit 31B, the green second emission unit 32G, a blue third emission unit 33B, and the second electrode 50 are vertically stacked in this order.

The OLED substrate of FIG. 6 has a tandem structure in which the first electrode 10, the green first emission unit 31G, the blue second emission unit 32B, the blue third emission unit 33B, and the second electrode 50 are vertically stacked in this order.

The OLED substrate may include three blue emission units and one green emission unit, as illustrated in FIGS. 7 to 10.

The OLED substrate of FIG. 7 has a tandem structure in which the first electrode 10, the blue first emission unit 31B, the blue second emission unit 32B, the blue third emission unit 33B, a green fourth emission unit 34G, and the second electrode 50 are vertically stacked in this order.

The OLED substrate of FIG. 8 has a tandem structure in which the first electrode 10, the blue first emission

unit 31B, the blue second emission unit 32B, the green third emission unit 33G, a blue fourth emission unit 34B, and the second electrode 50 are vertically stacked in this order.

The OLED substrate of FIG. 9 has a tandem structure in which the first electrode 10, the blue first emission unit 31B, the green second emission unit 32G, the blue third emission unit 33B, the blue fourth emission unit 34B and the second electrode 50 are vertically stacked in this order.

The OLED substrate of FIG. 10 has a tandem structure in which the first electrode 10, the green first emission unit 31G, the blue second emission unit 32B, the blue third emission unit 33B, the blue fourth emission unit 34B, and the second electrode 50 are vertically stacked in this order.

The OLED substrate may include four blue emission units and one green emission unit, as illustrated in FIGS. 11 to 15.

The OLED substrate of FIG. 11 has a tandem structure in which the first electrode 10, the blue first emission unit 31B, the blue second emission unit 32B, the blue third emission unit 33B, the blue fourth emission unit 34B, a green fifth emission unit 35G, and the second electrode 50 are vertically stacked in this order.

The OLED substrate of FIG. 12 has a tandem structure in which the first electrode 10, the blue first emission unit 31B, the blue second emission unit 32B, a blue third emission unit 33B, a green fourth emission unit 34G, a blue fifth emission unit 35B, and the second electrode 50 are vertically stacked in this order.

The OLED substrate of FIG. 13 has a tandem structure in which the first electrode 10, the blue first emission unit 31B, the blue second emission unit 32B, the green third emission unit 33G, the blue fourth emission unit 34B, the blue fifth emission unit 35B, and the second electrode 50 are vertically stacked in this order.

The OLED substrate of FIG. 14 has a tandem structure in which the first electrode 10, the blue first emission unit 31B, the green second emission unit 32G, the blue third emission unit 33B, the blue fourth emission unit 34B, the blue fifth emission unit 35B, and the second electrode 50 are vertically stacked in this order.

The OLED substrate of FIG. 15 has a tandem structure in which the first electrode 10, the green first emission unit 31G, the blue second emission unit 32B, the blue third emission unit 33B, the blue fourth emission unit 34B, the blue fifth emission unit 35B, and the second electrode 50 are vertically stacked in this order.

The OLED substrate may include two blue emission units and two green emission units, as illustrated in FIGS. 16 to 19.

The OLED substrate of FIG. 16 has a tandem structure in which the first electrode 10, the green first emission unit 31G, the green second emission unit 32G, the blue third emission unit 33B, the blue fourth emission unit 34B, and the second electrode 50 are vertically stacked in this order.

The OLED substrate of FIG. 17 has a tandem structure in which the first electrode 10, the green first emission unit 31G, the blue second emission unit 32B, the green third emission unit 33G, the blue fourth emission unit 34B, and the second electrode 50 are vertically stacked in this order.

The OLED substrate of FIG. 18 has a tandem structure in which the first electrode 10, the blue first emission unit 31B, the green second emission unit 32G, the green third emission unit 33G, the blue fourth emission unit 34B, and the second electrode 50 are vertically stacked in this order.

The OLED substrate of FIG. 19 has a tandem structure in which the first electrode 10, the blue first emission unit 31B, the blue second emission unit 32B, the green third emission unit 33G, the green fourth emission unit 34G, and the second electrode 50 are vertically stacked in this order.

The OLED substrate may include three blue emission units and two green emission units, as illustrated in FIGS. 20 to 29.

The OLED substrate of FIG. 20 has a tandem structure in which the first electrode 10, the blue first emission unit 31B, the blue second emission unit 32B, the blue third emission unit 33B, the green fourth emission unit 34G, the green fifth emission unit 35G, and the second electrode 50 are vertically stacked in this order.

The OLED substrate of FIG. 21 has a tandem structure in which the first electrode 10, the blue first emission unit 31B, the blue second emission unit 32B, the green third emission unit 33G, the blue fourth emission unit 34B, the green fifth emission unit 35G, and the second electrode 50 are vertically stacked in this order.

The OLED substrate of FIG. 22 has a tandem structure in which the first electrode 10, the blue first emission unit 31B, the blue second emission unit 32B, the green third emission unit 33G, the green fourth emission unit 34G, the blue fifth emission unit 35B, and the second electrode 50 are vertically stacked in this order.

The OLED substrate of FIG. 23 has a tandem structure in which the first electrode 10, the blue first emission unit 31B, the green second emission unit 32G, the blue third emission unit 33B, the blue fourth emission unit 34B, the green fifth emission unit 35G, and the second electrode 50 are vertically stacked in this order.

The OLED substrate of FIG. 24 has a tandem structure in which the first electrode 10, the blue first emission unit 31B, the green second emission unit 32G, the blue third emission unit 33B, the green fourth emission unit 34G, the blue fifth emission unit 35B, and the second electrode 50 are vertically stacked in this order.

The OLED substrate of FIG. 25 has a tandem structure in which the first electrode 10, the blue first emission unit 31B, the green second emission unit 32G, the green third emission unit 33G, the blue fourth emission unit 34B, the

blue fifth emission unit 35B, and the second electrode 50 are vertically stacked in this order.

The OLED substrate of FIG. 26 has a tandem structure in which the first electrode 10, the green first emission unit 31G, the blue second emission unit 32B, the blue third emission unit 33B, the blue fourth emission unit 34B, the green fifth emission unit 35G, and the second electrode 50 are vertically stacked in this order.

The OLED substrate of FIG. 27 has a tandem structure in which the first electrode 10, the green first emission unit 31G, the blue second emission unit 32B, the blue third emission unit 33B, the green fourth emission unit 34G, the blue fifth emission unit 35B, and the second electrode 50 are vertically stacked in this order.

The OLED substrate of FIG. 28 has a tandem structure in which the first electrode 10, the green first emission unit 31G, the blue second emission unit 32B, the green third emission unit 33G, the blue fourth emission unit 34B, the blue fifth emission unit 35B, and the second electrode 50 are vertically stacked in this order.

The OLED substrate of FIG. 29 has a tandem structure in which the first electrode 10, the green first emission unit 31G, the green second emission unit 32G, the blue third emission unit 33B, the blue fourth emission unit 34B, the blue fifth emission unit 35B, and the second electrode 50 are vertically stacked in this order.

The OLED substrates of FIGS. 3 to 29 may be understood by referring to the OLED substrate of FIG. 2 except that the number of emission units and/or the emission color has been changed.

The OLED substrate of FIG. 30 has a tandem structure in which the first electrode 10, the blue first emission unit 31B, a first charge generation layer 61, the blue second emission unit 32B, a second charge generation layer 62, the blue third emission unit 33B, a third charge generation layer 63, the green fourth emission unit 34G, an electron transport region 40, and the second electrode 50 are vertically stacked in this order.

Each of the first electrode 10, the blue first emission unit 31B, the blue second emission unit 32B, the blue third emission unit 33B, the green fourth emission unit 34G, and the second electrode 50 of FIG. 30 is the same as described in connection with FIG. 7.

The first charge generation layer 61 may supply charges to the blue first emission unit 31B and/or the blue second emission unit 32B, and the second charge generation layer 62 may supply charges to the blue second emission unit 32B and/or the blue third emission unit 33B, and the third charge generation layer 63 may supply charges to the blue third emission unit 33B and/or the green fourth emission unit 34G. Accordingly, the three blue emission units 31B, 32B, and 33B and one green emission unit 34G may emit light effectively.

The electron transport region 40 may transfer electrons injected from the second electrode 50 to the green fourth emission unit 34G. In one or more embodiments, the electron transport region 40 may include a hole-blocking layer, an electron transport layer, an electron injection layer, or a combination thereof.

The OLED substrate of FIG. 31 is a diagram illustrating details of the structure of each of the blue first emission unit 31B, the blue second emission unit 32B, the blue third emission unit 33B, and the green fourth emission unit 34G of the OLED substrate of FIG. 30.

The blue first emission unit 31B may include a first hole transport region HTL 1 and a blue first emission layer EML 1B, the blue second emission unit 32B may include a second hole transport region HTL 2 and a blue second emission layer EML 2B, the blue third emission unit 33B may include a third hole transport region HTL 3 and a blue third emission layer EML 3B, and the green fourth emission unit 34G may include a fourth hole transport region HTL 4 and a green fourth emission layer EML 4G.

The first hole transport region HTL 1, the second hole transport region HTL 2, the third hole transport region HTL 3, and the fourth hole transport region HTL 4 may transfer holes to the blue first emission layer EML 1B, the blue second emission layer EML 2B, the blue third emission layer EML 3B, and the green fourth emission layer EML 4G, respectively. Each of the first hole transport region HTL 1, the second hole transport region HTL 2, the third hole transport region HTL 3, and the fourth hole transport region HTL 4 may include a hole injection layer, a hole transport layer, an electron-blocking layer, a buffer layer, or a combination thereof.

The blue first emission layer EML 1B, the blue second emission layer EML 2B, and the blue third emission layer EML 3B may include the blue luminescent compound as described above, and the green fourth emission layer EML 4G may include a mixture of the first compound and the second compound as described herein.

The green fourth emission layer EML 4G may include a host in addition to the mixture of the first compound and the second compound. The host may include a hole-transporting host, an electron-transporting host, a bipolar host, or a combination thereof.

In one or more embodiments, the green fourth emission layer EML 4G may be formed by i) co-depositing a first compound, a second compound, and a host or ii) a soluble process in which a solution including a first compound, a second compound, and a host is provided, and heat treatment is performed.

Although not shown, the OLED substrate of FIGS. 2 to 6 and 8 to 29 may be variously changed with reference to the first charge generation layer 61, the second charge generation layer 62 and/or the third charge generation layer 63 of FIG. 30 and the first hole transport region HTL 1, the second hole transport region HTL 2, the third hole transport region HTL 3, the fourth hole transport region HTL 4, the blue first emission layer EML 1B, the blue second emission layer EML 2B, the blue third emission layer EML 3B, and/or the green fourth emission layer EML 4G of FIG. 31.

Description of FIG. 32

FIG. 32 is a cross-sectional view illustrating a light-emitting device according to one or more embodiments.

The light-emitting device of FIG. 32 may include an OLED substrate 100 and a color control unit 200.

The OLED substrate 100 may be the same as described above (for example, with reference to FIGS. 2 to 31).

The color control unit 200 may include a first color control element 70a including a first quantum dot (green light emitting quantum dot (G-QD)) for green conversion, a second color control element 70b including a second quantum dot (red light emitting quantum dot (R-QD)) for red conversion, and a third color control element 75c for blue expression. The color control element is not limited to including a quantum dot. In one or more embodiments, an inorganic material, an organic material, or a combination thereof that absorbs blue light or/and green light and converts the same to green light or red light, may be used as the color control element. In one or more embodiments, the color control unit 200 may further include a first color filter 80a located on the first color control element 70a and a second color filter 80b located on the second color control element 70b.

The first color control element 70a may be a green-QD-containing layer, and may convert light generated from the OLED substrate 100 into green light G. The second color control element 70b may be a red-QD containing layer and may convert light generated from the OLED substrate 100 to red light R. Accordingly, the first color control element 70a may be referred to as a first color conversion element, and the second color control element 70b may be referred to as a second color conversion element. The color conversion element may include a resin material, a plurality of quantum dots, and a light scattering agent. The resin material may include, for example, a photoresist (PR) material. In one or more embodiments, the third color control element 75c may be a color filter that optionally allows the blue (B) wavelength region of the light generated from the OLED substrate 100 to pass therethrough. In other words, the third color control element 75c may be a blue-color filter (C/F or CF). In this case, the third color control element 75c may be an absorption type color filter including a specific pigment(s) or quantum dot(s). The absorption type color filter may absorb light of wavelength band except light of the target wavelength band.

The first color filter 80a may cut the remaining blue region wavelength of the light that has passed through the first color control element 70a. The second color filter 80b may cut the remaining blue and green regions wavelength of the light that has passed through the second color control element 70b. The first color filter 80a may be referred to as a blue-cut filter, and the second color filter 80b may be referred to as a blue and green-cut filter. Accordingly, color-controlling/filtering characteristics may be improved by the first color filter 80a and the second color filter 80b. Although not illustrated, a separate optical film may be additionally located on the third color control element 75c. Full colors of RGB may be realized by using the color control unit 200. Herein, the arrangement order or arrangement method of the RGB subpixels is an example, and may be variously changed.

The first quantum dot that may be included in the first color control element 70a may be green-QD, and the second quantum dot that may be included in the second color control element 70b may be red-QD. A quantum dot refers to a semiconductor particle of a small sphere of nanometer (nm) size or a similar shape, and may have a size (diameter) of about several nm to several tens of nm. A quantum dot may have a monolithic structure or a core-shell structure, and in the case of a core-shell structure, the quantum dot may have a single shell structure or a multi-shell structure. For example, a quantum dot may have a core portion (center) including a first semiconductor and a shell portion including a second semiconductor. Here, a material for the core portion (center) may be cadmium selenide (CdSe), cadmium telluride (CdTe), or cadmium sulfide (CdS), and a material for the shell portion may be zinc sulfide (ZnS). Also, a non-cadmium-based quantum dot (QD) may be used. That is, various materials not including cadmium (Cd) may be applied to the quantum dot. However, the materials specifically presented here are exemplary, and other various materials may be applied to the quantum dot. For example, the quantum dot may include at least one of a group II-VI semiconductor, a group III-V semiconductor, a group IV-VI semiconductor, a group IV semiconductor, or combination thereof.

Because quantum dots are very small in size, quantum dots may exhibit a quantum confinement effect. When a particle is very small, electrons in the particle form a discontinuous energy state by the outer wall of the particle. As the size of the space inside the particle is small, the energy state of the electrons is relatively high, and the energy band gap increases. This effect is called as the quantum confinement effect. According to such a quantum confinement effect, when light such as ultraviolet rays or visible rays is incident on a quantum dot, light of various wavelengths may be generated. The wavelength of light generated from a quantum dot may be determined by the size, material, and/or structure of the particle (quantum dot). Specifically, when light with a wavelength greater than the energy band width is incident on the quantum dot, the quantum dot may be excited by absorbing the energy of the light and may transit to a ground state while emitting light of a specific wavelength. In this case, as the size of the quantum dot (or, the core portion of the quantum dot) is smaller, light of a relatively short wavelength, for example, bluish light or greenish light may be generated, and as the size of the quantum dot (or, the core portion of the quantum dot) is larger, light of a relatively long wavelength, for example, reddish light may be generated. Therefore, light of various colors may be realized according to the size of the quantum dot (or the core portion of the quantum dot). Quantum dot particles that may emit greenish light may be referred to as green light quantum dot particles, and quantum dot particles that may emit reddish light may

be referred to as red light quantum dot particles. For example, green light quantum dot particles (or the core portion thereof) may be particles having a particle width (diameter) of about 2 nm to about 3 nm, and red light quantum dot particles (or the core portion thereof) may be particles having a particle width (diameter) of about 5 nm to about 6 nm. The emission wavelength may be controlled not only by the size (diameter) of the quantum dot but also by the material and structure.

Since the first color control element 70a may be regarded as a kind of color filter that converts colors using quantum dots, the first color control element 70a may be referred to as a "first QD color filter". Similarly, the second color control element 70b may be referred to as a "second QD color filter".

The first color filter 80a and the second color filter 80b of a cut-off filter type may be formed in, for example, a distributed Bragg reflector (DBR) structure. A DBR structure that passes or reflects only the desired wavelength band may be created by repeatedly stacking two material layers (dielectrics) having different refractive indices and adjusting the thickness and the number of layers to be stacked of the material layers. The DBR structure may be applied to the first color filter 80a and the second color filter 80b. For example, a $SiO_2$ layer and a $TiO_2$ layer may be repeatedly stacked under $\lambda/4$ condition (here, "A" represents a wavelength of light), and the thickness and the number of layers to be stacked may be controlled to increase a reflectance and a transmittance of a desired wavelength band. As the DBR structure is well known, the detailed descriptions thereof are omitted herein. In addition, at least one of the first color filter 80a and the second color filter 80b may have a structure other than the DBR structure, for example, a high-contrast grating (HCG) structure.

Description of FIG. 33

FIG. 33 is a cross-sectional view illustrating a light-emitting device according to one or more embodiments.

The light-emitting device of FIG. 33 may include the OLED substrate 100 and a color control unit 201.

The OLED substrate 100 may be the same as described above (for example, with reference to FIGS. 2 to 31).

The color control unit 201 of FIG. 33 is the same as the color control unit 200 of FIG. 32 except that a light scattering element 71c located between the third color control element 75c and the OLED substrate 100 is added.

The light scattering element 71c may include a resin material and a light scattering agent. In this embodiment, the resin material may include a photoresist (PR) material. The light scattering agent may include, for example, titanium oxide ($TiO_2$). The first color control element 70a and the second color control element 70b may each include a light scattering agent. Accordingly, by positioning the light scattering element 71c under the third color control element 75c, the impression of colors may be balanced. In other words, change in visibility in a RGB region may be reduced.

Description of FIG. 34

FIG. 34 is a cross-sectional view illustrating a light-emitting device according to one or more embodiments;

The light-emitting device of FIG. 34 may include the OLED substrate 100 and a color control unit 202.

The OLED substrate 100 may be the same as described above (for example, with reference to FIGS. 2 to 31).

The color control unit 202 of FIG. 34 is the same as the color control unit 200 of FIG. 32 except that a blue-QD(blue light-emitting quantum dot)-containing layer as the third color control element 70c is used instead of the blue-color filter (B-C/F) as the third color control element 75c, and a third color filter 80c disposed on the third color control element 75c may be further included. The third color filter 80c may optionally be included.

The third color control element 70c may convert the light generated from the OLED substrate 100 into blue light B. Accordingly, the third color control element 70c may be referred to as a third color conversion element. The third color control element 70c may include a resin material, quantum dots, and a light scattering agent. The third color filter 80c may cut the remaining green region wavelength of the light that has passed through the third color control element 70c. That is, the third color filter 80c may be a green-cut filter.

Description of FIG. 35

FIG. 35 is a cross-sectional view illustrating a light-emitting device according to one or more embodiments;

The light-emitting device of FIG. 35 may include the OLED substrate 100 and a color control unit 203.

The OLED substrate 100 may be the same as described above (for example, with reference to FIGS. 2 to 31).

The color control unit 203 of FIG. 35 is the same as the color control unit 201 of FIG. 33, except that a first color filter 75a and a second color filter 75b are used instead of the first color filter 80a and the second color filter 80b that are of a cut-off filter type, respectively.

An absorption-type green-color filter (G-C/F) may be used as the first color filter 75a, and an absorption-type red-color filter (R-C/F) may be used as the second color filter 75b. The green-color filter 75a may selectively transmit light in the green wavelength region and absorb light in the other wavelength region. Similarly, the red-color filter 75b

may selectively transmit light in the red wavelength region and absorb light in the other wavelength region. The color control unit 203 of the present embodiment uses absorption type color filters 75a, 75b, and 75c respectively for the R-subpixel, G-subpixel and B-subpixel regions. In this embodiment, the third color control element 70c containing the blue-QD in FIG. 34 may be used instead of the light scattering element 71c.

Description of FIGS. 36 to 39

In one or more embodiments, the light-emitting device may further include a fourth sub-pixel, in addition to a R-sub-pixel (first sub-pixel), a G-sub-pixel (second sub-pixel), and a B-sub-pixel (third sub-pixel). The fourth sub-pixel may be configured to exhibit a color (a fourth color) other than R, G, and B. The other color (fourth color) may be, for example, cyan (C). Embodiments of the light-emitting device further including the fourth sub-pixel area are illustrated in FIGS. 36 to 39. In FIGS. 36 to 39, 100a denotes an OLED substrate, and 200a, 201a, 202a, and 203a denote color control units.

Referring to FIG. 36, the present embodiment is similar to the configuration described in connection with FIG. 32, except that a portion of the OLED substrate 100a is a blank region. The blank region may correspond to the fourth sub-pixel region, and cyan (C) color may be exhibited from the blank region.

Referring to FIG. 37, the present embodiment is similar to the configuration described in connection with FIG. 33, except that a light scattering element 71d may be further included in the fourth sub-pixel area of the OLED substrate 100a. The light scattering element 71c provided under the third color control element 75c is a first light scattering element, and the light scattering element 71d provided in the fourth sub-pixel area may be referred to as a second light scattering element. The first light scattering element 71c and the second light scattering element 71d may have the same or similar material composition.

Referring to FIG. 38, the present embodiment is similar to the configuration described in connection with FIG. 34, except that a light scattering element 71d may be further included in the fourth sub-pixel area of the OLED substrate 100a.

Referring to FIG. 39, the present embodiment is similar to the configuration described in connection with FIG. 35, except that the light scattering element 71d may be further included in the fourth sub-pixel area of the OLED substrate 100a.

In the embodiments illustrated in FIGS. 36 to 39, the arrangement order and method of the R-subpixel (the first subpixel), the G-subpixel (the second subpixel), the B-subpixel (the third subpixel), and the C-subpixel (the fourth subpixel) are illustrative only, and various alterations may be made. In some embodiments, the R, G, B, and C subpixel regions may be arranged such that a square shape matrix form may be formed when viewed from a top view. In addition, the color exhibited in the C-subpixel (the fourth subpixel) region may be any other color other than cyan (C).

Description of FIG. 40

FIG. 40 shows a graph of a PL quantum yield (%) according to the wavelength (nm) of a green-QD containing color conversion element and a red-QD containing color conversion element which may be applicable to a light-emitting device according to one or more embodiments.

Referring to FIG. 40, it can be seen that the green-QD containing color conversion element provides the PL quantum yield up to approximately the green wavelength region, and the red-QD containing color conversion element provides the PL quantum yield up to approximately the red wavelength region. The green-QD containing color conversion element and the red-QD containing color conversion element may be applicable to the first color control element 70a and the second color control element 70b of FIGS. 32 to 39, respectively.

Description of FIG. 41

FIG. 41 shows a graph of transmittance (%) according to the wavelength of a green-QD containing color conversion element and a red-QD containing color conversion element which may be applicable to a light-emitting device according to one or more embodiments.

Referring to FIG. 41, it can be seen that the green-QD containing color conversion element provides the transmittance from a wavelength corresponding to approximately in the green region, and the red-QD containing color conversion element provides the transmittance from a wavelength corresponding to approximately in the red region.

Description of FIG. 42

FIG. 42 shows a graph of transmittance (%) according to wavelength of an absorption type color filter that may be applicable to a light-emitting device according to one or more embodiments. Results for absorption type red-color

filter (CF-Red), absorption type green-color filter (CF-Green) and absorption type blue-color filter (CF-Blue) are included. In addition, the results for absorption type low reflection red-color filter (low reflection R), absorption type low reflection green-color filter (low reflection G) and absorption type low reflection blue-color filter (low reflection B) are also included. The term "low reflection" in the absorption type low reflection red-color filter refers to the case where the reflectance is relatively lower than that of the absorption type red-color filter. This description is also applicable to the low reflection green-color filter and the low reflection blue-color filter. By controlling the configuration of the color filter, the reflectance and transmittance thereof may be appropriately adjusted. The absorption type low reflection green-color filter, the absorption type low reflection red-color filter, and the absorption type low reflection blue-color filter may also be applied to the first color filter 75a, the second color filter 75b and the third color control element 75c, respectively. By using an absorption type low-reflection color filter, the reflectivity on a panel may be reduced, so that the contrast ratio in the bright room can be increased without a circular polarizer.

Description of FIG. 43

FIG. 43 shows a graph showing a difference in spectral radiance when a light scattering agent is applied to blue light and when no light scattering agent is applied.

Referring to FIG. 43, when a light scattering agent is not applied (before the scattering agent is used), it can be seen that the light is not well dispersed and a number of peaks are generated. When a light scattering agent is applied (after the scattering agent is used), it can be seen that one peak with a relatively smooth curve appears because the light is well dispersed.

Description of Table 1, and FIGS. 44 and 45

OLED substrates A, B, C, 1 and 2, each having the structure illustrated in FIG. 31, were fabricated. OLED substrates A, B, C, 1 and 2 are identical to each other except that, for each OLED substrate, the dopant compound(s) included in the EML4G of the green fourth emission unit 34G is as shown in Table 1. Each of Ir1, Ir2 and Pt1 in Table 1 emit a green light. Then, the luminescence efficiency (candela per ampere, cd/A) and lifespan ($LT_{95}$, hr, relative %) of each of OLED substrates A, B, C, 1 and 2 were measured using a current-voltmeter (Keithley 2400) and a luminance meter (Minolta Cs-1000A), under the luminance conditions described in in Table 1. Results thereof are shown as a relative value (%) in Table 1. The Lifespan ($LT_{95}$) refers to a time that is taken for the luminance to become 95% with respect to the initial luminance of 100%. In Table 1, the number in parentheses describes the doping concentration of the corresponding dopant relative to 100 wt% of EML4G, and the host of EML4G is a mixture of Compound H-H1 and Compound H-H2 (weight ratio = 1:1). EML4G is consisted of the dopant compound(s) and the hosts.

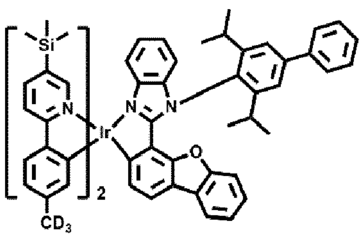

Ir1

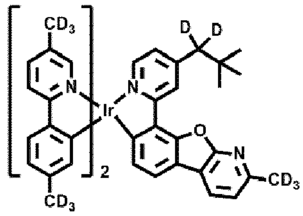

Ir2

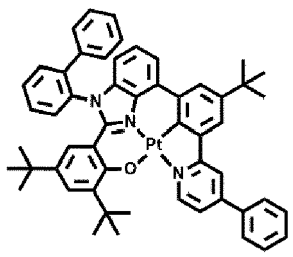

Pt1

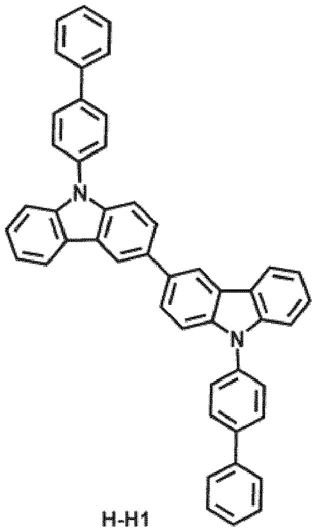

H-H1

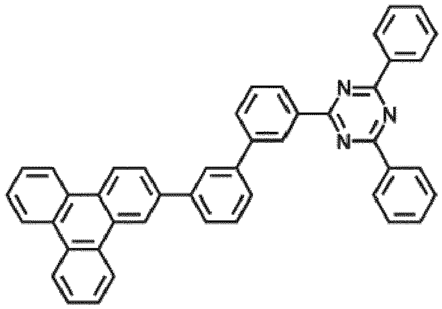

H-H2

Table 1

<table>
<tr><th rowspan="2"></th><th rowspan="2" colspan="2">Dopant included in EML4G</th><th colspan="2">Luminescence efficiency (Relative value, %)</th><th colspan="2">Lifespan ($LT_{95}$) (Relative value, %)</th></tr>
<tr><th>at 10,000 nit</th><th>at 30,000 nit</th><th>at 10,000 nit</th><th>at 30,000 nit</th></tr>
<tr><td>OLED substrate A</td><td colspan="2">Ir1 (5 wt%)</td><td>100</td><td>95</td><td>100</td><td>19</td></tr>
<tr><td>OLED substrate B</td><td colspan="2">Ir2 (5 wt%)</td><td>95</td><td>90</td><td>90</td><td>17</td></tr>
<tr><td>OLED substrate C</td><td colspan="2">Pt1 (5 wt%)</td><td>100</td><td>93</td><td>80</td><td>15</td></tr>
<tr><td>OLED substrate 1</td><td>Ir1 (5wt%)</td><td>Ir2 (4 wt%)</td><td>100</td><td>96</td><td>210</td><td>50</td></tr>
<tr><td>OLED substrate 2</td><td>Pt1 (5 wt%)</td><td>Ir1 (5 wt%)</td><td>102</td><td>99</td><td>250</td><td>60</td></tr>
</table>

From Table 1, It can be seen that the luminescence efficiency and lifespan characteristics of OLED substrate 1 are improved compared to the luminescence efficiency and lifespan (at high luminance) of OLED substrates A and B, and the luminescence efficiency and lifespan characteristics of OLED substrate 2 are improved compared to the luminescence efficiency and lifespan characteristics of OLED substrates A and C.

FIG. 44 shows a graph of the EL spectrum of OLED substrate 2. Referring to FIG. 44, it can be seen that OLED substrate 2 emits light in which blue light is mixed with green light.

Subsequently, Light Emitting Device 1 having the structure illustrated in FIG. 35 was manufactured including: OLED substrate 2 as the OLED substrate 100;

i) a green-QD containing color conversion element and a red-QD containing color conversion element that can provide the PL quantum yield according to the wavelength illustrated in FIG. 40 and the transmittance according to the wavelength illustrated in FIG. 41, respectively as the first color control element 70a including a first quantum dot (QD) for green conversion and the second color control element 70b including a second quantum dot for red conversion;

ii) three absorption type color filters showing the transmittance according to the wavelength of the absorption type red-color filter (CF-Red), the absorption type green-color filter (CF-Green), and the absorption type blue-color filter (CF-Blue), respectively as three absorption type color filters 75a, 75b, and 75c, respectively; and

iii) the color control unit 203 including the light scattering element that can provide the spectral radiance difference illustrated in FIG. 43, as the light scattering element 71c.

FIG. 45 shows a graph of the PL spectrum of the Light Emitting Device 1. As illustrated in FIG. 45, it can be seen that the blue light and green light emitted from OLED substrate 2 are effectively emitted in the form of red light, green light, and blue light after passing through the color control unit 203.

The light-emitting devices according to the embodiments described above may be applicable to various electronic apparatuses such as display apparatus. For example, the light emitting devices may be usefully applied to small-sized electronic devices such as portable devices and wearable devices, and medium- to large-sized electronic devices such as home appliances.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof are a methoxy group, an ethoxy group, a propoxy group, a butoxy group, and a pentoxy group.

The term "$C_1$-$C_{60}$ alkylthio group" as used herein refers to a monovalent group represented by $-SA_{101}$ (wherein $A_{101}$ is the $C_1$-$C_{60}$ alkyl group).

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a monovalent saturated cyclic group that includes at least one heteroatom selected from N, O, P, Si, S, Se, Ge, and B as a ring-forming atom and 1 to 10 carbon atoms, and the term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group are a silolanyl group, a silinanyl group, tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, S, Se, Ge, and B as a ring-forming atom, 1 to 10 carbon atoms, and at least one double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent

group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkyl aryl group" as used herein refers to a $C_6$-$C_{60}$ aryl group substituted with at least one $C_1$-$C_{60}$ alkyl group. The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group that includes at least one heteroatom selected from N, O, P, Si, S, Se, Ge, and B as a ring-forming atom and a cyclic aromatic system having 1 to 60 carbon atoms, and the term "$C_1$-$C_{60}$ heteroarylene group" as used herein refers to a divalent group that includes at least one heteroatom selected from N, O, P, Si, S, Se, Ge, and B as a ring-forming atom and a carbocyclic aromatic system having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein indicates $-OA_{102}$ (wherein $A_{102}$ indicates the $C_6$-$C_{60}$ aryl group), and the term "$C_6$-$C_{60}$ arylthio group" as used herein indicates $-SA_{103}$ (wherein $A_{103}$ indicates the $C_6$-$C_{60}$ aryl group).

The term "$C_1$-$C_{60}$ heteroaryloxy group" as used herein indicates $-OA_{102'}$ (wherein $A_{102'}$ indicates the $C_1$-$C_{60}$ heteroaryl group), and the term $C_1$-$C_{60}$ heteroarylthio group" as used herein indicates $-SA_{103'}$ (wherein $A_{103'}$ indicates the $C_1$-$C_{60}$ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The $C_1$-$C_{30}$ heterocyclic group may be a monocyclic group or a polycyclic group. The "$C_1$-$C_{30}$ heterocyclic group (unsubstituted or substituted with at least one $R_{10a}$)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{10a}$).

Examples of the "$C_5$-$C_{30}$ carbocyclic group" and the "$C_1$-$C_{30}$ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,

wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated $C_1$-$C_{60}$ alkyl group (or a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group (-F). For example, the term "fluorinated $C_1$ alkyl group (that is, a fluorinated methyl group)" includes $-CF_3$, - $CF_2H$, and $-CFH_2$. The "fluorinated $C_1$-$C_{60}$ alkyl group (or, a fluorinated $C_1$-$C_{20}$ alkyl group, or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group, or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen atoms included therein are not substituted with a fluoro group.

The terms "deuterated $C_1$-$C_{60}$ alkyl group (or a deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, the deuterated methyl group)" may include $-CD_3$, - $CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl) 'X' group" as used herein refers to a 'X' group that is substituted with at least one $C_1$-$C_{20}$ alkyl group. For example, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of a ($C_1$ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group,

a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, -CDs, $-CD_2H$, $-CDH_2$, $-CF_3$, $-CF_2H$, $-CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, -CDs, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$,$-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$,$-Ge(Q_{23})(Q_{24})(Q_{25})$, $-B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$,$-P(=O)(Q_{38})(Q_{39})$, or $-P(Q_{38})(Q_{39})$; or

a combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be: hydrogen, deuterium, -F, -Cl, -Br, -I, $-SF_5$, a hydroxyl group, a cyano group, a nitro group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

For example, $Q_1$ to $Q_9$, $Q_{11}$ to $Q_{19}$, $Q_{21}$ to $Q_{29}$ and $Q_{31}$ to $Q_{39}$ described herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

Although detailed features are specifically described in the above description, the detailed description should be construed as exemplary embodiments rather than limiting the scope of subject matter. For example, those of ordinary skill in the art may understand that the configuration of the OLED substrate, the color control unit, and the light-emitting device including the same described with reference to FIGS. 1 to 45 and the connection relationships therebetween may be variously modified.
The light-emitting device described above has high luminescence efficiency and long lifespan. Accordingly, an electronic apparatus including the same can be a high-quality electronic apparatus.
It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

**1.** A light-emitting device, comprising:

an organic light-emitting device (OLED) substrate comprising a structure, in which at least one blue emission unit and at least one green emission unit are stacked, wherein the OLED substrate emits blue light and green light; and
a color control unit located in a path of light emitted from the OLED substrate, wherein the color control unit controls a color of light emitted from the OLED substrate,
wherein the at least one green emission unit comprises a first compound and a second compound,
the first compound and the second compound are different from each other,
the first compound emits first light having a first spectrum, and AP(1) is a first emission peak wavelength of the first spectrum, as evaluated from a first photoluminescence spectrum measured from a first film comprising the first compound,
the second compound emits second light having a second spectrum, and AP(2) is a second emission peak wavelength of the second spectrum, as evaluated from a second photoluminescence spectrum measured from a second film comprising the second compound,
an absolute value of the difference between AP(1) and AP(2) is from 0 nanometer to 30 nanometer, and
$\lambda P(1)$ and $\lambda P(2)$ are each independently from 500 nanometer to 570 nanometer.

**2.** The light-emitting device of claim 1, wherein the at least one green emission units of the OLED substrate 1 comprises a layer comprising a mixture of the first compound and the second compound; and/or

wherein the OLED substrate comprises a tandem structure; and/or
wherein a number of the at least one blue emission units is equal to or greater than a number of the at least one green emission units; and/or
wherein the ratio of the number of the blue emission units to the number of the green emission units is 1:1 to 10:1; and/or
wherein the color control unit comprises a quantum dot, an inorganic phosphor, an organic fluorescent material, an organic phosphorescent material, or a combination thereof.

**3.** The light-emitting device of claims 1 or 2, wherein the color control unit comprises:

a first color control element for green conversion, comprising a first quantum dot;

a second color control element for red conversion, comprising a second quantum dot; and
a third color control element for blue conversion;
preferably wherein the color control unit further comprises
a first color filter located on the first color control element; and
a second color filter located on the second color control element.

**4.** The light-emitting device of any of claims 1-3, wherein

the first compound and the second compound are each an emitter, and
$\lambda P(1)$ and $\lambda P(2)$ are each independently 510 nanometer to 540 nanometer.

**5.** The light-emitting device of any of claims 1-4, wherein

the first compound is a sensitizer,
the second compound is an emitter,
$\lambda P(1)$ is 500 nanometer to 520 nanometer, and
$\lambda P(2)$ is 510 nanometer to 540 nanometer.

**6.** The light-emitting device of any of claims 1-5, wherein the first compound and the second compound are each independently a phosphorescent compound.

**7.** The light-emitting device of any of claims 1-6, wherein

the first compound is a phosphorescent compound, and the second compound is a fluorescent compound, or
the first compound and the second compound are each independently a fluorescent compound.

**8.** The light-emitting device of any of claims 1-7, wherein the light-emitting device satisfies Condition 1 or Condition 2:

Condition 1

the first compound is a platinum-containing organometallic compound comprising platinum and a tetradentate ligand bonded to the platinum, and
the second compound is an iridium-containing organometallic compound;

Condition 2
each of the first compound and the second compound is independently an iridium-containing organometallic compound.

**9.** The light-emitting device of claim 8, wherein

the light-emitting device satisfies Condition 1,
$\mu(Pt)$ is from of 0.5 debye to 5.0 debye,
$\mu(Pt)$ is less than $\mu(Ir)$,
$\mu(Pt)$ indicates an electric dipole moment of the first compound,
$\mu(Ir)$ indicates an electric dipole moment of the second compound, and
each of $\mu(Pt)$ and $\mu(Ir)$ is calculated based on density functional theory (DFT); preferably wherein
$\mu(Pt)$ is 1.5 debye to 5.0 debye, and
$\mu(Ir)$ is 4.0 debye to 9.0 debye.

**10.** The light-emitting device of claims 8 or 9, wherein the light-emitting device satisfies Condition 2, and the light-emitting device further satisfies at least one of Equation 1 to Equation 4:

Equation 1

$$\lambda P(Ir1) > \lambda P(Ir2)$$

Equation 2

$$PLQY(Ir1) > PLYQ(Ir2)$$

Equation 3

$$k_r(Ir1) > k_r(Ir2)$$

Equation 4

$$HOR(Ir1) > HOR(Ir2)$$

wherein, in Equations 1 to 4,

λP(Ir1) is the first emission peak wavelength AP(1) of the first compound, as evaluated from the first photoluminescence spectrum measured from the first film comprising the first compound,
λP(Ir2) is the second emission peak wavelength AP(2) of the second compound, as evaluated from the second photoluminescence spectrum measured from the second film comprising the second compound,
PLQY(Ir1) is a first photoluminescence quantum yield of the first compound, as evaluated from the first photoluminescence spectrum measured from the first film comprising the first compound,
PLQY(Ir2) is a second photoluminescence quantum yield of the second compound, as evaluated from the second photoluminescence spectrum measured from the second film comprising the second compound,
$k_r$(Ir1) is a first radiative decay rate of the first compound, as evaluated from the first photoluminescence spectrum and first time-resolved photoluminescence spectra measured from the first film comprising the first compound,
kr(Ir2) is a second radiative decay rate of the second compound, as evaluated from the second photoluminescence spectrum and second time-resolved photoluminescence spectra measured from the second film comprising the second compound,
HOR(Ir1) is a first horizontal orientation ratio of the first compound, as evaluated from a first emission intensity with respect to a first angle measured from the first film comprising the first compound, and
HOR(Ir2) is a second horizontal orientation ratio of the second compound, as evaluated from a second emission intensity with respect to a second angle measured from the second film comprising the second compound.

**11.** The light-emitting device of claim 10, wherein the light-emitting device satisfies

Equation 1,
at least one of Equation 2 to Equation 4, or
Equation 1, and at least one of Equation 2 to Equation 4.

**12.** The light-emitting device of claims 10 or 11, wherein the light-emitting device further satisfies Equation 5:

Equation 5

$$HOMO\ (Ir1) < HOMO\ (Ir2)$$

wherein, in Equation 5,

HOMO (Ir1) is a first highest occupied molecular orbital (HOMO) energy level of the first compound, as evaluated from a first atmospheric photoelectron spectrum measured from the first film comprising the first compound, and
HOMO (Ir2) is a second highest occupied molecular orbital (HOMO) energy level of the second compound, as evaluated from a second atmospheric photoelectron spectrum measured from the second film comprising the second compound.

**13.** The light-emitting device of any of claims 10-12, wherein

|HOMO (Ir1) - HOMO (Ir2)| is 0.03 electron volts to 0.30 electron volts, and
|HOMO (Ir1) - HOMO (Ir2)| is an absolute value of HOMO (Ir1) - HOMO (Ir2),
wherein HOMO (Ir1) is a first highest occupied molecular orbital (HOMO) energy level of the first compound, as evaluated from a first atmospheric photoelectron spectrum measured from the first film comprising the first compound, and
HOMO (Ir2) is a second highest occupied molecular orbital (HOMO) energy level of the second compound, as evaluated from a second atmospheric photoelectron spectrum measured from the second film comprising the second compound.

**14.** The light-emitting device of any of claims 8-13, wherein

the platinum-containing organometallic compound in Condition 1 comprises a chemical bond between a carbon atom of the tetradentate ligand and the platinum, and a chemical bond between an oxygen atom of the tetradentate ligand and the platinum, and
each of the iridium-containing organometallic compounds in Condition 1 and Condition 2 independently comprises a first ligand, a second ligand, and a third ligand,
wherein, in each of the iridium-containing organometallic compounds:

the first ligand, the second ligand, and the third ligand are identical to each other,
the first ligand and the second ligand are identical to each other, and the second ligand and the third ligand are different from each other, or
the first ligand, the second ligand, and the third ligand are different from each other, and

wherein the first ligand, the second ligand, and the third ligand are each independently:

a bidentate ligand bonded to the iridium of the iridium-containing organometallic compound via two nitrogen atoms;
a bidentate ligand bonded to the iridium of the iridium-containing organometallic compound via a nitrogen atom and a carbon atom; or
a bidentate ligand bonded to the iridium of the iridium-containing organometallic compound via two carbon atoms.

**15.** An electronic apparatus, comprising the light-emitting device of any of claims 1-14.

FIG. 1

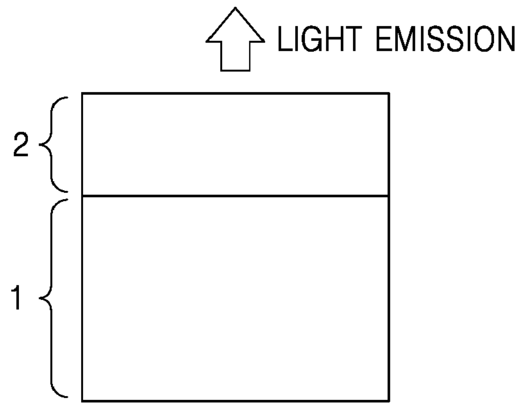


FIG. 2

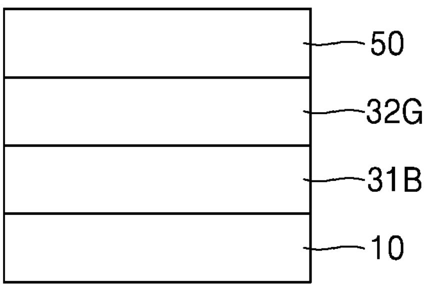

FIG. 3

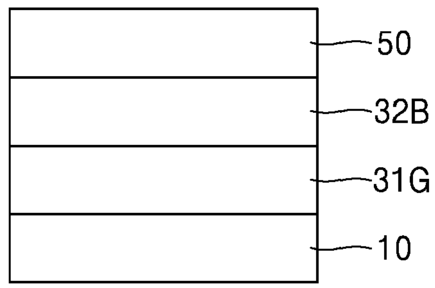


FIG. 4

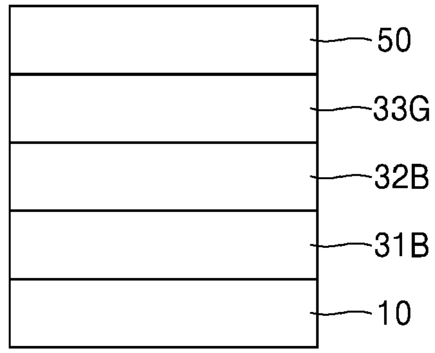

FIG. 5

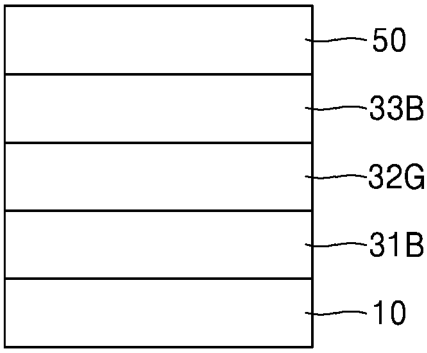


FIG. 6

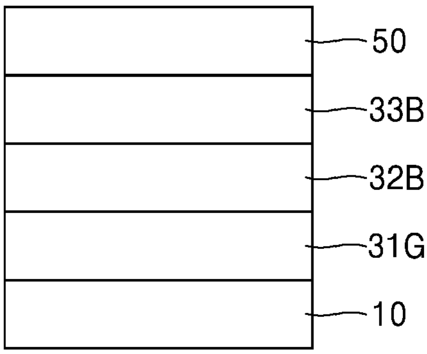

FIG. 7

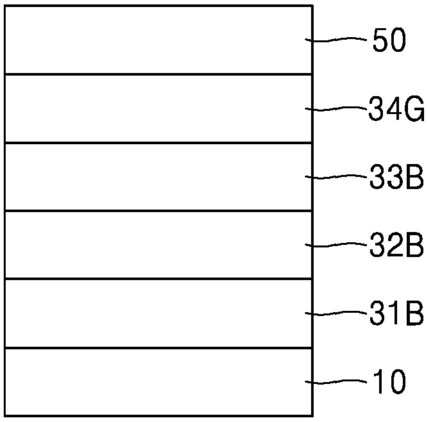


FIG. 8

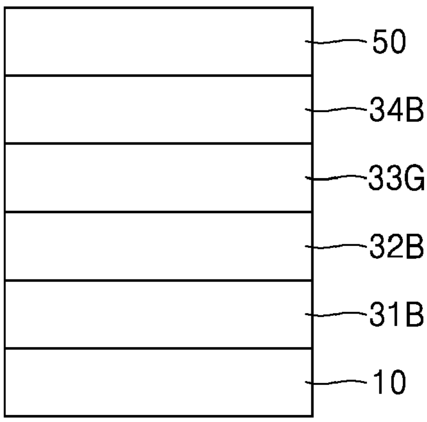

FIG. 9

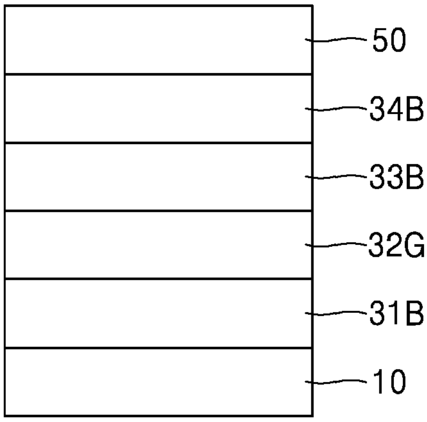


FIG. 10

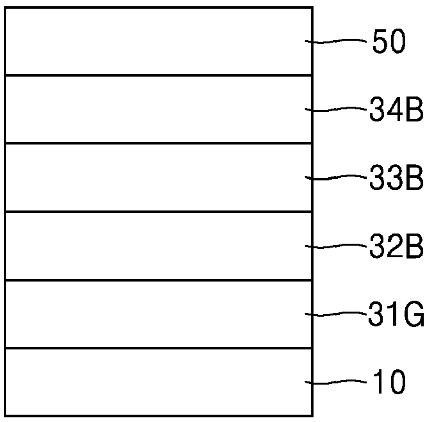

FIG. 11

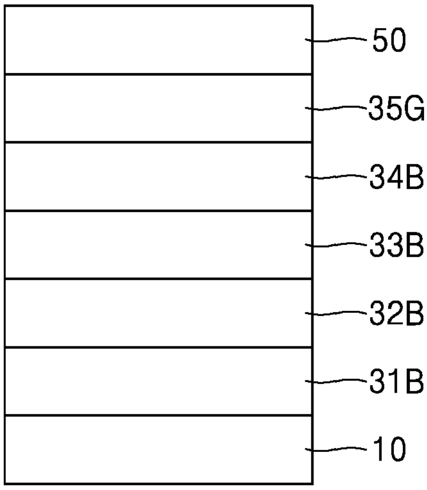


FIG. 12

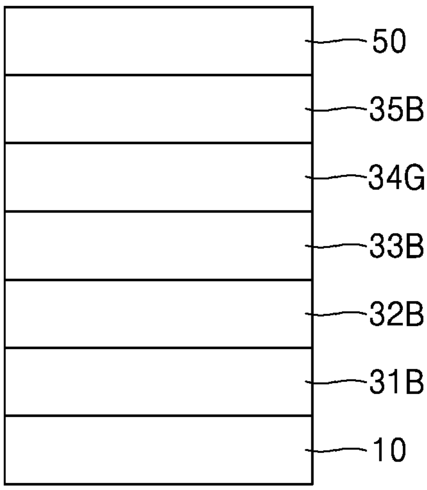

FIG. 13

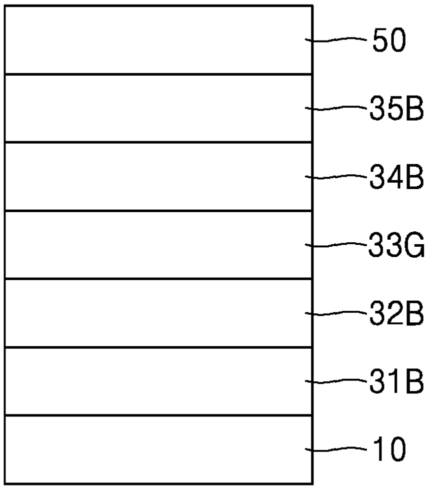


FIG. 14

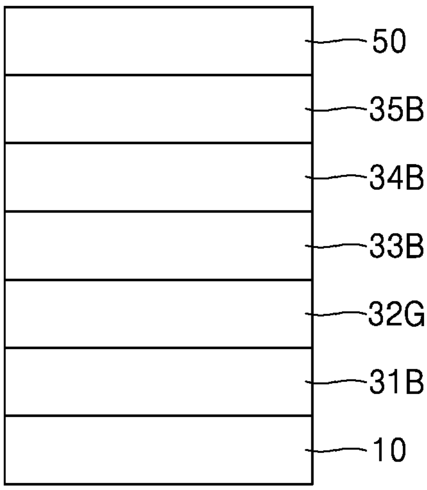

FIG. 15

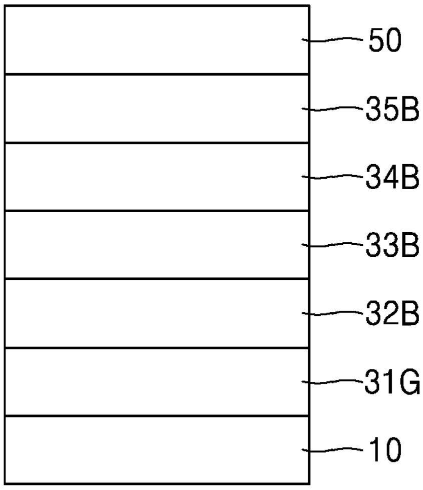


FIG. 16

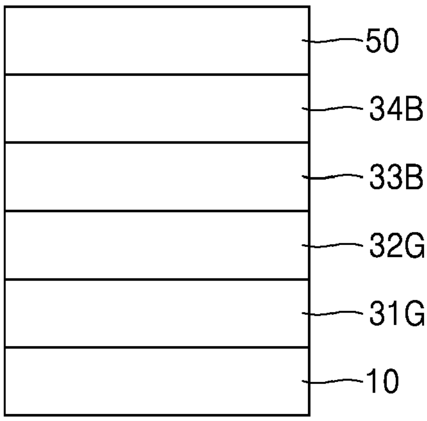

FIG. 17

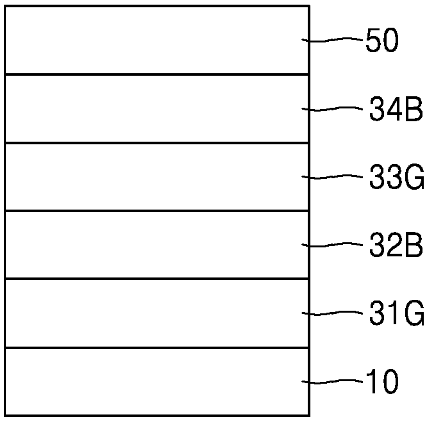


FIG. 18

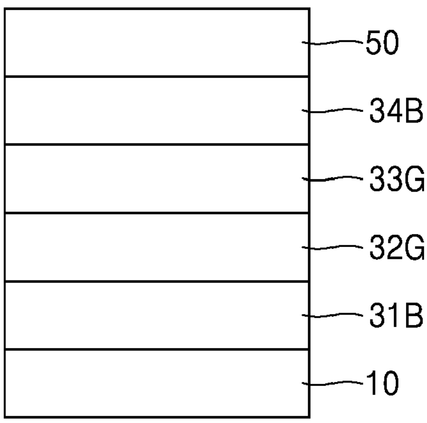

FIG. 19

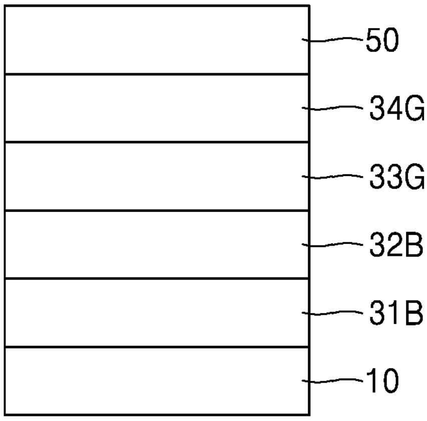


FIG. 20

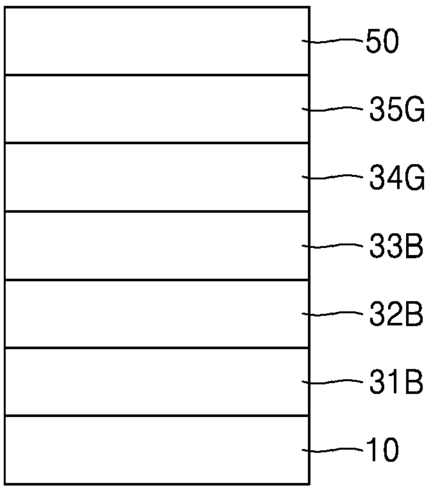

FIG. 21

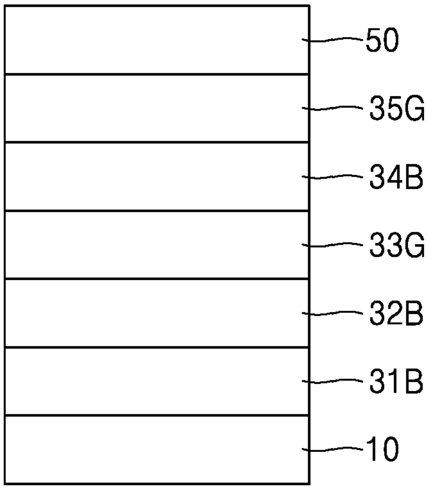


FIG. 22

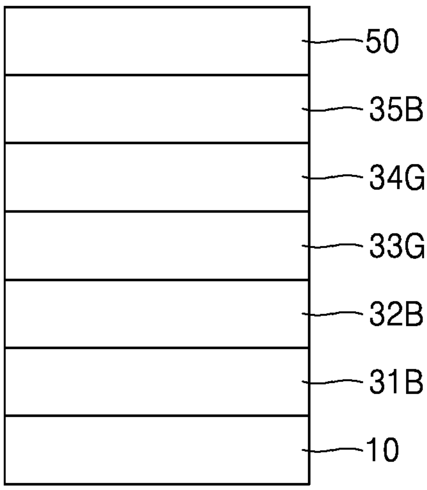

FIG. 23

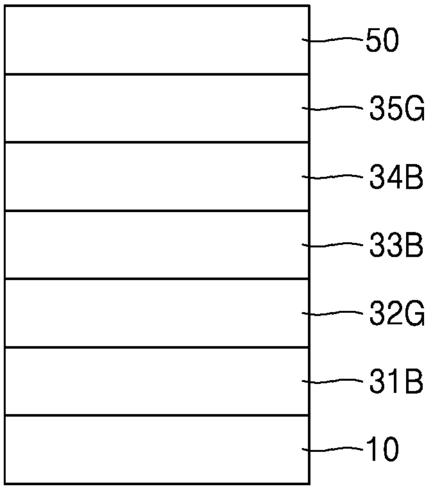


FIG. 24

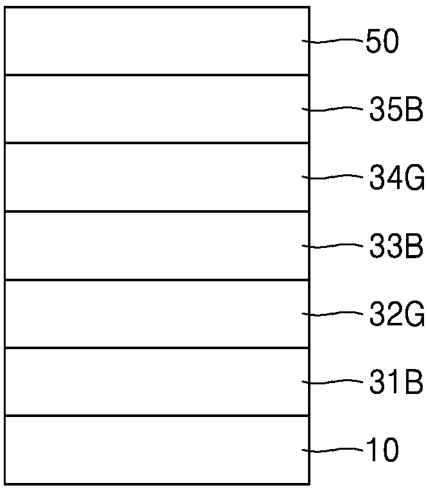

FIG. 25

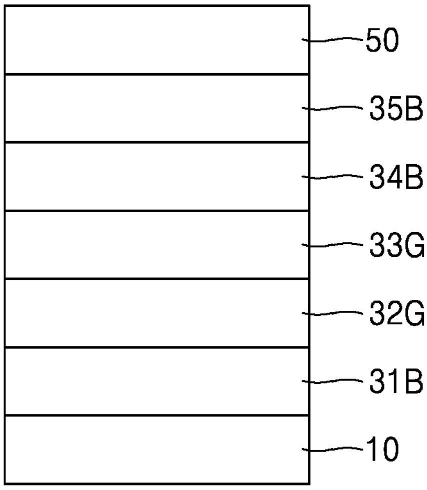


FIG. 26

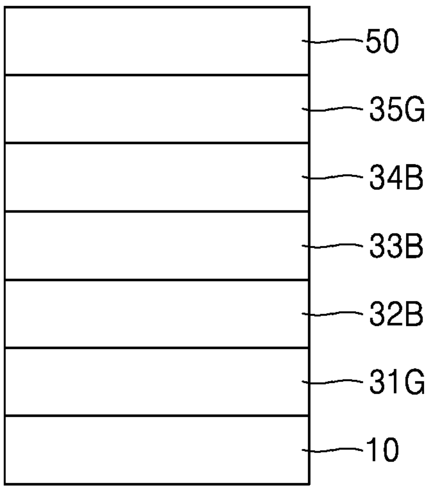

FIG. 27

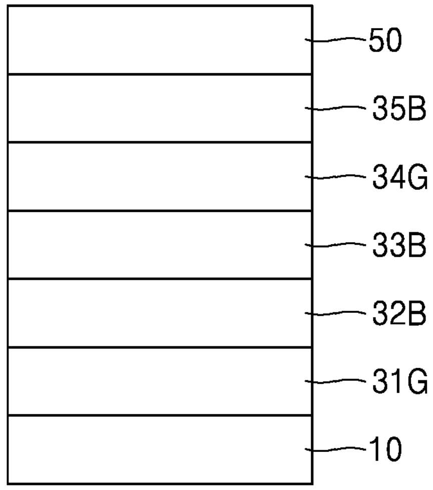


FIG. 28

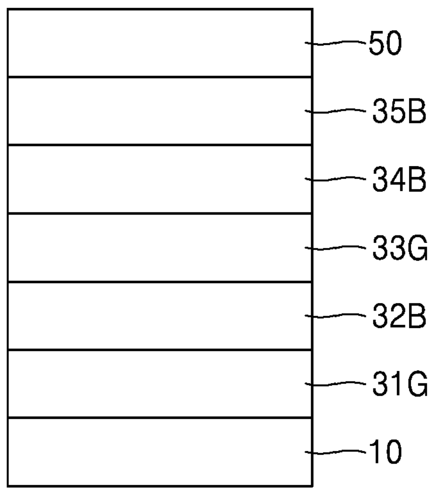

FIG. 29

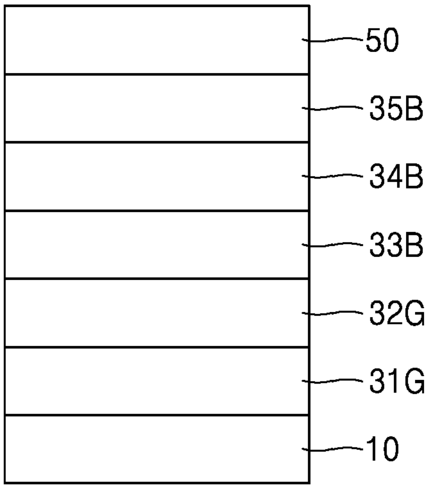


FIG. 30

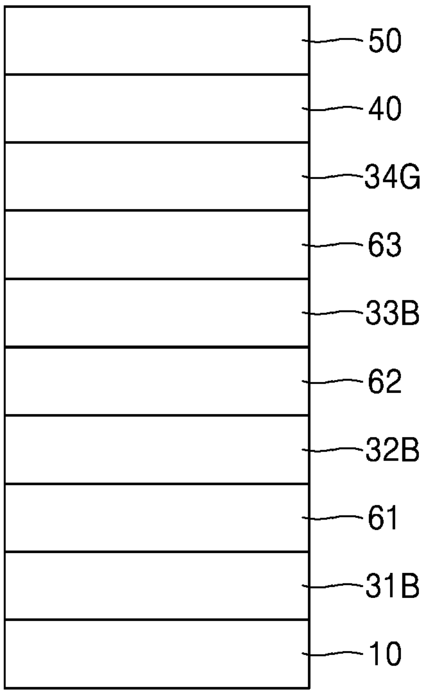

FIG. 31

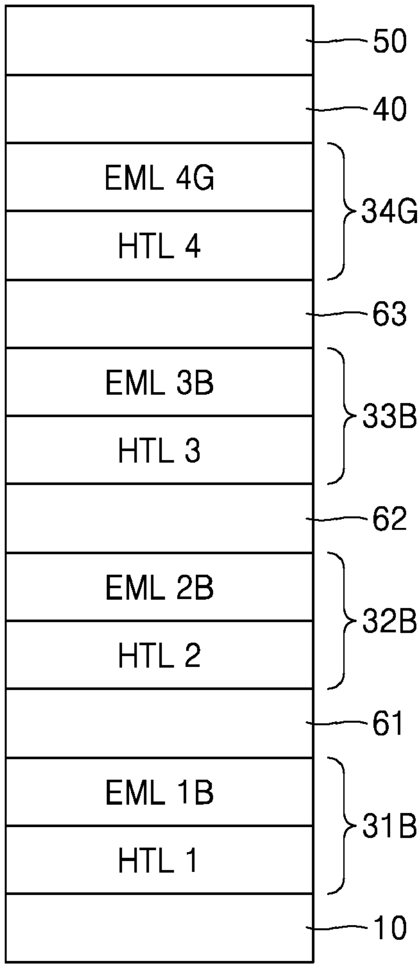
50
40
EML 4G
HTL 4
34G
63
EML 3B
HTL 3
33B
62
EML 2B
HTL 2
32B
61
EML 1B
HTL 1
31B
10

FIG. 32

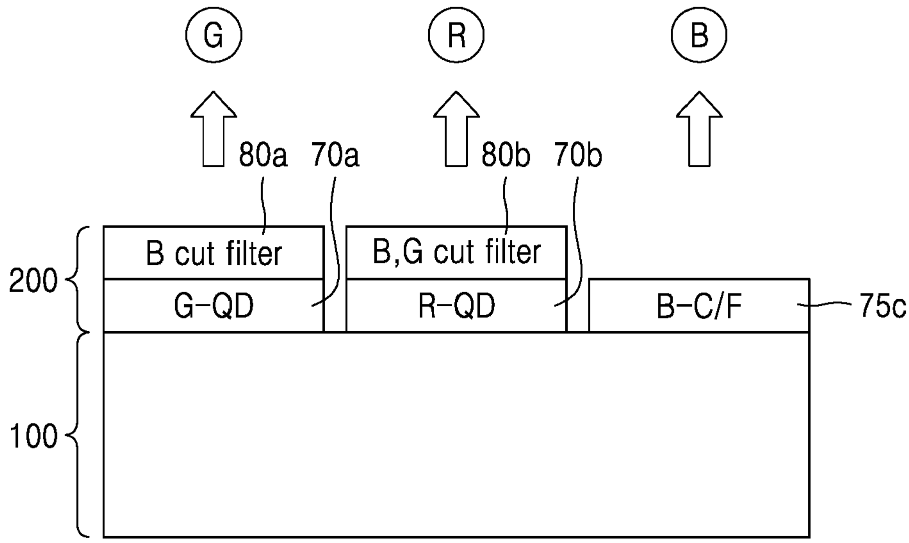
G
R
B
80a
70a
80b
70b
200
B cut filter
G-QD
B,G cut filter
R-QD
B-C/F
75c
100

FIG. 33

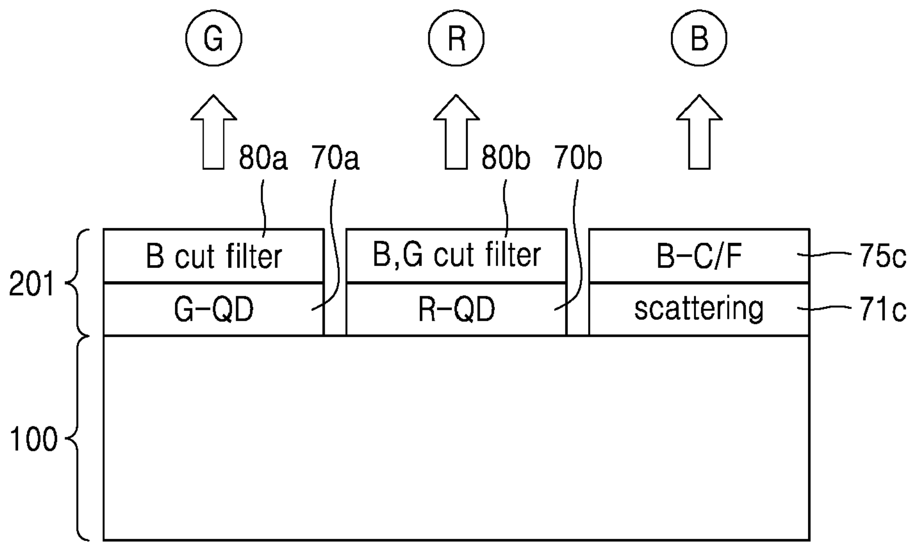
G
R
B
80a
70a
80b
70b
201
B cut filter
G-QD
B,G cut filter
R-QD
B-C/F
75c
scattering
71c
100

FIG. 34

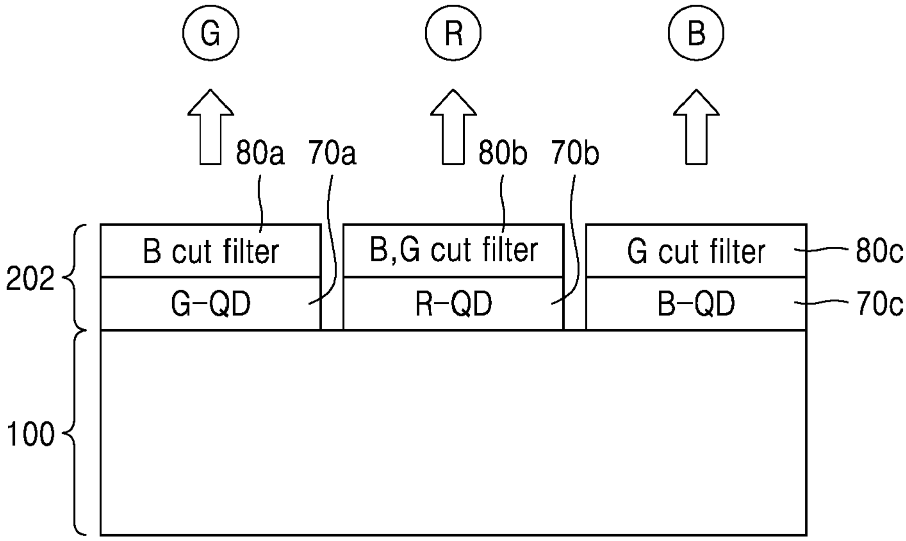
G
R
B
80a
70a
80b
70b
B cut filter
B,G cut filter
G cut filter
80c
202
G-QD
R-QD
B-QD
70c
100

FIG. 35

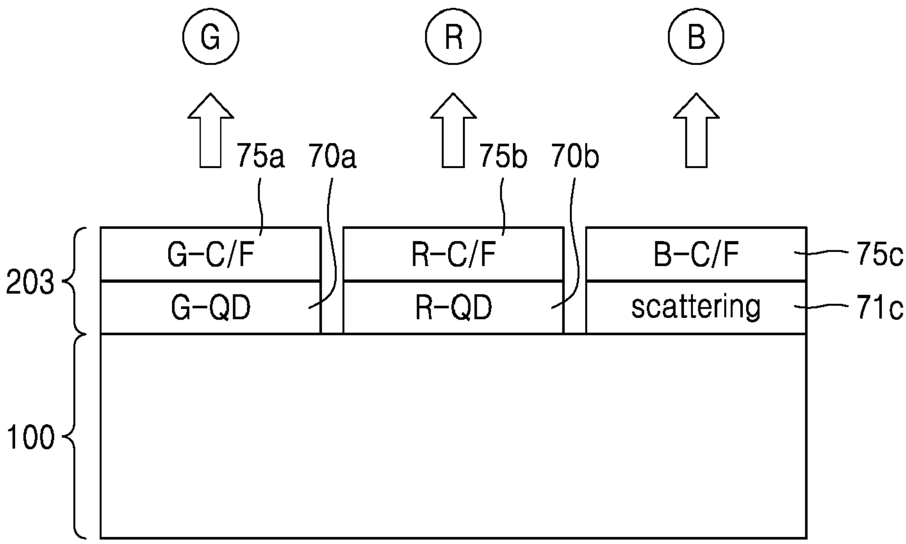
G
R
B
75a
70a
75b
70b
G-C/F
R-C/F
B-C/F
75c
203
G-QD
R-QD
scattering
71c
100

FIG. 36

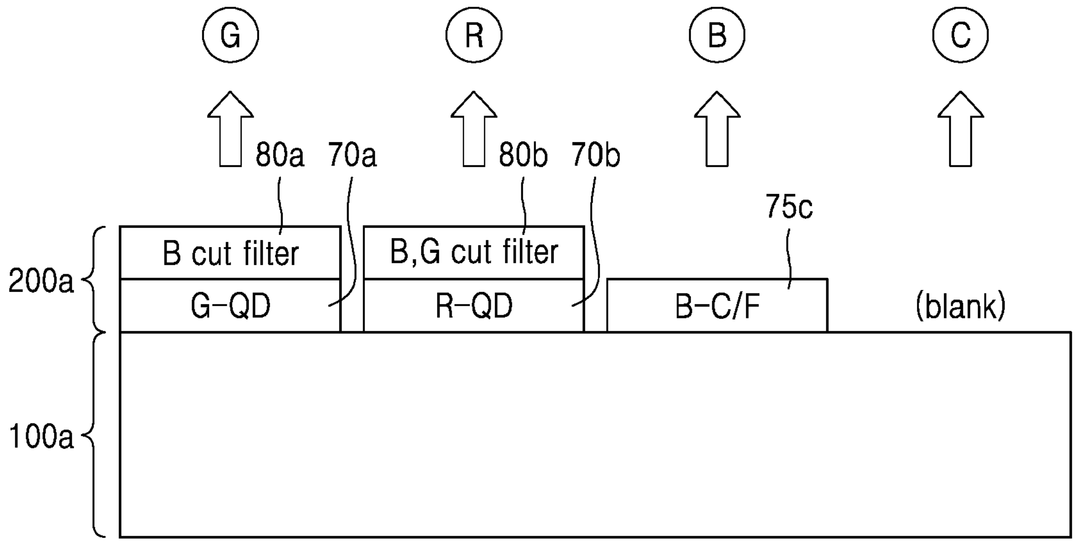
G
R
B
C
80a
70a
80b
70b
75c
200a
B cut filter
G-QD
B,G cut filter
R-QD
B-C/F
(blank)
100a

FIG. 37

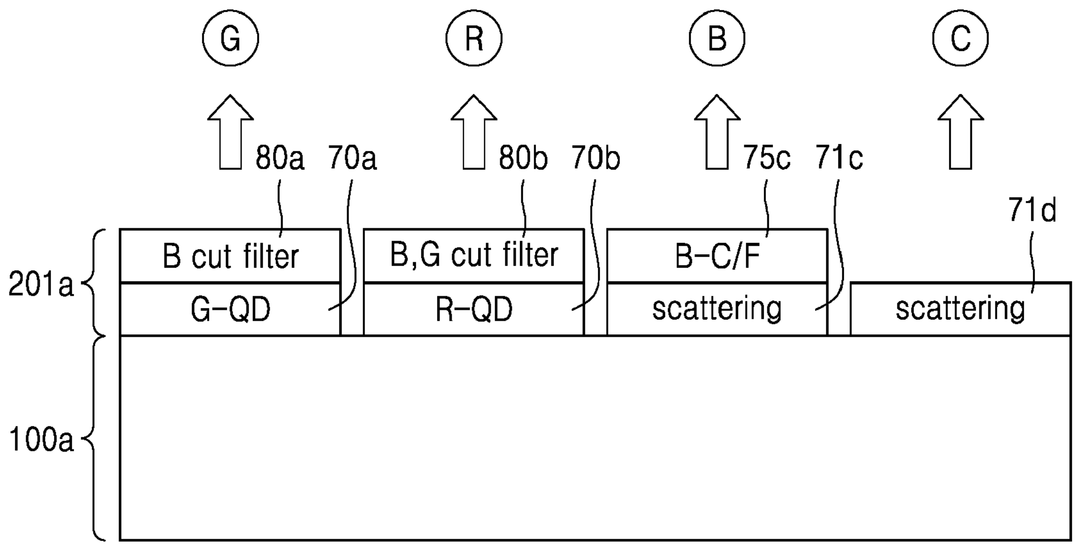
G
R
B
C
80a
70a
80b
70b
75c
71c
71d
201a
B cut filter
G-QD
B,G cut filter
R-QD
B-C/F
scattering
scattering
100a

FIG. 38

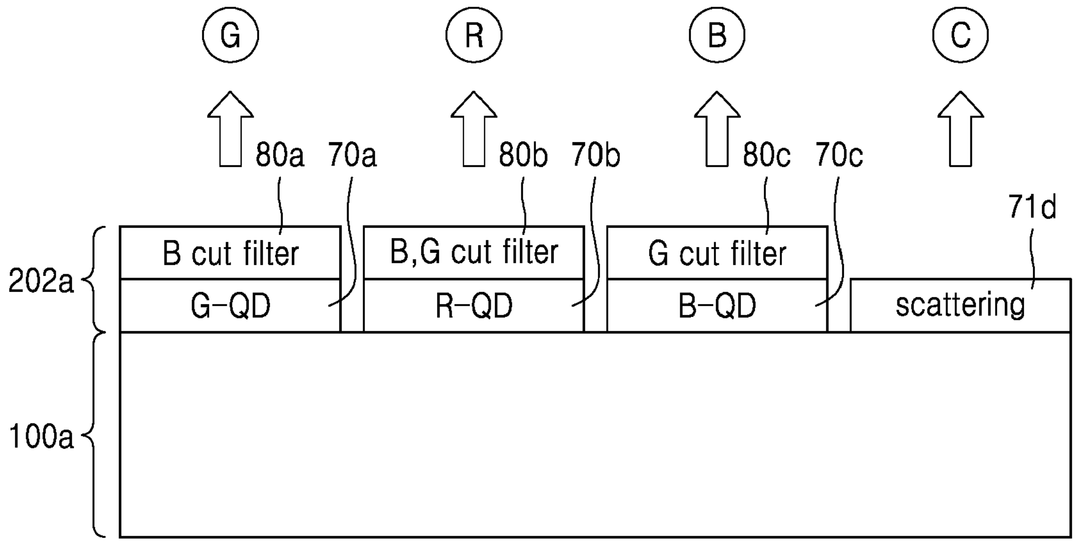
G
R
B
C
80a
70a
80b
70b
80c
70c
71d
B cut filter
B,G cut filter
G cut filter
G-QD
R-QD
B-QD
scattering
202a
100a

FIG. 39

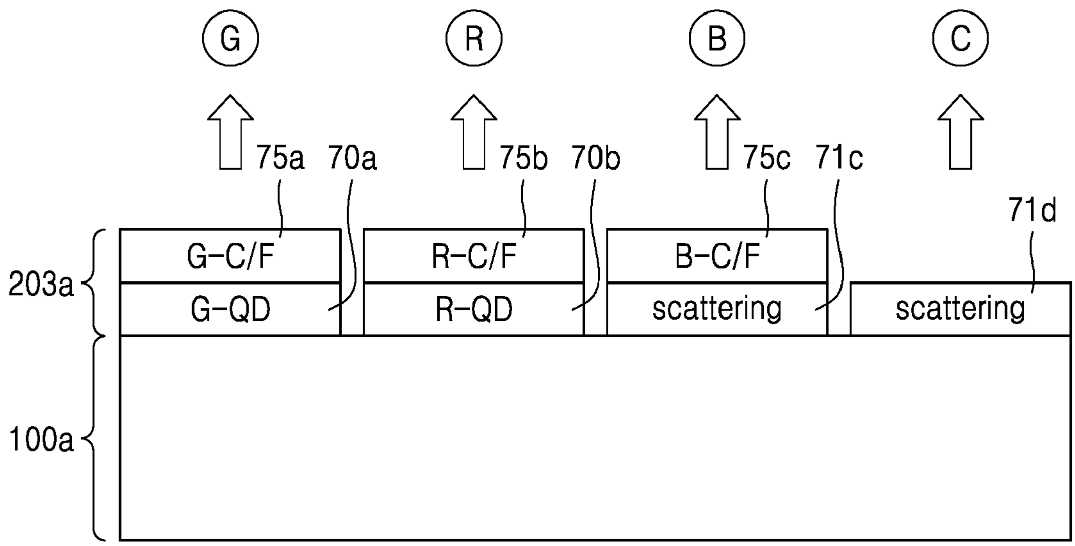
G
R
B
C
75a
70a
75b
70b
75c
71c
71d
G-C/F
R-C/F
B-C/F
G-QD
R-QD
scattering
scattering
203a
100a

FIG. 40

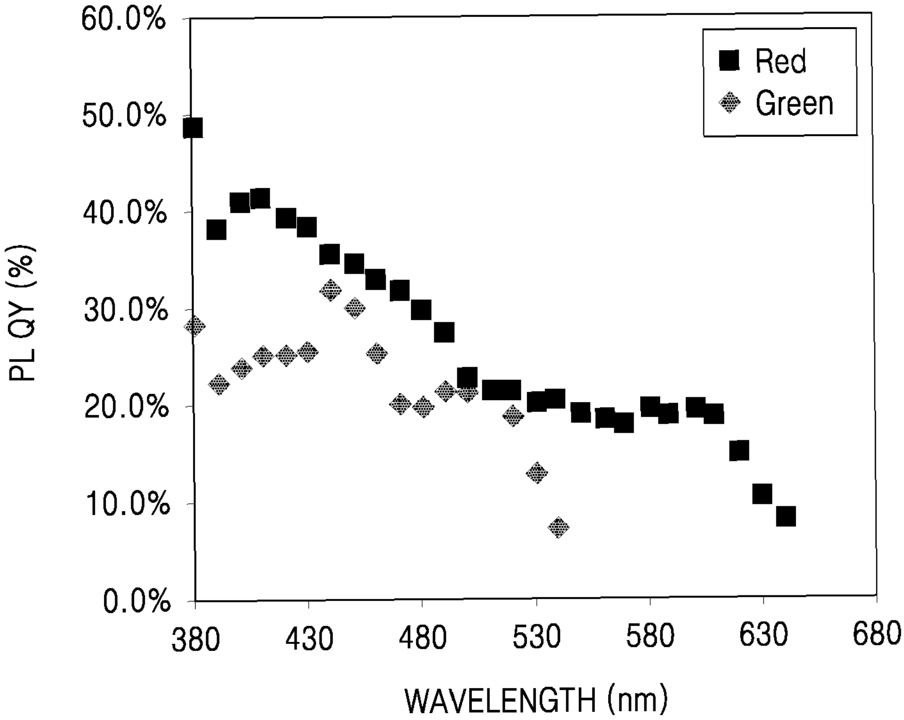
60.0%
50.0%
40.0%
30.0%
20.0%
10.0%
0.0%
PL QY (%)
380
430
480
530
580
630
680
WAVELENGTH (nm)
Red
Green

FIG. 41

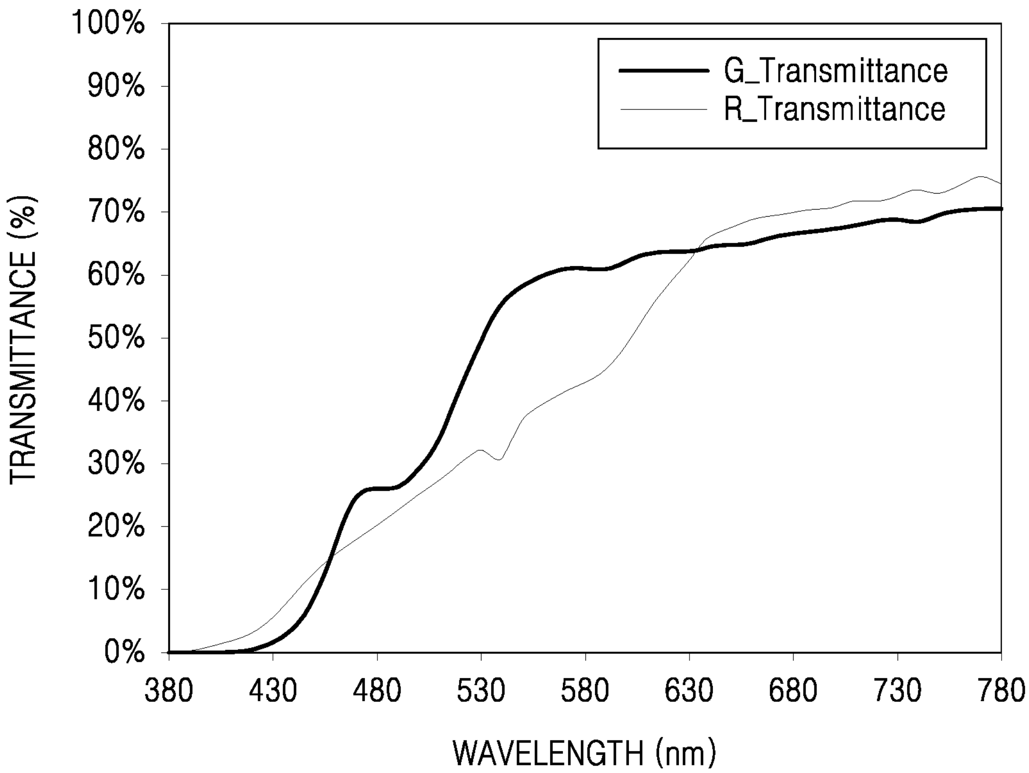
100%
90%
80%
70%
60%
50%
40%
30%
20%
10%
0%
TRANSMITTANCE (%)
380
430
480
530
580
630
680
730
780
WAVELENGTH (nm)
G_Transmittance
R_Transmittance

FIG. 42

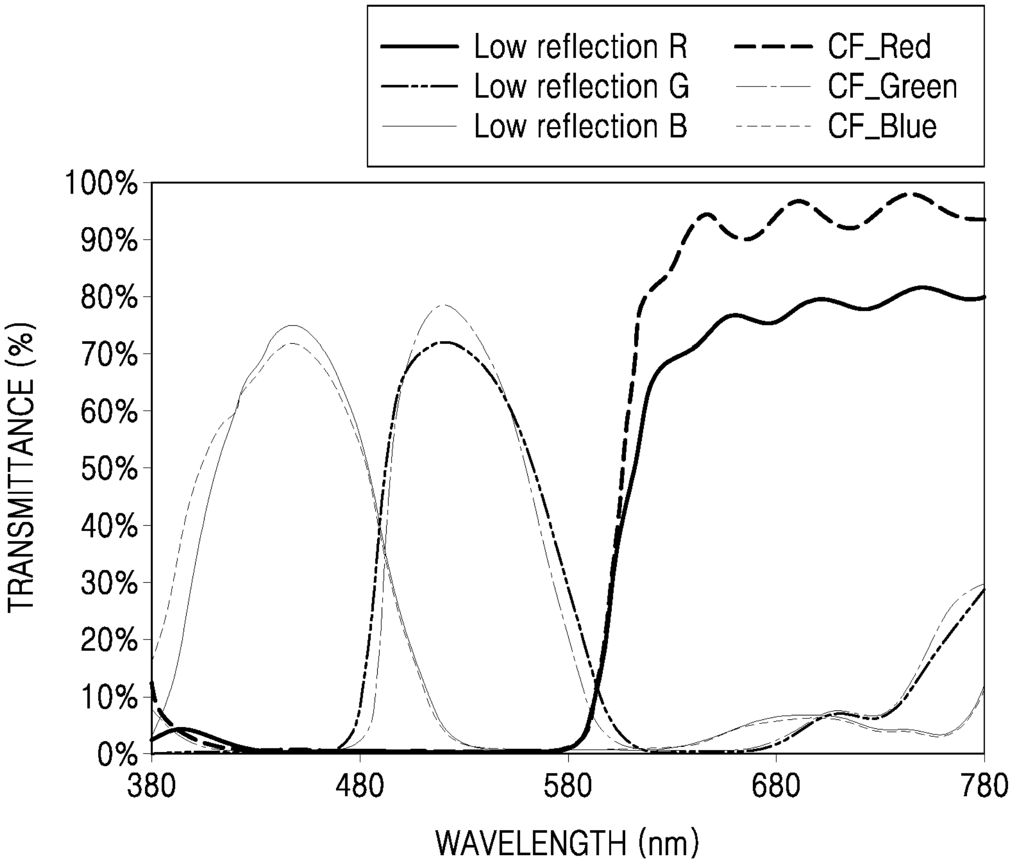
Low reflection R
Low reflection G
Low reflection B
CF_Red
CF_Green
CF_Blue
100%
90%
80%
70%
60%
50%
40%
30%
20%
10%
0%
TRANSMITTANCE (%)
380
480
580
680
780
WAVELENGTH (nm)

FIG. 43

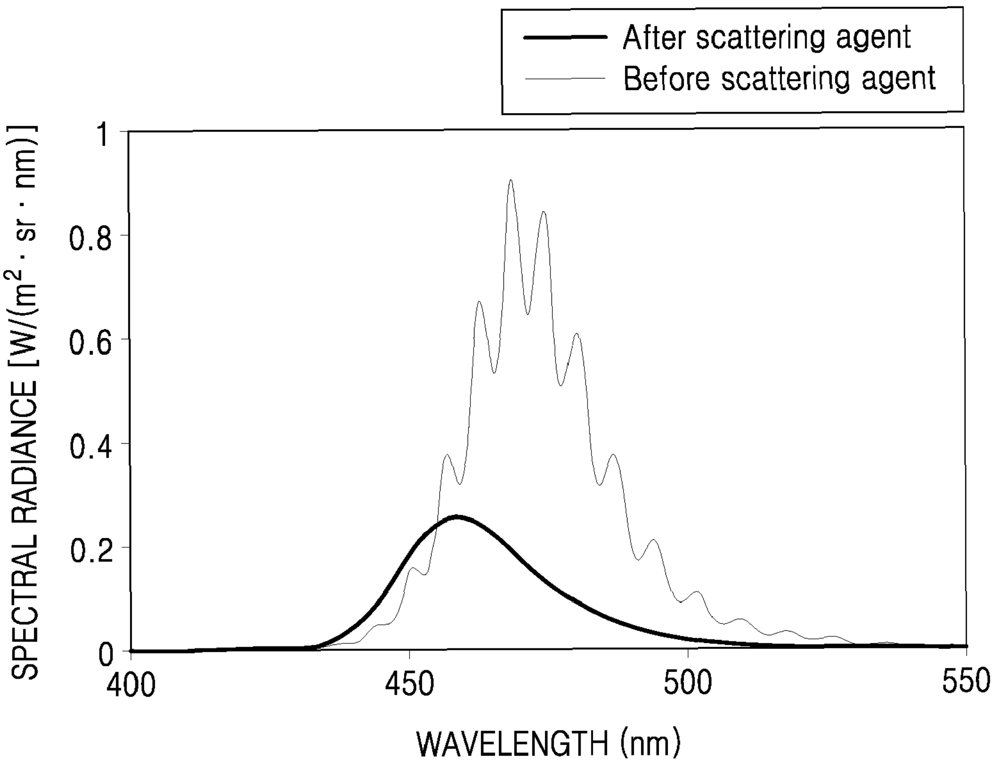
After scattering agent
Before scattering agent
SPECTRAL RADIANCE [W/(m2 · sr · nm)]
1
0.8
0.6
0.4
0.2
0
400
450
500
550
WAVELENGTH (nm)

FIG. 44

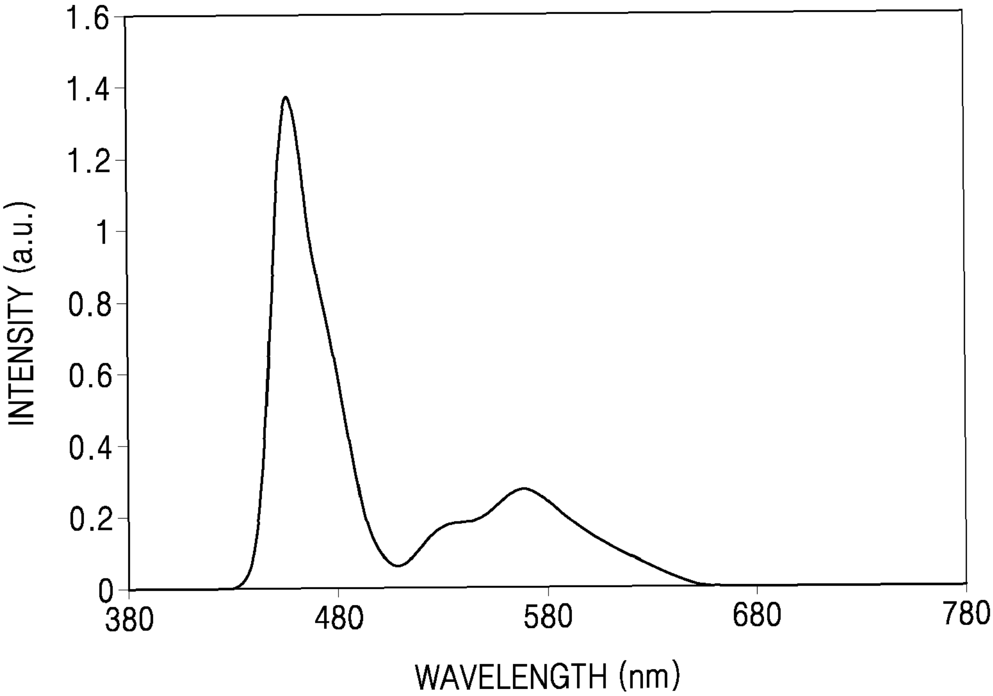
INTENSITY (a.u.)
1.6
1.4
1.2
1
0.8
0.6
0.4
0.2
0
380
480
580
680
780
WAVELENGTH (nm)

FIG. 45

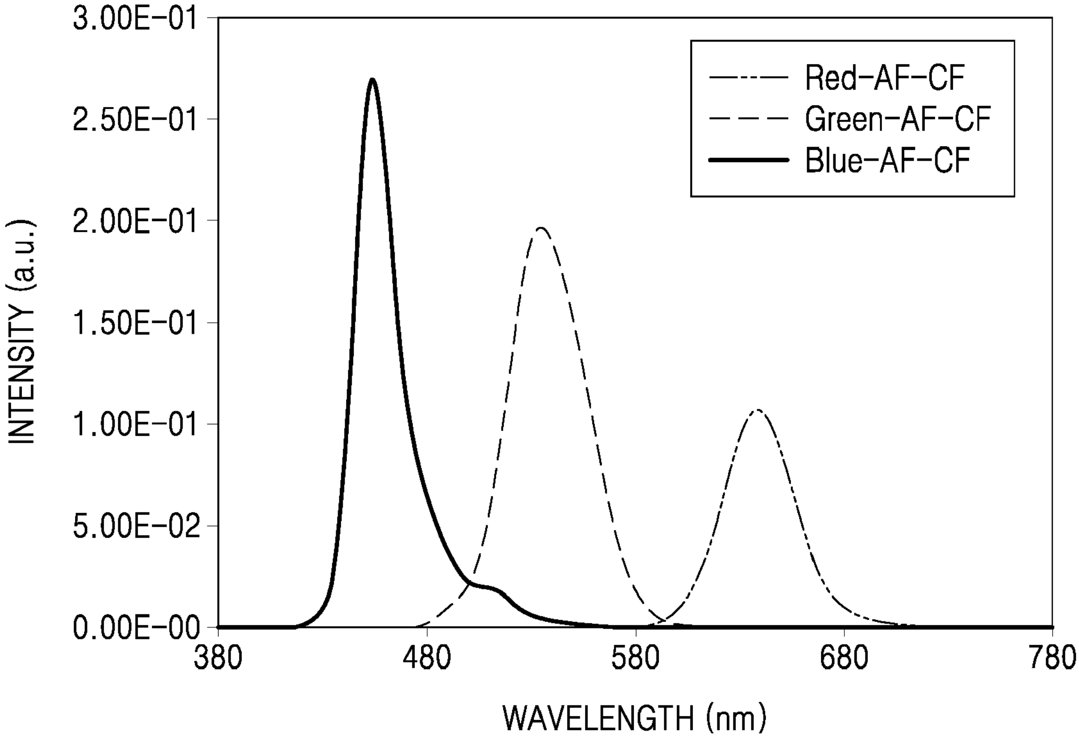
3.00E-01
2.50E-01
2.00E-01
1.50E-01
1.00E-01
5.00E-02
0.00E-00
INTENSITY (a.u.)
380
480
580
680
780
WAVELENGTH (nm)
Red-AF-CF
Green-AF-CF
Blue-AF-CF

Europäisches Patentamt
European Patent Office
Office européen des brevets

# EUROPEAN SEARCH REPORT

Application Number
EP 22 19 5349

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/251040 A1 (LEE SANGYOON [KR] ET AL) 6 August 2020 (2020-08-06)<br>* paragraph [0188] *<br>----- | 1-15 | INV.<br>H10K101/00<br>H10K50/13 |
| X | US 2021/020847 A1 (YOON KYUNG-JIN [KR] ET AL) 21 January 2021 (2021-01-21)<br>* paragraphs [0207] - [0234]; figure 13 *<br>----- | 1-15 | |
| | | | TECHNICAL FIELDS SEARCHED (IPC) |
| | | | H10K<br>H01L |

The present search report has been drawn up for all claims

1

| Place of search | Date of completion of the search | Examiner |
|---|---|---|
| Munich | 31 January 2023 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 19 5349

This annex lists the patent family members relating to the patent documents cited in the above-mentioned European search report. The members are as contained in the European Patent Office EDP file on
The European Patent Office is in no way liable for these particulars which are merely given for the purpose of information.

31-01-2023

| Patent document cited in search report | Publication date | Patent family member(s) | Publication date |
|---|---|---|---|
| US 2020251040 A1 | 06-08-2020 | KR 20220062256 A | 16-05-2022 |
| | | US 2018374409 A1 | 27-12-2018 |
| | | US 2020251040 A1 | 06-08-2020 |
| US 2021020847 A1 | 21-01-2021 | CN 112239472 A | 19-01-2021 |
| | | KR 20210009698 A | 27-01-2021 |
| | | US 2021020847 A1 | 21-01-2021 |

EPO FORM P0459

For more details about this annex : see Official Journal of the European Patent Office, No. 12/82